# EUROPÄISCHE PATENTSCHRIFT

(11) **EP 4 544 292 B1**
(45) Veröffentlichungstag und Bekanntmachung des Hinweises auf die Patenterteilung: **30.09.2026**
(21) Anmeldenummer: 23772759.9
(22) Anmeldetag: 23.08.2023
(51) Int. Cl.: G01N 24/10, G01R 33/26, G01R 33/02, H02P 6/16

(54) **VERFAHREN ZUR HERSTELLUNG EINES LICHTWELLENLEITERS MIT NV-ZENTREN**
METHOD FOR MANUFACTURING AN OPTICAL WAVEGUIDE HAVING NV CENTRES
PROCÉDÉ DE FABRICATION D'UN GUIDE D'ONDES OPTIQUES COMPORTANT DES CENTRES NV

(30) Priorität: 24.08.2022 DE 102022005018; 06.09.2022 DE 102022122507; 26.11.2022 DE 102022131306; 16.01.2023 DE 102023100857; 07.05.2023 DE 102023111859; 19.06.2023 DE 102023115907; 11.08.2023 DE 102023121634
(43) Veröffentlichungstag der Anmeldung: 30.04.2025
(60) Teilanmeldung: 26194739.4 / 4 807 978
(73) Patentinhaber: Quantum Technologies GmbH, 04103 Leipzig (DE)
(72) Erfinder: LANGGUTH, Lutz, 04317 Leipzig (DE); STAACKE, Robert, 04317 Leipzig (DE); RAJSP, Dominik, 04317 Leipzig (DE); MÜLLER, Romy, 04129 Leipzig (DE)
(86) Internationale Anmeldenummer: PCT/DE2023/100614
(87) Internationale Veröffentlichungsnummer: WO 2024/041703

(56) Entgegenhaltungen:
- CN-B- 110 554 332
- CN-B- 112 146 782
- DE-A1- 102014 208 527
- DE-A1- 102021 101 565
- RU-U1- 190 347
- ANONYMOUS: "UV Curable Ormocer Coatings", 24 October 2020 (2020-10-24), Internet, pages 1 - 2, XP093100433, Retrieved from the Internet <URL:https://web.archive.org/web/20201024060815/https://www.isc.fraunhofer.de/content/dam/isc/de/documents/Publikationen/UV_curable_ORMOCER_coatings.pdf> [retrieved on 20231110]

## Beschreibung

### Zu den Prioritäten

Die hier vorgelegte deutsche Patentanmeldung nimmt die Prioritäten der folgenden deutschen Patentanmeldungen DE 10 2022 005018.8 vom 24.08.2022, DE 102023 100 857.9 vom 16.01.2023, DE 10 2023 111 859.5 vom 07.05.2023, DE 10 2022 122 507.0 vom 06.09.2022, DE 10 2023 115 907.0 vom 19.06.2023 DE 10 2023 121 634.1 vom 11.08.2023 und DE 10 2022 131 306.9 vom 26.11.2022 in Anspruch.

### Feld der Erfindung

Die Erfindung richtet sich auf eine Vorrichtung zur hoch ortsaufgelösten Messung von magnetischen Feldern mittels eines Lichtwellenleiters mit einem gegenüber dem Lichtwellenleiter in Bezug auf eine Zielplatzierung selbstjustierenden Sensorelement. Als Anwendungen offenbart das hier vorgelegte Dokument eine Verwendung der Vorrichtung zur Kommutierung eines Elektromotors und einen Sensorkopf zur Erfassung von Materialeigenschaften an der Oberfläche eines Werkstücks. Das Sensorelement umfasst eine Vielzahl von Diamanten, die NV-Zentren oder andere paramagnetische Zentren umfassen. Diese Vielzahl von Diamanten weist eine unterschiedlicher Orientierung zueinander auf. Im Anwendungsfall eines Sensorkopfes weisen somit diese Vielzahl von Diamanten weist eine unterschiedliche räumliche Orientierung der Diamanten auch zum Sensorkopfgehäuse auf.

Die Erfindung betrifft ein Verfahren gemäss Anspruch 1 zur Herstellung eines Lichtwellenleiters (LWL) mit einem Sensorelement (SE), wobei das Sensorelement (SE) ein Trägermaterial (TM) aufweist und wobei in das Trägermaterial (TM) eine Vielzahl von Diamanten (DM) eingebettet sind und wobei einer oder mehrere oder alle Diamanten (DM) dieser Diamanten (DM) NV-Zentren (NVZ) und/oder andere paramagnetischen Zentren aufweisen und wobei die NV-Zentren (NVZ) des Sensorelements (SE) und/oder die anderen paramagnetischen Zentren des Sensorelements (SE) bei Bestrahlung mit Pumpstrahlung (LB) zumindest eine Fluoreszenzstrahlung (FL) emittieren. Die Erfindung ist dadurch gekennzeichnet, dass das Trägermaterial (TM) ein strahlungsgehärtetes Trägermaterial (TM) ist. Dies ermöglicht eine selbstjustierende Serienfertigung mit einem hohen Cₚₖ-Wert. Für die Funktionstüchtigkeit der damit aufgebauten Vorrichtungen ist es notwendig, dass das Trägermaterial (TM) für Strahlung mit einer Pumpstrahlungswellenlänge (λₚₘₚ) der Pumpstrahlung (LB), mit der die NV-Zentren (NVZ) und/oder die anderen paramagnetischen Zentren gepumpt werden, im Wesentlichen transparent ist und dass das Trägermaterial (TM) für Strahlung mit einer Fluoreszenzwellenlänge (λ_{fl}) der Fluoreszenzstrahlung (LB) der NV-Zentren (NVZ) und/oder die anderen paramagnetischen Zentren im Wesentlichen transparent ist.

Ein erfindungsgemäßes Verfahren zur Serienherstellung eines solchen, vorteilhaften Lichtwellenleiters (LWL), mit einem hohen Cₚₖ-Wert umfasst die Schritte a) Bereitstellen (140) eines Lichtwellenleiters (LWL), wobei der Lichtwellenleiter (LWL) ein erstes Ende und ein zweites Ende aufweist; b) Bereitstellen (145) eines flüssigen und mittels elektromagnetischer Strahlung einer Aushärtewellenlänge (λ_{H}) härtbaren Trägermaterials (TM), wobei in das Trägermaterial (TM) eine Vielzahl von Diamanten (DM) und/oder Kristalle eingebettet sind und wobei einer oder mehrere oder alle Diamanten (DM) dieser Diamanten (DM) und/oder Kristalle NV-Zentren (NVZ) und/oder andere paramagnetischen Zentren aufweisen und wobei die NV-Zentren (NVZ) des Trägermaterials (TM) und/oder die anderen paramagnetischen Zentren des Trägermaterials (TM) bei Bestrahlung mit Pumpstrahlung (LB) einer Pumpstrahlungswellenlänge (λₚₘₚ) zumindest eine Fluoreszenzstrahlung (FL) emittieren; c) Benetzen (150) des ersten Endes des Lichtwellenleiters (LWL), insbesondere auf eine Benetzungslänge LB oder in einem Benetzungsbereich, mit dem Trägermaterial (TM), das die Vielzahl eingebetteter Diamanten (DM) und/oder Kristalle aufweist; d) Bestrahlen (155) des Trägermaterials (TM) im Bereich des ersten Endes (ELWL1) des Lichtwellenleiters (LWL) mit elektromagnetischer Aushärtestrahlung, wobei die Wellenlänge dieser elektromagnetischen Strahlung, die Aushärtewellenlänge (λ_{H}), so gewählt ist, dass das Trägermaterial (TM) am ersten Ende (ELWL1) des Lichtwellenleiters (LWL) im bestrahlten Bereich zumindest teilweise aushärtet und sich zumindest teilweise in einen Festkörper wandelt; e) Entfernen (160) des nicht ausgehärteten Trägermaterials (TM), insbesondere mittels eines Lösungsmittels, wobei der verbleibende Film des Trägermaterials (TM) am ersten Ende des Lichtwellenleiters (LWL) das Sensorelement (SE) bildet. Erfindungsgemäss erfolgt ein Einspeisen (155) elektromagnetischer Aushärtestrahlung in das zweite Ende des Lichtwellenleiters (LWL), wobei die Wellenlänge dieser elektromagnetischen Strahlung, die Aushärtewellenlänge (λ_{H}), so gewählt ist, dass das Trägermaterial (TM) am ersten Ende des Lichtwellenleiters (LWL) aushärtet und sich in einen Festkörper wandelt. Dies hat den Vorteil, dass die Aushärtung des Trägermaterials (TM) am ersten Ende (ELWL1) des Lichtwellenleiters (LWL) zu einem Sensorelement (SE) selbstiustierend nur in dem Bereich des Lichtaustritts aus dem Lichtwellenleiter (LWL) erfolgt.

Es hat sich gezeigt, dass es vorteilhaft für die spätere Reinigung ist, wenn in einer weiteren Ausgestaltung des erfindungsgemäßen Verfahrens das Trägermaterial (TM) bei der Bestrahlung mit der Aushärtestrahlung der Aushärtewellenlänge (λ_{H}) nur teilweise aushärtet.

Für die Aushärtung gemäß dem vorbeschriebenen Verfahren sind relativ hohe Photonenenergien in der Regel je nach Trägermaterial (TM) vorteilhaft. Das erfindungsgemäße Verfahren sieht in einer weiteren Ausgestaltung daher vor, dass die Strahlung der der am zweiten Ende des Lichtwellenleiters zur Aushärtung eingespeisten Aushärtestrahlung UV-Strahlung mit einer Aushärtewellenlänge (λ_{H}) im Wellenlängenbereich von 1nm bis 400nm ist.

Für die Verbesserung der Selbstjustierung des Sensorelements (SE) gegenüber dem Lichtwellenleiter (LWL) ist es erfindungsgemäß vorteilhaft, wenn der bereitgestellte Lichtwellenleiter (LWL) zumindest am ersten Ende des Lichtwellenleiters (LWL) einen Lichtwellenleiterkern (LWLC) u.a. zu diesem Zweck aufweist und/oder zumindest am ersten Ende des Lichtwellenleiters (LWL) mit einer lichtundurchlässigen Schicht beschichtet ist, die eine oder mehrere lichtdurchlässige Öffnungen, die sogenannten Clearances, aufweist, und wobei diese Strukturen des Lichtwellenleiters (LWL), der Lichtwellenleiterkern (LWLC) und/oder die Clearances, den Lichtaustritt der Aushärtestrahlung mit der Aushärtewellenlänge (λ_{H}) am ersten Ende (ELWL1) des Lichtwellenleiters (LWL) bereichsweise auf einen oder mehrere Austrittsbereiche begrenzen und wobei das Verfahren in dem Trägermaterial (TM) beim Aushärten durch Einspeisung der Aushärtestrahlung mit der Aushärtewellenlänge (λ_{H}) am zweiten Ende (ELWL2) des Lichtwellenleiters (LWL) ein oder mehrere optische Funktionselemente (LWLL) und/oder ein oder mehrere Sensorelemente (SE) am ersten Ende (ELWL1) des Lichtwellenleiters (LWL) im Bereich des einen oder der mehreren Austrittsbereiche ausformt und wobei das eine oder die mehreren so durch das Verfahren ausgeformten optischen Funktionselement (LWLL) und/oder das eine oder die mehreren so durch das Verfahren ausgeformten Sensorelemente (SE) durch das Verfahren so eingerichtet werden, dass das eine oder die mehreren so durch das Verfahren ausgeformten optischen Funktionselement (LWLL) und/oder das eine oder die mehreren so durch das Verfahren ausgeformten Sensorelemente (SE)
- mit dem Lichtwellenleiterkern (LWLC) am ersten Ende (ELWL1) des Lichtwellenleiters (LWL) und/oder
- mit der einen oder den mehreren Clearances am ersten Ende (ELWL1) des Lichtwellenleiters (LWL), insbesondere durch das Verfahren selbstjustiert, optisch zusammenwirken,
- wenn am zweiten Ende (ELWL2) des Lichtwellenleiters (LWL) optische Strahlung, insbesondere Pumpstrahlung (LB) mit der Pumpstrahlungswellenlänge ( 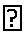 pmp) eingespeist wird und/oder
- wenn am ersten Ende (ELWL1) des Lichtwellenleiters (LWL) NV-Zentren (NVZ) innerhalb des Trägermaterials (TM) und/oder andere paramagnetische Zentren innerhalb des Trägermaterials (TM) eine Fluoreszenzstrahlung (FL) emittieren.

Erfindungsgemäß wurde erkannt, dass es für einige Anwendungsbeispiele sinnvoll ist, wenn der in dem Verfahren bereitgestellte Lichtwellenleiter (LWL) mit einem oder mehreren Wellenleitern (1380, 1880, 2380, 6880, 6980) beschichtet ist, die insbesondere Clearances aufweisen. Diese ermöglichen die Selbstjustierung der Sensorelemente gegenüber diesen Clearances und damit gegenüber dem Wellenleiter im erfindungsgemäßen Herstellungsverfahren.

Dem erfindungsgemäßen Lichtwellenleiter korrespondiert ein Verwendungsverfahren für diesen vorteilhaften Wellenleiter mit sehr guten Cpk-Werten der Messwerte, die solche Lichtwellenleiter in Sensorsystemen liefern. Das erfindungsgemäß vorgeschlagene Verfahren zum Bestimmen einer physikalischen Größe umfasst a) das Bereitstellen eines vorbeschriebenen, vorteilhaften erfindungsgemäßen Lichtwellenleiters (LWL),
wobei der bereitgestellte Lichtwellenleiter (LWL) mit einem oder mehreren Wellenleitern (1380, 1880, 2380, 6880, 6980) beschichtet ist, die Clearances aufweisen, und wobei sich in den Clearances des einen oder der mehreren Wellenleiter oder auf dem Wellenleiter und/oder in der Nähe des Wellenleiters (1380, 1880, 2380, 6880, 6980) ein oder mehrere Sensorelemente (SE) befinden und b) das Einspeisen eines Mikrowellensignals (µW) in einen oder mehrere der Wellenleiter (1380, 1880, 2380, 6880, 6980) und das Einspeisen einer Pumpstrahlung (LB) mit der Pumpstrahlungswellenlänge (λₚₘₚ) in den Lichtwellenleiter (LWL), insbesondere an dem zweiten Ende (ELWL2) des Lichtwellenleiters (LWL), oder das Bestrahlen des Sensorelements (SE) des Lichtwellenleiters (LWL) mit einer Pumpstrahlung (LB) mit der Pumpstrahlungswellenlänge (λₚₘₚ) und c) Erfassen eines Intensitätswerts der Fluoreszenzstrahlung (FL) der NV-Zentren (NVZ) des Sensorelements (SE) und/oder der anderen paramagnetischen Zentren des Sensorelements (SE) und das d) das Ermitteln zumindest eines Messwerts für eine physikalische Größe aus diesem Intensitätswert und ggf. weiterer Werte.

Ein anderes erfindungsgemäßes Verwendungsverfahren umfasst a) das Bereitstellen eines erfindungsgemäßen, vorteilhaften Lichtwellenleiters (LWL) und b) das Einspeisen einer Pumpstrahlung (LB) mit der Pumpstrahlungswellenlänge (λₚₘₚ) in den Lichtwellenleiter (LWL), insbesondere an dem zweiten Ende (ELWL2) des Lichtwellenleiters (LWL), oder das Bestrahlen des Sensorelements (SE) des Lichtwellenleiters (LWL) mit einer Pumpstrahlung (LB) mit der Pumpstrahlungswellenlänge (λₚₘₚ) und c) das Erfassen eines Intensitätswerts der Fluoreszenzstrahlung (FL) der NV-Zentren (NVZ) des Sensorelements (SE) und/oder der anderen paramagnetischen Zentren des Sensorelements (SE) und d) das Ermitteln zumindest eines Messwerts für eine physikalische Größe aus diesem Intensitätswert und ggf. weiteren Werten.

Im Rahmen der Ausarbeitung der Erfindung wurde erkannt, dass die Erfindung zur Verbesserung einer erfindungsgemäßen Magnetfeldkamera genutzt werden kann. Die Magnetfeldkamera umfasst eine Sensorelementschicht (5) als einem Sensorelement (SE), wobei das Sensorelement (SE) ein Trägermaterial (TM) aufweist und wobei in das Trägermaterial (TM) eine Vielzahl von Diamanten (DM) eingebettet sind und wobei einer oder mehrere oder alle Diamanten (DM) dieser Diamanten (DM) NV-Zentren (NVZ) und/oder andere paramagnetischen Zentren aufweisen und wobei die NV-Zentren (NVZ) des Sensorelements (SE) und/oder die anderen paramagnetischen Zentren des Sensorelements (SE) bei Bestrahlung mit Pumpstrahlung (LB) zumindest eine Fluoreszenzstrahlung (FL) emittieren. Vorzugsweise ist das Trägermaterial (TM) ein strahlungsgehärtetes Trägermaterial (TM), was eine Herstellung mit guten Cₚₖ-Werten ermöglich. Zur Funktionstüchtigkeit ist es erforderlich, dass das Trägermaterial (TM) für Strahlung mit einer Pumpstrahlungswellenlänge (λₚₘₚ) der Pumpstrahlung (LB), mit der die NV-Zentren (NVZ) und/oder die anderen paramagnetischen Zentren gepumpt werden, im Wesentlichen transparent ist und dass das Trägermaterial (TM) für Strahlung mit einer Fluoreszenzwellenlänge (λ_{fl}) der Fluoreszenzstrahlung (LB) der NV-Zentren (NVZ) im Wesentlichen transparent ist und dass die Magnetfeldkamera eine Fluoreszenzkamera, insbesondere ein Lichtsensorarray (1) und eine Optik (7), zur ortsaufgelösten Aufnahme eines Fluoreszenzbildes der Fluoreszenzstrahlung (FL) der NV-Zentren (NVZ) und/oder der anderen paramagnetischen Zentren mit mindestens 2x2 Pixeln umfasst.

Erfindungsgemäß ist in einer speziellen Ausprägung die Magnetfeldkamera dazu eingerichtet, ein Fluoreszenzbild zu erzeugen und das Fluoreszenzbild auszugeben. Die Magnetfeldkamera umfasst einen Speicher. Die Magnetfeldkamera ist in dieser Ausprägung dazu eingerichtet, das Fluoreszenzbild in diesem Speicher ab- oder zwischenzuspeichern und/oder bereitzuhalten und/oder aus dem Speicher auszugeben und/oder aus dem Speicher an ein übergeordnetes Rechnersystem zu übertragen.

In einer weiteren Ausprägung ist die Magnetfeldkamera dazu eingerichtet, ein computerimplementiertes Programm der künstlichen Intelligenz auszuführen, um digitalisierte und/oder binäre Messwerte und/oder Klassifikationen aus den aufgenommenen Fluoreszenzbildern der Magnetfeldkamera, insbesondere aus Fluoreszenzbildern im Speicher der Magnetfeldkamera, zu erzeugen und/oder auszugeben und/oder in einem Speicher der Magnetfeldkamera abzuspeichern und in dem Speicher der Magnetfeldkamera bereitzuhalten und/oder auszugeben und/oder an ein übergeordnetes Rechnersystem zu übermitteln .

In einer weiteren Ausprägung umfasst die Magnetfeldkamera einen Speicher in dem der Programmcode des computerimplementierten Programms der künstlichen Intelligenz zumindest zeitweise gespeichert ist und wobei ein Rechnersystem der Magnetfeldkamera den Programmcode bei Ausführung des computerimplementierten Programms der künstlichen Intelligenz aus diesem Speicher abruft und ausführt. Dem entspricht ein vorteilhaftes Computerprogrammprodukt, wobei das Computerprogrammprodukt zumindest ein Speichermedium umfasst und wobei in dem Speichermedium zumindest zeitweise die Information des Programmcodes des computerimplementierten Programms der künstlichen Intelligenz komprimiert und/oder nicht komprimiert und/oder verschlüsselt oder nicht verschlüsselt zumindest zeitweise gespeichert ist, und wobei das Speichermedium des Computerprogrammprodukts dazu eingerichtet ist, Teil des Speicher der Magnetfeldkamera zu werden, in dem der Programmcode des computerimplementierten Programms der künstlichen Intelligenz zumindest zeitweise gespeichert ist, oder zumindest einen Teil seines Inhalts in den Speicher der Magnetfeldkamera, in dem der Programmcode des computerimplementierten Programms der künstlichen Intelligenz zumindest zeitweise gespeichert ist, zu übertragen.

Ein anderes erfindungsgemäßes Ausführungsbeispiel betrifft eine Motorsteuerung für einen Motor, wobei der Motor und/oder die Ansteuerung des Motors einen erfindungsgemäßen Lichtwellenleiter umfasst und/oder wobei die Ansteuerung des Motors eine erfindungsgemäße Magnetfeldkamera umfasst und/oder wobei Ansteuerung des Motors dazu eingerichtet ist, ein erfindungsgemäßes Computerprogrammprodukt zu verwenden.

Dem zugeordnet ist ein erfindungsgemäßes Verfahren zur Kommutierung eines Motors mit den Schritten a) des Erfassens der Zeitpunkte der Nulldurchgänge des Phasenstromes einer Motorphase des Motors mittels eines erfindungsgemäßen Verfahrens und/oder das b) des Erfassens der Zeitpunkte der Nulldurchgänge des Betrags der magnetischen Flussdichte innerhalb des Luftspalts (LS) des Motors mittels eines erfindungsgemäßen Verfahrens, wobei das Sensorelement (SE) im Luftspalt (LS) des Motors und/oder im Streufeld des magnetischen Feldes im Luftspalt (LS) des Motors angeordnet ist und c) des Steuerns der Kommutierung der Phasenspannungen der Phasenanschlüsse der Motorphasenwicklungen in Abhängigkeit von den Zeitpunkten der Nulldurchgänge.

Die hohe Qualität der erfindungsgemäßen Lichtwellenleiter (LWL9 ermöglicht die Serienproduktion hochqualitativer Lichtwellenleiterproduktionsmengen, wobei die Lichtwellenleiterproduktionsmenge mehrere Lichtwellenleiter (LWL) umfasst und wobei der Lichtwellenleiter (LWL) der mehreren Lichtwellenleiter (LWL) mit einem Sensorelement (SE) versehen ist und wobei das Sensorelement (SE) ein Trägermaterial (TM) aufweist und wobei in das Trägermaterial (TM) eine Vielzahl von Diamanten (DM) und/oder Kristalle eingebettet sind und wobei einer oder mehrere oder alle Diamanten (DM) dieser Diamanten (DM) und/oder einer oder mehrere Kristalle dieser Kristalle NV-Zentren (NVZ) und/oder andere paramagnetischen Zentren aufweisen und wobei die NV-Zentren (NVZ) des Sensorelements (SE) und/oder die anderen paramagnetischen Zentren des Sensorelements (SE) bei Bestrahlung mit Pumpstrahlung (LB) einer Pumpstrahlungswellenlänge (λₚₘₚ) einer vorbestimmten Pumpstrahlungsintensität über den Lichtwellenleiter (LWL) zumindest eine Fluoreszenzstrahlung (FL) emittieren. Die erfindungsgemäße Lichtwellenleiterproduktionsmenge ist dadurch gekennzeichnet, dass diese Lichtwellenleiterproduktionsmenge dieser Lichtwellenleiter (LWL) 10 oder mehr Lichtwellenleiter (LWL) umfasst und dass das hier maßgebliche Toleranzfenster der Intensität der Fluoreszenzstrahlung (FL) der besagten bei Bestrahlung mit Pumpstrahlung (LB) einer Pumpstrahlungswellenlänge (λₚₘₚ) einer vorbestimmten Pumpstrahlungsintensität über den Lichtwellenleiter (LWL) 10% des Mittelwerts der gemessenen Intensitäten der Fluoreszenzstrahlung (FL) der verschiedenen Lichtwellenleiter der Lichtwellenleiterproduktionsmenge bei der besagten Bestrahlung des Sensorelements (SE) mit Pumpstrahlung (LB) der Pumpstrahlungswellenlänge (λₚₘₚ) der vorbestimmten Pumpstrahlungsintensität beträgt, wobei die Bestrahlung die Bestrahlung für die Vermessung des jeweiligen Lichtwellenleiters (LWL) über den jeweiligen Lichtwellenleiter (LWL) erfolgt, und dass der Cₚₖ-Wert dieser gemessenen Intensitäten der Fluoreszenzstrahlung (FL) der verschiedenen Lichtwellenleiter (LWL) der Lichtwellenleiterproduktionsmenge bei der besagten Bestrahlung des Sensorelements (SE) mit Pumpstrahlung (LB) der Pumpstrahlungswellenlänge (λₚₘₚ) der vorbestimmten Pumpstrahlungsintensität bezogen auf das besagte maßgebliche Toleranzfenster einen Cₚₖ-Wert höher als Cₚₖ=0,8 und/oder besser höher als Cₚₖ=1,0 und/oder besser höher als Cₚₖ=1,2 und/oder besser höher als Cₚₖ=1,4 und/oder besser höher als Cₚₖ=1,66 beträgt. Diese hohen Cₚₖ-Werte sind für eine erfolgreiche Serienproduktion unverzichtbar.

In analoger Weise beschreibt da hier vorgelegte Dokument eine hochqualitative erfindungsgemäße Wellenleiterproduktionsmenge, wobei die Wellenleiterproduktionsmenge mehrere Wellenleiter (1380, 1880, 2380, 6880, 6980) umfasst und wobei jeder Wellenleiter (1380, 1880, 2380, 6880, 6980) der Wellenleiter (1380, 1880, 2380, 6880, 6980) mit einem Sensorelement (SE) versehen ist und wobei das jeweilige Sensorelement (SE) ein Trägermaterial (TM) aufweist und wobei in das jeweilige Trägermaterial (TM) eine Vielzahl von Diamanten (DM) und/oder Kristallen eingebettet sind und
wobei einer oder mehrere oder alle Diamanten (DM) dieser Diamanten (DM) und/oder einer oder mehrere Kristalle dieser Kristall NV-Zentren (NVZ) und/oder andere paramagnetischen Zentren aufweisen und wobei die NV-Zentren (NVZ) des Sensorelements (SE) und/oder die anderen paramagnetischen Zentren des Sensorelements (SE) bei Bestrahlung mit Pumpstrahlung (LB) einer Pumpstrahlungswellenlänge (λₚₘₚ) einer vorbestimmten Pumpstrahlungsintensität zumindest eine Fluoreszenzstrahlung (FL) emittieren. Die erfindungsgemäße Wellenleiterproduktionsmenge ist dadurch gekennzeichnet, dass diese Wellenleiterproduktionsmenge dieser Wellenleiter (1380, 1880, 2380, 6880, 6980) 10 oder mehr Wellenleiter (1380, 1880, 2380, 6880, 6980) umfasst und dass das hier maßgebliche Toleranzfenster der Intensität der Fluoreszenzstrahlung (FL) der besagten bei Bestrahlung mit Pumpstrahlung (LB) einer Pumpstrahlungswellenlänge (λₚₘₚ) einer vorbestimmten Pumpstrahlungsintensität über einen Lichtwellenleiter (LWL) oder über eine für jeden Wellenleiter gleiche Lichtübertragungsstrecke 10% des Mittelwerts der gemessenen Intensitäten der Fluoreszenzstrahlung (FL) der verschiedenen Wellenleiter (1380, 1880, 2380, 6880, 6980) der Wellenleiterproduktionsmenge bei der besagten Bestrahlung des Sensorelements (SE) mit Pumpstrahlung (LB) der Pumpstrahlungswellenlänge (λₚₘₚ) der vorbestimmten Pumpstrahlungsintensität beträgt, wobei die Bestrahlung für die Vermessung des jeweiligen Wellenleiters über jeweils pro Wellenleiter den Lichtwellenleiter (LWL) oder über die für jeden Wellenleiter gleiche Lichtübertragungsstrecke erfolgt und dass der Cₚₖ-Wert dieser gemessenen Intensitäten der Fluoreszenzstrahlung (FL) der verschiedenen Wellenleiter der Wellenleiterproduktionsmenge bei der besagten Bestrahlung des Sensorelements (SE) mit Pumpstrahlung (LB) der Pumpstrahlungswellenlänge (λₚₘₚ) der vorbestimmten Pumpstrahlungsintensität bezogen auf das besagte maßgebliche Toleranzfenster einen Cₚₖ-Wert höher als Cₚₖ=0,8 und/oder besser höher als Cₚₖ=1,0 und/oder besser höher als Cₚₖ=1,2 und/oder besser höher als Cₚₖ=1,4 und/oder besser höher als Cₚₖ=1,66 beträgt. Diese hohen Cₚₖ-Werte sind für eine erfolgreiche Serienproduktion unverzichtbar.

### Stand der Technik

Aus der DE 10 2020 129 367 A1 ein System bekannt, bei dem vorgesehen ist, die Auswerteelektronik eines ähnlichen Systems direkt auf dem Stator zu positionieren. Bei der Ausarbeitung des hier in diesem Dokument vorgelegten Vorschlags wurde erkannt, dass die technische Lehre der DE 10 2020 129 367 A1 anfällig für EMV-Störungen ist und ein Problem mit der galvanischen Trennung und der Temperaturbelastung verursacht. Der hier vorgelegte Vorschlag löst diese Probleme.

Aus der DE 10 2020 109 477 A1 sind Methoden zur Produktion von NV-Zentren bekannt.

Aus der DE 10 2019 120 076 A1, der DE 11 2020003 569 A5, der DE 11 2020004650 A5, der DE 10 2021 101 565 A1, der DE 10 2021132 782 A1und der EP 3 874 343 A2 sind bereits leitungsfreie Vorrichtungen zur Erfassung von Magnetfeldern bekannt. Die zeigen keine selbstjustierenden Vorrichtungen. Aus der Schrift Ilja Fescenko, Andrey Jarmola, Igor Savukov, Pauli Kehayias, Janis Smits, Joshua Damron, Nathaniel Ristoff, Nazanin Mosavian und Victor M. Acosta "Diamond magnetometer enhanced by ferrite flux concentrators", Phys. Rev. Research 2, 023394, 24 June 2020, DOl:https://doi.org/10.1103/PhysRevResearch.2.023394 ist die Verwendung eines dichroitischen Spiegels für die Trennung von Pumpstrahlung und Fluoreszenzstrahlung bekannt.

Aus dem Dokument Georgios Chatzidrosos, Joseph Shaji Rebeirro, Huijie Zheng, Muhib Omar, Andreas Brenneis, Felix M. Stürner, Tino Fuchs, Thomas Buck, Robert Rölver, Tim Schneemann, Peter Blümler, Dmitry Budker, Arne Wickenbrock, "Fiberized Diamond-Based Vector Magnetometers" Front. Photon., 20 August 2021, Sec. Quantum Optics, Volume 2 - 2021 | https://doi.org/10.3389/fphot.2021.732748 und aus dem Dokument Yuji Hatano, Jaewon Shin, Daisuke Nishitani, Haruki Iwatsuka, Yuta Masuyama, Hiroki Sugiyama, Makoto Ishii, Shinobu Onoda, Takeshi Ohshima, Keigo Arai, Takayuki Iwasaki, Mutsuko Hatano, "Simultaneous thermometry and magnetometry using a fiber-coupled quantum diamond sensor" Appl. Phys. Lett. 118, 034001 (2021) https://doi.org/10.1063/5.0031502 ist die Übertragung der Pumpstrahlung zur Anregung von NV-Zentren eines Einkristalls mittels Lichtwellenleiter bekannt.

Die Web-Seite https://de.wikipedia.org/wiki/Lichtwellenleiter offenbart weitere Informationen über Lichtwellenleiter.

Alle diese Schriften lösen nicht das Problem, wie das Sensorelement des Lichtwellenleiters beschaffen sein soll um eine Stabilität aufzuweisen, die den thermischen Anforderungen beispielsweise für den Einsatz in einem Motor oder einem Sensorkopf geeignet ist. Bei den Verfahren im Stand der Technik werden die Diamanten an das Ende einer Glasfaser als Lichtwellenleiter geklebt. Dieser Fabrikationsschritt bedarf typischerweise einer sorgfältigen Ausrichtung der Diamanten, um eine gute Ankopplung zu erreichen. Auch sollten alle Diamanten mit NV-Zentren in gleicher Weise mit Pumpstrahlung der Pumpstrahlungswellenlänge λₚₘₚ im Betrieb bestrahlt werden. Diamanten die nicht ausreichend bestrahlt werden, zeigen nicht den vollen Kontrast hinsichtlich der Abhängigkeit der Intensität der Fluoreszenzstrahlung ihrer paramagnetischen Zentren, hier der NV-Zentren, von einem umgebenden Magnetfeld.

Ein wesentliches Problem ist dabei die Erzielung eines guten Cₚₖ-Werts für die Eigenschaften des Lichtwellenleiters, der mit NV-Zentren an einem seiner Enden bestückt ist. Bei Quantensensorsystemen mit einer Verwendung von Mikrowellen und/oder Radiowellen werden in der Regel Wellenleiter wie beispielsweise Mikrostreifenleitungen, Schlitzelitunge, Tri-Plate-Leitungen, differenzielle Mikrostreifenleitungen und differenzielle Tri-Plate-Leitungen und noch komplexere Streifenleitungssysteme eingesetzt. Der Wellenleiterbereich, in dem die NV-Zentren und/oder paramagnetischen Zentren von Kristallen und/oder Diamanten eines Sensorelements mit einem solchen Wellenleiter wechselwirken, weist bei einer definierten Bestrahlung mit einer Pumpstrahlung, die auch den Intensitätswert 0 haben kann, aufgrund einer abweichenden Permittivität ε des Trägermaterials des Sensorelements, in das diese Kristalle und/oder Diamanten eingebettet sind, und , aufgrund der abweichenden Permittivität ε dieser Kristalle und/oder dieser Diamanten einen anderen Wellenwiderstand als der Rest des Wellenleiters, der nicht von dem Sensorelement bedeckt ist auf. Ein wesentliches Problem ist dabei die Erzielung eines guten Cₚₖ-Werts für den Wellenwiderstand des Abschnittst des Wellenleiters der von dem Sensorelement bedeckt ist. Nur solche guten Cpk-Werte ermöglichen letztlich eine Serienproduktion mit zuverlässigen, hoch qualitativen Ergebnissen und Ausbeuten. Diese Fragestellungen sind im Stand der Technik noch vollkommen unbearbeitet. Eine entsprechende Literatur konnte trotz Recherche nicht aufgefunden werden. Das hier vorgestellte Dokument schlägt hier eine nacharbeitbare beispielhafte Lösung vor und wendet diese auf verschiedene Anwendungsbeispiele an.

Die vorbenannten Schriften lösen dieses Problem nicht. Auch erfordert die Platzierung der NV-Zentren in richtiger Art und Weise hochqualifiziertes Personal, das teuer und nicht immer verfügbar ist.

Ein immer wieder auftauchendes Problem ist die Erkennung von Rissen und anderen Störungen in Oberflächen von ferromagnetischen Werkstücken. Im Stand der Technik sind zwar entsprechende Messmethoden bekannt. Diese zeigen aber nur eine unzureichende Ortsauflösung um kleine Risse detektieren zu können.

Das hier vorgelegte Dokument gibt nur kurze Stichpunkte zur Prinzip für zerstörungsfreie Werkstoffprüfung hinsichtlich des Stands der Technik.

Für die Vermessung von Werkstücken mittels Magnetfeldmessung ergeben sich bei der Verwendung von Hallsensoren / -spulen zur Messung von magnetischen Streufeldern / Wirbelstromfeldern die Probleme, dass diese Messmethoden ein großes Messvolumen bei einem limitierter Abstand zum Werkstück und einen großen Messquerschnitt aufweisen. Die entsprechenden Vorrichtungen sind nicht Diamagnetisch und verändern daher das Messobjekt, das Magnetfeld.

Dem soll das hier vorgestellte Verfahren und die hier vorgestellte Vorrichtung abhelfen.

Aus der Schrift WO 2022 096 891 A1 ist ein Sensor bekannt, der einen Magneten umfasst. Gemäß der technischen Lehre der WO 2022 096 891 A1 ist der Magnet so angeordnet, dass er ein inhomogenes Magnetfeld an ein bestimmtes Volumen anlegt. Der Sensor der WO 2022 096 891 A1 umfasst drüber hinaus ein Magnetometer mit einem aktiven Element zum Erfassen des Magnetfelds in einem Volumen, das das bestimmte Volumen umfasst.

Aus der Schrift CN 1 14 994 006 A ist ein Detektionssystem für orthogonale Risse auf der Basis der NV-Farbzentrumserfassungstechnologie bekannt. Das Detektionssystem der CN 1 14 994 006 A umfasst ein Erregungsende, ein Sammelende und ein Magnetisierungserfassungsvorderende. Die technische Lehre der

CN 1 14 994 006 A verwendet das Anregungsende zur Erzeugung von Anregungslicht, wobei das Anregungslicht auf das vordere Ende des Magnetisierungssensors wirkt. Das vordere Ende des Magnetisierungssensors umfasst einen Magnetisierungsteil und einen Erfassungsteil, wobei der Magnetisierungsteil zum Magnetisieren eines zu erfassenden ferromagnetischen Gegenstands verwendet wird. Der Magnetisierungsteil der Vorrichtung der CN 1 14 994 006 A umfasst ein Magnetisierungsintervall. Wenn ein Riss auf dem zu erfassenden ferromagnetischen Gegenstand in dem Magnetisierungsintervall positioniert ist, kann die Vorrichtung der CN 1 14 994 006 A ein magnetisches Streufeld an dem Riss erzeugen. Der Erfassungsteil der Vorrichtung der CN 1 14 994 006 A erzeugt eine Spannungsfluoreszenz unter der Wirkung des Anregungslichts und des magnetischen Streufelds. Der der Erfassungsteil der Vorrichtung der CN 1 14 994 006 A dient zum Empfangen der Spannungsfluoreszenz und zum Analysieren und Verarbeiten der Spannungsfluoreszenz. Der Magnetisierungsteil der CN 1 14 994 006 A umfasst zwei Gruppen von Elektromagneten. Die Magnetisierungsrichtungen der beiden Gruppen von Elektromagneten der Vorrichtung der CN 1 14 994 006 A sind orthogonal zueinander. Der Sensorteil der Vorrichtung der CN 1 14 994 006 A umfasst eine optische Sensorfaser, ein Endteil der optischen Sensorfaser ist ein Erfassungsende, und diamantförmige NV-Farbmittelteilchen, die an dem Faserkern befestigt sind, sind an der Endfläche des Erfassungsendes angeordnet.

Aus der Schrift CN 1 12 146 782 A ist ein Verfahren zur Herstellung einer faseroptischen Quantensonde mit kontrollierbarer Diamantpartikeldotierung bekannt. Das Verfahren der CN 1 12 146 782 A umfasst die folgenden Schritte:
Schritt 1) Mischen der Lösung mit einer wässrigen Nano-Diamantpartikel-Lösung, die NV-Farbzentren enthält;
Schritt 2) Auflösen der hergestellten Lösung, die mit den Nano-Diamantpartikeln, die die NV-Farbzentren enthalten, dotiert ist, mit Ultraschall durch ein Sol-Gel-Verfahren, Versiegeln und Stehenlassen der Lösung und vollständiges Hydrolysieren der Lösung, um Sol-Gel zu bilden; und
3) gleichmäßiges Auftragen des in Schritt 2) hergestellten Sol-Gels auf die Endfläche der optischen Faser, Halten der optischen Faser durch einen Schrittmotor, Kontaktieren der Endfläche der optischen Faser mit dem Sol-Gel, Ziehen der Endfläche der optischen Faser mit einer bestimmten Geschwindigkeit nach einer Zeitspanne, um einen halbkugelförmigen Gelfilm mit einer bestimmten Dicke und einer bestimmten Krümmung zu bilden, und Aushärten, um die hergestellte Quantensonde der optischen Faser zu erhalten. Laut der technischen Lehre der CN 1 12 146 782 A kann die Dotierungskonzentration der Nanodiamantteilchen, die NV-Farbzentren enthalten, gesteuert werden. Laut der technischen Lehre der CN 1 12 146 782 A sind die Nanodiamantteilchen gleichmäßig gemischt. Die Schrift CN 1 12 146 782 A gibt an, dass der Herstellungsprozess der Sonde einfach ist, seine Wiederholbarkeit ist hoch ist und dass eine Massenproduktion realisiert werden kann.

Aus der Schrift CN 1 14 720 553 A ist eine Vorrichtung zur Erkennung des Streuflusses in einer Pipeline bekannt. Die Vorrichtung der CN 1 14 720 553 A basiert auf einer optischen Faser, die ein Diamant-Stickstoff-Vakanz-Farbzentrum ankoppelt.

Auch diese Schriften lösen das Problem der notwendigen Selbstjustage des Materials des Sensorelements mit den Kristallen, die die paramagnetischen Zentren und/oder NV-Zentren aufweisen, gegenüber dem Lichtwellenleiter nicht.

Das chinesische Patentdokument CN 1 12 146 782 A beschreibt ein Verfahren zur Herstellung einer optischen Faser-Quanten-Sonde mit kontrollierbarer Dotierungskonzentration von Nano-Diamantpartikeln, die NV-Farbzentren enthalten. Das Verfahren der CN 1 12 146 782 A umfasst drei Schritte: Zunächst wird eine Lösung hergestellt, indem eine wässrige Nano-Diamantpartikel-Lösung mit NV-Farbzentren mit einer weiteren Lösung gemischt wird. Anschließend wird gemäß der CN 1 12 146 782 A die Lösung mittels eines Sol-Gel-Verfahrens ultraschallunterstützt aufgelöst, versiegelt, stehengelassen und vollständig hydrolysiert, um ein Sol-Gel zu bilden. Im letzten Schritt wird laut der CN 1 12 146 782 A das vorbereitete Sol-Gel gleichmäßig auf die Stirnfläche einer optischen Faser aufgetragen. Mithilfe eines Schrittmotors wird die Faser in Kontakt mit dem Sol-Gel gebracht und anschließend mit einer definierten Geschwindigkeit gezogen, um eine hemisphärische Gelschicht mit einstellbarer Dicke (200-300 Mikrometer) und Krümmung (62,5-300 Mikrometer) zu erzeugen. Die Gelschicht wird entsprechend der technischen Lehre der CN 1 12 146 782 A ausgehärtet, um die Quanten-Sonde zu vervollständigen. Laut der CN 1 12 146 782 A ermöglicht das Verfahren der CN 1 12 146 782 A eine präzise Kontrolle der Dotierungskonzentration, gewährleistet eine homogene Verteilung der Nano-Diamantpartikel und bietet eine hohe Reproduzierbarkeit, wodurch sich die Herstellung für eine Massenproduktion eignet. Das Verfahren ist jedoch nicht selbstjustierend.

Das russische Patentdokument RU 190 347 U1 beschreibt einen integrierten optischen Faser-Quanten-Sensor mit einem Mikrowellen-Kanal zur Temperatur- und Magnetfeldmessung. Der Sensor der RU 190 347 U1 umfasst eine optische Faser, an deren Ende mindestens ein Diamantkristall mit Stickstoff-ersetzten Leerstellen befestigt ist. Auf der Oberfläche der optischen Faser des Dokuments RU 190 347 U1 befindet sich eine zweidrahtige metallische Mikrowellenleitung, die in Form eines offenen Rings um das Faserende gebogen ist. Die Mikrowellenleitung des Dokuments RU 190 347 U1 besteht aus einer submikronen Metallhaftschicht, die mit der optischen Faser in Kontakt steht, und einer leitfähigen Metallschicht mit einer Dicke von mindestens 2 Mikrometern, die aus hochleitfähigen Metallen wie Silber oder Kupfer gefertigt ist. Die Haftschicht des Dokuments RU 190 347 U1 kann aus Metallen wie Nickel, Chrom oder Titan bestehen und wird durch Magnetronsputtern aufgebracht. Die leitfähige Schicht wird ebenfalls durch Magnetronsputtern erzeugt. Die zweidrahtige Mikrowellenleitung und die Antenne am Faserende werden laut des Dokuments RU 190 347 U1 mithilfe von Laser-Photolithografie geformt. Laut des Dokuments RU 190 347 U1 ist der Sensor kompakt, robust und ermöglicht zuverlässige Temperatur- und Magnetfeldmessungen selbst in schwer zugänglichen Bereichen. Die optische Faser kann laut des Dokuments RU 190 347 U1 als mikrostrukturierte oder mehrkanalige Faser ausgeführt sein, was ihre Funktionalität laut des Dokuments RU 190 347 U1 erweitert.

Das deutsche Patentdokument DE102021101565A1 offenbart ein Magnetometer zur präzisen Messung magnetischer Flussdichten. Das Magnetometer der DE102021101565A1 umfasst ein Sensorelement, das mindestens einen Quantenpunkt enthält, vorzugsweise eine Vielzahl von NV-Zentren in einem Diamantkristall. Bei Bestrahlung mit Pumpstrahlung, die von einer Pumpstrahlungsquelle ausgesendet wird, emittiert das Sensorelement der DE102021101565A1 Fluoreszenzstrahlung. Die Intensität dieser Fluoreszenzstrahlung hängt laut der technischen Lehre der DE102021101565A1 von der magnetischen Flussdichte am Ort des Sensorelements ab. Ein Strahlungsempfänger wandelt gemäß der technischen Lehre der DE102021101565A1 die Fluoreszenzstrahlung in ein Empfängerausgangssignal um, dessen Wert von der Intensität oder einem anderen Parameter der Fluoreszenzstrahlung abhängt. Die Auswertung erfolgt laut der DE102021101565A1 durch Auswertemittel, die das Signal erfassen, speichern und verarbeiten. Der Schaltungsträger, an dem die Komponenten mechanisch befestigt und elektrisch verbunden sind, besteht laut der DE102021101565A1 aus einem transparenten Material, das die Durchleitung von Pump- und Fluoreszenzstrahlung ermöglicht. Optional kann der Schaltungsträger laut der DE102021101565A1 mit elektrischen Leitungen oder Funktionskomponenten ausgestattet sein.

Das deutsche Patentdokument DE102014208527A1 beschreibt ein Verfahren zur Steuerung eines elektronisch kommutierten Elektromotors, der aus einem Rotor mit einer Rotorwelle und einem Stator mit mindestens zwei Spulen besteht. Die Spulen werden laut des Patentdokuments DE102014208527A1 über elektronische Schalter, die von einem Steuerelement betätigt werden, zeitlich variabel mit Strom versorgt. Zur Bestimmung der Rotorposition wird laut des Patentdokuments DE102014208527A1 ein einzelner Magnetfeldsensor verwendet, der die Lage des Rotors relativ zum Stator erfasst und einen ersten Messwert an das Steuerelement übermittelt. Zusätzlich wird laut des Patentdokuments DE102014208527A1 die von einer unbestromten Spule durch die Bewegung des Rotors erzeugte elektromagnetische Kraft gemessen. Aus dieser Kraft wird ein zweiter Messwert ermittelt, der ebenfalls die Rotorlage beschreibt und dem Steuerelement zur Verfügung gestellt wird. Durch den Vergleich beider Messwerte können laut des Patentdokuments DE102014208527A1 Abweichungen erkannt und eine Fehlerdiagnose erstellt werden. Das Verfahren ermöglicht laut des Patentdokuments DE102014208527A1 eine ausfallsichere Steuerung, selbst bei einem Ausfall des Magnetfeldsensors, indem die Rotorlage allein aus der elektromagnetischen Kraft bestimmt wird.

Das chinesische Patentdokument CN110554332B offenbart einen faseroptischen Magnetfeldsensor und dessen Herstellungsverfahren. Der Sensor des Patentdokuments CN110554332B umfasst eine optische Faser mit mehreren Diamant-Mikrosäulen, die sich an einem Ende der Faser befinden. Jede Mikrosäule enthält laut des Patentdokuments CN110554332B ein Stickstoff-Fehlstellen-Zentrum (NV-Zentrum). Die optische Faser ist laut des Patentdokuments CN110554332B hohl, um die Integration der Diamant-Mikrosäulen zu ermöglichen. Zur Magnetfeldmessung wird laut des Patentdokuments CN110554332B das Ende der Faser mit den Diamant-Mikrosäulen in das zu messende Magnetfeld eingebracht. Ein Laser mit voreingestellter Wellenlänge wird laut des Patentdokuments CN110554332B am gegenüberliegenden Ende der Faser eingekoppelt, um die NV-Zentren zur Emission von Fluoreszenz anzuregen. Gleichzeitig wird laut des Patentdokuments CN110554332B ein Frequenzkehrsignal im Bereich von 2,8 bis 2,94 GHz an das Faserende gesendet. Die Fluoreszenz wird laut des Patentdokuments CN110554332B entweder auf derselben oder der gegenüberliegenden Seite gesammelt, und durch Analyse der Intensitätsänderungen der Fluoreszenz in Abhängigkeit von der Frequenz des Kehrsignals wird die Größe des Magnetfelds bestimmt. Das Herstellungsverfahren umfasst laut des Patentdokuments CN110554332B das Einbringen einer wässrigen Lösung, die die Diamant-Mikrosäulen enthält, in das hohle Faserende. Nach dem Trocknen entsteht laut des Patentdokuments CN110554332B ein Magnetfeldsensor mit hoher Sensitivität, die direkt mit der Dichte der NV-Zentren korreliert. Die Mikrosäulen können laut des Patentdokuments CN110554332B durch verschiedene Verfahren wie Ätzen, Detonation oder Ionenimplantation hergestellt werden.

Ein Prospekt des Fraunhofer-Instituts für Silicatforschung "UV Curable Ormocer Coatings" ( Internet 24. Oktober 2020 (2020-10-24), Seite 1-2, abrufbar unter URL:https://web.archive.org/web/20201024060815/https://www.isc.fraunhofer.de/content/dam/isc/de/docu ments/Publikationen/UV_curable_ORMOCER_coatings.pdf ) beschreibt sogenannte ORMOCER^{®}-Beschichtungssysteme, die auf Hybrid-Polymer-Nanokompositen basieren. Diese UV-härtbaren Beschichtungen ermöglichen laut des FhG-Prospekts funktionelle Oberflächeneigenschaften und optimieren Materialeigenschaften mit minimalem Materialeinsatz. Sie eignen sich laut des FhG-Prospekts für empfindliche Substrate und erfordern keine Vakuum- oder thermischen Nachbehandlungsprozesse. Die Beschichtungen können laut des FhG-Prospekts mit Standardverfahren wie Sprühen, Tauchen oder Spin-Coating aufgetragen werden und sind laut des FhG-Prospekts für kontinuierliche Prozesse mit Geschwindigkeiten von bis zu 300 m/min geeignet. Sie lassen sich laut des FhG-Prospekts auch durch Tintenstrahldruck oder Siebdruck auf strukturelle Anwendungen anpassen. Anwendungen umfassen laut des FhG-Prospekts kratzfeste Beschichtungen für Kunststoffoberflächen, gassensitive Schutzbeschichtungen für optische Fasern sowie umweltfreundliche Barrieren gegen Öl-, Fett- und Wasserwanderung auf Papier oder Polymerfolien. Die Beschichtungen sind laut des FhG-Prospekts mechanisch robust, abriebfest und beständig gegen Hitze bis 250 °C. Sie sind laut des FhG-Prospekts für verschiedene Substrate wie PMMA, PC, Glas und andere geeignet. ORMOCER^{®}-Beschichtungen bieten laut des FhG-Prospekts hohe Anpassungsfähigkeit durch vielfältige Hybridpolymer-Zusammensetzungen und fördern laut des FhG-Prospekts durch umfassende Testmöglichkeiten und Entwicklungsunterstützung eine effiziente Markteinführung neuer Produkte.

Keine der hier genannten Schriften offenbart eine Möglichkeit der selbstjustierenden Fertigung.

### Aufgabe

Dem Vorschlag liegt daher die Aufgabe zugrunde, eine Lösung für die obige Probleme
a) der notwendigen thermischen und galvanischen Trennung und
b) der Justage der Kristalle gegenüber dem Kern der Glasfaser bzw. dem Lichtwellenleiter und
c) eines geeigneten Verfahrens zur Herstellung eines geeigneten Lichtwellenleiters mit hohem Cpk-Wert in der Serienproduktion.
anzugeben.

Diese Aufgabe wird durch den unabhängigen Anspruch gelöst. Weitere Ausgestaltungen sind Gegenstand von Unteransprüchen.

### Lösung der Aufgabe

Vier beispielhafte Anwendungen des vorschlagsgemäßen Lichtwellenleiters LWL mit einem selbstjustierendem Sensorelement SE sind
- die Vermessung eines Magnetfelds mittels eines Sensorkopfes (erstes Anwendungsbeispiel) und/oder
- die Vermessung eines Magnetfelds in einem Motor (zweites Anwendungsbeispiel) und/oder
- die Verwendung in einer Magnetfeldkamera als Sensorschicht 5 (drittes Anwendungsbeispiel) und/oder
- die Verwendung in einem Wellenleiter insbesondere zusammen mit einer Magnetfeldkamera (viertes Anwendungsbeispiel) zur Vermessung physikalischer Größen, wie unbekannter Signalfrequenzen ωₙₖ und/oder Beträge magnetischer Flussdichten und/oder Stromwerte elektrischer Ströme in Leitungen (z.B. 1330) und/oder Temperaturen und/oder Spannungen und oder indirekt ermittelbarer Größen wie Drücken und/oder mechanischen Spannungen und oder Ortskoordinaten und/oder Geschwindigkeiten und/oder Beschleunigungen und/oder Gravitationsbeschleunigungen und/oder Rotationsgeschwindigkeiten und/oder Winkelpositionen und/oder Rotationsbeschleunigungen und/oder Schallsignalen und/oder Ultraschallsignalen und/oder Spektren.

Die Verwendungen des vorschlagsgemäßen Lichtwellenleiters **LWL** mit einem selbstjustierendem Sensorelement **SE** sind hierauf aber nicht auf diese Anwendungsbeispiele beschränkt.

Im Sinne des hier vorgelegten handelt es sich bei einem Lichtwellenleiter **LWL** typischerweise um einen dielektrischen Wellenleiter beliebiger Formgebung. Der Lichtwellenleiter **LWL** kann ein oder mehrere dielektrische Schichten aufweisen. Insbesondere kann der Lichtwellenleiter **LWL** einen Lichtwellenleiterkern **LWLC** als eine solche dielektrische Schicht aufweisen. Bevorzugt weisen mehrere dielektrische Schichten eines Lichtwellenleiter **LWL** verschiedene Brechungsindizes und/oder dielektrische Materialkonstanten ε ihres Materials auf, sodass an den Grenzflächen zwischen diesen dielektrischen Schichten des jeweiligen Lichtwellenleiters **LWL** eine Reflexion auftritt.

Im Folgenden beschreibt das hier vorgelegte Dokument die Anwendung des vorgeschlagenen Lichtwellenleiters **LWL** mit einem selbstjustierenden Sensorelement **SE** in verschiedenen Anwendungsbeispielen.

Insbesondere beschreibt das hier vorliegende Dokument als erstes Anwendungsbeispiel die Verwendung des vorschlagsgemäßen Lichtwellenleiters **LWL** in einem Sensorkopf **SK.**

Insbesondere beschreibt das hier vorliegende Dokument als zweites Anwendungsbeispiel die Verwendung des vorschlagsgemäßen Lichtwellenleiters **LWL** in einem elektrischen Motor und zwar insbesondere zur Steuerung der Kommutierung dieses Motors. Da ein Vier-Quadranten-Betrieb des Motors mitumfasst sein soll ist die Verwendung dieses Motors als Generator elektrischer Energie vom Begriff Motor im Sinne des hier vorgelegten Dokuments mitumfasst.

Das hier vorgelegte Dokument schlägt für solche und andere Anwendungen des vorgeschlagenen Lichtwellenleiters mit einem selbstjustierenden Sensorelement **SE** mit ähnlichen Messaufgaben einen Lichtwellenleiter **LWL** mit einem selbstjustieren Sensorelement **SE** und ein Verfahren zu dessen Herstellung vor. Dabei weist das Sensorelement **SE** ein Trägermaterial **TM** auf, in dem eine Vielzahl von Diamanten DM eingebettet sind. Ein oder mehrere oder alle Diamanten DM dieser Diamanten **DM** weisen dabei ein oder mehrere NV-Zentren **NVZ** und/oder ein oder mehrere andere paramagnetischen Zentren auf. Die NV-Zentren **NVZ** des Sensorelements **SE** und/oder die anderen paramagnetischen Zentren des Sensorelements **SE** emittieren bei Bestrahlung mit Pumpstrahlung LB zumindest eine Fluoreszenzstrahlung FL. Das Besondere des in dem hier vorgelegten Dokument vorgeschlagenen Lichtwellenleiter ist, dass das Trägermaterial TM ein mittels elektromagnetischer Strahlung ausgehärtetes Trägermaterial TM ist und dass das Trägermaterial TM nach dem Aushärten für Strahlung mit einer Pumpstrahlungswellenlänge λₚₘₚ der Pumpstrahlung LB, mit der die NV-Zentren NVZ und/oder die anderen paramagnetischen Zentren gepumpt werden, im Wesentlichen transparent ist. Im Wesentlichen bedeutet dabei, dass die unzweifelhaft auftretenden Verluste immer noch so gering sind, dass die Funktionsfähigkeit der betreffenden Anwendung immer noch gegeben ist. In gleicherweise sollte das Trägermaterial TM für Strahlung mit einer Fluoreszenzwellenlänge λ_{fl} der Fluoreszenzstrahlung LB der NV-Zentren im Wesentlichen transparent sein. Im Wesentlichen bedeutet dabei wiederum, dass die unzweifelhaft auftretenden Verluste immer noch so gering sind, dass die Funktionsfähigkeit der betreffenden Anwendung immer noch gegeben ist. Durch die Aushärtung eines zuvor flüssigen Trägermittels TM ist die Fertigung eines solchen Lichtwellenleiters LWL besonders einfach und prozesssicher mit einem hohen Cₚₖ-Wert zu fertigen.

Die hier vorgelegte Schrift schlägt als ein erstes beispielhaftes Anwendungsbeispiel eine Vorrichtung zur Erfassung der magnetischen Flussdichte B in der Nähe einer Störung einer ferromagnetischen Oberfläche vor.

Die hier vorgelegte Schrift schlägt als ein zweites beispielhaftes Anwendungsbeispiel eine Vorrichtung zur Erfassung der magnetischen Flussdichte B in einem Luftspalt LS und/oder im Streufeld BSTR des Luftspalts LS eines Motors vor.

Bei einem Sensorkopf der vorgeschlagenen Art gemäß dem ersten Anwendungsbeispiel wird die Aufgabe vorschlagsgemäß dadurch gelöst, dass
- dass der Sensorkopf NV-reichen Diamantstaub als Magnetfeldsensor verwendet und
- dass Permanentmagnete oder -spulen (AC oder DC Magnetfelder) des Sensorkopfes ein magnetisches Prüffeld erzeugen, das in die Oberfläche des Werkstücks eindringt, und
- dass das Diamantmaterial des Diamantstubs an einem Faserende eines Lichtwellenleiters das Sensorelement bildet und
- dass der Sensorkopf eine rein optische Vermessung des Magnetfelds und damit der magnetischen Eigenschaften der Oberfläche des Werkstücks über den Lichtwellenleiter ermöglicht.

Bei einem Motor der vorgeschlagenen Art gemäß dem zweiten Anwendungsbeispiel weist der Motor ein Gehäuse (GHR, GH) auf.

Des Weiteren weisen die Vorrichtungen der Anwendungsbeispiele der hier vorgestellten technischen Lehre, hier der der Motor und der Sensorkopf **SK,** jeweils ein Sensorelement **SE** mit einem Trägermittel **TM** auf. In das Trägermittel **TM** sind vorzugsweise eine Vielzahl von Diamanten **DM** eingebettet. Bevorzugt umfasst das Trägermaterial **TM** Glas und/oder einen ausgehärteten Kunststoff und/oder ein anderes optisch transparentes Material. Das Trägermaterial **TM** fixiert die Diamanten **DM** und verhindert eine Repositionierung der Diamanten **DM.** Bevorzugt ist das Trägermaterial **TM** nach der Verfestigung im Herstellungsprozess für elektromagnetische Strahlung mit der Pumpstrahlungswellenlänge **λₚₘₚ** der Pumpstrahlung **LB** für die paramagnetischen Zentren und/oder NV-Zentren NVZ in den Diamanten **DM** transparent, um das Pumpen dieser paramagnetischen Zentren und/oder NV-Zentren zu ermöglichen. Bevorzugt ist das Trägermaterial **TM** nach der Verfestigung im Herstellungsprozess für elektromagnetische Strahlung mit der Fluoreszenzwellenlänge **λ_{fl}** der Fluoreszenzstrahlung **FL** der paramagnetischen Zentren und/oder der NV-Zentren **NVZ** in den Diamanten **DM** in den Diamanten **DM** transparent. Einer oder mehrere oder alle Diamanten **DM** dieser Diamanten **DM** weisen typischerweise paramagnetische Zentren und/oder NV-Zentren **NVZ** auf.

In dem ersten Anwendungsbeispiel wirkt die magnetische Flussdichte B auf die auf die paramagnetische Zentren und/oder NV-Zentren **NVZ** des Sensorelements **SE** ein. In dem zweiten Anwendungsbeispiel umfasst der vorschlagsgemäße Motor umfasst vorzugsweise einen Rotor und einen Stator. Ein Luftspalt **LS** trennt den Rotor vom Stator. Der Rotor ist um eine Achse **AX** drehbar gegenüber dem Stator gelagert. Die magnetische Flussdichte **B** in dem Luftspalt LS und/oder im Streufeld **BSTR** des Luftspalts **LS** des Motors wirkt auf die paramagnetische Zentren und/oder NV-Zentren **NVZ** ein. Typischerweise bewirkt ein steigender Betrag der magnetischen Flussdichte **B** eine Reduktion der Intensität der Fluoreszenzstrahlung **FL.**

In dem ersten Anwendungsbeispiel verfügt der Sensorkopf **SK** bevorzugt über einen Lichtwellenleiter **LWL** für den Zutritt von Pumpstrahlung LB einer Pumpstrahlungsquelle **PL** zu dem Sensorelement SE.

In dem zweiten Anwendungsbeispiel besitzt das Gehäuse GH des Motors vorzugsweis eine erste Öffnung **OF** für den Zutritt von Pumpstrahlung **LB** einer Pumpstrahlungsquelle **PL** zu dem Sensorelement SE

Die Pumpstrahlung **LB** besitzt bei Verwendung von NV-Zentren in Diamant als paramagnetischen Zentren des Sensorelements **SE** bevorzugt eine Pumpstrahlungswellenlänge λₚₘₚ in einem Wellenlängenbereich von 400 nm bis 700 nm Wellenlänge und/oder besser 450 nm bis 650 nm und/oder besser 500 nm bis 550 nm und/oder besser 515 nm bis 540 nm aufweisen. Bevorzugt ist dabei eindeutig eine Wellenlänge von 532 nm als Pumpstrahlungswellenlänge **λₚₘₚ**. Im Falle von NV-Zentren in Diamant oder in Diamanten ist eine Laser-Diode der Fa. Osram vom Typ PLT5 520B beispielsweise als Pumpstrahlungsquelle **PL1** mit 520nm Pumpstrahlungswellenlänge λₚₘₚ geeignet. Die NV-Zentren **NVZ** des Sensorelements **SE** emittieren typischerweise bei Bestrahlung mit Pumpstrahlung **LB** der oben beschriebenen Pumpstrahlungswellenlänge λₚₘₚ eine Fluoreszenzstrahlung **FL** mit einer typischen Fluoreszenzwellenlänge **λ_{fl}** von ca. 637nm bei NV-Zentren. Andere Wellenlängen können durch plasmonische Kopplung mit metallischen Nanokristallen in dem Trägermaterial **TM** erreicht werden. Die optischen Eigenschaften paramagnetischen Zentren im Sensorelement SE, hier der NV-Zentren **NVZ,** können durch Kombination der Nanodiamanten bzw. Diamanten **DM** bzw. Kristalle im Trägermaterial **TM** mit metallischen Nanopartikeln modifiziert werden.

In dem ersten Anwendungsbeispiel transportiert ein zweiter Lichtwellenleiter **LWL** bevorzugt die Fluoreszenzstrahlung **FL** des Sensorelements **SE** zu einem Fotodetektor **PD** hin

In dem zweiten Anwendungsbeispiel weist das Gehäuse **GH** des Motors bevorzugt eine zweite Öffnung **OF** für den Austritt von Fluoreszenzstrahlung **FL** des Sensorelements **SE** zu einem Fotodetektor **PD** hin auf.

Die vorgeschlagene Vorrichtung weist darüber hinaus vorzugsweise eine Teilvorrichtung, insbesondere einen dichroitischen Spiegel **F1,** auf, um die Fluoreszenzstrahlung **FL** von der Pumpstrahlung **LB** zu trennen, sodass im Wesentlichen nur Fluoreszenzstrahlung **FL** und möglichst keine Pumpstrahlung **LB** auf den Fotodetektor **PD** fällt. Diese Teilvorrichtung in Form eines Filters **F1 oder** dichroitischen Spiegel lässt die Passage von Strahlung mit der Fluoreszenzwellenlänge **λ_{fl}** der Fluoreszenzstrahlung **FL -** z.B. 637nm bei NV-Zentren **NVZ** mit einem Phononenseitenband von 637nm bis 850 nm - in Richtung des Fotodetektors **PD** passieren, während es die Strahlung mit der Pumpstrahlungswellenlänge **λₚₘₚ** der Pumpstrahlung **LB** der Pumpstrahlungsquelle **PL** und somit die modulierte Pumpstrahlung **LB** nicht passieren lässt oder so führt, dass sie den Fotodetektor **PD** nicht trifft oder beeinflusst. Der Fotodetektor **PD** wandelt das Intensitätssignal der Fluoreszenzstrahlung **FL** in ein Empfängerausgangsignal **S0**.

In dem ersten Anwendungsbeispiel wertet die Vorrichtung das Empfängerausgangssignal **S0** aus, um Informationen über die Verzerrung des Magnetfelds **B** eines Permanentmagneten **PM** durch Risse **RI** und/oder Vertiefungen in der Oberfläche eines ferromagnetischen Materials **FM.** Die vorgeschlagene Vorrichtung hat in dem ersten Anwendungsbeispiel dann den Vorteil, dass das Magnetfeld der Risse **RI** und/oder Vertiefungen in der Oberfläche eines ferromagnetischen Materials **FM** durch Zuleitungen wie z.B. bei der Magnetfeldmessung mit Hall-Sensoren nicht gestört wird. Des Weiteren ist das Sensorelement **SE** vollkommen diamagnetisch. Eine Rückwirkung der Magnetfelder und/oder von Störfeldern auf die Auswertelektronik des Sensorsystems über das Sensorelement **SE** und den Lichtwellenleiter **LWL** ist wegen der galvanischen Trennung sehr unwahrscheinlich. Dadurch kann das System auch in Hochspannungssystemen mit Vorrichtungsteilen, die mit sehr hohen Spannungen angetrieben werden, eingesetzt werden. Systeme aus dem Stand der Technik zeigen dies nicht.

In dem zweiten Anwendungsbeispiel wertet die Vorrichtung das Empfängerausgangssignal S0 aus, um Informationen über die Position des magnetischen Feldes B im Motor zu erlangen oder Informationen zu erlangen, die diese Information über die Position des magnetischen Feldes B im Motor umfassen. Die vorgeschlagene Vorrichtung in dem zweiten Anwendungsbeispiel hat den Vorteil, dass das Magnetfeld des Motors durch Zuleitungen wie z.B. bei der Magnetfeldmessung mit Hall-Sensoren nicht gestört wird. Des Weiteren ist das Sensorelement vollkommen diamagnetisch. Eine Rückwirkung der Motorfelder auf die Auswertelektronik des Sensorsystems über das Sensorelement und den Lichtwellenleiter LWL ist wegen der galvanischen Trennung sehr unwahrscheinlich. Dadurch kann das System auch in Hochspannungssystemen mit Motoren, die mit sehr hohen Spannungen angetrieben werden, eingesetzt werden. Ebenso ist das System für Generatoren in Kraftwerken geeignet. Systeme aus dem Stand der Technik zeigen dies nicht. So ist aus der DE 10 2020 129 367 A1 ein System bekannt, bei dem vorgesehen ist, die Auswerteelektronik direkt auf dem Stator zu positionieren. bei der Ausarbeitung des hier in diesem Dokument vorgelegten Vorschlags wurde erkannt, dass die technische Lehre der DE 10 2020 129 367 A1 anfällig für EMV-Störungen ist und ein Problem mit der galvanischen Trennung und der Temperaturbelastung verursacht. Der hier vorgelegte Vorschlag hat diese Probleme dies nicht.

In einer ersten Variante in dem zweiten Anwendungsbeispiel befinden sich bevorzugt befinden sich paramagnetische Zentren und/oder NV-Zentren **NVZ** des Sensorelements **SE** nicht nur im Streufeld des Luftspalts, sondern im Luftspalt **LS** des Motors selbst. Dies ermöglicht ein besseres Signal und präzisere Messwerte mit geringeren Störungen.

In einer zweiten Variante der vorschlagsgemäßen Vorrichtung sind die Diamanten **DM** im Trägermaterial **TM** im Wesentlichen zueinander unterschiedlich mit einer jeweils im Wesentlichen unterschiedlichen Orientierung orientiert. Dies hat den wesentlichen und ganz massiven fertigungstechnischen Vorteil, dass eine Ausrichtung der Diamanten **DM** nicht mehr notwendig ist und die das Herstellverfahren zur Herstellung des Sensorelements **SE** beispielsweise Diamantpulver mit einer sehr großen Anzahl sehr kleiner Diamanten **DM** verwenden kann. Ein Sensorelement **SE** mit einer solchen ungeordneten Vielzahl von Diamanten **DM** hat den Vorteil, dass die Messung der magnetischen Flussdichte **B** isotrop ist. Das bedeutet, dass das Sensorelement **SE** nur den Betrag der magnetischen Flussdichte **B** erfasst, nicht jedoch die Richtung.

Dies hat in dem ersten Anwendungsbeispiel den Vorteil, dass eine Ausrichtung des Sensorelements **SE** und des Lichtwellenleiters **LWL** und des Sensorkopfes **SK** nicht mehr notwendig ist.

Dies hat in dem zweiten Anwendungsbeispiel den Vorteil, dass eine Ausrichtung des Sensorelements **SE** und des Lichtwellenleiters **LWL** im Motor nicht mehr notwendig ist.

Die Montage eines solchen Sensorelements **SE** können Hilfskräfte oder wenig präzise maschinelle Vorrichtungen übernehmen, die in dem ersten Anwendungsbeispiel das Sensorelement **SE** mit dem Lichtwellenleiter **LWL** beispielsweise nur in den Kanal **KN** des Sensorkopfes **SK** stecken müssen und die in dem zweiten Anwendungsbeispiel das Sensorelement **SE** mit dem Lichtwellenleiter **LWL** beispielsweise nur in eine dafür vorgesehene Öffnung OF am Motor stecken müssen.

Hierdurch sinken die Fertigungskosten für Vorrichtungen, die den vorgeschlagenen Lichtwellenleiter LWL nutzen, wie in dem ersten Anwendungsbeispiel der Sensorkopf **SK** und in dem zweiten Anwendungsbeispiel der Motor. Um die räumliche Isotropie zu erreichen, ist es daher vorteilhaft, wenn die Orientierung der Diamanten **DM** stochastisch im Wesentlichen gleichverteilt ist.

Im Zuge der Ausarbeitung der technischen Lehre dieses Dokuments hat die Anmelderin erkannt, dass es entsprechend den vorausgehenden Ausführungen auch vorteilhaft ist, wenn in dem ersten Anwendungsbeispiel das Sensorelement **SE** sich im Streufeld **BSTR** des Magnetfelds des Permanentmagneten **PM** befindet. Statt eines Permanentmagneten sind andere Feldanregungen denkbar. Diese sind im Sinne des hier vorgelegten Dokuments von der Beschreibung "Permanentmagnet **PM"** umfasst.

Im Zuge der Ausarbeitung der technischen Lehre dieses Dokuments hat die Anmelderin erkannt, dass es entsprechend den vorausgehenden Ausführungen auch vorteilhaft ist, wenn in dem zweiten Anwendungsbeispiel das Sensorelement **SE** sich im Luftspalt **LS** oder im Streufeld **BSTR** des Luftspalts **LS** des Motors befindet.

Um die Anzahl der Lichtwellenleiter **LWL** zu minimieren und die Modifikationen an der Vorrichtung, die den vorschlagsgemäßen Lichtwellenleiter **LWL** nutzt, hier beispielhaft der Sensorkopf **SK** bzw. der Motor, gering zu halten, ist es vorteilhaft einen einzigen Lichtwellenleiter **LWL** für die Zuführung der Pumpstrahlung **LB** der Pumpstrahlungsquelle **PL** zum Sensorelement **SE** und für die Rückführung der Fluoreszenzstrahlung **FL** vom Sensorelement **SE** zum Fotodetektor **PD** zu benutzen.

In dem Fall eines einzigen Lichtwellenleiters **LWL** ist in dem ersten Anwendungsbeispiel des Sensorkopfes **SK** nur ein einziger Kanal **KN** für die Montage des Lichtwellenleiters **LWL** notwendig, sodass dann der erste Kanal **KN** mit dem zweiten Kanal **KN** identisch ist. Der folgende Text bezeichnet dann einen solchen Kanal **KN** als gemeinsamen Kanal **KN.**

In dem Fall eines einzigen Lichtwellenleiters **LWL** ist in dem zweiten Anwendungsbeispiel des Motors nur eine einzige Öffnung **OF** für die Montage des Lichtwellenleiters **LWL** notwendig, sodass dann die erste Öffnung **OF** mit der zweiten Öffnung **OF** identisch ist. Der folgende Text bezeichnet dann eine solche Öffnung **OF** als gemeinsame Öffnung **OF.**

Somit umfasst die vorschlagsgemäße Vorrichtung, hier beispielhaft der Sensorkopf **SK** und der Motor, bevorzugt ein Sensorelement **SE** mit einer Vielzahl von Diamanten **DM** mit paramagnetischen Zentren und/oder **NV**-Zentren **NVZ** in einem Trägermaterial **TM** und einen ersten Lichtwellenleiter **LWL,** an dem das Sensorelement **SE** befestigt ist, wobei der Lichtwellenleiter **LWL** die Pumpstrahlung **LB** der Pumpstrahlungsquelle **PL** zu dem Sensorelement **SE** transportiert, sodass die Pumpstrahlung **LB** das Sensorelement **SE** bestrahlt und die paramagnetischen Zentren und/oder NV-Zentren **NVZ** Fluoreszenzstrahlung **FL** abgeben, die der Lichtwellenleiter **LWL** erfasst und in Richtung auf den Fotodetektor **PD** zurücktransportiert.

In dem ersten Anwendungsbeispiel des Sensorkopfes **SK** kann der Lichtwellenleiter **LWL** dabei parallel zur Auflagefläche **AF** des Sensorkopfes **SK** eingebracht werden, wobei sich dann das Sensorelement SE bevorzugt im Streufeld der Risse **RI** und/oder Vertiefungen in der Oberfläche eines ferromagnetischen Materials **FM** befindet. Der Lichtwellenleiter **LWL** kann aber auch senkrecht zur Auflagefläche **AF** des Sensorkopfes **SK** mittels eines senkrechten Kanals in den Sensorkopf eingebracht werden und in die Nähe der Auflagefläche **AF** vorgeschoben werden, sodass das Sensorelement **SE** dann die magnetische Flussdichte **B** im Streufeld der Risse **RI** und/oder Vertiefungen in der Oberfläche des ferromagnetischen Materials **FM** erfasst. Das Sensorelement **SE** kann auch bis zur unmittelbaren Nähe der Auflagefläche **AF** des Sensorkopfes **SK** vorgeschoben werden, wobei dann aber das Problem auftaucht, dass die Wahrscheinlichkeit einer Beschädigung im Messbetrieb des Sensorkopfes SK durch eine Bewegung längs der Auflagefläche **AF** des Sensorkopfes **SK** steigt.

In dem zweiten Anwendungsbeispiel des Motors kann der Lichtwellenleiter **LWL** kann dabei parallel zur Achse AX des Motors eingebracht werden, wobei sich dann das Sensorelement **SE** bevorzugt im Streufeld des Luftspalts LS befindet. Der Lichtwellenleiter **LWL** kann aber auch senkrecht zur Rotationsachse **AX** mittels einer Bohrung in das Blechpaket des Stators zwischen die Nuten, in denen die Stäbe der Stator-Spulen **SL** eingelegt sind eingebracht und bis zum Luftspalt vorgeschoben werden, sodass das Sensorelement **SE** dann die magnetische Flussdichte **B** in einer Stator-Spule SL erfasst. Das Sensorelement **SE** kann auch bis in den Luftspalt vorgeschoben werden, wobei dann aber das Problem auftaucht, dass die Wahrscheinlichkeit einer Beschädigung im Betrieb des Motors durch eine Bewegung oder Schwingung beweglicher Komponenten des Motors oder unterschiedliche thermische Ausdehnungskoeffizienten steigt.

Sofern die Rückführung der Fluoreszenzstrahlung **FL** vom Sensorelement **SE** zum Fotodetektor **PD** separat von der Hinführung der Pumpstrahlung **LB** zum Sensorelement **SE** erfolgen soll, umfasst in diesem Fall die vorschlagsgemäße Vorrichtung, hier also beispielsweise der der Sensorkopf **SK** bzw. der Motor, bevorzugt einen zweiten Lichtwellenleiter **LWL,** der Fluoreszenzstrahlung **FL** des Sensorelements **SE** erfasst, und die Fluoreszenzstrahlung **FL** in Richtung des Fotodetektors **PD** transportiert.

Wie oben ausgeführt, ist jedoch bevorzugt der erste Lichtwellenleiter **LWL** mit dem zweiten Lichtwellenleiter **LWL** identisch. Das hier vorgelegte Dokument bezeichnet im Folgenden einen solchen Lichtwellenleiter **LWL** als gemeinsamen Lichtwellenleiter **LWL.** Ein solche gemeinsamer Lichtwellenleiter **LWL** spart Kalibrationsaufwand und reduziert die Montagekomplexität und spart Material und ist daher vorteilhaft. Insbesondere werden die notwendigen Modifikationen an der vorschlagsgemäßen Vorrichtung, hier beispielhaft am Sensorkopf **SK** bzw. m Motor, selbst reduziert.

Der erste Lichtwellenleiter **LWL** weist ein erstes Ende und ein zweites Ende auf.

Der zweite Lichtwellenleiter **LWL** weist ebenfalls ein erstes Ende und ein zweites Ende auf. Der gemeinsame Lichtwellenleiter **LWL** weist ebenso ein erstes Ende und ein zweites Ende auf.

Das hier vorgelegte Dokument schlägt nun vor, das Sensorelement **SE** an dem ersten Ende des ersten Lichtwellenleiters **LWL** und/oder an dem ersten Ende des zweiten Lichtwellenleiters **LWL** und/oder an dem ersten Ende des gemeinsamen Lichtwellenleiters **LWL** zu befestigen, um die optische Kopplung zwischen Lichtwellenleiter **LWL** und Sensorelement **SE** zu stabilisieren.

Wenn nun das erste Ende des ersten und/oder der zweiten oder des gemeinsamen Lichtwellenleiters **LWL** von dem Trägermaterial **TM** des Sensorelements **SE** umhüllt ist, ergibt sich eine besonders gute Stabilisierung dieser optischen Kopplung.

Bevorzugt bildet dabei eine erste Endfläche **EF1** des ersten Endes des ersten und/oder der zweiten oder des gemeinsamen Lichtwellenleiters **LWL** eine erste ebene Endfläche **EF1.** Bevorzugt bildet dabei eine erste Endfläche **EF1** des ersten Endes des ersten und/oder der zweiten oder des gemeinsamen Lichtwellenleiters **LWL** eine erste ebene Endfläche **EF1** senkrecht zur Mittenlinie **ML** des Lichtwellenleiters **LWL.** Die Mittelline **ML** entspricht typischerweise der optischen Achse des Lichtwellenleiters **LWL.** Der Lichtwellenleiter **LWL** kann auch eine Form aufweisen. Eine solche ebene erste Endfläche **EF1** ermöglicht eine verbesserte Auskopplung der elektromagnetischen Pumpstrahlung **LB** aus dem Lichtwellenleiter **LWL** und eine verbesserte optische Einkopplung der Fluoreszenzstrahlung **FL** in den Lichtwellenleiter **LWL.** Bevorzugt ist der Abstand eines oder bevorzugt mehrerer Diamanten **DM** von dieser ersten ebenen Endfläche **EF1** kleiner als die Pumpstrahlungswellenlänge λₚₘₚ und/oder besser kleiner als ½ der Pumpstrahlungswellenlänge λₚₘₚ, und/oder besser kleiner als 1/4 der Pumpstrahlungswellenlänge λₚₘₚ, und/oder besser kleiner als 1/8 der Pumpstrahlungswellenlänge λₚₘₚ, und/oder besser kleiner als 1/10 der Pumpstrahlungswellenlänge λₚₘₚ, und/oder besser kleiner als 1/20 der Pumpstrahlungswellenlänge λₚₘₚ, und/oder besser kleiner als 1/50 der Pumpstrahlungswellenlänge λₚₘₚ, und/oder besser kleiner als 1/100 der Pumpstrahlungswellenlänge λₚₘₚ, , und/oder besser kleiner als 1/200 der Pumpstrahlungswellenlänge λₚₘₚ, und/oder besser kleiner als 1/500 der Pumpstrahlungswellenlänge λₚₘₚ, und/oder besser kleiner als 1/1000 der Pumpstrahlungswellenlänge λₚₘ

Die Mittenlinie **ML,** die eine gedachte Hilfskonstruktion zur Verdeutlichung des Sachverhalts ist, durchstößt die erste Endfläche **EF1** an einem Mittelpunkt **MP** der ersten Endfläche **EF1.** Bei einem längsgestreckten Lichtwellenleiter **LWL** mit einem Lichtwellenleiterkern **LWLC ,** also beispielsweise einer Glasfaser und/oder einer Gradientenglasfaser und/oder einer Monomodeglasfaser, ist bevorzugt die Dicke **dl** des Trägermaterials **TM** ist bevorzugt an diesem Mittelpunkt **MP** dicker ist als die Dicke **dr** an anderen Punkten der ersten Endfläche **EF1** des ersten Endes des ersten und/oder der zweiten oder des gemeinsamen Lichtwellenleiters **LWL.** Dies hat den Vorteil, dass Licht durch die Grenzfläche Trägermaterial **TM/** Luft in den Lichtwellenleiter **LWL** zurückgespiegelt wird und dass dann die Effizienz und der Wirkungsgrad steigt. Diese Anforderung kann durch ein selbstjustierendes Sensorelement **SE** besonders einfach erfüllt werden. Ein Herstellungsverfahren für ein solches Sensorelement SE, wie es das hier vorgelegte Dokument offenbart, erfüllt diese Anforderung typischerweise besonders einfach und kostengünstig. Die Erfüllung dieser Anforderung stellt im Falle eines einem längsgestreckten Lichtwellenleiters **LWL** mit einem Lichtwellenleiterkern **LWLC ,** also beispielsweise einer Glasfaser und/oder einer Gradientenglasfaser und/oder einer Stufenindex- oder Gradientenindexfaser und/oder einer Monomodeglasfaser und/oder ein Lichtwellenleiter auf Basis eines photonischen Kristalls, sicher, dass zum Ersten eine optimale Auskopplung der Pumpstrahlung **LB** aus dem Lichtwellenleiterkern **LWLC** des Lichtwellenleiters **LWL** in das Trägermaterial **TM** des Sensorelements **SE** und damit in die im Trägermaterial TM eingebetteten Kristalle,, insbesondere die Diamanten DM, insbesondere die Diamant-Nano-Kristalle, die vorzugsweise die paramagnetischen Zentren und/oder NV-Zentren aufweisen,

Bevorzugt formt daher das Trägermaterial **TM** am ersten Ende **ELWL1** eine faserförmigen und/oder zylindrischen und längserstreckten Lichtwellenleiters **LWL** eine Linse **LWLL** aus. Der Durchmesser **DLWLL** der Linse **LWLL** ist typischerweise kleiner als der Durchmesser **DLWL** des solchen faserförmigen und/oder zylindrischen und längserstreckten Lichtwellenleiters **LWL.** Der Durchmesser **DLWLL** der Linse **LWLL** kann aber auch so groß wie der der Durchmesser **DLWL** eines solchen faserförmigen und/oder zylindrischen und längserstreckten Lichtwellenleiters **LWL** sein, was aber nach den Erfahrungen bei der Ausarbeitung der technischen Lehre dieses Dokuments nicht optimal ist.

Bevorzugt ist der der erste Lichtwellenleiter **LWL** im Bereich der Anwendungsvorrichtung, also hier beispielsweise im Falle des ersten Anwendungsbeispiels im Bereich des Sensorkopfes **SK** und/oder innerhalb Sensorkopfes **SK** und im Falle des zweiten Anwendungsbeispiels im Bereich des Motors und/oder innerhalb des Motors, ganz oder teilweise durch eine mechanische Hülle **MH** umhüllt. Die mechanische Hülle **MH** kann dem Zweck des mechanischen Schutzes des ersten Lichtwellenleiter **LWL** und/oder der Abschirmung vor Umgebungslicht und/oder der Abschirmung vor externen magnetischen und/oder elektromagnetischen Feldern haben. Die mechanische Hülle **MH** kann das Sensorelement **SE** umschließen. Dies ist insbesondere dann von Vorteil, wenn die zu erfassende Größe, innerhalb der mechanischen Hülle, beispielsweise in einem mikrofluidischen Funktionselement erzeugt wird.

Bevorzugt ist der der zweite Lichtwellenleiter **LWL** im Bereich im Bereich der Anwendungsvorrichtung, also hier beispielsweise im Falle des ersten Anwendungsbeispiels im Bereich des Sensorkopfes **SK** und/oder innerhalb Sensorkopfes **SK** und im Falle des zweiten Anwendungsbeispiels im Bereich des Motors und/oder innerhalb des Motors, ganz oder teilweise ebenfalls durch eine zweite mechanische Hülle **MH** umhüllt. Die zweite mechanische Hülle **MH** kann dem Zweck des mechanischen Schutzes des zweiten Lichtwellenleiters **LWL** und/oder der Abschirmung vor Umgebungslicht und/oder der Abschirmung vor externen magnetischen und/oder elektromagnetischen Feldern haben.

Bevorzugt ist der der gemeinsame Lichtwellenleiter **LWL** im Bereich im Bereich der Anwendungsvorrichtung, also hier beispielsweise im Falle des ersten Anwendungsbeispiels im Bereich des Sensorkopfes **SK** und/oder innerhalb Sensorkopfes **SK** und im Falle des zweiten Anwendungsbeispiels im Bereich des Motors und/oder innerhalb des Motors, ganz oder teilweise in gleicher Weise durch eine mechanische Hülle **MH** umhüllt.

Die mechanische Hülle **MH** stützt den jeweiligen Lichtwellenleiter **LWL** typischerweise mechanisch. Die mechanische Hülle **MH** stützt und schützt typischerweise den jeweiligen Lichtwellenleiter **LWL** gegen die rauen Bedingungen innerhalb und außerhalb der Anwendungsvorrichtung, also hier im ersten Anwendungsbeispiel des Sensorkopfes **SK** und im zweiten Anwendungsbeispiel des Motors.

Die mechanische Hülle **MH** sollte in thermisch und/oder chemischen belastenden Umgebungen innerhalbe der Anwendungsvorrichtung, also beispielsweise im ersten Anwendungsbeispiel innerhalb des Sensorkopfes **SK** und im zweiten Beispiel innerhalb des Motors, in der Regel besondere Anforderungen hinsichtlich thermischer und chemischer Stabilität gegen Hitze und Betriebsflüssigkeiten erfüllen. Die mechanische Hülle **MH** ist daher bevorzugt aus Glas oder Keramik oder dergleichen gefertigt. Ganz besonders bevorzugt umfasst die mechanische Hülle ein mechanisch flexibles Material, beispielsweise ein Gewebe, beispielsweise ein Glasgewebe.

Die mechanische Hülle **MH** weist daher bevorzugt einen Keramikwerkstoff oder ein anderes nicht magnetisierbares und/oder elektrisch nichtleitendes Material und/oder ein bei Temperaturen oberhalb von 100°C stabiles Material und/oder ein bei Temperaturen oberhalb von 140°C stabiles Material und/oder ein bei Temperaturen oberhalb von 170°C stabiles Material und/oder ein bei Temperaturen oberhalb von 200°C stabiles Material und/oder ein bei Temperaturen oberhalb von 250°C stabiles Material oder umfasst diese oder besteht aus diesen im Extremfall. Hierdurch kann die jeweilige Anwendungsvorrichtung, hier beispielsweise in dem ersten Anwendungsbeispiel der Sensorkopf und im zweiten Anwendungsbeispiel der Motor, auch bei hohen externen und/oder internen Temperaturen eingesetzt werden. Im Falle des ersten Anwendungsbeispiels eines Sensorkopfes **SK** kann dies beispielsweise eine hohe Temperatur des ferromagnetischen Materials **FM** betreffen. Die mechanische Hülle **MH** kann also aus einem Keramikwerkstoff oder aus einem anderen nicht magnetisierbaren und/oder elektrisch nichtleitendes Material und/oder aus einem bei Temperaturen oberhalb von 100°C stabilen Material und/oder aus einem bei Temperaturen oberhalb von 140°C stabilen Material und/oder aus einem bei Temperaturen oberhalb von 170°C stabilen Material und/oder aus einem bei Temperaturen oberhalb von 200°C stabilen Material und/oder aus einem bei Temperaturen oberhalb von 250°C stabilen Material gefertigt sein.

Bevorzugt ist die mechanische Hülle **MH** zumindest abschnittweise ein Rohr oder Röhrchen oder eine Kapillare oder eine Kanüle, in die der jeweilige Lichtwellenleiter **LWL** beispielsweise hineingeschoben sein kann. Dies vereinfacht die Fertigung des Systems aus Lichtwellenleiter **LWL,** Sensorelement **SE** und mechanischer Hülle MH. Der Innendurchmesser **Dro** eines solchen Rohrs oder eines solchen Röhrchens oder einer solchen Kapillare oder einer solchen Kanüle ist bevorzugt nur ein Wenig größer als der Durchmesser der Lichtwellenleiterlinse **LWLL** und der Durchmesser **DLWL** des Lichtwellenleiters **LWL.**

Um den Zutritt von Fremdlicht im Betrieb zum Sensorelement **SE** zu minimieren, ist es sinnvoll, wenn der erste Spalt zwischen dem Rand des Zutrittskanals des ersten Lichtwellenleiters **LWL** in der Anwendungsvorrichtung, im ersten Anwendungsbeispiel eines Sensorkopfes **SK** des Kanals **KN** und im zweiten Anwendungsbeispiel eines Motors der ersten Öffnung **OF,** und dem ersten Lichtwellenleiter **LWL** mit einer optisch intransparenten Füllmasse **FM** ganz oder teilweise verschlossen ist.

Aus dem gleichen Grund ist es sinnvoll, wenn der zweite Spalt zwischen dem Rand des Zutrittskanals des zweiten Lichtwellenleiters **LWL** in der Anwendungsvorrichtung, im ersten Anwendungsbeispiel eines Sensorkopfes SK des Kanals **KN** und im zweiten Anwendungsbeispiel eines Motors der ersten Öffnung **OF,** und dem zweiten Lichtwellenleiter **LWL** mit einer optisch intransparenten Füllmasse **FM** ganz oder teilweise verschlossen ist und/oder wenn der gemeinsame Spalt zwischen dem Rand des Zutrittskanals des gemeinsamen Lichtwellenleiters **LWL** in der Anwendungsvorrichtung, im ersten Anwendungsbeispiel eines Sensorkopfes **SK** des Kanals **KN** und im zweiten Anwendungsbeispiel eines Motors der ersten Öffnung **OF,** und dem gemeinsamen Lichtwellenleiter **LWL** mit einer optisch im Wesentlichen nicht transparenten Füllmasse **FM** ganz oder teilweise verschlossen ist. Die gemeinsame Füllmasse **FM** kann den jeweiligen Lichtwellenleiter am Gehäuse der Anwendungsvorrichtung, im ersten Anwendungsbeispiel des Sensorkopfes **SK** und im zweiten Anwendungsbeispiel des Motors, befestigen.

Bevorzugt ist die Vorrichtung dazu eingerichtet, den zeitlichen Werteverlauf der Intensität der Fluoreszenzstrahlung **FL,** insbesondere in Form eines Empfängerausgangssignals **S0** zu ermitteln. Des Weiteren ist die Vorrichtung vorzugsweise dazu eingerichtet, den zeitlichen Verlauf des Amplitudenwerts des zeitlichen Werteverlaufs der Intensität der Fluoreszenzstrahlung **FL** aus dem zeitlichen Werteverlauf der Intensität der Fluoreszenzstrahlung **FL,** insbesondere aus dem Empfängerausgangssignal **S0** und insbesondere mittels eines Lock-In-Verstärkers **LIV** oder einer funktionsäquivalenten Teilvorrichtung, zu ermitteln.

Schließlich ist die Vorrichtung vorzugsweise dazu eingerichtet, in Abhängigkeit von dem ermittelten zeitlichen Verlauf des Amplitudenwerts des zeitlichen Werteverlaufs der Intensität der Fluoreszenzstrahlung **FL** eine Anzeige oder eine andere Signalisierung vorzunehmen, um übergeordneten Systemen und/oder einem Benutzer einen Eingriff in Abhängigkeit von einer solchen Anzeige oder Signalisierung zu ermöglichen.

Im Falle des zweiten Anwendungsbeispiels eines Motors ist die Vorrichtung vorzugsweise dazu eingerichtet, in Abhängigkeit von dem ermittelten zeitlichen Verlauf des Amplitudenwerts des zeitlichen Werteverlaufs der Intensität der Fluoreszenzstrahlung **FL,** die elektrische Bestromung von Spulen des Motors, insbesondere von Stator-Spulen **SL** des Motors und/oder die elektrische Bestromung von Rotor-Spulen des Motors und insbesondere mittels einer Halbbrückensteuerung **CTRH** im Zusammenwirken mit Halbbrücken **HB** zu steuern. Hierdurch ist es möglich, ohne das Magnetfeld des Motors durch Leitungen etc. zu modifizieren und ohne Probleme mit der galvanischen Trennung das Magnetfeld im Motor zu erfassen und den Motor zu steuern.

Im Falle des zweiten Anwendungsbeispiels eines Motors weist der Motor typischerweise n Motorphasen (MPH_{U}, MPH_{V}, MPH_{W}) mit n als ganzer positiver Zahl größer 2 auf. In den Beispielen der Figuren weist der beispielhafte Motor n=3 Motorphasen auf. Die Vorrichtung bestromt mittels Halbbrücken HB jede dieser Motorphasen (MPH_{U}, MPH_{V}, MPH_{W}) mit einem jeweils zugehörigen Motorphasenstrom (I_{MPHU}, I_{MPHV}, I_{MPHW}). Typischerweise moduliert die Halbbrückensteuerung **CTRH** die Halbbrücken **HB** mit einem jeweiligen pulsmodulierten Steuersignal, das sie individuell für jede Motorphase jeweils erzeugt. Diese Motorphasenströme (I_{MPHU}, I_{MPHV}, I_{MPHW}) sind typischerweise zumindest zeitabschnittsweise periodisch mit einer Periode T. Bevorzugt ist jedem der Motorphasenströme (I_{MPHU}, I_{MPHV}, I_{MPHW}) ein Stromwinkel (φ_{MPHU}, φ_{MPHV}, φ_{MPHW}) zugeordnet. Die Motorphasenströme können stets so in Form einer Folge von Motorphasenströme (I_{MPHU}, I_{MPHV}, I_{MPHW}) geordnet werden, dass ein vorausgehender Motorphasenstrom sich in seinem jeweiligen Stromwinkel von dem Stromwinkel des nachfolgenden Motorphasenstroms um 2π/n unterscheidet. Somit ist dann jedem Motorphasenstrom ein Motorphasenstromvektor zugeordnet, dessen Orientierung dem Stromwinkel des Motorphasenstroms und dessen Länge dem Betrag des Motorphasenstroms entspricht.

Vorzugsweise ist die vorschlagsgemäße Vorrichtung dazu eingerichtet, insbesondere mittels eines Hochpassfilters oder eines funktionsäquivalenten Filters, aus dem zeitlichen Verlauf des Amplitudenwerts des zeitlichen Werteverlaufs der Intensität der Fluoreszenzstrahlung **FL** einen Wechselanteil und/oder Gleichanteil des zeitlichen Verlaufs des Amplitudenwerts des zeitlichen Werteverlaufs der Intensität der Fluoreszenzstrahlung **FL** zu ermitteln.

Beispielsweise ermöglicht im zweiten Anwendungsbeispiel eines Motors erst dieser Wechselanteil und insbesondere dessen Nulldurchgänge die Regelung der Kommutierung der Bestromung des Motors mittels einer Halbbrücke auf Basis der Intensität der Fluoreszenzstrahlung des Sensorelement **SE** mit den NV-Zentren **NVZ.**

Bevorzugt ist die Anwendungsvorrichtung im zweiten Anwendungsbeispiel eines Motors dazu eingerichtet, insbesondere mittels eines zweiten Tiefpasses **TP2,** einen niederfrequenten Gleichanteil im zeitlichen Verlauf des Amplitudenwerts des zeitlichen Werteverlaufs der Intensität der Fluoreszenzstrahlung **FL** zu ermitteln. Dieser Gleichanteil kann die Vorrichtung zur Überwachung des Sensorelements **SE** und der optischen Strecke nutzen und Abweichungen von Erwartungswerten feststellen. Hierzu vergleicht die Vorrichtung den Wert des Gleichanteils mit einem Erwartungswertintervall. Liegt der Wert des Gleichanteils außerhalb des Erwartungswertintervalls, so schließt die Vorrichtung bevorzugt auf einen Fehler und löst entsprechende Maßnahmen aus. Eine solche Maßnahme kann beispielsweise sein, dass die Halbbrückensteuerung **CTRH** über einen externen Datenbus **EXTDB** eine Signalisierung an ein übergeordnetes Rechnersystem übermittelt, das dann alles Weitere veranlasst.

Bevorzugt weist die Anwendungsvorrichtung, im zweiten Anwendungsbeispiel eines Motors die Halbbrückensteuerung **CTRH,** einen Rechnerkern mit einem nichtflüchtigen Speicher, einen typischerweise flüchtigen Schreib/Lese-Speicher, eine Reset-Schaltung, einen Taktgenerator mit einem Taktsystem, der in dem zweiten Anwendungsbeispiel eines Motors zur Versorgung der Halbrückensteuerung mit einem Betriebstakt dient, eine Datenbusschnittstelle zu externen Datenbus **EXTDB,** einen internen Datenbus zur datentechnischen Verbindung dieser Komponenten und eine Spannungsversorgung sowie ggf. weitere übliche Prozessorkomponenten auf. In dem zweiten Anwendungsbeispiel weist die beispielhafte Anwendungsvorrichtung vorzugsweise beispielsweise eine Schnittstelle zur Steuerung der Halbbrücken zur Ansteuerung des Motors auf. Bevorzugt versorgt die Spannungsversorgung auch die anderen Vorrichtungsteile mit elektrischer Energie aus einer positiven und einer negativen Versorgungsspannungsleitung. Bevorzugt stellt die Spannungsversorgung auch die Bezugspotenzialleitung GND bereit.

Vorzugsweise führt der Rechnerkern der Anwendungsvorrichtung ein Anwendungsprogramm aus, dessen Programmcode sich in einem dieser Speicher der Anwendungsvorrichtung befindet. Dieses Anwendungsprogramm kann Teile der hier beschriebenen Signalverarbeitungskomponenten emulieren. Dieses Anwendungsprogramm kann beispielsweise die hier beschriebenen Hochpassfilter und/oder Tiefpassfilter und/oder Synchrondemodulatoren und/oder deren funktionsäquivalente Implementierungen emulieren. Bevorzugt ist die Vorrichtung dazu eingerichtet, diesen niederfrequenten Gleichanteil im zeitlichen Verlauf des Amplitudenwerts des zeitlichen Werteverlaufs der Intensität der Fluoreszenzstrahlung FL von dem zeitlichen Verlauf des Amplitudenwerts des zeitlichen Werteverlaufs der Intensität der Fluoreszenzstrahlung FL abzutrennen und so den Wechselanteil des zeitlichen Verlaufs des Amplitudenwerts des zeitlichen Werteverlaufs der Intensität der Fluoreszenzstrahlung **FL** zu ermitteln. Im Faller des zweiten Anwendungsbeispiels eines Motors kann die Anwendungsvorrichtung auf diese Weise ein Signal bereitstellen, das zur Steuerung der Kommutierung der Halbbrücken in der beispielhaften Anwendungsvorrichtung im zweiten Anwendungsbeispiel eines Motors geeignet ist.

Eine beispielhafte Anwendung des vorschlagsgemäßen Lichtwellenleiters **LWL** des ersten Anwendungsbeispiels eines Sensorkopfes **SK** ist die Vermessung eines Magnetfelds eines ferromagnetischen Materials **FM.** Bevorzugt ist die Anwendungsvorrichtung im Falle des zweiten Anwendungsbeispiels eines Motors daher dazu eingerichtet, einen Nulldurchgang des Wechselanteils des zeitlichen Verlaufs des Amplitudenwerts des zeitlichen Werteverlaufs der Intensität der Fluoreszenzstrahlung **FL** zu ermitteln. Die Detektion des Nulldurchgangs hat den Vorteil, dass Schwankungen der Amplitude des Signals etc. für den Nulldurchgang unerheblich sind. Ein solches Signal eignet sich daher besser für die Steuerung der Kommutierung eines Motors.

Des Weiteren ist die Anwendungsvorrichtung im Falle des zweiten Anwendungsbeispiels eines Motors vorzugsweise dazu eingerichtet, in einem zeitlichen Zusammenhang mit dem ermittelten Nulldurchgang des Wechselanteils des zeitlichen Verlaufs des Amplitudenwerts des zeitlichen Werteverlaufs der Intensität der Fluoreszenzstrahlung **FL** eine Kommutierung der elektrischen Bestromung von Spulen des Motors, insbesondere von Stator-Spulen **SL** des Motors und/oder die elektrische Bestromung von Rotor-Spulen des Motors und insbesondere mittels einer Halbbrückensteuerung **CTRH** im Zusammenwirken mit Halbbrücken **HB,** durchzuführen.

Schließlich ist die Anwendungsvorrichtung im Falle des zweiten Anwendungsbeispiels eines Motors vorzugsweise dazu eingerichtet,
1. einen oder mehrere Spannungswerte einer oder mehrerer Motorphasenspannungen (V_{MPHU}, V_{MPHV}, V_{MPHW}) einer oder mehrerer Motorphasen (MPH_{U}, MPH_{V}, MPH_{W}) der Motorphasen **MPH** gegen eine oder mehrere von dieser Motorphase verschiedenen Motorphasen (MPHu, MPHv, MPHw) der Motorphasen **MPH** und/oder gegen ein Bezugspotenzial **GND** zu ermitteln, und/oder
2. einen oder mehrere Stromwerte einer oder mehrerer Motorphasenströme (I_{MPHU}, I_{MPHV}, I_{MPHW}) einer oder mehrerer Motorphasen (MPH_{U}, MPH_{V}, MPH_{W}) der Motorphasen MPH zu ermitteln und/oder
3. einen oder mehrere Summenstromwerte eines oder mehreres Summenströme mehrerer Motorphasenströme (I_{MPHU}, I_{MPHV}, I_{MPHW}) mehrerer Motorphasen (MPH_{U}, MPH_{V}, MPH_{W}) der Motorphasen MPH, insbesondere einen Sternpunktstrom von einem Sternpunkt von Spulen des Motors zu einem Referenzknoten oder einem Bezugspotenzialknoten GND,
zu ermitteln.

In der Folge ist die Anwendungsvorrichtung im Falle des zweiten Anwendungsbeispiels eines Motors bevorzugt dazu eingerichtet, eine Information über den Nulldurchgang des Wechselanteils des zeitlichen Verlaufs des Amplitudenwerts des zeitlichen Werteverlaufs der Intensität der Fluoreszenzstrahlung **FL** als erstem Regelparameter einerseits zu ermitteln.

Des Weiteren ist die Anwendungsvorrichtung im Falle des zweiten Anwendungsbeispiels eines Motors bevorzugt dazu eingerichtet,
1. mit dem einen Spannungswert einer Motorphasenspannung der Motorphasenspannungen (V_{MPHU}, V_{MPHV}, V_{MPHW}) einer Motorphase der Motorphasen (MPH_{U}, MPH_{V}, MPH_{W}) und/oder
2. mit mehreren Spannungswerten der mehreren Spannungswerte mehrerer Motorphasenspannungen (V_{MPHU}, V_{MPHV}, V_{MPHW}) mehrerer Motorphasen (MPH_{U}, MPH_{V}, MPH_{W}) und/oder
3. mit dem einen Stromwert eines Motorphasenstroms der Motorphasenströme (I_{MPHU}, I_{MPHV}, I_{MPHW}) einer Motorphase der Motorphasen (MPH_{U}, MPH_{V}, MPH_{W}) und/oder
4. mit mehrere Stromwerte der Stromwerte mehrerer Motorphasenströme der Motorphasenströme (I_{MPHU}, I_{MPHV}, I_{MPHW}) mehrerer Motorphasen der Motorphasen (MPH_{U}, MPH_{V}, MPH_{W}) und/oder
5. mit dem einen Summenstromwert eines Summenstroms mehrerer Motorphasenströme der Motorphasenströme (I_{MPHU}, I_{MPHV}, I_{MPHW}) mehrerer Motorphasen der Motorphasen (MPH_{U}, MPH_{V}, MPH_{W}) und/oder
6. mit mehreren Summenstromwerten mehrerer Summenströme der Summenströme mehrerer Motorphasenströme der Motorphasenströme (I_{MPHU}, I_{MPHV}, I_{MPHW}) mehrerer Motorphasen der Motorphasen (MPHu, MPHv, MPHw)
als zweitem Regelparameter andererseits mit dem ersten Regelparameter zu kombinieren.

Dabei ist die die Anwendungsvorrichtung im Falle des zweiten Anwendungsbeispiels eines Motors bevorzugt dazu eingerichtet, den Zeitpunkt der Kommutierung der Bestromung von Spulen des Motors, insbesondere von Stator-Spulen **SL** und/oder insbesondere von Rotor-Spulen des Motors, in Abhängigkeit vom ersten Regelparameter und von einem solchen zweiten Regelparameter zu ändern.

Vorzugsweise ist darüber hinaus die die Anwendungsvorrichtung im Falle des zweiten Anwendungsbeispiels eines Motors dazu eingerichtet, aus dem ersten Regelparameter und dem zweiten Regelparameter auf eine Position des magnetischen Feldes mit der Flussdichte B im Luftspalt **LS** des Motors relativ zu einem oder mehreren Motorphasenstromvektoren der Motorphasenströme (I_{MPHU}, I_{MPHV}, I_{MPHW}) zu schließen und einen räumlichen Winkelwert des Winkels zwischen der Position des Sensorelements als Referenzposition einerseits und der Richtung eines oder mehrerer Motorphasenstromvektoren der Motorphasenströme (I_{MPHU}, I_{MPHV}, I_{MPHW}) zum Zeitpunkt des Nulldurchgangs Nulldurchgang des Wechselanteils des zeitlichen Verlaufs des Amplitudenwerts des zeitlichen Werteverlaufs der Intensität der Fluoreszenzstrahlung **FL** andererseits zu ermitteln.

Darüber hinaus ist eine Sensor-Fusion hier sinnvoll.

Bevorzugt umfasst die vorgeschlagene die Anwendungsvorrichtung im Falle des zweiten Anwendungsbeispiels eines Motors einen Positionssensor **POS.** Vorzugsweise ist die Vorrichtung dazu eingerichtet, mittels dieses Positionssensors **POS** eine Positionsinformation **POSS** zu ermitteln und eine Information über den Nulldurchgang des Wechselanteils des zeitlichen Verlaufs des Amplitudenwerts des zeitlichen Werteverlaufs der Intensität der Fluoreszenzstrahlung **FL** als erstem Regelparameter einerseits mit der Positionsinformation als zweitem Regelparameter andererseits zu kombinieren. In dem Fall ist die Anwendungsvorrichtung des zweiten Anwendungsbeispiels eines Motors vorzugsweise dazu eingerichtet, den Zeitpunkt der Kommutierung der Bestromung von Spulen des Motors, insbesondere von Stator-Spulen **SL** und/oder insbesondere von Rotor-Spulen, in Abhängigkeit vom ersten Regelparameter und von einem solchen zweiten Regelparameter zu ändern, um insbesondere auf die Position des magnetischen Feldes B im Luftspalt **LS** relativ zu einem oder mehreren Motorphasenstromvektoren der Motorphasenströme (I_{MPHU}, I_{MPHV}, I_{MPHW}) zuschließen.

In einer anderen Variante ist die Anwendungsvorrichtung des zweiten Anwendungsbeispiels eines Motors bevorzugt dazu eingerichtet, aus dem ersten Regelparameter und dem zweiten Regelparameter auf eine Position des magnetischen Feldes mit der Flussdichte B im Luftspalt **LS** des Motors relativ zur Position des Rotors **(GHR, PM, RMK)** zu schließen. In einer anderen Variante ist die die Anwendungsvorrichtung des zweiten Anwendungsbeispiels eines Motors bevorzugt somit dazu eingerichtet, dann einen räumlichen Winkelwert des Winkels zwischen der Position des Sensorelements als Referenzposition einerseits und der räumlichen Position des Rotors zum Zeitpunkt des Nulldurchgangs Nulldurchgang des Wechselanteils des zeitlichen Verlaufs des Amplitudenwerts des zeitlichen Werteverlaufs der Intensität der Fluoreszenzstrahlung **FL** andererseits zu ermitteln.

Die Anwendungen der hier dargestellten technischen Lehre sind hierauf aber nicht beschränkt. Das hier vorgelegte Dokument schlägt für solche und andere Anwendungen mit ähnlichen Messaufgaben einen Lichtwellenleiter **LWL** mit dem Sensorelement **SE** vor. Dabei weist das Sensorelement **SE** ein Trägermaterial **TM** auf, in dem eine Vielzahl von Diamanten **DM** eingebettet sind. Ein oder mehrere oder alle Diamanten **DM** dieser Diamanten **DM** weisen dabei ein oder mehrere NV-Zentren **NVZ** und/oder ein oder mehrere andere paramagnetischen Zentren auf. Die NV-Zentren **NVZ** des Sensorelements **SE** und/oder die anderen paramagnetischen Zentren des Sensorelements **SE** emittieren bei Bestrahlung mit Pumpstrahlung **LB** zumindest eine Fluoreszenzstrahlung **FL.**

Das Besondere des in dem hier vorgelegten Dokument vorgeschlagenen Lichtwellenleiter **LWL** ist, dass das Trägermaterial **TM** bevorzugt ein mittels elektromagnetischer Strahlung ausgehärtetes Trägermaterial **TM** ist und dass das Trägermaterial **TM** nach dem Aushärten für Strahlung mit einer Pumpstrahlungswellenlänge λₚₘₚ der Pumpstrahlung **LB,** mit der die NV-Zentren **NVZ** und/oder die anderen paramagnetischen Zentren gepumpt werden, im Wesentlichen transparent ist. Im Wesentlichen bedeutet dabei, dass die unzweifelhaft auftretenden Verluste immer noch so gering sind, dass die Funktionsfähigkeit der Vorrichtung der betreffenden Anwendung immer noch gegeben ist. In gleicherweise sollte das Trägermaterial **TM** für Strahlung mit einer Fluoreszenzwellenlänge λ_{fl} der Fluoreszenzstrahlung **LB** der NV-Zentren **NVZ** bzw. paramagnetischer Zentren im Wesentlichen transparent sein. Im Wesentlichen bedeutet dabei wiederum, dass die unzweifelhaft auftretenden Verluste immer noch so gering sind, dass die Funktionsfähigkeit der Vorrichtung der betreffenden Anwendung immer noch gegeben ist.

Die hier vorgelegte Schrift schlägt als erstes Anwendungsbeispiel eine Vorrichtung zur Erfassung der magnetischen Flussdichte **B** in einem Kanal **KN** eines Sensorkopfes **SK** und/oder im Streufeld **BSTR** eines Permanentmagneten **PM** des Sensorkopfes **SK** vor. Der Sensorkopf **SK** des ersten Anwendungsbeispiels weist bevorzugt ein Sensorelement **SE** mit einem Trägermittel **TM** auf.

In das Trägermittel **TM** eines vorschlagsgemäßen Sensorelements **SE** sind entsprechend der technischen Lehre des hier vorgelegten Dokument vorzugsweise eine Vielzahl von Diamanten bzw. Nanodiamanten **DM** und/oder Kristalle eingebettet. Bevorzugt umfasst das Trägermaterial **TM** Glas und/oder einen ausgehärteten Kunststoff. Das Trägermaterial **TM** fixiert die Diamanten **DM** und/oder Kristalle gegenüber dem ersten Ende **ELWL1** des Lichtwellenleiters **LWL** und verhindert eine Repositionierung der Diamanten **DM** und/oder Kristalle. Bevorzugt ist das Trägermaterial **TM** nach der Verfestigung im Herstellungsprozess für Strahlung mit der Pumpstrahlungswellenlänge λₚₘₚ der Pumpstrahlung **LB** und für Strahlung mir der Fluoreszenzwellenlänge **λ_{fl}** der Fluoreszenzstrahlung **FL** der NV-Zentren **NVZ** bzw. paramagnetischen Zentren in den Diamanten **DM** bzw. Nanodiamanten und/oder Kristalle im Wesentlichen transparent. Einer oder mehrere oder alle Diamanten bzw. Nanodiamanten **DM** und/oder Kristalle dieser Diamanten bzw. Nanodiamanten **DM** und/oder Kristalle weisen typischerweise NV-Zentren **NVZ** und/oder paramagnetische Zentren auf.

In einer beispielhaften Variante der Anwendungsvorrichtung des ersten Anwendungsbeispiels eines Sensorkopfes **SK** wirkt die magnetische Flussdichte B im Streufeld **BSTR** des Magnetfelds des beispielhaften Permanentmagneten **PM** auf die NV-Zentren **NVZ** bzw. die paramagnetischen Zentren im Sensorelement SE des Sensorkopfes **SK** ein.

Typischerweise bewirkt die magnetische Flussdichte **B,** die das Trägermaterial **TM** des Sensorkopfes mit den paramagnetischen Zentren und/oder NV-Zentren **NVZ** durchdringt, eine Reduktion der Intensität der Fluoreszenzstrahlung **FL** der NV-Zentren **NVZ** bzw. paramagnetischen Zentren im Sensorelement SE.

In einer beispielhaften Variante der Anwendungsvorrichtung des ersten Anwendungsbeispiels eines Sensorkopfes **SK** besitzt das Sensorkopfgehäuse **GH** vorzugsweis einen ersten Kanal **KN** für die Zuführung von Pumpstrahlung **LB** der Pumpstrahlungsquelle **PL** zu dem Sensorelement **SE** über einen Lichtwellenleiter **LWL** oder über dergleichen optischen System.

In einer beispielhaften Variante der Anwendungsvorrichtung des zweiten Anwendungsbeispiels eines Motors besitzt das Gehäuse **GH** des Motors vorzugsweis eine erste Öffnung **OF** für die Zuführung von Pumpstrahlung **LB** der Pumpstrahlungsquelle **PL** zu dem Sensorelement **SE** über einen Lichtwellenleiter **LWL** oder über dergleichen optisches System.

Die Pumpstrahlung **LB** besitzt im Falle von NV-Zentren in Dimant als paramagnetischen Zentren innerhalb des Trägermaterials **TM** des Sensorelements **SE** bevorzugt eine Pumpstrahlungswellenlänge λₚₘₚ in einem Wellenlängenbereich von 400 nm bis 700 nm Wellenlänge und/oder besser 450 nm bis 650 nm und/oder besser 500 nm bis 550 nm und/oder besser 515 nm bis 540 nm aufweisen. Bevorzugt ist dabei eindeutig eine Wellenlänge von 532 nm als Pumpstrahlungswellenlänge λₚₘₚ. Im Falle von NV-Zentren in Diamant oder in Diamanten als paramagnetischen Zentren innerhalb des Trägermaterials **TM** des Sensorelements SE ist eine Laser-Diode der Fa. Osram vom Typ PLT5 520B beispielsweise als Pumpstrahlungsquelle **PL** mit 520nm Pumpstrahlungswellenlänge λₚₘₚ geeignet. Die NV-Zentren **NVZ** des Sensorelements **SE** emittieren dann typischerweise bei Bestrahlung mit Pumpstrahlung **LB** der oben beschriebenen Pumpstrahlungswellenlänge λₚₘₚ eine Fluoreszenzstrahlung **FL** mit einer typischen Fluoreszenzwellenlänge λ_{fl} von ca. 637nm bei NV-Zentren **NVZ.**

Andere Wellenlängen können durch plasmonische Kopplung mit zusätzlich im Trägermaterial TM eingebetteten metallischen Nanokristallen in dem Trägermaterial **TM** erreicht werden. Die optischen Eigenschaften der NV-Zentren **NVZ** bzw. paramagnetischen Zentren im Sensorelement **SE** können durch Kombination der Nanodiamanten bzw. Diamanten **DM** im Trägermaterial **TM** des Sensorelements **SE** mit metallischen Nanopartikeln modifiziert werden.

In einer beispielhaften Variante der Anwendungsvorrichtung des ersten Anwendungsbeispiels eines Sensorkopfes **SK** weist das Sensorkopfgehäuse **GH** bevorzugt einen zweiten Kanal **KN** für den Austritt von Fluoreszenzstrahlung **FL** des Sensorelements **SE** zu einem Fotodetektor **PD** hin auf.

In einer beispielhaften Variante der Anwendungsvorrichtung des zweiten Anwendungsbeispiels eines Motors weist das Gehäuse **GH** des Motors bevorzugt einen zweiten Kanal **KN** für den Austritt von Fluoreszenzstrahlung **FL** des Sensorelements **SE** zu einem Fotodetektor **PD** hin auf.

Die vorgeschlagene Vorrichtung weist darüber hinaus vorzugsweise eine Teilvorrichtung, insbesondere einen dichroitischen Spiegel **F1** und/oder einen Filter **F1,** auf, um die Fluoreszenzstrahlung **FL** von der Pumpstrahlung **LB** zu trennen, sodass im Wesentlichen nur Fluoreszenzstrahlung **FL** und möglichst keine Pumpstrahlung **LB** auf den Fotodetektor **PD** fällt. Diese Teilvorrichtung in Form eines Filters **F1** oder dichroitischen Spiegel lässt bevorzugt die Passage von Strahlung mit der Fluoreszenzwellenlänge **λ_{fl}** der Fluoreszenzstrahlung **FL -** z.B. 637nm bei NV-Zentren **NVZ** mit einem Phononenseitenband von 637nm bis 850 nm bei NV-Zentren **NVZ** - in Richtung des Fotodetektors **PD** passieren, während es die Strahlung mit der Pumpstrahlungswellenlänge **λₚₘₚ** der Pumpstrahlung **LB** der Pumpstrahlungsquelle **PL** und somit die modulierte Pumpstrahlung **LB** nicht passieren lässt oder so führt, dass sie den Fotodetektor **PD** nicht trifft oder beeinflusst. Der Fotodetektor **PD** wandelt das Intensitätssignal der Fluoreszenzstrahlung **FL** in ein Empfängerausgangsignal **S0**. Die Vorrichtung wertet das Empfängerausgangssignal **S0** aus,

Im Falle der Anwendungsvorrichtung des ersten Anwendungsbeispiels eines Sensorkopfes **SK** kann die Anwendungsvorrichtung das Empfängerausgangssignal **S0** auswerten, um Informationen über die Werte magnetischer Materialparameter des Materials an der Oberfläche **OF** eines Werkstücks zu erlangen und/oder Informationen zu erlangen, die diese Information umfassen. Vorzugsweise umfasst das Material des Werkstücks in der Nähe der Oberfläche **OF** ein ferromagnetisches Material **FMM.**

Im Falle der Anwendungsvorrichtung des zweiten Anwendungsbeispiels eines Motorskann die Anwendungsvorrichtung das Empfängerausgangssignal **S0** auswerten, um Informationen über die Rotorposition und/oder die tatsächliche Position des Magnetfelds im Luftspalt **LS** des Motors und/oder den Zustand des Motors und/oder seiner Ansteuerungsvorrichtung Und/oder seiner mechanischen Belastung (d.h. das anliegende Drehmoment) zu erlangen und/oder Informationen zu erlangen, die diese Information umfassen.

Die vorgeschlagene Vorrichtung hat den Vorteil, dass das Magnetfeld in der Anwendungsvorrichtung, d.h. im ersten Anwendungsbeispiel das Magnetfels des Permanentmagnete **PM** und des ferromagnetischen Materials **FM** des Werkstücks und im zweiten Anwendungsbeispiel das Magnetfeld im Luftspalt **LS** des Motors, durch Zuleitungen wie z.B. bei der Magnetfeldmessung mit Hall-Sensoren nicht gestört wird.

Des Weiteren ist das Sensorelement **SE** vollkommen diamagnetisch. Eine Rückwirkung von Feldern innerhalb der Anwendungsvorrichtung und/oder aus dem Umfeld der Anwendungsvorrichtung auf die Auswertelektronik des Sensorsystems über das Sensorelement **SE** und den Sensorkopf **SK** und den Lichtwellenleiter **LWL** ist wegen der galvanischen Trennung sehr unwahrscheinlich.

Im Falle einer Anwendungsvorrichtung des ersten Anwendungsbeispiels eines Sensorkopfes SK ist eine Rückwirkung von Feldern innerhalb des Sensorkopfes **SK** und/oder aus dem Umfeld des Sensorkopfes **SK** - beispielsweise des Werkstücks -auf die Auswertelektronik des Sensorsystems über das Sensorelement **SE** und den Sensorkopf **SK** und den Lichtwellenleiter **LWL** ist wegen der galvanischen Trennung sehr unwahrscheinlich. Im Falle einer Anwendungsvorrichtung des zweiten Anwendungsbeispiels eines Motors ist eine Rückwirkung von Feldern innerhalb des Motors und/oder aus dem Umfeld des Motors - beispielsweise von Rotor- oder Stator-Spannungen und-Strömen -auf die Auswertelektronik des Sensorsystems über das Sensorelement SE und den Sensorkopf **SK** und den Lichtwellenleiter **LWL** ist wegen der galvanischen Trennung sehr unwahrscheinlich.

Dadurch kann das System auch in Anwendungsvorrichtungen in Hochspannungsteilvorrichtungen, die auf sehr hohen elektrischem Potenzial liegen, eingesetzt werden.

Beispielsweise kann das System in einer Anwendungsvorrichtung des ersten Anwendungsbeispiels eines Sensorkopfes **SK** auch in Hochspannungssystemen mit Werkstücken, die auf sehr hohen elektrischem Potenzial liegen, eingesetzt werden.

Beispielsweise kann das System in einer Anwendungsvorrichtung des zweiten Anwendungsbeispiels eines Motors auch in Hochspannungssystemen Motorkomponenten, die auf sehr hohen elektrischem Potenzial liegen, eingesetzt werden.

Dies sind wesentliche Vorteile eines vorschlagsgemäßen Sensorelements **SE.** Ganz besonders vorteilhaft ist die erzielbare geringe Größe bei gleichzeitiger Präzision der Positionierung.

Auch ist es denkbar, dass das die Anwendungsvorrichtung, also z.B. der Sensorkopf SK bzw. der Motor, und/oder die Umgebung der Anwendungsvorrichtung, also z.B. das Werkstück bzw. die Umgebung des Motors, im Vergleich zu den Betriebsbedingungen von Halbleitern sehr heiß oder sehr kalt sind. Ein Temperaturbereich von 0°C bis 80°C ist möglich. Bei entsprechender Ausgestaltung des Sensorkopfes, des Lichtwellenleiters **LWL,** der mechanischen Hülle **MH,** des Trägermaterials **TM** und des **Materials** des Sensorkopfgehäuses **GH** sind Temperaturen bis 700°C und bis zum absoluten Nullpunkt für das Werkstück und das ferromagnetische Material **FM** denkbar. Systeme aus dem Stand der Technik zeigen dies nicht

Bevorzugt befinden sich NV-Zentren **NVZ** bzw. die paramagnetischen Zentren des Sensorelements **SE** im ersten Anwendungsbeispiel eines Sensorkopfes SK nicht im Streufeld **BSTR** des Permanentmagneten **PM** und im zweiten Anwendungsbeispiel eines Motors nicht im Streufeld **BSTR** des Luftspalts **LS.**

Bevorzugt sind die Diamanten bzw. Nanodiamanten **DM** und/oder Kristalle im Trägermaterial **TM** im Wesentlichen zueinander unterschiedlich mit einer jeweils im Wesentlichen unterschiedlichen Orientierung orientiert. Dies hat den fertigungstechnischen Vorteil, dass eine Ausrichtung der Diamanten bzw. Nanodiamanten **DM** und/oder Kristalle nicht mehr notwendig ist und die das Herstellverfahren zur Herstellung des Sensorelements **SE** beispielsweise Diamantpulver und/oder Kristallpulver mit einer sehr großen Anzahl sehr kleiner Diamanten bzw. Nanodiamanten **DM** und/oder Kristalle verwenden kann.

Ein Sensorelement **SE** mit einer solchen ungeordneten Vielzahl von Diamanten bzw. Nanodiamanten **DM** und/oder einer solchen ungeordneten Vielzahl von Kristallen hat den Vorteil, dass die Messung der magnetischen Flussdichte B isotrop ist.

Das bedeutet, dass das Sensorelement **SE** nur den Betrag der magnetischen Flussdichte B erfasst, nicht jedoch die Richtung. Dies hat den Vorteil, dass eine Ausrichtung des Sensorelements **SE** und des Lichtwellenleiters **LWL** im Sensorkopf **SK** nicht mehr notwendig ist. Die Montage eines solchen Sensorelements **SE** können Hilfskräfte oder wenig präzise maschinelle Vorrichtungen übernehmen, die das Sensorelement **SE** mit dem Lichtwellenleiter **LWL** nur in einen dafür vorgesehenen Kanal **KN** im Sensorkopfgehäuse **GH** stecken und dort beispielsweise mittels Klebung oder Verschraubung befestigen müssen. Hierdurch sinken die Fertigungskosten für einen solchen Sensorkopf **SK** drastisch. Der Cpk-Wert einer auf einem solchen Fertigungsverfahren beruhenden Serienfertigung steigt dramatisch an, was entsprechend niedrige Kostenpositionen ermöglicht. Um die räumliche Isotropie zu erreichen, ist es daher vorteilhaft, wenn die Orientierung der Diamanten bzw. Nanodiamanten **DM** und/oder Kristalle stochastisch im Sensorelement **SE** im Wesentlichen gleichverteilt ist. Im Zuge der Ausarbeitung der technischen Lehre dieses Dokuments hat die Anmelderin erkennt, dass es entsprechend den vorausgehenden Ausführungen auch vorteilhaft sein kann, wenn das Sensorelement **SE** in bestimmten Sonderfällen im ersten Anwendungsbeispiel eines Sensorkopfes SK doch im Streufeld **BSTR** des Permanentmagneten **PM** und im zweiten Anwendungsbeispiel eines Motors doch im Streufeld **BSTR** des Luftspalts **LS** befindet.

Um die Anzahl der Lichtwellenleiter **LWL** zu minimieren und die Modifikationen an der Anwendungsvorrichtung, hier im ersten Anwendungsbeispiel am Sensorkopf **SK** und im zweiten Anwendungsbeispiel eines Motors am Motor, gering zu halten, ist es vorteilhaft einen einzigen Lichtwellenleiter **LWL** für die Zuführung der Pumpstrahlung **LB** der Pumpstrahlungsquelle **PL** zum Sensorelement **SE** und für die Rückführung der Fluoreszenzstrahlung **FL** vom Sensorelement SE zum Fotodetektor **PD** zu benutzen.

In dem Fall ist nur ein einziger Kanal **KN** bzw. nur eine einzige Öffnung OF in der Anwendungsvorrichtung, hier im ersten Anwendungsbeispiel in dem Sensorkopf **SK** und im zweiten Anwendungsbeispiel eines Motors in dem Motor, für die Montage des Lichtwellenleiters **LWL** im Gehäuse **GH** der Anwendungsvorrichtung, hier im ersten Anwendungsbeispiel im Sensorkopfgehäuse **GH** und im zweiten Anwendungsbeispiel mim Gehäuse **GH** des Motors, notwendig, sodass dann der erste Kanal **KN** mit dem zweiten Kanal **KN** bzw. die erste Öffnung **OF** und die zweite Öffnung **OF** identisch sind. Der folgende Text bezeichnet dann einen solchen Kanal **KN** als gemeinsamen Kanal **KN** und eine solche Öffnung **OF** als gemeinsame Öffnung **OF.**

Somit umfasst die vorschlagsgemäße Anwendungsvorrichtung, in dem ersten Anwendungsbeispiel der vorschlagsgemäße Sensorkopf **SK** und in dem zweiten Anwendungsbeispiel der Motor, ein Sensorelement SE mit einer Vielzahl von Diamanten bzw. Nanodiamanten **DM** und/oder Kristallen mit NV-Zentren **NVZ** und/oder anderen paramagnetischen Zentren in einem Trägermaterial **TM** und einen ersten Lichtwellenleiter **LWL,** an dem das Sensorelement SE befestigt ist. Der Lichtwellenleiter **LWL** transportiert die Pumpstrahlung **LB** der Pumpstrahlungsquelle **PL** zu dem Sensorelement SE, sodass die Pumpstrahlung **LB** das Sensorelement **SE** bestrahlt und die NV-Zentren **NVZ** bzw. die paramagnetischen Zentren des Sensorelements **SE** Fluoreszenzstrahlung **FL** abgeben. Der Lichtwellenleiter **LWL** erfasst diese Fluoreszenzstrahlung **FL** und transportiert die Fluoreszenzstrahlung **FL** in Richtung auf den Fotodetektor **PD** zurück.

Der Lichtwellenleiter **LWL** kann in der Anwendungsvorrichtung des ersten Anwendungsbeispiels eines Sensorkopfes SK dabei parallel oder senkrecht zur Achse **AX** des Permanentmagneten **PM** im Sensorkopf **SK** eingebracht werden, wobei sich dann das Sensorelement **SE** bevorzugt im Streufeld **BSTR** des Permanentmagneten **PM** befindet.

Der Lichtwellenleiter **LWL** kann in der Anwendungsvorrichtung des zweiten Anwendungsbeispiels eines Motors dabei parallel oder senkrecht zur Achse **AX** Motors im Luftspalt **LS** des Motors eingebracht werden, wobei sich dann das Sensorelement **SE** bevorzugt im Streufeld **BSTR** im Luftspalt **LS** des Motors befindet.

Sofern die Rückführung der Fluoreszenzstrahlung **FL** vom Sensorelement **SE** zum Fotodetektor **PD** separat von der Hinführung der Pumpstrahlung **LB** zum Sensorelement **SE** erfolgen soll, umfasst in diesem Fall die Anwendungsvorrichtung, im ersten Anwendungsbeispiel eines Sensorkopfes **SK** der Sensorkopf **SK** im zweiten Anwendungsbeispiel eines Motors der Motor, bevorzugt einen zweiten Lichtwellenleiter **LWL,** der Fluoreszenzstrahlung **FL** des Sensorelements **SE** erfasst, und die Fluoreszenzstrahlung **FL** in Richtung des Fotodetektors **PD** transportiert.

Wie oben ausgeführt, ist jedoch bevorzugt der erste Lichtwellenleiter **LWL** mit dem zweiten Lichtwellenleiter **LWL** identisch. Das hier vorgelegte Dokument bezeichnet im Folgenden einen solchen Lichtwellenleiter **LWL** als gemeinsamen Lichtwellenleiter **LWL.** Ein solche gemeinsamer Lichtwellenleiter **LWL** spart Kalibrationsaufwand und reduziert die Montagekomplexität und spart Material und ist daher vorteilhaft.

Insbesondere reduziert ein gemeinsamer Lichtwellenleiter **LWL** die notwendigen Modifikationen an der Anwendungsvorrichtung, im ersten Anwendungsbeispiel eines Sensorkopfes **SK** an dem Sensorkopf **SK** im zweiten Anwendungsbeispiel eines Motors an dem Motor.

Der erste Lichtwellenleiter **LWL** weist ein erstes Ende **ELWL1** und ein zweites Ende **ELWL2** auf. Der zweite Lichtwellenleiter **LWL** weist ebenfalls ein erstes Ende **ELWL1** und ein zweites Ende **ELWL2** auf. Der gemeinsame Lichtwellenleiter **LWL** weist ebenso ein erstes Ende **ELWL1** und ein zweites Ende **ELWL2** auf.

Das hier vorgelegte Dokument schlägt nun vor, das Sensorelement **SE** an dem ersten Ende **ELWL1** des ersten Lichtwellenleiters **LWL** und/oder zweiten Lichtwellenleiters **LWL** oder des gemeinsamen Lichtwellenleiters **LWL** zu befestigen, um die optische Kopplung zwischen Lichtwellenleiter **LWL** und Sensorelement **SE** zu stabilisieren. Ein Lichtwellenleiter **LWL** im Sinne dieses Dokuments kann die Form eines Zylinders, insbesondere eins langgestreckten Zylinders wie die einer Glasfaser, oder eines Polyeder oder eines Parallelepiped oder eines Quader oder eines Prismas oder eine andere geometrische Form aufweisen.

Das erste Ende **ELWL1** eines Lichtwellenleiters **LWL** umfasst im Sinne des hier vorgestellten Dokuments eine Endfläche **EF,** die Teilfläche der Außenfläche des Lichtwellenleiters **LWL** ist, aus der die Pumpstrahlung **LB** in das Trägermaterial **TM** des Sensorelements **SE** austritt und/oder in die die Fluoreszenzstrahlung **FL** der paramagnetischen Zentren und/oder NV-Zentren **NVZ** der Diamanten bzw. Nanodiamanten und/oder Kristalle des Trägermaterials **TM** in den Lichtwellenleiter **LWL** eintritt.

Das zweite Ende **ELWL2** eines Lichtwellenleiters **LWL** umfasst im Sinne des hier vorgestellten Dokuments eine Endfläche **EF,** die Teilfläche der Außenfläche des Lichtwellenleiters **LWL** ist, in die die Pumpstrahlung **LB** in den Lichtwellenleiter **LWL** eintritt austritt und/oder aus der die Fluoreszenzstrahlung **FL** der paramagnetischen Zentren und/oder NV-Zentren **NVZ** der Diamanten bzw. Nanodiamanten und/oder Kristalle des Trägermaterials **TM** wieder aus dem Lichtwellenleiter **LWL** austritt.

Das zweite Ende **ELWL2** eines Lichtwellenleiters **LWL** und das erste Ende **ELWL1** eines Lichtwellenleiters **LWL** müssen nicht unbedingt planparallel zueinander ausgerichtete Endflächen **EF** umfassen. Optische Funktionselemente des Lichtwellenleiters **LWL** können innerhalb des Lichtwellenleiters **LWL** das Licht geeignet umlenken.

Solche optischen Funktionselemente können spiegelnde Außenflächen des Lichtwellenleiters und/oder mikrooptischen Funktionselemente wie Mikrolinsen und/oder holographische Strukturen, insbesondere spiegelnde holographische Strukturen und/oder Diffusoren und/oder digitaloptische Funktionselement wie Fresnellinsen etc. umfassen. Vorzugsweise befinden sich diese optischen und mikrooptischen Funktionselemente auf Teiloberflächen des Lichtwellenleiters **LWL.**

Wenn nun beispielsweise das erste Ende **ELWL1** des ersten und/oder der zweiten oder des gemeinsamen Lichtwellenleiters **LWL** von dem Trägermaterial **TM** des Sensorelements **SE** umhüllt ist, ergibt sich eine besonders gute Stabilisierung dieser optischen Kopplung.

Bevorzugt bildet im Falle eines langgestreckten Lichtwellenleiters dabei die Endfläche **EF** des ersten Endes **ELWL1** des ersten und/oder der zweiten oder des gemeinsamen Lichtwellenleiters **LWL** eine ebene Endfläche **EF** senkrecht zur Mittenlinie **ML** des Lichtwellenleiters **LWL.** Die Mittelline **ML** entspricht typischerweise der optischen Achse des Lichtwellenleiters **LWL.**

Eine solche ebene Endfläche **EF** im Falle eines langgestreckten Lichtwellenleiters ermöglicht eine verbesserte Auskopplung der elektromagnetischen Pumpstrahlung **LB** aus dem Lichtwellenleiter **LWL** und eine verbesserte optische Einkopplung der Fluoreszenzstrahlung **FL** in den Lichtwellenleiter **LWL.** Bevorzugt ist der Abstand eines oder bevorzugt mehrerer Diamanten bzw. Nanodiamanten **DM** und/oder eines oder mehrerer Kristalle im Trägermaterial **TM** des Sensorelements **SE** von dieser ebenen Endfläche **EF** kleiner als die Pumpstrahlungswellenlänge λₚₘₚ und/oder besser kleiner als ½ der Pumpstrahlungswellenlänge λₚₘₚ, und/oder besser kleiner als 1/4 der Pumpstrahlungswellenlänge λₚₘₚ, und/oder besser kleiner als 1/8 der Pumpstrahlungswellenlänge λₚₘₚ, und/oder besser kleiner als 1/10 der Pumpstrahlungswellenlänge λₚₘₚ, und/oder besser kleiner als 1/20 der Pumpstrahlungswellenlänge λₚₘₚ, und/oder besser kleiner als 1/50 der Pumpstrahlungswellenlänge λₚₘₚ, und/oder besser kleiner als 1/100 der Pumpstrahlungswellenlänge λₚₘₚ, , und/oder besser kleiner als 1/200 der Pumpstrahlungswellenlänge λₚₘₚ, und/oder besser kleiner als 1/500 der Pumpstrahlungswellenlänge λₚₘₚ, und/oder besser kleiner als 1/1000 der Pumpstrahlungswellenlänge λₚₘₚ.

Im Falle eines langgestreckten Lichtwellenleiters **LWL** durchstößt die Mittenlinie **ML,** die eine gedachte Hilfskonstruktion zur Verdeutlichung des Sachverhalts ist, die Endfläche **EF** an einem Mittelpunkt **MP** der Endfläche **EF.** Die Dicke **dₗ** des Trägermaterials **TM** ist im Falle eines langgestreckten Lichtwellenleiters **LWL** bevorzugt an diesem Mittelpunkt **MP** dicker ist als die Dicke **dᵣ** an anderen Punkten der Endfläche **EF** des ersten Endes des ersten und/oder der zweiten oder des gemeinsamen Lichtwellenleiters **LWL.** Dies hat den Vorteil, dass im Falle eines langgestreckten Lichtwellenleiters **LWL** Licht durch die Grenzfläche Trägermaterial **TM/** Luft in den Lichtwellenleiter **LWL** zurückgespiegelt wird und dass dann die Effizienz und der Wirkungsgrad steigt. Bevorzugt formt daher das Trägermaterial **TM** im Falle eines langgestreckten Lichtwellenleiters **LWL** am ersten Ende **ELWL1** des Lichtwellenleiters **LWL** eine Linse **LWLL** aus. Der Durchmesser **D_{LWLL}** der Linse **LWLL** ist im Falle eines langgestreckten Lichtwellenleiters **LWL** typischerweise kleiner als der Durchmesser **D_{LWL}** des Lichtwellenleiters **LWL.** Der Durchmesser **D_{LWLL}** der Linse **LWLL** kann aber auch im Falle eines langgestreckten Lichtwellenleiters **LWL** so groß wie der der Durchmesser **D_{LWL}** des Lichtwellenleiters **LWL** sein, was aber nach den Erfahrungen bei der Ausarbeitung der technischen Lehre dieses Dokuments nicht optimal ist.

Bevorzugt ist im Falle eines langgestreckten ersten Lichtwellenleiters **LWL** der erste Lichtwellenleiter **LWL** im Bereich des Sensorkopfes SK und/oder innerhalb des Sensorkopfes **SK** ganz oder teilweise durch eine mechanische Hülle **MH** umhüllt. Bevorzugt ist im Falle eines langgestreckten zweiten Lichtwellenleiters **LWL** der zweite Lichtwellenleiter **LWL** im Bereich der Anwendungsvorrichtung, im Fall des ersten Anwendungsbeispiels des Sensorkopfes **SK** und Im Fall des zweiten Anwendungsbeispiels des Motors, und/oder innerhalb der Anwendungsvorrichtung ganz oder teilweise ebenfalls durch eine mechanische Hülle **MH** umhüllt.

Bevorzugt ist der der gemeinsame Lichtwellenleiter **LWL** im Bereich der Anwendungsvorrichtung, im Fall des ersten Anwendungsbeispiels des Sensorkopfes **SK** und Im Fall des zweiten Anwendungsbeispiels des Motors, und/oder innerhalb der Anwendungsvorrichtung ganz oder teilweise in gleicher Weise durch eine mechanische Hülle **MH** umhüllt. Die mechanische Hülle **MH** stützt und schützt den jeweiligen Lichtwellenleiter **LWL** gegen die rauen Bedingungen der jeweiligen Messsituation.

Die mechanische Hülle **MH** innerhalb der Anwendungsvorrichtung, im Fall des ersten Anwendungsbeispiels des Sensorkopfes **SK** und Im Fall des zweiten Anwendungsbeispiels des Motors, muss den jeweiligen besondere Anforderungen hinsichtlich thermischer und chemischer Stabilität gegen Hitze und Betriebsflüssigkeiten erfüllen. Die mechanische Hülle **MH** ist daher im Falle eines langestreckten, faserförmigen Lichtwellenleiters bevorzugt aus Glasgewebe oder Keramik oder Kunststoff oder dergleichen gefertigt.

Die mechanische Hülle **MH** weist daher bevorzugt einen Keramikwerkstoff oder ein anderes nicht magnetisierbares und/oder elektrisch nichtleitendes Material und/oder ein bei Temperaturen oberhalb von 100°C stabiles Material und/oder ein bei Temperaturen oberhalb von 140°C stabiles Material und/oder ein bei Temperaturen oberhalb von 170°C stabiles Material und/oder ein bei Temperaturen oberhalb von 200°C stabiles Material und/oder ein bei Temperaturen oberhalb von 250°C stabiles Material oder umfasst diese oder besteht aus diesen im Extremfall. Die mechanische Hülle **MH** kann also aus einem Keramikwerkstoff oder aus einem anderen nicht magnetisierbaren und/oder elektrisch nichtleitendes Material und/oder aus einem bei Temperaturen oberhalb von 100°C stabilen Material und/oder aus einem bei Temperaturen oberhalb von 140°C stabilen Material und/oder aus einem bei Temperaturen oberhalb von 170°C stabilen Material und/oder aus einem bei Temperaturen oberhalb von 200°C stabilen Material und/oder aus einem bei Temperaturen oberhalb von 250°C stabilen Material gefertigt sein oder dieses umfassen.

Bevorzugt ist die mechanische Hülle **MH** im Falle eines faserförmigen Lichtwellenleiters **LWL** zumindest abschnittweise ein Rohr oder Röhrchen oder eine Kapillare oder eine Kanüle oder ein Schlauch, in die der jeweilige Lichtwellenleiter **LWL** hineingeschoben ist. Dies vereinfacht die Fertigung des Systems aus Lichtwellenleiter **LWL,** Sensorelement **SE** und mechanischer Hülle **MH.** Der Innendurchmesser **Dᵣₒ** eines solchen Rohrs oder eines solchen Röhrchens oder einer solchen Kapillare oder einer solchen Kanüle oder eines solchen Schlauches ist bevorzugt nur ein Wenig größer als der Durchmesser der Lichtwellenleiterlinse **LWLL** und der Durchmesser **DLWL** des Lichtwellenleiters **LWL.**

Um den Zutritt von Fremdlicht im Betrieb zum Sensorelement **SE** zu minimieren, ist es sinnvoll, wenn der erste Spalt zwischen dem Rand des ersten Kanals **KN** bzw. dem Rand der ersten Öffnung **OF** und dem ersten Lichtwellenleiter **LWL** im Falle eines faserförmigen ersten Lichtwellenleiters **LWL** mit einer optisch intransparenten Füllmasse ganz oder teilweise oder abschnittsweise verschlossen ist. Aus dem gleichen Grund ist es sinnvoll, wenn der zweite Spalt zwischen dem Rand des zweiten Kanals **KN** bzw. dem Rand der zweiten Öffnung **OF** und dem zweiten Lichtwellenleiter **LWL** im Falle eines faserförmigen zweiten Lichtwellenleiters **LWL** mit einer optisch intransparenten Füllmasse ganz oder teilweise verschlossen oder abschnittsweise ist und/oder wenn der gemeinsame Spalt zwischen dem Rand des gemeinsamen Kanals **KN** bzw. dem Rand der gemeinsamen Öffnung **OF** und dem gemeinsamen Lichtwellenleiter **LWL** im Falle eines faserförmigen gemeinsamen Lichtwellenleiters **LWL** mit einer optisch im Wesentlichen nicht transparenten Füllmasse ganz oder teilweise oder abschnittsweise verschlossen ist. Die gemeinsame Füllmasse kann den jeweiligen Lichtwellenleiter **LWL** im jeweiligen Kanal **KN** und/oder der jeweiligen Öffnung **OF** des Gehäuses der Anwendungsvorrichtung, im ersten Anwendungsbeispiel des Sensorkopfgehäuses **GH** und im zweiten Anwendungsbeispiel des Gehäuses **GH** des Motors, befestigen.

Bevorzugt ist die Vorrichtung dazu eingerichtet, den zeitlichen Werteverlauf der Intensität der Fluoreszenzstrahlung **FL,** insbesondere in Form eines Empfängerausgangssignals **S0** zu ermitteln. Des Weiteren ist die Vorrichtung vorzugsweise dazu eingerichtet, den zeitlichen Verlauf des Amplitudenwerts des zeitlichen Werteverlaufs der Intensität der Fluoreszenzstrahlung **FL** aus dem zeitlichen Werteverlauf der Intensität der Fluoreszenzstrahlung **FL,** insbesondere aus dem Empfängerausgangssignal **S0** und insbesondere mittels eines Lock-In-Verstärkers **LIV** oder einer funktionsäquivalenten Teilvorrichtung, zu ermitteln.

Dabei weist das Sensorelement **SE** vorzugsweise ein Trägermaterial **TM** auf, in dem eine Vielzahl von Diamanten bzw. Nanodiamanten **DM** und/oder Kristalle eingebettet sind. Ein oder mehrere oder alle Diamanten bzw. Nanodiamanten **DM** dieser Diamanten **DM** und/oder ein oder mehrere Kristalle dieser Kristalle weisen dabei ein oder mehrere NV-Zentren **NVZ** und/oder ein oder mehrere andere paramagnetischen Zentren auf. Die NV-Zentren **NVZ** des Sensorelements **SE** und/oder die anderen paramagnetischen Zentren des Sensorelements **SE** emittieren bei Bestrahlung mit Pumpstrahlung **LB** zumindest eine Fluoreszenzstrahlung **FL.**

Das Besondere des in dem hier vorgelegten Dokument vorgeschlagenen Lichtwellenleiter **LWL** ist, dass das Trägermaterial **TM** bevorzugt ein mittels elektromagnetischer Strahlung ausgehärtetes Trägermaterial **TM** ist und dass das Trägermaterial **TM** nach dem Aushärten für Strahlung mit einer Pumpstrahlungswellenlänge λₚₘₚ der Pumpstrahlung **LB,** mit der die NV-Zentren **NVZ** und/oder die anderen paramagnetischen Zentren gepumpt werden, im Wesentlichen transparent ist. Im Wesentlichen bedeutet dabei, dass die unzweifelhaft auftretenden Verluste immer noch so gering sind, dass die Funktionsfähigkeit der betreffenden Anwendung immer noch gegeben ist. In gleicherweise sollte das Trägermaterial **TM** für Strahlung mit einer Fluoreszenzwellenlänge **λ_{fl}** der Fluoreszenzstrahlung **LB** der NV-Zentren bzw. der paramagnetischen Zentren im Wesentlichen transparent sein. Im Wesentlichen bedeutet dabei wiederum, dass die unzweifelhaft auftretenden Verluste immer noch so gering sind, dass die Funktionsfähigkeit der betreffenden Anwendung immer noch gegeben ist. Durch die Aushärtung eines zuvor flüssigen Trägermittels **TM** ist die Fertigung eines solchen Lichtwellenleiters **LWL** besonders einfach und prozesssicher mit einem hohen Cₚₖ-Wert zu fertigen.

In einer Variante des Lichtwellenleiters sind die Diamanten bzw. Nanodiamanten **DM** und/oder Kristalle im Trägermaterial **TM** im Wesentlichen zueinander unterschiedlich mit einer jeweils im Wesentlichen unterschiedlichen Orientierung orientiert sind. Dies hat den Vorteil, dass sich das Sensorelement isotrop verhält und keine Vorzugsrichtung zeigt. Die Mischung verschiedenster Diamantkristalle homogenisiert die Messergebnisse und verbessert den Cₚₖ-Wert.

Aus dem gleichen Grund ist es vorteilhaft, wenn im Trägermaterial **TM** die Orientierung der Diamanten bzw. Nanodiamanten **DM** und/oder Kristalle stochastisch im Wesentlichen gleichverteilt ist.

Bevorzugt ist der Lichtwellenleiter **LWL** dazu eingerichtet oder bestimmt ist, Pumpstrahlung **LB** der Pumpstrahlungsquelle **PL** zu dem Sensorelement **SE** zu transportieren, sodass die Pumpstrahlung **LB** das Sensorelement **SE** mit Strahlung der Pumpstrahlungswellenlänge **λₚₘₚ** bestrahlt.

Der Lichtwellenleiter **LWL** ist bevorzugt ebenfalls dazu eingerichtet oder bestimmt, Fluoreszenzstrahlung **FL** des Sensorelements **SE** zu erfassen, und die Fluoreszenzstrahlung FL in Richtung eines Fotodetektors **PD** zu transportieren.

Der vorgeschlagene Lichtwellenleiter **LWL** weist wieder bevorzugt ein erstes Ende **ELWL1** und ein zweites Ende **ELWL2** auf. Das Trägermaterial **TM** bildet bevorzugt das Sensorelement SE und befestigt dieses Sensorelement **SE** an dem ersten Ende **ELWL1** des Lichtwellenleiters **LWL.**

Bevorzugt umhüllt das Trägermaterial **TM** des Sensorelements **SE** im Falle eines langgestreckten, insbesondere faserförmigen Lichtwellenleiters **LWL** das erste Ende **ELWL1** des Lichtwellenleiters **LWL.** Dies verbessert die mechanische Verbindung zwischen Lichtwellenleiter **LWL** und Sensorelement SE.

Bevorzugt bildet im Falle eines langgestreckten, insbesondere faserförmigen Lichtwellenleiters **LWL** eine Endfläche **EF** des ersten Endes **ELWL1** des Lichtwellenleiters **LWL** eine ebene Endfläche **EF** senkrecht zur Mittenlinie **ML** des Lichtwellenleiters **LWL.** Dies verbessert die Auskopplung elektromagnetischer Strahlung aus dem Kern **LWLC** des Lichtwellenleiters **LWL** in das Sensorelement **SE** und umgekehrt.

Die gedachte virtuelle Mittenlinie **ML** des Lichtwellenleiters **LWL** durchstößt im Falle eines langgestreckten, insbesondere faserförmigen Lichtwellenleiters **LWL** die Endfläche **EF** des Lichtwellenleiters **LWL** am ersten Ende **ELWL1** des Lichtwellenleiters **LWL** an einem Mittelpunkt **MP** der Endfläche **EF** des Lichtwellenleiters **LWL.** Bevorzugt ist Dicke **dₗ** des Trägermaterials **TM** an diesem Mittelpunkt **MP** dicker als die Dicke **dᵣ** an anderen Punkten der Endfläche **EF** des ersten Endes **ELWL1** des Lichtwellenleiters **LWL.** Hierdurch formt sich ein optisches Funktionselement am ersten Ende **ELWL1** des Lichtwellenleiters **LWL** aus. Dies verbessert die Auskopplung elektromagnetischer Strahlung aus dem Kern **LWLC** des Lichtwellenleiters **LWL** in das Sensorelement **SE** und umgekehrt.

Bevorzugt formt daher das Trägermaterial **TM** am ersten Ende **ELWL1** des Lichtwellenleiters **LWL** im Falle eines langgestreckten, insbesondere faserförmigen Lichtwellenleiters **LWL** eine Linse **LWLL** aus, deren Durchmesser **D_{LWLL}** vorzugsweise kleiner als der Durchmesser **D_{LWL}** des Lichtwellenleiters **LWL** oder so groß wie der der Durchmesser **D_{LWL}** des Lichtwellenleiters **LWL** ist. Dies verringert das Messvolumen des Sensorelements und steigert damit die Ortsauflösung magnetischer Messungen. Somit kann dann im ersten Anwendungsbeispiel eines Sensorkopfes **SK** das hier vorgestellte Verfahren mittels der vorgeschlagenen Vorrichtung besonders kleine Risse **RI** in der Oberfläche **OF** des Materials des Werkstücks entdecken.

Bevorzugt ist der erste Lichtwellenleiter **LWL** im Falle eines langgestreckten, insbesondere faserförmigen ersten Lichtwellenleiters **LWL** ganz oder teilweise durch eine erste mechanische Hülle **MH** umhüllt. Bevorzugt umfasst die mechanische Hülle **MH** einen Keramikwerkstoff oder ein anderes nicht magnetisierbares und/oder elektrisch nichtleitendes Material und/oder ein bei Temperaturen oberhalb von 100°C stabiles Material und/oder ein bei Temperaturen oberhalb von 140°C stabiles Material und/oder ein bei Temperaturen oberhalb von 170°C stabiles Material und/oder ein bei Temperaturen oberhalb von 200°C stabiles Material und/oder ein bei Temperaturen oberhalb von 250°C stabiles Material oder weist ein solches Material auf. Dies schützt das Sensorelement **SE** und den Lichtwellenleiter **LWL** vor Beschädigung. Bevorzugt ist die mechanische Hülle **MH** aus einem Keramikwerkstoff oder aus einem anderen nicht magnetisierbaren und/oder elektrisch nichtleitendes Material und/oder aus einem bei Temperaturen oberhalb von 100°C stabilen Material und/oder aus einem bei Temperaturen oberhalb von 140°C stabilen Material und/oder aus einem bei Temperaturen oberhalb von 170°C stabilen Material und/oder aus einem bei Temperaturen oberhalb von 200°C stabilen Material und/oder aus einem bei Temperaturen oberhalb von 250°C stabilen Material gefertigt.

Zur besseren Verarbeitung und Montage umfasst die mechanische Hülle **MH** im Falle eines langgestreckten, insbesondere faserförmigen Lichtwellenleiters **LWL** bevorzugt zumindest abschnittweise ein Rohr oder Röhrchen oder eine Kapillare oder eine Kanüle oder einen Schlauch, insbesondere einen Gewebeschlauch.

Die Fluoreszenzstrahlung der NV-Zentren **NVZ** und/oder der anderen paramagnetischen Zentren in den

Diamanten bzw. den Nanodiamanten **DM** und/oder der Kristalle des Trägermaterials **TM** und insbesondere die Fluoreszenzwellenlänge **λ_{fl}** derer Fluoreszenzstrahlung FL kann beispielsweise mittels plasmonischer Kopplung durch metallische Nanopartikel, die dem Trägermaterial **TM** ebenfalls beigemischt werden, modifiziert werden. In dem Fall kann dann beispielsweise das Trägermaterial **TM** metallische Nanopartikel mit einem Durchmesser kleiner 200nm und/oder kleiner 100nm und/oder kleiner 50nm und/oder kleiner 20nm und/oder kleiner 10nm und/oder kleiner 5nm aufweisen, die später dann in dem verfestigten Trägermaterial **TM** eingelagert sind. Dies verbessert die Anwendbarkeit in speziellen Anwendungsfällen.

Die metallischen Nanopartikel wechselwirken dann typischerweise plasmonisch mit Diamanten bzw. Nanodiamanten **DM** und/oder Kristallen in dem Trägermaterial **TM** und beeinflussen dann so die Fluoreszenzstrahlung **FL** dieser Diamanten **DM** und/oder Kristalle.

Diese metallischen Nanopartikel weisen typischerweise Gold und/oder Platin und/oder Palladium und/oder Graphit und/oder Graphen und/oder Chrom und/oder Silizium und/oder Germanium und/oder Zinn und/oder Schwefel und/oder Selen und/oder Tellur und/oder Magnesium und/oder Kalzium und/oder Strontium und/oder Barium und/oder Titan und/oder Zirkon und/oder Hafnium und/oder Chrom und/oder Molybdän und/oder Wolfram und/oder Eisen und/oder Ruthenium und/oder Osmium und/oder Nickel und/oder Zinn und/oder Kadmium und/oder Quecksilber und/oder Cerium und/oder Neodym und/oder Samarium und/oder Gadolinium und/oder Dysprosium und/oder Erbium und/oder Ytterbium und/oder Thorium und/oder Proactinium und/oder Uran und/oder Plutonium auf. Wobei erstere besonders bevorzugt sind.

Die Atome des Metalls der Nanopartikel umfassen eines oder mehrerer Elemente des Periodensystems. Jedes dieser Elemente tritt in verschiedenen Isotopen in der Natur mit einem jeweiligen natürlichen Isotopenmischungsverhältnis auf. Jedes Isotop eines Elements weist dabei einen natürlichen Anteil entsprechend dem natürlichen Isotopenmischungsverhältnis dieses Elements auf. Hinsichtlich der dieser Anteile und der Werte verweist das hier vorgelegte Dokument auf die deutsche Patentanmeldung DE 10 2020 125 178 A1 der Anmelderin. Diese Isotope weisen jeweils ein magnetisches Kernmoment µ auf oder nichtaufweisen je nach Isotop. Bevorzugt weisen die metallischen Nanopartikel bei zumindest einem Element, das die metallischen Nanopartikel aufweisen, einen erhöhten Anteil im Isotopenmischungsverhältnis gegenüber dem natürlichen Anteil des Isotopenmischungsverhältnisses für zumindest eines der folgenden Isotope auf:¹²C, ¹⁴C, ²⁸Si, ³⁰Si, ⁷⁰Ge, ⁷²Ge, ⁷⁴Ge, ⁷⁶Ge,¹¹²Zn, ¹¹⁴Zn, ¹¹⁶Zn, ¹¹⁸Zn, ¹²⁰Zn, ¹²²Zn, ¹²⁴Zn ¹⁶O, ¹⁸O, ³²S, ³⁴S, ³⁶S, ⁷⁴Se, ⁷⁶Se, ⁷⁸Se, ⁸⁰Se, ³²Se, ¹²⁰Te, ¹²²Te, ¹²⁴Te, ¹²⁶Te, ¹²⁸Te, ¹³⁰Te, ²⁴Mg, ²⁶Mg, ⁴⁰Ca, ⁴²Ca, ⁴⁴Ca, ⁴⁶Ca, ⁴⁸Ca, ⁸⁴Sr, ⁸⁶Sr, ⁸⁸Sr, ¹³⁰Ba, ¹³²Ba, ¹³⁴Ba, ¹³⁶Ba, ¹³⁸Ba, ⁴⁶Ti, ⁴⁸Ti, ⁵⁰Ti, ⁹⁰Zr, ⁹⁰Zr, ⁹²Zr, ⁹⁴Zr, ⁹⁶Zr, ¹⁷⁴Hf, ¹⁷⁶Hf, ¹⁷⁸Hf, ⁵⁰Cr, ⁵²Cr, ⁵³Cr, ⁹²Mo, ⁹⁴Mo, ⁹⁶Mo, ⁹³Mo, ¹⁰⁰Mo, ¹⁸⁰W, ¹⁸²W, ¹⁸⁴W, ¹⁸⁶W, ⁵⁴Fe, ⁵⁶Fe, ⁵⁸Fe, ⁹⁶Ru, ⁹⁸Ru, ¹⁰⁰Ru, ¹⁰²Ru, ¹⁰⁴Ru, ¹⁸⁴Os, ¹⁸⁶Os, ¹⁸³Os, ¹⁹⁰Os, ¹⁹²Os ⁵⁸Ni, ⁶⁰Ni, ⁶²Ni, ⁶⁴Ni, ¹⁰²Pd, ¹⁰²Pd, ¹⁰⁴Pd, ¹⁰⁶Pd, ¹⁰⁸Pd, ¹¹⁰Pd, ¹⁹⁰Pt, ¹⁹²Pt, ¹⁹⁴Pt, ¹⁹⁶Pt, ¹⁹³Pt ⁶⁴Zn, ⁶⁶Zn, ⁶⁸Zn, ⁷⁰Zn, ¹⁰⁶Cd, ¹⁰⁸Cd, ¹¹⁰Cd, ¹¹²Cd, ¹¹⁴Cd, ¹¹⁶Cd, ¹⁹⁶Hg, ¹⁹⁸Hg, ²⁰⁰Hg, ²⁰²Hg, ²⁰⁴Hg ¹³⁶Ce, ¹³⁸Ce, ¹⁴⁰Ce, ¹⁴²Ce, ¹⁴²Nd, ¹⁴⁴Nd, ¹⁴⁶Nd, ¹⁴⁸Nd, ¹⁵⁰Nd, ¹⁴⁴Sm, ¹⁴⁶Sm, ¹⁴³Sm, ¹⁵⁰Sm, ¹⁵²Sm, ¹⁵⁴Sm, ¹⁵²Gd, ¹⁵⁴Gd, ¹⁵⁶Gd, ¹⁵⁸Gd, ¹⁶⁰Gd, ¹⁵⁶Dy, ¹⁵⁸Dy, ¹⁶⁰Dy, ¹⁶²Dy, ¹⁶⁴Dy, ¹⁶²Er, ¹⁶⁴Er, ¹⁶⁶Er, ¹⁶⁸Er, ¹⁷⁰Er, ¹⁶⁸Yb, ¹⁷⁰Yb, ¹⁷²Yb, ¹⁷⁴Yb, ¹⁷⁶Yb, ²³²Th, ²³⁴Pa, ²³⁴U, ²³⁸U, ²⁴⁴Pu.

Der Lichtwellenleiter **LWL** kann einen Lichtwellenleiterkern **LWLC** aufweisen. In dem Trägermaterial **TM** formt das Trägermaterial **TM** bevorzugt ein optisches Funktionselement am ersten Ende **ELWL1** des Lichtwellenleiters **LWL** aus. Dies verbessert wieder die besagte optische Kopplung zwischen Lichtwellenleiter **LWL** und Trägermaterial **TM.** Das optische Funktionselement wirkt dann so mit dem Lichtwellenleiterkern **LWLC** des Lichtwellenleiters **LWL** am ersten Ende **ELWL1** des Lichtwellenleiters **LWL** optisch zusammen.

Bevorzugt weist das optische Funktionselement eine Lichtwellenleiterlinse **LWLL,** insbesondere in Form einer Verdickung des Trägermaterials **TM** im Bereich des optischen Funktionselements, auf.

Das Wesentliche des hier vorgelegten Dokuments ist nun, dass es auch ein Verfahren zur Herstellung eines Lichtwellenleiters **LWL,** wie er zuvor beschrieben und verwendet wurde, beschreibt und offenlegt. Das vorgeschlagene Verfahren umfasst die Schritte:
- Bereitstellen **140** eines Lichtwellenleiters **LWL,** wobei der Lichtwellenleiter **LWL** ein erstes Ende **ELWL1** und ein zweites Ende **ELWL2** aufweist
   wobei der Lichtwellenleiter **LWL** für elektromagnetische Strahlung der Pumpstrahlungswellenlänge λₚₘₚ der Pumpstrahlung **LB** und/oder für elektromagnetische Strahlung der Fluoreszenzstrahlungswellenlänge λ_{fl} der Fluoreszenzstrahlung **LB** und für elektromagnetische Strahlung einer Aushärtewellenlänge λ_{H} des Trägermaterials **TM** des Sensorelements **SE** transparent ist;
- Bereitstellen **142** eines flüssigen und mittels elektromagnetischer Strahlung einer Aushärtewellenlänge λ_{H} härtbaren Trägermaterials **TM,** wobei in das Trägermaterial **TM** eine Vielzahl von Diamanten **DM,** vorzugsweise Nanodiamanten, und/oder Kristalle eingebettet sind und wobei einer oder mehrere oder alle Diamanten **DM** dieser Diamanten **DM** und/oder ein oder mehrere Kristalle dieser Kristalle NV-Zentren **NVZ** und/oder andere paramagnetischen Zentren aufweisen und wobei die NV-Zentren **NVZ** der Diamanten **DM** und/oder Kristalle des Trägermaterials **TM** und/oder die anderen paramagnetischen Zentren der Diamanten **DM** und/oder Kristalle des Trägermaterials **TM** bei Bestrahlung mit Pumpstrahlung **LB** zumindest eine Fluoreszenzstrahlung **FL** emittieren;
- Benetzen **145** des ersten Endes des Lichtwellenleiters **TM** insbesondere auf eine Benetzungslänge **L_{B}**, mit dem Trägermaterial **TM,** das die Vielzahl eingebetteter Diamanten **DM** und/oder Kristalle aufweist;
- ggf. Vorhärten **147** (Pre-Bake) des Sensorelements **SE** durch eine vorausgehende Temperaturbehandlung.
- Einspeisen **150** elektromagnetischer Strahlung in das zweite Ende des Lichtwellenleiters **LWL,** wobei die Wellenlänge dieser elektromagnetischen Strahlung, die Aushärtewellenlänge λ_{H}, so gewählt ist, dass das Trägermaterial **TM** am zweiten Ende des Lichtwellenleiters **LWL** aushärtet und sich in einen Festkörper wandelt.
- Entfernen **160** des nicht ausgehärteten Trägermaterials **TM** insbesondere mittels eines Lösungsmittels, wobei der verbleibende Film des Trägermaterials **TM** am ersten Ende des Lichtwellenleiters **LWL** das Sensorelement **SE** bildet.
- ggf. Nachhärten **165** (Post-Bake) des Sensorelements **SE** durch eine nachfolgende Temperaturbehandlung.

Typischerweise härtet das Trägermaterial **TM** nur teilweise aus, was die Bildung des optischen Funktionselements ermöglicht.

Die elektromagnetischen Strahlung mit der Aushärtewellenlänge λ_{H} weist eine Eindringtiefe in das Trägermaterial **TM** auf, so dass das Trägermaterial **TM** nur bis zu einer Dicke **dₗ** des Trägermaterials aushärtet und so das optische Funktionselement bildet, was im Rahmen der Ausarbeitung der technischen Lehre dieser Schrift erst als überraschendes und vorteilhaftes Vorgehen erkannt wurde.

Die Strahlung der am zweiten Ende **ELWL2** des Lichtwellenleiters **LWL** zur Aushärtung eingespeisten Strahlung ist bevorzugt UV-Strahlung. Ganz besonders bevorzugt ist eine Strahlung zur Aushärtung mit einer Aushärtewellenlänge λ_{H} zwischen 320-380nm.

In bestimmten Anwendungsfällen können dem Trägermaterial **TM** Nanopartikel mit einem Durchmesser kleiner 200nm und/oder kleiner 100nm und/oder kleiner 50nm und/oder kleiner 20nm und/oder kleiner 10nm und/oder kleiner 5nm vor dem Bereitstellen beigemischt werden, sodass diese in dem Trägermaterial **TM** nach dem Aushärten eingelagert sind. Bevorzugt handelt es sich um metallische Nanopartikel.

Solche metallischen Nanopartikel wechselwirken mit Diamanten bzw. Nanodiamanten **DM** und/oder Kristalle in dem Trägermaterial **TM** und können beispielsweise die Fluoreszenzstrahlung **FL** dieser Diamanten bzw. Nanodiamanten **DM** und/oder Kristalle beeinflussen.

Die metallischen Nanopartikel umfassen beispielsweise Gold und/oder Platin und/oder Palladium und/oder Graphit und/oder Graphen und/oder Chrom und/oder Silizium und/oder Germanium und/oder Zinn und/oder Schwefel und/oder Selen und/oder Tellur und/oder Magnesium und/oder Kalzium und/oder Strontium und/oder Barium und/oder Titan und/oder Zirkon und/oder Hafnium und/oder Chrom und/oder Molybdän und/oder Wolfram und/oder Eisen und/oder Ruthenium und/oder Osmium und/oder Nickel und/oder Zinn und/oder Kadmium und/oder Quecksilber und/oder Cerium und/oder Neodym und/oder Samarium und/oder Gadolinium und/oder Dysprosium und/oder Erbium und/oder Ytterbium und/oder Thorium und/oder Proactinium und/oder Uran und/oder Plutonium und/oder Mischungen derselben.

Die Atome des Metalls der Nanopartikel umfassten naturgemäß eines oder mehrerer Elemente des Periodensystems der Elemente. Jedes dieser Elemente tritt in verschiedenen Isotopen in der Natur mit einem jeweiligen natürlichen Isotopenmischungsverhältnis auf. Jedes Isotop weit in der Natur dabei einen natürlichen Anteil entsprechend dem natürlichen Isotopenmischungsverhältnis auf. Diese Isotope können ein magnetisches Kernmoment µ aufweisen oder nichtaufweisen je nach Isotop. Die metallischen Nanopartikel weisen bei zumindest einem Element, das die metallischen Nanopartikel aufweisen, einen erhöhten Anteil im Isotopenmischungsverhältnis gegenüber dem natürlichen Anteil des Isotopenmischungsverhältnisses für zumindest eines der folgenden Isotope auf :¹²C, ¹⁴C, ²⁸Si, ³⁰Si, ⁷⁰Ge, ⁷²Ge, ⁷⁴Ge, ⁷⁶Ge,¹¹²Zn, ¹¹⁴Zn, ¹¹⁶Zn, ¹¹⁸Zn, ¹²⁰Zn, ¹²²Zn, ¹²⁴Zn ¹⁶O, ¹⁸O, ³²S, ³⁴S, ³⁶S, ⁷⁴Se, ⁷⁶Se, ⁷⁸Se, ⁸⁰Se, ⁸²Se, ¹²⁰Te, ¹²²Te, ¹²⁴Te, ¹²⁶Te, ¹²⁸Te, ¹³⁰Te, ²⁴Mg, ²⁶Mg, ⁴⁰Ca, ⁴²Ca, ⁴⁴Ca, ⁴⁶Ca, ⁴⁸Ca, ⁸⁴Sr, ⁸⁶Sr, ⁸⁸Sr, ¹³⁰Ba, ¹³²Ba, ¹³⁴Ba, ¹³⁶Ba, ¹³⁸Ba, ⁴⁶Ti, ⁴⁸Ti, ⁵⁰Ti, ⁹⁰Zr, ⁹⁰Zr, ⁹²Zr, ⁹⁴Zr, ⁹⁶Zr, ¹⁷⁴Hf, ¹⁷⁶Hf, ¹⁷⁸Hf, ⁵⁰Cr, ⁵²Cr, ⁵³Cr, ⁹²Mo, ⁹⁴Mo, ⁹⁶Mo, ⁹⁸Mo, ¹⁰⁰Mo, ¹⁸⁰W, ¹⁸²W, ¹⁸⁴W, ¹⁸⁶W, ⁵⁴Fe, ⁵⁶Fe, ⁵⁸Fe, ⁹⁶Ru, ⁹⁸Ru, ¹⁰⁰Ru, ¹⁰²Ru, ¹⁰⁴Ru, ¹⁸⁴Os, ¹⁸⁶Os, ¹⁸³Os, ¹⁹⁰Os, ¹⁹²Os ⁵⁸Ni, ⁶⁰Ni, ⁶²Ni, ⁶⁴Ni, ¹⁰²Pd, ¹⁰²Pd, ¹⁰⁴Pd, ¹⁰⁶Pd, ¹⁰⁸Pd, ¹¹⁰Pd, ¹⁹⁰Pt, ¹⁹²Pt, ¹⁹⁴Pt, ¹⁹⁶Pt, ¹⁹⁸Pt ⁶⁴Zn, ⁶⁶Zn, ⁶⁸Zn, ⁷⁰Zn, ¹⁰⁶Cd, ¹⁰⁸Cd, ¹¹⁰Cd, ¹¹²Cd, ¹¹⁴Cd, ¹¹⁶Cd, ¹⁹⁶Hg, ¹⁹⁸Hg, ²⁰⁰Hg, ²⁰²Hg, ²⁰⁴Hg ¹³⁶Ce, ¹³⁸Ce, ¹⁴⁰Ce, ¹⁴²Ce, ¹⁴²Nd, ¹⁴⁴Nd, ¹⁴⁶Nd, ¹⁴⁸Nd, ¹⁵⁰Nd, ¹⁴⁴Sm, ¹⁴⁶Sm, ¹⁴⁸Sm, ¹⁵⁰Sm, ¹⁵²Sm, ¹⁵⁴Sm, ¹⁵²Gd, ¹⁵⁴Gd, ¹⁵⁶Gd, ¹⁵⁸Gd, ¹⁶⁰Gd, ¹⁵⁶Dy, ¹⁵⁸Dy, ¹⁶⁰Dy, ¹⁶²Dy, ¹⁶⁴Dy, ¹⁶²Er, ¹⁶⁴Er, ¹⁶⁶Er, ¹⁶⁸Er, ¹⁷⁰Er, ¹⁶⁸Yb, ¹⁷⁰Yb, ¹⁷²Yb, ¹⁷⁴Yb, ¹⁷⁶Yb, ²³²Th, ²³⁴Pa, ²³⁴U, ²³⁸U, ²⁴⁴Pu. "Erhöht" bedeutet dabei im Sinne dieses Dokuments, dass der Anteil im Isotopenmischverhältnis der vorstehenden Isotope um 50% oder mehr erhöht ist.

Der Lichtwellenleiter **LWL** weist vorzugsweise im Falle eines faserförmigen und/oder langestreckten einen Lichtwellenleiterkern **LWLC** auf. Das vorgeschlagene Verfahren formt bevorzugt in dem Trägermaterial **TM** beim Aushärten mit Strahlung der Aushärtewellenlänge **λ_{H}** ein optisches Funktionselement **LWLL** am ersten Ende **ELWL1** des Lichtwellenleiters **LWL** aus, wobei die Strahlung der Aushärtewellenlänge λ_{H} über das zweite Ende **ELWL2** des Lichtwellenleiters **LWL** eingespeist und dem Trägermaterial **TM** zugeführt wird.

Das dann so ausgeformte optische Funktionselement **LWL** kann dann mit dem Lichtwellenleiterkern **LWLC** am ersten Ende **ELWL1** des Lichtwellenleiters **LWL** optisch zusammenwirken, wenn am zweiten Ende **ELWL2** des Lichtwellenleiters **LWL** optische Strahlung, insbesondere Pumpstrahlung **LB** mit der Pumpstrahlungswellenlänge λₚₘₚ eingespeist wird.

Das optische Funktionselement weist dann eine Lichtwellenleiterlinse **LWLL,** insbesondere in Form einer Verdickung des Trägermaterials **TM** aufweist.

Das hier vorgestellte Dokument schlägt als Trägermaterial **TM** beispielsweise ein klares, farbloses, flüssiges Fotopolymer, beispielsweise den optischen Norland Klebstoff 61 vor. Weitere Informationen sind zum Zeitpunkt der Anmeldung des hier vorgelegten Dokuments unter https://www.norlandprod.com/adhesives/noa%2061.html verfügbar.

Norland Optical Adhesive 61 ("NOA 61") ist ein klares, farbloses, flüssiges Fotopolymer, das unter ultraviolettem Licht aushärtet. Da es sich um ein Einkomponentensystem mit 100 % Feststoffanteil handelt, bietet es viele Vorteile bei Verklebungen, bei denen der Klebstoff UV-Licht ausgesetzt werden kann. Durch die Verwendung von NOA 61 entfällt das Vormischen, Trocknen oder Aushärten durch Wärme, wie es bei anderen Klebstoffsystemen üblich ist. Die Aushärtezeit ist kurz und hängt von der aufgetragenen Dicke und der verfügbaren UV-Lichtenergie ab. Es ist besonders sinnvoll, wenn das Trägermittel TM Federal Specification MIL-A-3920 für optische Klebstoffe erfüllt. NOA 61 erfüllt die Federal Specification MIL-A-3920 für optische Klebstoffe. Das Trägermaterial TM soll eine bestmögliche optische Verbindung zu Glasoberflächen, Metallen, Glasfasern und glasgefüllten Kunststoffen herstellen. NOA61 erfüllt diese Voraussetzung. Besonders günstig ist die Verwendung eines Trägermaterials **TM,** das für die Verklebung von Linsen, Prismen und Spiegeln für militärische, luft- und raumfahrttechnische und kommerzielle Optiken sowie für den Abschluss und das Spleißen von Glasfasern empfohlen ist. NOA61 erfüllt diese Voraussetzungen.

Das Trägermaterial **TM** soll sich außerdem durch hervorragende Klarheit, geringe Schrumpfung und Lichtflexibilität auszeichnen. Diese Eigenschaften sind wichtig, damit der Anwender qualitativ hochwertige Sensorelemente **SE** herstellen und eine langfristige Leistung unter wechselnden aggressiven Umgebungsbedingungen erzielen kann.

NOA 61 härtet, wie für das Trägermaterial **TM** gewünscht, mit ultraviolettem Licht aus, wobei die maximale Absorption im Bereich von 320-380 Nanometern für die Aushärtewellenlänge λ_{H} liegt und die höchste Empfindlichkeit bei 365 nm erreicht wird. Die empfohlene Energie für die vollständige Aushärtung beträgt 3 Joule/cm² bei diesen Wellenlängen. Die Aushärtung wird durch Sauerstoff nicht gehemmt, so dass alle Bereiche, die mit Luft in Berührung kommen, zu einem nicht klebrigen Zustand aushärten, wenn sie ultraviolettem Licht ausgesetzt werden.

Bei den meisten optischen Anwendungen erfolgt die Aushärtung in zwei Schritten. Zunächst erfolgt eine kurze, gleichmäßige Belichtung, die sogenannte Vorhärtung. Die Aushärtungszeit ist ausreichend lang, um die Verbindung zu verfestigen und zu ermöglichen, dass sie bewegt werden kann, ohne die Ausrichtung zu stören.

Danach folgt eine längere Aushärtung unter UV-Licht, um eine vollständige Vernetzung und Lösungsmittelbeständigkeit des Klebstoffs zu erreichen. Die Aushärtung kann in 10 Sekunden mit einer 100-Watt-Quecksilberlampe bei 6" erfolgen. Wenn für die Ausrichtung eine längere Zeit erforderlich ist, kann sie mit einer Lichtquelle sehr geringer Intensität auf einige Minuten verlängert werden. Die endgültige Aushärtung kann mit der 100-Watt-Quecksilberlampe in 5 bis 10 Minuten erreicht werden.

Die Vorhärtung ermöglicht es dem Anwender, den Lichtwellenleiter **LWL** bei Bedarf schnell auszurichten und zu fixieren, und minimiert die Anzahl der erforderlichen Haltevorrichtungen. Nach der Vorfixierung kann überschüssiger Klebstoff mit einem mit Alkohol oder Aceton als beispielhaftes Lösungsmittel angefeuchteten Tuch abgewischt werden. Die Lichtwellenleiter **LWL** sollten zu diesem Zeitpunkt geprüft und Ausschuss in Methylenchlorid separiert werden. Der beschichtete Bereich der Sensorelemente **SE** muss in dem Lösungsmittel eingeweicht werden und löst sich normalerweise über Nacht. Die Zeit, die benötigt wird, um das Trägermaterial **TM** zu lösen, hängt vom Ausmaß der Aushärtung und der Größe der Beschichtung ab.

Nach der Aushärtung weist NOA 61 eine sehr gute Haftung und Lösungsmittelbeständigkeit auf, aber es hat noch nicht seine optimale Haftung auf Glas erreicht. Diese wird durch eine Alterung über einen Zeitraum von etwa 1 Woche erreicht, in der sich eine chemische Verbindung zwischen Glas und Klebstoff bildet. Diese optimale Haftung kann auch durch eine Alterung bei 50° C für 12 Stunden in einem Temperaturschrank erreicht werden.

NOA 61 hält vor der Alterung Temperaturen von -15°C bis 60° C stand, wenn es zum Beschichten des Lichtwellenleiters LWL verwendet wird. Nach der Alterung hält es Temperaturen von -150°C bis 125°C stand. Als Beschichtung auf der Oberfläche des Lichtwellenleiters hält NOA 61 drei Stunden lang 260°C und beim Reflow-Löten stand. Hierdurch kann das Sensorelement **SE** bis zu diesen Temperaturen für die Messung der magnetischen Flussdichte B verwendet werden. Das hier vorgelegte Dokument schlägt daher die Verwendung eines vorschlagsgemäßen Lichtwellenleiters **LWL** bei Temperaturen oberhalb von 100°C und/oder sogar oberhalb von 110°C und/oder sogar oberhalb von 120°C und/oder sogar oberhalb von 130°C und/oder sogar oberhalb von 140°C und/oder sogar oberhalb von 150°C und/oder sogar oberhalb von 160°C und/oder sogar oberhalb von 170°C und/oder sogar oberhalb von 180°C und/oder sogar oberhalb von 190°C und/oder sogar oberhalb von 200°C und/oder sogar oberhalb von 210°C und/oder sogar oberhalb von 220°C und/oder sogar oberhalb von 230°C und/oder sogar oberhalb von 240°C und/oder sogar oberhalb von 250°C und/oder sogar oberhalb von 260°C vor. Für die höheren Temperaturen eignet sich NOA 61 nicht. Hier sind andere Materialien, sinnvoll.

Typische Eigenschaften eines Trägermittel sind ein Feststoffgehalt mehr als 80%, eine Viskosität bei 25°C von mehr als 250 cps, ein Brechungsindex des gehärteten Trägermaterials TM von mehr als 1,2 eine Dehnung bei Bruch von weniger als 50% oder mehr als 25% je nach Anwendung, ein Elastizitätsmodul von weniger als (psi) 200.000, eine Zugfestigkeit von mehr als (psi) 3.000 und eine Härte von mehr als Shore D 60.

Typische Eigenschaften von NOA 61 als beispielhaftes Trägermittel sind ein Feststoffgehalt von 100%, eine Viskosität bei 25°C von 300 cps, en Brechungsindex des gehärteten Polymers von 1,56, eine Dehnung bei Bruch von 38%, ein Elastizitätsmodul von (psi) 150.000, eine Zugfestigkeit von (psi) 3.000 und eine Härte von Shore D 85.

### Vorteil

Folgende Vorteile zeichnen die hier in diesem Dokument vorgeschlagene technische Lösung aus:
- Das Sensorelement **SE** ist galvanisch von der Auswerteelektronik der jeweiligen Anwendungsschaltung getrennt
- Das Sensorelement **SE** ist thermisch von der Auswerteelektronik der jeweiligen Anwendungsschaltung getrennt
- Das Sensorelement **SE** und seine Leitung (Lichtwellenleiter LWL) sind Diamagnetisch und beeinflussen die Messung nicht.
- Die Anwendungsvorrichtungen (beispielsweise Sensorkopf SK und Motor) sind unanfällig gegenüber elektrostatischen Störungen
- Das Sensorelement **SE** kann ein kleines Messvolumen (Fibercore- Durchmesser 9µm bis 1000µm) aufweisen,
- Die Dicke des Materials des Trägermaterials **TM** mit den Diamanten **DM** und/oder Nanodiamanten und/oder Kristallen mit den paramagnetischen Zentren und/oder NV-Zentren an dem ersten Ende des Lichtwellenleiters ist variabel
- die mögliche Messfrequenz reicht von DC (0Hz) bis in den MHz Bereich
- Gleicher Sensor für DC / AC Magnetfeldanregung
- Diamagnetischer Messkopf (Sensor beeinflusst Messung nicht)

Eine solche Vorrichtung, wie in der obigen Beschreibung beschrieben, ermöglicht in dem zweiten Anwendungsbeispiel eines Motors eine Erfassung des Magnetfelds im Luftspalt eines Motors, ohne dieses Magnetfeld zu stören, ohne EMV-Probleme zu verursachen und ohne Probleme mit einer nicht vorhandenen galvanischen Trennung zu verursachen. Der Bauraum einer solchen Lösung ist extrem klein. Die Lösung ist robust gegen thermische und chemische Anforderungen. Sie funktioniert z.B. auch bei 100°K und möglicherweise bis hinunter zu 0°K.

### Drittes Anwendungsbeispiel Magnetfeldkamera

Die Grundidee des in diesem Dokument beschriebenen dritten Anwendungsbeispiels ist, das Fluoreszenzlicht einer magnetfeldsensitiven Fluoreszenzschicht als Sensorelement **SE** mittels einer optischen Fluoreszenzlichtkamera als ortsauflösendem Fotodetektor **PD** zu erfassen. Das hier vorgelegte Dokument schlägt vor, als Fluoreszenzschicht Diamantkristalle und zwar vorzugsweise Diamantnanokristalle in einem Trägermaterial als Material der Fluoreszenzschicht zu verwenden. Statt der Diamantkristalle können auch alternativ oder zusätzlich andere Kristalle verwendet werden, die bei Bestrahlung mit Pumpstrahlung Fluoreszenzstrahlung emittieren. Sofern dies nicht ausdrücklich anders beschrieben ist, kann die Leserin bzw. der Leser bei der Erwähnung von Diamanten andere Kristalle mit funktionsäquivalenten Fluoreszenzeigenschaften mitlesen und bei der Erwähnung von NV-Zentren andere paramagnetische Zentren funktionsäquivalenter Fluoreszenzeigenschaften mitlesen. Besonders bevorzugt handelt es sich bei den Diamantnanokristallen um HDNV-Diamanten. Das hier vorgelegte Dokument verweist in diesem Zusammenhang auf die oben angegebenen Dokument aus dem Stand der Technik. (Z.B. DE 10 2021 132 780 A1)

Das hier vorgelegte Dokument schlägt im Zusammenhang mit der vorgeschlagenen Magnetfeldkamera als drittes Ausführungsbeispiel vor, die NV-Zentren in den Nanodiamanten der Fluoreszenzschicht der mit einer Pumpstrahlung mit einer Pumpstrahlungswellenlänge zu bestrahlen. Diese Bestrahlung der Nanodiamanten der Fluoreszenzschicht mit Pumpstrahlung regt die NV-Zentren der Nanodiamanten der Fluoreszenzschicht zur Emission von Fluoreszenzstrahlung mit einer Fluoreszenzwellenlänge an. Bevorzugt ist das Trägermaterial, in dem die Nanodiamanten eingebettet sind, für Strahlung der Pumpstrahlungswellenlänge und für Strahlung der Fluoreszenzwellenlänge transparent. Die magnetische Flussdichte B des zu vermessenden magnetischen Feldes durchdringt die Fluoreszenzschicht. Typischerweise ist die Durchdringung der Fluoreszenzschicht durch die magnetische Flussdichte B nicht homogen, sondern hängt von den magnetisierbaren Körpern und der Verteilung magnetischer Stoffe etc. in der Nähe der Fluoreszenzschicht ab. Bevorzugt ist die Orientierung der Nanodiamanten stochastisch gleichmäßig verteilt, sodass die Fluoreszenzstrahlung der NV-Zentren der Nanodiamanten der Fluoreszenzschicht nicht von der Richtung der magnetischen Flussdichte B, sondern nur von dem Betrag der magnetischen Flussdichte B abhängt.

Typischerweise hängt daher die Fluoreszenzstrahlungsintensität der Fluoreszenzstrahlung der NV-Zentren der Fluoreszenzschicht ortsabhängig von dem ortsabhängigen Betrag der magnetischen Flussdichte am Ort des jeweiligen NV-Zentrums in der Fluoreszenzschicht ab.

Eine Fluoreszenzkamera der vorgeschlagenen Magnetfeldkamera als drittes Ausführungsbeispiel erfasst die ortsabhängige Intensität der Fluoreszenzstrahlung der NV-Zentren in einer Schicht mit paramagnetischen Zentren in einer Vielzahl von Kristallen . Hierzu umfasst die Fluoreszenzkamera bevorzugt einem zweidimensionales Array von Lichtsensoren eines Lichtsensorarrays, die für die elektromagnetische Strahlung der Fluoreszenzwellenlänge empfindlich sind. Beispielsweis kann das zweidimensionales Array von Lichtsensoren des Lichtsensorarrays der Fluoreszenzkamera ein CCD-Sensor-Array oder ein CMOS-Array oder ein SPAD-Array umfassen. Eine Auswerteschaltung stellt den Lichtsensoren, soweit notwendig, die ggf. erforderliche Betriebsspannung zur Verfügung. Typischerweise erzeugen die Lichtsensoren einen Fotostrom und/oder eine Fotoladung, die typischerweise proportional zur empfangenen Lichtintensität ist oder zumindest von der jeweils empfangenen Lichtintensität abhängt. Die Auswerteschaltung erfasst den Wert dieses Fotostroms bzw. der Fotoladung und ermittelt daraus pixelweise einen Messwert für die Intensität der Fluoreszenzstrahlung an dem Ort der Fluoreszenzschicht der Sensorschicht, den die Optik der Fluoreszenzkamera auf das jeweilige Pixel abbildet. Die Fluoreszenzschicht umfasst Kristalle mit paramagnetischen Zentren, die in Abhängigkeit von der magnetischen Flussdichte B und der Intensität der Pumpstrahlung mit der sie bestrahlt werden, fluoreszieren. Auf diese Weise kann die Fluoreszenzkamera die einen Wert der magnetischen Flussdichte je Pixel des Fotodetektor-Arrays bestimmen, der mit einen diesem Pixel zugeordneten Bereich der Fluoreszenzschicht korrespondiert.

Die Erfindung nutzt die Verbindung zwischen Diamantstaub und UV-Kleber und das Know-How aus Messungen von Magnetfeldern durch fasergekoppelte Messung der Fluoreszenz von NV-reichem Diamantpulver. Das hier vorgelegte Dokument verweist in diesem Zusammenhang auf die unveröffentlichte deutschen Patentanmeldung DE 10 2022 122 505.4.

Als Sensorelement kommt flächig auf ein Trägermaterial aufgebrachter NV-haltiger Diamantstaub (Größe beliebig, sollte jedoch möglichst im Bereich von 100nm - 2µm Partikeln liegen.) in Verbindung mit einem optisch transparenten (500nm - 850nm) Verbundmaterial (z.B. UV-Kleber oder anderen optisch transparenten Materialien, wie z.B. Glas, Glaspasten, Epoxy etc.) zum Einsatz. Dabei gibt es keine Einschränkungen für die Flächengröße und Form (z.B. gekrümmte oder flexible Flächen sind möglich). Die Schichtdicke der Sensorschicht ist dabei deutlich kleiner als die Flächenausdehnung (typ. wenige 10µm). Zusätzlich kann das Trägermaterial verspiegelt werden, um die Anregung und Detektion zu verbessern, sowie mögliches Streulicht von außerhalb des Sensors zu blockieren. Dazu können Metalle (z.B. Au, Ti, Al, Ag) auf das Trägermaterial aufgebracht werden oder dielektrische Verspiegelungen genutzt werden. Als Trägermaterial kann z.B. Keramik, (gehärtetes-) Glas oder Metall genutzt werden. Um möglichst nah mit dem Sensorelement an ein Prüfstück zu gelangen, sollte das Trägermaterial möglichst dünn ausgestaltet sein. Um die Stabilität des Trägermaterials in Verbindung mit dem Diamantmaterial zu gewährleisten, kann auf das Diamantmaterial ein weiteres (dickeres) optisch transparentes Trägermaterial aufgebracht werden.

Das hier vorgelegte Dokument schlägt für solche und andere Anwendungen mit ähnlichen Messaufgaben eine Sensorschicht vor. Dabei weist die Sensorschicht vorzugsweise ein Trägermaterial auf, in dem eine Vielzahl von Diamanten oder andere Kristalle, die paramagnetische Zentren umfassen, eingebettet sind. Ein oder mehrere oder alle Diamanten dieser Diamanten bzw. ein oder mehrere oder alle Kristalle dieser Kristalle weisen dabei ein oder mehrere NV-Zentren und/oder ein oder mehrere andere paramagnetischen Zentren auf. Die NV-Zentren der Sensorschicht und/oder die anderen paramagnetischen Zentren der Sensorschicht emittieren bei Bestrahlung mit Pumpstrahlung zumindest eine Fluoreszenzstrahlung. Das Besondere der in dem hier vorgelegten Dokument vorgeschlagenen Sensorschicht ist, dass das Trägermaterial beispielsweise ein mittels elektromagnetischer Strahlung ausgehärtetes Trägermaterial sein kann und dass das Trägermaterial nach dem Aushärten für Strahlung mit einer Pumpstrahlungswellenlänge λₚₘₚ der Pumpstrahlung, mit der die NV-Zentren NVZ und/oder die anderen paramagnetischen Zentren gepumpt werden, im Wesentlichen transparent ist. Im Wesentlichen bedeutet dabei, dass die unzweifelhaft auftretenden Verluste immer noch so gering sind, dass die Funktionsfähigkeit der betreffenden Anwendung immer noch gegeben ist. In gleicherweise sollte das Trägermaterial für Strahlung mit einer Fluoreszenzwellenlänge λ_{fl} der Fluoreszenzstrahlung der NV-Zentren im Wesentlichen transparent sein. Im Wesentlichen bedeutet dabei wiederum, dass die unzweifelhaft auftretenden Verluste immer noch so gering sind, dass die Funktionsfähigkeit der betreffenden Anwendung immer noch gegeben ist. Durch die Aushärtung eines zuvor flüssigen Trägermittels ist die Fertigung einer solchen Sensorschicht besonders einfach und prozesssicher mit einem hohen Cₚₖ-Wert zu fertigen.

In einer Variante der Sensorschicht sind die Diamanten bzw. Kristalle im Trägermaterial der Sensorschicht im Wesentlichen zueinander unterschiedlich mit einer jeweils im Wesentlichen unterschiedlichen Orientierung orientiert. Dies hat den Vorteil, dass sich die Sensorschicht isotrop verhält und keine Vorzugsrichtung zeigt. Die Mischung verschiedenster Diamantkristalle zw. Kristalle kann die Messergebnisse homogenisieren und den Cpk-Wert verbessern.

Das Diamantmaterial der Sensorschicht der vorgeschlagenen Magnetfeldkamera wird vorzugsweise, wenn es NV-Zentren enthält, mit grünem Licht angeregt. Dies kann z.B. durch eine oder mehrere LEDs als Lichtquelle erfolgen. Um die gezielte Anregung des Diamantmaterials zu verbessern können Linsen zur Fokussierung / Ausrichtung der Anregung in der vorgeschlagenen Magnetfeldkamera verwendet werden. Die Fluoreszenzstrahlung wird anschließend mit einem Lichtsensorarray der vorgeschlagenen Magnetfeldkamera ortsaufgelöst gemessen. Zur optimalen Detektion kann die Fluoreszenzemission der Fluoreszenzstrahlung mit einem Objektiv / einer Linse auf das Lichtsensorarray abgebildet werden (Fluoreszenzkamera). Alternativ kann das Diamantmaterial mit optischen Filtern auch direkt auf ein Lichtsensorarray aufgebracht werden- der Messbereich entspricht dann aber nur der der Größe des Sensorarrays. Zur Verbesserung des Kontrastes kann ein Shortpass-Filter vor der LED, also der Lichtquelle, und/oder ein Longpass-Filter vor dem Lichtsensorarray der vorgeschlagenen Magnetfeldkamera verwendet werden, wobei die Grenz-Wellenlänge des Shortpass-Filters der vorgeschlagenen Magnetfeldkamera kleiner als die des Longpass-Filters der vorgeschlagenen Magnetfeldkamera sein sollte. Das Longpass-Filter lässt typischerweise elektromagnetische Strahlung mit einer Wellenlänge im technisch für die betreffende Anwendung relevanten Wellenlängenbereich größer als die Grenzwellenlänge des Longpass-Filters passieren. Das Shortpass-Filter der vorgeschlagenen Magnetfeldkamera lässt elektromagnetische Strahlung mit einer Wellenlänge im technisch für die betreffende Anwendung relevanten Wellenlängenbereich kleiner als die Grenzwellenlänge des Shortpass-Filters passieren. Bevorzugt umfasst die vorgeschlagene Vorrichtung als Lichtsensorarray der vorgeschlagenen Magnetfeldkamera ein monochromes Lichtsensorarray ohne RGB-Filter und ohne Infrarotfilter.

Das Wesentliche des hier vorgelegten Dokuments ist nun, dass es auch ein Verfahren zur Herstellung einer Sensorschicht, wie sie zuvor beschrieben wurde, beschreibt und offenlegt. Das vorgeschlagene Verfahren umfasst die Schritte:
- Bereitstellen eines ersten Trägermaterials **9;**
- Beschichten der Oberfläche der Oberseite des ersten Trägermaterials **9** mit einer Verspiegelung **10**;
- Bereitstellen eines flüssigen und mittels elektromagnetischer Strahlung einer Aushärtewellenlänge λ_{H} härtbaren flüssigen, zweiten Trägermaterials, wobei in das zweite, flüssige Trägermaterial eine Vielzahl von Diamanten, vorzugsweise Nanodiamanten, bzw. Kristallen, vorzugsweise Nanokristallen, eingebettet sind und wobei einer oder mehrere oder alle Diamanten dieser Diamanten bzw. Kristalle NV-Zentren und/oder andere paramagnetischen Zentren aufweisen und wobei die NV-Zentren der Diamanten bzw. Kristalle des zweiten, flüssigen Trägermaterials und/oder die anderen paramagnetischen Zentren der Diamanten bzw. Kristalle des zweiten, flüssigen Trägermaterials bei Bestrahlung mit Pumpstrahlung zumindest eine Fluoreszenzstrahlung emittieren;
- Benetzen der Oberfläche der Verspiegelung **10** mit dem zweiten, flüssigen Trägermaterial, das die Vielzahl eingebetteter Diamanten bzw. eingebetteter Kristalle aufweist;
- Bestrahlen der Oberfläche der Verspiegelung **10** und die Schicht des zweiten Flüssigen Trägermaterials mit elektromagnetischer Strahlung, wobei die Wellenlänge dieser elektromagnetischen Strahlung, die Aushärtewellenlänge λ_{H}, so gewählt ist, dass das zweite, flüssige Trägermaterial aushärtet und sich in einen Festkörper wandelt. Es bildet sich eine Schicht **11** mit Kristallen mit paramagnetischen Zentren. Bevorzugt umfasst diese Schicht eine Vielzahl von Nanokristallen, die vorzugsweise vollkommen zufällig, gleichverteilt orientiert sind, und deren Dichte vorzugsweise im Wesentlichen nicht abhängig von der Position in der Schicht ist. Vorzugsweise handelt es sich bei den Kristallen um Diamanten. Vorzugsweise handelt es sich bei den paramagnetischen Zentren um NV-Zentren. Bei diesem Diamantmaterial handelt es sich bevorzugt um NV-reichem Diamantstaub in einem optisch transparentem Verbundmaterial, das für elektromagnetische Strahlung mit Pumpstrahlungswellenlänge λₚₘₚ und für elektromagnetische Strahlung mit Fluoreszenzstrahlungswellenlänge λ_{fl} im Wesentlichen transparent ist
- Entfernen des nicht ausgehärteten, flüssigen, zweiten Trägermaterials insbesondere mittels eines Lösungsmittels, wobei der verbleibende Film des zweiten Trägermaterials auf der Oberfläche der Verspiegelung **10** nach optionaler Beschichtung mit einem weiteren Trägermaterial 12 zusammen mit den anderen Komponenten **(9, 10, 11, 12)** die Sensorschicht **5** bildet.

Typischerweise härtet das zweite, flüssige Trägermaterial nur teilweise aus, was die Bildung des optischen Funktionselements ermöglicht.

Die elektromagnetischen Strahlung mit der Aushärtewellenlänge λ_{H} weist eine Eindringtiefe in das zweite, flüssige Trägermaterial auf, so dass das zweite Trägermaterial nur bis zu einer gewissen Dicke des Trägermaterials aushärtet und so das optische Funktionselement bildet, was im Rahmen der Ausarbeitung der technischen Lehre dieser Schrift erst als überraschendes und vorteilhaftes Vorgehen erkannt wurde.

Die Strahlung der zur Aushärtung des zweiten flüssigen Trägermaterials verwendeten Strahlung ist bevorzugt UV-Strahlung. Ganz besonders bevorzugt ist eine Strahlung zur Aushärtung mit einer Aushärtewellenlänge λ_{H} zwischen 320-380nm.

In bestimmten Anwendungsfällen können dem zweiten, flüssigen Trägermaterial Nanopartikel mit einem Durchmesser kleiner 200nm und/oder kleiner 100nm und/oder kleiner 50nm und/oder kleiner 20nm und/oder kleiner 10nm und/oder kleiner 5nm vor dem Bereitstellen beigemischt werden, sodass diese in dem Trägermaterial nach dem Aushärten eingelagert sind. Beispielsweise kann es sich um metallische Nanopartikel handeln.

Solche metallischen Nanopartikel wechselwirken mit Diamanten in dem zweiten Trägermaterial der Sensorschicht 9 und können beispielsweise die Fluoreszenzstrahlung dieser Diamanten DM beeinflussen.

Die optionalen metallischen Nanopartikel können beispielsweise Gold und/oder Platin und/oder Palladium und/oder Graphit und/oder Graphen und/oder Chrom und/oder Silizium und/oder Germanium und/oder Zinn und/oder Schwefel und/oder Selen und/oder Tellur und/oder Magnesium und/oder Kalzium und/oder Strontium und/oder Barium und/oder Titan und/oder Zirkon und/oder Hafnium und/oder Chrom und/oder Molybdän und/oder Wolfram und/oder Eisen und/oder Ruthenium und/oder Osmium und/oder Nickel und/oder Zinn und/oder Kadmium und/oder Quecksilber und/oder Cerium und/oder Neodym und/oder Samarium und/oder Gandolinium und/oder Dysprosium und/oder Erbium und/oder Ytterbium und/oder Thorium und/oder Proactinium und/oder Uran und/oder Plutonium und/oder Mischungen derselben umfassen.

Die Atome des Metalls der Nanopartikel umfassten naturgemäß eines oder mehrerer Elemente des Periodensystems der Elemente. Jedes dieser Elemente tritt in verschiedenen Isotopen in der Natur mit einem jeweiligen natürlichen Isotopenmischungsverhältnis auf. Jedes Isotop weit in der Natur dabei einen natürlichen Anteil entsprechend dem natürlichen Isotopenmischungsverhältnis auf. Diese Isotope können ein magnetisches Kernmoment µ aufweisen oder nichtaufweisen je nach Isotop. Die metallischen Nanopartikel weisen bevorzugt bei zumindest einem Element, das die metallischen Nanopartikel aufweisen, einen erhöhten Anteil im Isotopenmischungsverhältnis gegenüber dem natürlichen Anteil des Isotopenmischungsverhältnisses für zumindest eines der folgenden Isotope auf :¹²C, ¹⁴C, ²³Si, ³⁰Si, ⁷⁰Ge, ⁷²Ge, ⁷⁴Ge, ⁷⁶Ge,¹¹²Zn, ¹¹⁴Zn, ¹¹⁶Zn, ¹¹⁸Zn, ¹²⁰Zn, ¹²²Zn, ¹²⁴Zn ¹⁶O, ¹⁸O, ³²S, ³⁴S, ³⁶S, ⁷⁴Se, ⁷⁶Se, ⁷⁸Se, ⁸⁰Se, ⁸²Se, ¹²⁰Te, ¹²²Te, ¹²⁴Te, ¹²⁶Te, ¹²⁸Te, ¹³⁰Te, ²⁴Mg, ²⁶Mg, ⁴⁰Ca, ⁴²Ca, ⁴⁴Ca, ⁴⁶Ca, ⁴⁸Ca, ⁸⁴Sr, ⁸⁶Sr, ⁸⁸Sr, ¹³⁰Ba, ¹³²Ba, ¹³⁴Ba, ¹³⁶Ba, ¹³⁸Ba, ⁴⁶Ti, ⁴⁸Ti, ⁵⁰Ti, ⁹⁰Zr, ⁹⁰Zr, ⁹²Zr, ⁹⁴Zr, ⁹⁶Zr, ¹⁷⁴Hf, ¹⁷⁶Hf, ¹⁷⁸Hf, ⁵⁰Cr, ⁵²Cr, ⁵³Cr, ⁹²Mo, ⁹⁴Mo, ⁹⁶Mo, ⁹⁸Mo, ¹⁰⁰Mo, ¹⁸⁰W, ¹⁸²W, ¹⁸⁴W, ¹⁸⁶W, ⁵⁴Fe, ⁵⁶Fe, ⁵⁸Fe, ⁹⁶Ru, ⁹⁸Ru, ¹⁰⁰Ru, ¹⁰²Ru, ¹⁰⁴Ru, ¹⁸⁴Os, ¹⁸⁶Os, ¹⁸³Os, ¹⁹⁰Os, ¹⁹²Os ⁵⁸Ni, ⁶⁰Ni, ⁶²Ni, ⁶⁴Ni, ¹⁰²Pd, ¹⁰²Pd, ¹⁰⁴Pd, ¹⁰⁶Pd, ¹⁰⁸Pd, ¹¹⁰Pd, ¹⁹⁰Pt, ¹⁹²Pt, ¹⁹⁴Pt, ¹⁹⁶Pt, ¹⁹⁸Pt ⁶⁴Zn, ⁶⁶Zn, ⁶⁸Zn, ⁷⁰Zn, ¹⁰⁶Cd, ¹⁰⁸Cd, ¹¹⁰Cd, ¹¹²Cd, ¹¹⁴Cd, ¹¹⁶Cd, ¹⁹⁶Hg, ¹⁹⁸Hg, ²⁰⁰Hg, ²⁰²Hg, ²⁰⁴Hg ¹³⁶Ce, ¹³⁸Ce, ¹⁴⁰Ce, ¹⁴²Ce, ¹⁴²Nd, ¹⁴⁴Nd, ¹⁴⁶Nd, ¹⁴⁸Nd, ¹⁵⁰Nd, ¹⁴⁴Sm, ¹⁴⁶Sm, ¹⁴⁸Sm, ¹⁵⁰Sm, ¹⁵²Sm, ¹⁵⁴Sm, ¹⁵²Gd, ¹⁵⁴Gd, ¹⁵⁶Gd, ¹⁵⁸Gd, ¹⁶⁰Gd, ¹⁵⁶Dy, ¹⁵⁸Dy, ¹⁶⁰Dy, ¹⁶²Dy, ¹⁶⁴Dy, ¹⁶²Er, ¹⁶⁴Er, ¹⁶⁶Er, ¹⁶⁸Er, ¹⁷⁰Er, ¹⁶⁸Yb, ¹⁷⁰Yb, ¹⁷²Yb, ¹⁷⁴Yb, ¹⁷⁶Yb, ²³²Th, ²³⁴Pa, ²³⁴U, ²³⁸U, ²⁴⁴Pu. "Erhöht" bedeutet dabei im Sinne dieses Dokuments, dass der Anteil im Isotopenmischverhältnis der vorstehenden Isotope um 50% oder mehr erhöht ist.

Der Wert des Ausgangssignals jedes Sensorpixel, also jeder Lichtsensor des Lichtsensorarrays der vorgeschlagenen Magnetfeldkamera, gibt dann die Magnetfeldstärke am Ort des auf dem betreffenden Sensorpixel, also dem betreffenden Lichtsensor des Lichtsensorarrays, abgebildeten Diamantmaterial-Volumens wieder. Damit ist die Ortsauflösung der vorgeschlagenen Magnetfeldkamera nur durch die abbildende Optik und die Auflösung des Lichtsensorarrays, also die Sensorauflösung, begrenzt. Eine solche Vorrichtung kann somit mehrere Megapixel Auflösung realisieren.

Die Auswerteelektronik kann Schwankungen durch das Anregungslicht oder Inhomogenitäten im Diamantmaterial durch Verwendung von Werten einer zuvor durchgeführten Referenzmessung einer Referenzprobe herausrechnen. Die Anregung, Detektion und die optisch zugängliche Seite des Diamantmaterials befinden sich vorzugsweise in einem optisch geschlossenen Gehäuse, um den Einfluss von externem Licht zu unterdrücken.

Für größere Sensorflächen kann entsprechend der Arbeitsabstand und Fokus der Fluoreszenzkamera der vorgeschlagenen Magnetfeldkamera angepasst werden. Vorrichtungen, die mehrere Fluoreszenzkameras verwenden, um die Ortsauflösung bei größerer Sensorfläche zu erhöhen, sind denkbar. Die Auswerteelektronik kann dann die Mehrzahl der Bilder dieser Mehrzahl von Fluoreszenzkameras zu einem Bild verrechnen.

Ein Demonstrator hat seine Tauglichkeit zur ortsaufgelösten Messung von Magnetfeldern bei der Erprobung des Vorschlags bereits unter Beweis gestellt.

### ZUSAMMENFASSUNG DES DRITTEN AUSFÜHRUNGSVORSCHLAGS (MAGNETFELDNAMERA)

Das hier vorgelegte Dokument schlägt einen Magnetfeldkamerakopf 21 mit einer Sensorschicht 5, einer Lichtquelle 2 für Pumpstrahlung 13 und einer Fluoreszenzkamera mit einem Lichtsensorarray 1 aus Lichtsensoren vor. Die Sensorschicht 5 umfasst bevorzugt paramagnetische Zentren. Diese paramagnetischen Zentren emittieren bei Bestrahlung mit Pumpstrahlung 13 Fluoreszenzstrahlung 14. Die Intensität der emittierten Fluoreszenzstrahlung 14 hängt dabei von der Intensität der Pumpstrahlung 13 und der Intensität der magnetischen Flussdichte B am jeweiligen Ort des jeweiligen paramagnetischen Zentrums in der Sensorschicht 5 ab. Die Fluoreszenzkamera der vorgeschlagenen Magnetfeldkamera erfasst ein Fluoreszenzbild der Emissionsintensitätsverteilung für die Fluoreszenzstrahlungsemission der Fluoreszenzstrahlung 14 aus der Sensorschicht 5 und stellt dieses bereit.

Der Magnetfeldkamerakopf 21 kann Hilfsmagnete 19 umfassen.

Die Sensorschicht 5 umfasst bevorzugt Diamanten mit NV-Zentren als paramagnetische Zentren und/oder NV-zentren NVZ und/oder andere Kristalle mit paramagnetischen Zentren .

Außerdem schlägt das hier vorgelegte Dokument eine Magnetfeldkamera mit einem solchen Magnetfeldkamerakopf 21 und mit einem Rechnersystem 28 zur Bedienung des Magnetfeldkamerakopfes 21 vor, wobei das Rechnersystem 28 vorzugsweise dazu eingerichtet ist, aus einem Fluoreszenzbild des Magnetfeldkamerakopfes 21 ein Magnetflussdichtenbetragsbild zu erzeugen und/oder einen eindimensionalen Verlauf der Fluoreszenzintensität oder des Magnetflussdichtenbetrags längs einer Linie durch das Fluoreszenzbild hindurch zu erzeugen.

Das Weiteren schlägt das hier vorgelegte Dokument die Verwendung der oben beschriebenen Magnetfeldkamera und/oder des oben beschriebenen Magnetfeldkamerakopfes 21 für die Untersuchung des Magnetfelds magnetisierter Objekte und/oder für die Untersuchung der Struktur magnetisierter Objekte und/oder für die Untersuchung der Stromdichteverteilung in Objekten, die von einem elektrischen Strom durchflossen sind, vor.

Mit der hier vorgestellten technischen Lehre werden in diesem dritten Anwendungsbeispiel somit Bildformate für Magnetfeldkameras möglich, die bisher nicht realisierbar waren.

Im Folgenden listet das hier vorgelegte Dokument einige dieser Bildformate auf, die mittels der hier vorgestellten Magnetfeldkamera bei geeigneter Wahl der Kristallgröße der Kristalle und Nanokristalle 66 und/oder Diamanten und/oder Nanodiamanten und einer geeigneten Wahl der Pixelanzahl des Lichtsensorarrays 1 der vorgeschlagenen Magnetfeldkamera möglich werden.

Bevorzugt sollte der Erfassungsbereich eines Lichtsensors (Pixels) des Lichtsensorarrays **1** der vorgeschlagenen Magnetfeldkamera auf der Oberfläche der Schicht **11** größer als das Doppelte des mittleren Durchmessers der Kristalle und/oder Nanokristalle **66** sein. Dann ist in der Regel das Nyquist-Theorem erfüllt. Bevorzugt sollte der Erfassungsbereich eines Lichtsensors (Pixels) des Lichtsensorarrays **1** der vorgeschlagenen Magnetfeldkamera auf der Oberfläche der Schicht **11** größer als das 5-Fache, besser 10-Fache, besser 20-Fache, besser 50-Fache des mittleren Durchmessers der Kristalle und/oder Nanokristalle **66** bzw. Diamanten und/oder Nanodiamanten sein. Dies ermöglicht eine stochastische Gleichverteilung der Orientierung mehrerer Kristalle und/oder Nanokristalle bzw. Diamanten und/oder Nanodiamanten, deren Fluoreszenzstrahlung von diesem Lichtsensor (Pixel) des Lichtsensorarrays **1** der vorgeschlagenen Magnetfeldkamera erfasst wird.

### Magnetfeldkamera mitflächenhafter Pumpstrahlungsquelle

Das hier vorgelegte Dokument beschreibt unter anderem eine flächenhafte Pumpstrahlungsquelle **PL** für die Bestrahlung paramagnetischer Zentren mit Pumpstrahlung **13** mit einer Pumpstrahlungswellenlänge λₚₘₚ, wobei die flächenhafte Pumpstrahlungsquelle **PL** ein oder mehreren primäre Pumpstrahlungsquellen insbesondere in Form von LEDs **44** umfasst. Die ein oder mehreren primäre Pumpstrahlungsquellen sind bevorzugt dazu eingerichtet, Pumpstrahlung **13** mit der Pumpstrahlungswellenlänge λₚₘₚ zu emittieren. Bevorzugt umfasst die flächenhafte Pumpstrahlungsquelle ein erstes optisches Funktionselement, insbesondere eine Glasplatte **46** und/oder einen flächenhaften Lichtwellenleiter und/oder ein optisches System. Das erste optische Funktionselement ist im Sinne des hier vorgelegten Dokuments ein Lichtwellenleiter **LWL.** Das erste optische Funktionselement weist typischerweise eine erste Oberfläche **67** auf. Bevorzugt verteilt das erste optische Funktionselement die Pumpstrahlung **13** mit der Pumpstrahlungswellenlänge λₚₘₚ, die von den primären Pumpstrahlungsquellen emittiert wird, flächenhaft.

Typischerweise ist das erste optische Funktionselement somit dazu eingerichtet, dass aus einer ersten Oberfläche des ersten optischen Funktionselements der flächenhafte Pumpstrahlungsquelle diese flächenhaft verteilte Pumpstrahlung **13** flächenhaft austritt.

Diese flächenhafte Pumpstrahlungsquelle ermöglicht eine Ausleuchtung der Schicht **11** mittels LEDs **44** anstelle von Laser-Dioden als primären Pumpstrahlungsquellen. Dies ist wesentlich kostengünstiger, als die Ausleuchtung mittels Lasern. Wenn in dem hier vorgelegten Dokument von LEDs **44** geschrieben ist, sind damit allerdings Laser als möglich primäre Pumpstrahlungsquellen mitumfasst.

In einer anderen Ausprägung umfassen somit die ein oder mehreren primären Pumpstrahlungsquellen der flächenhaften Pumpstrahlungsquelle ein oder mehreren LEDs **44** als primäre Pumpstrahlungsquellen der Pumpstrahlung **13.** Dies ermöglicht eine gute und vor allem homogenere Ausleuchtung der Schicht 11 mit Pumpstrahlung **13.**

In einer anderen Ausprägung umfasst das erste optische Funktionselement eine oder mehrere der folgenden optischen Funktionselemente:
- eine Glasplatte **46** und/oder
- einen flächenhaften Lichtwellenleiter und/oder
- eine Mehrzahl von Lichtwellenleitern, die einem flächenhaften Lichtwellenleiter funktionsäquivalent sind, und/oder
- ein mikrooptisches System mit zumindest einem photonischen Kristall, das dazu eingerichtet ist, die Pumpstrahlung **13** mit der Pumpstrahlungswellenlänge λₚₘₚ flächenhaft zu verteilen, und/oder
- ein mikrooptisches System mit zumindest einem mikrooptischen Spiegel, das dazu eingerichtet ist, die Pumpstrahlung **13** mit der Pumpstrahlungswellenlänge λₚₘₚ flächenhaft zu verteilen, und/oder
- ein anderes optisches System, das dazu eingerichtet ist, die Pumpstrahlung **13** mit der Pumpstrahlungswellenlänge λₚₘₚ flächenhaft zu verteilen.

Dieses erste optische Funktionselement ermöglicht somit die flächige Verteilung der Pumpstrahlung **13** zur Bestrahlung der Schicht **11** mit Pumpstrahlung **13.**

In einer anderen Ausprägung bestrahlt die flächenhafte Pumpstrahlungsquelle der vorgeschlagenen Magnetfeldkamera eine flächenhafte Schicht **11** mit flächenhaft verteilten Kristallen und/oder Nanokristallen **66** und/oder Diamanten mit paramagnetischen Zentren und/oder NV-Zentren mit Pumpstrahlung **13** der Pumpstrahlungswellenlänge λₚₘₚ flächenhaft. Dieses erste optische Funktionselement ermöglicht somit die flächige Verteilung der Pumpstrahlung **13** zur Bestrahlung der Schicht **11** mit Pumpstrahlung **13.**

In einer anderen Ausprägung umfasst die flächenhafte Pumpstrahlungsquelle die Schicht **11** und bestrahlt die Schicht **11** über die erste Oberfläche **67.** Dabei ist in dieser anderen Ausprägung die Schicht **11** mit der ersten Oberfläche **67** des ersten optischen Funktionselements, hier der Glasplatte **46,** direkt oder indirekt mechanisch verbunden. Bevorzugt bedeckt die Schicht **11** die erste Oberfläche **67** des ersten optischen Funktionselements, hier der Glasplatte **46,** ganz oder teilweise.

Dies ermöglicht eine sehr einfache Konstruktion einer flächenhaften Fluoreszenzstrahlungsquelle als Zusammenstellung der Schicht **11** mit der flächenhaften Pumpstrahlungsquelle, wobei die flächenhafte Pumpstrahlungsquelle die Schicht **11** mit Pumpstrahlung **13** flächenhaft bestrahlt und daraufhin die paramagnetischen Zentren in der Schicht **11** flächenhaft Fluoreszenzstrahlung **14** in Abhängigkeit von der magnetischen Flussdichte am Ort des jeweiligen paramagnetischen Zentrums in der Schicht **11** emittieren. Hierdurch ergibt sich somit eine flächenhafte Fluoreszenzstrahlungsquelle, bei der die Intensität der lokal an einem Punkt der Abstrahlungsfläche der flächigen Fluoreszenzstrahlungsquelle abgestrahlten Fluoreszenzstrahlung **14** von der magnetischen Flussdichte an diesem Punkt der Abstrahlungsfläche der flächigen Fluoreszenzstrahlungsquelle abhängt.

In einer anderen Ausprägung emittiert die Schicht **11** örtlich unterschiedlich je nach dem Wert des lokalen Betrags der magnetischen Flussdichte in der Schicht **11** eine Fluoreszenzstrahlung **14** mit einer Fluoreszenzstrahlungswellenlänge λ_{fl}. Auch Hierdurch ergibt sich somit eine flächenhafte Fluoreszenzstrahlungsquelle, bei der die Intensität der lokal an einem Punkt der Abstrahlungsfläche der flächigen Fluoreszenzstrahlungsquelle abgestrahlten Fluoreszenzstrahlung 14 von der magnetischen Flussdichte an diesem Punkt der Abstrahlungsfläche der flächigen Fluoreszenzstrahlungsquelle abhängt.

In einer anderen Ausprägung umfasst die flächenhafte Pumpstrahlungsquelle ein weiteres optisches Funktionselement, das elektromagnetische Strahlung mit der Pumpstrahlungswellenlänge λₚₘₚ von der elektromagnetischen Strahlung mit Fluoreszenzstrahlungswellenlänge **λ_{fl}** separiert. Hierdurch ergibt sich somit eine flächenhafte Fluoreszenzstrahlungsquelle, bei der die Intensität der lokal an einem Punkt der Abstrahlungsfläche der flächigen Fluoreszenzstrahlungsquelle abgestrahlten Fluoreszenzstrahlung **14** von der magnetischen Flussdichte an diesem Punkt der Abstrahlungsfläche der flächigen Fluoreszenzstrahlungsquelle abhängt und die keine Pumpstrahlung emittiert, was den Kontrast erhöht.

In einer anderen Ausprägung umfasst das weitere optische Funktionselement eines oder mehrere der folgenden optischen Funktionselemente:
- eine dichroitisch verspiegelte Schicht **47** und/oder
- einen optischen Filter (Longpass) **6.**

Dies ermöglicht eine sehr einfache Konstruktion der Separationsvorrichtung für die Separation der elektromagnetischen Strahlung mit der Pumpstrahlungswellenlänge λₚₘₚ von der elektromagnetischen Strahlung mit Fluoreszenzstrahlungswellenlänge λ_{fl}.

In einer anderen Ausprägung separiert das weitere optische Funktionselement die Pumpstrahlung **13** mit der Pumpstrahlungswellenlänge λₚₘₚ von der Fluoreszenzstrahlung **14** mit der Fluoreszenzstrahlungswellenlänge λ_{fl} zu separieren. Hierdurch ergibt sich somit eine flächenhafte Fluoreszenzstrahlungsquelle, bei der die Intensität der lokal an einem Punkt der Abstrahlungsfläche der flächigen Fluoreszenzstrahlungsquelle abgestrahlten Fluoreszenzstrahlung **14** von der magnetischen Flussdichte an diesem Punkt der Abstrahlungsfläche der flächigen Fluoreszenzstrahlungsquelle abhängt und die keine Pumpstrahlung emittiert, was den Kontrast erhöht.

### Herstellverfahren für die flächenhafte Pumpstrahlungsquelle

Das hier vorgelegte Dokument stellt darüber hinaus ein Verfahren zur Herstellung einer flächenhaften Pumpstrahlungsquelle **(44, 46)** vor. Das Verfahren beginnt mit der Bereitstellung von ein oder mehreren primären Pumpstrahlungsquellen. Dabei emittieren die ein oder mehreren primären Pumpstrahlungsquellen Pumpstrahlung **13** mit der Pumpstrahlungswellenlänge **λₚₘₚ**. Ein weiterer Schritt umfasst das Bereitstellen eines ersten optischen Funktionselements, beispielsweise einer Glasplatte **46.** Typischerweise weist das erste optische Funktionselement eine erste Oberfläche **67** auf. Bevorzugt verteilt das erste optische Funktionselement die Pumpstrahlung **13** mit der Pumpstrahlungswellenlänge λₚₘₚ, die die primären Pumpstrahlungsquellen emittieren, flächenhaft. Das erste optische Funktionselement somit dazu eingerichtet ist, dass aus der ersten Oberfläche **67** des ersten optischen Funktionselements der flächenhafte Pumpstrahlungsquelle diese flächenhaft verteilte Pumpstrahlung **13** flächenhaft austritt. Ein weiterer Schritt des Verfahrens ist typischerweise ein mechanisches Verbinden der primären Pumpstrahlungsquellen mit dem ersten optischen Funktionselement. Hierbei kann beispielsweise ein Schaltungsträger (PCB) **43** die mechanische Verbindung mittels Lötungen und/oder Klebungen herstellen. Die primären Pumpstrahlungsquellen sind vorzugsweise nach dem mechanischen Verbinden dazu eingerichtet, Pumpstrahlung **13** mit der Pumpstrahlungswellenlänge λₚₘₚ bei elektrischer Aktivierung z.B. durch Bestromung zu emittieren und in das erste optische Funktionselement, insbesondere über eine Kante des ersten optischen Funktionselements und/oder eine Seitenfläche des ersten optischen Funktionselements, einzuspeisen. Das erste optische Funktionselement ist vorzugsweise dazu eingerichtet, dass die Pumpstrahlung **13** sich innerhalb des ersten optischen Funktionselements flächenhaft in einer Lichtfläche ausbreitet. Das erste optische Funktionselement strahlt vorzugsweise über die erste Oberfläche **67** des ersten optischen Funktionselements Pumpstrahlung **13** mit der Pumpstrahlungswellenlänge λₚₘₚ senkrecht zur vorbeschriebenen Lichtfläche der Pumpstrahlung **13** innerhalb des ersten optischen Funktionselements Pumpstrahlung **(13)** mit der Pumpstrahlungswellenlänge λₚₘₚ ab.

In einer anderen Ausprägung umfasst das Verfahren zur Herstellung einer Sensorschicht **5** als einen Schritt das Bereitstellen eines ersten optisches Funktionselement, insbesondere einer Glasplatte **(46)** und/oder eines flächenhaften Lichtwellenleiters und/oder eines optischen Systems. Des Weiteren umfasst das Verfahren in dieser Ausprägung bevorzugt das Bereitstellen eines flüssigen und mittels elektromagnetischer Strahlung einer Aushärtewellenlänge **λ_{H}** härtbaren flüssigen, zweiten Trägermaterials. Dabei sind bevorzugt in das zweite, flüssige Trägermaterial eine Vielzahl von Diamanten, vorzugsweise Nanodiamanten, bzw. Kristallen **66,** vorzugsweise Nanokristallen **66,** eingebettet. Bevorzugt weisen einer oder mehrere oder alle Diamanten dieser Diamanten bzw. Kristalle **66** und/oder Nanokristalle **66** NV-Zentren und/oder andere paramagnetischen Zentren auf. Bevorzugt emittieren die NV-Zentren der Diamanten bzw. Kristalle **66** bzw. Nanokristalle **66** des zweiten, flüssigen Trägermaterials und/oder die anderen paramagnetischen Zentren der Diamanten bzw. Kristalle **66** und/oder Nanokristalle **66** des zweiten, flüssigen Trägermaterials bei Bestrahlung mit Pumpstrahlung **13** zumindest eine Fluoreszenzstrahlung **14.** In dieser Ausprägung umfasst das hier vorgestellte Verfahren zur Herstellung einer flächenhaften Pumpstrahlungsquelle **(44, 46)** bevorzugt den Schritt des Benetzens und Beschichtens der ersten Oberfläche **67** des ersten optisches Funktionselements, insbesondere der Glasplatte **46** und/oder des flächenhaften Lichtwellenleiters und/oder des optischen Systems, mit dem zweiten, flüssigen Trägermaterial, das vorzugsweise die Vielzahl eingebetteter Diamanten bzw. eingebetteter Kristalle **66** und/oder Nanokristalle **66** aufweist. Das hier vorgestellte Verfahren zur Herstellung einer flächenhaften Pumpstrahlungsquelle **(44, 46)** umfasst als weiteren Schritt vorzugsweise das Bestrahlen der ersten Oberfläche **67** des ersten optisches Funktionselements, insbesondere der Glasplatte **(46)** und/oder des flächenhaften Lichtwellenleiters und/oder des optischen Systems, und/oder der Schicht des zweiten Flüssigen Trägermaterials mit elektromagnetischer Strahlung, wobei die Wellenlänge dieser elektromagnetischen Strahlung, die Aushärtewellenlänge **λ_{H}**, so gewählt ist, dass das zweite, flüssige Trägermaterial aushärtet und sich in einen Festkörper, insbesondere in Form der Schicht **11,** wandelt. Bevorzugt wird hierzu an den Stellen des ersten optischen Funktionselements - also beispielsweise der Glasplatte **46** - an dem die primären Pumpstrahlungsquellen - also beispielsweise die LEDs **44** - die Pumpstrahlung **13** später einspeisen sollen, Aushärtestrahlung als elektromagnetischen Strahlung mit der Aushärtewellenlänge λ_{H}, eingespeist. Hierdurch wird die Schicht selbstjustierend auf der ersten Oberfläche **67** des ersten optischen Funktionselements - also beispielsweise der Glasplatte **46** - ausgehärtet und damit gefertigt.

In einer anderen Ausprägung des Verfahrens zur Herstellung einer Sensorschicht **5** umfasst die Schicht **11** eine Vielzahl von Kristallen **66** und/oder Nanokristallen **66** mit paramagnetischen Zentren.

In einer anderen Ausprägung des Verfahrens zur Herstellung einer Sensorschicht **5** sind die Kristalle **66** und/oder Nanokristalle **66** in der Schicht **11** vollkommen zufällig und im Wesentlichen gleichverteilt orientiert sind, und/oder die Dichte Kristalle **66** und/oder Nanokristalle **66** in der Schicht **11** ist vorzugsweise im Wesentlichen nicht abhängig von der Position in der Schicht **11.**

In einer anderen Ausprägung des Verfahrens zur Herstellung einer Sensorschicht **5** umfassen die Kristalle **66** und/oder Nanokristalle **66** Diamanten. Bevorzugt umfassen die Kristalle **66** und/oder Nanokristalle **66** in dieser Ausprägung paramagnetischen Zentren. Bevorzugt umfassen in dieser Ausprägung die Kristalle **66** und/oder Nanokristalle **66** Diamanten mit NV-Zentren umfassen.

In einer anderen Ausprägung des Verfahrens zur Herstellung einer Sensorschicht **5** handelt es sich bei der Schicht **11** um ein optisch transparentes Verbundmaterial, das für elektromagnetische Strahlung mit Pumpstrahlungswellenlänge λₚₘₚ und für elektromagnetische Strahlung mit Fluoreszenzstrahlungswellenlänge λ_{fl} im Wesentlichen transparent ist.

In einer anderen Ausprägung des Verfahrens zur Herstellung einer Sensorschicht **5** umfasst das Verfahren einen weiteren Schritt des Entfernens des nicht ausgehärteten, flüssigen, zweiten Trägermaterials insbesondere mittels eines Lösungsmittels, wobei der verbleibende Film des zweiten Trägermaterials auf der ersten Oberfläche **67** des ersten optisches Funktionselements, insbesondere der Glasplatte **46,** die Schicht **11** bildet. In einer anderen Ausprägung des Verfahrens zur Herstellung einer Sensorschicht 5 umfasst das Verfahren einen weiteren Schritt der Beschichtung der Schicht **11** mit einer Verspiegelung **10**.

In einer anderen Ausprägung des Verfahrens zur Herstellung einer Sensorschicht 5 umfasst das Verfahren einen weiteren Schritt der Beschichtung der Schicht **11** und/oder der Verspiegelung **10** mit einem weiteren Trägermaterial **12.**

In einer anderen Ausprägung des Verfahrens zur Herstellung einer Sensorschicht **5** umfasst das Verfahren einen weiteren Schritt des Verwendens der Schicht **11** zusammen mit anderen Komponenten **(9, 10, 12)** als Sensorschicht **5** eines Sensorkopfes **21.**

In einer anderen Ausprägung des Verfahrens zur Herstellung einer Sensorschicht **5** umfasst das Verfahren einen weiteren Schritt des ganzflächigen oder bereichsweisen Herstellens eines Diffusors oder einer Diffusor Schicht **69** auf der ersten Oberfläche **67** des ersten optischen Funktionselements.

### Herstellen der Sensorschicht 5 auf einem Trägermaterial 9

In einer anderen Ausprägung des Verfahrens zur Herstellung einer Sensorschicht **5** in einem Gehäuse **8** umfasst das Verfahren zur Herstellung einer Sensorschicht **5** als ersten Schritt das Bereitstellen eines ersten Trägermaterials **9.** Ein weiterer Schritt dieses Verfahrens zur Herstellung einer Sensorschicht **5** in einem Gehäuse **8** umfasst das Beschichten der Oberfläche der Oberseite des ersten Trägermaterials **9** mit einer Verspiegelung **10**. Das Verfahren umfasst auch das Bereitstellen eines flüssigen und mittels elektromagnetischer Strahlung einer Aushärtewellenlänge λ_{H} härtbaren flüssigen, zweiten Trägermaterials. Dabei sind vorzugsweise in das zweite, flüssige Trägermaterial eine Vielzahl von Diamanten, vorzugsweise Nanodiamanten, bzw. Kristallen **66,** vorzugsweise Nanokristallen **66,** eingebettet. Dabei weisen bevorzugt einer oder mehrere oder alle Diamanten dieser Diamanten bzw. Kristalle **66** und/oder Nanokristalle **66** NV-Zentren und/oder andere paramagnetischen Zentren auf. Dabei emittieren die NV-Zentren der Diamanten bzw. Kristalle **66** und/oder Nanokristalle **66** des zweiten, flüssigen Trägermaterials und/oder die anderen paramagnetischen Zentren der Diamanten bzw. Kristalle **66** und/oder Nanokristalle **66** des zweiten, flüssigen Trägermaterials bei Bestrahlung mit Pumpstrahlung **13** zumindest eine Fluoreszenzstrahlung **14.** Das Verfahren umfasst vorzugsweise das Benetzen der Oberfläche der Verspiegelung **10** mit dem zweiten, flüssigen Trägermaterial, das die Vielzahl eingebetteter Diamanten bzw. eingebetteter Kristalle **66** und/oder Nanokristalle **66** aufweist. Bevorzugt umfasst das Verfahren das Bestrahlen der Oberfläche der Verspiegelung **10** und der Schicht des zweiten flüssigen Trägermaterials mit elektromagnetischer Strahlung. Dabei ist die Wellenlänge dieser elektromagnetischen Strahlung, die Aushärtewellenlänge λ_{H}, vorzugsweise so gewählt, dass das zweite, flüssige Trägermaterial aushärtet und sich in einen Festkörper wandelt. Typischerweise bildet sich eine Schicht **11** mit Kristallen **66** und/oder Nanokristallen **66** mit paramagnetischen Zentren. Bevorzugt umfasst diese Schicht **11** eine Vielzahl von Nanokristallen **66,** die vorzugsweise vollkommen zufällig, gleichverteilt orientiert sind, und deren Dichte vorzugsweise im Wesentlichen nicht abhängig von der Position in der Schicht **11** ist. Vorzugsweise handelt es sich bei den Kristallen um Diamanten. Vorzugsweise handelt es sich bei den paramagnetischen Zentren um NV-Zentren. Bei diesem Diamantmaterial handelt es sich bevorzugt um NV-reichem Diamantstaub aus Kristallen **66** und/oder Nanokristallen **66** in einem optisch transparentem Verbundmaterial, das für elektromagnetische Strahlung mit Pumpstrahlungswellenlänge λₚₘₚ und für elektromagnetische Strahlung mit Fluoreszenzstrahlungswellenlänge **λ_{fl}** im Wesentlichen transparent ist. Das vorgeschlagene Verfahren umfasst bevorzugt das Entfernen des nicht ausgehärteten, flüssigen, zweiten Trägermaterials insbesondere mittels eines Lösungsmittels, wobei der verbleibende Film des zweiten Trägermaterials auf der Oberfläche der Verspiegelung **10** nach optionaler Beschichtung mit einem weiteren Trägermaterial **12** zusammen mit den anderen Komponenten **(9, 10, 11, 12)** die Sensorschicht **5** bildet.

### Verwendung einer flächenhaften Pumpstrahlungsquelle (46, 44)

Das hier vorgelegte Dokument beschriebt darüber hinaus ein Verfahren zur Verwendung einer flächenhaften Pumpstrahlungsquelle **(46, 44).** Schritte des Verfahrens sind das Bereitstellen der flächenhaften Pumpstrahlungsquelle **(46, 44)** und das Bereitstellen einer flächenhaften Schicht **11,** wobei die flächenhafte Schicht **11** eine Vielzahl von Kristallen **66** und/oder Nanokristallen **66** umfasst, die paramagnetische Zentren aufweisen. Das Verfahren umfasst bevorzugt das Bestrahlen der flächenhaften Schicht **11** mit Pumpstrahlung **13** einer Pumpstrahlungsquelle **(2, 44),** wobei die Pumpstrahlung **13** eine Pumpstrahlungswellenlänge λₚₘₚ aufweist. Paramagnetische Zentren von Kristallen **66** und/oder Nanokristallen **66** der flächenhaften Schicht **11** emittieren bei dieser Bestrahlung durch die die Pumpstrahlung **13** der flächenhaften Pumpstrahlungsquelle **(46, 44)** flächenhaft Fluoreszenzstrahlung **14.** Das Verfahren umfasst des Weiteren bevorzugt das Separieren der Fluoreszenzstrahlung **14** von der Pumpstrahlung **13** mittels eines Separationsmittels **(6, 47).** Typischerweise können optische Filter (Longpass) **6** und/oder dichroitisch verspiegelte optionale Schichten **47** solche Separationsmittel **(6,47)** darstellen. Das Verfahren umfasst auch das Erfassen der Fluoreszenzstrahlung **14** mittels eines Erfassungsmittels **15, 1.** Typischerweise können die Lichtsensoren des Lichtsensorarrays **1** und/oder die Auswerteelektronik **15** der Fluoreszenzkamera solche Erfassungsmittel **15, 1** darstellen.

In einer weiteren Ausprägung des Verfahrens zur Verwendung einer flächenhaften Pumpstrahlungsquelle **(46, 44)** umfasst das Verfahren das Abbilden der Verteilung der örtlichen Intensität der flächenhaften Emission der Fluoreszenzstrahlung **14** mittels einer bildgebenden Optik **7** auf ein Lichtsensorarray **1;**

In einer weiteren Ausprägung des Verfahrens zur Verwendung einer flächenhaften Pumpstrahlungsquelle **(46, 44)** umfasst das Verfahren das Erfassen von Messwerten von Lichtsensoren des Lichtsensorarrays **1** und Aufbereitung dieser Messwerte in einer Auswerteelektronik **15** und vorzugsweise das Bilden eines Fluoreszenzbildes aus solchen Messwerten.

In einer weiteren Ausprägung des Verfahrens zur Verwendung einer flächenhaften Pumpstrahlungsquelle **(46, 44)** umfasst das Verfahren das Komprimieren der erfassten Messwerte von Lichtsensoren des Lichtsensorarrays **1** und Aufbereitung dieser Messwerte in einer Auswerteelektronik **15** insbesondere zu einem komprimierten Fluoreszenzbild. Beispielsweise kann der Sensorkopf **21** Formate verlustfreier Bildkompressionsverfahren wie GIF, RAW, BMP, PNG erzeugen. Beispielsweise kann der Sensorkopf **21** Formate verlustbehafteter Bildkompressionsverfahren wie JPEG erzeugen.

In einer weiteren Ausprägung des Verfahrens zur Verwendung einer flächenhaften Pumpstrahlungsquelle **(46, 44)** umfasst das Verfahren das Übertragen eines Fluoreszenzbildes und/oder eines komprimierten Fluoreszenzbildes an ein übergeordnetes Rechnersystem **28.**

In einer weiteren Ausprägung des Verfahrens zur Verwendung einer flächenhaften Pumpstrahlungsquelle **(46, 44)** umfasst das Verfahren die Dekomprimierung des empfangenen komprimierten Fluoreszenzbildes zu einem übertragenen Fluoreszenzbild im übergeordneten Rechnersystem **28** und/oder die Verwendung des empfangenen Fluoreszenzbildes zu einem übertragenen Fluoreszenzbild im übergeordneten Rechnersystem **28.**

In einer weiteren Ausprägung des Verfahrens zur Verwendung einer flächenhaften Pumpstrahlungsquelle **(46, 44)** umfasst das Verfahren das Ermitteln eines Bildes der eindimensionalen und/oder zweidimensionalen und/oder dreidimensionalen Verteilung der magnetischen Flussdichte in Abhängigkeit von einem oder mehreren übertragenen oder erfassten Fluoreszenzbildern. Vorzugsweise führt ein übergeordnetes Rechnersystem **28** diese Ermittlung aus.

In einer weiteren Ausprägung des Verfahrens zur Verwendung einer flächenhaften Pumpstrahlungsquelle **(46, 44)** umfasst das Verfahren die Darstellung eines Bildes der eindimensionalen und/oder zweidimensionalen und/oder dreidimensionalen Verteilung der magnetischen Flussdichte und/oder eines einem oder mehrerer übertragener oder erfasster Fluoreszenzbilder und/oder daraus errechneter Bilder auf einem Display **32** oder einem anderen Medium zur Darstellung von Bildern.

In einer weiteren Ausprägung des Verfahrens zur Verwendung einer flächenhaften Pumpstrahlungsquelle **(46, 44)** umfasst das Verfahren das Erzeugen einer Video-Sequenz aus mehreren eines Bildes der eindimensionalen und/oder zweidimensionalen und/oder dreidimensionalen Verteilung der magnetischen Flussdichte und/oder aus einem oder mehreren übertragenen oder erfassten Fluoreszenzbildern und/oder aus daraus errechneten Bildern. Die Auswerteelektronik **15** und/oder das übergeordnete Rechnersystem **28** können diese Videosequenzerzeugung vornehmen.

In einer weiteren Ausprägung des Verfahrens zur Verwendung einer flächenhaften Pumpstrahlungsquelle **(46, 44)** umfasst das Verfahren die Kompression der Video-Sequenz zu einer komprimierten Video-Sequenz. Dabei können die Auswerteelektronik **15** und/oder das übergeordnete Rechnersystem **28** diese Kompression vornehmen. Bevorzugt benutzen diese eines der folgenden Kompressionsverfahren: AVC, HEVC, MPEG. Bevorzugt erstellt die Auswerteelektronik **15** des Sensorkopfes **21** die Video-Sequenz und komprimiert diese mittels eines Kompressionsverfahrens und überträgt die so komprimierte Video-Sequenz dann über den Datenbus **29** an das übergeordnete Rechnersystem **28** zur Bedienung des Sensorkopfes **21.**

In einer weiteren Ausprägung des Verfahrens zur Verwendung einer flächenhaften Pumpstrahlungsquelle **(46, 44)** umfasst das Verfahren die Darstellung der Video-Sequenz auf einem Display **32** oder einem anderen Medium zur Darstellung von Video-Sequenzen.

### Sensorkopf

Das hier vorgestellte Dokument schlägt auch einen Sensorkopf **21** mit einer Sensorschicht **5** und einer Lichtquelle **(2, 44)** für Pumpstrahlung **13** und einer Fluoreszenzkamera mit einem Lichtsensorarray **1** aus Lichtsensoren vor. Auch hierbei umfasst bevorzugt die Sensorschicht **5** paramagnetische Zentren, die bei Bestrahlung mit Pumpstrahlung **13** Fluoreszenzstrahlung **(14)** emittieren. Dabei hängt die Intensität der Fluoreszenzstrahlung **14** von der Intensität der Pumpstrahlung **13** und der Intensität der magnetischen Flussdichte am jeweiligen Ort des jeweiligen paramagnetischen Zentrums ab. Vorschlagsgemäß erfasst die Fluoreszenzkamera ein Fluoreszenzbild der Emissionsintensitätsverteilung für die Emission der Fluoreszenzstrahlung **14** aus der Sensorschicht **5** und stellt das Fluoreszenzbild bereit.

In einer weiteren Ausprägung des Sensorkopfes **21** umfasst der der Sensorkopf Hilfsmagnete **19.**

In einer weiteren Ausprägung des Sensorkopfes **21** umfasst die Sensorschicht **5** Diamanten mit NV-Zentren als paramagnetische Zentren.

### Magnetfeldkamera

Das hier vorgelegte Dokument schlägt eine Magnetfeldkamera mit einem der vorbeschriebenen Magnetfeldkameraköpfen **21** vor. Die Magnetfeldkamera weist dabei ein Rechnersystem **28** zur Bedienung des Magnetfeldkamerakopfes **21** auf, wobei das Rechnersystem **28** vorzugsweise aus einem Fluoreszenzbild des Magnetfeldkamerakopfes **21** und/oder aus einem daraus berechneten Bild
- ein Magnetflussdichtenbetragsbild und/oder
- ein Bild der eindimensionales und/oder zweidimensionales und/oder dreidimensionales Verteilung der magnetischen Flussdichte und/oder
- einen Datensatz mit Werten eines eindimensionalen Verlaufs der Fluoreszenzintensität oder des Magnetflussdichtenbetrags längs einer Linie durch das Fluoreszenzbild und/oder das daraus berechneten Bild hindurch
erzeugt.

### Verwendung einer Magnetfeldkamera

Das hier vorgelegte Dokument schlägt vor, eine der vorbesprochenen Magnetfeldkameras für die Untersuchung des Magnetfelds magnetisierter Objekte zu verwenden.

Das hier vorgelegte Dokument schlägt vor, eine der vorbesprochenen Magnetfeldkameras für die Untersuchung der Struktur magnetisierter Objekte zu verwenden.

Das hier vorgelegte Dokument schlägt vor, eine der vorbesprochenen Magnetfeldkameras für die Untersuchung der Materialzusammensetzung magnetisierter Objekte zu verwenden.

Das hier vorgelegte Dokument schlägt vor, eine der vorbesprochenen Magnetfeldkameras für die Untersuchung der Stromdichteverteilung in Objekten, die von einem elektrischen Strom durchflossen sind, zu verwenden.

### Auflösung

Vorzugsweise liefert die Fluoreszenzkamera nach Dekompression ein Bild mit mehr als 19000 Pixeln. Mögliche Bildformate für die Magnetfeldkamera sind je nach Lichtsensorarray-Format des Lichtsensorarrays 1 beispielsweise (Quelle: https://de.wikipedia.org/wiki/Bildaufl%C3%B6sung)

| **Abkürzung** | **Name** | **x** | | **y** | **x:y** | **DAR** | **PAR** | **x·y** |
|---|---|---|---|---|---|---|---|---|
| QQVGA | Quarter QVGA [2][3] | 160 | × | 120 | 4:3 | 4:3 | 1:1 | 19.200 |
| GB | Game Boy[4] | 160 | × | 144 | 4:3 | 4:3 | 1:1 | 23.040 |
| GBC | Game Boy Color [5] | 160 | × | 144 | 4:3 | 4:3 | 1:1 | 23.040 |
| Palm | Palm Low | 160 | × | 160 | 1:1 | 1:1 | 1:1 | 25.600 |
| LoRes | Resolution | | | | | | | |
| GBA | Game Boy Advance [6] | 240 | × | 160 | 3:2 | 3:2 | 1:1 | 38.400 |
| ⅛VGA | ⅛ VGA | 240 | × | 180 | 4:3 | 4:3 | 1:1 | 43.200 |
| ZXS | ZX Spectrum | 256 | × | 192 | 4:3 | 4:3 | 1:1 | 49.152 |
| NDS | Nintendo DS[7] | 256 | × | 192 | 4:3 | 4:3 | 1:1 | 49.152 |
| 3DS | Nintendo 3DS Auflösung je Auge[8] | 400 | × | 240 | 5:3 | 5:3 | 1:1 | 96.000 |
| CGA | Color Graphics Adapter[3] | 320 | × | 200 | 8:5 | 4:3 | 0.833 | 64.000 |
| QVGA | Quarter VGA[3] | 320 | × | 240 | 4:3 | 4:3 | 1:1 | 76.800 |
| 360 | × | 240 | 3:2 | 3:2 | 1:1 | 86.400 | | |
| 384 | × | 240 | 8:5 | 4:3 | 0.833 | 92.160 | | |
| Palm HiRes | Palm High Resolution | 320 | × | 320 | 1:1 | 1:1 | 1:1 | 102.400 |
| QSVGA | Quarter SVGA | 400 | × | 300 | 4:3 | 4:3 | 1:1 | 120.000 |
| WQVGA | Wide QVGA | 432 | × | 240 | 9:5 | 9:5 | 1:1 | 103.680 |
| 480 | × | 160 | 3:1 | 3 | 1:1 | 76.800 | | |
| PSP | PlayStation Portable[9] | 480 | × | 272 | 16:9 | 16:9 | 1.007 | 130.560 |
| HVGA | Half VGA[2] | 480 | × | 320 | 3:2 | 3:2 | 1:1 | 153.600 |
| PSION Serie 5 | 640 | × | 240 | 8:3 | 8:3 | 1:1 | 153.600 | |
| 480 | × | 360 | 4:3 | 4:3 | 1:1 | 172.800 | | |
| EGA | Enhanced Graphics Adapter [3] | 640 | × | 350 | 64:35 | 4:3 | 0.729 | 224.000 |
| QHD | Quarter HD | 640 | × | 360 | 16:9 | 16:9 | 1:1 | 230.400 |
| HSVGA | Half SVGA | 600 | × | 400 | 3:2 | 3:2 | 1:1 | 240.000 |
| VGA | Video Graphics Array[2] | 640 | × | 480 | 4:3 | 4:3 | 1:1 | 307.200 |
| HGC | Hercules Graphics Card | 720 | × | 348 | 60:29 | 4:3 | 0.644 | 250.560 |
| MDA | Monochrome Display Adapter | 720 | × | 350 | 72:35 | 4:3 | 0.648 | 252.000 |
| Apple Lisa | 720 | × | 364 | ≈ 2:1 | 4:3 | 0.674 | 262.080 | |
| WVGA, WGA | Wide VGA | 720 | × | 400 | 9:5 | 9:5 | 1:1 | 288.000 |
| 720 | × | 480 | 3:2 | 3:2 | 1:1 | 345.600 | | |
| 720 | × | 540 | 4:3 | 4:3 | 1:1 | 388.800 | | |
| WVGA, WGA | Wide VGA | 800 | × | 480 | 5:3 | 5:3 | 1:1 | 384.000 |
| WVGA, WGA | Wide VGA | 848 | × | 480 | ≈ 16:9 | 16:9 | 1.006 | 407.040 |
| WVGA, WGA | Wide VGA | 852 | × | 480 | ≈ 16:9 | 16:9 | 1.001 | 408.960 |
| WVGA, WGA | Wide VGA | 858 | × | 484 | ≈ 16:9 | 16:9 | 1.002 | 415.272 |
| WVGA, WGA | Wide VGA | 864 | × | 480 | 9:5 | 9:5 | 1:1 | 414.720 |
| PAL-D | PAL Digital[3] | 768 | × | 576 | 4:3 | 4:3 | 1:1 | 442.368 |
| SVGA | Super VGA[3][2] | 800 | × | 600 | 4:3 | 4:3 | 1:1 | 480.000 |
| HXGA | Half Megapixel (Apple) | 832 | × | 624 | 4:3 | 4:3 | 1:1 | 519.168 |
| qHD, QHD | Quarter HD | 960 | × | 540 | 16:9 | 16:9 | 1:1 | 518.400 |
| 960 | × | 540 | 16:9 | 16:9 | 1:1 | 518.400 | | |
| PS Vita | PlayStation Vita | 964 | × | 544 | 16:9 | 16:9 | 1:1 | 524.416 |
| 964 | × | 544 | ≈ 16:9 | 16:9 | 1:1 | 524.416 | | |
| DVGA | Double VGA | 960 | × | 640 | 3:2 | 3:2 | 1:1 | 614.400 |
| 960 | × | 720 | 4:3 | 4:3 | 1:1 | 691.200 | | |
| WXGA | Wide XGA | 1024 | × | 576 | 16:9 | 16:9 | 1:1 | 589.824 |
| WSVGA | Wide SVGA [3] | 1024 | × | 600 | ≈ 17:10 | 16:9 | 1.041 | 614.400 |
| WSVGA | Wide SVGA | 1072 | × | 600 | ≈ 16:9 | 16:9 | 0.995 | 643.200 |
| EVGA | Extended VGA | 1024 | × | 768 | 4:3 | 4:3 | 1:1 | 786.432 |
| XGA | Extended Graphics Array[2][3] | 1024 | × | 768 | 4:3 | 4:3 | 1:1 | 786.432 |
| XGA | XGA+[3] | 1152 | × | 864 | 4:3 | 4:3 | 1:1 | 995.328 |
| HD720, 720p | High Definition, "HD ready"[3] | 1280 | × | 720 | 16:9 | 16:9 | 1:1 | 921.600 |
| WXGA | Wide XGA (Bright View) | 1280 | × | 768 | 5:3 | 5:3 | 1:1 | 983.040 |
| DSVGA | Double SVGA | 1200 | × | 800 | 3:2 | 3:2 | 1:1 | 960.000 |
| WXGA | Wide XGA[3] | 1280 | × | 800 | 8:5 | 8:5 | 1:1 | 1.024.000 |
| OLPC | One Laptop per Child | 1200 | × | 900 | 4:3 | 4:3 | 1:1 | 1.080.000 |
| SXVGA, QVGA | Super Extended VGA, Quad VGA | 1280 | × | 960 | 4:3 | 4:3 | 1:1 | 1.228.800 |
| SXGA | Super XGA[2][3] | 1280 | × | 1024 | 5:4 | 5:4 | 1:1 | 1.310.720 |
| WXGA | Wide XGA | 1360 | × | 768 | ≈ 16:9 | 16:9 | 1.003 | 1.044.480 |
| WXGA | Wide XGA | 1366 | × | 768 | ≈ 16:9 | 16:9 | 0.999 | 1.049.088 |
| WXGA | Wide XGA | 1376 | × | 768 | ≈ 16:9 | 16:9 | 0.992 | 1.056.768 |
| WXGA+ | WXGA Plus[3] | 1400 | × | 900 | 14:9 | 14:9 | 1:1 | 1.260.000 |
| WXGA+ | WXGA Plus | 1440 | × | 900 | 8:5 | 8:5 | 1:1 | 1.296.000 |
| (Apple) | 1440 | × | 960 | 3:2 | 3:2 | 1:1 | 1.382.400 | |
| SXGA+ | SXGA Plus[3] | 1400 | × | 1050 | 4:3 | 4:3 | 1:1 | 1.470.000 |
| UWXGA | Ultra Wide XGA | 1600 | × | 768 | 25:12 | 2.083 | 1:1 | 1.228.800 |
| WSXGA | Wide SXGA[3] | 1600 | × | 900 | 16:9 | 16:9 | 1:1 | 1.440.000 |
| WSXGA | Wide SXGA[3] | 1600 | × | 1024 | 25:16 | 25:16 | 1:1 | 1.638.400 |
| UXGA | Ultra XGA[2][3] | 1600 | × | 1200 | 4:3 | 4:3 | 1:1 | 1.920.000 |
| WSXGA+ | Wide SXGA+[3] | 1680 | × | 1050 | 8:5 | 8:5 | 1:1 | 1.764.000 |
| FHD, HD1080, 1080p | High Definition, "Full HD" | 1920 | × | 1080 | 16:9 | 16:9 | 1:1 | 2.073.600 |
| WUXGA | Wide UXGA[3] | 1920 | × | 1200 | 8:5 | 8:5 | 1:1 | 2.304.000 |
| 2K-DCI | 2K - Digital Cinema Initiatives | 2048 | × | 1080 | 256:135 | 256:135 | 1:1 | 2.211.840 |
| QWXGA | Quad WXGA | 2048 | × | 1152 | 16:9 | 16:9 | 1:1 | 2.359.296 |
| TXGA | Tesselar XGA | 1920 | × | 1400 | 48:35 | 1.371 | 1:1 | 2.688.000 |
| 1920 | × | 1440 | 4:3 | 4:3 | 1:1 | 2.764.800 | | |
| SUXGA | Super UXGA | 2048 | × | 1536 | 4:3 | 4:3 | 1:1 | 3.145.728 |
| QXGA | Quad XGA[2][3] | 2048 | × | 1536 | 4:3 | 4:3 | 1:1 | 3.145.728 |
| FHD+ | Full HD+ | 2160 | × | 1080 | 18:9 | 18:9 | 1:1 | 2.332.800 |
| FHD+ | Full HD+ | 2340 | × | 1080 | 2.10:1 | 2.10:1 | 1:1 | 2.527.200 |
| UWFHD | Ultra Wide FHD | 2560 | × | 1080 | 21:9 | 21:9 | 1:1 | 2.764.800 |
| WQHD, | Wide QHD | 2560 | × | 1440 | 16:9 | 16:9 | 1:1 | 3.686.400 |
| 1440p | (QHD),[3] "2K"[10] | | | | | | | |
| WQXGA | Wide QXGA[3] | 2560 | × | 1600 | 8:5 | 8:5 | 1:1 | 4.096.000 |
| QSXGA | Quad SXGA[3] | 2560 | × | 2048 | 5:4 | 5:4 | 1:1 | 5.242.880 |
| QHD+ | Quad High Definition Plus | 3200 | × | 1800 | 16:9 | 16:9 | 1:1 | 5.760.000 |
| QSXGA+ DFHD | Quad SXGA+ Double Full HD | 2800 | × | 2100 | 4:3 | 4:3 | 1:1 | 5.880.000 |
| | | 3840 | × | 1080 | 32:9 | 32:9 | 1:1 | 4.147.200 |
| 2K+ | Quad HD+ | 2880 | × | 1440 | 18:9 | 18:9 | 1:1 | 4.147.200 |
| 2K+ | Quad HD+ | 2960 | × | 1440 | 18,5:9 / 19:9 | 18,5:9 / 19:9 | 1:1 | 4.262.400 |
| DWUXGA | Double WUXGA | 3840 | × | 1200 | 32:10 | 32:10 | 1:1 | 4.608.000 |
| WQSXGA | Wide QSXGA | 3200 | × | 2048 | 25:16 | 25:16 | 1:1 | 6.553.600 |
| QUXGA | Quad UXGA[2] | 3200 | × | 2400 | 4:3 | 4:3 | 1:1 | 7.680.000 |
| HSVGA | Hex SVGA | 3200 | × | 2400 | 4:3 | 4:3 | 1:1 | 7.680.000 |
| UWQHD, 1440p | Ultra Wide QHD (QHD) | 3440 | × | 1440 | 21:9 | 43:18 | 1:1 | 4.953.600 |
| QHD | Quad High | 3440 | × | 1440 | 21:9 | 43:18 | 1:1 | 4.953.600 |
| 1440p | Definition | | | | | | | |
| UWQXGA | Ultra Wide QXGA | 3840 | × | 1600 | 2.35:1 | 2.35:1 | 1:1 | 6.144.000 |
| QHD+ 1600p UW4k | Quad High Definition Plus (Ultra Wide 4K) | 3840 | × | 1600 | 2.35:1 | 2.35:1 | 1:1 | 6.144.000 |
| UHD 4K, 2160p | Ultra High Definition "4K"[3] | 3840 | × | 2160 | 16:9 | 16:9 | 1:1 | 8.294.400 |
| QWUXGA | Quad WUXGA | 3840 | × | 2400 | 8:5 | 8:5 | 1:1 | 9.216.000 |
| WQUXGA | Wide QUXGA | 3840 | × | 2400 | 8:5 | 8:5 | 1:1 | 9.216.000 |
| 4K-DCI, 4K2K | 4K - Digital Cinema Initiatives, High Definition, "4K2K"[3] | 4096 | × | 2160 | 256:135 | 256:135 | 1:1 | 8.847.360 |
| Apple iMac Retina 4K | 4096 | × | 2304 | 16:9 | 16:9 | 1:1 | 9.437.184 | |
| HXGA | Hex XGA | 4096 | × | 3072 | 4:3 | 4:3 | 1:1 | 12.582.912 |
| DQHD | Double QHD | 5120 | × | 1440 | 32:9 | 32:9 | 1:1 | 7.372.800 |
| WUHD | Wide UHD, "5K2K"[3] | 5120 | × | 2160 | 21:9 | 21:9 | 1:1 | 11.059.200 |
| UHD+ | Ultra High Definition Plus, "5K"[3] | 5120 | × | 2880 | 16:9 | 16:9 | 1:1 | 14.745.600 |
| WHXGA | Wide HXGA | 5120 | × | 3200 | 8:5 | 8:5 | 1:1 | 16.384.000 |
| Apple Pro Display XDR | 6016 | × | 3384 | 16:9 | 16:9 | 1:1 | 20.358.144 | |
| HSXGA | Hex SXGA | 5120 | × | 4096 | 5:4 | 5:4 | 1:1 | 20.971.520 |
| WHSXGA | Wide HSXGA | 6400 | × | 4096 | 25:16 | 25:16 | 1:1 | 26.214.400 |
| HUXGA | Hex UXGA | 6400 | × | 4800 | 4:3 | 4:3 | 1:1 | 30.720.000 |
| FUHD, 4320p | Full UHD, 8K[3] | 7680 | × | 4320 | 16:9 | 16:9 | 1:1 | 33.177.600 |
| WHUXGA | Wide HUXGA | 7680 | × | 4800 | 8:5 | 8:5 | 1:1 | 36.864.000 |
| 8K-DCI | 8K - Digital Cinema Initiatives | 8192 | × | 4320 | 256:135 | 256:135 | 1:1 | 35.389.440 |
| QUHD, 8640p | Quad UHD, "16K"[3] | 15360 | × | 8640 | 16:9 | 16:9 | 1:1 | 132.710.400 |

Für die Übertragung der Videosequenzen vom Sensorkopf **21** zu einem übergeordneten Rechnersystem **28** kommen beispielsweise folgende Video-Formate in Frage:
Einige Videoformate: (Quelle: https://de.wikipedia.org/wiki/Bildaufl%C3%B6sung)

| Format | Technik | Breite | Höhe | Seitenverhältnis | Pixel |
|---|---|---|---|---|---|
| VHS | analog | 320 | 240 | 4:3 | 76.800 (0,08 MP) |
| Hi8 | analog | 533 | 400 | 4:3 | 213.200 (0,21 MP) |
| S-VHS | analog | 533 | 400 | 4:3 | 213.200 (0,21 MP) |
| LD | analog | 640 | 480 | 4:3 | 307.200 (0,30 MP) |
| VCD (PAL) | digital | 352 | 288 | 4:3 | 101.376 (0,10 MP) |
| SVCD (PAL) | digital | 480 | 576 | 4:3 | 276.480 (0,28 MP) |
| DVB (PAL), DVD-Video (PAL) | digital | 720 | 576 | 4:3 oder 16:9 | 414.720 (0,41 MP) |
| HDTV ("720p") | digital | 1280 | 720 | 16:9 | 921.600 (0,92 MP) |
| FullHD ("1080p") | digital | 1920 | 1080 | 16:9 | 2.073.600 (2,07 MP) |
| WUXGA | digital | 1920 | 1200 | 16:10 | 2.304.000 (2,30 MP) |
| HD-MAC / QWXGA | analog / digital | 2048 | 1152 | 16:9 | 2.359.296 (2,36 MP) |
| 2K | digital | 2048 | 1536 | 4:3 | 3.145.728 (3,15 MP) |
| UHDV-1 ("2160p") | digital | 3840 | 2160 | 16:9 | 8.294.400 (8,30 MP) |
| 4K | digital | 4096 | 3072 | 4:3 | 12.582.912 (12,58 MP) |
| UHDV-2 | digital | 7680 | 4320 | 16:9 | 33.177.600 (33,20 MP) |
| UHXGA | digital | 7680 | 4800 | 16:10 | 36.864.000 (36,90 MP) |

Bevorzugt weist ein durch die Magnetfeldkamera verwendete Videoformat für die Übertragung der Videosequenzen mehr als 70000 Pixel pro Fra me nach Dekompression auf.

Bevorzugt überträgt der Sensorkopf **21** die Video-Sequenzen mit einer Bildrate von mehr als 5fps, besser mehr als 10fps, besser mehr als 20fps, besser mehr al 50fps, besser mehr als 100fps an das übergeordnete Rechnersystem **28.** (fps=frames per second = Biilder pro Sekunde)

### Vorteile der Magnetfeldkamera

Der hier vorgestellte Vorschlag Erfindung ist frei skalierbar und bietet eine deutlich bessere Ortsauflösung als gängige Lösungen.

Vorteile gegenüber aktueller Technik sind:
- Die frei wählbare Sensorfläche der Sensorschicht **5** an der Unterseite **24** des Magnetfeldkamerakopfes **21** ermöglicht auch die Vermessung gekrümmter und flexibler Flächen.
- Der Magnetfeldkamerakopfe **21** bietet eine erhöhte Ortsauflösung bis maximal zur Partikelgröße der Nanodiamanten mit den NV-zentren in der Sensorschicht 5. Dies Größe kann beispielsweise bei ~100nm liegen!
- Der Magnetfeldkamerakopfe **21** bietet eine erhöhte Zeitauflösung aufgrund der hohen möglichen Bildübertragungsrate.
- Der Magnetfeldkamerakopfe **21** bietet eine erhöhte galvanische Trennung. Die die Sensorschicht 5 ist bevorzugt aus einem dielektrischen, isolierendem Material gefertigt und beeinflusst damit typischerweise nicht das zu messende Magnetfeld.
- Die Sensorschicht 5 des Magnetfeldkamerakopfes **21** ist typischerweise unempfindlich gegenüber elektromagnetischen Störungen und Einstrahlungen und strahlt selbst keine elektromagnetischen Wellen im Radiobereich oder Mikrowellenbereich ab. Sie ist damit anderen Quantensensoren überlegen.

### Viertes Ausführungsbeispiel Spektrometer

### Vorschlag

Das hier vorgelegte Dokument schlägt als viertes Ausführungsbeispiel einen Hochfrequenzspektrumanalysator zur spektralen Analyse eines externen Signals (S_{ωnk}) vor. Die Prinzipien der hier vorgestellten Vorrichtung gehen aber darüber hinaus. Daher beschreibt das hier vorgelegte Dokument auch weitere Vorrichtungen, Verfahren und Anwendungen, die auf diesen Prinzipien aufbauen.

Der vorgeschlagene Hochfrequenzspektrumanalysator umfasst typischerweise ein oder mehrere Sensorelemente (SE, 5). Bevorzugt umfasst der Hochfrequenzspektrumanalysator eine Magnetfelderzeugungsvorrichtung (L_{c}), die elektrisch gesteuert sein kann und/oder durch einen Permanentmagneten (PM) und/oder durch einen Gradienten behafteten Permanentmagneten (GPM) realisiert sein kann. Bevorzugt erzeugen diese ein zusätzliches magnetisches Feld, dessen Flussdichte (B_{ad}) von der Position innerhalb eines Sensorelements (SE) und/oder längs eines Wellenleiters **(1380, 1880, 2380, 6830, 6980)** abhängt. Der Hochfrequenzspektrumanalysator umfasst daher bevorzugt einen Wellenleiter **(1380, 1880, 2380, 6830, 6980)** mit einer Längserstreckung mit einer Wellenleitererstreckungskoordinate (x) entlang dieser Längserstreckung. Die Punkte auf dem Wellenleiter **(1380, 1880, 2380, 6830, 6980)** längs der Längserstreckung des Wellenleiters **(1380, 1880, 2380, 6830, 6980)** korrelieren dann typischerweise mit einer eineindeutigen Wellenleitererstreckungskoordinate (x). Die Sensorelemente (SE, 5) sind bevorzugt oberhalb des Wellenleiters **(1380, 1880, 2380, 6830, 6980)** längs der Transportrichtung für elektromagnetische Strahlung längs des Wellenleiters **(1380, 1880, 2380, 6830, 6980)** platziert. Die Sensorelemente (SE, 5) umfassen bevorzugt eine Vielzahl von Kristallen und/oder Diamant-Nano-Kristallen (ND). Die Kristalle und/oder Diamant-Nano-Kristalle (ND) umfassen typischerweise paramagnetische Zentren, bevorzugt NV-Zentren in Diamant als Diamant-Nano-Kristalle (ND). Die paramagnetischen Zentren emittieren typischerweise bei Bestrahlung mit Pumpstrahlung (LB) einer Pumpstrahlungswellenlänge (λₚₘₚ) eine Fluoreszenzstrahlung (FL) mit einer Fluoreszenzstrahlungswellenlänge (λ_{fl}). Die Intensität (Iᵢₛₜ(x), Iᵢₛₜ(y)) der Emission der Fluoreszenzstrahlung (FL) hängt dabei typischerweise von der Frequenz des Mikrowellensignals (µW) und der magnetischen Gesamtflussdichte (B_{Σ}) am Ort des jeweiligen paramagnetischen Zentrums innerhalb der Sensorelemente (SE, 5) ab. Der Hochfrequenzspektrumanalysator speist zur Analyse das externe Signals (S_{ωnk}) oder ein mit dem externen Signal (S_{ωnk}) gemischtes Mikrowellenmischsignal (µW_MX_I) und anschließend typischerweise gefiltertes Signal, das gefilterte, gemischte Mikrowellenmischsignal, als Mikrowellensignal (µW) in den Wellenleiter (1380, 1880, 2380, 6830, 6980) ein. Als Wellenleiter (1380, 1880, 2380, 6830, 6980) kommen insbesondere verschiedene planare Wellenleiter in Frage. Dieses Mikrowellensignal (µW) wechselwirkt dann typischerweise mit den paramagnetischen Zentren in den Sensorelementen **(SE, 5).** Die Magnetfelderzeugungsvorrichtung (L_{c}) durchflutet dann die Sensorelemente **(SE, 5)** mit einem magnetischen Feld mit einer zusätzlichen magnetischen Flussdichte (B_{ad}(x), B_{ad}(y)). Bevorzugt ist das Sensorelement (SE) eine ausgedehnte Sensorelementschicht **(5),** deren flächenhafte Fluoreszenzstrahlung (FL) eine Magnetfeldkamera, die vorzugsweise Teil des Hochfrequenzspektrumanalysators ist, ortsaufgelöst mittels eines Lichtsensorarrays (1) aus Fotodetektoren (PD) erfasst. Diese zusätzliche magnetische Flussdichte (B_{ad}(x), B_{ad}(y)) trägt dann zur jeweiligen Gesamtflussdichte (B_{Σ}) an der jeweiligen Position (x,y) des jeweiligen paramagnetischen Zentrums im Sensorelement **(SE)** bzw. in der Sensorelementschicht (5) an der zugehörigen Wellenleitererstreckungskoordinate (x, y) bei. Der Hochfrequenzspektrumanalysator umfasst bevorzugt Mittel zu Erfassung des Messwertverlaufs des Intensitätsverlaufs (Iᵢₛₜ(x), Iᵢₛₜ(y)) der Emission der Fluoreszenzstrahlung (FL) längs des Wellenleiters **(1380, 1880, 2380, 6830, 6980).** Ein solches Mittel kann beispielsweise Vorrichtungsteile einer Magnetfeldkamera umfassen. Der Hochfrequenzspektrumanalysator ist bevorzugt dazu eingerichtet, aus einem mittels dieser Mittel erfassten Messwertverlauf des Intensitätsverlaufs (Iᵢₛₜ(x), Iᵢₛₜ(y)) der Emission der Fluoreszenzstrahlung (FL) längs des Wellenleiters **(1380, 1880, 2380, 6830, 6980)** auf ein Hochfrequenzspektrum (Kₛ(ω_{µW}), K_{w}(ω_{µW})) des externen Signals (S_{ωnk}) zu schließen. Der Vorteil einer solchen Vorrichtung ist, dass der Verlauf der Fluoreszenzintensität der Intensität Iᵢₛₜ(x), Iᵢₛₜ(y) der Fluoreszenzstrahlung (FL) längs des Sensorelements (SE, 5) längs des Wellenleiters in einem längs des Wellenleiters mit einem Gradienten behafteten Magnetfeld, insbesondere eines Gradienten behafteten Permanentmagneten (GPM), nach Erfassung durch eine Magnetfeldkamera und/oder eine Vielzahl von Fotodetektoren (PD) mittels einer einfachen Transformation extrem schnell in ein Spektrum K(ω_{µW}) des externen Signals (S_{ωnk}) umgesetzt werden kann.

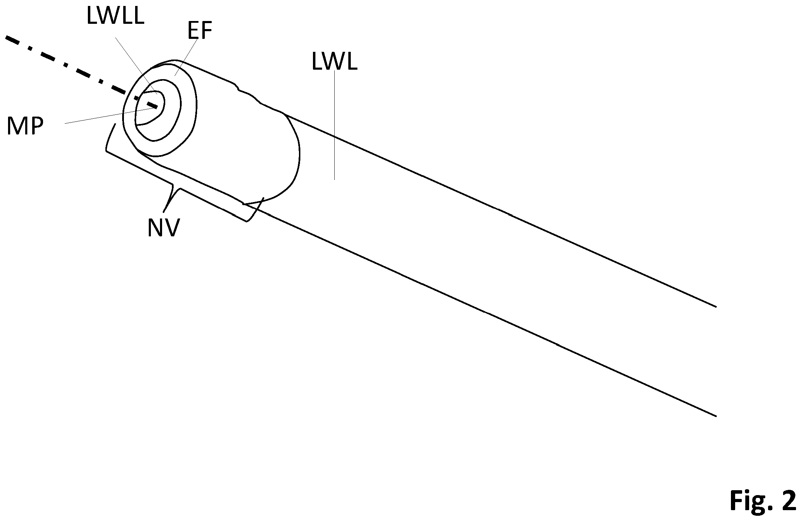

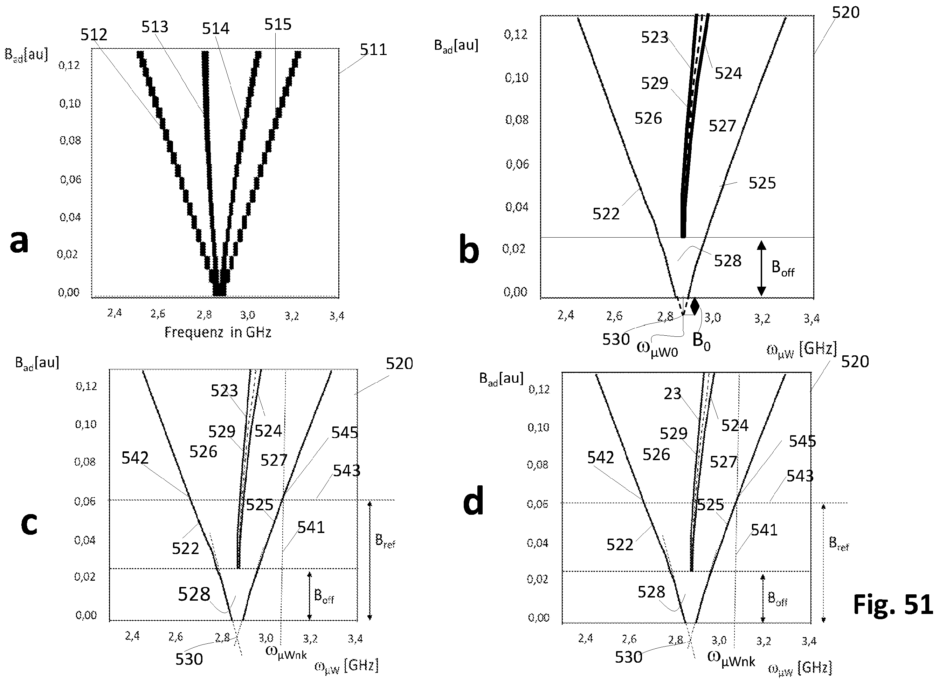

In einer besonderen Ausprägung umfasst der Hochfrequenzspektrumanalysator als Wellenleiter **(1380, 1880, 2380, 6830, 6980)** einen ersten Wellenleiter **(6980_I)** und einen zweiten Wellenleiter **(6980_II),** wobei der erste Wellenleiter **(6980_I)** vom zweiten Wellenleiter **(6980_II)** verschieden ist. In dieser Ausprägung erzeugt der Hochfrequenzspektrumanalysator durch Mischung des externen Signals (S_{ωnk}) mit einem ersten internen Mikrowellensignal (µW_G_I) mit einer ersten internen Mikrowellenfrequenz (ω_{µW_I}) ein erstes Mikrowellensignal (µW_I). In dieser Ausprägung erzeugt der Hochfrequenzspektrumanalysator durch Mischung des externen Signals (S_{ωnk}) mit einem zweiten internen Mikrowellensignal (µW_G_II) mit einer zweiten internen Mikrowellenfrequenz (ω_{µW_II}) ein zweites Mikrowellensignal (µW_II). Bevorzugt speist dann der Hochfrequenzspektrumanalysator das erste Mikrowellensignal (µW_I) in den ersten Wellenleiter (6980_I) ein. Bevorzugt speist der Hochfrequenzspektrumanalysator das zweite Mikrowellensignal (µW_II) in den zweiten Wellenleiter (6980_II) ein. Bevorzugt umfasst der Hochfrequenzspektrumanalysator Mittel zu Erfassung des Messwertverlaufs der Intensitätsverläufe (Iᵢₛₜ(x), Iᵢₛₜ(y)) der Emission der Fluoreszenzstrahlung (FL) längs der Wellenleiterkoordinate (x) des ersten Wellenleiters (6980_I) und längs der Wellenleiterkoordinate (y) des zweiten Wellenleiters (6980_II). Der Hochfrequenzspektrumanalysator ist in dieser Ausprägung dann bevorzugt dazu eingerichtet, aus den erfassten Messwertverläufen der Intensitätsverläufe (Iᵢₛₜ(x), Iᵢₛₜ(y)) der Emission der Fluoreszenzstrahlung (FL) längs der Wellenleiterkoordinate (x) des ersten Wellenleiters (6980_I) und längs der Wellenleiterkoordinate (y) des zweiten Wellenleiters (6980_II) auf ein oder mehrere Hochfrequenzspektren (Kₛ(ω_{µW}), K_{w}(ω_{µW})) des externen Signals (S_{ωnk}) zu schließen. Der Vorteil eine solchen Konstruktion ist, dass unterschiedliche vertikale Linien in dem Diagramm der Figur 2 gleichzeitig und damit schneller abgetastet werden können. Damit ist die Bestimmung der Position (30) der V-Formation aus unterer Resonanzkante (522) und oberer Resonanzkante (525) (siehe Figur 51b) präziser und sehr schnell möglich.

Ein zu charakterisierendes Mikrowellensignal (S_{ωnk}) wird z.B. in einem planaren Wellenleiter geführt, dessen Oberfläche mit NV-Pulver bedeckt ist und vorzugsweise zusätzlich noch mit einer statischen Magnetfeldverteilung beaufschlagt ist. Mikrowellenstrahlung einer Frequenz führt zu einer Abschwächung der Fluoreszenzintensitäten an Positionen bestimmter Magnetfeldstärken, womit durch Auswertung der Fluoreszenzintensitätsverteilung das Mikrowellenspektrum rekonstruiert werden kann.

Hierdurch wird ein optischer Breitband Single-Shot Spektrum Analysator für Mikrowellenstrahlung im Frequenzbereich von ca. 0,1 bis 100GHz möglich.

Das unbekannte Mikrowellensignal (S_{ωnk}) wird in ein Mikrowellenbauteil, beispielsweise einen Wellenleiter eingespeist (z.B. eine planares PCB), das das Mikrowellensignal (µW) der Mikrowellen führt (z.B. coplanar waveguide). Es kann sich bei einem Mikrowellenbauteil auch um eine Zusammenschaltung mehrerer Mikrowellenbauteilen handeln. Ein solches Mikrowellenbauteil kann das unbekannte Mikrowellensignal u.U. auch spektral auftrennen und/oder an Resonatoren koppen (z.B. Ringresonatoren). Das Mikrowellenbauteil ist vorzugsweise so gestaltet, dass an der Oberfläche evaneszente Mikrowellenfelder vorhanden sind. Diese Oberfläche wird mit dem NV-Diamant-Pulver beschichtet. Dies kann z.B. durch eine Mischung aus NV-Diamant-Pulver mit Diamant-Nano-Kristallen (ND) Pulver oder einem anderen Kristallpulver mit anderen paramagnetischen Zentren und UV-härtbarem Kleber Trägermaterial TM) erfolgen. Nach dem Auftragen dieser kolloidalen Mischung auf ein Mikrowellenbauteil, wird der UV-härtbare Kleber (Trägermaterial TM) vorzugsweise mittels UV-Strahlung (Aushärtestrahlung 4910) ausgehärtet. Andere Kleber (Trägermaterialien TM) mit anderen Aushärtemethoden sind denkbar. Durch das Aushärten entsteht das eigentliche Sensorelement (SE).

Des Weiteren wird durch Permanentmagneten (PM, GPM) oder Elektromagneten (Magnetfelderzeugungsmittel L_{c}) eine zusätzliche Magnetfeldverteilung (B_{ad}) im NV-Diamant-Pulver des Sensorelements (SE) erzeugt, welche bevorzugt senkrecht zum magnetischen Feld (B_{µW}) der Mikrowellenfeldersteht.

Zusätzlich wird das NV-Diamant-Pulver durch eine geeignete Lichtquelle (z.B. grüne LED) als Pumpstrahlungsquelle zur Emission einer Fluoreszenzstrahlung (FL) angeregt. Ein Fotodetektorarray (1) und/oder eine Kamera messen die Verteilung der Fluoreszenzintensität der Intensität Iᵢₛₜ(t) der Fluoreszenzstrahlung der über den Wellenleiter.

Eine Mikrowellenstrahlung einer bestimmten Mikrowellenfrequenz (ω_{µW}) verursacht eine charakteristische Fluoreszenzintensitätsabschwächung der Intensität Iᵢₛₜ(t) der Fluoreszenzstrahlung der NV-Zentren in den Diamantkristallen des NV-Diamant-Pulvers. Diese Fluoreszenzintensitätsabschwächung hängt typischerweise von der Stärke des statischen Magnetfeldes an den NV-Zentren bzw. paramagnetischen Zentren, die dem jeweiligen Fotodetektor des jeweiligen Messpixels zugeordnet sind, ab.

Durch Messung der Fluoreszenzintensitätsverteilung Intensität Iᵢₛₜ(t) der Fluoreszenzstrahlung der NV-Zentren in den Diamantkristallen des NV-Diamant-Pulvers mit einer Kamera (oder einem anderen Sensor- oder Fotodetektorarray) und Kenntnis der Verteilung des statischen Magnetfeldes (insbesondere nach vorheriger Kalibrierung des Messgeräts), lassen sich die spektralen Anteile des Mikrowellensignals(S_{ωnk}) rekonstruieren. Ein erster wesentlicher Vorteil der Verwendung von NV-Diamant-Pulver, das viele kleine ungeordnete Diamantkristalle (Diamant-Nano-Kristalle ND) mit NV-Zentren umfasst, gegenüber der Verwendung einkristallinen Diamants ist vor allem die Einfachheit der Produktion, die keine Ausrichtung eines einkristallinen Diamanten gegenüber einem Magnetfeld mehr erfordert. Ein solches kolloidales Gemisch (KL) aus NV-Diamantkristallen und einem Kleber als Trägermaterial (TM) ist einfach durch Aufschleudern, Dispensieren oder Drucken zu handhaben und damit Batch-fähig, was die Herstellkosten für diese Sensorsysteme massiv senkt und eine CMOS-Kompatibilität und CMOS-Fab-Fähigkeit zur Folge hat.

Neu ist die Idee, ein solches Gemisch auf einem Wellenleiter (1380, 1880, 2380, 6830, 6980), und zwar insbesondere selbstjustierend, zu platzieren. Das kolloidale Gemisch (KL) ist daher leicht auf einer gedruckten Schaltung (PCB) oder einem Wafer mikrointegrierter Halbleiterschaltungen aufzubringen, die die besagten Wellenleiter (1380, 1880, 2380, 6830, 6980) umfassen können.

Das hier vorgestellte Spektrometer ist daher mikrointegrierbar.

Die NV-Pulverschicht umfassen Diamant-Nano-Kristalle (ND) mit NV-Zentren und/oder paramagnetischen Zentren und/oder umfassend Kristalle mit paramagnetischen Zentren ist vorzugsweise dünn und wechselwirkt damit gut mit dem evaneszenten Anteilen der im PCB geführten Mikrowellenfeldern.

Vorzugsweise ist die Dicke **D_{SE}** des Sensorelements **SE** und/oder der Sensorelementschicht **5** dünner als die Breite der kleinsten Strukturen des jeweiligen Wellenleiters, um eine gute Auflösung sicherzustellen.

Durch das Vermischen des NV-Diamant-Pulvers mit Diamant-Nano-Kristallen (ND) mit NV-Zentren und/oder paramagnetischen Zentren und/oder Kristallen mit paramagnetischen Zentren mit einem Klebstoff als Trägermaterial, kann das NV-Pulver gezielt auf Bereiche des PCBs und/oder des Wafers aufgebracht werden in denen das evaneszente Mikrowellenfeld des Mikrowellensignals (µW) eine hohe Amplitude und geeignete Orientierung aufweist.

Im Gegensatz zu einkristallinen Diamanten, ist in der in diesem Dokument vorgestellten technischen Lehre keine Ausrichtung von NV-Diamantkristallen nötig, da im NV-Pulver alle Raumrichtungen als Ausrichtungsrichtungen der NV-Zentren-Achsen statistisch gleichverteilt auftreten.

Im Vergleich zu anderen Spektrumanalysatoren kann eine Vorrichtung gemäß der hier vorgestellten technischen Lehre einen sehr breiten Frequenzbereich mit der hier vorgestellten Messtechnik abdecken. Der Messbereich ist dabei durch das das maximal angelegte statische Magnetfeld (28GHz / Tesla) gegeben. Damit ergibt sich z.B. bei einer Magnetfeldverteilung von 0T bis 2,5T ein Messbereich von ca. 0-70Ghz. Der größte Vorteil ist aber, dass bei Verwendung einer Magnetfeldkamera der gesamte Messbereich mit einem "Single Shot" mittels einzelner Frames einer Magnetfeldkamera gemessen werden kann. Ein Durchstimmen einer Mikrowellenfrequenz, wie z.B. für eine hetreodyne Messung, ist bei der hier vorgestellten Messtechnik nicht nötig.

Bei der Ausarbeitung des hier vorgelegten Dokuments wurde darüber hinaus erkannt, dass die Vorrichtung auch für die hochpräzise Messung unbekannter externer magnetischer Flussdichten (Bₑₓₜ) geeignet ist.

Die Vorrichtung kann also PARALLEL eine unbekannte Mikrowellenfrequenz (ωₙₖ) und eine unbekannte magnetische Flussdichte (Bₑₓₜ) bestimmen.

Aufgrund der großen Parallelität der Messungen, kann die Vielzahl der Messwerte für eine signifikante Fehlerreduktion verwendet werden. Die hier vorgestellte technische Lehre ermöglicht also breitbandige, schnelle und hochgenaue Messungen von magnetischen Flussdichten (Bₑₓₜ) und/oder Mikrowellenfrequenzen (ω_{µW}).

Damit ergeben sich für die hier vorgestellte technische Lehre beispielsweise folgende Anwendungsgebiete: Magnetokardiographie (MKG): Die hier vorgestellten Sensorsysteme können beispielsweise zur Erfassung und Aufzeichnung von magnetischen Feldern, die vom Herz eines Menschen oder eines Tieres erzeugt werden, verwendet werden. Die Magnetokardiographie ermöglicht eine nicht-invasive Untersuchung der Herzaktivität und kann zur Diagnose von Herzkrankheiten eingesetzt werden.

Magnetenzephalographie (MEG): Die hier vorgestellten Sensorsysteme können beispielsweise zur Messung der magnetischen Felder, die von der elektrischen Aktivität des Gehirns eines Menschen oder eines Tieres erzeugt werden, verwendet werden. Die Magnetenzephalographie ermöglicht die hochauflösende Abbildung der Hirnaktivität und kann in der Neurowissenschaft und klinischen Diagnostik eingesetzt werden.

Neurointerfaces: Die hier vorgestellten Sensorsysteme können beispielsweise zur Messung der magnetischen Felder, die von der elektrischen Aktivität des Gehirns von Menschen oder Tieren erzeugt werden, verwendet werden, wobei dann die erfassten Messwerte zur Steuerung von Computern und/oder Rechnersystemen und/oder Quantencomputern direkt oder indirekt eingesetzt werden können, die wiederum Aktoren steuern können oder Datenbanken mit Daten füllen können.

Biomagnetik: Die hier vorgestellten Sensorsysteme können beispielsweise in der Erforschung und Messung von magnetischen Feldern, die von biologischen Organismen erzeugt werden, eingesetzt. Dies umfasst Studien zur Magnetorezeption bei Tieren, Untersuchungen zur Gehirnfunktion und -aktivität, aber auch die Detektion von Krebs durch magnetische Marker in der medizinischen Bildgebung.

Materialcharakterisierung: Die hier vorgestellten Sensorsysteme können beispielsweise zur Charakterisierung der magnetischen Eigenschaften von Materialien eingesetzt werden. Dies umfasst die Messung magnetischer Suszeptibilität, kritischer Magnetfelder und Magnetisierungskurven, die wichtige Informationen über die Materialeigenschaften liefern. Hierzu gehören die Detektion und Darstellung von Materialfehlern wie Rissen, Lunkern und Inhomogenitäten.

Geophysikalische Erkundung: Die hier vorgestellten Sensorsysteme können beispielsweise in der Geophysik eingesetzt, um magnetische Felder zu messen und geologische Strukturen zu kartieren. Dies umfasst die Suche nach Bodenschätzen, die Untersuchung der Erdkruste und die Erforschung des Erdmagnetfeldes. Quanteninformatik und Quantencomputing: Die hier vorgestellten Sensorsysteme können beispielsweise in einigen Ansätzen zur Realisierung von Quantenbits (Qubits) in Quantencomputern verwendet werden. Sie ermöglichen die Messung und Steuerung von Quantenzuständen und sind wahrscheinlich nützlich für die Entwicklung von skalierbaren Quantencomputern.

Detektion schwacher magnetischer Signale: Aufgrund ihrer hohen Empfindlichkeit können die hier vorgestellten Sensorsysteme beispielsweise in verschiedenen Anwendungen eingesetzt werden, um schwache magnetische Signale zu detektieren. Dies umfasst die Untersuchung von Materialdefekten, die zerstörungsfreie Prüfung, die Magnetresonanztomographie (MRT) und die Detektion von biomagnetischen Signalen. Strommessung: Die hier vorgestellten Sensorsysteme können beispielsweise zur nicht-invasiven Messung von Stromstärken in elektrischen Systemen eingesetzt. Sie können in Leistungselektronik, Elektrofahrzeugen, Solarmodulen Leistungsbauelementen (IGBTs, Thyristoren, Dioden etc.) und anderen Anwendungen verwendet werden, um den Stromfluss zu überwachen.

Geschwindigkeits- und Positionsregelung: Die hier vorgestellten Sensorsysteme können beispielsweise können zur Erfassung der Geschwindigkeit und Position rotierender und/oder translatorisch sich bewegender Komponenten wie Motoren, Lüftern und Getrieben eingesetzt werden. Sie ermöglichen eine präzise Regelung und Steuerung der betreffenden Bewegung.

Automotive-Anwendungen: Die hier vorgestellten Sensorsysteme können beispielsweise in der Automobilindustrie in verschiedenen Anwendungen eingesetzt. Dazu gehören beispielsweise die Erfassung der Kurbelwellenposition, des Nockenwellensignals, der Raddrehzahl, des Lenkwinkels und anderer Parameter für die Motorsteuerung, das Antiblockiersystem (ABS), die Traktionskontrolle und andere sicherheitsrelevante Systeme.

Magnetfeldmessung: Die hier vorgestellten Sensorsysteme können beispielsweise verwendet werden, um Magnetfelder zu messen und zu überwachen. Dies kann Anwendung in Bereichen wie der Magnetsensorik, der Materialcharakterisierung, der Geophysik, der Robotik und anderen wissenschaftlichen und industriellen Anwendungen geschehen.

Sicherheits- und Alarmsysteme: Die hier vorgestellten Sensorsysteme können beispielsweise in Sicherheitssystemen eingesetzt, um das Öffnen oder Schließen von Türen, Fenstern und anderen Zugängen zu überwachen. Sie können auch in Alarmsystemen zur Erkennung von Eindringlingen oder zur Überwachung von Bewegungen verwendet werden.

Stromversorgung und Energieeffizienz: Die hier vorgestellten Sensorsysteme können beispielsweise Anwendung in der Stromversorgung finden, um den Energieverbrauch zu überwachen und die Energieeffizienz zu optimieren. Sie können in Smart Grids, elektrischen Fahrzeugladesystemen und anderen Anwendungen eingesetzt werden, um genaue Messungen und Kontrolle zu ermöglichen.

Elektronik und Kommunikation: Die hier vorgestellten Sensorsysteme können beispielsweise Verwendung in der Elektronik und Kommunikationstechnik finden, um magnetische Interferenzen zu erkennen und zu reduzieren. Sie können auch in berührungsfreien Schaltern, Schließsystemen, Joysticks und anderen elektronischen Geräten und zur Fehlersuche in elektronischen Schaltungen und mikroelektronischen Schaltungen eingesetzt werden.

Industrielle Automatisierung: Die hier vorgestellten Sensorsysteme können beispielsweise in der industriellen Automatisierung zur Erfassung von Positionen, Winkeln, Winkelgeschwindigkeiten, Winkelbeschleunigungen, Geschwindigkeiten, Beschleunigungen und Bewegungen eingesetzt werden. Sie ermöglichen eine präzise Steuerung von Maschinen und Prozessen.

### Trägersubstrat

Um einen solchen Hochfrequenzspektrumanalysator realisieren zu können, schlägt das hier vorgelegte Dokument ein Trägersubstrat (1360), insbesondere für einen solchen Hochfrequenzspektrumanalysator und/oder für Vorrichtungen zur Bestimmungen von magnetischen Flussdichten, vor. Das Trägersubstrat (1360) weist typischerweise eine Oberfläche mit einer oder mehreren eine Wellenleitungen (1380, 1880, 2380, 6830, 6980) auf. Vorschlagsgemäß umfasst das Trägersubstrat (1360) ein Sensorelement (SE) zur Detektion der Komponente einer Gesamtflussdichte (B_{Σ}) parallel und/oder senkrecht zur Oberfläche des Trägersubstrats (1360) und parallel und/oder senkrecht zur Richtung der Wellenleitungen (1380, 1880, 2380, 6830, 6980), wobei die Komponente der Gesamtflussdichte (B_{Σ}) von der Größe und Position des Sensorelements (SE) relativ zu den Strukturen der Wellenleitung abhängt . Vorschlagsgemäß umfasst das Sensorelement (SE) eine Vielzahl von Kristallen und/oder Diamant-Nano-Kristallen (ND), wobei die Kristalle, wenn vorhanden, und Diamant-Nano-Kristalle (ND), wenn vorhanden, paramagnetische Zentren, insbesondere und bevorzugt NV-Zentren in Diamant als Diamant-Nano-Kristalle (ND), umfassen. Die bevorzugten Diamant-Nano-Kristalle (ND) mit NV-zentren und/oder paramagnetischen Zentren liegen bevorzugt als Diamantpulver vor der Verarbeitung vor. Dabei umfasst das Sensorelement (SE) bevorzugt ein Trägermaterial (TM), in das typischerweise die Kristallen und/oder Diamant-Nano-Kristallen (ND) eingebettet sind. Grundsätzlich müssen der Vektor der magnetischen Flussdichte eines Mikrowellensignals (µW) in der Mikrowellenleitung (1380, 1880, 2380, 6830, 6980) und die Achse der NV-Zentren bzw. paramagnetischen Zentren in den Kristallen und/oder Diamant-Nano-Kristallen (ND) des Sensorelements (SE) senkrechtaufeinander stehen. Demgegenüber muss typischerweise die Achse des externen Magnetfelds parallel zur NV-Zentren Achse bzw. zur Achse der paramagnetischen Zentren sein, um eine Reduktion der Intensität Iᵢₛₜ(t) der Fluoreszenzstrahlung (FL) der paramagnetischen Zentren bzw. NV-Zentren bei Resonanz zwischen dem Mikrowellensignal (µW) und dem NV-Zentrum bzw. dem paramagnetischen Zentrum zu zeigen. Um bestimmungsgemäß verwendet werden zu können, ist das Trägermaterial (TM) vorzugsweise für elektromagnetische Strahlung (Pumpstrahlung LB) einer Pumpstrahlungswellenlänge (λₚₘₚ) im Wesentlichen transparent und für elektromagnetische Strahlung (Fluoreszenzstrahlung FL) einer Fluoreszenzstrahlungswellenlänge (λ_{fl}) im Wesentlichen transparent. Typischerweise senden paramagnetische Zentren der Kristalle und/oder der Diamant-Nano-Kristalle (ND) Fluoreszenzstrahlung (FL) mit einer Fluoreszenzwellenlänge (λ_{fl}) aus, wenn sie mit Pumpstrahlung (LB) der Pumpstrahlungswellenlänge (λₚₘₚ) bestrahlt werden. Bevorzugt weist nun das Sensorelement (SE) eine Breite (d_{SE}) auf. Vorschlagsgemäß ergeben sich nun verschiedene Positionierungen für das Sensorelement (SE, 5) gegenüber einem Wellenleiter (1380, 1880, 2380, 6830, 6980):
Zum Ersten, entsprechend einer Sensorelementposition A des Sensorelements (SE):
Bei einer Positionierung des Sensorelements (SE, **5)** entsprechend einer Sensorelementposition A des Sensorelements (SE) umfasst die Wellenleitung (1380, 2380, 6830, 6980) nur eine Signalleitung (1330) oder eine differentielle Signalleitung (6830) aus zwei Signalleitungen (6810, 6820). Bei einer Positionierung des Sensorelements (SE, 5) entsprechend einer Sensorelementposition A des Sensorelements (SE) befindet sich das jeweilige Sensorelement (SE) auf der jeweiligen Signalleitung (1330, 6810, 6820) und ist vorzugsweise mit der jeweiligen Signalleitung (1330, 6810, 6820) fest verbunden. Die jeweiligen betreffende Signalleitung (1330, 6810, 6820) weist dabei typischerweise eine jeweilige Breite (dₛ) auf. Vorschlagsgemäß ist bevorzugt in einigen Anwendungsfällen die jeweilige Breite (d_{SE}) des jeweiligen Sensorelements (SE) kleiner als die jeweilige Breite (dₛ) der jeweiligen Signalleitung **(1330, 6810, 6820).**

Zum Zweiten, entsprechend einer Sensorelementposition B des Sensorelements (SE):
Bei einer Positionierung des Sensorelements **(SE, 5)** entsprechend einer Sensorelementposition B des Sensorelements **(SE)** umfasst die Wellenleitung **(1880, 2380, 6830, 6980)** eine nicht-leitende Isolationslücke **(1840, 2340, 2350, 6840).** Bei einer Positionierung des Sensorelements (SE, **5)** entsprechend einer Sensorelementposition B des Sensorelements (SE) befindet sich vorzugsweise das jeweilige Sensorelement **(SE)** in der jeweiligen nicht-leitenden Isolationslücke (1840, 2340, 2350, 6840) und das jeweilige Sensorelement **(SE)** ist vorzugsweise mit Oberfläche der jeweiligen nicht-leitenden Isolationslücke **(1840, 2340, 2350, 6840)** fest verbunden. Typischerweise weist die jeweilige nicht-leitende Isolationslücke **(1840, 2340, 2350, 6840)** eine jeweilige Breite **(d_{IS1}, d_{IS2}, d_{SL})** auf. Bevorzugt ist die jeweilige Breite **(d_{SE})** des jeweiligen Sensorelements **(SE)** kleiner als die jeweilige Breite **(d_{IS1}, d_{IS2}, d_{SL})** der jeweiligen nicht-leitenden Isolationslücke **(1840, 2340, 2350, 6840).**

Zum Dritten, entsprechend einer Sensorelementposition C des Sensorelements (SE):
Bei einer Positionierung des Sensorelements (SE, 5) entsprechend einer Sensorelementposition C des Sensorelements (SE) umfasst die Wellenleitung (1380, 6830) eine Signalleitung (1330, 6810, 6820) und eine elektrisch im Wesentlichen nicht-leitende Isolationsfläche (1340, 1350). Bei einer Positionierung des Sensorelements (SE, 5) entsprechend einer Sensorelementposition C des Sensorelements (SE) befindet sich das jeweilige Sensorelement (SE) bevorzugt auf der jeweiligen elektrisch im Wesentlichen nicht-leitenden Isolationsfläche (1340, 1350) und ist vorzugsweise mit der jeweiligen elektrisch im Wesentlichen nicht-leitenden Isolationsfläche (1340, 1350) fest verbunden. Die jeweilige Signalleitung (1330, 6810, 6820) weist eine jeweilige Breite (dₛ) aufweist, wobei vorzugsweise die jeweilige Breite (d_{SE}) des jeweiligen Sensorelements (SE) kleiner als die jeweilige Breite (dₛ) der jeweiligen Signalleitung (1330, 6810, 6820) ist und wobei bevorzugt der maximale Abstand eines Teils des jeweiligen Sensorelements (SE) von der jeweils nächstliegenden Kante der jeweiligen Signalleitung (1330, 6810, 6820) kleiner als das doppelte der jeweiligen Breite (dₛ) der jeweiligen Signalleitung (1330, 6810, 6820) ist.

Zum Vierten, entsprechend einer Sensorelementposition D des Sensorelements (SE):
Bei einer Positionierung des Sensorelements (SE, 5) entsprechend einer Sensorelementposition D des Sensorelements (SE) umfasst die Wellenleitung (1880, 2380, 6980) eine nicht-leitende Isolationslücke (1840, 2340, 2350, 6840) und eine elektrisch leitende Signalmassefläche (1310, 1320). Bei einer Positionierung des Sensorelements (SE, 5) entsprechend einer Sensorelementposition D des Sensorelements (SE) befindet sich das jeweilige Sensorelement (SE) auf der jeweiligen elektrisch leitenden Signalmassefläche (1310, 1320) und ist vorzugsweise mit der jeweiligen elektrisch leitenden Signalmassefläche (1310, 1320) fest verbunden. Bevorzugt weist die jeweilige nicht-leitende Isolationslücke (1840, 2340, 2350, 6840) eine jeweilige Breite (d_{IS1}, d_{IS2}, d_{SL}) auf, wobei vorzugsweise jeweilige die Breite (d_{SE}) des Sensorelements (SE) kleiner als die jeweilige Breite (d_{IS1}, d_{IS2}, d_{SL}) der jeweiligen nicht-leitenden Isolationslücke (1840, 2340, 2350, 6840) ist und wobei vorzugsweise der maximale Abstand eines Teils des jeweiligen Sensorelements (SE) von der jeweiligen nächstliegenden Kante der jeweiligen nicht-leitenden Isolationslücke (1840, 2340, 2350, 6840) kleiner als das doppelte der jeweiligen Breite (d_{IS1}, d_{IS2}, d_{SL}) der jeweiligen nicht-leitenden Isolationslücke (1840, 2340, 2350, 6840) ist.

In einer weiteren Ausprägung des Trägersubstrat (1360) umfasst das Trägermaterial (TM) ein strahlungsgehärtetes Trägermaterial (TM). In einer weiteren Ausprägung des Trägersubstrat (1360) umfasst das Trägermaterial (TM) ein UV-strahlungsgehärtetes Trägermaterial (TM).

### Trägersubstratsatz mit hohem Cₚₖ-Wert

Die in dem hier vorgelegten Dokument beschriebenen, insbesondere selbstjustierenden Fertigungstechniken ermöglichen die Fertigung von Sensorelementen (SE) mit einem hohen Cpk-Wert. Bevorzugt wird der Cpk-Wert anhand eines willkürlichen Trägersubstratsatzes als Stichprobe ermittelt, wobei der Trägersubstratsatz eine Mehrzahl von Trägersubstraten (1360) umfasst. Bevorzugt umfasst der Trägersubstratsatz eine Mehrzahl von mindestens 10 und/oder besser mindestens 20 und/oder besser mindestens 50 und/oder besser mindestens 100 Trägersubstraten (1360). Um einen sinnvollen Cpk-Wert ermitteln zu können sollten die Trägersubstrate (1360) des Trägersubstratsatzes in im Wesentlichen gleicher Weise konstruiert sein (konstruktionsidentisch sein). Dabei weist typischerweise jedes der Trägersubstrate (1360) des Trägersubstratsatzes zumindest eine Wellenleitung (1380, 1880, 2380, 6830, 6980) auf. Des Weiteren weist typischerweise die zumindest eine Wellenleitung (1380, 1880, 2380, 6830, 6980) jedes jeweiligen Trägersubstrats (1360) des Trägersubstratsatzes zumindest eines der Strukturelemente
- einen Signalleiter (1330) mit einer Breite (dS) und/oder
- eine elektrisch im Wesentlichen nicht-leitende linke Isolationslücke (2340) mit einer Breite (dIS1) und/oder
- eine elektrisch im Wesentlichen nicht-leitende rechte Isolationslücke (2350) mit einer Breite (dIS2) und/oder
- einen Schlitz (1840) mit einer Breite (dSL) und/oder
- einen linken Signalleiter (6810) mit einer Breite (dS) und/oder
- einen rechten Signalleiter (6820) mit einer Breite (dS) und/oder
- eine elektrisch isolierende Lücke (6840) mit einer Breite (dSL)
als jeweiliges Strukturelement auf. Somit weist jedes der jeweiligen Trägersubstrate (1360) des Trägersubstratsatzes zumindest ein jeweiliges Sensorelement (SE) des jeweiligen Trägersubstrats (1360) des Trägersubstratsatzes mit einem jeweiligen Durchmesser (dSE) und seiner jeweiligen Mitte des jeweiligen Sensorelements (SE) des jeweiligen Trägersubstrats (1360) des Trägersubstratsatzes auf. Das jeweilige Sensorelement (SE) des jeweiligen Trägersubstrats (1360) des Trägersubstratsatzes befindet sich typischerweise auf oder in dem zumindest einen jeweiligen Strukturelement der zumindest einen jeweiligen Wellenleitung (1380, 1880, 2380, 6830, 6980) des jeweiligen Trägersubstrats (1360). Dieses jeweilige Strukturelement des jeweiligen Trägersubstrats (1360) des Trägersubstratsatzes weist dabei jeweils die besagte jeweilige Breite und eine jeweilige Mitte dieses jeweiligen Strukturelements des jeweiligen Trägersubstrats (1360) bei seiner halben jeweiligen Breite auf. Die jeweilige Mitte des zumindest einen jeweiligen Sensorelements des jeweiligen Trägersubstrats (1360) des Trägersubstratsatzes ist fertigungsstreuungsbedingt typischerweise jeweils gegenüber der jeweiligen Mitte dieses jeweiligen Strukturelements des jeweiligen Trägersubstrats (1360) um einen jeweiligen Versatz fertigungsbedingt versetzt. Der aus diesen jeweiligen Versätzen der jeweiligen Trägersubstrate (1360) als jeweilige Streuungen und der mittleren Breite der jeweiligen Breite des zumindest einen jeweiligen Strukturelements der jeweiligen Trägersubstrate (1360) als Toleranzintervall für den Versatz der jeweiligen Sensorelemente (SE) gegenüber dem jeweiligen Strukturelement ermittelte Cₚₖ-Wert für die Gesamtheit der Trägersubstrate (1360) dieses Trägersubstratsatzes ist bei Verwendung der hier vorgestellten, insbesondere selbstjustierenden Fertigungstechniken bei richtiger Anwendung der Verfahren besser als 1,66 und damit für die Fertigung in automobilen Lieferketten geeignet. Die zur Ermittlung des Cₚₖ-Werts des Trägersubstratsatzes vermessenen jeweiligen Strukturelemente der jeweiligen Trägersubstrate (1360) des Trägersubstratsatzes sind bevorzugt die gleichen jeweiligen Strukturelemente bei allen jeweiligen Trägersubstraten der Trägersubstrate (1360) des Trägersubstratsatzes. Die zur Ermittlung des Cₚₖ-Werts des Trägersubstratsatzes vermessenen jeweiligen Sensorelemente (SE) der jeweiligen Trägersubstrate (1360) des Trägersubstratsatzes sind vorzugsweise die gleichen jeweiligen Sensorelemente (SE) bei allen jeweiligen Trägersubstraten der Trägersubstrate (1360) des Trägersubstratsatzes.

Im Sinne des hier vorgelegten Dokuments kann ein Strukturelement auch aus mehreren der hier vorgestellten auf den jeweiligen Trägersubstraten (1360) nebeneinander liegenden Strukturelementen zusammengesetzt sein.

Natürlich kann auch aus den Breiten der jeweiligen Sensorelemente (SE) der jeweiligen Trägersubstrate (1360) des Trägersubstratsatzes und den mittleren Breiten der Strukturelemente der jeweiligen Trägersubstrate (1360) des Trägersubstratsatzes als Toleranzmaß ein Cₚₖ-Wert gebildet werden, der ebenfalls aufgrund der in diesem Dokument offenbarten Fertigungsverfahren über 1,66 liegen kann. Solche Trägersubstratsätze sind daher Teil der Offenlegung und potenziellen Beanspruchung des hier vorgelegten Dokuments.

### Allgemeine Sensorsysteme

Wie bereits angedeutet kann das System des Hochfrequenzspektrumanalysators auch als allgemeines Sensorsystem verwendet werden. Ein solches allgemeines Sensorsystem umfasst typischerweise eine Steuervorrichtung (CTR) zur Einstellung einer magnetischen Flussdichte (B_{Σ}, B_{ad}) als ersten Messparameter innerhalb eines ersten Messparameterintervalls und zur Einstellung einer Mikrowellenfrequenz (ω_{µW}) eines Mikrowellensignals (µW) als zweiten Messparameter innerhalb eines zweiten Messparameterintervalls. Das allgemeine Sensorsystem weist bevorzugt des Weiteren ein Sensorelement (SE, 5) mit einer Vielzahl von Kristallen und/oder Diamant-Nano-Kristallen (ND) auf, wobei die Vielzahl von Kristallen und/oder Diamant-Nano-Kristallen (ND) in einem Trägermaterial (TM) des Sensorelements(SE) eingebettet sind und typischerweise im Wesentlichen unterschiedlich orientiert sind. Die Vielzahl von Kristallen und/oder Diamant-Nano-Kristallen (ND) weist bevorzugt paramagnetische Zentren, insbesondere NV-Zentren in Diamant als Diamant-Nano-Kristalle (ND), auf. Vorzugsweise weist das Sensorsystem eine Pumpstrahlungsquelle in Form einer Lichtquelle (LED) auf, wobei die Pumpstrahlungsquelle vorzugsweise dazu eingerichtet ist, die paramagnetischen Zentren der Vielzahl der Kristalle und/oder der Diamant-Nano-Kristalle (ND) des Sensorelements (SE, 5) mit Pumpstrahlung (LB) einer Pumpstrahlungswellenlänge (λₚₘₚ) zu bestrahlen. Die paramagnetischen Zentren der Vielzahl der Kristalle und/oder Diamant-Nano-Kristalle (ND) des Sensorelements (SE, 5) emittieren bei der Bestrahlung mit der Pumpstrahlung (LB) der Pumpstrahlungswellenlänge (λₚₘₚ) eine Fluoreszenzstrahlung (FL) mit einer Fluoreszenzstrahlungswellenlänge (λ_{fl}). Vorzugsweise ist das Sensorsystem (SE) dazu eingerichtet, seine Vorrichtungsteile zur Vermessung eines eingestellten Messpunkt aus einem ersten Wert des ersten Messparameters und einem zweiten Wert des zweiten Messparameters zu parametrisieren. Das Sensorelement (SE) ist vorzugsweise dazu eingerichtet, der Ermittlung eines Sensorelementmesswerts für diesen eingestellten Messpunkts zu dienen, wobei der Sensorelementmesswert dem Fluoreszenzintensitätswert der Intensität Iᵢₛₜ(t) der Fluoreszenzstrahlung (FL) und/oder einer Abschwächung der der Intensität Iᵢₛₜ(t) der Fluoreszenzstrahlung (FL) entspricht und oder von diesen abhängt. Dabei hängt Sensorelementmesswert typischerweise vom ersten Messparameter und zweiten Messparameter ab. Typischerweise bildet der Sensorelementmesswert in einer X-Y-Ebene mit dem ersten Messwert als X-Koordinate und dem zweiten Messwert als Y-Koordinate eine V-Formation aus einer unteren Resonanzkante (522) und einer oberen Resonanzkante (525) aus. (Siehe Figur 2) Die V-Formation (522, 525) weist dabei eine Spitze (530) der V-Formation auf, die auch ggf. im nicht mehr messbaren Bereich liegen kann und daher ggf. nur indirekt erschlossen werden kann. Bevorzugt ist die Steuervorrichtung (CTR) dazu eingerichtet, ein computerimplementiertes Verfahren anzuwenden, um insbesondere den nächsten Messpunkt mit möglichst wenigen Iterationen zu bestimmen, wobei der nächste Messpunkt vorzugsweise einen nächsten ersten Messparameter und einen nächsten zweiten Messparameter umfasst.

In einer weiteren Ausprägung des Sensorsystems wendet die Steuervorrichtung (CTR) daher als computerimplementiertes Verfahren bevorzugt eines oder mehrere der folgenden computerimplementierten Verfahren an:
- ein computerimplementiertes Machine-Learning-Verfahren und/oder
- ein computerimplementiertes Verfahren zur Anwendung computerimplementierter Optimierungsalgorithmen und/oder
- ein computerimplementiertes Machine-Learning-Verfahren unter Anwendung eines Verfahrens der computerimplementierten Bayes'schen Optimierung und/oder
- ein computerimplementiertes Verfahren der computerimplementierten Random-Forest-Regression und/oder
- ein computerimplementiertes Verfahren der computerimplementierten Gaussian-Process-Regression und/oder
- ein computerimplementiertes Verfahren unter Verwendung eines computerimplementierten neuronalen Netzwerkmodells und/oder.
- ein computerimplementiertes Verfahren der computerimplementierten gradientenbasierten Optimierung und/oder
- ein computerimplementiertes Verfahren des computerimplementierten Gradientenabstiegs und/oder
- ein computerimplementiertes Verfahren des computerimplementierten stochastischen Gradientenabstiegs und/oder
- ein computerimplementiertes Verfahren des computerimplementierten Simulated-Annealings und/oder
- ein computerimplementiertes Verfahren der computerimplementierten Partikelschwarmoptimierung und/oder
- ein computerimplementiertes Verfahren unter Verwendung computerimplementierter genetischer Algorithmen und/oder
- ein computerimplementiertes Verfahren unter Verwendung eines computerimplementierten Verfahrens der Bayes'schen Optimierung und/oder
- ein computerimplementiertes Verfahren des computerimplementierten Nelder-Mead-Algorithmus.

Wie bereits angedeutet, kann das System des Hochfrequenzspektrumanalysators auch als allgemeines Sensorsystem in einer anderen Ausprägung verwendet werden. Ein solches allgemeines Sensorsystem umfasst beispielsweise eine Steuervorrichtung (CTR) zur Einstellung einer magnetischen Flussdichte (B_{Σ}, B_{ad}) als ersten Messparameter innerhalb eines ersten Messparameterintervalls und zur Einstellung einer Mikrowellenfrequenz (ω_{µW}) eines Mikrowellensignals (µW) als zweiten Messparameter innerhalb eines zweiten Messparameterintervalls. Das allgemeine Sensorsystem weist bevorzugt wieder ein Sensorelement (SE, 5) mit einer Vielzahl von Kristallen und/oder Diamant-Nano-Kristallen (ND) auf, wobei die Vielzahl von Kristallen und/oder Diamant-Nano-Kristallen (ND) vorzugsweise in einem Trägermaterial (TM) des Sensorelements (SE) eingebettet sind und wobei bevorzugt die Vielzahl von Kristallen und/oder Diamant-Nano-Kristallen (ND) im Wesentlichen unterschiedlich orientiert sind. Die Vielzahl von Kristallen und/oder Diamant-Nano-Kristallen (ND) weist bevorzugt paramagnetische Zentren, insbesondere NV-Zentren, auf. Bevorzugt weist das allgemeine Sensorsystem typischerweise eine Pumpstrahlungsquelle in Form einer Lichtquelle (LED) auf, wobei die Pumpstrahlungsquelle vorzugsweise dazu eingerichtet ist, die paramagnetischen Zentren der Vielzahl der Kristalle und/oder Diamant-Nano-Kristalle (ND) des Sensorelements (SE, 5) mit Pumpstrahlung (LB) der Pumpstrahlungswellenlänge (λₚₘₚ) zu bestrahlen, und wobei die paramagnetischen Zentren der Vielzahl der Kristalle und/oder Diamant-Nano-Kristalle (ND) des Sensorelements (SE, 5) bei der Bestrahlung mit der Pumpstrahlung (LB) der Pumpstrahlungswellenlänge (λₚₘₚ) eine Fluoreszenzstrahlung (FL) mit einer Fluoreszenzstrahlungswellenlänge (λ_{fl}) emittieren. Vorzugsweise ist dabei das allgemeine Sensorsystem dazu eingerichtet, seine Vorrichtungsteile zur Vermessung eines eingestellten Messpunkt aus einem ersten Wert des ersten Messparameters und einem zweiten Wert des zweiten Messparameters zu parametrisieren. Typischerweise ist die Steuervorrichtung (CTR) in der Lage, einen ersten Messparameter innerhalb eines ersten Messparameterintervalls einzustellen und einen zweiten Messparameter innerhalb eines zweiten Messparameterintervalls einzustellen. Das Sensorelement (SE) ist dann bevorzugt dazu eingerichtet, der Ermittlung eines Sensorelementmesswerts für diesen eingestellten Messpunkt zu dienen. Vorzugsweise entspricht dabei der Sensorelementmesswert dem Fluoreszenzintensitätswert der Intensität Iᵢₛₜ(t) der Fluoreszenzstrahlung (FL) und/oder einer Abschwächung der der Intensität Iᵢₛₜ(t) der Fluoreszenzstrahlung (FL) und/oder hängt von diesen ab. Typischerweise hängt der Sensorelementmesswert dabei zumindest vom ersten Messparameter und zweiten Messparameter ab. Der erste Messparameter können dabei beispielsweise die magnetische Gesamtflussdichte (B_{Σ}) oder die zusätzliche magnetische Flussdichte (B_{ad}), die zur magnetischen Gesamtflussdichte (B_{Σ}) beiträgt, sein. Bei einer Vermessung in dieser Weise mit unterschiedlichen Messpunkten aus einem ersten Messparameterwert des ersten Messparameters und einem zweiten Messparameterwerts des weiten Messparameters bilden die über die X-Y-Fläche dieser beiden Messparameter erfassten Sensorelementmesswerte in dieser X-Y-Ebene mit dem ersten Messwert als X-Koordinate und dem zweiten Messwert als Y-Koordinate eine V-Formation aus. Einer untere Resonanzkante (522) und eine obere Resonanzkante (525) bilden dabei diese V-Formation. (Siehe Figur 51b). Eine wesentliche Idee des hier vorgelegten Dokuments ist es, durch Mustererkennung die Lage dieser V-Formation zu erkennen und daraus Messwerte abzuleiten, da Größe, Ausrichtung und Struktur im Wesentlichen auf atomarer Ebene bereits festgelegt sind und nur die Position der Spitze (530) dieser V-Formation von der Mikrowellenfrequenz (ω_{µW}) und der magnetischen Gesamtflussdichte (B_{Σ}) oder der zusätzlichen magnetischen Flussdichte (B_{ad}), die zur magnetischen Gesamtflussdichte (B_{Σ}) beiträgt, abhängt. Diese die V-Formation weist somit die besagte Spitze (530) der V-Formation auf, die auch außerhalb des messbaren Bereichs liegen kann und deren Position besonders charakteristisch für die Position der V-Formation ist. Typischerweise liefert das Sensorelement (SE) in Abhängigkeit von dem eingestellten ersten Messparameter und dem eingestellten zweiten Messparameter den Sensorelementmesswert. Die Steuervorrichtung (CTR) ist typischerweise dazu eingerichtet, ein computerimplementiertes Verfahren der zur Bestimmung des nächsten Messpunkts, der den nächsten ersten Messparameter und dem nächsten zweiten Messparameter umfasst, anzuwenden. Hierzu umfasst das Sensorsystem vorzugsweise ein System zur Bestimmung der Lage einer V-Formation in der X-Y-Ebene, wobei die Lage durch die X-Koordinate des ersten Messparameters und die Y-Koordinate des zweiten Messparameters definiert ist. Auch kann das Sensorsystem ein System zur Bestimmung der Position (530) der Spitze der V-Formation in der X-Y-Ebene umfassen, wobei auch diese Position durch die zugehörige X-Koordinate des ersten Messparameters und die zugehörige Y-Koordinate des zweiten Messparameters definiert ist. Vorzugsweise umfasst das Sensorsystem eine Speichervorrichtung (RAM, NVM) zur Bereithaltung der so bestimmten Lage der V-Formation in der X-Y-Ebene und/oder zur Bereithaltung der bestimmten Position (530) der Spitze der V-Formation und/oder einer funktionsäquivalenten Information für die Verwendung durch ein übergeordnetes System. Hierzu umfasst bevorzugt das Sensorsystem eine Benutzerschnittstelle zur Einstellung von Parametern, wie beispielsweise der Messparameterintervalle und/oder zum Abrufen der Ergebnisse der Position (530) der Spitze der V-Formation in der X-Y-Ebene aus dem ersten Messparameter als X-Koordinate und dem zweiten Messparameter als Y-Koordinate. Diese Benutzerschnittstelle kann vorschlagsgemäß auch durch eine Vorrichtung, beispielsweise ein übergeordnetes Rechnersystem angesprochen, bedient und abgefragt werden. Es kann sich bei der Benutzerschnittstelle also auch um eine Maschine-Maschine-Schnittstelle handeln. Die Benutzerschnittstelle kann eine Web-Seite sein, die die Steuervorrichtung (CTR) erzeugt.

Wie bereits angedeutet kann, das System des Hochfrequenzspektrumanalysators auch als allgemeines Sensorsystem in einer anderen dritten Ausprägung verwendet werden. Ein solches allgemeines Sensorsystem umfasst beispielsweise bevorzugt eine Steuervorrichtung (CTR), wobei das allgemeine Sensorsystem vorzugsweise eine Steuervorrichtung (CTR) zur Einstellung einer magnetischen Flussdichte (B_{Σ}, B_{ad}) als ersten Messparameter innerhalb eines ersten Messparameterintervalls und zur Einstellung einer Mikrowellenfrequenz (ω_{µW}) eines Mikrowellensignals (µW) als zweiten Messparameter innerhalb eines zweiten Messparameterintervalls aufweist. Auch hier weist das allgemeine Sensorsystem bevorzugt wieder ein Sensorelement (SE, 5) mit einer Vielzahl von Kristallen und/oder Diamant-Nano-Kristallen (ND) auf, die typischerweise in einem Trägermaterial (TM) des Sensorelements(SE) eingebettet sind. Die Vielzahl von Kristallen und/oder Diamant-Nano-Kristallen (ND) sind bevorzugt im Wesentlichen unterschiedlich orientiert. Kristalle und/oder Diamant-Nano-Kristalle (ND) der Kristalle und/oder Diamant-Nano-Kristalle (ND) weisen vorzugsweise paramagnetische Zentren, insbesondere NV-Zentren in Diamant, auf. Das allgemeine Sensorsystem umfasst bevorzugt wieder eine Pumpstrahlungsquelle in Form einer Lichtquelle (LED), die die paramagnetischen Zentren der Vielzahl der Kristalle und/oder Diamant-Nano-Kristalle (ND) des Sensorelements (SE, 5) mit Pumpstrahlung (LB) einer Pumpstrahlungswellenlänge (λₚₘₚ) bestrahlen kann. Wie zuvor emittieren die paramagnetischen Zentren der Vielzahl der Kristalle und/oder Diamant-Nano-Kristalle (ND) des Sensorelements (SE, 5) bei der Bestrahlung mit der Pumpstrahlung (LB) einer Pumpstrahlungswellenlänge (λₚₘₚ) wieder typischerweise eine Fluoreszenzstrahlung (FL) mit einer Fluoreszenzstrahlungswellenlänge (λ_{fl}). Vorzugsweise ist das allgemeine Sensorsystem dazu eingerichtet, seine Vorrichtungsteile zur Vermessung eines eingestellten Messpunkts aus einem ersten Wert des ersten Messparameters und einem zweiten Wert des zweiten Messparameters beispielsweise mittels seiner Steuervorrichtung (CTR) zu parametrisieren. Daher ist vorzugsweise die Steuervorrichtung (CTR) vorzugsweise in der Lage, einen ersten Messparameter innerhalb eines ersten Messparameterintervalls einzustellen und einen zweiten Messparameter innerhalb eines zweiten Messparameterintervalls einzustellen. Das Sensorelement (SE) ist typischerweise dazu eingerichtet, der Ermittlung eines Sensorelementmesswerts für diesen eingestellten Messpunkt zu dienen. Dabei entspricht typischerweise der Sensorelementmesswert dem Fluoreszenzintensitätswert der Intensität Iᵢₛₜ(t) der Fluoreszenzstrahlung (FL) und/oder einer Abschwächung der der Intensität Iᵢₛₜ(t) der Fluoreszenzstrahlung (FL) und/oder hängt von diesem ab. Dieser Sensorelementmesswert hängt typischerweise vom ersten Messparameter und zweiten Messparameter ab. Typischerweise bildet der Sensorelementmesswert in einer X-Y-Ebene mit dem ersten Messwert als X-Koordinate und dem zweiten Messwert als Y-Koordinate eine V-Formation aus einer unteren Resonanzkante (522) und einer oberen Resonanzkante (525) aus. Dabei weist im Allgemeinen die V-Formation eine Spitze (530) der V-Formation auf, die auch außerhalb des Messbereiches liegen kann. Darüber hinaus weist das allgemeine Sensorsystem dieser Ausprägung bevorzugt das Sensorelement (SE) zur Ermittlung eines Sensorelementmesswerts für einen eingestellten Messpunkt basierend auf dem ersten Messparameter und dem zweiten Messparameter auf. Vorzugsweise verwendet das allgemeine Sensorsystem ein virtuelles, speicherbasiertes, dreidimensionales kartesisches Koordinatensystem zur Eintragung der Messwerte des Sensorelements (SE) in eine Datenbank im Speicher (RAM, NVM) des Sensorsystems, wobei vorzugsweise die x-Koordinate auf der x-Achse durch den ersten Messparameter und die y-Koordinate auf der y-Achse durch den zweiten Messparameter bestimmt werden und die z-Koordinate auf der z-Achse durch den Messwert des Sensorelements (SE) bestimmt wird. Des Weiteren umfasst das Sensorsystem in dieser Ausprägung vorzugsweise eine Positionserkennungseinheit, der bekannt ist und die die Information verwendet, dass die Maxima des Betrags des Gradienten des Messwerts des Sensorelements nach der x-Koordinate und der y-Koordinate eine V-Form auf der X-Y-Ebene ergeben, wobei es typischerweise die Aufgabe des Sensorsystems ist, die Position der unteren Spitze (530) dieser V-Formation (522, 525) zu bestimmen und auszugeben.

**In** einer weiteren Ausprägung der vorangehenden drei Ausprägungen des Sensorsystems ist die Steuervorrichtung (CTR) vorzugsweise dazu eingerichtet, den nächsten Messpunkt für die nächste Messung eines Sensorelementmesswerts in Abhängigkeit von einem oder mehreren bereits vorhandenen Messwertdatensätzen zu bestimmen, wobei ein solcher Messwertdatensatz typischerweise einem Messpunkt und einen Sensorelementmesswert umfasst. Dies ermöglicht eine schnelle Konvergenz der Messwerte, um die echte Position der V-Formation und zwar insbesondere die Position der Spitze (530) der V-Formation aus unterer Resonanzkante (522) und oberer Resonanzkante (525) zu identifizieren und daraus ggf. weitere Messwerte für die magnetische Flussdichte B und/oder die Mikrowellenfrequenz abzuleiten.

**In** einer weiteren Ausprägung der vier vorangehenden Ausprägungen des Sensorsystems ist die Steuervorrichtung (CTR) vorzugsweise dazu eingerichtet, das computerimplementierte Verfahren zur Bestimmung des nächsten Messpunkts aus einem nächsten ersten Messparameter und einem nächsten zweiten Messparameter anzuwenden, um die Lage der V-Formation in der X-Y-Ebene zu bestimmen und die Position (30) der Spitze der V-Formation in der X-Y-Ebene oder eine funktionsäquivalente Information zu berechnen und für die Verwendung durch ein übergeordnetes System bereitzuhalten.

**In** einer weiteren Ausprägung der fünf vorangehenden Ausprägungen des Sensorsystems ist die Steuervorrichtung (CTR) vorzugsweise dazu eingerichtet, das computerimplementierte Verfahren zu verwenden, um die Lage der V-Formation in der X-Y-Ebene aus erstem Messparameter als X-Koordinate und zweitem Messparameter als Y-Koordinate oder eine funktionsäquivalente Positionsangabe der V-Formation und/oder eine funktionsäquivalente Positionsangabe eines Merkmals der V-Formation mittels Iteration zu bestimmen.

**In** einer weiteren Ausprägung der sechs vorangehenden Ausprägungen des Sensorsystems ist die Steuervorrichtung (CTR) vorzugsweise dazu eingerichtet, das computerimplementierte Verfahren so auszuführen, dass die Steuervorrichtung (CTR) mittels des computerimplementierten Verfahrens diese die Positionsangabe der V-Formation und/oder eine funktionsäquivalente Positionsangabe eines Merkmals der V-Formation mit möglichst wenigen Iterationen zu bestimmen.

**In** einer weiteren Ausprägung der sieben vorangehenden Ausprägungen des Sensorsystems ist die Steuervorrichtung (CTR) vorzugsweise dazu eingerichtet, das computerimplementierte Verfahren für die Bestimmung der die Position der Spitze (30) der V-Formation in der X-Y-Ebene aus erstem Messparameter als X-Koordinate und zweitem Messparameter als Y-Koordinate oder einer funktionsäquivalenten Information zu verwenden.

**In** einer weiteren Ausprägung der acht vorangehenden Ausprägungen des Sensorsystems ist die Steuervorrichtung (CTR) vorzugsweise dazu eingerichtet, die so bestimmte Positionsangabe der V-Formation und/oder eine funktionsäquivalente Positionsangabe eines Merkmals der V-Formation und/oder der Position der Spitze (30) der V-Formation für die Verwendung durch ein übergeordnetes System (z.B. 28) bereit zu halten.

**In** einer weiteren Ausprägung der neun vorangehenden Ausprägungen des Sensorsystems ist die Steuervorrichtung (CTR) vorzugsweise dazu eingerichtet, das computerimplementierte Verfahren in Kombination mit dem Sensorelement (SE) einzusetzen, um die Position (30) der Spitze der V-Formation und/oder eine funktionsäquivalente Information basierend auf den ersten Messparametern und den zweiten Messparametern zu bestimmen.

**In** einer weiteren Ausprägung der zehn vorangehenden Ausprägungen des Sensorsystems ist die Steuervorrichtung (CTR) vorzugsweise dazu eingerichtet, die Position (30) der Spitze der V-Formation und/oder die funktionsäquivalente Information für die Verwendung durch ein übergeordnetes System (z.B. 28) bereitzuhalten. Dies ermöglicht beispielsweise eine Sensor-Fusion dieser Informationen mit Daten anderer Sensoren beispielsweise in einem übergeordneten System und das Erkennen fehlerhafter Werte durch das übergeordnete System.

In einer weiteren Ausprägung des Sensorsystems sind der Programmcode und/oder die Programmdaten der computerimplementierten Verfahrens auf einem speicherbasierten Medium (RAM, NVM) gespeichert. Insbesondere ist es denkbar, dieses Speichermedium (RAM, NVM) austauschen zu können, um so das Sensorsystem schnell an neue Gegebenheiten anpassen zu können.

Vorzugsweise sind die Steuervorrichtung (CTR) und das speicherbasierten Medium (RAM, NVM) dazu eingerichtet, diesen Programmcode des computerimplementierten Verfahrens mittels eines Prozessors der Steuervorrichtung (CTR) auszuführen. Dabei kann das speicherbasierte Medium (RAM, NVM) ein Computerprogrammprodukt, eine Festplatte, einen Flash-Speicher oder ein anderes nichtflüchtiges Speichermedium (NVM) umfassen.

Wie bereits angedeutet kann das System des Hochfrequenzspektrumanalysators auch als allgemeines Sensorsystem in einer anderen zwölften Ausprägung verwendet werden. Dabei umfasst das Sensorsystem ein Speichermedium (RAM, NVM), das die aktuellen Werte des ersten Messparameters, des zweiten Messparameters und des Sensorelementmesswerts speichert, um eines der computerimplementierten Verfahren, insbesondere iterativ, durchzuführen. **In** dieser Ausprägung kann die Steuervorrichtung (CTR) insbesondere dazu eingerichtet sein, im Falle eines iterativen Vorgehens eine Konvergenzkriteriumsprüfung durchzuführen, um festzustellen, ob die Berechnung der Position der unteren Spitze (30) der V-Formation in der X-Y-Ebene und/oder die Berechnung einer funktionsäquivalenten Information konvergiert ist, und die Iterationen computerimplementierten Verfahrens entsprechend zu beenden.

Wie bereits angedeutet kann das System des Hochfrequenzspektrumanalysators auch als allgemeines Sensorsystem in einer anderen dreizehnten Ausprägung verwendet werden. Dabei umfasst die Steuervorrichtung (CTR) vorzugsweise eine Fehlerkorrektur- und Ausgleichseinheit, die dazu eingerichtet ist, Fehler in den Messungen des Sensorelements (SE) zu erkennen und zu korrigieren, um eine präzisere Bestimmung der Position der unteren Spitze (30) der V-Formation und/oder einer funktionsäquivalenten Information zu gewährleisten.

Wie bereits angedeutet kann das System des Hochfrequenzspektrumanalysators auch als allgemeines Sensorsystem in einer anderen zwölften Ausprägung verwendet werden. Dabei ist die Steuervorrichtung (CTR) vorzugsweise dazu eingerichtet, eines der computerimplementierten Verfahren anzuwenden, indem sie eine Menge von Messpunkten in der X-Y-Ebene generiert, die eine initiale Schätzung der Position (30) der Spitze der V-Formation und/oder einer funktionsäquivalenten Information darstellen, und anschließend die Messpunkte basierend auf dem Sensorelementmesswert zu bewerten und die besten Messpunkte für die nächste Iteration auszuwählen.

Wie bereits angedeutet kann das System des Hochfrequenzspektrumanalysator auch als allgemeines Sensorsystem in einer anderen dreizehnten Ausprägung verwendet werden. Dabei umfasst das Sensorsystem die Steuervorrichtung (CTR) mit einen Prozessor und einen Speicher (RAM, NVM), wobei der Speicher (RAM, NVM) den Programmcode für das computerimplementierte Verfahren enthält. Die Steuervorrichtung (CTR) ist in dieser Ausprägung vorzugsweise dazu eingerichtet ist, mittels ihres Prozessors den Programmcode aus dem Speicher (RAM, NVM) abzurufen und auszuführen. Bevorzugt ist der Speicher (RAM, NVM) dazu eingerichtet, weitere Informationen über die V-Formation, wie beispielsweise die Größe oder Form, zu speichern, um eine umfassende Charakterisierung der V-Formation zu ermöglichen.

Schließlich beschreibt das hier vorgelegte Dokument ein Verfahren zur Herstellung eines monolithisch integrierten Sensorsystems. Das vorgeschlagene Verfahren umfasst die Schritte:
1. Bereitstellen eines Halbleitersubstrats (1360), wobei das Halbleitersubstrat (1360) eine oder mehrere mikroelektronischen Schaltungen und einen Metallisierungsstapel mit elektrischen Leitungen, ggf. notwendigen Durchkontaktierungen, Kontakten, Pads und Isolationsschichten etc. an einer seiner Oberflächen aufweist. Besonders wichtig ist in diesem Fall, dass das Halbleitersubstrat (1360) eine Wellenleitung (1380, 1880, 2380, 6830, 6980) an dieser Oberfläche aufweist.
2. Ein weiterer Schritt ist das ganzflächige oder teilweise Beschichten dieser Oberfläche des Halbleitersubstrats (1360) im Bereich der Wellenleitung (1380, 1880, 2380, 6830, 6980) mit einem kolloidalen Lack (KL) der kolloidalen Mischung zur Bildung einer lokalen kolloidalen Lackschicht, wobei der kolloidale Lack (KL) ein Trägermaterial (TM) und Kristalle und/oder Diamant-Nano-Kristalle (ND) aufweist, die alle oder in Teilen paramagnetische Zentren, insbesondere NV-Zentren in Diamant, umfassen, die wiederum bei Bestrahlung mit einer Pumpstrahlung (LB) mit einer Pumpstrahlungswellenlänge (λₚₘₚ) Fluoreszenzstrahlung (FL) mit einer Fluoreszenzstrahlungswellenlänge (λ_{fl}) emittieren.
3. Es folgt dann die Strukturierung der lokalen kolloidalen Lackschicht. Diese Strukturierung kann grundsätzlich auf zwei Arten als Positiv-Prozess oder Negativ-Prozess erfolgen. Ein weiterer Schritt betrifft das Durchführen zumindest eines dieser beiden folgenden Strukturierungsprozesse:
   3.1. Negativ Verfahren mit den Schritten:
      3.1.1. Lokal begrenztes Bestrahlen der lokalen kolloidalen Lackschicht des kolloidalen Lacks (KL) mit einer elektromagnetischen Aushärtestrahlung (4910) einer Aushärtewellenlänge (λ_{H}), sodass die das Trägermaterial (TM) der lokalen kolloidalen Lackschicht des einem kolloidalen Lacks (KL) aushärtet. Dabei ist das ausgehärtete Trägermaterial (TM) vorzugsweise für elektromagnetische Strahlung der Pumpstrahlungswellenlänge (λₚₘₚ) im Wesentlichen transparent und für elektromagnetische Strahlung der Fluoreszenzstrahlungswellenlänge (λ_{fl}) im Wesentlichen transparent.
      3.1.2. Entfernen der Bereiche der lokalen kolloidalen Lackschicht des einem kolloidalen Lacks (KL), deren Trägermaterial (TM) nicht ausgehärteten ist, um ein oder mehrere Sensorelemente (SE) auszuformen.
   3.2. Positiv Verfahren
      3.2.1. Vorhärten der lokalen kolloidalen Lackschicht;
      3.2.2. Lokal begrenztes Bestrahlen der vorgehärteten lokalen kolloidalen Lackschicht des einem kolloidalen Lacks (KL) mit einer elektromagnetischen Belichtungsstrahlung (4910) einer Belichtungswellenlänge (λ_{B}), sodass die das Trägermaterial (TM) der lokalen kolloidalen Lackschicht des einem kolloidalen Lacks (KL) angreifbar wird,
      3.2.3. Entfernen der Bereiche der belichteten und damit angreifbar gewordenen lokalen kolloidalen Lackschicht des einem kolloidalen Lacks (KL) beispielsweise mittels eines Lösungsmittels oder eines Entwicklers,
      3.2.4. Aushärten der nicht entfernten Bereiche der nicht belichteten lokalen kolloidalen Lackschicht des einem kolloidalen Lacks (KL), um ein oder mehrere Sensorelemente (SE) auszuformen, wobei das dann ausgehärtete Trägermaterial (TM) für elektromagnetische Strahlung der Pumpstrahlungswellenlänge (λₚₘₚ) im Wesentlichen transparent ist und wobei das dann ausgehärtete Trägermaterial (TM) für elektromagnetische Strahlung der Fluoreszenzstrahlungswellenlänge (λ_{fl}) im Wesentlichen transparent ist.

Bevorzugt umfassen die mikroelektronischen Schaltungen auf dem Halbleitersubstrat (1360) eine oder mehrere Vorrichtungselemente des Sensorsystems und/oder eines oder mehrere Sensorkanäle und/oder eine Steuervorrichtung (CTR) und/oder ein oder mehrere Speicher (RAM; NVM), und/oder ein oder mehrere Magnetfelderzeugungsmittel (L_{c}) und/oder in oder mehrere Signalquellen (µWG, G1, G2, LDRV,) und/oder ein oder mehrere Mustererkennungsvorrichtungen (MEV) und/oder ein oder mehrere mikrooptische Vorrichtungsteile (LWL1, LWL2) und/oder ein oder mehrere mikrofluidische und/oder ein oder mehrere mikromechanische Funktionselemente.

Hier ist eine unvollständige Liste beispielhafter einfacher Schaltungsblöcke, die typischerweise in solchen Mixed-Signal-Schaltungen der CMOS-Technik zu finden sind und deren Integration in das Halbleitersubstrat (1360) denkbar ist:
Verstärker: Verstärker werden verwendet, um elektrische Signale zu verstärken und/oder zu filtern und/oder zu mischen und/oder zu addieren etc., entweder in analoger oder digitaler Form. Beispiele sind Operationsverstärker (Op-Amps) und differenzielle Verstärker.

Komparatoren: Komparatoren vergleichen zwei Eingangssignale und erzeugen ein Ausgangssignal, das angibt, ob das eine Signal größer oder kleiner als das andere ist. Sie werden häufig in Schwellwertdetektoren und Analog-Digital-Wandlern verwendet.

Filter: Filter ermöglichen es, bestimmte Frequenzen eines Signals zu verstärken oder zu unterdrücken oder bestimmte Signalverlaufsstrukturen zu erkennen. Beispiele sind Tiefpassfilter, Hochpassfilter, Bandpassfilter und Notchfilter, Kalman-Filter, Optimalfilter, Matched Filter etc.

Analog-Digital-Wandler (ADC): ADCs wandeln analoge Signale in digitale Werte um. Sie sind wesentlich für die digitale Verarbeitung analoger Signale und werden in vielen Anwendungen eingesetzt, z.B. in der Tonaufnahme, Sensortechnik und Kommunikation.

Digital-Analog-Wandler (DAC): DACs wandeln digitale Werte in analoge Signale um. Sie werden verwendet, um digitale Informationen in eine kontinuierliche analoge Form zu übertragen, z.B. in Audioverstärkern und Kommunikationssystemen.

Oszillatoren: Oszillatoren erzeugen periodische Signale, die in vielen Anwendungen wie Taktgeber, Zeitgeber und Taktsynchronisation benötigt werden.

Multiplexer: Multiplexer ermöglichen die Auswahl und Weiterleitung eines bestimmten Eingangssignals aus einer Gruppe von Signalen zu einem Ausgang. Sie werden oft verwendet, um zwischen verschiedenen Datenquellen oder Adressen umzuschalten. Es kann sich auch um Digital-Multiplexer und/oder AnalogMultiplexer handeln.

Schieberegister: Schieberegister sind sequenzielle Schaltungen, die in der Lage sind, eine Reihe von Datenbits zu speichern und diese seriell oder parallel zu verschieben. Sie werden in vielen Anwendungen wie Speichererweiterungen, Datenverschiebung und Signalverarbeitung verwendet.

Phasendetektoren: Phasendetektoren werden verwendet, um die Phasendifferenz zwischen zwei Signalen zu messen. Sie sind wichtig in Phasenregelschleifen (PLL) und Frequenzsynthesizern.

Spannungsreferenzen: Spannungsreferenzen erzeugen präzise und stabile Referenzspannungen, die in vielen Schaltungen als Bezugsspannungen dienen, beispielsweise in ADCs, DACs und Regelkreisen.

Phasenregelschleifen (PLL): PLLs werden verwendet, um eine präzise Phasen- und Frequenzsynchronisation zwischen verschiedenen Signalen zu erreichen. Sie finden Anwendung in Kommunikationssystemen, Taktgeneratoren und Frequenzsynthesizern.

Taktgeneratoren: Taktgeneratoren erzeugen präzise und stabile Taktimpulse, die zur Synchronisierung von Schaltungen und zum Zeitmultiplexing verwendet werden. Sie spielen eine entscheidende Rolle in digitalen Schaltungen und Kommunikationssystemen.

Schaltregler: Schaltregler sind elektronische Schaltungen, die die Spannung oder den Strom effizient umwandeln oder regeln können. Sie werden in Stromversorgungen, Batterieladegeräten und energieeffizienten Systemen eingesetzt.

Komparator-basierte Analog-Digital-Wandler (Flash ADC): Flash-ADCs sind schnelle Analog-Digital-Wandler, die das Prinzip der Komparator-Schaltung nutzen, um das Eingangssignal zu quantisieren. Sie sind in Anwendungen mit hohen Abtastraten und schnellen Signalen weit verbreitet.

Stromquellen und Spiegelschaltungen: Stromquellen und Spiegelschaltungen werden verwendet, um stabile Stromreferenzen zu erzeugen und zu spiegeln. Sie sind wichtig in analogen Schaltungen wie Verstärkern und Differenzverstärkern.

Operationsverstärker-Schaltungen: Operationsverstärker (Op-Amps) werden in vielen analogen Schaltungen eingesetzt, um Verstärkung, Filterung, Verstärkung und andere Funktionen auszuführen. Sie sind ein grundlegender Baustein in der analogen Signalverarbeitung.

Schwellwertdetektoren: Schwellwertdetektoren vergleichen ein Eingangssignal mit einem festgelegten Schwellenwert und geben ein digitales Signal basierend auf diesem Vergleich aus. Sie finden Anwendung in der Datenerkennung, Signalverarbeitung und Kommunikation.

Integratoren und Differentiatoren: Integratoren und Differentiatoren sind Schaltungen, die Integration und Differentiation von analogen Signalen ermöglichen. Sie werden in vielen Anwendungen wie Filterdesign, Audioverarbeitung und Regelungstechnik eingesetzt.

Spannungsfolger: Spannungsfolger (Buffer) sind Verstärkerschaltungen mit einer Verstärkung von etwa 1, die dazu dienen, das Ausgangssignal zu isolieren und den Strombedarf anderer Schaltungen zu senken.

Analogschalter: Analogschalter ermöglichen es, analoge Signale zu steuern und zwischen verschiedenen Schaltungspfaden umzuschalten. Sie finden Anwendung in analogen Multiplexern, Pufferverstärker: Pufferverstärker dienen dazu, die Impedanz zwischen verschiedenen Schaltungsbereichen anzupassen und Signalverluste zu minimieren. Sie werden oft verwendet, um Signalquellen mit unterschiedlichen Impedanzen zu verbinden.

Schaltregelkreise (Regler): Schaltregelkreise sind Rückkopplungsschaltungen, die dazu dienen, eine stabile Ausgangsspannung oder einen stabilen Ausgangsstrom aufrechtzuerhalten. Sie werden in Stromversorgungen und Regelkreisen eingesetzt.

Schmitt-Trigger: Schmitt-Trigger sind Komparatorschaltungen mit Hysterese, die dazu dienen, ein stabiles digitales Ausgangssignal zu erzeugen, das auf Änderungen des Eingangssignals empfindlich reagiert. Sie finden Anwendung in Schwellwertdetektoren, Schaltungen mit Rauschen und Signalverarbeitungsschaltungen. Taktsynchronisationsschaltungen: Taktsynchronisationsschaltungen werden verwendet, um verschiedene Taktquellen miteinander zu synchronisieren oder um Taktphasenverschiebungen zu erzeugen. Sie sind wichtig in Kommunikationssystemen und synchronen digitalen Schaltungen.

Taktverteiler: Taktverteiler ermöglichen die Verteilung eines Taktimpulses auf mehrere Schaltungsteile. Sie werden verwendet, um mehrere synchronisierte Schaltungen zu steuern und zu synchronisieren. Digitallogikschaltungen: Digitale Logikschaltungen wie AND-Gatter, OR-Gatter, NAND-Gatter und NOR-Gatter werden verwendet, um logische Operationen auf digitalen Signalen auszuführen. Sie sind grundlegende Bausteine in digitalen Schaltungen und Prozessoren.

Schwellwertwandlerschaltungen: Schwellwertwandler dienen dazu, analoge Signale in digitale Signale umzuwandeln, indem sie die Signalamplitude mit einem festgelegten Schwellenwert vergleichen. Sie werden in der Signalverarbeitung und Kommunikationstechnik verwendet.

Bandlückenreferenzen: Bandlückenreferenzen sind präzise Spannungsreferenzen, die unempfindlich gegenüber Versorgungsspannungsschwankungen sind. Sie werden verwendet, um stabile Referenzspannungen in analogen Schaltungen bereitzustellen.

Schaltungen zur Leistungsverstärkung: Leistungsverstärkerschaltungen werden verwendet, um hohe Leistungen in einer Schaltung zu liefern, z. B. für Audioverstärker, Verstärker in drahtlosen Kommunikationssystemen und Leistungsumrichter.

Reset-Schaltungen: Diese setzen die mikrointegrierte Schaltung bei einem Neustart oder einem verlust der Betriebsspannung und ähnlichen Störungen zurück.

Phasenschieber: Phasenschieber sind Schaltungen, die die Phasenlage eines Signals ändern können. Sie finden Anwendung in Phasenregelschleifen, Kommunikationssystemen und Oszillatoren.

Test-Controller (JATG): Test-Controller (JATG) sind für den Fertigungstest der mikroelektronischen Schaltungen auf dem Halbleitersubstrat (1360) wichtig. Vorzugsweise handelt es sich um einen JATG -Test-Controller (JATG). Dieser ist in dem Dokument **IEEE** Standard for Test Access Port and Boundary-Scan Architecture, **IEEE** Std 1149.1-2013 (Revision of **IEEE** Std 1149.1-2001) beschrieben.

Außerdem weist das hier vorgelegte Dokument auf die Standards
- **IEEE** Standard for Reduced-Pin and Enhanced-Functionality Test Access Port and Boundary-Scan Architecture **IEEE** Std 1149.7-2009
- **IEEE** Supplement to Standard Test Access Port and Boundary-Scan Architecture (1149.1) **IEEE** Std 1149.1b-1994
- **IEEE** Standard for Reduced-Pin and Enhanced-Functionality Test Access Port and Boundary-Scan Architecture, **IEEE** Std 1149.7-2022 (Revision of **IEEE** Std 1149.7-2009)
- **IEEE** Standard for Access and Control of Instrumentation Embedded within a Semiconductor Device, **IEEE** Std 1687-2014
zur Information hin. Der Zugriff auf den Test-Controller (JATG) erfolgt bevorzugt über den JATG -Test-Bus (TB). Auf die Erläuterung der Funktionalität einer JATG-Testschnittstelle aus dem Stand der Technik wird hier verzichtet. Das hier vorgelegte Dokument verweist hier beispielhaft auf die Texte:
https://de.wikipedia.org/wiki/Joint_Test_Action_Group
https://www.corelis.com/education/tutorials/boundary-scan/

Es ist ein weiterer Gedanke des hier vorgelegten Dokuments, dass die vorgeschlagene mikroelektronische Schaltung eine Test-Schnittstelle, bevorzugt eine JATG -Test-Schnittstelle nach einer der **IEEE** JATG -Test-Normen, aufweist und einen Testcontroller, vorzugsweise einen **IEEE** 1149 JATG-Test-Controller (JATG), umfasst, der zumindest eine der folgenden Funktionselemente des Sensorsystems über ein Datenregister (DR) und/oder ein Instruktionsregister (IR) des JATG-Test-Controllers (JATG) steuern oder auslesen kann:
- Eine Lichtquelle (LED) zur Bestrahlung eines oder mehrerer paramagnetischer Zentren mit Pumpstrahlung (LB) einer Pumpstrahlungswellenlänge (λₚₘₚ) und/oder
- ein oder mehrere paramagnetisches Zentren, insbesondere ein oder mehrere NV-Zentren, durch Bestrahlung mit Pumpstrahlung (LB) einer Pumpstrahlungswellenlänge (λₚₘₚ) einer Lichtquelle (LED), die von einem Datenregister (DR) und/oder Instruktionsregister (IR) des Test-Controllers (JTAG), insbesondere des **IEEE** 1149 JATG-Test-Controller (JTAG), gesteuert werden kann, und/oder
- ein oder mehrere paramagnetische Zentren, insbesondere ein oder mehrere NV-Zentren, durch Erfassen der Fluoreszenzstrahlung (FL) dieses einen paramagnetischen Zentrums oder dieser mehreren paramagnetischen Zentren, insbesondere dieses einen NV-Zentrums oder dieser mehreren NV-Zentren, mittels eines oder mehrerer Fotodetektoren (PD), deren Empfängerausgangssignale (S0) von einem oder mehreren Schaltungsteilen der mikroelektronischen Schaltung gewandelt werden, sodass der Test-Controller(JTAG), insbesondere der **IEEE** 1149 JATG-Test-Controller (JTAG), einen oder mehrere Werte insbesondere mittels eines Datenregisters (DR) des JATG-Test-Controllers (JATG) erfassen können, die von der Fluoreszenzstrahlung (FL) des einen oder der mehreren paramagnetischen Zentren, insbesondere des einen oder der mehreren NV-Zentren abhängen und/oder
- eine Datenschnittstelle, über die der Test-Controller (JTAG), insbesondere der **IEEE** 1149 JATG-Test-Controller (JTAG), einen oder mehrere erfasste Werte ausgeben können, die von der Fluoreszenzstrahlung (FL) eines oder der mehrerer paramagnetischen Zentren, insbesondere des einen oder der mehreren NV-Zentren abhängen.

Hierdurch kann ein Fertigungstest bei einer Mikrointegration des Sensorsystems auf Basis paramagnetischer Zentren und/oder NV-Zentren vorgenommen werden. Die Mikrointegration kann dabei monolithisch oder als Mikrosystem erfolgen.

### Schaltungssystem mit Mehrfachkorrelator

**In** einer weiteren Ausprägung umfasst das Sensorsystem eine Steuervorrichtung (CTR), einen ersten Signalgenerator (G1), eine Lichtquelle (LED), einen zweiten Signalgenerator (G2), einen Fotodetektor (PD), ein Sensorelement (SE) mit Kristallen und/oder Diamant-Nano-Kristallen (ND) mit paramagnetischen Zentren und/oder NV-Zentren in Diamant, einen Wellenleiter (1380, 1880, 2380, 6830, 6980) und eine Mikrowellensignalquelle (µWG). Der erste Signalgenerator (G1) erzeugt ein LED-Modulationssignal (S5w). Der der zweite Signalgenerator (G2) erzeugt ein Mikrowellenmodulationssignal (S5m). Die Lichtquelle (LED) erzeugt eine Pumpstrahlung (LB) und bestrahlt moduliert mit der modulierten Pumpstrahlung(LB) die paramagnetischen Zentren und/oder NV-Zentren in Diamant in Abhängigkeit von dem LED-Modulationssignal moduliert. Die Mikrowellensignalquelle (µWG) erzeugt ein Mikrowellensignal (µW) und speist das Mikrowellensignal (µW) in Abhängigkeit von dem Mikrowellenmodulationssignal (S5m) moduliert in den Wellenleiter (1380, 1880, 2380, 6830, 6980) ein. Der Wellenleiter (1380, 1880, 2380, 6830, 6980) bestrahlt die paramagnetischen Zentren und/oder NV-Zentren in Diamant mit dem modulierten Mikrowellensignal (µW). In Abhängigkeit von dem modulierten Mikrowellensignal (µW) und in Abhängigkeit von der Pumpstrahlung (LB) emittieren paramagnetische Zentren und/oder NV-Zentren in Diamant Fluoreszenzstrahlung (FL). Der Fotodetektor (PD) erfasst die von den paramagnetischen Zentren und/oder NV-Zentren in Diamant emittierte Fluoreszenzstrahlung (FL) und bildet in Abhängigkeit davon ein Empfängerausgangssignal (S0). Ein Mehrfachkorrelator (LIV) oder eine funktionsäquivalente Vorrichtung korrelieren das Empfängerausgangssignal (S0) oder ein daraus abgeleitetes Signal mit dem LED-Modulationssignal (S5w) und dem Mikrowellenmodulationssignal (S5m), insbesondere durch hardwaregestützte Bildung eines L3-Produkts, zu einem ein- oder mehrdimensionalen Filterausgangssignal (S4). Das Sensorsystem verwendet das Filterausgangssignal (S4) und/oder ein daraus abgeleitetes Signal als Messergebnis oder hält es bereit oder gibt es an ein übergeordnetes System aus.

### vektorieller Sensorelementkanal

Es lässt sich somit ein vektorieller Sensorelementkanal definieren, der wesentliche Teile eines Sensorsystems umfasst. Bevorzugt weist der vektorielle Sensorelementkanal einen ersten Signalgenerator (G1) auf, der dazu eingerichtet ist, ein LED-Modulationssignal (S5w) zu erzeugen. Der vektorielle Sensorelementkanal kann alternativ einen ersten vektoriellen Signalgenerator (G1) aufweisen, der mehrere Signalgeneratoren (G1_1, G1_2, G1_3, G1_4, G1_5) als erste Signalgeneratorkomponenten umfasst und der dazu eingerichtet ist, ein vektorielles LED-Modulationssignal (S5w) mit mehreren LED-Modulationssignalen (S5w_1, S5w_2, S5w_3, S5w_4, S5w_5) als LED-Modulationssignalkomponenten zu erzeugen. Der vektorielle Sensorelementkanal kann ein Sendesignal (S5) oder ein vektorielles Sendesignal (S5), umfassend mehrere Sendesignale (S5_1, S5_2, S5_3, S5_4, S5_5), als Sendesignalkomponenten aufweisen. Der vektorielle Sensorelementkanal weist vorzugsweise einen Lichtquellentreiber (LDRV) auf, der dazu eingerichtet ist, das Sendesignal (S5) für eine Lichtquelle (LED) in Abhängigkeit von dem LED-Modulationssignal (S5w) zu erzeugen und vorzugsweise die Lichtquelle (LED) zumindest zeitweise mit elektrischer Energie zu versorgen, oder wobei der vektorielle Sensorelementkanal einen vektoriellen Lichtquellentreiber (LDRV) aufweist, der mehrere Lichtquellentreiber (LDRV_1, LDRV_2, LDRV_3, LDRV_4, LDRV_5) umfasst und der dazu eingerichtet ist, die Sendesignalkomponenten (S5_1, S5_2, S5_3, S5_4, S5_5) des vektoriellen Sendesignals (S5) für eine vektorielle Lichtquelle (LED) in Abhängigkeit von dem vektoriellen LED-Modulationssignal (S5w) und/oder von dem LED-Modulationssignal (S5w) zu erzeugen und die jeweiligen Lichtquellenkomponenten (LED_1, LED_2, LED_3, LED_4, LED_5) der vektoriellen Lichtquelle (LED) zumindest zeitweise jeweils mit elektrischer Energie zu versorgen. Der vektorielle Sensorelementkanal weist vorzugsweise eine Lichtquelle (LED) auf, die dazu eingerichtet ist, Pumpstrahlung (LB) in Abhängigkeit von dem Sendesignal (S5) zu erzeugen. Dabei schaltet typischerweise das Sendesignal (S5) die Lichtquelle (LED) zeitweise und/oder teilweise ein und zeitweise und/oder teilweise aus. Der vektorielle Sensorelementkanal kann eine vektorielle Lichtquelle (LED), umfassend mehrere Lichtquellen (LED_1, LED_2, LED_3, LED_4, LED_5) als Lichtquellenkomponenten, aufweisen, die vorzugsweise dazu eingerichtet sind, die vektorielle Pumpstrahlung (LB), umfassend mehrere Pumpstrahlungskomponenten (LB_1, LB_2, LB_3, LB_4, LB_5) die jeweils eine dieser Lichtquellenkomponenten (LED_1, LED_2, LED_3, LED_4, LED_5) erzeugt, in jeweiliger Abhängigkeit von den jeweiligen Sendesignalkomponenten (S5_1, S5_2, S5_3, S5_4, S5_5) des vektoriellen Sendesignals (S5) zu erzeugen. Dabei schalten dann bevorzugt die jeweiligen Sendesignalkomponenten (S5_1, S5_2, S5_3, S5_4, S5_5) des vektoriellen Sendesignals (S5) die ihnen zugeordneten jeweiligen Lichtquellenkomponenten (LED_1, LED_2, LED_3, LED_4, LED_5) der vektoriellen Lichtquelle (LED) zeitweise und/oder teilweise ein und zeitweise und/oder teilweise aus. Der vektorielle Sensorelementkanal weist typischerweise ein erstes vektorielles optisches System auf, das ein erstes optisches Funktionselemente (LWL) oder ein vektorielles erstes optisches Funktionselement aufweist, das mehrere erste optische Funktionselemente (LWL_1, LWL_2, LWL_3, LWL_4, LWL_5) als erste optische Funktionselementkomponenten umfasst. Das erste vektorielle optische System ist vorzugsweise dazu eingerichtet, die Pumpstrahlung (LB) der Lichtquelle (LED) zu erfassen oder die vektorielle Pumpstrahlung (LB) der vektoriellen Lichtquelle (LED) in vektorieller Weise zu erfassen, wobei bevorzugt jede optische Funktionskomponente (LWL_1, LWL_2, LWL_3, LWL_4, LWL_5) jeweils ein oder mehrere jeweilige Pumpstrahlungskomponenten (LB_1, LB_2, LB_3, LB_4, LB_5) der vektoriellen Pumpstrahlung (LB) separat erfasst. Des Weiteren ist bevorzugt das erste vektorielle optisches System dazu eingerichtet, die erfasste Pumpstrahlung (LB) zum Sensorelement (SE) zu transportieren oder die jeweils erfassten Pumpstrahlungskomponenten (LB_1, LB_2, LB_3, LB_4, LB_5) der Pumpstrahlung (LB) zu einem oder mehreren zugeordneten Sensorelementkomponenten (z.B. 1410, 1420, 1430) des vektorielle Sensorelement (SE) zu transportieren. Dabei umfasst bevorzugt das vektoriellen Sensorelement (SE) vorzugsweise zumindest zwei Sensorelementkomponenten (z.B. 1410, 1420, 1430). Bevorzugt ist das erste vektorielle optisches System dazu eingerichtet, die Pumpstrahlung (LB) aus dem ersten optischen Funktionselement (LWL) auszukoppeln oder die jeweilige Pumpstrahlungskomponente (LB_1, LB_2, LB_3, LB_4, LB_5) der vektoriellen Pumpstrahlung (LB) jeweils aus der jeweiligen ersten optischen Funktionselementkomponente (LWL_1, LWL_2, LWL_3, LWL_4, LWL_5) des ersten vektoriellen optischen Funktionselements (LWL) auszukoppeln. Weiter ist das erste vektorielle optisches System vorzugsweise dazu eingerichtet, das Sensorelement (SE) mit dieser Pumpstrahlung (LB) zu bestrahlen oder jeweils ein oder mehrere Sensorelementkomponenten (z.B. 1410, 1420, 1430) des vektoriellen Sensorelements (SE) mit genau einer oder mehreren jeweiligen Pumpstrahlungskomponenten (LB_1, LB_2, LB_3, LB_4, LB_5) der vektoriellen Pumpstrahlung (LB) zu bestrahlen. Dabei bestrahlt bevorzugt genau eine jeweilige Pumpstrahlungskomponente (LB_1, LB_2, LB_3, LB_4, LB_5) der vektoriellen Pumpstrahlung (LB) genau einer jeweiligen Lichtquellenkomponente (LED_1, LED_2, LED_3, LED_4, LED_5) der vektoriellen Lichtquelle (LED) bevorzugt genau eine jeweilige Sensorelementkomponente (z.B. 1410, 1420, 1430) des vektoriellen Sensorelements (SE). Das erste vektorielle optische System weist bevorzugt in einer Variante einen ersten vektoriellen Lichtwellenleiter (LWL), der bevorzugt eine Mehrzahl von ersten Lichtwellenleitern (LWL_1, LWL_2, LWL_3, LWL_4, LWL_5) als ersten Lichtwellenleiterkomponenten umfasst, für diese Bestrahlung des vektoriellen Sensorelements (SE) als ein solches vektorielles erstes optisches Funktionselement auf. Der vektorielle Sensorelementkanal weist bevorzugt ein zweites vektorielles optisches System auf, das ein zweites optisches Funktionselemente (LWL) oder ein vektorielles zweites optisches Funktionselement (LWL), das mehrere zweite optische Funktionselemente (LWL_1, LWL_2, LWL_3, LWL_4, LWL_5) als zweite optische Funktionselementkomponenten umfasst, auf. Das zweite vektorielle optische System ist vorzugsweise dazu eingerichtet, mittels des zweiten optischen Funktionselements (LWL) die Fluoreszenzstrahlung (FL) des Sensorelements (SE) oder der Sensorelemente (SE) zu erfassen oder mittels der jeweiligen zweiten optischen Funktionselementkomponenten (LWL_1, LWL_2, LWL_3, LWL_4, LWL_5) seines vektoriellen zweiten optischen Funktionselements (LWL) jeweils die jeweilige Fluoreszenzstrahlungskomponente (FL_!, FL_2, FL3, FL_4, FL_5) der vektoriellen Fluoreszenzstrahlung (FL) eines oder mehrerer der jeweiligen Sensorelementkomponenten (z.B. 1410, 1420, 1430) des vektoriellen Sensorelements (SE) zu erfassen. Dabei erfasst bevorzugt genau eine seiner jeweiligen zweiten optischen Funktionselementkomponenten (LWL_1, LWL_2, LWL_3, LWL_4, LWL_5) seines vektoriellen zweiten optischen Funktionselements (LWL) jeweils genau eine jeweilige Fluoreszenzstrahlungskomponente (FL_1, FL_2, FL3, FL_4, FL_5) der vektoriellen Fluoreszenzstrahlung (FL) eines oder mehrerer der jeweiligen Sensorelementkomponenten (z.B. 1410, 1420, 1430) des vektoriellen Sensorelements (SE). Die Fluoreszenzstrahlung (FL) der NV-Zentren und/oder der paramagnetischen Zentren des Sensorelements (SE) umfasst eine einzelne Fluoreszenzstrahlungskomponente oder die vektorielle Fluoreszenzstrahlung (FL) umfasst die jeweiligen Fluoreszenzstrahlungen (FL1, FL_2, FL_3, FL_4, FL_5) der NV-Zentren und/oder der paramagnetischen Zentren der jeweiligen Sensorelementkomponenten (z.B. 1410, 1420, 1430) des vektoriellen Sensorelements (SE) als jeweilige Fluoreszenzstrahlungskomponenten (FL_1, FL_2, FL_3, FL_4, FL_5). Vorzugsweise ist das das zweite vektorielle optische System dazu eingerichtet, Fluoreszenzstrahlung (FL) der NV-Zentren und/oder der paramagnetischen Zentren des Sensorelements (SE) zum Fotodetektor (PD) zu transportieren oder die jeweiligen Fluoreszenzstrahlungskomponenten (FL_1, FL_2, FL_3, FL_4, FL_5) der vektoriellen Fluoreszenzstrahlung (FL) vorzugsweise untereinander separat zu jeweiligen Fotodetektorkomponenten (PD_1, PD_2, PD_3, PD_4, PD_5) eines vektoriellen Fotodetektors (PD) zu transportieren. Vorzugsweise umfasst dann der vektorielle Fotodetektor (PD) mehrere Fotodetektoren (PD_1, PD_2, PD_3, PD_4, PD_5) als jeweilige Fotodetektorkomponenten des vektoriellen Fotodetektors (PD). Vorzugsweise ist das zweite vektorielle optische System dazu eingerichtet, die Fluoreszenzstrahlung (FL) aus dem zweiten optischen Funktionselement auszukoppeln oder das die jeweiligen Fluoreszenzstrahlungskomponenten (FL_1, FL_2, FL_3, FL_4, FL_5) der vektoriellen Fluoreszenzstrahlung (FL) aus der jeweiligen zweiten optischen Funktionskomponente (LWL_1, LWL_2, LWL_3, LWL_4, LWL_5) der zweiten vektoriellen optischen Funktionskomponente (LWL) auszukoppeln. Des Weiteren ist vorzugsweise das zweite vektorielle optische System dazu eingerichtet, den Fotodetektor (PD) mit der ausgekoppelten Fluoreszenzstrahlung (FL) zu bestrahlen oder jeweils die jeweilige Fotodetektorkomponente (PD_1, PD_2, PD_3, PD_4, PD_5) des vektoriellen Fotodetektors (PD) mit einer insbesondere jeweiligen Fluoreszenzstrahlungskomponente (FL_1, FL_2, FL_3, FL_4, FL_5) der vektoriellen Fluoreszenzstrahlung (FL) zu bestrahlen. Dabei bestrahlt das zweite vektorielle optische System ganz besonders bevorzugt jeweils genau eine jeweilige Fotodetektorkomponente (PD_1, PD_2, PD_3, PD_4, PD_5) des vektoriellen Fotodetektors (PD) bevorzugt mit genau einer jeweiligen Fluoreszenzstrahlungskomponente (FL_1, FL_2, FL_3, FL_4, FL_5) der vektoriellen Fluoreszenzstrahlung (FL). Das zweite vektorielle optische System umfasst vorzugsweise weitere optische Funktionselemente, insbesondere einen oder mehrere dichroitische Spiegel (F1) und/oder einen oder mehrere optische Filter (ebenfalls mit dem funktionsbezogenen Bezugszeichen F1 bezeichnet) im Strahlengang, die sicherstellen, dass im Wesentlichen keine Pumpstrahlung (LB, LB_1, LB_2, LB_3, LB_4, LB_5) dieser oder anderer Pumpstrahlungsquellen (LED, LED_1, LED_2, LED_3, LED_4, LED_5) den Fotodetektor (PD) oder die jeweilige Fotodetektorkomponente (PD_1, PD_2, PD_3, PD_4, PD_5) der Fotodetektorkomponenten (PD_1, PD_2, PD_3, PD_4, PD_5) des vektoriellen Fotodetektors (PD) erreichen. Vorzugsweise umfasst das zweite vektorielle optische System insbesondere einen zweiten Lichtwellenleiter (LWL) als ein solches zweites optisches Funktionselement oder insbesondere einen zweiten vektoriellen Lichtwellenleiter (LWL) mit mehrere Lichtwellenleitern (LWL_1, LWL_2, LWL_3, LWL_4, LWL_5) als ein solches zweites vektorielles optisches Funktionselement. Typischerweise und ganz besonders bevorzugt kann das zweite vektorielle optische System Vorrichtungsteile umfassen, die mit Vorrichtungsteilen des ersten optischen Systems identisch sind. Das hier vorgestellte Dokument verweist hier auf die Figuren und die zugehörigen Beschreibungen. Der vektorielle Sensorelementkanal umfasst vorzugsweise des Weiteren den Fotodetektor (PD), der typischerweise die Intensität der empfangenen Fluoreszenzstrahlung (FL) in ein Empfängerausgangssignal (S0) wandelt, oder den vektoriellen Fotodetektor (PD) umfassend mehrere Fotodetektoren (PD_1, PD_2, PD_3, PD_4, PD_5) als Fotodetektorkomponenten, die jeweils die jeweilige Intensität der jeweils durch den jeweiligen Fotodetektoren (PD_1, PD_2, PD_3, PD_4, PD_5) empfangenen jeweiligen Fluoreszenzstrahlungskomponente (FL_1, FL_2, FL_3, FL_4, FL_5) der vektoriellen Fluoreszenzstrahlung (FL) in ein jeweiliges Empfängerausgangssignal (S0_1, S0_2, S0_3, S0_4, S0_5) des jeweiligen Fotodetektors (PD_1, PD_2, PD_3, PD_4, PD_5) als Empfängerausgangssignalkomponente eines vektoriellen Empfängerausgangssignals (S0) des vektoriellen Fotodetektors (PD) wandeln. Der vektorielle Sensorelementkanal umfasst des Weiteren vorzugsweise das Empfängerausgangssignal (S0) oder das vektorielle Empfängerausgangssignal (S0), das die Empfängerausgangssignale (S0_1, S0_2, S0_3, S0_4, S0_5) als Empfängerausgangssignalkomponente des vektoriellen Empfängerausgangssignals (S0). Vorzugsweise weist der vektorielle Sensorelementkanal einen ersten Verstärker (V1) zur Verstärkung und/oder Digitalisierung des Empfängerausgangssignal (S0) zum verstärkten Empfängerausgangssignal (S1) bzw. zum digitalisierten Empfängerausgangssignal (S1) auf oder einen ersten vektoriellen Verstärker (V1) umfassend mehrere erste Verstärker (V1_1, V1_2, V1_3, V1_4, V1_5) als erste Verstärkerkomponenten des ersten vektoriellen Verstärkers (V1) zur jeweiligen Verstärkung und/oder jeweiligen Digitalisierung einer jeweiligen Empfängerausgangssignalkomponente (S0_1, S0_2, S0_3, S0_4, S0_5) des vektoriellen Empfängerausgangssignals (S0) zu einer jeweiligen verstärkten Empfängerausgangssignalkomponente (S1_1, S1_2, S1_3, S1_4, S1_5) des vektoriellen verstärkten Empfängerausgangssignals (S1) bzw. zu einer jeweiligen digitalisierten Empfängerausgangssignalkomponente (S1_1, S1_2, S1_3, S1_4, S1_5) des vektoriellen digitalisierten Empfängerausgangssignals (S1) auf. Außerdem umfasst bevorzugt und im Gegensatz zum Stand der Technik der vektorielle Sensorelementkanal einen Mehrfachkorrelator (LIV) auf, der vorzugsweise dazu eingerichtet ist,
- ein Filterausgangssignal (S4) in Abhängigkeit vom verstärkten Empfängerausgangssignal (S1) bzw. vom digitalisierten Empfängerausgangssignal (S1) und von dem LED-Modulationssignal (S5w) und von dem Mikrowellenmodulationssignal (S5m) zu bilden und
- Daten des so gebildeten Filterausgangssignals (S4) der Steuervorrichtung (CTR) zur Verfügung zu stellen und/oder
- Daten des so gebildeten Filterausgangssignals (S4) insbesondere für die Steuervorrichtung (CTR) bereit zu halten und/oder a
- Daten des so gebildeten Filterausgangssignals (S4) an die Steuervorrichtung (CTR) oder eine andere Vorrichtung (z.B. die Mustererkennungsvorrichtung MEV) insbesondere zur Auswertung zu übertragen
oder wobei der vektorielle Sensorelementkanal mehre Mehrfachkorrelatoren (LIV_1, LIV_2, LIV_3, LIV_4, LIV_5) eines vektoriellen Mehrfachkorrelators (LIV) als Mehrfachkorrelatorkomponenten umfasst, wobei jede der Mehrfachkorrelatorkomponenten (LIV_1, LIV_2, LIV_3, LIV_4, LIV_5) des vektoriellen Mehrfachkorrelators (LIV) jeweils dazu eingerichtet ist,
- jeweils ein jeweiliges Filterausgangssignal (S4_1, S4_2, S4_3, S4_4, S4_5) als jeweilige Filterausgangssignalkomponente eines gemeinsamen vektoriellen Filterausgangssignals (S4) in jeweiliger Abhängigkeit von der jeweiligen verstärkten Empfängerausgangssignalkomponente (S1_1, S1_2, S1_3, S1_4, S1_5) des vektoriellen verstärkten Empfängerausgangssignals (S1) bzw. in jeweiliger Abhängigkeit von der jeweiligen digitalisierten Empfängerausgangssignalkomponente (S1_1, S1_2, S1_3, S1_4, S1_5) des vektoriellen digitalisierten Empfängerausgangssignals (S1) und in jeweiliger Abhängigkeit von der jeweiligen LED-Modulationssignalkomponente (S5w_1, S5w_2, S5w_3, S5w_4, S5w_5) des vektoriellen LED-Modulationssignal (S5w) und in jeweiliger Abhängigkeit von der jeweiligen Mikrowellenmodulationssignalkomponente (S5m_1, S5m_2, S5m_3, S5m_4, S5m_5) des vektoriellen Mikrowellenmodulationssignals (S5m) zu bilden und
- Daten des so gebildeten vektoriellen Filterausgangssignals (S4) der Steuervorrichtung (CTR) zur Verfügung zu stellen und/oder
- Daten des so gebildeten vektoriellen Filterausgangssignals (S4) für die Steuervorrichtung (CTR) bereit zu halten und/oder
- Daten des so gebildeten vektoriellen Filterausgangssignals (S4) an die Steuervorrichtung (CTR) oder eine andere Vorrichtung (z.B. den Mustererkenner (MEV) insbesondere zur Auswertung zu übertragen.

Der vektorielle Sensorelementkanal kann dabei eine optionale Mustererkennungsvorrichtung (MEV) zusätzlich zur Beschleunigung und/oder Entlastung beispielsweise der Steuervorrichtung (CTR) umfassen. Typischerweise sind diese optionale Mustererkennungsvorrichtung (MEV) und/oder die Steuervorrichtung (CTR) dazu eingerichtet, ein oder mehrere vektorielle Filterausgangssignale (S4, S4_1, S4_2, S4_3, S4_4, S4_5) und/oder das gemeinsame vektorielle Filterausgangssignal (S4) auszuwerten und/oder zu analysieren und/oder mittels computerimplementierter Verfahren zu verarbeiten und/oder einen oder mehrere Musterdatensätze (MDS) zu erzeugen und anderen externen Systemen und/oder internen Vorrichtungsteilen (CTR) zur Verfügung zu stellen und/oder bereitzuhalten und/oder zu übergeben .

Vorzugsweise ist zumindest eine, besser zwei, besser drei, besser vier, besser fünf der folgenden Vorrichtungsteilgruppen vektoriell ausgelegt:
- Gruppe 1: Der erste vektorielle Signalgenerator (G1), das vektorielle LED-Modulationssignal (S5w), der vektorielle Lichtquellentreiber (LDRV), das vektorielle Sendesignal (S5), die vektorielle Lichtquelle (LED).
- Gruppe 2: das erste vektorielle optische System.
- Gruppe 3: vektorielle Sensorelement (SE).
- Gruppe 4: das zweite vektorielle optische System
- Gruppe 5: der vektorielle Fotodetektor (PD), das vektorielle Empfängerausgangssignal (S0), der vektorielle erste Verstärker (V1), das verstärkte Empfängerausgangssignal (S1) bzw. das digitalisierte Empfängerausgangssignal (S1), der vektorielle Mehrfachkorrelators (LIV).

Dies kann zusammengefasst werden in eine Anforderung, dass vorzugsweise zumindest Teilgruppen des Sensorelementkanals vektoriell ausgelegt sind.

### Mikrooptik

Das Trägersubstrat (1360) kann dabei auch mikrooptische Funktionselemente umfassen. Hier eine beispielhafte unvollständige Liste:
- Mikrooptische Linsen: Mikrooptische Linsen werden verwendet, um Licht zu fokussieren oder zu kollimieren. Sie bestehen oft aus einer Sammellinse oder einer Mikrolinse, die in den Wafer integriert werden kann.
- Mikrostrukturierte optische Filter: Diese Filter nutzen mikrooptische Strukturen, um bestimmte Wellenlängenbereiche zu blockieren oder durchzulassen. Beispiele hierfür sind Mikro-Gitterfilter oder mikrooptische Interferenzfilter.
- Mikrooptische Wellenleiter: Mikrooptische Wellenleiter werden verwendet, um Licht innerhalb des Wafers zu führen und zu leiten. Sie können beispielsweise in Form von mikrooptischen Fasern oder Wellenleiterstrukturen realisiert werden.
- Mikrospiegel: Mikrospiegel bestehen aus kleinen, beweglichen Spiegeln, die das einfallende Licht in verschiedene Richtungen reflektieren können. Sie ermöglichen die optische Steuerung von Lichtstrahlen und werden oft in der optischen Kommunikation oder in der optischen Schaltertechnologie eingesetzt.
- Mikrostrukturen für die Oberflächenstrukturierung: Mikrooptische Oberflächenstrukturen können verwendet werden, um das einfallende Licht zu streuen, zu brechen oder zu polarisieren. Solche Strukturen können beispielsweise in Form von Mikroprismen, Mikrogittern oder Mikroreliefs realisiert werden.
- Mikrooptische Beugungsgitter: Mikrooptische Beugungsgitter bestehen aus regelmäßigen mikrooptischen Strukturen, die das einfallende Licht in verschiedene Beugungsordnungen aufspalten. Sie werden häufig in spektralen Analysegeräten oder als optische Kodierstrukturen eingesetzt.
- Mikrooptische Phasenelemente: Mikrooptische Phasenelemente ermöglichen die Manipulation der Phasen des einfallenden Lichts. Dazu gehören zum Beispiel Mikrooptische Phasengitter, die die Phasenverteilung des Lichts modulieren und zur Erzeugung von Interferenzmustern verwendet werden können.
- Mikrooptische Detektoren: Mikrooptische Detektoren sind optische Sensoren, die in den Wafer integriert werden können. Sie können zum Beispiel Fotodioden, Fototransistoren oder andere lichtempfindliche Elemente umfassen. Diese Detektoren wandeln Lichtsignale in elektrische Signale um und werden in optischen Kommunikationssystemen oder Sensoren eingesetzt.
- Mikrooptische Strahlteiler und Koppler: Diese Funktionselemente ermöglichen die Aufteilung oder Kopplung von Licht in mehrere Kanäle. Sie werden oft in optischen Kommunikationssystemen, optischen Schaltern oder optischen Sensoren eingesetzt.
- Mikrooptische Hohlraumresonatoren: Mikrooptische Hohlraumresonatoren bestehen aus mikrostrukturierten Materialien, die Licht in einem begrenzten Volumen einschließen und bestimmte Resonanzmoden aufweisen. Sie werden in optischen Filtern, Lasern oder als optische Verstärker verwendet.

**In** der NV-Zentren-Sensorik und/oder der Sensorik paramagnetischer Zentren können mikrooptische Vorrichtungen in Kombination mit NV-Zentren und/oder paramagnetischen Zentren verwendet werden, um Informationen über analytische Substanzen und/oder physikalische Parameter in der Umgebung der NV-zentren und/oder paramagnetischen Zentren zu erhalten. Das hier vorgelegte Dokument nennt einige Wechselwirkungen zwischen mikrooptischen Vorrichtungen und NV-Zentren und/oder paramagnetischen Zentren in der NV-Zentren-Sensorik und/oder der Sensorik paramagnetischer Zentren:
1. Lichtemission und -absorption: NV-Zentren und/oder paramagnetischen Zentren können Licht emittieren und absorbieren, wobei ihre optischen Eigenschaften von der Umgebung und den Wechselwirkungen mit analytischen Substanzen und/oder physikalischen Parametern in der Umgebung der NV-zentren und/oder paramagnetischen Zentren beeinflusst werden. Mikrooptische Vorrichtungen wie Mikrospiegel, Mikroresonatoren oder mikrostrukturierte optische Wellenleiter können verwendet werden, um mit dem Licht NV-Zentren und/oder paramagnetischen Zentren zu steuern und zu manipulieren. Durch die Beobachtung von Veränderungen in der Lichtemission oder -absorption der paramagnetischen Zentren und/oder NV-Zentren können Informationen über analysierte Substanzen und/oder physikalische Parameter in der Umgebung der NV-Zentren und/oder paramagnetischen Zentren gewonnen werden.
2. Lichtführung und -kopplung: Mikrooptische Vorrichtungen können verwendet werden, um Licht auf die NV-Zentren und/oder paramagnetischen Zentren zu fokussieren, zu lenken oder zu koppeln. Durch die präzise Steuerung des Lichtwegs und der Lichtintensität können gezielte Wechselwirkungen zwischen dem Licht und den NV-Zentren und/oder paramagnetischen Zentren hergestellt werden. Dies ermöglicht die Detektion von optischen Signaländerungen, die auf die Anwesenheit oder Interaktion von analytischen Substanzen und/oder physikalische Parameter in der Umgebung der NV-Zentren und/oder paramagnetischen Zentren zurückzuführen sind.
3. Plasmonische Wechselwirkungen: Mikrooptische Vorrichtungen können plasmonische Strukturen enthalten, die die Wechselwirkung zwischen Licht und NV-Zentren und/oder paramagnetischen Zentren verstärken. Plasmonische Effekte können genutzt werden, um die Empfindlichkeit und Auflösung der NV-Zentren-Sensorik und/oder der Sensorik paramagnetischer Zentren zu verbessern. Durch die Integration von NV-Zentren und/oder paramagnetischen Zentren in plasmonische Strukturen können kleinste Veränderungen in der optischen Eigenschaft der NV-Zentren und/oder paramagnetischen Zentren detektiert werden, was zu hoher Empfindlichkeit bei der Detektion von Analyten und/oder physikalischer Parameter in der Umgebung der NV-Zentren und/oder paramagnetischen Zentren führt.
4. Spektrale Analyse: Mikrooptische Vorrichtungen können verwendet werden, um das emittierte oder absorbierte Licht von NV-Zentren und/oder paramagnetischen Zentren spektral zu analysieren. Durch die Aufspaltung des Lichts in verschiedene spektrale Komponenten können Informationen über die spektrale Signatur der NV-Zentren und/oder paramagnetischen Zentren und deren Veränderungen aufgrund von Wechselwirkungen mit analytischen Substanzen und/oder physikalischen Parametern in der Umgebung der NV-Zentren und/oder paramagnetischen Zentren erhalten werden.
5. Interferenz und Modulation: Mikrooptische Vorrichtungen können Interferenz- und Modulationstechniken nutzen, um Veränderungen in der optischen Phase oder Intensität zu erfassen. Durch die Integration von NV-Zentren und/oder paramagnetischen Zentren in Interferometer- oder Modulationsstrukturen können geringfügige Veränderungen in den optischen Eigenschaften der NV-Zentren und/oder paramagnetischen Zentren detektiert werden, die auf die Anwesenheit oder Interaktion von analytischen Substanzen und/oder Änderungen physikalischer Parameter in der Umgebung der NV-Zentren und/oder paramagnetischen Zentren hinweisen.
6. Kohärenzeffekte: NV-Zentren und/oder paramagnetische Zentren können kohärente optische Signale erzeugen, die zur Messung von Phasen- und Frequenzänderungen verwendet werden können. Mikrooptische Vorrichtungen können dazu dienen, die Kohärenz der NV-Zentren und/oder der paramagnetischen Zentren zu erhalten und zu verbessern. Durch die präzise Kontrolle der Kohärenzeigenschaften können subtile optische Signale detektiert werden, die auf die Anwesenheit oder Wechselwirkung mit analytischen Substanzen und/oder Änderungen physikalischer Parameter in der Umgebung der NV-Zentren und/oder paramagnetischen Zentren hinweisen.
7. Polarisationsempfindlichkeit: NV-Zentren und/oder der paramagnetische Zentren zeigen eine starke Empfindlichkeit gegenüber der Polarisation des Lichts. Mikrooptische Vorrichtungen können dazu verwendet werden, die Polarisation des Lichts, das auf die NV-Zentren und/oder der paramagnetischen Zentren trifft, zu manipulieren und zu analysieren. Durch die Messung von Polarisationseffekten können Informationen über die Umgebung der NV-Zentren und/oder der paramagnetischen Zentren und die Wechselwirkungen mit analytischen Substanzen und/oder mit physikalischen Parametern in der Umgebung der NV-Zentren und/oder paramagnetischen Zentren gewonnen werden.
8. Nahfeldoptik: Mikrooptische Vorrichtungen können in Kombination mit NV-Zentren und/oder paramagnetischen Zentren zur Nahfeldoptik genutzt werden. Dies ermöglicht die Manipulation und Erfassung von Licht im Bereich des optischen Nahfelds, was eine hohe räumliche Auflösung und beispielsweise eine verbesserte Wechselwirkung mit analytischen Substanzen und/oder physikalischen Parametern in der Nähe der NV-Zentren und/oder paramagnetischen Zentren bietet. Durch die gezielte Kontrolle des Lichtfelds in der Nähe der NV-Zentren und/oder der paramagnetischen Zentren können Informationen über die Substanzen in unmittelbarer Nähe und/oder physikalischer Parameter in der Umgebung der NV-Zentren und/oder paramagnetischen Zentren erhalten werden.
9. Integration von Mikrolinsen oder Mikroobjektiven: Mikrooptische Vorrichtungen können Mikrolinsen oder Mikroobjektive enthalten, die dazu dienen, das Licht auf die NV-Zentren und/oder die paramagnetischen Zentren zu fokussieren oder das emittierte Licht zu sammeln. Durch die präzise Kontrolle der Linsenposition und -geometrie können optimale Lichtverhältnisse für die Wechselwirkung mit analytischen Substanzen und/oder physikalischen Parametern in der Umgebung der NV-Zentren und/oder paramagnetischen Zentren geschaffen werden.
10. Wellenleiter-Integration: Mikrooptische Vorrichtungen können optische Wellenleiterstrukturen enthalten, die das Licht zu den NV-Zentren und/oder den paramagnetischen Zentren leiten oder das emittierte Licht sammeln. Durch die Integration von NV-Zentren und/oder von paramagnetischen Zentren in diese Wellenleiterstrukturen können die Wechselwirkungen zwischen dem Licht und den analytischen Substanzen und/oder physikalischen Parametern in der Umgebung der NV-Zentren und/oder paramagnetischen Zentren verstärkt und gezielt gesteuert werden.

Diese Wechselwirkungen zwischen mikrooptischen Vorrichtungen und NV-Zentren und/oder den paramagnetischen Zentren eröffnen eine breite Palette von Anwendungen in der optischen Sensorik, der chemischen Analyse, der Biotechnologie und anderen Bereichen. Durch die Integration von NV-Zentren und/oder den paramagnetischen Zentren in mikrooptische Systeme können hochempfindliche, hochauflösende und präzise Messungen von analytischen Substanzen und/oder physikalischen Parametern in der Umgebung der NV-Zentren und/oder paramagnetischen Zentren ermöglicht werden.

### Mikrofluidik

**In** der Mikrofluidik gibt es verschiedene Funktionselemente, die für die Integration in das Trägersubstrat (1360) in Frage kommen. Hier sind einige Beispiele:
- Mikrokanäle: Mikrokanäle sind winzige Kanäle, die Flüssigkeiten oder Gase auf mikroskopischer Skala transportieren können. Sie können in den Wafer integriert werden, um Fluidströme zu lenken, zu mischen oder zu trennen. Mikrokanäle können beispielsweise für die Durchführung von Lab-on-a-Chip-Anwendungen, zur Analyse von biologischen Proben oder für die chemische Reaktionstechnik verwendet werden.
- Mikroventile: Mikroventile dienen zur Steuerung des Flusses in Mikrokanälen. Sie ermöglichen das Öffnen, Schließen oder Regulieren des Flüssigkeitsstroms. Mikroventile können beispielsweise in mikrofluidischen Systemen eingesetzt werden, um den Fluss zu stoppen oder umzuleiten und damit eine Wechselwirkung zwischen den NV-zentren und/oder paramagnetischen Zentren zu beeinflussen.
- Mikropumpen: Mikropumpen erzeugen Druckunterschiede, um Flüssigkeiten in Mikrokanälen zu bewegen. Sie können beispielsweise mit Hilfe von piezoelektrischen oder elektro-osmotischen Effekten arbeiten. Mikropumpen ermöglichen die aktive Steuerung des Flusses und finden Anwendung in verschiedenen Bereichen wie medizinischer Diagnostik, chemischer Analytik oder Mikroreaktionssystemen.
- Mikrostrukturierte Mischkammern: Mikrostrukturierte Mischkammern werden verwendet, um Flüssigkeiten oder Gase effizient zu mischen. Sie enthalten spezielle Strukturen wie Wirbelgeneratoren oder mikrostrukturierte Hindernisse, um eine schnelle und homogene Mischung zu erreichen. Mikrostrukturierte Mischkammern finden Anwendung in chemischen Reaktionssystemen, biologischen Analysen oder in der Lab-on-a-Chip-Technologie.
- Mikrofilter und Separationsstrukturen: Mikrofilter und Separationsstrukturen dienen zur Trennung von Partikeln oder Verunreinigungen in Flüssigkeiten. Sie können beispielsweise aus mikrostrukturierten Membranen, Mikro-Gewebe- oder Mikro-Sieben bestehen. Solche Strukturen werden in der Mikrofluidik verwendet, um Proben zu filtern, Zellen zu sortieren oder Partikel abzutrennen.

Diese Funktionselemente können in das Trägersubstrat (1360) bei Bedarf integriert werden, indem sie mit Hilfe von Mikrofabrikationsprozessen wie der Fotolithographie, der Ätztechnik, der additiven Fertigung , des Spritzgusses oder der Beschichtungstechnik etc. erzeugt werden. Die Integration von Mikrofluidikelementen in das Trägersubstrat (1360) ermöglicht die Miniaturisierung und Integration von Flüssigkeitsmanipulationssystemen auf einem Chip.

**In** der NV-Zentren-Sensorik und/oder der Sensorik mit paramagnetischen Zentren können mikrofluidische Vorrichtungen in Kombination mit NV-Zentren bzw. paramagnetischen Zentren verwendet werden, um Informationen über analytische Substanzen und/oder physikalische Parameter in der Nähe der NV-Zentren und/oder paramagnetischen Zentren zu erhalten. Hier sind einige bekannte Wechselwirkungen zwischen mikrofluidischen Vorrichtungen und NV-Zentren in der NV-Zentren-Sensorik und/oder der Sensorik mittels paramagnetischer Zentren. Das hier vorgelegte Dokument beschreibt hiermit die Kombination der hier vorgestellten Verfahren und Vorrichtungen auf Basis einer Vielzahl von Kristallen und/oder Diamant-Nano-Kristallen (ND) mit den im Folgenden beispielhaft aufgelisteten Wechselwirkungen:
1. Fluoreszenzdetektion: Paramagnetische Zentren und/oder NV-Zentren können Fluoreszenzstrahlung (FL) emittieren, das als fluoreszentes Signal detektiert werden kann. Mikrofluidische Vorrichtungen können verwendet werden, um Proben mit analytischen Substanzen in der Nähe der NV-Zentren und/oder paramagnetischen Zentren zu platzieren. Wenn die analytischen Substanzen mit den NV-Zentren und/oder den paramagnetischen Zentren wechselwirken, können Änderungen im jeweiligen Fluoreszenzsignal beobachtet werden. Dies ermöglicht die Detektion und Quantifizierung von Analyten und/oder die Detektion von Änderungen physikalischer Parameter in der Umgebung der NV-Zentren und/oder paramagnetischen Zentren.
2. Magnetfeldmessungen: NV-Zentren und/oder paramagnetische Zentren zeigen eine empfindliche Abhängigkeit ihrer optischen Eigenschaften von Magnetfeldern. Mikrofluidische Vorrichtungen können verwendet werden, um Proben mit magnetischen Substanzen in der Nähe der NV-Zentren und/oder paramagnetischen Zentren zu platzieren. Die Wechselwirkung zwischen den magnetischen Substanzen und den NV-Zentren und/oder paramagnetischen Zentren führt zu Änderungen im jeweiligen optischen Fluoreszenzsignal der Intensität (liₛt(t)) der Fluoreszenzstrahlung (FL), die zur Messung von Magnetfeldern genutzt werden können.
3. Oberflächenplasmonenresonanz (SPR): Mikrofluidische Vorrichtungen können speziell gestaltete Oberflächenstrukturen enthalten, die die Wechselwirkung zwischen NV-Zentren und/oder paramagnetischen Zentren einerseits und analytischen Substanzen andererseits verstärken. Durch die Kombination von NV-Zentren und/oder paramagnetischen Zentren mit Oberflächenplasmonenresonanz (SPR) können winzige Änderungen in der optischen Eigenschaft der NV-Zentren und/oder paramagnetischen Zentren detektiert werden, was zu hoher Empfindlichkeit bei der Detektion von Analyten und/oder der Detektion von Änderungen physikalischer Parameter in der Umgebung der NV-Zentren und/oder paramagnetischen Zentren führt.
4. Chemische Reaktionen: Mikrofluidische Vorrichtungen können verwendet werden, um chemische Reaktionen zwischen analytischen Substanzen einerseits und NV-Zentren und/oder paramagnetischen Zentren zu ermöglichen. Durch die präzise Steuerung von Reaktionsbedingungen wie Temperatur, Druck und Flussrate können spezifische chemische Reaktionen initiiert und verfolgt werden. Die resultierenden Veränderungen in den optischen oder magnetischen Eigenschaften der NV-Zentren und/oder paramagnetischen Zentren können Informationen über die analysierten Substanzen und/oder Informationen über physikalische Parametern in der Umgebung der NV-Zentren und/oder paramagnetischen Zentren liefern.

Diese Wechselwirkungen ermöglichen die Anwendung von NV-Zentren und/oder paramagnetischen Zentren in der Sensordiagnostik, der chemischen Analytik, der medizinischen Diagnostik und anderen Bereichen. Die Integration von mikrofluidischen Vorrichtungen erlaubt eine präzise Steuerung der Probenumgebung und eine effiziente Analyse von Analyten durch die Nutzung der einzigartigen optischen und magnetischen Eigenschaften der NV-Zentren und/oder paramagnetischen Zentren.

### Mikromechanik

In der Mikromechanik gibt es verschiedene Funktionselemente, die für die Integration in das Trägersubstrat (1360) in Frage kommen. Hier sind einige Beispiele:
- Mikroaktoren: Mikroaktoren sind mechanische Bauteile, die translatorische und/oder rotatorische Bewegungen oder Verformungen auf mikroskopischer Skala erzeugen können. Sie können beispielsweise in Form von mikroelektromechanischen Systemen (MEMS) realisiert werden und verschiedene Aktionsprinzipien umfassen, wie zum Beispiel elektrostatische, piezoelektrische oder elektromagnetische Aktoren. Mikroaktoren finden Anwendung in Bereichen wie der Optik, der Robotik, der Sensorik oder der Medizintechnik.
- Mikrosensoren: Mikrosensoren dienen zur Erfassung physikalischer Größen wie Druck, Temperatur, Beschleunigung oder chemischer Parameter auf mikroskopischer Skala. Sie können beispielsweise in Form von MEMS-Sensoren realisiert werden und verschiedene Wirkprinzipien umfassen, wie zum Beispiel Kapazitanz, piezoresistive oder optische Sensoren. Mikrosensoren werden in vielen Anwendungen eingesetzt, darunter Automobilelektronik, medizinische Diagnostik, Umweltüberwachung und Industrieautomatisierung.
- Mikrostrukturen: Mikrostrukturen umfassen eine Vielzahl von mikromechanischen Strukturen wie Balken, Federn, Hebel oder Zahnradsysteme. Diese Strukturen können verwendet werden, um mechanische Funktionen zu realisieren, wie zum Beispiel die Kraftübertragung, die Bewegungsumsetzung oder die Energieübertragung. Mikrostrukturen werden in vielen Anwendungen eingesetzt, darunter mechanische Schalter, Mikrogetriebe, Mikroaktuatoren oder Mikropumpen.
- Mikroresonatoren: Mikroresonatoren sind mechanische Strukturen, die Schwingungen mit bestimmten Resonanzfrequenzen erzeugen können. Sie können beispielsweise in Form von Mikrobrücken, Mikroklammern oder Mikro-Biegebalken realisiert werden. Mikroresonatoren finden Anwendung in der Präzisionstechnik, der Frequenznormierung, der Sensorik oder der Schwingungsanalyse.
- Mikrostrukturierungstechniken: Neben den einzelnen Funktionselementen sind auch mikrofabrikationstechnische Verfahren und Techniken Teil der Mikromechanik. Dazu gehören beispielsweise die fotolithographische Strukturierung, die Ätztechnik, die Dünnschichttechnologie oder die Mikrofertigungstechniken. Diese Techniken ermöglichen die präzise Herstellung von mikromechanischen Strukturen und die Integration von Funktionselementen in einen Wafer.

Die Integration dieser Funktionselemente und Techniken in dem Trägersubstrat (1360) ermöglicht die Herstellung von Mikromechanik-basierten Bauteilen und Systemen auf einem Chip.

Die Kombination von mikromechanischen Vorrichtungen, insbesondere, wenn diese ferro- oder permanentmagnetische Vorrichtungsteile umfassen, mit NV-Zentren und/oder paramagnetischen Zentren in der NV-Zentren-Sensorik und/oder der Sensorik paramagnetischer Zentren ermöglicht die Nutzung der einzigartigen Eigenschaften von NV-Zentren und/oder paramagnetischen Zentren für die Detektion und Charakterisierung von analytischen Substanzen und/oder physikalischen Parametern in der Nähe der NV-Zentren und/oder paramagnetischen Zentren. Hier sind einige bekannte Wechselwirkungen zwischen mikromechanischen Vorrichtungen und NV-Zentren und/oder paramagnetischen Zentren in der NV-Zentren-Sensorik und/oder in der Sensorik paramagnetischer Zentren:
1. Oberflächenfunktionalisierung: Mikromechanische Vorrichtungen können mit Oberflächenstrukturen oder Beschichtungen, insbesondere ferromagnetische oder permanentmagnetische Beschichtungen, versehen werden, um NV-Zentren und/oder paramagnetischen Zentren zu immobilisieren oder zu positionieren und/oder magnetische Funktionselemente in die Nähe der NV-Zentren und/oder paramagnetischen Zentren zu bringen. Durch die gezielte Platzierung der NV-Zentren und/oder paramagnetischen Zentren in der Nähe der zu analysierenden Substanzen können spezifische Wechselwirkungen ermöglicht werden, die zu detektierbaren Veränderungen in den optischen oder magnetischen Eigenschaften der NV-Zentren und/oder paramagnetischen Zentren führen.
2. Schwingungsanalyse: Mikromechanische Vorrichtungen können verwendet werden, um die mechanischen Einflüsse auf NV-Zentren und/oder paramagnetische Zentren mittels ferro- und permanentmagnetischen Funktionselementen zu analysieren. Durch die Integration von NV-Zentren und/oder paramagnetischen Zentren in mikromechanische Resonatoren oder Biegebalken und/oder ferro- oder permanentmagnetische Vorrichtungsteile können mechanische Kräfte oder Verformungen erfasst werden, die beispielsweise durch Wechselwirkungen mit analytischen Substanzen und/oder physikalische Parameter wie Druck, Beschleunigung , Rotation, Kraft, Spannung hervorgerufen werden. Diese Veränderungen können beispielsweise als Indikatoren für die Anwesenheit oder Konzentration der analytischen Substanzen und/oder physikalische Parameter dienen.
3. Kraftdetektion: NV-Zentren und/oder paramagnetischen Zentren und/oder die Systeme aus diesen und ferromagnetische oder permanentmagnetische Vorrichtungsteilen können empfindlich auf mechanische Kräfte reagieren, die auf sie ausgeübt werden. Mikromechanische Vorrichtungen können verwendet werden, um die Wechselwirkungskräfte zwischen NV-Zentren und/oder paramagnetischen Zentren einerseits und analytischen Substanzen zu erfassen. Durch die Messung der Änderungen in den optischen oder magnetischen Eigenschaften der NV-Zentren und/oder paramagnetischen Zentren können **Informationen** über die analysierten Substanzen und/oder Informationen über physikalische Parameter in der Umgebung der NV-Zentren und/oder paramagnetischen Zentren und/oder über die ferro- oder permanentmagnetischen Vorrichtungsteile gewonnen werden.
4. Druck- und Spannungsmessung: NV-Zentren und/oder paramagnetischen Zentren können als druck- und spannungsempfindliche Sensoren dienen. Mikromechanische Vorrichtungen können verwendet werden, um Druck- oder Spannungsänderungen in der Umgebung der NV-Zentren und/oder paramagnetischen Zentren zu erzeugen, ggf. in Änderungen von Magnetfeldern zu wandeln und zu messen. Dies ermöglicht die Analyse von mechanischen Eigenschaften von Materialien oder die Detektion von Druck- oder Spannungsänderungen in analytischen Proben oder Materialien.
5. Akustische Detektion: Mikromechanische Vorrichtungen können als akustische Transduktoren fungieren, um Schallwellen zu erzeugen oder zu erfassen. Durch die Integration von NV-Zentren und/oder paramagnetischen Zentren in solche Vorrichtungen können akustische Wechselwirkungen zwischen den NV-Zentren und/oder paramagnetischen Zentren einerseits und den zu analysierenden Substanzen bzw. physikalischer Parameter andererseits beispielsweise mittels magnetischer Vorrichtungsteile erfasst werden. Dies ermöglicht die akustische Detektion und Charakterisierung von Analyten und/oder von physikalischen Parametern in der Umgebung der NV-Zentren und/oder paramagnetischen Zentren.

Diese direkten Wechselwirkungen zwischen mikromechanischen Vorrichtungen und NV-Zentren und/oder paramagnetischen Zentren eröffnen neue Möglichkeiten für die Anwendung von NV-Zentren und/oder paramagnetischen Zentren und indirekte Wechselwirkungen über magnetische ferromagnetische oder permanentmagnetische Vorrichtungsteile in der Sensorik, insbesondere in Bereichen wie der Materialcharakterisierung, der Umweltüberwachung, der medizinischen Diagnostik und der Nanotechnologie. Die genaue Ausgestaltung und Integration dieser Vorrichtungen hängen jedoch von den spezifischen Anwendungen ab.

### Wesentliche Erkenntnis zur Produzierbarkeit

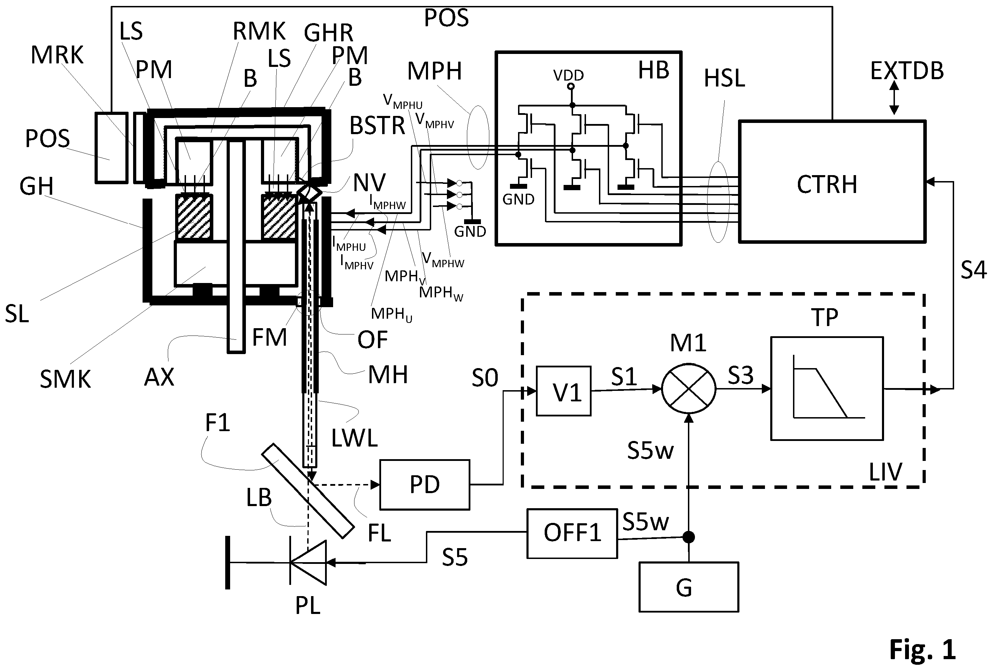

Bei der Ausarbeitung der technischen Lehre des hier vorgelegten Dokuments wurde erkannt, dass zwar die Verwendung vieler Kristalle bzw. Diamant-Nano-Kristalle (ND) zur einer Verschmierung der V-Formationen der Fluoreszenzstrukturen der Einkristalle (siehe Figur 1) führt, dies jedoch nicht für die äußeren Resonanzkanten (522, 525, siehe Figur 51b) gilt. Eine Grundidee ist daher NV-Diamantpulver bzw. Kristallpulver mit paramagnetischen Zentren für die Sensorelemente (SE) anstelle von Einkristallen zu verwenden und die Resonanzkanten auszumessen, um auf die magnetische Flussdichte und/oder die Mikrowellenfrequenz zu schließen. Die äußere V-Formation bleibt nämlich erhalten. (siehe Figur 2)

Je nach unbekannter Mikrowellenfrequenz (ωₙₖ) und magnetischer Flussdichte (Bₑₓₜ) verschiebt sich die Position dieser V-Formation in dem Diagramm der Figur 2. Die unbekannte magnetische Flussdichte (Bₑₓₜ) überlagert sich summierend mit einer von der vorgeschlagenen Vorrichtung erzeugten, bekannten zusätzlichen magnetischen Flussdichte (B_{ad}) zur magnetischen Gesamtflussdichte B_{Σ}, die die vertikale Position der V-Formation in Figur 2 bestimmt. Das Mikrowellensignal (S_{ωnk}) mit unbekannter Mikrowellenfrequenz (ωₙₖ) wird einem Mikrowellensignal mit bekannter Mikrowellenfrequenz zugemischt. Eines der Seitenbänder und das Trägersignal sollten weggefiltert werden. Das nicht weggefilterte Seitenband verschiebt dann die V-Formation in der Figur 2 in der Horizontalen.

Aus der Verschiebung der V-Formation kann dann auf die magnetische Flussdichte Bₑₓₜ und die unbekannte Mikrowellenfrequenz ωₙₖ geschlossen werden. Sofern zwei Mikrowellensignale mit zwei unbekannten Mikrowellenfrequenzen zugemischt werden, verdoppelt sich die V-Formation an zwei unterschiedlichen horizontalen Positionen. Damit kann über eine Kreuzkorrelation zwischen der V-Formation ohne Zumischung und mit den Formationen mit Zumischungen über die Mikrowellenfrequenzen auf das Mikrowellenspektrum der Zumischung geschlossen werden.

Um die unbekannte Mikrowellenfrequenz zu bestimmen, ist besonders vorteilhaft den markantesten Punkt der V-Formation zu bestimmen, da dieser unabhängig von äußeren Einflüssen in seiner Form ist und vorbekannt und vorbestimmbar ist. Dies ist die Spitze (530) der V-Formation (522, 525) Statt der Spitze (530) der V-Formation (522, 525) können selbstverständlich auch funktionsäquivalente Informationen, wie z.B. zwei Punkte auf dem linken Ast der V-Formation und zwei Punkte auf dem rechten Ast der V-Formation verwendet werden. Die Steigungen der Graden durch die zwei Punkte auf dem linken Ast der V-Formation ist vorbekannt. Die Steigungen der Graden durch die zwei Punkte auf dem Rechten Ast der V-Formation ist vorbekannt. Damit kann nach Kenntnis von vier solchen Punkten die Position der Spitze der V-Formation aus den Positionen dieser vier Punkte im Diagramm aus magnetischer Flussdichte und Mikrowellenfrequenz ermittelt werden.

Bei der Ausarbeitung des Vorschlags für die Bestimmung der Position der unteren Spitze der V-Form in der X-Y-Ebene, also der Lage der V-Formation, können verschiedene Verfahren eingesetzt werden. Der folgende Text führt nun sind fünf beispielhafte Verfahren zur Bestimmung des nächsten Messpunkts aus nächstem ersten Messparameter und nächstem zweiten Messparameter auf:
1. Rasterverfahren: Bei diesem Verfahren wird der Messbereich in ein regelmäßiges Raster unterteilt. Die Steuervorrichtung kann systematisch die Messpunkte des Rasters abarbeiten, beginnend von einem Startpunkt. Der nächste Messpunkt wird in vordefinierter Reihenfolge ausgewählt, zum Beispiel durch schrittweise Erhöhung oder Verringerung des ersten und/oder zweiten Messparameters. Dieses Verfahren ermöglicht eine gleichmäßige Abdeckung des Messbereichs, kann jedoch ineffizient sein, wenn die V-Formation nicht regelmäßig ist.
2. Schrittweitenanpassung: Hierbei wird die Schrittweite zur Anpassung der Messparameter basierend auf den bisherigen Messungen verwendet. Die Steuervorrichtung startet mit einem bestimmten Schritt und passt diesen anhand der erfassten Messwerte an. Wenn der Betrag des Gradienten des Messwerts des Sensorelements zunimmt, kann die Schrittweite verringert werden, um eine genauere Bestimmung der Lage der V-Formation zu ermöglichen. Dieses Verfahren erfordert jedoch eine iterative Anpassung und kann je nach Komplexität der V-Formation Zeit in Anspruch nehmen.
3. Gradientenverfahren: Das Gradientenverfahren nutzt den Gradienten des Messwerts des Sensorelements, um die Richtung der maximalen Steigung zu bestimmen. Die Steuervorrichtung kann die Messparameter entlang dieser Richtung anpassen, um den nächsten Messpunkt zu bestimmen. Durch die Berücksichtigung des Gradienten kann das Verfahren schnell zur Spitze der V-Formation führen. Jedoch kann es in Regionen mit flachem Gradienten oder wenn die V-Formation asymmetrisch ist, weniger effektiv sein.
4. Optimierungsalgorithmen: Es können verschiedene Optimierungsalgorithmen wie der Nelder-Mead-Algorithmus oder der Powell-Algorithmus eingesetzt werden, um die Position der V-Formation zu bestimmen. Diese Algorithmen verwenden eine Kombination aus direkter Suche und Gradienteninformation, um den nächsten Messpunkt zu finden. Sie können effizient sein, erfordern jedoch möglicherweise komplexe mathematische Berechnungen und mehr Rechenleistung.
5. Machine-Learning-Methoden: Fortgeschrittene Machine-Learning-Techniken wie neuronale Netzwerke oder genetische Algorithmen können verwendet werden, um die Lage der V-Formation zu bestimmen. Diese Ansätze können aus den bisherigen Messdaten lernen und eine Vorhersage für den nächsten Messpunkt treffen. Dies erfordert jedoch eine umfangreiche Datensammlung und Modelltrainingsphase, bevor das System einsatzbereit ist.

Es ist wichtig zu beachten, dass die Auswahl des am besten geeigneten Verfahrens von verschiedenen Faktoren abhängt, die Genauigkeitsanforderungen, die verfügbaren Ressourcen und der Kontext der Anwendung.

Eine eingehende Analyse und Bewertung dieser Faktoren ermöglichen die Auswahl des am besten geeigneten Verfahrens zur Bestimmung der Position der Spitze der V-Formation in der X-Y-Ebene. Dabei sollten folgende Aspekte berücksichtigt werden:
- Komplexität der V-Formation: Je komplexer die Form der V-Formation ist, - also je mehr Merkmale der Figur 2 und der nachfolgenden Figuren berücksichtigt werden, desto anspruchsvoller kann die Bestimmung der Lage sein. Da die inneren Strukturen der V-Formation der Figur 2 asymmetrisch und nichtlinear sind, können Verfahren wie das Gradientenverfahren oder Machine-Learning-Methoden besonders vorteilhaft sein, um genaue Ergebnisse zu erzielen.
- Genauigkeitsanforderungen: Die erforderliche Präzision beeinflusst die Wahl des Verfahrens. Wenn hohe Genauigkeit erforderlich ist, können Optimierungsalgorithmen oder präzisionsbasierte Schrittweitenanpassungsmethoden eingesetzt werden. Bei weniger strengen Anforderungen kann ein Rasterverfahren oder ein gröberes Schrittweitenanpassungsverfahren ausreichen.
- Verfügbare Ressourcen: Die zur Verfügung stehenden technischen Ressourcen, wie Rechenleistung, Stromverbrauch, funktionale Sicherheit, Speicherplatz oder Messinstrumente, können die Auswahl beeinflussen. Komplexere Verfahren wie Machine-Learning-Methoden erfordern möglicherweise mehr Ressourcen für das Training von Modellen oder die Verarbeitung großer Datenmengen.
- Kontext der Anwendung: Der spezifische Anwendungsbereich und die zugrunde liegenden Rahmenbedingungen spielen ebenfalls eine Rolle. **In** einigen Anwendungen kann eine schnelle, aber grobe Näherung ausreichend sein, während andere Anwendungen eine detaillierte und präzise Bestimmung erfordern.

Die Auswahl des besten Verfahrens zur Bestimmung der Position der Spitze der V-Formation erfordert eine sorgfältige Abwägung dieser Faktoren. Oftmals ist es auch hilfreich, verschiedene Verfahren zu kombinieren oder anzupassen, um optimale Ergebnisse zu erzielen. Es kann empfehlenswert sein, eine Prototypentwicklung oder Simulation durchzuführen, um die Leistung der verschiedenen Verfahren zu evaluieren und die passendste Lösung für die konkrete Situation zu identifizieren

### Bestimmung der Position der V-Formation

Die hier vorgestellte Vorrichtung ermöglicht also die Vermessung eines zweidimensionalen Feldes aus magnetischer Gesamtflussdichte B_{Σ} bzw. der externen magnetischen Flussdichte Bₑₓₜ und Mikrowellenfrequenz ωₙₖ. (siehe auch Figur 51b) Je nach angelegter Mikrowellenfrequenz ωₙₖ und nach magnetischer Gesamtflussdichte B_{Σ} befindet sich die V-Formation aus der unteren Resonanzkante 522 und der oberen Resonanzkante 525 an einer anderen Position im zweidimensionalen Feld der beiden Messparameter Gesamtflussdichte B_{Σ} und Mikrowellenfrequenz ωₙₖ. Die Form der V-Formation aus unterer Resonanzkante 522 und der oberer Resonanzkante 25 bleibt dabei unverändert.

Die typischerweise auftretende Aufgabe ist daher oft, die exakte Lage der V-Formation aus der unteren Resonanzkante 522 und der oberen Resonanzkante 525 und dabei die exakte Position der Spitze 530 dieser V-Formation möglichst präzise und schnell zu bestimmen, um die Werte der Nullpunktsmikrowellenfrequenz ω_{µW0} und der Nullpunktsflussdichte B₀, die die Position 530 der Spitze 530 der V-Formation aus der unteren Resonanzkante 522 und der oberen Resonanzkante 525 kennzeichnen, zu ermitteln und dann auf die jeweils gesuchten Messwerte zu schließen.

Da die Vorrichtung in der Regel nur einige wenige, diskrete Punkte vermessen kann, wendet die Steuervorrichtung der Vorrichtung bevorzugt ein computerimplementiertes Iterationsverfahren an, um die Messwerte schnell zu präzisieren. Im Folgenden führt daher das hier vorgelegte Dokument einige mögliche Verfahren an, die die Steuervorrichtung der Vorrichtung zur Präzisierung der Messpunkte benutzen kann. Wenn im Folgenden von Messparametern und zwar einem ersten Messparameter und einem zweiten Messparameter die Rede ist, so sind damit die beiden Parameter magnetische Flussdichte und Mikrowellenfrequenz gemeint. Mit der X-Y-Ebene ist die Ebene aus diesen beiden Messparametern gemeint. Eine Kernidee ist, dass die Steuervorrichtung fortschrittliche computerimplementierte KI-Methoden anwendet, um auf Basis der vorhergehenden Messergebnisse die nächsten Messpunkte zu bestimmen und so die Präzision mit maximaler Geschwindigkeit zu steigern. Ein Messpunkt (auch Arbeitspunkt des Systems genannt) umfasst dabei typischerweise immer einen bestimmten Wert der magnetischen Flussdichte und einen bestimmten Wert des Mikrowellenfrequenz. Die Anwendung der folgenden KI-Verfahren auf Fluoreszenzbilder wird an dieser Stelle Beispielhaft für alle Bilder von Magnetfeldkameras - also auch die vorbeschriebenen - des hier vorgelegten Dokuments beschrieben.

### Machine Learning

Für die Bestimmung des nächsten Messpunkts aus dem nächsten ersten Messparameter und dem nächsten zweiten Messparameter mittels Machine-Learning-Methoden können verschiedene Ansätze verwendet werden. Hier sind fünf bekannte Machine-Learning-Methoden zur Lösung dieses Problems:
1. Neuronale Netzwerke: Neuronale Netzwerke sind eine leistungsstarke Methode im Bereich des Machine Learnings. Durch das Training eines neuronalen Netzwerks mit geeigneten Eingabe- und Ausgabedaten kann es eine Funktion erlernen, um den nächsten Messpunkt basierend auf den aktuellen Messungen vorherzusagen. Dabei können verschiedene Architekturen wie einfache Feedforward-Netzwerke oder rekurrente neuronale Netzwerke eingesetzt werden.
2. Genetische Algorithmen: Genetische Algorithmen nutzen evolutionäre Prinzipien, um die optimale Lösung zu finden. Durch die Definition geeigneter Fitnessfunktionen und die Anwendung von genetischen Operatoren wie Mutation und Rekombination können genetische Algorithmen den nächsten Messpunkt schrittweise verbessern und anpassen, um die Lage der V-Formation zu bestimmen.
3. Entscheidungsbäume: Entscheidungsbäume sind ein intuitives und interpretierbares Machine-Learning-Modell. Durch das Trainieren eines Entscheidungsbaums mit den vorhandenen Messdaten kann er verwendet werden, um den nächsten Messpunkt basierend auf den aktuellen Messungen auszuwählen. Die Entscheidungsbäume können in enger Verbindung mit anderen Methoden wie dem Random Forest eingesetzt werden, um die Vorhersagegenauigkeit zu verbessern.
4. Support Vector Machines (SVM): SVM ist eine Methode des überwachten Lernens, die bei der Klassifizierung und Regression eingesetzt werden kann. Durch das Training einer SVM mit den vorhandenen Messdaten kann sie verwendet werden, um den nächsten Messpunkt vorherzusagen. SVM kann insbesondere dann nützlich sein, wenn die V-Formation nicht-linear separierbar ist.
5. K-means-Clustering: K-means ist ein Clustering-Algorithmus, der verwendet werden kann, um die V-Formation in verschiedene Cluster zu unterteilen. Durch das Trainieren eines K-means-Modells mit den vorhandenen Messdaten können die Clusterzentren ermittelt werden, und der nächste Messpunkt kann in der Nähe des geeignetsten Clusterzentrums gewählt werden.

Es ist wichtig zu beachten, dass die Wahl der besten Methode von verschiedenen Faktoren abhängt, darunter die verfügbaren Daten, die Anzahl der Messungen, die Genauigkeitsanforderungen und der Kontext der Anwendung. Die Auswahl der richtigen Machine-Learning-Methode erfordert möglicherweise Experimente und Bewertungen der Leistungsfähigkeit verschiedener Ansätze.

### Optimierungsalgorithmen

Für die Bestimmung des nächsten Messpunkts aus dem nächsten ersten Messparameter und dem nächsten zweiten Messparameter können verschiedene Optimierungsalgorithmen verwendet werden. Hier sind fünf beispielhafte Optimierungsalgorithmen, die für dieses Sensorsystem bei einer Nacharbeit relevant sein könnten:
1. Gradientenabstieg: Der Gradientenabstieg ist ein Optimierungsalgorithmus, der versucht, das Minimum einer Funktion zu finden, indem er entlang des negativen Gradienten schrittweise absteigt. **In** diesem Fall könnte der Algorithmus den negativen Gradienten des Betrags des Gradienten des Sensorelementmesswerts nach dem ersten und zweiten Messparameter berechnen und den nächsten Messpunkt basierend auf der Abstiegsrichtung auswählen.
2. Genetische Algorithmen: Genetische Algorithmen können auch für die Optimierung des nächsten Messpunkts verwendet werden. Indem sie eine Population von Kandidatenlösungen verwenden und genetische Operatoren wie Rekombination und Mutation anwenden, können genetische Algorithmen die Lage der V-Formation schrittweise verbessern und den nächsten Messpunkt bestimmen.
3. Partikelschwarmoptimierung (PSO): Bei der Partikelschwarmoptimierung wird eine Gruppe von virtuellen Partikeln verwendet, die sich durch den Suchraum - hier der Ebene aus magnetischer Flussdichte und Mikrowellenfrequenz bewegen. Jedes virtuelle Partikel speichert seine eigene Position und Geschwindigkeit und passt diese anhand des bisher besten Ergebnisses und des global besten Ergebnisses nach der Messung an. Durch die Interaktion und Zusammenarbeit der Partikel kann PSO eine gute Lösung finden, indem es den Suchraum effektiv erkundet.
4. Nelder-Mead-Algorithmus: Der Nelder-Mead-Algorithmus ist ein direkter Optimierungsalgorithmus, der ohne Gradienteninformationen auskommt. Er verwendet ein Simplex, das eine geometrische Struktur im Suchraum darstellt. Der Algorithmus führt Iterationen durch, bei denen er die besten, schlechtesten und mittleren Punkte des Simplex verwendet, um die nächste Position zu bestimmen. Dieser Algorithmus kann effektiv sein, wenn der Suchraum nicht differenzierbar ist.
5. Simulated Annealing: Simulated Annealing ist ein probabilistischer Optimierungsalgorithmus, der von der Metallbearbeitungstechnik "annealing" inspiriert ist. Der Algorithmus simuliert das Erwärmen und langsames Abkühlen eines Metalls, um seine Kristallstruktur zu optimieren. Ähnlich wird beim Simulated Annealing der Suchraum erkundet und gelegentlich schlechtere Lösungen akzeptiert, um aus lokalen Minima zu entkommen und ein globales Minimum zu finden.

Es ist wichtig zu beachten, dass die Auswahl des am besten geeigneten Optimierungsalgorithmus von verschiedenen Faktoren abhängt, darunter die Komplexität der V-Formation und der ggf. berücksichtigten inneren Strukturen der V-Formation, die Anzahl der verfügbaren Messungen, die Genauigkeitsanforderungen und die verfügbaren Ressourcen. Die Wahl des richtigen Optimierungsalgorithmus erfordert möglicherweise Experimente und Evaluierung der Leistungsfähigkeit verschiedener Ansätze.

### Machine-Learning-Methoden ähnlich der Bayes'schen Optimierung

Für die Bestimmung des nächsten Messpunkts aus dem nächsten ersten Messparameter und dem nächsten zweiten Messparameter, um die Lage der V-Formation in der X-Y-Ebene zu bestimmen, könnten verschiedene Machine-Learning-Methoden ähnlich der Bayes'schen Optimierung eingesetzt werden. Hier sind fünf wichtige Methoden, die in diesem Kontext relevant sein könnten:
- Bayes'sche Optimierung: Die Bayes'sche Optimierung ist eine probabilistische Methode zur globalen Optimierung unter Unsicherheit. Sie kombiniert die Modellierung der Zielfunktion mit einer Bayesianischen Wahrscheinlichkeitsschätzung, um eine möglichst effiziente Suche nach dem optimalen Punkt zu ermöglichen. Dabei wird ein probabilistisches Modell erstellt, das die Zusammenhänge zwischen den Eingangsparametern (erster Messparameter und zweiter Messparameter) und den Zielfunktionswerten (Position der V-Formation) erfasst. Aufgrund dieser Modellierung wird eine probabilistische Suche durchgeführt, die die Exploration des Suchraums mit der Ausbeutung bereits bekannter guter Bereiche kombiniert. Die Bayes'sche Optimierung kann daher dazu beitragen, mit möglichst wenigen Iterationen die Lage und die Position der Spitze der V-Formation zu bestimmen.
- Random Forest Regression: Random Forest Regression ist eine Ensemble-Methode, die auf Entscheidungsbäumen basiert. Sie kann verwendet werden, um die Beziehung zwischen den Eingangsparametern (erster Messparameter, zweiter Messparameter) und den Zielfunktionswerten (Position der V-Formation) zu modellieren. Durch den Einsatz mehrerer Entscheidungsbäume, die zufällig erstellt werden und eine Vorhersage treffen, kann ein robustes Modell erstellt werden, das auch nichtlineare Zusammenhänge erfassen kann.
- Gaussian Process Regression: Gaussian Process Regression ist eine nichtparametrische Methode, die die Unsicherheit in den Daten berücksichtigt. Sie verwendet einen Satz von Funktionen, um die Zusammenhänge zwischen den Eingangsparametern und den Zielfunktionswerten zu modellieren. Dabei wird eine Verteilung über mögliche Funktionen erstellt, die zu den beobachteten Daten passen. Diese Methode kann effektiv sein, um die Unsicherheit in den Vorhersagen zu quantifizieren und eine gute Schätzung der Position der V-Formation zu liefern.
- Künstliche Neuronale Netze: Künstliche Neuronale Netze sind eine leistungsstarke Klasse von Machine-Learning-Modellen, die in der Lage sind, komplexe Zusammenhänge zwischen den Eingangsparametern und den Zielfunktionswerten zu modellieren. Durch das Training eines neuronalen Netzes auf den vorhandenen Daten kann eine Funktion erlernt werden, die den nächsten Messpunkt vorhersagt. Künstliche Neuronale Netze können sowohl für Regression als auch für Klassifikation eingesetzt werden und bieten Flexibilität und hohe Kapazität zur Modellierung komplexer Vorgänge.
- Gradientenbasierte Optimierung: Bei der gradientenbasierten Optimierung wird der Gradient der Zielfunktion bezüglich der Eingangsparameter berechnet und zur Bestimmung des nächsten Messpunkts verwendet. Der Gradient zeigt die Richtung des steilsten Anstiegs der Zielfunktion an, was darauf hinweist, in welche Richtung die Parameter angepasst werden müssen, um eine Verbesserung zu erzielen.
- Ein bekannter Algorithmus für die gradientenbasierte Optimierung ist das Gradientenabstiegsverfahren. Es beginnt mit einem initialen Messpunkt und iterativ wird der Gradient an diesem Punkt berechnet. Anschließend wird der nächste Messpunkt entlang des negativen Gradienten gewählt, um die Zielfunktion zu minimieren. Dieser Prozess wird solange wiederholt, bis ein Konvergenzkriterium erfüllt ist oder eine ausreichend gute Lösung gefunden wurde.
- Das Gradientenabstiegsverfahren kann effektiv sein, wenn die Zielfunktion differenzierbar ist und die Parameter einen stetigen Suchraum bilden. Allerdings kann es in komplexen Optimierungsproblemen stecken bleiben, wenn das Verfahren in lokale Minima oder Sattelpunkte gerät. Um diesem Problem entgegenzuwirken, können Techniken wie Momentum, AdaGrad oder Adam angewendet werden, um die Konvergenz zu beschleunigen und lokale Minima zu umgehen.

Es ist zu beachten, dass die Gradientenbasierte Optimierung nicht explizit auf Bayes'sche Optimierung abzielt. Die Bayes'sche Optimierung verwendet probabilistische Modelle, um den Suchraum zu modellieren und eine Balance zwischen Exploration und Ausbeutung zu finden. Im Gegensatz dazu optimiert die gradientenbasierte Methode direkt den Wert der Zielfunktion und betrachtet die Unsicherheit nicht explizit. Beide Ansätze können jedoch in Kombination verwendet werden, indem beispielsweise eine Bayes'sche Optimierung zur globalen Suche und die gradientenbasierte Optimierung zur Feinabstimmung in der Nähe einer Lösung eingesetzt werden.

Der Gradientenbasierten Optimierung wird verwendet, um den nächsten Messpunkt in Richtung des steilsten Anstiegs der Zielfunktion zu bestimmen. Dieser Ansatz erfordert, dass die Zielfunktion differenzierbar ist, um den Gradienten berechnen zu können. Durch die Verwendung des Gradienten kann die Steuervorrichtung des Sensorsystems den nächsten Messpunkt iterativ anpassen, um die V-Formation in der X-Y-Ebene zu lokalisieren.

Um die Suche effizienter zu gestalten, können verschiedene Optimierungsalgorithmen auf der Grundlage des Gradienten eingesetzt werden. Hier sind zwei wichtige Optimierungsalgorithmen:
- Gradientenabstieg: Beim Gradientenabstieg wird der Gradient der Zielfunktion berechnet und entgegengesetzt zur Richtung des steilsten Abstiegs der Zielfunktion verwendet. Der Algorithmus aktualisiert iterativ die Werte der Eingangsparameter (erster Messparameter, zweiter Messparameter), um den nächsten Messpunkt näher an die Spitze der V-Formation zu bringen. Der Gradientenabstieg ist ein einfacher und weit verbreiteter Optimierungsalgorithmus, der jedoch möglicherweise in lokalen Minima stecken bleiben kann.
- Stochastischer Gradientenabstieg: Der stochastische Gradientenabstieg ist eine Variante des Gradientenabstiegs, bei der der Gradient auf Basis einer zufälligen Teilmenge der verfügbaren Datenpunkte berechnet wird. Anstatt den Gradienten über den gesamten Datensatz zu berechnen, wird der stochastische Gradientenabstieg verwendet, um die Berechnung des Gradienten effizienter zu gestalten und die Konvergenz zu beschleunigen. Dieser Algorithmus eignet sich gut für große Datensätze und kann die Anzahl der benötigten Iterationen reduzieren.

Diese Optimierungsalgorithmen können verwendet werden, um den nächsten Messpunkt aus dem nächsten ersten Messparameter und dem nächsten zweiten Messparameter zu bestimmen und somit die Position der V-Formation in der X-Y-Ebene zu bestimmen. Durch die Anwendung von Machine-Learning-Methoden und Optimierungsalgorithmen kann das Sensorsystem die Lage und die Position der V-Formation mit möglichst wenigen Iterationen bestimmen und die Spitze der V-Formation in der X-Y-Ebene genau lokalisieren.

### Random Forest Regression

Das Sensorsystem umfasst in einer Ausprägung eine Steuervorrichtung, die in der Lage ist, den ersten Messparameter innerhalb eines bestimmten Messparameterintervalls einzustellen und auch den zweiten Messparameter innerhalb eines anderen Messparameterintervalls einzustellen. Ein Sensorelement wird verwendet, um einen Sensorelementmesswert für einen eingestellten Messpunkt zu ermitteln. Dabei ist der Messwert abhängig von den Werten des ersten und zweiten Messparameters. Zur präzisen Bestimmung des nächsten Messpunkts mit möglichst wenigen Iterationen wird ein computerimplementiertes Verfahren der Random Forest Regression angewendet.

In einer Ausprägung des Vorschlags wird das computerimplementierte Verfahren der Random Forest Regression genutzt, um die Lage der Spitze der V-Formation oder einer funktionsäquivalenten Information in der X-Y-Ebene zu bestimmen. Hierbei werden der erste Messparameter als X-Koordinate und der zweite Messparameter als Y-Koordinate verwendet. Dies ermöglicht eine effiziente Positionsermittlung der V-Formation.

Darüber hinaus hält die Steuervorrichtung die bestimmte Position der unteren Spitze der V-Formation für die Verwendung durch ein übergeordnetes System bereit. Dies gewährleistet, dass die ermittelten Daten von anderen Systemen genutzt werden können.

Das Sensorsystem kombiniert das computerimplementierte Verfahren der Random Forest Regression mit dem Sensorelement und der Steuervorrichtung, um die Position der unteren Spitze der V-Formation basierend auf den Messparametern zu bestimmen und für die Verwendung durch ein übergeordnetes System bereitzuhalten. Dabei ist das computerimplementierte Verfahren der Random Forest Regression auf einem speicherbasierten Medium gespeichert und wird von einem Prozessor der Steuervorrichtung ausgeführt. Das speicherbasierte Medium kann beispielsweise ein Computerprogrammprodukt, eine Festplatte, ein Flash-Speicher oder ein anderes nichtflüchtiges Speichermedium sein. Durch diese Implementierung wird eine effiziente und zuverlässige Bestimmung der Position der V-Formation ermöglicht.

Die Steuervorrichtung des Sensorsystems umfasst einen Prozessor und einen Speicher. Der Speicher enthält den Code für das computerimplementierte Verfahren der Random Forest Regression, während der Prozessor den Code aus dem Speicher abruft und ausführt. Dies stellt sicher, dass das Verfahren korrekt und effizient ausgeführt wird.

In einer Variante des Vorschlags kann das Sensorsystem eine Kommunikationsschnittstelle umfassen, die eine Datenübertragung zwischen dem Sensorsystem und anderen Systemen ermöglicht. Dadurch können die ermittelten Positionsdaten der V-Formation einfach an andere Systeme weitergegeben und zur weiteren Verarbeitung genutzt werden.

Des Weiteren kann das Sensorsystem mit einem Datenbanksystem verbunden sein, in dem die ermittelten Positionsinformationen der V-Formation gespeichert werden. Dies ermöglicht eine einfache und strukturierte Verwaltung der Positionsdaten für zukünftige Analysen oder Auswertungen.

Ein weiterer Vorteil des Sensorsystems besteht darin, dass das computerimplementierte Verfahren der Random Forest Regression flexibel anpassbar ist. Durch das Hinzufügen oder Entfernen von Trainingsdaten kann das Verfahren verbessert und an verschiedene Einsatzszenarien angepasst werden. Dies ermöglicht eine optimale Leistung des Sensorsystems in verschiedenen Anwendungsbereichen und Umgebungen.

Ein weiterer Vorteil des Sensorsystems liegt in seiner Skalierbarkeit. Durch die Verwendung von Speichermedien wie RAM oder NVM kann das Sensorsystem problemlos an die Anforderungen der jeweiligen Anwendung angepasst werden. Dadurch wird eine effiziente und zuverlässige Verarbeitung großer Datenmengen ermöglicht.

Darüber hinaus bietet das Sensorsystem eine hohe Genauigkeit und Präzision bei der Bestimmung der Position der V-Formation. Durch die Kombination des Sensorelements mit dem computerimplementierten Verfahren der Random Forest Regression werden mögliche Messfehler minimiert und die Messgenauigkeit maximiert. Ein weiterer wichtiger Aspekt des Sensorsystems ist seine Robustheit und Zuverlässigkeit. Durch die Verwendung moderner Technologien und qualitativ hochwertiger Materialien gewährleistet das Sensorsystem eine langfristige und stabile Leistung auch unter anspruchsvollen Bedingungen.

Zusammenfassend bietet das Sensorsystem mit der Steuervorrichtung, dem Sensorelement und dem computerimplementierten Verfahren der Random Forest Regression eine effiziente, präzise und zuverlässige Lösung zur Bestimmung der Position einer V-Formation. Die Flexibilität, Skalierbarkeit und hohe Genauigkeit des Systems machen es ideal für verschiedene Anwendungen in Bereichen wie der Luftfahrt, Logistik oder auch dem Tierverhalten. Durch die Nutzung von modernen Technologien und Materialien setzt das Sensorsystem neue Maßstäbe in der Positionsbestimmung und ermöglicht innovative Lösungen für die Herausforderungen unserer Zeit.

### Gaussian Process Regression

**In** einer weiteren Ausgestaltung des Sensorsystems umfasst das Sensorsystem eine Steuervorrichtung zur Einstellung eines ersten Messparameters innerhalb eines ersten Messparameterintervalls und eines zweiten Messparameters innerhalb eines zweiten Messparameterintervalls. Ein Sensorelement ermittelt einen Sensorelementmesswert abhängig von den eingestellten Messparametern für einen bestimmten Messpunkt. Das Sensorsystem verwendet ein computerimplementiertes Verfahren der Gaussian Process Regression, das von der Steuervorrichtung angewendet wird, um den nächsten Messpunkt basierend auf dem nächsten ersten Messparameter und dem nächsten zweiten Messparameter mit möglichst wenigen Iterationen zu bestimmen. **In** einer Ausprägung des Sensorsystems wird das computerimplementierte Verfahren der Gaussian Process Regression eingesetzt, um die Lage der V-Formation in der X-Y-Ebene aus dem ersten Messparameter als X-Koordinate und dem zweiten Messparameter als Y-Koordinate zu bestimmen. Durch die präzise Bestimmung der Lage der Spitze (30) der V-Formation ermöglicht das Sensorsystem eine genaue Positionierung.

**In** einer weiteren Ausprägung wird das Sensorsystem verwendet, um die Position der Spitze (30) der V-Formation in der X-Y-Ebene aus dem ersten Messparameter als X-Koordinate und dem zweiten Messparameter als Y-Koordinate zu bestimmen. Dies ermöglicht die genaue Erfassung und Bereitstellung der Spitzenposition, die von einem übergeordneten System genutzt werden kann, um optimale Koordination und Steuerung von Prozessen zu ermöglichen, bei denen die Position der V-Formation, insbesondere der Spitze (30) der V-Formation, und/oder der Wert einer daraus abgeleiteten Informationen und/oder der Wert einer funktionsäquivalente Informationen von Bedeutung ist.

Das computerimplementierte Verfahren der Gaussian Process Regression in Verbindung mit dem Sensorelement und der Steuervorrichtung ermöglicht eine präzise und effiziente Bestimmung der Position der unteren Spitze der V-Formation basierend auf den Messparametern. Dies wird erreicht, indem das Verfahren Schritte zur Optimierung der nächsten Messpunkte basierend auf der Unsicherheit der Vorhersagen verwendet und adaptiv die Verteilung der Messpunkte anpasst, um die Lage der V-Formation effizienter zu bestimmen. Ein weiterer Vorteil des Sensorsystems besteht darin, dass das computerimplementierte Verfahren der Gaussian Process Regression auf einem speicherbasierten Medium gespeichert ist und von einem Prozessor der Steuervorrichtung ausgeführt wird. Das speicherbasierte Medium kann beispielsweise ein Computerprogrammprodukt, eine Festplatte, ein Flash-Speicher oder ein anderes nichtflüchtiges Speichermedium (NVM) sein. Dadurch wird die Flexibilität und Skalierbarkeit des Systems erhöht.

**In** einer Variante des Vorschlags umfasst die Steuervorrichtung des Sensorsystems einen Prozessor und einen Speicher, wobei der Speicher den Code für das computerimplementierte Verfahren der Gaussian Process Regression enthält und der Prozessor den Code aus dem Speicher abruft und ausführt. Dadurch wird eine effiziente Ausführung des Verfahrens gewährleistet und ermöglicht eine schnelle und präzise Bestimmung der Position der V-Formation, insbesondere der Spitze (30) der V-Formation, und/oder einer daraus abgeleiteten Informationen und/oder einer funktionsäquivalenten Informationen.

Es ist zu beachten, dass die vorliegende Beschreibung zusätzliche Erläuterungen der Funktionsweise des Sensorsystems und des computerimplementierten Verfahrens der Gaussian Process Regression bietet. Durch die Anwendung der Gaussian Process Regression werden die nächsten Messpunkte basierend auf den nächsten ersten und zweiten Messparametern bestimmt. Dabei werden möglichst wenige Iterationen benötigt, um eine hohe Genauigkeit und Effizienz zu gewährleisten.

Die Verwendung der Gaussian Process Regression ermöglicht die präzise Bestimmung der Lage der V-Formation in der X-Y-Ebene durch die Nutzung des ersten Messparameters als X-Koordinate und des zweiten Messparameters als Y-Koordinate. Durch die effiziente Positionserfassung der V-Formation, insbesondere der Spitze (30) der V-Formation, und/oder einer daraus abgeleiteten Informationen und/oder einer funktionsäquivalenten Informationen kann das Sensorsystem in verschiedenen Anwendungen eingesetzt werden.

Die Steuervorrichtung des Sensorsystems speichert den bestimmten Positionswert der V-Formation, insbesondere der Spitze (30) der V-Formation, und/oder einer daraus abgeleiteten Informationen und/oder einer funktionsäquivalenten Informationen für die Verwendung durch ein übergeordnetes System. Dies ermöglicht eine nahtlose Integration des Sensorsystems in ein umfassendes System und bietet eine zuverlässige Informationsgrundlage für übergeordnete Prozesse.

Durch die Kombination des computerimplementierten Verfahrens der Gaussian Process Regression mit dem Sensorelement und der Steuervorrichtung werden die Messparameter verwendet, um die Position der V-Formation, insbesondere der Spitze (30) der V-Formation, und/oder eine daraus abgeleitete Informationen und/oder eine funktionsäquivalente Informationen n genau zu bestimmen und für die Verwendung durch ein übergeordnetes System bereitzuhalten. Diese Integration ermöglicht eine präzise Steuerung und optimale Nutzung der V-Formation in verschiedenen Anwendungen.

Zusammenfassend bietet das Sensorsystem mit dem computerimplementierten Verfahren der Gaussian Process Regression eine effiziente und präzise Methode zur Bestimmung der Position der V-Formation. Die Verwendung eines speicherbasierten Mediums, das den Code für das Verfahren enthält, und die Einbindung eines Prozessors ermöglichen eine optimale Ausführung des Verfahrens. Dadurch werden genaue Positionsergebnisse erzielt und eine zuverlässige Grundlage für übergeordnete Systeme bereitgestellt.

### künstliche neuronale Netzwerkmodelle

In einer weiteren Ausgestaltung des Sensorsystems umfasst die Steuervorrichtung eine Prozessoreinheit (Steuervorrichtung CTR) und ein Speichermedium (RAM, NVM), wobei der Speichermedium (RAM, NVM) vorzugsweise den Code für das computerimplementierte Verfahren unter Anwendung künstlicher neuronaler Netzwerkmodelle enthält und die Prozessoreinheit den Code aus dem Speichermedium abruft und ausführt. Dadurch wird eine effiziente Ausführung des Verfahrens gewährleistet und ermöglicht eine schnelle und präzise Bestimmung der Lage der Spitze 30 der V-Formation oder einer funktionsäquivalenten Information.

In einer Variante des Vorschlags wird das computerimplementierte Verfahren unter Anwendung künstlicher neuronaler Netzwerkmodelle verwendet, um die Lage der V-Formation in der X-Y-Ebene basierend auf dem ersten Messparameter als X-Koordinate und dem zweiten Messparameter als Y-Koordinate zu bestimmen. Durch die Anwendung dieses Verfahrens mit möglichst wenigen Iterationen wird eine hohe Genauigkeit und Effizienz bei der Positionserfassung erreicht.

Die Steuervorrichtung des Sensorsystems hält die bestimmte Position der V-Formation, insbesondere der Spitze (30) der V-Formation, und/oder eine daraus abgeleitete Information und/oder eine funktionsäquivalente Information für die Verwendung durch ein übergeordnetes System bereit. Dadurch wird eine nahtlose Integration des Sensorsystems in ein umfassendes System ermöglicht und eine zuverlässige Informationsgrundlage für übergeordnete Prozesse geschaffen.

Das computerimplementierte Verfahren unter Anwendung künstlicher neuronaler Netzwerkmodelle ist vorzugsweise auf einem speicherbasierten Medium gespeichert, wie beispielsweise einem RAM (Random Access Memory) oder einem NVM (Non-Volatile Memory), und wird von der Prozessoreinheit der Steuervorrichtung ausgeführt. Diese Speicherung und Ausführung ermöglichen eine optimale Nutzung und Skalierbarkeit des Verfahrens.

Das Sensorsystem bietet somit eine effiziente und präzise Methode zur Bestimmung der Lage der Spitze 30 der V-Formation oder einer funktionsäquivalenten Information. Durch die Verwendung künstlicher neuronaler Netzwerkmodelle in Kombination mit dem Sensorelement und der Steuervorrichtung werden die Messparameter verwendet, um die Position präzise zu bestimmen und für die Verwendung durch ein übergeordnetes System bereitzuhalten. Dies ermöglicht eine präzise Steuerung und optimale Nutzung der V-Formation in verschiedenen Anwendungen.

Weiterhin ist das Sensorsystem flexibel und vielseitig einsetzbar, da es verschiedene Arten von speicherbasierten Medien unterstützt, wie beispielsweise Computerprogrammprodukte, Festplatten, Flash-Speicher oder andere nichtflüchtige Speichermedien. Dadurch kann das Sensorsystem an die spezifischen Anforderungen und Gegebenheiten der jeweiligen Anwendung angepasst werden.

### Gradientenbasierte Optimierung

In einer weiteren Ausgestaltung des Sensorsystems wird ein computerimplementiertes Verfahren der gradientenbasierten Optimierung angewendet, um die genaue Position der Spitze 30 der V-Formation oder einer funktionsäquivalenten Position in der X-Y-Ebene zu bestimmen. Das Verfahren nutzt die Steuervorrichtung, um den nächsten Messpunkt basierend auf den ersten und zweiten Messparametern mit möglichst wenigen Iterationen zu ermitteln.

Das Sensorsystem ermöglicht eine präzise Bestimmung der Position der Spitze 30 der V-Formation oder einer funktionsäquivalenten Position durch die Verwendung des computerimplementierten Verfahrens der gradientenbasierten Optimierung. Die Steuervorrichtung stellt sicher, dass der erste und zweite Messparameter innerhalb ihrer jeweiligen Intervalle eingestellt werden, um genaue Messwerte zu erzielen. Durch die Anwendung des Verfahrens der gradientenbasierten Optimierung werden die nächsten Messpunkte mit hoher Effizienz und Genauigkeit bestimmt, wodurch eine präzise Positionserfassung ermöglicht wird.

Die Kombination aus dem Sensorelement und der Steuervorrichtung ermöglicht die genaue Bestimmung der Position der Spitze 30 der V-Formation und/oder einer funktionsäquivalenten Position. Das Sensorsystem kann die Positionsinformationen für eine Vielzahl von Anwendungen bereitstellen, wie beispielsweise in der Luftfahrt, Robotik, Logistik und Landwirtschaft.

Die Verwendung des computerimplementierten Verfahrens der gradientenbasierten Optimierung bietet zahlreiche Vorteile. Durch die Nutzung des Gradienten des Sensorelementmesswerts nach den Messparametern können genaue und effiziente Messpunkte ermittelt werden. Das Verfahren ermöglicht zudem adaptive Schritte, um die Schrittweite oder das Schrittverfahren anzupassen, was zu einer verbesserten Anpassungsfähigkeit führt. Zusätzlich können weitere Optimierungstechniken wie konjugierte Gradienten oder L-BFGS eingesetzt werden, um eine noch effizientere und genauere Bestimmung der Positionen zu erreichen. Das Sensorsystem umfasst vorzugsweise die Steuervorrichtung umfasst einen Prozessor und einen nichtflüchtigen Speicher, der den Code für das computerimplementierte Verfahren der gradientenbasierten Optimierung enthält. Dadurch kann der Prozessor den Code abrufen und ausführen, um die Bestimmung der Positionen der V-Formation, insbesondere der Spitze (30) der V-Formation, und/oder daraus abgeleiteter Informationen und/oder funktionsäquivalenter Informationen zu ermöglichen. Die Verwendung eines nichtflüchtigen Speichermediums gewährleistet, dass der Code dauerhaft gespeichert und jederzeit abgerufen werden kann.

Die Benutzerschnittstelle des Sensorsystems ermöglicht es dem Benutzer, die Einstellungen der Messparameterintervalle anzupassen und die Ergebnisse der Positionserfassung abzurufen. Dadurch wird eine benutzerfreundliche Anpassung an unterschiedliche Anforderungen und Anwendungsszenarien ermöglicht. Das Sensorsystem ist in der Lage, die Position der Spitze 30 der V-Formation oder einer funktionsäquivalenten Position in Echtzeit zu bestimmen und die Ergebnisse an ein übergeordnetes System zu übermitteln. Dies ermöglicht eine Echtzeitüberwachung und -verarbeitung der Positionsdaten für eine schnelle Reaktion und Entscheidungsfindung.

Zusätzlich zur Beschreibung des Sensorsystems umfasst die Patentanmeldung auch weitere Ansprüche. **In** einer Variante des Vorschlags kann eine computerimplementierte Vorrichtung zur Durchführung des Verfahrens bereitgestellt werden. Diese Vorrichtung umfasst einen Prozessor (Steuervorrichtung CTR) und einen Speicher (RAM, NVM), der den Code für das computerimplementierte Verfahren enthält und vom Prozessor (Steuervorrichtung CTR) abgerufen und ausgeführt wird.

Ein weiteres Speichermedium (RAM, NVM) kann verwendet werden, um den Code für das computerimplementierte Verfahren zu speichern. Dieses Speichermedium (RAM, NVM) wird in Verbindung mit der Steuervorrichtung des Sensorsystems verwendet.

Eine Benutzerschnittstelle ermöglicht die Einstellung der Messparameterintervalle und den Abruf der Ergebnisse der Positionserfassung. Dadurch wird dem Benutzer eine einfache Interaktion mit dem Sensorsystem ermöglicht.

Das übergeordnete System kommuniziert mit dem Sensorsystem und empfängt die Positionsergebnisse. Diese Ergebnisse können für weitere Verarbeitung oder Anzeige verwendet werden, um beispielsweise ein koordiniertes Verhalten von mehreren Sensorsystemen zu ermöglichen. Durch den Austausch von Positionsdaten zwischen den einzelnen Sensorsystemen können sie gemeinsam an einer Aufgabe arbeiten, wie zum Beispiel der Überwachung eines großen Gebiets oder der Durchführung kooperativer Prozesse und Verfahren.

Darüber hinaus bietet das Sensorsystem die Möglichkeit zur Integration mit anderen Systemen oder Plattformen. Zum Beispiel könnte es in ein Flugzeug oder eine Drohne integriert werden, um eine präzise Positionsbestimmung während des Fluges durch Nutzung des Erdmagnetfeldes zu ermöglichen. Es könnte auch in autonome Fahrzeuge integriert werden, um deren Navigation zu verbessern und Kollisionen zu vermeiden. Das Sensorsystem könnte auch in der Landwirtschaft eingesetzt werden, um die Position von landwirtschaftlichen Geräten oder Fahrzeugen zu bestimmen und sie bei der Ausführung von Aufgaben wie dem Pflügen, Säen oder Ernten zu unterstützen. Die präzise Positionsbestimmung kann dazu beitragen, die Effizienz und Genauigkeit landwirtschaftlicher Prozesse zu verbessern.

Des Weiteren könnte das Sensorsystem in der Robotik verwendet werden, um die Position von Robotern in einer Produktionsumgebung oder in anderen Anwendungen zu erfassen. Dadurch können Roboter präzise Aufgaben ausführen, Kollisionen vermeiden und effizient mit anderen Robotern oder menschlichen Arbeitskräften zusammenarbeiten.

Insgesamt ermöglicht das beschriebene Sensorsystem mit seinem computerimplementierten Verfahren der gradientenbasierten Optimierung eine präzise und effiziente Positionsbestimmung der V-Formation, insbesondere der Spitze (30) der V-Formation, und/oder daraus abgeleiteter Informationen und/oder funktionsäquivalenter Informationen. Durch die Integration in verschiedene Systeme und Anwendungen eröffnet es vielfältige Möglichkeiten zur Verbesserung von Prozessen, Sicherheit und Koordination.

### Gradientenabstieg

In einer weiteren Ausgestaltung des Sensorsystems kommuniziert das übergeordnete System mit dem Sensorsystem und empfängt die Positionsergebnisse. Diese Ergebnisse, die die Position der unteren Spitze 30 der V-Formation in der X-Y-Ebene oder einer funktionsäquivalenten Information repräsentieren, können für weitere Verarbeitung oder Anzeige verwendet werden, um beispielsweise ein koordiniertes Verhalten von mehreren Sensorsystemen zu ermöglichen.

Das Sensorsystem nutzt ein computerimplementiertes Verfahren des Gradientenabstiegs, um mit möglichst wenigen Iterationen die Position der unteren Spitze 30 der V-Formation in der X-Y-Ebene oder einer funktionsäquivalenten Information aus erstem Messparameter als X-Koordinate und zweitem Messparameter als Y-Koordinate zu bestimmen. Das Verfahren des Gradientenabstiegs ermöglicht eine effiziente und genaue Positionsbestimmung, indem es adaptive Schritte zur Anpassung der Schrittweite oder des Schrittverfahrens verwendet. Dadurch kann der nächste Messpunkt präzise ermittelt werden.

Um die Genauigkeit und Effizienz weiter zu verbessern, können dem computerimplementierten Verfahren des Gradientenabstiegs auch weitere Optimierungstechniken wie konjugierte Gradienten oder L-BFGS (Limitedmemory Broyden-Fletcher-Goldfarb-Shanno) hinzugefügt werden. Diese Techniken tragen dazu bei, die Position der unteren Spitze 30 der V-Formation in der X-Y-Ebene oder einer funktionsäquivalenten Information noch genauer zu bestimmen.

Um die Benutzerfreundlichkeit zu erhöhen, verfügt die Steuervorrichtung über eine Benutzerschnittstelle, die es dem Benutzer ermöglicht, Einstellungen wie das erste Messparameterintervall und das zweite Messparameterintervall anzupassen. Darüber hinaus können die Ergebnisse der Positionsbestimmung über die Benutzerschnittstelle abgerufen werden.

Das Sensorsystem ist in der Lage, die Position der unteren Spitze 30 der V-Formation in der X-Y-Ebene oder einer funktionsäquivalenten Information in Echtzeit zu bestimmen und die Ergebnisse an das übergeordnete System in Echtzeit zu übermitteln. Dadurch wird eine Echtzeitüberwachung und -steuerung ermöglicht.

Zur Implementierung des beschriebenen Verfahrens ist eine computerimplementierte Vorrichtung vorgesehen, die einen Prozessor und einen Speicher umfasst. Der Speicher enthält den Code für das computerimplementierte Verfahren des Gradientenabstiegs, während der Prozessor den Code aus dem Speicher abruft und ausführt.

Zusätzlich ist vorzugsweise ein nichtflüchtiges Speichermedium (NVM) vorgesehen, das den Code für das computerimplementierte Verfahren des Gradientenabstiegs speichert und in Verbindung mit der Steuervorrichtung des Sensorsystems verwendet wird. Dadurch kann das Verfahren auch auf andere Systeme oder Plattformen übertragen und dort genutzt werden

Die Benutzerschnittstelle ermöglicht es dem Benutzer, die Messparameterintervalle anzupassen und die Ergebnisse der Positionsbestimmung abzurufen. Dies erhöht die Flexibilität und Anpassungsfähigkeit des Sensorsystems. Der Benutzer kann die Messparameterintervalle je nach den spezifischen Anforderungen und Umgebungsbedingungen anpassen, um optimale Ergebnisse zu erzielen. Der Benutzer kann eine Vorrichtung sein.

Darüber hinaus ermöglicht die Benutzerschnittstelle dem Benutzer einen bequemen Zugriff auf die ermittelten Positionsdaten der V-Formation, insbesondere der Spitze (30) der V-Formation, und/oder daraus abgeleiteter Informationen und/oder funktionsäquivalenter Informationen. Diese Informationen können für verschiedene Zwecke genutzt werden, beispielsweise zur Überwachung und Analyse der V-Formation oder zur Integration in ein übergeordnetes System.

Die Verwendung des computerimplementierten Verfahrens des Gradientenabstiegs in Verbindung mit adaptiven Schritten und weiteren Optimierungstechniken gewährleistet eine effiziente und genaue Positionsbestimmung der V-Formation, insbesondere der Spitze (30) der V-Formation, und/oder daraus abgeleiteter Informationen und/oder funktionsäquivalenter Informationen. Durch die Anpassung der Schrittweite oder des Schrittverfahrens kann das Sensorsystem die Position mit hoher Präzision bestimmen und gleichzeitig den Berechnungsaufwand minimieren.

Die Echtzeitfähigkeit des Sensorsystems ermöglicht eine schnelle und kontinuierliche Erfassung der Positionsdaten der V-Formation, insbesondere der Spitze (30) der V-Formation, und/oder daraus abgeleiteter Informationen und/oder funktionsäquivalenter Informationen. Dies ist besonders wichtig in Anwendungen, in denen Echtzeitinformationen erforderlich sind, um beispielsweise eine reibungslose Navigation oder Koordination mehrerer Sensorsysteme zu gewährleisten.

Die Implementierung des computerimplementierten Verfahrens des Gradientenabstiegs in einer computerimplementierten Vorrichtung mit Prozessor (Steuervorrichtung CTR) und Speicher (RAM, NVM) bietet eine effiziente und flexible Lösung. Der Code für das Verfahren kann auf dem Speichermedium als Speicher (RAM, NVM) gespeichert und bei Bedarf vom Prozessor abgerufen und ausgeführt werden. Dadurch wird eine einfache Integration des Sensorsystems in bestehende Systeme oder Plattformen ermöglicht.

Das nichtflüchtige Speichermedium (NVM) dient als zuverlässige und dauerhafte Aufbewahrung des Codes für das Verfahren. Dadurch kann das Sensorsystem auch nach einem Neustart oder einem Stromausfall seine Funktionalität beibehalten und nahtlos wieder aufgenommen werden.

Insgesamt ermöglicht das Sensorsystem mit dem computerimplementierten Verfahren des Gradientenabstiegs eine präzise, effiziente und Echtzeit-Positionsbestimmung der unteren Spitze 30 der V-Formation oder einer funktionsäquivalenten Information. Die Benutzerschnittstelle, die Anpassungsmöglichkeiten und die Integration in bestehende Systeme tragen zur Vielseitigkeit und Anwendbarkeit des Sensorsystems bei. Durch die Verbesserung der Positionsbestimmung der V-Formation, insbesondere der Spitze (30) der V-Formation, und/oder daraus abgeleiteter Informationen und/oder funktionsäquivalenter Informationen in verschiedenen Anwendungsbereichen kann das Sensorsystem zu einer optimierten Leistung und Effizienz beitragen.

### stochastischer Gradientenabstieg

**In** einer weiteren Ausgestaltung des Sensorsystems wird ein computerimplementiertes Verfahren des stochastischen Gradientenabstiegs eingesetzt, um den nächsten Messpunkt aus dem nächsten ersten und zweiten Messparameter zu bestimmen. Dadurch wird die Lage der Spitze 30 der V-Formation oder eine funktionsäquivalenten Information in der X-Y-Ebene mit möglichst wenigen Iterationen ermittelt. Das Verfahren nutzt den ersten Messparameter als X-Koordinate und den zweiten Messparameter als Y-Koordinate. Die Steuervorrichtung des Sensorsystems wendet adaptive Schritte an, um die Schrittweite oder das Schrittverfahren anzupassen, was eine effiziente und genaue Positionsbestimmung ermöglicht.

Die Verwendung des stochastischen Gradientenabstiegs in Verbindung mit adaptiven Schritten ermöglicht es dem Sensorsystem, präzise Messpunkte zu bestimmen und die Position der Spitze 30 der V-Formation oder eine funktionsäquivalenten Information genau zu erfassen. Durch die Anpassung der Schrittweite oder des Schrittverfahrens kann das Sensorsystem die Position mit hoher Präzision bestimmen und gleichzeitig den Berechnungsaufwand minimieren.

Die Verwendung von weiteren Optimierungstechniken wie Momentum oder Nesterov Momentum verbessert die Effizienz des stochastischen Gradientenabstiegs und trägt zu einer genaueren Positionsbestimmung bei. Diese Techniken ermöglichen es dem Sensorsystem, schneller konvergierende Lösungen zu finden und potenzielle lokale Minima zu überwinden.

Die Steuervorrichtung des Sensorsystems ist mit einer Benutzerschnittstelle ausgestattet, die es dem Benutze, der auch eine Vorrichtung sein kann, r ermöglicht, das Messparameterintervall anzupassen und die Ergebnisse der Positionsbestimmung der V-Formation, insbesondere der Spitze (30) der V-Formation, und/oder daraus abgeleiteter Informationen und/oder funktionsäquivalenter Informationen abzurufen. Die Benutzerschnittstelle bietet interaktive Einstellungsmöglichkeiten, z. B. Schieberegler oder Eingabefelder, um das Messparameterintervall anzupassen. Darüber hinaus wird sie vorzugsweise der beabsichtigten Benutzung durch menschliche Benutzer so ausgelegt, dass sie eine grafische Benutzeroberfläche bereitstellt, die die Position der Spitze 30 der V-Formation oder die funktionsäquivalente Information auf einem Diagramm in der X-Y-Ebene visuell darstellt und die numerischen Koordinaten anzeigt.

Durch die Verwendung des computerimplementierten Verfahrens des stochastischen Gradientenabstiegs in Verbindung mit adaptiven Schritten und weiteren Optimierungstechniken gewährleistet das Sensorsystem eine effiziente und genaue Positionsbestimmung der V-Formation und/oder einer funktionsäquivalenten Information. Die Benutzerschnittstelle ermöglicht eine einfache Anpassung der Messparameterintervalle und den bequemen Zugriff auf die Ergebnisse. Diese Funktionen tragen zur Flexibilität und Anpassungsfähigkeit des Sensorsystems bei.

Das Sensorsystem kann die Position der Spitze 30 der V-Formation oder eine funktionsäquivalente Information in Echtzeit bestimmen und die Ergebnisse in Echtzeit an ein übergeordnetes System übermitteln. Dies ermöglicht eine schnelle und kontinuierliche Erfassung der Positionsdaten und ist besonders wichtig in Anwendungen, in denen Echtzeitinformationen erforderlich sind, beispielsweise für eine präzise Navigation oder die Koordination mehrerer Sensorsysteme.

### Gradientenbasierte Optimierung

**In** einer weiteren Ausgestaltung des Sensorsystems wird eine Steuervorrichtung bereitgestellt, die in der Lage ist, einen ersten Messparameter innerhalb eines ersten Messparmeterintervalls einzustellen und einen zweiten Messparameter innerhalb eines zweiten Messparameterintervalls einzustellen. Ein Sensorelement ist ebenfalls vorhanden, das abhängig von den eingestellten Messparametern einen Sensorelementmesswert liefert. Die Steuervorrichtung wendet ein computerimplementiertes Verfahren der gradientenbasierten Optimierung an, um den nächsten Messpunkt basierend auf den nächsten Messparametern zu bestimmen. Des Weiteren umfasst das Sensorsystem ein System zur Bestimmung der Position der Spitze einer V-Formation in der X-Y-Ebene oder einer funktionsäquivalenten Information, wobei die Position durch die X-Koordinate des ersten Messparameters und die Y-Koordinate des zweiten Messparameters definiert ist. Eine Speichervorrichtung dient dazu, die bestimmte Position der V-Formation oder der funktionsäquivalenten Information für die Verwendung durch ein übergeordnetes System bereitzuhalten. Zudem gibt es eine Benutzerschnittstelle, die es ermöglicht, die Messparameterintervalle einzustellen und die Ergebnisse der Position der V-Formation oder der funktionsäquivalenten Information abzurufen. Dabei kann eine Vorrichtung ein benutzer sein.

In einer Variante des Vorschlags kann eine Vorrichtung zur Durchführung des Verfahrens gemäß dem vorausgehenden Abschnitt bereitgestellt werden. Diese Vorrichtung umfasst einen Prozessor (Steuervorrichtung CTR) zur Ausführung des computerimplementierten Verfahrens der gradientenbasierten Optimierung und zur Steuerung des Sensorsystems. Des Weiteren ist ein Speicher vorhanden, der den Code für das computerimplementierte Verfahren und die erforderlichen Daten speichert. Ein nichtflüchtiges Speichermedium wird in Verbindung mit der Steuervorrichtung des Sensorsystems verwendet, um den Code für das Verfahren und die erforderlichen Daten zu speichern.

Die Steuervorrichtung des Sensorsystems kann in einer Ausführungsform eine adaptive Schrittweitenanpassung im Rahmen des computerimplementierten Verfahrens der gradientenbasierten Optimierung durchführen, um die Konvergenz des Verfahrens zu verbessern. **In** einer anderen Ausführungsform kann die Steuervorrichtung eine Schrittverfahrensanpassung im Rahmen des Verfahrens durchführen, um die Effizienz zu optimieren. Eine weitere Möglichkeit besteht darin, dass die Steuervorrichtung eine adaptive Anpassung der Messparameterintervalle basierend auf dem Verlauf des gradientenbasierten Optimierungsverfahrens durchführt, um die Suche nach der Position der V-Formation zu beschleunigen.

Das Sensorelement und/oder das Sensorsystem können eine Rauschunterdrückungsfunktion aufweisen, um Störeinflüsse auf die Messwerte zu reduzieren und die Genauigkeit der Bestimmung der Position der V-Formation zu verbessern. Die Benutzerschnittstelle kann zusätzlich eine Visualisierung der Position der V-Formation auf der X-Y-Ebene ermöglichen, um dem Benutzer eine intuitive Darstellung der ermittelten Position zu bieten. Die Speichervorrichtung kann weitere Informationen über die V-Formation speichern, um eine umfassende Charakterisierung zu ermöglichen.

Das computerimplementierte Verfahren der gradientenbasierten Optimierung kann verschiedene Optimierungstechniken verwenden, um den nächsten Messpunkt basierend auf den nächsten Messparametern zu bestimmen. Beispiele für solche Techniken sind das steepest-descent-Verfahren oder das Newton-Verfahren. Die Auswahl der geeigneten Optimierungstechnik kann von den spezifischen Anforderungen des Sensorsystems abhängen.

Die Bestimmung der Position der Spitze einer V-Formation in der X-Y-Ebene oder einer funktionsäquivalenten Information kann in verschiedenen Anwendungen nützlich sein. Zum Beispiel könnte das Sensorsystem in der Luftfahrt eingesetzt werden, um die Position einer Flugzeugformation zu bestimmen. **In** der Robotik könnte es verwendet werden, um die Position eines Roboters zu ermitteln. Die Anwendungsmöglichkeiten sind vielfältig und hängen von den spezifischen Anforderungen des jeweiligen Systems ab.

Insgesamt bietet das vorgeschlagene Sensorsystem mit dem computerimplementierten Verfahren der gradientenbasierten Optimierung eine effiziente und präzise Methode zur Bestimmung der Position einer V-Formation. Durch die Integration von Funktionen wie Rauschunterdrückung, Visualisierung und Speicherung wird eine umfassende Charakterisierung der V-Formation ermöglicht. Dies kann zu einer verbesserten Steuerung, Überwachung oder Analyse in verschiedenen Anwendungsbereichen führen.

### Simulated Annealing

Das Sensorsystem umfasst eine Steuervorrichtung, die dazu dient, einen ersten Messparameter innerhalb eines ersten Messparameterintervalls und einen zweiten Messparameter innerhalb eines zweiten Messparameterintervalls einzustellen. Ein Sensorelement ermittelt einen Sensorelementmesswert in Abhängigkeit von den eingestellten Messparametern. Das Sensorsystem ist vorzugsweise in der Lage, Messpunkte im kartesischen Koordinatensystem zu bilden, wobei der erste Messparameter die x-Koordinate auf der x-Achse und der zweite Messparameter die y-Koordinate auf der y-Achse bestimmt und der Sensorelementmesswert die z-Koordinate auf der z-Achse bestimmt.

Des Weiteren kann das Sensorsystem die Position 30 der unteren Spitze einer V-Formation auf der X-Y-Ebene oder eine funktionsäquivalente Information, die aus dem ersten Messparameter als X-Koordinate und dem zweiten Messparameter als Y-Koordinate abgeleitet werden kann, bestimmen und ausgeben.

Für die Bestimmung der Position 30 der unteren Spitze der V-Formation oder der funktionsäquivalenten Information wird von der Steuervorrichtung das computerimplementierte Verfahren des Simulated Annealings angewendet. Dieses Verfahren ermöglicht es, den nächsten Messpunkt basierend auf den nächsten Messparametern zu bestimmen, um die Position 30 der unteren Spitze der V-Formation oder der funktionsäquivalenten Information mit möglichst wenigen Iterationen zu bestimmen. Die berechnete Position 30 der unteren Spitze der V-Formation oder der funktionsäquivalenten Information wird dann für die Verwendung durch ein übergeordnetes System bereitgehalten.

Zusätzlich zu den oben genannten Merkmalen umfasst das Sensorsystem weitere funktionale Eigenschaften und Vorteile. Eine Kommunikationsschnittstelle des Sensorsystems (z.B. eine Datenschnittstelle) ermöglicht die Übertragung der ermittelten Position 30 der unteren Spitze der V-Formation oder der funktionsäquivalenten Information an das übergeordnete System. Eine Speichereinheit in der Steuervorrichtung enthält ein Speichermedium, auf dem das computerimplementierte Verfahren des Simulated-Annealings gespeichert ist. Eine Datenanalyseeinheit (z.B. als Teil der Steuervorrichtung CTR und/oder Mustererkennungsvorrichtung MEV) führt eine Analyse der erfassten Sensorelementmesswerte und/oder des Filterausgangssignals (S4) durch, um Muster oder Strukturen zu erkennen und die Bestimmung der Position 30 der unteren Spitze der V-Formation oder der funktionsäquivalenten Information zu verbessern.

Die Benutzerschnittstelle ermöglicht es einem Benutzer, Eingaben für die Anpassung der Messparameter und die Steuerung des Verfahrens des Simulated-Annealings vorzunehmen. Der Benutzer kann eine Vorrichtung sein. Eine Kalibrierungseinheit (z.B. als Teil der Steuervorrichtung CTR und/oder Mustererkennungsvorrichtung MEV) ermöglicht es, das Sensorsystem basierend auf bekannten Referenzwerten zu kalibrieren und eine genaue Bestimmung der Position 30 der unteren Spitze der V-Formation oder der funktionsäquivalenten Information sicherzustellen.

Durch die Verwendung einer hochauflösenden Sensorik im Sensorelement werden präzise Sensorelementmesswerte geliefert, was zu einer genauen Bestimmung der Position 30 führt. Dies ermöglicht eine präzise Lokalisierung der unteren Spitze der V-Formation oder eine genaue Bestimmung der funktionsäquivalenten Information.

### Nelder-Mead-Algorithmus

**In** einer weiteren Ausgestaltung des Sensorsystems erfolgt die Einstellung eines ersten Messparameters innerhalb eines ersten Messparameterintervalls und eines zweiten Messparameters innerhalb eines zweiten Messparameterintervalls durch eine Steuervorrichtung. Durch ein Sensorelement wird ein Sensorelementmesswert für einen eingestellten Messpunkt basierend auf dem ersten Messparameter und dem zweiten Messparameter ermittelt. Der Messwert des Sensorelements wird in ein dreidimensionales kartesisches Koordinatensystem eingetragen, wobei die x-Koordinate auf der x-Achse durch den ersten Messparameter und die y-Koordinate auf der y-Achse durch den zweiten Messparameter bestimmt werden. Die z-Koordinate auf der z-Achse wird durch den Messwert des Sensorelements bestimmt. Eine Positionserkennungseinheit erkennt, dass die Maxima des Betrags des Gradienten des Messwerts des Sensorelements nach der x-Koordinate und der y-Koordinate eine V-Formation auf der X-Y-Ebene mit einer Spitze 30 dieser V-Formation ergeben. Die Aufgabe des Sensorsystems besteht darin, die Position 30 dieser unteren Spitze dieser V-Formation in der X-Y-Ebene und/oder eine funktionsäquivalente Information zu bestimmen und auszugeben.

Gemäß einer Ausprägung des Sensorsystems gemäß dem vorausgehenden Abschnitt wird die Steuervorrichtung den Nelder-Mead-Algorithmus, ein computerimplementiertes Verfahren, zur Bestimmung des nächsten Messpunkts aus einem nächsten ersten Messparameter und einem nächsten zweiten Messparameter anwenden. Dadurch wird die Position 30 dieser unteren Spitze dieser V-Formation in der X-Y-Ebene und/oder eine funktionsäquivalente Information berechnet und für die Verwendung durch ein übergeordnetes System bereitgestellt. Der Nelder-Mead-Algorithmus ist eine heuristische Optimierungsmethode, die auf einem iterativen Prozess zur Anpassung der Messparameter basiert, um die Position 30 dieser unteren Spitze dieser V-Formation in der X-Y-Ebene und/oder die funktionsäquivalente Information mit möglichst wenigen Iterationen zu bestimmen. Dies ermöglicht eine effiziente und genaue Positionserkennung.

Die Steuervorrichtung des Sensorsystems kann auch ein gesondertes Speichermedium umfassen, wobei das Speichermedium die aktuellen Werte des ersten Messparameters, des zweiten Messparameters und des Sensorelementmesswerts speichert. Dadurch wird der Nelder-Mead-Algorithmus iterativ durchgeführt, um die Position 30 dieser unteren Spitze dieser V-Formation in der X-Y-Ebene und/oder eine funktionsäquivalente Information zu bestimmen.

Zur Überprüfung der Konvergenz der Berechnung der Position 30 dieser unteren Spitze dieser V-Formation in der X-Y-Ebene und/oder der funktionsäquivalenten Information kann die Steuervorrichtung eine Konvergenzkriteriumsprüfung durchführen und die Iterationen des Nelder-Mead-Algorithmus entsprechend beenden. Dadurch wird sichergestellt, dass die Positionserkennung zuverlässig und präzise erfolgt.

Um Fehler in den Messungen des Sensorelements zu erkennen und zu korrigieren, kann die Steuerungsvorrichtung ein Fehlererkennungs- und Korrekturverfahren verwenden. Dieses Verfahren ermöglicht es, Fehler in den Messungen des Sensorelements zu identifizieren und zu beheben.

Das Fehlererkennungs- und Korrekturverfahren kann verschiedene Techniken umfassen, je nach den spezifischen Anforderungen des Systems. Eine Möglichkeit besteht darin, die erfassten Daten mit vordefinierten Schwellenwerten zu vergleichen. Wenn die Messwerte außerhalb der erwarteten Grenzen liegen, wird ein Fehler erkannt. In solchen Fällen kann die Steuervorrichtung geeignete Korrekturmaßnahmen ergreifen, um die Genauigkeit der Positionserkennung zu verbessern.

Eine andere Möglichkeit besteht darin, statistische Methoden zur Fehlererkennung und -korrektur anzuwenden. Hierbei werden die Messwerte analysiert, um Abweichungen und Anomalien zu identifizieren. Basierend auf diesen Erkenntnissen kann die Steuervorrichtung Fehlerkorrekturen durchführen, indem sie beispielsweise die Datenfilterung anpasst oder die Messwerte neu berechnet.

Darüber hinaus kann die Steuervorrichtung auch auf Redundanz setzen, indem sie mehrere Sensorelemente verwendet. Durch den Vergleich der Messwerte der verschiedenen Sensorelemente kann die Vorrichtung Fehler erkennen und korrigieren, indem sie beispielsweise Ausreißerwerte eliminieren oder den Durchschnitt der Messungen verwendet.

Insgesamt dient die Fehlererkennungs- und Korrekturfunktion dazu, die Zuverlässigkeit und Genauigkeit der Positionserkennung zu gewährleisten. Indem potenzielle Fehler erkannt und korrigiert werden, kann die Steuervorrichtung eine präzise Bestimmung der Position der unteren Spitze der V-Formation in der X-Y-Ebene oder der funktionsäquivalenten Information ermöglichen.

### Partikelschwarmoptimierung (PSO)

**In** einer weiteren Ausgestaltung des Sensorsystems wird das computerimplementierte Verfahren der Partikelschwarmoptimierung (PSO) angewendet, um den nächsten Messpunkt aus dem nächsten ersten Messparameter und dem nächsten zweiten Messparameter zu bestimmen. Dabei simuliert die Steuervorrichtung eine Gruppe von Partikeln im mehrdimensionalen Suchraum, wobei jedes Partikel einen Satz von Messparametern repräsentiert. Die Partikel suchen nach dem Optimum der V-Formation, wobei die Position 30 der unteren Spitze der V-Formation in der X-Y-Ebene und/oder eine funktionsäquivalente Information aus dem ersten Messparameter als X-Koordinate und dem zweiten Messparameter als Y-Koordinate maximiert wird.

Das computerimplementierte Verfahren der Partikelschwarmoptimierung (PSO) verwendet eine Aktualisierungsfunktion für die Partikelpositionen, bei der die Partikel ihre Position basierend auf ihren aktuellen Positionen, ihren individuellen besten Positionen und den besten Positionen anderer Partikel aktualisieren. Dies führt zu einer Konvergenz zum Optimum der V-Formation und ermöglicht eine präzise Positionsermittlung.

Um eine zu schnelle Konvergenz oder ein Verlassen des Suchraums zu verhindern und eine umfassende Erkundung des Suchraums zu gewährleisten, wendet das computerimplementierte Verfahren der PSO verschiedene Geschwindigkeits- und Bewegungseinschränkungen für die Partikel an.

Das PSO-Verfahren verwendet ein vordefiniertes Abbruchkriterium, um den Suchprozess zu beenden. Dies kann geschehen, wenn eine bestimmte Anzahl von Iterationen erreicht ist oder eine vordefinierte Genauigkeit der Ermittlung der Position 30 der unteren Spitze der V-Formation in der X-Y-Ebene und/oder der funktionsäquivalenten Information erreicht wurde. Dadurch wird eine effiziente und genaue V-Formationserkennung gewährleistet.

Um eine effiziente und genaue V-Formationserkennung zu ermöglichen, verwendet das computerimplementierte Verfahren der PSO eine adaptive Parameteranpassung. Die Steuervorrichtung passt die Parameter des PSO-Verfahrens basierend auf dem Fortschritt des Suchprozesses und der Qualität der ermittelten Position 30 der unteren Spitze der V-Formation in der X-Y-Ebene und/oder der ermittelten funktionsäquivalenten Information an.

Das PSO-Verfahren enthält eine stochastische Komponente, die zufällige Schwankungen in den Partikelpositionen einführt. Dadurch wird eine breitere Exploration des Suchraums ermöglicht und das Risiko von lokalen Optima verringert.

Um eine schnellere Konvergenz und eine bessere Positionsermittlung zu erreichen, passt die Steuervorrichtung die Schrittweite der Partikel basierend auf der Konvergenzgeschwindigkeit und dem Fortschritt des Suchprozesses an. Dadurch wird eine effektive und effiziente Suche im Suchraum ermöglicht.

Um eine höhere Genauigkeit der Positionsermittlung zu erzielen, führen die Partikel in der Nähe vielversprechender Positionen 30 der unteren Spitze der V-Formation in der Mitte der V-Formation eine enge Spiralbewegung aus. Diese Spirale ermöglicht es den Partikeln, ihre Positionen feiner anzupassen und eine genauere Erfassung der Zielposition zu ermöglichen. Währenddessen halten die äußeren Partikel ihre Positionen stabil, um die Form der V-Formation beizubehalten und die Stabilität des Schwarmes zu gewährleisten.

Durch diese Kombination aus enger Spiralbewegung und Beibehaltung der V-Formation können die Partikel ihre Positionen kontinuierlich verbessern und die Zielverfolgungsgenauigkeit erhöhen. Darüber hinaus ermöglicht die enge Zusammenarbeit innerhalb des Schwarms eine effektive Informationsübertragung zwischen den Partikeln, was zu einer optimierten Positionsermittlung führt.

Das Verhalten der Partikel in der V-Formation ist ein Beispiel für ein kooperatives Verhalten, das in der Schwarmintelligenz häufig beobachtet wird. Durch die Zusammenarbeit und Kommunikation innerhalb des Schwarms können komplexe Aufgaben effizienter und genauer gelöst werden. Dieses Prinzip wird in verschiedenen Bereichen wie Robotik, Optimierungsalgorithmen und künstlicher Intelligenz angewendet, um vielfältige Probleme zu lösen und innovative Lösungen zu finden.

### Genetische Algorithmen

In einer Ausprägung des vorgeschlagenen Sensorsystems zur Bestimmung der Position 30 der Spitze einer V-Formation in einer X-Y-Ebene oder einer funktionsäquivalenten Information werden folgende Komponenten verwendet:
Das Sensorsystem umfasst ein Sensorelement, das Messwerte abhängig von einem ersten und einem zweiten Messparameter erfasst. Ein Paar aus erstem und zweitem Messparameter bildet jeweils einen Messpunkt. Um die Messparameter innerhalb vordefinierter Messparmeterintervalle einzustellen, wird eine Steuervorrichtung verwendet.

Ein computerimplementiertes Verfahren, das vorzugsweise computerimplementiert genetische Algorithmen nutzt, kommt zum Einsatz, um den nächsten Messpunkt basierend auf dem nächsten ersten und zweiten Messparameter zu bestimmen. Dieses Verfahren ermöglicht eine effiziente Positionsbestimmung der Spitze der V-Formation oder einer funktionsäquivalenten Information.

Eine Ausgabeeinheit dient vorzugsweise dazu, die Position 30 der Spitze der V-Formation in der X-Y-Ebene oder der funktionsäquivalenten Information bereitzustellen. Dabei wird vorzugsweise der erste Messparameter als X-Koordinate und der zweite Messparameter als Y-Koordinate verwendet. Diese Informationen können von einem übergeordneten System genutzt werden.

Das computerimplementierte Verfahren nutzt vorzugsweise ein Speichermedium (RAM, NVM) zur Speicherung der Daten, Parameter und Zwischenergebnisse des genetischen Algorithmus. Durch die Anwendung des genetischen Algorithmus wird die Position der Spitze der V-Formation oder der funktionsäquivalenten Information mit möglichst wenigen Iterationen bestimmt. Dabei werden die Messparameter durch den genetischen Algorithmus optimiert, um eine effiziente Positionsbestimmung zu gewährleisten.

Das Sensorsystem weist vorzugsweise eine Datenschnittstelle zur Kommunikation der Steuervorrichtung (CTR) mit dem übergeordneten System auf, um die Position 30 der Spitze der V-Formation in der X-Y-Ebene oder der funktionsäquivalenten Information bereitzustellen.

Das Sensorelement des Sensorsystems ist vorzugsweise ein neuartiges und erfinderisches Element, das den Messwert in Abhängigkeit von den Messparametern mit einem guten Cpk-Wert in der Serienproduktion ermittelt und liefert. Dies ermöglicht eine präzise Positionsbestimmung der Spitze der V-Formation in der X-Y-Ebene oder der funktionsäquivalenten Information.

Das computerimplementierte Verfahren der genetischen Algorithmen verwendet vorzugsweise eine Mehrpunkt-Suche, bei der mehrere Messpunkte gleichzeitig im Suchraum erkundet werden. Dadurch wird die Effizienz des Verfahrens zur Positionsbestimmung der V-Formation gesteigert.

Das Sensorsystem verfügt über vorzugsweise eine Fehlererkennungsfunktion und Fehlerkorrekturfunktion, die es ermöglicht, Messfehler, Ausreißer oder Störungen im Messprozess zu identifizieren und zu eliminieren. Dadurch wird eine präzise Positionsbestimmung gewährleistet.

Zusätzlich bietet das Sensorsystem eine Datensicherungsfunktion, um die gespeicherten Daten langfristig zu sichern, zu archivieren oder wiederherzustellen und somit die Integrität der Messdaten zu gewährleisten.

Das Sensorsystem ist vorzugsweise erweiterbar und kann vorzugsweise um zusätzliche Komponenten oder Funktionen ergänzt werden, um den Anforderungen und Bedürfnissen der Benutzer gerecht zu werden. Mögliche Erweiterungen umfassen:
Zusätzliche Sensoren: Je nach Anwendungsbereich können weitere Sensoren hinzugefügt werden, um zusätzliche Daten zu erfassen. Beispielsweise könnten Temperatursensoren, Feuchtigkeitssensoren oder Luftqualitätssensoren integriert werden, um umfassendere Umweltinformationen zu liefern. Kommunikationsmodule: Um die Konnektivität des Sensorsystems zu verbessern, können Kommunikationsmodule wie WLAN, Bluetooth oder Mobilfunktechnologien integriert werden. Dadurch können die gesammelten Daten drahtlos an andere Geräte oder Cloud-Dienste übertragen werden.

Datenanalyse und -verarbeitung: Durch die Integration von leistungsstarker Software kann das Sensorsystem Daten in Echtzeit mittels computerimplementierter Verfahren analysieren und verarbeiten. Dies ermöglicht eine sofortige Reaktion auf bestimmte Ereignisse oder die Durchführung komplexer computerimplementierter Algorithmen zur Extraktion wertvoller Informationen.

Energieeffizienz: Um die Batterielebensdauer einer batteriegestützten Energieversorgung des Sensorsystems zu verlängern, kann das Sensorsystem mit energieeffizienten Komponenten ausgestattet werden. Dies umfasst beispielsweise den Einsatz von Low-Power-Mikrocontrollern, intelligentem Energiemanagement und Energierückgewinnungstechnologien.

Benutzerschnittstellen: Um die Bedienung und Interaktion mit dem Sensorsystem zu verbessern, können zusätzliche Benutzerschnittstellen implementiert werden. Dies könnte die Integration von Touchscreens, Sprachsteuerung oder Fernbedienungen umfassen, um eine intuitive Steuerung zu ermöglichen.

Diese Erweiterungsmöglichkeiten machen das Sensorsystem flexibel und anpassungsfähig für verschiedene Anwendungsszenarien. Benutzer können die Funktionen des Systems erweitern, um ihre spezifischen Anforderungen zu erfüllen und von den vielseitigen Möglichkeiten des Sensorsystems zu profitieren.

### Bayes'sche Optimierung

In einer Variante des vorgeschlagenen Sensorsystems wird die Position 30 der unteren Spitze einer V-Formation in einer X-Y-Ebene oder einer funktionsäquivalenten Information bestimmt. Das Sensorsystem umfasst eine Steuervorrichtung zur Einstellung eines ersten Messparameters innerhalb eines ersten Messparmeterintervalls und eines zweiten Messparameters innerhalb eines zweiten Messparmeterintervalls. Ein Paar aus einem ersten Messparameter und einem zweiten Messparameter bildet einen Messpunkt. Ein Sensorelement erfasst einen Sensorelementmesswert abhängig von den eingestellten Messpunkten. Der Sensorelementmesswert wird in vorzugsweise ein virtuelles, dreidimensionales kartesisches Koordinatensystem eingetragen. Die x-Koordinate wird durch den ersten Messparameter, die y-Koordinate durch den zweiten Messparameter und die z-Koordinate durch den Sensorelementmesswert bestimmt.

Um die Position 30 der unteren Spitze der V-Formation oder einer funktionsäquivalenten Information zu bestimmen, verwendet beispielsweise das Sensorsystem eine Bayes'sche Optimierungsfunktion. Diese Funktion implementiert ein computerimplementiertes Verfahren, um den nächsten Messpunkt aus einem nächsten ersten Messparameter und einem nächsten zweiten Messparameter zu bestimmen. Eine Positionserfassungseinheit (Mustererkennungsvorrichtung MEV, Steuervorrichtung CTR) bestimmt dann die Position 30 der unteren Spitze der V-Formation oder einer funktionsäquivalenten Information aus dem bestimmten Messpunkt. Zusätzlich stellt eine Speichermediumfunktion (RAM, NVM) die Position 30 der unteren Spitze der V-Formation oder einer funktionsäquivalenten Information für die Verwendung durch ein übergeordnetes System bereit.

Die Bayes'sche Optimierungsfunktion des Sensorsystems minimiert die Anzahl der Iterationen, die zur Bestimmung der Position 30 der unteren Spitze der V-Formation in der X-Y-Ebene oder der funktionsäquivalenten Information erforderlich sind. Dadurch wird die Effizienz des Verfahrens gesteigert und eine schnellere Positionserfassung ermöglicht.

Das Sensorsystem kann auch als Computerprogrammproduktfunktion ausgeführt werden, das ein computerlesbares Programm bereitstellt, das die Bayes'sche Optimierungsfunktion zur Bestimmung des nächsten Messpunkts implementiert. Dadurch wird die Flexibilität des Systems erhöht und eine einfache Aktualisierung oder Erweiterung der Funktionen ermöglicht.

Eine drahtlose und/oder drahtgebundene Kommunikationsschnittstellenfunktion beispielsweise mittels einer Datenschnittstelle ermöglicht die Übertragung von Daten oder Informationen zwischen dem Sensorsystem und anderen Geräten oder Systemen. Dies ermöglicht eine nahtlose Integration des Sensorsystems in bestehende Netzwerke oder Systeme.

Das Sensorsystem umfasst eine Prozessoreinheit (Steuervorrichtung CTR) und ein Speichermedium (RAM, NVM), um die Ausführung des computerimplementierten Verfahrens und die Speicherung von Daten zu ermöglichen. Dadurch wird eine effiziente Verarbeitung und Speicherung der erfassten Messdaten und Ergebnisse gewährleistet.

Eine typischerweise computerimplementierte Fehlererkennungsfunktion und Fehlerkorrekturfunktion ist vorzugsweise im Sensorsystem integriert, um Messfehler, Ausreißer oder Störungen im Messprozess zu identifizieren und zu eliminieren. Dadurch wird die Genauigkeit der Positionserfassung verbessert und zuverlässige Ergebnisse erzielt.

Zur Sicherung und langfristigen Aufrechterhaltung der Datenintegrität verfügt das Sensorsystem vorzugsweise über einen Speichermechanismus, der die erfassten Messdaten protokolliert und sicher in einem Speicher (RAM, NVM) ablegt. Dadurch wird gewährleistet, dass die Messergebnisse auch nach der Erfassung vor Verlust oder Beschädigung geschützt sind.

Darüber hinaus ist das Sensorsystem vorzugsweise mit einer Kalibrierungsfunktion ausgestattet, die bevorzugt regelmäßig durchgeführt wird, um die Messgenauigkeit aufrechtzuerhalten. Dabei werden interne Referenzwerte verwendet, um eventuelle Abweichungen oder Drifts zu erkennen und zu korrigieren. Durch diese regelmäßige Kalibrierung wird eine hohe Präzision und Zuverlässigkeit der Positionserfassung gewährleistet.

Ein weiteres Merkmal des Sensorsystems ist vorzugsweise die Integration einer Echtzeitüberwachungsfunktion. Diese ermöglicht eine kontinuierliche Überwachung der Sensordaten während des Messprozesses. Abweichungen oder Anomalien werden sofort erkannt und können schnell behoben werden, um eine unterbrechungsfreie und zuverlässige Erfassung der Positionsinformationen sicherzustellen. Zusammenfassend lässt sich sagen, dass das Sensorsystem durch die Integration einer Fehlererkennungsfunktion und Fehlerkorrekturfunktion, eines Speichermechanismus, einer Kalibrierungsfunktion und einer Echtzeitüberwachungsfunktion eine präzise, zuverlässige und sichere Positionserfassung ermöglicht. Diese Funktionen tragen dazu bei, Messfehler zu identifizieren, zu eliminieren und die Genauigkeit der Positionsinformationen zu verbessern, was wiederum zuverlässige Ergebnisse liefert.

### Sonstiges

Die obige Beschreibung erhebt keinen Anspruch auf Vollständigkeit und beschränkt diese Offenbarung nicht auf die gezeigten Beispiele. Andere Variationen zu den offengelegten Beispielen können von denjenigen, die über gewöhnliche Fachkenntnisse auf dem Gebiet verfügen, anhand der Zeichnungen, der Offenbarung und der Ansprüche verstanden und ausgeführt werden. Die unbestimmten Artikel "ein" oder "eine" und dessen Flexionen schließen eine Vielzahl nicht aus, während die Erwähnung einer bestimmten Anzahl von Elementen nicht die Möglichkeit ausschließt, dass mehr oder weniger Elemente vorhanden sind. Eine einzige Einheit kann die Funktionen mehrerer in der Offenbarung genannter Elemente erfüllen, und umgekehrt können mehrere Elemente die Funktion einer Einheit erfüllen. Zahlreiche Alternativen, Äquivalente, Variationen und Kombinationen sind möglich, ohne dass der Anwendungsbereich der vorliegenden Offenbarung verlassen wird. Soweit nichts anders angegeben ist, können sämtliche Merkmale der vorliegenden Erfindung frei miteinander kombiniert werden. Dies betrifft die gesamte hier vorgelegte Schrift. Auch die in der Figurenbeschreibung beschriebenen Merkmale können, soweit nichts anderes angegeben ist, als Merkmale der Erfindung frei mit den übrigen Merkmalen kombiniert werden. Eine Beschränkung einzelner Merkmale der Ausführungsbeispiele auf die Kombination mit anderen Merkmalen der Ausführungsbeispiele ist dabei ausdrücklich nicht vorgesehen. Außerdem können gegenständliche Merkmale der Vorrichtung umformuliert auch als Verfahrensmerkmale Verwendung finden und Verfahrensmerkmale umformuliert als gegenständliche Merkmale der Vorrichtung. Eine solche Umformulierung ist somit automatisch mit offenbart.

In der vorausgehenden detaillierten Beschreibung wird auf die beigefügten Zeichnungen verwiesen. Die Beispiele in der Beschreibung und den Zeichnungen sollten als illustrativ betrachtet werden und sind nicht als einschränkend für das beschriebene spezifische Beispiel oder Element zu betrachten. Aus der vorausgehenden Beschreibung und/oder den Zeichnungen und/oder den Ansprüchen können durch Abänderung, Kombination oder Variation bestimmter Elemente mehrere Beispiele abgeleitet werden. Darüber hinaus können Beispiele oder Elemente, die nicht wörtlich beschrieben sind, von einer fachkundigen Person aus der Beschreibung und/oder den Zeichnungen abgeleitet werden.

### Liste der Figuren

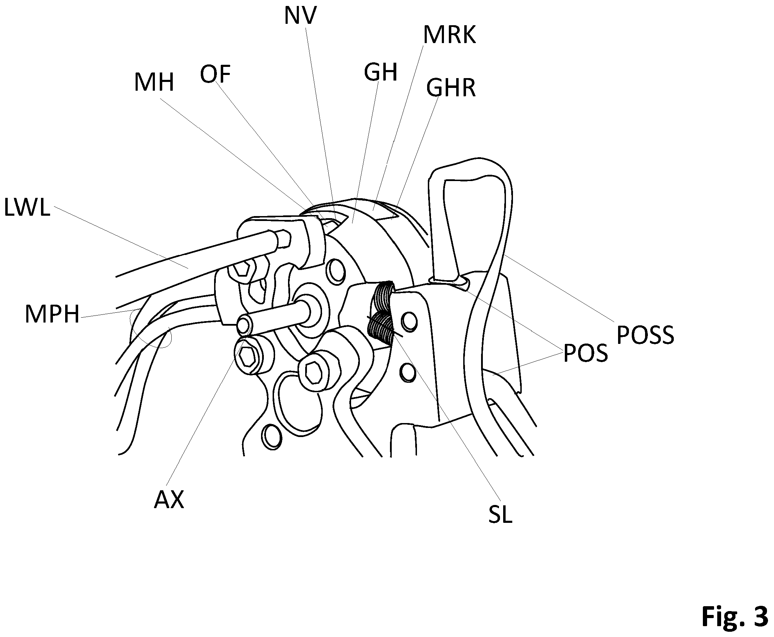

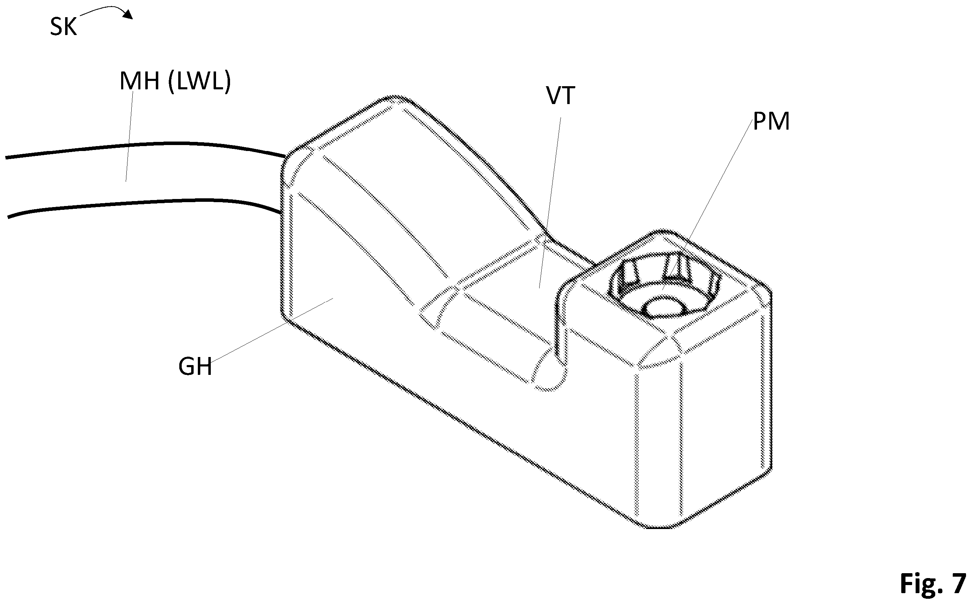

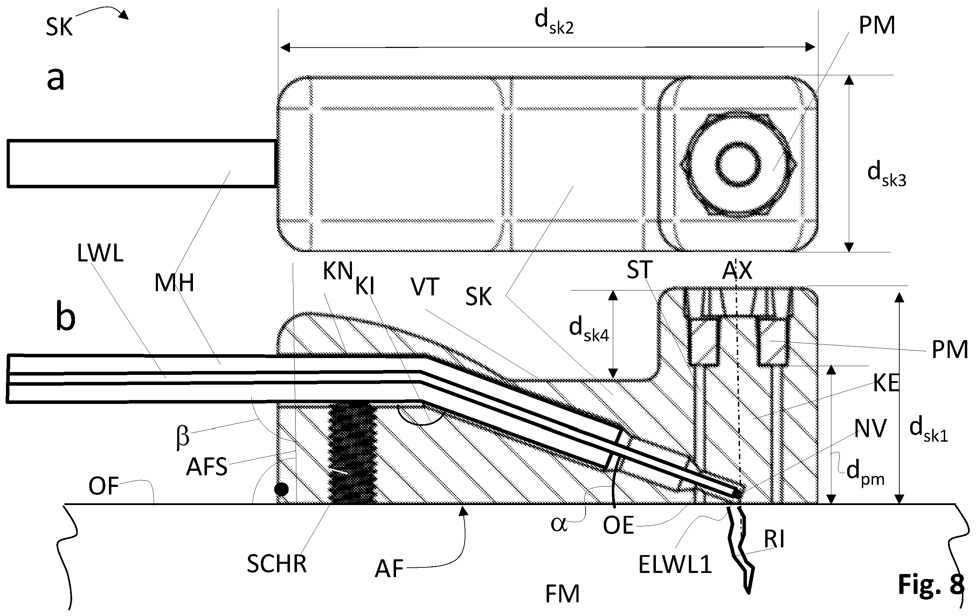

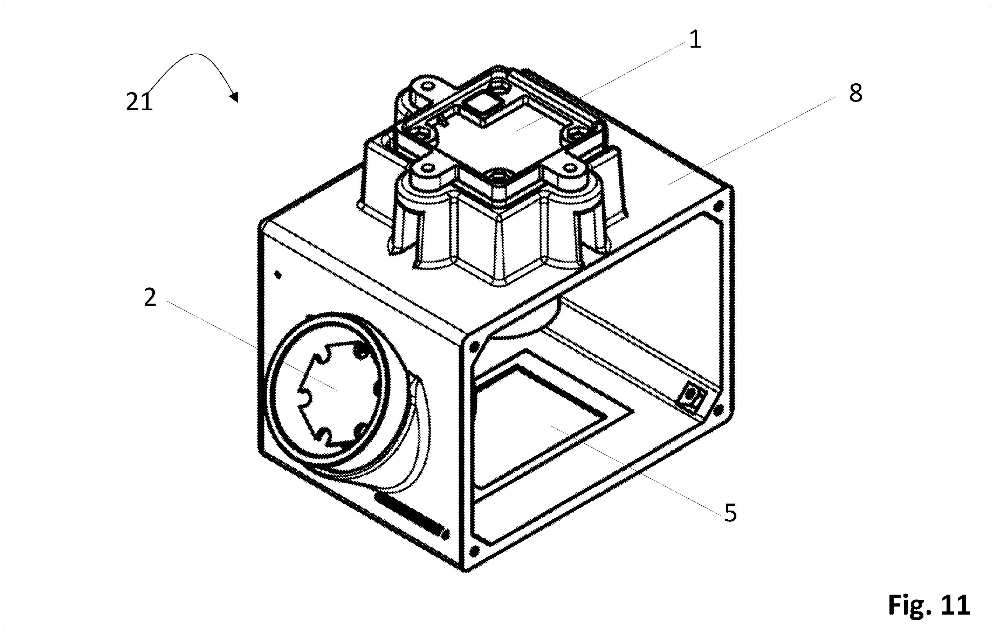

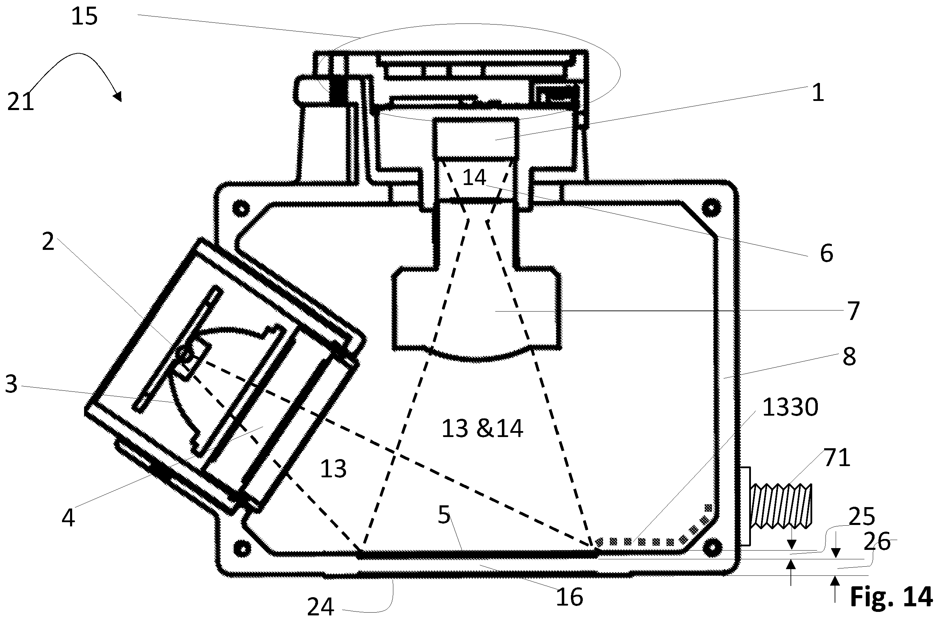

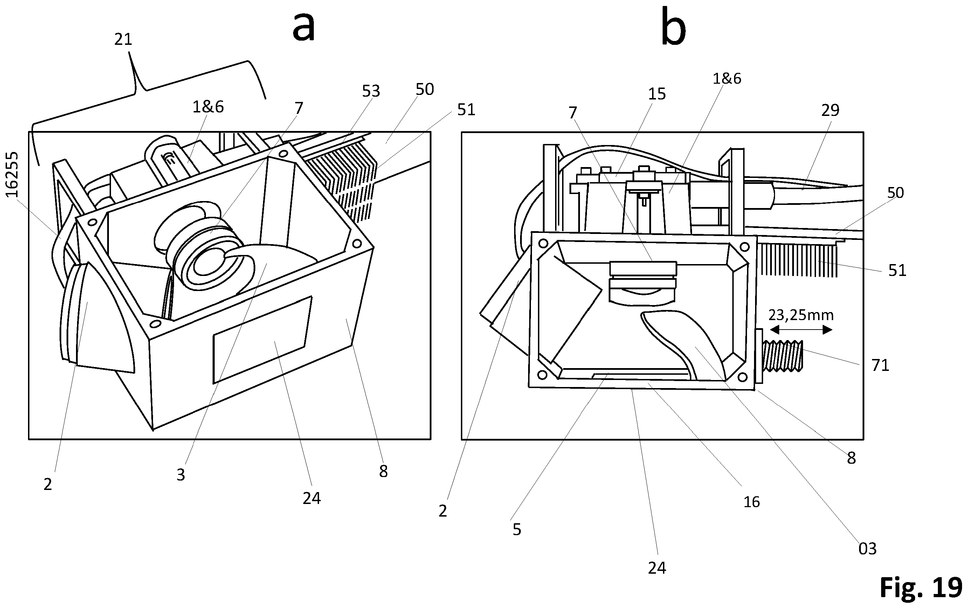

Figur 1
   zeigt beispielhaft und schematisch vereinfacht ein beispielhaftes, vorschlagsgemäßes System einer Anwendungsvorrichtung entsprechend dem zweiten Anwendungsbeispiel eines Motors.
Figur 2
   zeigt einen Lichtwellenleiter **LWL** mit einem Sensorelement **SE** direkt auf dem Zentrum **MP** des Kerns des Lichtwellenleiters **LWL.**
Figur 3
   zeigt einen Motor einer Anwendungsvorrichtung entsprechend dem zweiten Anwendungsbeispiel eines Motors, wie ihn Figur 1 schematisch vereinfacht skizziert, wobei zusätzlich zu dem Lichtwellenleiter **LWL** mit dem Sensorelement SE, der über die besagte Öffnung **OF** in den Motor hineinreicht und der mit der mechanischen Hülle MH umhüllt ist, die Aufhängung des Motors einen Positionssensor **POS** mit einer **LED** und einer Fotodiode aufweist, die das Positionssignal **POSS** mit Hilfe einer Markierung **MRK** auf dem Rotorgehäuse **GHR** erzeugt.
Figur 4
   zeigt das von dem Lock-In-Verstärker **LIV** erzeugte Filterausgangssignal **S4** als Flussdichtemesssignal und das Positionssignal **POSS** des Positionsdetektors **POS** der Figur 3.
Figur 5
   zeigt einen Querschnitt durch das beispielhafte erste Ende **ELWL1** eines vorschlagsgemäßen Lichtwellenleiters **LWL.**
Figur 6
   zeigt beispielhaft und schematisch vereinfacht ein beispielhaftes, vorschlagsgemäßes Materialmesssystem mit einem vorschlagsgemäßen Sensorkopf **SK.**
Figur 7
   zeigt einen Sensorkopf **SK** mit der mechanischen Hülle des Lichtwellenleiters **LWL,** der durch die mechanische Hülle **MH** verdeckt ist.
Figur 8
   zeigt den Sensorkopf **SK** der Figur 7 in der Aufsicht (Figur 8a) und in der Seitenansicht (Figur 8b) als Schnittbild.
Figur 9
   zeigt die Schritte des Verfahrens zur Herstellung eines vorschlagsgemäßen Sensorkopfes **SK** und dessen Verwendung.
Figur 10
   zeigt ein beispielhaftes Werkstück aus einem ferromagnetischen Material **FM** in der Aufsicht.
Figur 11
   zweigt einen beispielhaften Werteverlauf des erhaltenen Messignals **S4** in Abhängigkeit von der Position **x** des Sensorkopfes **SK** auf der Oberfläche **OF** des Werkstücks der Figur 11a dargestellt.
Figur 12
   zeigt die Vorrichtung mit aufgesetztem Deckel zum lichtdichten Verschluss des Gehäuses **8.**
Figur13
   entspricht der Figur 11, wobei die beispielhafte Vorrichtung nun aus einem anderen Winkel dargestellt ist.
Figur 14
   zeigt die Vorrichtung im Querschnitt.
Figur 15
   zeigt einen beispielhaften, nicht maßstabsgerechten Querschnitt durch die Sensorschicht 5.
Figur 16
   zeigt eine typische Nutzungssituation, wobei der Magnetfeldkamerakopf **21** vorzugsweise auf der Oberfläche **34** des jeweiligen Messobjekts mit der Unterseite **24** des Gehäuses **8** aufgesetzt ist.
Figur 17
   zeigt das System der Figur 14 vereinfacht mit den Ansteuer- und Auswertevorrichtungen als Blockdiagramm.
Figur 18
   zeigt eine Zeichnung auf Basis eines beispielhaften Fotos eines beispielhaften, bei der Ausarbeitung des hier vorgelegten Vorschlags erstellten Sensorkopfes **21** mit abgenommenen Deckel.
Figur 19a
   zeigt eine Zeichnung auf Basis eines beispielhaften Fotos eines beispielhaften, bei der Ausarbeitung des hier vorgelegten Vorschlags erstellten Sensorkopfes **21** mit abgenommenen Deckel.
Figur 19b
   entspricht im Wesentlichen der Figur 19a und zeigt den gleichen Magnetfeldkamerakopfes **21** aus einer etwas anderen Perspektive.
Figur 20
   zeigt eine Zeichnung des Prototypen mit aufgesetztem Deckel. Der Innenraum des Gehäuses **8** des Magnetfeldkamerakopf **21** ist dann lichtdicht verschlossen.
Figur 22
   zeigt oben das musterkodierte Magnetflussdichtenbetragsbild **39** der Verteilung der magnetischen Flussdichte von vier Permanentmagneten **37** auf einer Glasplatte **38** in willkürlichen Einheiten.
Figur 23
   zeigt eine Darstellung für vier magnetisierte Ringe.

### Beschreibung der Figuren

Die Figuren erläutern den Vorschlag schematisch und vereinfacht. Die Offenlegung der hier vorgelegten Schrift ist nicht auf die Figuren begrenzt und umfasst auch andere Kombinationen.

### Figur 1

Figur 1 zeigt beispielhaft und schematisch vereinfacht ein beispielhaftes, vorschlagsgemäßes System. Der Motor umfasst das Stator-Gehäuse **GH.** An dem Stator-Gehäuse **GH** ist der magnetische Stator-Kreis befestigt. Der magnetische Stator-Kreis kann beispielsweise einen ferrit-Körper umfassen. Der Motor umfasst des Weiteren die Stator-Spulenwicklungen **SL.** Der Motor umfasst außerdem die Achse **AX,** die der Stator vorzugsweise drehbar lagert. Bevorzugt ist die Achse AX um die Längsachse der Achse drehbar im Stator gelagert. Bevorzugt ist die Achse **AX** gegen Verschiebungen längs der Längsachse der Achse **AX** gesichert. An der Achse **AX** ist bevorzugt ein Rotor-Gehäuse **GHR** befestigt. An dem Rotor-Gehäuse und/oder der Achse **AX** ist bevorzugt ein magnetischer Rotorkreis **RMK** befestigt. Bevorzugt umfasst der magnetische Rotorkreis **RMK** ein ferromagnetisches Blechpaket oder dergleichen. An dem magnetischer Rotorkreis **RMK** und/oder an dem Rotor-Gehäuse GHR sind typischerweise mehrere Permanentmagneten **PM** befestigt. Zwischen den Stator-Spulen SL und den Permanentmagneten **PM** befindet sich typischerweise ein Luftspalt **LS.**

Eine Halbbrückensteuerung **CTRH** steuert mittels Halbbrückensteuerleitungen **HSL** mehrere Halbbrücken **HB.** Die Halbbrücken bestromen die Motorphasen, die mit den Stator-Spulen **SL** verbunden sind. In dem Beispiel der Figur 1 ist der beispielhafte Motor dreiphasig. Der beispielhafte Motor umfasst dabei dann bevorzugt N*3 Stator-Spulen. Hierbei ist N eine ganze positive Zahl größer 0. Die Halbbrücken kommutieren die Ansteuerung der Stator-Spulen in Abhängigkeit von den Halbbrückensteuerleitungen **HSL** mittels der Motorphasen **MPH.** Der Generator **G** erzeugt das Sendevorsignal **S5w.** Bevorzugt ist das Sendevorsignal **S5w** pulsmoduliert mit einer Pulsfrequenz. Besonders bevorzugt handelt es sich um ein Rechtecksignal mit einem Duty-Cycle von bevorzugt 50%. Andere Duty-Cycles sind denkbar. Die Offset-Addition **OFF1** addiert bevorzugt einen Offset zu dem Wert des Sendevorsignals, um die Pumpstrahlungsquelle **PL** nutzen zu können. Bevorzugt weist das resultierende Sendesignal **S5** keine negativen Signalanteile auf. Die Pumpstrahlungsquelle **PL** erzeugt in Abhängigkeit von dem Sendesignal **S5** eine modulierte Pumpstrahlung **LB.** In dem Beispiel der Figur 1 transmittiert die Pumpstrahlungsquelle die Pumpstrahlung **LB** durch einen dichroitischer Spiegel **F1** und strahlt Pumpstrahlung **LB** in den Lichtwellenleiter **LWL** ein. Das Motorgehäuse **GH** weist zumindest eine Öffnung **OF** auf, durch die der Lichtwellenleiter **LWL** in das Gehäuse **GH** tritt. Am Ende des Lichtwellenleiters **LWL** befindet sich bevorzugt das Sensorelement SE. Das Sensorelement SE umfasst bevorzugt eine Vielzahl von Nanodiamanten bzw. Diamanten **DM** und/oder eine Vielzahl von Kristallen, die bevorzugt eine statistisch geleichverteilte unterschiedliche Kristallorientierung aufweisen und die in ein Matrixmaterialeingebettet sind. Typischerweise verbindet das Matrixmaterial aus einem Trägermaterial **TM** diese Nano-Diamanten **ND** mechanisch mit dem ersten Ende **ELWL1** des Lichtwellenleiters **LWL.** Bevorzugt hat der eigentliche Lichtwellenleiter **LWL** einen Lichtwellenleiterdurchmesser **D_{LWL}** von ca. 100µm. Bevorzugt sind kleinere Lichtwellenleiterdurchmesser **D_{LWL}.** Größere Lichtwellenleiterdurchmesser **D_{LWL}** sind aber möglich. Hinzukommt typischerweise ein Knickschutz des Lichtwellenleiters **LWL.** Bevorzugt ist der Knickschutz als mechanische Hülle **MH** ausgeführt. Die Pumpstrahlung **LB** der Pumpstrahlungsquelle **PL** trifft am ersten Ende des Lichtwellenleiters **ELWL1** auf die Nanodiamanten bzw. Diamanten **DM** und/oder Kristalle im Sensorelement SE. Der Nanodiamanten bzw. Diamanten **DM** und/oder Kristalle im Sensorelement **SE** umfassen bevorzugt NV-Zentren und/oder paramagnetische Zentren. Bevorzugt umfasst das Sensorelement **SE** Diamanten mit **NV-**Zentren. Typischerweise regt die Pumpstrahlung **LB** die Nanodiamanten bzw. Diamanten **DM** und/oder Kristalle zur Emission einer Fluoreszenzstrahlung **FL** mit einer Fluoreszenzwellenlänge λ_{fl} an. Bevorzugt befindet sich das Sensorelement **SE** am ersten Ende **ELWL1** des Lichtwellenleiters **LWL.** Bevorzugt hat das Sensorelement einen Durchmesser, der kleiner als der Durchmesser **D_{LWL}** des Lichtwellenleiters **LWL** ist. Typischerweise strahlen die NV-Zentren **NVZ** des Sensorelements **SE** die Fluoreszenzstrahlung **FL** wieder in den Lichtwellenleiter **LWL** über das erste Ende **ELWL1** des Lichtwellenleiters **LWL** ein. Die Fluoreszenzstrahlung **FL** tritt am anderen, zweiten Ende **ELWL2** des Lichtwellenleiters **LWL** aus dem Lichtwellenleiter **LWL** wieder aus und bestrahlt, beispielsweise umgelenkt durch den dichroitischen Spiegel **F1,** vorzugsweise den Fotodetektor **PD.** Der dichroitische Spiegel **F1** lenkt die gestreute Pumpstrahlung **LB** in dem Beispiel der Figur 1 nicht in Richtung des Fotodetektors **PD.** Hierdurch empfängt der Fotodetektor **PD** im Wesentlichen nur Fluoreszenzstrahlung **FL.** Im Wesentlichen bedeutet hierbei, dass die Pumpstrahlung **LB** und die sonstige Strahlung, die den Fotodetektor **PD** trotzdem treffen im Wesentlichen für den technischen Zweck der Vorrichtung unbedeutend sind. Um dies zu erreichen, schlägt das hier vorgestellte Dokument die Verwendung eines lichtdichten Gehäuses für die lichtempfindlichen Vorrichtungsteile und die Verwendung von Blenden vor, um den Zutritt unerwünschter Strahlung und unerwünschte Effekte durch Streustrahlung zu vermeiden. Der Fotodetektor **PD** wandelt bevorzugt die Intensität der Fluoreszenzstrahlung **FL** in einen zeitlichen Werteverlauf eines Empfangssignals **S0.** Ein beispielhafter Verstärker **V1** verstärkt und filtert ggf. das Empfängerausgangssignal **S0** in dem Beispiel der Figur 1 zum verstärkten Empfängerausgangssignal **S1.** In dem Beispiel der Figur 1 multipliziert ein beispielhafter Multiplizierer **M1** das verstärkte Empfängerausgangssignal **S1** mit dem Sendevorsignal **S5w** zum Filtereingangssignal **S3.** Ein Tiefpassfilter **TP** entfernt typischerweise die Frequenzanteile mit den addierten Frequenzen des Sendevorsignals **S5w** und des verstärkten Empfängerausgangssignals **S1** aus dem Spektrum. Der Tiefpassfilter TP filtert so das Empfängereingangssignal zum Filterausgangssignal **S4.** Die Halbbrückensteuerung **CTRH** steuert die Kommutierung des Motors mittels der Halbbrücke **HB** in Abhängigkeit von dem Filterausgangssignal **S4.** Die Kombination aus dem ersten Multiplizierer **M1** und dem Tiefpassfilter **TP** bildet ein Skalarprodukt zwischen dem Signalvektor des verstärkten Empfängerausgangssignal **S1** und dem Sendevorsignal **S5w.** Es handelt sich um einen einfachen beispielhaften Synchrondemodulator. Der Synchrondemodulator erzeugt ein Signal **S4,** dass die Korrelation zwischen dem verstärkten Empfängerausgangssignal **S1** und dem Sendevorsignal **S5w** symbolisiert. Dieses Signal **S4** ist das Filterausgangssignal **S4.** Die Verwendung anderer Korrelatoren an Stelle eines Synchrondemodulators, beispielsweise die Verwendung von Optimalfiltern, Kalmann-Filtern und/oder Matched-Filtern und/oder anderen Schätzvorrichtungen zur Ermittlung des Anteils des Sendesignals **S5** im Empfängerausgangssignal **S0** ist denkbar. Das Besondere an dem Messverfahren der Figur 1 ist, dass der Lichtwellenleiter **LWL** zusammen mit dem Sensorelement **SE und** den anderen Vorrichtungsteilen typischerweise keine ferromagnetischen und/oder elektrisch leitenden Materialien umfasst und damit das magnetische Feld des Motors im Wesentlichen nicht beeinflusst.

Beispielsweis kann die Halbbrückensteuerung **CTRH** einen Nulldurchgang der magnetischen Flussdichte im Luftspalt **LS** oder der magnetischen Flussdichte des Streufeldes des Luftspalts feststellen.

Die Intensität der Fluoreszenzstrahlung **FL** der Diamanten **DM** bzw. Nanodiamanten und/oder der Kristalle des Sensorelements **SE** hängt von der magnetischen Flussdichte **B** am Ort der NV-Zentren **NVZ** des Sensorelements **SE** ab. Da der Wert des Filterausgangssignals **S4** angibt, wieviel von dem Sendevorsignal **S5w** in dem verstärkten Empfängerausgangssignal **S1** enthalten ist, ist dieses Filterausgangssignals **S4** ein Maß für die Intensität der Fluoreszenzstrahlung **FL.** Damit ist das Filterausgangssignal **S4** ein Maß für die magnetische Flussdichte **B** am Ort der NV-Zentren **NVZ** im Sensorelement SE.

Die Halbbrückensteuerung **CTRH** wertet den Nulldurchgang des Wechselsignalanteils des Filterausgangssignals **S4** aus und steuert bevorzugt in Abhängigkeit davon die Kommutierung des Motors mittels der Halbbrücken **HB.**

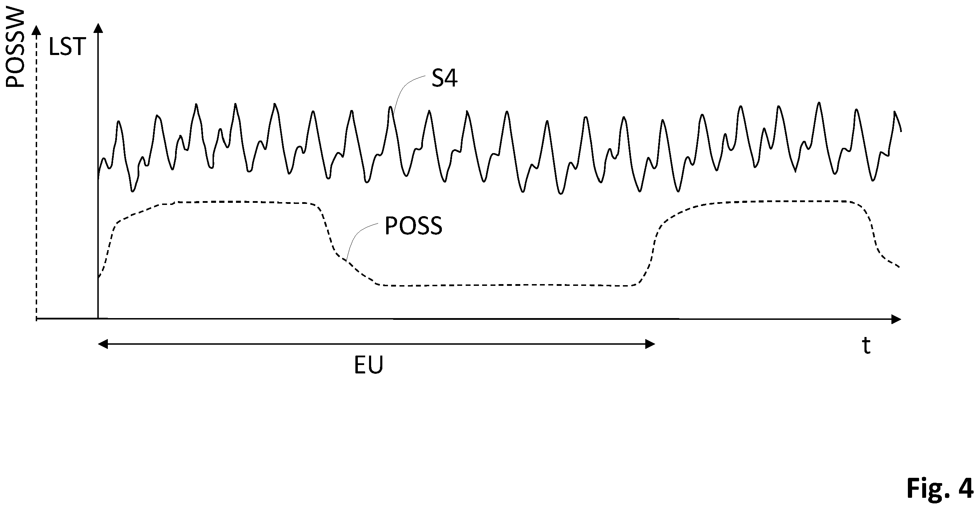

In dem Beispiel der Figur 1 ist das Sensorelement **SE** im Streufeld **BSTR** des Luftspalts **LS** des Motors platziert. Ein Positionssensor **POS** liefert mittels einer Markierung **MRK** am Rotor des Motors ein Positionssignal. In dem folgenden Beispiel der Figur 4 wird klar, dass das Signal ein binäres Signal mit einer beispielhaften 1 Bit-Auflösung ist. Der magnetischer Stator-Kreis **SMK** ist an dem Gehäuse **GH** befestigt. Eine mechanische Hülle MH aus Keramik schützt den gemeinsamen Lichtwellenleiter **LWL.** Eine Füllmasse **FM** dichtet die Öffnung **OF** im Motor ab.

Ein externer Datenbus **EXTDB** ermöglicht der Halbbrückensteuerung **CTRH** die Kommunikation mit einem übergeordneten Steuerungssystem. Der Externe Datenbus kann eine drahtgebundene oder drahtlose Datenverbindung sein. Mehrere parallele Datenverbindungen, die unterschiedliche realisiert sein können, sind denkbar.

### Figur 2

Die Figur 2 zeigt einen Lichtwellenleiter **LWL** mit einem Sensorelement **SE** direkt auf dem Zentrum **MP** des Kerns des Lichtwellenleiters **LWL.** Auf einem Teil der Endfläche **EF** des Lichtwellenleiters **LWL** ist das Sensorelement **SE** als Lichtwellenleiterlinse **LWLL** ausgeführt.

### Figur 3

Die Figur 3 zeigt einen Motor, wie ihn Figur 1 schematisch vereinfacht skizziert. Zusätzlich zu dem Lichtwellenleiter **LWL** mit dem Sensorelement SE, der über die besagte Öffnung **OF** in den Motor hineinreicht und der mit der mechanischen Hülle **MH umhüllt** ist, weist die Aufhängung des Motors einen Positionssensor **POS** mit einer LED und einer Fotodiode auf, die das Positionssignal **POSS** mit Hilfe einer Markierung **MRK** auf dem Rotorgehäuse **GHR** erzeugt. Die Leitungen der Motorphasen treiben den Motor an und steuern diesen. Der Rotor ist mittels der Achse **AX** drehbar im Stator gelagert. Die Motorphasen **MPH** bestromen die Stator-Spulen SL. Das Gehäuse fixiert die Komponenten des Stators, wie beispielsweise die Stator-Spulen **SL,** die Achse und **AX** (ohne die Drehbarkeit der Achse zu beeinträchtigen) und den Lichtwellenleiter **LWL** mit der mechanischen Hülle **MH.**

### Figur 4

Figur 4 zeigt das von dem Lock-In-Verstärker **LIV** erzeugte Filterausgangssignal **S4** und das Positionssignal POSS des Positionsdetektors **POS** der Figur 3. Der Motor dreht sich mit der Motordrehperiode **EU.** Es handelt sich um einen dreiphasigen Motor mit vier Spulen je Motorphase.

Das Besondere ist, dass die Messung des magnetischen Feldes **B** im Streubereich BSTR des Motorluftspalts **LS** rein optisch erfolgt. Die Frequenzen der Messignale zur Positionsmessung dieses magnetischen Feldes B im Luftspalt **LS** des Motors liegen allesamt und ausschließlich in dem Beispiel der Figuren 3 und 4 im optischen Bereich, also zwischen 3*10¹⁴Hz und 10¹⁴Hz. Hierdurch ist ein Übersprechen zwischen elektrischen Vorrichtungsteilen des Motors und der Messvorrichtung sehr gering, wenn die Ansteuer- und Auswertelemente der Vorrichtung weit genug von dem Motor entfernt sind. Bevorzugt liegt die Energieintensität der elektromagnetischen Strahlung, die der Lichtwellenleiter in den Motor transportiert und die die Messvorrichtung in dem Motor verwendet, im Frequenzbereich von 1Hz bis 10¹⁰Hz gegenüber der Energieintensität im Frequenzbereich zwischen 3*10¹⁴Hz und 10¹⁴Hz um -40dB, besser um -60dB, besser um - 90dB, besser um -120dB, besser um -200dB niedriger. Die Vorrichtung arbeitet also mikrowellenfrei.

Dies ist ein wesentlicher Vorteil gegenüber einer Messung mit Hall-Sonden oder dergleichen oder Messungen mit NV-Zentren unter Nutzung von Mikrowellen.

### Figur 5

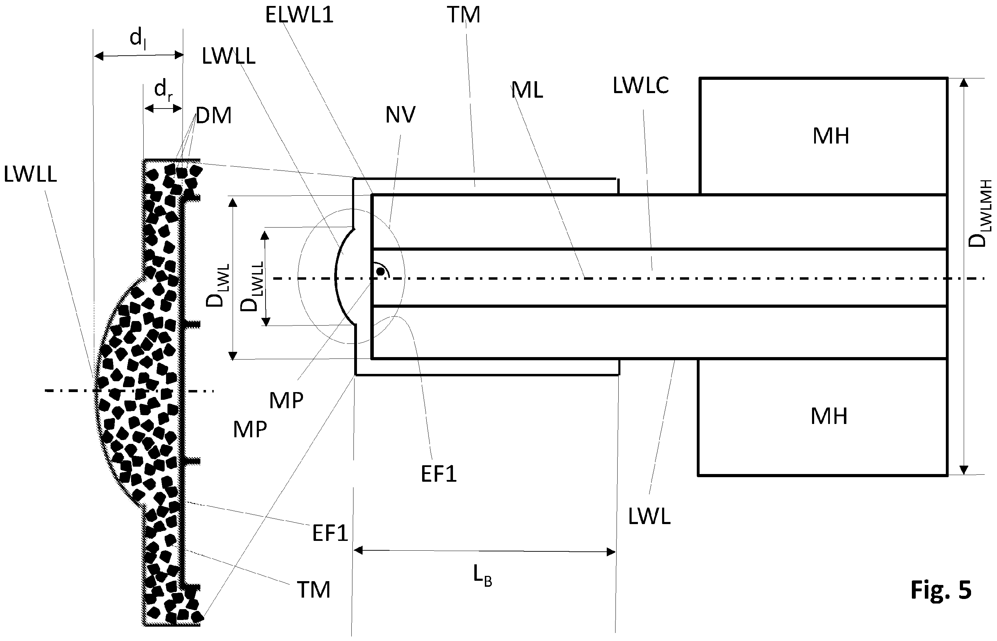

Figur 5 zeigt einen Querschnitt durch das beispielhafte erste Ende **ELWL1** eines vorschlagsgemäßen Lichtwellenleiters **LWL.** Der Lichtwellenleiter **LWL** weist einen Lichtwellenleiterkern **LWLC** auf. Es kann sich bei dem Lichtwellenleiter **LWL** um einen Monomodelichtwellenleiter oder einen Multimodelichtwellenleiter handeln. Der Lichtwellenleiter **LWL** kann ein Gradientenlichtwellenleiter oder ein Step-Index-Wellenleiter oder dergleichen sein, bei dem der Lichtwellenleiterkern **LWLC** fließend in den Außenbereich des Lichtwellenleiters **LWL** hinsichtlich des Brechungsindex übergeht. Die mechanische Hülle **MH** schützt den Lichtwellenleiter **LWL** und lässt das erste Ende **ELWL1** des Lichtwellenleiters **LWL** bevorzugt frei. Das Trägermaterial **TM des** Sensorelements **SE** umgibt das erste Ende **ELWL1** des Lichtwellenleiters **LWL.** Das Trägermaterial **TM** des Lichtwellenleiters **LWL** ist bevorzugt transparent für die Pumpstrahlungswellenlänge λₚₘₚ und die Fluoreszenzwellenlänge λ_{fl}. Die Transparenz bezieht sich hierbei auf die Dimensionen des Lichtwellenleiters **LWL** der einen Durchmesser **D_{LWL}** durchaus kleiner als 100µm aufweisen kann. Die Endfläche **EF** des Lichtwellenleiters **LWL** ist bevorzugt senkrecht zur optischen Achse des Lichtwellenleiters **LWL,** die hier als Mittenlinie **ML** beispielhaft gezeichnet ist. Am Durchstoßpunkt der optischen Achse, also der Mittenlinie **ML,** durch die Endfläche **EF** ist in dem Trägermaterial **TM** eine Lichtwellenleiterlinse **LWLL** als Verdickung des Trägermaterials **TM** gefertigt. Dort ist die Dicke **dₗ** des Trägermaterials **TM** typischerweise am dicksten. In den übrigen Bereichen des Sensorelements **SE** ist der Lichtwellenleiter **LWL** ggf. nur dünn mit einer kleineren Dicke dᵣ mit dem Trägermaterial **TM** beschichtet. Die Dicke **dᵣ** kann auch 0m betragen. Der Durchmesser **D_{LWLL}** der Lichtwellenleiter Linse **LWLL** ist typischerweise kleiner als der Durchmesser **D_{LWL}** des Lichtwellenleiters **LWL.** Zur Verdeutlichung ist das erste Ende **ELWL1** des Lichtwellenleiters **LWL** mit der Endfläche **EF** und der Lichtwellenleiterlinse **LWLL** links noch einmal herausvergrößert. Die kleinen stochastisch gleichverteilten Diamanten bzw. Nanodiamanten **DM** und/oder Kristalle im Material des Trägermaterials **TM** sind zur Verdeutlichung angedeutet. Bevorzugt sind die Diamanten **DM** Nanodiamanten mit einer Größe kleiner 500µm, besser kleiner 200µm, besser kleiner 100µm, besser kleiner 50µm, besser kleiner 20µm, besser kleiner 10µm, besser kleiner 5µm, besser kleiner 2µm, besser kleiner 1µm, besser kleiner 0,5µm, besser kleiner 0,2µm, besser, kleiner 0,1µm, besser, kleiner 50nm, besser, kleiner 20nm, besser, kleiner 10nm. Bevorzugt weisen die Kristalle eine Größe kleiner 500µm, besser kleiner 200µm, besser kleiner 100µm, besser kleiner 50µm, besser kleiner 20µm, besser kleiner 10µm, besser kleiner 5µm, besser kleiner 2µm, besser kleiner 1µm, besser kleiner 0,5µm, besser kleiner 0,2µm, besser, kleiner 0,1µm, besser, kleiner 50nm, besser, kleiner 20nm, besser, kleiner 10nm auf. Besonders bevorzugt sind Größen über 100nm, da Größen kleiner 100nm spezielle Oberflächeneffekte zwischen NV-Zentrum **NVZ** bzw. paramagnetischen Zentren und Diamantoberfläche des betreffenden Diamanten **DM** hervorrufen können. Besonders bevorzugt sind Kristallgrößen über 100nm, da Größen kleiner 100nm spezielle Oberflächeneffekte zwischen paramagnetischen Zentren und Kristalloberfläche des betreffenden Kristalls hervorrufen können . Bevorzugt umfassen eine Vielzahl dieser Diamanten bzw. Nanodiamanten **DM** und/oder Kristalle ein oder mehrere NV-Zentren **NVZ** und/oder ein oder mehrere paramagnetische Zentren, die dann die bei Bestrahlung mit geeigneter Pumpstrahlung **LB** Fluoreszenzstrahlung **FL** erzeugen.

### Figur 6

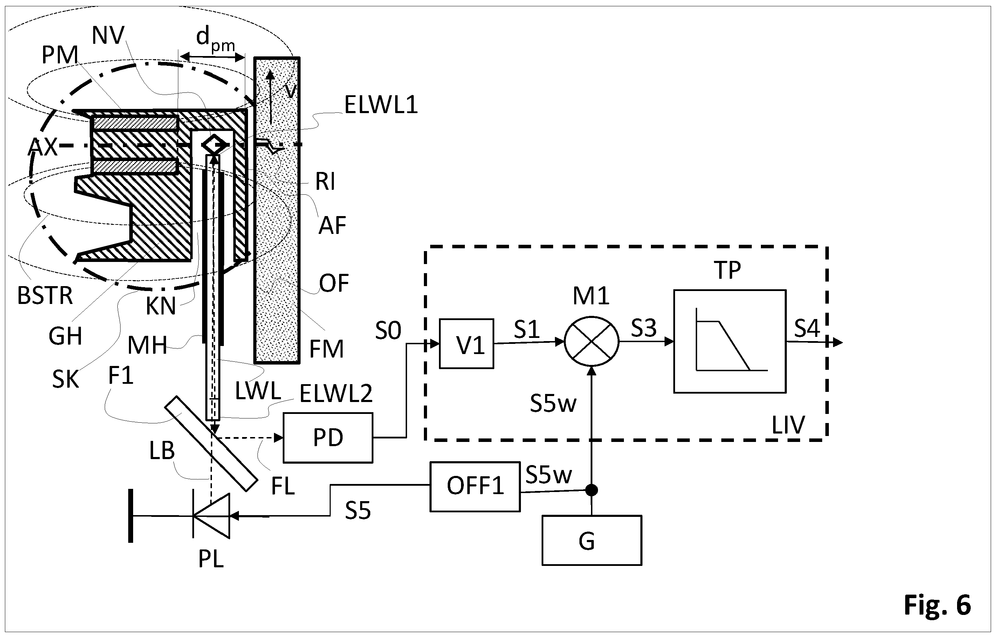

Figur 6 zeigt beispielhaft und schematisch vereinfacht ein beispielhaftes, vorschlagsgemäßes Materialmesssystem mit einem vorschlagsgemäßen Sensorkopf **SK.** Der Sensorkopf **SK** umfasst das Sensorkopfgehäuse **GH.** Das Sensorkopfgehäuse **GH** umfasst bevorzugt einen Permanentmagneten **PM.**

Bevorzugt ist der Permanentmagnet **PM** röhrenförmig ausgeführt. Bevorzugt weist der Permanentmagnet **PM** eine Permanentmagnetsymmetrieachse **AX** auf. Bevorzugt ist der Permanentmagnet **PM** parallel zur Permanentmagnetsymmetrieachse **AX** magnetisiert. Der bevorzugt röhrenförmige Permanentmagnet **PM** weist typischerweise ein erstes Ende und ein zweites Ende auf. Das zweite Ende des Permanentmagneten PM weist einen Permanentmagnetabstand dₚₘ von der Auflagefläche **AF** des Sensorkopfes **SK** auf. Da der Durchmesser des Lichtwellenleiters LWL weniger als 1mm beträgt ist der Permanentmagnetabstand **dₚₘ** kleiner als 1mm, besser kleiner als 0,5mm, besser kleiner als 200µm, besser kleiner als 100µm, besser kleiner als 20µm. Der der Permanentmagnetabstand **dₚₘ** ist bevorzugt im Bereich des Sensorelements **SE** bevorzugt etwas größer als der Durchmesser des Lichtwellenleiters **LWL..** Der der Permanentmagnetabstand **dₚₘ** ist im Bereich des Sensorelements **SE** bevorzugt weniger als 200% größer als der Durchmesser des Lichtwellenleiters LWL, besser weniger als 100% größer als der Durchmesser des Lichtwellenleiters **LWL,** , besser weniger als 50% größer als der Durchmesser des Lichtwellenleiters **LWL,** , besser weniger als 25% größer als der Durchmesser des Lichtwellenleiters **LWL,** , besser weniger als 10% größer als der Durchmesser des Lichtwellenleiters **LWL,** , besser weniger als 5% größer als der Durchmesser des Lichtwellenleiters **LWL.** Bevorzugt ist das Material des Gehäuses GH des Sensorkopfes SK nicht magnetisch und/oder nicht magnetisierbar. Im Sinne des hier vorgelegten Dokuments gilt ein Material als nicht magnetisch, wenn für die magnetische Permeabilität µ_{T} dieses Materials µ_{T}<1 gilt. Das hier vorgelegte Dokument empfiehlt die Verwendung von Materialien mit möglichst geringer magnetischer Permeabilität µ_{T} als Material des Sensorkopfgehäuses **GH.** Bevorzugt befindet sich das Sensorelement **SE** auf der verlängerten Symmetrieachse, der Permanentmagnetsymmetrieachse **AX** des Permanentmagneten **PM.**

Für die Messung bringen der Bediener oder ein mechanischer Aktor den Sensorkopf SK mit der Auflagefläche **AF** in Kontakt mit der Oberfläche **OF** des zu vermessenden Werkstücks. Bevorzugt umfasst die Oberfläche **OF** des zu vermessenden Werkstücks ein ferromagnetisches Material **FMM** (17).

West nun das zu vermessende Werkstück an seiner Oberfläche OF eine Störung auf, die die magnetische Flussdichte B beeinflusst, so ändert sich die magnetische Flussdichte B, die das Sensorelement **SE** durchflutet, wenn diese Störung in die Nähe der Permanentmagnetsymmetrieachse **AX** des Permanentmagneten **PM** und damit in die Nähe des Sensorelements **SE** kommt. Bei einer solchen Störung kann es sich beispielsweise um einen Riss Ri oder eine Bohrung oder eine Vertiefung oder einen sonstigen Defekt des Materials des Werkstücks in der Nähe der Oberfläche **OF** des Werkstücks handeln.

Der Generator **G** erzeugt das Sendevorsignal **S5w.** Bevorzugt ist das Sendevorsignal **S5w** pulsmoduliert mit einer Pulsfrequenz. Besonders bevorzugt handelt es sich um ein Rechtecksignal mit einem Duty-Cycle von bevorzugt 50%. Andere Duty-Cycles sind denkbar. Die Offset-Addition **OFF1** addiert bevorzugt einen Offset zu dem Wert des Sendevorsignals, um die Pumpstrahlungsquelle **PL** nutzen zu können. Bevorzugt weist das resultierende Sendesignal **S5** keine negativen Signalanteile auf. Die Pumpstrahlungsquelle **PL** erzeugt in Abhängigkeit von dem Sendesignal **S5** eine modulierte Pumpstrahlung **LB.** In dem Beispiel der Figur 1 transmittiert die Pumpstrahlungsquelle die Pumpstrahlung **LB** durch einen dichroitischer Spiegel **F1** und strahlt Pumpstrahlung **LB** in den Lichtwellenleiter **LWL** ein. Das Sensorkopfgehäuse **GH** weist zumindest einen Kanal **KN** auf, durch den der Lichtwellenleiter **LWL** in das Sensorkopfgehäuse **GH** eingeführt ist. Am Ende des Lichtwellenleiters **LWL** befindet sich bevorzugt das Sensorelement SE. Das Sensorelement **SE** umfasst bevorzugt eine Vielzahl von Nanodiamanten bzw. Diamanten **DM,** die bevorzugt eine statistisch geleichverteilte unterschiedliche Kristallorientierung aufweisen und die in ein Matrixmaterialeingebettet sind. Typischerweise verbindet das Matrixmaterial aus einem Trägermaterial **TM** diese Nano-Diamanten **ND** mechanisch mit dem ersten Ende **ELWL1** des Lichtwellenleiters **LWL.** Bevorzugt hat der eigentliche Lichtwellenleiter **LWL** einen Lichtwellenleiterdurchmesser **D_{LWL}** von ca. 100µm. Bevorzugt sind kleinere Lichtwellenleiterdurchmesser **D_{LWL}.** Größere Lichtwellenleiterdurchmesser **D_{LWL}** sind aber möglich. Hinzukommt typischerweise ein Knickschutz des Lichtwellenleiters **LWL.** Bevorzugt ist der Knickschutz als mechanische Hülle **MH** ausgeführt. Die Pumpstrahlung **LB** der Pumpstrahlungsquelle **PL** trifft am ersten Ende des Lichtwellenleiters **ELWL1** auf die Nanodiamanten bzw. Diamanten **DM** im Sensorelement SE. Bevorzugt umfasst das Sensorelement SE Diamanten mit **NV-**Zentren. Typischerweise regt die Pumpstrahlung **LB** die Nanodiamanten bzw. Diamanten **DM** zur Emission einer Fluoreszenzstrahlung **FL** mit einer Fluoreszenzwellenlänge λ_{fl} an. Bevorzugt befindet sich das Sensorelement SE am ersten Ende **ELWL1** des Lichtwellenleiters **LWL.** Bevorzugt hat das Sensorelement einen Durchmesser, der kleiner als der Durchmesser **D_{LWL}** des Lichtwellenleiters **LWL** ist. Typischerweise strahlen die NV-Zentren **NVZ** des Sensorelements **SE** die Fluoreszenzstrahlung **FL** wieder in den Lichtwellenleiter **LWL** über das erste Ende **ELWL1** des Lichtwellenleiters **LWL** ein. Die Fluoreszenzstrahlung **FL** tritt am anderen, zweiten Ende **ELWL2** des Lichtwellenleiters **LWL** aus dem Lichtwellenleiter **LWL** wieder aus und bestrahlt, beispielsweise umgelenkt durch den dichroitischen Spiegel **F1,** vorzugsweise den Fotodetektor **PD.** Der dichroitische Spiegel **F1** lenkt die gestreute Pumpstrahlung **LB** in dem Beispiel der Figur 1 nicht in Richtung des Fotodetektors **PD.** Hierdurch empfängt der Fotodetektor **PD** im Wesentlichen nur Fluoreszenzstrahlung **FL.** Im Wesentlichen bedeutet hierbei, dass die Pumpstrahlung **LB** und die sonstige Strahlung, die den Fotodetektor **PD** trotzdem treffen im Wesentlichen für den technischen Zweck der Vorrichtung unbedeutend sind. Um dies zu erreichen, schlägt das hier vorgestellte Dokument die Verwendung eines lichtdichten Gehäuses für die lichtempfindlichen Vorrichtungsteile und die Verwendung von Blenden vor, um den Zutritt unerwünschter Strahlung und unerwünschte Effekte durch Streustrahlung zu vermeiden. Der Fotodetektor **PD** wandelt bevorzugt die Intensität der Fluoreszenzstrahlung **FL** in einen zeitlichen Werteverlauf eines Empfangssignals **S0.** Ein beispielhafter Verstärker **V1** verstärkt und filtert ggf. das Empfängerausgangssignal **S0** in dem Beispiel der Figur 1 zum verstärkten Empfängerausgangssignal **S1.** In dem Beispiel der Figur 1 multipliziert ein beispielhafter Multiplizierer **M1** das verstärkte Empfängerausgangssignal **S1** mit dem Sendevorsignal **S5w** zum Filtereingangssignal **S3.** Ein Tiefpassfilter **TP** entfernt typischerweise die Frequenzanteile mit den addierten Frequenzen des Sendevorsignals **S5w** und des verstärkten Empfängerausgangssignals **S1** aus dem Spektrum. Der Tiefpassfilter **TP** filtert so das Empfängereingangssignal zum Filterausgangssignal **S4.** Die Kombination aus dem ersten Multiplizierer M1 und dem Tiefpassfilter **TP** bildet ein Skalarprodukt zwischen dem Signalvektor des verstärkten Empfängerausgangssignal **S1** und dem Sendevorsignal **S5w.** Es handelt sich um einen einfachen beispielhaften Synchrondemodulator. Der Synchrondemodulator erzeugt ein Signal **S4,** dass die Korrelation zwischen dem verstärkten Empfängerausgangssignal **S1** und dem Sendevorsignal **S5w** symbolisiert. Dieses Signal **S4** ist das Filterausgangssignal **S4.** Die Verwendung anderer Korrelatoren an Stelle eines Synchrondemodulators, beispielsweise die Verwendung von Optimalfiltern, Kalmann-Filtern und/oder Matched-Filtern ist denkbar. Das Besondere an dem Messverfahren der Figur 1 ist, dass der Lichtwellenleiter **LWL** zusammen mit dem Sensorelement **SE** und den anderen Vorrichtungsteilen des Sensorkopfes **SK** typischerweise keine ferromagnetischen und/oder elektrisch leitenden Materialien umfasst und damit das magnetische Feld des Werkstücks, bzw. des ferromagnetischen Materials **FM** und des Permanentmagneten **PM** im Wesentlichen nicht beeinflusst.

Die Intensität der Fluoreszenzstrahlung **FL** der Diamanten **DM** bzw. Nanodiamanten des Sensorelements **SE** hängt von der magnetischen Flussdichte **B** am Ort der NV-Zentren **NVZ** des Sensorelements **SE** ab. Da der Wert des Filterausgangssignals **S4** angibt, wieviel von dem Sendevorsignal **S5w** in dem verstärkten Empfängerausgangssignal **S1** enthalten ist, ist dieses Filterausgangssignals **S4** ein Maß für die Intensität der Fluoreszenzstrahlung **FL.** Damit ist das Flussdichtemesssignal **S4** ein Maß für die magnetische Flussdichte **B** am Ort der NV-Zentren **NVZ** im Sensorelement **SE.**

In dem Beispiel der Figur 1 ist das Sensorelement **SE** im Streufeld **BSTR** des Permanentmagneten **PM** platziert. Das ferromagnetische Material FM des Werkstücks beeinflusst dieses Streufeld **BSTR.** Wenn nun ein Bediener oder ein Aktor das Werkstück und damit das ferromagnetische Material **FM** an der Oberfläche **OF** des Werkstücks an der Auflagefläche **AF** entlangschiebt, so ändert sich eine Beeinflussung des magnetischen Streufelds **BSTR** nur dann, wenn diese Translationsbewegung mit der Geschwindigkeit v den das magnetische Streufeld BSTR beeinflussenden Bereich des ferromagnetischen Materials in seiner Verteilung physikalischer Parameter beeinflusst. Eine solcher Beeinflussung kann eine Ungleichverteilung physikalischer Parameter im ferromagnetischen Material **FM** hervorrufen, die das magnetische Streufeld **BSTR** beeinflusst. Bevorzugt ist die Vorschubgeschwindigkeit v des Sensorkopfes **SK** gegenüber dem Werkstück mit dem ferromagnetischen Material **FM** konstant. Bevorzugt führt ein Bediener manuell den Vorschub des Sensorkopfes **SK** gegenüber dem Werkstück mit der Vorschubgeschwindigkeit **v** durch. Das hier vorgelegte Dokument schlägt vor, für Produktionsprüfungen einen Aktor vorzusehen, der der den Sensorkopf **SK** mit der Auflagefläche **AF** auf der Oberfläche **OF** des Werkstücks oder dicht an der der Oberfläche **OF** des Werkstücks platziert und dann parallel zur Oberfläche OF des Werkstücks längs einer zu untersuchenden Linie zu verschieben. Bevorzugt erfasst ein Rechnersystem dabei mittels eines Koordinatensensorsystems die Position des Sensorkopfes **SK** und damit des Sensorelements **SE** relativ zum Werkstück und damit dem ferromagnetischen Material **FM.** Bevorzugt erfasst das Rechnersystem den Wert des Filterausgangssignals **S4** zusammen mit den Koordinaten der Position des Sensorkopfes **SK** und damit der Position des Sensorelements **SE.** Bevorzugt speichert das Rechnersystem diese Paare aus Koordinaten des Messpunkts und Messwert des Filterausgangssignals **S4** in einem Speicher des Rechnersystems. Das Rechnersystem kann diese Daten beispielsweise zu einem zwei oder dreidimensionalen Model der Verteilung der Magnetisierbarkeit weiterverarbeiten. Beispielsweise kann das Rechnersystem eine zweidimensionale Verteilung der Werte des Filterausgangssignals **S4** auf der Oberfläche **OF** des Werkstücks und damit des ferromagnetischen Materials **FM** ermitteln und auf einem Bildschirm darstellen oder beispielsweise als JPEG-Bild oder funktionsäquivalenter Form bereithalten. Die Vorschubgeschwindigkeit **v** kann für eine Punktmessung 0m/s sein. der Eine mechanische Hülle **MH** umfassend Keramik oder ein Gewebe oder einen robusten Kunststoff schützt den gemeinsamen Lichtwellenleiter **LWL.** Der Lichtwellenleiter **LWL** kann mittels einer Schraube **SCHR** im Kanal **KN** des Sensorkopfgehäuses **GH** befestigt sein. Ein externer Datenbus **EXTDB** ermöglicht der Halbbrückensteuerung **CTRH** die Kommunikation mit einem übergeordneten Steuerungssystem.

Der Externe Datenbus kann eine drahtgebundene oder drahtlose Datenverbindung sein. Mehrere parallele Datenverbindungen, die unterschiedliche realisiert sein können, sind denkbar.

### Figur 7

Figur 7 zeigt einen Sensorkopf **SK** mit der mechanischen Hülle des Lichtwellenleiters **LWL,** der durch die mechanische Hülle **MH** verdeckt ist. Die Zeichnung zeigt den Permanentmagneten **PM.** Die Auflagefläche **AF** ist unten und verdeckt.

### Figur 8

Figur 8 zeigt den Sensorkopf der Figur 7 in der Aufsicht (Figur 8a) und in der Seitenansicht (Figur 8b) als Schnittbild.

Die mechanische Hülle **MH** des Lichtwellenleiters **LWL** ist mit dem Lichtwellenleiter **LWL** im Kanal **KN** des Sensorkopfgehäuses **GH** des Sensorkopfes **SK** mittels einer Schraube **SCHR** fixiert. Es ist denkbar, die mechanische Hülle MH des Lichtwellenleiters **LWL** mit dem Lichtwellenleiter **LWL** im Kanal **KN** des Sensorkopfgehäuses **GH** des Sensorkopfes **SK** mittels einer Klebung zu fixieren. Der Permanentmagnet **PM** ist beispielhaft als Zylinder ausgeführt. Das untere Ende des Permanentmagneten **PM** hat einen Abstand **dₚₘ** zur Auflagefläche **AF.** Die Auflagefläche **AF** liegt in dem Beispiel der Figur 5 auf der Oberfläche **OF** des beispielhaft ferromagnetischen Materials **FM** des Werkstücks auf. In dem ferromagnetischen Material **FM** soll sich beispielhaft ein Riss **RI** befinden. Dieser Riss **RI** beeinflusst das Streufeld **BSTR** des Permanentmagneten **PM.** Das Sensorelement **SE** befindet sich am ersten Ende **ELWL1** des Lichtwellenleiters **LWL.** Bevorzugt befindet sich das Sensorelement **SE** in der Nähe der Verlängerung der Achse **AX** des zylindrischen Permanentmagneten **PM.** Der Riss **RI** beeinflusst das Streufeld **BSTR** des Permanentmagneten **PM** im Bereich des Sensorelements **SE.** Daher beeinflusst der Riss **RI** die Intensität der Fluoreszenzstrahlung **FL** der NV-Zentren **NVZ** bzw. paramagnetischen Zentren im Sensorelement SE.

Der beispielhafte Sensorkopf **SK** hat die Höhe **d_{SK1}.** Der beispielhafte Sensorkopf **SK** hat die Länge **d_{SK2}.** Der beispielhafte Sensorkopf **SK** hat die Breite **d_{SK3}.**

An der Oberseite entgegengesetzt zur Auflagefläche **AF** weist der Sensorkopf **SK** eine Vertiefung **VT** mit der Tiefe d_{SK4} bezogen auf die Oberseite des Sensorkopfes **SK** auf. Sofern der Sensorkopf **SK** für eine manuelle Positionierung auf der Oberfläche **OF** des Werkstücks vorgesehen ist, hat die Vertiefung **VT** bevorzugt eine Tiefe d_{SK4} zwischen 3mm und 1,5cm, wobei 5mm bis 8mm bevorzugt sind. Dies verbessert die Handhabbarkeit. In dem Beispiel der Figur 5 weist der Kanal **KN** einen Knick **KI** um einen Winkel auf. Dies hat zum ersten den positiven Effekt einer gewissen mechanischen Klemmung des Lichtwellenleiters **LWL** im Kanal **KN** und zum zweiten den Effekt, dass der Lichtwellenleiter **LWL** parallel zur Auflagefläche **AF** aus dem Sensorkopf **SK** austreten kann. Dies hat den Vorteil, dass der Lichtwellenleiter **LWL** aufgrund seiner Flexibilität in geringerem Abstand vom Sensorkopf **SK** beispielsweise auf einer Arbeitsplatte zum Liegen kommt als ohne diesen Knick KI. Hierdurch verringert sich das Drehmoment, das der Lichtwellenleiter **LWL** auf den Sensorkopf **SK** ausübt. Zum Dritten kann das Sensorelement **SE** hierdurch näher zur Auflagefläche **AF** des Sensorkopfes **SK** positioniert werden. Bevorzugt bildet daher der Lichtwellenleiter **LWL** mit der Auflagefläche **AF** in unmittelbarer Nähe des Sensorelements **SE** einen Winkel α, der von 90° und 0° verschieden ist. Typischerweise liegt der Winkel α zwischen 15° und 65°, bzw. besser 25° und 55°. Winkel α von 30° und 45° sind derzeit in Benutzung.

in der Figur 5 ist eine ferromagnetische Stütze **ST** vorgesehen, die die magnetische Erregung **H** des Permanentmagneten **PM** zum Material des Werkstücks, hier dem ferromagnetischen Material **FM,** leitet. In dem Beispiel der Figur 5 handelt es sich bei der ferromagnetische Stütze **ST** um ein beispielhaftes ferromagnetisches Rohr. Die ferromagnetische Stütze **ST** hat in dem Beispiel der Figur 5 beispielhaft in etwa den gleichen Durchmesser wie der Permanentmagnet **PM.** In dem Beispiel der Figur 5 weist die ferromagnetische Stütze **ST** eine Öffnung **OE** im unteren Bereich auf. Durch diese Öffnung **OE** gelangt der Lichtwellenleiter **LWL** in das Innere der ferromagnetischen Stütze **ST.** Diese Öffnung **OE** ist somit Teil des Kanals **KN** im Sensorkopfgehäuse **GH.** Die ferromagnetische Stütze **ST** ist mit einem Füllmaterial eines Kerns **KE** der Stütze **ST** und des Permanentmagneten **PM** gefüllt. Der Kanal **KN** setzt sich aus dem Material des übrigen Sensorkopfgehäuses **GH** durch die Öffnung **OE** in diesen Kern **KE** hinein fort. In dem Beispiel der Figur 5 stimmt die Rotationssymmetrieachse **AX** des Permanentmagneten **PM** mit der Rotationssymmetrieachse der ferromagnetischen Stütze **ST** beispielhaft überein. Bevorzugt ist der Kanal **KN** im Kern **KE** daher so ausgeführt, dass nach dem Einbringen des Lichtwellenleiters **LWL** das Sensorelement **SE** sich in der Nähe der Verlängerung dieser Symmetrieachse **AX** befindet.

Bevorzugt umfasst der Sensorkopf **SK** also zumindest ein Mittel zur Erzeugung einer magnetischen Erregung, nämlich den Permanentmagneten **PM,** und ein Sensorelement SE, dass über zumindest einen Lichtwellenleiter **LWL.** Der Lichtwellenleiter **LWL** ist dazu eingerichtet mit einer Ansteuer- und Auswertevorrichtung (siehe Figur 1) verbunden zu werden oder ist mit dieser verbunden. Der Sensorkopf umfasst des Weiteren ein Sensorkopfgehäuse **GH** aus einem nicht ferromagnetischen Material (µₜ<1). Bevorzugt umfasst der Sensorkopf **SK** weitere Funktionselemente eines oder mehrerer magnetischer Kreise. Ein solches weiteres Funktionselement eines oder mehrerer magnetischer Kreise kann beispielsweise die ferromagnetische Stütze **ST** sein. Bevorzugt ist der Sensorkopf **SK** dazu ausgelegt, dass der Permanentmagnet **PM** und die weiteren Funktionselemente eines oder mehrerer magnetischer Kreise des Sensorkopfes **SK** über eine Auflagefläche **AF** mit einem Bereich der Oberfläche **OF** eines Werkstücks zumindest einen gemeinsamen magnetischen Kreis bilden, wenn der Sensorkopf **SK** mit der Auflagefläche **AF** auf der Oberfläche **OF** des Werkstücks platziert wird.

### Figur 9

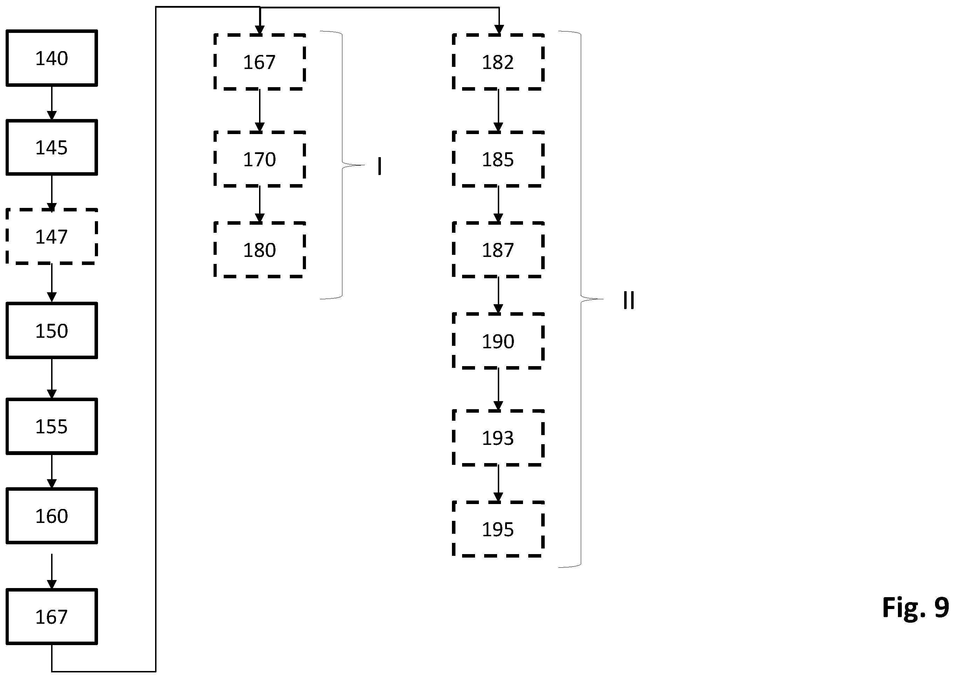

Figur 9 zeigt die Schritte des Verfahrens zur Herstellung eines vorschlagsgemäßen Sensorkopfes **SK** und dessen Verwendung. Das Verfahren umfasst die Schritte:
- Bereitstellen **140** eines Lichtwellenleiters **LWL,** wobei der Lichtwellenleiter **LWL** ein erstes Ende **ELWL1** und ein zweites Ende **ELWL2** aufweist;
- Bereitstellen **145** eines flüssigen und mittels elektromagnetischer Strahlung einer Aushärtewellenlänge λ_{H} härtbaren Trägermaterials **TM,** wobei in das Trägermaterial (TM) eine Vielzahl von Diamanten **DM** bzw. Nanodiamanten eingebettet sind und wobei einer oder mehrere oder alle Diamanten DM bzw. Nanodiamanten dieser Diamanten **DM** NV-Zentren **NVZ** und/oder andere paramagnetischen Zentren aufweisen und wobei die NV-Zentren **NVZ** des Trägermaterials **TM** und/oder die anderen paramagnetischen Zentren des Trägermaterials **TM** bei Bestrahlung mit Pumpstrahlung **LB** zumindest eine Fluoreszenzstrahlung **FL** emittieren;
- ggf. Vorhärten **147** (Pre-Bake) des Sensorelements **SE** durch eine vorausgehende Temperaturbehandlung.
- Benetzen **150** des ersten Endes des Lichtwellenleiters **TM** auf eine Benetzungslänge L_{B} mit dem Trägermaterial **TM,** das die Vielzahl eingebetteter Diamanten **DM** bzw. Nanodiamanten und/oder Kristalle mit einem oder mehreren NV-Zentren und/oder einem oder mehreren paramagnetischen Zentren aufweist;
- Einspeisen **155** elektromagnetischer Strahlung in das zweite Ende **ELWL2** des Lichtwellenleiters **LWL,** wobei die Wellenlänge dieser elektromagnetischen Strahlung, die Aushärtewellenlänge λ_{H} so gewählt ist, dass das Trägermaterial **TM** am zweiten Ende **ELWL2** des Lichtwellenleiters **LWL** aushärtet und sich in einen Festkörper wandelt, wobei das ausgehärtete Trägermaterial **TM** das Sensorelement **SE** ausbildet;
- Entfernen **160** des nicht ausgehärteten Trägermaterials **TM** insbesondere mittels eines Lösungsmittels, wobei der verbleibende Film des Trägermaterials **TM** am ersten Ende des Lichtwellenleiters LWL das Sensorelement bildet;
- ggf. Nachhärten **165** (Post-Bake) des Sensorelements **SE** durch eine nachfolgende Temperaturbehandlung.
Im ersten Anwendungsbeispiel eines Sensorkopfes **SK** können folgende optionale Schritte eines ersten beispielhaften Anwendungsprozesses als nachfolgen (Variante **I)** folgen:
- Bereitstellen **167** eines Sensorkopfgehäuses **GH** des Sensorkopfes **SK** und einer Erregungsquelle für eine magnetische Erregung **H,** insbesondere eines Permanentmagneten **PM;**
- Einbau **170** des Lichtwellenleiters **LWL** mit dem neu gebildeten Sensorelement **SE** in den Kanal **KN** des Sensorkopfgehäuses **GH** des Sensorkopfes **SK** und Einbau der einer Erregungsquelle für eine magnetische Erregung **H** in das Sensorkopfgehäuses **GH** des Sensorkopfes **SK;**
- Verwendung **180** des Sensorkopfes **SK** zur ortsaufgelösten Vermessung der magnetischen Eigenschaften des Materials eines Werkstücks in der Nähe der Oberfläche **OF** des Werkstücks, wobei die Ortsauflösung besser als 500µm und/oder besser als 200µm und/oder besser als 100µm und/oder besser als 50µm und/oder besser als 20µm und/oder besser als 10µm ist. Dabei ist Auflösung die Möglichkeit zwei beieinanderliegende Störungen der magnetischen Eigenschaften einer Oberfläche OF eines Werkstücks noch durch ein Extremum von 5% der Signalamplitude zu können, wenn diese entsprechend der Auflösung voneinander beabstandet sind. Solche Störungen können beispielsweise Risse, Lunker, Materialinhomogenitäten etc. sein.
Im zweiten Anwendungsbeispiel eines Motors können folgende optionale Schritte eines zweiten beispielhaften Anwendungsprozesses als nachfolgen (Variante II) folgen:
- Bereitstellen **182** eines Gehäuses **GH** des Motors;
- Einbau **185** des Lichtwellenleiters **LWL** mit dem neu gebildeten Sensorelement **SE** in die Öffnung OF des Gehäuses **GH** des Motors;
- Verwendung **187** des Lichtwellenleiters **LWL** mit dem neu gebildeten Sensorelement **SE** zur Vermessung der magnetischen Flussdichte B innerhalb des Luftspalts **LS** des Motors oder im Streufeld **BSTR** des Magnetfelds im Luftspalt **LS.**
- ggf. Ermittlung **190** des Zeitpunkten des Nulldurchgangs des Betrags der magnetischen Flussdichte B der magnetischen Flussdichte **B** innerhalb des Luftspalts **LS** des Motors oder im Streufeld **BSTR** des Magnetfelds im Luftspalt **LS** und/oder ggf. Ermittlung **190** des Betrags der magnetischen Flussdichte **B** der magnetischen Flussdichte **B** innerhalb des Luftspalts **LS** des Motors oder im Streufeld **BSTR** des Magnetfelds im Luftspalt **LS.**
- ggf. Ermittlung **193** oder Schätzung der Position des Magnetfelds innerhalb des Luftspalts des Motors.
- ggf. Kommutierung **195** der Bestromung einer oder mehrerer Statorspulen des Motors und/oder einer oder mehrerer Rotorspulen des Motors in Abhängigkeit
   ∘ von den ermittelten Zeitdurchgängen des Nulldurchgangs des Betrags der magnetischen Flussdichte B der magnetischen Flussdichte **B** innerhalb des Luftspalts **LS** des Motors oder im Streufeld **BSTR** des Magnetfelds im Luftspalt **LS** und/oder
   ∘ von dem ermittelten Betrags der magnetischen Flussdichte **B** der magnetischen Flussdichte **B** innerhalb des Luftspalts **LS** des Motors oder im Streufeld **BSTR** des Magnetfelds im Luftspalt **LS** und/oder von der ermittelten oder geschätzten Position des Magnetfelds innerhalb des Luftspalts des Motors;

### Figur 10

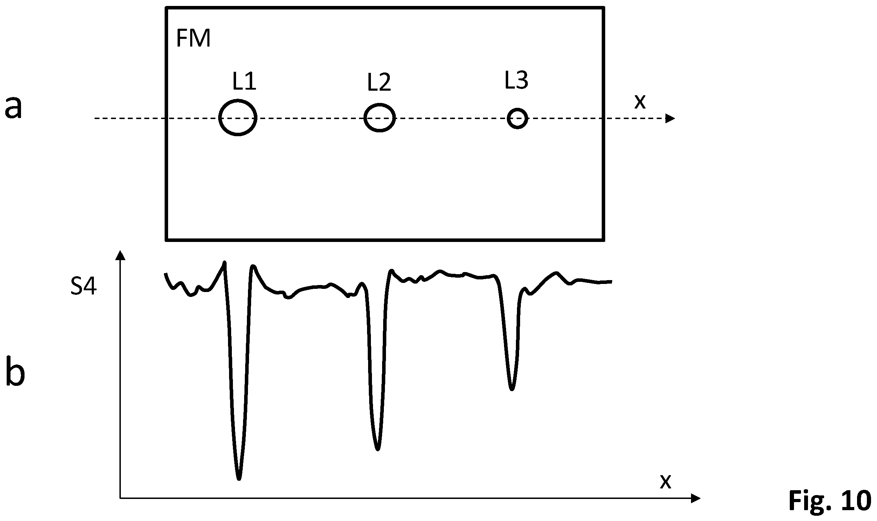

Figur 10a zeigt ein beispielhaftes Werkstück aus einem ferromagnetischen Material **FM** in der Aufsicht. In die Oberfläche des Werkstücks sind verschiedene Bohrungen **L1** bis **L3** als Simulation eines Risses RI eingebracht. Die erste Bohrung **L1** soll beispielsweise einen beispielhaften Durchmesser von 4mm aufweisen. Die zweite Bohrung **L2** soll beispielsweise einen beispielhaften Durchmesser von 3mm aufweisen. Die dritte Bohrung **L3** soll beispielsweise einen beispielhaften Durchmesser von 2mm aufweisen.

Für die Erstellung der Figur 10b wurde ein Sensorkopf **SK,** wie in den Figuren 7 und 8 dargestellt über die Oberfläche **OF** des Werkstücks längs des mit **x** bezeichneten Weges verschoben, wobei der Kontakt zwischen der Auflagefläche **AF** und der Oberfläche **OF** des Werkstücks beibehalten wurde.

Der Werteverlauf des so erhaltenen Messignals **S4** ist in der Figur 10b in Abhängigkeit von der Position x des Sensorkopfes **SK** auf der Oberfläche **OF** dargestellt. Aufgrund der geringen Größe **D_{LWL}** des Sensorelements **SE** ist die Ortsauflösung erheblich, was aus dem Stand der Technik unbekannt ist und damit die Detektion von Fertigungsfehlern und Werkstückunregelmäßigkeiten mit ganz neuer Geschwindigkeit und Präzision ermöglicht.

### Figur 11

Figur 11 zeigt eine vorschlagemäße Anwendungsvorrichtung in Form einer Magnetfeldkamera in Form des vorschlagsgemäßen Magnetfeldkamerakopfes **21** aus einer ersten Ansicht. Eine Lichtquelle **2** (Laser, LED) des vorschlagsgemäßen Magnetfeldkamerakopfes **21** bestrahlt die Sensorschicht **5** des vorschlagsgemäßen Magnetfeldkamerakopfes **21 mit** Pumpstrahlung **13** einer Pumpstrahlungswellenlänge λₚₘₚ. Die Sensorschicht **5** umfasst bevorzugt Kristalle mit paramagnetischen Zentren. Bevorzugt umfassen die Kristalle 66 der Sensorschicht **5** Diamanten. Bevorzugt umfassen die Kristalle **66** der Sensorschicht **5** Nanokristalle **66.** Bevorzugt handelt es sich bei den paramagnetischen Zentren in der Sensorschicht **5** um NV-Zentren in Diamantkristallen. Bevorzugt umfasst das Trägermaterial der Sensorschicht **5** die Kristalle und/oder Nanokristalle **66.** Diese Sensorschicht **5** ist bevorzugt auf einer ebenen Fläche im Innern des Gehäuses **8** der des vorschlagsgemäßen Magnetfeldkamerakopfes **21** aufgebracht. Die Sensorschicht **5** umfasst somit paramagnetische Zentren. Da die Kristalle **66** sehr klein als Nanokristalle **66** ausgeführt sein können, kann die Dicke **25** der Sensorschicht **5** sehr dünn ausgeführt sein und die Sensorschicht **5** sehr dicht mit Kristallen **66** mit paramagnetischen Zentren angefüllt sein. Bei Bestrahlung mit Pumpstrahlung **13** der Pumpstrahlungswellenlänge λₚₘₚ emittieren die paramagnetischen Zentren der Sensorschicht **5** Fluoreszenzstrahlung **14** mit einer Fluoreszenzwellenlänge λ_{fl}. Eine beispielhafte Größe der Sensorschicht **5** kann beispielsweise 32mm x 22mm betragen. Andere Dimensionen sind möglich. Bei einer Nacharbeit sollten die Personen, die die Nacharbeit durchführen die Dimensionen der Sensorschicht **5** entsprechend der jeweiligen konkret vorgesehenen Anwendung wählen. Ein Lichtsensorarray **1** mit n x m Lichtsensoren und mit einer Auswerteelektronik des Lichtsensorarrays 1 erfasst diese Fluoreszenzstrahlung **14**.Die erfolgreiche Erprobung der hier vorgestellten Vorrichtung mit dem hier vorgestellten Magnetfeldkamerakopfes **21** umfasste ein Lichtsensorarray **1** mit n x m Lichtsensoren mit n=900 und m= 600. Bevorzugt umfasst die Auswertelektronik **15** des Lichtsensorarrays **1,** die Ansteuerung des Lichtsensorarrays **1** und der der Lichtsensoren des Lichtsensorarrays **1,** die Energieversorgung der Lichtsensoren des Lichtsensorarrays **1,** die Aufbereitungsschaltung **30** für die Ausgangssignale **31** der Lichtsensoren des Lichtsensorarrays **1,** und eine Schnittstellenschaltung **36** zur Weitergabe der Werte der Werte der Ausgangssignale **31** der Lichtsensoren des Lichtsensorarrays **1,** an ein übergeordnetes System, beispielsweise ein Rechnersystem **28** zur Bedienung des Magnetfeldkamerakopfes **21** mit einem Bildschirm **32** über einen Datenbus **29** oder dergleichen. Bevorzugt befindet sich der Strahlengang der Pumpstrahlung **13** und der Fluoreszenzstrahlung **14** innerhalb eines Gehäuses **8.** Das hier vorgelegte Dokument nennt die Oberfläche der Sensorschicht **5,** die dem Lichtsensorarray **1** zugewandt ist, im Folgenden Oberseite der **23** Sensorschicht **5.** Das hier vorgelegte Dokument nennt die gegenüberliegende Oberfläche der Sensorschicht **5,** die dem Lichtsensorarray **1** nicht zugewandt ist, im Folgenden Unterseite **22** der Sensorschicht **5.**

Die Oberseite **23** der Sensorschicht **5** befindet sich vorzugsweise innerhalb des Gehäuses **8.**

Die Unterseite **22** der Sensorschicht **5** befindet sich vorzugsweise außerhalb des Gehäuses **8.** an dessen Oberfläche. Vorzugsweise bedeckt ein Lichtschutz die Unterseite **22** der Sensorschicht **5.** Dies verhindert, dass Licht in das Gehäuse **8** eindringt und zum Lichtsensorarrays **1** gelangt. Die Sensorschicht **5** ist bevorzugt transparent für elektromagnetische Strahlung, insbesondere Pumpstrahlung **13,** der Pumpstrahlungswellenlänge λₚₘₚ. Die Sensorschicht **5** ist bevorzugt transparent für elektromagnetische Strahlung, insbesondere Fluoreszenzstrahlung **14,** der Fluoreszenzstrahlungswellenlänge **λ_{fl}.** Beispielsweise kann der Lichtschutz ein Lack auf der Unterseite **22** der Sensorschicht **5** oder ein besonders dünner, lichtundurchlässiger Teil der Gehäusewand des Gehäuses **8** sein. Bevorzugt beeinflusst eine solche dünne Gehäusewand des Gehäuses **8** im Bereich der Sensorschicht **5** das magnetische Feld, also beispielsweise die magnetische Flussdichte **B** nicht.

Bevorzugt umfasst das Lichtsensorarray **1** n x m Lichtsensoren, die vorzugsweise in einer Fläche angeordnet sind. Hierbei sind n und m positive ganze Zahlen.

Zur besseren Übersicht ist der Deckel, der den Innenraum des Gehäuses **8** abdeckt in der Figur 11 nicht dargestellt.

### Figur 12

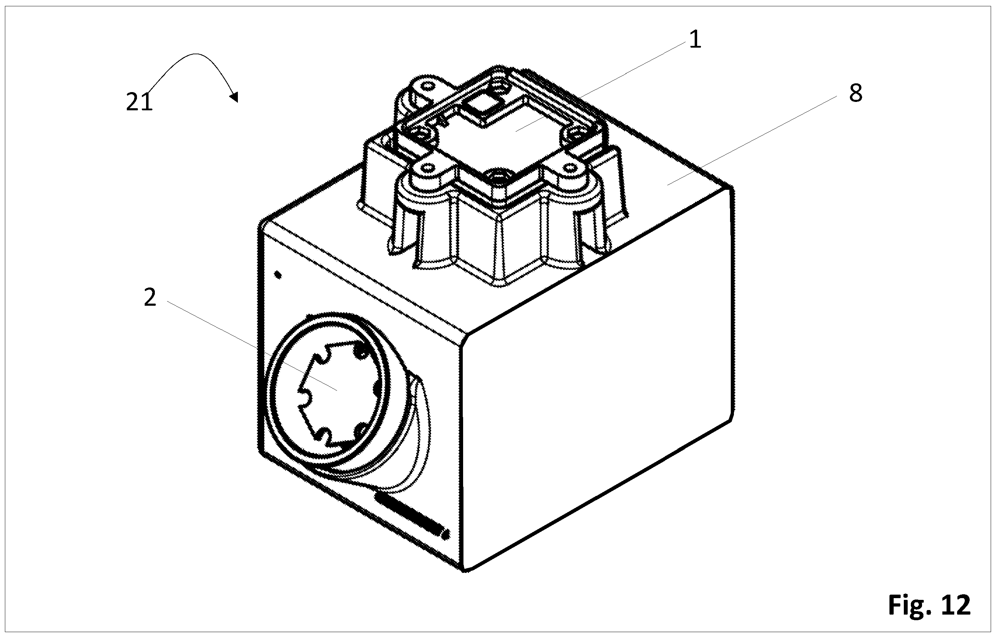

Figur 12 zeigt die Vorrichtung mit aufgesetztem Deckel zum lichtdichten Verschluss des Gehäuses **8.**

### Figur 13

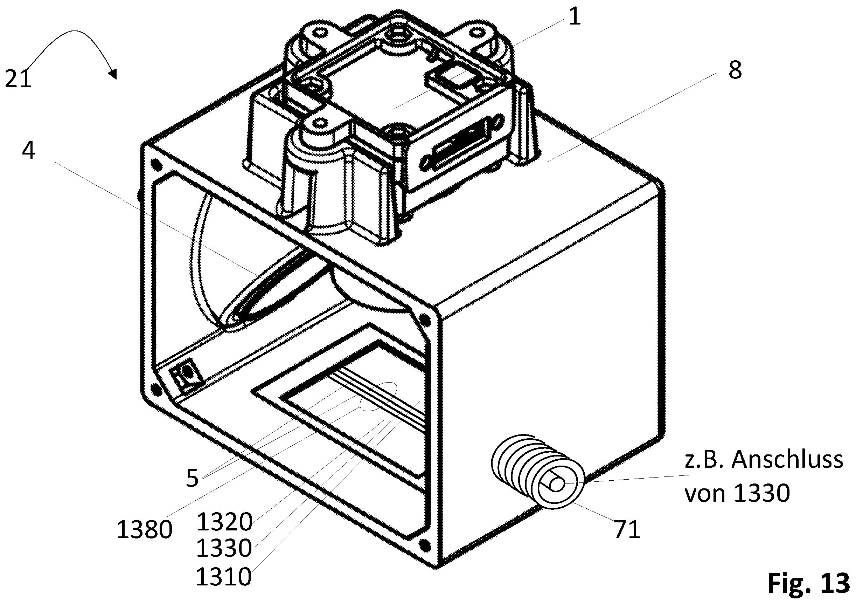

Figur13 entspricht der Figur 11, wobei die beispielhafte Vorrichtung nun aus einem anderen Winkel dargestellt ist. Im Blickfeld der Kamera befinden sich dabei Leitungen **1320, 1310, 1330** einer beispielhaften Tri-Plate-Leitung **1380** mit einem Sensorelement in den Clearances **2340** und **2350.** Die Verwendung anderer Wellenleitungen **(1380, 1880, 2380, 6880, 6980)** ist denkbar. Auch die Verwendung einer durchgängigen Sensorschicht **5** ohne Wellenleitungen **(1380, 1880, 2380, 6880, 6980)** ist denkbar, wobei dann die Nutzung einer Mikrowellen- und/oder HF-Anregung der NV-Zentren und/oder paramagnetischen Zentren der Sensorschicht 5 nicht möglich ist. Die Wellenleitung **(1380, 1880, 2380, 6880, 6980)** kann beispielsweise über eine Steckverbindung, wie beispielsweise eine Koaxialbuchs oder einen Triax-Buchse **71** vorzugsweise angeschlossen werden.

### Figur 14

Figur 14 zeigt die Vorrichtung im Querschnitt. Die Lichtquelle **2** (Laser, LED) emittiert die Pumpstrahlung **13** mit Pumpstrahlungswellenlänge **λₚₘₚ** und ggf. auch elektromagnetische Strahlung anderer Wellenlängenbereiche **27.** Optische Funktionselemente einer Beleuchtungsoptik **3,** wie beispielsweise ein oder mehrere Parabolspiegel. lenken möglichst viel Pumpstrahlung **13** mit Pumpstrahlungswellenlänge **λₚₘₚ** in Richtung Sensorschicht **5.** Ein optischer Shortpass-Filter **4** transmittiert vorzugsweise die Pumpstrahlung **13** mit Pumpstrahlungswellenlänge **λₚₘₚ** und vorzugsweise nicht die elektromagnetische Strahlung der besagten anderen Wellenlängenbereiche. Hierdurch bestrahlt die Lichtquelle **2** im Wesentlichen die Sensorschicht **5** ausschließlich mit Pumpstrahlung **13** einer Pumpstrahlungswellenlänge **λₚₘₚ.** Die Sensorschicht **5** umfasst bevorzugt Kristalle und/oder Nanokristalle **66** mit paramagnetischen Zentren. Optische Funktionselemente und/oder Filterfolien etc. der Beleuchtungsoptik **3** im Strahlengang zwischen der Lichtquelle **2** und der Sensorschicht **5** homogenisieren bevorzugt die Intensitätsverteilung der Pumpstrahlung **13** mit Pumpstrahlungswellenlänge **λₚₘₚ** auf der Sensorschicht **5.** Bei einer Sensorschicht **5** mit einer homogenen Verteilung der paramagnetischen Zentren über die Fläche der Sensorschicht **5** homogenisiert dies die Intensität der Fluoreszenzstrahlung **14** der paramagnetischen Zentren der Kristalle und/oder Nanokristalle **66** der Sensorschicht **5** in einem homogenen Magnetfeld **B.** Bevorzugt umfassen die Kristalle und/oder Nanokristalle **66** der Sensorschicht **5** Diamanten. Bevorzugt umfassen die Kristalle **66** der Sensorschicht **5** Nanokristalle **66.** Bevorzugt handelt es sich bei den paramagnetischen Zentren um NV-Zentren in Diamantkristallen der Sensorschicht **5.** Bevorzugt umfasst das Trägermaterial der Sensorschicht **5** diese Kristalle und/oder Nanokristalle **66.** Diese Sensorschicht **5** ist bevorzugt auf einer ebenen Fläche **15** aufgebracht. Die Sensorschicht **5** umfasst somit diese paramagnetische Zentren. Da die Kristalle **66** sehr klein als Nanokristalle **66** ausgeführt sein können, kann die Sensorschicht **5** sehr dünn ausgeführt sein und sehr dicht mit Kristallen und/oder Nanokristallen **66** angefüllt sein. Da die vorzugsweise ebene Fläche 16 vorzugsweise als sehr dünne Gehäusewand des Gehäuses **8** ausgeführt ist, ist der Abstand zwischen Sensorschicht **5** und der Außenfläche des Gehäuses **8** im Bereich der Sensorschicht **5** sehr klein. Vorzugsweise ist der ist der Abstand **26** zwischen Sensorschicht **5** und der Außenfläche des Gehäuses **8** im Bereich der Sensorschicht **5** kleiner als 1mm, besser kleiner als 500µm, besser kleiner als 200µm, besser kleiner als 100µm , besser kleiner als 50µm, besser kleiner als 20µm, besser kleiner als 10µm , besser kleiner als 5µm, besser kleiner als 2µm, besser kleiner als 1µm. Vorzugsweise ist die Dicke **25** der Sensorschicht **5** kleiner als 1mm, besser kleiner als 500µm, besser kleiner als 200µm, besser kleiner als 100µm , besser kleiner als 50µm, besser kleiner als 20µm, besser kleiner als 10µm , besser kleiner als 5µm, besser kleiner als 2µm, besser kleiner als 1µm. Vorzugsweise ist das Verhältnis zwischen der Dicke **25** der Sensorschicht **5** geteilt durch den Abstand **26** zwischen Sensorschicht **5** und der Außenfläche des Gehäuses **8** im Bereich der Sensorschicht **5** kleiner als 1, besser kleiner als 0,5, besser kleiner als 0,2, besser kleiner als 0,1, besser kleiner als 0,05, besser kleiner als 0,02, besser kleiner als 0,01. Die Untergrenze des Vorzugsweise ist das Verhältnis zwischen der Dicke **25** der Sensorschicht **5** geteilt durch den Abstand **26** zwischen Sensorschicht **5** und der Außenfläche des Gehäuses **8** im Bereich der Sensorschicht 5 bestimmen sie Anforderung der jeweiligen Anwendung. Ein niedriges Verhältnis führt letztlich zu einer verschlechterten Auflösung, sodass nicht immer ein niedrigeres Verhältnis einen Vorteil bietet. Je nach Material der Gehäusewand des Gehäuses im Bereich der Sensorschicht 5 und je nach den Anforderungen kann dieser Abstand zwischen Sensorschicht **5** und der Außenfläche des Gehäuses **8** im Bereich der Sensorschicht **5** nach unten hin durch Anforderungen der mechanischen Stabilität, der Lebensdauer etc. begrenzt sein. Größere Abstände zwischen Sensorschicht **5** und der Außenfläche des Gehäuses **8** im Bereich der Sensorschicht **5** verringern die Auflösung der Sensormessvorrichtung. Bei Bestrahlung mit Pumpstrahlung **13** der Pumpstrahlungswellenlänge **λₚₘₚ** durch die Lichtquelle **2** emittieren die paramagnetischen Zentren der Sensorschicht **5** Fluoreszenzstrahlung **14** mit einer Fluoreszenzwellenlänge **λ_{fl}.** Die Intensität der Fluoreszenzstrahlung **14** mit einer Fluoreszenzwellenlänge **λ_{fl}** hängt dabei von der magnetischen Flussdichte **B** am Ort des jeweiligen paramagnetischen Zentrums in der Sensorschicht **5** ab. Eine abbildende Optik **7** erfasst die Fluoreszenzstrahlung **14** mit der Fluoreszenzwellenlänge **λ_{fl}** und bildet die Intensitätsverteilung der Emissionsintensität der Fluoreszenzstrahlung **14** mit der Fluoreszenzwellenlänge **λ_{fl}** auf die vorzugsweise in einer Ebene angeordneten n x m Lichtsensoren des Lichtsensorarrays **1** als Fluoreszenzbild der Emissionsintensität der Fluoreszenzstrahlung **14** mit der Fluoreszenzwellenlänge **λ_{fl}** ab. Das Lichtsensorarray **1** mit der Auswerteelektronik **15** erfasst dieses Fluoreszenzbild der Emissionsintensität der Fluoreszenzstrahlung **14** mit der Fluoreszenzwellenlänge **λ_{fl}** als n x m Matrix von Messwerten der n x m Lichtsensoren des Lichtsensorarrays **1.** Der bei der Erprobung des Vorschlage benutzte Magnetfeldkamerakopfes **21** erreichte eine effektive Auflösung von 33µm x 3µm. Die theoretisch erzielbare Auflösung liegt typischerweise im Bereich der Fluoreszenzstrahlungswellenlänge **λ_{fl}** der Fluoreszenzstrahlung **14.** Das hier vorgelegte Dokument offenbart somit eine technische Lehre für einen Magnetfeldkamerakopfes 21 zur ortsaufgelösten und bildgebenden Erfassung der Verteilung der Stärke der magnetischen Flussdichte B mit einer Auflösung von besser kleiner als 100µm x 100µm, bzw. besser kleiner als 50µm x 50µm, bzw. besser kleiner als 20µm x 20µm, bzw. besser kleiner als 10µm x 10µm, bzw. besser kleiner als 5µm x 5µm, bzw. besser kleiner als 2µm x 2µm, bzw. besser kleiner als 1µm x 1µm. Für diese hohen Auflösungen sollten die Kristalle und/oder Nanokristalle **66** mit den paramagnetischen Zentren in der Sensorschicht **5** um einen Faktor größer 2, besser um einen Faktor größer 5, um einen Faktor größer 10, besser um einen Faktor größer 20, besser um einen Faktor größer 50, um einen Faktor größer 100 kleiner als die effektive Länge der Außenkannte der effektiven Größe eines Pixels der Auflösung, wie zuvor angegeben, sein. Für diese hohen Auflösungen sollte die Dicke **25** der Sensorschicht **5** um einen Faktor größer 2, besser um einen Faktor größer 5, um einen Faktor größer 10, besser um einen Faktor größer 20, besser um einen Faktor größer 50, um einen Faktor größer 100 kleiner als die effektive Länge der Außenkannte der effektiven Größe eines Pixels der Auflösung, wie zuvor angegeben, sein. Die Aufbereitungsschaltung für die n x m Ausgangssignale **31** der n x m Lichtsensoren des Lichtsensorarrays **1** bereitet die typischerweise analogen Signale der n x m Ausgangssignale **31** der n x m Lichtsensoren des Lichtsensorarrays **1** auf und digitalisiert diese vorzugsweise. Diese Aufbereitung umfasst bevorzugt eine Verstärkung und / oder Filterung. Vorzugsweise multipliziert ein Rechnersystem der Auswerteelektronik **15,** das vorzugsweise Teil der Aufbereitungsschaltung ist, oder eines nachfolgenden Rechnersystems **28** zur Bedienung des Magnetfeldkamerakopfes **21** die n x m Messwerte mit n x m Kalibrationswerten einer n x m Kalibrationsmatrix. Dies dient dazu, ggf. doch noch vorhandene Inhomogenitäten der Fluoreszenzintensität der Fluoreszenzstrahlung **14** bei homogenem Magnetfeld **B** zu eliminieren. Vorzugsweise gibt das Rechnersystem der Aufbereitungsschaltung der Auswerteelektronik 15 über eine Schnittstellenschaltung die so korrigierten Werte der Ausgangssignale **31** der Lichtsensoren des Lichtsensorarrays **1,** an ein übergeordnetes System, beispielsweise ein übergeordnetes Rechnersystem mit einem Bildschirm über einen Datenbus oder dergleichen weiter. Bevorzugt befindet sich der Strahlengang der Pumpstrahlung **13** und der Fluoreszenzstrahlung **14** von der Lichtquelle 2 bis zum Lichtsensorarray **1** innerhalb eines vorzugsweise lichtdichten Gehäuses **8.** Vorzugsweise befindet sich in dem optischen Pfad zwischen Sensorschicht 5 und Lichtsensorarrays **1** der optische Longpass-Filter **6.** Vorzugsweise befindet sich der optische Longpass-Filter **6** möglichst nahe der Oberfläche oder auf der Oberfläche des Lichtsensorarrays **1.** Der optische der optische Longpass-Filter **6** stellt bevorzugt sicher, dass im Wesentlichen nur elektromagnetische Strahlung **14** mit der Fluoreszenzwellenlänge λ_{fl}, also im Wesentlichen nur Fluoreszenzstrahlung **14** mit der Fluoreszenzwellenlänge **λ_{fl}** die Lichtsensoren des Lichtsensorarrays **1** erreicht.

Die Oberseite **23** der Sensorschicht **5** befindet sich vorzugsweise innerhalb des Gehäuses **8.**

Die Unterseite **22** der Sensorschicht **5** befindet sich vorzugsweise außerhalb des Gehäuses **8.** an dessen Oberfläche. Vorzugsweise bedeckt ein Lichtschutz die Unterseite **22** der Sensorschicht **5.** Dies verhindert, dass Licht in das Gehäuse **8** eindringt und zum Lichtsensorarrays **1** gelangt. Die Sensorschicht **5** ist bevorzugt transparent für elektromagnetische Strahlung der Pumpstrahlungswellenlänge **λₚₘₚ.** Die Sensorschicht **5** ist bevorzugt transparent für elektromagnetische Strahlung der Fluoreszenzstrahlungswellenlänge **λ_{fl}.** Beispielsweise kann der Lichtschutz ein Lack auf der Unterseite **22** der Sensorschicht **5** oder ein besonders dünner, lichtundurchlässiger Teil **16** der Gehäusewand des Gehäuses **8** sein. Bevorzugt beeinflusst eine solche dünne Gehäusewand **16** des Gehäuses **8** im Bereich der Sensorschicht **5** das magnetische Feld, also beispielsweise die magnetische Flussdichte **B,** nicht.

Bevorzugt umfasst das Lichtsensorarray **1** n x m Lichtsensoren, die vorzugsweise in einer Fläche angeordnet sind. Hierbei sind n und m positive ganze Zahlen.

Im Blickfeld der Kamera befinden sich dabei Leitungen **1320, 1310, 1330** einer beispielhaften Tri-Plate-Leitung **1380** mit einem Sensorelement in den Clearances **2340** und **2350.** Die Verwendung anderer Wellenleitungen **(1380, 1880, 2380, 6880, 6980)** ist denkbar. Auch die Verwendung einer durchgängigen Sensorschicht **5** ohne Wellenleitungen **(1380, 1880, 2380, 6880, 6980)** ist denkbar, wobei dann die Nutzung einer Mikrowellen- und/oder HF-Anregung der NV-Zentren und/oder paramagnetischen Zentren der Sensorschicht 5 nicht möglich ist. Die Wellenleitung **(1380, 1880, 2380, 6880, 6980)** kann beispielsweise über eine Steckverbindung, wie beispielsweise eine Koaxialbuchs oder einen Triax-Buchse **71** vorzugsweise angeschlossen werden.

### Figur 15

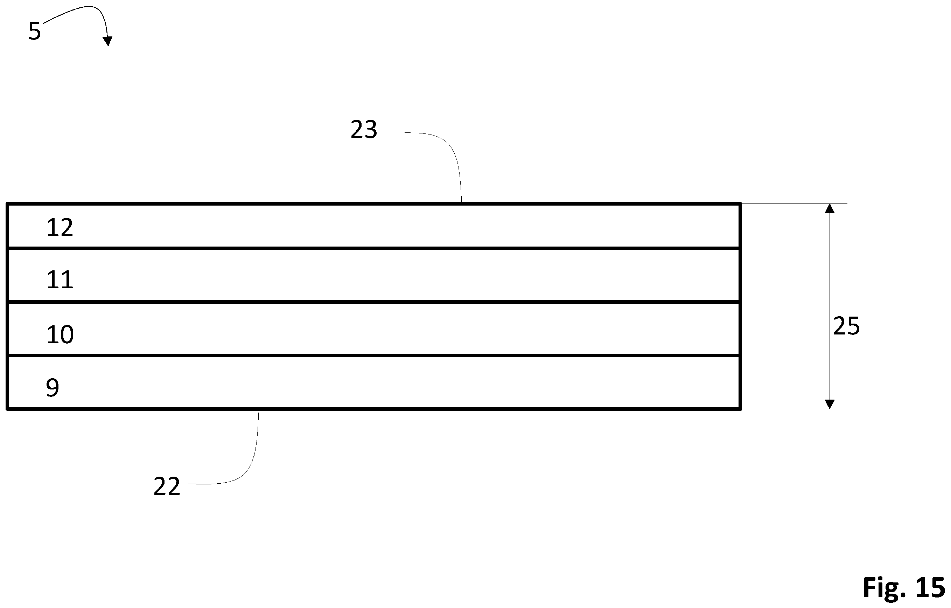

Figur 15 zeigt einen beispielhaften, nicht maßstabsgerechten Querschnitt durch die Sensorschicht **5.**

Auf ein Trägermaterial **9** ist eine Verspiegelung **10** aufgebracht. Das Trägermaterial **9** befindet sich in Richtung der Unterseite **22** der Sensorschicht **5.** Die Verspiegelung **10** befindet sich bezogen auf das Trägermaterial **9** in Richtung der Oberseite **23** der Sensorschicht **5.** Die Verspiegelung **10** ist bevorzugt undurchlässig für elektromagnetische Strahlung mit der Pumpstrahlungswellenlänge **λₚₘₚ.** Die Verspiegelung **10** reflektiert bevorzugt elektromagnetische Strahlung mit der Pumpstrahlungswellenlänge **λₚₘₚ** wieder zurück in den Innenraum des Gehäuses **8.** Dies hat den Vorteil, dass die Pumpstrahlung **13** mit Pumpstrahlungswellenlänge **λₚₘₚ** die Schicht mit Kristallen und/oder Nanokristallen **66** mit paramagnetischen Zentren **11** zweimal durchläuft. Dies verdoppelt die Pumpleistung und damit die Intensität der Fluoreszenzstrahlung **14,** die n x m Lichtsensoren des Lichtsensorarrays **1** erreicht.

Die Verspiegelung **10** reflektiert bevorzugt elektromagnetische Strahlung mit der Fluoreszenzstrahlungswellenlänge **λ_{fl}** wieder zurück in den Innenraum des Gehäuses **8.** Dies hat den Vorteil, dass die Fluoreszenzstrahlung **14** mit Fluoreszenzstrahlungswellenlänge **λ_{fl},** die die paramagnetischen Zentren der Schicht mit Kristallen und/oder Nanokristallen **66** mit paramagnetischen Zentren **11** in Richtung Unterseite **22** der Sensorschicht **5** emittieren, zurück in Richtung Oberfläche der Oberseite **23** der Sensorschicht **5** reflektieren. Dies verdoppelt nochmals die Intensität der Fluoreszenzstrahlung **14,** die n x m Lichtsensoren des Lichtsensorarrays **1** erreicht.

Auf der Verspiegelung **10** in Richtung Oberseite **23** der Sensorschicht **5** befindet sich vorschlagsgemäß die Schicht mit Kristallen und/oder mit Nanokristallen **66** mit paramagnetischen Zentren **11.**

Eine weitere Trägermaterialschicht **12** deckt vorzugsweise die die Schicht mit Kristallen und/oder Nanokristallen **66** mit paramagnetischen Zentren **11** ab. Vorzugsweise ist das Material der Trägermaterialschicht **12** transparent für elektromagnetische Strahlung, insbesondere Pumpstrahlung **13,** mit Pumpstrahlungswellenlänge **λₚₘₚ.** Vorzugsweise ist das Material der Trägermaterialschicht **12** transparent für elektromagnetische Strahlung mit Fluoreszenzstrahlungswellenlänge λ_{fl}.

Die Sensorschicht **5** kann optische Funktionselemente wie Lichtwellenleiter und/oder Filter und/oder photonische Kristalle und/oder digitale Optiken umfassen. Die digitalen Optiken können in die Oberfläche der Sensorschicht **5** eingeprägt oder sonst wie eingearbeitet sein.

Die Sensorschicht **5** kann optische Funktionselemente wie Lichtwellenleiter und/oder Filter umfassen.

### Figur 16

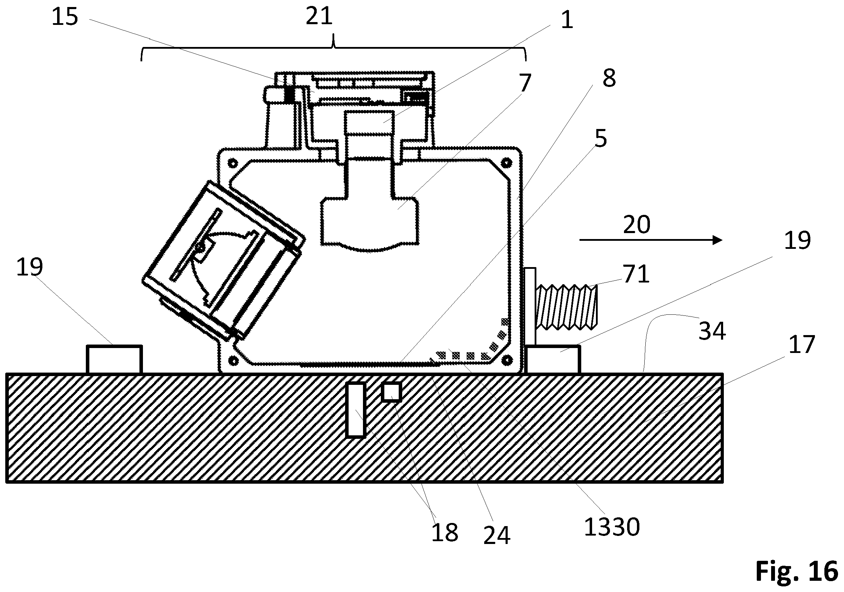

Figur 16 zeigt eine typische Nutzungssituation. Der Magnetfeldkamerakopf **21** ist vorzugsweise auf der Oberfläche **34** des jeweiligen Messobjekts mit der Unterseite **24** des Gehäuses **8** aufgesetzt. In Figur 16 ist die auf der Oberfläche **34** des jeweiligen Messobjekts die Oberfläche des beispielhaften ferromagnetischen Materials **17.** Das beispielhafte ferromagnetische Material **17** der Figur 16 weist beispielhafte Inhomogenitäten in Form von beispielhaften Fehlern **18** in dem beispielhaften ferromagnetischen Material **17** der Figur 16 auf. Zwei Hilfsmagnete **19** stellen eine magnetische Erregung des magnetischen Prüfkreises bereit. Der beispielhafte magnetische Prüfkreis umfasst hier die beiden Hilfsmagnete **19,** das Material des Messobjekts in Form des beispielhaften ferromagnetischen Materials **17** und den Luftraum um diese Objekte herum. Die beispielhaften Fehler **18** in dem beispielhaften ferromagnetischen Material **17** der Figur 16 verzerren das magnetische Feld im Bereich dieser Fehler **18.** Bei den Fehlern kann es sich beispielsweise um Risse, Bohrungen, Nuten, Lunker, Höhlungen, Materialzusammensetzungsfluktuationen und andere Strukturen handeln deren magnetische Materialparameter zu einer Veränderung der Struktur der magnetischen Flusslinien des magnetischen Flusses **B** in diesem Bereich dieser Fehler **18** führen.

Die Fehler 18 führen zu einer Veränderung der Verteilung und Stärke des magnetischen Flusses B, der aus dem Material des Messobjekts in Form des beispielhaften ferromagnetischen Materials **17** in den Luftraum um diese Objekte herum austritt. Damit verändert sich die Verteilung und Richtung der magnetischen Flussdichte **B** bei der Durchdringung der Sensorschicht **5.** Dies wiederum verändert die Intensitätsverteilung der Intensität der Fluoreszenzstrahlung **14** der paramagnetischen Zentren der Sensorschicht **5** in der Sensorschicht **5.** Damit ändert sich das Fluoreszenzbild der Sensorschicht **5,** das die Fluoreszenzkamera mittels der abbildenden Optik 7 und den n x m Lichtsensoren des Lichtsensorarray **1** aufnimmt. Das Lichtsensorarray **1** erfasst das Fluoreszenzbild der Sensorschicht 5 und übermittelt dieses Fluoreszenzbild der Sensorschicht **5** an ein Rechnersystem **28** zur Bedienung des Magnetfeldkamerakopfes **21.** Bevorzugt führt das ein Rechnersystem **28** zur Bedienung des Magnetfeldkamerakopfes **21** ein Bildverarbeitungsprogramm aus. Vorzugsweise ermittelt das Rechnersystem **28** zur Bedienung des Magnetfeldkamerakopfes **21** eine Abweichung zwischen dem Fluoreszenzbild des fehlerhaften Messobjekts und dem Fluoreszenzbild eines fehlerfreien Messobjekts oder einem berechneten oder sonst wie erzeugten Referenzfluoreszenzbild. Beispielsweise kann das Rechnersystem **28** zur Bedienung des Magnetfeldkamerakopfes **21** ein KI-Programm zur Klassifizierung der Abweichungen und/oder der Fehler und/oder zur Bewertung der Abweichungen und/oder der Fehler ausführen. Beispielsweise kann das Rechnersystem **28** zur Bedienung des Magnetfeldkamerakopfes **21** ein neuronales Netzwerkmodell zur Klassifizierung der Abweichungen und/oder der Fehler und/oder zur Bewertung der Abweichungen und/oder der Fehler ausführen. Beispielsweise kann das Rechnersystem **28** zur Bedienung des Magnetfeldkamerakopfes **21** ein KI-Programm zur Klassifizierung und/oder Bewertung eines oder mehrerer Fluoreszenzbilder ausführen. Beispielsweise kann das Rechnersystem **28** zur Bedienung des Magnetfeldkamerakopfes **21** ein neuronales Netzwerkmodell zur Klassifizierung und/oder zur Bewertung eines oder mehrerer Fluoreszenzbilder ausführen.

Um ein vollständiges Bild des Zustands der Oberfläche 34 des Materials des Messobjekts, hier in Form des beispielhaften ferromagnetischen Materials **17,** zu erhalten bewegt die messende Person und/oder eine mechanische Positioniervorrichtung den Magnetfeldkamerakopfes **21** vorzugsweise mit einer Geschwindigkeit **20** über die Oberfläche **34** des Materials des Messobjekts, hier in Form des beispielhaften ferromagnetischen Materials **17.**

Vorzugsweise sind die Hilfsmagneten **19** dabei fest mit dem Magnetfeldkamerakopfes **21** verbunden und/oder ein Teil desselben. die Hilfsmagnete **19** erzeugen die notwendige magnetische Erregung H des magnetischen Kreises, dessen Teil die Sensorschicht **5** vorzugsweise ist.

Die Hilfsmagnete **19** umfassen bevorzugt Permanentmagnete. Die Hilfsmagnete **19** können Elektromagnete sein oder umfassen. sofern die Hilfsmagnete 19 Elektromagnete umfassen kann können die Aufbereitungsschaltung **30** für die Ausgangssignale **31** der Lichtsensoren des Lichtsensorarrays **1** und/oder ein Rechnersystem **28** zur Bedienung des Magnetfeldkamerakopfes **21** und/oder eine andere Steuervorrichtung und/oder ein anderes Rechnersystem mittels einer Ansteuervorrichtung für die Elektromagnete der Hilfsmagnete **19** beispielsweise die Amplitude der magnetischen Erregung H der Hilfsmagnete **19** mit einem Code und/oder einer Frequenz modulieren.

Bei dem Code kann es sich beispielsweise um einen Spreiz-Kode handeln. Beispielsweise kann ein Pseudozufallszahlengenerator PRNG der Ansteuervorrichtung **39** für die Elektromagnete der Hilfsmagnete **19** den Spreizkode in Form eines Spreizkodesignals erzeugen. Bevorzugt weist das Spreizkodesignal die Taktfrequenz des Pseudozufallszahlengenerator PRNG auf. Beispielsweise kann es sich bei dem Pseudozufallszahlengenerator PRNG um ein mit einem einfach primitiven Polynom rückgekoppeltes Schieberegister handeln. Typischerweise modulieren die Hilfsmagnete die von ihnen erzeugte magnetische Feldstärke H dann zumindest zu einem Teil mit der jeweiligen Amplitude des Spreizkodesignals der Ansteuervorrichtung **39** für die Elektromagnete der Hilfsmagnete **19.** Der Einfachheit halber sprechen wir auch bei einem monofrequenten Spreizkode in Form einer einzigen Modulationsfrequenz von einem Spreizkodesignal. Bevorzugt weist das Spreizkodesignal eine untere Grenzfrequenz ωᵤ und eine obere Grenzfrequenz ωₒ auf. Bevorzugt hat das Spreizcodesignal unterhalb der unteren Grenzfrequenz ωᵤ im Wesentlichen eine Amplitude von 0. Bevorzugt hat das Spreizcodesignal oberhalb der oberen Grenzfrequenz ωₒ im Wesentlichen eine Amplitude von 0.

Bevorzugt weist das Trägersignal des Spreizkodesignals eine Trägerfrequenz auf, die typischerweise gleich der Frequenz der Schiebefrequenz des typischerweise linear rückgekoppelten Schieberegisters des Pseudozufallszahlengenerators PRNG ist. Im Falle eines monofrequenten Spreizkodes entspricht die Trägerfrequenz dieser Frequenz des Spreizkodes. Vorzugsweise ist die Trägerfrequenz gleich der Frame-Rate (Bildwiederholrate) mit der die Lichtsensoren des Lichtsensorarrays **1** der Fluoreszenzkamera das Fluoreszenzbild der Sensorschicht **5** erfassen. Bei dem Magnetfeldkamerakopf **21** der hier dargestellten Beispiele lag diese Frame-Rate bei bis zu 160 Frames pro Sekunde. Die Framerate der Magnetfeldkamera ist dabei im Sinne des hier vorgelegten Dokuments die Rate der erzeugten und übertragenen Fluoreszenzbilder der Lichtsensoren des Lichtsensorarrays **1** pro Sekunde. Bevorzugt schwankt das Spreizkodesignal beispielsweise zwischen den Werten 0 und 1.

Da dann die magnetische Feldstärke H mit dem Spreizcodesignalmoduliert ist, ist dann auch die magnetische Flussdichte B, die die Sensorschicht **5** durchdringt, mit dem Spreizcodesignal moduliert. Daher ist auch die Intensität der Fluoreszenzstrahlung **14** mit dem Spreizcodesignal moduliert. Bevorzugt erfassen die Aufbereitungsschaltung **30** für die Ausgangssignale **31** der Lichtsensoren des Lichtsensorarrays **1** und/oder das Rechnersystem **28** zur Bedienung des Magnetfeldkamerakopfes **21** mehrere Fluoreszenzbilder der Lichtsensoren des Lichtsensorarrays **1** der Fluoreszenzkamera und multiplizieren die Amplituden der Pixelwerte der Messwerte der Lichtsensoren des Lichtsensorarrays 1 mit dem Inversen des Werts des Spreizkodesignals bzw. mit dem Inversen des Werts der Summe aus dem Wert des Spreizkodesignals plus einem Offset. Eine Division durch 0 ist ja nicht möglich.

Vorzugsweise werten die die Aufbereitungsschaltung **30** für die Ausgangssignale **31** der Lichtsensoren des Lichtsensorarrays **1** und/oder das Rechnersystem **28** zur Bedienung des Magnetfeldkamerakopfes **21** mehrere Frames, also Fluoreszenzbilder, der Fluoreszenzkamera, als der Lichtsensoren des Lichtsensorarrays 1, in einer Auswertebildsequenz aus.

Zu Beginn der Auswertesequenz initialisieren die Aufbereitungsschaltung **30** für die Ausgangssignale **31** der Lichtsensoren des Lichtsensorarrays **1** und/oder das Rechnersystem **28** zur Bedienung des Magnetfeldkamerakopfes **21** je Lichtsensor des Lichtsensorarrays **1** von eine jeweilige Pixelsumme für den Summenwert des betreffenden Lichtsensors des Lichtsensorarrays **1** auf einen vorgebbaren Initialwert. Typischerweise ist dieser Initialwert 0.

Vorzugsweise werten die die Aufbereitungsschaltung **30** für die Ausgangssignale **31** der Lichtsensoren des Lichtsensorarrays **1** und/oder das Rechnersystem **28** zur Bedienung des Magnetfeldkamerakopfes **21** Pixelwerte eines Lichtsensors des Lichtsensorarrays **1** in Zeiten zu denen das Spreizkodesignal beispielsweise den Werten 0 annimmt negativ und ziehen den jeweiligen Pixelwert eines Lichtsensors des Lichtsensorarrays **1** daher in dem Fall von einer Pixelsumme für den Summenwert des betreffenden Lichtsensors des Lichtsensorarrays **1** ab.

Vorzugsweise werten die die Aufbereitungsschaltung **30** für die Ausgangssignale **31** der Lichtsensoren des Lichtsensorarrays **1** und/oder das Rechnersystem **28** zur Bedienung des Magnetfeldkamerakopfes **21** Pixelwerte eines Lichtsensors des Lichtsensorarrays 1 in Zeiten zu denen das Spreizkodesignal beispielsweise den Werten 1 annimmt positiv und addieren den jeweiligen Pixelwert eines Lichtsensors des Lichtsensorarrays **1** daher in dem Fall daher zu einer Pixelsumme für den Summenwert des betreffenden Lichtsensors des Lichtsensorarrays **1** hinzu.

Nachdem die Auswertesequenz beendet ist und die Aufbereitungsschaltung **30** für die Ausgangssignale **31** der Lichtsensoren des Lichtsensorarrays **1** und/oder das Rechnersystem **28** zur Bedienung des Magnetfeldkamerakopfes **21** die geplanten, mehreren Frames, also Fluoreszenzbilder, der Fluoreszenzkamera, also der Lichtsensoren des Lichtsensorarrays 1, in der Auswertebildsequenz ausgewertet haben, erzeugen die Aufbereitungsschaltung **30** für die Ausgangssignale **31** der Lichtsensoren des Lichtsensorarrays **1** und/oder das Rechnersystem **28** zur Bedienung des Magnetfeldkamerakopfes **21** aus den resultierenden jeweiligen Pixelsummen für die jeweiligen Summenwerte der jeweiligen Lichtsensors des Lichtsensorarrays **1** ein verbessertes Fluoreszenzbild.

Diese Vorgehensweise eliminiert ein Hintergrundrauschen und erhöht die Empfindlichkeit.

Im Blickfeld der Kamera befinden sich dabei Leitungen **1320, 1310, 1330** einer beispielhaften Tri-Plate-Leitung **1380** mit einem Sensorelement in den Clearances **2340** und **2350.** Die Verwendung anderer Wellenleitungen **(1380, 1880, 2380, 6880, 6980)** ist denkbar. Auch die Verwendung einer durchgängigen Sensorschicht **5** ohne Wellenleitungen **(1380, 1880, 2380, 6880, 6980)** ist denkbar, wobei dann die Nutzung einer Mikrowellen- und/oder HF-Anregung der NV-Zentren und/oder paramagnetischen Zentren der Sensorschicht 5 nicht möglich ist. Die Wellenleitung **(1380, 1880, 2380, 6880, 6980)** kann beispielsweise über eine Steckverbindung, wie beispielsweise eine Koaxialbuchs oder einen Triax-Buchse **71** vorzugsweise angeschlossen werden.

### Figur 17

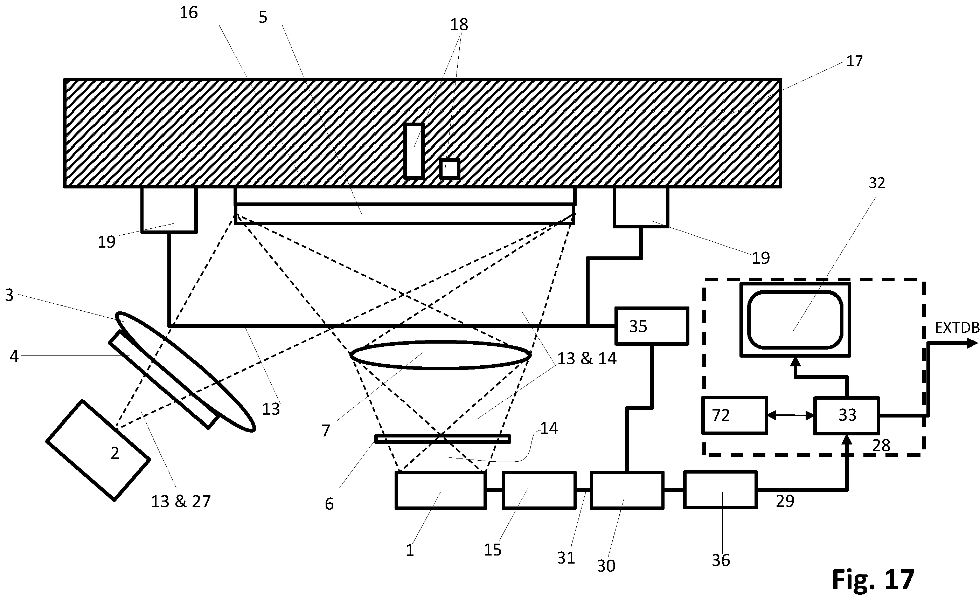

Figur 17 zeigt das System der Figur 14 vereinfacht mit den Ansteuer- und Auswertevorrichtungen als Blockdiagramm.

Die Lichtquelle **2** emittiert Pumpstrahlung **13** mit einer Pumpstrahlungswellenlänge λₚₘₚ und unerwünschte elektromagnetische Strahlung **27** anderer Wellenlängenbereiche. Ein optischer Shortpass-Filter **4** lässt bevorzugt nur die Pumpstrahlung **13** passieren und hält bevorzugt die elektromagnetische Strahlung **27** anderer Wellenlängenbereiche zurück. Sofern die Lichtquelle 2 keine unerwünschte elektromagnetische Strahlung **27** anderer Wellenlängenbereiche emittiert, ist dieses optische Shortpass-Filter **4** nicht notwendig. Eine Beleuchtungsoptik **3** sorgt dafür, dass die Pumpstrahlung **13** die Sensorschicht **5** möglichst homogen ausleuchtet. Die Beleuchtungsoptik **3** kann ein oder mehrere optische Funktionselemente umfassen. Die Sensorschicht 5 ist vorzugsweise auf einem mechanischen Träger, beispielsweise einer ebenen Fläche **16,** aufgebracht. Vorzugsweise ist die ebene Fläche **16** Teil der Gehäusewand des hier nicht gezeichneten Gehäuses **8.** Das Material dieser ebenen Fläche **16** bzw. der Gehäusewand des Gehäuses **8** in diesem Bereich ist bevorzugt nicht magnetisch und beeinflusst bevorzugt das magnetische Feld im Wesentlichen nicht. Die Sensorschicht 5 umfasst bevorzugte eine Vielzahl zufällig und vorzugsweise gleichverteilt orientierte Kristalle und/oder Nanokristalle **66** mit paramagnetischen Zentren. Bei den paramagnetischen Zentren kann es sich bei der Verwendung von Diamant als Kristallmaterial beispielsweise um NV-Zentren und/oder SiV-Zentren und/oder TiV-Zentren und/oder GeV-Zentren und/oder SnV-Zentren und/oder NiN4-Zentren und/oder PbV-Zentren und/oder ST1-Zentren handeln. Die Pumpstrahlung **13** besitzt bei der Verwendung von NV-Zentren in Dimant als Kristalle und/oder Nanokristalle **66** der Sensorschicht **5** bevorzugt eine Pumpstrahlungswellenlänge λₚₘₚ in einem Wellenlängenbereich von 400 nm bis 700 nm Wellenlänge und/oder besser 450 nm bis 650 nm und/oder besser 500 nm bis 550 nm und/oder besser 515 nm bis 540 nm aufweisen. Bevorzugt ist dabei eindeutig eine Wellenlänge von 532 nm als Pumpstrahlungswellenlänge λₚₘₚ. Im Falle der Verwendung von NV-Zentren in Diamant oder in Diamanten der Sensorschicht **5** ist eine Laser-Diode der Fa. Osram vom Typ PLT5 520B beispielsweise als Lichtquelle **2** mit 520nm Pumpstrahlungswellenlänge **λₚₘₚ** geeignet. Bei der Verwendung von NV-Zentren in Diamantkristallen in der Sensorschicht **5** als paramagnetische Zentren der Sensorschicht **5** emittieren die NV-Zentren der Sensorschicht **5** typischerweise bei Bestrahlung mit Pumpstrahlung **13** der oben beschriebenen Pumpstrahlungswellenlänge **λₚₘₚ** eine Fluoreszenzstrahlung **14** mit einer typischen Fluoreszenzwellenlänge **λ_{fl}** von ca. 637nm bei NV-Zentren. Eine abbildende Optik **7** erfasst bevorzugt das Fluoreszenzbild der ortsabhängigen Fluoreszenzintensität der Fluoreszenzstrahlung **14** mit der Fluoreszenzwellenlänge **λ_{fl},** das die Sensorschicht **5** mittels der paramagnetischen Zentren in der Sensorschicht **5** erzeugt. Ein optisches Longpass-Filter **6** lässt bevorzugt elektromagnetische Strahlung mit der Fluoreszenzwellenlänge **λ_{fl}** und damit die Fluoreszenzstrahlung **14** passieren. Das optische Longpass-Filter **6** blockier bevorzugt die Passage elektromagnetische Strahlung mit der Pumpstrahlungswellenlänge **λₚₘₚ** und damit die Passage der Pumpstrahlung **13.** Hierdurch kann die abbildende Optik 7 das Fluoreszenzbild der Sensorschicht **5** im Wellenlängenbereich der Fluoreszenzwellenlänge **λ_{fl}** erfassen und auf die n x m Lichtsensoren des n x m Lichtsensorarrays **1** der Fluoreszenzkamera abbilden. Da die Intensität der Fluoreszenzstrahlung **14** der Sensorschicht **5** lokal in der Sensorschicht **5** von der magnetischen Flussdichte B am Ort des jeweiligen paramagnetischen Zentrums in der Sensorschicht **5** abhängt, entspricht das Fluoreszenzbild der Sensorschicht **5** einem Magnetflussdichtenbetragsbild des magnetischen Flussdichtefeldes, das die Sensorschicht **5** durchflutet. Da in der Regel die Dichteverteilung der paramagnetischen Zentren in der Sensorschicht **5** und/oder die Ausleuchtung der Sensorschicht **5** mit Pumpstrahlung **13** und/oder die Erfassung der Fluoreszenzintensität der Fluoreszenzstrahlung **14** über die Fläche der Sensorschicht **5** bei allem Bemühen nicht ganz homogen sind, hat es sich bewährt, durch Kalibrationsmessungen das System vor dem ersten Gebrauch zu kalibrieren. Zur Verarbeitung der Messwerte der Lichtsensoren des Lichtsensorarrays 1 erfassen Auswertelektroniken **15** des Lichtsensorarrays **1** die Messwerte des Signale der Lichtsensoren des Lichtsensorarrays **1** und bilden daraus insbesondere durch Verstärkung und/oder Filterung die Ausgangssignale **31** der Lichtsensoren des Lichtsensorarrays **1.** Die Aufbereitungsschaltung **30** für die Ausgangssignale **31** der Lichtsensoren des Lichtsensorarrays **1** steuert bevorzugt mittels einer Ansteuervorrichtung **35** für die Elektromagnete der Hilfsmagnete **19** die Hilfsmagnete **19,** wenn diese nicht nur Permanentmagnete umfassen. Die Aufbereitungsschaltung **30** für die Ausgangssignale **31** der Lichtsensoren des Lichtsensorarrays **1** erzeugt aus den die Ausgangssignalen **31** der Lichtsensoren des Lichtsensorarrays **1** ein Fluoreszenzbild und/oder beispielsweise ggf. auch ein verbessertes Fluoreszenzbild, wie oben beschrieben. Aufgrund der zuvor dargestellten Zusammenhänge stellen das Fluoreszenzbild und/oder beispielsweise ggf. auch das verbesserte Fluoreszenzbild ein Magnetflussdichtenbetragsbild des magnetischen Flussdichtefeldes in der Sensorschicht **5** bzw. ein verbessertes Magnetflussdichtenbetragsbild des magnetischen Flussdichtefeldes in der Sensorschicht **5** dar. Die Aufbereitungsschaltung **30** für die Ausgangssignale **31** der Lichtsensoren des Lichtsensorarrays **1** überträgt dieses Fluoreszenzbild bzw. das verbesserte Fluoreszenzbild vorzugsweise mittels der Schnittstellenschaltung **36** über einen Datenbus **29** an ein Rechnersystem **28** zur Bedienung des Magnetfeldkamerakopfes **21.** Bevorzugt erzeugt das Rechnersystem **28** zur Bedienung des Magnetfeldkamerakopfes **21** aus diesem Fluoreszenzbild bzw. aus dem verbesserten Fluoreszenzbild eine ein- oder zwei- oder dreidimensionale Darstellung der Verteilung der magnetischen Flussdichte in der Sensorschicht **5** und stellt diese auf dem Bildschirm **32** dar. Der Datenbus **29** dient dabei der Herstellung der Datenverbindung zwischen Aufbereitungsschaltung **30** für die Ausgangssignale **31** der Lichtsensoren des Lichtsensorarrays **1** und Rechnersystem **28** zur Bedienung des Magnetfeldkamerakopfes **21.** Das Messobjekt, hier beispielhaft ein ferromagnetisches Material **17** mit Fehlern **18** erzeugt die Variationen der magnetischen Flussdichte **B** in der Sensorschicht **5,** die zu den besagten Magnetflussdichtenbetragsbildern des magnetischen Flussdichtefeldes in der Sensorschicht **5** bzw. den verbesserten Magnetflussdichtenbetragsbildern des magnetischen Flussdichtefeldes in der Sensorschicht **5** führen.

### Figur 18

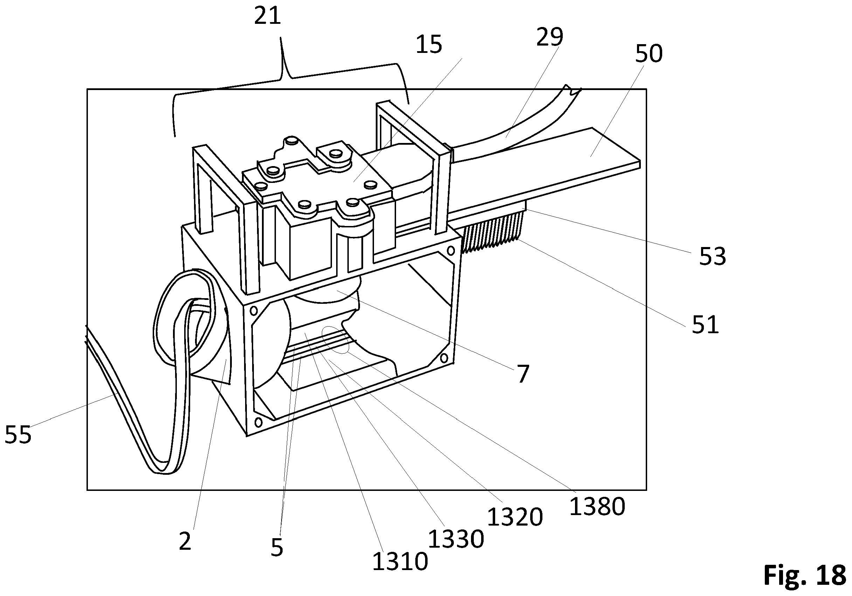

Figur 18 zeigt eine Zeichnung auf Basis eines beispielhaften Fotos eines beispielhaften, bei der Ausarbeitung des hier vorgelegten Vorschlags erstellten Sensorkopfes **21** mit abgenommenen Deckel. Die Zeichnung entspricht im Wesentlichen der Figur 13. Zu erkennen ist die Zuleitung mit dem Datenbus **29** zur Herstellung der Datenverbindung zwischen Aufbereitungsschaltung **30** für die Ausgangssignale **31** der Lichtsensoren des Lichtsensorarrays **1** und Rechnersystem **28** zur Bedienung des Magnetfeldkamerakopfes **21.** Außerdem sind die Lichtquelle **2** und die mit grüner Pumpstrahlung **13** bestrahlte Sensorschicht **5** zu erkennen.

Im Blickfeld der Kamera befinden sich dabei Leitungen **1320, 1310, 1330** einer beispielhaften Tri-Plate-Leitung **1380** mit einem Sensorelement in den Clearances **2340** und **2350.** Die Verwendung anderer Wellenleitungen **(1380, 1880, 2380, 6880, 6980)** ist denkbar. Auch die Verwendung einer durchgängigen Sensorschicht **5** ohne Wellenleitungen **(1380, 1880, 2380, 6880, 6980)** ist denkbar, wobei dann die Nutzung einer Mikrowellen- und/oder HF-Anregung der NV-Zentren und/oder paramagnetischen Zentren der Sensorschicht 5 nicht möglich ist. Die Wellenleitung **(1380, 1880, 2380, 6880, 6980)** kann beispielsweise über eine Steckverbindung, wie beispielsweise eine Koaxialbuchs oder einen Triax-Buchse **71** vorzugsweise angeschlossen werden.

### Figur 19a

Figur 19a zeigt eine Zeichnung auf Basis eines beispielhaften Fotos eines beispielhaften, bei der Ausarbeitung des hier vorgelegten Vorschlags erstellten Sensorkopfes **21** mit abgenommenen Deckel. Die Zeichnung entspricht im Wesentlichen ebenfalls der Figur 13. Zu erkennen sind die Lichtquelle **2,** Unterseite **24** des Gehäuses **8,** die abbildende Optik **7** in Form eines Kameraobjektivs und ein bisher nicht erwähnter Spiegel **3** zur Homogenisierung der Pumpstrahlungsintensität der Pumpstrahlung **13** auf der Sensorschicht **5.** Der Magnetfeldkamerakopfes **21** der Figur 19a ist ein Beispiel für eine Beleuchtungsoptik **3,** die mehrere optische Funktionselemente umfasst.

### Figur 19b

Figur 19b entspricht im Wesentlichen der Figur 19a und zeigt den gleichen Magnetfeldkamerakopfes **21** aus einer etwas anderen Perspektive. Das Lichtsensorarray **1** und das optische Longpass-Filter **6** sind in der grauen Ausstülpung untergebracht. Die Dicke der Gehäusewand des Gehäuses **8** im Bereich der Sensorschicht **5** und die Unterseite **24** des Gehäuses **8** sind gut zu erkennen. Die Zuleitung mit dem Datenbus **29** zur Herstellung der Datenverbindung zwischen Aufbereitungsschaltung **30** für die Ausgangssignale **31** der Lichtsensoren des Lichtsensorarrays **1** und Rechnersystem **28** zur Bedienung des Magnetfeldkamerakopfes **21.** Außerdem sind die Lichtquelle **2** und die mit grüner Pumpstrahlung **13** bestrahlte Sensorschicht **5** zu erkennen. Der beispielhafte Magnetfeldkamerakopf **21** ist in der Lage, die örtliche Verteilung magnetischer Flussdichten mit Beträgen von 0mT bis ca. 50mT darzustellen.

### Figur 20

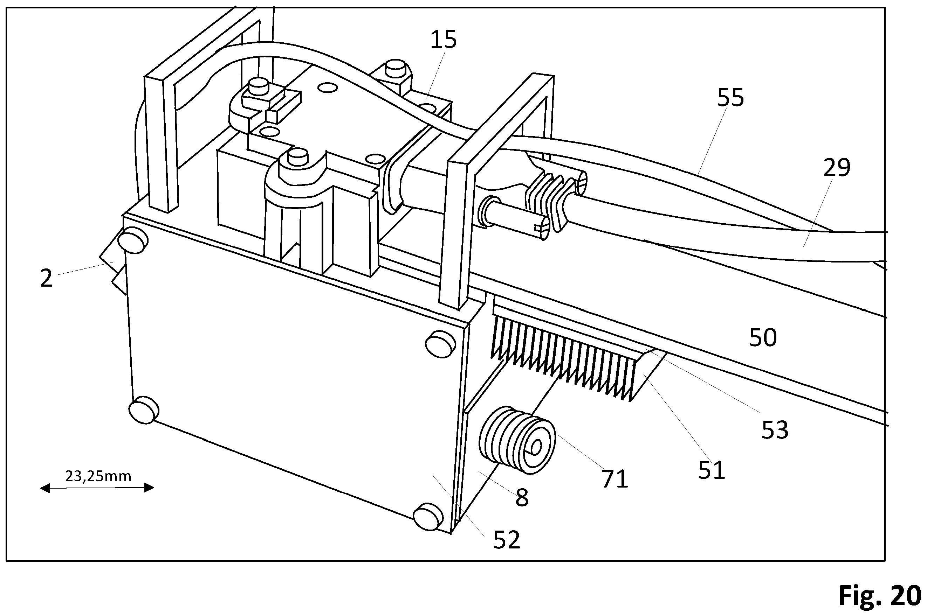

Figur 20 zeigt eine Zeichnung des Prototypen mit aufgesetztem Deckel. Der Innenraum des Gehäuses **8** des Magnetfeldkamerakopf **21** ist dann lichtdicht verschlossen.

### Figuren 21 und 22

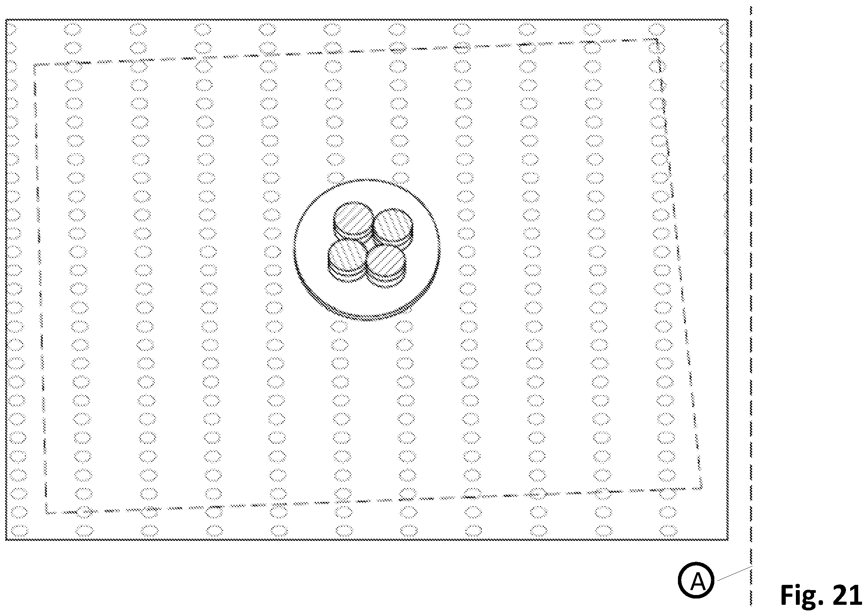

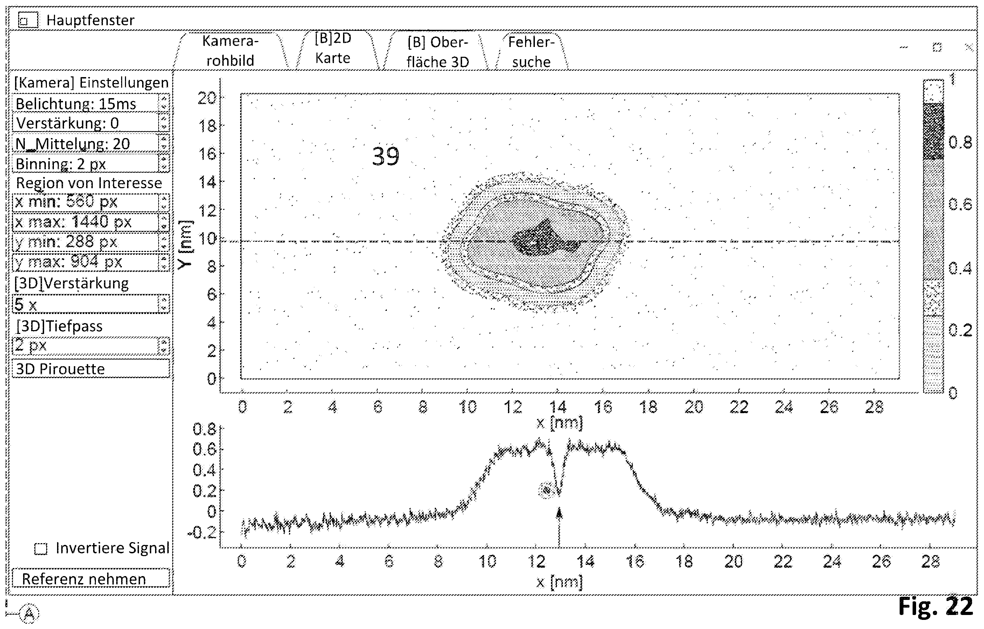

Figur 22 zeigt oben das musterkodierte Magnetflussdichtenbetragsbild **39** der Verteilung der magnetischen Flussdichte von vier Permanentmagneten **37** auf einer Glasplatte **38** in willkürlichen Einheiten. Das System der Figur 17 erzeugte dieses zweidimensionale Falschfarben- Magnetflussdichtenbetragsbild **39** der Verteilung der magnetischen Flussdichte von vier Permanentmagneten **37** auf einer Glasplatte **38** durch Aufsetzen des Magnetfeldkamerakopfes **21** der vorhergehenden Seiten mit dessen Unterseite **24** auf die Permanentmagneten **37.** (Siehe hierzu Figur 21)

Figur 22 zeigt unten den eindimensionalen Verlauf der Fluoreszenzintensität längs einer Linie durch die Gruppierung der Permanentmagneten **37** hindurch. Die Magnetfeldkamera kann Strukturen kleiner 500µm auflösen.

Bei diesen beiden Bildern handelt es sich um Zeichnungen basierend auf Screen-Shots der Darstellung auf dem Bildschirm **32.**

### Figur 23

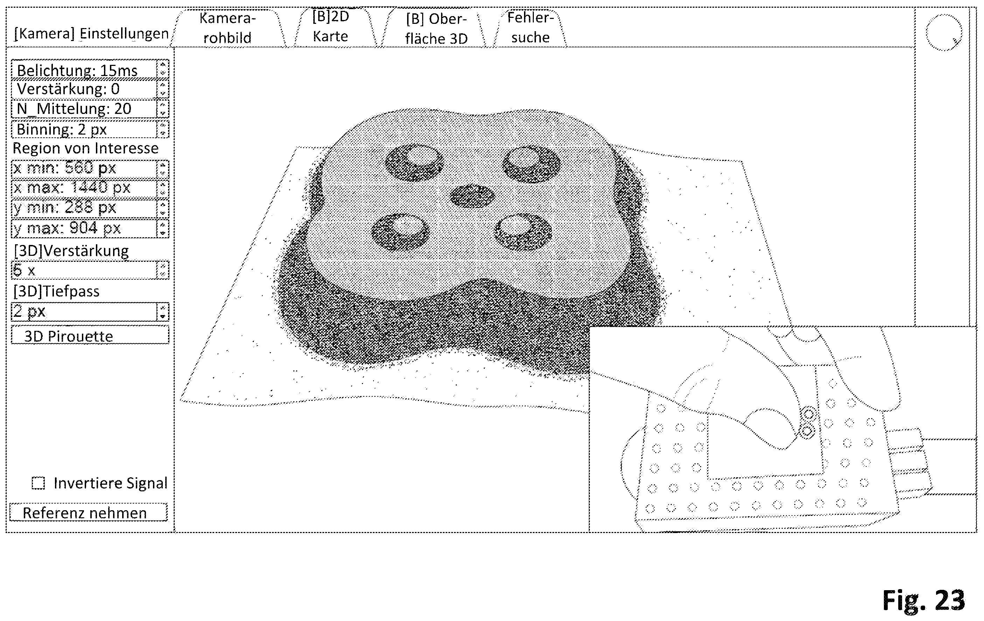

Figur 23 zeigt eine Darstellung für vier magnetisierte Ringe. Die Figur 22 zeigt unten links die entsprechende Anordnung als eine Zeichnung basierend auf einem Foto.

### Figuren 24 und 25

Die Figur 24 entspricht der Figur 21. Die Figur 25 entspricht der Figur 22. Bei der Erstellung der Figur 25 wurde nun eine magnetisierbare ferromagnetische flächige Figur (siehe Figur 23) verwendet.

Figur 25 zeigt oben das zweidimensionale musterkodierte Magnetflussdichtenbetragsbild **39** der Verteilung der magnetischen Flussdichte der magnetisierten Figur auf einer Glasplatte **38** in willkürlichen Einheiten. Das System der Figur 17 erzeugte dieses musterkodierte Magnetflussdichtenbetragsbild **39** der Verteilung der magnetischen Flussdichte von vier Permanentmagneten **37** auf einer Glasplatte **38** durch Aufsetzen des Magnetfeldkamerakopfes **21** der vorhergehenden Seiten mit dessen Unterseite **24** auf die magnetisierte Figur der Figur 24.

Figur 26 zeigt unten den eindimensionalen Verlauf der Fluoreszenzintensität längs einer Linie durch die magnetisierte Figur der Figur 24 hindurch.

Bei diesen beiden Bildern handelt es sich um Zeichnungen basierend auf Screen-Shots der Darstellung auf dem Bildschirm **32.**

### Figur 26

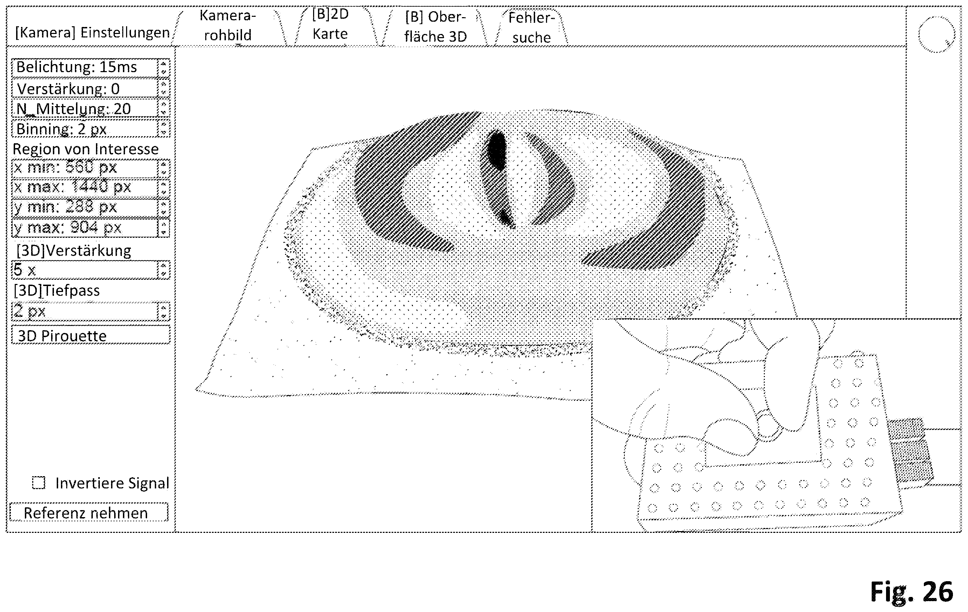

Figur 26 zeigt eine Darstellung für einen inhomogen magnetisierten Ring. Die Figur 26 zeigt unten links die entsprechende Anordnung als Zeichnung basierend auf einem Foto.

### Figur 27

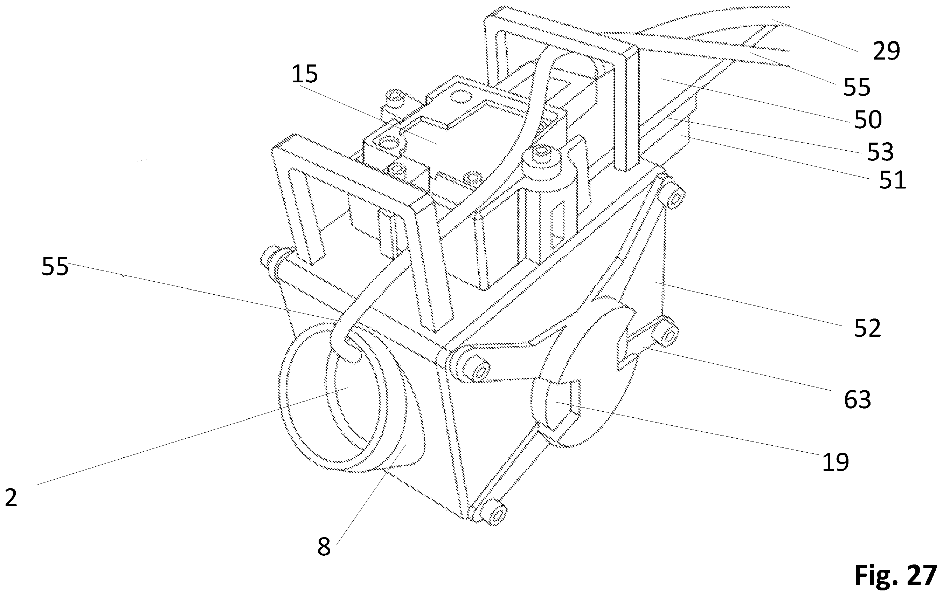

Figur 27 zeigt den Sensorkopf mit angebrachten Hilfsmagneten **19.**

### Figur 28

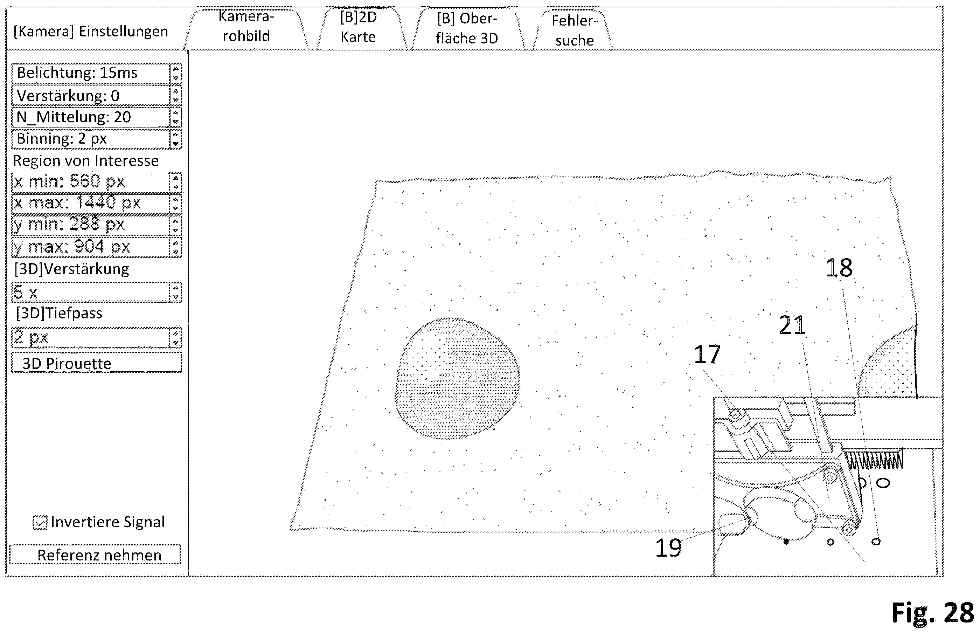

Figur 28 zeigt die Detektion und Darstellung von Bohrungen in einem ferromagnetischen Material **17** mit einer Vorrichtung der Figuren 28, 16 und 17. Bei einem der beiden Bilder handelt es sich um eine Zeichnung basierend auf einem Screen-Shot der Darstellung auf dem Bildschirm **32.** Das andere Bild ist eine Zeichnung basierend auf einem Foto der Messituation.

### Figur 29

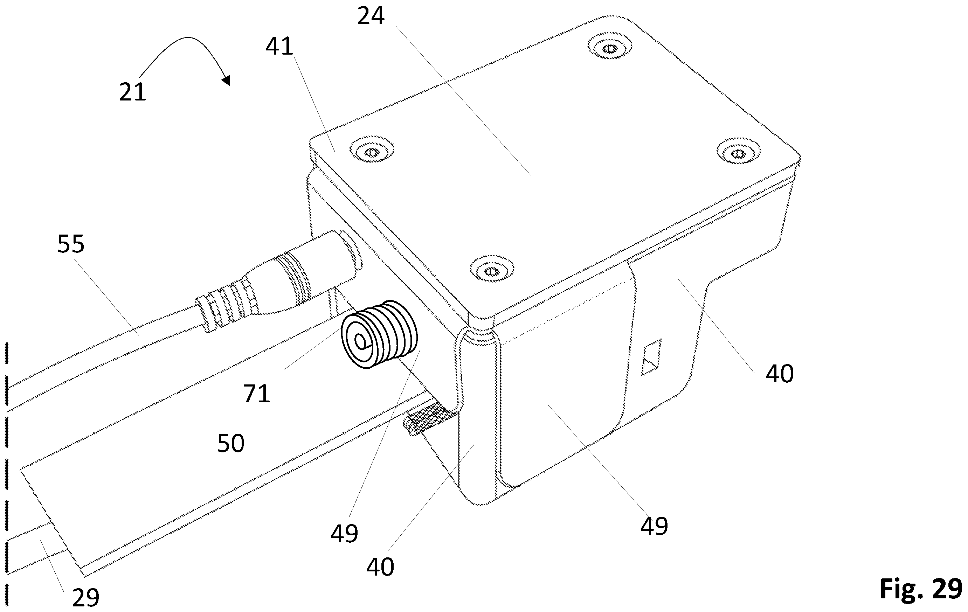

Die Figur 29 zeigt einen beispielhaften, alternativen Magnetfeldkamerakopfes **21** einer bespielhaften, alternativen Magnetfeldkamera. Das Gehäuse **8** dieses beispielhafte , alternativen Magnetfeldkamerakopfes **21** der bespielhaften, alternativen Magnetfeldkamera umfasst beispielhaft einen oberen Gehäuseteil **40** des Gehäuses **8** und einen unteren Gehäuseteil **41** des Gehäuses **8.** Beispielsweise kann es sich bei dem oberen Gehäuseteil **40** des Gehäuses **8** um einen oberen 3D-Druckgehäuseteil des beispielhaften 3D-Druckgehäuses **8** handeln. Beispielsweise kann es sich bei dem unteren Gehäuseteil **41** des Gehäuses **8** um einen unteren 3D-Druckgehäuseteil des beispielhaften 3D-Druckgehäuses **8** handeln. Der untere Gehäuseteil **41** des Gehäuses **8** umfasst hier beispielhaft die Unterseite **24** des Gehäuses **8** mit der Sensorschicht **5,** die bevorzugt die Schicht **11** mit Kristallen und/oder Nanokristallen **66** mit paramagnetischen Zentren umfasst. Die Sensorschicht **5** ist vorzugsweise durch eine dünne Materialschicht des unteren Gehäuseteils **41** des Gehäuses **8** an der die Unterseite **24** des Gehäuses **8** abgedeckt und dadurch mechanisch geschützt. Das Material dieser dünne Materialschicht des unteren Gehäuseteils **41** des Gehäuses **8** an der die Unterseite **24** des Gehäuses **8** beeinflusst bevorzugt die magnetische Flussdichte in Betrag und Richtung, die die Sensorschicht **5** durchflutet, bevorzugt im Wesentlichen nicht. Im Wesentlichen bedeutet hierbei, dass das Material dieser dünne Materialschicht des unteren Gehäuseteils **41** des Gehäuses **8** an der die Unterseite **24** des Gehäuses **8** die magnetische Flussdichte, die die Sensorschicht **5** durchflutet, beeinflusst, dass diese Beeinflussung für den jeweiligen technischen Zweck unerheblich ist und/oder dass diese Beeinflussung zur Beeinflussung eines Messwerts, der von der Fluoreszenzstrahlung **14** der der Schicht **11** abhängig ist, nur so wenig beeinflusst, dass dieser Messwert nur eine betragsmäßige Änderung erfährt, die betragsmäßig innerhalb eines vorgegebenen Toleranzintervalls liegt. Eine Energiezuleitung **55** ist mittels eines Anschlussstecker **56** für die Energiezuleitung **55** mit dem Schaltungsträger (PCB) **43** für die LEDs **44** und deren Energieversorgung **45** und der LEDs **44** im unteren Gehäuseteils **41** des Gehäuses **8** elektrisch verbunden. Di e Energiezuleitung **55** dient der Energieversorgung des Schaltungsträgers (PCB) **43** für die LEDs **44** und deren Energieversorgung **45** und der LEDs **44.**

Ein Datenbusleitung eines Datenbusses **29** dient der Herstellung der Datenverbindung zwischen Aufbereitungsschaltung **30** für die Ausgangssignale **31** der Lichtsensoren des Lichtsensorarrays **1** und Rechnersystem **28** zur Bedienung des Magnetfeldkamerakopfes **21.** (siehe auch Figur 17)

Ein zweiter Kühlkörper **49** dient der Kühlung des Schaltungsträgers (PCB) **43** für die LEDs **44** und deren Energieversorgung **45** und der LEDs **44.** Der zweite Kühlkörper **49** umfasst bevorzugt Kupfer oder ein anderes thermisch gut leitendes Material, das bevorzugt die magnetische Flussdichte, die die Schicht **11** der Sensorschicht 5 durchflutet, nicht oder schlechter im Wesentlichen nicht oder schlechter nur wenig beeinflusst, als Kühlkörpermaterial des zweiten Kühlkörpers **49.** Die Ausarbeitung des Vorschlags ergab, dass es vorteilhaft ist, die Temperatur des Lichtsensorarrays **1** und/oder der Sensorschicht **5** niedrig zu halten, um den Signal-zu-Rausch-Abstand möglichst groß zu halten. Die LEDs **44** erzeugen trotz relativ gutem Wirkungsgrad im Betrieb eine größere Menge Abwärme, die der zweite Kühlkörper **49** zur Verbesserung des Signal-zu-Rausch-Verhältnisses aus dem Gehäuse **8** abführt.

Aus dem gleichen Grund weist der hier beispielhaft vorgeschlagene Magnetfeldkamerakopfes **21** einen ersten Kühlkörper **50** zur Kühlung der Auswertelektronik **15** des Lichtsensorarrays **1** und/oder des Lichtsensorarrays **1** auf. Der erste Kühlkörper **50** verbessert hierdurch das Signal-zu-Rauschverhältnis des Video-Signals der Lichtsensorarrays **1** in der Fluoreszenzkamera des Sensorkopfes **21.**

### Figur 30

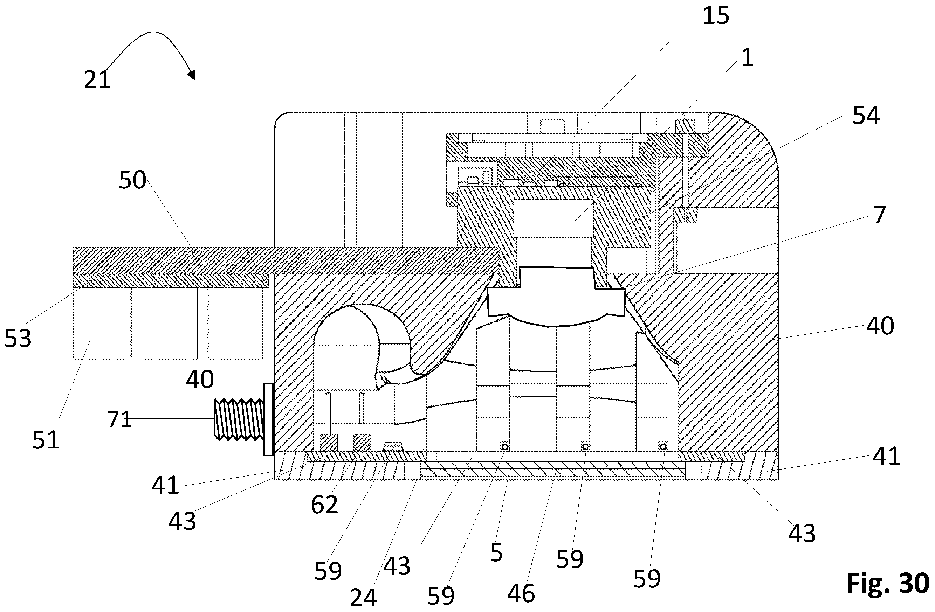

Figur 30 zeigt schematisch und vereinfacht einen Querschnitt durch den Magnetfeldkamerakopfes **21** der Figur 29.

Das Gehäuse 8 des Magnetfeldkamerakopfes 21 umfasst beispielhaft wieder, wie in der Figur 29 einen oberen Gehäuseteil **40** des Gehäuses **8** und einen unteren Gehäuseteil **41** des Gehäuses **8.**

Der untere Gehäuseteil **41** des Gehäuses **8** umfasst beispielhaft einen Schaltungsträger (PCB) **43** für die LEDs **44** und deren Energieversorgung **45.**

Auf dem Schaltungsträger (PCB) **43** sind hier beispielhaft LED-Vorwiderstände **59** montiert, beispielsweise aufgelötet oder aufgeklebt. Diese LED-Vorwiderstände **59** sind typischerweise LED-Vorwiderstände **59** der LEDs **44** auf dem Schaltungsträger (PCB) **43** für die Strombegrenzung des Diodenstroms der LEDs **44** im Betrieb. Vorzugsweise deckt eine dünne Materialschicht des unteren Gehäuseteil **41** des Gehäuses **8** die Sensorschicht **5** ab. und schützt diese. Zur besseren Übersicht ist diese möglichst dünne Materialschicht des unteren Gehäuseteil **41** des Gehäuses **8** in der Figur 30 nicht eingezeichnet. Die Lager dieser dünnen Materialschicht ist im Bereich der Sensorschicht 5 im Wesentlichen gleich der Unterseite **24** des Gehäuses **8.**

Ein auf dem Schaltungsträger (PCB) **43** montierter Kodierstecker **62** mit Jumper kann beispielsweise der Änderung analoger Betriebsparameter der elektronischen Schaltung auf dem Schaltungsträger (PCB) **43** dienen. Beispielsweise ist es denkbar, dass es möglich ist, den elektrischen LED-Strom durch die LEDs **44** auf dem Schaltungsträger (PCB) **43** mittels eines solchen Kodiersteckers **62** durch Positionieren des Jumpers einzustellen. Dabei sieht der Kodierstecker 62 typischerweise mehrere verschiendene mögliche Positionen des Jumpers auf dem Kodierstecker 62 vor, von denen jede dieser Positionen bevorzugt eine ganz bestimmte Bestromung der LEDs **44** mit einem elektrischen Strom mit einem ganz bestimmten Stromwert entspricht.

In dem Beispiel der Figur 30 sind die LED-Vorwiderstände **59** auf der der Fluoreszenzkamera zugewandten Seite des Schaltungsträgers (PCB) **43** montiert. In dem Beispiel der Figur 30 sind die LEDs **44** auf der der Fluoreszenzkamera abgewandten Seite des Schaltungsträgers (PCB) **43** montiert. Dies hat den Vorteil, dass kein oder nur wenig Streulicht von den LEDs **44** zu dem Lichtsensorarrays **1** in der Fluoreszenzkamera des Magnetfeldkamerakopfes **21** gelangen kann. Dies verbessert das Signal-zu-Rauschverhältnis des Messsignals des Magnetfeldkamerakopfes **21.** Bevorzugt ist die Sensorschicht **5** mit dem Schaltungsträgers (PCB) **43** mechanisch beispielsweise durch einen Kleber **48** festverbunden.

Die Sensorschicht **5** umfasst bevorzugt, aber nicht notwendigerweise, eine Glasplatte **46**

Die Glasplatte dient hier in dem Beispiel der Figur 30 als beispielhaftes optisches Funktionselement, dass die paramagnetischen Zentren der mit Pumpstrahlung **13** mit der Pumpstrahlungswellenlänge **λₚₘₚ.** Bevorzugt bildet die Glasplatte **46** die ebene Fläche **16** des unteren Gehäuseteils **41** des Gehäuses **8** aus. Die Glasplatte 46 hat hier im Beispiel der Figur 30 auch die Funktion des Trägermaterials II**12**.

Der erste Kühlkörper **50** dient der Kühlung der Auswertelektronik **15** des Lichtsensorarrays **1** und/oder des Lichtsensorarrays **1.** Der erste Kühlkörper **50** umfasst bevorzugt Kupfer und/oder ein anderes thermisch gut leitenden, bevorzugt im Wesentlichen nicht magnetisches Material als Kühlkörpermaterial des ersten Kühlkörpers **50.** Bevorzugt ist der erste Kühlkörper **50** in einem möglichst guten thermischen Kontakt mit dem Kameragehäuse **54** der Fluoreszenzkamera mit dem Lichtsensorarray **1** mit dessen Auswertelektronik **15** und der abbildenden Optik **7.**

Beispielsweise kann Wärmeleitpaste **53** und/oder ein Wärmeleitkleber **53** Kühlrippen **51** mit dem ersten Kühlkörper **50** thermisch und/oder mechanisch verbinden. Hierdurch kann der Kühlkörper **50** die Wärme der Auswertelektronik **15** des Lichtsensorarrays **1** der Fluoreszenzkamera an die Umgebungsluft abgegeben und die Temperatur des Lichtsensorarrays **1** senken. Dies verbessert das Signal-zu-Rausch-verhältnis des Datensignals des Lichtsensorarrays **1** über die Datenleitung **29.**

Die Fluoreszenzkamera weist in dem Beispiel der Figur 30 ein Kameragehäuse **54** der Fluoreszenzkamera mit dem Lichtsensorarray **1** auf. In dem Beispiel der Figur 30 ist das Kameragehäuse **54** der Fluoreszenzkamera mit dem Lichtsensorarray **1** mit dessen Auswertelektronik **15** und der abbildenden Optik **7** in den oberen Gehäuseteil **40** des Gehäuses **8** eingesetzt oder eingeschraubt oder eingeklebt oder dergleichen. Im Gegensatz zu den Vorrichtungen der Figuren 11, 12, 13, 14, 16, 18, 19, 20 bestrahlen die Pumpstrahlungsquellen die Sensorschicht **5** nun nicht wie in den Figuren 11, 12, 13, 14, 16, 18, 19, 20 von oben, sondern von der Seite der Glasplatte **46.** Die LEDs **44** strahlen in dem Beispiel der Figur 30 von der Seite in die Glasplatte **46** die Pumpstrahlung **13** mit der Pumpstrahlungswellenlänge **λₚₘₚ** ein. Die Pumpstrahlung **13** tritt vorzugsweise über die ganze Fläche der Glasplatte **46** aus der Glasplatte wieder aus und bestrahlt dabei die Schicht **11** mit den Kristallen und/oder Nanokristallen **66** mit den paramagnetischen Zentren, also beispielsweise den NV-Zentren, an der Unterseite der Glasplatte **46** auf der dem Lichtsensorarray **1** abgewandten Seite der Glasplatte **46.** Hierdurch regen die LEDs **44** die Kristalle und/oder Nanokristalle **66** mit den paramagnetischen Zentren, also beispielsweise den NV-Zentren, an der Unterseite der Glasplatte **46** auf der dem Lichtsensorarray **1** abgewandten Seite der Glasplatte **46** zur Emission von Fluoreszenzstrahlung **14** an. Eine bevorzugt vorhandene reflektierende Schicht **10** unterhalb der Schicht **11** mit den Kristallen und/oder mit den Nanokristallen **66** mit den paramagnetischen Zentren, also beispielsweise den NV-Zentren, an der Unterseite der Glasplatte **46** auf der dem Lichtsensorarray **1** abgewandten Seite der Glasplatte **46** reflektiert Pumpstrahlung **13** und Fluoreszenzstrahlung **14,** die nach unten aus der Schicht **11** auf der dem Lichtsensorarray **1** abgewandten Seite der Glasplatte **46** austritt, wieder in die Schicht **11** zurück. Die zurückreflektierte Pumpstrahlung **13** verstärkt die Erzeugung der Fluoreszenzstrahlung **14** in der Schicht **11.** Die zurückreflektierte Fluoreszenzstrahlung **14** gelangt, wie die direkt in Richtung des Lichtsensorarrays **1** emittierte Fluoreszenzstrahlung **14** zum Lichtsensorarray **1** und verbessert so das Signal-zu-Rausch-Verhältnis.

Typischerweise ist die lokale Intensität der Fluoreszenzstrahlung **14** der paramagnetischen Zentren in der Schicht **11** der Sensorschicht **5** an verschiedenen Positionen in der Schicht **11** von der Intensität der Pumpstrahlung **13** und dem Betrag der magnetischen Flussdichte B an diesen Positionen abhängig.

Es ergibt sich somit ein Intensitätsmuster der Emission der Fluoreszenzstrahlung **14** der paramagnetischen Zentren in der Schicht **11** der Sensorschicht **5** an verschiedenen Positionen in der Schicht **11,** das die flächenhaften Unterschiede der Beträge der Intensität der Fluoreszenzstrahlung **14** der paramagnetischen Zentren in der Schicht **11** der Sensorschicht **5** an verschiedenen Positionen des Schicht **11** wiedergibt.

Die abbildende Optik 7 erfasst dieses Intensitätsmuster der Emission der Fluoreszenzstrahlung **14** der paramagnetischen Zentren in der Schicht **11** der Sensorschicht **5** und bildet dieses Intensitätsmuster auf das Lichtsensorarray **1** ab.

Das Kameragehäuse **54** der Fluoreszenzkamera verbindet das Lichtsensorarray **1** in dem Beispiel der Figur 30 mechanisch mit dessen Auswerteelektronik **15** und der abbildenden Optik **7** und mit dem oberer Gehäuseteil **40** des Gehäuses **8.**

Der Datenbus **29** zur Herstellung der Datenverbindung zwischen Aufbereitungsschaltung **30** für die Ausgangssignale **31** der Lichtsensoren des Lichtsensorarrays **1** und Rechnersystem **28** zur Bedienung des Magnetfeldkamerakopfes **21** ist in dem Beispiel der Figur 30 zur Vereinfachung weggelassen. Eine fachkundige Person soll sich beim Lesen dieses Textes diesen Datenbus **29** zur Herstellung der Datenverbindung zwischen Aufbereitungsschaltung **30** für die Ausgangssignale **31** der Lichtsensoren des Lichtsensorarrays **1** und Rechnersystem **28** zur Bedienung des Magnetfeldkamerakopfes **21** hinzudenken.

Die Energiezuleitung **55** zur Energieversorgung des Schaltungsträgers (PCB) **43** für die LEDs **44** und deren Energieversorgung **45** und der LEDs **44** ist in dem Beispiel der Figur 30 zur Vereinfachung weggelassen. Eine fachkundige Person soll sich beim Lesen dieses Textes diese Energiezuleitung **55** zur Energieversorgung des Schaltungsträgers (PCB) **43** für die LEDs **44** und deren Energieversorgung **45** und der LEDs **44** hinzudenken.

### Figur 31

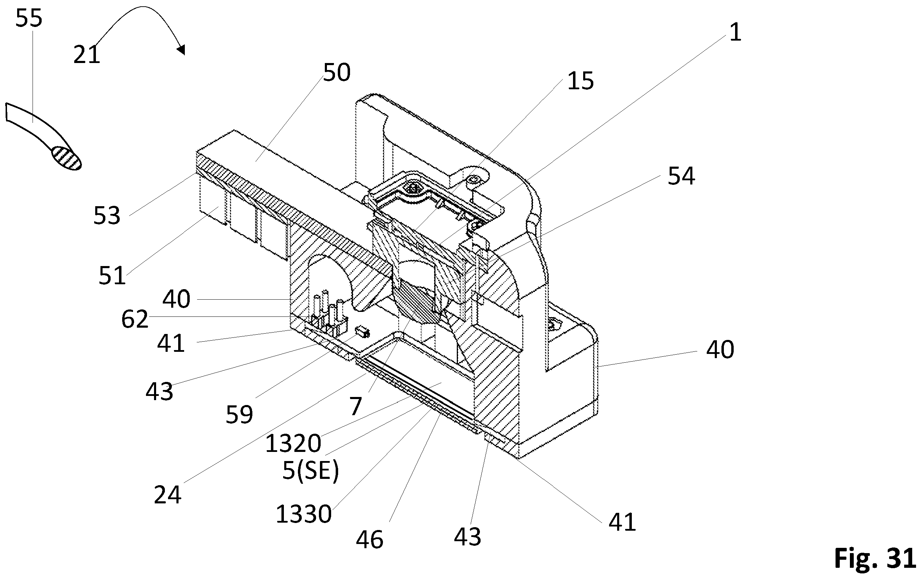

Figur 31 entspricht im Wesentlichen der Figur 30 und zeigt den gleichen Magnetfeldkamerakopfes **21** wie die Vorrichtung der Figur 30 und der Figur 29 aus einer anderen Perspektive. Das hier vorgelegte Dokument verweist daher hier auf die Beschreibungen der Figuren 29 und 30 und die Bezugszeichenliste. Die Energiezuleitung **55** zur Energieversorgung des Schaltungsträgers (PCB) **43** für die LEDs **44** und deren Energieversorgung **45** und der LEDs **44** ist in dem Beispiel der Figur 31 angeschnitten und daher nur unvollständig dargestellt. Der Datenbus **29** zur Herstellung der Datenverbindung zwischen Aufbereitungsschaltung **30** für die Ausgangssignale **31** der Lichtsensoren des Lichtsensorarrays **1** und Rechnersystem **28** zur Bedienung des Magnetfeldkamerakopfes **21** ist in dem Beispiel der Figur 31 zur Vereinfachung weggelassen. Eine fachkundige Person soll sich beim Lesen dieses Textes diesen Datenbus **29** zur Herstellung der Datenverbindung zwischen Aufbereitungsschaltung **30** für die Ausgangssignale **31** der Lichtsensoren des Lichtsensorarrays **1** und Rechnersystem **28** zur Bedienung des Magnetfeldkamerakopfes **21** hinzudenken.

Im Blickfeld der Kamera befinden sich dabei Leitungen **1320, 1310, 1330** einer beispielhaften Tri-Plate-Leitung **1380** mit einem Sensorelement in den Clearances **2340** und **2350.** Die Verwendung anderer Wellenleitungen **(1380, 1880, 2380, 6880, 6980)** ist denkbar. Auch die Verwendung einer durchgängigen Sensorschicht **5** ohne Wellenleitungen **(1380, 1880, 2380, 6880, 6980)** ist denkbar, wobei dann die Nutzung einer Mikrowellen- und/oder HF-Anregung der NV-Zentren und/oder paramagnetischen Zentren der Sensorschicht 5 nicht möglich ist. Die Wellenleitung **(1380, 1880, 2380, 6880, 6980)** kann beispielsweise über eine Steckverbindung, wie beispielsweise eine Koaxialbuchs oder einen Triax-Buchse **71** vorzugsweise angeschlossen werden.

### Figur 32

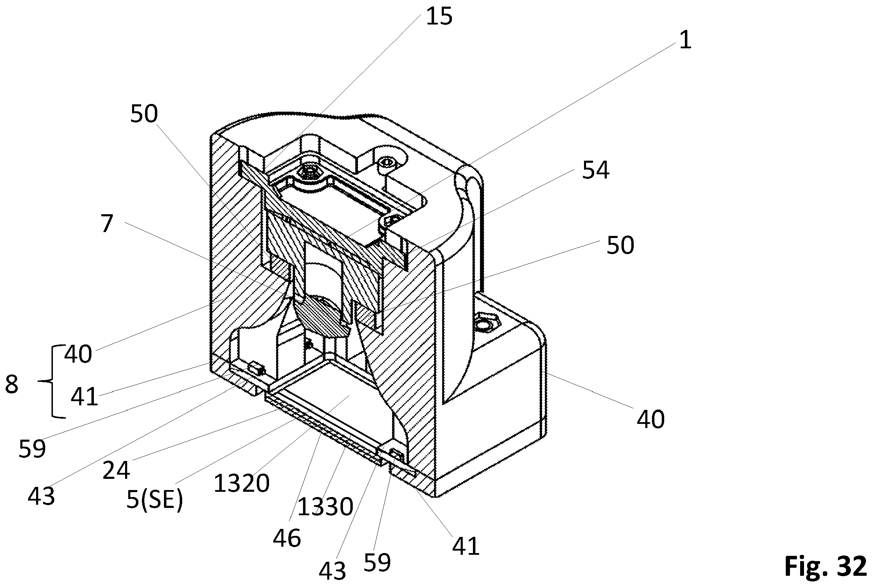

Figur 32 entspricht insofern im Wesentlichen den Figuren 29 bis 31, als dass die Figur 32 nun einen Querschnitt durch den Magnetfeldkamerakopfes **21** der Figuren 29 bis 31 quer zum ersten Kühlkörper **50** zeigt. Das hier vorgelegte Dokument verweist daher hier auf die Beschreibungen der Figuren 29 bis 31 und die Bezugszeichenliste.

Im Blickfeld der Kamera befinden sich dabei Leitungen **1320, 1310, 1330** einer beispielhaften Tri-Plate-Leitung **1380** mit einem Sensorelement in den Clearances **2340** und **2350.** Die Verwendung anderer Wellenleitungen **(1380, 1880, 2380, 6880, 6980)** ist denkbar. Auch die Verwendung einer durchgängigen Sensorschicht **5** ohne Wellenleitungen **(1380, 1880, 2380, 6880, 6980)** ist denkbar, wobei dann die Nutzung einer Mikrowellen- und/oder HF-Anregung der NV-Zentren und/oder paramagnetischen Zentren der Sensorschicht 5 nicht möglich ist. Die Wellenleitung **(1380, 1880, 2380, 6880, 6980)** kann beispielsweise über eine Steckverbindung, wie beispielsweise eine Koaxialbuchs oder einen Triax-Buchse **71** vorzugsweise angeschlossen werden.

### Figur 33

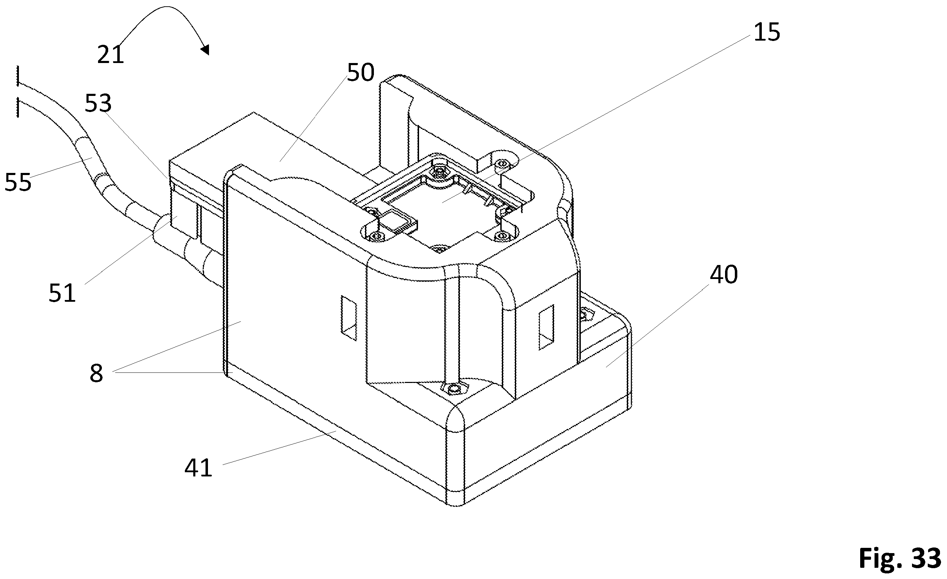

Figur 33 entspricht insofern im Wesentlichen den Figuren 29 bis 32, als dass die Figur 33 eine Seitenansicht ohne Schnitt aus einer anderen Perspektive. Das hier vorgelegte Dokument verweist daher hier auf die Beschreibungen der Figuren 29 bis 32 und die Bezugszeichenliste.

Der Datenbus **29** zur Herstellung der Datenverbindung zwischen Aufbereitungsschaltung **30** für die Ausgangssignale **31** der Lichtsensoren des Lichtsensorarrays **1** und Rechnersystem **28** zur Bedienung des Magnetfeldkamerakopfes **21** ist in dem Beispiel der Figur 33 zur Vereinfachung weggelassen. Eine fachkundige Person soll sich beim Lesen dieses Textes diesen Datenbus **29** zur Herstellung der Datenverbindung zwischen Aufbereitungsschaltung **30** für die Ausgangssignale **31** der Lichtsensoren des Lichtsensorarrays **1** und Rechnersystem **28** zur Bedienung des Magnetfeldkamerakopfes **21** hinzudenken.

### Figur 34

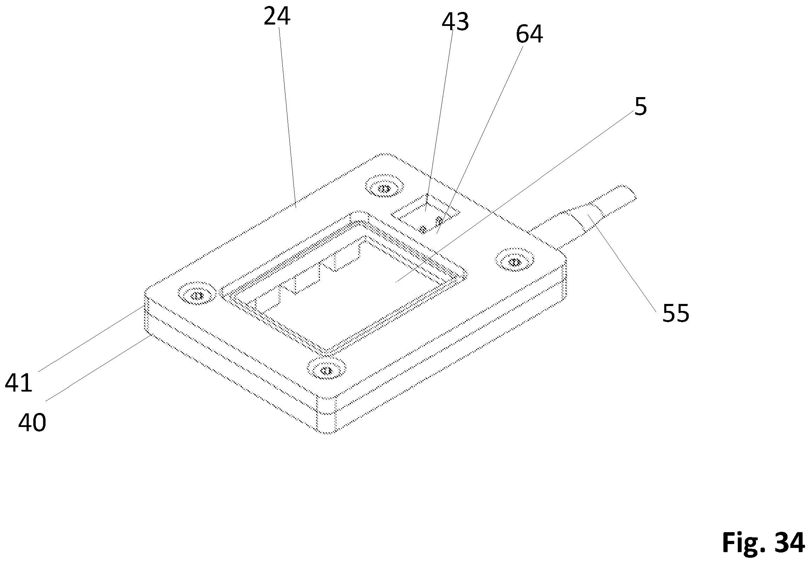

Figur 34 entspricht insofern im Wesentlichen den Figuren 29 bis 33, als dass die Figur 34 eine Seitenansicht mit horizontalem Schnitt aus einer Perspektive von unten mit Blick auf die Sensorschicht **5** auf der Unterseite **24** des Sensorkopfes **21** der Figuren 29 bis 33. Das hier vorgelegte Dokument verweist daher hier auf die Beschreibungen der Figuren 29 bis 33 und die Bezugszeichenliste.

Der oberer Gehäuseteil **40** des Gehäuses **8** und die Energiezuleitung **55** sind angeschnitten und daher nur teilweise dargestellt, ohne dass die Schnittflächen in der Figur 34 sichtbar sind.

### Figur 35

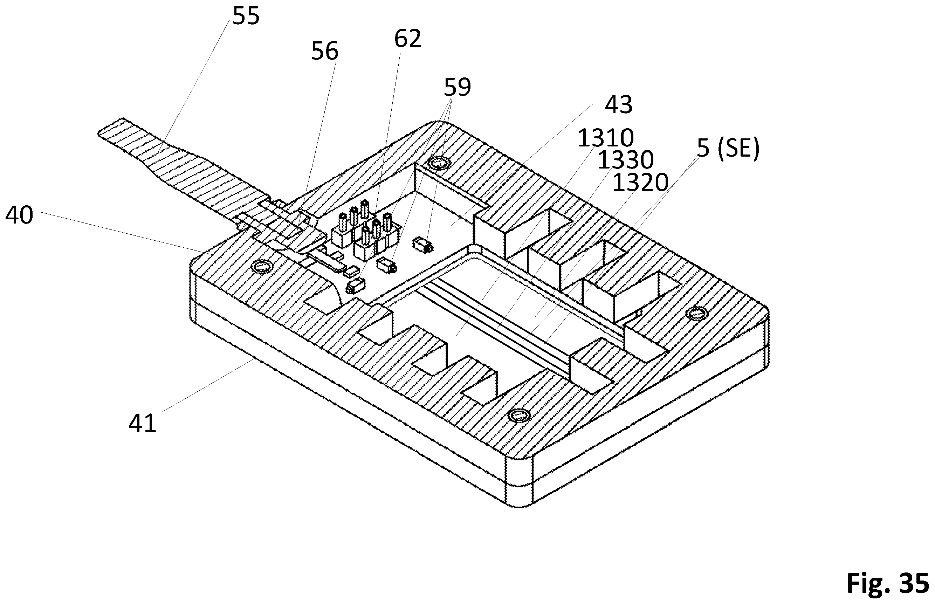

Figur 35 entspricht der Figur 34 mit dem Unterschied, dass der in der Figur 34 dargestellt angeschnittene Teil des Magnetfeldkamerakopfes **21** nun mit der Schnittfläche nach oben statt nach unten dargestellt ist. Figur 35 entspricht insofern im Wesentlichen den Figuren 29 bis 35, als dass die Figur 35 eine Seitenansicht mit horizontalem Schnitt und Blick von oben darstellt. Das hier vorgelegte Dokument verweist daher hier auf die Beschreibungen der Figuren 29 bis 34 und die Bezugszeichenliste.

Im späteren Blickfeld der Kamera befinden sich dabei Leitungen **1320, 1310, 1330** einer beispielhaften Tri-Plate-Leitung **1380** mit einem Sensorelement in den Clearances **2340** und **2350.** Die Verwendung anderer Wellenleitungen **(1380, 1880, 2380, 6880, 6980)** ist denkbar. Auch die Verwendung einer durchgängigen Sensorschicht **5** ohne Wellenleitungen **(1380, 1880, 2380, 6880, 6980)** ist denkbar, wobei dann die Nutzung einer Mikrowellen- und/oder HF-Anregung der NV-Zentren und/oder paramagnetischen Zentren der Sensorschicht 5 nicht möglich ist. Die Wellenleitung **(1380, 1880, 2380, 6880, 6980)** kann beispielsweise über eine Steckverbindung, wie beispielsweise eine Koaxialbuchs oder einen Triax-Buchse **71** vorzugsweise angeschlossen werden.

### Figur 36

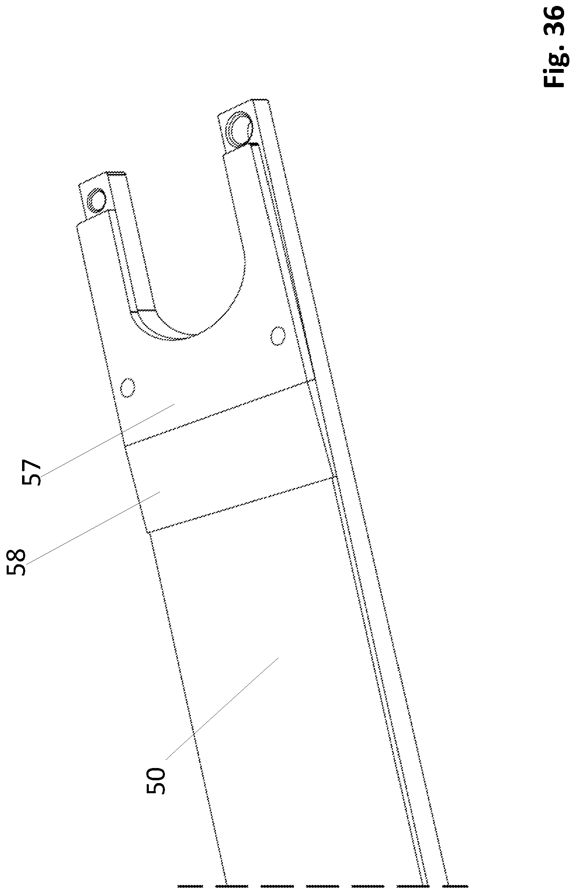

Figur 36 zeigt den ersten Kühlkörper **50** vor dem Einsetzen in das Gehäuse **8.** In dem hier vorgestellten Beispiel der Figuren 29 bis 36 schlägt das hier vorgelegte Dokument vor, ein elastisches und thermisch leitendes Material **57** und/oder eine thermisch leitende Isolationsfolie **58** zwischen Kühlkörper **50** und Gehäuse **8** vorzusehen, die eine elektrische Isolierung sicherstellen und/oder das Auftreten mechanischer Spannungen bei Erwärmung infolge unterschiedlicher thermischer Ausdehnungskoeffizienten verringern.

### Figur 37

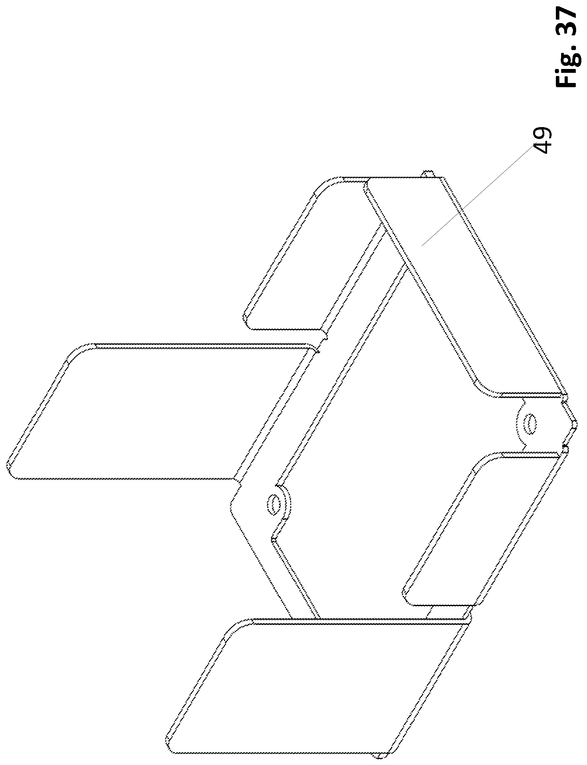

Figur 37 zeigt einen beispielhaften zweiter Kühlkörper **49** zur Kühlung des Schaltungsträgers (PCB) **43** für die LEDs **44** und deren Energieversorgung **45** und der LEDs **44** vor dessen Einbau in einen Sensorkopf entsprechend den Figuren 29 bis 36. Der zweite Kühlkörper **49** umfasst bevorzugt Kupfer als Kühlkörpermaterial des zweiten Kühlkörpers **49** oder ein anderes thermisch gut leitendes Kühlkörpermaterial.

### Figur 38

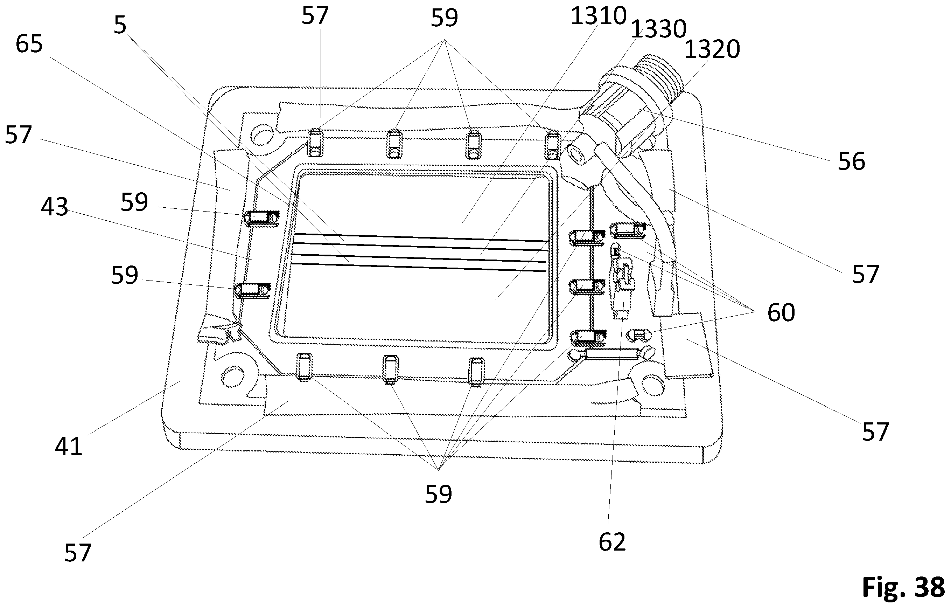

Figur 38 zeigt den unteren Gehäuseteil **41** des Gehäuses **8** eines Magnetfeldkamerakopfes **21** entsprechend den Figuren 29 bis 37 mit dem Schaltungsträger (PCB) **43** vor dem Einbau in das Gehäuse **8.** Der Schaltungsträgers (PCB) **43** ist mit den LEDs 44 nach unten auf den unteren Gehäuseteil **41** des Gehäuses **8** montiert. Die LEDs **44** sind daher nicht sichtbar. Die LED-Vorwiderstände **59** der LEDs **44** befinden sich auf der sichtbaren Oberseite auf dem Schaltungsträger (PCB) **43** für die LEDs **44.** Zur besseren Klarheit sei hier erwähnt, dass das Bezugszeichen **59** sich auf die Vorwiderstände **59** der LEDs **44** und nicht auf die Sensorschicht **5** bezieht. Die Sensorschicht **5** ist mit ihrer Glasplatte **46** an dem Schaltungsträger (PCB) **43** für die LEDs **44** befestigt. Der Schaltungsträger (PCB) **43** für die LEDs **44** weist eine Öffnung auf, sodass die Fluoreszenzstrahlung **14** der paramagnetischen Zentren in der Schicht **11** auf der Unterseite der Glasplatte **46** durch die Glasplatte **46** und die Öffnung in dem Schaltungsträger (PCB) **43** zum Lichtsensorarray **1** gelangen kann.

Mittels eines Jumpers am beispielhaften Kodierstecker **62** kann beispielhaft die Intensität der Pumpstrahlung **13** der LEDs **44** beispielsweise durch Selektion von Spannungsteilerausgangswerten oder dergleichen eingestellt werden.
Ein Anschlussstecker **56** für die Energiezuleitung **55** dient der Energieversorgung des Schaltungsträgers (PCB) **43** für die LEDs **44** und deren Energieversorgung **45** und der LEDs **44.**
Typischerweise befinden sich auf der Oberseite des Schaltungsträgers (PCB) **43** für die LEDs **44** weitere elektronische Bauteile **60** beispielsweise für die Energieversorgung der LEDs **44.**

Beispielsweise kann sich ein Spannungsregler **61** als ein solches weiters Bauteil **60** auf der Oberseite des Schaltungsträgers (PCB) **43** für die LEDs **44** befinden.

In dem Beispiel der Figur 38 dienen elastische und thermisch leitende Materialien **57** zwischen unterem Gehäuseteil **41** des Gehäuses **8** und oberen Gehäuseteil **40** des Gehäuses **8** dazu, das Auftreten mechanischer Spannungen bei Erwärmung infolge unterschiedlicher thermischer Ausdehnungskoeffizienten und/oder unterschiedlicher thermischer Belastungen zu verringern.

Im späteren Blickfeld der Kamera befinden sich dabei Leitungen **1320, 1310, 1330** einer beispielhaften Tri-Plate-Leitung **1380** mit einem Sensorelement in den Clearances **2340** und **2350.** Die Verwendung anderer Wellenleitungen **(1380, 1880, 2380, 6880, 6980)** ist denkbar. Auch die Verwendung einer durchgängigen Sensorschicht **5** ohne Wellenleitungen **(1380, 1880, 2380, 6880, 6980)** ist denkbar, wobei dann die Nutzung einer Mikrowellen- und/oder HF-Anregung der NV-Zentren und/oder paramagnetischen Zentren der Sensorschicht 5 nicht möglich ist. Die Wellenleitung **(1380, 1880, 2380, 6880, 6980)** kann beispielsweise über eine Steckverbindung, wie beispielsweise eine Koaxialbuchs oder einen Triax-Buchse **71** vorzugsweise angeschlossen werden.

### Figur 39

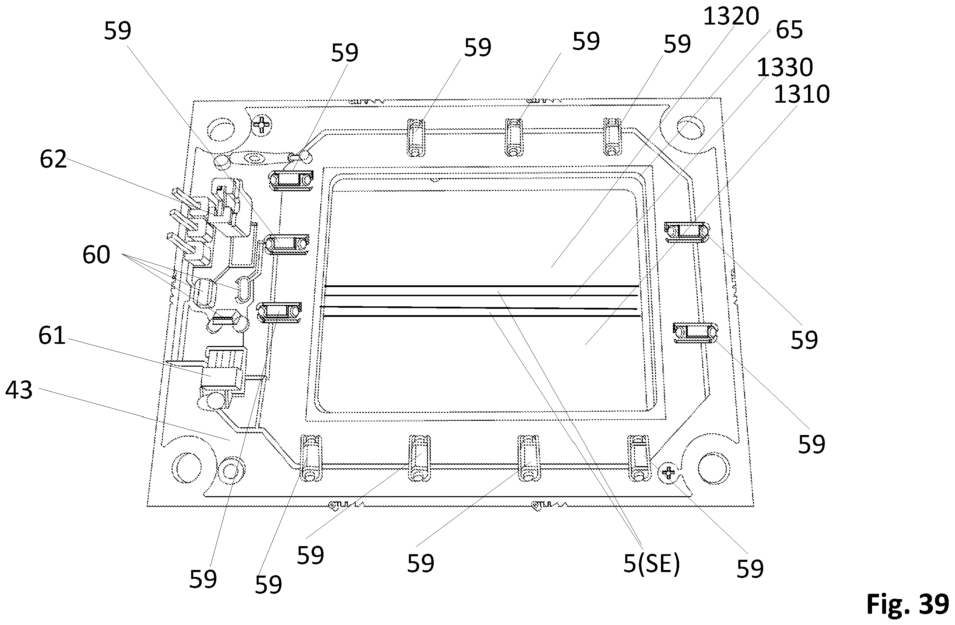

Figur 39 zeigt die Unterseite des Schaltungsträgers (PCB) **43** eines Magnetfeldkamerakopfes **21** entsprechend den Figuren 29 bis 38 mit den Vorwiderständen **59** der LEDs **44.** Der Schaltungsträger (PCB) **43** ist zu einem Einsatz in einem Magnetfeldkamerakopfes **21** entsprechend den Figuren 29 bis 38 vorgesehen. Die Öffnung **65** in dem Schaltungsträger (PCB) **43** dient dazu, dass die Fluoreszenzstrahlung **14** der paramagnetischen Zentren, also beispielsweise der NV-Zentren, in der Schicht **11** der Sensorschicht **5** auf der Unterseite der Glasplatte **46** durch die Glasplatte **46** und die Öffnung in dem Schaltungsträger (PCB) **43** zum Lichtsensorarray **1** gelangen kann. Mittels eines Kodiersteckers **62** kann in dem Beispiel der Figur 39 der Nutzer die Helligkeit der LEDs **44** einstellen. Bevorzugt können die Nutzer mittels des Kodiersteckers **62** die Ausgangsspannung des Spannungsreglers **61** einstellen. Bevorzugt versorgt der Spannungsregler **62** über die Vorwiderstände **59** der LEDs **44** die LEDs **44.** Der Kodierstecker **62** dient somit bevorzugt zur Änderung analoger Betriebsparameter der elektronischen Schaltung auf dem Schaltungsträger (PCB) **43.**

Im späteren Blickfeld der Kamera befinden sich dabei Leitungen **1320, 1310, 1330** einer beispielhaften Tri-Plate-Leitung **1380** mit einem Sensorelement in den Clearances **2340** und **2350.** Die Verwendung anderer Wellenleitungen **(1380, 1880, 2380, 6880, 6980)** ist denkbar. Auch die Verwendung einer durchgängigen Sensorschicht **5** ohne Wellenleitungen **(1380, 1880, 2380, 6880, 6980)** ist denkbar, wobei dann die Nutzung einer Mikrowellen- und/oder HF-Anregung der NV-Zentren und/oder paramagnetischen Zentren der Sensorschicht 5 nicht möglich ist. Die Wellenleitung **(1380, 1880, 2380, 6880, 6980)** kann beispielsweise über eine Steckverbindung, wie beispielsweise eine Koaxialbuchs oder einen Triax-Buchse **71** vorzugsweise angeschlossen werden.

### Figur 40

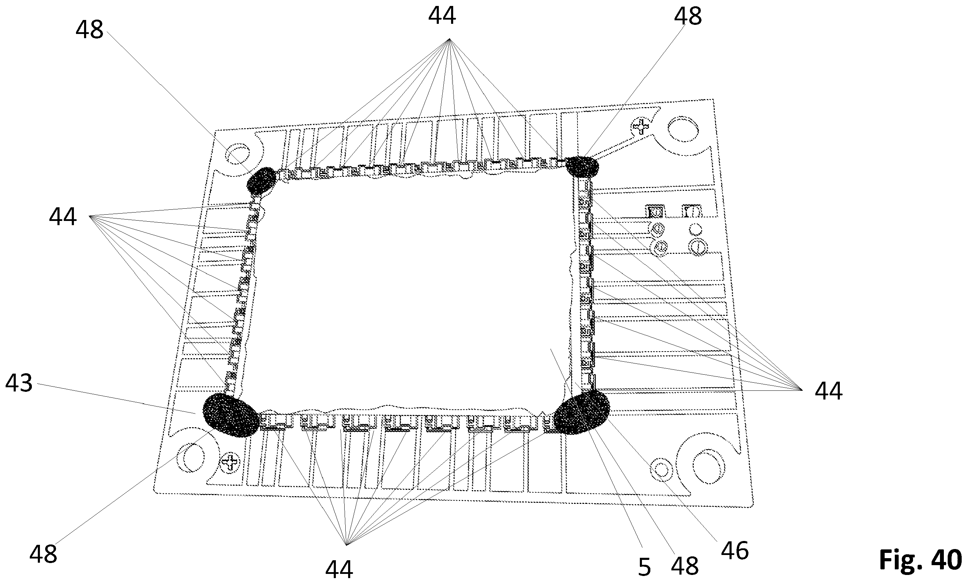

Figur 40 zeigt die Unterseite des Schaltungsträgers (PCB) **43** eines Magnetfeldkamerakopfes **21** entsprechend den Figuren 29 bis 39 mit den LEDs **44.** Figur 40 zeigt dabei die Unterseite des Schaltungsträgers (PCB) **43** der vorausgehenden Figur 39. An dem Schaltungsträger (PCB) **43** ist mittels vier Klebepunkten mit Kleber **48** eine Glasplatte **46** befestigt. Diese Glasplatte **46** dient als beispielhaftes optisches Funktionselement. Die LEDs **44** strahlen die Pumpstrahlung **13** mit der Pumpstrahlungswellenlänge **λₚₘₚ** über die Kanten der Glasplatte **46** in das für elektromagnetische Strahlung, insbesondere Pumpstrahlung **13,** der Pumpstrahlungswellenlänge **λₚₘₚ** transparente Material der Glasplatte **46** ein. Typischerweise tritt ein Teil dieser Pumpstrahlung **13** in die Richtung aus jener Glasplattenoberfläche der Glasplatte **46** aus, die vom Lichtsensorarray **1** abgewandt ist, und bestrahlt dort die Sensorschicht **5,** die die Schicht **11** mit den paramagnetischen Zentren, beispielsweise NV-Zentren, umfasst, mit Pumpstrahlung **13** der Pumpstrahlungswellenlänge **λₚₘₚ** . Dies regt die paramagnetischen Zentren in der Schicht **11** zur Emission einer magnetfeldabhängigen Fluoreszenzstrahlung **14** an, die das Lichtsensorarray **1** mittels der abbildenden Optik **7** ortsaufgelöst detektieren und als Bild erfassen kann.

Leider ist die Intensitätsverteilung der Intensität der an einem Punkt der Oberfläche der Glasplatte **46** aus dieser abgewandten Glasplattenoberfläche der Glasplatte **46** austretenden Pumpstrahlung **13** vom inversen quadratischen Abstand dieses Punkts der Oberfläche der Glasplatte **46** von der betreffenden LED **44** abhängig. Diese Abstandsabhängigkeit kann durch eine Diffuser-Struktur in einer Diffusor-Schicht **69** auf dieser abgewandten Glasplattenoberfläche der Glasplatte **46** ausgeglichen werden. Bevorzugt ist somit die Glasplatte **46** auf der Oberfläche, die vom Lichtsensorarray **1** abgewandt ist, mit einer Diffusor-Struktur in einer Diffusor-Schicht **69** versehen, die eine homogene Beleuchtung der Schicht **11** und damit der in der Schicht **11** enthaltenen paramagnetischen Zentren mit Pumpstrahlung **13** durch die LEDs **44** sicherstellt.

Bei diesem System aus einer Glasplatte **46,** den LEDs **44,** die von den Kanten der Glasplatte **46** Pumpstrahlung **13** in das Material der Glasplatte **46** einstrahlen, der Diffusor-Schicht **69** und der Schicht **11** mit den paramagnetischen Zentren handelt es sich letztlich um ein flaches Flächenbeleuchtungssystem, mit: a) einer flächigen Pumpstrahlungsquelle (**44, 46**) für Pumpstrahlung **13** mit der Pumpstrahlungswellenlänge **λₚₘₚ**, die ein Substrat und mindestens einen auf dem Substrat (Glaswafer **46**) ausgebildeten, im Wesentlichen nicht gepixelten, Pumpstrahlung 13 ausstrahlenden Bereich aufweist, der Pumpstrahlung **13** von mindestens einer Pumpstrahlung **13** ausstrahlenden Seite der flächigen Pumpstrahlungsquelle aus in jede Richtung ausstrahlt (Nach unten zeigende Oberfläche der Glasplatte **46**); und b) einer Pumpstrahlung **13** lenkenden, optischen Schicht - beispielsweise der Glasplatte **46** -, die auf der mindestens einen Pumpstrahlung **13** ausstrahlenden Seite(Kante der Glasplatte **46**) über dem Pumpstrahlung **13** ausstrahlenden Bereich einer punktförmigen oder flächigen Pumpstrahlungsquelle (beispielhafte LEDs **44**) angeordnet ist, worin die Pumpstrahlung **13** lenkende, optische Schicht - insbesondere die Glasplatte **46** - vorzugsweise Pumpstrahlung **13** aus einer Richtung weglenkt, die rechtwinklig zur Fläche der Pumpstrahlung **13** (Lichtausbreitungsebene der Pumpstrahlung **13** in der Glasplatte 46) ausstrahlenden Seite der flächigen oder punktförmigen Pumpstrahlungsquelle (**46, 44**) verläuft.

In einer Ausprägung des flachen Flächenbeleuchtungssystems weist die Pumpstrahlung **13** lenkende, optische Schicht (Glasplatte **46**) eine strukturierte erste Oberfläche(Unterseite der Glasplatte **46**) auf, die der Pumpstrahlung **13** ausstrahlenden Seite der punktförmigen oder flächigen Pumpstrahlungsquelle (LEDs **44**) benachbart angeordnet ist.

In einer Ausprägung des flachen Flächenbeleuchtungssystems weist die Pumpstrahlung **13** lenkende, optische Schicht (Glasplatte **46**) eine plane erste Oberfläche auf, die der Pumpstrahlung **13** ausstrahlenden Seite der punktförmigen oder flächigen Pumpstrahlungsquelle (LEDs **44**) rechtwinklig gegenüber angeordnet ist.

In einer Ausprägung des flachen Flächenbeleuchtungssystems weist die Pumpstrahlung **13** lenkende, optische Schicht (Glasplatte **46**) eine plane erste Oberfläche auf, die der Pumpstrahlung **13** ausstrahlenden Seite der flächigen Pumpstrahlungsquelle (LEDs **44**) gegenüber angeordnet ist.

In einer Ausprägung des flachen Flächenbeleuchtungssystems weist die strukturierte erste Oberfläche der Pumpstrahlung **13** lenkenden, optischen Schicht (Glasplatte **46**) dreieckige Prismen oder eine auf die erste Oberfläche der Pumpstrahlung **13** lenkenden, optischen Schicht (Glasplatte **46**) aufgebrachte Diffusor-Schicht **69** beispielsweise als Diffusor auf.

In einer Ausprägung des flachen Flächenbeleuchtungssystems weist die strukturierte Oberfläche beispielsweise zylindrische Linsen oder andere optische und/oder mikrooptische Funktionselemente auf.

In einer Ausprägung des flachen Flächenbeleuchtungssystems weist die strukturierte Oberfläche eine Vielzahl keilförmiger Strukturen auf, die eine lange Achse aufweisen, wobei die Achsen der keilförmigen Strukturen bevorzugt dann in einer gemeinsamen Richtung ausgerichtet sind.

In einer Ausprägung des flachen Flächenbeleuchtungssystems umfasst eine flächige Pumpstrahlungsquelle OLEDs oder VCSELs als LEDs **44.**

In einer Ausprägung des flachen Flächenbeleuchtungssystems weist die Pumpstrahlung **13** lenkende, optische Schicht (Glasplatte **46**) eine plane erste Oberfläche auf, die der Pumpstrahlung **13** ausstrahlenden Seite der punktförmigen oder flächigen Pumpstrahlungsquelle (LEDs **44**) gegenüber angeordnet ist, wobei bevorzugt die flächigen Pumpstrahlungsquellen (LEDs **44**) OLEDs oder VCSELs als LEDs **44** umfassen.

In einer Ausprägung des flachen Flächenbeleuchtungssystems umfasst das flächige Flächenbeleuchtungssystem in einer Diffusor-Schicht **69** einen Diffusor, der zwischen der Pumpstrahlung **13** lenkenden, optischen Schicht und der flächigen Pumpstrahlungsquelle angeordnet ist.

In einer Ausprägung des flachen Flächenbeleuchtungssystems umfasst das Flächenbeleuchtungssystem eine zweite, Pumpstrahlung **13** lenkende, optischen Schicht, die über der Pumpstrahlung **13** lenkenden optischen Schicht und parallel zur Pumpstrahlung **13** lenkenden optischen Schicht angeordnet ist.

In einer Ausprägung des flachen Flächenbeleuchtungssystems ist beispielsweise die Pumpstrahlung **13** lenkende optische Schicht in eine Vielzahl von Bereichen unterteilt und Pumpstrahlung **13** lenkende Strukturen sind in einem Bereich in einem Winkel ausgerichtet, der sich von dem Winkel Licht lenkender Strukturen in einem zweiten Bereich unterscheidet.

Bevorzugt befindet sich die Schicht **11** mit den paramagnetischen Zentren auf der Oberfläche des flachen Flächenbeleuchtungssystems, also beispielsweise auf der Oberfläche einer Diffusor-Schicht **69** eines Diffusors, der sich bevorzugt wieder auf einer Oberfläche der besagten Glasplatte **46** befindet.

Das flache Flächenbeleuchtungssystem umfasst somit bevorzugt
- Pumpstrahlungsquellen, hier beispielhaft in Form der LEDs **44,**
- eine Pumpstrahlung **13** transportierende Schicht, hier die Glasplatte **46,**
- wobei die Pumpstrahlungsquellen eine Pumpstrahlung **13** mit der Pumpstrahlungswellenlänge **λₚₘₚ** in eine diese Pumpstrahlung transportierende Schicht, hier die Glasplatte **46,** die Pumpstrahlung **13** von der Seite über eine Kante der Glasplatte **46** einspeisen,
- eine Diffusor-Schicht **69,** die eine weitere, eine Pumpstrahlung **13** lenkende, optische Schicht ist,
- wobei die Diffusor-Schicht **69** auf der mindestens einen Pumpstrahlung **13** ausstrahlenden Seite über dem Pumpstrahlung **13** ausstrahlenden Bereich flächigen Pumpstrahlungsquelle angeordnet ist, worin die Pumpstrahlung **13** lenkende, optische Schicht vorzugsweise Pumpstrahlung **13** aus einer Richtung weglenkt, die vorzugsweise im Wesentlichen rechtwinklig zur Fläche der Pumpstrahlung **13** ausstrahlenden Seite der punktförmigen oder flächigen Pumpstrahlungsquelle (insbesondere der LEDs 44) verläuft

Die Diffusor-Schicht **69** lenkt somit bevorzugt die Pumpstrahlung **13** in der Glasplatte **46** auf die auf der Diffusor-Schicht **69** bevorzugt befindliche Schicht **11** mit den paramagnetischen Zentren, die daraufhin Fluoreszenzstrahlung **14** emittieren. Die Diffusor-Schicht **69** kann auch durch eine Mattierung und/oder Strukturierung der ersten Oberfläche **67** der Glasplatte **46** erreicht werden. Auch die zweite Oberfläche **68** der Glasplatte **46** kann eine Diffusor-Schicht **69** aufweisen. Beispielsweise kann durch eine unterschiedliche Rauigkeit der Oberfläche der Glasplatte **46** erreicht werden, das ein örtlich unterschiedlicher Anteil der Pumpstrahlung **13** in der Glasplatte **46** aus der Glasplatte **46** aus- und in die Schicht **11** eingekoppelt wird. Beispielsweise kann die Oberfläche der Glasplatte so strukturiert werden, dass in größerer Entfernung von den Pumpstrahlungsquellen (LEDs **44**) ein größerer Anteil der Pumpstrahlung **13** aus der Glasplatte **46** heraus in die Schicht **11** mit den paramagnetischen Zentren eingekoppelt wird. Hierdurch kann erreicht werden, dass bei einem homogenen externen Magnetfeld mit einer homogenen magnetischen Flussdichte die Intensität der erzeugten Fluoreszenzstrahlung **14** an Punkten der Oberfläche der Schicht **11** im Wesentlichen nicht mehr von der Entfernung zu den Pumpstrahlungsquellen, hier den LEDs **44,** abhängt.

die so konstruierte flächige Pumpstrahlungsquelle aus LEDs **44** und Glasplatte **46** und optionaler Diffusor-Schicht **69** bzw. Diffusor-Oberflächenstruktur der Glasplatte **46** bestrahlt dann die paramagnetischen Zentren der Schicht **11** mit Pumpstrahlung **13** mit der Pumpstrahlungswellenlänge **λₚₘₚ.** Die Schicht **11** umfasst dabei bevorzugt Kristalle **66,** besonders bevorzugt Mikro- oder Nanokristalle **66,** mit diesen paramagnetischen Zentren, die bevorzugt NV-Zentren in Diamantkristallen sind. Bevorzugt bildet die Glasplatte **46** die ebene Fläche **16** des unteren Gehäuseteils **41** des Gehäuses **8** aus. Die Glasplatte **46** hat hier auch die Funktion des Trägermaterials II **12.**

### Figur 41

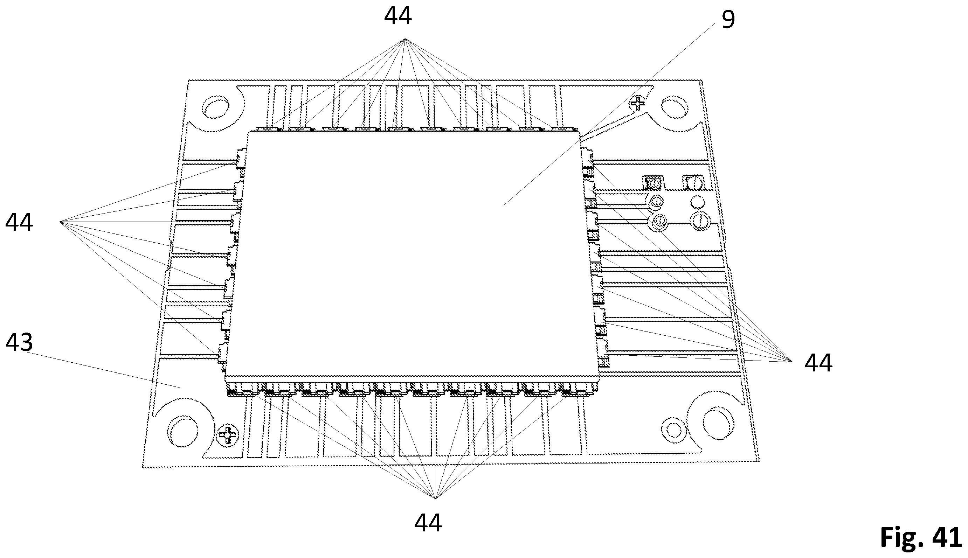

Figur 41 zeigt die Unterseite des Schaltungsträgers (PCB) **43** des Magnetfeldkamerakopfes **21** entsprechend den Figuren 29 bis 40. Figur 41 entspricht insbesondere der Figur 40, wobei nun die Schicht **11** der Sensorschicht **5** mit einem Trägermaterial **I 9** als reflektierender Schicht **10** abgedeckt ist.

### Figur 42

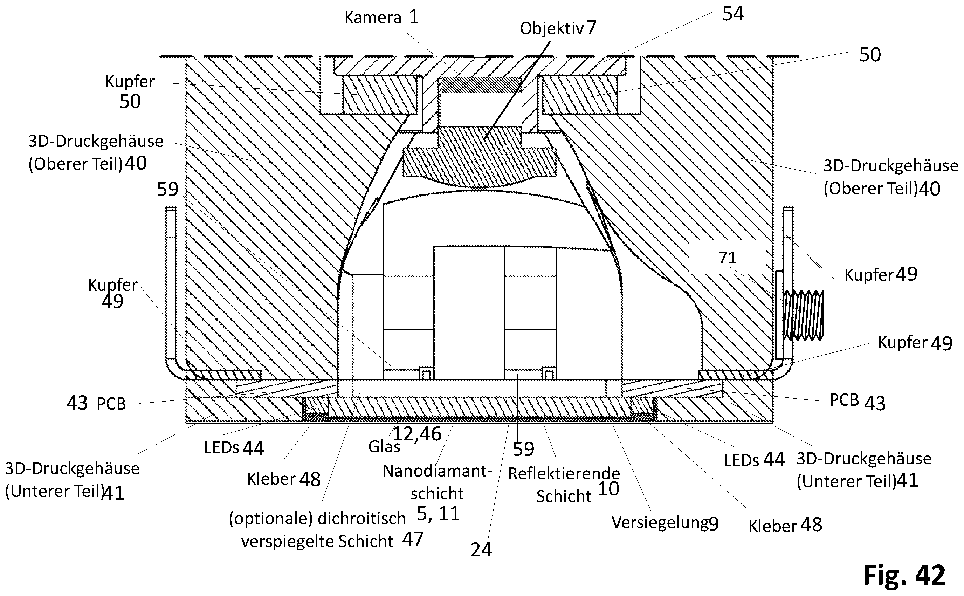

Figur 42 zeigt die einen Schnitt durch einen Magnetfeldkamerakopf **21** entsprechend den Figuren 29 bis 41. Figur 42 entspricht dabei weitestgehend der Figur 32, wobei nun jedoch nur die Schnittfläche dargestellt ist und wobei nun der Schnitt durch die LEDs **44** geführt ist. Außerdem umfasst der Sensorkopf der Figur 42 den zweiten Kühlkörper **49** zu Kühlung des Schaltungsträgers (PCB) **43** des Magnetfeldkamerakopfes **21** und zur Ableitung der Abwärme der LEDs **44.** Der obere Teil der Fluoreszenzkamera mit der Auswertelektronik **15** fehlt zur besseren Übersichtlichkeit. Eine fachkundige Person kann diese Details beispielsweise der Figur 32 entnehmen und hier ergänzen, sodass der obere Teil der Fluoreszenzkamera in der Figur, auch wenn nicht explizit eingezeichnet, trotzdem als offenbart gilt.

In der Figur 42 sind zwei Klebepunkte mit Kleber **48** eingezeichnet, mit denen der Schaltungsträger (PCB) **43** des Magnetfeldkamerakopfes **21** mit den LEDs **44** und den übrigen elektronischen Bauteilen (**59, 60, 61**) an dem unteren Gehäuseteil **41** des Gehäuses **8** befestigt ist.

Die LEDs **44** strahlen bei Betrieb in horizontaler Richtung Pumpstrahlung **13** in die Glasplatte **46** ein. Die Glasplatte **46** dient dabei als Wellenleiter für die Pumpstrahlung **13** der Pumpstrahlungsquellen, also beispielsweise der LEDs **44,** mit Pumpstrahlungswellenlänge **λₚₘₚ.** Die Glasplatte **46** verteilt die Pumpstrahlung **13** der LEDs **44** flächenhaft. Ein Teil der so in der Glasplatte **46** transportierten Pumpstrahlung **13** tritt in der vertikalen Richtung nach oben und unten aus der Glasplatte **46** aus.

Die Pumpstrahlung **13** der LEDs **44,** die aus der Glasplatte **46** nach unten austritt, trifft auf die Sensorschicht **5,** hier die Schicht **11** mit den Kristallen und/oder mit den Nanokristallen **66** mit paramagnetischen Zentren. Bevorzugt handelt es sich bei den paramagnetischen Zentren um NV-Zentren. Die paramagnetischen Zentren der Schicht **11** emittieren infolge der Bestrahlung mit Pumpstrahlung **13** der Pumpstrahlungswellenlänge **λₚₘₚ** Fluoreszenzstrahlung **14** der Fluoreszenzwellenlänge **λ_{fl}.** Typischerweise ist bei NV-Zentren die Pumpstrahlung **13** grün und die Fluoreszenzstrahlung **14** rot.

Eine reflektierende Schicht **10** reflektiert vorzugsweise die Pumpstrahlung **13,** die von der Schicht **11** transmittiert und nicht reflektiert und nicht absorbiert wird, zurück in Richtung des Lichtsensorarrays **1.** Dabei passiert die reflektierte Pumpstrahlung **13** die Schicht **11** mit den paramagnetischen Zentren ein zweites Mal und ruft dort ein zweites Mals die Emission von Fluoreszenzstrahlung **14** hervor. Dies hebt den Signalkontrast der lokal magnetfeldabhängigen Intensität der lokalen Fluoreszenzstrahlung **14** weiter an.

Die reflektierende Schicht **10** reflektiert vorzugsweise auch den Anteil der Fluoreszenzstrahlung **14,** die von der Schicht **11** nach unten hin emittiert wird, zurück in Richtung des Lichtsensorarrays **1.** Dabei passiert die reflektierte Fluoreszenzstrahlung **14** die Schicht **11** mit den paramagnetischen Zentren ein zweites Mal.

Die Schicht **11** emittiert somit einen ersten Anteil der Fluoreszenzstrahlung **14** direkt in Richtung des Lichtsensorarrays **1** und transmittiert einen zweiten Anteil der Fluoreszenzstrahlung **14,** der an der reflektierenden Schicht **10** reflektiert wurde, zumindest teilweise typischerweise ebenfalls in Richtung des Lichtsensorarrays **1.** Dies hebt somit ebenfalls den Signalkontrast der lokal magnetfeldabhängigen Intensität der lokalen Fluoreszenzstrahlung **14** der paramagnetischen Zentren der Schicht **11** weiter an.

In dem Beispiel der Figur 42 verhindert beispielhaft eine optionale dichroitisch verspiegelte Schicht **47** den Austritt der Pumpstrahlung **13** der LEDs **44** mit Pumpstrahlungswellenlänge **λₚₘₚ** aus der Glasplatte **46** in Richtung des Lichtsensorarrays **1.** D.h. diese optionale dichroitisch verspiegelte Schicht **47** kann die Rolle des optischen Filter (Longpass) **6** übernehmen und diesen ersetzen.

In dem Beispiel der Figur 42 ermöglicht beispielhaft die optionale dichroitisch verspiegelte Schicht **47** die Transmission der Fluoreszenzstrahlung **14** der paramagnetischen Zentren der Schicht **11** mit Fluoreszenzstrahlungswellenlänge **λ_{fl}** durch die Glasplatte **46** in Richtung des Lichtsensorarrays **1.** D.h. diese optionale dichroitisch verspiegelte Schicht **47** kann auch hier die Rolle des optischen Filter (Longpass) **6** übernehmen und diesen ersetzen.

Daher ist die optionale dichroitisch verspiegelte Schicht **47** typischerweise für elektromagnetische Strahlung, also beispielsweise Pumpstrahlung **13,** mit Pumpstrahlungswellenlänge **λₚₘₚ** im Wesentlichen nicht transparent und bevorzugt im Wesentlichen reflektierend.

Hier bei bedeutet "im Wesentlichen nicht transparent", dass die Intensität der verbleibenden transmittierten elektromagnetischen Strahlung, also beispielsweise Pumpstrahlung **13,** mit Pumpstrahlungswellenlänge **λₚₘₚ** so gering ist, dass die verbleibenden transmittierten elektromagnetischen Strahlung mit Pumpstrahlungswellenlänge **λₚₘₚ** die Erzielung des beabsichtigten Zwecks in der jeweiligen Anwendung vorzugsweise nicht beeinträchtigt.

Hier bei bedeutet "im Wesentlichen reflektiert", dass die Intensität der nicht reflektierten elektromagnetischen Strahlung mit Pumpstrahlungswellenlänge **λₚₘₚ** so gering ist, dass die verbleibende reflektierte elektromagnetischen Strahlung mit Pumpstrahlungswellenlänge **λₚₘₚ** für die Erzielung des beabsichtigten Zwecks in der jeweiligen Anwendung vorzugsweise ausreichend ist.

In dem Beispiel der Figur 42 bildet die Kombination aus den LEDs **44** mit der Glasplatte **46** ein Beispiel für eine flächenhafte Pumpstrahlungsquelle zur Bestrahlung der paramagnetischen Zentren der Kristalle und/oder Nanokristalle **66** der Schicht 11 der Sensorschicht 5 mit Pumpstrahlung 13 der Pumpstrahlungswellenlänge λₚₘₚ.

Das hier vorgelegte Dokument offenbart somit eine flächenhafte Pumpstrahlungsquelle, die ein oder mehrere primäre Pumpstrahlungsquellen, hier die LEDs 44, und ein optisches Funktionselement, hier die Glasplatte **46** zur flächenhaften Verteilung der Pumpstrahlung 13 der primären Pumpstrahlungsquellen, hier der LEDs 44, umfasst.

In einer bevorzugten Variante bestrahlt diese flächenhafte Pumpstrahlungsquelle eine Schicht 11 mit Kristallen und/oder Nanokristallen **66** mit paramagnetischen Zentren, hier die Schicht 11, mit Pumpstrahlung 13 der Pumpstrahlungswellenlänge **λₚₘₚ.**

In einer weiteren Variante emittiert diese Schicht **11** dann ggf. örtlich unterschiedlich je nach dem Wert des lokalen Betrags der magnetischen Flussdichte eine Fluoreszenzstrahlung **14** mit einer Fluoreszenzstrahlungswellenlänge **λ_{fl}**.

In einer weiteren Variante separiert ein optisches Funktionselement, beispielsweise die dichroitisch verspiegelte optionale Schicht **47** und/oder der optischer Filter (Longpass) **6,** die elektromagnetische Strahlung mit der Pumpstrahlungswellenlänge **λₚₘₚ** von der elektromagnetischen Strahlung mit der Fluoreszenzstrahlungswellenlänge λ_{fl}. In dieser weiteren Variante separiert somit das optische Funktionselement, beispielsweise die dichroitisch verspiegelte optionale Schicht **47** und/oder der optischer Filter (Longpass) **6,** die Pumpstrahlung **13** mit der Pumpstrahlungswellenlänge **λₚₘₚ** von der Fluoreszenzstrahlung **14** mit der Fluoreszenzstrahlungswellenlänge λ_{fl}. Somit kann dann nur noch elektromagnetischen Strahlung mit der Fluoreszenzstrahlungswellenlänge λ_{fl} bzw. Fluoreszenzstrahlung **14** mit der Fluoreszenzstrahlungswellenlänge λ_{fl} zum Lichtsensorarray **1** gelangen.

Vorzugsweise ist zu dem gleichen Zweck das Gehäuse **8** des Magnetfeldkamerakopfes **21** lichtdicht ausgeführt. Die abbildende Optik **7** bildet die örtlich verschiedene Intensität der Fluoreszenzstrahlung **14** der paramagnetischen Zentren der Schicht **11** auf das Lichtsensorarray **1** ab.

Mittels der nicht eingezeichneten, aber hiermit ausdrücklich mitoffenbarten Auswerteelektronik 15 und des Lichtsensorarrays **1** erfasst der Magnetfeldkamerakopf **21** somit diese die örtlich verschiedene Intensität der Fluoreszenzstrahlung **14** der paramagnetischen Zentren der Schicht **11** und damit die örtlich unterschiedlichen Werte des Betrags der magnetischen Flussdichte in der Schicht **11** in Form eines Bildes.

Der erste Kühlkörper **50** kühlt die Auswerteelektronik **13** der Fluoreszenzkamera und das Lichtsensorarray **1** der Fluoreszenzkamera und erhöht so den Signal-zu-Rauschabstand der Lichtsensoren des Lichtsensorarrays **1.**

Der zweite Kühlkörper 49 kühlt den Schaltungsträger (PCB) **43** für die LEDs **44** und deren Energieversorgung **45.** Hierbei kühlt der zweite Kühlkörper **49** insbesondere die LEDs **44,** die erhebliche Wärme abgeben, und verhindert so ein Aufheizen des Gehäuses (**8, 40, 41**) und damit ein Aufheizen des Lichtsensorarrays **1.** Auch und erhöht den Signal-zu-Rauschabstand der Lichtsensoren des Lichtsensorarrays **1.**

Bei dem Magnetfeldkamerakopf **21** der Figur 42 handelt es sich somit weitestgehend um einen Sensorkopf **21** entsprechend den Figuren 29 bis 41.

### Figur 43

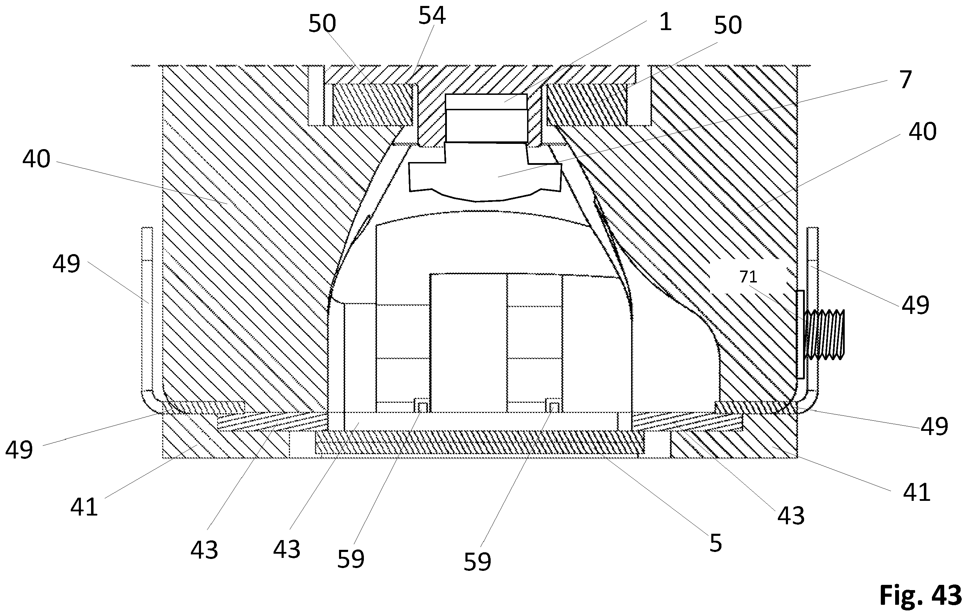

Figur 43 zeigt die einen Schnitt durch einen Magnetfeldkamerakopf **21** entsprechend den Figuren 29 bis 42. Figur 43 entspricht dabei weitestgehend der Figur 42, wobei nun der Schnitt NICHT durch die LEDs **44** geführt ist. Figur 42 entspricht dabei auch weitestgehend der Figur 32, wobei nun jedoch nur die Schnittfläche dargestellt ist. Bei dem Magnetfeldkamerakopf **21** der Figur 43 handelt es sich somit weitestgehend um einen Magnetfeldkamerakopf **21** entsprechend den Figuren 29 bis 42.

### Figur 44

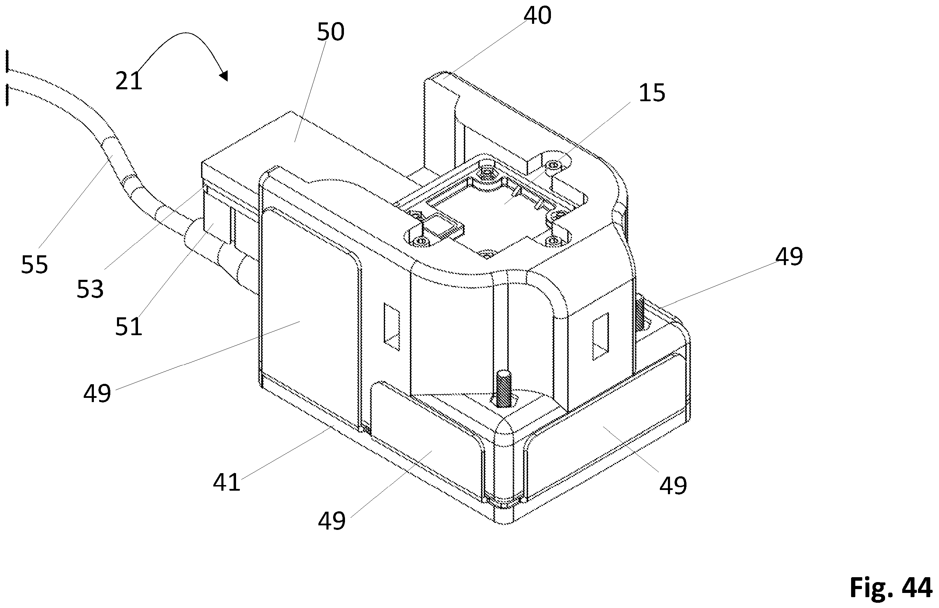

Figur 44 entspricht dabei weitestgehend der Figur 23, wobei nun der Magnetfeldkamerakopf **21** der Figur 44 zusätzlich gegenüber dem Magnetfeldkamerakopf **21** der Figur 33 den zweiten Kühlkörper **49** aufweist. Bei dem Magnetfeldkamerakopf **21** der Figur 44 handelt es sich somit weitestgehend um einen Magnetfeldkamerakopf **21** entsprechend den Figuren 29 bis 43.

### Figur 45

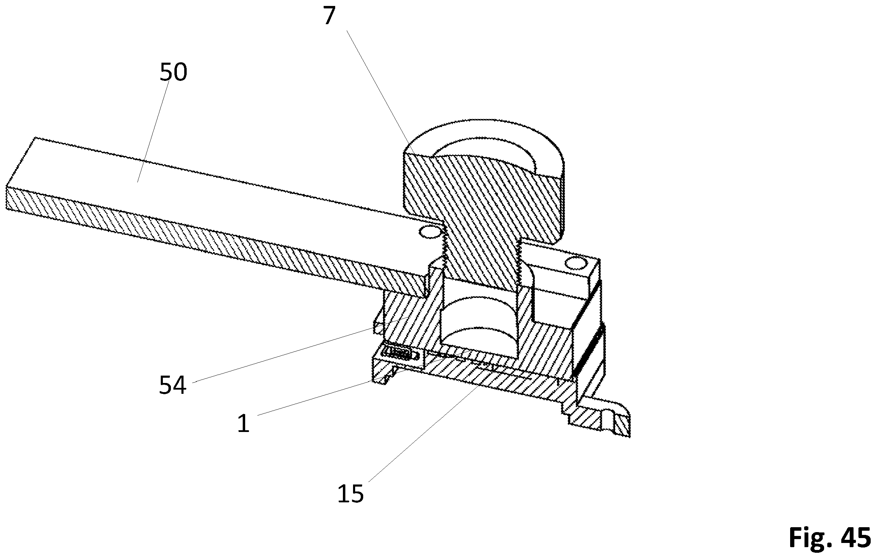

Figur 45 zeigt die Fluoreszenzkamera eines Magnetfeldkamerakopf **21** entsprechend den Figuren 29 bis 44 in Verbindung mit dem ersten Kühlkörper **50** als Schnittbild. Die Fluoreszenzkamera umfasst hier beispielsweise die Auswerteelektronik **15,** das Kameragehäuse **54,** das Lichtsensorarray **1** und die abbildende Optik **7.** Ggf. kann die Fluoreszenzkamera auch das optische Filter (Longpass) **6** im Strahlengang der abbildenden Optik **7** und des Lichtsensorarrays **1** mitumfassen.

Der erste Kühlkörper **50** ist vorzugsweise mit einem geringen thermischen Widerstand mit der Auswerteelektronik **15** und/oder dem Lichtsensorarray **1** thermisch verbunden. Besonders bevorzugt ist der erste Kühlkörper **50** mit einem geringen thermischen Widerstand mit dem Lichtsensorarray **1** thermisch verbunden. Hierdurch verbessert der erste Kühlkörper 50 das Signal-zu-Rauschverhältnis des Lichtsensorarrays **1.**

### Figur 46

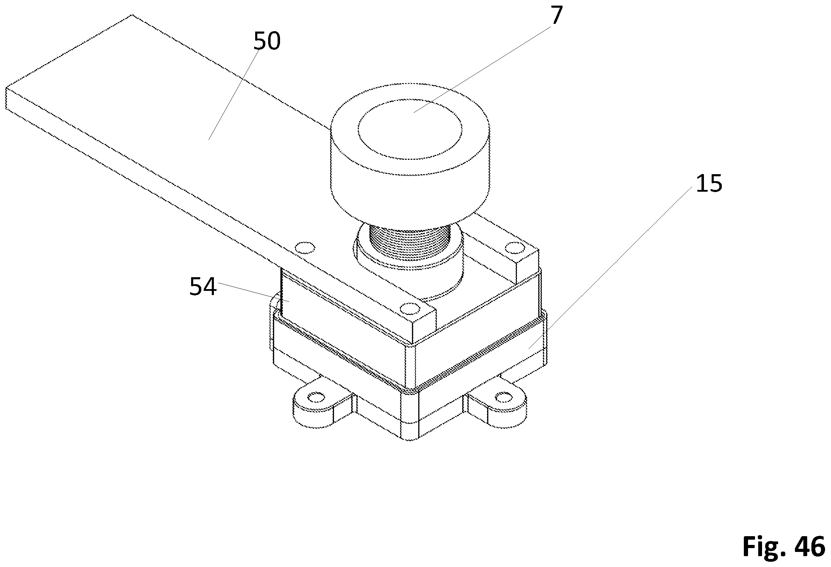

Figur 46 zeigt wie die Figur 45 die Fluoreszenzkamera eines Magnetfeldkamerakopfes **21** entsprechend den Figuren 29 bis 45 in Verbindung mit dem ersten Kühlkörper **50** nun jedoch nicht als Schnittbild.

### Figur 47

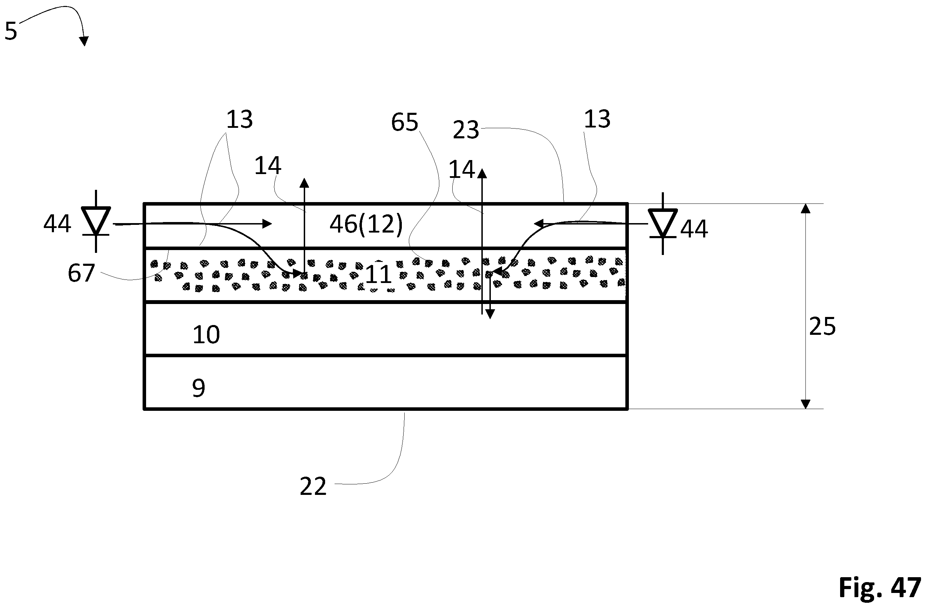

Figur 47 zeigt das Funktionsprinzip der Sensorschicht 5, wie sie in den Vorrichtungsteilen des Sensorkopfes der Figuren 29 bis 46 in den Figuren 30, 31, 32, 34, 35, 38, 39, 40, 41, 42 und 43 Verwendung findet. Die zwei Leuchtdioden (LEDs) **44** bilden hier die primären Pumpstrahlungsquellen für die Erzeugung der Pumpstrahlung **13** mit der Pumpstrahlungswellenlänge **λₚₘₚ.** Die primären Pumpstrahlungsquellen in Form der LEDs **44** strahlen die Pumpstrahlung **13** von der Seite her in das flächige erste optische Funktionselement in Form einer Glasplatte **46** ein. Die Pumpstrahlung **13** breitet sich vom Einspeisepunkt der Pumpstrahlung **13** in das flächenhafte erste optische Funktionselement - hier die Glasplatte **46** - flächenhaft aus, wobei die Intensität mit dem Abstand vom Einspeisepunkt der Pumpstrahlung **13** in das flächenhafte erste optische Funktionselement - hier die Glasplatte **46** - kontinuierlich abnimmt. Ein Teil der Pumpstrahlung **13** verlässt das erste optische Funktionselement (Glasplatte **46**) in Richtung einer ersten Oberfläche **67** und tritt in die Schicht **11** über. Die Schicht **11** umfasst bevorzugt eine Vielzahl von Kristallen und/oder Nanokristallen **66,** die bevorzugt paramagnetische Zentren umfassen. Die Kristalle und Nanokristalle **66** sind bevorzugt in ein Trägermaterial der Schicht **11** eingebettet, dass für elektromagnetische Strahlung mit der Pumpstrahlungswellenlänge **λₚₘₚ** transparent ist. Die Kristalle und Nanokristalle **66** sind bevorzugt in ein Trägermaterial der Schicht **11** eingebettet, dass für elektromagnetische Strahlung mit der Fluoreszenzstrahlungswellenlänge **λ_{fl}** transparent ist.

Die Kristalle und Nanokristalle **66** sind bevorzugt in ein Trägermaterial der Schicht **11** eingebettet, dass für Pumpstrahlung mit der Pumpstrahlungswellenlänge **λₚₘₚ** transparent ist. Die Kristalle und Nanokristalle **66** sind bevorzugt in ein Trägermaterial der Schicht **11** eingebettet, dass für Fluoreszenzstrahlung mit der Fluoreszenzstrahlungswellenlänge **λ_{fl}** transparent ist.

Ein Teil der Pumpstrahlung **13** in der Schicht **11** bestrahlt paramagnetische Zentren von Kristallen und Nanokristallen **66** in der Schicht **11.** Aufgrund der Bestrahlung mit Pumpstrahlung 13 der Pumpstrahlungswellenlänge **λₚₘₚ** emittieren paramagnetische Zentren von Kristallen und Nanokristallen **66** in der Schicht **11** Fluoreszenzstrahlung **14.**

Eine Verspiegelung **10** reflektiert den Teil der Fluoreszenzstrahlung **14,** der die Schicht **11** nicht in Richtung auf das Lichtsensorarray **1,** sondern in die entgegengesetzte Richtung verlässt in die Schicht **11** zurück.

Die Verspiegelung **10** reflektiert den Teil der Pumpstrahlung **13,** der die Schicht **11** nicht in Richtung auf das Lichtsensorarray **1,** sondern in die entgegengesetzte Richtung verlässt in die Schicht **11** zurück.

In dem Beispiel der Figur 47 ist die Verspiegelung **10** mit einem optionalen Trägermaterial I **9** abgedeckt. Typischer Weise ist das Trägermaterial I **9** eine Teilvorrichtung des unteren Gehäuseteils **41** des Gehäuses **8** der Magnetfeldkamera.

### Figur 48

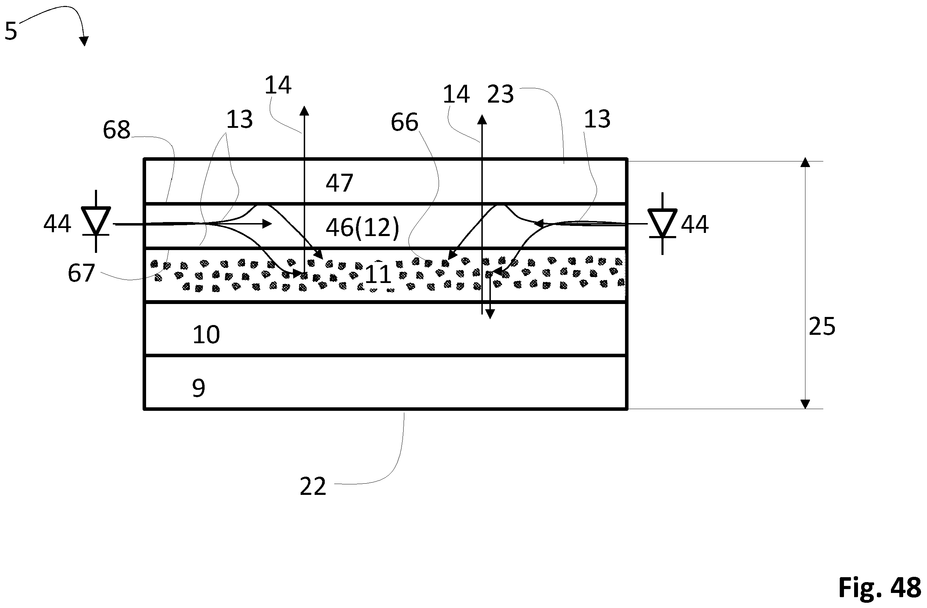

Die Figur 48 zeigt schematisch vereinfacht das Funktionsprinzip der Sensorschicht **5,** wie sie in den Vorrichtungsteilen des Sensorkopfes der Figuren 29 bis 46 in den Figuren 30, 31, 32, 34, 35, 38, 39, 40, 41, 42 und 43 Verwendung finden kann. Im Wesentlichen entspricht die Figur 48 der Figur 47, wobei auf der zweiten Oberfläche **68** des ersten optischen Funktionselements (Glasplatte **46**) eine dichroitisch verspiegelte optionale Schicht **47** aufgebracht ist.

Die optionale dichroitisch verspiegelte Schicht **47** ist vorzugsweise im Wesentlichen transparent für elektromagnetische Strahlung mit der Fluoreszenzstrahlungswellenlänge **λ_{fl}**.

Die optionale dichroitisch verspiegelte Schicht **47** ist vorzugsweise im Wesentlichen NICHT transparent für elektromagnetische Strahlung mit der Pumpstrahlungswellenlänge λₚₘₚ.

Die optionale dichroitisch verspiegelte Schicht **47** ist vorzugsweise im Wesentlichen transparent für Fluoreszenzstrahlung **14** mit der Fluoreszenzstrahlungswellenlänge λ_{fl}.

Die optionale dichroitisch verspiegelte Schicht **47** ist vorzugsweise im Wesentlichen NICHT transparent für Pumpstrahlung **13** mit der Pumpstrahlungswellenlänge **λₚₘₚ.**

Bevorzugt reflektiert die optionale dichroitisch verspiegelte Schicht **47** Pumpstrahlung **13** mit der Pumpstrahlungswellenlänge **λₚₘₚ**, die über die zweite Oberfläche **68** des ersten optischen Funktionselements (Glasplatte **46**) aus dem ersten optischen Funktionselement (Glasplatte **46**) austritt, wieder in das erste optische Funktionselement (Glasplatte **46**) hinein zurück. Hierdurch werden die paramagnetischen Zentren in den Kristallen und/oder Nanokristallen **66** der Schicht **11** einem Maximum an Intensität der Pumpstrahlung **13** aufgesetzt. Dies verbessert das Signal-zu-Rauschverhältnis weiter.

### Figur 49

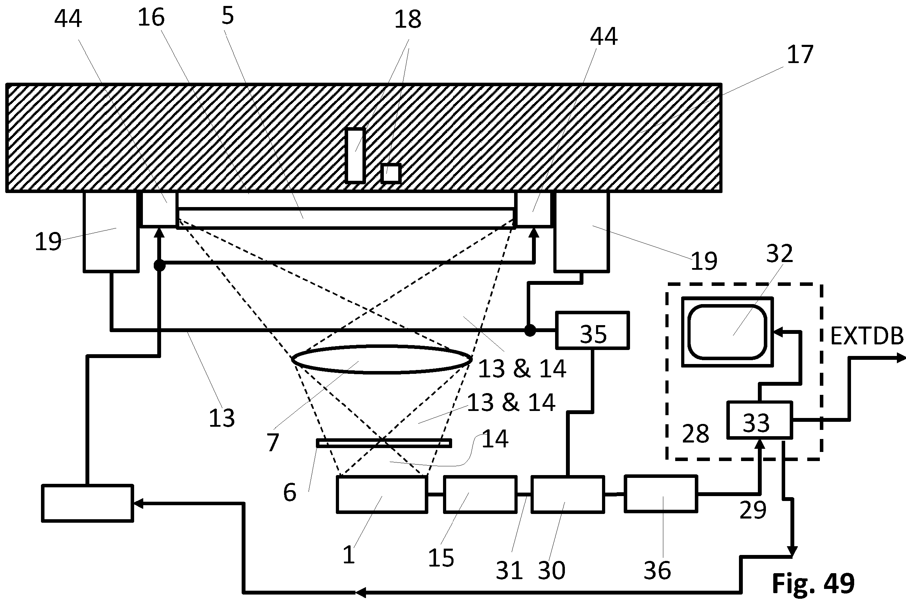

Figur 49 zeigt das System der Figur 7 mit einem Magnetfeldsensorkopf der Figuren 29 bis 48.

Die LEDs **44** emittieren Pumpstrahlung **13** mit einer Pumpstrahlungswellenlänge λₚₘₚ. Die Sensorschicht 5 entspricht bevorzugt dem Aufbau der Figur 48. Die Sensorschicht **5** ist vorzugsweise auf einem mechanischen Träger, beispielsweise einer ebenen Fläche **16,** aufgebracht. Vorzugsweise ist die ebene Fläche **16** Teil der Gehäusewand des hier nicht gezeichneten Gehäuses **8.** Das Material dieser ebenen Fläche **16** bzw. der Gehäusewand des Gehäuses **8** in diesem Bereich ist bevorzugt nicht magnetisch und beeinflusst bevorzugt das magnetische Feld im Wesentlichen nicht. Die Sensorschicht **5** umfasst bevorzugte eine Vielzahl zufällig und vorzugsweise gleichverteilt orientierte Kristalle und/oder Nanokristalle **66** mit paramagnetischen Zentren. Bei den paramagnetischen Zentren kann es sich bei der Verwendung von Diamant als Kristallmaterial beispielsweise um NV-Zentren und/oder SiV-Zentren und/oder TiV-Zentren und/oder GeV-Zentren und/oder SnV-Zentren und/oder NiN4-Zentren und/oder PbV-Zentren und/oder ST1-Zentren handeln. Die Pumpstrahlung **13** besitzt bei der Verwendung von NV-Zentren in Dimant als Kristalle und/oder Nanokristalle **66** der Sensorschicht **5** bevorzugt eine Pumpstrahlungswellenlänge **λₚₘₚ** in einem Wellenlängenbereich von 400 nm bis 700 nm Wellenlänge und/oder besser 450 nm bis 650 nm und/oder besser 500 nm bis 550 nm und/oder besser 515 nm bis 540 nm aufweisen. Bevorzugt ist dabei eindeutig eine Wellenlänge von 532 nm als Pumpstrahlungswellenlänge λₚₘₚ. Im Falle der Verwendung von NV-Zentren in Diamant oder in Diamanten der Sensorschicht **5** ist eine Laser-Diode der Fa. Osram vom Typ PLT5 520B beispielsweise als LED **44** mit 520nm Pumpstrahlungswellenlänge λₚₘₚ geeignet. Bei der Verwendung von NV-Zentren in Diamantkristallen in der Sensorschicht **5** als paramagnetische Zentren der Sensorschicht **5** emittieren die NV-Zentren der Sensorschicht **5** typischerweise bei Bestrahlung mit Pumpstrahlung **13** der oben beschriebenen Pumpstrahlungswellenlänge **λₚₘₚ** eine Fluoreszenzstrahlung **14** mit einer typischen Fluoreszenzwellenlänge **λ_{fl}** von ca. 637nm bei NV-Zentren. Eine abbildende Optik 7 erfasst bevorzugt das Fluoreszenzbild der ortsabhängigen Fluoreszenzintensität der Fluoreszenzstrahlung **14** mit der Fluoreszenzwellenlänge **λ_{fl},** das die Sensorschicht **5** mittels der paramagnetischen Zentren in der Sensorschicht **5** erzeugt. Ein optisches Longpass-Filter **6** und/oder eine dichroitisch verspiegelte optionale Schicht **47** in der Sensorschicht **5** lassen bevorzugt elektromagnetische Strahlung mit der Fluoreszenzwellenlänge **λ_{fl}** und damit die Fluoreszenzstrahlung **14** passieren. Das optische Longpass-Filter **6** und/oder eine dichroitisch verspiegelte optionale Schicht **47** in der Sensorschicht **5** blockieren bevorzugt die Passage elektromagnetischer Strahlung mit der Pumpstrahlungswellenlänge **λₚₘₚ** und damit die Passage der Pumpstrahlung **13.** Hierdurch kann die abbildende Optik **7** das Fluoreszenzbild der Sensorschicht **5** im Wellenlängenbereich der Fluoreszenzwellenlänge **λ_{fl}** erfassen und auf die n x m Lichtsensoren des n x m Lichtsensorarrays **1** der Fluoreszenzkamera abbilden. Da die Intensität der Fluoreszenzstrahlung **14** der Sensorschicht **5** lokal in der Sensorschicht **5** von der magnetischen Flussdichte B am Ort des jeweiligen paramagnetischen Zentrums in der Sensorschicht **5** abhängt, entspricht das Fluoreszenzbild der Sensorschicht **5** einem Magnetflussdichtenbetragsbild des magnetischen Flussdichtefeldes, das die Sensorschicht **5** durchflutet. Da in der Regel die Dichteverteilung der paramagnetischen Zentren in der Sensorschicht **5** und/oder die Ausleuchtung der Sensorschicht **5** mit Pumpstrahlung **13** und/oder die Erfassung der Fluoreszenzintensität der Fluoreszenzstrahlung **14** über die Fläche der Sensorschicht **5** bei allem Bemühen nicht ganz homogen sind, hat es sich bewährt, durch Kalibrationsmessungen das System vor dem ersten Gebrauch zu kalibrieren. Zur Verarbeitung der Messwerte der Lichtsensoren des Lichtsensorarrays 1 erfassen Auswertelektroniken **15** des Lichtsensorarrays **1** die Messwerte des Signale der Lichtsensoren des Lichtsensorarrays **1** und bilden daraus insbesondere durch Verstärkung und/oder Filterung die Ausgangssignale **31** der Lichtsensoren des Lichtsensorarrays **1.** Die Aufbereitungsschaltung **30** für die Ausgangssignale **31** der Lichtsensoren des Lichtsensorarrays **1** steuert bevorzugt mittels einer Ansteuervorrichtung **35** für die Elektromagnete der Hilfsmagnete **19** die Hilfsmagnete **19,** wenn diese nicht nur Permanentmagnete umfassen. Die Aufbereitungsschaltung **30** für die Ausgangssignale **31** der Lichtsensoren des Lichtsensorarrays **1** erzeugt **beispielsweise** aus den die Ausgangssignalen **31** der Lichtsensoren des Lichtsensorarrays **1** ein Fluoreszenzbild und/oder beispielsweise ggf. auch ein verbessertes Fluoreszenzbild, wie oben beschrieben. Aufgrund der zuvor dargestellten Zusammenhänge stellen das Fluoreszenzbild und/oder beispielsweise ggf. auch das verbesserte Fluoreszenzbild ein Magnetflussdichtenbetragsbild des magnetischen Flussdichtefeldes in der Sensorschicht **5** bzw. ein verbessertes Magnetflussdichtenbetragsbild des magnetischen Flussdichtefeldes in der Sensorschicht **5** dar. Die Aufbereitungsschaltung **30** für die Ausgangssignale **31** der Lichtsensoren des Lichtsensorarrays **1** überträgt dieses Fluoreszenzbild bzw. das verbesserte Fluoreszenzbild vorzugsweise mittels der Schnittstellenschaltung **36** über einen Datenbus **29** an ein Rechnersystem **28** zur Bedienung des Magnetfeldkamerakopfes **21.** Bevorzugt erzeugt das Rechnersystem **28** zur Bedienung des Sensorkopfes **21** aus diesem Fluoreszenzbild bzw. aus dem verbesserten Fluoreszenzbild eine ein- oder zwei- oder dreidimensionale Darstellung der Verteilung der magnetischen Flussdichte in der Sensorschicht **5** und stellt diese auf dem Bildschirm **32** dar. Der Datenbus **29** dient dabei der Herstellung der Datenverbindung zwischen Aufbereitungsschaltung **30** für die Ausgangssignale **31** der Lichtsensoren des Lichtsensorarrays **1** und Rechnersystem **28** zur Bedienung des Magnetfeldkamerakopfes **21.** Das Messobjekt, hier beispielhaft ein ferromagnetisches Material **17** mit Fehlern **18** erzeugt die Variationen der magnetischen Flussdichte **B** in der Sensorschicht **5,** die zu den besagten Magnetflussdichtenbetragsbildern des magnetischen Flussdichtefeldes in der Sensorschicht **5** bzw. den verbesserten Magnetflussdichtenbetragsbildern des magnetischen Flussdichtefeldes in der Sensorschicht **5** führen.

### Figur 50

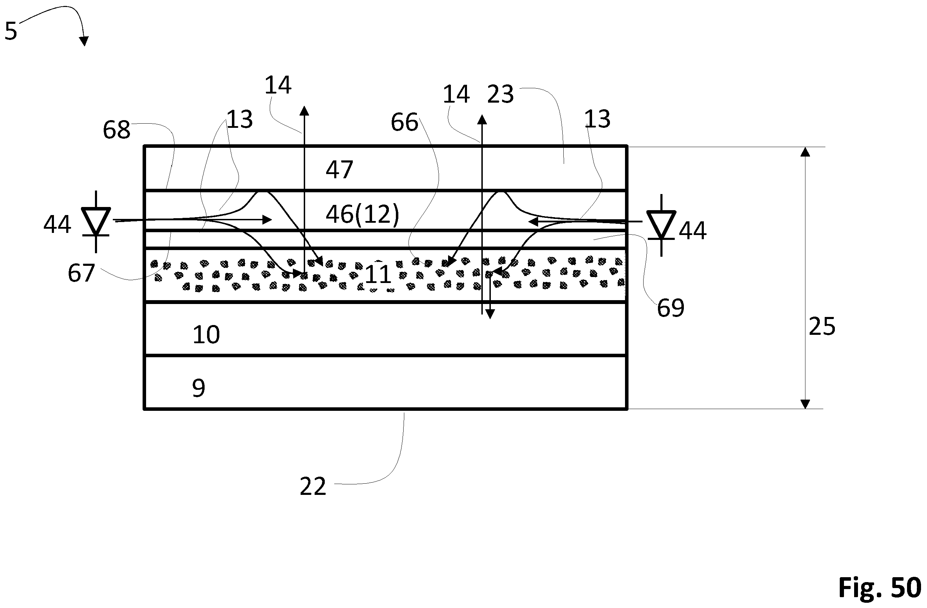

Figur 50 entspricht weitestgehend der Figur47, die das Funktionsprinzip der Sensorschicht **5** zeigt, wie sie in den Vorrichtungsteilen des Sensorkopfes der Figuren 29 bis 46 in den Figuren 30, 31, 32, 34, 35, 38, 39, 40, 41, 42 und 43 Verwendung findet. Die Figur 50 unterscheidet sich von der Figur 47 durch eine Diffusorschicht **69.** Leider ist die Intensitätsverteilung der Intensität der an einem Punkt der Oberfläche der Glasplatte **46** aus dieser abgewandten Glasplattenoberfläche der Glasplatte **46** austretenden Pumpstrahlung **13** vom inversen quadratischen Abstand dieses Punkts der Oberfläche der Glasplatte **46** von der betreffenden LED **44** abhängig. Diese Abstandsabhängigkeit kann durch eine Diffuser-Struktur in einer Diffusor-Schicht **69** auf dieser abgewandten Glasplattenoberfläche der Glasplatte **46** ausgeglichen werden. Bevorzugt ist somit die Glasplatte **46** auf der Oberfläche, die vom Lichtsensorarray **1** abgewandt ist, mit einer Diffusor-Struktur in einer Diffusor-Schicht **69** versehen, die eine homogene Beleuchtung der Schicht **11** und damit der in der Schicht **11** enthaltenen paramagnetischen Zentren mit Pumpstrahlung **13** durch die LEDs **44** sicherstellt.

Bei diesem System aus einer Glasplatte **46,** den LEDs **44,** die von den Kanten der Glasplatte **46** Pumpstrahlung **13** in das Material der Glasplatte **46** einstrahlen, der Diffusor-Schicht **69** und der Schicht **11** mit den paramagnetischen Zentren handelt es sich letztlich um ein flaches Flächenbeleuchtungssystem, mit: a) einer flächigen Pumpstrahlungsquelle (**44, 46**) für Pumpstrahlung **13** mit der Pumpstrahlungswellenlänge **λₚₘₚ,** die ein Substrat und mindestens einen auf dem Substrat (Glaswafer **46**) ausgebildeten, im Wesentlichen nicht gepixelten, Pumpstrahlung **13** ausstrahlenden Bereich aufweist, der Pumpstrahlung **13** von mindestens einer Pumpstrahlung **13** ausstrahlenden Seite der flächigen Pumpstrahlungsquelle aus in jede Richtung ausstrahlt (Nach unten zeigende Oberfläche der Glasplatte **46**); und b) einer Pumpstrahlung **13** lenkenden, optischen Schicht - beispielsweise der Glasplatte **46** -, die auf der mindestens einen Pumpstrahlung **13** ausstrahlenden Seite(Kante der Glasplatte **46**) über dem Pumpstrahlung **13** ausstrahlenden Bereich einer punktförmigen oder flächigen Pumpstrahlungsquelle (beispielhafte LEDs **44**) angeordnet ist, worin die Pumpstrahlung **13** lenkende, optische Schicht - insbesondere die Glasplatte **46** - vorzugsweise Pumpstrahlung **13** aus einer Richtung weglenkt, die rechtwinklig zur Fläche der Pumpstrahlung **13** (Lichtausbreitungsebene der Pumpstrahlung **13** in der Glasplatte 46) ausstrahlenden Seite der flächigen oder punktförmigen Pumpstrahlungsquelle (**46, 44**) verläuft.

In einer Ausprägung des flachen Flächenbeleuchtungssystems weist die Pumpstrahlung **13** lenkende, optische Schicht (Glasplatte **46**) eine strukturierte erste Oberfläche(Unterseite der Glasplatte **46**) auf, die der Pumpstrahlung **13** ausstrahlenden Seite der punktförmigen oder flächigen Pumpstrahlungsquelle (LEDs **44**) benachbart angeordnet ist.

In einer Ausprägung des flachen Flächenbeleuchtungssystems weist die Pumpstrahlung **13** lenkende, optische Schicht (Glasplatte **46**) eine plane erste Oberfläche auf, die der Pumpstrahlung **13** ausstrahlenden Seite der punktförmigen oder flächigen Pumpstrahlungsquelle (LEDs **44**) rechtwinklig gegenüber angeordnet ist.

In einer Ausprägung des flachen Flächenbeleuchtungssystems weist die Pumpstrahlung **13** lenkende, optische Schicht (Glasplatte **46**) eine plane erste Oberfläche auf, die der Pumpstrahlung **13** ausstrahlenden Seite der flächigen Pumpstrahlungsquelle (LEDs **44**) gegenüber angeordnet ist.

In einer Ausprägung des flachen Flächenbeleuchtungssystems weist die strukturierte erste Oberfläche der Pumpstrahlung **13** lenkenden, optischen Schicht (Glasplatte **46**) dreieckige Prismen oder eine auf die erste Oberfläche der Pumpstrahlung **13** lenkenden, optischen Schicht (Glasplatte **46**) aufgebrachte Diffusor-Schicht **69** beispielsweise als Diffusor auf.

In einer Ausprägung des flachen Flächenbeleuchtungssystems weist die strukturierte Oberfläche beispielsweise zylindrische Linsen oder andere optische und/oder mikrooptische Funktionselemente auf.

In einer Ausprägung des flachen Flächenbeleuchtungssystems weist die strukturierte Oberfläche eine Vielzahl keilförmiger Strukturen auf, die eine lange Achse aufweisen, wobei die Achsen der keilförmigen Strukturen bevorzugt dann in einer gemeinsamen Richtung ausgerichtet sind.

In einer Ausprägung des flachen Flächenbeleuchtungssystems umfasst eine flächige Pumpstrahlungsquelle OLEDs oder VCSELs als LEDs **44.**

In einer Ausprägung des flachen Flächenbeleuchtungssystems weist die Pumpstrahlung **13** lenkende, optische Schicht (Glasplatte **46**) eine plane erste Oberfläche auf, die der Pumpstrahlung **13** ausstrahlenden Seite der punktförmigen oder flächigen Pumpstrahlungsquelle (LEDs **44**) gegenüber angeordnet ist, wobei bevorzugt die flächigen Pumpstrahlungsquellen (LEDs **44**) OLEDs oder VCSELs als LEDs **44** umfassen.

In einer Ausprägung des flachen Flächenbeleuchtungssystems umfasst das flächige Flächenbeleuchtungssystem in einer Diffusor-Schicht **69** einen Diffusor, der zwischen der Pumpstrahlung **13** lenkenden, optischen Schicht und der flächigen Pumpstrahlungsquelle angeordnet ist.

In einer Ausprägung des flachen Flächenbeleuchtungssystems umfasst das Flächenbeleuchtungssystem eine zweite, Pumpstrahlung **13** lenkende, optischen Schicht, die über der Pumpstrahlung **13** lenkenden optischen Schicht und parallel zur Pumpstrahlung **13** lenkenden optischen Schicht angeordnet ist.

In einer Ausprägung des flachen Flächenbeleuchtungssystems ist beispielsweise die Pumpstrahlung **13** lenkende optische Schicht in eine Vielzahl von Bereichen unterteilt und Pumpstrahlung **13** lenkende Strukturen sind in einem Bereich in einem Winkel ausgerichtet, der sich von dem Winkel Licht lenkender Strukturen in einem zweiten Bereich unterscheidet.

Bevorzugt befindet sich die Schicht **11** mit den paramagnetischen Zentren auf der Oberfläche des flachen Flächenbeleuchtungssystems, also beispielsweise auf der Oberfläche einer Diffusor-Schicht **69** eines Diffusors, der sich bevorzugt wieder auf einer Oberfläche der besagten Glasplatte **46** befindet.

Das flache Flächenbeleuchtungssystem umfasst somit bevorzugt
- Pumpstrahlungsquellen, hier beispielhaft in Form der LEDs **44,**
- eine Pumpstrahlung **13** transportierende Schicht, hier die Glasplatte **46,**
- wobei die Pumpstrahlungsquellen eine Pumpstrahlung **13** mit der Pumpstrahlungswellenlänge **λₚₘₚ** in eine diese Pumpstrahlung transportierende Schicht, hier die Glasplatte **46,** die Pumpstrahlung **13** von der Seite über eine Kante der Glasplatte **46** einspeisen,
- eine Diffusor-Schicht **69,** die eine weitere, eine Pumpstrahlung **13** lenkende, optische Schicht ist,
- wobei die Diffusor-Schicht **69** auf der mindestens einen Pumpstrahlung **13** ausstrahlenden Seite über dem Pumpstrahlung **13** ausstrahlenden Bereich flächigen Pumpstrahlungsquelle angeordnet ist, worin die Pumpstrahlung **13** lenkende, optische Schicht vorzugsweise Pumpstrahlung **13** aus einer Richtung weglenkt, die vorzugsweise im Wesentlichen rechtwinklig zur Fläche der Pumpstrahlung **13** ausstrahlenden Seite der punktförmigen oder flächigen Pumpstrahlungsquelle (insbesondere der LEDs 44) verläuft

Die Diffusor-Schicht **69** lenkt somit bevorzugt die Pumpstrahlung **13** in der Glasplatte **46** auf die auf der Diffusor-Schicht **69** bevorzugt befindliche Schicht **11** mit den paramagnetischen Zentren, die daraufhin Fluoreszenzstrahlung **14** emittieren. Die Diffusor-Schicht **69** kann auch durch eine Mattierung und/oder Strukturierung der ersten Oberfläche **67** der Glasplatte **46** erreicht werden. Auch die zweite Oberfläche **68** der Glasplatte **46** kann eine Diffusor-Schicht **69** aufweisen. Beispielsweise kann durch eine unterschiedliche Rauigkeit der Oberfläche der Glasplatte **46** erreicht werden, das ein örtlich unterschiedlicher Anteil der Pumpstrahlung **13** in der Glasplatte **46** aus der Glasplatte **46** aus- und in die Schicht **11** eingekoppelt wird. Beispielsweise kann die Oberfläche der Glasplatte so strukturiert werden, dass in größerer Entfernung von den Pumpstrahlungsquellen (LEDs **44**) ein größerer Anteil der Pumpstrahlung **13** aus der Glasplatte **46** heraus in die Schicht **11** mit den paramagnetischen Zentren eingekoppelt wird. Hierdurch kann erreicht werden, dass bei einem homogenen externen Magnetfeld mit einer homogenen magnetischen Flussdichte die Intensität der erzeugten Fluoreszenzstrahlung **14** an Punkten der Oberfläche der Schicht **11** im Wesentlichen nicht mehr von der Entfernung zu den Pumpstrahlungsquellen, hier den LEDs **44,** abhängt.
die so konstruierte flächige Pumpstrahlungsquelle aus LEDs **44** und Glasplatte **46** und optionaler Diffusor-Schicht **69** bzw. Diffusor-Oberflächenstruktur der Glasplatte **46** bestrahlt dann die paramagnetischen Zentren der Schicht **11** mit Pumpstrahlung **13** mit der Pumpstrahlungswellenlänge **λₚₘₚ.** Die Schicht **11** umfasst dabei bevorzugt Kristalle **66,** besonders bevorzugt Mikro- oder Nanokristalle **66,** mit diesen paramagnetischen Zentren, die bevorzugt NV-Zentren in Diamantkristallen sind. Bevorzugt bildet die Glasplatte **46** die ebene Fläche **16** des unteren Gehäuseteils **41** des Gehäuses **8** aus. Die Glasplatte **46** hat hier auch die Funktion des Trägermaterials II **12.**

### Figur 51

Figur 51a zeigt die Resonanzen eines einkristallinen NV-Zentren umfassenden Diamanten. Die Figur 51a zeigt in Diagramm **501** die Resonanzlinien des Anteils an der der Intensität **Iᵢₛₜ(t)** der Fluoreszenzstrahlung **FL** eines mit NV-Zentren versehenen Diamant-Einkristalls, bei dem der Anteil des relativen Intensitätssignals der Intensität **Iᵢₛₜ(t)** der Fluoreszenzstrahlung **FL,** der der Mikrowellenmodulationsfrequenz **f _{µW}** aufweist, in Anhängigkeit von der Mikrowellenfrequenz ω _{µW} und von der magnetischen Flussdichte **B** dargestellt ist. Dabei ist die Mikrowellenfrequenz ω _{µW} in der X-Achse des Diagramms **501** aufgetragen. Die magnetische Flussdichte **B** ist in der Y-Achse des Diagramms **501** in willkürlichen Einheiten aufgetragen (englisch: "arbitrary units" oder abgekürzt "au"). In dem Beispiel ist ein einzelner Diamantkristall in [111] gegenüber der Richtung der magnetischen Flussdichte **B** eines Magnetfelds ausgerichtet. Das in dem Diagramm **501** dargestellte Verhalten ist aus dem Stand der Technik bekannt.

In der X-Achse ist die Mikrowellenfrequenz ω _{µW} des Mikrowellensignals **µW** im Bereich von 2,4 GHz bis 3,4 GHz aufgetragen. In der Y-Achse ist die magnetische Flussdichte **B** in willkürlichen Einheiten aufgetragen. Die Intensität der Resonanz wird durch die Schwärzung des entsprechenden Flächensegments des Diagramms **501** der Figur 51a dargestellt.

Zur Aufnahme der Werte die dem Diagramm **501** der Figur 51a zugrunde liegen, bestrahlt eine Mikrowellensignalquelle **µWG** den Diamant-Einkristall mit einer Mikrowellenstrahlung der Mikrowellenfrequenz **ω _{µw}** zwischen 2,4 GHz und 3,4 GHz. Gleichzeitig bestrahlt eine Lichtquelle **LED** den Diamant-Einkristall mit Pumpstrahlung **LB** einer Pumpstrahlungswellenlänge **λₚₘₚ.** Bevorzugt transportiert ein Lichtwellenleiter **LWL** die Pumpstrahlung **LB** von der Lichtquelle **LED** zum Diamant-Einkristall mit den NV-Zentren. In Folge der Bestrahlung mit Pumpstrahlung **LB** strahlt der Diamant-Einkristall Fluoreszenzstrahlung **FL** mit einer Intensität **Iᵢₛₜ(t)** ab. Ein Licht sensitives Bauteil, im folgenden Fotodetektor **PD** genannt, erfasst diese Fluoreszenzstrahlung **FL** und erzeugt ein Empfangssignal **S0**. Die Auswertungsvorrichtung **AWV** die später weiter erläutert wird, verarbeitet das Empfangssignal **S0** und erzeugt so einen Messwert des Intensitätsanteils in der Fluoreszenzstrahlung **FL,** dessen Modulationsfrequenz mit der Mikrowellenmodulationsfrequenz **f _{µW}** des Mikrowellensignals **µW** der Mikrowellensignalquelle **µWG** übereinstimmt. Die Auswertevorrichtung umfasst bevorzugt einen ersten Verstärker **V1** und einen Mehrfachkorrelator **LIV**, die später erläutert werden. Es erfolgt also vorzugsweise 100 % Amplitudenmodulation des Mikrowellensignals **µW** durch die Mikrowellensignalquelle **µWG** entsprechend einem Mikrowellenmodulationssignal **S5m.** Ein zweiter Signalgenerator **G2** erzeugt dieses Mikrowellenmodulationssignal **S5m.** Bevorzugt ist das Mikrowellenmodulationssignal **S5m** ein PWM-Modulationssignal mit einem Tastgrad von vorzugsweise 50 %. Die Auswertungsvorrichtung **AWV** korreliert vorzugsweise das Intensitätssignal der Intensität **Iᵢₛₜ(t)** der Fluoreszenzstrahlung **FL** im Empfangssignal **S0** mit dem Mikrowellenmodulationssignal **S5m.** Dabei ermittelt die Auswertungsvorrichtung **AWV** einen Wert für die Stärke der Resonanz. Das hier vorgelegte Dokument nennt diesen Wert im folgenden Resonanzwert. Die NV-Zentren des Diamant-Einkristalls strahlen Fluoreszenzstrahlung **FL** mit einer Intensität **Iᵢₛₜ(t)** ab, wenn die Mikrowellenfrequenz **ω _{µW}** des Mikrowellensignals **µW** nicht in Resonanz mit den NV-Zentren des Diamant-Einkristalls ist. Die dunklen Felder in dem Diagramm **501** der Figur 51a geben somit Kombination von Stärken der magnetischen Flussdichte **B** und der Mikrowellenfrequenz ω _{µw} des Mikrowellensignals **µW** wieder, in denen die Intensität der von den NV-Zentren des Diamant-Einkristalls ausgestrahlten Fluoreszenzstrahlung **FL** reduziert ist. Bei Resonanz der Mikrowellenfrequenz **ω _{µW}** des Mikrowellensignals **µW** mit der Resonanzfrequenz der NV-Zentren des Diamant-Einkristalls tritt in dem Intensitätssignal des Empfangssignals **S0** ein Signalanteil auf der die Mikrowellenmodulationsfrequenz **f_{µW}** der Mikrowellenstrahlung **µW** der Mikrowellensignalquelle **µWG** aufweist. Dieser Anteil fehlt, wenn keine Resonanz der Mikrowellenmodulationsfrequenz **f_{µW}** der Mikrowellenstrahlung **µW** der Mikrowellensignalquelle **µWG** mit der Resonanzfrequenz der NV-Zentren des Diamant-Einkristalls vorliegt. Das NV-Zentrum weist jeweils eine Achse im Diamant-Einkristall auf. Das hier vorgelegte Dokument bezeichnet diese Achse im Folgenden als NV-Achse. Die linke Resonanzlinie **502** für die Spin-Quantenzahl mₛ=-1 und die ganz rechte Resonanzlinie **505** für die Spin-Quantenzahl mₛ=+1 bedeuten, dass der Vektor der magnetischen Flussdichte **B** in Richtung der NV-Achse [111] ausgerichtet ist.

Die Resonanzlinie **502** steht für eine Spin-Quantenzahl mₛ=-1. Die Resonanzlinie **505** steht für eine Spin-Quantenzahl mₛ=+1. Die Resonanzlinien **3** und **4** entstammen der Überlagerung der anderen drei im Kristall möglichen Ausrichtungen der NV-Achsen von NV-Zentren des Diamant-Einkristalls. Auch dieser anderen drei möglichen Ausrichtungen der NV-Achsen stehen senkrecht zu dem Vektor der magnetischen Flussdichte **B.** Das wirksame B-Feld der Mikrowellenstrahlung des Mikrowellensignals **µW** der Mikrowellensignalquelle **µWG** muss zur Wirksamkeit stets senkrecht zur NV-Achse des jeweiligen NV-Zentrums sein. Ist dies nicht der Fall, so beeinflusst lediglich der Anteil des B-Felds der Mikrowellenstrahlung des Mikrowellensignals **µW** der Mikrowellensignalquelle **µWG,** der zur Wirksamkeit senkrecht zur NV-Achse des jeweiligen NV-Zentrums ist, die Intensität **Iᵢₛₜ(t)** der Fluoreszenzstrahlung FL des betreffenden NV-Zentrums. Somit ist für diese anderen drei möglichen Ausrichtungen der NV-Achsen die wirksame magnetische Flussdichte **B** kleiner als für die Resonanzlinien **502** und **505.** Für eine Messung zur Erzeugung des Diagramms **501** entsprechend der Figur 51a liegt der Kristall vorzugsweise mit der Fläche mit Normalenvektor [111] auf der Leitung auf, die das Mikrowellenmodulationssignal **S5m** von der Mikrowellensignalquelle **µWG** zum Diamant-Einkristall transportiert. Der Normalenvektor [111] ist der Vektor, der senkrecht zur Oberfläche des betreffenden Diamantkristalls steht, der parallel zur NV-Achse zumindest eines Teils der NV-Zentren ist.

Über den Stand der Technik geht nun die folgende Erkenntnis hinaus:
Diese Methode kann auch genutzt werden, um ein unbekanntes Mikrowellensignal **S_{ω nk}** zu analysieren. Hierfür kann eine Vorrichtung ein einkristallines Diamantplättchen mit NV-Zentren in ein magnetisches Feld mit einem Gradienten der magnetischen Flussdichte **B** einbringen. Vorzugsweise umfasst die Vorrichtung dann einen Mischer. Dieser Mischer mischt das unbekannte Mikrowellensignal mit einem Trägersignal. Bevorzugt ist das Trägersignal das Mikrowellensignal **µW** der Mikrowellensignalquelle **µWG**. Die betreffende Vorrichtung führt vorzugsweise dann das so gemischte Mikrowellensignal den NV-Zentren über eine Tri-Plate-Leitung **1330** zu.

Die NV-Zentren, die in Resonanz sind, zeigen dann die Modulation entsprechend dem Mikrowellenmodulationssignal **S5m** der Mikrowellensignalquelle **µWG** die dann das mit dem Mikrowellenmodulationssignal **S5m** moduliert Trägersignal vor der Mischung durch den Mischer der Vorrichtung erzeugt. Die Vorrichtung kann die dann auftretenden Resonanzlinien **(502, 503, 504, 505)** zur Bestimmung der unbekannten Mikrowellenfrequenz des unbekannten Mikrowellensignals verwenden.

### Figur 51b

Figur 51b zeigt den Übergang von Figur 51a zu Figur 51b. Dieser entspricht einem Übergang von einem einkristallinen zu einem multikristallinen Fluoreszenzsubstrat. In Figur 51b bestrahlt die Lichtquelle **LED** eine Vielzahl von Diamant-Nano-Kristallen **ND.** Statt der Diamant-Nano-Kristalle **ND** kann es sich auch um eine Vielzahl anderer Diamantkristalle mit NV-Zentren und/oder um eine Vielzahl von Kristallen mit paramagnetischen Zentren vergleichbarer Eigenschaften handeln. Insofern sind die Diamant-Nano-Kristalle **ND** hier nur beispielhaft. Ein Fachmann bzw. eine Fachfrau können leicht zur entsprechenden technischen Lehre gelangen, in dem sie den Begriff Diamant-Nano-Kristalle **ND** durch den Begriff Diamanten ersetzen. Der Begriff Diamant-Nano-Kristall **ND** bezeichnet zwar also die nach derzeitiger Kenntnis optimale Ausführungsform und umfasst aber ausdrücklich weniger optimale Ausführungsformen wie Diamant an sich ebenfalls im Sinne der technischen Lehre des hier vorgelegten Dokuments. Die Diamant-Nano-Kristalle **ND** weisen in dem Beispiel der Figur 51b eine unterschiedliche Orientierung im Raum auf. Aufgrund der statistisch gleichverteilten unterschiedlichen Orientierung der Diamant-Nano-Kristalle **ND** zeigen die Diamant-Nano-Kristalle **ND** nicht das Resonanzbild der Figur 51a. Gleiches gilt bei der Verwendung anderer geeigneter kleiner Kristalle mit geeigneten funktionsäquivalenten paramagnetischen Zentren die stochastisch gleichverteilt unterschiedlich im Raum ausgerichtet sind. Die Resonanzlinien **(502, 503, 504, 505)** der Figur 51 weiten sich durch die Zahl der Diamant-Nano-Kristalle **ND** und deren gleichverteilte stochastische Orientierung im Raum auf. Vorzugsweise liegen die Diamant-Nano-Kristalle **ND** als Diamantpulver bzw. Kristallpulver vor. Bevorzugt sind zumindest ein Teil der Diamanten HDNV-Diamanten entsprechend dem Stand der Technik. Hierzu verweist das hier vorgelegte Dokument beispielsweise auf die Schrift DE 10 2021 132 148 A1.

Figur 51b zeigt die Resonanzen einer Vielzahl unterschiedliche im Raum orientierter NV-Zentren umfassender Diamanten. Die Figur 51b zeigt in Diagramm **2** die Resonanzen des Anteils an der der Intensität **Iᵢₛₜ(t)** der Fluoreszenzstrahlung **FL** der Vielzahl der mit NV-Zentren versehenen Diamanten, bei dem der Anteil des Intensitätssignals der Fluoreszenzstrahlung **FL,** der der Mikrowellenmodulationsfrequenz **f_{µW}** aufweist, in Anhängigkeit von der Mikrowellenfrequenz ω _{µW} und von der magnetischen Flussdichte **B** dargestellt ist. Dabei ist die Mikrowellenfrequenz ω _{µW} in der X-Achse des Diagramms **501** aufgetragen. Die magnetische Flussdichte **B** ist in der Y-Achse des Diagramms **520** in willkürlichen Einheiten aufgetragen (englisch: "arbitrary units" oder abgekürzt "au"). In dem Beispiel ist eine Vielzahl unterschiedlich im Raum orientierter Diamantkristalle gegenüber der Richtung der magnetischen Flussdichte **B** eines Magnetfelds unterschiedlich und typischerweise gleichverteilt ausgerichtet.

Durch die stochastisch gleichverteilte Orientierung der Diamant-Nano-Kristalle **ND** weiten sich die Resonanzlinien **(502, 503, 504, 505)** des Diagramms **501** der Figur 51a auf. Anstelle von Resonanzlinien **(502, 503, 504, 505)** weist das Diagramm 5**20** der Figur 51b nun Resonanzteilfelder **(526, 527, 528)** auf.

Ein erstes Resonanzteilfeld ist der das untere Resonanzfeld **528.** Überschreitet die wirksamen magnetische Flussdichte **B** des Magnetfelds einen Grenzwert **B_{off}** des Betrags der wirksamen magnetischen Flussdichte **B** des Magnetfelds so spaltet sich das untere Resonanzfeld **528** in ein unteres Resonanzteilfeld **522** und ein oberes Resonanzteilfeld 5**25** auf. Zwischen dem unteren Resonanzteilfeld **522** und dem oberen Resonanzteilfeld **525** bildet sich bei einem Betrag der wirksamen magnetischen Flussdichte **B** oberhalb des Grenzwerts **B_{off}** des Betrags der wirksamen magnetischen Flussdichte **B** des Magnetfelds ein mittleres Resonanzminimum **529** aus. Die untere Resonanzkante **522** begrenzt das untere Resonanzfeld **528** zu niedrigeren Mikrowellenfrequenzen und zu kleineren magnetischen Flussdichten **B** hin. Die obere Resonanzkante **25** begrenzt das untere Resonanzteilfeld **528** zu höheren Mikrowellenfrequenzen ω _{µw} und zu kleineren wirksamen magnetischen Flussdichten **B** hin. Eine wirksame Offsetflussdichte **B_{off}** begrenzt das untere Resonanzfeld **528** zu höheren wirksamen magnetischen Flussdichten **B** hin. Das mittlere Resonanzminimum **529** teilt das untere Resonanzfeld **528** nicht.

Ein zweites Resonanzteilfeld ist das untere Resonanzteilfeld **526.** Die untere Resonanzkante **522** begrenzt das untere Resonanzteilfeld **526** zu niedrigeren Mikrowellenfrequenzen ω _{µW} und zu niedrigeren wirksamen magnetischen Flussdichten **B** hin. Die untere mittlere Resonanzkante **523** begrenzt das untere Resonanzteilfeld **526** zu höheren Mikrowellenfrequenzen ω _{µw} und zu niedrigeren wirksamen magnetischen Flussdichten **B** hin. Eine Offsetflussdichte **B_{off}** begrenzt das untere Resonanzteilfeld **526** zu kleineren wirksamen magnetischen Flussdichten **B** hin weiter.

Ein drittes Resonanzteilfeld ist das obere Resonanzteilfeld **527.** Die obere Resonanzkante **525** begrenzt das obere Resonanzteilfeld **527** zu niedrigeren Mikrowellenfrequenzen ω _{µw} und zu höheren wirksamen magnetischen Flussdichten **B** hin. Die obere mittlere Resonanzkante **524** begrenzt das obere Resonanzteilfeld **527** zu höheren Mikrowellenfrequenzen ω _{µw} und zu höheren wirksamen magnetischen Flussdichten **B** hin. Eine wirksame Offsetflussdichte **B_{off}** begrenzt das obere Resonanzteilfeld **527** zu kleineren wirksamen magnetischen Flussdichten **B** hin weiter.

Ein Teil der Diamant-Nano-Kristalle **ND,** die die gleiche Ausrichtung, wie der Diamant-Einkristall der Figur 51a aufweisen, erzeugt die untere Resonanzkante **522.** Diese Diamant-Nano-Kristalle **ND** besitzen eine Resonanzlinie **502** für die Spinquantenzahl mₛ=-1. Diese Diamant-Nano-Kristalle **ND** sind gegenüber der wirksamen magnetischen Flussdichte **B** des Magnetfelds in [111] Richtung ausgerichtet. Die bei dieser Resonanzlinie wechselwirkenden NV-Zentren dieses Teils der Diamant-Nano-Kristalle **ND** sind in der [111]-Richtung des jeweiligen Diamant-Nano-Kristalls **ND** ausgerichtet. Die B-Komponente des Mikrowellenfeldes des Mikrowellensignals **µW** ist gegenüber der wirksamen magnetischen Flussdichte **B** des Magnetfelds senkrecht ausgerichtet. Die untere Resonanzkante **522** entspricht somit der Spinquantenzahl mₛ=-1;

Ein Teil der Diamant-Nano-Kristalle **ND,** die die gleiche Ausrichtung wie der Diamant-Einkristall der Figur 51a aufweisen, erzeugt die obere Resonanzkante **525.** Diese Diamant-Nano-Kristalle **ND** besitzen eine Resonanzlinie **505** für die Spinquantenzahl mₛ=+1. Diese Diamant-Nano-Kristalle **ND** sind gegenüber der wirksamen magnetischen Flussdichte **B** des Magnetfelds in [111] Richtung ausgerichtet. Die bei dieser Resonanzlinie wechselwirkenden NV-Zentren dieses Teils der Diamant-Nano-Kristalle **ND** sind in der [111]-Richtung des jeweiligen Diamant-Nano-Kristalls **ND** ausgerichtet. Die B-Komponente des Mikrowellenfeldes des Mikrowellensignals **µW** ist gegenüber der wirksamen magnetischen Flussdichte **B** des Magnetfelds senkrecht ausgerichtet. Die obere Resonanzkante 5**25** entspricht somit der Spinquantenzahl mₛ=+1;

Erstaunlicherweise teilt das mittleres Resonanzminimum **529** eine Strecke parallel zur x-Achse in dem Diagramm **20** zwischen der unteren Resonanzkante **522** und der oberen Resonanzkante **525** nicht überall in einem Verhältnis 50:50 oberhalb der wirksamen Offsetflussdichte **B_{off}**. Bei der wirksamen Offsetflussdichte **B_{off}** teilt das mittleres Resonanzminimum **529** eine Strecke parallel zur x-Achse in dem Diagramm **520** zwischen der unteren Resonanzkante **522** und der oberen Resonanzkante **525** noch in einem Verhältnis 50:50. Die Linie des mittleren Resonanzminimums **529** schwenkt dann aber nichtlinear nach rechts ab. Damit kann das Verhältnis der Strecken als Maß für die magnetische Flussdichte B verwendet werden.

### Figur 51c

Figur 51c erläutert die Bestimmung einer unbekannten wirksamen magnetischen Flussdichte **Bₙₖ** auf Basis der Figur 51b mittels einer Variation der Mikrowellenfrequenz ω _{µW} im interessierenden Bereich und mittels einer gleichzeitigen eine Bestimmung desjenigen Anteils an der der Intensität der Fluoreszenzstrahlung **FL** der Vielzahl mit NV-Zentren versehenen Diamant-Nano-Kristallen **ND,** bei dem dieser Anteil des Intensitätssignals der Fluoreszenzstrahlung **FL** die Mikrowellenmodulationsfrequenz **f_{µW}** aufweist, in Abhängigkeit von dieser Mikrowellenfrequenz ω _{µW} im interessierenden Bereich. Das Diagramm **520** der Figur 51c entspricht dem der Figur 51b, wobei nun markante Punkte in dem Diagramm **520** zur besseren Klarheit mittels Bezugslinien und Bezugszeichen zusätzlich markiert sind.

Die unbekannte wirksame Flussdichte **Bₙₖ** ist der Teil der unbekannten Gesamtflussdichte **B_{Σ}**, dessen vektorieller Anteil senkrecht zur magnetischen B-Feld-Komponenten des Mikrowellenfeldes des Mikrowellensignals **µW** der Mikrowellensignalquelle **µWG** steht. Wie im Folgenden näher erläutert wird, hängt dieser Teil erheblich von der Positionierung des Sensorelements **SE,** das vorzugsweise die Vielzahl von Diamant-Nano-Kristallen **ND** und typischerweise in Trägermaterial **TM** umfasst, relativ zum Signalleiter **1330** und zur nicht-leitenden linken Isolationslücke **1440** und zur nicht-leitenden rechten Isolationslücke **1450** der beispielhaften Triplate-Leitung **1480** ab. Bei einer Positionierung des Sensorelements **SE** in der nicht-leitenden linken Isolationslücke **1440** und/oder in der nicht-leitenden rechten Isolationslücke **1450** entspricht die unbekannte wirksame Flussdichte **Bₙₖ** dem Anteil der unbekannten Flussdichte **B,** der **parallel** zur Ebene des Trägersubstrats **1360** der beispielhaften Triplate-Leitung **1480** ist. Bei einer Positionierung des Sensorelements **SE** auf und/oder unter dem Signalleiter **1330** der beispielhaften Triplate-Leitung **1480** entspricht die unbekannte wirksame Flussdichte **Bₙₖ** dem Anteil der unbekannten Flussdichte **B,** der in Richtung des Wellenleiters **2380** oder **senkrecht** zur Ebene des Trägersubstrats **1360** der beispielhaften Triplate-Leitung **1480** ist. Sofern das Sensorelement **SE** sowohl eine einer Positionierung des Sensorelements **SE** in der nicht-leitenden, linken Isolationslücke **1440** und/oder in der nicht-leitenden rechten Isolationslücke **1450** als auch eine Positionierung des Sensorelements **SE** auf und/oder unter dem Signalleiter **1330** der beispielhaften Triplate-Leitung **1480** zumindest teilweise aufweist, so zeigt es in der Regel eine Mischung dieser Empfindlichkeiten. Dies kann unter Umständen gewollt sein.

Das hier vorgelegte Dokuments schlägt vor, dass die vorschlagsgemäße Vorrichtung zur Bestimmung der unbekannten wirksamen magnetischen Flussdichte **Bₙₖ** die Mikrowellenfrequenz ω _{µW} im interessierenden Bereich durchscannt und für eine Vielzahl von Messpunkten mit unterschiedlicher Mikrowellenfrequenz ω_{µW} einen jeweils zugehörigen Messwert für den Anteil an der der Intensität der Fluoreszenzstrahlung **FL** der Vielzahl mit NV-Zentren versehenen Diamant-Nano-Kristallen **ND** bestimmt, bei dem der Anteil des Intensitätssignals der Fluoreszenzstrahlung **FL** die Mikrowellenmodulationsfrequenz **f_{µW}** aufweist.

Aus diesen zugehörigen Messwerten für den Anteil an der der Intensität **Iᵢₛₜ(t)** der Fluoreszenzstrahlung **FL** der Vielzahl mit NV-Zentren versehenen Diamant-Nano-Kristallen **ND** kann die vorschlagsgemäße Vorrichtung dann die untere Mikrowellenfrequenz ω _{µW22} der unteren Resonanzkante **522** bestimmen. Bevorzugt sind in einem Speicher (RAM, ROM, Flash) **(RAM, NVM)** der Vorrichtung eine erste Kalibrationstabelle und/oder die ersten Parameter einer ersten Kalibrationsfunktion abgelegt, mit deren Hilfe die Vorrichtung aus der ermittelten Wert der unteren Mikrowellenfrequenz ω _{µW22} den Wert des Betrags der unteren wirksamen magnetischen Flussdichte **B₂₂** ermitteln kann.

Aus den zugehörigen Messwerten für den Anteil an der der Intensität **Iᵢₛₜ(t)** der Fluoreszenzstrahlung **FL** der Vielzahl mit NV-Zentren versehenen Diamant-Nano-Kristallen **ND** kann die vorschlagsgemäße Vorrichtung auch die obere Mikrowellenfrequenz ω _{µW25} der oberen Resonanzkante **525** bestimmen. Bevorzugt sind in einem Speicher (RAM, ROM, Flash) **(RAM, NVM)** der Vorrichtung eine zweite Kalibrationstabelle und/oder die zweiten Parameter einer zweiten Kalibrationsfunktion abgelegt, mit deren Hilfe die Vorrichtung aus der ermittelten Wert der oberen Mikrowellenfrequenz ω _{µW25} den Wert des Betrags der oberen wirksamen magnetischen Flussdichte **B₂₅** ermitteln kann.

Aus den zugehörigen Messwerten für den Anteil an der der Intensität der Fluoreszenzstrahlung **FL** der Vielzahl mit NV-Zentren versehenen Diamant-Nano-Kristallen **ND** kann die vorschlagsgemäße Vorrichtung auch das Vorhandensein des mittleren Resonanzminimums **529** feststellen und die Resonanzminimum-Mikrowellenfrequenz ω µ_{W29} des mittleren Resonanzminimums **529** bestimmen. Bevorzugt sind in einem Speicher (RAM, ROM, Flash) (**RAM, NVM**)der Vorrichtung eine dritte Kalibrationstabelle und/oder die dritten Parameter einer dritten Kalibrationsfunktion abgelegt, mit deren Hilfe die Vorrichtung aus der ermittelten Wert der Resonanzminimum-Mikrowellenfrequenz ω µ_{W29} des mittleren Resonanzminimums **529** den Wert des Betrags der wirksamen magnetischen Resonanzminimum-Flussdichte **B₂₉** ermitteln kann.

Der Abfall des Betrags der Messwerte für den Anteil an der der Intensität **Iᵢₛₜ(t)** der Fluoreszenzstrahlung **FL** der Vielzahl mit NV-Zentren versehenen Diamant-Nano-Kristallen **ND** vom unteren Resonanzteilfeld **526** zum mittleren Resonanzminimums **529** erfolgt bei konstanter wirksamer magnetischer Flussdichte **B** und bei Erhöhung der Mikrowellenfrequenz ω _{µw} mit Überschreiten der unteren mittleren Mikrowellenfrequenz ω_{µW23}, sodass die Vorrichtung eine untere mittlere Resonanzkante **523** feststellen kann, wenn die wirksame magnetische Flussdichte **B** über der der wirksamen Offsetflussdichte **B_{off}** liegt. Bevorzugt sind in einem Speicher (RAM, ROM, Flash) **(RAM, NVM)** der Vorrichtung eine vierte Kalibrationstabelle und/oder die vierten Parameter einer vierten Kalibrationsfunktion abgelegt, mit deren Hilfe die Vorrichtung aus der ermittelten Wert der unteren mittleren Mikrowellenfrequenz ω _{µW23} der unteren mittleren Resonanzkante **523** den Wert des Betrags der unteren mittleren wirksamen magnetischen Flussdichte **B₂₃** ermitteln kann.

Der Anstieg des Betrags der Messwerte für den Anteil an der der Intensität **Iᵢₛₜ(t)** der Fluoreszenzstrahlung **FL** der Vielzahl mit NV-Zentren versehenen Diamant-Nano-Kristallen **ND** vom mittleren Resonanzminimums **529** zum oberen Resonanzteilfeld **527** erfolgt bei konstanter wirksamer magnetischer Flussdichte **B** und bei weiterer Erhöhung der Mikrowellenfrequenz ω _{µW} mit Überschreiten der oberen mittleren Mikrowellenfrequenz ω _{µW24}, sodass die Vorrichtung eine obere mittlere Resonanzkante **524** feststellen kann, wenn die wirksame magnetische Flussdichte **B** über der der wirksamen Offsetflussdichte **B_{off}** liegt. Bevorzugt sind in einem Speicher (RAM, ROM, Flash) **(RAM, NVM)** der Vorrichtung eine fünften Kalibrationstabelle und/oder die fünften Parameter einer fünften Kalibrationsfunktion abgelegt, mit deren Hilfe die Vorrichtung aus der ermittelten Wert der oberen mittleren Mikrowellenfrequenz ω _{µW24} der oberen mittleren Resonanzkante **524** den Wert des Betrags der oberen mittleren wirksamen magnetischen Flussdichte **B₂₄** ermitteln kann.

Bei einer unbekannten wirksamen magnetischen Flussdichte **Bₙₖ** kann die Vorrichtung somit durch Variation der Mikrowellenfrequenz ω _{µW} einen oder mehrere der Messwerte
- untere Mikrowellenfrequenz ω_{µW22},
- untere mittlere Mikrowellenfrequenz ω_{µW23},
- obere mittlere Mikrowellenfrequenz ω_{µW24},
- obere Mikrowellenfrequenz ω_{µW25},
- Resonanzminimum-Mikrowellenfrequenz ω_{µW29}
bestimmen.

Bei einer unbekannten wirksamen magnetischen Flussdichte **Bₙₖ** kann die Vorrichtung aus diesen Mikrowellenfrequenzen (ω _{µW22}, ω _{µW23}, ω _{µW24}, ω _{µW25}, ω _{µW29}) somit durch Variation der Mikrowellenfrequenz ω _{µW} und mit Hilfe von einen oder mehrere der Messwerte
- untere Mikrowellenfrequenz ω_{µW22},
- untere mittlere Mikrowellenfrequenz ω_{µW23},
- obere mittlere Mikrowellenfrequenz ω_{µW24},
- obere Mikrowellenfrequenz ω_{µW25},
- Resonanzminimum-Mikrowellenfrequenz ω_{µW29}
einen oder mehreren der zugehörigen Messwerte
- untere wirksame magnetische Flussdichte **B₂₂**,
- obere wirksame magnetische Flussdichte **B₂₅**,
- wirksame magnetische Resonanzminimum-Flussdichte **B₂₉**,
- untere mittlere wirksame magnetische Flussdichte **B₂₃**,
- obere mittlere wirksame magnetische Flussdichte **B₂₄**
bestimmen. Diese sollten in der Regel der unbekannten wirksamen magnetischen Flussdichte **Bₙₖ** entsprechen. Beispielsweise kann die Vorrichtung durch Mittelung über zwei oder mehrere Werte (**B₂₂, B₂₃, B₂₄, B₂₅, B₂₉**) den Messwert einer gemittelten mittleren wirksamen Flussdichte **B_{g}** errechnen.

### Figur 51d

Figur 51d erläutert die Bestimmung einer unbekannten Mikrowellenfrequenz ω _{µWnk}. auf Basis der Figur 51b. Mittels einer Variation der wirksamen magnetischen Referenzflussdichte **B_{ref}** im interessierenden Bereich und mittels einer gleichzeitigen eine Bestimmung desjenigen Anteils an der der Intensität der Fluoreszenzstrahlung **FL** der Vielzahl mit NV-Zentren versehenen Diamant-Nano-Kristallen **ND,** bei dem dieser Anteil des Intensitätssignals der Fluoreszenzstrahlung **FL** die Mikrowellenmodulationsfrequenz **f_{µW}** aufweist, in Abhängigkeit von dieser wirksamen magnetischen Referenzflussdichte **B_{ref}** im interessierenden Bereich. Das Diagramm **520** der Figur 51d entspricht dem der Figur 51b, wobei nun markante Punkte in dem Diagramm **520** zur besseren Klarheit mittels Bezugslinien und Bezugszeichen zusätzlich markiert sind.

Die lineare Extrapolation der unteren Resonanzkante **522** und der oberen Resonanzkante **525** schneiden sich typischerweise in einem Punkt der Spitze **530** der V-Formation **(522, 525)** mit der Nullpunktsflussdichte **B₀** und der Nullpunktsmikrowellenfrequenz ω_{µW0}.

Bevorzugt bestimmt die Vorrichtung durch Veränderung der magnetischen Referenzflussdichte **B_{ref}** die Nullpunktsflussdichte **B₀** und die Nullpunktsmikrowellenfrequenz ω _{µW0} der Spitze **530** der V-Formation **(522, 525)** oder eine funktionsäquivalente Information vor der bestimmungsgemäßen Nutzung der Vorrichtung und/oder in einem Initialisierungsvorgang bei einer Inbetriebsetzung der vorschlagsgemäßen Vorrichtung. Sofern vorhanden, kompensiert die vorschlaggemäße Vorrichtung die Nullpunktsflussdichte **B₀** mittels optionaler Magnetfeldkompensationsmittel **(LCTR, DRLV, Lc, SIS, MS).** Beispielsweise können diese Magnetfeldkompensationsmittel **(LCTR, DRLV, Lc, SIS, MS)** einen Magnetfeldregler **LCTR** umfassen, die das Magnetfelderzeugungsmittels **L_{C}** und die Treiberstufe **DRVL** zur Versorgung des Magnetfelderzeugungsmittels **L_{C}** steuert. Beispielsweise kann somit die vorschlaggemäße Vorrichtung über Mittel zur Erzeugung einer zusätzlichen, überlagernden magnetischen Flussdichte **B_{ad}** verfügen. Diese Mittel zur Erzeugung einer zusätzlichen, überlagernden magnetischen Flussdichte **B_{ad}** können das besagte Magnetfelderzeugungsmittels **Lc** umfassen.

Diese Mittel zur Erzeugung einer zusätzlichen, überlagernden magnetischen Flussdichte **B_{ad}** können einen Permanentmagneten **PM** bzw. einen Gradienten behafteten Permanentmagneten **GPM** umfassen. Diese Mittel zur Erzeugung einer zusätzlichen, überlagernden magnetischen Flussdichte **B_{ad}** können eine Positioniervorrichtung **PV** umfassen, die den Permanentmagneten **PM** bzw. den Gradienten behafteten Permanentmagneten **GPM** gegenüber dem Sensorelement **SE** positioniert. Vorzugsweise steuert dann die Steuervorrichtung **CTR** über einen Datenbus **DB** die Positioniervorrichtung **PV** des Permanentmagneten **PM** bzw. des Gradienten behafteten Permanentmagneten **GPM** und damit die Positionierung des Permanentmagneten **PM** bzw. des Gradienten behafteten Permanentmagneten **GPM** gegenüber dem Sensorelement SE. Hierdurch kann die Steuervorrichtung **CTR** die zusätzliche magnetische Flussdichte **B_{ad}**, die das Sensorelement **SE** durchflutet, beeinflussen. Bevorzugt steuert die Steuervorrichtung **CTR** die Positionierung des Permanentmagneten **PM** bzw. des Gradienten behafteten Permanentmagneten **GPM** gegenüber dem Sensorelement **SE** und Beeinflussung der zusätzlichen magnetischen Flussdichte **B_{ad}**, die das Sensorelement **SE** durchflutet, in Abhängigkeit von einem oder mehreren Messwerten einer magnetischen Flussdichte.

Ein erster dieser Messwerte einer solchen magnetischen Flussdichte kann beispielsweise ein Messwert eines Magnetfeldsensors **MS** sein, den die Steuervorrichtung **CTR** mittels des Magnetfeldsensors **MS** und ggf. einer Magnetfeldsensoransteuerung **SIS** beispielsweise über einen Datenbus **DB** erfasst.

Ein zweiter dieser Messwerte einer solchen magnetischen Flussdichte kann beispielsweise ein Messwert sein, den die Steuervorrichtung **CTR** mittels des Sensorelements **SE** und dessen Fluoreszenzstrahlung **FL** und weiterer hier beschriebener Vorrichtungsteile erfasst.

Die wirksame magnetische Flussdichte **B_{w}** setzt sich dann zusammen aus der wirksamen externen magnetischen Flussdichte **B_{extw}** und der wirksamen zusätzlichen Flussdichte **B_{adw}.** (**B_{w}= B_{extw}+ B_{adw}**) In dem Fall kann die Vorrichtung die wirksame magnetische Flussdichte **B_{w}** durch Veränderung der zusätzlichen magnetischen Flussdichte **B_{ad}** durchstimmen.

Die wirksamen zusätzlichen Flussdichte **B_{adw}** ist der Anteil der zusätzlichen Flussdichte **B_{ad}**, der senkrecht zum Vektor der magnetischen Flussdichte **B_{µW}** der Mikrowellenstrahlung des Mikrowellensignals **µW** ist.

Die wirksame magnetische Flussdichte **B_{w}** ist der Anteil der Gesamtflussdichte **B_{Σ}**, der senkrecht zum Vektor der magnetischen Flussdichte **B_{µW}** der Mikrowellenstrahlung des Mikrowellensignals **µW** ist.

Die wirksamen externen magnetischen Flussdichte **B_{extw}** ist der Anteil der externen magnetischen Flussdichte **Bₑₓₜ,** der senkrecht zum Vektor der magnetischen Flussdichte **B_{µW}** der Mikrowellenstrahlung des Mikrowellensignals **µW** ist. Dabei wirkt die externe magnetische Flussdichte **Bₑₓₜ,** vorzugsweise von außerhalb der Vorrichtung auf das Sensorelement **SE** ein.

Für die Bestimmung einer unbekannten Mikrowellenfrequenz **ω _{µWnk}** kann die Vorrichtung beispielsweise die wirksame magnetische Referenzflussdichte **B_{ref}** mittels Änderung der zusätzlichen wirksamen magnetischen Flussdichte **B_{adw}** verändern. Hierdurch wandert der Arbeitspunkt des Sensorelements **SE** entlang der Linie **541.** Für die Bestimmung einer unbekannten Mikrowellenfrequenz ω _{µWnk} kann die Vorrichtung beispielsweise die ein Mikrowellensignal **µW** mit der Mikrowellenfrequenz ω _{µW} zumischen. Hierdurch ergeben sich innerhalb des Sensorelements **SE** Mikrowellensignalanteile mit einer gemischten Mikrowellenfrequenz von ω _{µWmix+}=ω _{µWnk}+ω _{µW} und ω _{µWmix-}=ω _{µWnk}-ω _{µW}. Hierdurch wandert sich der Arbeitspunkt des Sensorelements **SE** entlang der Linie **543.** Bevorzugt ist die unbekannte Mikrowellenfrequenz ω _{µWnk} betragsmäßig größer als der Frequenzabstand zwischen dem Schnittpunkt **542** der Linie **543** mit der untere Resonanzkante **522** vom Schnittpunkt **545** der Linie **543** mit der oberen Resonanzkante **525.**

Es ist daher vorteilhaft, wenn die Vorrichtung die zusätzliche magnetische Flussdichte **B_{ad}** während der Messung erhöht, um den Arbeitspunkt der Messung, der von unten nach oben zu schieben. Dabei ist der Arbeitspunkt typischerweise durch die gemischten Mikrowellenfrequenzen von ω _{µWmix+}=ω _{µWnk}+_{ω µW} und ω _{µWmix-}=ω _{µWnk}-ω _{µW} und durch die wirksame magnetische Flussdichte
**B_{w}** (**B_{w}= B_{extw}+ B_{adw}**) bestimmt.

Somit kann die vorschlagegemäße Vorrichtung durch Interpolation aus den bei einer unbekannten wirksamen Mikrowellenfrequenz ω _{µWnk} durch Variation der Mikrowellenfrequenz ω _{µW} und/oder durch Variation der wirksamen zusätzlichen magnetischen Flussdichte **B_{adw}** die Lage der unteren Resonanzkante **522** und der oberen Resonanzkante **525** und/oder der Spitze **530** der V-Formation **(522, 525)** und ggf. die Lagen der untere mittlere Resonanzkante **523** und/oder der oberen mittlere Resonanzkante **524** und/oder die Lage des mittleren Resonanzminimums **529** bestimmen und beispielsweise daraus die Lage der Nullpunktsflussdichte **B₀** und/oder der Nullpunktsmikrowellenfrequenz ω _{µW0} bestimmen. Hieraus kann die Vorrichtung auf die wirksame externe magnetische Flussdichte **B_{extw}** und/oder die unbekannte Mikrowellenfrequenz ω _{µWnk} schließen. Die Steuervorrichtung **CTR** steuert bevorzugt hierfür die Mikrowellensignalquelle **µWG** und die das Magnetfelderzeugungsmittel **L_{C}** mit ihrer Steuervorrichtung **LCTR** typischerweise über den Datenbus **DB.**

### Figur 52a

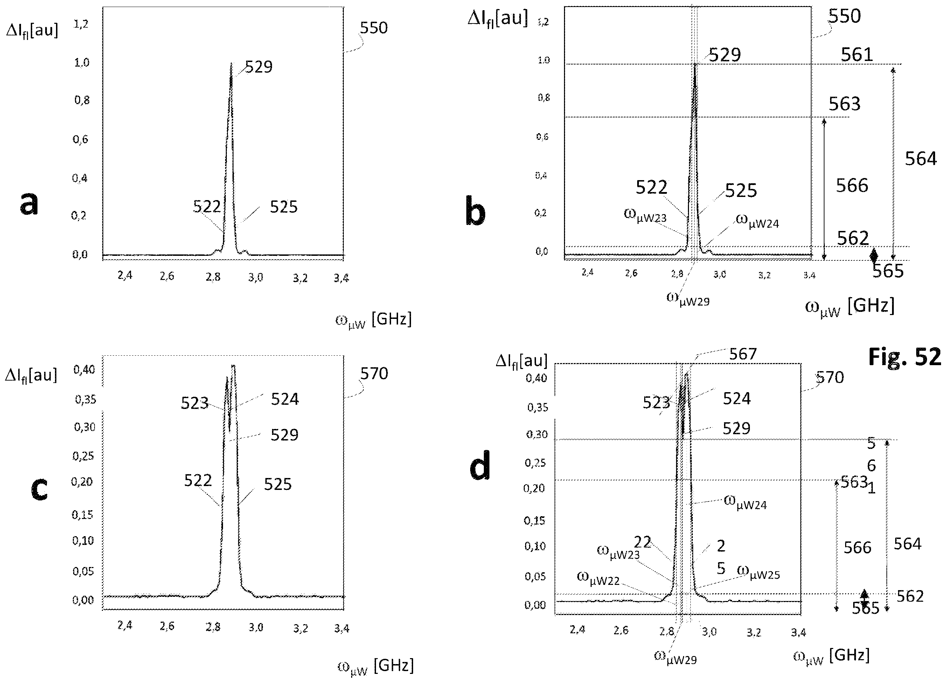

Figur 52a zeigt die Resonanzen einer Vielzahl unterschiedlich im Raum orientierter NV-Zentren umfassender Diamanten. Die Figur 52a zeigt in Diagramm 5**50** die Amplitude des Anteils an der der Intensität der Fluoreszenzstrahlung **FL** der Vielzahl der mit NV-Zentren versehenen Diamanten, bei dem der Anteil des Intensitätssignals der Fluoreszenzstrahlung **FL,** der der Mikrowellenmodulationsfrequenz **fw** aufweist, in Anhängigkeit von der Mikrowellenfrequenz ω _{µw} und bei konstanter wirksamer magnetischer Flussdichte **B_{w}** dargestellt ist. Die magnetischer Flussdichte **B** entspricht dabei dem Wert 0,0 der Y-Achse des Diagramms **520** der Figur 51b. Dabei ist die Mikrowellenfrequenz ω _{µW} in der X-Achse des Diagramms 5**50** aufgetragen. Die Amplitude des Anteils an der der Intensität **Iᵢₛₜ(t)** der Fluoreszenzstrahlung **FL** der Vielzahl der mit NV-Zentren versehenen Diamanten, bei dem der Anteil des Intensitätssignals der Fluoreszenzstrahlung **FL,** der der Mikrowellenmodulationsfrequenz **f_{µW}** aufweist, ist in der Y-Achse des Diagramms 5**50** in willkürlichen Einheiten aufgetragen (englisch: "arbitrary units" oder abgekürzt "au"). In dem Beispiel ist eine Vielzahl unterschiedlich Im Raum orientierter Diamantkristalle gegenüber der Richtung der magnetischen Flussdichte **B eines** Magnetfelds unterschiedlich und typischerweise gleichverteilt ausgerichtet.

In der Figur 52a sind zur Orientierung die untere Resonanzkante **522** und die obere Resonanzkante **525** und das mittlere Resonanzminimum **529** mit Bezugszeichen versehen.

### Figur 52b

Die Figur 52b entspricht der Figur 52a, wobei nun verschiedene Referenzlinien **(561, 562, 563)** zur Vermessung eingezeichnet sind. Ein Problem ist der Rauschuntergrund, den die Steuervorrichtung **CTR** z.B. mittels eines computerimplementierten Rauschunterdrückungsverfahrens unterdrücken muss.

Vorzugsweise legt die Steuervorrichtung **CTR** die obere Referenzlinie **561** so, dass der Wert **564** der magnetischen Flussdichte **B₆₁**, der der oberen Referenzlinie **561** zugeordnet ist, maximal ist und die obere Referenzlinie **561** mindestens einmal und nicht mehr als vier Mal von der erfassten Kurve gekreuzt wird. Vorzugsweise legt die Steuervorrichtung **CTR** die untere Referenzlinie **562** so, dass der Wert **565** der magnetischen Flussdichte **B₆₂**, der der unteren Referenzlinie **562** zugeordnet ist, minimal ist und die untere Referenzlinie **562** mindestens zweimal und nicht mehr als viermal von der erfassten Kurve gekreuzt wird. Bevorzugt wählt dann die Steuervorrichtung **CTR** der vorschlagsgemäßen Vorrichtung die mittlere Referenzlinie **563** so, dass die Differenz des Werts **566** der magnetischen Flussdichte **B₆₃**, der der mittleren Referenzlinie **563** zugeordnet ist, minus dem Wert **565** der magnetischen Flussdichte **B₆₂**, der der unteren Referenzlinie **562** zugeordnet ist, einem Faktor X mal der Differenz des Werts **564** der magnetischen Flussdichte **B₆₁**, der der oberen Referenzlinie **561** zugeordnet ist, minus des Werts **565** der magnetischen Flussdichte **B₆₂**, der der unteren Referenzlinie **562** zugeordnet ist, entspricht. Ein beispielhafte Werte für den Faktor X können 80% bis 50% oder 75% oder 70% etc. sein. Das hier vorgelegte Dokument schlägt vor, je nach Anwendung diesen Faktor X in der Entwicklungsphase durch einen DoE zu optimieren. (siehe auch https://de.wikipedia.org/wiki/Statistische_Versuchsplanung)

Der unteren Resonanzkante **522** ist dabei die untere Mikrowellenfrequenz ω _{µW22} zugeordnet.

Der oberen Resonanzkante **525** ist dabei die obere Mikrowellenfrequenz ω _{µW25} zugeordnet.

Dem mittleren Resonanzminimum **529** ist die Resonanzminimum-Mikrowellenfrequenz ω _{µW29} zugeordnet.

### Figur 52c

Figur 52c zeigt die Resonanzen einer Vielzahl unterschiedliche im Raum orientierter NV-Zentren umfassender Diamanten. Die Figur 52c zeigt in Diagramm **570** die Amplitude des Anteils an der der Intensität der Fluoreszenzstrahlung **FL** der Vielzahl der mit NV-Zentren versehenen Diamanten, bei dem der Anteil des Intensitätssignals der Fluoreszenzstrahlung **FL,** der der Mikrowellenmodulationsfrequenz **f_{µW}** aufweist, in Anhängigkeit von der Mikrowellenfrequenz ω _{µW} und bei konstanter wirksamer magnetischer Flussdichte **B_{w}** dargestellt ist. Die magnetischer Flussdichte **B** entspricht dabei in etwa dem Wert 0,003 der Y-Achse des Diagramms **520** der Figur 51b. Dabei ist die Mikrowellenfrequenz ω _{µW} in der X-Achse des Diagramms **570** aufgetragen. Die Amplitude des Anteils an der der Intensität der Fluoreszenzstrahlung **FL** der Vielzahl der mit NV-Zentren versehenen Diamanten, bei dem der Anteil des Intensitätssignals der Fluoreszenzstrahlung **FL,** der der Mikrowellenmodulationsfrequenz **f_{µW}** aufweist, ist in der Y-Achse des Diagramms **570** in willkürlichen Einheiten aufgetragen (englisch: "arbitrary units" oder abgekürzt "au"). In dem Beispiel ist eine Vielzahl unterschiedlich Im Raum orientierter Diamantkristalle gegenüber der Richtung der magnetischen Flussdichte **B** eines Magnetfelds unterschiedlich und typischerweise gleichverteilt ausgerichtet.

In der Figur 52c sind zur Orientierung die untere Resonanzkante **522** und die obere Resonanzkante **525** und die untere mittlere Resonanzkante **523** und die obere mittlere Resonanzkante **524** und das mittlere Resonanzminimum **529** mit Bezugszeichen versehen.

### Figur 52d

Die Figur 52d entspricht der Figur 52c, wobei nun wieder die verschiedenen Referenzlinien **(561, 562, 563)** zur Vermessung eingezeichnet sind. Ein Problem ist der Rauschuntergrund, den die Steuervorrichtung **CTR** unterdrücken muss.

Vorzugsweise legt die Steuervorrichtung **CTR** die obere Referenzlinie **561** so, dass der Wert **564** der magnetischen Flussdichte **B₆₁**, der der oberen Referenzlinie **561** zugeordnet ist, maximal ist und die obere Referenzlinie **561** mindestens einmal und nicht mehr als vier Mal von der erfassten Kurve gekreuzt wird. Vorzugsweise legt die Steuervorrichtung **CTR** die untere Referenzlinie **562** so, dass der Wert **565** der magnetischen Flussdichte **B₆₂**, der der unteren Referenzlinie **562** zugeordnet ist, minimal ist und die untere Referenzlinie **562** mindestens zweimal und nicht mehr als viermal von der erfassten Kurve gekreuzt wird. Bevorzugt wählt dann die Steuervorrichtung **CTR** der vorschlagsgemäßen Vorrichtung die mittlere Referenzlinie **563** so, dass die Differenz des Werts **566** der magnetischen Flussdichte **B₆₃**, der der mittleren Referenzlinie **563** zugeordnet ist, minus dem Wert **565** der magnetischen Flussdichte **B₆₂**, der der unteren Referenzlinie **562** zugeordnet ist, einem Faktor X mal der Differenz des Werts **564** der magnetischen Flussdichte **B₆₁**, der der oberen Referenzlinie **561** zugeordnet ist, minus des Werts **565** der magnetischen Flussdichte **B₆₂**, der der unteren Referenzlinie **562** zugeordnet ist, entspricht. Ein beispielhafte Werte für den Faktor X können 80% bis 50% oder 75% oder 70% etc. sein. Das hier vorgelegte Dokument schlägt vor, je nach Anwendung diesen Faktor X in der Entwicklungsphase durch einen DoE zu optimieren. (siehe auch https://de.wikipedia.org/wiki/Statistische_Versuchsplanung)

Der unteren Resonanzkante **522** ist dabei die untere Mikrowellenfrequenz ω _{µW22} zugeordnet.

Der unteren mittleren Resonanzkante **523** ist dabei die untere mittlere Mikrowellenfrequenz ω _{µW23} zugeordnet.

Der oberen mittleren Resonanzkante **524** ist dabei die obere mittlere Mikrowellenfrequenz ω _{µW24} zugeordnet.

Der oberen Resonanzkante **525** ist dabei die obere Mikrowellenfrequenz ω _{µW25} zugeordnet.

Dem mittleren Resonanzminimum **529** ist die Resonanzminimum-Mikrowellenfrequenz ω _{µW29} zugeordnet. Zusätzlich ist die Steigung **567** der Kurve eingezeichnet. Diese ist erst ab einer gewissen magnetischen Flussdichte B messbar.

### Figur 53a

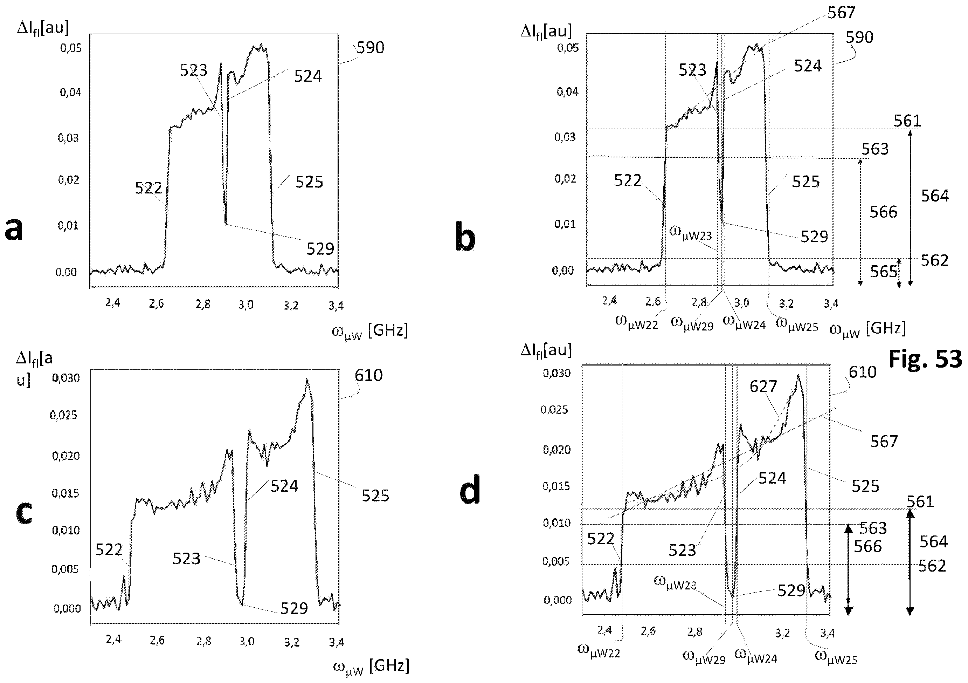

Figur 53a zeigt die Resonanzen einer Vielzahl unterschiedlich im Raum orientierter NV-Zentren umfassender Diamanten. Die Figur 53a zeigt in Diagramm **590** die Amplitude des Anteils an der der Intensität der Fluoreszenzstrahlung **FL** der Vielzahl der mit NV-Zentren versehenen Diamanten, bei dem der Anteil des Intensitätssignals der Fluoreszenzstrahlung **FL,** der die Mikrowellenmodulationsfrequenz **f_{µW}** aufweist, in Anhängigkeit von der Mikrowellenfrequenz ω _{µW} und bei konstanter wirksamer magnetischer Flussdichte **B_{w}** dargestellt ist. Die magnetischer Flussdichte **B** entspricht dabei in etwa dem Wert 0,07 der Y-Achse des Diagramms **520** der Figur 51b. Dabei ist die Mikrowellenfrequenz ω _{µW} in der X-Achse des Diagramms **590** aufgetragen. Die Amplitude des Anteils an der der Intensität **Iᵢₛₜ(t)** der Fluoreszenzstrahlung **FL** der Vielzahl der mit NV-Zentren versehenen Diamanten, bei dem der Anteil des Intensitätssignals der Fluoreszenzstrahlung **FL,** der der Mikrowellenmodulationsfrequenz **f_{µW}** aufweist, ist in der Y-Achse des Diagramms **590** in willkürlichen Einheiten aufgetragen (englisch: "arbitrary units" oder abgekürzt "au"). In dem Beispiel ist eine Vielzahl unterschiedlich Im Raum orientierter Diamantkristalle gegenüber der Richtung der magnetischen Flussdichte **B** eines Magnetfelds unterschiedlich und typischerweise gleichverteilt ausgerichtet.

In der Figur 53a sind zur Orientierung die untere Resonanzkante **522** und die obere Resonanzkante **525** und die untere mittlere Resonanzkante **523** und die obere mittlere Resonanzkante **524** und das mittlere Resonanzminimum **529** mit Bezugszeichen versehen.

### Figur 53b

Die Figur 53b entspricht der Figur 53a, wobei nun wieder die verschiedenen Referenzlinien **(561, 562, 563)** zur Vermessung eingezeichnet sind. Ein Problem ist der Rauschuntergrund, den die Steuervorrichtung **CTR** unterdrücken muss.

Vorzugsweise legt die Steuervorrichtung **CTR** die obere Referenzlinie **561** so, dass der Wert **564** der magnetischen Flussdichte **B₆₁**, der der oberen Referenzlinie **561** zugeordnet ist, maximal ist und die obere Referenzlinie **561** mindestens einmal und nicht mehr als vier Mal von der erfassten Kurve gekreuzt wird. Vorzugsweise legt die Steuervorrichtung **CTR** die untere Referenzlinie **562** so, dass der Wert **565** der magnetischen Flussdichte **B₆₂**, der der unteren Referenzlinie **562** zugeordnet ist, minimal ist und die untere Referenzlinie **562** mindestens zweimal und nicht mehr als viermal von der erfassten Kurve gekreuzt wird. Bevorzugt wählt dann die vorschlagsgemäße Vorrichtung die mittlere Referenzlinie **563** so, dass die Differenz des Werts **566** der magnetischen Flussdichte **B₆₃**, der der mittleren Referenzlinie **563** zugeordnet ist, minus dem Wert **565** der magnetischen Flussdichte **B₆₂**, der der unteren Referenzlinie **562** zugeordnet ist, einem Faktor X mal der Differenz des Werts **564** der magnetischen Flussdichte **B₆₁**, der der oberen Referenzlinie **561** zugeordnet ist, minus des Werts **565** der magnetischen Flussdichte **B₆₂**, der der unteren Referenzlinie **562** zugeordnet ist, entspricht. Ein beispielhafte Werte für den Faktor X können 80% bis 50% oder 75% oder 70% etc. sein. Das hier vorgelegte Dokument schlägt vor, je nach Anwendung diesen Faktor X in der Entwicklungsphase durch einen DoE zu optimieren. (siehe auch https://de.wikipedia.org/wiki/Statistische_Versuchsplanung)

Der unteren Resonanzkante **522** ist dabei die untere Mikrowellenfrequenz ω _{µW22} zugeordnet.

Der unteren mittleren Resonanzkante **523** ist dabei die untere mittlere Mikrowellenfrequenz ω _{µW23} zugeordnet. Der oberen mittleren Resonanzkante **524** ist dabei die obere mittlere Mikrowellenfrequenz ω _{µW24} zugeordnet. Der oberen Resonanzkante **525** ist dabei die obere Mikrowellenfrequenz ω _{µW25} zugeordnet.

Dem mittleren Resonanzminimum **529** ist die Resonanzminimum-Mikrowellenfrequenz ω _{µW29} zugeordnet. Zusätzlich ist die Steigung **567** der Kurve eingezeichnet.

Bevorzugt bestimmt die Steuervorrichtung **CTR** der Vorrichtung die Steigung **567** der Kurve in den zentralen Bereichen der Kurve zum Ersten zwischen der unteren Resonanzkante **522** und der unteren mittleren Resonanzkante **523** und zum Zweiten zwischen der oberen mittleren Resonanzkante **524** und der oberen Resonanzkante **525.** Vorzugseise verwendet die Steuervorrichtung **CTR** der Vorrichtung die Bereiche der Kurve in der Nähe der unteren Resonanzkante **522** und in der Nähe der unteren mittleren Resonanzkante **523** und in der Nähe der oberen mittleren Resonanzkante **524** und in der Nähe der oberen Resonanzkante **25** für die Bestimmung der Steigung **567** der Kurve nicht. Daher kann die Steuervorrichtung **CTR** der Vorrichtung die Steigung **567** der Kurve in der Regel erst ab einer bestimmten Mindestflussdichte B der magnetischen Flussdichte B bestimmen.

### Figur 53c

Figur 53c zeigt die Resonanzen einer Vielzahl unterschiedliche im Raum orientierter NV-Zentren umfassender Diamanten. Die Figur 53c zeigt in Diagramm **610** die Amplitude des Anteils an der der Intensität der Fluoreszenzstrahlung **FL** der Vielzahl der mit NV-Zentren versehenen Diamanten, bei dem der Anteil des Intensitätssignals der Fluoreszenzstrahlung **FL,** der der Mikrowellenmodulationsfrequenz **f_{µW}** aufweist, in Anhängigkeit von der Mikrowellenfrequenz ω _{µW} und bei konstanter wirksamer magnetischer Flussdichte **B_{w}** dargestellt ist. Die magnetischer Flussdichte **B** entspricht dabei in etwa dem Wert 0,124 der Y-Achse des Diagramms **520** der Figur 51b. Dabei ist die Mikrowellenfrequenz ω _{µW} in der X-Achse des Diagramms **610** aufgetragen. Die Amplitude des Anteils an der der Intensität **Iᵢₛₜ(t)** der Fluoreszenzstrahlung **FL** der Vielzahl der mit NV-Zentren versehenen Diamanten, bei dem der Anteil des Intensitätssignals der Fluoreszenzstrahlung **FL,** der der Mikrowellenmodulationsfrequenz **f_{µW}** aufweist, ist in der Y-Achse des Diagramms **610** in willkürlichen Einheiten aufgetragen (englisch: "arbitrary units" oder abgekürzt "au"). In dem Beispiel ist eine Vielzahl unterschiedlich Im Raum orientierter Diamantkristalle gegenüber der Richtung der magnetischen Flussdichte **B** eines Magnetfelds unterschiedlich und typischerweise gleichverteilt ausgerichtet.

In der Figur 53c sind zur Orientierung die untere Resonanzkante **522** und die obere Resonanzkante **525** und die untere mittlere Resonanzkante **523** und die obere mittlere Resonanzkante **524** und das mittlere Resonanzminimum **529** mit Bezugszeichen versehen.

### Figur 53d

Die Figur 53d entspricht der Figur 53c, wobei nun wieder die verschiedenen Referenzlinien **(561, 562, 563)** zur Vermessung eingezeichnet sind. Ein Problem ist der Rauschuntergrund, den die Steuervorrichtung **CTR** unterdrücken muss.

Vorzugsweise legt die Steuervorrichtung **CTR** die obere Referenzlinie **561** so, dass der Wert **564** der magnetischen Flussdichte **B₆₁**, der der oberen Referenzlinie **561** zugeordnet ist, maximal ist und die obere Referenzlinie **561** mindestens einmal und nicht mehr als vier Mal von der erfassten Kurve gekreuzt wird. Vorzugsweise legt die Steuervorrichtung **CTR** die untere Referenzlinie **562** so, dass der Wert **565** der magnetischen Flussdichte **B₆₂**, der der unteren Referenzlinie **562** zugeordnet ist, minimal ist und die untere Referenzlinie **562** mindestens zweimal und nicht mehr als viermal von der erfassten Kurve gekreuzt wird. Bevorzugt wählt dann die vorschlagsgemäße Vorrichtung die mittlere Referenzlinie **563** so, dass die Differenz des Werts **566** der magnetischen Flussdichte **B₆₃**, der der mittleren Referenzlinie **563** zugeordnet ist, minus dem Wert **565** der magnetischen Flussdichte **B₆₂**, der der unteren Referenzlinie **562** zugeordnet ist, einem Faktor X mal der Differenz des Werts **564** der magnetischen Flussdichte **B₆₁**, der der oberen Referenzlinie **561** zugeordnet ist, minus des Werts **565** der magnetischen Flussdichte **B₆₂**, der der unteren Referenzlinie **562** zugeordnet ist, entspricht. Ein beispielhafte Werte für den Faktor X können 80% bis 50% oder 75% oder 70% etc. sein. Das hier vorgelegte Dokument schlägt vor, je nach Anwendung diesen Faktor X in der Entwicklungsphase durch einen DoE zu optimieren. (siehe auch https://de.wikipedia.org/wiki/Statistische_Versuchsplanung)

Der unteren Resonanzkante **522** ist dabei die untere Mikrowellenfrequenz ω _{µW22} zugeordnet.

Der unteren mittleren Resonanzkante **523** ist dabei die untere mittlere Mikrowellenfrequenz ω _{µW23} zugeordnet. Der oberen mittleren Resonanzkante **524** ist dabei die obere mittlere Mikrowellenfrequenz ω _{µW24} zugeordnet. Der oberen Resonanzkante **525** ist dabei die obere Mikrowellenfrequenz ω _{µW25} zugeordnet.

Dem mittleren Resonanzminimum **529** ist die Resonanzminimum-Mikrowellenfrequenz ω _{µW29} zugeordnet. Zusätzlich ist die Steigung **567** der Kurve eingezeichnet.

Bevorzugt bestimmt die Steuervorrichtung **CTR** der Vorrichtung die Steigung **567** der Kurve in den zentralen Bereichen der Kurve zum Ersten zwischen der unteren Resonanzkante **522** und der unteren mittleren Resonanzkante **523** und zum Zweiten zwischen der oberen mittleren Resonanzkante **524** und der oberen Resonanzkante **525.** Vorzugseise verwendet die Steuervorrichtung **CTR** der Vorrichtung die Bereiche der Kurve in der Nähe der unteren Resonanzkante **522** und in der Nähe der unteren mittleren Resonanzkante **523** und in der Nähe der oberen mittleren Resonanzkante **524** und in der Nähe der oberen Resonanzkante **525** für die Bestimmung der Steigung **567** der Kurve nicht. Daher kann die Steuervorrichtung **CTR** der Vorrichtung die Steigung **567** der Kurve in der Regel erst ab einer bestimmten Mindestflussdichte B der magnetischen Flussdichte B bestimmen.

Zusätzlich ist eine er Polynomapproximation **627** der Kurve eingetragen, die typischerweise mittels eines Polynoms mit Polynomkoeffizienten beschrieben werden kann.

### Figur 54

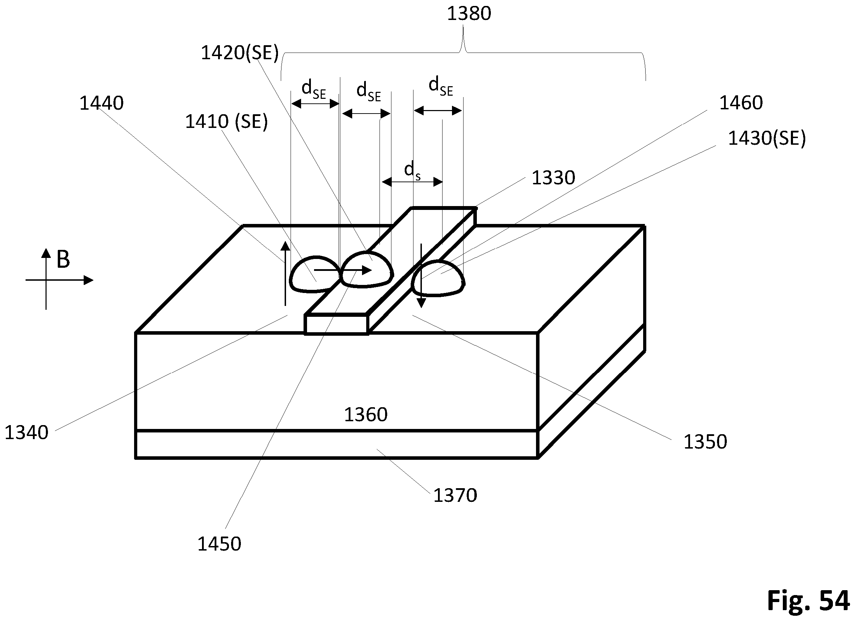

Figur 54 zeigt eine einzelne Mikrostreifenleitung **1380** als Beispiel einer Mikrostreifenleitung.

Das hier vorgelegte Dokument verweist hierzu beispielhaft auf das Buch R.K. Hoffmann "Integrierte Mikrowellenschaltungen: Elektrische Grundlagen, Dimensionierung, technische Ausführung, Technologien" Springer; 1. Edition (1. Juni 1983), ISBN-10: 3540123520, ISBN-13: 978-3540123521.

Dort sind verschiedene Mikrostreifenleitungen aufgeführt. Die Kombination der in diesem Dokument vorgestellten technischen Lehre mit einer Mikrostreifenleitungen beliebiger Ausführung ist von der hier vorgelegten Offenbarung umfasst.

Die beispielhafte einzelne Mikrostreifenleitung **1380** der Figur 54 umfasst ein vorzugsweise nicht oder nur wenig elektrisch leitendes oder dielektrisches oder halbleitendes Trägersubstrat **1360,** einen elektrisch leitenden Rückseitenkontakt **1370** auf der Unterseite des elektrisch nicht-leitenden Trägersubstrats **1360,** eine elektrisch leitende Signalleitung **1330** auf der Oberseite des elektrisch nicht-leitenden Trägersubstrats **1360.** Das Trägersubstrat **1360** kann beispielsweise eine Isolierschicht im Metallisierungsstapel eines mikrointegrierten Schaltkreises, insbesondere eines mikrointegrierten Hableiterschaltkreises, insbesondere eines CMOS- oder BiCMOS oder Bipolar-Schaltkreises oder eines Schaltkreises auf Basis von III/V-Materialien oder eine dielektrische Schicht sein. Beispielsweise kann das Trägersubstrat **1360**) aus Materialien wie FR-4 (Flameresistent-4) oder PTFE (Polytetrafluorethylen) oder aus halbleiten Materialien, wie beispielsweise Stücken von Halbleiterwafern, beispielsweise Stücken von CMOS-Wafern oder beispielsweise Stücken von BiCMOS-Wafern beispielsweise Stücken von Wafern aus einer Bipolar-Technologie oder Stücke eines Wafers aus einem III/V-Material oder dergleichen und/oder beispielsweise Stücken von MEMS-Wafern und/oder beispielsweise Stücken von MEOS-Wafern (MEOS= micro electro optical system) und/oder beispielsweise Stücken von MOEMS-Wafern etc. und/oder Stücke von MOEMS-Wafern mikroelektronische Schaltkreise und Funktionselemente und/oder mikrooptische Funktionselemente und/oder Mikromechanische Funktionselemente und/oder mikrofluidische Funktionselemente umfassen. Die einzelne Mikrostreifenleitung **1380** kann ggf. noch mit einer isolierenden Schicht bedeckt sein, wodurch sie zu einer eingebetteten Mikrostreifenleitung würde. Im Sinne der Knappheit der hier vorgestellten technischen Lehre haben wir darauf verzichtet, diese Variante hier darzustellen. Sie ist aber von der Offenbarung des hier vorgelegten Dokuments umfasst. Bei der beispielhaften einzelne Mikrostreifenleitung **1380** der Figur 54 trennt eine elektrisch im Wesentlichen nicht-leitende linke Isolationsfläche **1340** die elektrisch leitende Signalleitung **1330** von anderen Schaltungsteilen auf dem Trägersubstrat **1360.** Außerdem trennt eine elektrisch im Wesentlichen nicht-leitende rechte Isolationsfläche **1350** die elektrisch leitende Signalleitung **1330** ebenfalls von anderen Schaltungsteilen auf dem Trägersubstrat **1360.** Bevorzugt weist die einzelne Mikrostreifenleitung **1380** bezogen auf die elektrisch leitende Signalleitung **1330** als "heißen" Innenleiter und den elektrisch leitenden Rückseitenkontakt **1370** als Masseelektrode einen Wellenwiderstand aufm der bevorzugt zu dem Ausgangswellenwiderstand der Mikrowellensignalquelle **µWG** passt.

Vorschlagsgemäß wurde erkannt, dass die Platzierung und die Größe des Sensorelements **SE** relativ zur elektrisch leitende Signalleitung **1330** ausschlaggebend für die Richtungsempfindlichkeit der Fluoreszenzstrahlung **FL** der NV-Zentren in den Diamant-Nano-Kristallen **ND** des Sensorelements **SE** in Bezug auf die Richtung einer externen magnetischen Flussdichte **Bₑₓₜ** ist.

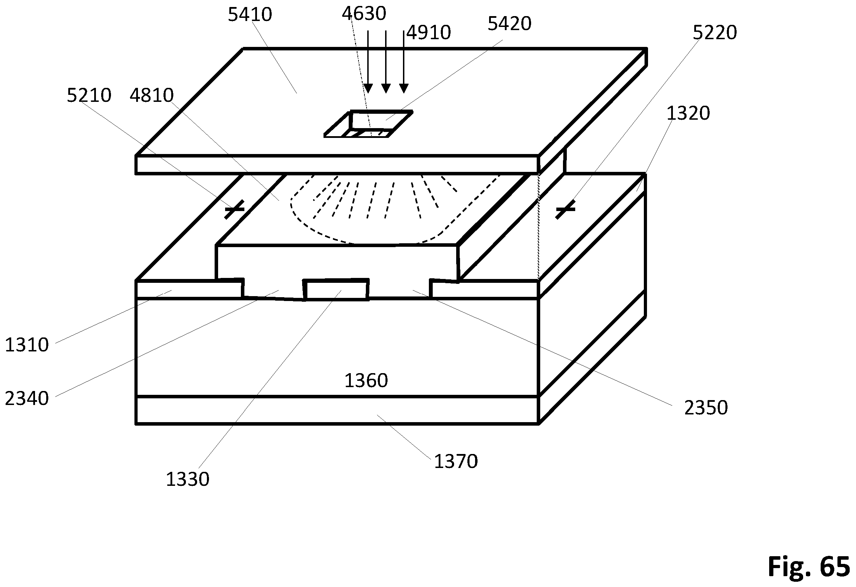

Bei Platzierung des Sensorelements **SE auf** bzw. oberhalb der elektrisch leitende Signalleitung **1330** (Siehe folgende Figur 65.) ist der Vektor der magnetischen Flussdichte des Mikrowellenfeldes des Mikrowellensignals **µW**, das die Mikrowellensignalquelle **µWG** in die Signalleitung **1330** einspeist, im Wesentlichen parallel zur Oberfläche des elektrisch nicht-leitenden Trägersubstrats **1360** und quer zur Richtung der Signalleitung **1330** im Bereich des Sensorelements **SE.** Dadurch ist die Fluoreszenzstrahlung **FL** der NV-Zentren in den Diamant-Nano-Kristallen **ND** des Sensorelements **SE** im Wesentlichen empfindlich gegenüber dem wirksamen Anteil **Bw** der externen magnetischen Flussdichte **Bₑₓₜ,** dessen Flussdichtevektor **senkrecht** zur Oberfläche des elektrisch nicht-leitenden Trägersubstrats **1360** innerhalb des Sensorelements **SE** ist und/oder dessen Flussdichtevektor **parallel** zur Signalleitung **1360** ist.

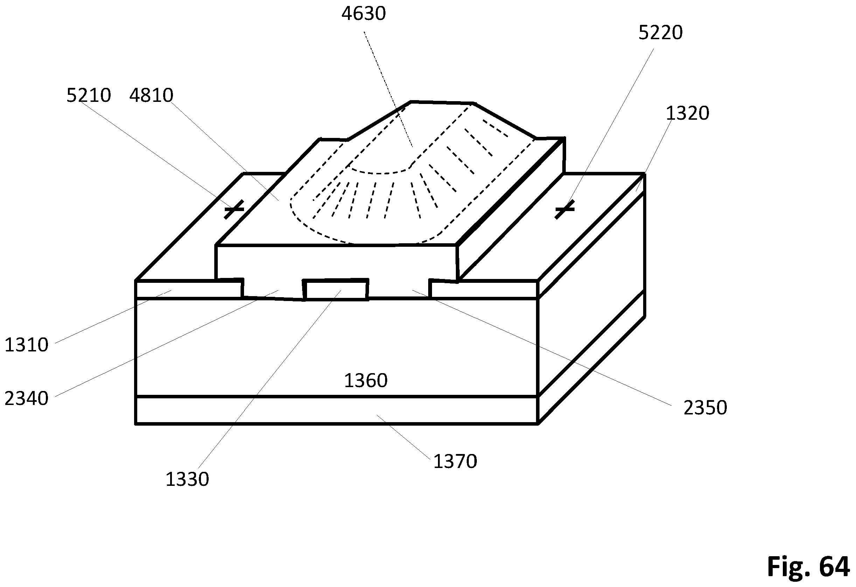

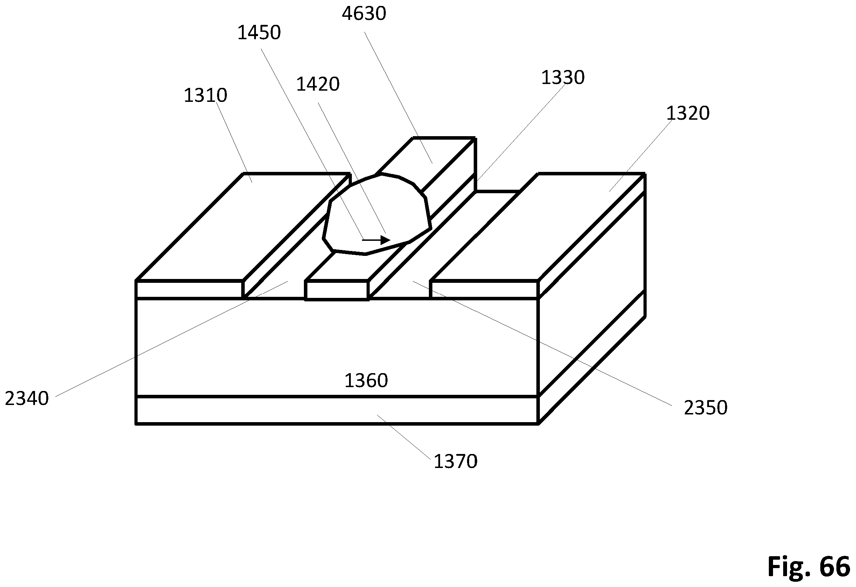

Bei Platzierung des Sensorelements **SE direkt neben** der elektrisch leitenden Signalleitung **1330** (Siehe auch folgende Figur 64 und folgende Figur 66.) ist der Vektor **1440** der magnetische Flussdichte des Mikrowellenfeldes des Mikrowellensignals **µW**, das die Mikrowellensignalquelle **µWG** in die Signalleitung **1330** einspeist, im Wesentlichen senkrecht zur Oberfläche des elektrisch nicht-leitenden Trägersubstrats **1360** innerhalb des Sensorelements **SE.** Dadurch ist die Fluoreszenzstrahlung **FL** der NV-Zentren in den Diamant-Nano-Kristallen **ND** des Sensorelements **SE** im Wesentlichen empfindlich gegenüber dem wirksamen Anteil **B_{W}** der externen magnetischen Flussdichte **Bₑₓₜ**, dessen Flussdichtevektor **parallel** zur Oberfläche des elektrisch nicht-leitenden Trägersubstrats **1360** innerhalb des Sensorelements **SE** ist.

Die Ausarbeitung des Vorschlags der technischen Lehre des hier vorgelegten Dokuments ergab somit als eine wesentliche Idee der hier vorgestellten technischen Lehre, dass
a. die Positionierung des Sensorelements **SE** relativ zur elektrisch leitende Signalleitung **1330** eine Einstellung einer Vorzugsrichtung der Empfindlichkeit ermöglicht,
   i. wenn der Durchmesser **d_{SE}** des Sensorelements **SE** um nicht mehr als 50%, besser nicht mehr als 25%, noch besser nicht mehr als 10%, noch besser nicht mehr als 5%, besser nicht mehr als 2%, noch besser nicht mehr als 1% die Breite **ds** der elektrisch leitenden Signalleitung **1330** überschreitet oder
   ii. wenn besonders bevorzugt der der Durchmesser **d_{SE}** des Sensorelements **SE** die Breite **d_{S}** der elektrisch leitenden Signalleitung **1330** um mehr als 1%, besser mehr als 2%, besser mehr als 5%, besser mehr als 10%, besser mehr als 25%, besser mehr als 50%, besser mehr als 75% unterschreitet.
b. die Positionierung des Sensorelements **SE** relativ zur elektrisch leitende Signalleitung **1330** eine unbeabsichtigte Einstellung einer Vorzugsrichtung der Empfindlichkeit unterdrückt,
   i. wenn der Durchmesser **d_{SE}** des Sensorelements **SE** um mehr als 1%, besser mehr als 2%, noch besser mehr als 5%, noch besser mehr als 10%, noch besser mehr als 25%, noch besser mehr als 50%, noch besser mehr als 75%, noch besser mehr als 100% die Breite d_{S} der elektrisch leitenden Signalleitung **1330** überschreitet

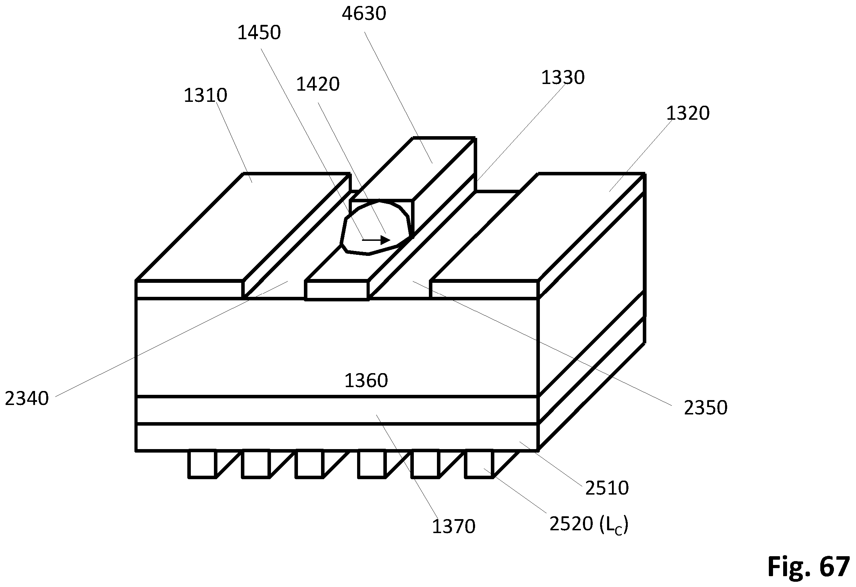

Die technische Lehre des hier vorgelegten Dokuments hat also erkannt, dass der Durchmesser **d_{SE}** des Sensorelements **SE** relativ zu Breite **d_{S}** der elektrisch leitenden Signalleitung **1330** und die Positionierung des Sensorelements **SE** relativ zur elektrisch leitende Signalleitung **1330** einer einzelnen Mikrostreifenleitung **1380** die Richtungsempfindlichkeit der Intensität der mikrowellenabhängigen Fluoreszenzstrahlung FL der NV-Zentren in den Diamant-Nano-Kristallen **ND** des Sensorelements **SE** gegenüber dem wirksamen Anteil **B_{W}** der externen magnetischen Flussdichte **Bₑₓₜ**, bezogen auf die Ausrichtung des Flussdichtevektors innerhalb des Sensorelements **SE** relativ zur Oberfläche des elektrisch nicht-leitenden Trägersubstrats **1360** vorhersagbar einstellen kann und dass gleichzeitig die Wahl dieser Parameter (Position **SE** und **dₛ**) bestimmt, in welchem Maße sich diese Richtungsabhängigkeit ausprägt. Dabei kann diese Richtungsabhängigkeit auch komplett unterdrückt werden. (Siehe auch die folgende Figur 67.)

Das linke Sensorelement **1410** ist als Sensorelement **SE** links der elektrisch leitenden Signalleitung **1330** eingezeichnet.

In dem Beispiel der Figur 54 ist der Durchmesser **d_{SE}** des Sensorelements **SE** beispielhaft vergleichbar mit der Breite **dₛ** der elektrisch leitenden Signalleitung **1330.** Zur besseren Klarheit ist die Richtung des Vektors **1440** der magnetische Flussdichte des Mikrowellenfeldes des Mikrowellensignals **µW**, das die Mikrowellensignalquelle **µWG** in die Signalleitung **1330** einspeist, in die Figur 54 im Bereich des Sensorelements **SE** eingezeichnet. Die Fluoreszenzstrahlung **FL** der NV-Zentren in den Diamant-Nano-Kristallen **ND** des Sensorelements **SE (1410)** ist im Wesentlichen empfindlich gegenüber dem wirksamen Anteil **B_{W}** der externen magnetischen Flussdichte **Bₑₓₜ**, dessen Flussdichtevektor **parallel** zur Oberfläche des elektrisch nicht-leitenden Trägersubstrats **1360** innerhalb des Sensorelements **SE.** Das Sensorelement **SE (1410)** umfasst ein Trägermaterial **TM** in das die Diamant-Nano-Kristallen **ND** mit den NV-Zentren typischerweise innerhalb des Sensorelements **SE** eingebettet sind.

Das mittlere Sensorelement **1420** ist als Sensorelement **SE** auf der elektrisch leitenden Signalleitung **1310** eingezeichnet.

In dem Beispiel der Figur 54 ist der Durchmesser **d_{SE}** des Sensorelements **SE** beispielhaft vergleichbar mit der Breite **dₛ** der elektrisch leitenden Signalleitung **1330.** Zur besseren Klarheit ist die Richtung des Vektors **1450** der magnetische Flussdichte des Mikrowellenfeldes des Mikrowellensignals **µW**, das die Mikrowellensignalquelle **µWG** in die Signalleitung **1330** einspeist, in die Figur 54 im Bereich des Sensorelements **SE** eingezeichnet. Die Fluoreszenzstrahlung **FL** der NV-Zentren in den Diamant-Nano-Kristallen **ND** des mittleren Sensorelements **SE (1420)** ist im Wesentlichen empfindlich gegenüber dem wirksamen Anteil **B_{W}** der externen magnetischen Flussdichte **Bₑₓₜ**, dessen Flussdichtevektor **senkrecht** zur Oberfläche des elektrisch nicht-leitenden Trägersubstrats **1360** innerhalb des Sensorelements **SE** und/oder dessen Flussdichtevektor **parallel** zur Signalleitung **1360** ist. Das Sensorelement **SE (1420)** umfasst ein Trägermaterial **TM** in das die Diamant-Nano-Kristallen **ND** mit den NV-Zentren typischerweise innerhalb des Sensorelements **SE** eingebettet sind.

Das rechte Sensorelement **1430** ist als Sensorelement **SE** rechts der elektrisch leitenden Signalleitung **1330** eingezeichnet

In dem Beispiel der Figur 54 ist der Durchmesser **d_{SE}** des Sensorelements **SE** beispielhaft vergleichbar mit der Breite **dₛ** der elektrisch leitenden Signalleitung **1330.** Zur besseren Klarheit ist die Richtung des Vektors **1460** der magnetische Flussdichte des Mikrowellenfeldes des Mikrowellensignals **µW**, das die Mikrowellensignalquelle **µWG** in die Signalleitung **1330** einspeist, in die Figur 54 im Bereich des Sensorelements **SE** eingezeichnet. Die Fluoreszenzstrahlung **FL** der NV-Zentren in den Diamant-Nano-Kristallen **ND** des Sensorelements **SE (1430)** ist im Wesentlichen empfindlich gegenüber dem wirksamen Anteil **B_{W}** der externen magnetischen Flussdichte **Bₑₓₜ**, dessen Flussdichtevektor **parallel** zur Oberfläche des elektrisch nicht-leitenden Trägersubstrats **1360** innerhalb des Sensorelements **SE.** Das Sensorelement **SE (1430)** umfasst ein Trägermaterial **TM** in das die Diamant-Nano-Kristallen **ND** mit den NV-Zentren typischerweise innerhalb des Sensorelements **SE** eingebettet sind.

In verschiedenen Ausprägungen können mehrere der Sensorelemente **(1410, 1420, 1430)** weggelassen werden, um die Richtungssensitivität zu erzielen.

### Figur 55

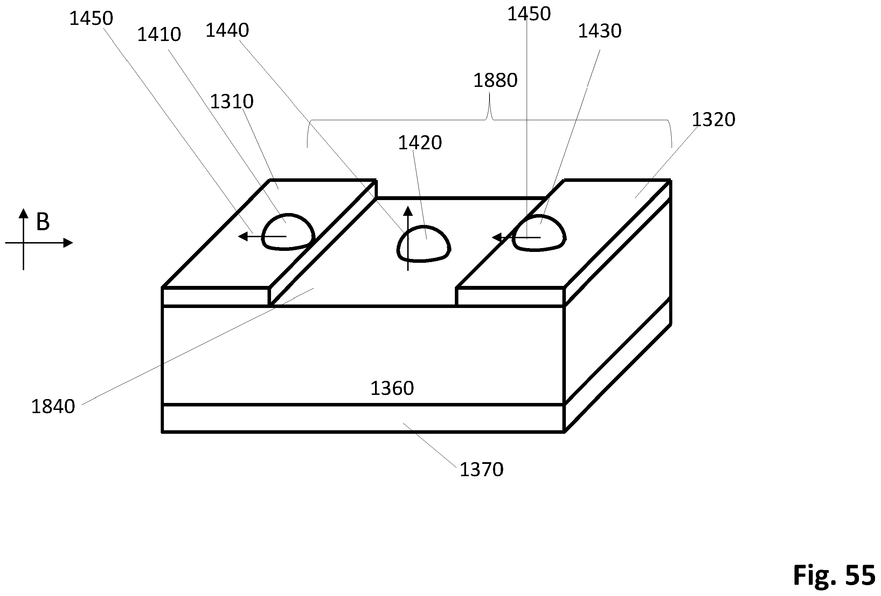

Figur 55 zeigt eine einzelne Schlitzleitung **1880** als Beispiel einer Schlitzleitung.

Das hier vorgelegte Dokument verweist hierzu beispielhaft auf das Buch R.K. Hoffmann "Integrierte Mikrowellenschaltungen: Elektrische Grundlagen, Dimensionierung, technische Ausführung, Technologien" Springer; 1. Edition (1. Juni 1983), ISBN-10: 3540123520, ISBN-13: 978-3540123521.

Dort sind verschiedene Schlitzleitungen aufgeführt. Die Kombination der in diesem Dokument vorgestellten technischen Lehre mit einer Mikrostreifenleitungen beliebiger Ausführung ist von der hier vorgelegten Offenbarung umfasst.

Die beispielhafte einzelne Schlitzleitung **1880** der Figur 55 umfasst ein vorzugsweise nicht oder nur wenig elektrisch leitendes Trägersubstrat **1360,** einen elektrisch leitenden Rückseitenkontakt **1370** auf der Unterseite des elektrisch nicht-leitenden Trägersubstrats **1360,** eine elektrisch leitende linke Signalmassefläche **1310** auf der Oberseite des elektrisch nicht leitenden Trägersubstrats **1360** und eine elektrisch leitende rechte Signalmassefläche **1320** auf der Oberseite des elektrisch nicht leitenden Trägersubstrats **1360.** Das Trägersubstrat **1360** kann beispielsweise eine Isolierschicht im Metallisierungsstapel eines mikrointegrierten Schaltkreises, insbesondere eines mikrointegrierten Hableiterschaltkreises, insbesondere eines CMOS- oder BiCMOS oder Bipolar-Schaltkreises oder eines Schaltkreises auf Basis von III/V-Materialien oder ein dielektrisches Trägersubstrat **1360** dergleichen sein. Die elektrisch leitende linke Signalmassefläche **1310** und die elektrisch leitende rechte Signalmassefläche **1320** können ggf. noch mit einer isolierenden Schicht bedeckt sein, wodurch sie zu einer eingebetteten Schlitzleitung würden. Im Sinne der Knappheit der hier vorgestellten technischen Lehre haben wir darauf verzichtet, diese Variante hier darzustellen. Sie ist aber von der Offenbarung des hier vorgelegten Dokuments umfasst. Bei der beispielhaften einzelne Schlitzleitung **1880** der Figur 55 trennt eine elektrisch im Wesentlichen nicht-leitende Isolationsfläche **1840** - der Schlitz -die elektrisch leitende linke Signalmassefläche **1310** von der die elektrisch leitenden rechten Signalmassefläche **1320** auf dem Trägersubstrat **1360.** Bevorzugt weist die einzelne Schlitzleitung **1880** bezogen auf den Schlitz **1840** als "heißen" Innenleiter und den elektrisch leitenden Rückseitenkontakt **1370** als Masseelektrode einen Wellenwiderstand auf, der bevorzugt zu dem Ausgangswellenwiderstand der Mikrowellensignalquelle **µWG** passt.

Vorschlagsgemäß wurde erkannt, dass die Platzierung und die Größe des Sensorelements **SE** relativ zur elektrisch leitende linke Signalmassefläche **1310** und die elektrisch leitende rechte Signalmassefläche **1320** und zum Schlitz **1840** ausschlaggebend für die Richtungsempfindlichkeit der Fluoreszenzstrahlung **FL** der NV-Zentren in den Diamant-Nano-Kristallen **ND** des Sensorelements **SE** in Bezug auf die Richtung einer externen magnetischen Flussdichte **Bₑₓₜ** ist.

Bei Platzierung eines oder mehrerer Sensorelemente **SE auf** bzw. oberhalb der elektrisch leitenden linken Signalmassefläche **1310** und/oder **auf** bzw. oberhalb der elektrisch leitenden rechten Signalmassefläche **1320** ist der jeweilige Vektor der magnetische Flussdichte des Mikrowellenfeldes des Mikrowellensignals **µW,** das die Mikrowellensignalquelle **µWG** in die Schlitzleitung **1880** einspeist, im Wesentlichen parallel zur Oberfläche des elektrisch nicht-leitenden Trägersubstrats **1360** im Bereich des jeweiligen Sensorelements **SE.** Dadurch ist die Fluoreszenzstrahlung **FL** der NV-Zentren in den Diamant-Nano-Kristallen **ND** des jeweiligen Sensorelements **SE** im Wesentlichen empfindlich gegenüber dem wirksamen Anteil **B_{W}** der externen magnetischen Flussdichte **Bₑₓₜ**, dessen Flussdichtevektor **senkrecht** zur Oberfläche des elektrisch nicht-leitenden Trägersubstrats **1360** oder dessen Flussdichtevektor **parallel** zum Schlitz **1840** der Schlitzleitung **1880** innerhalb des jeweiligen Sensorelements **SE** ist.

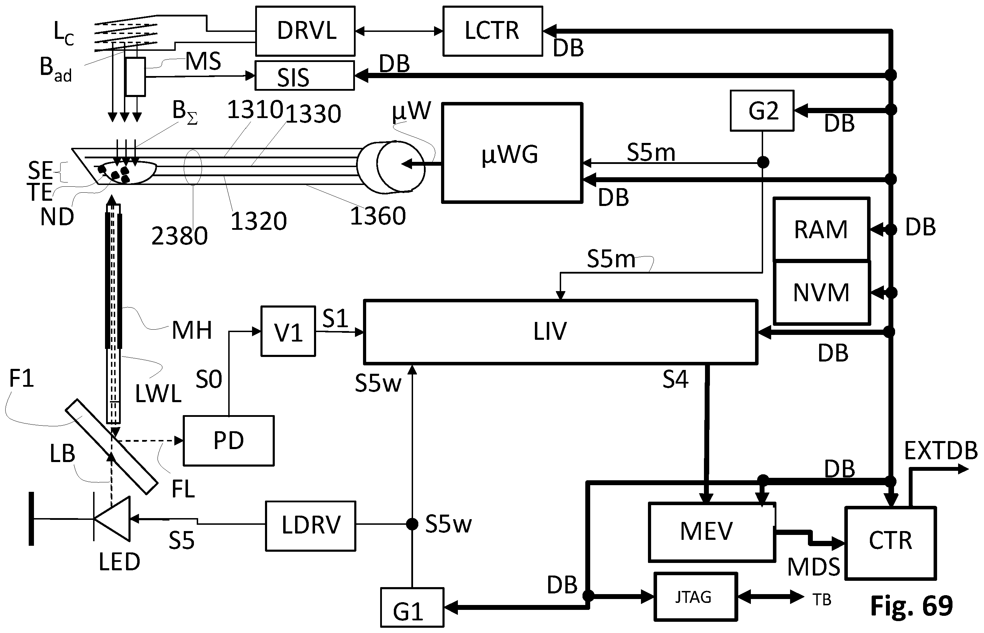

Bei Platzierung des Sensorelements **SE direkt innerhalb** des Schlitzes **1840** der Schlitzleitung **1880** (Siehe auch folgende Figur 69.) ist der Vektor **1440** der magnetische Flussdichte des Mikrowellenfeldes des Mikrowellensignals **µW,** das die Mikrowellensignalquelle **µWG** in die Schlitzleitung **1880** einspeist, im Wesentlichen senkrecht zur Oberfläche des elektrisch nicht-leitenden Trägersubstrats **1360** innerhalb des Sensorelements **SE.** Dadurch ist die Fluoreszenzstrahlung **FL** der NV-Zentren in den Diamant-Nano-Kristallen **ND** des Sensorelements **SE** im Wesentlichen empfindlich gegenüber dem wirksamen Anteil **B_{W}** der externen magnetischen Flussdichte **Bₑₓₜ**, dessen Flussdichtevektor **parallel** zur Oberfläche des elektrisch nicht-leitenden Trägersubstrats **1360** innerhalb des Sensorelements **SE** ist.

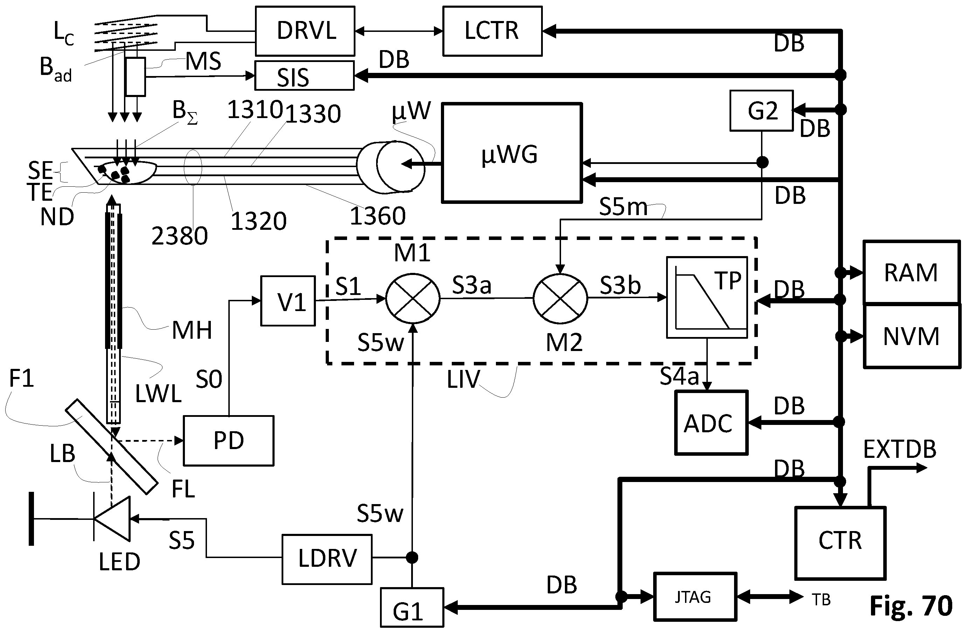

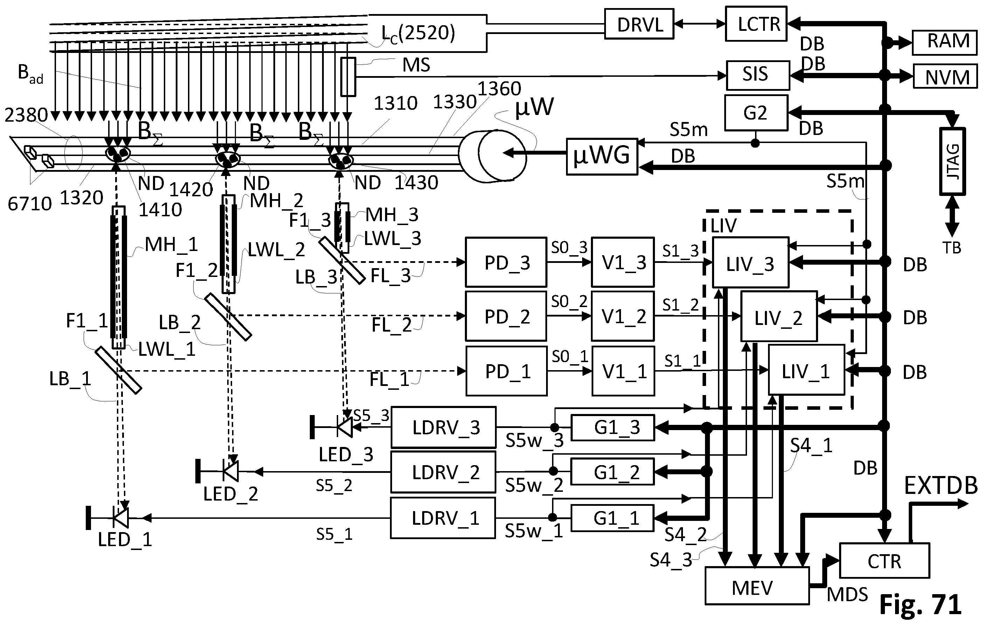

Die Ausarbeitung des Vorschlags der technischen Lehre des hier vorgelegten Dokuments ergab somit als eine wesentliche Idee der hier vorgestellten technischen Lehre, dass
a. die Positionierung des Sensorelements **SE** relativ zum Schlitz **1840** der Schlitzleitung **1880** eine Einstellung einer Vorzugsrichtung der Empfindlichkeit ermöglicht,
   iii. wenn der Durchmesser **d_{SE}** des Sensorelements **SE** um nicht mehr als 50%, besser nicht mehr als 25%, noch besser nicht mehr als 10%, noch besser nicht mehr als 5%, besser nicht mehr als 2%, noch besser nicht mehr als 1% die Breite **d_{SL}** des Schlitzes **1840** der Schlitzleitung **1880** überschreitet oder
   iv. wenn besonders bevorzugt der der Durchmesser **d_{SE}** des Sensorelements **SE** die Breite **d_{SL}** des Schlitzes **1840** der Schlitzleitung **1880** um mehr als 1%, besser mehr als 2%, besser mehr als 5%, besser mehr als 10%, besser mehr als 25%, besser mehr als 50%, besser mehr als 75% unterschreitet.
b. die Positionierung des Sensorelements **SE** relativ zum Schlitz **1840** der Schlitzleitung **1880** eine unbeabsichtigte Einstellung einer Vorzugsrichtung der Empfindlichkeit unterdrückt,
   ii. wenn der Durchmesser **d_{SE}** des Sensorelements **SE** um mehr als 1%, besser mehr als 2%, noch besser mehr als 5%, noch besser mehr als 10%, noch besser mehr als 25%, noch besser mehr als 50%, noch besser mehr als 75%, noch besser mehr als 100% die Breite **d_{SL}** des Schlitzes **1840** der Schlitzleitung **1880** überschreitet und
   iii. wenn Sensorelements **SE** relativ zum Schlitz **1840** der Schlitzleitung **1880** vorzugsweise so positioniert ist, dass das Sensorelement **SE** die elektrisch leitende linke Signalmassefläche **1310** und die elektrisch leitende rechte Signalmassefläche **1320** (Siehe folgende Figuren 70 und 71.) bevorzugt in gleicher Weise mit überdeckt.

Die technische Lehre des hier vorgelegten Dokuments hat also erkannt, dass der Durchmesser **d_{SE}** des Sensorelements **SE** relativ zu Breite **d_{SL}** des Schlitzes **1840** der Schlitzleitung **1880** und die Positionierung des Sensorelements **SE** relativ zum Schlitz **1840** der Schlitzleitung **1880** die Richtungsempfindlichkeit der Intensität der mikrowellenabhängigen Fluoreszenzstrahlung **FL** der NV-Zentren in den Diamant-Nano-Kristallen **ND** des Sensorelements **SE** gegenüber dem wirksamen Anteil **B_{W}** der externen magnetischen Flussdichte **Bₑₓₜ**, bezogen auf die Ausrichtung des Flussdichtevektors innerhalb des Sensorelements **SE** relativ zur Oberfläche des elektrisch nicht-leitenden Trägersubstrats **1360** vorhersagbar einstellen kann und dass gleichzeitig die Wahl dieser Parameter (Position **SE** und **d_{SL}**) bestimmt, in welchem Maße sich diese Richtungsabhängigkeit ausprägt. Dabei kann diese Richtungsabhängigkeit auch komplett unterdrückt werden.

Ein mittleres Sensorelement **1420** ist als Sensorelement **SE** in den Schlitz **1840** der Schlitzleitung **1880** eingezeichnet.

In dem Beispiel der Figur 55 ist der Durchmesser **d_{SE}** des mittleren Sensorelements **SE(1420)** beispielhaft kleiner als die Breite **d_{SL}** des Schlitzes **1840** der Schlitzleitung **1880.** Zur besseren Klarheit ist die Richtung des Vektors **1450** der magnetische Flussdichte des Mikrowellenfeldes des Mikrowellensignals **µW,** das die Mikrowellensignalquelle **µWG** in die Schlitzleitung **1880** einspeist, in die Figur 55 im Bereich des mittleren Sensorelements **SE(1420)** eingezeichnet. Die Fluoreszenzstrahlung **FL** der NV-Zentren in den Diamant-Nano-Kristallen **ND** des mittleren Sensorelements **SE(1420)** ist im Wesentlichen empfindlich gegenüber dem wirksamen Anteil **B_{W}** der externen magnetischen Flussdichte **Bₑₓₜ**, dessen Flussdichtevektor **parallel** zur Oberfläche des elektrisch nicht-leitenden Trägersubstrats **1360** innerhalb des mittleren Sensorelements **SE(1420).** Das mittlere Sensorelement **SE (1420)** umfasst ein Trägermaterial **TM** in das die Diamant-Nano-Kristallen **ND** mit den NV-Zentren typischerweise innerhalb des Sensorelements **SE** eingebettet sind.

Ein linkes Sensorelement **1410** ist als Sensorelement **SE** auf der elektrisch leitenden linken Signalmassefläche **1310** der beispielhaften Schlitzleitung **1880** eingezeichnet.

In dem Beispiel der Figur 70 ist der Durchmesser **d_{SE}** des linken Sensorelements **SE(1410)** beispielhaft kleiner als die Breite **d_{SL}** des Schlitzes **1840** der Schlitzleitung **1880.** Zur besseren Klarheit ist die Richtung des Vektors **1450** der magnetische Flussdichte des Mikrowellenfeldes des Mikrowellensignals **µW,** das die Mikrowellensignalquelle **µWG** in die Schlitzleitung **1880** einspeist, in die Figur 55 im Bereich des linken Sensorelements **SE** eingezeichnet. (Wir haben hier das Bezugszeichen **1450** gewählt, da die Empfindlichkeit sich auf Anteile der magnetischen Flussdichte des Mikrowellenfeldes senkrecht zur Oberfläche des Trägersubstrats **1370** bezieht.) Die Fluoreszenzstrahlung **FL** der NV-Zentren in den Diamant-Nano-Kristallen **ND** des linken Sensorelements **SE(1420)** ist im Wesentlichen empfindlich gegenüber dem wirksamen Anteil **B_{W}** der externen magnetischen Flussdichte **Bₑₓₜ**, dessen Flussdichtevektor **senkrecht** zur Oberfläche des elektrisch nicht-leitenden Trägersubstrats **1360** oder dessen Flussdichtevektor **parallel** zum Schlitz **1840** der Schlitzleitung **1880** innerhalb des linken Sensorelements **SE.** Das linke Sensorelement **SE (1420)** umfasst ein Trägermaterial **TM** in das die Diamant-Nano-Kristallen **ND** mit den NV-Zentren typischerweise innerhalb des Sensorelements **SE** eingebettet sind.

Ein rechtes Sensorelement **1430** ist als Sensorelement **SE** auf der elektrisch leitenden rechten Signalmassefläche **1320** der beispielhaften Schlitzleitung **1880** eingezeichnet.

In dem Beispiel der Figur 55 ist der Durchmesser **d_{SE}** des rechten Sensorelements **SE** beispielhaft kleiner als die Breite **d_{SL}** des Schlitzes **1840** der Schlitzleitung **1880.** Zur besseren Klarheit ist die Richtung des Vektors **1450** der magnetische Flussdichte des Mikrowellenfeldes des Mikrowellensignals **µW,** das die Mikrowellensignalquelle **µWG** in die Schlitzleitung **1880** einspeist, in die Figur 55 im Bereich des rechten Sensorelements **SE** eingezeichnet. Die Fluoreszenzstrahlung **FL** der NV-Zentren in den Diamant-Nano-Kristallen **ND** des Sensorelements **SE (1430)** ist im Wesentlichen empfindlich gegenüber dem wirksamen Anteil **B_{W}** der externen magnetischen Flussdichte **Bₑₓₜ**, dessen Flussdichtevektor **parallel** zur Oberfläche des elektrisch nicht-leitenden Trägersubstrats **1350** innerhalb des rechten Sensorelements **SE.** Das rechte Sensorelement **SE (1430)** umfasst ein Trägermaterial **TM** in das die Diamant-Nano-Kristallen **ND** mit den NV-Zentren typischerweise innerhalb des Sensorelements **SE** eingebettet sind.

### Figur 56

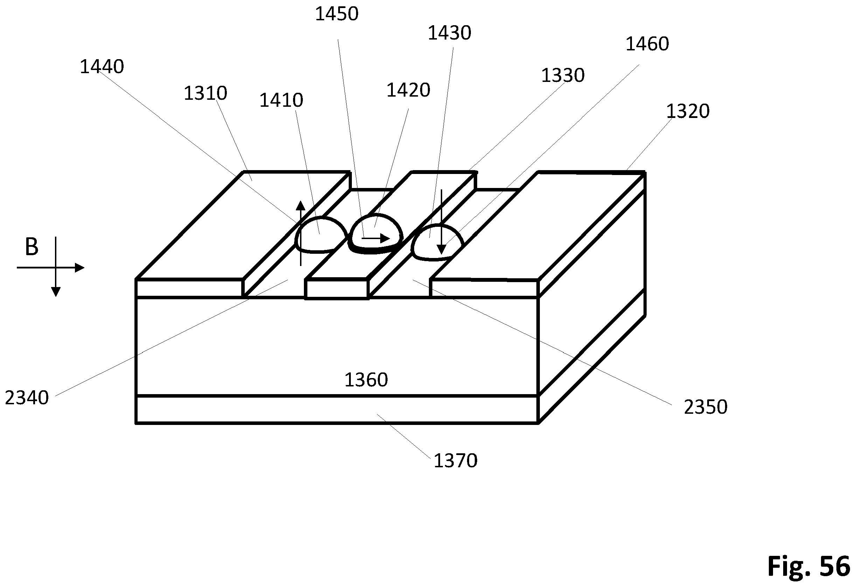

Die Figur 56 zeigt verschiedene Platzierungen verschiedener Sensorelemente im Zusammenhang mit einer beispielhaften Tri-Plate-Leitung **2380.** In analoger Weise können statt einer Tri-Plate-Leitung **2380** auch eine Mikrostreifenleitung **1380** oder eine Schlitzleitung **1880** verwendet werden.

Die fachlich ausgebildete Person erhält aus der Figur 56 die korrespondierende Figur mit einer Mikrostreifenleitung **1380,** durch Weglassen der elektrisch leitenden linken Signalmassefläche **1310** der beispielhaften Triplate-Leitung **2380** und durch Weglassen der elektrisch leitenden rechten Signalmassefläche **1320** der beispielhaften Triplate-Leitung **2380.** Hierdurch wird dann die nicht-leitende linke Isolationslücke **2340** zur elektrisch im Wesentlichen nicht-leitenden linken Isolationsfläche **1340.** Hierdurch wird dann auch die nicht-leitende recht Isolationslücke **2350** zur elektrisch im Wesentlichen nicht-leitenden linken Isolationsfläche **1350.**

Die fachlich ausgebildete Person erhält aus der Figur 56 die korrespondierende Figur mit einer Schlitzleitung **1880,** durch Weglassen des Signalleiters **1330** der beispielhaften Triplate-Leitung **2380.** Hierdurch wird dann die nicht-leitende linke Isolationslücke **2340** und die nicht-leitende recht Isolationslücke **2350** zum elektrisch im Wesentlichen nicht-leitenden Schlitz **1840** der Schlitzleitung **1880.**

Zur Reduktion des Aufwands beschreibt der folgende Text der Beschreibung der Figur 56 daher stellvertretend nur die Tri-Plate Leitung **2380** stellvertretend für andere Typen von Streifenleitungen, wie der Streifenleitung **1380** oder der Schlitzleitung **1880.** Andere Leitungstypen insbesondere planarer Wellenleitungen sind daher von der Offenbarung umfasst.

Figur 56 zeigt eine Tri-Plate-Leitung **2380** als Beispiel einer Mikrostreifenleitung.

Das hier vorgelegte Dokument verweist hierzu beispielhaft auf das Buch R.K. Hoffmann "Integrierte Mikrowellenschaltungen: Elektrische Grundlagen, Dimensionierung, technische Ausführung, Technologien" Springer; 1. Edition (1. Juni 1983), ISBN-10: 3540123520, ISBN-13: 978-3540123521.

Dort sind verschiedene Mikrostreifenleitungen aufgeführt. Die Verwendung der dort beschriebenen Mikrostreifenleitungen als Mikrostreifenleitung in einer Vorrichtung im Sinne des hier vorgelegten Dokuments ist hiermit offengelegt.

Die beispielhafte Tri-Plate-Leitung **2380** der Figur 56 umfasst ein vorzugsweise nicht oder nur wenig elektrisch leitendes Trägersubstrat **1360,** einen elektrisch leitenden Rückseitenkontakt **1370** auf der Unterseite des elektrisch leitenden Trägersubstrats **1360,** eine elektrisch leitende linke Signalmassefläche **1310** auf der Oberseite des elektrisch leitenden Trägersubstrats **1360,** eine elektrisch leitende rechte Signalmassefläche **1320** auf der Oberseite des elektrisch leitenden Trägersubstrats **1360,** eine elektrisch leitende Signalleitung **1330** auf der Oberseite des elektrisch leitenden Trägersubstrats **1360** zwischen der elektrisch leitende linken Signalmassefläche **1310** und der elektrisch leitende rechten Signalmassefläche **1320.** Das Trägersubstrat **1360** kann beispielsweise eine Isolierschicht im Metallisierungsstapel eines mikrointegrierten Schaltkreises, insbesondere eines mikrointegrierten Hableiterschaltkreises, insbesondere eines CMOS- oder BiCMOS oder Bipolar-Schaltkreises oder eines Schaltkreises auf Basis von III/V-Materialien oder dergleichen sein. Bei der beispielhaften Tri-Plate-Leitung **1480** der Figur 56 trennt eine elektrisch im Wesentlichen nicht-leitende linke Isolationslücke **2340** die elektrisch leitende Signalleitung **1330** von der elektrisch leitenden linken Signalmassefläche **1310.** Außerdem trennt eine elektrisch im Wesentlichen nicht-leitende rechte Isolationslücke **2350** die elektrisch leitende Signalleitung **1330** von der elektrisch leitenden rechten Signalmassefläche **1450.** Bevorzugt weist die Tri-Plate-Leitung **2380** bezogen auf die elektrisch leitende Signalleitung **1330** als "heißen" Innenleiter und die Gemeinschaft aus elektrisch leitender linken Signalmassefläche **1310,** elektrisch leitender rechter Signalmassefläche **1320** und elektrisch leitendem Rückseitenkontakt **1370** als Masseelektroden einen Wellenwiderstand auf. Der Vorteil der Verwendung einer Tri-Plate-Leitung **2380** ist die gute Abschirmung der Umgebung gegenüber der Mikrowellenstrahlung des Mikrowellensignals µW, das die Mikrowellensignalquelle **µWG** in die elektrisch leitende Signalleitung **1330** der Tri-Plate-Leitung **2380** einspeist.

Ein linkes Sensorelement **SE(1410)** ist als ein in der nicht-leitenden linken Isolationslücke **2340** der Tri-Plate-Leitung **2380** platziertes linkes Sensorelement **SE(1410)** eingezeichnet ist.

In dem Beispiel der Figur 56 ist der Durchmesser **d_{SE}** des Sensorelements **SE(1410)** beispielhaft kleiner als die Breite **d_{IS1}** der nicht-leitenden linken Isolationslücke **2340** der Tri-Plate-Leitung **2380.** In dem Beispiel der Figur 56 befinden sich keine Teile des linken Sensorelements **SE(1410)** links oder rechts der nicht-leitenden linken Isolationslücke **2340** der Tri-Plate-Leitung **2380** und gleichzeitig auch auf bzw. oberhalb der elektrisch leitenden linken Signalmassefläche **1310** der beispielhaften Tri-Plate-Leitung **2380** oder auch auf bzw. oberhalb des Signalleiters **1330** der beispielhaften Mikrostripleitung **1380** bzw. der beispielhaften Triplate-Leitung **2380.** Zur besseren Klarheit ist die Richtung des Vektors **1440** der magnetische Flussdichte des Mikrowellenfeldes des Mikrowellensignals **µW,** das die Mikrowellensignalquelle **µWG** in die Tri-Plate-Leitung **2380** einspeist, in die Figur 56 im Bereich des linken Sensorelements **SE(1410)** eingezeichnet.

Zur besseren Klarheit ist die Richtung des Vektors **1440** der magnetische Flussdichte des Mikrowellenfeldes des Mikrowellensignals **µW,** das die Mikrowellensignalquelle **µWG** in die Signalleitung **1330** der Tri-Plate-Leitung **2380** einspeist, in die Figur 56 im Bereich des linken Sensorelements **SE(1410)** eingezeichnet. Die Fluoreszenzstrahlung **FL** der NV-Zentren in den Diamant-Nano-Kristallen **ND** des linken Sensorelements **SE(1410)** ist im Wesentlichen empfindlich gegenüber dem wirksamen Anteil **B_{W}** der externen magnetischen Flussdichte **Bₑₓₜ**, dessen Flussdichtevektor **senkrecht** zur Oberfläche des elektrisch nicht-leitenden Trägersubstrats **1360** oder dessen Flussdichtevektor **parallel** zur Signalleitung **1330** innerhalb des linken Sensorelements **SE(1410)** steht. Das linke Sensorelement **SE (1410)** umfasst ein Trägermaterial **TM** in das die Diamant-Nano-Kristallen **ND** mit den NV-Zentren typischerweise innerhalb des linken Sensorelements **SE(1410)** eingebettet sind.

Ein rechtes Sensorelement **SE(1430)** ist als ein in der nicht-leitenden rechten Isolationslücke **2350** der Tri-Plate-Leitung **2380** platziertes rechtes Sensorelement **SE(1430)** eingezeichnet.

In dem Beispiel der Figur 56 ist der Durchmesser **d_{SE}** des rechten Sensorelements **SE(1430)** beispielhaft kleiner als die Breite **d_{IS2}** der nicht-leitenden rechten Isolationslücke **2350** der Tri-Plate-Leitung **2380.**

In dem Beispiel der Figur 56 befinden sich keine Teile des rechten Sensorelements **SE(1430)** links oder rechts der nicht-leitenden rechten Isolationslücke **2350** der Tri-Plate-Leitung **2380** und gleichzeitig auf bzw. oberhalb der elektrisch leitenden rechten Signalmassefläche **1320** der beispielhaften Tri-Plate-Leitung **2380** oder auf bzw. oberhalb des Signalleiters **1330** der beispielhaften Mikrostripleitung **1380** bzw. der beispielhaften Triplate-Leitung **2380.**

Zur besseren Klarheit ist die Richtung des Vektors **1460** der magnetische Flussdichte **B_{µW}** des Mikrowellenfeldes des Mikrowellensignals **µW,** das die Mikrowellensignalquelle **µWG** in die Tri-Plate-Leitung **2380** einspeist, in die Figur 56 im Bereich des rechten Sensorelements **SE(1430)** eingezeichnet.

Zur besseren Klarheit ist die Richtung des Vektors **1460** der magnetische Flussdichte des Mikrowellenfeldes des Mikrowellensignals **µW,** das die Mikrowellensignalquelle **µWG** in die Signalleitung **1330** der Tri-Plate-Leitung **2380** einspeist, in die Figur 56 im Bereich des rechten Sensorelements **SE(1430)** eingezeichnet. Die Fluoreszenzstrahlung **FL** der NV-Zentren in den Diamant-Nano-Kristallen **ND** des rechten Sensorelements **SE(1430)** ist im Wesentlichen empfindlich gegenüber dem wirksamen Anteil **B_{W}** der externen magnetischen Flussdichte **Bₑₓₜ**, dessen Flussdichtevektor **senkrecht** zur Oberfläche des elektrisch nicht-leitenden Trägersubstrats **1360** oder dessen Flussdichtevektor **parallel** zur Signalleitung **1330** innerhalb des rechten Sensorelements **SE(1430)** steht. Das rechte Sensorelement **SE (1430)** umfasst ein Trägermaterial **TM** in das die Diamant-Nano-Kristallen **ND** mit den NV-Zentren typischerweise innerhalb des rechten Sensorelements **SE(1430)** eingebettet sind.

Ein mittleres Sensorelement **SE(1420)** ist als ein auf dem Signalleiter **1330** der beispielhaften Mikrostripleitung **1380** bzw. der beispielhaften Triplate-Leitung **2380** platziertes mittleres Sensorelement **SE(1420)** eingezeichnet.

In dem Beispiel der Figur 56 ist der Durchmesser **d_{SE}** des Sensorelements **SE(1420)** beispielhaft kleiner als die Breite **d_{S}** des Signalleiter **1330** der beispielhaften Mikrostripleitung **1380** bzw. der beispielhaften Triplate-Leitung **2380.**

In dem Beispiel der Figur 56 befinden sich keine Teile des mittleren Sensorelements **SE(1420)** links oder rechts des Signalleiter **1330** der beispielhaften Mikrostripleitung **1380** bzw. der beispielhaften Triplate-Leitung **2380** oder in der nicht-leitenden linken Isolationslücke **2340** der beispielhaften Tri-Plate-Leitung **2380** oder in der nicht-leitenden rechten Isolationslücke **2350** der beispielhaften Tri-Plate-Leitung **2380.**

Zur besseren Klarheit ist die Richtung des Vektors **1450** der magnetische Flussdichte **B_{µW}** des Mikrowellenfeldes des Mikrowellensignals **µW,** das die Mikrowellensignalquelle **µWG** in die Tri-Plate-Leitung **2380** einspeist, in die Figur 36 im Bereich des mittleren Sensorelements **SE(1420)** eingezeichnet.

Zur besseren Klarheit ist die Richtung des Vektors **1450** der magnetische Flussdichte **B_{µW}** des Mikrowellenfeldes des Mikrowellensignals **µW,** das die Mikrowellensignalquelle **µWG** in die Signalleitung **1330** der Tri-Plate-Leitung **2380** einspeist, in die Figur 56 im Bereich des mittleren Sensorelements **SE(1420)** eingezeichnet. Die Fluoreszenzstrahlung **FL** der NV-Zentren in den Diamant-Nano-Kristallen **ND** des mittleren Sensorelements **SE(1420)** ist im Wesentlichen empfindlich gegenüber dem wirksamen Anteil **B_{W}** der externen magnetischen Flussdichte **Bₑₓₜ**, dessen Flussdichtevektor **parallel** zur Oberfläche des elektrisch nicht-leitenden Trägersubstrats **1360** innerhalb des mittleren Sensorelements **SE(1420)** steht. Das mittlere Sensorelement **SE (1420)** umfasst ein Trägermaterial **TM** in das die Diamant-Nano-Kristallen **ND** mit den NV-Zentren typischerweise innerhalb des mittleren Sensorelements **SE(1420)** eingebettet sind.

### Figur 57

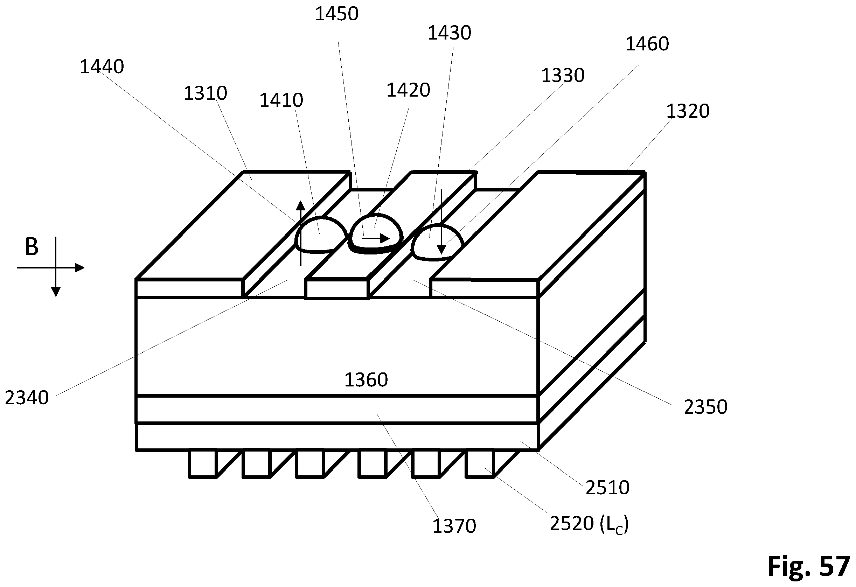

Figur 57 entspricht der Figur 56 ergänzt um eine Flachspule **2520** als Magnetfelderzeugungsmittel Lc. Die besagte Flachspule **2520** ist nur ein Beispiel für ein mögliches Magnetfelderzeugungsmittel Lc. Die Flachspule **2520** kann mehrere Windungen und mehrere Lagen aufweisen. In dem Beispiel der Figur 57 ist die Flachspule **2520** durch eine Isolationsschicht **2510** von dem elektrisch leitenden Rückseitenkontakt **1370** der beispielhaften Triplate-Leitung **2380** elektrisch isoliert. Die Flachspule **2520** erzeugt bei Bestromung durch eine Treiberstufe **DRVL,** die zur Versorgung des Magnetfelderzeugungsmittels **L_{C}** in Form der Flachspule **2520** mit elektrischer Energie und/oder zur Steuerung des Magnetfelderzeugungsmittels **L_{C}** in Form der Flachspule **2520** dient, ein magnetisches Feld mit einer zusätzlichen magnetischen Flussdichte **B_{ad}**. Diese zusätzliche magnetische Flussdichte **B_{ad}** durchflutet nun das auf dem Signalleiter **1330** der beispielhaften Mikrostripleitung **1380** bzw. der beispielhaften Triplate-Leitung **2380** platzierte mittlere Sensorelement **SE(1420).** Damit können Vorrichtungen entsprechend den Figuren 69 bis 71 und 73 bis 81 diese Flachspule **2520** als ein die magnetische Gesamtflussdichte **B_{Σ}** kompensierendes und/oder modulierendes und/oder änderndes Magnetfelderzeugungsmittel **L_{C}** nutzen. Damit das zusätzliche magnetische Feld mit der zusätzlichen magnetischen Flussdichte **B_{ad}** parallel zur Oberfläche des elektrisch nicht-leitenden Trägersubstrats **1360** innerhalb des mittleren Sensorelements **SE(1420)** sich ausprägt, sollte bevorzugt die der Flachspule **2520** in eine erste Teilflachspule links des Signalleiters **1330** der beispielhaften Mikrostripleitung **1380** bzw. der beispielhaften Triplate-Leitung **2380** und eine zweite Teilflachspule rechts des Signalleiters **1330** der beispielhaften Mikrostripleitung **1380** bzw. der beispielhaften Triplate-Leitung **2380** aufgeteilt sein. Typischerweise bestromt die Treiberstufe **DRVL,** die zur Versorgung des Magnetfelderzeugungsmittels **L_{C}** in Form der Flachspule **2520** mit elektrischer Energie und/oder zur Steuerung des Magnetfelderzeugungsmittels Lc in Form der Flachspule **2520** dient, zur Erzeugung der magnetischen Flussdichte **B_{ad} parallel** zur Oberfläche des elektrisch nicht-leitenden Trägersubstrats **1360** innerhalb des mittleren Sensorelements **SE(1420)** so, dass die Richtung des Flussdichtevektors des magnetischen Feldes, dass die erste Teilspule erzeugt, der Richtung des Flussdichtevektors, das die zweite Teilspule erzeugt, entgegengesetzt ist.

Typischerweise bestromt die Treiberstufe **DRVL,** die zur Versorgung des Magnetfelderzeugungsmittels **L_{C}** in Form der Flachspule **2520** mit elektrischer Energie und/oder zur Steuerung des Magnetfelderzeugungsmittels Lc in Form der Flachspule **2520** dient, zur Erzeugung der magnetischen Flussdichte **B_{ad} senkrecht** zur Oberfläche des elektrisch nicht-leitenden Trägersubstrats **1360** innerhalb des mittleren Sensorelements **SE(1420)** so, dass die Richtung des Flussdichtevektors des magnetischen Feldes, dass die erste Teilspule erzeugt, der Richtung des Flussdichtevektors, das die zweite Teilspule erzeugt, gleichausgerichtet ist.

Durch diese unterschiedliche Bestromung der Teilspulen der Flachspule **2520** kann die Treiberstufe **DRVL** somit selektieren, ob und in welchem Maße das linke Sensorelement **1410** und das rechte Sensorelement **1430** einerseits oder das mittlere Sensorelement **1420** andererseits durch das zusätzliche magnetische Feld mit der magnetischen Flussdichte **B_{ad}**, das die Flachspule **2520** erzeugt, beeinflusst werden sollen. Durch die unterschiedliche Bestromung der Teilflachspulen der Flachspule **2520** kann somit Treiberstufe **DRVL** die richtungsmäßige Empfindlichkeit des linken Sensorelement **1410** und des rechten Sensorelements **1430** der einerseits oder des mittleren Sensorelements **1420** einstellen.

Damit können Vorrichtungen entsprechend den Figuren 69 bis 71 und 73 bis 81 diese Flachspule **2520** als ein den Vektor **1440** der magnetische Flussdichte **B_{µW}** des Mikrowellenfeldes des Mikrowellensignals **µW** kompensierendes und/oder modulierendes und/oder änderndes Magnetfelderzeugungsmittel Lc nutzen Dabei speist wieder die Mikrowellensignalquelle **µWG** das Mikrowellensignal **µW** in die Signalleitung **1330** der Tri-Plate-Leitung **2380** ein. Hier repräsentiert der Vektor **1450** der magnetische Flussdichte **B_{µW}** des Mikrowellenfeldes des Mikrowellensignals **µW** die magnetische Gesamtflussdichte **B_{Σ},** die das mittlere Sensorelement **SE(1420)** durchdringt.

### Figuren 58 bis 61

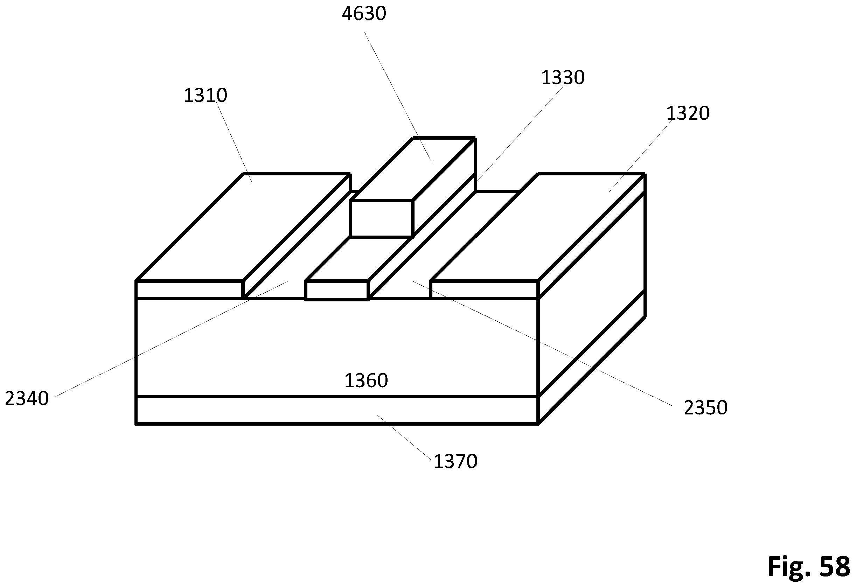

Die Figuren 58 bis 61 veranschaulichen die Herstellung des mittleren Sensorelements **SE(1320)** am zweiten Ende des mittleren optischen Lichtwellenleiters **LWL (4630).** Das Verfahren kann in analoger Weise auch zur Herstellung eines linken Sensorelements **SE(1310)** am zweiten Ende eines linken optischen Lichtwellenleiters **LWL (4610)** und/oder zur Herstellung eines rechten Sensorelements **SE(1320)** am zweiten Ende eines rechten optischen Lichtwellenleiters **LWL (4610)** verwendet werden. In der Beschreibung sind dann lediglich die korrespondierenden Bezeichnungen gegeneinander auszutauschen. Auch für andere in diesem Dokument und in den zitierten Dokumenten erwähnten Wellenleitern sind diese verwendbar, wenn die Lichtwellenleiter vorzugsweise im Wesentlichen parallel zu den Leitern angeordnet werden.

### Figur 58

Das Verfahren beginnt mit dem Bereitstellen des Trägersubstrats **1360** wobei in dem Beispiel der Figur 47 das bereitgestellte Trägersubstrat **1360** die Tri-Plate-Leitung **2380** mit der elektrisch leitenden linken Signalmassefläche **1310** und der elektrisch leitenden rechten Signalmassefläche **1320** und dem mittleren Signalleiter **1330** und den elektrisch leitenden Rückseitenkontakt **1370** sowie beispielhaft den mittleren optischen Lichtwellenleiter **LWL (4630)** umfasst. Das zweite Ende des mittleren optischen Lichtwellenleiters **LWL (4630)** befindet sich hier beispielhaft auf dem mittleren Signalleiter **1330.**

### Figur 59

in einem nachfolgenden Schritt des Verfahrens wird die Oberfläche des Trägersubstrats **1360** mit der Sensorelementschicht **4810** bedeckt. Die Sensorelementschicht **4810** umfasst bevorzugt eine dieser kolloidale Mischung (kolloidaler Lack KL) der Diamant-Nano-Kristalle **ND** und des noch flüssigen Trägermaterials **TM.** Die Sensorelementschicht **4810** ist also vorzugsweise mit Diamant-Nano-Kristallen **ND** angefüllt. Vorzugsweise umfassen die Diamant-Nano-Kristalle **ND** paramagnetische Zentren, die bei Bestrahlung mit elektromagnetischer Pumpstrahlung **LB** der Pumpstrahlungswellenlänge **λₚₘₚ** Fluoreszenzstrahlung **FL** mit einer Fluoreszenzstrahlungswellenlänge **λ_{fl}** emittieren. Ganz besonders bevorzugt handelt es sich bei den paramagnetischen Zentren um NV-Zentren. Ggf. wird die Oberfläche des Trägersubstrats **1360** beispielsweise durch Plasma-Terminierung und/oder durch eine Haftvermittlerschicht vorbehandelt, um eine gute Benetzung der Oberfläche des Trägersubstrats **1360** durch das noch flüssige Trägermaterial **TM** sicherzustellen. Bevorzugt wird die Sensorelementschicht **4810** beispielsweise mittels eines Temperatur- oder Lagerschritts angehärtet. Dieser vorzugsweise durchgeführte Temperaturschritt härtet dann bevorzugt das Trägermaterial **TM** an, um es zu stabilisieren.

### Figur 60

In einem nachfolgenden Schritt des Verfahrens speist eine Aushärtestrahlungsquelle typischerweise über eine mittlere mikrooptische Einkoppelstruktur die Aushärtestrahlung **4910** mit der Aushärtewellenlänge λ_{H} in das erste Ende des mittleren optischen Lichtwellenleiter **LWL (4630)** ein. In der Figur 49 verdeckt die Sensorelementschicht **4810** den mittleren optischen Lichtwellenleiter **LWL (4630),** der sich hier unter der Sensorelementschicht **4810** befindet. Die Aushärtestrahlung **4910** tritt dann am zweiten Ende des mittleren optischen Lichtwellenleiters **LWL (4630)** wieder aus dem mittleren optischen Lichtwellenleiter **LWL (4630)** aus und in die Masse der Sensorelementschicht **4810** ein. Hierdurch bestrahlt die Aushärtestrahlung **4910** das zuerst noch flüssige oder angehärtete Trägermaterial **TM** der Sensorelementschicht **4810** mit elektromagnetischer Aushärtestrahlung **4910** der Aushärtewellenlänge λ_{H}. Hierdurch verfestigt sich das Trägermaterial **TM** der Sensorelementschicht **4810** zu verfestigtem Trägermaterial **TM** der Sensorelementschicht **4810.** Dadurch bildet sich bereits jetzt das spätere mittlere Sensorelements **SE(1320)** in der Sensorelementschicht **4810.**

### Figur 61

In einem nachfolgenden Schritt des Verfahrens wird nun das schon gebildete mittlere Sensorelements **SE(1320)** durch Reinigung mit einem Lösungsmittel freigelegt. Die Reinigung mit dem Lösungsmittel entfern die nicht oder nicht ausreichend mit elektromagnetischer Aushärtestrahlung **4910** der Aushärtewellenlänge **λ_{H}** bestrahlten Bereiche der Sensorelementschicht **4810.** Das zurückbleibende mittlere Sensorelement **SE(1320)** ist selbstjustierend und optimal an den mittleren optischen Lichtwellenleiter **LWL (4630)** optisch angekoppelt. Das Besondere des in dem hier vorgelegten Dokument vorgeschlagenen mittleren optischen Lichtwellenleiter **LWL (4630)** ist, dass das Trägermaterial **TM** ein mittels elektromagnetischer Aushärtestrahlung **4910** ausgehärtetes Trägermaterial **TM** ist und dass das Trägermaterial **TM** nach dem Aushärten für elektromagnetische Strahlung mit einer Pumpstrahlungswellenlänge **λₚₘₚ** der Pumpstrahlung **LB,** mit der die NV-Zentren und/oder die anderen paramagnetischen Zentren in den Diamant-Nano-Kristallen **ND** gepumpt werden, im Wesentlichen transparent ist. Bevorzugt ist das Trägermaterial **TM** nach dem Aushärten für elektromagnetische Strahlung mit einer Fluoreszenzstrahlungswellenlänge **λ_{fl}** der Fluoreszenzstrahlung **FL,** mit der die NV-Zentren und/oder die anderen paramagnetischen Zentren in den Diamant-Nano-Kristallen **ND** bei Bestrahlung mit elektromagnetischer Strahlung mit einer Pumpstrahlungswellenlänge **λₚₘₚ** der Pumpstrahlung **LB** fluoreszieren, im Wesentlichen transparent. Im Wesentlichen bedeutet dabei jeweils, dass die unzweifelhaft auftretenden Verluste immer noch so gering sind, dass die Funktionsfähigkeit der betreffenden Anwendung immer noch gegeben ist. Durch die Aushärtung eines zuvor flüssigen oder angehärteten Trägermittels **TM** ist die Fertigung eines solchen mittleren optischen Lichtwellenleiter **LWL (4630)** besonders einfach und prozesssicher mit einem hohen Cₚₖ-Wert zu fertigen

Wenn somit das zweite Ende des Lichtwellenleiters **LWL(4630)** von dem Trägermaterial **TM** des Sensorelements **4810** umhüllt ist, ergibt sich eine besonders gute Stabilisierung dieser optischen Kopplung. Bevorzugt bildet dabei eine Endfläche des zweiten Endes des Lichtwellenleiters **LWL(4630)** eine ebene Endfläche senkrecht zur Mittenlinie des Lichtwellenleiters **LWL(4630).** Die Mittelline entspricht typischerweise der optischen Achse des Lichtwellenleiters **LWL(4630).** Eine solche Endfläche ermöglicht eine verbesserte Auskopplung der elektromagnetischen Pumpstrahlung **LB** aus dem Lichtwellenleiter **LWL(4630)** und eine verbesserte optische Einkopplung der Fluoreszenzstrahlung **FL** in den Lichtwellenleiter **LWL(4630).** Bevorzugt wird daher der **LWL(4630)** durch einen geeigneten Ätzprozess (z.B. DRIE oder RIE-Ätzung), der vorzugsweise senkrechte Flanken erzeugt, ausgeformt. Bevorzugt ist der Abstand eines oder bevorzugt mehrerer Kristalle und/oder Diamant-Nano-Kristalle **ND** von dieser ebenen Endfläche kleiner als die Pumpstrahlungswellenlänge λₚₘₚ und/oder besser kleiner als ½ der Pumpstrahlungswellenlänge λₚₘₚ, und/oder besser kleiner als 1/4 der Pumpstrahlungswellenlänge λₚₘₚ, und/oder besser kleiner als 1/8 der Pumpstrahlungswellenlänge λₚₘₚ, und/oder besser kleiner als 1/10 der Pumpstrahlungswellenlänge λₚₘₚ, und/oder besser kleiner als 1/20 der Pumpstrahlungswellenlänge λₚₘₚ, und/oder besser kleiner als 1/50 der Pumpstrahlungswellenlänge λₚₘₚ, und/oder besser kleiner als 1/100 der Pumpstrahlungswellenlänge λₚₘₚ, , und/oder besser kleiner als 1/200 der Pumpstrahlungswellenlänge λₚₘₚ, und/oder besser kleiner als 1/500 der Pumpstrahlungswellenlänge λₚₘₚ, und/oder besser kleiner als 1/1000 der Pumpstrahlungswellenlänge λₚₘₚ.

Die Mittenlinie, die eine gedachte Hilfskonstruktion zur Verdeutlichung des Sachverhalts ist, durchstößt die Endfläche an einem Mittelpunkt der Endfläche. Die Dicke d_{I} des Trägermaterials **TM** ist bevorzugt an diesem Mittelpunkt dicker ist als die Dicke dᵣ an anderen Punkten der Endfläche des zweiten Endes des Lichtwellenleiters **LWL(4630).** Dies hat den Vorteil, dass Licht durch die Grenzfläche Trägermaterial **TM/** Luft in den Lichtwellenleiter **LWL(4630)** zurückgespiegelt wird und dass dann die Effizienz und der Wirkungsgrad der Lichtkopplung steigt.

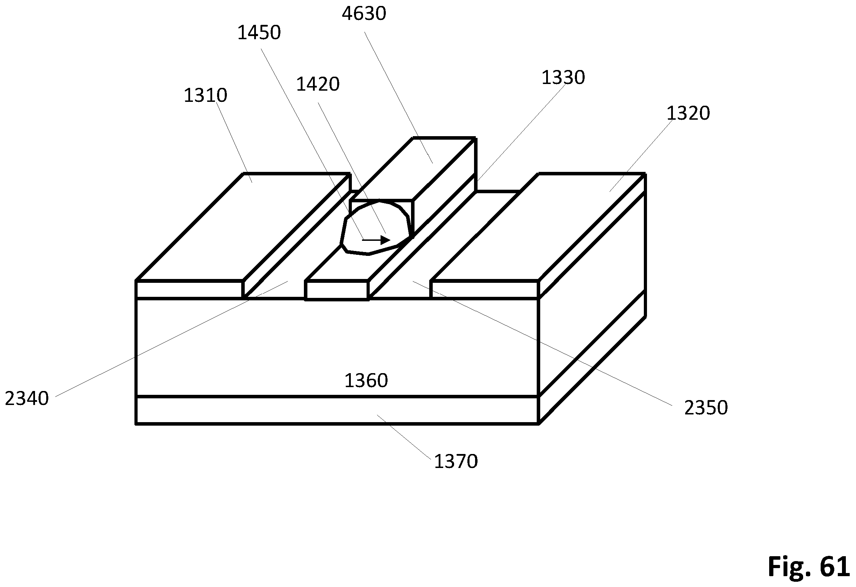

Bevorzugt formt daher das Trägermaterial **TM** am zweiten Ende des Lichtwellenleiters **LWL(4630)** eine Linse aus. Der Durchmesser D_{LWLL} der Linse ist vorzugsweise, aber nicht zwangsweise kleiner als der Durchmesser des Lichtwellenleiters **LWL(4630).** Die Figur 66 zeigt ein Sensorelement, dessen Durchmesser bzw. dessen Linsendurchmesser größer als der Durchmesser D_{LWL} des Lichtwellenleiters **LWL(4630)** ist. Die Figur 61 zeigt hingegen ein Sensorelement **1420,** dessen Durchmesser bzw. dessen Linsendurchmesser D_{LWLL} kleiner als der Durchmesser des Lichtwellenleiters **LWL(4630)** ist. Der Durchmesser D_{LWLL} der Linse kann aber auch so groß wie der der Durchmesser D_{LWL} des Lichtwellenleiters **LWL(4630)** sein.

Bevorzugt ist der der Lichtwellenleiter **LWL(4630)** ganz oder teilweise durch eine mechanische Hülle **MH** umhüllt und/oder lichtdicht abgedeckt, die auch nur den Zweck haben kann, ein Übersprechen zwischen verschiedenen Lichtwellenleitern der Vorrichtung zu verhindern. Die mechanische Hülle **MH** ist bevorzugt aus Glas oder Keramik, Kunststoff oder dergleichen gefertigt und für relevante elektromagnetische Strahlung intransparent. Die mechanische Hülle **MH** weist daher bevorzugt einen Keramikwerkstoff oder eine Kunststoffwerkstoff oder ein anderes nicht magnetisierbares und/oder elektrisch nichtleitendes Material und/oder ein bei Temperaturen oberhalb von 100°C stabiles Material und/oder ein bei Temperaturen oberhalb von 140°C stabiles Material und/oder ein bei Temperaturen oberhalb von 170°C stabiles Material und/oder ein bei Temperaturen oberhalb von 200°C stabiles Material und/oder ein bei Temperaturen oberhalb von 250°C stabiles Material auf oder umfasst diese oder besteht aus diesen im Extremfall. Die mechanische Hülle **MH** kann also aus einem Keramikwerkstoff oder einem Kunststoffwerkstoff oder aus einem anderen nicht magnetisierbaren und/oder elektrisch nichtleitendes Material und/oder aus einem bei Temperaturen oberhalb von 100°C stabilen Material und/oder aus einem bei Temperaturen oberhalb von 140°C stabilen Material und/oder aus einem bei Temperaturen oberhalb von 170°C stabilen Material und/oder aus einem bei Temperaturen oberhalb von 200°C stabilen Material und/oder aus einem bei Temperaturen oberhalb von 250°C stabilen Material gefertigt sein.

Bevorzugt bildet die mechanische Hülle **MH** zumindest abschnittweise ein Rohr oder Röhrchen oder eine Kapillare oder eine Kanüle oder eine Abdeckung des Lichtwellenleiters **LWL(4630),** die den jeweilige Lichtwellenleiter **LWL(4630)** umhüllt oder zumindest teilweise oder ganz abdeckt. Dies vereinfacht die Fertigung des Systems aus Lichtwellenleiter, Sensorelement **SE(1420)** und mechanischer Hülle **MH.** Der Innendurchmesser Dᵣₒ eines solchen Rohrs oder einer solchen Abdeckung oder eines solchen Röhrchens oder einer solchen Kapillare oder einer solchen Kanüle ist bevorzugt nur ein Wenig größer oder gleich groß wie der Durchmesser der Lichtwellenleiterlinse und der Durchmesser des Lichtwellenleiters **LWL(4630).**

Der Lichtwellenleiter **LWL(4630)** weist typischerweise einen Lichtwellenleiterkern LWLC auf. In dem Trägermaterial **TM** formt das Trägermaterial **TM** bevorzugt ein optisches Funktionselement am zweiten Ende des Lichtwellenleiters **LWL(4630)** aus. Dies verbessert wieder die besagte optische Kopplung zwischen Lichtwellenleiter **LWL(4630)** und Trägermaterial **TM.** Das optische Funktionselement wirkt dann so mit dem Lichtwellenleiterkern des Lichtwellenleiters **LWL(4630)** am zweiten Ende des Lichtwellenleiters **LWL(4630)** optisch zusammen.

Bevorzugt weist das optische Funktionselement eine Lichtwellenleiterlinse, insbesondere in Form einer Verdickung des Trägermaterials **TM** im Bereich des optischen Funktionselements, auf.

Das Wesentliche des hier vorgelegten Dokuments ist nun, dass es auch ein Verfahren zur Herstellung eines Lichtwellenleiters **LWL(4630),** wie er zuvor beschrieben und verwendet wurde, beschreibt und offenlegt. Das vorgeschlagene Verfahren umfasst die Schritte (Siehe Figur 153):
- Bereitstellen **15310** eines Lichtwellenleiters **LWL(4630),** wobei der Lichtwellenleiter **LWL(4630)** ein erstes Ende und ein zweites Ende aufweist;
- Bereitstellen **15320** eines flüssigen und mittels elektromagnetischer Strahlung einer Aushärtestrahlung **4910** mit einer Aushärtewellenlänge λ_{H} härtbaren Trägermaterials **TM,** wobei in das Trägermaterial **TM** eine Vielzahl von Kristallen und/oder Diamant-Nano-Kristallen **ND,** vorzugsweise Nanodiamanten, eingebettet sind und wobei einer oder mehrere oder alle Kristalle und/oder Diamant-Nano-Kristalle **ND** NV-Zentren und/oder andere paramagnetischen Zentren aufweisen und wobei die NV-Zentren der Kristalle und/oder Diamant-Nano-Kristalle **ND** des Trägermaterials **TM** und/oder die anderen paramagnetischen Zentren der Kristalle und/oder Diamant-Nano-Kristalle **ND** des Trägermaterials **TM** bei Bestrahlung mit Pumpstrahlung **LB** zumindest eine Fluoreszenzstrahlung **FL** emittieren;
- Benetzen **15330** des zweiten Endes des Lichtwellenleiters **LWL(4630)** zumindest auf eine Benetzungslänge L_{B} mit dem Trägermaterial **TM,** das die Vielzahl eingebetteter Kristalle und/oder Diamant-Nano-Kristalle **ND** mit NV-Zentren und/oder paramagnetischen Zentren aufweist;
- Einspeisen **15340** elektromagnetischer Strahlung in das erste Ende des Lichtwellenleiters **LWL(4630),** wobei die Wellenlänge dieser elektromagnetischen Strahlung, die Aushärtewellenlänge λ_{H}, so gewählt ist, dass das Trägermaterial **TM** am zweiten Ende des Lichtwellenleiters **LWL(4630)** aushärtet und sich in einen Festkörper wandelt.
- Entfernen **15350** des nicht ausgehärteten Trägermaterials **TM** insbesondere mittels eines Lösungsmittels **LM,** wobei der verbleibende Film des Trägermaterials **TM** am zweiten Ende des Lichtwellenleiters **LWL(4630)** das Sensorelement **SE** bildet.

Typischerweise härtet das Trägermaterial **TM** nur teilweise aus, was die Bildung des optischen Funktionselements und des Sensorelements **SE** ermöglicht.

Somit ist nun auf der elektrisch leitenden Signalleitung **1330** der Tri-Plate-Leitung **2380** ein mittlerer optischer Lichtwellenleiter **LWL (4630)** beispielhaft selbstjustierend platziert. Das hier vorgelegte Dokument schlägt somit vor, diesen mittleren optischen Lichtwellenleiter **LWL (4630)** mit einem mittleren Sensorelement **SE(1420)** zu kombinieren. Dabei weist das mittlere Sensorelement **SE(1420)** ein Trägermaterial **TM** auf, in dem typischerweise eine Vielzahl von Diamant-Nano-Kristallen **ND** eingebettet sind. Ein oder mehrere oder alle Diamant-Nano-Kristalle **ND** dieser Diamant-Nano-Kristalle **ND** weisen dabei ein oder mehrere NV-Zentren und/oder ein oder mehrere andere paramagnetische Zentren auf. Die NV-Zentren des mittleren Sensorelements **SE(1420)** und/oder die anderen paramagnetischen Zentren des mittleren Sensorelements **SE(1420)** emittieren bei Bestrahlung mit Pumpstrahlung **LB** mit einer Pumpstrahlungswellenlänge **λₚₘₚ** zumindest eine Fluoreszenzstrahlung **FL.** mit einer Fluoreszenzstrahlungswellenlänge **λ_{fl}.** Das Besondere des in dem hier vorgelegten Dokument vorgeschlagenen mittleren optischen Lichtwellenleiter **LWL (4630)** ist, dass das Trägermaterial **TM** vorzugsweise ein mittels elektromagnetischer Strahlung (Aushärtestrahlung **4910)** ausgehärtetes Trägermaterial **TM** ist und dass das Trägermaterial **TM** nach dem Aushärten für elektromagnetische Strahlung mit einer Pumpstrahlungswellenlänge **λₚₘₚ** der Pumpstrahlung **LB,** mit der die NV-Zentren des mittleren Sensorelements **SE(1420)** und/oder die anderen paramagnetischen Zentren des mittleren Sensorelements **SE(1420)** von einer der vorgeschlagenen Vorrichtungen gepumpt werden, im Wesentlichen transparent ist. Im Wesentlichen bedeutet dabei, dass die unzweifelhaft auftretenden Verluste immer noch so gering sind, dass die Funktionsfähigkeit der betreffenden Anwendung immer noch gegeben ist. In gleicher Weise sollte das Trägermaterial **TM** für Strahlung mit einer Fluoreszenzwellenlänge λ_{fl} der Fluoreszenzstrahlung **LB** der NV-Zentren des mittleren Sensorelements **SE(1420)** und/oder der anderen paramagnetischen Zentren des mittleren Sensorelements **SE(1420)** im Wesentlichen transparent sein. Im Wesentlichen bedeutet dabei wiederum, dass die unzweifelhaft auftretenden Verluste immer noch so gering sind, dass die Funktionsfähigkeit der betreffenden Anwendung immer noch gegeben ist. Zur Herstellung des mittleren Sensorelements **SE(1420)** wird die Oberfläche des Trägersubstrats **1360** mit der mittleren elektrisch leitenden Signalleitung **1330** der Tri-Plate-Leitung **2380** und den anderen Leitungen **1310, 1320** der Tri-Plate-Leitung **2380** und mit dem mittleren optischen Lichtwellenleiter **LWL (4630)** eine kolloidale Mischung (kolloidaler Lack **KL**) der Diamant-Nano-Kristalle **ND** mit paramagnetischen Zentren und/oder NV-Zentren und Kristalle mit paramagnetischen Zentren einerseits und des noch flüssigen Trägermaterials **TM** andererseits als Sensorelementschicht **4810** über die mittlere elektrisch leitende Signalleitung **1330** der Tri-Plate-Leitung **2380** und die anderen Leitungen **1310, 1320** der Tri-Plate-Leitung **2380** und den mittlerer optischer Lichtwellenleiter **LWL (4630)** aufgetragen. Ggf. wird die Lackschicht der kolloidalen Mischung (kolloidaler Lack **KL**) in einem nachfolgenden temperaturschritt angehärtet um sie zu stabilisieren.

Der Herstellungsprozess des mittleren Sensorelements **SE(1420)** umfasst bevorzugt in einem anschließenden Herstellungsschritt das lokale Bestrahlen dieser kolloidale Mischung (kolloidaler Lack **KL**) der Diamant-Nano-Kristalle **ND** und des noch flüssigen Trägermaterials **TM** der Sensorelementschicht **4810** mit einer elektromagnetischen Aushärtestrahlung **4910** der Aushärtewellenlänge **λ_{H}.** Die lokale Bestrahlung dieser kolloidale Mischung (kolloidaler Lack **KL**) der Diamant-Nano-Kristalle **ND** und des noch flüssigen Trägermaterials **TM** der Sensorelementschicht **4810** mit einer elektromagnetischen Aushärtestrahlung **4910** der Aushärtewellenlänge λ_{H} ist dabei bevorzugt auf den Bereich der Sensorelementschicht **4810** am zweiten Ende des mittleren optischen Lichtwellenleiters **LWL (4630)** begrenzt. Bevorzugt handelt es sich bei der elektromagnetischen Aushärtestrahlung **4910** der Aushärtewellenlänge λ_{H} um UV-Strahlung. Beispiels kann der mit der elektromagnetischen Aushärtestrahlung **4910** der Aushärtewellenlänge λ_{H} bestrahlte Bereich der Sensorelementschicht **4810** durch eine Maske **5410** begrenzt werden, die in einem vorausgehenden Justierschritt gegenüber Justiermarken **(5210, 5220)** auf der Oberfläche des Trägersubstrats **1360** justiert und beispielsweise in einem Mask-Aligner (Maskenjustier- und Ausrichtungsvorrichtung) ausgerichtet worden ist. Bevorzugt weist das Trägersubstrat **1360** somit die Leitungen **1310, 1320, 1330** der Tri-Plate-Leitung **2380** (bzw. einer anderen möglichen Mikrostreifenleitung) und die Justiermarken **(5210, 5220)** für die Justierung einer oder mehrerer Belichtungsmasken **5410** auf. Durch die Bestrahlung der Sensorelementschicht **4810,** die die kolloidale Mischung (kolloidaler Lack **KL**) der Diamant-Nano-Kristalle **ND** und das noch flüssige bzw. angehärtete Trägermaterial **TM** der Sensorelementschicht **4810** umfasst, mit elektromagnetischer Aushärtestrahlung **4910** der Aushärtewellenlänge **λ_{H}** verfestigt sich typischerweise das zuvor flüssige bzw. angehärtete Trägermaterial **TM** der Sensorelementschicht **4810** zu verfestigtem Trägermaterial **TM** der Sensorelementschicht **4810** im mit der elektromagnetischen Aushärtestrahlung **4910** der Aushärtewellenlänge λ_{H} bestrahlten Bereich der Sensorelementschicht **4810.** Hierdurch bildet sich innerhalb der Sensorelementschicht **4810** verdeckt bereits das mittlere Sensorelement **SE(1430).** In einem typischerweise dann nachfolgenden Verfahrensschritt können nicht verfestigte Bereiche der Sensorelementschicht **4810,** die zuvor typischerweise nicht oder nur unzureichend mit Aushärtestrahlung **4910** der Aushärtewellenlänge **λ_{H}** bestrahlt wurden, mittels eines Lösungsmittels für das noch flüssige bzw. angehärtete Trägermaterial **TM** der Sensorelementschicht **4810** aufgelöst und von der der Oberfläche des Trägersubstrats **1360** und den anderen Leitungen **1310, 1320, 1330** und aus der elektrisch im Wesentlichen nicht-leitenden linken Isolationsfläche **1340** und aus der elektrisch im Wesentlichen nicht-leitende rechten Isolationsfläche **1360** etc. an der Oberfläche des Trägersubstrats **1360** entfernt werden. Es verbleibt das fertig gestellte mittlere Sensorelement **SE(1320).** Besonders elegant ist die Herstellung des mittleren Sensorelements **SE(1320),** wenn eine Aushärtestrahlungsquelle in den mittleren optischen Lichtwellenleiter **LWL (4630)** elektromagnetische Aushärtestrahlung **4910** der Aushärtewellenlänge **λ_{H}** im Herstellungsprozess einspeist. Bevorzugt weist zur Anwendung der hier dargestellten technischen Lehre der mittlere optischen Lichtwellenleiter **LWL (4630)** auf der Oberfläche des Trägersubstrats **1360** mikrooptische Strukturen auf, die die Einkopplung einer solchen elektromagnetischen Aushärtestrahlung **4910** der Aushärtewellenlänge **λ_{H}** im Herstellungsprozess in den mittleren optischen Lichtwellenleiter **LWL (4630)** erlauben. Bevorzugt dienen diese mikrooptischen Strukturen, die die Einkopplung einer solchen elektromagnetischen Aushärtestrahlung **4910** der Aushärtewellenlänge **λ_{H}** im Herstellungsprozess in den mittleren optischen Lichtwellenleiter **LWL (4630)** erlauben, später auch zur Einkoppelung der Pumpstrahlung **LB** der Pumpstrahlungswellenlänge **λₚₘₚ** in den mittleren optischen Lichtwellenleiter **LWL (4630)** und/oder zur Auskoppelung der Fluoreszenzstrahlung **FL** mit der Fluoreszenzstrahlungswellenlänge **λ_{fl}** aus dem mittleren optischen Lichtwellenleiter **LWL (4630).** Bevorzugt weist somit Oberfläche des Trägersubstrats **1360** mikrooptische Strukturen auf, die dazu eingerichtet sind, elektromagnetische Aushärtestrahlung **4910** der Aushärtewellenlänge **λ_{H}** im Herstellungsprozess in den mittleren optischen Lichtwellenleiter **LWL (4630)** einzuspeisen. Bevorzugt wird in den Bereichen der Oberfläche des Trägersubstrats **1360,** die diese mikrooptische Strukturen aufweisen, die dazu eingerichtet sind, elektromagnetischen Aushärtestrahlung **4910** der Aushärtewellenlänge **λ_{H}** im Herstellungsprozess in den mittleren optischen Lichtwellenleiter **LWL (4630)** einzuspeisen, die Sensorelementschicht **4810** vor der Aushärtung der Sensorelementschicht **4810** lokal entfernt. Es ist beispielsweise auch denkbar, die Sensorelementschicht **4810** grob vorstrukturiert mittels eines Dispensers oder mittels Siebdruck nur im Bereich der zweiten Enden des mittleren optischen Lichtwellenleiters **LWL (4630)** lokal begrenzt aufzubringen, sodass diese Entfernung von vornherein nicht notwendig ist. Im Herstellungsprozess wird nun beispielsweise über die besagten mikrooptischen Strukturen, die die Einkopplung einer solchen elektromagnetischen Aushärtestrahlung **4910** der Aushärtewellenlänge **λ_{H}** im Herstellungsprozess in den mittleren optischen Lichtwellenleiter **LWL (4630)** erlauben, elektromagnetische Aushärtestrahlung **4910** der Aushärtewellenlänge λ_{H} an einem ersten Ende des mittleren optischen Lichtwellenleiter **LWL (4630)** in den mittleren optischen Lichtwellenleiter **LWL (4630)** eingespeist. Der mittlere Lichtwellenleiter **LWL (4630)** transportiert die elektromagnetischen Aushärtestrahlung **4910** der Aushärtewellenlänge **λ_{H}** vom ersten Ende des mittleren Lichtwellenleiters **LWL (4630)** zum zweiten Ende des Lichtwellenleiters **LWL (4630).** Die elektromagnetischen Aushärtestrahlung **4910** der Aushärtewellenlänge **λ_{H}** tritt dann typischerweise am anderen, zweiten Ende des mittleren optischen Lichtwellenleiters **LWL (4630)** wieder aus. Bevorzugt ist das zweite Ende des mittleren optischen Lichtwellenleiters **LWL (4630)** mit einem Bereich der Sensorelementschicht **4810** bedeckt. Die elektromagnetische Aushärtestrahlung **4910** der Aushärtewellenlänge **λ_{H}** bestrahlt das noch flüssige Trägermaterial **TM** der Sensorelementschicht **4810** und härtet so das noch flüssige Trägermaterial **TM** der Sensorelementschicht **4810** zu verfestigtem Trägermaterial **TM** der Sensorelementschicht **4810** aus. In dem besagten, typischerweise dann nachfolgenden Verfahrensschritt können nicht verfestigte Bereiche der Sensorelementschicht **4810,** die typischerweise nicht oder nur unzureichend mit Aushärtestrahlung **4910** der Aushärtewellenlänge **λ_{H}** bestrahlt wurden, mittels eines Lösungsmittels für das noch flüssige Trägermaterial **TM** der Sensorelementschicht **4810** aufgelöst und von der der Oberfläche des Trägersubstrats **1360** und von den anderen Leitungen **1310, 1320, 1330** und aus der elektrisch im Wesentlichen nicht-leitenden linken Isolationsfläche **1340** und aus der elektrisch im Wesentlichen nicht-leitende rechten Isolationsfläche **1360** etc. an der Oberfläche des Trägersubstrats **1360** entfernt werden. Es verbleibt wieder das fertig gestellte mittlere Sensorelement **SE(1420),** das nun jedoch in optimaler Weise und selbstjustierend gegenüber dem zweiten Ende des mittleren optischen Lichtwellenleiters **LWL (4630)** gefertigt ist. Durch diese Aushärtung eines zuvor flüssigen und ggf. angehärteten Trägermittels **TM** ist die Fertigung des mittleren Sensorelements **SE(1420)** gegenüber dem zweiten Ende eines solchen mittleren optischen Lichtwellenleiters **LWL (4630)** besonders einfach und prozesssicher in selbstjustierender Weise mit einem hohen Cₚₖ-Wert zu fertigen.

### Figuren 62 bis 66

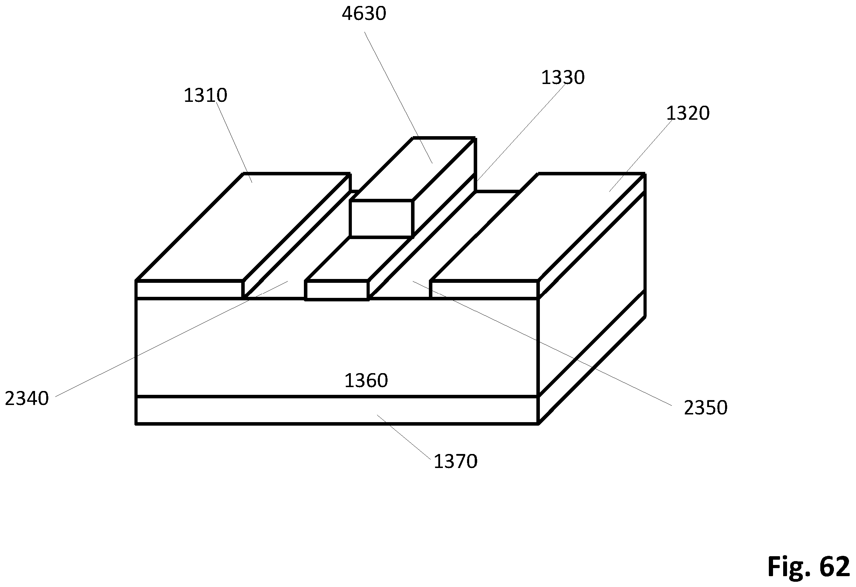

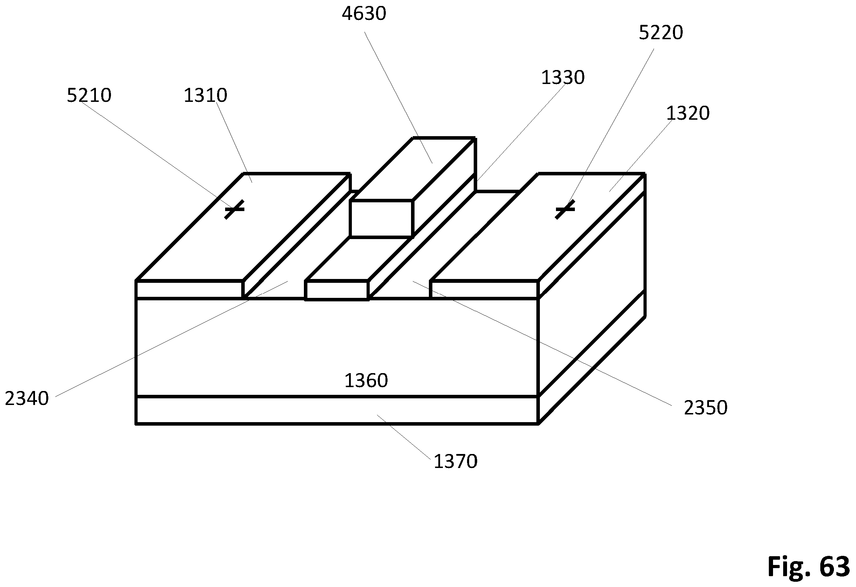

Die Figuren 62 bis 66 veranschaulichen die Herstellung des mittleren Sensorelements **SE(1320)** am zweiten Ende des mittleren optischen Lichtwellenleiters **LWL (4630)** mittels eines maskengesteuerten Verfahrens. Das Verfahren kann in analoger Weise auch zur Herstellung eines linken Sensorelements **SE(1310)** am zweiten Ende eines linken optischen Lichtwellenleiters **LWL (4610)** und/oder zur Herstellung eines rechten Sensorelements **SE(1310)** am zweiten Ende eines rechten optischen Lichtwellenleiters **LWL (4610)** verwendet werden. Dieses Fertigungsprinzip kann in analoger und funktionsäquivalenter Weise auf die Herstellung anderer Sensorelemente durch eine fachkundige Person übertragen werden. In der Beschreibung sind dann lediglich die korrespondierenden Bezeichnungen gegeneinander auszutauschen.

### Figur 62

Das Verfahren beginnt wieder mit dem Bereitstellen des Trägersubstrats **1360** wobei in dem Beispiel der Figur 62 das bereitgestellte Trägersubstrat **1360** die Tri-Plate-Leitung **2380** mit der elektrisch leitenden linken Signalmassefläche **1310** und der elektrisch leitenden rechten Signalmassefläche **1320** und dem mittleren Signalleiter **1330** und den elektrisch leitenden Rückseitenkontakt **1370** sowie beispielhaft den mittleren optischen Lichtwellenleiter **LWL (4630)** umfasst. Das zweite Ende des mittleren optischen Lichtwellenleiters **LWL (4630)** befindet sich hier beispielhaft wieder auf dem mittleren Signalleiter **1330.**

### Figur 63

um das hier vorgeschlagene maskenbasierende Verfahren durchführen zu können, wird die Oberfläche des Trägersubstrats **1360** mit einer oder mehreren Justiermarken **5210, 5220** versehen. Die Justiermarken **5210, 5220** können auch in einem vorhergehenden Prozessschritt angefertigt worden sein. Beispielsweise ist es denkbar, eine oder mehrere linke Justiermarken **5210** zusammen mit der elektrisch leitenden linken Signalmassefläche **1310** der der beispielhaften Triplate-Leitung **2380** zu fertigen. Beispielsweise ist es denkbar, eine oder mehrere rechte Justiermarken **5220** zusammen mit der elektrisch leitenden rechten Signalmassefläche **1320** der der beispielhaften Triplate-Leitung **2380** zu fertigen.

### Figur 64

in einem nachfolgenden Schritt des Verfahrens wird die Oberfläche des Trägersubstrats **1360** mit der Sensorelementschicht **4810** teilweise bedeckt. Dies kann beispielsweise durch Siebdruck und/oder einen Dispenser erfolgen. Die Sensorelementschicht **4810** umfasst bevorzugt eine dieser kolloidale Mischung (kolloidaler Lack **KL**) der Diamant-Nano-Kristalle **ND** und des noch flüssigen Trägermaterials **TM.** Die Sensorelementschicht **4810** ist also vorzugsweise mit Diamant-Nano-Kristallen **ND** angefüllt. Vorzugsweise umfassen die Diamant-Nano-Kristalle **ND** paramagnetische Zentren, die bei Bestrahlung mit elektromagnetischer Pumpstrahlung **LB** der Pumpstrahlungswellenlänge **λₚₘₚ** Fluoreszenzstrahlung **FL** mit einer Fluoreszenzstrahlungswellenlänge **λ_{fl}** emittieren. Ganz besonders bevorzugt handelt es sich bei den paramagnetischen Zentren um NV-Zentren. Ggf. wird die Oberfläche des Trägersubstrats **1360** beispielsweise durch Plasma-Terminierung und/oder durch eine Haftvermittlerschicht vorbehandelt, um eine gute Benetzung der Oberfläche des Trägersubstrats **1360** durch das noch flüssige Trägermaterial **TM** sicherzustellen. Ggf. erfolgt in einem weiteren Schritt eine Anhärtung des Trägermaterials TM der Sensorelementschicht **4810** z.B. in einem nachfolgenden Temperatur- oder Lagerschritt.

### Figur 65

In einem nachfolgenden Schritt des Verfahrens bestrahlt eine Aushärtestrahlungsquelle typischerweise die Sensorelementschicht **4810** mit der Aushärtestrahlung **4910** der Aushärtewellenlänge **λ_{H}.** In der Figur 65 verdeckt die Sensorelementschicht **4810** den mittleren optischen Lichtwellenleiter **LWL (4630),** der sich hier unter der Sensorelementschicht **4810** befindet. In der Figur 65 strukturiert eine Schattenmaske **5410** die Aushärtestrahlung **4910.** Typischerweise weist die Schattenmaske **5410** einige für die elektromagnetische Aushärtestrahlung **4910** der Aushärtewellenlänge **λ_{H}** transparente Transmissionsbereiche **5420** auf. Die übrigen Bereiche der Schattenmaske **5410** sind für die elektromagnetische Aushärtestrahlung **4910** der Aushärtewellenlänge **λ_{H}** typischerweise im Wesentlichen nicht transparent. Im Bereich der Transmissionsbereiche **5420** bestrahlt dann die Aushärtestrahlungsquelle die Sensorelementschicht **4810** mit elektromagnetischer Aushärtestrahlung **4910** der Aushärtewellenlänge **λ_{H}** in bestrahlten Bereichen der Sensorelementschicht **4810.** Diese Aushärtestrahlung **4910** tritt in diesen bestrahlten Bereichen der Sensorelementschicht **4810** in die Masse der Sensorelementschicht **4810** ein. Hierdurch bestrahlt die Aushärtestrahlung **4910** das zuerst noch flüssige Trägermaterial **TM** der Sensorelementschicht **4810** in diesen bestrahlten Bereichen der Sensorelementschicht **4810** mit elektromagnetischer Aushärtestrahlung **4910** der Aushärtewellenlänge **λ_{H}.** Hierdurch verfestigt sich das ausgehärtete Trägermaterial **TM** der Sensorelementschicht **4810** in diesen bestrahlten Bereichen der Sensorelementschicht **4810** zu verfestigtem Trägermaterial **TM** der Sensorelementschicht **4810.** Dadurch bildet sich bereits jetzt das spätere mittlere Sensorelements **SE(1320)** in der Sensorelementschicht **4810.**

Das Problem ist allerdings, dass das Verfahren nicht selbstjustierend ist und daher höhere Toleranzen aufweist.

### Figur 66

In einem nachfolgenden Schritt des Verfahrens wird nun das schon gebildete mittlere Sensorelements **SE(1320)** durch Reinigung mit einem Lösungsmittel freigelegt. Die Reinigung mit dem Lösungsmittel entfern die nicht oder nicht ausreichend mit elektromagnetischer Aushärtestrahlung **4910** der Aushärtewellenlänge **λ_{H}** bestrahlten Bereiche der Sensorelementschicht **4810.** Das zurückbleibende mittlere Sensorelement **SE(1320)** ist bei richtiger Justierung der Maske **5410** gegenüber dem Trägersubstrat **1360** an den mittleren optischen Lichtwellenleiter **LWL (4630)** optisch angekoppelt. Das Besondere des in dem hier vorgelegten Dokument vorgeschlagenen mittleren optischen Lichtwellenleiter **LWL (4630)** ist, dass das Trägermaterial **TM** ein mittels elektromagnetischer Aushärtestrahlung **4910** ausgehärtetes Trägermaterial **TM** ist und dass das Trägermaterial **TM** nach dem Aushärten für elektromagnetische Strahlung mit einer Pumpstrahlungswellenlänge **λₚₘₚ** der Pumpstrahlung **LB,** mit der die NV-Zentren und/oder die anderen paramagnetischen Zentren in den Diamant-Nano-Kristallen **ND** gepumpt werden, im Wesentlichen transparent ist. Bevorzugt ist das Trägermaterial **TM** nach dem Aushärten für elektromagnetische Strahlung mit einer Fluoreszenzstrahlungswellenlänge **λ_{fl}** der Fluoreszenzstrahlung **FL,** mit der die NV-Zentren und/oder die anderen paramagnetischen Zentren in den Diamant-Nano-Kristallen **ND** bei Bestrahlung mit elektromagnetischer Strahlung mit einer Pumpstrahlungswellenlänge **λₚₘₚ** der Pumpstrahlung **LB** fluoreszieren, im Wesentlichen transparent ist. Im Wesentlichen bedeutet dabei jeweils, dass die unzweifelhaft auftretenden Verluste immer noch so gering sind, dass die Funktionsfähigkeit der betreffenden Anwendung immer noch gegeben ist. Durch die Aushärtung eines zuvor flüssigen Trägermittels **TM** ist die Fertigung eines solchen mittleren optischen Lichtwellenleiter **LWL (4630)** besonders einfach und prozesssicher mit einem akzeptablen Cₚₖ-Wert zu fertigen.

Hinsichtlich des Trägermaterials **TM** verweist das hier vorgelegte Dokument hier auf die anderen Beschreibungen des Trägermaterials **TM** in diesem Dokument.

Das Wesentliche des hier vorgelegten Dokuments ist nun, dass es auch ein Verfahren zur Herstellung eines Lichtwellenleiters **LWL(4630),** wie er zuvor beschrieben und verwendet wurde, beschreibt und offenlegt. Das vorgeschlagene Verfahren umfasst die Schritte:
- Bereitstellen **15410** eines Lichtwellenleiters **LWL(4630),** wobei der Lichtwellenleiter **LWL(4630)** ein erstes Ende und ein zweites Ende aufweist;
- Bereitstellen **15420** eines flüssigen und mittels elektromagnetischer Strahlung (Aushärtestrahlung **4910)** einer Aushärtewellenlänge λ_{H} härtbaren Trägermaterials **TM,** wobei in das Trägermaterial **TM** eine Vielzahl von Kristallen und/oder Diamant-Nano-Kristallen **ND,** vorzugsweise Nanodiamanten, eingebettet sind und wobei einer oder mehrere oder alle Kristalle und/oder Diamant-Nano-Kristalle **ND** NV-Zentren und/oder andere paramagnetischen Zentren aufweisen und wobei die NV-Zentren der Kristalle und/oder Diamant-Nano-Kristalle **ND** des Trägermaterials **TM** und/oder die anderen paramagnetischen Zentren der Kristalle und/oder Diamant-Nano-Kristalle **ND** des Trägermaterials **TM** bei Bestrahlung mit Pumpstrahlung **LB** mit einer Pumpstrahlungswellenlänge **λₚₘₚ** zumindest eine Fluoreszenzstrahlung **FL** mit einer Fluoreszenzstrahlungswellenlänge **λ_{fl}** emittieren;
- Beschichten **15430** des zweiten Endes des Lichtwellenleiters **LWL(4630)** zumindest auf eine Benetzungslänge L_{B} mit dem Trägermaterial **TM,** das die Vielzahl eingebetteter Kristalle und/oder Diamant-Nano-Kristalle **ND** mit NV-Zentren und/oder paramagnetischen Zentren aufweist;
- Justieren **15440** einer Belichtungsmaske **5410** gegenüber dem Trägersubstrat **1360.**
- Bestrahlen **15450** des zweiten Endes des Lichtwellenleiters **LWL(4630)** durch die Belichtungsmaske **5410** mit elektromagnetischer Strahlung (Aushärtestrahlung **4910),** wobei die Wellenlänge dieser elektromagnetischen Strahlung, die Aushärtewellenlänge **λ_{H},** so gewählt ist, dass das Trägermaterial **TM** am zweiten Ende des Lichtwellenleiters **LWL(4630)** aushärtet und sich in einen Festkörper wandelt;
- Entfernen **15460** des nicht ausgehärteten Trägermaterials **TM** insbesondere mittels eines Lösungsmittels **LM,** wobei der verbleibende Film des Trägermaterials **TM** am zweiten Ende des Lichtwellenleiters **LWL(4630)** zumindest teilweise das Sensorelement **SE** bildet.

Typischerweise härtet das Trägermaterial **TM** nur teilweise aus, was die Bildung des optischen Funktionselements und des Sensorelements **SE** ermöglicht.

Die Strahlung der am zweiten Ende des Lichtwellenleiters LWL**(4630)** zur Aushärtung eingestrahlten Aushärtestrahlung **4910** ist bevorzugt UV-Strahlung. Ganz besonders bevorzugt ist eine Aushärtestrahlung **4910** zur Aushärtung mit einer Aushärtewellenlänge λ_{H} zwischen 320-380nm.

In bestimmten Anwendungsfällen können dem Trägermaterial **TM** Nanopartikel mit einem Durchmesser kleiner 200nm und/oder kleiner 100nm und/oder kleiner 50nm und/oder kleiner 20nm und/oder kleiner 10nm und/oder kleiner 5nm vor dem Bereitstellen beigemischt werden, sodass diese in dem Trägermaterial **TM** nach dem Aushärten eingelagert sind. Bevorzugt handelt es sich um metallische Nanopartikel. Das hier vorgelegte Dokument weist hier in diesem Zusammen hang auf die anderen Beschreibungen diese Nanopartikel hin, die hier auch gelten sollen.

### Figur 67

Figur 67 entspricht der Figur 61 ergänzt um eine Flachspule **2520** als Magnetfelderzeugungsmittel **L_{C}.** Die besagte Flachspule **2520** ist nur ein Beispiel für ein mögliches Magnetfelderzeugungsmittel **L_{C}.** Die Flachspule **2520** kann mehrere Windungen und mehrere Lagen aufweisen. In dem Beispiel der Figur 67 ist die Flachspule **2520** durch eine Isolationsschicht **2510** von dem elektrisch leitenden Rückseitenkontakt **1370** der beispielhaften Triplate-Leitung **2380** elektrisch isoliert. Die Flachspule **2520** erzeugt bei Bestromung durch eine Treiberstufe **DRVL,** die zur Versorgung des Magnetfelderzeugungsmittels **L_{C}** in Form der Flachspule **2520** mit elektrischer Energie und/oder zur Steuerung des Magnetfelderzeugungsmittels **L_{C}** in Form der Flachspule **2520** dient, ein magnetisches Feld mit einer zusätzlichen magnetischen Flussdichte **B_{ad}**.

Diese zusätzliche magnetische Flussdichte **B_{ad}** durchflutet nun das auf dem Signalleiter **1330** der beispielhaften Mikrostripleitung **1380** bzw. der beispielhaften Triplate-Leitung **2380** platzierte mittlere Sensorelement **SE(1420).**

Damit können Vorrichtungen entsprechend den Figuren 69 bis 71 und 73 bis 81 diese Flachspule **2520** als ein die magnetische Gesamtflussdichte **B_{Σ}** kompensierendes und/oder modulierendes und/oder änderndes Magnetfelderzeugungsmittel **L_{C}** nutzen.

Damit können Vorrichtungen entsprechend den Figuren 69 bis 71 und 73 bis 81 diese Flachspule **2520** als ein den Vektor **1450** der magnetische Flussdichte **B_{µW}** des Mikrowellenfeldes des Mikrowellensignals **µW,** das die Mikrowellensignalquelle **µWG** in die Signalleitung **1330** der Tri-Plate-Leitung **2380** einspeist, kompensierendes und/oder modulierendes und/oder änderndes Magnetfelderzeugungsmittel **L_{C}** nutzen.

Hier repräsentiert der Vektor **1450** der magnetische Flussdichte **B_{µW}** des Mikrowellenfeldes des Mikrowellensignals **µW** , die das mittlere Sensorelement **SE(1420)** durchdringt.

### Figur 68

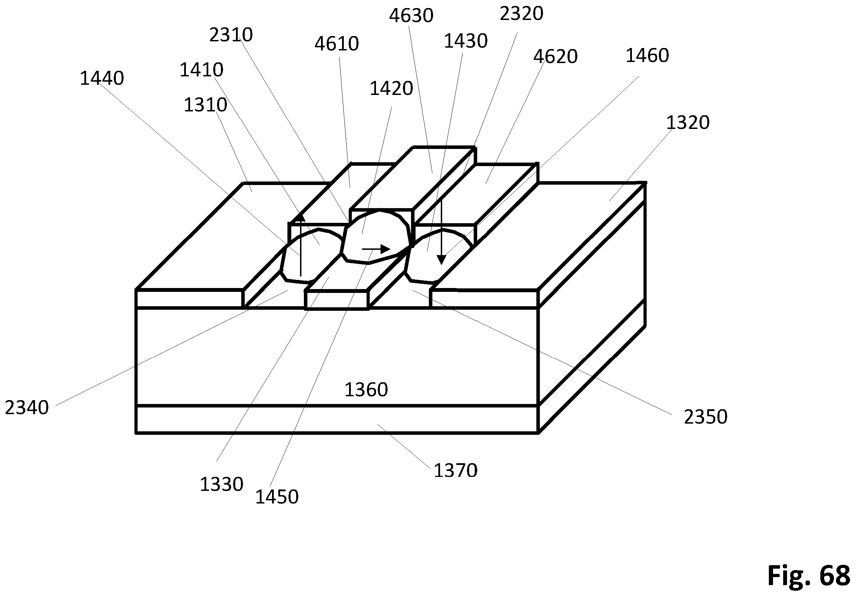

Figur 68 wendet die Prinzipien der Sensorelementherstellung auf alle drei Sensorelemente **(1410, 1420, 1430)** an. Diesen korrespondieren drei Lichtwellenleiter **(4610, 4620, 4630),** die optisch gegeneinander vorzugsweise durch Blenden etc. isoliert sind.

Hinsichtlich der Herstellungsmethoden des rechten Sensorelements **SE(1430)** und des linken Sensorelements **SE(1410)** und des mittleren Sensorelements **SE(1420)** verweist das hier vorgelegte Dokument auf die Beschreibungen der Figuren 58 bis 66, wobei die dort beschriebenen Methoden zur Herstellung des mittleren Sensorelements **SE(1420)** im funktionalen Zusammenhang mit dem mittleren optischen Lichtwellenleiter **LWL (4630)** hier nun auf die Herstellung des rechten Sensorelements **SE(1430)** im Zusammenhang mit dem rechten Lichtwellenleiter **LWL(4620)** und auf die Herstellung des linken Sensorelements **SE(1410)** im Zusammenhang mit dem linken Lichtwellenleiter **LWL(4610)** und auf die Herstellung des mittleren Sensorelements **SE(1420)** im Zusammenhang mit dem mittleren Lichtwellenleiter **LWL(4630)** angewendet werden können.

### Figur 69

Figur 69 zeigt eine beispielhafte, schematische und vereinfachte Vorrichtung zur Ansteuerung, Vermessung und Auswertung von beispielhaften Sensorköpfen, wie sie die Figuren 54 bis 68 zeigen, wenn sie ein Sensorelement **SE** aufweisen. Das hier vorgelegte Dokument bezeichnet solche Vorrichtungen auch als Messvorrichtungen.

Die Messvorrichtung der Figur 69 umfasst einen Sensorkopf, der beispielhaft ein Trägersubstrat **1360** mit einer beispielhaften Tri-Plate-Leitung **2380** aufweist. Das hier vorgelegte Dokument weist darauf hin, dass statt der Tri-Plate-Leitung **2380** beispielsweise auch andere Hochfrequenz-Streifenleitungen wie beispielsweise Mikrostreifenleitungen **1380,** oder Schlitzleitungen **1880** oder differentielle Mikrostripleitung **6830** oder differentielle Triplate-Leitungen **7080** verwendet werden können.

Die Tri-Plate-Leitung **2380** in dem Beispiel der Figur 69 umfasst ein vorzugsweise nicht oder nur wenig elektrisch leitendes, vorzugsweise dielektrisches Trägersubstrat **1360,** typischerweise einen hier nicht eingezeichneten elektrisch leitenden Rückseitenkontakt **1370** auf der Unterseite des elektrisch nicht leitenden Trägersubstrats **1360,** eine elektrisch leitende linke Signalmassefläche **1310** auf der Oberseite des elektrisch nicht leitenden Trägersubstrats **1360,** eine elektrisch leitende rechte Signalmassefläche **1320** auf der Oberseite des elektrisch nicht leitenden Trägersubstrats **1360,** eine elektrisch leitende Signalleitung **1330** auf der Oberseite des elektrisch nicht leitenden Trägersubstrats **1360** zwischen der elektrisch leitende linken Signalmassefläche **1310** und der elektrisch leitende rechten Signalmassefläche **1320.** Dabei trennt eine elektrisch im Wesentlichen nicht-leitende linke Isolationslücke **2340** die elektrisch leitende Signalleitung **1330** von der elektrisch leitenden linken Signalmassefläche **1310.** Außerdem trennt eine elektrisch im Wesentlichen nicht-leitende rechte Isolationslücke **2350** die elektrisch leitende Signalleitung **1330** von der elektrisch leitenden rechten Signalmassefläche **1320.** Bevorzugt weist die Tri-Plate-Leitung **2380** bezogen auf die elektrisch leitende Signalleitung **1330** als "heißen" Innenleiter und die Gemeinschaft aus elektrisch leitender linken Signalmassefläche **1310,** elektrisch leitender rechter Signalmassefläche **1320** und elektrisch leitendem Rückseitenkontakt **1370** als Masseelektroden einen Wellenwiderstand auf.

Ein Mikrowellensignalquelle **µWG** erzeugt beispielsweise ein Mikrowellensignal **µW** und speist es in die Wellenleitung, hier die beispielhafte Tri-Plate-Leitung **2380,** ein. Das Magnetfeld mit einer magnetischen Flussdichte **B_{µW}** des Mikrowellenfeldes des Mikrowellensignals **µW** wirkt auf das Sensorelement **SE** ein. Bevorzugt ist die Wellenleitung, hier die beispielhafte Tri-Plate-Leitung **2380,** an ihrem der Mikrowellensignalquelle **µWG** abgewandten Ende mittels eines oder mehrerer Abschlusswiderstände **6710** reflexionsfrei mit dem Wellenwiderstand der Wellenleitung, hier der beispielhaften Tri-Plate-Leitung **2380,** betragsgleich abgeschlossen oder mit einer mikrowellenfähigen Kupplung versehen. Diese Abschlusswiderstände sind in der Figur 69 nicht eingezeichnet, jedoch Teil der Beanspruchung. Durch die Verwendung von Abschlusswiderständen **6710** an dem der Mikrowellensignalquelle **µWG** abgewandten Ende der Wellenleitung, hier die beispielhafte Tri-Plate-Leitung **2380,** reflektiert das an dem der Mikrowellensignalquelle **µWG** abgewandten Ende der Wellenleitung, hier der beispielhaften Tri-Plate-Leitung **2380,** liegende Ende der Wellenleitung, hier das Ende der beispielhafte Tri-Plate-Leitung **2380,** nur wenig Leistung zurück in Richtung des Sensorelements **SE** und Mikrowellensignalquelle **µWG.** Durch die Verwendung von Abschlusswiderständen **6710** an dem der Mikrowellensignalquelle **µWG** abgewandten Ende der Wellenleitung, hier die beispielhafte Tri-Plate-Leitung **2380,** kann das Mikrowellensignal **µW**, das auf das Sensorelement **SE** einwirkt, sehr daher präzise durch die Mikrowellensignalquelle **µWG** erzeugt und kontrolliert werden. Außerdem vermeidet diese Konstruktion eine unnötige Aufheizung des Sensorelements **SE** und damit des Trägermaterials **TM.** Vorzugsweise entspricht der Innenwiderstand der Mikrowellensignalquelle **µWG** im Wesentlichen dem Wellenwiderstand der Wellenleitung, hier die beispielhafte Tri-Plate-Leitung **2380.** Hierdurch reflektiert die Mikrowellensignalquelle **µWG** nur wenig Leistung zurück in Richtung des Sensorelements **SE** und der Abschlusswiderstände **6710.**

Das Sensorelement **SE** umfasst typischerweise eine Vielzahl von Diamant-Nano-Kristallen **ND** und/oder Kristalle in dem verfestigten Trägermaterial **TM.** Ein oder mehrere oder alle Diamant-Nano-Kristalle **ND** dieser Diamant-Nano-Kristalle **ND** weisen dabei typischer Weise ein oder mehrere NV-Zentren und/oder ein oder mehrere andere paramagnetische Zentren auf. Ein oder mehrere oder alle Kristalle dieser Kristalle weisen dabei typischer Weise ein oder mehrere andere paramagnetische Zentren auf. Die NV-Zentren des Sensorelements **SE** und/oder die anderen paramagnetischen Zentren des Sensorelements **SE** emittieren bei Bestrahlung mit Pumpstrahlung **LB** mit einer Pumpstrahlungswellenlänge **λₚₘₚ** typischerweise zumindest eine Fluoreszenzstrahlung **FL.** mit einer Fluoreszenzstrahlungswellenlänge **λ_{fl}.**

Bei dem Sensorelement **SE** kann es sich beispielsweise um ein oder mehrere der in den Figuren 54 bis 68 dargestellten Sensorelemente **SE** handeln.

Die magnetische Gesamtflussdichte **B_{Σ}** durchflutet das Sensorelement **SE.** Typischerweise beeinflusst die magnetische Gesamtflussdichte **B_{Σ}** die Intensität der Fluoreszenzstrahlung **LB,** die die NV-Zentren des Sensorelements **SE** und/oder die anderen paramagnetischen Zentren des Sensorelements **SE** emittieren.

Eine Lichtquelle **LED** dient als Pumpstrahlungsquelle für die Pumpstrahlung **LB** mit der Pumpstrahlungswellenlänge **λₚₘₚ.** Die Pumpstrahlungsquelle, hier die Lichtquelle **LED,** bestrahlt das Sensorelement **SE** über einen Lichtwellenleiter **LWL** mit der Pumpstrahlung **LB** der Pumpstrahlungswellenlänge **λₚₘₚ.** Bei der Lichtquelle **LED** kann es sich beispielsweise um eine Leuchtdiode oder um einen Laser handeln. Ein Sendesignal **S5** zur Modulation der Lichtquelle **LED** steuert vorzugsweise die Intensität der von der Lichtquelle **LED** emittierten Pumpstrahlung **LB.**

Bevorzugt ist das Sendesignal **S5** mit einem LED-Modulationssignal **S5w** in seinem zeitlichen Verlauf amplitudenmoduliert. Typischerweise weist das zeitlich modulierte LED-Modulationssignal des Sendesignals **S5** ein LED-Modulationsspektrum im Frequenzbereich auf. Beispielsweise kann das LED-Modulationssignal **S5w** ein PWM-Modulationssignal mit einer PWM-Periodendauer und einem Tastgrad sein. Auch kann das LED-Modulationssignal **S5w** ein Spreiz-Code-Signal auf Basis einer Reihenfolge einer ersten Anzahl von 1-Bits und einer zweiten Anzahl von 0-sein, wobei die Bits des Spreiz-Codes eine Spreiz-Code-bit-Periodendauer aufweisen und wobei der Spreiz-Code eine Spreiz-Code-Periodendauer aufweist. Typischerweise wiederholt sich bei der Verwendung eines Spreiz-Codes dieser Spreiz-Code im LED-Modulationssignal **S5w.** Die erste Anzahl der 1-Spreiz-Code-Bits in einem Spreiz-Code ist vorzugsweise aber nicht notwendigerweise gleich der zweiten Anzahl der 0-Spreiz-Code-Bits in dem Spreiz-Code. Der Spreiz-Code kann auch unendlich lang sein und durch einen Zufallszahlengenerator (Abkürzung RNG) erzeugt werden, der Teil der Vorrichtung sein kann. Der Zufallszahlengenerator (Abkürzung RNG) kann ein Pseudozufallszahlengenerator (Abkürzung PRNG) beispielsweise auf Basis eines linear rückgekoppelten Schieberegisters (Abkürzung LFSR) oder ein echter Zufallszahlengenerator (Abkürzung TRNG) oder ein Quantenzufallszahlengenerator (Abkürzung QRNG) sein. Typischerweise weist der zeitliche Intensitätsverlauf der Intensität der von der Lichtquelle **LED** emittierten Pumpstrahlung **LB** ein Pumpstrahlungsintensitätsspektum auf, das in der Regel ein mehr oder weniger deformiertes LED-Modulationsspektrum ist. Die Deformation ergibt sich in der Regel aus dem nichtlinearen Verhalten der Lichtquelle **LED.** Ist das LED-Modulationssignal monofrequent, so ist in der Regel auch der zeitliche Intensitätsverlauf der Intensität der von der Lichtquelle **LED** emittierten Pumpstrahlung **LB** monofrequent mit der gleichen LED-Sendefrequenz f_{LED}.

Ein erstes optisches System (hier **F1, LWL**) erfasst die Pumpstrahlung **LB** der Pumpstrahlungsquelle, hier der Lichtquelle **LED,** und transportiert die Pumpstrahlung **LB** zu den einem oder den mehreren Sensorelementen **SE** des Sensorkopfes und bestrahlt das Sensorelementen **SE** des Sensorkopfes mit dieser Pumpstrahlung **LB.** Bevorzugt weist das erste optische System ein optisches Funktionselement, beispielsweise eine Einkoppelstruktur, zur Erfassung eines möglichst großen Anteils der Pumpstrahlung **LB** der Pumpstrahlungsquelle, hier der Lichtquelle **LED,** auf. Bevorzugt weist das erste optische System ein optisches Funktionselement, beispielsweise eine Auskoppelstruktur, zur Bestrahlung des Sensorelements **SE** mit einem möglichst großen Anteils der von dem ersten optischen Funktionselement erfassten Pumpstrahlung **LB** der Pumpstrahlungsquelle, hier der Lichtquelle **LED,** auf. In dem Beispiel der Figur 69 transportiert ein Lichtwellenleiter **LWL** die Pumpstrahlung **LB** zu den einem oder den mehreren Sensorelementen **SE** des Sensorkopfes. Ein solches erstes optisches System kann ein oder mehrere optische Funktionselemente, wie beispielsweise aber nicht nur Linse, Prismen, Blenden, Filter, Spiegel, Strahlteiler, dichroitische Spiegel, photonische Kristalle, Lichtwellenleiter etc. umfassen.

Die elektromagnetische Pumpstrahlung **LB** mit der Pumpstrahlungswellenlänge **λₚₘₚ** regt die NV-Zentren bzw. die paramagnetischen Zentren in dem Sensorelement **SE** dazu an, Fluoreszenzstrahlung **FL** der Fluoreszenzwellenlänge **λ_{fl}** zu emittieren. Typischerweise weist der zeitliche Intensitätsverlauf der Intensität der von dem Sensorelement **SE** emittierten Fluoreszenzstrahlung **FL** ein Fluoreszenzstrahlungsintensitätsspektum auf. Das Fluoreszenzstrahlungsintensitätsspektum ist in der Regel ein mehr oder weinige deformiertes Pumpstrahlungsintensitätsspektum und daher ein ebenfalls mehr oder weniger deformierte LED-Modulationsspektrum. Ist das LED-Modulationssignal monofrequent, so ist in der Regel auch der zeitliche Intensitätsverlauf der Intensität der von der Lichtquelle **LED** emittierten Pumpstrahlung **LB** monofrequent mit der LED-Modulationsfrequenz **f_{LED}** und auch der zeitliche Intensitätsverlauf der Intensität **Iᵢₛₜ(t)** der von dem Sensorelement **SE** emittierten Fluoreszenzstrahlung **FL** monofrequent mit der gleichen LED-Sendefrequenz **f_{LED}**.

Ein zweites optisches System (hier **F1, LWL**) erfasst die Fluoreszenzstrahlung **FL** des Sensorelements **SE** und transportiert die Fluoreszenzstrahlung **FL** zu den einem oder den mehreren Fotodetektor **PD** und bestrahlt den einen oder die mehreren Fotodetektoren **PD** mit dieser Fluoreszenzstrahlung **FL.** Bevorzugt weist das zweite optische System ein optisches Funktionselement, beispielsweise eine Einkoppelstruktur, zur Erfassung eines möglichst großen Anteils der Fluoreszenzstrahlung **FL** des Sensorelements **SE** auf. Bevorzugt weist das zweite optische System ein optisches Funktionselement, beispielsweise eine Auskoppelstruktur, zur Bestrahlung des einen oder der mehreren Fotodetektoren **PD** mit einem möglichst großen Anteil der von dem zweiten optischen System erfassten Fluoreszenzstrahlung **FL** des Sensorelements **SE** auf. In dem Beispiel der Figur 69 erfasst ein Lichtwellenleiter **LWL** die Fluoreszenzstrahlung **LB** und transportiert die erfasste Fluoreszenzstrahlung **LB** zu dem einen oder den mehreren Fotodetektoren **PD.** Typischerweise umfasst das zweite optische System ein optisches Funktionselement, beispielsweise einen Filter **F1** und/oder einen dichroitischen Spiegel, die verhindern, dass Pumpstrahlung **LB** auf den einen oder die mehreren Fotodetektoren **PD** gelangt. Ein solches zweites optisches System kann ein oder mehrere optische Funktionselemente, wie beispielsweise aber nicht nur Linsen, Prismen, Blenden, Filter **F1,** Spiegel, Strahlteiler, dichroitische Spiegel, photonische Kristalle, Lichtwellenleiter **LWL** etc. umfassen.

Bevorzugt sind das erste optischen System und das zweite optische System zu einem großen Anteil ihrer Vorrichtungsteile identisch.

In dem Beispiel der Figur 69 emittiert die Pumpstrahlungsquelle in Form der Lichtquelle **LED** die Pumpstrahlung **LB** mit der Pumpstrahlungswellenlänge **λₚₘₚ.** Ein dichroitischer Spiegel **F1** als erster beispielhafter Teil des ersten optischen Systems lässt die Pumpstrahlung **LB** passieren. Ein Lichtwellenleiter **LWL** als zweiter beispielhafter Teil des ersten optischen Systems nimmt die Pumpstrahlung **LB** an seinem ersten Ende auf und transportiert die Pumpstrahlung **LB** zu dem zweiten Ende des Lichtwellenleiters **LWL.** Die Pumpstrahlung **LB** tritt am zweiten Ende des Lichtwellenleiters **LWL** aus dem Lichtwellenleiter **LWL** aus und bestrahlt ein oder mehrere Sensorelemente **SE** des Sensorkopfes.

Die Pumpstrahlung **LB** mit der Pumpstrahlungswellenlänge **λₚₘₚ** bestrahlt somit die paramagnetischen Zentren und/oder die NV-Zentren in den Diamant-Nano-Kristallen **ND** bzw. Kristallen des einen oder der mehreren Sensorelemente **SE.** Die so bestrahlten NV-Zentren und/oder paramagnetischen Zentren in den Diamant-Nano-Kristallen **ND** emittieren aufgrund der Bestrahlung mit der Pumpstrahlung **LB** Fluoreszenzstrahlung **FL** mit einer Fluoreszenzwellenlänge **λ_{fl}.** Die Fluoreszenzwellenlänge **λ_{fl}** ist typischerweise von der Pumpstrahlungswellenlänge **λₚₘₚ** verschieden. Typischerweise ist die Fluoreszenzwellenlänge **λ_{fl}** typischerweise langwelliger als die Pumpstrahlungswellenlänge **λₚₘₚ.** Typischerweise hängt die Intensität der Fluoreszenzstrahlung **FL** von der magnetischen Gesamtflussdichte **B_{Σ}**, der Mikrowellenamplitude und der Mikrowellenfrequenz des Mikrowellensignals **µW** und der Intensität der Pumpstrahlung **LB** ab.

Vorzugsweise erfasst der Lichtwellenleiter **LWL** als erster beispielhafter Teil des zweiten optischen Systems an seinem zweiten Ende einen möglichst großen Anteil der emittierten Fluoreszenzstrahlung **FL** der NV-Zentren und/oder der paramagnetischen Zentren in den Diamant-Nano-Kristallen **ND** des einen oder der mehreren Sensorelemente **SE.** Hierfür ist eine gute Justierung zwischen dem Sensorelement und dem Kern des Lichtwellenleiters **LWL** notwendig. Bevorzugt ist das Sensorelement **SE** daher mittels eines selbstjustierenden Prozesses am zweiten Ende des Lichtwellenleiters **LWL** gefertigt. Der Lichtwellenleiter **LWL** transportiert die so erfasste Fluoreszenzstrahlung **FL** von dem zweiten Ende des Lichtwellenleiters **LWL** zu dem ersten Ende des Lichtwellenleiters **LWL.** Ein beispielhafter dichroitischer Spiegel **F1** als zweites beispielhaftes optisches Funktionselement des zweiten optischen Systems trennt die Fluoreszenzstrahlung **FL** von der Pumpstrahlung **LB** indem der dichroitische Spiegel **F1** die Fluoreszenzstrahlung FL im Wesentlichen aus dem Strahlengang heraus auf einen Fotodetektor **PD** spiegelt und die Pumpstrahlung **LB** im Wesentlichen nicht aus dem Strahlengeng herausspiegelt.

Bevorzugt umfasst das zweite optische System somit ein optisches Funktionselement **(F1),** das die Fluoreszenzstrahlung **FL** in Richtung des Fotodetektors **PD** passieren lässt oder umlenkt und das die Pumpstrahlung **LB** in Richtung des Fotodetektors **PD** nicht passieren lässt und nicht umlenkt.

Aus dem Stand der Technik ist bekannt, die Amplitude des Mikrowellensignals **µW** mit einem Mikrowellenmodulationssignal oder alternativ die Amplitude der Pumpstrahlung **LB** mit einem LED-Modulationssignal zu modulieren.

Der hier vorgelegte Vorschlag sieht vor, mindestens zwei, besser drei oder mehr der folgenden Parameter mittels eines jeweiligen Modulationssignals zu modulieren bzw. einzustellen:
1. die Intensität der Pumpstrahlung **LB** (Amplitudenmodulation) z.B. mittels eines LED-Modulationssignals **S5w,**
2. die Intensität des Mikrowellensignal **µW** (Amplitudenmodulation) z.B. mittels eines Mikrowellenmodulationssignals **S5m,**
3. die Frequenz des Mikrowellensignals **µW** (Frequenzmodulation) z.B. mittels eines Mikrowellenfrequenzsteuersignals,
4. die Amplitude einer zusätzlichen, durch ein Magnetfelderzeugungsmittels **L_{C}.** erzeugten magnetischen Flussdichte **B_{ad}** z.B. mittels eines Kompensationsfeldsteuersignals.

Jeder dieser Modulationen ist eine von 4 Modulationsgrundfrequenzen zugeordnet.

### Zu 1. der Modulation der Intensität der Pumpstrahlung LB (Amplitudenmodulation)

Vorzugsweise steuert eine Steuervorrichtung **CTR** der Vorrichtung mittels eines LED-Modulationssignals **S5w** die Intensität der Pumpstrahlung **LB,** die die Pumpstrahlungsquelle, hier die Lichtquelle **LED,** emittiert. Bevorzugt ist das LED-Modulationssignal **S5w** mit einem LED-Modulationsspektrum moduliert. Hierdurch sind dann auch der zeitliche Intensitätsverlauf der Pumpstrahlung **LB** und der zeitliche Intensitätsverlauf der Fluoreszenzstrahlung **FL** sowie die Amplitude des Empfängerausgangssignals **S0** des Fotodetektors **PD** mit einem jeweils mehr oder weniger verzerrten LED-Modulationsspektrum moduliert. Bevorzugt ist das LED-Modulationssignal **S5w** monofrequent mit einer LED -Modulationsfrequenz **f_{LED}** amplitudenmoduliert. Hierdurch sind dann auch der zeitliche Intensitätsverlauf der Pumpstrahlung **LB** und der zeitliche Intensitätsverlauf der Fluoreszenzstrahlung **FL** sowie die Amplitude des Empfängerausgangssignals **S0** des Fotodetektors **PD** im Wesentlichen mit der LED -Modulationsfrequenz **f_{LED}** amplitudenmoduliert.

Eine Modulation kann sein, dass das LED-Modulationssignal **S5w** die Pumpstrahlungsquelle PWM-moduliert. Dabei kann es sinnvoll sein, dass das LED-Modulationssignal **S5w** die Pumpstrahlungsquelle, hier die Lichtquelle **LED,** in einer PWM-Periode zeitweise ganz ausschaltet und für den Rest der betreffenden PWM-Periode einschaltet. Alternativ kann es sinnvoll sein, dass das LED-Modulationssignal **S5w** die Pumpstrahlungsquelle, hier die Lichtquelle **LED,** in einer PWM-Periode zeitweise in ihrer Emissionsintensität reduziert und für den Rest der betreffenden PWM-Periode in ihrer Emissionsintensität erhöht. Im Falle der Verwendung eines Spreiz-Codes kann es sinnvoll sein, wenn das LED-Modulationssignal **S5w** die Pumpstrahlungsquelle, hier die Lichtquelle **LED,** bei Vorliegen eines logischen 0-Spreiz-Code-Bits ganz ausschaltet und die Pumpstrahlungsquelle, hier die Lichtquelle **LED,** bei Vorliegen eines logischen 1-Spreiz-Code-Bits ganz einschaltet. Im Falle der Verwendung eines Spreiz-Codes kann es ggf. auch sinnvoll sein, wenn das LED-Modulationssignal **S5w** die Pumpstrahlungsquelle, hier die Lichtquelle **LED,** bei Vorliegen eines logischen 0-Spreiz-Code-Bits in ihrer Emissionsintensität reduziert und die Pumpstrahlungsquelle, hier die Lichtquelle **LED,** bei Vorliegen eines logischen 1-Spreiz-Code-Bits in ihrer Emissionsintensität erhöht.

### Zu 2. der Modulation der Intensität des Mikrowellensignal µW (Amplitudenmodulation)

Vorzugsweise steuert die Steuervorrichtung **CTR** der Vorrichtung mittels eines Mikrowellenmodulationssignals **S5m** die Amplitude des Mikrowellensignals **µW**, das die Mikrowellensignalquelle **µWG** erzeugt. Bevorzugt ist das Mikrowellenmodulationssignals **S5m** mit einem Mikrowellenmodulationsspektrum moduliert. Hierdurch sind dann auch der zeitliche Intensitätsverlauf der Fluoreszenzstrahlung **FL** sowie die Amplitude des Empfängerausgangssignals **S0** des Fotodetektors **PD** mit einem jeweils mehr oder weniger verzerrten Mikrowellenmodulationsspektrum zusätzlich überlagernd zum LED-Modulationsspektrum moduliert. Bevorzugt ist das Mikrowellenmodulationssignal **S5m** monofrequent mit einer Mikrowellenmodulationsfrequenz **f_{µW}** amplitudenmoduliert. Hierdurch sind dann typischerweise auch der zeitliche Intensitätsverlauf der Intensität **Iᵢₛₜ(t)** der Fluoreszenzstrahlung **FL** sowie die Amplitude des Empfängerausgangssignals **S0** des Fotodetektors **PD** im Wesentlichen mit der Mikrowellenmodulationsfrequenz **f_{µW}** amplitudenmoduliert.

Eine Modulation kann sein, dass das Mikrowellenmodulationssignal **S5m** die Amplitude des Mikrowellensignals **µW**, das die Mikrowellensignalquelle **µWG** erzeugt, PWM-moduliert. Dabei kann es sinnvoll sein, dass das das Mikrowellenmodulationssignal **S5m** die Amplitude des Mikrowellensignals **µW**, das die Mikrowellensignalquelle **µWG** erzeugt, in einer PWM-Periode zeitweise ganz auf null ausschaltet und für den Rest der betreffenden PWM-Periode diese Amplitude auf einen von null verschiedenen Betrag einschaltet. Alternativ kann es sinnvoll sein, dass das Mikrowellenmodulationssignal **S5m** die Amplitude des Mikrowellensignals **µW**, das die Mikrowellensignalquelle **µWG** erzeugt, in einer PWM-Periode zeitweise in ihrer Amplitude reduziert und für den Rest der betreffenden PWM-Periode in ihrer Amplitude erhöht. Im Falle der Verwendung eines Spreiz-Codes kann es sinnvoll sein, wenn das Mikrowellenmodulationssignal **S5m** die Amplitude des Mikrowellensignals **µW**, das die Mikrowellensignalquelle **µWG** erzeugt, bei Vorliegen eines logischen 0-Spreiz-Code-Bits ganz auf null ausschaltet und die Amplitude des Mikrowellensignals **µW**, das die Mikrowellensignalquelle **µWG** erzeugt, bei Vorliegen eines logischen 1-Spreiz-Code-Bits ganz auf eine von null verschiedene Amplitude einschaltet. Im Falle der Verwendung eines Spreiz-Codes kann es ggf. auch sinnvoll sein, wenn das Mikrowellenmodulationssignal **S5m** die Amplitude des Mikrowellensignals **µW**, das die Mikrowellensignalquelle **µWG** erzeugt, bei Vorliegen eines logischen 0-Spreiz-Code-Bits in ihrer Amplitude reduziert und die Amplitude des Mikrowellensignals **µW**, das die Mikrowellensignalquelle **µWG** erzeugt, bei Vorliegen eines logischen 1-Spreiz-Code-Bits in ihrer Amplitude erhöht.

### Zu 3. der Modulation der Frequenz des Mikrowellensignals µW (Frequenzmodulation)

Vorzugsweise steuert die Steuervorrichtung **CTR** der Vorrichtung beispielsweise über einen Datenbus **DB** mittels eines Mikrowellenfrequenzsteuersignals die Frequenz des Mikrowellensignals **µW**, das die Mikrowellensignalquelle **µWG** erzeugt. Bevorzugt führt die Frequenzmodulation durch das Mikrowellenfrequenzsteuersignal über den Datenbus **DB** zu einem weiteren Mikrowellenmodulationsspektrum mit dem das Mikrowellensignals **µW** dann moduliert ist. Hierdurch sind dann auch der zeitliche Intensitätsverlauf der Intensität **Iᵢₛₜ(t)** der Fluoreszenzstrahlung **FL** sowie die Amplitude des Empfängerausgangssignals **S0** des Fotodetektors **PD** mit einem jeweils mehr oder weniger verzerrten weiteren Mikrowellenfrequenzmodulationsspektrum zusätzlich überlagernd zum LED-Modulationsspektrum und zum Mikrowellenmodulationsspektrum moduliert. Beispielsweise kann die Mikrowellenfrequenz des Mikrowellensignals **µW** monofrequent mit einer Mikrowellenfrequenzmodulationsfrequenz **f_{fµW}** frequenzmoduliert sein. Da die unterschiedlichen Mikrowellenfrequenzen des Mikrowellensignals **µW** unterschiedliche Intensitäten **Iᵢₛₜ(t)** der Fluoreszenzstrahlung **FL** zur Folge haben, sind hierdurch dann auch der zeitliche Intensitätsverlauf der Intensität **Iᵢₛₜ(t)** der Fluoreszenzstrahlung **FL** sowie die Amplitude des Empfängerausgangssignals **S0** des Fotodetektors **PD** dann im Wesentlichen auch mit der Mikrowellenfrequenzmodulationsfrequenz **f_{fµW}** moduliert.

### Zu 4. der Modulation der Amplitude einer zusätzlichen, durch ein Magnetfelderzeugungsmittels Lc. erzeugten magnetischen Flussdichte B_{ad}

Vorzugsweise steuert die Steuervorrichtung **CTR** der Vorrichtung beispielsweise über einen Datenbus **DB** mittels eines Kompensationsfeldsteuersignals die Amplitude einer zusätzlichen magnetischen Flussdichte **B_{ad},** das ein Magnetfelderzeugungsmittel **Lc** erzeugt. Die zusätzliche magnetische Flussdichte **B_{ad}** trägt zur magnetischen Gesamtflussdichte **B_{Σ}** bei. Die magnetische Gesamtflussdichte **B_{Σ}** durchflutet das Sensorelement **SE** und beeinflusst daher die Intensität **Iᵢₛₜ(t)** der Fluoreszenzstrahlung **FL.** Vorzugsweise steuert zu diesem Zweck der Steuerung des ein Magnetfelderzeugungsmittels **L_{c}** die Steuervorrichtung **CTR** über den Datenbus **DB** einen Magnetfeldregler **LCTR.** Der Magnetfeldregler **LCTR** steuert typischerweise eine Treiberstufe **DRVL** zur Versorgung des Magnetfelderzeugungsmittels Lc mit elektrischer Energie und/oder zur Steuerung des Magnetfelderzeugungsmittels **L_{C}.** Somit moduliert die Steuervorrichtung **CTR** über den Magnetfeldregler **LCTR** und die Treiberstufe **DRLV** mittels des beispielsweise über den Datenbus **DB** versendeten Kompensationsfeldsteuersignals die Amplitude der zusätzlichen magnetischen Flussdichte **B_{ad},** die das Magnetfelderzeugungsmittel **L_{C}** in Abhängigkeit vom Kompensationsfeldsteuersignal erzeugt.

Beispielsweise kann das Kompensationsfeldsteuersignal mit einem Magnetfeldmodulationsspektrum moduliert sein. Hierdurch kann die zusätzliche magnetische Flussdichte **B_{ad},** die das Magnetfelderzeugungsmittel Lc in Abhängigkeit vom Kompensationsfeldsteuersignal erzeugt, mit dem Magnetfeldmodulationsspektrum amplitudenmoduliert sein. Die zusätzliche magnetische Flussdichte **B_{ad}** überlagert sich mit anderen magnetischen Flussdichten anderer Quellen zur magnetischen Gesamtflussdichte **B_{Σ}**.Dadurch ist die magnetische Gesamtflussdichte **B_{Σ},** die das Sensorelement **SE** durchflutet, typischerweise im Wesentlichen ebenfalls mit dem Magnetfeldmodulationsspektrum moduliert.

Die Intensität **Iᵢₛₜ(t)** der Fluoreszenzstrahlung **FL** hängt u.a. von der Amplitude der magnetischen Gesamtflussdichte **B_{Σ}** ab. Hierdurch können dann somit auch der zeitliche Intensitätsverlauf der Fluoreszenzstrahlung **FL** sowie in letzter Konsequenz auch die Amplitude des Empfängerausgangssignals **S0** des Fotodetektors **PD** im Wesentlichen mit einem jeweils mehr oder weniger verzerrten Magnetfeldmodulationsspektrum zusätzlich überlagernd zum LED-Modulationsspektrum und zum Mikrowellenmodulationsspektrum und zum Mikrowellenfrequenzmodulationsspektrum moduliert sein. Bevorzugt ist das Kompensationsfeldsteuersignal, wenn es periodisch angelegt ist, monofrequent mit einer Magnetfeldmodulationsfrequenz **f_{mg}** moduliert. Da die unterschiedlichen magnetischen Gesamtflussdichten **B_{Σ}** unterschiedliche Intensitäten der Fluoreszenzstrahlung **FL** zur Folge haben, sind hierdurch dann auch der zeitliche Intensitätsverlauf der Intensität Iᵢₛₜ(t) der Fluoreszenzstrahlung **FL** sowie die Amplitude des Empfängerausgangssignals **S0** des Fotodetektors **PD** mit der Magnetfeldmodulationsfrequenz **f_{mg}** moduliert.

Es ergeben sich in dieser Konfiguration somit 2⁴=16 Mischfrequenzen mit denen das Empfängerausgangssignal **S0** des Fotodetektors **PD** moduliert sein kann.

Vorzugsweise sind die Magnetfeldmodulationsfrequenz **f_{mg},** die Mikrowellenfrequenzmodulationsfrequenz **f_{fµW},** die Mikrowellenmodulationsfrequenz **f_{uW}** und die LED -Modulationsfrequenz **f_{LED}** so gewählt, dass vorzugsweise alle Mischfrequenzen sich unterscheiden.

Dies kann beispielsweise dadurch erreicht werden, dass eine zweite Modulationsgrundfrequenz den doppelten Frequenzwert einer ersten Modulationsgrundfrequenz aufweist und eine dritte Modulationsgrundfrequenz den vierfachen Frequenzwert der ersten Modulationsgrundfrequenz aufweist und eine vierte Modulationsgrundfrequenz den achtfachen Frequenzwert der ersten Modulationsgrundfrequenz aufweist. Beispielsweise ist es, um hier ein willkürliches Beispiel zu nennen, denkbar, dass die die Mikrowellenmodulationsfrequenz **f_{µW}** den achtfachen Frequenzwert der Magnetfeldmodulationsfrequenz **f_{mg}** aufweist und dass die die LED -Modulationsfrequenz **f_{LED}** den vierfachen Frequenzwert der Magnetfeldmodulationsfrequenz **f_{mg}** aufweist und dass die die Mikrowellenfrequenzmodulationsfrequenz **f_{fµW}** den doppelten Frequenzwert der Magnetfeldmodulationsfrequenz **f_{mg}** aufweist.

### Fall mit einer Modulationsgrundfrequenz (Mikrowellenmodulationsfrequenz)

Es ist aus dem Stand der Technik bekannt, die Vorrichtung mit nur einer von 0Hz verschiedenen Modulationsgrundfrequenz zu betreiben und die anderen Werte der anderen Modulationsgrundfrequenzen für die Dauer einer Messung auf quasi statische Werte zu setzen. Im Folgenden stellt das hier vorgelegte Dokument ein Beispiel vor.

Sofern die Steuervorrichtung **CTR** der Vorrichtung beispielsweise
1. über den Datenbus **DB** mittels Steuerung des ersten Signalgenerators **G1** eine Modulation der Intensität der Pumpstrahlung **LB** (Amplitudenmodulation) quasistatisch, also mit einer mit einer LED-Modulationsfrequenz **f_{LED}** =0Hz, einstellt und
2. gleichzeitig über den Datenbus **DB** mittels Steuerung des zweiten Signalgenerators **G2** eine Modulation der Intensität des Mikrowellensignals **µW** (Amplitudenmodulation) mit einer Mikrowellenmodulationsfrequent **f_{µW}** vornimmt und
3. die Mikrowellenfrequenz des Mikrowellensignals **µW** den Datenbus **DB** in der Mikrowellensignalquelle **µWG** quasistatisch, also mit einer Mikrowellenfrequenzmodulationsfrequenz **f**_{**f**µW}=0Hz, einstellt und
4. den Wert des Kompensationsfeldsteuersignals auf einen quasistatischen Wert, d.h. auf eine Magnetfeldmodulationsfrequenz **f**_{mg}=0Hz, und damit auf eine quasistatische, durch die Steuervorrichtung **CTR** eingestellte Amplitude einer zusätzlichen magnetischen Flussdichte **B_{ad},** einstellt, die das Magnetfelderzeugungsmittel Lc erzeugt,

Es ergibt sich somit genau eine Mischfrequenz mit denen das Empfängerausgangssignal **S0** des Fotodetektors **PD** moduliert sein kann.

Ein erster Signalgenerator **G1** erzeugt in diesem Beispiel das das quasi statische LED-Modulationssignal **S5w,** mit einer der LED -Modulationsfrequenz **f_{LED}**=0Hz typischerweise entsprechend einem Vorgabewert, den die Steuervorrichtung **CTR** über den Datenbus **DB** in dem ersten Signalgenerator **G1** eingestellt hat. Die Steuervorrichtung **CTR** steuert den ersten Signalgenerator **G1** bevorzugt über den beispielhaften Datenbus **DB.** Ein Lichtquellentreiber **LDRV** für die Lichtquelle LED erzeugt typischerweise aus dem LED-Modulationssignal **S5w** das quasistatische Sendesignal **S5,** mit dem der Lichtquellentreiber **LDRV** die Lichtquelle **LED** bevorzugt auch mit elektrischer Energie versorgt. Bevorzugt handelt es sich bei der Lichtquelle **LED** um eine Halbleiterlichtquelle wie beispielsweise einen Laser oder eine LED. Ganz besonders bevorzugt umfasst die Lichtquelle **LED** eine Silizium-LED und/oder eine Silizium-Lawinen-LED wodurch dieser Vorrichtungsteil ggf. auch CMOS integrierbar wird.

Die Lichtquelle **LED** emittiert dann in Abhängigkeit von dem Sendesignal **S5** die Pumpstrahlung **LB.** mit der Pumpstrahlungswellenlänge λₚₘₚ.

Das Empfängerausgangssignal **S0** und das verstärkte Empfängerausgangssignal **S1** sind dann wegen LED - Modulationsfrequenz **f_{LED}**=0Hz nicht mit einem LED-Modulationsspektrum moduliert.

In diesem Beispiel der Figur 69 erzeugt ein zweiter Signalgenerator **G2** das Mikrowellenmodulationssignal **S5m** insbesondere mit einer Mikrowellenmodulationsfrequenz **f_{µW}** typischerweise entsprechend einem Vorgabewert, den die Steuervorrichtung **CTR** über den Datenbus **DB** in dem zweiten Signalgenerator **G2** eingestellt hat. Typischerweise moduliert der zweite Signalgenerator **G2** das Mikrowellenmodulationssignal **S5m** mit dem besagten Mikrowellenmodulationsspektrum und/oder mit der besagten Mikrowellenmodulationsfrequenz **f**_{µW}. Ganz besonders bevorzugt handelt es sich bei der Mikrowellenmodulation des Mikrowellenmodulationssignals **S5m** um eine PWM-Modulation mit einer PWM-Frequenz oder einen Bit-Strom eines Spreiz-Code-Signals mit einer Spreiz-Code-Periodendauer und einer Spreiz-Code-Bitfrequenz. Die Steuervorrichtung **CTR** steuert den zweiten Signalgenerator **G2** bevorzugt über den beispielhaften Datenbus **DB.**

Die Mikrowellensignalquelle **µWG** erzeugt dann das mit dem Mikrowellenmodulationssignal modulierte Mikrowellensignal **µW.** Die Steuervorrichtung **CTR** steuert die Mikrowellensignalquelle **µWG** bevorzugt über den beispielhaften Datenbus **DB.**

Da das Mikrowellenmodulationssignal **S5m** mit einem Mikrowellenmodulationsspektrum moduliert ist, ist dann auch das Mikrowellensignal **µW** mit dem Mikrowellenmodulationsspektrum amplitudenmoduliert. Daher ist dann typischerweise auch der zeitliche Intensitätsverlauf der Fluoreszenzstrahlung **FL** mit dem Mikrowellenmodulationsspektrum moduliert. Daher sind dann auch das Empfängerausgangssignal **S0** und das verstärkte Empfängerausgangssignal **S1** mit dem Mikrowellenmodulationsspektrum moduliert. Typischerweise verstärkt ein optionaler erster Verstärker **V1** das Empfängerausgangssignal **S0** des Fotodetektors **PD** zu einem verstärkten Empfängerausgangssignal **S1.** Bevorzugt weist die Übertragungsfunktion des ersten Verstärkers **V1** für die Verstärkung des Empfängerausgangssignals **S0** zum verstärkten Empfängerausgangssignal **S1** eine Filtereigenschaft auf, die typischerweise so gewählt ist, dass der erste Verstärker **V1** im Wesentlichen nur modulierte Signalanteile des Empfängerausgangssignals **S0** mit einer Frequenz f≠0Hz zum verstärkten Empfängerausgangssignal **S1** verstärkt und im Wesentlichen nur Signalanteile des Empfängerausgangssignals **S0** mit einer Frequenz f<fₘₐₓ zum verstärkten Empfängerausgangssignal **S1** verstärkt. Dabei ist bevorzugt fₘₐₓ eine Maximalfrequenz deren Frequenzbetragswert vorzugsweise größer als der Frequenzbetragswert derjenigen Mischfrequenz mit dem größten Frequenzbetragswert ist.

Bevorzugt umfassen der erste Verstärker **V1** oder die Vorrichtung eine Analog-zu-Digital-Wandlung **ADC,** sodass das verstärkte Empfängerausgangssignal **S1** ein digitalisiertes Empfängerausgangssignal **S1** sein kann. Die Steuervorrichtung **CTR** kann den Mehrfachkorrelator **LIV** der Figur 69 in verschiedenen Ausprägungen der Vorrichtung emulieren.

Der Mehrfachkorrelator **LIV** der Figur 69 korreliert das verstärkte Empfängerausgangssignal **S1** bzw. das digitalisierte Empfängerausgangssignal **S1** typischerweise in dieser Betriebsart mit dem Mikrowellensignal **µW.** Sofern der Mehrfachkorrelator **LIV** das verstärkte Empfängerausgangssignal **S1** bzw. das digitalisierte Empfängerausgangssignal **S1** mit einem Signal s1(t) korreliert, so berechnet der Mehrfachkorrelator **LIV** im Wesentlichen das folgende Korrelationsintegral: $S 4 \left(t\right) = {\int }_{0}^{2 π} S 1 \left(t\right) ⋅ s 1 \left(t\right) dt$

Hierbei bezieht sich der Winkel 2π auf die Periode des periodischen Signals s1(t).

In dem Beispiel der Figur 69 korreliert der Mehrfachkorrelator **LIV** das verstärkte Empfängerausgangssignal **S1** bzw. das digitalisierte Empfängerausgangssignal **S1** vorzugsweise mit dem Mikrowellenmodulationssignal S5m(t). So berechnet der Mehrfachkorrelator **LIV** im Wesentlichen das folgende Korrelationsintegral als L2-Produkt des Empfängerausgangssignals **S1**(t) bzw. des digitalisierten Empfängerausgangssignals **S1**(t) und des Mikrowellenmodulationssignal **S5m**(t): $S {4}_{a} \left(t\right) = {\int }_{0}^{2 π} S 1 \left(t\right) ⋅ S 5 m \left(t\right) dt$ $S {4}_{b} \left(t\right) = {\int }_{0}^{2 π} S 1 \left(t\right) ⋅ S 5 mq \left(t\right) dt$

Hierbei bezieht sich der Winkel 2π auf die Periode des periodischen Signals S5m(t). Das Signal **S5mq** ist typischerweise das invertierte Signal des Mikrowellenmodulationssignal **S5m.**

Bevorzugt ist das Mikrowellenmodulationssignal **S5m**(t) ein digitales Signal, dass den logischen 1-Pegel und den Logischen 0-Pegel annehmen kann.

Im Extremfall des Mikrowellenmodulationssignals **S5m**(t) soll bei einem logischen 1-Pegel des Mikrowellenmodulationssignals **S5m**(t) soll gemäß willkürlicher Definition der hier vorgelegten Schrift die Mikrowellensignalquelle **µWG** ein Mikrowellensignal **µW** mit der über den Datenbus **DB** voreingestellten Amplitude und der voreingestellten Mikrowellenfrequenz ω_{µW} einschalten und erzeugen und bei einem logischen 0-Pegel des Mikrowellenmodulationssignals **S5m**(t) die die Mikrowellensignalquelle **µWG** ein Mikrowellensignal mit der Amplitude 0 erzeugen und somit das Mikrowellensignal **µW** abschalten.

Bei einem logischen 1-Pegel des Mikrowellenmodulationssignals **S5m**(t) soll nach willkürlicher Definition der hier vorgelegten Schrift die Mikrowellensignalquelle **µWG** ein Mikrowellensignal **µW** mit der über den Datenbus **DB** voreingestellten erhöhten Amplitude und der voreingestellten Mikrowellenfrequenz ω_{µW} einschalten und erzeugen und bei einem logischen 0-Pegel Mikrowellenmodulationssignals **S5m(t)** die Mikrowellensignalquelle **µWG** ein Mikrowellensignal mit der über den Datenbus **DB** voreingestellten niedrigeren Amplitude und der voreingestellten Mikrowellenfrequenz ω_{µW} erzeugen (ausschalten).

In dem Fall, dass das Mikrowellenmodulationssignal **S5m(t)** ein solches digitales Signal ist, kann ein invertiertes Mikrowellenmodulationssignals **S5mq(t)** als invertiertes Signal des Mikrowellenmodulationssignals **S5m**(t) definiert werden.

Das Filterausgangssignal **S4(t)** gibt dann typischerweise den Anteil im verstärkten Empfängerausgangssignal **S1** bzw. im digitalisierten Empfängerausgangssignal **S1** an, der auf die Mikrowelleneinstrahlung des Mikrowellensignals **µW** in das Sensorelement **SE** zurückzuführen ist.

### Fall mit einer Modulationsgrundfrequenz (LED-Modulationsfrequenz)

Es ist aus dem Stand der Technik bekannt, die Vorrichtung mit nur einer von 0Hz verschiedenen Modulationsgrundfrequenz zu betreiben und die anderen Werte der anderen Modulationsgrundfrequenzen für die Dauer einer Messung auf quasi statische Werte zu setzen. Im Folgenden stellt das hier vorgelegte Dokument ein Beispiel vor.

Sofern die Steuervorrichtung **CTR** der Vorrichtung beispielsweise
1. über den Datenbus **DB** mittels Steuerung des ersten Signalgenerators **G1** eine Modulation der Intensität der Pumpstrahlung **LB** (Amplitudenmodulation), also mit einer mit einer LED-Modulationsfrequenz **f_{LED}** vornimmt und
2. gleichzeitig über den Datenbus **DB** mittels Steuerung des zweiten Signalgenerators **G2** eine Modulation der Intensität des Mikrowellensignals **µW** (Amplitudenmodulation) quasistatisch, also mit einer Mikrowellenmodulationsfrequenz f_{µW}=0 Hz vornimmt und
3. die Mikrowellenfrequenz des Mikrowellensignals **µW** den Datenbus **DB** in der Mikrowellensignalquelle **µWG** quasistatisch, also mit einer Mikrowellenfrequenzmodulationsfrequenz **f_{fµW}**=0Hz, einstellt und
4. den Wert des Kompensationsfeldsteuersignals auf einen quasistatischen Wert, d.h. auf eine Magnetfeldmodulationsfrequenz **f**_{mg}=0Hz, und damit auf eine quasistatische, durch die Steuervorrichtung **CTR** eingestellte Amplitude einer zusätzlichen magnetischen Flussdichte **B_{ad},** einstellt, die das Magnetfelderzeugungsmittel Lc erzeugt,

Es ergibt sich somit genau eine Mischfrequenz mit denen das Empfängerausgangssignal **S0** des Fotodetektors **PD** moduliert sein kann.

Ein erster Signalgenerator **G1** erzeugt in diesem Beispiel das das quasi statische LED-Modulationssignal **S5w,** mit einer der LED -Modulationsfrequenz **f_{LED}** typischerweise entsprechend einem Vorgabewert, den die Steuervorrichtung **CTR** über den Datenbus **DB** in dem ersten Signalgenerator **G1** eingestellt hat. Die Steuervorrichtung **CTR** steuert den ersten Signalgenerator **G1** bevorzugt über den beispielhaften Datenbus **DB.** Typischerweise moduliert der erst Signalgenerator **G1** das LEED-Modulationssignal **S5w** mit dem besagten LED-Modulationsspektrum und/oder mit der besagten LED-Modulationsfrequenz **f**_{LED}. Ganz besonders bevorzugt handelt es sich bei der LED-Modulation des LED-Modulationssignals **S5w** um eine PWM-Modulation mit einer PWM-Frequenz oder einen Bit-Strom eines Spreiz-Code-Signals mit einer Spreiz-Code-Periodendauer und einer Spreiz-Code-Bitfrequenz. Die Steuervorrichtung **CTR** steuert den ersten Signalgenerator **G1** bevorzugt über den beispielhaften Datenbus **DB.**

Ein Lichtquellentreiber **LDRV** für die Lichtquelle **LED** erzeugt typischerweise aus dem LED-Modulationssignal **S5w** das Sendesignal **S5,** mit dem der Lichtquellentreiber **LDRV** die Lichtquelle **LED** bevorzugt auch mit elektrischer Energie versorgt. Bevorzugt handelt es sich bei der Lichtquelle **LED** um eine Halbleiterlichtquelle wie beispielsweise einen Laser oder eine LED. Ganz besonders bevorzugt umfasst die Lichtquelle **LED** eine Silizium-LED und/oder eine Silizium-Lawinen-LED wodurch dieser Vorrichtungsteil ggf. auch CMOS integrierbar wird.

Die Lichtquelle **LED** emittiert dann in Abhängigkeit von dem Sendesignal **S5** die Pumpstrahlung **LB.** mit der Pumpstrahlungswellenlänge λₚₘₚ.

Das Empfängerausgangssignal **S0** und das verstärkte Empfängerausgangssignal **S1** sind dann mit einem LED-Modulationsspektrum moduliert.

Da das LED-Modulationssignal **S5w** mit einem LED-Modulationsspektrum moduliert ist, ist dann auch das Sendesignal **S5** mit dem LED-Modulationsspektrum amplitudenmoduliert. Daher ist dann typischerweise auch der zeitliche Intensitätsverlauf Iᵢₛₜ(t) der Fluoreszenzstrahlung **FL** mit dem LED-Modulationsspektrum moduliert. Daher sind dann auch das Empfängerausgangssignal **S0** und das verstärkte Empfängerausgangssignal **S1** mit dem LED-Modulationsspektrum moduliert.

In diesem Beispiel der Figur 69 erzeugt ein zweiter Signalgenerator **G2** das Mikrowellenmodulationssignal **S5m** insbesondere mit einer Mikrowellenmodulationsfrequenz **f**_{µW}=0Hz typischerweise entsprechend einem Vorgabewert, den die Steuervorrichtung **CTR** über den Datenbus **DB** in dem zweiten Signalgenerator **G2** eingestellt hat. Typischerweise moduliert der zweite Signalgenerator **G2** das Mikrowellenmodulationssignal **S5m** mit dem besagten Mikrowellenmodulationsspektrum und/oder mit der besagten Mikrowellenmodulationsfrequenz **f**_{µW}=0Hz. Die Steuervorrichtung **CTR** steuert den zweiten Signalgenerator **G2** bevorzugt über den beispielhaften Datenbus **DB.**

Die Mikrowellensignalquelle **µWG** erzeugt dann das unmodulierte Mikrowellensignal **µW.** Die Steuervorrichtung **CTR** steuert die Mikrowellensignalquelle **µWG** bevorzugt über den beispielhaften Datenbus **DB.**

Typischerweise verstärkt ein optionaler erster Verstärker **V1** das Empfängerausgangssignal **S0** des Fotodetektors **PD** zu einem verstärkten Empfängerausgangssignal **S1.** Bevorzugt weist die Übertragungsfunktion des ersten Verstärkers **V1** für die Verstärkung des Empfängerausgangssignals **S0** zum verstärkten Empfängerausgangssignal **S1** eine Filtereigenschaft auf, die typischerweise so gewählt ist, dass der erste Verstärker **V1** im Wesentlichen nur modulierte Signalanteile des Empfängerausgangssignals **S0** mit einer Frequenz f≠0Hz zum verstärkten Empfängerausgangssignal **S1** verstärkt und im Wesentlichen nur Signalanteile des Empfängerausgangssignals **S0** mit einer Frequenz f<fₘₐₓ zum verstärkten Empfängerausgangssignal **S1** verstärkt. Dabei ist bevorzugt fₘₐₓ eine Maximalfrequenz deren Frequenzbetragswert vorzugsweise größer als der Frequenzbetragswert derjenigen Mischfrequenz mit dem größten Frequenzbetragswert ist.

Bevorzugt umfassen der erste Verstärker **V1** oder die Vorrichtung eine Analog-zu-Digital-Wandlung **ADC,** sodass das verstärkte Empfängerausgangssignal **S1** ein digitalisiertes Empfängerausgangssignal **S1** sein kann. Die Steuervorrichtung **CTR** kann den Mehrfachkorrelator **LIV** der Figur 69 in verschiedenen Ausprägungen der Vorrichtung emulieren.

Der Mehrfachkorrelator **LIV** der Figur 69 korreliert das verstärkte Empfängerausgangssignal **S1** bzw. das digitalisierte Empfängerausgangssignal **S1** typischerweise in dieser Betriebsart mit dem LED-Modulationssignal **S5w.**

Sofern der Mehrfachkorrelator **LIV** das verstärkte Empfängerausgangssignal **S1** bzw. das digitalisierte Empfängerausgangssignal **S1** mit einem Signal s1(t) korreliert, so berechnet der Mehrfachkorrelator **LIV** im Wesentlichen das folgende Korrelationsintegral: $S 4 \left(t\right) = {\int }_{0}^{2 π} S 1 \left(t\right) ⋅ s 1 \left(t\right) dt$

Hierbei bezieht sich der Winkel 2π auf die Periode des periodischen Signals s1(t).

In dem Beispiel der Figur 69 korreliert der Mehrfachkorrelator **LIV** das verstärkte Empfängerausgangssignal **S1** bzw. das digitalisierte Empfängerausgangssignal **S1** vorzugsweise mit dem LED-Modulationssignal **S5w**(t). So berechnet der Mehrfachkorrelator **LIV** im Wesentlichen das folgende Korrelationsintegral als L2-Produkt des Empfängerausgangssignals **S1**(t) bzw. des digitalisierten Empfängerausgangssignals **S1**(t) und des LED-Modulationssignals **S5w**(t): $S {4}_{a} \left(t\right) = {\int }_{0}^{2 π} S 1 \left(t\right) ⋅ S 5 w \left(t\right) dt$ $S {4}_{b} \left(t\right) = {\int }_{0}^{2 π} S 1 \left(t\right) ⋅ S 5 wq \left(t\right) dt$

Hierbei bezieht sich der Winkel 2π auf die Periode des periodischen Signals S5m(t). Das Signal **S5wq** ist typischerweise das invertierte Signal des LED-Modulationssignal **S5w.**

Bevorzugt ist das LED-Modulationssignal **S5w**(t) ein digitales Signal, dass den logischen 1-Pegel und den Logischen 0-Pegel annehmen kann.

Im Extremfall des LED-Modulationssignals **S5w**(t) soll bei einem logischen 1-Pegel des LED-Modulationssignals **S5w**(t) gemäß willkürlicher Definition der hier vorgelegten Schrift die Lichtquelle **LED** ein die Pumpstrahlung **LB** mit der über den Datenbus **DB** voreingestellten Amplitude einschalten und erzeugen und bei einem logischen 0-Pegel des LED-Modulationssignals **S5w**(t) soll die Lichtquelle **LED** die Pumpstrahlung **LB** mit der Amplitude 0 erzeugen und somit die Pumpstrahlung **LB** abschalten.

Bei einem logischen 1-Pegel des LED-Modulationssignals **S5w**(t) soll nach willkürlicher Definition der hier vorgelegten Schrift die Lichtquelle **LED** die Pumpstrahlung **LB** mit der über den Datenbus **DB** voreingestellten erhöhten Amplitude einschalten und erzeugen und bei einem logischen 0-Pegel des LED-Modulationssignals **S5w**(t) die Lichtquelle **LED** ein Pumpstrahlung **LB** mit der über den Datenbus **DB** voreingestellten niedrigeren Amplitude erzeugen (ausschalten).

In dem Fall, dass das LED-Modulationssignal **S5w**(t) ein solches digitales Signal ist, kann ein invertiertes LED-Modulationssignals **S5wq**(t) als invertiertes Signal des LED-Modulationssignals **S5w**(t) definiert werden.

Das Filterausgangssignal **S4(t)** gibt dann typischerweise den Anteil im verstärkten Empfängerausgangssignal **S1** bzw. im digitalisierten Empfängerausgangssignal **S1** an, der auf die Einstrahlung der Pumpstrahlung **LB** in das Sensorelement **SE** zurückzuführen ist.

### Fall mit zwei Modulationsgrundfrequenzen

Es ist denkbar und neu gegenüber dem Stand der Technik, die Vorrichtung mit zwei statt nur einer von 0Hz verschiedenen Modulationsgrundfrequenzen zu betreiben und die anderen Werte für die Dauer einer Messung auf quasi statische Werte zu setzen. Im Folgenden stellt das hier vorgelegte Dokument ein bevorzugtes Beispiel vor, ohne die Offenbarung darauf zu beschränken.

Sofern die Steuervorrichtung **CTR** der Vorrichtung beispielsweise
1. über den Datenbus **DB** mittels Steuerung des ersten Signalgenerators **G1** eine Modulation der Intensität der Pumpstrahlung **LB** (Amplitudenmodulation) mit einer LED-Modulationsfrequenz **f_{LED}** einstellt und
2. gleichzeitig über den Datenbus **DB** mittels Steuerung des zweiten Signalgenerators **G2** eine Modulation der Intensität des Mikrowellensignals **µW** (Amplitudenmodulation) mit einer Mikrowellenmodulationsfrequenz **f_{µW}** vornimmt und
3. die Mikrowellenfrequenz des Mikrowellensignals **µW** den Datenbus **DB** in der Mikrowellensignalquelle **µWG** quasistatisch, also mit einer Mikrowellenfrequenzmodulationsfrequenz **f**_{fµW}=0Hz, einstellt und
4. den Wert des Kompensationsfeldsteuersignals auf einen quasistatischen Wert, d.h. auf eine Magnetfeldmodulationsfrequenz **f**_{mg}=0Hz, und damit auf eine quasistatische, durch die Steuervorrichtung **CTR** eingestellte Amplitude einer zusätzlichen magnetischen Flussdichte **B_{ad},** einstellt, die das Magnetfelderzeugungsmittel Lc erzeugt,

Es ergeben sich somit nun 2²=4 Mischfrequenzen mit denen das Empfängerausgangssignal **S0** des Fotodetektors **PD** moduliert sein kann.

Vorzugsweise ist in dieser Konfiguration die Magnetfeldmodulationsfrequenz **f_{mg}** so eingestellt, dass für die Magnetfeldmodulationsfrequenz **f_{mg}**=0Hz gilt.

Vorzugsweise ist in dieser Konfiguration die Mikrowellenfrequenzmodulationsfrequenz **f_{fµW}** so eingestellt, dass für die Mikrowellenfrequenzmodulationsfrequenz **f_{fµW}**=0Hz gilt.

Vorzugsweise sind die Mikrowellenmodulationsfrequenz **f_{µW}** und die LED -Modulationsfrequenz **f_{LED}** nun so gewählt, dass vorzugsweise diese vier Mischfrequenzen sich unterscheiden.

Dies kann beispielsweise dadurch erreicht werden, dass eine zweite Modulationsgrundfrequenz den doppelten Frequenzwert einer ersten Modulationsgrundfrequenz diese beiden Modulationsgrundfrequenzen ω_{µW} und ω_{LED} aufweist.

Beispielsweise ist es, um hier ein willkürliches Beispiel zu nennen, denkbar, dass die die Mikrowellenmodulationsfrequenz **f_{µW}** den doppelten Frequenzwert der LED -Modulationsfrequenz **f_{LED}** aufweist.

Der erste Signalgenerator **G1** erzeugt in diesem Beispiel dieser Konfiguration das LED-Modulationssignal **S5W,** mit einer der LED -Modulationsfrequenz **f_{LED}** typischerweise entsprechend einem von null verschiedenen Vorgabewert, den die Steuervorrichtung **CTR** über den Datenbus **DB** in dem ersten Signalgenerator **G1** eingestellt hat. Typischerweise moduliert der erste Signalgenerator **G1** das LED-Modulationssignal **S5W** mit dem besagten LED-Modulationsspektrum und/oder mit der besagten LED-Modulationsfrequenz **f_{LED}.** Ganz besonders bevorzugt handelt es sich bei der LED-Modulation des LED-Modulationssignal **S5W** um eine PWM-Modulation mit einer PWM-Frequenz oder einen Bit-Strom eines Spreiz-Code-Signals mit einer Spreiz-Code-Periodendauer und einer Spreiz-Code-Bitfrequenz. Die Steuervorrichtung **CTR** steuert den ersten Signalgenerator **G1** bevorzugt über den beispielhaften Datenbus **DB.**

Ein Lichtquellentreiber **LDRV** für die Lichtquelle **LED** erzeugt typischerweise aus dem LED-Modulationssignal **S5W** das Sendesignal **S5,** mit dem der Lichtquellentreiber **LDRV** die Lichtquelle **LED** bevorzugt auch mit elektrischer Energie versorgt. Bevorzugt handelt es sich bei der Lichtquelle **LED** um eine Halbleiterlichtquelle wie beispielsweise einen Laser oder eine LED. Ganz besonders bevorzugt umfasst die Lichtquelle **LED** eine Silizium-LED und/oder eine Silizium-Lawinen-LED wodurch dieser Vorrichtungsteil ggf. auch CMOS integrierbar wird.

Die Lichtquelle **LED** emittiert dann in Abhängigkeit von dem Sendesignal **S5** die Pumpstrahlung **LB.** mit der Pumpstrahlungswellenlänge λₚₘₚ.

Da das LED-Modulationssignal **S5w** mit einem LED-Modulationsspektrum moduliert ist, ist dann auch das Sendesignal **S5** mit dem LED-Modulationsspektrum moduliert. Da das Sendesignal **S5** mit dem LED-Modulationsspektrum moduliert ist, ist typischerweise der zeitliche Intensitätsverlauf der Pumpstrahlung **LB** mit dem LED-Modulationsspektrum moduliert. Daher ist dann typischerweise auch der zeitliche Intensitätsverlauf der Intensität **Iᵢₛₜ(t)** der Fluoreszenzstrahlung **FL** mit dem LED-Modulationsspektrum moduliert. Daher sind dann auch das Empfängerausgangssignal **S0** und das verstärkte Empfängerausgangssignal **S1** typischerweise mit dem LED-Modulationsspektrum moduliert.

In diesem Beispiel der Figur 69 erzeugt in dieser Konfiguration der zweite Signalgenerator **G2** das Mikrowellenmodulationssignal **S5m** insbesondere mit einer von null verschiedenen Mikrowellenmodulationsfrequenz **f_{µW}** typischerweise entsprechend einem Vorgabewert, den die Steuervorrichtung **CTR** über den Datenbus **DB** in dem zweiten Signalgenerator **G2** eingestellt hat. Typischerweise moduliert der zweite Signalgenerator **G2** das Mikrowellenmodulationssignal **S5m** mit dem besagten Mikrowellenmodulationsspektrum und/oder mit der besagten Mikrowellenmodulationsfrequenz **f_{µW}.** Ganz besonders bevorzugt handelt es sich bei der Mikrowellenmodulation des Mikrowellenmodulationssignals **S5m** um eine PWM-Modulation mit einer PWM-Frequenz oder einen Bit-Strom eines Spreiz-Code-Signals mit einer Spreiz-Code-Periodendauer und einer Spreiz-Code-Bitfrequenz. Die Steuervorrichtung **CTR** steuert den zweiten Signalgenerator **G2** bevorzugt über den beispielhaften Datenbus **DB.**

Die Mikrowellensignalquelle **µWG** erzeugt dann das mit dem Mikrowellenmodulationssignal modulierte Mikrowellensignal **µW.** Die Steuervorrichtung **CTR** steuert die Mikrowellensignalquelle **µWG** bevorzugt über den beispielhaften Datenbus **DB.**

Da das Mikrowellenmodulationssignal **S5m** mit einem Mikrowellenmodulationsspektrum moduliert ist, ist dann typischerweise auch das Mikrowellensignal **µW** mit dem Mikrowellenmodulationsspektrum amplitudenmoduliert. Daher ist dann typischerweise auch der zeitliche Intensitätsverlauf der Fluoreszenzstrahlung **FL** mit dem Mikrowellenmodulationsspektrum moduliert. Daher sind dann typischerweise auch das Empfängerausgangssignal **S0** und das verstärkte Empfängerausgangssignal **S1** mit dem Mikrowellenmodulationsspektrum moduliert.

Typischerweise verstärkt der optionale erste Verstärker **V1** das Empfängerausgangssignal **S0** des Fotodetektors **PD** zu einem verstärkten Empfängerausgangssignal **S1.** Bevorzugt weist die Übertragungsfunktion des ersten Verstärkers **V1** für die Verstärkung des Empfängerausgangssignals **S0** zum verstärkten Empfängerausgangssignal **S1** eine Filtereigenschaft auf, die typischerweise so gewählt ist, dass der erste Verstärker **V1** im Wesentlichen nur modulierte Signalanteile des Empfängerausgangssignals **S0** mit einer Frequenz f≠0Hz zum verstärkten Empfängerausgangssignal **S1** verstärkt und im Wesentlichen nur Signalanteile des Empfängerausgangssignals **S0** mit einer Frequenz f<fₘₐₓ zum verstärkten Empfängerausgangssignal **S1** verstärkt. Dabei ist bevorzugt fₘₐₓ eine Maximalfrequenz deren Frequenzbetragswert vorzugsweise größer als der Frequenzbetragswert derjenigen Mischfrequenz mit dem größten Frequenzbetragswert ist.

Bevorzugt umfassen der erste Verstärker **V1** oder die Vorrichtung eine Analog-zu-Digital-Wandlung **ADC,** sodass das verstärkte Empfängerausgangssignal **S1** ein digitalisiertes Empfängerausgangssignal **S1** sein kann. Die Steuervorrichtung **CTR** kann den Mehrfachkorrelator **LIV** der Figur 69 in verschiedenen Ausprägungen der Vorrichtung emulieren.

Der Mehrfachkorrelator **LIV** der Figur 69 korreliert das verstärkte Empfängerausgangssignal **S1** bzw. das digitalisierte Empfängerausgangssignal **S1** vorzugsweise mit den mindestens zwei folgenden Signalen:
1. dem LED-Modulationssignal **S5w,**
2. dem Mikrowellensignal **µW.**

Sofern der Mehrfachkorrelator **LIV** das verstärkte Empfängerausgangssignal **S1** bzw. das digitalisierte Empfängerausgangssignal **S1** mit zwei Signalen s1(t) und s2(t) korreliert, so berechnet der Mehrfachkorrelator **LIV** im Wesentlichen beispielsweise das folgende Korrelationsintegral: $S 4 \left(t\right) = {\int }_{0}^{2 π} S 1 \left(t\right) ⋅ s 1 \left(t\right) ⋅ s 2 \left(t\right) dt$

DFINITION: Das hier vorgelegte Dokument bezeichnet diese mathematische Form nun als ein L3-Produkt (für drei Funktionen) in Anlehnung an das bekannte L2-Produkt.

Hierbei bezieht sich der Winkel 2π auf die Periode desjenigen periodischen Signals s1(t) oder s2(t) mit der längeren Periodendauer. Voraussetzung ist, dass die Periodendauer des Signals mit der längeren Periodendauer ein ganzzahliges Vielfaches der die Periodendauer des Signals mit der kürzeren Periodendauer ist.

In dem Beispiel der Figur 69 korreliert der Mehrfachkorrelator **LIV** das verstärkte Empfängerausgangssignal **S1** bzw. das digitalisierte Empfängerausgangssignal **S1** vorzugsweise mit dem LED-Modulationssignal **S5w(t)** und dem Mikrowellenmodulationssignal **S5m**(t). So berechnet der Mehrfachkorrelator **LIV** im Wesentlichen das folgende Korrelationsintegral als L3-Produkt des Empfängerausgangssignals **S1**(t) bzw. des digitalisierten Empfängerausgangssignals **S1**(t), des LED-Modulationssignals **S5w**(t) und des Mikrowellenmodulationssignal **S5m**(t): $S 4 \left(t\right) = {\int }_{0}^{2 π} S 1 \left(t\right) ⋅ S 5 w \left(t\right) ⋅ S 5 m \left(t\right) dt$

Hierbei bezieht sich der Winkel 2π auf die Periode desjenigen periodischen Signals S5m(t) oder S5w(t) mit der längeren Periodendauer. Bevorzugte Voraussetzung ist, dass die Periodendauer des Signals mit der längeren Periodendauer ein ganzzahliges Vielfaches der die Periodendauer des Signals mit der kürzeren Periodendauer ist.

Bevorzugt ist das LED-Modulationssignal **S5w**(t) ein digitales Signal, dass den logischen 1-Pegel und den Logischen 0-Pegel annehmen kann.

Im Extremfall des LED-Modulationssignals **S5w**(t) soll bei einem logischen 1-Pegel des LED-Modulationssignals **S5w**(t) soll willkürlicher Definition der hier vorgelegten Schrift der Lichtquellentreiber **LDRV** für die Lichtquelle **LED** die Abgabe einer Pumpstrahlung **LB** durch die Pumpstrahlungsquelle, hier die Lichtquelle **LED** einschalten und bei einem logischen 0-Pegel des LED-Modulationssignals **S5w**(t) die Pumpstrahlungsquelle, hier die Lichtquelle **LED** abschalten.

Bei einem logischen 1-Pegel des LED-Modulationssignals **S5w**(t) soll nach willkürlicher Definition der hier vorgelegten Schrift der Lichtquellentreiber **LDRV** für die Lichtquelle **LED** die Pumpstrahlungsquelle, hier die Lichtquelle **LED,** zu der Abgabe einer erhöhten Intensität der Pumpstrahlung **LB** veranlassen und bei einem logischen 0-Pegel des LED-Modulationssignals **S5w**(t) die Pumpstrahlungsquelle, hier die Lichtquelle **LED,** zu der Abgabe einer verminderten Intensität der Pumpstrahlung **LB** veranlassen.

Bevorzugt ist das Mikrowellenmodulationssignal **S5m**(t) ein digitales Signal, dass den logischen 1-Pegel und den Logischen 0-Pegel annehmen kann.

Im Extremfall des Mikrowellenmodulationssignals **S5m**(t) soll bei einem logischen 1-Pegel des Mikrowellenmodulationssignals **S5m**(t) soll gemäß willkürlicher Definition der hier vorgelegten Schrift die Mikrowellensignalquelle **µWG** ein Mikrowellensignal mit der über den Datenbus **DB** voreingestellten Amplitude und der voreingestellten Mikrowellenfrequenz einschalten und erzeugen und bei einem logischen 0-Pegel des Mikrowellenmodulationssignals **S5m**(t) die die Mikrowellensignalquelle **µWG** ein Mikrowellensignal mit der Amplitude 0 erzeugen und somit das Mikrowellensignal **µW** abschalten.

Bei einem logischen 1-Pegel des Mikrowellenmodulationssignals **S5m**(t) soll nach willkürlicher Definition der hier vorgelegten Schrift die Mikrowellensignalquelle **µWG** ein Mikrowellensignal mit der über den Datenbus **DB** voreingestellten erhöhten Amplitude und der voreingestellten Mikrowellenfrequenz ω_{µW} einschalten und erzeugen und bei einem logischen 0-Pegel Mikrowellenmodulationssignals **S5m(t)** die Mikrowellensignalquelle **µWG** ein Mikrowellensignal mit der über den Datenbus **DB** voreingestellten niedrigeren Amplitude und der voreingestellten Mikrowellenfrequenz ω_{µW} erzeugen (ausschalten).

In dem Fall, dass das Mikrowellenmodulationssignal **S5m**(t) ein solches digitales Signal ist, kann ein invertiertes Mikrowellenmodulationssignals **S5mq**(t) als invertiertes Signal des Mikrowellenmodulationssignals **S5m**(t) definiert werden.

In dem Fall, dass das LED-Modulationssignals **S5w**(t) ein solches digitales Signal ist, kann ein invertiertes LED-Modulationssignals **S5wq**(t) als invertiertes Signal des LED-Modulationssignals **S5w**(t) definiert werden. Insgesamt kann die der Mehrfachkorrelator **LIV** aus dem das verstärkten Empfängerausgangssignal **S1,** Mikrowellenmodulationssignal **S5m**(t) und dem LED-Modulationssignal **S5w**(t) dann vier L3-Produkte in Form von vier Filterausgangssignalen **S4**(t) bilden: $S {4}_{a} \left(t\right) = {\int }_{0}^{2 π} S 1 \left(t\right) ⋅ S 5 w \left(t\right) ⋅ S 5 m \left(t\right) dt$ $S {4}_{b} \left(t\right) = {\int }_{0}^{2 π} S 1 \left(t\right) ⋅ S 5 wq \left(t\right) ⋅ S 5 m \left(t\right) dt$ $S {4}_{c} \left(t\right) = {\int }_{0}^{2 π} S 1 \left(t\right) ⋅ S 5 w \left(t\right) ⋅ S 5 mq \left(t\right) dt$ $S {4}_{d} \left(t\right) = {\int }_{0}^{2 π} S 1 \left(t\right) ⋅ S 5 wq \left(t\right) ⋅ S 5 mq \left(t\right) dt$

Das erste so gebildete Filterausgangssignal **S4ₐ**(t) gibt die Intensität der Fluoreszenzstrahlung **FL** an, wenn die Pumpstrahlung **LB** eingeschaltet ist und das Mikrowellensignal **µW** eingeschaltet ist.

Das zweite so gebildete Filterausgangssignal **S4_{b}**(t) gibt die Intensität der Fluoreszenzstrahlung **FL** an, wenn die Pumpstrahlung **LB** ausgeschaltet ist und das Mikrowellensignal **µW** eingeschaltet ist. Da infolge der fehlenden Pumpstrahlung **LB** keine Fluoreszenzstrahlung **FL** auftritt, repräsentiert dieses zweite so gebildete Filterausgangssignal **S4_{b}**(t) den Strahlungsuntergrund, der aus welchen Gründen auch immer vorhanden ist. Das dritte so gebildete Filterausgangssignal **S4_{c}**(t) gibt die Intensität der Fluoreszenzstrahlung **FL** an, wenn die Pumpstrahlung **LB** eingeschaltet ist und das Mikrowellensignal **µW** ausgeschaltet ist. Das dritte so gebildete Filterausgangssignal **S4_{c}**(t) gibt somit die Intensität der mikrowellenfreien Fluoreszenzstrahlung **FL** an, wie sie beispielsweise aus der EP 3 980 797A1 bekannt ist.

Das vierte so gebildete Filterausgangssignal **S4_{d}**(t) gibt die Intensität der Fluoreszenzstrahlung **FL** an, wenn die Pumpstrahlung **LB** ausgeschaltet ist und das Mikrowellensignal **µW** ausgeschaltet ist. Da infolge der fehlenden Pumpstrahlung **LB** keine Fluoreszenzstrahlung **FL** auftritt, repräsentiert dieses zweite so gebildete Filterausgangssignal **S4_{d}**(t) den Strahlungsuntergrund, der aus welchen Gründen auch immer vorhanden ist. Das hier vorgelegte Dokument schlägt nun vor, das Filterausgangssignal **S4(t)** als Merkmalsvektorsignal zu verstehen. Das hier vorgelegte Dokument schlägt nun vor, dieses vektorielle Filterausgangssignal **S4**(t) unter Subtraktion des jeweiligen Strahlungsuntergrunds beispielsweise wie folgt zu bilden: $S 4 \left(t\right) = \left(\begin{matrix}S {4}_{1} \left(t\right) \\ S {4}_{2} \left(t\right) \\ S {4}_{3} \left(t\right) \\ S {4}_{4} \left(t\right)\end{matrix}\right) = \left(\begin{matrix}S {4}_{a} \left(t\right) - S {4}_{b} \left(t\right) \\ S {4}_{c} \left(t\right) - S {4}_{d} \left(t\right) \\ S {4}_{a} \left(t\right) - S {4}_{c} \left(t\right) \\ S {4}_{a} \left(t\right) - S {4}_{b} \left(t\right) - S {4}_{c} \left(t\right) + S {4}_{d} \left(t\right)\end{matrix}\right)$

Dies entspricht: $S 4 \left(t\right) = \left(\begin{matrix}{\int }_{0}^{2 π} S 1 \left(t\right) ⋅ S 5 w \left(t\right) ⋅ S 5 m \left(t\right) dt - {\int }_{0}^{2 π} S 1 \left(t\right) ⋅ S 5 wq \left(t\right) ⋅ S 5 m \left(t\right) dt \\ {\int }_{0}^{2 π} S 1 \left(t\right) ⋅ S 5 w \left(t\right) ⋅ S 5 mq \left(t\right) dt - {\int }_{0}^{2 π} S 1 \left(t\right) ⋅ S 5 wq \left(t\right) ⋅ S 5 mq \left(t\right) dt \\ {\int }_{0}^{2 π} S 1 \left(t\right) ⋅ S 5 w \left(t\right) ⋅ S 5 m \left(t\right) dt - {\int }_{0}^{2 π} S 1 \left(t\right) ⋅ S 5 w \left(t\right) ⋅ S 5 mq \left(t\right) dt \\ {\int }_{0}^{2 π} S 1 \left(t\right) ⋅ S 5 w \left(t\right) ⋅ S 5 m \left(t\right) dt - {\int }_{0}^{2 π} S 1 \left(t\right) ⋅ S 5 wq \left(t\right) ⋅ S 5 m \left(t\right) dt - {\int }_{0}^{2 π} S 1 \left(t\right) ⋅ S 5 w \left(t\right) ⋅ S 5 mq \left(t\right) dt + {\int }_{0}^{2 π} S 1 \left(t\right) ⋅ S 5 wq \left(t\right) ⋅ S 5 mq \left(t\right) dt\end{matrix}\right)$ $S 4 \left(t\right) = \left(\begin{matrix}{\int }_{0}^{2 π} S 1 \left(t\right) ⋅ \left(S5w\left(t\right)-S5wq\left(t\right)\right) ⋅ S 5 m \left(t\right) dt \\ {\int }_{0}^{2 π} S 1 \left(t\right) ⋅ \left(S5w\left(t\right)-S5wq\left(t\right)\right) ⋅ S 5 m \left(t\right) dt \\ {\int }_{0}^{2 π} S 1 \left(t\right) ⋅ S 5 w \left(t\right) ⋅ \left(S5m\left(t\right)-S5mq\left(t\right)\right) dt \\ {\int }_{0}^{2 π} S 1 \left(t\right) ⋅ \left(S5w\left(t\right)-S5wq\left(t\right)\right) ⋅ \left(S5m\left(t\right)-S5mq\left(t\right)\right) dt\end{matrix}\right)$

Ergebnis ist ein vierdimensionales Filterausgangssignal S4(t). Hierbei wurde die mögliche weitere Dimension des Filterausgangssignals entsprechend dem Integral ${\int }_{0}^{2 π} S 1 \left(t\right) ⋅ S 5 wq \left(t\right) ⋅ \left(S5m\left(t\right)-S5mq\left(t\right)\right) dt$ nicht berücksichtigt, da dieses Integral einen Einfluss der Mikrowellenstrahlung auf das Rauschen ohne Fluoreszenz voraussetzt. Dieses Integral kann aber theoretisch ebenfalls Teil des vektoriellen Filterausgangssignals **S4(t)** sein.

Typischerweise stellt die Steuervorrichtung **CTR** unterschiedliche Mikrowellenfrequenzen ω_{µW} des Mikrowellensignals **µW** über den Datenbus **DB** in der Mikrowellensignalquelle **µWG** ein und unterschiedliche Werte des Kompensationsfeldsteuersignals ein. Die Steuervorrichtung **CTR** stellt somit typischer Weise unterschiedliche Amplituden der zusätzlichen magnetischen Flussdichte **B_{ad},** ein, die das Magnetfelderzeugungsmittel L_{C} erzeugt. Die Steuervorrichtung **CTR** bestimmt dann mittels des Mehrfachkorrelators **LIV** für vorzugsweise jeden der eingestellten zweidimensionalen Arbeitspunkte aus Wert des Kompensationsfeldsteuersignals (d.h. eingestellter zusätzlicher magnetischer Flussdichte **B_{ad})** und Frequenzwert der Mikrowellenfrequenz ω_{µW} des Mikrowellensignals **µW** den Wert des mehrdimensionalen Filterausgangssignals **S4**(t). D.h. die Vorrichtung überdeckt in der Figur 51a die Fläche der Figur 51a zumindest teilweise mit einem Gitter oder einer Verteilung von Arbeitspunkten der Vorrichtung an denen die Vorrichtung jeweils die Werte der jeweils diesen Arbeitspunkten zugehörigen mehrdimensionalen Filterausgangssignale S4(t) bestimmt.

Die Steuervorrichtung **CTR** speichert diese Werte vorzugsweise in einem Speicher **RAM, NVM** ab.

Die Steuervorrichtung **CTR** speichert diese Werte vorzugsweise in einem Speicher **RAM, NVM** vorzugsweise in Form von Datensätzen ab.

Vorzugsweise umfasst jeder Datensatz zum Ersten den vektoriellen Wert des Arbeitspunkts, also den Wert des Kompensationsfeldsteuersignals (d.h. eingestellter zusätzlicher magnetischer Flussdichte **B_{ad})** und den Frequenzwert der Mikrowellenfrequenz ω_{µW} des Mikrowellensignals **µW,** und zum Zweiten die aktuellen Vektorkomponentenwerte des mehrdimensionalen Filterausgangssignals **S4**(t).

Wenn die Steuervorrichtung **CTR** alle Arbeitspunkte eines Messzyklus vermessen hat, können die Steuervorrichtung **CTR** und/oder die Mustererkennungsvorrichtung **MEV** diese Datensätze als vorläufigen Merkmalsvektor für ein computer- oder logikimplementiertes Mustererkennungsverfahren oder eines der vorbeschriebenen computerimplementierten Verfahren verwenden.

Hierzu kann die Vorrichtung über eine separate Mustererkennungsvorrichtung **MEV,** verfügen, die das vektorielle Filterausgangssignal **S4(t)** direkt auswertet oder auf die Datensätze im Speicher **RAM, NVM** zugreift. Alternativ und bevorzugt kann die Steuervorrichtung **CTR** eine solche Mustererkennungsvorrichtung **MEV** durch ein computerimplementiertes verfahren emulieren. Beispielsweise kann die Steuervorrichtung **CTR** ein computerimplementiertes Programm der künstlichen Intelligenz als Mustererkennungsprogramm ausführen. Beispielsweise kann die Steuervorrichtung **CTR** ein computerimplementiertes Neuronales Netzwerkmodell **NN** ausführen, das aus den erfassten Parametern die Gesamtflussdichte **B_{Σ}** und die externe Gesamtflussdichte **Bₑₓₜ=B_{Σ}-B_{ad}** abschätzt. Beispielsweise kann es sich bei der Mustererkennungsvorrichtung **MEV** auch um eine Vorrichtung handeln, die ein computerimplementiertes oder logikimplementiertes Verfahren zur Musterkennung oder zur Vorbereitung einer Mustererkennung durch die Steuervorrichtung **CTR** mittels eines computerimplementierten Verfahrens zur Mustererkennung durchführt. Typischerweise erzeugt die Mustererkennungsvorrichtung **MEV** hierzu einen Musterdatensatz **MDS.** Bevorzugt umfasst dieser Musterdatensatz **MDS** den Datensatz eines von der Mustererkennungsvorrichtung **MEV** erkannten Musters und/oder einen Merkmalsvektor, den die Mustererkennung **MEV** aus dem typischerweise vektoriellen Filterausgangssigna **S4**(t) und ggf. weiteren im System vorliegenden Daten und Signalen extrahiert hat. Die Mustererkennungsvorrichtung **MEV** stellt diesen Musterdatensatz **MDS** für eine Mustererkennung und/oder eine Nachverarbeitung der Steuervorrichtung über den Datenbus **DB** und/oder über eine FiFo-Struktur oder eine spezielle Schnittstelle mit einem speziellen Musterdatensatzdatenbus zur weiteren Verarbeitung und/oder Verwendung zur Verfügung. Im Falle der Übermittlung von Merkmalsvektordaten innerhalb des Musterdatensatzes kann die Steuervorrichtung **CTR** eine Mustererkennung in den übermittelten aktuellen und zeitlich vorausgegangenen Merkmalsvektordaten mit Hilfe eines computerimplementierten Programms zur Mustererkennung oder dergleichen durchführen. Ein wichtiger Wert, den die Steuervorrichtung **CTR** und/oder die Mustererkennungsvorrichtung **MEV** ermitteln, ist typischerweise der Wert der erkannten Gesamtflussdichte **B_{Σ}.** Typischerweise umfasst dieser Musterdatensatz **MEV** auch den Messfehlerwert, mit dem dieser Wert der erkannten Gesamtflussdichte **B_{Σ}** behaftet ist. Die Mustererkennungsvorrichtung **MEV** kann ein eigenes Rechnersystem mit einem eigenen Rechnerkern umfassen. Die Mustererkennungsvorrichtung **MEV** kann einen eigenen Programmspeicher und einen eigenen Datenspeicher umfassen. Die Speicher des Systems können flüchtig und nicht flüchtig sein. Ein solches Rechnersystem der Mustererkennungsvorrichtung **MEV** kann ggf. gemeinsam mit der Steuervorrichtung **CTR** auf die flüchtigen Speicher **RAM** und nicht flüchtigen Speicher **NVM** zugreifen und sich diese mit der Steuervorrichtung **CTR** ganz oder teilweise teilen. Die Mustererkennungsvorrichtung **MEV** kann ihre Funktionen ganz oder teilweise durch Ausführung entsprechender computerimplementierter Programme realisieren, die in den Speichern der Mustererkennungsvorrichtung **MEV** oder den Speichern **RAM, NVM** des Systems zumindest zeitweise abgelegt sind.

Besonders vorteilhaft ist es, wenn die Steuervorrichtung **CTR** während eines noch laufenden Messzyklus in Abhängigkeit von dem bereits in dem noch laufenden Messzyklus und in vorhergehenden Messzyklen erfassten Datensätzen einen oder mehrere zukünftige Arbeitspunkte des Sensorsystems (hinsichtlich magnetischer Flussdichte Bad und Mikrowellenfrequenz ω_{µW} des Mikrowellensignals **µW)** festlegt, die als nachfolgend noch vermessen werden sollen. Vorzugsweise wendet die Steuervorrichtung **CTR** dabei beispielsweise ein computerimplementiertes Verfahren der Bayes'sche Optimierung an, um diese nachfolgenden einen oder mehreren Arbeitspunkte aus dem Wert des Kompensationsfeldsteuersignals (d.h. eingestellter zusätzlicher magnetischer Flussdichte **B_{ad})** und dem Frequenzwert der Mikrowellenfrequenz ω_{µW} des Mikrowellensignals **µW** an diesem Arbeitspunkt für die nächste(n) Bestimmung(en) der Vektorkomponentenwerte des mehrdimensionalen Filterausgangssignals **S4**(t) festzulegen.

In einer weiteren Ausbildung umfasst das Sensorsystem bevorzugt eine Anzeigeeinheit, insbesondere einen Bildschirm **32,** die in der Lage ist, die Lage der Grenze zwischen dem ersten Messpunkt und dem zweiten Messpunkt im Parameterraum grafisch darzustellen.

In einer weiteren Ausbildung des Sensorsystems, weist die Anzeigeeinheit, insbesondere der Bildschirm **32,** beispielsweise eine grafische Benutzeroberfläche auf, die es einem Benutzer ermöglicht, die Lage der Grenze im Parameterraum zu überwachen und anzupassen.

In einer weiteren Ausbildung des Sensorsystems, ist Steuerrechner, also beispielsweise die Steuervorrichtung **CTR,** dazu eingerichtet, computerimplementierte Fehlerkennungs- und Fehlerkorrekturalgorithmen basierend auf den Messwerten anzuwenden, um die Genauigkeit der Lagebestimmung der Grenze im Parameterraum zu verbessern.

In einer weiteren Ausbildung des Sensorsystems, ist der Steuerrechner, also beispielsweise die Steuervorrichtung **CTR,** dazu eingerichtet, mit anderen Sensoren und/oder Systemen (z.B. **33**) insbesondere über eine Datenschnittstelle (z.B. **29**) zu kommunizieren, um zusätzliche Informationen für die Lagebestimmung der Grenze im Parameterraum zu erhalten und/oder solche an diese anderen Sensoren und/oder Systemen (z.B. **33**) weiterzugeben und/oder für diese bereitzuhalten.

In einer weiteren Ausbildung des Sensorsystems, ist der Steuerrechner, also beispielsweise die Steuervorrichtung **CTR,** dazu eingerichtet, in Echtzeit zu arbeiten und die Lage der Grenze im Parameterraum kontinuierlich zu überwachen und zu aktualisieren.

In einer weiteren Ausbildung des Sensorsystems, ist der Steuerrechner, also beispielsweise die Steuervorrichtung **CTR,** dazu eingerichtet, die Arbeitspunkte im Parameterraum adaptiv anzupassen, um eine optimale Messgenauigkeit für die Lagebestimmung der Grenze zu erreichen.

In einer weiteren Ausbildung des Sensorsystems, ist der Steuerrechner, also beispielsweise die Steuervorrichtung **CTR,** dazu eingerichtet, die Messergebnisse zu speichern und zu analysieren, um Trends und Muster in der Lagebestimmung der Grenze im Parameterraum zu erkennen.

Damit die Optimierung nicht durch eine zu lange Messdauer kontraproduktiv wird, sollt eine Abbruchbedingung, beispielsweise die Anzahl der Arbeitspunkte dann vorgesehen werden.

Sind alle vorbestimmten und ggf. im Laufe eines Messzyklus nachbestimmten Arbeitspunkte vermessen und/oder ist die vorgegebene maximale Anzahl an Messpunkten erreicht oder überschritten, so beendet das Sensorsystem typischerweise den Messzyklus.

Nach der Beendigung des letzten Messzyklus startet die Steuervorrichtung **CTR** typischerweise den nächsten Messzyklus. Hierzu kann die Steuervorrichtung **CTR** beispielsweise wieder zuerst die vorbestimmten Arbeitspunkte aus einem jeweiligen Wert des Kompensationsfeldsteuersignals (d.h. eingestellter zusätzlicher magnetischer Flussdichte **B_{ad})** an diesem Arbeitspunkt und dem jeweiligen Frequenzwert der Mikrowellenfrequenz des Mikrowellensignals **µW** an diesem Arbeitspunkt vermessen und die zugehörigen Vektorkomponentenwerte des mehrdimensionalen Filterausgangssignals **S4**(t) an diesen Arbeitspunkten erfassen und dann die Messwerte in einer zweiten Phase und/oder weiteren Phasen des Messzyklus durch Vermessung zusätzlicher Arbeitspunkte zu optimieren.

Die Bestimmung der zusätzlichen Arbeitspunkte innerhalb der weiteren Phasen des Messzyklus kann auch durch andere computerimplementierte Optimierungsverfahren als ein computerimplementierte Bayes'sches Optimierungsverfahren erfolgen. Die Form und der Verlauf der unteren Resonanzkante **522,** der unteren mittleren Resonanzkante **23,** der oberen mittleren Resonanzkante **524,** der oberen Resonanzkante **25** und des mittleren Resonanzminimums **529** der Figur 51a sind ja vorbekannt oder in einem Kalibrationsmessvorgang erfassbar. Nur die Position **530** der Spitze der V-Formation **(522, 525)** ist durch eine zusätzliche magnetische Flussdichte **B_{ad}** oder eine Änderung der externen magnetischen Flussdichte Bₑₓₜ änderbar. Bevorzugt berücksichtigt das computerimplementierte Verfahren, das die Steuervorrichtung **CTR** ausführt, diese Daten. Bevorzugt sind diese Kalibrationsdaten, die die Form und Lage und den Verlauf der unteren Resonanzkante **522,** der unteren mittleren Resonanzkante **523,** der oberen mittleren Resonanzkante **24,** der oberen Resonanzkante **525** und des mittleren Resonanzminimums **529** der Figur 51a beschreiben zumindest teilweise in einem nicht flüchtigen Speicher **NVM** oder einem anderen Speicher **RAM** der Vorrichtung oder einem Speichermedium der Vorrichtung abgelegt, sodass die Steuervorrichtung **CTR** auf diese Daten über den Datenbus **DB** zugreifenkann und durch Vergleich zwischen den erfassten Datensätzen des aktuellen Meszyklus und ggf. vorhergehender Messzyklen auf die aktuelle Gesamtflussdichte **B_{Σ}** und die externe Gesamtflussdichte **Bₑₓₜ=B_{Σ}-B_{ad}** schließen kann und/oder auf zusätzlich notwendige Arbeitspunkte für weitere Messungen zur Verbesserung des Messergebnisses schließen kann.

Vorzugsweise bestimmt die Vorrichtung mittels eines computerimplementierten Verfahrens mittels der Steuervorrichtung **CTR** für die Arbeitspunkte und die dazwischen liegenden Bereiche eine jeweilige Messunsicherheit.

Bevorzugt ermittelt die Steuervorrichtung **CTR** im Rahmen eines Messzyklus einen oder mehrere der folgenden Werte
1. die wahrscheinliche Lage der unteren Resonanzkante **522,**
2. die wahrscheinliche Lage der unteren mittleren Resonanzkante **523,**
3. die wahrscheinliche Lage der oberen mittleren Resonanzkante **524,**
4. die wahrscheinliche Lage der oberen Resonanzkante **525,**
5. die wahrscheinliche Lage des mittleren Resonanzminimums **529,**
6. den wahrscheinlichen Wert der wirksamen Offsetflussdichte **B_{off},**
7. den wahrscheinlichen Wert der Nullpunktsflussdichte **B₀,**
8. den wahrscheinlichen Wert der Nullpunktsmikrowellenfrequenz ω_{µW0},
9. den wahrscheinlichen Wert **564** der magnetischen Flussdichte B, der der oberen Referenzlinie **561** zugeordnet ist, an einem oder mehreren Arbeitspunkten,
10. den wahrscheinlichen Wert **565** der magnetischen Flussdichte B, der der unteren Referenzlinie **562** zugeordnet ist, an einem oder mehreren Arbeitspunkten,
11. die wahrscheinliche Differenz **566** des Werts der magnetischen Flussdichte B, der der mittleren Referenzlinie **563** zugeordnet ist, minus dem Wert **565** der magnetischen Flussdichte B, der der unteren Referenzlinie **562** zugeordnet ist,
12. die wahrscheinliche Steigung **567** der Kurve an einem oder mehreren Arbeitspunkten;
13. die Polynomkoeffizienten der Polynomapproximation **627** der Kurve in einigen Arbeitspunkten,
14. den wahrscheinlichen Wert einer unteren wirksamen magnetischen Flussdichte **B₂₂,**
15. den wahrscheinlichen Wert einer unteren mittleren wirksamen magnetischen Flussdichte **B₂₃,**
16. den wahrscheinlichen Wert einer oberen mittleren wirksamen magnetischen Flussdichte **B₂₄,**
17. den wahrscheinlichen Wert einer oberen wirksamen magnetischen Flussdichte **B₂₅,**
18. den wahrscheinlichen Wert einer wirksamen magnetische Resonanzminimum-Flussdichte **B₂₉,**
19. den wahrscheinlichen Wert einer Nullpunktsmikrowellenfrequenz ω_{µW0};
20. den wahrscheinlichen Wert einer unteren Mikrowellenfrequenz ω_{µW22};
21. den wahrscheinlichen Wert einer unteren mittleren Mikrowellenfrequenz ω_{µW23};
22. den wahrscheinlichen Wert einer oberen mittleren Mikrowellenfrequenz ω_{µW24};
23. den wahrscheinlichen Wert einer oberen Mikrowellenfrequenz ω_{µW25};
24. den wahrscheinlichen Wert einer Resonanzminimum-Mikrowellenfrequenz ω_{µW29};
25. den wahrscheinlichen Wert einer unbekannten Mikrowellenfrequenz ω_{µWnk};
26. den wahrscheinlichen Wert einer Mikrowellenmodulationsfrequenz **f_{MµW};**

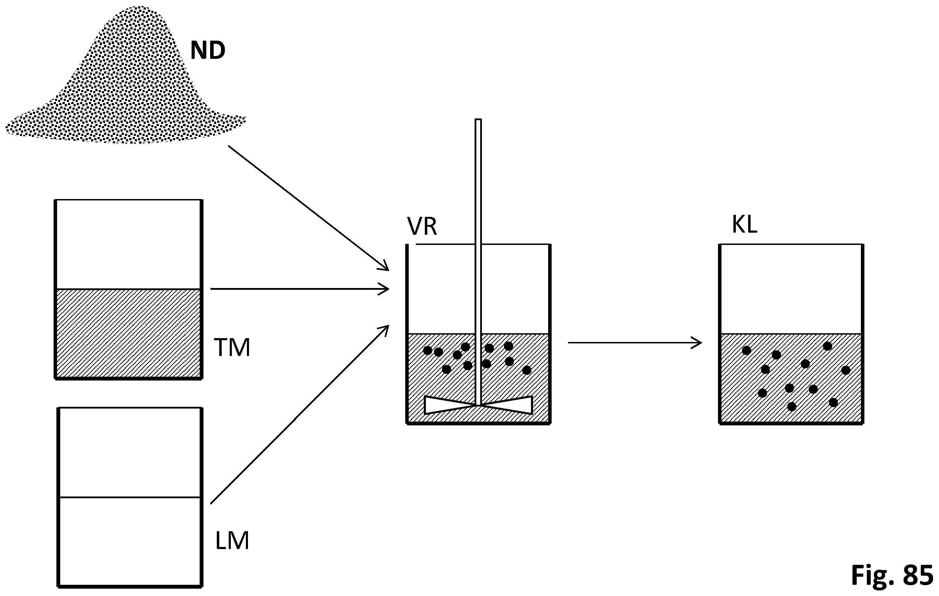

Die Vorrichtung kann den wahrscheinlichen Frequenzwert einer unbekannten Mikrowellenfrequenz ω_{µWnk} dadurch bestimmen, dass der die Mikrowellensignalquelle **µWG** ein internes Mikrowellensignal **(µW_G_I, µW_G_II, µW_G_III, µW_G_IV)** (Siehe Figur 85 für ein vektorielle Ausgestaltung, die hier aber sinngemäß angewendet werden kann), das eine bekannte interne Mikrowellenfrequenz (ω_{µW_I}, ω_{µW_II}, ω_{µE_III}, ω_{µW_IV}) aufweist, mit einem externen Mikrowellensignal S_{ωnk} zu dem Mikrowellensignal µW mischt und die dabei eines der beiden Seitenbänder mittels eines Filters **(µWG_F_I, µWG_F_II, µWG_F_III, µWG_F_I, µWG_F_IV)** wegfiltert. Die Vorrichtung wird dann typischerweise mit einem bekannten externen Mikrowellensignal S_{ωµwk} mit einer Referenzmikrowellenfrequenz ω_{µWk} kalibriert und es werden die Nullpunktsmikrowellenfrequenz ω_{µW0} und der Wert der Nullpunktsflussdichte **B₀,** als Referenzarbeitspunkt bestimmt. Wenn nun eine unbekannte Mikrowellenfrequenz ωₙₖ von extern als externes Mikrowellensignal S_{ωnk} eingespeist wird, so verschiebt sich die Nullpunktsmikrowellenfrequenz ω_{µW0} um einen Frequenzdifferenzwert, zwischen der Nullpunktsmikrowellenfrequenz ω_{µW0} bei der Kalibration und der Nullpunktsmikrowellenfrequenz ω_{µW0} bei der Messung der unbekannten Mikrowellenfrequenz ω_{µWnk} der Differenz zwischen Referenzmikrowellenfrequenz und der unbekannten Mikrowellenfrequenz ω_{µWnk} entspricht. Daher kann durch Bestimmung der Nullpunktsmikrowellenfrequenz ω_{µW0} die unbekannten Mikrowellenfrequenz ω_{µWnk} ermittelt werden. Bevorzugt regelt die Vorrichtung das zusätzliche Magnetfeld **B_{ad}** nach. Hierzu erfasst die Vorrichtung mittels eines Magnetfeldsensors **MS** die magnetische Gesamtflussdichte **B_{Σ},** vergleicht den erfassten Wert der Gesamtflussdichte **B_{Σ}** mit einem Sollwert und regelt dann die Bestromung des Magnetfelderzeugungsmittel **L_{C}** entsprechend der Differenz zwischen Gesamtflussdichte **B_{Σ}** und Sollwert nach. Bevorzugt handelt es sich um eine Regelung mit einer PID-Regler-Charakteristik. Die Vorrichtung kann beispielsweise das Signal **S4_{c}**(t) bilden und als Regelgröße verwenden. In dem Fall wäre das Sensorelement **SE** selbst der Magnetfeldsensor **MS.** Sofern die Vorrichtung nicht das Sensorelement **SE** als Magnetfeldsensor **MS** für die Regelung der magnetische Gesamtflussdichte **B_{Σ}** verwendet, kann die Vorrichtung über eine Magnetfeldsensoransteuerung **SIS** verfügen, die den Magnetfeldsensor **MS** ansteuert, betreibt und ausliest und die so ausgelesenen Messdaten dem Magnetfeldregler **LCTR** und/oder der Steuervorrichtung **CTR** für die Nachregelung der magnetischen Gesamtflussdichte **B_{Σ},** beispielsweise mittels Regelung der Bestromung des Magnetfelderzeugungsmittels **L_{C}** durch den Magnetfeldregler **LCTR,** zur Verfügung stellt. Vorzugsweise kann dabei die Steuervorrichtung **CTR** den Magnetfeldregler **LCTR** und die Magnetfeldsensoransteuerung **SIS** über den Datenbus **DB** auslesen und/oder steuern.

Es ist offensichtlich, dass die Bildung der vorstehenden Integrale auch analog ohne Digitalisierung des Empfängerausgangssignals im Mehrfachkorrelator **LIV** erfolgen kann. Beispielsweise können die Vektorkomponentensignale **S4ₐ, S4_{b}, S4_{c}** und **S4_{d}** bzw. **S4₁, S4₂, S4₃** und **S4₄** in dem Mehrfachkorrelator **LIV** auch mittels analoger Signalverarbeitung gebildet werden. In dem Fall ist eine Digitalisierung der dann analogen Vektorkomponentensignale **S4ₐ, S4_{b}, S4_{c}** und **S4_{d}** bzw. **S4₁, S4₂, S4₃** und **S4₄** des Filterausgangssignals **S4** sinnvoll, um die Werte der Steuervorrichtung **CTR** zur Verfügung zu stellen. Im Falle einer analogen Bildung der obigen Integrale hat sich die Verwendung eines Tiefpassfilters **TP** oder eines Filters mit Tiefpasseigenschaften als Integrator nach den erfolgten Multiplikationen bewährt.

### Zur Positionierung der Sensorelemente SE

Das hier vorgelegte Dokument weist darauf hin, dass insgesamt fünf Positionierungen von Sensorelementen **SE** relativ zu den Leitungen und Leitungsflächen der Tri-Plate-Leitung **2380** möglich sind:
1. auf der elektrisch leitenden linken Signalmassefläche **1310,**
2. in der nicht-leitenden linken Isolationslücke **2340,**
3. auf dem Signalleiter **1330,**
4. in der nicht-leitenden rechten Isolationslücke **2350,**
5. auf der elektrisch leitenden linken Signalmassefläche **1320.**

Mischformen der Sensorelemente **SE** durch Fehlplatzierungen und Vergrößerungen der betreffenden Sensorelemente **SE** sind möglich.

### Figur 70

Figur 70 zeigt eine beispielhafte schematische Realisierung eines analogen Mehrfachkorrelators **LIV** in einer schematisch skizzierten Konstruktion der Figur 69.

Zur Vereinfachung stellt der analoge Mehrfachkorrelator **LIV** der Figur 70 nur ein Integral der in der Beschreibung der Figur 69 aufgezählten Integrale dar. Es handelt sich um das Integral $S {4}_{a} \left(t\right) = {\int }_{0}^{2 π} S 1 \left(t\right) ⋅ S 5 w \left(t\right) ⋅ S 5 m \left(t\right) dt$

Da der Mehrfachkorrelator **LIV** in der Figur 70 nur dieses eine Integral bildet, bildet der Mehrfachkorrelator **LIV** keine der Differenzen aus den Integralen, wie in der Beschreibung der Figur 69 beschrieben.

Um die anderen Integrale bilden zu können, müssten weitere Vorrichtungsteile ergänzt werden, was einer fachkundigen Person leicht möglich ist.

Zum ersten müssten die jeweils fehlenden invertierten Signale der hier verwendeten Signale gebildet werden. Hierzu müsste beispielsweise ein Inverter oder dergleichen das invertierte Mikrowellenmodulationssignal **S5mq** oder ein funktionsäquivalentes Signal aus dem Mikrowellenmodulationssignal **S5m** bilden. Des Weiteren müsste ein Inverter oder dergleichen das invertierte LED-Modulationssignal **S5wd** oder ein funktionsäquivalentes Signal aus dem LED-Modulationssignal **S5w** bilden. Außerdem wären zusätzliche Multiplizierer und für jedes zu bildende Signal ein weiterer Tiefpass **TP** notwendig. Zu Bildung der Differenzen der von diesen Tiefpässen TP gebildeten Filterausgangssignale **S4ₐ(t), S4_{b}(t), S4_{c}**(t) und **S4_{d}**(t) wären dann für jedes zu bildende Differenzsignal jeweils ein Subtrahierer notwendig, der eines der Filterausgangssignale **S4ₐ(t), S4_{b}(t), S4_{c}**(t) und **S4_{d}**(t) von einem anderen der Filterausgangssignale **S4ₐ(t), S4_{b}(t), S4_{c}**(t) und **S4_{d}**(t) subtrahiert und daraus eines der Vektorkomponentensignale **S4₁(t), S4₂(t), S4₃(t)** und **S4₄(t)** des vektoriellen Filterausgangssignal **S4(t)** und ggf. andere Vektorkomponentensignale des vektoriellen Filterausgangssignal **S4(t)** bildet.

Die Figur 70 ist daher nur ein Beispiel für eine analoge Realisierung des Mehrfachkorrelators **LIV** aus einer größeren Menge möglicher Realisierungen, die Teil der technischen Lehre des hier vorgelegten Dokuments sind.

In der Figur 70 digitalisiert der erste Verstärker **V1** das Empfängerausgangssignal **S0** nicht zu einem digitalen Empfängerausgangssignal **S1,** sondern bildet nur das analoge, verstärkte Empfängerausgangssignal **S1.**

In dem Beispiel der Figur 70 umfasst der Mehrfachkorrelator **LIV** einen ersten Multiplizierter **M1,** der das erste Produkt S1(t)*s1(t)=S3a(t) des L3-Produkts $S 4 \left(t\right) = {\int }_{0}^{2 π} S 1 \left(t\right) ⋅ s 1 \left(t\right) ⋅ s 2 \left(t\right) dt$ bildet. Das Ergebnis ist das erste Zwischensignal **S3a** des L3-Produkts des Mehrfachkorrelators **LIV.**

In dem Beispiel der Figur 70 ist das erste Signal s1(t) des L3-Produkts das LED-Modulationssignal **S5w.**

In dem Beispiel der Figur 70 umfasst der Mehrfachkorrelator **LIV** einen zweiten Multiplizierter **M2,** der das zweite Produkt (S1(t)*s1(t))*s2(t)=S3a(t)*s2(t)=S3b(t) des L3-Produkts $S 4 \left(t\right) = {\int }_{0}^{2 π} S 1 \left(t\right) ⋅ s 1 \left(t\right) ⋅ s 2 \left(t\right) dt$ bildet. Das Ergebnis ist das zweite Zwischensignal **S3b(t)** des L3-Produkts des Mehrfachkorrelators **LIV.**

In dem Beispiel der Figur 70 realisiert eine Tiefpassfilterung des Zwischensignals **S3b** des L3-Produkts des Mehrfachkorrelators **LIV** in einem analogen Tiefpassfilter **TP** die Integration. Dieser Tiefpassfilter **TP** bildet zum Ersten nur ein unbestimmtes und kein bestimmtes Integral. Zum Zweiten gilt diese Äquivalenz eines Tiefpassfilters **TP** mit einem Integrator nur für hinreichend niedrige Frequenzen.

Vorzugsweise ist die Grenzfrequenz des Tiefpassfilters **TP** daher so gewählt, dass die LED-Modulationsfrequenz **f_{LED},** die Mikrowellenmodulationsfrequenz **f_{µW}** und die Differenzfrequenz **| f_{LED}** - **f_{µW}** | sicher unterdrückt werden, so dass im Wesentlichen nur die Anteile um 0Hz herum den Tiefpassfilter **TP** passieren.

Der Tiefpass **TP** kann auch komplexere Filterfunktionen realisieren und umfassen.

Der Verzicht auf die Bestimmtheit des Integrals im Tiefpassfilter **TP** führt zu Fehlern. Diese können vermieden werden, wenn eine Sample&Hold-Schaltung am Ausgang des Tiefpassfilters **TP** immer am Ende der längeren Periode der Periode des Mikrowellenmodulationssignals **S5m** bzw. der Periode des LED-Modulationssignals **S5w** den analogen Pegel am Ausgang des Tiefpasses **TP** bis zum nächsten Periodenende einfriert. Dafür ist es notwendig, dass die beiden Periodendauern in einem ganzzahligen Verhältnis stehen.

In der Praxis hat sich gezeigt, dass abhängig von der jeweiligen Anwendung eine solche Sample &Hold-Schaltung als Teil des Tiefpasses **TP** oft nicht zwingend erforderlich ist.

In dem Beispiel der Figur 70 bildet der Tiefpass **TP** das Vektorkomponentensignal **S4ₐ(t)** des vereinfacht hier beispielhaft eindimensionalen vektoriellen Filterausgangssignals **S4(t).**

In dem Beispiel der Figur 70 digitalisiert der Analog-zu-Digital-Wandler **ADC** das Vektorkomponentensignal **S4ₐ(t)** des vereinfacht hier beispielhaft eindimensionalen vektoriellen Filterausgangssignals **S4(t)** und stellt die Abtastwerte über den Datenbus **DB** der Steuervorrichtung **CTR** zur Verfügung.

Typischerweise umfasst die Vorrichtung im Falle einer solchen analogen Realisierung mehr als einen analogen Mehrfachkorrelator **LIV** zur Bildung mehrerer Vektorkomponentensignale **S4ₐ(t), S4_{b}(t), S4_{c}**(t) und **S4_{d}**(t) des vektoriellen Filterausgangssignals **S4(t).** Der Analog-zu-Digital-Wandler **ADC** tastet dann jedes dieser Vektorkomponentensignale **S4ₐ(t), S4_{b}(t), S4_{c}**(t) und **S4_{d}**(t) des vektoriellen Filterausgangssignals **S4(t)** ab und stellt deren Abtastwerte über den Datenbus **DB** der Steuervorrichtung **CTR** zur Verfügung.

Insofern ist die Figur 70 nur eine stark vereinfachte Darstellung zur Erläuterung der Realisierung eines Mehrfachkorrelators **LIV.** Umfasst die Vorrichtung mehr als einen Mehrfachkorrelator **LIV,** so umfassen diese typischerweise aus Synergiegründen verschiedene Vorrichtungsteile wie Multiplizierer und Zwischensignale gemeinsam, um Ressourcen zu sparen.

### Figur 71

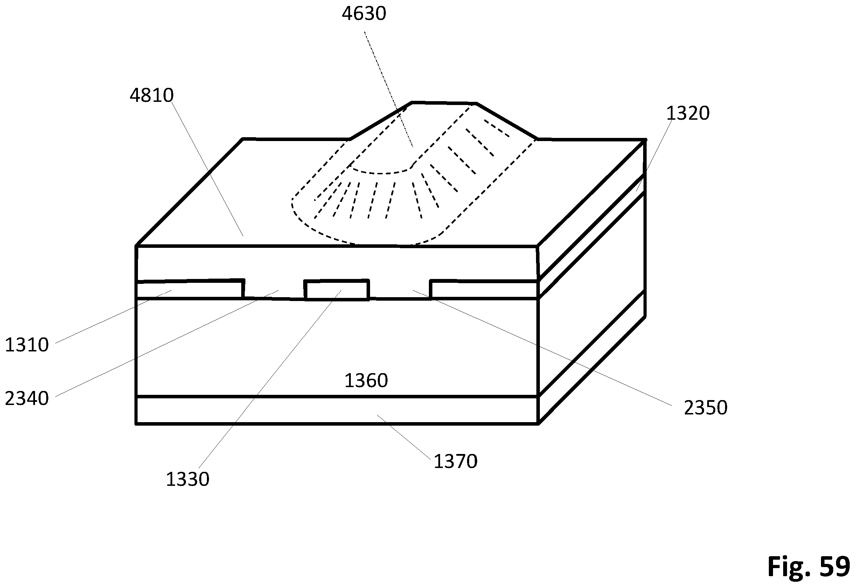

Figur 71 zeigt eine Vorrichtung zur Ansteuerung von beispielhaft drei Sensorelementen **SE (1410, 1420, 1430),** die auf dem Trägersubstrat **1360** platziert sind, mittels einer beispielhafte Tri-Plate-Leitung **2380.** Statt der Tri-Plate-Leitung **2380** können auch andere Wellenleitungen wie beispielsweise eine Schlitzleitung **1880** mit den beispielhaften Sensorelementen **1410, 1420, 1430** oder die Mikrostreifenleitung **1380** mit den beispielhaften Sensorelementen **1410, 1420, 1430** eingesetzt werden. Die technische Lehre der Figur 59 soll hier also ganz allgemein für die Ansteuerung, Vermessung und Auswertung mehrerer Sensorelemente **SE** stehen, die auf einem Trägersubstrat **1360** platziert sind und deren NV-Zentren und/oder paramagnetischen Zentren mit dem elektromagnetischen Feld und insbesondere mit der magnetischen Flussdichtekomponente eines elektromagnetischen Feldes wechselwirken, das von einem Wellenleiter, der auf dem Trägersubstrat **1360** gefertigt ist, transportiert wird.

In dem Beispiel der Figur 71 umfasst die Vorrichtung als beispielhaft drei Sensorelemente **SE** ein linkes Sensorelement **1410** und ein mittleres Sensorelement **1420** und ein rechtes Sensorelement **1430.** Das Beispiel der Figur 71 steht beispielhaft für Vorrichtungen mit n Sensorelementen SE, wobei n eine ganze positive Zahl größer 1 ist und hier in diesem Beispiel n=3 beispielhaft gilt.

In dem Beispiel der Figur 71 umfasst die Vorrichtung mehrere - hier drei - Sensorelementkanäle. Jeder Sensorelementkanal ist bevorzugt einem Sensorelement der Sensorelemente **SE(1410, 1420, 1430)** zugeordnet.

### Allgemeiner Sensorelementkanal

Die vorschlagsgemäße Vorrichtung kann typischerweise mehrere Sensorelementkanäle aufweisen. Die vorschlagsgemäße Vorrichtung umfasst vorzugsweise mindestens einen Sensorelementkanal oder besser mindestens zwei Sensorelementkanäle. In dem Beispiel der Figur 71 umfasst die vorschlagsgemäße Vorrichtung beispielhaft drei Sensorelementkanäle.

Vorzugsweise umfasst ein Sensorelementkanal
- einen ersten Signalgenerator **G1,** der das LED-Modulationssignal **S5w** erzeugt,
- einen Lichtquellentreiber **LDRV,** der das Sendesignal **S5** für die Pumpstrahlungsquelle, hier die Lichtquelle **LED,** in Abhängigkeit von dem LED-Modulationssignal **S5w** erzeugt und vorzugsweise die Pumpstrahlungsquelle, hier die Lichtquelle **LED,** mit elektrischer Energie versorgt,
- ein Sendesignal **S5;**
- eine Pumpstrahlungsquelle, hier eine Lichtquelle **LED,** die die Pumpstrahlung **LB** in Abhängigkeit von dem Sendesignal **S5** erzeugt und beispielsweise die Pumpstrahlungsquelle, hier eine Lichtquelle **LED,** nur zeitweise ein und nur zeitweise ausschaltet,
- ein erstes optisches System,
   ∘ das ein oder mehrere optische Funktionselemente umfasst und
   ∘ das die Pumpstrahlung **LB** der Pumpstrahlungsquelle, hier der Lichtquelle LED, erfasst und
   ∘ das die Pumpstrahlung **LB** zum zugeordneten Sensorelement **SE** transportiert und
   ∘ das die Pumpstrahlung **LB** aus dem ersten optischen System auskoppelt und
   ∘ das das zugeordnete Sensorelement **SE** mit Pumpstrahlung **LB** bestrahlt und
   ∘ das bevorzugt einen Lichtwellenleiter **LWL** für das Sensorelement **SE** als ein solches optisches Funktionselement umfasst,
- ein zweites optisches System,
   ∘ das ein oder mehrere optische Funktionselemente umfasst und
   ∘ das die Fluoreszenzstrahlung **FL** der NV-Zentren und/oder der paramagnetischen Zentren des zugeordneten Sensorelements **SE** erfasst und
   ∘ das Fluoreszenzstrahlung **FL** der NV-Zentren und/oder der paramagnetischen Zentren des zugeordneten Sensorelements **SE** zum zugeordneten Fotodetektor **PD** transportiert und
   ∘ das Fluoreszenzstrahlung **FL** der NV-Zentren und/oder der paramagnetischen Zentren des zugeordneten Sensorelements **SE** aus dem zweiten optischen System auskoppelt und
   ∘ das den zugeordneten Fotodetektor **PD** mit Fluoreszenzstrahlung **FL** der NV-Zentren und/oder der paramagnetischen Zentren des zugeordneten Sensorelements **SE** bestrahlt und
   ∘ das Funktionselemente, beispielsweise einen dichroitischen Spiegel **F1** und/oder einen optischen Filter im Strahlengang, umfasst, die sicherstellen, dass im Wesentlichen keine Pumpstrahlung **LB** dieser oder anderer Pumpstrahlungsquellen, insbesondere die der Lichtquelle **LED** und/oder anderer Lichtquellen **(LED, LED_1, LED2, LED_3),** den Fotodetektor **PD** erreicht und
   ∘ das bevorzugt einen Lichtwellenleiter **LWL** für das Sensorelement **SE** als ein solches optisches Funktionselement umfasst und
   ∘ das Vorrichtungsteile umfassen kann, die mit Vorrichtungsteilen des ersten optischen Systems identisch sind,
- den Fotodetektor **PD,** der die Intensität der empfangenen Fluoreszenzstrahlung **FL** in eine Empfängerausgangssignal **S0** wandelt,
- das Empfängerausgangssignal **S0,**
- einen erster Verstärker **V1** für das Sensorelement **SE** zur Verstärkung und/oder Digitalisierung des Empfangssignals **S0** zum verstärkten Empfängerausgangssignal **S1** bzw. zum digitalisierten Empfängerausgangssignal **S1,**
- das verstärkte Empfängerausgangssignal **S1** bzw. das digitalisierte Empfängerausgangssignal **S1,**
- einen Mehrfachkorrelator **LIV,** der ein vektorielles Filterausgangssignal **S4** in Abhängigkeit vom verstärkten Empfängerausgangssignal **S1** bzw. vom digitalisierten Empfängerausgangssignal **S1** und dem LED-Modulationssignal **S5w** bildet und Daten des vektoriellen Filterausgangssignals **54** der Steuervorrichtung **CTR** zur Verfügung stellt, insbesondere für die Steuervorrichtung **CTR** bereithält oder an die Steuervorrichtung **CTR** oder eine andere Vorrichtung (z.B. den Mustererkennungsvorrichtung **MEV)** insbesondere zur Auswertung überträgt,
- ein vektorielles Filterausgangssignal **54** für das zugeordnete Sensorelement **SE,** das typischerweise ein Teil des eines gemeinsamen vektoriellen Filterausgangssignals **54** der vektoriellen Filterausgangssignale **54** anderer Sensorelementkanäle ist und typischerweise von einem Mustererkennungsvorrichtung **MEV** und/oder der Steuervorrichtung **CTR** ausgewertet wird.

In einer Weiterbildung umfasst der allgemeine Sensorelementkanal,
- einen zweiten Signalgenerator **G2,** der dazu eingerichtet ist, ein Mikrowellenmodulationssignal **S5m** zu erzeugen;
- eine Wellenleitung **(1380, 1880, 2380, 6830, 6980);**
- eine Mikrowellensignalquelle **µWG,** die dazu eingerichtet ist, das Mikrowellensignal **µW** für die Wellenleitung **(1380, 1880, 2380, 6830, 6980)** in Abhängigkeit von dem Mikrowellenmodulationssignal **S5m** zu erzeugen und in die Wellenleitung **(1380, 1880, 2380, 6830, 6980)** einzuspeisen;
- den Mehrfachkorrelator **LIV** für das Sensorelement **SE,** der ein vektorielles Filterausgangssignal **S4** für das Sensorelement **SE** in Abhängigkeit vom verstärkten Empfängerausgangssignal **S1** für das Sensorelement **SE** bzw. vom digitalisierten Empfängerausgangssignal **S1** für das Sensorelement **SE** und dem LED-Modulationssignal **S5w** für das Sensorelement **SE** und dem Mikrowellenmodulationssignal **S5m** bildet und Daten des vektoriellen Filterausgangssignals **S4** für das Sensorelement **SE** der Steuervorrichtung **CTR** zur Verfügung stellt, insbesondere für die Steuervorrichtung **CTR** bereithält oder an die Steuervorrichtung **CTR** oder eine andere Vorrichtung (z.B. die Mustererkennungsvorrichtung **MEV)** insbesondere zur Auswertung überträgt.

Die Figur 71 weist drei solcher Sensorelementkanäle auf.

Ein beispielhafter erster, linker Sensorelementkanal ist dem beispielhaften linken Sensorelement **1410** zugeordnet.

Ein beispielhafter zweiter, mittlerer Sensorelementkanal ist dem beispielhaften mittleren Sensorelement **1420** zugeordnet.

Ein beispielhafter dritter, rechter Sensorelementkanal ist dem beispielhaften rechten Sensorelement **1430** zugeordnet.

### Erster, linker Sensorelementkanal

Vorzugsweise umfasst der erste, linke Sensorelementkanal
- einen ersten Signalgenerator **G1_1** für das linke Sensorelement **1410,** der das LED-Modulationssignal **S5w_1** für das linke Sensorelement **1410** erzeugt,
- einen Lichtquellentreiber **LDRV_1** für das linke Sensorelement **1410,** der das Sendesignal **S5_1** für das linke Sensorelement **1410** zur Ansteuerung der Pumpstrahlungsquelle für das linke Sensorelement **1410,** hier die Lichtquelle **LED_1** für das linke Sensorelement **1410,** in Abhängigkeit von dem LED-Modulationssignal **S5w_1** für das linke Sensorelement **1410** erzeugt und vorzugsweise die Pumpstrahlungsquelle für das linke Sensorelement **1410,** hier die Lichtquelle **LED_1** für das linke Sensorelement **1410,** mit elektrischer Energie versorgt,
- ein Sendesignal **S5_1** für das linke Sensorelement **1410;**
- eine Pumpstrahlungsquelle für das linke Sensorelement **1410,** hier eine Lichtquelle **LED_1** für das linke Sensorelement **1410,** die die Pumpstrahlung **LB_1** für das linke Sensorelement **1410** in Abhängigkeit von dem Sendesignal **S5_1** für das linke Sensorelement **1410** erzeugt und beispielsweise die Pumpstrahlungsquelle für das linke Sensorelement **1410,** hier eine Lichtquelle **LED_1** für das linke Sensorelement **1410,** nur zeitweise ein und nur zeitweise ausschaltet,
- ein erstes optisches System für das linke Sensorelement **1410,**
   ∘ das ein oder mehrere optische Funktionselemente umfasst und
   ∘ das die Pumpstrahlung **LB_1** für das linke Sensorelement **1410** der Pumpstrahlungsquelle für das linke Sensorelement **1410,** hier der Lichtquelle **LED_1** für das linke Sensorelement **1410,** erfasst und
   ∘ das die Pumpstrahlung **LB** für das linke Sensorelement **1410** zum zugeordneten Sensorelement **SE,** hier dem linken Sensorelement **1410,** transportiert und
   ∘ das die Pumpstrahlung **LB_1** für das linke Sensorelement **1410**aus dem ersten optischen System für das linke Sensorelement **1410**auskoppelt und
   ∘ das das zugeordnete Sensorelement **SE,** hier das linke Sensorelement **1410,** mit Pumpstrahlung **LB_1** für das linke Sensorelement **1410** bestrahlt und
   ∘ das bevorzugt einen Lichtwellenleiter **LWL_1** für das linke Sensorelement **1410** als ein solches optisches Funktionselement umfasst,
- ein zweites optisches System,
   ∘ das ein oder mehrere optische Funktionselemente umfasst und
   ∘ das die Fluoreszenzstrahlung **FL_1** der NV-Zentren und/oder der paramagnetischen Zentren des zugeordneten Sensorelements **SE,** hier des linken Sensorelements **1410,** erfasst und
   ∘ das Fluoreszenzstrahlung **FL_1** der NV-Zentren und/oder der paramagnetischen Zentren des zugeordneten Sensorelements **SE** , hier des linken Sensorelements **1410,** zum zugeordneten Fotodetektor **PD_1** für das linke Sensorelement **1410** transportiert und
   ∘ das Fluoreszenzstrahlung **FL_1** der NV-Zentren und/oder der paramagnetischen Zentren des zugeordneten Sensorelements **SE,** hier des linken Sensorelements **1410,** aus dem zweiten optischen System auskoppelt und
   ∘ das den zugeordneten Fotodetektor **PD_1** für das linke Sensorelement **1410** mit Fluoreszenzstrahlung **FL_1** der NV-Zentren und/oder der paramagnetischen Zentren des zugeordneten Sensorelements **SE,** hier des linken Sensorelements **1410,** bestrahlt und
   ∘ das Funktionselemente, beispielsweise einen dichroitischen Spiegel **F1_1** für das linke Sensorelement **1410** und/oder einen optischen Filter im Strahlengang, umfasst, die sicherstellen, dass im Wesentlichen keine Pumpstrahlung **LB_1** dieser oder anderer Pumpstrahlungsquellen, insbesondere die der Lichtquelle **LED_1** und/oder anderer Lichtquellen **(LED, LED_1, LED2, LED_3),** den Fotodetektor **PD_1** für das linke Sensorelement **1410** erreicht und
   ∘ das bevorzugt einen Lichtwellenleiter **LWL_1** für das linke Sensorelement **1410** als ein solches optisches Funktionselement umfasst und
   ∘ das Vorrichtungsteile umfassen kann, die mit Vorrichtungsteilen des ersten optischen Systems identisch sind,
- den Fotodetektor **PD_1** für das linke Sensorelement **1410,** der die Intensität der empfangenen Fluoreszenzstrahlung **FL_1** des linken Sensorelements **1410,** in ein Empfängerausgangssignal S0_1 für das linke Sensorelement **1410** wandelt,
- das Empfängerausgangssignal **S0_1** für das linke Sensorelement **1410,**
- einen erster Verstärker **V1_1** für das Sensorelement **SE,** hier für das linke Sensorelement **1410,** zur Verstärkung und/oder Digitalisierung des Empfangssignals **S0_1** für das linke Sensorelement **1410** zum verstärkten Empfängerausgangssignal **S1_1** für das linke Sensorelement **1410** bzw. zum digitalisierten Empfängerausgangssignal **S1_1** für das linke Sensorelement **1410,**
- das verstärkte Empfängerausgangssignal **S1_1** für das linke Sensorelement **1410** bzw. das digitalisierte Empfängerausgangssignal **S1_1** für das linke Sensorelement **1410,**
- einen Mehrfachkorrelator **LIV_1** für das linke Sensorelement **1410,** der ein vektorielles Filterausgangssignal **S4_1** für das linke Sensorelement **1410** in Abhängigkeit vom verstärkten Empfängerausgangssignal **S1_1** für das linke Sensorelement **1410** bzw. vom digitalisierten Empfängerausgangssignal **S1_1** für das linke Sensorelement **1410** und dem LED-Modulationssignal **S5w_1** für das linke Sensorelement **1410** bildet und Daten des vektoriellen Filterausgangssignals **S4_1** für das linke Sensorelement **1410** der Steuervorrichtung **CTR** zur Verfügung stellt, insbesondere für die Steuervorrichtung **CTR** bereithält oder an die Steuervorrichtung **CTR** oder eine andere Vorrichtung (z.B. den Mustererkennungsvorrichtung **MEV**) insbesondere zur Auswertung überträgt,
- ein vektorielles Filterausgangssignal **S4_1** für das linke Sensorelement **1410,** das typischerweise ein Teil des vektoriellen Filterausgangssignals **S4** ist und typischerweise von einem Mustererkennungsvorrichtung **MEV** und/oder der Steuervorrichtung **CTR** ausgewertet wird.

In einer Weiterbildung umfasst der erste Sensorelementkanal,
- einen ersten zweiten Signalgenerator **G2_I,** der dazu eingerichtet ist, ein erstes Mikrowellenmodulationssignal **S5m_I** zu erzeugen;
- eine erste Wellenleitung **(1380, 1880, 2380, 6830, 6980);**
- eine erste Mikrowellensignalquelle **µWG_I,** die dazu eingerichtet ist, das erste Mikrowellensignal **µW_I** für die erste Wellenleitung **(1380, 1880, 2380, 6830, 6980)** in Abhängigkeit von dem ersten Mikrowellenmodulationssignal **S5m_I** zu erzeugen und in die erste Wellenleitung **1380, 1880, 2380, 6830, 6980** einzuspeisen;
- den Mehrfachkorrelator **LIV_1** für das linke Sensorelement **1410,** der ein vektorielles Filterausgangssignal **S4_1** für das linke Sensorelement **1410** in Abhängigkeit vom verstärkten Empfängerausgangssignal **S1_1** für das linke Sensorelement **1410** bzw. vom digitalisierten Empfängerausgangssignal **S1_1** für das linke Sensorelement **1410** und dem LED-Modulationssignal **S5w_1** für das linke Sensorelement **1410** und dem ersten Mikrowellenmodulationssignal **S5m_I** bildet und Daten des vektoriellen Filterausgangssignals **S4_1** für das linke Sensorelement **1410** der Steuervorrichtung **CTR** zur Verfügung stellt, insbesondere für die Steuervorrichtung **CTR** bereithält oder an die Steuervorrichtung **CTR** oder eine andere Vorrichtung (z.B. die Mustererkennungsvorrichtung **MEV)** insbesondere zur Auswertung überträgt.

Hinsichtlich der Funktionen und dem Zusammenwirken der Sensorelementkanal spezifischen Vorrichtungsteile **(SE(1410); S5w_1, LDRV_1, S5_1, LED_1, LB_1, LWL_1, F1_1, PD_1, S0_1, V1_1, S1_1, LIV_1, S4_1)** des ersten, linken Sensorelementkanals und der anderen nicht Sensorelementkanal spezifischen Vorrichtungsteile der Vorrichtung verweist das hier vorgelegte Dokument auf die Beschreibung der Figur 69 für die korrespondierenden Vorrichtungsteile **(SE, S5w, LDRV, S5, LED, LB, LWL, F1, PD, S0, V1, S1, LIV, S4)** des einen Sensorkanals der Figur 69 und der anderen nicht Sensorelementkanal spezifischen Vorrichtungsteile der Vorrichtung der Figur 69.

### Zweiter, mittlerer Sensorelementkanal

Vorzugsweise umfasst der zweite, mittlere Sensorelementkanal
- einen ersten Signalgenerator **G1_2** für das mittlere Sensorelement **1420,** der das LED-Modulationssignal **S5w_2** für das mittlere Sensorelement **1420** erzeugt,
- einen Lichtquellentreiber **LDRV_2** für das mittlere Sensorelement **1420,** der das Sendesignal **S5_2** für das mittlere Sensorelement **1420** zur Ansteuerung der Pumpstrahlungsquelle für das mittlere Sensorelement **1420,** hier die Lichtquelle **LED_2** für das mittlere Sensorelement **1420,** in Abhängigkeit von dem LED-Modulationssignal **S5w_2** für das mittlere Sensorelement **1420** erzeugt und vorzugsweise die Pumpstrahlungsquelle für das mittlere Sensorelement **1420,** hier die Lichtquelle **LED_2** für das mittlere Sensorelement **1420,** mit elektrischer Energie versorgt,
- ein Sendesignal **S5_2** für das mittlere Sensorelement **1420;**
- eine Pumpstrahlungsquelle für das mittlere Sensorelement **1420,** hier eine Lichtquelle **LED_2** für das mittlere Sensorelement **1420,** die die Pumpstrahlung **LB_2** für das mittlere Sensorelement **1420** in Abhängigkeit von dem Sendesignal **S5_2** für das mittlere Sensorelement **1420** erzeugt und beispielsweise die Pumpstrahlungsquelle für das mittlere Sensorelement **1420,** hier eine Lichtquelle **LED_2** für das mittlere Sensorelement **1420,** nur zeitweise ein und nur zeitweise ausschaltet,
- ein erstes optisches System für das mittlere Sensorelement **1420,**
   ∘ das ein oder mehrere optische Funktionselemente umfasst und
   ∘ das die Pumpstrahlung **LB_2** für das mittlere Sensorelement **1420** der Pumpstrahlungsquelle für das mittlere Sensorelement **1420,** hier der Lichtquelle **LED_2** für das mittlere Sensorelement **1420,** erfasst und
   ∘ das die Pumpstrahlung **LB_2** für das mittlere Sensorelement **1420** zum zugeordneten Sensorelement **SE,** hier dem mittleren Sensorelement **1420,** transportiert und
   ∘ das die Pumpstrahlung **LB_2** für das mittlere Sensorelement **1420** aus dem ersten optischen System für das mittlere Sensorelement **1420** auskoppelt und
   ∘ das das zugeordnete Sensorelement **SE,** hier das mittlere Sensorelement **1420,** mit Pumpstrahlung **LB_2** für das mittlere Sensorelement **1420** bestrahlt und
   ∘ das bevorzugt einen Lichtwellenleiter **LWL_2** für das mittlere Sensorelement **1420** als ein solches optisches Funktionselement umfasst,
- ein zweites optisches System,
   ∘ das ein oder mehrere optische Funktionselemente umfasst und
   ∘ das die Fluoreszenzstrahlung **FL_2** der NV-Zentren und/oder der paramagnetischen Zentren des zugeordneten Sensorelements **SE,** hier des mittleren Sensorelements **1420,** erfasst und
   ∘ das Fluoreszenzstrahlung **FL_2** der NV-Zentren und/oder der paramagnetischen Zentren des zugeordneten Sensorelements **SE** , hier des mittleren Sensorelements **1420,** zum zugeordneten Fotodetektor **PD_2** für das mittlere Sensorelement **1420** transportiert und
   ∘ das Fluoreszenzstrahlung **FL_2** der NV-Zentren und/oder der paramagnetischen Zentren des zugeordneten Sensorelements **SE,** hier des mittleren Sensorelements **1420,** aus dem zweiten optischen System auskoppelt und
   ∘ das den zugeordneten Fotodetektor **PD_2** für das mittlere Sensorelement **1420** mit Fluoreszenzstrahlung **FL_2** der NV-Zentren und/oder der paramagnetischen Zentren des zugeordneten Sensorelements **SE,** hier des mittleren Sensorelements **1420,** bestrahlt und
   ∘ das Funktionselemente, beispielsweise einen dichroitischen Spiegel **F1_2** für das mittlere Sensorelement **1420** und/oder einen optischen Filter im Strahlengang, umfasst, die sicherstellen, dass im Wesentlichen keine Pumpstrahlung **LB_2** dieser oder anderer Pumpstrahlungsquellen, insbesondere die der Lichtquelle **LED_2** und/oder anderer Lichtquellen **(LED, LED_1, LED2, LED_3),** den Fotodetektor **PD_2** für das mittlere Sensorelement **1420** erreicht und
   ∘ das bevorzugt einen Lichtwellenleiter **LWL_2** für das mittlere Sensorelement **1420** als ein solches optisches Funktionselement umfasst und
   ∘ das Vorrichtungsteile umfassen kann, die mit Vorrichtungsteilen des ersten optischen Systems identisch sind,
- den Fotodetektor **PD_2** für das mittlere Sensorelement **1420,** der die Intensität der empfangenen Fluoreszenzstrahlung **FL_2** des mittleren Sensorelements **1420,** in ein Empfängerausgangssignal **S0_2** für das mittlere Sensorelement **1420** wandelt,
- das Empfängerausgangssignal **S0_2** für das mittlere Sensorelement **1420,**
- einen erster Verstärker **V1_2** für das Sensorelement **SE,** hier für das mittlere Sensorelement **1410,** zur Verstärkung und/oder Digitalisierung des Empfangssignals **S0_2** für das mittlere Sensorelement **1420** zum verstärkten Empfängerausgangssignal **S1_2** für das mittlere Sensorelement **1420** bzw. zum digitalisierten Empfängerausgangssignal **S1_2** für das mittlere Sensorelement **1420,**
- das verstärkte Empfängerausgangssignal **S1_2** für das mittlere Sensorelement **1420** bzw. das digitalisierte Empfängerausgangssignal **S1_2** für das mittlere Sensorelement **1420,**
- einen Mehrfachkorrelator **LIV_2** für das mittlere Sensorelement **1420,** der ein vektorielles Filterausgangssignal **S4_2** für das mittlere Sensorelement **1420** in Abhängigkeit vom verstärkten Empfängerausgangssignal **S1_2** für das mittlere Sensorelement **1420** bzw. vom digitalisierten Empfängerausgangssignal **S1_2** für das mittlere Sensorelement **1420** und dem LED-Modulationssignal **S5w_2** für das mittlere Sensorelement **1420** bildet und Daten des vektoriellen Filterausgangssignals **S4_2** für das mittlere Sensorelement **1420** der Steuervorrichtung **CTR** zur Verfügung stellt, insbesondere für die Steuervorrichtung **CTR** bereithält oder an die Steuervorrichtung **CTR** oder eine andere Vorrichtung (z.B. den Mustererkennungsvorrichtung **MEV**) insbesondere zur Auswertung überträgt,
- ein vektorielles Filterausgangssignal **S4_2** für das mittlere Sensorelement **1420,** das typischerweise ein Teil des vektoriellen Filterausgangssignals **S4** ist und typischerweise von einem Mustererkennungsvorrichtung **MEV** und/oder der Steuervorrichtung **CTR** ausgewertet wird.

In einer Weiterbildung umfasst der zweite Sensorelementkanal,
- einen zweiten zweiten Signalgenerator **G2_II,** der dazu eingerichtet ist, ein zweites Mikrowellenmodulationssignal **S5m_II** zu erzeugen;
- eine zweite Wellenleitung **(1380, 1880, 2380, 6830, 6980);**
- eine zweite Mikrowellensignalquelle **µWG_II,** die dazu eingerichtet ist, das zweite Mikrowellensignal **µW_II** für die zweite Wellenleitung **(1380, 1880, 2380, 6830, 6980)** in Abhängigkeit von dem zweiten Mikrowellenmodulationssignal **S5m_II** zu erzeugen und in die zweite Wellenleitung **1380, 1880, 2380, 6830, 6980** einzuspeisen;
- den Mehrfachkorrelator **LIV_2** für das mittlere Sensorelement **1420,** der ein vektorielles Filterausgangssignal **S4_2** für das mittlere Sensorelement **1420** in Abhängigkeit vom verstärkten Empfängerausgangssignal **S1_2** für das mittlere Sensorelement **1420** bzw. vom digitalisierten Empfängerausgangssignal **S1_2** für das mittlere Sensorelement **1420** und dem LED-Modulationssignal **S5w_2** für das mittlere Sensorelement **1420** und dem zweiten Mikrowellenmodulationssignal **S5m_II** bildet und Daten des vektoriellen Filterausgangssignals **S4_2** für das mittlere Sensorelement **1420** der Steuervorrichtung **CTR** zur Verfügung stellt, insbesondere für die Steuervorrichtung **CTR** bereithält oder an die Steuervorrichtung **CTR** oder eine andere Vorrichtung (z.B. die Mustererkennungsvorrichtung **MEV**) insbesondere zur Auswertung überträgt.

Hinsichtlich der Funktionen und dem Zusammenwirken der Sensorelementkanal spezifischen Vorrichtungsteile **(SE(1420); S5w_2, LDRV_2, S5_2, LED_2, LB_2, LWL_2, F1_2, PD_2, S0_2, V1_2, S1_2, LIV_2, S4_2)** des zweiten, mittleren Sensorelementkanals und der anderen nicht Sensorelementkanal spezifischen Vorrichtungsteile der Vorrichtung verweist das hier vorgelegte Dokument auf die Beschreibung der Figur 69 für die korrespondierenden Vorrichtungsteile **(SE, S5w, LDRV, S5, LED, LB, LWL, F1, PD, S0, V1, S1, LIV, S4)** des einen Sensorkanals der Figur 69 und der anderen nicht Sensorelementkanal spezifischen Vorrichtungsteile der Vorrichtung der Figur 69.

### Dritter, rechter Sensorelementkanal

Vorzugsweise umfasst der dritte, rechte Sensorelementkanal
- einen ersten Signalgenerator **G1_3** für das recte Sensorelement **1430,** der das LED-Modulationssignal **S5w_3** für das rechte Sensorelement **1430** erzeugt,
- einen Lichtquellentreiber **LDRV_3** für das rechte Sensorelement **1430,** der das Sendesignal **S5_3** für das rechte Sensorelement **1430** zur Ansteuerung der Pumpstrahlungsquelle für das rechte Sensorelement **1430,** hier die Lichtquelle **LED_3** für das rechte Sensorelement **1430,** in Abhängigkeit von dem LED-Modulationssignal **S5w_3** für das rechte Sensorelement **1430** erzeugt und vorzugsweise die Pumpstrahlungsquelle für das rechte Sensorelement **1430,** hier die Lichtquelle **LED_3** für das rechte Sensorelement **1430,** mit elektrischer Energie versorgt,
- ein Sendesignal **S5_3** für das rechte Sensorelement **1430;**
- eine Pumpstrahlungsquelle für das rechte Sensorelement **1430,** hier eine Lichtquelle **LED_3** für das rechte Sensorelement **1430,** die die Pumpstrahlung **LB_3** für das rechte Sensorelement **1430** in Abhängigkeit von dem Sendesignal **S5_3** für das rechte Sensorelement **1430** erzeugt und beispielsweise die Pumpstrahlungsquelle für das rechte Sensorelement **1430,** hier eine Lichtquelle **LED_3** für das rechte Sensorelement **1430,** nur zeitweise ein und nur zeitweise ausschaltet,
- ein erstes optisches System für das rechte Sensorelement **1430,**
   ∘ das ein oder mehrere optische Funktionselemente umfasst und
   ∘ das die Pumpstrahlung **LB_3** für das rechte Sensorelement **1430** der Pumpstrahlungsquelle für das rechte Sensorelement **1430,** hier der Lichtquelle **LED_3** für das rechte Sensorelement **1430,** erfasst und
   ∘ das die Pumpstrahlung **LB_3** für das rechte Sensorelement **1430** zum zugeordneten Sensorelement **SE,** hier dem rechten Sensorelement **1430,** transportiert und
   ∘ das die Pumpstrahlung **LB_3** für das rechte Sensorelement **1430** aus dem ersten optischen System für das rechte Sensorelement **1430** auskoppelt und
   ∘ das das zugeordnete Sensorelement **SE,** hier das rechte Sensorelement **1430,** mit Pumpstrahlung **LB_3** für das rechte Sensorelement **1430** bestrahlt und
   ∘ das bevorzugt einen Lichtwellenleiter **LWL_3** für das rechte Sensorelement **1430** als ein solches optisches Funktionselement umfasst,
- ein zweites optisches System,
   ∘ das ein oder mehrere optische Funktionselemente umfasst und
   ∘ das die Fluoreszenzstrahlung **FL_3** der NV-Zentren und/oder der paramagnetischen Zentren des zugeordneten Sensorelements **SE,** hier des rechten Sensorelements **1430,** erfasst und
   ∘ das Fluoreszenzstrahlung **FL_3** der NV-Zentren und/oder der paramagnetischen Zentren des zugeordneten Sensorelements **SE** , hier des rechten Sensorelements **1430,** zum zugeordneten Fotodetektor **PD_3** für das rechte Sensorelement **1430** transportiert und
   ∘ das Fluoreszenzstrahlung **FL_3** der NV-Zentren und/oder der paramagnetischen Zentren des zugeordneten Sensorelements **SE,** hier des rechten Sensorelements **1430,** aus dem zweiten optischen System auskoppelt und
   ∘ das den zugeordneten Fotodetektor **PD_3** für das rechte Sensorelement **1430** mit Fluoreszenzstrahlung **FL_3** der NV-Zentren und/oder der paramagnetischen Zentren des zugeordneten Sensorelements **SE,** hier des rechten Sensorelements **1430,** bestrahlt und
   ∘ das Funktionselemente, beispielsweise einen dichroitischen Spiegel **F1_3** für das rechte Sensorelement **1430** und/oder einen optischen Filter im Strahlengang, umfasst, die sicherstellen, dass im Wesentlichen keine Pumpstrahlung **LB_3** dieser oder anderer Pumpstrahlungsquellen, insbesondere die der Lichtquelle **LED_3** und/oder anderer Lichtquellen **(LED, LED_1, LED2, LED_3),** den Fotodetektor **PD_3** für das rechte Sensorelement **1430** erreicht und
   ∘ das bevorzugt einen Lichtwellenleiter **LWL_3** für das rechte Sensorelement **1430** als ein solches optisches Funktionselement umfasst und
   ∘ das Vorrichtungsteile umfassen kann, die mit Vorrichtungsteilen des ersten optischen Systems identisch sind,
- den Fotodetektor **PD_3** für das rechte Sensorelement **1430,** der die Intensität der empfangenen Fluoreszenzstrahlung **FL_3** des rechten Sensorelements **1430,** in ein Empfängerausgangssignal **S0_3** für das rechte Sensorelement **1430** wandelt,
- das Empfängerausgangssignal **S0_3** für das rechte Sensorelement **1430,**
- einen erster Verstärker **V1_23** für das Sensorelement **SE,** hier für das rechte Sensorelement **1430,** zur Verstärkung und/oder Digitalisierung des Empfangssignals **S0_3** für das rechte Sensorelement **1430** zum verstärkten Empfängerausgangssignal **S1_3** für das rechte Sensorelement **1430** bzw. zum digitalisierten Empfängerausgangssignal **S1_3** für das rechte Sensorelement **1430,**
- das verstärkte Empfängerausgangssignal **S1_3** für das rechte Sensorelement **1430** bzw. das digitalisierte Empfängerausgangssignal **S1_3** für das rechte Sensorelement **1430,**
- einen Mehrfachkorrelator **LIV_3** für das rechte Sensorelement **1430,** der ein vektorielles Filterausgangssignal **S4_3** für das rechte Sensorelement **1430** in Abhängigkeit vom verstärkten Empfängerausgangssignal **S1_3** für das rechte Sensorelement **1430** bzw. vom digitalisierten Empfängerausgangssignal **S1_3** für das rechte Sensorelement **30e0** und dem LED-Modulationssignal **S5w_3** für das rechte Sensorelement **1430** bildet und Daten des vektoriellen Filterausgangssignals **S4_3** für das rechte Sensorelement **1430** der Steuervorrichtung **CTR** zur Verfügung stellt, insbesondere für die Steuervorrichtung **CTR** bereithält oder an die Steuervorrichtung **CTR** oder eine andere Vorrichtung (z.B. den Mustererkennungsvorrichtung **MEV)** insbesondere zur Auswertung überträgt,
- ein vektorielles Filterausgangssignal **S4_3** für das rechte Sensorelement **1430,** das typischerweise ein Teil des vektoriellen Filterausgangssignals **S4** ist und typischerweise von einem Mustererkennungsvorrichtung **MEV** und/oder der Steuervorrichtung **CTR** ausgewertet wird.

In einer Weiterbildung umfasst der dritte Sensorelementkanal,
- einen dritte zweiten Signalgenerator **G2_III,** der dazu eingerichtet ist, ein drittes Mikrowellenmodulationssignal **S5m_III** zu erzeugen;
- eine dritte Wellenleitung **(1380, 1880, 2380, 6830, 6980);**
- eine dritte Mikrowellensignalquelle **µWG_III,** die dazu eingerichtet ist, das dritte Mikrowellensignal µW_III für die dritte Wellenleitung **(1380, 1880, 2380, 6830, 6980)** in Abhängigkeit von dem dritten Mikrowellenmodulationssignal **S5m_III** zu erzeugen und in die dritte Wellenleitung **1380, 1880, 2380, 6830, 6980** einzuspeisen;
- den Mehrfachkorrelator **LIV_3** für das rechte Sensorelement **1430,** der ein vektorielles Filterausgangssignal **S4_3** für das rechte Sensorelement **1430** in Abhängigkeit vom verstärkten Empfängerausgangssignal **S1_3** für das rechte Sensorelement **1430** bzw. vom digitalisierten Empfängerausgangssignal **S1_3** für das rechte Sensorelement **1430** und dem LED-Modulationssignal **S5w_3** für das rechte Sensorelement **1430** und dem dritten Mikrowellenmodulationssignal **S5m_III** bildet und Daten des vektoriellen Filterausgangssignals **S4_3** für das rechte Sensorelement **1430** der Steuervorrichtung **CTR** zur Verfügung stellt, insbesondere für die Steuervorrichtung **CTR** bereithält oder an die Steuervorrichtung **CTR** oder eine andere Vorrichtung (z.B. die Mustererkennungsvorrichtung **MEV**) insbesondere zur Auswertung überträgt.

Hinsichtlich der Funktionen und dem Zusammenwirken der Sensorelementkanal spezifischen Vorrichtungsteile **(SE(1430); S5w_3, LDRV_3, S5_3, LED_3, LB_3, LWL_3, F1_3, PD_3, S0_3, V1_3, S1_3, LIV_3, S4_3)** des dritten, rechten Sensorelementkanals und der anderen nicht Sensorelementkanal spezifischen Vorrichtungsteile der Vorrichtung verweist das hier vorgelegte Dokument auf die Beschreibung der Figur 69 für die korrespondierenden Vorrichtungsteile **(SE, S5w, LDRV, S5, LED, LB, LWL, F1, PD, S0, V1, S1, LIV, S4)** des einen Sensorkanals der Figur 69 und der anderen nicht Sensorelementkanal spezifischen Vorrichtungsteile der Vorrichtung der Figur 69.

Die Anordnung der Sensorelemente **1410, 1420 1430** und der Leitungen **1310, 1320, 1330** auf dem Trägersubstrat **1360** bei bevorzugtem Vorhandensein eines Magnetfelderzeugungsmittels **L_{C}** beispielsweise einer Flachspule **2520** entspricht also im Wesentlichen der Anordnungen der Figuren 68 und 67.

### Alternative Verwendung einer Schlitzleitung 1880

Weglassen des Signalleiters **1330** verwandelt die Triplate-Leitung **2380** in eine Schlitzleitung **1880.** Das linke Sensorelement **1410** wird dann vorzugsweise auf der elektrisch leitenden linken Signalmassefläche **1310** der beispielhaften Schlitzleitung **1880** links des Schlitzes **1840** der Schlitzleitung **1880** nahe der Kante des Schlitzes **1840** der Schlitzleitung **1880** platziert. Das rechte Sensorelement **1430** wird dann vorzugsweise auf der elektrisch leitenden rechten Signalmassefläche **1320** der beispielhaften Schlitzleitung **1880** rechts des Schlitzes **1840** der Schlitzleitung **1880** nahe der Kante Schlitzes **1840** der Schlitzleitung **1880** platziert. Das mittlere Sensorelement **1420** wird dann vorzugsweise möglichst mittig in dem Schlitz **1840** der Schlitzleitung **1880** platziert.

Da die Empfindlichkeiten der Sensorelemente **1410, 1420, 1430** andere als die bei der Verwendung einer Tri-Plate-Leitung **2380** sind, müssen die Parameter die die Vorrichtungsteile verwenden, ggf. angepasst werden.

### Alternative Verwendung einer Mikrostreifenleitung 1380

Weglassen der elektrisch leitenden linken Signalmassefläche **1310** und der elektrisch leitenden rechten Signalmassefläche **1320** verwandelt die Triplate-Leitung **2380** in eine Mikrostreifenleitung **1380.** Das linke Sensorelement **1410** wird dann vorzugsweise auf der elektrisch im Wesentlichen nicht-leitenden linken Isolationsfläche **1340** der beispielhaften Mikrostreifenleitung **1380** links des Signalleiters **1330** der Mikrostreifenleitung **1380** nahe der Kante des Signalleiters **1330** der Mikrostreifenleitung **1380** platziert. Das rechte Sensorelement **1430** wird dann vorzugsweise auf der elektrisch im Wesentlichen nicht-leitenden rechten Isolationsfläche **1350** der beispielhaften Mikrostreifenleitung **1380** rechts des Signalleiters **1330** der Mikrostreifenleitung **1380** nahe der Kante des Signalleiters **1330** der Mikrostreifenleitung **1380** platziert. Das mittlere Sensorelement **1420** wird dann vorzugsweise möglichst mittig auf dem Signalleiters **1330** der Mikrostreifenleitung **1380** platziert.

Da die Empfindlichkeiten der Sensorelemente **1410, 1420, 1430** andere als die bei der Verwendung einer Schlitzleitung **1880** sind, müssen die Parameter die die Vorrichtungsteile verwenden, ggf. angepasst werden. Im Falle der Verwendung einer Tri-Plate-Leitung **2380** sind die Parameterunterschiede zwischen den Parametern, die die Vorrichtungsteile im Falle einer Tri-Plate-Leitung **2380** verwenden, und den Parametern, die die Vorrichtungsteile im Falle einer Mikrostreifenleitung **1380** verwenden, in der Regel geringer.

### Vereinfachung ohne linkes Sensorelement 1410

Sofern auf das linke Sensorelement **1410** verzichtet wird, können die sensorelementkanalspezifischen Vorrichtungsteile **(SE(1410); S5w_1, LDRV_1, S5_1, LED_1, LB_1, LWL_1, F1_1, PD_1, S0_1, V1_1, S1_1, LIV_1, S4_1)** des ersten linken Sensorelementkanals auch entfallen. Die Verarbeitung des dann in der Dimensionalität reduzierten vektoriellen Filterausgangssignals **S4** durch die Mustererkennungsvorrichtung **MEV** und/oder die Steuervorrichtung **CTR** muss dann noch entsprechend angepasst werden.

### Vereinfachung ohne rechtes Sensorelement 1430

Sofern auf das rechte Sensorelement **1430** verzichtet wird, können die sensorelementkanalspezifischen Vorrichtungsteile **(SE(1430); S5w_3, LDRV_3, S5_3, LED_3, LB_3, LWL_3, F1_3, PD_3, S0_3, V1_3, S1_3, LIV_3, S4_3)** des dritten rechten Sensorelementkanals auch entfallen. Die Verarbeitung des dann in der Dimensionalität reduzierten vektoriellen Filterausgangssignals **S4** durch die Mustererkennungsvorrichtung **MEV** und/oder die Steuervorrichtung **CTR** muss dann noch entsprechend angepasst werden.

### Vereinfachung ohne mittleres Sensorelement 1420

Sofern auf das mittlere Sensorelement **1420** verzichtet wird, können die sensorelementkanalspezifischen Vorrichtungsteile **(SE(1420); S5w_2, LDRV_2, S5_2, LED_2, LB_2, LWL_2, F1_2, PD_2, S0_2, V1_2, S1_2, LIV_2, S4_2)** des zweiten mittleren Sensorelementkanals auch entfallen. Die Verarbeitung des dann in der Dimensionalität reduzierten vektoriellen Filterausgangssignals **S4** durch die Mustererkennungsvorrichtung **MEV** und/oder die Steuervorrichtung **CTR** muss dann noch entsprechend angepasst werden. Eine solche Vorrichtung ist gegenüber Anteilen der magnetischen Flussdichte, die senkrecht zur Oberfläche des Trägersubstrats **1370** stehen oder dessen Anteile der magnetischen Flussdichte parallel zur Signalleitung **1330** stehen, jedoch -nicht oder nur wenig empfindlich.

### Vereinfachung nur mit linken Sensorelement 1410

Sofern auf das rechte Sensorelement **1430** und das mittlere Sensorelement **1420** verzichtet wird, können die sensorelementkanalspezifischen Vorrichtungsteile **(SE(1420); S5w_2, LDRV_2, S5_2, LED_2, LB_2, LWL_2, F1_2, PD_2, S0_2, V1_2, S1_2, LIV_2, S4_2)** des zweiten mittleren Sensorelementkanals und **(SE(1430); S5w_3, LDRV_3, S5_3, LED_3, LB_3, LWL_3, F1_3, PD_3, S0_3, V1_3, S1_3, LIV_3, S4_3)** des dritten rechten Sensorelementkanals auch entfallen. Die Verarbeitung des dann in der Dimensionalität reduzierten vektoriellen Filterausgangssignals **S4** durch die Mustererkennungsvorrichtung **MEV** und/oder die Steuervorrichtung **CTR** muss dann noch entsprechend angepasst werden. Eine solche Vorrichtung ist gegenüber Anteilen der magnetischen Flussdichte, die senkrecht zur Oberfläche des Trägersubstrats **1370** stehen oder dessen Flussdichtevektor **parallel** zur Signalleitung **1330** steht, jedoch -nicht oder nur wenig empfindlich.

### Vereinfachung nur mit rechtem Sensorelement 1430

Sofern auf das linke Sensorelement **1410** und das mittlere Sensorelement **1420** verzichtet wird, können die sensorelementkanalspezifischen Vorrichtungsteile **(SE(1420); S5w_2, LDRV_2, S5_2, LED_2, LB_2, LWL_2, F1_2, PD_2, S0_2, V1_2, S1_2, LIV_2, S4_2)** des zweiten mittleren Sensorelementkanals und **(SE(1410); S5w_1, LDRV_1, S5_1, LED_1, LB_1, LWL_1, F1_1, PD_1, S0_1, V1_1, S1_1, LIV_1, S4_1)** des ersten linken Sensorelementkanals auch entfallen. Die Verarbeitung des dann in der Dimensionalität reduzierten vektoriellen Filterausgangssignals **S4** durch die Mustererkennungsvorrichtung **MEV** und/oder die Steuervorrichtung **CTR** muss dann noch entsprechend angepasst werden. Eine solche Vorrichtung ist gegenüber Anteilen der magnetischen Flussdichte, die senkrecht zur Oberfläche des Trägersubstrats **1370** stehen oder dessen Flussdichtevektor **parallel** zur Signalleitung **1330** stehen, jedoch -nicht oder nur wenig empfindlich.

### Vereinfachung nur mit mittlerem Sensorelement 1420

Sofern auf das linke Sensorelement **1430** und das rechte Sensorelement **1430** verzichtet wird, können die sensorelementkanalspezifischen Vorrichtungsteile **SE(1430); S5w_3, LDRV_3, S5_3, LED_3, LB_3, LWL_3, F1_3, PD_3, S0_3, V1_3, S1_3, LIV_3, S4_3)** des dritten rechten Sensorelementkanals und **(SE(1410); S5w_1, LDRV_1, S5_1, LED_1, LB_1, LWL_1, F1_1, PD_1, S0_1, V1_1, S1_1, LIV_1, S4_1)** des ersten linken Sensorelementkanals auch entfallen. Die Verarbeitung des dann in der Dimensionalität reduzierten vektoriellen Filterausgangssignals **S4** durch die Mustererkennungsvorrichtung **MEV** und/oder die Steuervorrichtung **CTR** muss dann noch entsprechend angepasst werden. Eine solche Vorrichtung ist gegenüber Anteilen der magnetischen Flussdichte, die parallel zur Oberfläche des Trägersubstrats **1370** ausgerichtet sind, jedoch -nicht oder nur wenig empfindlich.

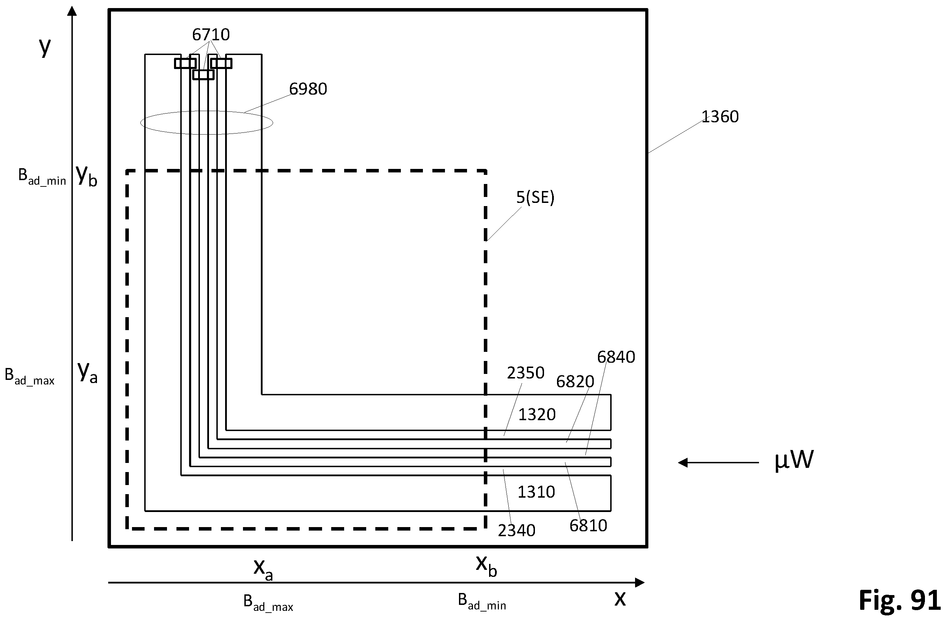

Natürlich ist es denkbar, dass die Vorrichtung weitere Trägersubstrate mit Wellenleitungen **(2380, 1880, 1380, 6830)** und Sensorelementen **(SE, 1410, 1420, 1430, 1710, 2210, 2410, 2420, 2430, 4410, 7115, 7125, 1735, 7145** und **7155)** und vorzugsweise zu jedem Sensorelement jeweils bevorzugt einen Sensorelementkanal mit entsprechenden Vorrichtungsteilen korrespondierend zu dem Vorrichtungsteilen **(SE, S5w, LDRV, S5, LED, LB, LWL, F1, PD, S0, V1, S1, LIV, S4)** des einen Sensorkanals der Figur 58 umfasst. Besonders bevorzugt sind Vorrichtungen, die zwei Wellenleiter **(2380, 1880, 1380, 6830)** mit jeweils einem oder mehreren Sensorelementen **(SE, 1410, 1420, 1430, 1710, 2210, 2410, 2420, 2430, 4410, 7115, 7125, 1735, 7145** und **7155)** und zugehörigen Sensorelementkanälen und den Sensorelementkanal unabhängigen Vorrichtungsteilen umfassen, bei denen die Wellenleiter senkrecht zueinander angeordnet sind. Besonders bevorzugt sind Vorrichtungen, die zwei Wellenleiter **(2380, 1880, 1380, 6830)** mit jeweils einem oder mehreren Sensorelementen **(SE, 1410, 1420, 1430, 1710, 2210, 2410, 2420, 2430, 4410, 7115, 7125, 1735, 7145** und **7155)** und zugehörigen Sensorelementkanälen und den Sensorelementkanal unabhängigen Vorrichtungsteilen umfassen, bei denen die Wellenleiter senkrecht zueinander in der Ebene der Oberfläche eines der Trägersubstrate **1370** angeordnet sind. (Siehe Figur 91) Besonders bevorzugt sind Vorrichtungen, die zwei Wellenleiter **(2380, 1880, 1380, 6830)** mit jeweils einem oder mehreren Sensorelementen **(SE, 1410, 1420, 1430, 1710, 2210, 2410, 2420, 2430, 4410, 7115, 7125, 1735, 7145** und **7155)** und zugehörigen Sensorelementkanälen und den Sensorelementkanal unabhängigen Vorrichtungsteilen umfassen, bei denen die Wellenleiter senkrecht zueinander an der Oberfläche des gleichen Trägersubstrats **1370** angeordnet sind. Typischerweise verfügen Sensorelemente **(1410, 1420, 1430)** eines Wellenleiters **(2380, 1880, 1380, 6830)** über ein oder mehrere gemeinsame Flachspulen **2520** als gemeinsames Magnetfelderzeugungsmittel Lc. Bevorzugt ermitteln die Steuervorrichtung **CTR** und/oder der Magnetfeldregler **LCTR** einen Wert für die Gesamtflussdichte **B_{Σ}** und vergleicht diesen ermittelten Wert der Gesamtflussdichte **B_{Σ}** mit einem Sollwert. Bevorzugt ermitteln die Steuervorrichtung **CTR** und/oder der Magnetfeldregler **LCTR** den Wert für die Gesamtflussdichte **B_{Σ}** mittels der Auswertung des vektoriellen Filterausgangssignals **S4** und/oder mittels eines Magnetfeldsensors MS und einer Magnetfeldsensoransteuerung **SIS.**

### Vektorieller Sensorelementkanal

Im Sinne des hier vorgelegten Dokuments kann die Mehrzahl der Sensorelemente (**SE, 1410, 1420, 1430, 1710, 2210, 2410, 2420, 2430, 4410, 7115, 7125, 1735, 7145** und **7155)** auch als ein vektorielles Sensorelement **SE** aufgefasst werden, dass eine Mehrzahl separater Fluoreszenzstrahlungssignale **(FL_1, FL_2, FL_3)** als vektorielles Fluoreszenzstrahlungssignal **FL** bei Bestrahlung mit Pumpstrahlung **LB** der Pumpstrahlungswellenlänge λₚₘₚ erzeugt.

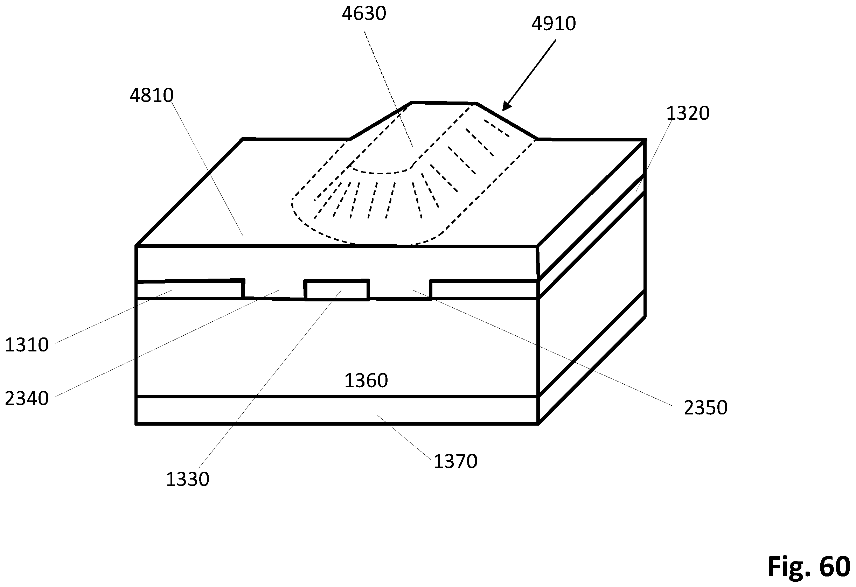

Die vorschlagsgemäße Vorrichtung kann typischerweise mehrere vektorielle Sensorelementkanäle und vektorielle Sensorelemente **SE** aufweisen. Die vorschlagsgemäße vektorielle Vorrichtung umfasst vorzugsweise mindestens einen vektoriellen Sensorelementkanal mit vorzugsweise mindestens zwei Sensorelementkanälen. In dem Beispiel der Figur 60 umfasst die vorschlagsgemäße Vorrichtung beispielhaft einen dreidimensionalen vektoriellen Sensorelementkanal mit drei Sensorelementkanälen und einem dreidimensional vektoriellen Sensorelement mit drei Sensorelementen **(SE, 1410, 1420, 1430).**

Vorzugsweise umfasst ein vektorieller Sensorelementkanal
- einen ersten Signalgenerator **G1,** der ein LED-Modulationssignal **S5w** erzeugt, oder einen ersten vektoriellen Signalgenerator **G1** umfassend mehrere Signalgeneratoren **(G1_1, G1_2, G1,_3),** der ein vektorielles LED-Modulationssignal **55w** umfassen mehrere LED-Modulationssignale **(S5w_1, S5w_2, S5w_3)** erzeugt,
- einen vektoriellen Lichtquellentreiber **LDRV** umfassend mehrere Lichtquellentreiber **(LDRV_1, LDRV_2, LDRV_3),** der das vektorielle Sendesignal **S5** für die vektorielle Pumpstrahlungsquelle, hier die vektorielle Lichtquelle **LED,** in Abhängigkeit von dem vektoriellen LED-Modulationssignal **S5w** und/oder dem LED-Modulationssignal **S5w** erzeugt und vorzugsweise die vektorielle Pumpstrahlungsquelle, hier die Lichtquellen **(LED_1, LED_2, LED_3)** der vektoriellen Lichtquelle **LED,** mit elektrischer Energie versorgt,
- ein vektorielles Sendesignal **S5,** umfassen mehrere Sendesignale **(S5_1, S5_2, S5_3),**
- eine vektorielle Pumpstrahlungsquelle, hier eine vektorielle Lichtquelle **LED,** die die vektorielle Pumpstrahlung **LB** in Abhängigkeit von dem vektoriellen Sendesignal **S5** erzeugt und beispielsweise die Pumpstrahlungsquelle, hier eine vektorielle Lichtquelle **LED** umfassen mehrere Lichtquellen **(LED_1, LED_2, LED_3,),** nur zeitweise und/oder teilweise ein- und nur zeitweise und/oder teilweise ausschaltet,
- ein erstes vektorielles optisches System,
   ∘ das ein oder mehrere vektorielle optische Funktionselemente umfasst und
   ∘ das die vektorielle Pumpstrahlung **LB** der vektoriellen Pumpstrahlungsquelle, hier der vektoriellen Lichtquelle **LED,** in vektorieller Weise erfasst, d. h. die die vektoriellen Pumpstrahlungskomponenten **(LB_1, LB2, LB3)** separat erfasst, und
   ∘ das die erfasste vektorielle Pumpstrahlung **LB** vektoriell, d.h. im Wesentlichen ohne Vermischung der vektoriellen Pumpstrahlungskomponenten **(LB_1, LB_2, LB_3)** und ohne ungleichmäßige Dämpfung oder Modifikation der vektoriellen Pumpstrahlungskomponenten **(LB_1, LB_2, LB_3),** zum zugeordneten vektoriellen Sensorelement **SE,** d.h. zu den zugeordneten Sensorelementen (z.B. **1410, 1420, 1430)** transportiert und
   ∘ das die vektorielle Pumpstrahlung **LB** aus dem ersten vektoriellen optischen System vektoriell auskoppelt, d.h. im Wesentlichen ohne Vermischung der vektoriellen Pumpstrahlungskomponenten **(LB_1, LB_2, LB_3)** und ohne ungleichmäßige Dämpfung oder Modifikation der vektoriellen Pumpstrahlungskomponenten **(LB_1, LB_2, LB_3)** auskoppelt, und
   ∘ das das zugeordnete vektorielle Sensorelement **SE,** d.h. die zugeordneten Sensorelemente (z.B. **1410, 1420, 1430),** mit vektorieller Pumpstrahlung **LB,** d.h. mit den Pumpstrahlungskomponenten **(LB_1, LB_2, LB_3),** bestrahlt, wobei eine Pumpstrahlungskomponenten **(LB_1, LB_2, LB_3)** bevorzugt einem oder mehreren Sensorelementen (z.B. **1410, 1420, 1430)** zugeordnet ist und wobei bevorzugt jedem benutzen Sensorelement (z.B. **1410, 1420, 1430)** genau eine Pumpstrahlungskomponente **(LB_1, LB_2, LB_3)** zugeordnet ist, und
   ∘ das bevorzugt einen vektoriellen Lichtwellenleiter **LWL,** der bevorzugt eine Mehrzahl von Lichtwellenleitern **(LWL_1, LWL_2, LWL_3),** für das vektorielle Sensorelement **SE** als ein solches vektorielles optisches Funktionselement umfasst,
- ein zweites vektorielles optisches System,
   ∘ das ein oder mehrere vektorielle optische Funktionselemente umfasst und
   ∘ das die vektorielle Fluoreszenzstrahlung **FL** vektoriell erfasst,
      ▪ wobei die vektorielle Fluoreszenzstrahlung **FL** die Fluoreszenzstrahlungen **(FL1, FL_2, FL_3)** der NV-Zentren und/oder der paramagnetischen Zentren des zugeordneten vektoriellen Sensorelements **SE** d.h. der Sensorelemente (z.B. **1410, 1420, 1430)** als Fluoreszenzstrahlungskomponenten **(FL_1, FL_2, FL_3)** umfasst und
      ▪ wobei diese Erfassung durch das zweite vektorielle optische System typischerweise im Wesentlichen ohne Vermischung der vektoriellen Fluoreszenzstrahlungskomponenten **(FL_1, FL_2, FL_3)** und ohne ungleichmäßige Dämpfung oder Modifikation der vektoriellen Fluoreszenzstrahlungskomponenten **(FL_1, FL_2, FL_3)** erfolgt, und
   ∘ das vektorielle Fluoreszenzstrahlung **FL** der NV-Zentren und/oder der paramagnetischen Zentren des zugeordneten vektoriellen Sensorelements **SE** zum zugeordneten Fotodetektor PD, umfassend die Fotodetektoren **(PD_1, PD_2, PD_3)** vektoriell, d.h. im Wesentlichen ohne Vermischung der vektoriellen Fluoreszenzstrahlungskomponenten **(FL_1, FL_2, FL_3)** und ohne ungleichmäßige Dämpfung oder Modifikation der vektoriellen Fluoreszenzstrahlungskomponenten **(FL_1, FL_2, FL_3),** transportiert und
   ∘ das die vektorielle Fluoreszenzstrahlung **FL** der NV-Zentren und/oder der paramagnetischen Zentren des zugeordneten vektoriellen Sensorelements **SE** aus dem zweiten vektoriellen optischen System vektoriell, d.h. im Wesentlichen ohne Vermischung der vektoriellen Fluoreszenzstrahlungskomponenten **(FL_1, FL_2, FL_3)** und ohne ungleichmäßige Dämpfung oder Modifikation der vektoriellen Fluoreszenzstrahlungskomponenten **(FL_1, FL_2, FL_3),** auskoppelt und
   ∘ das den zugeordneten vektoriellen Fotodetektor **PD** umfassend die Fotodetektoren **(PD_1, PD_2, PD_3)** mit vektorieller Fluoreszenzstrahlung **FL** umfassend die Fluoreszenzstrahlungen **(FL_1, FL_2, FL_3)** der NV-Zentren und/oder der paramagnetischen Zentren des zugeordneten vektoriellen Sensorelements **SE** vektoriell bestrahlt
      - wobei eine vektorielle Bestrahlung bedeutet,
      - dass vorzugsweise Fluoreszenzstrahlungskomponenten **(FL_1, FL_2, FL_3)** vorzugsweise jeweils ein Fotodetektor **(PD_1, PD_2, PD_3)** des vektoriellen Fotodetektors **PD** zugeordnet ist und
      - dass vorzugsweise Fotodetektoren **(PD_1, PD_2, PD_3)** des vektoriellen Fotodetektors **PD** vorzugsweise ein oder mehrere der Fluoreszenzstrahlungskomponenten **(FL_1, FL_2, FL_3)** zugeordnet sind und
      - dass besonders bevorzugt jeder Fluoreszenzstrahlungskomponente **(FL_1, FL_2, FL_3)** vorzugsweise genau ein Fotodetektor **(PD_1, PD_2, PD_3)** des vektoriellen Fotodetektors **PD** zugeordnet ist und
      - dass besonders bevorzugt jedem Fotodetektor **(PD_1, PD_2, PD_3)** des vektoriellen Fotodetektors **PD** genau eine der Fluoreszenzstrahlungskomponenten **(FL_1, FL_2, FL_3)** zugeordnet ist und
   ∘ das Funktionselemente, beispielsweise einen oder mehrere dichroitische Spiegel **F1** und/oder einen oder mehrere optische Filter im Strahlengang, umfasst, die sicherstellen, dass im Wesentlichen keine Pumpstrahlung **LB** dieser oder anderer Pumpstrahlungsquellen, insbesondere die der Lichtquelle **LED** und/oder anderer Lichtquellen **(LED, LED_1, LED2, LED_3),** den vektoriellen Fotodetektor **PD** erreicht und
   ∘ das bevorzugt einen oder mehrere Lichtwellenleiter **LWL** oder einen vektoriellen Lichtwellenleiter **LWL** für das vektorielle Sensorelement **SE** als ein solches vektorielles optisches Funktionselement umfasst und
      • wobei der vektoriellen Lichtwellenleiter **LWL** ein oder mehrere Lichtwellenleiter **(LWL_1, LWL_2, LWL_3)** mit jeweils einem ersten Ende und einem zweiten Ende umfasst und
      • wobei vorzugsweise Lichtwellenleiter **(LWL_1, LWL_2, LWL_3)** des vektoriellen Lichtwellenleiters **LWL** vorzugsweise einem Sensorelement **(SE_1, SE_2, SE_3)** des vektoriellen Sensorelements **SE** an ihrem zweiten Ende zugeordnet sind und
      • wobei vorzugsweise Lichtwellenleiter **(LWL_1, LWL_2, LWL_3)** des vektoriellen Lichtwellenleiters **LWL** vorzugsweise einem Fotodetektor **(PD_1, PD_2, PD_3)** des vektoriellen Fotodetektors **SE** an ihrem zweiten Ende zugeordnet sind und
      • wobei besonders bevorzugt jedem Lichtwellenleiter **(LWL_1, LWL_2, LWL_3)** des vektoriellen Lichtwellenleiters **LWL** vorzugsweise genau ein Sensorelement **(SE_1, SE_2, SE_3)** des vektoriellen Sensorelements **SE** an seinem ersten Ende zugeordnet ist und
      • wobei besonders bevorzugt jedem Lichtwellenleiter **(LWL_1, LWL_2, LWL_3)** des vektoriellen Lichtwellenleiters **LWL** vorzugsweise genau ein Fotodetektor **(PD_1, PD_2, PD_3)** des vektoriellen Fotodetektors **SE** an seinem ersten Ende zugeordnet ist und
   ∘ das Vorrichtungsteile umfassen kann, die mit Vorrichtungsteilen des ersten optischen Systems identisch sind,
- den vektoriellen Fotodetektor **PD,** der die Intensität der empfangenen vektoriellen Fluoreszenzstrahlung **FL** in ein vektorielles Empfängerausgangssignal **S0** wandelt,
- das vektorielle Empfängerausgangssignal **S0,** das die Empfängerausgangssignale **(S0_1, S0_2, S0_3)** umfasst,
- einen ersten vektoriellen Verstärker **V1** für das vektorielle Sensorelement **SE** zur vektoriellen Verstärkung und/oder vektoriellen Digitalisierung des vektoriellen Empfängerausgangssignal **S0** zum verstärkten vektoriellen Empfängerausgangssignal **S1** bzw. zum digitalisierten vektoriellen Empfängerausgangssignal **S1,**
   ∘ wobei ersten vektoriellen Verstärker **V1** einen oder mehrere erste Verstärker **(V1_1, V1_2, V1_3)** umfasst und
   ∘ wobei erste Verstärker **(V1_1, V1_2, V1_3)** des ersten vektoriellen Verstärkers **V1** ein Empfängerausgangssignal **(S0_1, S0_2, S0_3)** des vektoriellen Empfängerausgangssignal **S0** zu einem verstärkten Empfängerausgangssignal **(S1_1, S1_2, S1_3)** des verstärkten vektoriellen Empfängerausgangssignals **S1** bzw. zu einem digitalisierten Empfängerausgangssignal **(S1_1, S1_2, S1_3)** des digitalisierten vektoriellen Empfängerausgangssignal **S1** verstärkt oder digitalisiert, und
- das verstärkte Empfängerausgangssignal **S1** bzw. das digitalisierte Empfängerausgangssignal **S1,** die ein oder mehrere verstärkte Empfängerausgangssignale **(S1_1, S1_2, S1_3)** des verstärkten vektoriellen Empfängerausgangssignals **S1** bzw. zu einem digitalisierten Empfängerausgangssignal **(S1_1, S1_2, S1_3)** umfassen,
- einen vektoriellen Mehrfachkorrelator **LIV,** der ein gemeinsames vektorielles Filterausgangssignal **S4** in Abhängigkeit vom vektoriellen verstärkten Empfängerausgangssignal **S1** bzw. vom vektoriellen digitalisierten Empfängerausgangssignal **S1** und dem vektoriellen LED-Modulationssignal **S5w** bildet und Daten des vektoriellen Filterausgangssignals **S4** der Steuervorrichtung **CTR** zur Verfügung stellt, insbesondere für die Steuervorrichtung **CTR** bereithält oder an die Steuervorrichtung **CTR** oder eine andere Vorrichtung (z.B. die Mustererkennungsvorrichtung **MEV**) insbesondere zur Auswertung überträgt,
   ∘ wobei der vektorielle Mehrfachkorrelator **LIV** typischerweise einen oder mehrere Mehrfachkorrelatoren **(LIV_1, LIV_2, LIV_3)** umfasst, und
   ∘ wobei Mehrfachkorrelatoren **(LIV_1, LIV_2, LIV_3)** des vektoriellen Mehrfachkorrelators **LIV,** der ein Filterausgangssignal **(S4_1, S4_2, S4_3)** des gemeinsamen vektoriellen Filterausgangssignals **S4** in Abhängigkeit von einem verstärkten Empfängerausgangssignal **(S1_1, S1_2, S1_3)** des vektoriellen verstärkten Empfängerausgangssignal **S1** bzw. von einem digitalisierten Empfängerausgangssignal **(S1_1, S1_2, S1_3)** des vektoriellen digitalisierten Empfängerausgangssignals **S1** und in Abhängigkeit von einem Modulationssignal **(S5w_1, S5w_2, S5w_3)** des vektoriellen LED-Modulationssignals **S5w** bildet und Daten des vektoriellen Filterausgangssignals **(S4_1, S4_2, S4_3)** des gemeinsamen vektoriellen Filterausgangssignals **S4** der Steuervorrichtung **CTR** zur Verfügung stellt, insbesondere für die Steuervorrichtung **CTR** bereithält oder an die Steuervorrichtung **CTR** oder eine andere Vorrichtung (z.B. die Mustererkennungsvorrichtung **MEV**) insbesondere zur Auswertung überträgt,
- ein gemeinsames vektorielles Filterausgangssignal **S4** für das zugeordnete vektorielle Sensorelement **SE,**
   ∘ wobei das gemeinsame vektorielle Filterausgangssignal **S4** ein oder mehrere vektorielle Filterausgangssignale **(S4_1, S4_2, S4_3)** umfasst, und
   ∘ wobei typischerweise eine Mustererkennungsvorrichtung **MEV** und/oder die Steuervorrichtung **CTR** ein oder mehrere vektorielle Filterausgangssignale **(S4_1, S4_2, S4_3)** und/oder das gemeinsame vektorielle Filterausgangssignal **S4** auswerten und/oder analysieren und/oder mittels computerimplementierter Verfahren verarbeiten.

In einer Weiterbildung umfasst der vektorielle Sensorelementkanal,
- einen zweiten Signalgenerator (G2), der dazu eingerichtet ist, ein Mikrowellenmodulationssignal (S5m) zu erzeugen, oder einen zweiten vektoriellen Signalgenerator (G2), der mehrere zweite Signalgeneratoren (G2_1, G2_2, G2_3, G2_4, G2_5) als zweite Signalgeneratorkomponenten umfasst und der dazu eingerichtet ist, ein vektorielles Mikrowellenmodulationssignal (S5m) mit mehreren Mikrowellenmodulationssignalen (S5m_1, S5m_2, S5m_3, S5m_4, S5m_5) als Mikrowellenmodulationssignalkomponenten zu erzeugen;
- eine Wellenleitung (1380, 1880, 2380, 6830, 6980) oder eine vektorielle Wellenleitung mit mehreren Wellenleitungen als Wellenleitungskomponenten (1380, 1880, 2380, 6830, 6980);
   ∘ eine Mikrowellensignalquelle (µWG), die dazu eingerichtet ist, das Mikrowellensignal (µW) für die Wellenleitung (1380, 1880, 2380, 6830, 6980) in Abhängigkeit von dem Mikrowellenmodulationssignal (S5m) zu erzeugen und in die Wellenleitung (1380, 1880, 2380, 6830, 6980) einzuspeisen oder
   ∘ eine vektorielle Mikrowellensignalquelle (µWG), die mehrere Mikrowellensignalquellen (µWG _1, µWG _2, µWG _3, µWG _4, µWG _5) als Mikrowellensignalquellenkomponenten umfasst und die dazu eingerichtet ist, das vektorielle Mikrowellensignal (µW) mit mehreren Mikrowellensignalen (µW_1, µW_2, µW_3, µW_4, µW_5) als Mikrowellensignalkomponenten in Abhängigkeit von dem vektoriellen Mikrowellenmodulationssignal (S5m) und/oder von dem Mikrowellenmodulationssignal (S5m) zu erzeugen und in die vektorielle Wellenleitung einzuspeisen und/oder
   ∘ eine vektorielle Mikrowellensignalquelle (µWG) aufweist, die mehrere Mikrowellensignalquellen (µWG _1, µWG _2, µWG _3, µWG _4, µWG _5) als Mikrowellensignalquellenkomponenten umfasst und wobei jeweilige Mikrowellensignalquellenkomponenten dazu eingerichtet sind, eine jeweilige Mikrowellensignalkomponente (µW_1, µW_2, µW_3, µW_4, µW_5) des vektorielle Mikrowellensignals (µW) in Abhängigkeit von einer jeweiligen Mikrowellenmodulationssignalkomponente (S5m_1, S5m_2, S5m_3, S5m_4, S5m_5) des vektoriellen Mikrowellenmodulationssignal (S5m) und/oder von dem Mikrowellenmodulationssignal (S5m) zu erzeugen und in die jeweilige Wellenleitungskomponente (1380, 1880, 2380, 6830, 6980) der vektoriellen Wellenleitung einzuspeisen;
- einen Mehrfachkorrelator (LIV), der dazu eingerichtet ist, ein Filterausgangssignal (S4) in Abhängigkeit vom verstärkten Empfängerausgangssignal (S1) bzw. vom digitalisierten Empfängerausgangssignal (S1) und von dem LED-Modulationssignal (S5w) und von einem Mikrowellenmodulationssignal (S5m) zu bilden oder mehrere Mehrfachkorrelatoren (LIV_1, LIV_2, LIV_3, LIV_4, LIV_5) eines vektoriellen Mehrfachkorrelators (LIV) als Mehrfachkorrelatorkomponenten umfasst, wobei jede der Mehrfachkorrelatorkomponenten (LIV_1, LIV_2, LIV_3, LIV_4, LIV_5) des vektoriellen Mehrfachkorrelators (LIV) jeweils dazu eingerichtet ist, jeweils ein jeweiliges Filterausgangssignal (S4_1, S4_2, S4_3, S4_4, S4_5) als jeweilige Filterausgangssignalkomponente eines gemeinsamen vektoriellen Filterausgangssignals (S4) in jeweiliger Abhängigkeit von der jeweiligen verstärkten Empfängerausgangssignalkomponente (S1_1, S1_2, S1_3, S1_4, S1_5) des vektoriellen verstärkten Empfängerausgangssignals (S1) bzw. in jeweiliger Abhängigkeit von der jeweiligen digitalisierten Empfängerausgangssignalkomponente (S1_1, S1_2, S1_3, S1_4, S1_5) des vektoriellen digitalisierten Empfängerausgangssignals (S1) und in jeweiliger Abhängigkeit von der jeweiligen LED-Modulationssignalkomponente (S5w_1, S5w_2, S5w_3, S5w_4, S5w_5) des vektoriellen LED-Modulationssignal (S5w) und zum ersten in jeweiliger Abhängigkeit von der jeweiligen Mikrowellenmodulationssignalkomponente (S5m_1, S5m_2, S5m_3, S5m_4, S5m_5) des vektoriellen Mikrowellenmodulationssignals (S5m) zu bilden oder zum zweiten in Abhängigkeit von dem Mikrowellenmodulationssignals (S5m) zu bilden.

### Figur 72

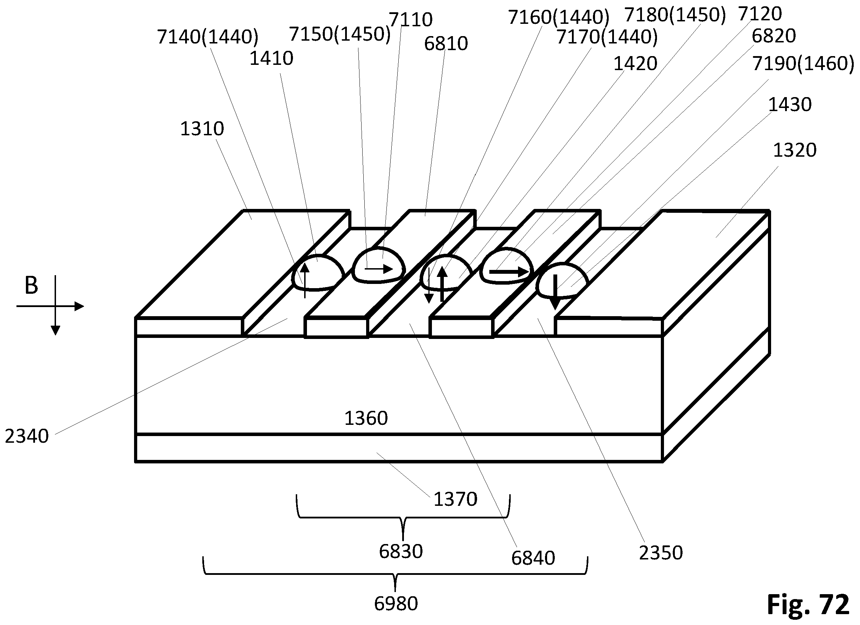

Die Figur 72 zeigt eine differentielle Mikrostreifenleitung 6880. Die beispielhafte differentielle Mikrostreifenleitung **6880** der Figur 68 umfasst wieder ein vorzugsweise nicht oder nur wenig elektrisch leitendes Trägersubstrat **1360.** Die differentielle Mikrostreifenleitung **6880** umfasst bevorzugt wieder einen elektrisch leitenden Rückseitenkontakt **1370** auf der Unterseite des elektrisch nicht-leitenden Trägersubstrats **1360.** Die differentielle Mikrostreifenleitung **6880** umfasst bevorzugt eine elektrisch im Wesentlichen nicht-leitende linke Isolationsfläche **1340** auf der Oberseite des elektrisch nicht-leitenden Trägersubstrats **1360** und eine elektrisch im Wesentlichen nicht-leitende rechte Isolationsfläche **1350** auf der Oberseite des elektrisch nicht-leitenden Trägersubstrats **1360.** Des Weiteren umfasst bevorzugt die differentielle Mikrostreifenleitung **6880** eine linke elektrisch leitende Signalleitung **6810** auf der Oberseite des elektrisch nicht-leitenden Trägersubstrats **1360** zwischen der elektrisch im Wesentlichen nicht-leitende linke Isolationsfläche **1340** einerseits und der elektrisch isolierenden Lücke **6840** zwischen dem linken Signalleiter **6810** und dem rechten Signalleiter **6820** des differentiellen Signalleiters **6830** andererseits. Des Weiteren umfasst bevorzugt die differentielle Mikrostreifenleitung **6880** eine rechte elektrisch leitende Signalleitung **6820** auf der Oberseite des elektrisch nicht-leitenden Trägersubstrats **1360** zwischen der elektrisch isolierenden Lücke **6840** zwischen dem linken Signalleiter **6810** und dem rechten Signalleiter **6820** des differentiellen Signalleiters **6830** einerseits und der elektrisch im Wesentlichen nicht-leitenden rechten Isolationsfläche **1350** andererseits. Die elektrisch isolierende Lücke **6840** zwischen dem linken Signalleiter **6810** und dem rechten Signalleiter **6820** des differentiellen Signalleiters **6830** isoliert elektrisch den linken Signalleiter **6810** von dem rechten Signalleiter **6820** des differentiellen Signalleiters **6830.** Der linke Signalleiter **6810** und der rechte Signalleiter **6820** bilden zusammen den differentiellen Signalleiter **6830** der differentiellen Mikrostreifenleitung **6880.** Die differentielle Mikrostreifenleitung **6880** kann mit einem Gleichtaktsignal angesteuert werden, bei dem in den linken Signalleiter **6810** und den rechten Signalleiter **6820** des differentiellen Signalleiters **6830** das gleiche Signal zeitsynchron eingespeist wird. Dieser Betriebszustand heißt Gleichtaktansteuerung mit einem Gleichtaktsignal. Die differentielle Mikrostreifenleitung **6880** kann mit einem Gegentaktaktsignal angesteuert werden, bei dem in den linken Signalleiter **6810** und den rechten Signalleiter **6820** des differentiellen Signalleiters **6830** das gleiche Signal zeitsynchron, aber mit unterschiedlichem Vorzeichen, eingespeist wird. Dieser Betriebszustand heißt Gegentaktansteuerung mit einem Gegentaktsignal.

Bevorzugt weist die differentielle Mikrostreifenleitung **6880** bezogen auf den differentieller Signalleiter **6830** als "heißen" Innenleiter einen Gleichtaktwellenwiderstand für eine Gleichtaktansteuerung auf und einen Gegentaktwellenwiderstand für eine Gegentaktansteuerung auf.

Eine solche differentielle Mikrostreifenleitung **6880** ermöglicht durch unterschiedliche Nutzung der Gleichtaktund Gegentaktansteuerung die vereinfachte Ansteuerung der Sensorelemente SE.

Bei Gleichtaktansteuerung verhält sich der differentielle Signalleiter **6830** im Wesentlichen wie der Signalleiter **1330** einer beispielhaften Mikrostreifenleitung **1380.** Die die differentielle Mikrostreifenleitung **6880** verhält sich bei Gleichtaktansteuerung also im Wesentlichen wie eine Mikrostreifenleitung **1380.**

Auch kann man den differentiellen Signalleiter **6830** bei Gegentaktansteuerung wie einen spezielle Schlitzleitung **1880** betrachten, bei der die Breite der elektrisch leitenden linken Signalmassefläche **1310** der Schlitzleitung **1880** auf der Oberseite des elektrisch nicht-leitenden Trägersubstrats **1360** auf die Breite des linken Signalleiters **6810** geschrumpft ist und bei der die Breite der elektrisch leitenden rechten Signalmassefläche **1320** der Schlitzleitung **1880** auf der Oberseite des elektrisch nicht-leitenden Trägersubstrats **1360** auf die Breite des rechten Signalleiters **6820** geschrumpft ist. Die elektrisch isolierende Lücke **6840** zwischen dem linken Signalleiter **6810** und dem rechten Signalleiter **6820** des differentiellen Signalleiters **6830** entspricht dann dem Schlitz **1840** der Schlitzleitung **1880.** Der Abstand des linken Signalleiters **6810** vom rechten Signalleiter **6810,** also die Breite der elektrisch isolierenden Lücke **6840** zwischen dem linken Signalleiter **6810** und dem rechten Signalleiter **6820** des differentiellen Signalleiters **6830** entspricht daher in ihrer Funktion der Breite **d_{SL}** des Schlitzes **1840** der Schlitzleitung **1880.** Dies ist insofern von Bedeutung, als dass die folgenden Positionierungen der Sensorelemente **SE** dann besser zu verstehen sind.

Figur 72 zeigt darüber hinaus eine beispielhafte differenzielle Tri-Plate-Leitung **6980.** Die beispielhafte differenzielle Tri-Plate-Leitung **6980** umfasst eine differenzielle Mikrostreifenleitung **6880** mit einem differentiellen Signalleiter **6830.** Die differenzielle Mikrostreifenleitung **6880** wurde bereits erläutert. Die differenzielle Tri-Plate-Leitung **6980** umfasst zusätzlich eine elektrisch leitende linke Signalmassefläche **1310** und eine elektrisch leitende rechte Signalmassefläche **1320.**

Die elektrisch leitende linke Signalmassefläche **1310** ist durch eine elektrisch nicht-leitende linke Isolationslücke **2340** von dem linken Signalleiter **6810** des differentiellen Signalleiters **6830** der differenziellen Mikrostreifenleitung **6880** der beispielhaften differenziellen Tri-Plate-Leitung **6980** beabstandet und isoliert. Die elektrisch leitende rechte Signalmassefläche **1320** ist durch eine elektrisch nicht-leitende rechte Isolationslücke **2350** von dem rechten Signalleiter **6820** des differentiellen Signalleiters **6830** der differenziellen Mikrostreifenleitung **6880** der beispielhaften differenziellen Tri-Plate-Leitung **6980** beabstandet und isoliert. Die elektrisch isolierende Lücke **6840** separiert den linken Signalleiter **6810** von dem rechten Signalleiter **6820** des differentiellen Signalleiters **6830** der differenziellen Mikrostreifenleitung **6880** der beispielhaften differenziellen Tri-Plate-Leitung **6980.**

Wie bei der differenziellen Mikrostreifenleitung **6880** weist die differenzielle Tri-Plate-Leitung **6980** zumindest zwei unabhängige Wellenwiderstände auf. Die technische Lehre der hier vorgelegten Schrift geht vereinfachend davon aus, dass die elektrisch leitende rechte Signalmassefläche **1320** und die elektrisch leitende rechte Signalmassefläche **1320** und der elektrisch leitende Rückseitenkontakt **1370** miteinander elektrisch verbunden sind oder zumindest als Signalmasse angesehen werden können. Dies ist aber nicht zwingend so. Ggf. können sie auch zeitgleich als Zu- und Ableitung von elektrischer Energie zu Vorrichtungsteilen verwendet werden, die mit einem Gleichstrom oder einer Gleichspannung oder Wechselspannung versorgt werden müssen. Eine solche Energieversorgung dürfte aber in der Regel problematisch sein, da sie magnetische Felder erzeugt, die unerwünscht sind. Im Folgenden geht die hier vorgelegte Schrift daher davon aus, dass bis auf die von Signalgeneratoren eingespeisten Signale zur Ansteuerung der Sensorelemente **SE** keine weiteren Signale über die differenzielle Tri-Plate-Leitung **6980** transportiert werden, was bevorzugt ist.

Bevorzugt ist die differenzielle Tri-Plate-Leitung **6980** an dem Ende, das dem anderen Ende der differenziellen Tri-Plate-Leitung **6980,** an dem die Einspeisung der Signale erfolgt, gegenüberliegt, mit Anschlusswiderständen **6710** abgeschlossen.

Bevorzugt ist die Breite der elektrisch nicht-leitenden linken Isolationslücke **2340** im Wesentlichen gleich der Breite der elektrisch nicht-leitenden linken Isolationslücke **2340.**

Bevorzugt sind die Breiten der elektrisch nicht-leitenden linken Isolationslücke **2340** und der elektrisch nicht-leitenden linken Isolationslücke **2340** einerseits und die Breite der elektrisch isolierende Lücke **6840** so relativ zueinander eingestellt, dass der Gleichtaktwellenwiderstand der differenzielle Tri-Plate-Leitung **6980** bei Gleichtaktansteuerung des differentiellen Signalleiters **6830** der differenziellen Mikrostreifenleitung **6880** der beispielhaften differenziellen Tri-Plate-Leitung **6980** im Wesentlichen gleich dem Gegentaktwellenwiderstand der differenzielle Tri-Plate-Leitung **6980** bei Gegentaktansteuerung des differentiellen Signalleiters **6830** der differenziellen Mikrostreifenleitung **6880** der beispielhaften differenziellen Tri-Plate-Leitung **6980** ist.

Dies vereinfacht die Konstruktion der Ansteuerschaltungen (z.B. der Mikrowellensignalquelle **µWG**) und der Abschlusswiderstände **6710.**

Die beispielhafte Tri-Plate-Leitung **6980** der Figur 72 ist um verschiedene Sensorelemente **SE** an verschiedenen Punkten der Tri-Plate-Leitung **6980** ergänz.

Wie zuvor sollen die Sensorelemente **SE** jeweils eine Vielzahl von Diamant-Nano-Kristallen **ND** und/oder Kristallen mit unterschiedlicher und bevorzugt gleichverteilter räumlicher Ausrichtung umfassen. Bevorzugt umfassen Diamant-Nano-Kristalle **ND** bzw. Kristalle der Sensorelemente **SE** dabei wieder paramagnetische Zentren, insbesondere NV-Zentren, die bei Bestrahlung mit einer Pumpstrahlung **LB** einer Pumpstrahlungswellenlänge λₚₘₚ eine Fluoreszenzstrahlung **FL** mit einer Fluoreszenzwellenlänge λ_{fl} emittieren. In dem Beispiel der Figur 72 ist angenommen, dass die Sensorelemente **SE** so platziert sind und in ihrer Größe so gewählt sind, dass sie sich ideal verhalten. Hierbei bezieht sich ideales Verhalten auf eine Platzierung entsprechend den vorausgehenden Figuren für andere Wellenleiter, die auch hier für eine differenzielle TriPlate-Leitung **6980** angewendet werden können. Mischformen durch übergroße Sensorelemente **SE** sind natürlich möglich. Diese Mischformen können auch hier für die Sensorelemente **SE** einer differenziellen TriPlate-Leitung **6980** angewendet werden.

Der Unterschied zu der Tri-Plate-Leitung **2380** ist, dass durch die Verwendung einer differentiellen Signalleitung **6830** einer differenziellen Mikrostreifenleitung **6880** als Teil der differenziellen Tri-Plate-Leitung **6980** zwei zusätzliche Positionen für die Sensorelemente **SE** hinzugekommen sind und dass die Eigenschaften der Sensorelemente **SE** nach Gleichtakteigenschaften und Gegentakteigenschaften sich unterscheiden.

### linkes Sensorelement SE(1410)

Als erstes nennen wir hier wieder das linke Sensorelement **SE(1410).** Das linke Sensorelement **SE(1410)** ist stärker für Gleichtaktsignale des von den Signalgeneratoren (z.B. **RWG,µWG)** in die differenzielle Tri-Plate-Leitung **6980** eingespeisten Signals und weniger für Gegentaktsignale des von den Signalgeneratoren (z.B. **RWG,µWG)** in die differenzielle Tri-Plate-Leitung **6980** eingespeisten Signals empfindlich. Für Gleichtaktsignale verhält sich die Anordnung aus differentieller Tri-Plate-Leitung **6980** und linkem Sensorelement **SE(1410)** ähnlich einer Tri-Plate-Leitung **2380** mit linkem Sensorelement **SE(1410)** und zentraler Signalleitung **1330.** Das hier vorgelegte Dokument verweist in diesem Zusammenhang auf die Beschreibung der entsprechenden Figur 68, wobei angenommen wird, dass im Wesentlichen für die Gleichtaktansteuerung die differentielle Signalleitung **6830** der differenziellen Mikrostreifenleitung **6880** der differentiellen Tri-Plate-Leitung **6980** zu einer zentrale Signalleitung **1330** einer Tri-Plate-Leitung **2380** bezgl. der Gleichtaktansteuerung zusammengefasst werden kann. Auch das Gegentaktsignal beeinflusst die Intensität der Fluoreszenzstrahlung **LB** des linken Sensorelements **SE(1410).** Da die Signale in der linken Signalleitung **6810** der differentielle Signalleitung **6830** der differenziellen Mikrostreifenleitung **6880** der differentiellen Tri-Plate-Leitung **6980** und der rechten Signalleitung **6820** der differentielle Signalleitung **6830** der differenziellen Mikrostreifenleitung **6880** der differentiellen Tri-Plate-Leitung **6980** sich jedoch aufgrund des gegentaktigen Verhaltens größten Teils kompensieren, verbleibt nur der Einfluss der linken Signalleitung **6810** der differentielle Signalleitung **6830** der differenziellen Mikrostreifenleitung **6880** der differentiellen Tri-Plate-Leitung **6980** der aufgrund der größeren Nähe zwischen dem linken Sensorelement **SE(1410)** und der linken Signalleitung **6810** der differentielle Signalleitung **6830** der differenziellen Mikrostreifenleitung **6880** der differentiellen Tri-Plate-Leitung **6980** gegenüber der rechten Signalleitung **6820** der differentielle Signalleitung **6830** der differenziellen Mikrostreifenleitung **6880** der differentiellen Tri-Plate-Leitung **6980** überschießt. Dieser ist jedoch typischerweise massiv geringer als der Einfluss des Gleichtaktsignals. Vereinfachend nimmt die technische Lehre der hier vorgelegten Schrift an, dass das linke Sensorelement **SE(1410)** für Gleichtaktsignale des in die differentielle Tri-Plate-Leitung eingespeisten Signals der Signalgeneratoren (z.B. **RWG,µWG)** empfindlich ist. Typischerweise ist dabei die Intensität der Fluoreszenzstrahlung **FL** des linken Sensorelements **SE(1410)** von dem Anteil der magnetischen Gesamtflussdichte **B_{Σ},** dessen Komponentenvektor **parallel** zur Oberfläche des Trägersubstrats **1360** liegt, abhängig. Zusammenfassend nimmt das hier vorgelegte Dokument also an, dass die Intensität der Fluoreszenzstrahlung **FL** des linken Sensorelements **SE(1410)** von dem Anteil der magnetischen Gesamtflussdichte B_{Σ}, dessen Komponentenvektor **parallel** zur Oberfläche des Trägersubstrats **1360** liegt, und dem Gleichtaktsignal der Signalgeneratoren (z.B. **RWG,µWG)** abhängt. Diese neue Erkenntnis kann zur gezielten Sensorsystemkonstruktion und Ansteuerung des linken Sensorelements **SE(1410)** durch die Signalgeneratoren (z.B. **RWG,µWG)** eingesetzt werden.

### rechtes Sensorelement SE(1430)

Als zweites nennen wir hier wieder das rechte Sensorelement **SE(1430).** Das rechte Sensorelement **SE(1430)** ist stärker für Gleichtaktsignale des von den Signalgeneratoren (z.B. **RWG,µWG)** in die differenzielle Tri-Plate-Leitung **6980** eingespeisten Signals und weniger für Gegentaktsignale des von den Signalgeneratoren (z.B. **RWG,µWG)** in die differenzielle Tri-Plate-Leitung **6980** eingespeisten Signals empfindlich. Für Gleichtaktsignale verhält sich die Anordnung aus differentieller Tri-Plate-Leitung **6980** und rechtem Sensorelement **SE(1430)** ähnlich einer Tri-Plate-Leitung **2380** mit rechtem Sensorelement **SE(1430)** und zentraler Signalleitung **1330.** Das hier vorgelegte Dokument verweist in diesem Zusammenhang auf die Beschreibung der entsprechenden Figur 68, wobei angenommen wird, dass im Wesentlichen für die Gleichtaktansteuerung die differentielle Signalleitung **6830** der differenziellen Mikrostreifenleitung **6880** der differentiellen Tri-Plate-Leitung **6980** zu einer zentrale Signalleitung **1330** einer Tri-Plate-Leitung **2380** bezgl. der Gleichtaktansteuerung zusammengefasst werden kann. Auch das Gegentaktsignal beeinflusst die Intensität der Fluoreszenzstrahlung **LB** des rechten Sensorelements **SE(1430).** Da die Signale in der rechten Signalleitung **6820** der differentielle Signalleitung **6830** der differenziellen Mikrostreifenleitung **6880** der differentiellen Tri-Plate-Leitung **6980** und der linken Signalleitung **6810** der differentielle Signalleitung **6830** der differenziellen Mikrostreifenleitung **6880** der differentiellen Tri-Plate-Leitung **6980** sich jedoch aufgrund des gegentaktigen Verhaltens größten Teils kompensieren, verbleibt nur der Einfluss der rechten Signalleitung **6820** der differentielle Signalleitung **6830** der differenziellen Mikrostreifenleitung **6880** der differentiellen Tri-Plate-Leitung **6980** der aufgrund der größeren Nähe zwischen dem rechten Sensorelement **SE(1430)** und der rechten Signalleitung **6820** der differentielle Signalleitung **6830** der differenziellen Mikrostreifenleitung **6880** der differentiellen Tri-Plate-Leitung **6980** gegenüber der linken Signalleitung **6810** der differentielle Signalleitung **6830** der differenziellen Mikrostreifenleitung **6880** der differentiellen Tri-Plate-Leitung **6980** überschießt. Dieser ist jedoch typischerweise massiv geringer als der Einfluss des Gleichtaktsignals. Vereinfachend nimmt die technische Lehre der hier vorgelegten Schrift an, dass das rechte Sensorelement **SE(1430)** für Gleichtaktsignale des in die differentielle Tri-Plate-Leitung eingespeisten Signals der Signalgeneratoren (z.B. **RWG,µWG)** empfindlich ist. Typischerweise ist dabei die Intensität Iᵢₛₜ der Fluoreszenzstrahlung **FL** des rechten Sensorelements **SE(1430)** von dem Anteil der magnetischen Gesamtflussdichte **B_{Σ},** dessen Komponentenvektor **parallel** zur Oberfläche des Trägersubstrats **1360** liegt, abhängig. Zusammenfassend nimmt das hier vorgelegte Dokument also an, dass die Intensität Iᵢₛₜ der Fluoreszenzstrahlung **FL** des rechten Sensorelements **SE(1430)** von dem Anteil der magnetischen Gesamtflussdichte **B_{Σ},** dessen Komponentenvektor **parallel** zur Oberfläche des Trägersubstrats **1360** liegt, und dem Gleichtaktsignal der Signalgeneratoren (z.B. **RWG,µWG)** abhängt. Diese neue Erkenntnis kann zur gezielten Sensorsystemkonstruktion und Ansteuerung des rechten Sensorelements **SE(1430)** durch die Signalgeneratoren (z.B. **RWG,µWG)** eingesetzt werden.

### mittleres Sensorelement SE(1420)

Als drittes nennen wir hier wieder das mittlere Sensorelement **SE(1420).** Das mittlere Sensorelement **SE(1420)** ist stärker für Gegentaktsignale des von den Signalgeneratoren (z.B. **RWG,µWG)** in die differenzielle Tri-Plate-Leitung **6980** eingespeisten Signals und weniger für Gleichtaktsignale des von den Signalgeneratoren (z.B. **RWG,µWG)** in die differenzielle Tri-Plate-Leitung **6980** eingespeisten Signals empfindlich. Für Gegentaktsignale verhält sich die Anordnung aus differentieller Tri-Plate-Leitung **6980** und mittlerem Sensorelement **SE(1420)** ähnlich einer Schlitzleitung **1880** mit mittlerem Sensorelement **SE(1430).** Das hier vorgelegte Dokument verweist in diesem Zusammenhang auf die Beschreibung der Figur 55, wobei angenommen wird, dass im Wesentlichen für die Gegentaktansteuerung die linke Signalleitung **6810** der differentiellen Signalleitung **6830** der differenziellen Mikrostreifenleitung **6880** der differentiellen Tri-Plate-Leitung **6980** mit der elektrisch leitende linke Signalmassefläche **1310** der differentiellen Tri-Plate-Leitung **6980** zu einer elektrisch leitende linke Signalmassefläche **1310** einer Schlitzleitung **1880** bezgl. der Gegentaktansteuerung näherungsweise zusammengefasst werden kann. Auch das Gleichtakttaktsignal beeinflusst die Intensität **Iᵢₛₜ** der Fluoreszenzstrahlung **LB** des mittleren Sensorelements **SE(1420),** nun aber nur aufgrund von Fertigungsabweichungen. Da die Signale in der rechten Signalleitung **6820** der differentielle Signalleitung **6830** der differenziellen Mikrostreifenleitung **6880** der differentiellen Tri-Plate-Leitung **6980** und der linken Signalleitung **6810** der differentielle Signalleitung **6830** der differenziellen Mikrostreifenleitung **6880** der differentiellen Tri-Plate-Leitung **6980** sich jedoch aufgrund des gleichtaktaktigen Verhaltens kombiniert mit der unterschiedlichen durch die Gleichtaktsignale in den Leitungen **6810, 6820** der differenziellen Signalleitung **6830** größten Teils kompensieren, verbleibt nur der Einfluss aus Justage- und Fertigungsfehlern des mittleren Sensorelements **1430,** die zu Asymmetrien gegenüber der rechten Signalleitung **6820** der differentielle Signalleitung **6830** der differenziellen Mikrostreifenleitung **6880** der differentiellen Tri-Plate-Leitung **6980** und der der linken Signalleitung **6810** der differentiellen Signalleitung **6830** der differenziellen Mikrostreifenleitung **6880** der differentiellen Tri-Plate-Leitung **6980** führen. Vereinfachend nimmt die technische Lehre der hier vorgelegten Schrift an, dass das mittlere Sensorelement **SE(1420)** für Gegentaktsignale des in die differentielle Tri-Plate-Leitung **6980** eingespeisten Signals der Signalgeneratoren (z.B. **RWG,µWG)** empfindlich ist. Typischerweise ist dabei die Intensität Iᵢₛₜ der Fluoreszenzstrahlung **FL** des mittleren Sensorelements **SE(1420)** von dem Anteil der magnetischen Gesamtflussdichte **B_{Σ},** dessen Komponentenvektor **parallel** zur Oberfläche des Trägersubstrats **1360** liegt, abhängig. Zusammenfassend nimmt das hier vorgelegte Dokument also an, dass die Intensität Iᵢₛₜ der Fluoreszenzstrahlung **FL** des mittleren Sensorelements **SE(1420)** von dem Anteil der magnetischen Gesamtflussdichte **B_{Σ},** dessen Komponentenvektor **parallel** zur Oberfläche des Trägersubstrats **1360** liegt, und dem Gegentaktsignal der Signalgeneratoren (z.B. **RWG,µWG)** abhängt. Diese neue Erkenntnis kann zur gezielten Sensorsystemkonstruktion und Ansteuerung des mittleren Sensorelements **SE(1420)** durch die Signalgeneratoren (z.B. **RWG,µWG)** eingesetzt werden.

### linkes Leitungssensorelement SE(7110)

Als viertes nennen wir hier nun das neue linke Leitungssensorelement **SE(7110).** Das linke Leitungssensorelement **SE(7110)** ist für Gegentaktsignale und für Gleichtaktsignale des von den Signalgeneratoren (z.B. **RWG,µWG)** in die differenzielle Tri-Plate-Leitung **6980** eingespeisten Signals empfindlich. Insofern unterscheidet sich das linke Leitungssensorelement **SE(7110)** von dem linken Sensorelement **SE(1410)** und dem rechten Sensorelement **SE(1430)** und dem mittleren Sensorelement **SE(1430).** Wir unterscheiden daher hier das Verhalten Gleichtaktsignale und Gegentaktsignale des von den Signalgeneratoren (RWG, µWG) in die differentielle Tri-Plate-Leitung **6980** eingespeisten Signals.

### Gegentaktsignale

Für Gegentaktsignale verhält sich die Anordnung aus differentieller Tri-Plate-Leitung **6980** und linken Leitungssensorelement **SE(7110)** ähnlich einer Tri-Plate-Leitung **2380** mit mittlerem Sensorelement **SE(1430).** Das hier vorgelegte Dokument verweist in diesem Zusammenhang auf die Beschreibung der Figur 56, wobei angenommen wird, dass im Wesentlichen für die Gegentaktansteuerung die rechte Signalleitung **6820** der differentiellen Signalleitung **6830** der differenziellen Mikrostreifenleitung **6880** der differentiellen Tri-Plate-Leitung **6980** mit der elektrisch leitenden rechten Signalmassefläche **1320** der differentiellen Tri-Plate-Leitung **6980** zu einer elektrisch leitende rechten Signalmassefläche **1320** der Tri-Plate-Leitung **2380** mit mittlerem Sensorelement **SE(1430)** bezgl. der Gegentaktansteuerung näherungsweise zusammengefasst werden kann.

### Gleichtaktsignale

Für Gleichtaktsignale verhält sich die Anordnung aus differentieller Tri-Plate-Leitung **6980** und linken Leitungssensorelement **SE(7110)** ebenfalls ähnlich einer Tri-Plate-Leitung **2380** mit mittlerem Sensorelement **SE(1430).** Das hier vorgelegte Dokument verweist in diesem Zusammenhang wieder auf die Beschreibung der Figur 56, wobei nun aber angenommen wird, dass im Wesentlichen für die Gleichtaktansteuerung die rechte Signalleitung **6820** der differentiellen Signalleitung **6830** der differenziellen Mikrostreifenleitung **6880** der differentiellen Tri-Plate-Leitung **6980** mit der linken Signalleitung **6810** der differentiellen Signalleitung **6830** der differenziellen Mikrostreifenleitung **6880** der differentiellen Tri-Plate-Leitung **6980** zu einer elektrisch leitenden Leitung **1330** der Tri-Plate-Leitung **2380** mit mittlerem Sensorelement **SE(1430)** bezgl. der Gleichtaktansteuerung näherungsweise zusammengefasst werden kann.

Typischerweise sollten also Gleichtaktsignale und Gegentaktsignale die Intensität der Fluoreszenzstrahlung **FL** des linken Leitungssensorelements **SE(7110)** im Wesentlichen in gleicher Weise beeinflussen.

### Zusammenfassung linkes Leitungssensorelement SE(7110)

Typischerweise ist dabei die Intensität Iᵢₛₜ der Fluoreszenzstrahlung **FL** des linken Leitungssensorelements **SE(7110)** von dem Anteil der magnetischen Gesamtflussdichte **B_{Σ},** dessen Komponentenvektor **senkrecht** zur Oberfläche des Trägersubstrats **1360** oder in Richtung der linken Signalleitung **6810** der differentiellen Signalleitung **6830** der differenziellen Mikrostreifenleitung **6880** der differentiellen Tri-Plate-Leitung **6980** liegt, abhängig. Zusammenfassend nimmt das hier vorgelegte Dokument also an, dass die Intensität Iᵢₛₜ der Fluoreszenzstrahlung **FL** des linken Leitungssensorelements **SE(7110)** von dem Anteil der magnetischen Gesamtflussdichte **B_{Σ},** dessen Komponentenvektor **senkrecht** zur Oberfläche des Trägersubstrats **1360** oder in Richtung der linken Signalleitung **6810** der differentiellen Signalleitung **6830** der differenziellen Mikrostreifenleitung **6880** der differentiellen Tri-Plate-Leitung **6980** liegt, und dem Gegentaktsignal und Gleichtaktsignal der Signalgeneratoren (z.B. **RWG,µWG)** abhängt. Diese neue Erkenntnis kann zur gezielten Sensorsystemkonstruktion und Ansteuerung des linken Leitungssensorelements **SE(7110)** durch die Signalgeneratoren (z.B. **RWG,µWG)** eingesetzt werden.

### rechtes Leitungssensorelement SE(7120)

Als fünftes nennen wir hier nun das neue rechte Leitungssensorelement **SE(7120).** Das rechte Leitungssensorelement **SE(7120)** ist ebenfalls für Gegentaktsignale und für Gleichtaktsignale des von den Signalgeneratoren (z.B. **RWG,µWG)** in die differenzielle Tri-Plate-Leitung **6980** eingespeisten Signals empfindlich. Das rechte Leitungssensorelement **SE(7120)** ist jedoch für Gegentaktsignale mit dem umgekehrten Vorzeichen als das linke Leitungssensorelement **SE(7110)** empfindlich. Insofern unterscheidet sich das rechte Leitungssensorelement **SE(7120)** von dem linken Sensorelement **SE(1410)** und dem rechten Sensorelement **SE(1430)** und dem mittleren Sensorelement **SE(1430)** und dem linken Leitungssensorelement **SE(7110).** Wir unterscheiden daher wieder hier das Verhalten Gleichtaktsignale und Gegentaktsignale des von den Signalgeneratoren **(RWG, µWG)** in die differentielle Tri-Plate-Leitung **6980** eingespeisten Signals.

### Gegentaktsignale

Für Gegentaktsignale verhält sich die Anordnung aus differentieller Tri-Plate-Leitung **6980** und rechtem Leitungssensorelement **SE(7120)** wieder ähnlich einer Tri-Plate-Leitung **2380** mit mittlerem Sensorelement **SE(1430),** wobei das Vorzeichen gegenüber dem Verhalten des linken Leitungssensorelements **SE(7110)** invertiert ist. Das hier vorgelegte Dokument verweist in diesem Zusammenhang auf die Beschreibung der Figur 56, wobei angenommen wird, dass im Wesentlichen für die Gegentaktansteuerung die linken Signalleitung **6810** der differentiellen Signalleitung **6830** der differenziellen Mikrostreifenleitung **6880** der differentiellen TriPlate-Leitung **6980** mit der elektrisch leitenden linken Signalmassefläche **1310** der differentiellen Tri-Plate-Leitung **6980** zu einer elektrisch leitenden linken Signalmassefläche **1310** der Tri-Plate-Leitung **2380** mit mittlerem Sensorelement **SE(1430)** bezgl. der Gegentaktansteuerung näherungsweise zusammengefasst werden kann.

### Gleichtaktsignale

Für Gleichtaktsignale verhält sich die Anordnung aus differentieller Tri-Plate-Leitung **6980** und rechtem Leitungssensorelement **SE(7120)** ebenfalls ähnlich einer Tri-Plate-Leitung **2380** mit mittlerem Sensorelement **SE(1430).** Das hier vorgelegte Dokument verweist in diesem Zusammenhang wieder auf die Beschreibung der Figur 56, wobei nun aber angenommen wird, dass im Wesentlichen für die Gleichtaktansteuerung die linke Signalleitung **6810** der differentiellen Signalleitung **6830** der differenziellen Mikrostreifenleitung **6880** der differentiellen Tri-Plate-Leitung **6980** mit der rechten Signalleitung **6820** der differentiellen Signalleitung **6830** der differenziellen Mikrostreifenleitung **6880** der differentiellen Tri-Plate-Leitung **6980** zu einer elektrisch leitenden Leitung **1330** der Tri-Plate-Leitung **2380** mit mittlerem Sensorelement **SE(1430)** bezgl. der Gleichtaktansteuerung näherungsweise zusammengefasst werden kann.

Typischerweise sollten also Gleichtaktsignale und Gegentaktsignale die Intensität Iᵢₛₜ der Fluoreszenzstrahlung **FL** des rechten Leitungssensorelements **SE(7120)** im Wesentlichen in gleicher Weise beeinflussen, wobei nun aber die Wirkungsrichtung der Gegentaktsignale gegenüber der Wirkungsrichtung der Gleichtaktsignale im Falle des linken Leitungssensorelements **SE(7110)** invertiert ist.

### Zusammenfassung linkes Leitungssensorelement SE(7110)

Typischerweise ist dabei die Intensität der Fluoreszenzstrahlung **FL** des rechten Leitungssensorelements **SE(7120)** von dem Anteil der magnetischen Gesamtflussdichte **B_{Σ},** dessen Komponentenvektor **senkrecht** zur Oberfläche des Trägersubstrats **1360** oder in Richtung der rechten Signalleitung **6820** der differentiellen Signalleitung **6830** der differenziellen Mikrostreifenleitung **6880** der differentiellen Tri-Plate-Leitung **6980** liegt, abhängig. Zusammenfassend nimmt das hier vorgelegte Dokument also an, dass die Intensität Iᵢₛₜ der Fluoreszenzstrahlung **FL** des rechten Leitungssensorelements **SE(6820)** von dem Anteil der magnetischen Gesamtflussdichte **B_{Σ},** dessen Komponentenvektor **senkrecht** zur Oberfläche des Trägersubstrats **1360** oder in Richtung der rechten Signalleitung **6820** der differentiellen Signalleitung **6830** der differenziellen Mikrostreifenleitung **6880** der differentiellen Tri-Plate-Leitung **6980** liegt, und dem Gegentaktsignal und Gleichtaktsignal der Signalgeneratoren (z.B. **RWG,µWG)** abhängt. Diese neue Erkenntnis kann zur gezielten Sensorsystemkonstruktion und Ansteuerung des rechten Leitungssensorelements **SE(7120)** durch die Signalgeneratoren (z.B. **RWG, µWG)** eingesetzt werden.

Die Vektoren der jeweiligen magnetischen Flussdichte **B_{µW},** die die linke Signalleitung **6810** der differenziellen Signalleitung **6830** der differenziellen Mikrostreifenleitung **6880** der differenziellen Tri-Plate-Leitung **6980** erzeugen sind mit dünnen Pfeilen zur Verdeutlichung eingezeichnet.

Die Vektoren der jeweiligen magnetischen Flussdichte **B_{µW},** die die rechte Signalleitung **6820** der differenziellen Signalleitung **6830** der differenziellen Mikrostreifenleitung **6880** der differenziellen Tri-Plate-Leitung **6980** erzeugen sind mit fetten Pfeilen zur Verdeutlichung eingezeichnet.

Die Vektoren **(7140, 7150, 7160, 7170, 7180, 7190)** der jeweiligen magnetischen Flussdichte **B_{µW}** der Bestromung der Signalleitungen **6810, 6820** der differenziellen Signalleitung **6830** der differenziellen Mikrostreifenleitung **6880** der beispielhaften differenziellen Tri-Plate-Leitung **6980** sind zur Verdeutlichung für Gegentaktansteuerung der differenziellen Signalleitung **6830** der differenziellen Mikrostreifenleitung **6880** der beispielhaften differenziellen Tri-Plate-Leitung **6980** dargestellt. Um die Darstellung der Gleichtaktansteuerung zu erhalten, reicht es beispielsweise aus, die Richtungen der Pfeile **7170, 7180** und **7190** umzudrehen.

### Figur 73

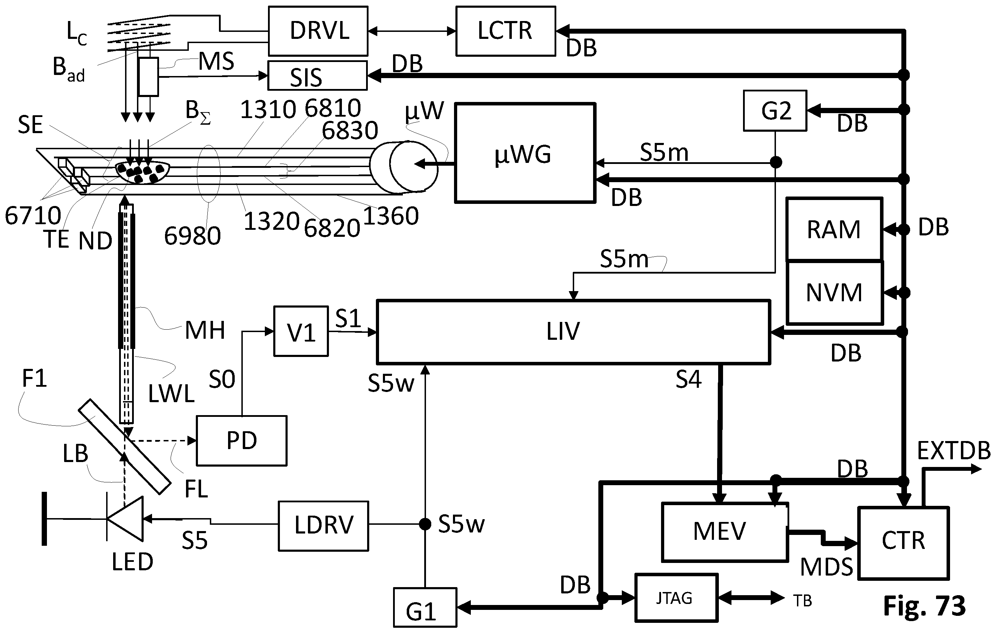

Die Figur 73 entspricht der Figur 69, wobei die Tri-Plate-Leitung **2380** durch eine differentielle Tri-Plate-Leitung **6980** ersetzt ist.

Das hier vorgelegte Dokument weist darauf hin, dass insgesamt sieben Positionierungen von Sensorelementen SE relativ zu den Leitungen und Leitungsflächen der differentiellen Tri-Plate-Leitung **6980** möglich sind:
1. auf der elektrisch leitenden linken Signalmassefläche **1310,**
2. in der nicht-leitenden linken Isolationslücke **2340,**
3. auf dem linken Signalleiter **6810** des differentiellen Signalleiters **6830,**
4. in der elektrisch isolierenden Lücke **6840** zwischen dem linken Signalleiter **6810** und dem rechten Signalleiter **6820** des differentiellen Signalleiters **6830.**
5. auf dem rechten Signalleiter **6820** des differentiellen Signalleiters **6830,**
6. in der nicht-leitenden rechten Isolationslücke **2350,**
7. auf der elektrisch leitenden rechten Signalmassefläche **1320.**

Mischformen durch Fehlplatzierungen und Vergrößerungen der betreffenden Sensorelemente **SE** sind möglich. Hieraus ergeben sich 2⁷ =128 mögliche Platzierungskombinationen an den verschiedenen 3 Sensorelementpositionen, die hiermit alle für eine fachkundige Person offenbart sind.

### Figur 74

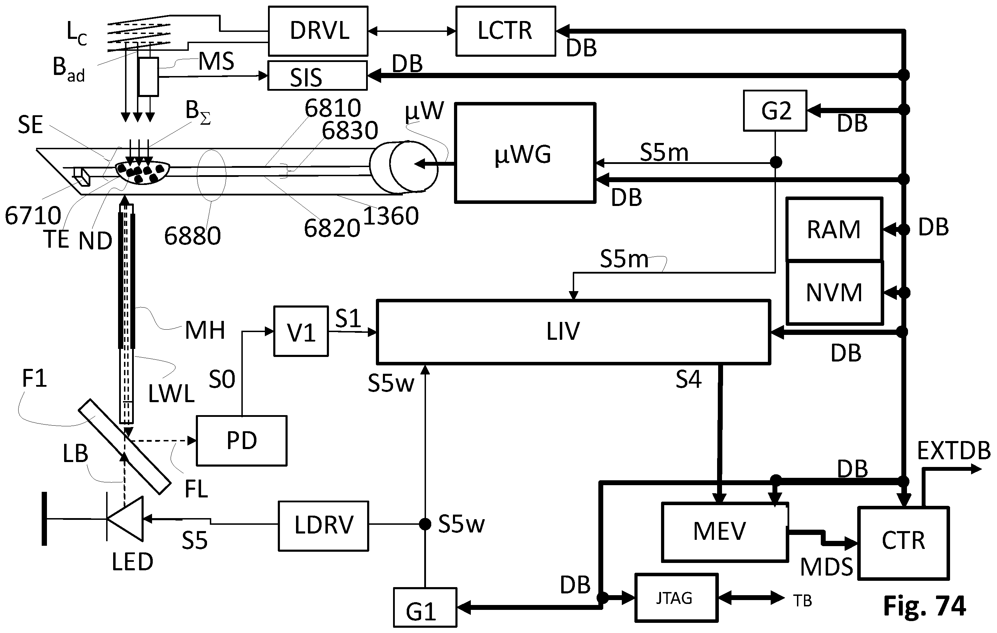

Die Figur 74 entspricht der Figur 69, wobei die Tri-Plate-Leitung **2380** durch eine differentielle Mikrostreifenleitung **6880** ersetzt ist.

Das hier vorgelegte Dokument weist darauf hin, dass insgesamt fünf Positionierungen von Sensorelementen **SE** relativ zu den Leitungen und Leitungsflächen der differentielle Mikrostreifenleitung **6880** möglich sind:
1. auf der elektrisch im Wesentlichen nicht-leitenden linken Isolationsfläche **1340,**
2. auf dem linken Signalleiter **6810** des differentiellen Signalleiters **6830,**
3. in der elektrisch isolierenden Lücke **6840** zwischen dem linken Signalleiter **6810** und dem rechten Signalleiter **6820** des differentiellen Signalleiters **6830.**
4. auf dem rechten Signalleiter **6820** des differentiellen Signalleiters **6830,**
5. auf der elektrisch im Wesentlichen nicht-leitenden rechten Isolationsfläche **1350.**

Mischformen durch Fehlplatzierungen und Vergrößerungen der betreffenden Sensorelemente **SE** sind möglich. Hieraus ergeben sich 2⁵ =32 mögliche Platzierungskombinationen an den verschiedenen 3 Sensorelementpositionen, die hiermit alle für eine fachkundige Person offenbart sind.

### Figur 75

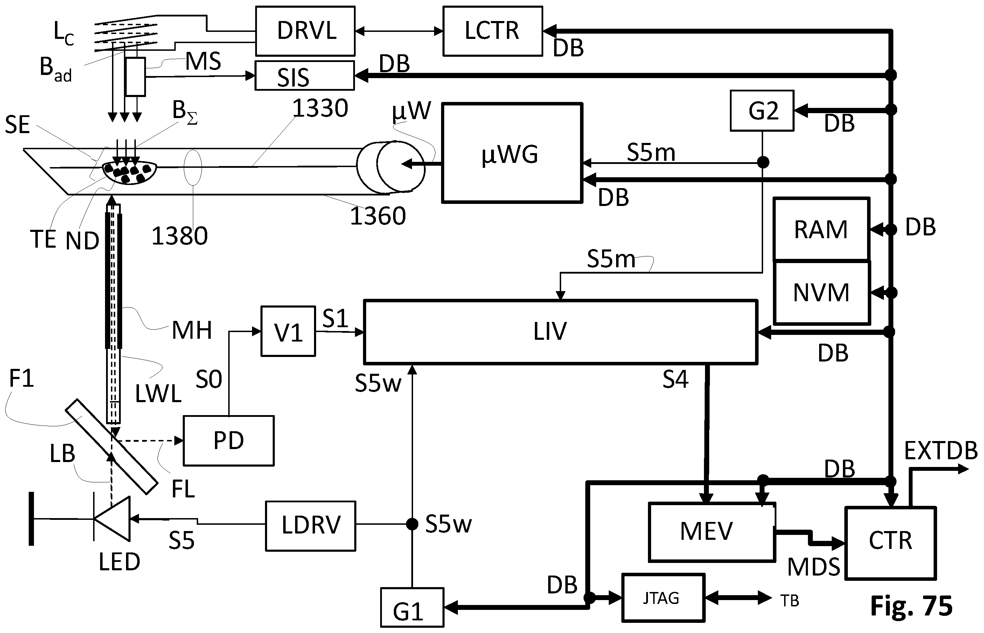

Die Figur 75 entspricht der Figur 69, wobei die Tri-Plate-Leitung **2380** durch eine Mikrostreifenleitung **1380** ersetzt ist.

Das hier vorgelegte Dokument weist darauf hin, dass insgesamt drei Positionierungen von Sensorelementen **SE** relativ zu den Leitungen und Leitungsflächen der Mikrostreifenleitung **1380** möglich sind:
1. auf der elektrisch im Wesentlichen nicht-leitenden linken Isolationsfläche **1340,**
2. auf dem linken Signalleiter **1330,**
3. auf der elektrisch im Wesentlichen nicht-leitenden rechten Isolationsfläche **1350.**

Mischformen durch Fehlplatzierungen und Vergrößerungen der betreffenden Sensorelemente **SE** sind möglich. Hieraus ergeben sich 2³ =8 mögliche Platzierungskombinationen an den verschiedenen 3 Sensorelementpositionen, die hiermit alle für eine fachkundige Person offenbart sind.

### Figur 76

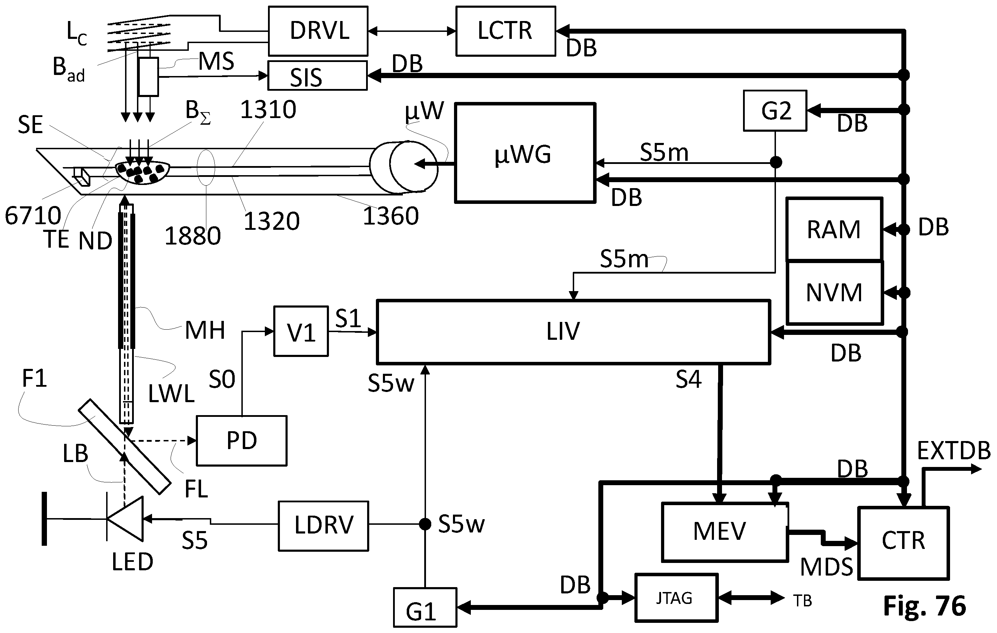

Die Figur 76 entspricht der Figur 69, wobei die Tri-Plate-Leitung **2380** durch eine Schlitzleitung **1880** ersetzt ist. Das hier vorgelegte Dokument weist darauf hin, dass insgesamt drei Positionierungen von Sensorelementen **SE** relativ zu den Leitungen und Leitungsflächen der Schlitzleitung **1880** möglich sind:
1. auf der elektrisch leitenden linken Signalmassefläche **1310,**
2. im Schlitz **1840** der Schlitzleitung **1880**
3. auf der elektrisch leitenden rechten Signalmassefläche **1320.**

Mischformen durch Fehlplatzierungen und Vergrößerungen der betreffenden Sensorelemente **SE** sind möglich. Hieraus ergeben sich 2³ =8 mögliche Platzierungskombinationen an den verschiedenen 3 Sensorelementpositionen, die hiermit alle für eine fachkundige Person offenbart sind.

### Figur 77

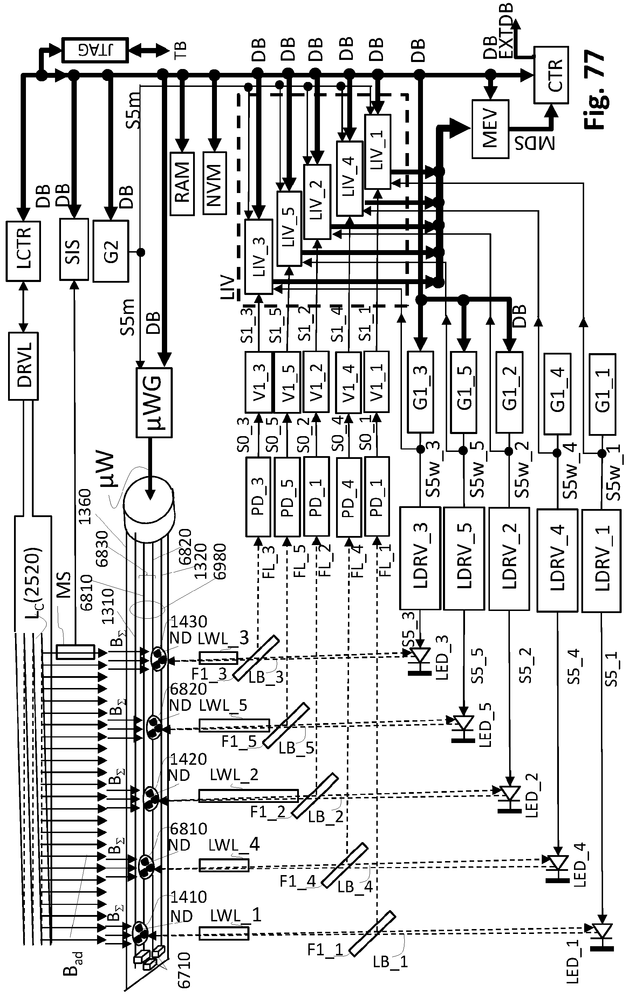

Die Figur 77 entspricht der Figur 71 mit dem Unterschied, dass die Wellenleitung statt einer Tri-Plate-Leitung **2380** eine differenzielle Tri-Plate-Leitung **6830** ist. Da die differenzielle Triplate-Leitung **2380** sieben mögliche Positionierungen von Sensorelementen **SE** ermöglicht und zwar:
1. auf der elektrisch leitenden linken Signalmassefläche **1310;**
2. in der elektrisch im Wesentlichen nicht-leitenden linken Isolationslücke **2340,**
3. auf dem linken Signalleiter **6810** des differentiellen Signalleiters **6830,**
4. in der elektrisch isolierenden Lücke **6840** zwischen dem linken Signalleiter **6810** und dem rechten Signalleiter **6820** des differentiellen Signalleiters **6830.**
5. auf dem rechten Signalleiter **6820** des differentiellen Signalleiters **6830,**
6. in der elektrisch im Wesentlichen nicht-leitenden rechten Isolationslücke **2350,**
7. auf der elektrisch leitenden rechten Signalmassefläche **1320;**

Hier umfasst die Vorrichtung der Figur 77 nur fünf der sieben möglichen Sensorkanäle. Die Platzierungen auf der elektrisch leitenden rechten Signalmassefläche **1320** und auf der elektrisch leitenden linken Signalmassefläche **1310** vernachlässigt das hier vorgelegte Dokument, da der zusätzliche Aufwand in der Regel den Informationsgewinn nicht rechtfertigt. Eine fachkundige Person kann diese zwei fehlenden Sensorelemente SE und die zugehörigen Sensorelementkanäle sich dazu denken, da deren Einbindung in das System der Figur 77 in analoger Weise wie die Einbindung der anderen Sensorelemente **SE(1410, 1420, 1430, 6810, 6820)** und deren zugehöriger Sensorelementkanäle erfolgt, die bereits Figur 77 zeigt. Alle Sensorelemente **SE(1410, 1420, 1430, 6810, 6820)** werden mit der im Wesentlichen gleichen, zusätzlichen magnetischen Flussdichte **B_{ad}** des Magnetfelderzeugungsmittels **L_{C}** durchflutet. In dem Beispiel der Figur 77 sind die Sensorelemente vorzugsweise an verschiedenen Positionen auf der differenziellen Tri-Plate-Leitung **6980** positioniert. Wie zuvor können Sensorelemente **SE** und die zugehörigen Sensorkanäle weggelassen werden.

Die Funktion der Sensorelementkanäle ist in der Beschreibung der Figur 71 beschrieben.

Die vektorielle Filterausgangssignal **S4** umfasst die vektoriellen Filterausgangssignale **(S4_1, S4_2, S4_3, S4_4, S4_5)** der Mehrfachkorrelatoren **(LIV_1, LIV_2, LIV_3, LIV_4, LIV_5).**

Die Steuervorrichtung **CTR** und/oder die Mustererkennungsvorrichtung **MEV** werden das vektorielle Filterausgangssignal **S4** vorzugsweise aus. Typischerweise emulieren die Steuervorrichtung **CTR** und/oder die Mustererkennungsvorrichtung **MEV** einige Vorrichtungsteile der Sensorelementkanäle.

Es ist oft zweckmäßig, wenn die Steuervorrichtung **CTR** auch die Mustererkennungsvorrichtung **MEV** ganz oder in Teilen beispielsweise mittels eines computerimplementierten Verfahren emuliert.

Hieraus ergeben sich 2⁷ = 128 mögliche Platzierungskombinationen an den verschiedenen 3 Sensorelementpositionen, die hiermit alle für eine fachkundige Person offenbart sind.

### Figur 78

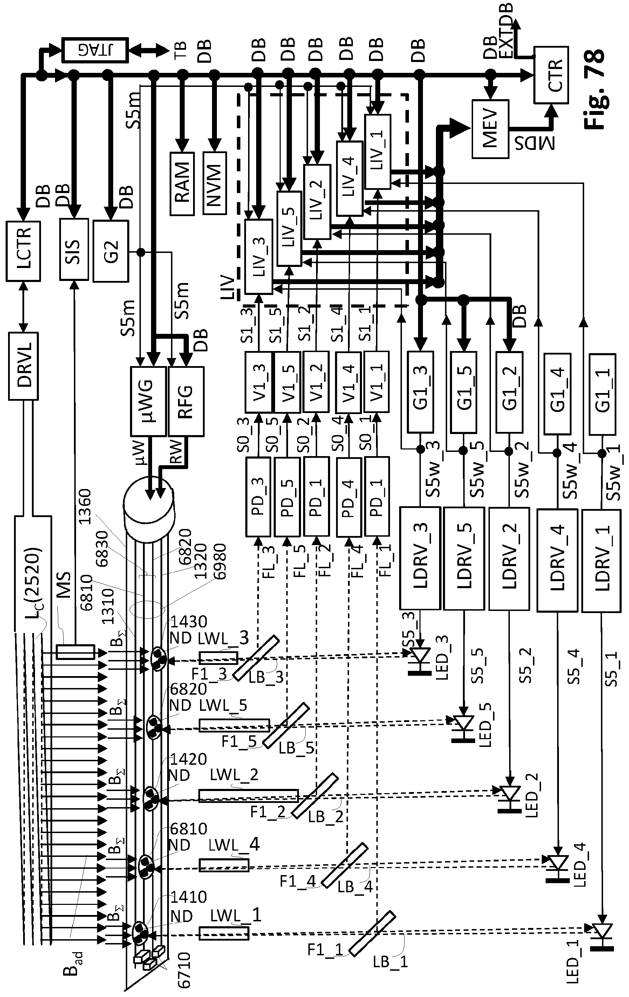

Die Figur 78 entspricht der Figur 71 mit dem Unterschied, dass die Wellenleitung statt einer Tri-Plate-Leitung **2380** eine differenzielle Tri-Plate-Leitung **6830** ist und dass die Vorrichtung der Figur 78 für die Ansteuerung eine Mikrowellensignalquelle **µWG** und eine Radiowellensignalquelle **RFG** verwendet. Die differenzielle Triplate-Leitung **6980** ermöglicht wie zuvor wieder sieben mögliche Positionierungen von Sensorelementen **SE** und zwar:
1. auf der elektrisch leitenden linken Signalmassefläche **1310,**
2. in der elektrisch im Wesentlichen nicht-leitenden linken Isolationslücke **2340,**
3. auf dem linken Signalleiter **6810** des differentiellen Signalleiters **6830,**
4. in der elektrisch isolierenden Lücke **6840** zwischen dem linken Signalleiter **6810** und dem rechten Signalleiter **6820** des differentiellen Signalleiters **6830.**
5. auf dem rechten Signalleiter **6820** des differentiellen Signalleiters **6830,**
6. in der im Wesentlichen elektrisch nicht-leitenden rechten Isolationslücke **2350,**
7. auf der elektrisch leitenden rechten Signalmassefläche **1320.**
wieder umfasst die Vorrichtung der Figur 78 nun fünf Sensorkanäle. Die Platzierungen auf der elektrisch leitenden rechten Signalmassefläche **1320** und auf der elektrisch leitenden linken Signalmassefläche **1310** vernachlässigt das hier vorgelegte Dokument, da der zusätzliche Aufwand in der Regel den Informationsgewinn nicht rechtfertigt. Eine fachkundige Person kann diese zwei fehlenden Sensorelemente **SE** und die zugehörigen Sensorelementkanäle sich dazu denken, da deren Einbindung in das System der Figur 78 in analoger Weise wie die Einbindung der anderen Sensorelemente **SE(1410, 1420, 1430, 6810, 6820)** und deren zugehöriger Sensorelementkanäle erfolgt, die bereits Figur 78 zeigt. Alle Sensorelemente **SE(1410, 1420, 1430, 6810, 6820)** werden mit der im Wesentlichen gleichen, zusätzlichen magnetischen Flussdichte **B_{ad}** des Magnetfelderzeugungsmittels **L_{C}** durchflutet. In dem Beispiel der Figur 77 sind die Sensorelemente vorzugsweise an verschiedenen Positionen auf der differenziellen Tri-Plate-Leitung **6980** positioniert. Wie zuvor können Sensorelemente **SE** und die zugehörigen Sensorkanäle weggelassen werden. Die Funktion der Sensorelementkanäle ist die in der Beschreibung der Figur 71 beschrieben.

Hieraus ergeben sich 2⁷ =128 mögliche Platzierungskombinationen an den verschiedenen 3 Sensorelementpositionen, die hiermit alle für eine fachkundige Person offenbart sind.

Die vektorielle Filterausgangssignal **S4** umfasst die vektoriellen Filterausgangssignale **(S4_1, S4_2, S4_3, S4_4, S4_5)** der Mehrfachkorrelatoren **(LIV_1, LIV_2, LIV_3, LIV_4, LIV_5).**

Die Steuervorrichtung **CTR** und/oder die Mustererkennungsvorrichtung **MEV** werden das vektorielle Filterausgangssignal **S4** vorzugsweise aus. Typischerweise emulieren die Steuervorrichtung **CTR** und/oder die Mustererkennungsvorrichtung **MEV** einige Vorrichtungsteile der Sensorelementkanäle.

Es ist oft zweckmäßig, wenn die Steuervorrichtung **CTR** auch die Mustererkennungsvorrichtung **MEV** ganz oder in Teilen beispielsweise mittels eines computerimplementierten Verfahren emuliert.

Das Besondere ist nun, dass in dem hier dargestellten Beispiel die Mikrowellensignalquelle **µWG** das von ihr erzeugte Mikrowellensignal **µW** nicht beide Signalleitungen **6810** und **6820** der differentiellen Signalleitung **6830** der Mikrostreifenleitung **6830** der beispielhaften differentiellen Tri-Plate-Leitung **6980** einspeist, sondern nur in eine der beiden Signalleitungen **6810** und **6820** der differentiellen Signalleitung **6830** der Mikrostreifenleitung **6830** der beispielhaften differentiellen Tri-Plate-Leitung **6980.** Zur Erläuterung soll die Mikrowellensignalquelle **µWG** bevorzugt das von ihr erzeugte Mikrowellensignal **µW** in die linke Signalleitung **6810** der differentiellen Signalleitung **6830** der Mikrostreifenleitung **6830** der beispielhaften differentiellen TriPlate-Leitung **6980** in dem Beispiel der Figur 78 beispielhaft einspeisen.

Die Mikrowellenquelle **µWG** erzeugt das Mikrowellensignal **µW.** Vorzugsweise steuert die Steuervorrichtung **CTR** die Erzeugung des Mikrowellensignals **µW** durch die Mikrowellenquelle **µWG** mittels Datenbotschaften über den Datenbus **DB** an die Mikrowellenquelle **µWG.** Die Steuervorrichtung **CTR** überprüft vorzugsweise den Status der Mikrowellensignalquelle **µWG** mittels Datenabfragen über den Datenbus **DB.** Ein zweiter Signalgenerator **G2** erzeugt typischerweise ein Mikrowellenmodulationssignal **S5m.** Vorzugsweise steuert die Steuervorrichtung **CTR** die Erzeugung des Mikrowellenmodulationssignals **S5m** durch den zweiten Signalgenerator **G2** mittels Datenbotschaften über den Datenbus **DB** an den zweien Signalgenerator **G2.** Typischerweise überprüft die Steuervorrichtung **CTR** den Status des zweiten Signalgenerators **G2** mittels Datenabfragen über den Datenbus **DB.** Das Mikrowellenmodulationssignal **S5m** moduliert bevorzugt die Amplitude des Radiowellensignals **µW** der Mikrowellenquelle **µW.** Typischerweise ist das Radiowellenmodulationssignal **S5m** ein digitales Signal mit einem ersten logischen Pegel und einem zweiten logischen Pegel, der vom ersten logischen Pegel verschieden ist. Beispielsweise steuert der zweite Signalgenerator **G2** mittels des Mikrowellenmodulationssignals **S5m** die Amplitude des Mikrowellensignals **µW,** das die Mikrowellensignalquelle **µWG** erzeugt.

Beispielsweise kann die Vorrichtung so konstruiert sein, dass die Mikrowellensignalquelle **µWG** ein Mikrowellensignal **µW** mit einer vorgegebenen Minimalamplitude erzeugt, wenn das Mikrowellenmodulationssignal **S5m** den ersten logischen Wert annimmt.

Beispielsweise kann die Vorrichtung so konstruiert sein, dass die Mikrowellensignalquelle **µWG** ein Mikrowellensignal **RµW** mit einer vorgegebenen Maximalamplitude erzeugt, wenn das Mikrowellenmodulationssignal **S5m** den zweiten logischen Wert annimmt.

Die Steuerung der Mikrowellensignalquelle **µWG** durch das Mikrowellenmodulationssignal **S5m** kann auch schaltend erfolgen:
Beispielsweise kann die Vorrichtung so konstruiert sein, dass die Mikrowellensignalquelle **µWG** das Mikrowellensignal **µW** abschaltet, wenn das Mikrowellenmodulationssignal **S5m** den ersten logischen Wert annimmt.

Beispielsweise kann die Vorrichtung so konstruiert sein, dass die Mikrowellensignalquelle **µWG** ein Mikrowellensignal **µW** mit der vorgegebenen Maximalamplitude erzeugt, wenn das Mikrowellenmodulationssignal **S5m** den zweiten logischen Wert annimmt.

Die Radiowellenquelle **RFG** erzeugt das Radiowellensignal **RW.** Vorzugsweise steuert die Steuervorrichtung **CTR** die Erzeugung des Radiowellensignals **RW** durch die Radiowellenquelle **RFG** mittels Datenbotschaften über den Datenbus **DB** an die Radiowellenquelle **RFG.** Die Steuervorrichtung **CTR** überprüft vorzugsweise den Status der Radiowellensignalquelle **RFG** mittels Datenabfragen über den Datenbus **DB.** Ein dritter Signalgenerator **G3** erzeugt typischerweise ein Radiowellenmodulationssignal **S5r.** Vorzugsweise steuert die Steuervorrichtung **CTR** die Erzeugung des Radiowellenmodulationssignals **S5r** durch den dritter Signalgenerator **G3** mittels Datenbotschaften über den Datenbus **DB** an den dritten Signalgenerator **G3.** Typischerweise überprüft die Steuervorrichtung **CTR** den Status des dritten Signalgenerator **G3** mittels Datenabfragen über den Datenbus **DB.** Das Radiowellenmodulationssignal **S5r** moduliert bevorzugt die Amplitude des Radiowellensignals **RW** der Radiowellenquelle **RW.** Typischerweise ist das Radiowellenmodulationssignal **S5r** ein digitales Signal mit einem ersten logischen Pegel und einem zweiten logischen Pegel, der vom ersten logischen Pegel verschieden ist. Beispielsweise steuert der dritte Signalgenerator **G3** mittels des Radiowellenmodulationssignals **S5r** die Amplitude des Radiowellensignals **RW,** das die Radiowellensignalquelle **RFG** erzeugt.

Beispielsweise kann die Vorrichtung so konstruiert sein, dass die Radiowellensignalquelle **RFG** ein Radiowellensignal **RW** mit einer vorgegebenen Minimalamplitude erzeugt, wenn das Radiowellenmodulationssignal **S5r** den ersten logischen Wert annimmt.

Beispielsweise kann die Vorrichtung so konstruiert sein, dass die Radiowellensignalquelle **RFG** ein Radiowellensignal **RW** mit einer vorgegebenen Maximalamplitude erzeugt, wenn das Radiowellenmodulationssignal **S5r** den zweiten logischen Wert annimmt.

Die Steuerung der Radiowellensignalquelle **RFG** durch das Radiowellenmodulationssignal **S5r** kann auch schaltend erfolgen:
Beispielsweise kann die Vorrichtung so konstruiert sein, dass die Radiowellensignalquelle **RFG** das Radiowellensignal **RW** abschaltet, wenn das Radiowellenmodulationssignal **S5r** den ersten logischen Wert annimmt.

Beispielsweise kann die Vorrichtung so konstruiert sein, dass die Radiowellensignalquelle **RFG** ein Radiowellensignal **RW** mit der vorgegebenen Maximalamplitude erzeugt, wenn das Radiowellenmodulationssignal **S5r** den zweiten logischen Wert annimmt.

Vorzugsweise ist das Radiowellenmodulationssignal **RW** mit einer Radiowellenmodulationsfrequenz **f_{RWm}** moduliert. Vorzugsweise ist die Radiowellenmodulationsfrequenz **f_{RWm}** von den anderen Modulationsfrequenzen der Vorrichtung, wie zuvor erläutert, verschieden. Bevorzugt fügt sich die Radiowellenmodulationsfrequenz **f_{RWm}** in das 2ⁿ-Schema der Modulationsfrequenzen der Vorrichtung ein, dass sicherstellt, dass keine der Mischfrequenzen der Modulationsfrequenzen gleich oder ähnlich sind.

Die beispielhafte Vorrichtung der Figur 78 verwendet zur Vereinfachung der Darstellung das Mikrowellenmodulationssignal **S5m** als Radiowellenmodulationssignal **S5r** und den zweiten Signalgenerator **G2** als dritten Signalgenerator **G3.**

Das Besondere ist nun, dass in dem hier dargestellten Beispiel die Radiowellensignalquelle **RFG** das von ihr erzeugte Radiowellensignal **RW** nicht beide Signalleitungen **6810** und **6820** der differentiellen Signalleitung **6830** der Mikrostreifenleitung **6830** der beispielhaften differentiellen Tri-Plate-Leitung **6980** einspeist, sondern nur in eine beiden Signalleitungen **6810** und **6820** der differentiellen Signalleitung **6830** der Mikrostreifenleitung **6830** der beispielhaften differentiellen Tri-Plate-Leitung **6980** und zwar bevorzugt nun in die andere der beiden Signalleitungen **6810** und **6820** der differentiellen Signalleitung **6830** der Mikrostreifenleitung **6830** der beispielhaften differentiellen Tri-Plate-Leitung **6980.** Zur Erläuterung soll die Radiowellensignalquelle **RFG** bevorzugt das von ihr erzeugte Radiowellensignal **RW** nun in die rechte Signalleitung **6820** der differentiellen Signalleitung **6830** der Mikrostreifenleitung **6830** der beispielhaften differentiellen Tri-Plate-Leitung **6980** in dem Beispiel der Figur 78 beispielhaft einspeisen.

Dies hat den Vorteil, dass kein Mischer **MIX** für die Mischung des Radiowellensignals **RW** mit dem Mikrowellensignal **µW** zu einem Radiowellen-Mikrowellen-Mischsignal **RWµW** mehr notwendig ist.

Die Verwendung von Radiowellen hat den Vorteil, dass auch Resonanzen, die durch die Wechselwirkung der paramagnetischen Zentren mit nuklearen Atomkernen von Isotopen, die ein magnetisches Moment aufweisen und sich im Material der Diamant-Nano-Kristalle **ND** bzw. der funktionsgleich verwendeten Kristalle im Sensorelement **SE** befinden, angeregt werden können und ggf. beobachtet werden können.

Die Grundidee der Figur 78 ist also die beiden Signalleitungen **6810** und **6820** der differenziellen Signalleitung **6830** der differenziellen Mikrostreifenleitung **6880** der differentiellen Tri-Plate-Leitung **6980** für unterschiedliche Funktionen zu nutzen. Eine Signalleitung der differenziellen Signalleitung **6830** der differenziellen Mikrostreifenleitung **6880** der differentiellen Tri-Plate-Leitung **6980** für die Anregung der Resonanzen zwischen dem nuklearen Atomkern von Isotopen mit magnetischen Momenten im Material der Diamant-Nano-Kristalle **ND** bzw. im Material der funktionsäquivalenten Kristalle, die sich jeweils in den Sensorelementen **SE** befinden, einerseits und den paramagnetischen Zentren, also beispielsweise NV-Zentren, in diesen Diamant-Nano-Kristalle **ND** bzw. diesen funktionsäquivalenten Kristallen andererseits.

### Figur 79

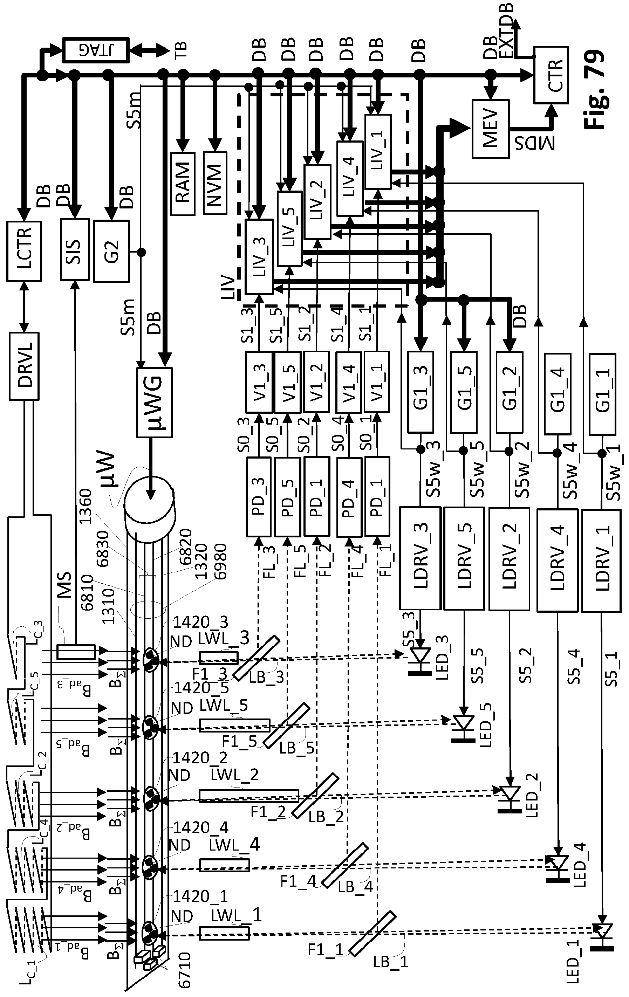

Die Figur 79 entspricht der Figur 77, wobei nun zum Ersten entlang der differentiellen Tri-Plate-Leitung beispielhaft fünf mittlere Sensorelemente **1420** angeordnet sind, denen jeweils ein Sensorelementkanal zugeordnet ist. Zum Zweiten umfasst die Vorrichtung der Figur 79 nun mehrere Magnetfelderzeugungsmittel **(L_{c}_1, L_{c}_2, L_{c}_3, L_{c}_4, L_{c}_5).** Diese Magnetfelderzeugungsmittel erzeugen jeweils eine jeweilige zusätzliche magnetische Flussdichte **(B_{ad}_1, B_{ad}_2, B_{ad}_3, B_{ad}_4, B_{ad}_5),** die vorzugsweise jeweils ein dem jeweiligen Magnetfelderzeugungsmittel **(L_{c}_1, L_{c}_2, L_{c}_3, L_{c}_4, L_{c}_5)** zugeordnetes Sensorelement **(1420_1, 1420_2, 1420_3, 1420_4, 1420_5)** zugeordnet ist.

Diese zusätzlichen magnetischen Flussdichten **(B_{ad}_1, B_{ad}_2, B_{ad}_3, B_{ad}_4, B_{ad}_5)** definieren in der Figur 51b jeweils eine horizontale Linie, auf der der Arbeitspunkt des zugeordneten Sensorelements **(1420_1, 1420_2, 1420_3, 1420_4, 1420_5)** liegen muss. Im Beispiel der Figur 79 weisen sie Spulen der Magnetfelserzeugungsmittel (L_{c}_1, L_{c}_2, L_{c}_3, **L_{c}_4, L_{c}_5)** unterschiedliche Windungszahlen auf und sind in Serie geschaltet. Sie definieren daher in der Figur 51b beispielhaft fünf dieser horizontalen Linien, auf denen die jeweiligen Arbeitspunkte der beispielhaft fünf Sensorelements **(1420_1, 1420_2, 1420_3, 1420_4, 1420_5)** liegen müssen, wobei jeder dieser Linien genau ein Sensorelement **(1420_1, 1420_2, 1420_3, 1420_4, 1420_5)** zugeordnet ist.

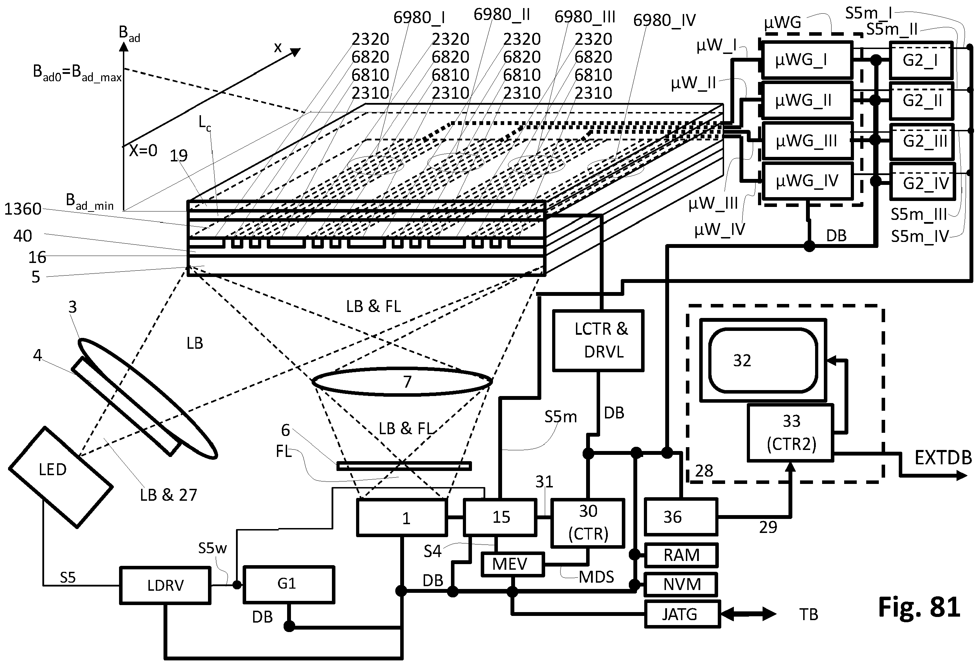

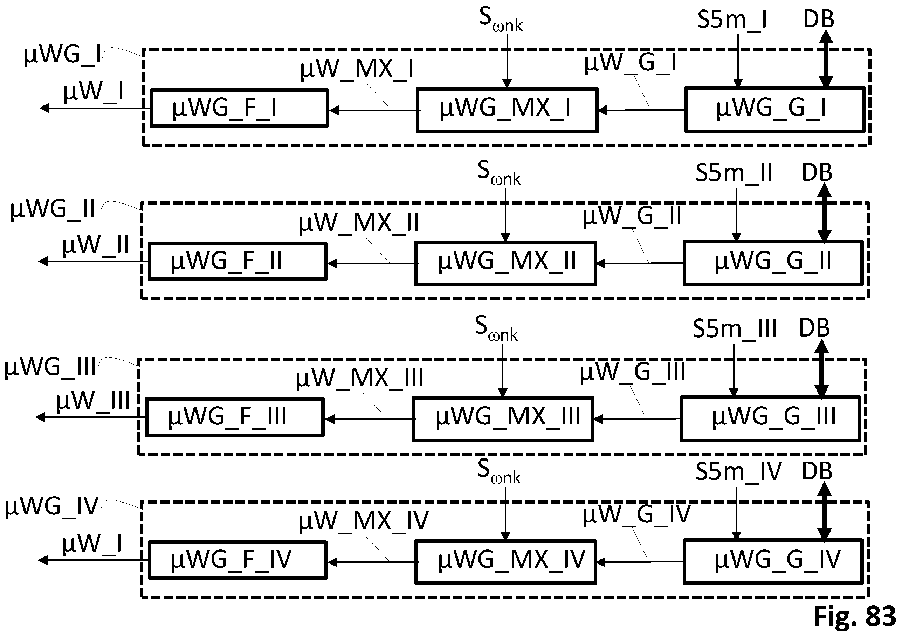

Die Vorgaben jeweils einer Mikrowellenfrequenzen (ω_{µW_I}, ω_{µW_I}, ω_{µW_I}, ω_{µW_IV}) der jeweiligen Mikrowellensignale **(µW_I, µW_II, µW_III, µW_IV)** der Figuren 81 und 83 definieren jeweils eine senkrechte Linie in der Figur 51b. Die fünf Kreuzungspunkte der horizontalen Linien und der so definierten senkrechten Linie ergeben für die jeweils zugeordneten Sensorelemente **(1420_1, 1420_2, 1420_3, 1420_4, 1420_5)** deren Arbeitspunkte. Es ist intuitiv sofort offensichtlich, dass auf diese Weise die Steuervorrichtung CTR einen oder mehrere der folgenden Werte bereits bei der ersten Messung grob ermitteln kann.
1. die wahrscheinliche Lage der unteren Resonanzkante 5**22**,
2. die wahrscheinliche Lage der unteren mittleren Resonanzkante 5**23**,
3. die wahrscheinliche Lage der oberen mittleren Resonanzkante 5**24**,
4. die wahrscheinliche Lage der oberen Resonanzkante 5**25**,
5. die wahrscheinliche Lage des mittleren Resonanzminimums 5**29**,
6. den wahrscheinlichen Wert der wirksamen Offsetflussdichte **B_{off},**
7. den wahrscheinlichen Wert der Nullpunktsflussdichte **B₀,**
8. den wahrscheinlichen Wert der Nullpunktsmikrowellenfrequenz ω_{µW0},
Nach weiteren Messungen kann die Steuervorrichtung **CTR** auch hier auf einen oder mehrere der folgenden Werte schließen:
9. den wahrscheinlichen Wert **564** der magnetischen Flussdichte B, der der oberen Referenzlinie **561** zugeordnet ist, an einem oder mehreren Arbeitspunkten,
10. den wahrscheinlichen Wert **565** der magnetischen Flussdichte B, der der unteren Referenzlinie **562** zugeordnet ist, an einem oder mehreren Arbeitspunkten,
11. die wahrscheinliche Differenz **566** des Werts der magnetischen Flussdichte B, der der mittleren Referenzlinie **563** zugeordnet ist, minus dem Wert **565** der magnetischen Flussdichte B, der der unteren Referenzlinie **562** zugeordnet ist,
12. die wahrscheinliche Steigung **567** der Kurve an einem oder mehreren Arbeitspunkten;
13. die Polynomkoeffizienten der Polynomapproximation **627** der Kurve in einigen Arbeitspunkten,
14. den wahrscheinlichen Wert einer unteren wirksamen magnetischen Flussdichte **B₂₂,**
15. den wahrscheinlichen Wert einer unteren mittleren wirksamen magnetischen Flussdichte **B₂₃,**
16. den wahrscheinlichen Wert einer oberen mittleren wirksamen magnetischen Flussdichte **B₂₄,**
17. den wahrscheinlichen Wert einer oberen wirksamen magnetischen Flussdichte **B₂₅,**
18. den wahrscheinlichen Wert einer wirksamen magnetische Resonanzminimum-Flussdichte **B₂₉,**
19. den wahrscheinlichen Wert einer Nullpunktsmikrowellenfrequenz ω_{µW0};
20. den wahrscheinlichen Wert einer unteren Mikrowellenfrequenz ω_{µW22};
21. den wahrscheinlichen Wert einer unteren mittleren Mikrowellenfrequenz ω_{µW23};
22. den wahrscheinlichen Wert einer oberen mittleren Mikrowellenfrequenz ω_{µW24};
23. den wahrscheinlichen Wert einer oberen Mikrowellenfrequenz ω_{µW25};
24. den wahrscheinlichen Wert einer Resonanzminimum-Mikrowellenfrequenz ω_{µW29};
25. den wahrscheinlichen Wert einer unbekannten Mikrowellenfrequenz ω_{µW2}
26. den wahrscheinlichen Wert einer Mikrowellenmodulationsfrequenz **f**_{µW};

### Figur 80

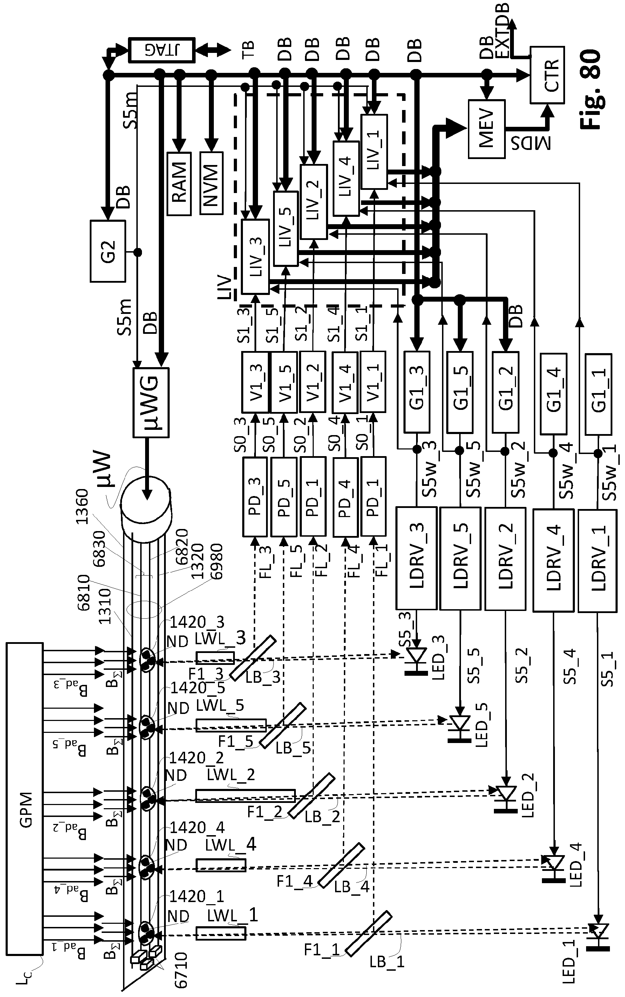

Figur 80 entspricht der Figur 79 mit dem Unterschied, dass ein Gradienten behafteter Permanentmagnet **GPM** als Magnetfelserzeugungsmittel **L_{c}** die unterschiedlichen zusätzlichen magnetischen Flussdichten **(B_{ad}_1, B_{ad}_2, B_{ad}_3, B_{ad}_4, B_{ad}_5)** erzeugt. Auch hier kann die Erzeugung der zusätzlichen magnetischen Flussdichten wieder so aussehen, dass beispielsweise gilt:$\left|{B}_{ad _}1\right| > \left|{B}_{ad _}2\right| > \left|{B}_{ad _}3\right| > \left|{B}_{ad _}4\right| > \left|{B}_{ad _}5\right| .$

Nachteil ist, dass eine Verstellung der magnetischen Gesamtflussdichte **B_{Σ}** dann nur mit dem Gradienten behafteter Permanentmagnet **GPM** alleine nicht mehr möglich ist. Daher ist es sinnvoll, in dem Fall ein zusätzliches Magnetfelserzeugungsmittel **L_{c}** zusätzlich zum Gradienten behafteten Permanentmagneten **GPM** vorzusehen.

Es wird hier offensichtlich, dass eine Auflösung mit nur 5 Sensorelementkanälen unzureichend ist.

### Figur 81

Figur 81 zeigt als konsequente Weiterentwicklung der Verwendung mehrerer mehr oder weniger punktförmiger Sensorelemente **SE** die Verwendung linienhafter und/oder flächenhafter Sensorelementschichten **5** als ein feingranulares ausgedehntes Sensorelement **SE.** Damit dies möglich ist, ist vorzugsweise die Sensorelementschicht **5** dünner als die kleinste Strukturgröße des zu vermessenden Wellenleiters **(1380, 2380, 6830, 6980)** gefertigt. Als Strukturgröße gelten hierbei die Breiten der Signalleitungen **(1330, 6830,6810, 6820)** der betreffenden Wellenleiter **(1380, 2380, 6830, 6980)** und deren Abstände zueinander und zu Masseflächen **(2310, 2320)** der betreffenden Wellenleiter **(2380, 1880, 6980).** Das in der Figur 81 dargestellte Prinzip kann für verschiedene Wellenleiter **(1380, 2380, 6830, 6980)** angewendet werden. Vorzugsweise sind die Wellenleiter **(1380, 2380, 6830, 6980)** planare Wellenleiter. Exemplarisch behandelt die hier vorgelegte Schrift Mikrostreifenleitungen **1380,** Schlitzleitungen **1880,** Tri-Plate-Leitungen **2380,** differenzielle Mikrostreifenleitungen **6830** und differenzielle Tri-Plate-Leitungen **6980.** Die technische Lehre des hier vorgelegten Dokuments ist aber ausdrücklich nicht auf diese Wellenleitungstypen begrenzt. Vorzugsweise weist die linienhafte und/oder flächenhafte Sensorelementschicht **5** alle Merkmale eines Sensorelements **SE,** die in diesem Dokument bereits mehrfach beschreiben wurden, auf. Die Idee ist also, statt mit diskreten Sensorelementen **SE** mit einer kontinuierlich und linienhaften und/oder flächenhaften, typischerweise im Wesentlichen homogen gefertigten Sensorelementschicht **5** als Sensorelement **SE** die Messungen der magnetischen Gesamtflussdichte **B_{Σ}** und/oder der unbekannten Mikrowellenfrequenz ωₙₖ eines externen Mikrowellensignals **S_{ωnk}** vorzunehmen, die auf die Sensorelementschicht **5** einwirken.

Eine Verwendung einer linienhaften Sensorelementschicht **5** als Sensorelement **SE** kann durch eine Verbindung der Sensorelemente beispielsweise der Figuren 72, 54 bis 57 erhalten werden. Grundsätzlich kann zum Ersten ein linienhaftes Sensorelement **SE(5)** quer zur Richtung eines Wellenleiters **(1380, 1880, 2380, 6830, 6980)** angeordnet sein. Grundsätzlich kann zum Zweiten ein linienhaftes Sensorelement **SE(5)** parallel zur Richtung eines Wellenleiters **(1380, 1880, 2380, 6830, 6980)** angeordnet sein und dabei, wenn es schmaler als der Abstand der Signalleitungen **(1330, 6810, 6820)** und kleiner als die Breite der ggf. vorhandenen nicht-leitenden linken Isolationslücke **2340** und der ggf. vorhandenen nicht-leitenden rechten Isolationslücke **2350** ist, mehrere Positionen relativ zu diesen Strukturen des jeweiligen Wellenleiters **(1380, 1880, 2380, 6830, 6980)** einnehmen. In dem Fall kann somit das parallel zum jeweiligen Wellenleiter **(1380, 1880, 2380, 6830, 6980)** angeordnete linienhafte Sensorelement **SE(5)** verschiedene Positionen relativ zum Wellenleiter**(1380, 1880, 2380, 6830, 6980)** annehmen. Ist das linienhafte Sensorelement **SE(5)** jedoch in diesen Fällen breiter, so kommt dies dem Vorhandensein verschiedener idealer linienhafter Sensorelemente **SE(5)** direkt benachbart und parallel zueinander gleich. Eine Kamera kann die Intensität **Iᵢₛₜ** der Fluoreszenzstrahlung **FL** dieser verbreiterten linienhaften Sensorelemente **SE(5)** beobachten und eine nachfolgende Aufbereitungsvorrichtung **30** bzw. eine Steuervorrichtung **CTR, CTR2** können diese Signale der Intensität der Fluoreszenzstrahlung **FL** dieser linienhaften Sensorelemente **SE(5)** in dem verbreiterten linienhaften Sensorelement **SE(5)** mittels computerimplementierten Bildverarbeitungsverfahren trennen und zugehörige Messwerte ermitteln Im Falle der Verbindung der Sensorelemente beispielsweise der Figuren 72, 54 bis 57 wäre die linienhafte Sensorelementschicht **5** beispielhaft quer zur Richtung des Wellenleiters angeordnet. Eine solche quer zum Wellenleiter **(1380, 2380, 1880, 6830, 6980)** angeordnete linienhafte Sensorelementschicht **5** bezeichnet daher das hier vorgelegte Dokument als querangeordnete linienhafte Sensorelementschicht **5.**

Soll das Magnetfelderzeugungsmittel **L_{C}** mehrere Magnetfelderzeugungsmittel **(L_{c}_1, L_{c}_2, L_{c}_3, L_{c}_4, L_{c}_5)** als Teilvorrichtungen des Magnetfelderzeugungsmittel **L_{C}** umfassen, die längs des Wellenleiters **(1380, 2380, 1880, 6830, 6980)** angeordnet sind, so kann bevorzugt eine linienhafte Sensorelementschicht **5** auch längs dieses Wellenleiters **(1380, 2380, 1880, 6830, 6980)** ausgeformt sein. Eine solche längs des Wellenleiters **(1380, 2380, 1880, 6830, 6980)** angeordnete linienhafte Sensorelementschicht **5** bezeichnet daher das hier vorgelegte Dokument als längsangeordnete linienhafte Sensorelementschicht **5,** die hier typischerweise eine Vielzahl von ineinander übergehenden Sensorelementen **SE** umfasst.

Zunächst nehmen wir an, dass die längsangeordnete linienhafte Sensorelementschicht **5.** so schmal ist, dass sie einer der im Folgenden für die zuvor bereits erwähnten verschiedenen beispielhaften Wellenleiter **(1380, 2380, 1880, 6830, 6980)** möglichen Positionen einnehmen kann. Für alternative, hier nicht aufgeführte, insbesondere planare, Wellenleiter gelten die analogen Positionen.

Hierzu diskutiert das hier vorgelegte Dokument beispielhaft die in dem hier vorgelegten Dokument bereits beispielhaft erwähnten Wellenleiter **(1380, 2380, 1880, 6830, 6980).**

Das hier vorgelegte Dokument weist darauf hin, dass insgesamt drei Positionierungen von längsangeordneten linienhaften Sensorelementschichten **5** relativ zu den Leitungen und Leitungsflächen der Mikrostreifenleitung **1380** möglich sind:
1. auf der elektrisch im Wesentlichen nicht-leitenden linken Isolationsfläche **1340,**
2. auf dem linken Signalleiter **1330,**
3. auf der elektrisch im Wesentlichen nicht-leitenden rechten Isolationsfläche **1350.**

Das hier vorgelegte Dokument weist darauf hin, dass insgesamt drei Positionierungen von längsangeordneten linienhaften Sensorelementschichten **5** relativ zu den Leitungen und Leitungsflächen der Schlitzleitung **1880** möglich sind:
1. auf der elektrisch leitenden linken Signalmassefläche **1310,im** Schlitz **1840** der Schlitzleitung **1880**
2. auf der elektrisch leitenden rechten Signalmassefläche **1320.**

Das hier vorgelegte Dokument weist darauf hin, dass insgesamt fünf Positionierungen von längsangeordneten linienhaften Sensorelementschichten **5** relativ zu den Leitungen und Leitungsflächen der Triplate-Leitung **2380** möglich sind:
1. auf der elektrisch leitenden linken Signalmassefläche **1310,**
2. in der elektrisch im Wesentlichen nicht-leitenden linken Isolationslücke **2340,**
3. auf dem Signalleiter **1330,**
4. in der elektrisch im Wesentlichen nicht-leitenden rechten Isolationslücke **2350**
5. auf der elektrisch leitenden rechten Signalmassefläche **1320.**

Das hier vorgelegte Dokument weist darauf hin, dass insgesamt fünf Positionierungen von längsangeordneten linienhaften Sensorelementschichten **5** relativ zu den Leitungen und Leitungsflächen der differentielle Mikrostreifenleitung **6880** möglich sind:
1. auf der elektrisch im Wesentlichen nicht-leitenden linken Isolationsfläche **1340,**
2. auf dem linken Signalleiter **6810** des differentiellen Signalleiters **6830,**
3. in der elektrisch isolierenden Lücke **6840** zwischen dem linken Signalleiter **6810** und dem rechten Signalleiter **6820** des differentiellen Signalleiters **6830.**
4. auf dem rechten Signalleiter **6820** des differentiellen Signalleiters **6830,**
5. auf der elektrisch im Wesentlichen nicht-leitenden rechten Isolationsfläche **1350.**

Das hier vorgelegte Dokument weist darauf hin, dass insgesamt sieben Positionierungen von längsangeordneten linienhaften Sensorelementschichten **5** relativ zu den Leitungen und Leitungsflächen differenzielle Triplate-Leitung **2380** möglich sind:
1. auf der elektrisch leitenden linken Signalmassefläche **1310,**
2. in der elektrisch im Wesentlichen nicht-leitenden linken Isolationslücke **2340,**
3. auf dem linken Signalleiter **6810** des differentiellen Signalleiters **6830,**
4. in der elektrisch isolierenden Lücke **6840** zwischen dem linken Signalleiter **6810** und dem rechten Signalleiter **6820** des differentiellen Signalleiters **6830.**
5. auf dem rechten Signalleiter **6820** des differentiellen Signalleiters **6830,**
6. in der elektrisch im Wesentlichen nicht-leitenden rechten Isolationslücke **2350,**
7. auf der elektrisch leitenden rechten Signalmassefläche **1320.**

Mischformen durch Fehlplatzierungen und Vergrößerungen (Verbreiterungen) der betreffenden längsangeordneten linienhaften Sensorelementschichten **5** sind möglich und von der Beanspruchung ausdrücklich umfasst. Die Wellenleiter **(1380, 2380, 1880, 6830, 6980)** können gerade oder nicht gerade auf dem Trägersubstrat **1360** ausgeformt sein. Die Breite der Wellenleiter **(1380, 2380, 1880, 6830, 6980)** kann längs der Sensorelementschicht **5** variieren, wobei die Variationsstellen der Breite der Wellenleiter **(1380, 2380, 1880, 6830, 6980)** bevorzugt so ausgeformt sind, dass keine Stoßstellen durch variierende Wellenwiederstände der jeweiligen Wellenleiter in Folge der Variation der Breite der Wellenleiter **(1380, 2380, 1880, 6830, 6980)** entstehen. Bevorzugt weichen die Breiten der Signalleitungen **(1330, 6810, 6820)** und die Abstände der Signalleitungen **(1380, 2380, 1880, 6830, 6980)** zueinander und die Breiten der ggf. vorhandenen nicht-leitenden linken Isolationslücken **2340** und der ggf. vorhandenen nicht-leitenden rechten Isolationslücken **2350** in einem ersten Bereich eines Wellenleiters **(1380, 2380, 1880, 6830, 6980),** der Sensorelemente **SE** aufweist und/oder ganz oder teilweise von einer Sensorelementschicht **5** bedeckt ist oder einer Sensorelementschicht **5** und/oder einem Sensorelement **SE** wechselwirkt, von den Breiten der Signalleitungen **(1330, 6810, 6820)** und den Abstände der Signalleitungen **(1380, 2380, 1880, 6830, 6980)** zueinander und den Breiten der ggf. vorhandenen nicht-leitenden linken Isolationslücken **2340** und der ggf. vorhandenen nicht-leitenden rechten Isolationslücken **2350** in einem zweiten Bereich eines Wellenleiters **(1380, 2380, 1880, 6830, 6980),** der keine Sensorelemente SE aufweist und der nicht ganz oder teilweise von einer Sensorelementschicht **5** bedeckt ist und nicht mit einer Sensorelementschicht **5** und/oder einem Sensorelement **SE** wechselwirkt, ab. Bevorzugt sind diese Abweichungen so gestaltet, dass der Wellenwiderstand des betreffenden Wellenleiters **(1380, 2380, 1880, 6830, 6980)** im ersten Bereich vom Wellenwiderstand des zweiten Bereichs betragsmäßig um nicht mehr als 25% besser, um nicht mehr als 10%, besser um nicht mehr als 5%, besser um nicht mehr als 2%, besser um nicht mehr als 1%, besser, um nicht mehr als 0,5% abweicht.

Das hier vorgelegte Dokument weist darauf hin, dass auch die Verwendung anderer, insbesondere planarer, Wellenleiter in funktionsäquivalenter Weise möglich ist.

Auch können Wellenleiter, Funktionselemente der Streifenleitungstechnologie, wie Kapazitäten, Induktivitäten, Abzweigungen, Knicke, Kurven, Zirkulatoren, Wellenkoppler, Phasenschieber, Dickschichtwiderstände, Dünnfilmtransistoren, MEMS-Schalter etc. aufweisen.

Werden nun zwei unmittelbar nebeneinander liegende längsangeordnete linienhaften Sensorelementschichten **5** verwendet, so können diese zwei oder mehr der oben aufgeführten Positionierungen gegenüber dem jeweiligen Wellenleiter gleichzeitig aufweisen.

Das hier vorgelegte Dokument bezeichnet eine solche Sensorelementschicht **5** dann als längsangeordnete flächenhafte Sensorelementschicht **5.** Werden nun mehrere unmittelbar nebeneinander liegende längsangeordnete linienhaften Sensorelementschichten **5** verwendet, die alle der oben aufgeführten Positionierungen gegenüber dem jeweiligen Wellenleiter gleichzeitig aufweisen, so bezeichnet das hier vorgelegte Dokument eine solche Sensorelementschicht **5** dann als flächenhafte Sensorelementschicht **5.** Vorzugsweise hängt dann der Betrag der zusätzlichen magnetischen Flussdichte **B_{ad},** die die flächenhafte Sensorelementschicht **5** durchflutet, von der Position längs des jeweiligen Wellenleiters ab.

Ganz besonders bevorzugt verwendet die vorgeschlagene Vorrichtung ein statisches Magnetfelderzeugungsmittel **19(L_{C}),** beispielsweise in Form eines Permanentmagneten **PM.** Bevorzugt umfasst die Vorrichtung einen Gradienten behafteten Permanentmagneten **GPM** als statisches Magnetfelserzeugungsmittel **19(Lc)** der eine zusätzliche magnetische Flussdichte **B_{ad}** erzeugt, die vorzugsweise von der Koordinate **x** längs der benutzten Wellenleiter **(1380, 2380, 1880, 6830, 6980, 6830_I, 6830_II, 6830_III, 6830_IV)** abhängt. Besonders bevorzugt ist diese Abhängigkeit der zusätzlichen magnetischen Flussdichte **B_{ad}** von der Koordinate **x** längs des betreffenden Wellenleiters **(1380, 2380, 1880, 6830, 6980, 6830_I, 6830_II, 6830_III, 6830_IV)** im Bereich der flächenhaften Sensorelementschicht **5** linear abhängig von der Koordinate x längs des benutzten Wellenleiters **(1380, 2380, 1880, 6830, 6980, 6830_I, 6830_II, 6830_III, 6830_IV):** ${B}_{ad} \left(x\right) \approx {B}_{ad 0} + k \times x$

Hierbei ist **B_{ad0}** eine für den verwendeten Gradienten behafteten Permanentmagneten **GPM(19)** spezifischen Offset-Konstante. **x** ist die Koordinate längs des betreffenden Wellenleiters **(1380, 2380, 1880, 6830, 6980, 6830_I, 6830_II, 6830_III, 6830_IV).** k ist eine Proportionalitätskonstante für den verwendeten Gradienten behafteten Permanentmagneten **GPM(19)** im Bereich der flächenhaften Sensorelementschicht **5.** In dem Beispiel der Figur 81 ist k willkürlich negativ gewählt. Natürlich können statt dieses linearen Zusammenhangs auch Polynome eine höheren Grades als 1 mit komplexeren Abhängigkeiten der zusätzlichen magnetischen Flussdichte **B_{ad}** von der Koordinate x längs des betreffenden Wellenleiters **(1380, 2380, 1880, 6830, 6980, 6830_I, 6830_II, 6830_III, 6830_IV)** im Bereich der flächenhaften Sensorelementschicht 5 verwendet werden. Durch die quasikontinuierliche Verteilung des Betrags der zusätzlichen magnetischen Flussdichte **B_{ad}** von der Koordinate x längs des betreffenden Wellenleiters **(1380, 2380, 1880, 6830, 6980, 6830_I, 6830_II, 6830_III, 6830_IV)** entsprechend **B_{ad}(x)** steigt die Dimensionalität des Sensorelement **SE** quasi ins unendliche. Sie wird letztlich nur durch die Granularität der Diamant-Nano-Kristalle **ND** im Sensorelement **SE,** hier der Granularität der Kristalle / Diamant-Nano-Kristalle **ND** in der flächenhaften Sensorelementschicht **5,** begrenzt. Es handelt sich also immer noch um ein vektorielles Sensorelement **SE** mit extrem hoher Dimensionalität. Der Übergang ist ähnlich dem Übergang vom einer Fourier-Reihe zum Fourier-Intergral.

Dementsprechend können die bis hierher vorgestellten Auswertevorrichtungen und Methoden dieses Problem in der Regel nicht mehr adäquat lösen.

Das hier vorgelegte Dokument schlägt daher vor, statt diskreter Sensorelementkanäle eine Magnetfeldkamera für die Auswertung zu verwenden. Hierzu verweist das hier vorgelegte Dokument auf die noch unveröffentlichten deutschen Patentanmeldungen DE 10 2023 100 856.0, DE 10 2023 100 857.9,

DE 10 2023 111 858.7 und DE 10 2023 111 859.5.

Eine wesentliche Idee des hier vorgelegten Dokuments ist, eine solche Magnetfeldkamera, wie sie in diesen Dokumenten beschrieben ist, mit einem Wellenleiter, insbesondere einem planaren Wellenleiter und/oder insbesondere mit einem der hier diskutierten Wellenleiter **(1380, 2380, 1880, 6830, 6980, 6830_I, 6830_II, 6830_III, 6830_IV),** und einem der hier vorgestellten Systeme zu kombinieren und die Verteilung der Intensität der Fluoreszenzstrahlung **FL** in der Fläche der flächenhaften Sensorelementschicht **5** innerhalb des sich ergebenden Gesamtsystems als zweidimensional vektorielle Fluoreszenzstrahlung aufzufassen und mittels einer Kamera, insbesondere einer CMOS-Kamera, zu erfassen und durch die Steuerungsvorrichtung **CTR** bzw. eine Mustererkennungsvorrichtung **MEV** und/oder eine Auswertevorrichtung **30** unter Benutzung von computerimplementierten Bildverarbeitungsalgorithmen auszuwerten um auf Messwerte, insbesondere die Position der Spitze **30** der V-Formation **(522, 525)** und/oder daraus abgeleitete Werte, zu schließen. Bevorzugt umfassen die Auswertevorrichtung **30** und/oder die Steuervorrichtung **CTR** ein Speichermedium **(RAM, NVM),** dass diese computerimplementierten Bildverarbeitungsalgorithmen auf die Ausgangsdaten der Ausgangssignale **31** der Fotodetektoren **PD** des Lichtsensorarrays **1** anwendet, um Messwerte und/oder Messwertgruppen zu ermitteln und auf einem Bildschirm **32** darzustellen und/oder für die Verarbeitung durch ein übergeordnetes Rechnersystem **(CTR2, 29)** bereitzustellen oder an ein solches übergeordnetes Rechnersystem **(CTR2, 29)** zu übertragen.

Bevorzugt ermitteln die Steuervorrichtung **CTR** und/oder die Mustererkennungsvorrichtung **MEV** unter Verwendung von computerimplementierten Bildverarbeitungs- und/oder Mustererkennungsalgorithmen einen oder mehrere der folgenden Messwerte bzw. Messwertgruppen:
1. Informationen über die wahrscheinliche Lage der unteren Resonanzkante **522,**
2. Informationen über die wahrscheinliche Lage der unteren mittleren Resonanzkante **523,**
3. Informationen über die wahrscheinliche Lage der oberen mittleren Resonanzkante **524,**
4. Informationen über die wahrscheinliche Lage der oberen Resonanzkante **525,**
5. Informationen über die wahrscheinliche Lage des mittleren Resonanzminimums **529,**
6. Informationen über den wahrscheinlichen Wert der wirksamen Offsetflussdichte **B_{off},**
7. Informationen über den wahrscheinlichen Wert der Nullpunktsflussdichte **B₀,**
8. Informationen über den wahrscheinlichen Wert der Nullpunktsmikrowellenfrequenz ω_{µW0},
Nach weiteren Messungen können die Steuervorrichtung **CTR** und/oder die Mustererkennungsvorrichtung **MEV** bzw. eine Auswertevorrichtung **530** auch hier auf einen oder mehrere der folgenden Werte schließen:
9. Informationen über den wahrscheinlichen Wert **564** der magnetischen Flussdichte **B₆₁,** der der oberen Referenzlinie **561** zugeordnet ist, an einem oder mehreren Arbeitspunkten,
10. Informationen über den wahrscheinlichen Wert **565** der magnetischen Flussdichte **B₆₂,** der der unteren Referenzlinie **562** zugeordnet ist, an einem oder mehreren Arbeitspunkten,
11. Informationen über die wahrscheinliche Differenz **566** des Werts der magnetischen Flussdichte **B₆₃,** der der mittleren Referenzlinie **563** zugeordnet ist, minus dem Wert **565** der magnetischen Flussdichte **B₆₂,** der der unteren Referenzlinie **562** zugeordnet ist,
12. Informationen über die wahrscheinliche Steigung **567** der Kurve an einem oder mehreren Arbeitspunkten;
13. Informationen über die Polynomkoeffizienten der Polynomapproximation **627** der Kurve in einigen Arbeitspunkten,
14. Informationen über den wahrscheinlichen Wert einer unteren wirksamen magnetischen Flussdichte **B₂₂,**
15. Informationen über den wahrscheinlichen Wert einer unteren mittleren wirksamen magnetischen Flussdichte **B₂₃,**
16. Informationen über den wahrscheinlichen Wert einer oberen mittleren wirksamen magnetischen Flussdichte **B₂₄,**
17. Informationen über den wahrscheinlichen Wert einer oberen wirksamen magnetischen Flussdichte **B₂₅,**
18. Informationen über den wahrscheinlichen Wert einer wirksamen magnetische Resonanzminimum-Flussdichte **B₂₉,**
19. Informationen über den wahrscheinlichen Wert einer Nullpunktsmikrowellenfrequenz ω_{µW0};
20. den wahrscheinlichen Wert einer unteren Mikrowellenfrequenz ω_{µW22};
21. Informationen über den wahrscheinlichen Wert einer unteren mittleren Mikrowellenfrequenz ω_{µW23};
22. Informationen über den wahrscheinlichen Wert einer oberen mittleren Mikrowellenfrequenz ω_{µW24};
23. Informationen über den wahrscheinlichen Wert einer oberen Mikrowellenfrequenz ω_{µW25};
24. Informationen über den wahrscheinlichen Wert einer Resonanzminimum-Mikrowellenfrequenz ω_{µW29};
25. Informationen über den wahrscheinlichen Wert einer unbekannten Mikrowellenfrequenz ω_{µWnk};
26. Informationen über den wahrscheinlichen Wert einer Mikrowellenmodulationsfrequenz **f**_{µW};

Als Beispiel wird hier die Ermittlung einer unbekannten Mikrowellenfrequenz ωₙₖ erläutert:
Besonders bevorzugt ist, dass die Relation **B_{ad}(x)** eine bijektive Funktion ist. Für die Ermittlung einer zusätzlichen magnetischen Flussdichte **B_{ad}** können dann die Auswertevorrichtung **30** und/oder die Mustererkennungsvorrichtung **MEV** in einem ersten Schritt eine Intensitätskurve **I_{fl}(x)** der Intensität der Fluoreszenzstrahlung **FL** längs eines Wellenleiters **(1380, 2380, 1880, 6830, 6980, 6830_I, 6830_II, 6830_III, 6830_IV),** beispielsweise des ersten Wellenleiters **(6830_I),** mit den Fotodetektoren **PD** des Lichtsensorarrays **1** für eine erste Mikrowellenfrequenz ω_{µW_1} aufnehmen. Da die Relation **B_{ad}(x)** des Gradienten behafteten Permanentmagneten **GPM(19)** bekannt und umkehrbar und eine Funktion von **x** ist, können die Auswertevorrichtung **30** und/oder die Mustererkennungsvorrichtung **MEV** die Umkehrfunktion **x(B_{ad})** bestimmen und in eine für eine bei ωₙₖ=0Hz bestimmte Kalibrationskurve **I_{fl}(x)** einsetzen und erhalten so eine Kurve **I_{fl}(B_{ad})** für diese eine Mikrowellenfrequenz ω_{µW_1}. Vorzugsweise wurde zuvor das gesamte Intensitätsfeld **I_{fl}(ω_{µW}, B_{ad})** in einem Kalibrationsvorgang bestimmt, sodass Auswertevorrichtung **30** und/oder die Mustererkennungsvorrichtung **MEV** vorzugsweise über die entsprechenden Daten in einem Speicher **(RAM, NVM)** der Vorrichtung verfügen. Wird nun beispielsweise einem bekannten ersten Mikrowellensignal **µW_G_I** mit der ersten Mikrowellenfrequenz ω_{µW_I} der ersten internen Mikrowellenquelle **µW_G_I** innerhalb der ersten Mikrowellenquelle **µWG_I** (Siehe Figur 83) in einem ersten Mixer **µW_MX_I** der ersten Mikrowellenquelle **µWG_I** ein Signal **S_{ωnk}** mit einer unbekannten Mikrowellenfrequenz ωₙₖ zugemischt, so entsteht ein erstes Mikrowellenmischsignal **µW_MX**_I. Ein erster Mikrowellenfilter **µW_F_I** (Siehe Figur 83) eliminiert bevorzugt einen der beiden bei ω_{µW_I}-ωₙₖ und ω_{µw_I}+ωₙₖ entstehenden Transienten im ersten Mikrowellenmischsignal **µW_MX_I.** Bevorzugt ist die Grenzfrequenz des ersten Mikrowellenfilters **µW_F_I** (Siehe Figur 83) bei einem Tiefpass als ersten Mikrowellenfilter **µW_F_I** kleiner als die Nullpunktsmikrowellenfrequenz ω_{µW0}. Bevorzugt ist die Grenzfrequenz des ersten Mikrowellenfilters **µW_F_I** (Siehe Figur 83) bei einem Hochpass als erster Mikrowellenfilter **µW_F_I** größer als die Nullpunktsmikrowellenfrequenz ω_{µW0}. Hierdurch wird das Diagramm der Figur 2 betreffend die Position der untere Resonanzkante 5**22** in eine umkehrbare Funktion **ω_{µW}(B_{ad})** gewandelt. (Siehe Figur 83).

Hierdurch können in einem dritten Schritt die Auswertevorrichtung **30** und/oder die Mustererkennungsvorrichtung **MEV** die Position der unteren Resonanzkante 5**22** in der erfassten Kurve **I_{fl}(B_{ad})** als Wert der zusätzlichen magnetischen Flussdichte **B_{ad,22}** für diese untere Resonanzkante 5**22** ermitteln. Dies kann beispielsweise durch Bildung eines Kreuzkorrelationsintegrals zwischen der erfassten Kurve **I_{fl}(B_{ad})** und einer Referenzkurve **I_{fl_ref}(B_{ad})** für **S_{ωnk}** konstant geschehen. $K \left({B}_{ad}\right) = {\int }_{{B}_{ad _ min}}^{{B}_{ad _ max}} {I}_{fl} \left({B}_{ad}\right) ° {I}_{fl _ ref} \left({B}_{ad _ max}-{B}_{ad}\right) {dB}_{ad}$

Wird nur eine untere Referenzkante gesucht, so liegt diese typischerweise bei der zusätzlichen magnetischen Flussdichte **B_{ad,22}** mit dem Maximum der Korrelation **K(B_{ad}).**

In einem vierten Schritt können dann die Auswertevorrichtung **30** und/oder die Mustererkennungsvorrichtung **MEV** daraus dann eine Mikrowellenfrequenz **ω_{µW22}=ω_{µW}(B_{ad,22})** für die Lage der unteren Resonanzkante 5**22** bestimmen.

Je nach Art des ersten Mikrowellenfilters **µW_F_I** (Hochpass oder Tiefpass) können dann die Auswertevorrichtung **30** und/oder die Mustererkennungsvorrichtung **MEV** daraus dann mittels - ωₙₖ = ω_{µW22} - ω_{µW_I} bzw. ωₙₖ =ω_{µW_I} - ω_{µW22} die unbekannte Mikrowellenfrequenz ωₙₖ bestimmen.

In Figur 81 ist links des Trägersubstrats **1360** ein XY-Diagramm zur Verdeutlichung des beispielhaften, möglichen Zusammenhangs **B_{ad}(x)** dargestellt. Natürlich kann auch k=0 gelten, wenn kein Gradient der magnetischen Flussdichte in der jeweiligen Anwendung gewünscht ist.

Der linienhafte Wellenleiter **(1380, 2380, 1880, 6830, 6980)** kann im Bereich der der flächenhaften Sensorelementschicht **5** nicht nur gerade, sondern auch krumm und/oder ringförmig und/oder ringsegmentförmig und/oder abknickend ausgeführt sein. Weist beispielsweise der linienhafte Wellenleiter **(1380, 2380, 1880, 6830, 6980)** im Bereich der der flächenhaften Sensorelementschicht **5** zwei seriell hintereinander verschaltete Abschnitte des linienhaften Wellenleiters **(1380, 2380, 1880, 6830, 6980)** auf, die vorzugsweise in diesen Abschnitten gerade sind und die beispielsweise in einem Winkel von 90° zueinander angeordnet sind (siehe Figur 91) , so können die Steuervorrichtung **CTR** und/oder die Mustererkennungsvorrichtung **MEV** durch ein computerimplementiertes Bildverarbeitungsverfahren auf die Polarisationsrichtung und Frequenz von extern einfallender Mikrowellenstrahlung bzw. anderer elektromagnetischer Strahlung schließen, deren Mischfrequenz mit der Mikrowellenfrequenz des Mikrowellensignals **µW** im Messbereich der paramagnetischen Zentren bzw. der NV-Zentren der Diamant-Nano-Kristalle **ND** bzw. der entsprechenden funktionsäquivalenten Kristalle liegt.

Im Folgenden erläutert das hier vorgelegte Dokument nochmals der Vollständigkeit halber die Funktionsweise der hier vorgeschlagenen Vorrichtung näher:
Die Lichtquelle **LED** emittiert als beispielhafte Pumpstrahlungsquelle Pumpstrahlung **LB** mit der Pumpstrahlungswellenlänge λₚₘₚ und möglicherweise unerwünschte elektromagnetische Strahlung **27** anderer Wellenlängenbereiche. Optional kann wieder ein erster Signalgenerator **G1** ein LED-Modulationssignal **S5w** mit einer LED-Modulationsfrequenz **f_{LED}** erzeugen. Vorzugsweise steuert die Steuervorrichtung **CTR** den ersten Signalgenerator **G1** über den Datenbus **DB.** Ein Lichtquellentreiber LDRV versorgt bevorzugt zumindest Zeitweise in Abhängigkeit von dem optionalen LED-Modulationssignal **S5w** und/oder in Abhängigkeit von Steuerungsdaten der Steuervorrichtung **CTR,** die die Steuervorrichtung **CTR** über den Datenbus **DB** an den Lichtquellentreiber LDRV übermittelt, die Lichtquelle **LED** mit elektrischer Energie. Typischerweise können das LED-Modulationssignal **S5w** und/oder die Steuerungsdaten der Steuervorrichtung **LED** also die Intensität der Pumpstrahlung **LB,** die die Lichtquelle **LED** emittiert modulieren. Im Extremfall können das LED-Modulationssignal **S5w** und/oder die Steuerungsdaten der Steuervorrichtung **LED** also die Emission der Pumpstrahlung **LB,** die die Lichtquelle **LED** insbesondere in Abhängigkeit von einem computerimplementieren Lichterzeugungsprogramm in einem Speicher **RAM, NVM** der Vorrichtung, dass die Steuervorrichtung **CTR** zumindest zeitweise ausführt, an- und ausschalten. Ein optionales optischer Shortpass-Filter **4** lässt bevorzugt nur die Pumpstrahlung **LB** mit Pumpstrahlungswellenlänge λₚₘₚ der Lichtquelle **LED** passieren und hält bevorzugt die elektromagnetische Strahlung **27** anderer Wellenlängenbereiche zurück. Sofern die Lichtquelle **LED** keine unerwünschte elektromagnetische Strahlung **27** anderer Wellenlängenbereiche emittiert, ist dieses optische Shortpass-Filter **4** nicht notwendig. Eine optionale, vorzugsweise vorhandene Beleuchtungsoptik **3** sorgt dafür, dass die Pumpstrahlung **LB** die Sensorelementschicht **5** möglichst homogen ausleuchtet. Die Beleuchtungsoptik **3** kann ein oder mehrere optische Funktionselemente wie Linsen, Blenden, Lichtwellenleiter, Prismen etc., wie sie in jedem Lehrbuch der technischen Optik zu finden sind, umfassen. Die Form der Linsen und/oder Spiegel und sonstigen optischen Funktionselemente der Beleuchtungsoptik **3** ist vorzugsweise so berechnet und ausgeformt, dass bei einer bekannten Abstrahlcharakteristik der Lichtquelle **LED** die Ausleuchtung der Sensorelementschicht **5** mit Pumpstrahlung **LB** homogen ist. Diese optischen Funktionselemente können auch Funktionselemente der diffraktiven Optik wie photonische Kristalle, dielektrische Spiegel, Hologramme etc. umfassen. Das hier vorgelegte Dokument verweist hier beispielhaft auf die Dokumente Baha E.A. Saleh, Malvin Carl Teich, "Grundlagen der Photonik"Wiley-VCH, 2007 und Bernhard C. Kress, Patrick Meyreueis "Applied Digital Optics" Wiley, 2009

Die Sensorelementschicht **5** ist vorzugsweise auf dem mechanischen Trägersubstrat **1360,** beispielsweise einer ebenen Fläche **16,** aufgebracht. Die ebene Fläche kann insbesondere durch ein Dielektrikum **40** erzielt werden, dass Unebenheiten der Wellenleiter **(1360, 1880, 2380, 6830, 6980, 6980_1, 6980_II, 6980_III, 6980_IV)** ausgleicht. Vorzugsweise ist die Vorrichtung in ein Gehäuse **8** eingebaut. Das Material Gehäusewand des Gehäuses **8** ist in diesem Bereich bevorzugt nicht magnetisch und beeinflusst bevorzugt das magnetische Feld vorzugsweise im Wesentlichen nicht. Typischerweise umfasst das Trägersubstrat **1360** Materialien wie FR-4 (Flameresistent-4) oder PTFE (Polytetrafluorethylen) oder aus halbleiten Materialien, wie beispielsweise Stücke von Platinenmaterialien oder Stücke von Kunststoffplatten- oder -folien und/oder Stücke von Glas-Wafern oder ein Stücke von Keramik-Wafern und/oder Stücke von Halbleiterwafern, beispielsweise Stücken von CMOS-Wafern oder beispielsweise Stücken von BiCMOS-Wafern beispielsweise Stücken von Wafern aus einer BipolarTechnologie oder Stücke eines Wafers aus einem III/V-Material oder dergleichen und/oder beispielsweise Stücken von MEMS-Wafern und/oder Stücke mikroelektronischen Schaltungen und/oder beispielsweise Stücken von MEOS-Wafern (MEOS= micro electro optical system) und/oder beispielsweise Stücken von MOEMS-Wafern etc. und/oder Stücke von MOEMS-Wafern mikroelektronische Schaltkreise und Funktionselemente und/oder mikrooptische Funktionselemente und/oder mikromechanische Funktionselemente und/oder mikrofluidische Funktionselemente. Die Sensorelementschicht **5** umfasst bevorzugt eine Vielzahl zufällig und vorzugsweise gleichverteilt orientierter Kristalle mit paramagnetischen Zentren bzw. Diamant-Nano-Kristallen **ND** mit paramagnetischen Zentren und/oder NV-Zentren. Bevorzugt umfasst die Sensorelementschicht **5** ein Trägermaterial **TM,** in das die Kristalle mit paramagnetischen Zentren bzw. Diamant-Nano-Kristallen **ND** mit paramagnetischen Zentren und/oder NV-Zentren eingebettet sind. Bevorzugt ist das Trägermaterial **TM** der Sensorelementschicht **5** ein ausgehärtetes Trägermaterial **TM.** Bevorzugt ist das Trägermaterial **TM** der Sensorelementschicht **5** ein mittels elektromagnetischer Aushärtestrahlung **4910** einer Aushärtewellenlänge λ_{H} ausgehärtetes Trägermaterial **TM.** Die Sensorelementschicht **5** umfasst ganz besonders bevorzugt eine Vielzahl zufällig und vorzugsweise gleichverteilt orientierter Diamant-Nano-Kristalle **ND** mit NV-Zentren. Bei den paramagnetischen Zentren kann es sich bei der Verwendung von Diamant als Kristallmaterial der Diamant-Nano-Kristalle **ND** beispielsweise um NV-Zentren und/oder SiV-Zentren und/oder TiV-Zentren und/oder GeV-Zentren und/oder SnV-Zentren und/oder NiN4-Zentren und/oder PbV-Zentren und/oder ST1-Zentren handeln. Andere paramagnetische Zentren und/oder Kristallmaterialien erscheinen funktionsäquivalent möglich. Die Pumpstrahlung **LB** besitzt bei der Verwendung von NV-Zentren in Dimant als Kristalle der Sensorelementschicht **5** bevorzugt eine Pumpstrahlungswellenlänge λₚₘₚ in einem Wellenlängenbereich von 400 nm bis 700 nm Wellenlänge und/oder besser 450 nm bis 650 nm und/oder besser 500 nm bis 550 nm und/oder besser 515 nm bis 540 nm aufweisen. Bevorzugt ist dabei eindeutig eine Wellenlänge von 532 nm als Pumpstrahlungswellenlänge λₚₘₚ. Im Falle der Verwendung von NV-Zentren in Diamant oder in Diamanten der Sensorelementschicht **5** ist eine Laser-Diode der Fa. Osram vom Typ PLT5 520B beispielsweise als Lichtquelle **LED** mit 520nm Pumpstrahlungswellenlänge λₚₘₚ geeignet. Bei der Verwendung von NV-Zentren in Diamantkristallen als Diamant-Nano-Kristalle **ND** in der Sensorelementschicht **5** als paramagnetische Zentren der Sensorelementschicht **5** emittieren die NV-Zentren der Sensorelementschicht **5** typischerweise bei Bestrahlung mit Pumpstrahlung **LB** der oben beschriebenen Pumpstrahlungswellenlänge λₚₘₚ eine Fluoreszenzstrahlung **FL** mit einer typischen Fluoreszenzwellenlänge λ_{fl} von ca. 637nm.

Bevorzugt ist das Trägermaterial **TM** der Sensorelementschicht **5** nach dem Aushärten des Trägermaterials **TM** für elektromagnetische Strahlung mit der Fluoreszenzstrahlungswellenlänge λ_{fl} der paramagnetischen Zentren der Kristalle und/oder der Diamant-Nano-Kristalle **ND** und/oder der NV-Zentren der Diamant-Nano-Kristalle **ND** der Sensorelementschicht **5** transparent.

Bevorzugt ist das Trägermaterial **TM** der Sensorelementschicht **5** nach dem Aushärten des Trägermaterials TM für elektromagnetische Strahlung mit der Pumpstrahlungswellenlänge λₚₘₚ der Lichtquelle **LED** zur Anregung der Emission der Fluoreszenzstrahlung **FL** der paramagnetischen Zentren der Kristalle und/oder der Diamant-Nano-Kristalle ND und/oder der NV-Zentren der Diamant-Nano-Kristalle **ND** der Sensorelementschicht **5** transparent.

Eine abbildende Optik **7** erfasst bevorzugt das Bild der ortsabhängigen Intensität **Iᵢₛₜ** der Fluoreszenzstrahlung **FL** mit der Fluoreszenzwellenlänge λ_{fl}, das die Sensorelementschicht **5** mittels der paramagnetischen Zentren, also beispielsweise mittels der NV-Zentren, in der Sensorelementschicht **5** bei Anregung durch die Pumpstrahlung **LB** mit der Pumpstrahlungswellenlänge λₚₘₚ erzeugt.

Die abbildende Optik **7** kann ein oder mehrere optische Funktionselemente wie Linsen, Blenden, Lichtwellenleiter, Prismen, Spiegel, Planspiegel, Konvex- und Konkavspiegel etc., wie sie in jedem Lehrbuch der technischen Optik zu finden sind, umfassen. Diese optischen Funktionselemente können insbesondere auch Funktionselemente der diffraktiven Optik wie phononische Kristalle, dielektrische Spiegel, Hologramme etc. umfassen. Das hier vorgelegte Dokument verweist hierzu beispielhaft auf die Dokumente Baha E.A. Saleh, Malvin Carl Teich, "Grundlagen der Photonik"Wiley-VCH, 2007 und Bernhard C. Kress, Patrick Meyreueis "Applied Digital Optics" Wiley, 2009.

Ein optisches Longpass-Filter **F1(6)** lässt bevorzugt elektromagnetische Strahlung mit der Fluoreszenzwellenlänge λ_{fl} und damit die Fluoreszenzstrahlung **FL** passieren. Das optische Longpass-Filter **F1(13406)** blockiert bevorzugt die Passage anderer elektromagnetische Strahlung, beispielsweise solcher mit der Pumpstrahlungswellenlänge λₚₘₚ, und damit die Passage der Pumpstrahlung **LB.** Hierdurch kann die abbildende Optik **7** das Bild der Intensitätsverteilung der Emission der Fluoreszenzstrahlung **FL** über die Sensorelementschicht **5** im Wellenlängenbereich der Fluoreszenzwellenlänge **λ_{fl}** abgetrennt von anderen Strahlungsbildern anderer Wellenlängen erfassen und auf die n x m Fotodetektoren **PD** des n x m Lichtsensorarrays **1** der Fluoreszenzkamera abbilden. Beispielsweise kann die Abbildende Optik Linsen und/oder Lichtwellenleiterbündel als vektorielle Lichtwellenleiter LWL mit Lichtwellenleitern als Lichtwellenleiterbündelkomponenten umfassen. n und m sind hier ganze positive Zahlen. Bei dem Lichtsensorarray **1** handelt es sich bevorzugt im einen CMOS-Chip, noch stärker bevorzugt um eine mikrointegrierte CCD-Fotodetektorschaltung, die vorzugsweise eine Auswerteelektronik umfasst. Da die Intensität **Iᵢₛₜ(x)** der Fluoreszenzstrahlung **FL** der Sensorelementschicht **5** lokal in der Sensorelementschicht **5** von der magnetischen Gesamtflussdichte **B_{Σ}** und der Mikrowellenfrequenz **ω_{µW}(x)** am jeweiligen Ort **x** des jeweiligen paramagnetischen Zentrums in der Sensorelementschicht **5** abhängt, entspricht das Bild der Intensitätsverteilung der Intensität **Iᵢₛₜ(x)** der Emission der Fluoreszenzstrahlung **FL** über die Sensorelementschicht **5** einem Magnetflussdichtebetragsbild des Feldes der magnetischen Gesamtflussdichte **B_{Σ},** das die Sensorelementschicht **5** durchflutet, bzw. einem Mikrowellenfrequenzbetragsbild, dass nichtlinear von der Verteilung der Mikrowellenfrequenzen der Mikrowellenstrahlung im Bereich der Sensorelementschichtb**5** abhängt. Da in der Regel die Dichteverteilung der paramagnetischen Zentren in der Sensorelementschicht **5** und/oder die Ausleuchtung der Sensorelementschicht **5** mit Pumpstrahlung **LB** und/oder die Erfassung der Intensität der Fluoreszenzstrahlung **FL** über die Fläche der Sensorelementschicht **5** bei allem Bemühen nicht ganz homogen zu fertigen sind, hat es sich bewährt, durch Kalibrationsmessungen das System vor dem ersten Gebrauch zu kalibrieren. Zur Verarbeitung der Messwerte der Fotodetektoren **PD** des Lichtsensorarrays **1** erfassen Auswertelektroniken **15** des Lichtsensorarrays **1** die Messwerte des Signale der Fotodetektoren **PD** des Lichtsensorarrays **1** und bilden daraus insbesondere durch Verstärkung und/oder Filterung die Ausgangssignale **31** der Fotodetektoren PD des Lichtsensorarrays **1.** Diese Auswertelektroniken **15** des Lichtsensorarrays 1 entsprechen der Funktion des ersten Verstärkers **V1** in den zuvor diskutierten Sensorelementkanälen. Die Ausgangssignale **31** der Fotodetektoren **PD** des Lichtsensorarrays **1** entsprechen analog dazu den Empfangssignalen **S0** der zuvor diskutierten Fotodetektoren **PD.** Die Auswertung kann nun jedoch typischerweise aufgrund der hohen Dimensionalität nicht mehr mittels eines einfachen Mehrfachkorrelators **LIV** durchgeführt werden, der ggf. auch noch kanalweise zu Verfügung gestellt wird. Das hier vorgelegte Dokument schlägt stattdessen vor, die Analyse mittels eines computerimplementierten Bildund/oder Mustererkennungsprogramms, das in einem Speicher **(RAM, NVM)** der Vorrichtung abgelegt ist und von der einer Aufbereitungsvorrichtung **30** als Steuervorrichtung **CTR** ausgeführt wird, durchzuführen.

Die Aufbereitungsvorrichtung **30** für die Ausgangssignale **31(S0)** der Fotodetektoren **PD** des Lichtsensorarrays **1** kann optional mittels einer Ansteuervorrichtung **LCTR** für weitere Magnetfelderzeugungsmittel Lc steuern, wenn diese nicht nur den Gradienten behafteten Permanentmagneten **GPM** umfassen. Bei den weiteren Magnetfelderzeugungsmitteln **L_{C}** kann es sich beispielsweise wieder um Flachspulen **2520 (L_{C})** handeln, die von der Ansteuervorrichtung **LCTR** für das weitere Magnetfelderzeugungsmittel **L_{C}** mit einem elektrischen Strom bestromt werden.

Die Aufbereitungsvorrichtung **30** für die Ausgangssignale **31** der Fotodetektoren **PD** des Lichtsensorarrays **1** erzeugt aus den die Ausgangssignalen **31** der Fotodetektoren **PD** des Lichtsensorarrays **1** vorzugsweise ein Bild der Intensitätsverteilung der Fluoreszenzstrahlung **FL** der Sensorelementschicht **5.** Aufgrund der zuvor dargestellten Zusammenhänge stellen das Bild der Intensitätsverteilung der Intensität **Iᵢₛₜ** der Fluoreszenzstrahlung **FL** der Sensorelementschicht **5** ein Magnetflussdichtenbetragsbild des Feldes der magnetischen Gesamtflussdichte **B_{Σ}** in der Sensorelementschicht **5** dar. Die Aufbereitungsvorrichtung **30** für die Ausgangssignale **31** der der Fotodetektoren **PD** des Lichtsensorarrays **1** kann dieses Bild der Intensitätsverteilung der Intensität **Iᵢₛₜ** der Fluoreszenzstrahlung **FL** der Sensorelementschicht **15** beispielsweise direkt mittels der Schnittstellenschaltung **136** über einen Datenbus **29** an ein weiteres und/der übergeordnetes Rechnersystem **28(CTR2)** übertragen. Das weitere und/der übergeordnete Rechnersystem **28(CTR2)** kann der Bedienung des Sensorsystems **21** dienen. Bei dem weiteren und/der übergeordneten Rechnersystem **28** kann es sich um eine weiter Steuervorrichtung **CTR2** des Sensorsystems **21** handeln. Beispielsweise kann das weitere und/der übergeordnete Rechnersystem **28** zur Bedienung des Sensorsystems **21** aus dem von der Auswertevorrichtung **30** über eine Datenschnittstelle **36** und einen Datenbus **29** an das das weitere und/der übergeordnete Rechnersystem **28** übertragene Bild der Intensitätsverteilung der Intensität **Iᵢₛₜ** der Fluoreszenzstrahlung FL der Sensorelementschicht **5** eine ein- oder zwei- oder dreidimensionale Darstellung der Verteilung der magnetischen Gesamtflussdichte **B_{Σ}** in der Sensorelementschicht **5.** In dem Beispiel der Figur 81 sind auf einer ersten Oberfläche des Trägersubstrats **1360** beispielhaft vier Wellenleitungen, hier beispielhaft vier beispielhafte differentielle Tri-Plate-Leitungen **(6980_I, 6980_II, 6980_III, 6980_IV),** aufgebracht. In dem Beispiel der Figur 81 bedeckt das Dielektrikum **40** die Signalleitungen **(6810, 6820)** der TriPlate-Leitung **6980** dieser Tri-Plate-Leitungen **(6980_I, 6980_II, 6980_III, 6980_IV)** und die jeweilige elektrisch leitende linke Signalmassefläche **1310** und die jeweilige elektrisch leitende rechte Signalmassefläche **1320** und füllt beispielhaft zur Planarisierung die jeweilige nicht-leitende linke Isolationslücke **2340** und die jeweilige nicht-leitende rechte Isolationslücke **2350** und die elektrisch isolierende Lücke **6840** zwischen dem jeweiligen linken Signalleiter **6810** und dem jeweiligen rechten Signalleiter **6820** des jeweiligen differentiellen Signalleiters **6830** auf, sodass sich eine im Wesentlichen glatte Zwischenoberfläche **16** ergibt, auf der die Sensorelementschicht **5** beispielhaft aufgebracht ist. In dem Beispiel der Figur 81 dient das Dielektrikum **40** somit auch zu dem Zweck eine planare Oberfläche **16** für das Aufbringen der Sensorelementschicht **5** auf das Trägersubstrat **1360** sicherzustellen, um die Artefakte in der computerimplementierten Bild- und Mustererkennung zu reduzieren. Das weitere und/der übergeordnete Rechnersystem **28** kann beispielweise als weitere Steuervorrichtung **CTR2** des Sensorsystems **21** die empfangenen Bilder und/oder die extrahierten Messwerte auf dem Bildschirm **32** darstellen.

Der Datenbus **29** dient dabei der Herstellung der Datenverbindung zwischen der Aufbereitungsvorrichtung **30(CTR)** für die Ausgangssignale **31** der Fotodetektoren PD des Lichtsensorarrays **1** (Empfängerausgangssignale **S0** bzw. digitalisierte Empfängerausgangssignale **S1** bzw. analoge Empfängerausgangssignale **S1**) und dem weiteren und/der übergeordneten Rechnersystem **28(CTR2)** zur Bedienung des Sensorsystems **21.** Die von außen auf die Sensorelementschicht **5** einwirkenden externen magnetischen Flussdichten **Bₑₓₜ,** die zur die Sensorelementschicht **5** beeinflussenden Gesamtflussdichte **B_{Σ}** beitragen, und die externe Mikrowellenstrahlung **S_{ωnk}** beeinflussen durch Superposition die Intensitätsverteilung der Intensität **Iᵢₛₜ** der Fluoreszenzstrahlung **FL** der Sensorelementschicht **5.** und damit die Bilder, die die Aufbereitungsvorrichtung **30** für die Ausgangssignale **31** der der Fotodetektoren **PD** des Lichtsensorarrays **1** als Bilder der Intensitätsverteilung der der Intensität **Iᵢₛₜ** der Fluoreszenzstrahlung **FL** der Sensorelementschicht **5** beispielsweise direkt mittels der Schnittstellenschaltung **36** über einen Datenbus **29** an das weitere und/der übergeordnete Rechnersystem **28(CTR2)** überträgt.

Um mit einem Bild möglichst viele Daten zu erfassen verfügt die beispielhafte Vorrichtung über beispielhaft vier Mikrowellensignalquellen **(µWG_I, µWG_II, µWG_III, µWG_IV).** Vorzugsweise sind die beispielhaft vier Mikrowellensignalquellen **(µWG_I, µWG_II, µWG_III, µWG_IV)** Teil eines vektoriellen Mikrowellensignalquelle **µW.** Jede dieser beispielhaft vier Mikrowellensignalquellen **(µWG_I, µWG_II, µWG_III, µWG_IV)** erzeugt in dem Beispiel eines von vier Mikrowellensignalen **(µW_I, µW_II, µW_III, µW_IV).** D.h. die vektorielle Mikrowellensignalquelle **µW** erzeugt ein vektorielles Mikrowellensignal µW, das diese beispielhaft vier Mikrowellensignalquellen **(µWG_I, µWG_II, µWG_III, µWG_IV)** beispielsweise umfasst. Auf dem Trägersubstrat **1360** befinden sich beispielhaft vier Wellenleitungen, hier beispielhaft vier Triplate-Leitungen **(6980_I, 6980_II, 6980_III, 6980_IV).**

In dem Beispiel der Figur 81 speist die erste Mikrowellenquelle **µWG_I** das erste Mikrowellensignal **µW_I** in die erste Wellenleitung, hier eine erste Tri-Plate-Leitung **6980_I** ein.

In dem Beispiel der Figur 81 speist die zweite Mikrowellenquelle **µWG_I** das zweite Mikrowellensignal **µW_II** in die zweite Wellenleitung, hier eine zweite Tri-Plate-Leitung **6980_II** ein.

In dem Beispiel der Figur 81 speist die dritte Mikrowellenquelle **µWG_III** das dritte Mikrowellensignal **µW_III** in die dritte Wellenleitung, hier eine dritte Tri-Plate-Leitung **6980_III** ein.

In dem Beispiel der Figur 81 speist die vierte Mikrowellenquelle **µWG_IV** das vierte Mikrowellensignal **µW_IV** in die vierte Wellenleitung, hier eine vierte Tri-Plate-Leitung **6980_IV** ein.

Die vier Wellenleitungen, hier in dem Beispiel der Figur 81 die beispielhaften vier Tri-Plate-Leitungen **(6980_I, 6980_II, 6980_III, 6980_IV),** bilden zusammen eine vektorielle Wellenleitung, hier eine vektorielle Tri-Plate-Leitung **6980,** die die beispielhaften vier Tri-Plate-Leitungen **(6980_I, 6980_II, 6980_III, 6980_IV)** in dem Beispiel der Figur 81 umfasst.

In dem Beispiel der Figur 81 speist die vektorielle Mikrowellenquelle **µWG** das vektorielle Mikrowellensignal **µW** in die vektorielle Wellenleitung, hier eine vektorielle Tri-Plate-Leitung **6980** ein.

In dem Beispiel der Figur 81 erzeugt die erste Mikrowellenquelle **µWG_I** das erste Mikrowellensignal **µW_I** mit einer ersten Mikrowellenfrequenz ω_{µW_I}.

In dem Beispiel der Figur 81 erzeugt die zweite Mikrowellenquelle **µWG_II** das zweite Mikrowellensignal **µW_II** mit einer zweiten Mikrowellenfrequenz ω_{µW_II}.

In dem Beispiel der Figur 81 erzeugt die dritte Mikrowellenquelle **uWG_ III** das dritte Mikrowellensignal **µW_III** mit einer dritten Mikrowellenfrequenz ω_{µW_III}.

In dem Beispiel der Figur 81 erzeugt die vierte Mikrowellenquelle **µWG_IV** das vierte Mikrowellensignal **µW_IV** mit einer vierten Mikrowellenfrequenz ω_{µW_IV}.

Die erste Mikrowellenfrequenz ω_{µW_I} und die zweite Mikrowellenfrequenz ω_{µW_II} und die dritte Mikrowellenfrequenz ω_{µw_III} und die vierte Mikrowellenfrequenz ω_{µW_IV} können zusammen als vektorielle Mikrowellenfrequenz ω_{µW} aufgefasst werden.

In dem Beispiel der Figur 81 erzeugt die vektorielle Mikrowellenquelle **µWG** das vektorielle Mikrowellensignal **µW** somit mit einer vektorielle Mikrowellenfrequenz ω_{µW}.

Um ein Maximum an Informationen erfassen zu können, sind die erste Mikrowellenfrequenz ω_{µW_I} und die zweite Mikrowellenfrequenz ω_{µW_II} und die dritte Mikrowellenfrequenz ω_{µW_III} und die vierte Mikrowellenfrequenz ω_{µW_IV} vorzugsweise untereinander verschieden.

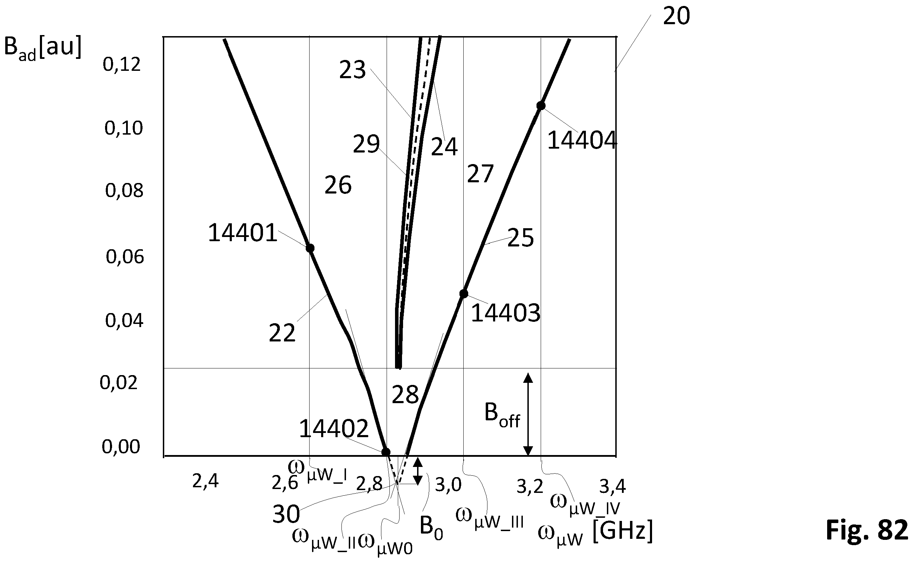

Diese vier Mikrowellenfrequenzen (ω_{µW_I}, ω_{µW_II}, ω_{µW_III}, ω_{µw_IV}) definieren dann in Figur 51b vier senkrechte virtuelle Linien, auf denen die Arbeitspunkte liegen müssen. (Siehe nachfolgende Figur 82.)

Durch die Verwendung eines Gradienten behafteten Permanentmagneten **GPM,** werden diese vertikalen Linien tatsächlich als Messwerte sichtbar und können durch ein computerimplementiertes Mustererkennungsund/oder Bildverarbeitungsverfahren aus den Bildern des Lichtsensorarray **1** direkt extrahiert werden. Bevorzugt führen die Aufbereitungsvorrichtung **30** für die Ausgangssignale **31** der Fotodetektoren PD des Lichtsensorarrays **1** und/oder die Mustererkennungsvorrichtung **MEV** und/oder das weitere und/oder übergeordnete Rechnersystem **CTR2(28)** das computerimplementierte Mustererkennungs- und/oder Bildverarbeitungsverfahren aus. Bevorzugt befinden sich die Programmdaten mit dem Programmcode für das computerimplementierte Mustererkennungs- und/oder Bildverarbeitungsverfahren in einem Speichermedium, beispielsweise in einem Speicher **(RAM, NVM)** des Systems. Bevorzugt führen die Aufbereitungsvorrichtung **30** für die Ausgangssignale **31** der Fotodetektoren **PD** des Lichtsensorarrays **1** und/oder die Mustererkennungsvorrichtung **MEV** und/oder das weitere und/oder übergeordnete Rechnersystem **CTR2(28)** den Programmcode für das computerimplementierte Mustererkennungs- und/oder Bildverarbeitungsverfahren in einem Speichermedium, beispielsweise in einem Speicher **(RAM, NVM)** des Systems bei Ausführung dieser Verfahren aus.

Ein optionaler erster zweiter Signalgenerator **G2_I** erzeugt ein erstes Mikrowellenmodulationssignal **S5m_I** mit einer ersten Mikrowellenmodulationsfrequenz **f_{µW_I}.**

Ein optionaler zweiter zweiter Signalgenerator **G2_II** erzeugt ein zweites Mikrowellenmodulationssignal **S5m_II** mit einer zweiten Mikrowellenmodulationsfrequenz **f_{µW_II}**

Ein optionaler dritter zweiter Signalgenerator **G2_III** erzeugt ein drittes Mikrowellenmodulationssignal **S5m_III** mit einer dritten Mikrowellenmodulationsfrequenz f_{µw_III}.

Ein optionaler vierter zweiter Signalgenerator **G2_IV** erzeugt ein viertes Mikrowellenmodulationssignal **S5m_IV** mit einer vierten Mikrowellenmodulationsfrequenz **f_{µW_IV}.**
Bevorzugt ist der Kehrwert der ersten Mikrowellenmodulationsfrequenz **f**_{µW_I} ein ganzzahliges Vielfaches der Bildwiederholperiode des Lichtsensorarrays 1. (Englisch: Frame Rate)
Bevorzugt ist der Kehrwert der zweiten Mikrowellenmodulationsfrequenz **f**_{µW_II} ein ganzzahliges Vielfaches der Bildwiederholperiode des Lichtsensorarrays 1. (Englisch: Frame Rate)
Bevorzugt ist der Kehrwert der dritten Mikrowellenmodulationsfrequenz **f**_{µW_III} ein ganzzahliges Vielfaches der Bildwiederholperiode des Lichtsensorarrays 1. (Englisch: Frame Rate)
Bevorzugt ist der Kehrwert der vierten Mikrowellenmodulationsfrequenz **f**_{µW_IV} ein ganzzahliges Vielfaches der Bildwiederholperiode des Lichtsensorarrays 1. (Englisch: Frame Rate)

Dies vermeidet Alaising-Effekte.

Die Aufbereitungsvorrichtung **30** für die Ausgangssignale **31** der Fotodetektoren **PD** des Lichtsensorarrays **1** und/oder die Mustererkennungsvorrichtung **MEV** und/oder das weitere und/oder übergeordnete Rechnersystem **CTR2(28)** können typischerweise die ersten Mikrowellenmodulationsfrequenz **f**_{µW_I} des ersten Mikrowellenmodulationssignals **S5m**_**I** des ersten zweiten Signalgenerators **G2_I** über den Datenbus **DB** einstellen.

Die Aufbereitungsvorrichtung **30** für die Ausgangssignale **31** der Fotodetektoren **PD** des Lichtsensorarrays 1 und/oder die Mustererkennungsvorrichtung **MEV** und/oder das weitere und/oder übergeordnete Rechnersystem **CTR2(28)** können typischerweise die zweiten Mikrowellenmodulationsfrequenz **f**_{µW_II} des zweiten Mikrowellenmodulationssignals **S5m_II** des zweiten zweiten Signalgenerators **G2_II** über den Datenbus **DB** einstellen.

Die Aufbereitungsvorrichtung **30** für die Ausgangssignale **31** der Fotodetektoren **PD** des Lichtsensorarrays **1** und/oder die Mustererkennungsvorrichtung **MEV** und/oder das weitere und/oder übergeordnete Rechnersystem **CTR2(28)** können typischerweise die dritten Mikrowellenmodulationsfrequenz **f**_{µW_III} des dritten Mikrowellenmodulationssignals **S5m_III** des dritten zweiten Signalgenerators **G2_III** über den Datenbus **DB** einstellen.

Die Aufbereitungsvorrichtung **30** für die Ausgangssignale **31** der Fotodetektoren **PD** des Lichtsensorarrays **1** und/oder die Mustererkennungsvorrichtung **MEV** und/oder das weitere und/oder übergeordnete Rechnersystem **CTR2(28)** können typischerweise die vierte Mikrowellenmodulationsfrequenz **f**_{µW_IV} des vierten Mikrowellenmodulationssignals **S5m_IV** des vierten zweiten Signalgenerators **G2_IV** über den Datenbus **DB** einstellen.

Das optionale erste Mikrowellenmodulationssignal **S5m_I** kann typischerweise, wenn vorhanden, die Amplitude des ersten Mikrowellensignals **µW_I** modulieren.

Das optionale zweite Mikrowellenmodulationssignal **S5m_II** kann typischerweise, wenn vorhanden, die Amplitude des zweite Mikrowellensignals **µW_II** modulieren.

Das optionale dritte Mikrowellenmodulationssignal **S5m**_**III** kann typischerweise, wenn vorhanden, die Amplitude des dritte Mikrowellensignals **µW_III** modulieren.

Das optionale vierte Mikrowellenmodulationssignal **S5m_IV** kann typischerweise, wenn vorhanden, die Amplitude des vierten Mikrowellensignals **µW_IV** modulieren.

Bevorzugt übermittelt der erste zweite Signalgenerator **G2_I** das erste Mikrowellenmodulationssignal **S5m_I** auch an die Aufbereitungsvorrichtung **30** für die Ausgangssignale **31** der Fotodetektoren **PD** des Lichtsensorarrays **1** und/oder die Mustererkennungsvorrichtung **MEV** und ggf. über diese indirekt an das weitere und/oder übergeordnete Rechnersystem **CTR2(28).**

Bevorzugt übermittelt der zweite zweite Signalgenerator **G2_II** das zweite Mikrowellenmodulationssignal **S5m_II** auch an die Aufbereitungsvorrichtung **30** für die Ausgangssignale **31** der Fotodetektoren **PD** des Lichtsensorarrays **1** und/oder die Mustererkennungsvorrichtung **MEV** und ggf. über diese indirekt an das weitere und/oder übergeordnete Rechnersystem **CTR2(28).**

Bevorzugt übermittelt der dritte zweite Signalgenerator **G2_III** das dritte Mikrowellenmodulationssignal **S5m_III** auch an die Aufbereitungsvorrichtung **30** für die Ausgangssignale **31** der Fotodetektoren **PD** des Lichtsensorarrays **1** und/oder die Mustererkennungsvorrichtung **MEV** und ggf. über diese indirekt an das weitere und/oder übergeordnete Rechnersystem **CTR2(28).**

Bevorzugt übermittelt der erste vierte Signalgenerator G2_IV das vierte Mikrowellenmodulationssignal **S5m_IV** auch an die Aufbereitungsvorrichtung **30** für die Ausgangssignale **31** der Fotodetektoren **PD** des Lichtsensorarrays **1** und/oder die Mustererkennungsvorrichtung **MEV** und ggf. über diese indirekt an das weitere und/oder übergeordnete Rechnersystem **CTR2(28).**

Sofern eine solche Modulation entsprechend dem vektoriellen Mikrowellenmodulationssignal **S5m** stattfindet, berücksichtigen die Aufbereitungsvorrichtung **30** für die Ausgangssignale **31** der Fotodetektoren **PD** des Lichtsensorarrays **1** und/oder die Mustererkennungsvorrichtung **MEV** und ggf. über diese indirekt an das weitere und/oder übergeordnete Rechnersystem **CTR2(28)** den jeweiligen vektoriellen Wert des vektoriellen Mikrowellenmodulationssignals **S5m** bei der Ausführung der computerimplementierten Bilderkennungsverfahren und/oder Mustererkennungsverfahren.

Nach der Auswertung eines oder mehrerer Bilder des Lichtsensorarrays **1**, ermitteln die Aufbereitungsvorrichtung **30** für die Ausgangssignale **31** der Fotodetektoren **PD** des Lichtsensorarrays **1** und/oder die Mustererkennungsvorrichtung **MEV** und/oder das weitere und/oder übergeordnete Rechnersystem **CTR2**(**28**) bevorzugt einen Verfeinerungsbedarf, um die Messergebnisse in ihrer Präzision zu verbessern. Hierfür führen bevorzugt die Aufbereitungsvorrichtung **30** für die Ausgangssignale **31** der Fotodetektoren **PD** des Lichtsensorarrays **1** und/oder die Mustererkennungsvorrichtung **MEV** und/oder das weitere und/oder übergeordnete Rechnersystem **CTR2**(**28**) beispielsweise ein computerimplementiertes Bayes'sche Optimierungsverfahren durch. Bevorzugt ist der Programmcode für das beispielhafte Bayes'sche Optimierungsverfahren in einem Speichermedium der Vorrichtung, insbesondere einem Speicher (**RAM, NVM**), abgelegt. Bevorzugt führen die Aufbereitungsvorrichtung **30** für die Ausgangssignale **31** der Fotodetektoren **PD** des Lichtsensorarrays **1** und/oder die Mustererkennungsvorrichtung **MEV** und/oder das weitere und/oder übergeordnete Rechnersystem **CTR2(28)** diesen Programmcode bei Ausführung des computerimplementierten Bayes'sche Optimierungsverfahrens durch.

Während des beispielhaften Bayes'sche Optimierungsverfahrens können die Aufbereitungsvorrichtung **30** für die Ausgangssignale **31** der Fotodetektoren **PD** des Lichtsensorarrays **1** und/oder die Mustererkennungsvorrichtung **MEV** und/oder das weitere und/oder übergeordnete Rechnersystem **CTR2**(**28**) beispielsweise über den Datenbus **DB** neue vektorielle Mikrowellenfrequenzen (ω_{µW_I}, (ω_{µW_II}, ω_{µW_III}, ω_{µW_IV}) in der vektoriellen Mikrowellenquelle **µW** einstellen und so das Diagramm erfasste der Figur 51b an interessierenden Punkten andere Mikrowellenfrequenzen (ω_{µW_I}, ω_{µW_II}, ω_{µW_III}, ω_{µW_IV}) geeignet verfeinern. Während des beispielhaften Bayes'sche Optimierungsverfahrens können die Aufbereitungsvorrichtung 30 für die Ausgangssignale **31** der Fotodetektoren **PD** des Lichtsensorarrays **1** und/oder die Mustererkennungsvorrichtung **MEV** und/oder das weitere und/oder übergeordnete Rechnersystem **CTR2**(**28**) beispielsweise über den Datenbus **DB** andere zusätzliche magnetische Flussdichten **B_{ad}** einstellen, die die Magnetfelderzeugungsvorrichtung **L_{c}** erzeugt und die zur Gesamtflussdichte **B_{Σ}** jeweils beiträgt.

Hierdurch können die Aufbereitungsvorrichtung **30** für die Ausgangssignale **31** der Fotodetektoren **PD** des Lichtsensorarrays **1** und/oder die Mustererkennungsvorrichtung **MEV** und/oder das weitere und/oder übergeordnete Rechnersystem **CTR2(28)** den Erfassungsbereich in der Figur 51b nach oben oder unten verschieben und so signifikantere Stellen, wie beispielsweise den Punkt der Nullpunktsmikrowellenfrequenz ω_{µW0} und der Nullpunktsflussdichte **B₀**, in den Erfassungsbereich bringen. Solche Positionen sind besonders leicht zu erkennen. Hierdurch kann die Sensorvorrichtung sehr schnell die Präzision der Messwerte verbessern und durch die Ermittlung der Lage der Kurve der Figur 51b in einem Flussdichte-Mikrowellenfrequenzdiagramm die Parameter einer externen magnetischen Flussdichte **Bₑₓₜ** und einer unbekannten Mikrowellenfrequenz ω_{µWnk} eines von extern einwirkenden Mikrowellenfeldes insbesondere durch Mischung mit einer Mischfrequenz ermitteln.

Bevorzugt ermitteln die Steuervorrichtung **CTR** (Aufbereitungsvorrichtung **30)** und/oder die Mustererkennungsvorrichtung **MEV** und/oder das weitere und/oder übergeordnete Rechnersystem **CTR2**(**28**) unter Verwendung der besagten computerimplementierten Bildverarbeitungs- und/oder Mustererkennungsalgorithmen einen oder mehrere der folgenden Messwerte bzw. Messwertgruppen:
1. Informationen über die wahrscheinliche Lage der unteren Resonanzkante 5**22**,
2. Informationen über die wahrscheinliche Lage der unteren mittleren Resonanzkante 5**23**,
3. Informationen über die wahrscheinliche Lage der oberen mittleren Resonanzkante 5**24**,
4. Informationen über die wahrscheinliche Lage der oberen Resonanzkante 5**25**,
5. Informationen über die wahrscheinliche Lage des mittleren Resonanzminimums 5**29**,
6. Informationen über den wahrscheinlichen Wert der wirksamen Offsetflussdichte **B_{off}**,
7. Informationen über den wahrscheinlichen Wert der Nullpunktsflussdichte **B₀**,
8. Informationen über den wahrscheinlichen Wert der Nullpunktsmikrowellenfrequenz ω_{µW0},
Nach weiteren Messungen können die Steuervorrichtung **CTR** und/oder die Mustererkennungsvorrichtung **MEV** bzw. eine Auswertevorrichtung **30** und/oder das weitere und/oder übergeordnete Rechnersystem **CTR2(28)** auch hier auf einen oder mehrere der folgenden Werte schließen:
9. Informationen über den wahrscheinlichen Wert **564** der magnetischen Flussdichte **B₆₁**, der der oberen Referenzlinie **561** zugeordnet ist, an einem oder mehreren Arbeitspunkten,
10. Informationen über den wahrscheinlichen Wert **565** der magnetischen Flussdichte **B₆₂**, der der unteren Referenzlinie **562** zugeordnet ist, an einem oder mehreren Arbeitspunkten,
11. Informationen über die wahrscheinliche Differenz **566** des Werts der magnetischen Flussdichte **B₆₃**, der der mittleren Referenzlinie **563** zugeordnet ist, minus dem Wert **565** der magnetischen Flussdichte **B₆₂**, der der unteren Referenzlinie **562** zugeordnet ist,
12. Informationen über die wahrscheinliche Steigung **567** der Kurve an einem oder mehreren Arbeitspunkten;
13. Informationen über die Polynomkoeffizienten der Polynomapproximation **627** der Kurve in einigen Arbeitspunkten,
14. Informationen über den wahrscheinlichen Wert einer unteren wirksamen magnetischen Flussdichte **B₂₂**,
15. Informationen über den wahrscheinlichen Wert einer unteren mittleren wirksamen magnetischen Flussdichte **B₂₃**,
16. Informationen über den wahrscheinlichen Wert einer oberen mittleren wirksamen magnetischen Flussdichte **B₂₄**,
17. Informationen über den wahrscheinlichen Wert einer oberen wirksamen magnetischen Flussdichte **B₂₅**,
18. Informationen über den wahrscheinlichen Wert einer wirksamen magnetische Resonanzminimum-Flussdichte **B₂₉**,
19. Informationen über den wahrscheinlichen Wert einer Nullpunktsmikrowellenfrequenz ω_{µW0};
20. den wahrscheinlichen Wert einer unteren Mikrowellenfrequenz ω_{µW22};
21. Informationen über den wahrscheinlichen Wert einer unteren mittleren Mikrowellenfrequenz ω_{µW23};
22. Informationen über den wahrscheinlichen Wert einer oberen mittleren Mikrowellenfrequenz ω_{µW24};
23. Informationen über den wahrscheinlichen Wert einer oberen Mikrowellenfrequenz ω_{µW25};
24. Informationen über den wahrscheinlichen Wert einer Resonanzminimum-Mikrowellenfrequenz ω_{µW29};
25. Informationen über den wahrscheinlichen Wert einer unbekannten Mikrowellenfrequenz ω_{µWnk};
26. Informationen über den wahrscheinlichen Wert einer Mikrowellenmodulationsfrequenz **f**_{µW};

### Figur 82

Figur 82 zeigt das Diagramm der Figur 51b, wobei nun beispielhaft vier beispielhafte Mikrowellenfrequenzen (ω_{µW_I}, ω_{µW_II}, ω_{µW_III}, ω_{µW_IV}) eingezeichnet sind, mit denen beispielsweise eine Vorrichtung entsprechend der Figur 81 die Messwerte der Intensität der **I_{fl}(B_{ad})** Fluoreszenzstrahlung **FL** längs der vier eingezeichneten senkrechten Linien für verschiedene zusätzliche Beträge der magnetischen Flussdichte **B_{ad}** ermittelt. Hierdurch können die Steuervorrichtung **CTR** und/oder die Mustererkennungsvorrichtung **MEV** bzw. eine Auswertevorrichtung **30** den ersten Arbeitspunkt **14401** mit den Werten **B₂₂**, ω_{µW,22}=ω_{µW_I} und den zweiten Arbeitspunkt **14402** mit den Werten **B₂₂**, ω_{µW,22}=ω_{µW_II} auf der unteren Resonanzkante **522** ermitteln. Außerdem können hierdurch die Steuervorrichtung **CTR** und/oder die Mustererkennungsvorrichtung **MEV** bzw. eine Auswertevorrichtung **30** den dritten Arbeitspunkt **14403** mit den Werten **B₂₅**, ω_{µW,25}=ω_{µW_III} und den vierten Arbeitspunkt **14404** mit den Werten **B₂₂**, ω_{µW,25}=ω_{µW_IV} auf der oberen Resonanzkante **25** ermitteln. Es ist leicht zu erkennen, dass sich für Mikrowellenfrequenzen ω_{µW}, die größer als die Nullpunktsmikrowellenfrequenz ω_{µW0} sind auch Schnittpunkte der vertikalen Linien mit der unteren mittleren Resonanzkante 5**23**, mit der oberen mittleren Resonanzkante 5**24** und mit dem mittleren Resonanzminimum 5**29** ergeben können. Je nach Anwendung kann es daher besser sein, den linken Bereich des Diagramms der Figur 51b mit ω_{µW} <ω_{µW0} (präziser und eindeutiger) oder den rechten Bereich des Diagramms der Figur 51b mit ω_{µW} >ω_{µW0} (mehr Informationen) zu nutzen. Mittels computerimplementierter Verfahren können die Mustererkennungsvorrichtung **MEV** und/oder die Steuervorrichtung **CTR** die Position der Spitze **30** der F-Formation (**522**, 5**25**) ermitteln und daraus Messwerte für gesuchte physikalische Parameter ableiten.

### Figur 83

Figur 83 zeigt beispielhaft die innere Struktur einer vektoriellen Mikrowellenquelle **µWG** mit den Mikrowellenquellen (**µWG_I**, **µWG_II**, **µWG_III**, **µWG_IV**) der Figur 81 im Falle der Zumischung eines externen Signals **S_{ωnk}** mit unbekannter Mikrowellenfrequenz ωₙₖ am Beispiel der Mikrowellenquellen (**µWG_I, µWG_II, µWG_III, µWG_IV**) der Figur 81.

In dem Beispiel erzeugt die erste interne Mikrowellenquelle **µW_G_I** in Abhängigkeit von dem ersten Mikrowellenmodulationssignal **S5m_I** und den über den Datenbus **DB** durch die Steuervorrichtung **CTR** oder die Auswertevorrichtung **30** oder die Mustererkennungsvorrichtung **MEV** eingestellten Parametern das erste internen Mikrowellensignal **µW_G_I**. Bevorzugt hängt die Amplitude des ersten internen Mikrowellensignals **µW_G_I** von dem ersten Mikrowellenmodulationssignal **S5m_I** ab. Das erste interne Mikrowellensignal **µW_G_I** weist dabei eine ersten Mikrowellenfrequenz ω_{µW_I} auf.

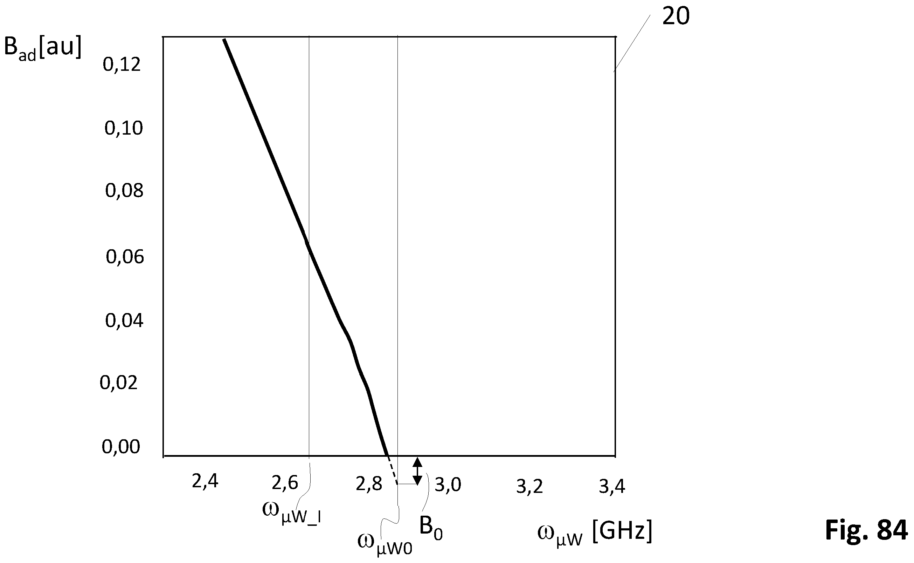

Ein erster interner Mixer **µW_MX_I** innerhalb der ersten Mikrowellenquelle **µWG_I** mischt nun das ersten interne Mikrowellensignal **µW_G_I** mit dem Signal **S_{ωnk}** mit der unbekannten Mikrowellenfrequenz ωₙₖ. Der erste interne Mixer **µW_MX_I** bildet somit das so gemischte erste Mikrowellenmischsignal **µW_MX_I.** Ein erster Mikrowellenfilter **µW_F_I** (Siehe Figur 83) eliminiert bevorzugt einen der beiden bei ω_{µW_I}-ωₙₖ und ω_{µW_I}+ωₙₖ entstehenden Transienten in dem erste Mikrowellenmischsignal **µW_MX_I** und bildet das erste Mikrowellensignal **µW_I.** Bevorzugt ist die Grenzfrequenz des ersten Mikrowellenfilters **µW_F_I** bei einem Tiefpass als ersten Mikrowellenfilter **µW_F_I** kleiner als die Nullpunktsmikrowellenfrequenz ω_{µW0}. Bevorzugt ist die Grenzfrequenz des ersten Mikrowellenfilters **µW_F_I** bei einem Hochpass als ersten Mikrowellenfilter **µW_F_I** größer als die Nullpunktsmikrowellenfrequenz ω_{µW0}. Hierdurch wird das Diagramm der Figur 51b betreffend die Position der untere Resonanzkante **522** in eine umkehrbare Funktion ω_{µW}(**B_{ad}**) gewandelt. (siehe Figur 84)

In dem Beispiel erzeugt die zweite interne Mikrowellenquelle **µW_G_II** in Abhängigkeit von dem zweiten Mikrowellenmodulationssignal **S5m_II** und den über den Datenbus **DB** durch die Steuervorrichtung **CTR** oder die Auswertevorrichtung **30** oder die Mustererkennungsvorrichtung **MEV** eingestellten Parametern das zweite internen Mikrowellensignal **µW_G_II**. Bevorzugt hängt die Amplitude des zweiten internen Mikrowellensignals **µW_G_II** von dem zweiten Mikrowellenmodulationssignal **S5m_II** ab. Das zweite interne Mikrowellensignal **µW_G_II** weist dabei eine zweite Mikrowellenfrequenz ω_{µW_II} auf.

Ein zweiter interner Mixer **µW_MX_II** innerhalb der zweiten Mikrowellenquelle **µWG_II** mischt nun das zweite interne Mikrowellensignal **µW_G_II** mit dem Signal **S**_{ωnk} mit der unbekannten Mikrowellenfrequenz ωₙₖ. Der zweite interne Mixer **µW_MX_II** bildet somit das so gemischte zweite Mikrowellenmischsignal **µW_MX_II**. Ein zweiter Mikrowellenfilter **µW_F_II** (Siehe Figur 83) eliminiert bevorzugt einen der beiden bei ω_{µW_II}-ωₙₖ und ω_{µW_II}+ωₙₖ entstehenden Transienten in dem zweiten Mikrowellenmischsignal **µW_MX_II** und bildet das zweite Mikrowellensignal **µW_II**. Bevorzugt ist die Grenzfrequenz des zweiten Mikrowellenfilters **µW_F_II** bei einem Tiefpass als zweiten Mikrowellenfilter **µW_F_II** kleiner als die Nullpunktsmikrowellenfrequenz ω_{µW0}. Bevorzugt ist die Grenzfrequenz des zweiten Mikrowellenfilters **µW_F_II** bei einem Hochpass als zweiten Mikrowellenfilter **µW_F_II** größer als die Nullpunktsmikrowellenfrequenz ω_{µW0}. Hierdurch wird das Diagramm der Figur 51b betreffend die Position der untere Resonanzkante **522** in eine umkehrbare Funktion ω_{µW}(**B**_{ad}) gewandelt. (siehe Figur 84)

In dem Beispiel erzeugt die dritte interne Mikrowellenquelle **µW_G_III** in Abhängigkeit von dem dritten Mikrowellenmodulationssignal **S5m_III** und den über den Datenbus **DB** durch die Steuervorrichtung **CTR** oder die Auswertevorrichtung **30** oder die Mustererkennungsvorrichtung **MEV** eingestellten Parametern das dritte internen Mikrowellensignal **µW_G_III.** Bevorzugt hängt die Amplitude des dritten internen Mikrowellensignals **µW_G_III** von dem dritten Mikrowellenmodulationssignal **S5m_III** ab. Das dritte interne Mikrowellensignal **µW_G_III** weist dabei eine dritte Mikrowellenfrequenz ω_{µW_III} auf.

Ein dritter interner Mixer **µW_MX_III** innerhalb der dritten Mikrowellenquelle **µWG_III** mischt nun das dritte interne Mikrowellensignal **µW_G_III** mit dem Signal **S**_{ωnk} mit der unbekannten Mikrowellenfrequenz ωₙₖ. Der dritte interne Mixer **µW_MX_III** bildet somit das so gemischte dritte Mikrowellenmischsignal **µW_MX_III**. Ein dritter Mikrowellenfilter **µW_F_III** (Siehe Figur 83) eliminiert bevorzugt einen der beiden bei ω_{µW_III}-ωₙₖ und ω_{µW_III}+ωₙₖ entstehenden Transienten in dem dritten Mikrowellenmischsignal **µW_MX_III** und bildet das dritte Mikrowellensignal **µW_III**. Bevorzugt ist die Grenzfrequenz des dritten Mikrowellenfilters **µW_F_III** bei einem Tiefpass als dritten Mikrowellenfilter **µW_F_III** kleiner als die Nullpunktsmikrowellenfrequenz ω_{µW0}. Bevorzugt ist die Grenzfrequenz des dritten Mikrowellenfilters **µW_F_III** bei einem Hochpass als dritten Mikrowellenfilter **µW_F_III** größer als die Nullpunktsmikrowellenfrequenz ω_{µW0}. Hierdurch wird das Diagramm der Figur 2 betreffend die Position der untere Resonanzkante **522** in eine umkehrbare Funktion ω_{µW}(**B**_{ad}) gewandelt. (siehe Figur 84)

In dem Beispiel erzeugt die vierte interne Mikrowellenquelle **µW_G_IV** in Abhängigkeit von dem vierten Mikrowellenmodulationssignal **S5m_IV** und den über den Datenbus **DB** durch die Steuervorrichtung **CTR** oder die Auswertevorrichtung **30** oder die Mustererkennungsvorrichtung **MEV** eingestellten Parametern das vierte interne Mikrowellensignal **µW_G_IV.** Bevorzugt hängt die Amplitude des vierten internen Mikrowellensignals **µW_G_IV** von dem vierten Mikrowellenmodulationssignal **S5m_IV** ab. Das vierte interne Mikrowellensignal **µW_G_IV** weist dabei eine vierte Mikrowellenfrequenz ω_{µW_IV} auf.

Ein vierter interner Mixer **µW_MX_IV** innerhalb der vierten Mikrowellenquelle **µWG_IV** mischt nun das vierte interne Mikrowellensignal **µW_G_IV** mit dem Signal S_{ωnk} mit der unbekannten Mikrowellenfrequenz ωₙₖ. Der vierte interne Mixer **µW_MX_IV** bildet somit das so gemischte vierte Mikrowellenmischsignal **µW_MX_IVI.** Ein vierter Mikrowellenfilter **µW_F_IV** (Siehe Figur 83) eliminiert bevorzugt einen der beiden bei ω_{µW_IV}-ωₙₖ und ω_{µW_IV}+ωₙₖ entstehenden Transienten in dem vierten Mikrowellenmischsignal **µW_MX_IV** und bildet das vierte Mikrowellensignal **µW_IV.** Bevorzugt ist die Grenzfrequenz des vierten Mikrowellenfilters **µW_F_IV** bei einem Tiefpass als vierten Mikrowellenfilter **µW_F_IV** kleiner als die Nullpunktsmikrowellenfrequenz ω_{µW0}. Bevorzugt ist die Grenzfrequenz des vierten Mikrowellenfilters **µW_F_IV** bei einem Hochpass als vierten Mikrowellenfilter **µW_F_IV** größer als die Nullpunktsmikrowellenfrequenz ω_{µW0}. Hierdurch wird das Diagramm der Figur 51b betreffend die Position der untere Resonanzkante **522** in eine umkehrbare Funktion ω_{µW}(**B**_{ad}) gewandelt. (siehe Figur 84)

### Figur 84

Figur 84 veranschaulicht, die Funktionsbildung der Kurve der unteren Resonanzkante 5**22** durch Tiefpassfilterung in den Mikrowellenfiltern (**µW_F_I, µW_F_II, µW_F_III, µW_F_IV**) (Siehe Figuren 81, 82 und 83).

### Figur 85

Die Grundidee der Herstellung eines kolloidalen Lackes **KL** zur Belackung und/oder zum Bedrucken des Trägersubstrats **1360** ist in Figur 85 dargestellt:
Zunächst gehen wir hier davon aus, dass die Kristalle bzw. Diamant-Nano-Kristalle **ND** in ausreichend großen Mengen in vorzugsweise im Wesentlichen gleicher Form vorliegen. Beispielhaft gehen wir hier davon aus, dass es sich bei den Kristallen bzw. Diamant-Nano-Kristallen **ND** um Nanodiamanten mit einem oder mehreren paramagnetischen Zentren, vorzugsweise mit einem oder mehreren NV-Zentren, handelt. Andere Kristallmaterialien und/oder paramagnetische Zentren sind denkbar, wenn sie ebenfalls eine Fluoreszenzstrahlung **FL** bei Bestrahlung mit einer Pumpstrahlung **LB** einer typischerweise Zentren spezifischen Pumpstrahlungswellenlänge **λₚₘₚ** emittieren. Die Diamant-Nano-Kristalle **ND** stehen hier somit beispielhaft für andere mögliche Kristalle mit möglicherweise anderen Eigenschaften und/oder anderen paramagnetischen Zentren. Auf den Rest dieses Dokuments wird hier verwiesen. Im Falle der Diamant-Nano-Kristalle **ND,** die Diamant umfassen, sind NV-Zentren als paramagnetische Zentren bevorzugt.

Die Kristalle mit paramagnetischen Zentren und/oder Diamant-Nano-Kristalle **ND** mit paramagnetischen Zentren und/oder NV-Zentren werden mit dem zuvor ausgewählten und in geeigneter Form bereitgestelltem Trägermaterial **TM** und ggf. einem Lösungsmittel **LM** zur Einstellung der Viskosität beispielhaft zur Vermischung in einen Behälter gegeben und mittels Verrühren **VR** gemischt, bis eine kolloidale Mischung (kolloidaler Lack **KL**) entsteht, die für die vorgesehene Weiterverarbeitung beispielsweise in einer Nachfolgenden Spin-On-Belackung oder einen Druckvorgang, beispielsweise einen Siebdruckvorgang und/oder einem Schablonendruck und/oder Tampon-Druck, geeignet ist.

Das hier vorgestellte Dokument schlägt als Trägermaterial **TM** beispielsweise ein klares, farbloses, flüssiges Fotopolymer, beispielsweise den optischen Norland Klebstoff 61 vor. Weitere Informationen sind zum Zeitpunkt der Anmeldung des hier vorgelegten Dokuments unter https://www.norlandprod.com/adhesives/noa%2061.html verfügbar.

Norland Optical Adhesive 61 ("NOA 61") ist ein klares, farbloses, flüssiges Fotopolymer, das unter Bestrahlung mit einer Aushärtestrahlung **4910** mit der Aushärtewellenlänge λ_{H} im ultraviolettem Wellenlängenbereich aushärtet. Da es sich um ein Einkomponentensystem mit 100 % Feststoffanteil handelt, bietet es viele Vorteile bei Verklebungen, bei denen der Klebstoff UV-Licht ausgesetzt werden kann. Durch die Verwendung von NOA 61 entfällt das Vormischen, Trocknen oder Aushärten durch Wärme, wie es bei anderen Klebstoffsystemen üblich ist. Die Aushärtezeit ist typischerweise kurz und hängt von der aufgetragenen Dicke **D_{SE}** der Sensorelementschicht **5** bzw. des Sensorelements **SE** und der verfügbaren UV-Lichtenergie ab. Es ist besonders sinnvoll, wenn das Trägermittel **TM** die Federal Specification MIL-A-3920 für optische Klebstoffe erfüllt. NOA 61 erfüllt als Trägermittel **TM** die Federal Specification MIL-A-3920 vom 21 Februar 1977 für optische Klebstoffe. Das Trägermaterial **TM** soll eine bestmögliche optische Verbindung zu der Oberfläche des Trägersubstrats **1360** herstellen können. Dementsprechend soll Das Trägermaterial **TM** soll eine bestmögliche optische und/oder mechanische Verbindung zu FR-4-Oberflächen (Flameresistent-4) oder PTFE-Oberflächen (Polytetrafluorethylen) oder Oberflächen halbleitender Materialien, wie beispielsweise zu Oberflächen von Stücken von Platinenmaterialien oder von Stücken von Kunststoffplatten- oder -folien und/oder von Stücken von Glas-Wafern oder von Stücken von Keramik-Wafern und/oder von Stücken von Halbleiterwafern, beispielsweise Oberflächen von Stücken von CMOS-Wafern oder beispielsweise von Stücken von BiCMOS-Wafern beispielsweise Stücken von Wafern aus einer Bipolar-Technologie oder von Stücken eines Wafers aus einem III/V-Material oder dergleichen und/oder beispielsweise von Stücken von MEMS-Wafern und/oder von Stücken mikroelektronischen Schaltungen und/oder beispielsweise von Stücken von MEOS-Wafern (MEOS= micro electro optical system) und/oder beispielsweise von Stücken von MOEMS-Wafern etc. und/oder von Stücken von MOEMS-Wafern mikroelektronischer Schaltkreise und mikroelektronischer Funktionselemente und/oder mikrooptische Funktionselemente und/oder mikromechanischer Funktionselemente und/oder mikrofluidischer Funktionselemente je nach Anwendungsbereich herstellen können. NOA61 erfüllt diese Voraussetzungen in der Regel und insbesondere auch über den benötigten Temperaturbereich und typischerweise die erwartete Lebensdauer. Dies macht eine Produktqualifikation aber nicht überflüssig. Besonders günstig ist die Verwendung eines Trägermaterials **TM,** das für die Verklebung von Linsen, Prismen und Spiegeln für militärische, luft- und raumfahrttechnische und kommerzielle Optiken sowie für den Abschluss und das Spleißen von Glasfasern empfohlen ist. NOA61 erfüllt diese Voraussetzungen.

Das Trägermaterial **TM** soll sich typischerweise nach Herstellerangaben außerdem durch hervorragende Klarheit, geringe Schrumpfung und Lichtflexibilität auszeichnen. Diese Eigenschaften sind wichtig, damit der Anwender qualitativ hochwertige Sensorelemente **SE** und/oder Sensorelementschichten SE(5) herstellen und eine langfristige Leistung unter wechselnden aggressiven Umgebungsbedingungen erzielen kann.

NOA 61 härtet, wie für das Trägermaterial **TM** gewünscht, mit ultraviolettem Licht als Aushärtestrahlung **4910** aus, wobei die maximale Absorption im Bereich von 320-380 Nanometern für die Aushärtewellenlänge λ_{H} liegt und die höchste Empfindlichkeit für die Aushärtung von NOA61 bei einer Aushärtewellenlänge λ_{H} von 365 nm erreicht wird. Die empfohlene Energie für die vollständige Aushärtung beträgt 3 Joule/cm² bei diesen Aushärtewellenlängen λ_{H}. Die Aushärtung von NOA 61 wird durch Sauerstoff nicht gehemmt, so dass alle Bereiche, die mit Luft in Berührung kommen, zu einem nicht klebrigen Zustand aushärten, wenn sie ultraviolettem Licht als Aushärtestrahlung **4910** ausgesetzt werden.

Bei den meisten optischen Anwendungen erfolgt die Aushärtung mittels der als Aushärtestrahlung **4910** in zwei Schritten. Zunächst erfolgt eine kurze, gleichmäßige Belichtung, die sogenannte Vorhärtung mit einer Aushärtestrahlung **4910** mit einer Aushärtewellenlänge λ_{H}. Die Aushärtungszeit ist ausreichend lang, um die Verbindung zu verfestigen und zu ermöglichen, dass sie bewegt/transportiert werden kann, ohne die Ausrichtung zu stören. Danach folgt eine längere Aushärtung unter UV-Licht als Aushärtestrahlung **4910,** um eine vollständige Vernetzung und Lösungsmittelbeständigkeit des Klebstoffs, also beispielsweise NOA 61, zu erreichen. Die Aushärtung mit Aushärtestrahlung **4910** kann in dem Beispiel NOA 61 als Trägermaterial **TM** in 10 Sekunden mit einer 100-Watt-Quecksilberlampe bei 6" erfolgen. Wenn für die Ausrichtung eine längere Zeit erforderlich ist, kann sie mit einer Lichtquelle für Aushärtestrahlung **4910** mit sehr geringer Intensität auf einige Minuten im Falle des beispielhaften Trägermaterials TM NOA 61 verlängert werden. Die endgültige Aushärtung kann im Falle des beispielhaften Trägermaterials **TM** mit der 100-Watt-Quecksilberlampe in 5 bis 10 Minuten erreicht werden.

Die Vorhärtung ermöglicht es dem Anwender, den das Trägersubstrat **1360** und/oder Lichtwellenleiter **LWL** im Falle der getrennten Bereitstellung bei Bedarf schnell gegeneinander noch auszurichten und zu fixieren, und minimiert die Anzahl der erforderlichen Haltevorrichtungen. Nach der Vorfixierung kann überschüssiger Klebstoff mit einem mit Alkohol oder Aceton als beispielhaftes Lösungsmittel **LM** angefeuchteten Tuch abgewischt und/oder abgespült werden. Die Lichtwellenleiter **LWL** sollten zu diesem Zeitpunkt geprüft und Ausschuss in Methylenchlorid separiert werden. Der beschichtete Bereich der Sensorelemente **SE** und/oder der Sensorelementschichten 5 muss für eine Nacharbeit typischerweise in dem Lösungsmittel **LM** eingeweicht werden und löst sich normalerweise über Nacht. Die Zeit, die benötigt wird, um das Trägermaterial **TM** für eine Nacharbeit zu lösen, hängt vom Ausmaß der Aushärtung und der Größe der Beschichtung ab.

Nach der Aushärtung weist NOA 61 als Trägermaterial **TM** eine sehr gute Haftung und Lösungsmittelbeständigkeit auf, aber es hat noch nicht seine optimale Haftung auf Glas und/oder SiO₂-Halbleiterwafer-Oberflächen erreicht. Diese wird durch eine Alterung über einen Zeitraum von etwa 1 Woche erreicht, in der sich eine chemische Verbindung zwischen Glas bzw. SiO₂-Oberfläche einerseits und Trägermaterial **TM** bildet. Diese optimale Haftung kann auch durch eine Alterung des Trägersubstrats **1360** mit der Sensorelementschicht **5** und/oder den Sensorelementen **SE** bei 50° C für 12 Stunden in einem Temperaturschrank erreicht werden.

NOA 61 hält vor der Alterung Temperaturen von -15°C bis 60° C stand, wenn es zum Beschichten des Lichtwellenleiters LWL und/oder des Trägersubstrats **1360** verwendet wird. Nach der Alterung hält es Temperaturen von -150°C bis 125°C stand. Damit ist dieses Trägermaterial **TM** NOA 61 automotive-tauglich. Als Beschichtung auf der Oberfläche des Lichtwellenleiters **LWL** und/oder des Trägersubstrats **1360** hält NOA 61 drei Stunden lang 260°C und beim Reflow-Löten stand. Dies ist insbesondere dann von Interesse, wenn das Trägersubstrat ein Platinenmaterial, beispielsweise mit elektronischen Bauelementen ist. Das hier vorgelegte Dokument verweist in diesem Zusammenhang auf die noch unveröffentlichte Schrift DE 10 2023 111 858.7. Hierdurch können das Sensorelement **SE** und/oder die Sensorelementschicht 5 und/oder die vorschlagsgemäßen Lichtwellenleiter **LWL** bis zu diesen Temperaturen für die Messung der magnetischen Gesamtflussdichte **B_{Σ}** und/oder zur Messung von unbekannten Mikrowellenfrequenzen ωₙₖ verwendet werden. Das hier vorgelegte Dokument schlägt daher die Verwendung eines vorschlagsgemäßen Lichtwellenleiters **LWL** und/oder das Sensorelements **SE** und/oder der Sensorelementschicht **5** bei Temperaturen oberhalb von 100°C und/oder sogar oberhalb von 110°C und/oder sogar oberhalb von 120°C und/oder sogar oberhalb von 130°C und/oder sogar oberhalb von 140°C und/oder sogar oberhalb von 150°C und/oder sogar oberhalb von 160°C und/oder sogar oberhalb von 170°C und/oder sogar oberhalb von 180°C und/oder sogar oberhalb von 190°C und/oder sogar oberhalb von 200°C und/oder sogar oberhalb von 210°C und/oder sogar oberhalb von 220°C und/oder sogar oberhalb von 230°C und/oder sogar oberhalb von 240°C und/oder sogar oberhalb von 250°C und/oder sogar oberhalb von 260°C vor. Hierbei ist zu beachten, dass hier die Eigenschaften des Materials des eines vorschlagsgemäßen Lichtwellenleiters **LWL** und/oder des Sensorelements **SE** und/oder der Sensorelementschicht **5** nicht berücksichtigt wurden, die ggf. diese Temperaturbereiche nicht mehr zulassen, was im Falle einer Nacharbeit zu prüfen wäre.

Typische Eigenschaften eines Trägermaterials **TM** sind ein Feststoffgehalt mehr als 80%, eine Viskosität bei 25°C von mehr als 250 cps, ein Brechungsindex des gehärteten Trägermaterials **TM** von mehr als 1,2 eine Dehnung bei Bruch von weniger als 50% oder mehr als 25% je nach Anwendung, ein Elastizitätsmodul von weniger als (psi) 200.000, eine Zugfestigkeit von mehr als (psi) 3.000 und eine Härte von mehr als Shore D 60. Typische Eigenschaften von NOA 61 als beispielhaftes Trägermaterial **TM** sind ein Feststoffgehalt von 100%, eine Viskosität bei 25°C von 300 cps, en Brechungsindex des gehärteten Polymers des Trägermaterials **TM** von 1,56, eine Dehnung bei Bruch von 38%, ein Elastizitätsmodul von (psi) 150.000, eine Zugfestigkeit von (psi) 3.000 und eine Härte von Shore D 85.

Wie bereits beschrieben, sind diese Verfahren prinzipiell nicht auf die Verwendung Trägermaterials **TM** (NAO 61 in z.B. alkoholischer Lösung) und dieser Kristalle bzw. Diamant-Nano-Kristalle **ND** mit paramagnetischen Zentren, insbesondere NV-Zentren beschränkt. Beispielsweise können auch statt der Diamanten mit NV-Zentren als Diamant-Nano-Kristalle **ND** auch Diamant-Nano-Kristalle **ND** mit SiV-Zentren und/oder mit TiV-Zentren und/oder mit GeV-Zentren und/oder mit SnV-Zentren und/oder mit NiN4-Zentren und/oder mit PbV-Zentren und/oder mit ST1-Zentren als paramagnetischen Zentren verwendet werden, wobei deren Eignung ggf. bei einer Nacharbeit zuvor durch eine fachkundige Person zu prüfen wäre. Solche alternativen paramagnetischen Zentren und/oder Materialien für Kristalle und/oder Diamant-Nano-Kristalle **ND** müssen für die Erfüllung des technischen Zwecks des herzustellenden Systems dienlich sein, was jeweils zu Beginn einer Nacharbeit zu prüfen wäre. Zur Vereinfachung der Beschreibung stellen wir hier nicht alle sinnvollen Varianten dar. Die Beanspruchung umfasst aber auch solche Kombinationen. Es können also auch andere Kombinationen aus Kristalle anderer Materialien und anderer Trägermaterialien **TM** und anderer Lösungsmittel **LM** verwendet werden, wenn die durch das herzustellende System zu lösende technische Aufgabe und die beabsichtigte Herstellungsmethode (Belacken und/oder Bedrucken und/oder lokales Benetzen) dies erfordert. Im Folgenden wird meistens nur der Begriff Belacken verwendet. Sofern anwendbar soll dieser Begriff auch die Begriffe Belacken, Beschichten und und/oder lokales Benetzen umfassen. Das Bezugszeichen **ND** steht hier also nicht nur für Diamant-Nano-Kristalle **ND,** die Diamant als Material umfassen, sondern auch für allgemeinere Kristalle. Die Kristalle können auch poly-Kristallin sein und dann auch verschiedene Materialien und Schichten umfassen. Beispielsweise kann es sich um Silizium-Nanokristalle und/oder Kristalle und Mischkristalle beispielsweise umfassend III/V-Materialeien handeln, die beispielsweise von einer SiO₂-Schicht oder eine andere optisch in den relevanten Wellenlängenbereichen (λₚₘₚ, λ_{fl}) transparente Isolationsschicht eigehüllt sind und bevorzugt geeignete paramagnetische Zentren aufweisen. Aus dem Stand der Technik sind beispielsweise darüber hinaus zahlreiche verschiedene transparente Lacke bekannt, die ggf. auf ihre jeweilige Eignung als Trägermaterial **TM** bei Verwendung anstelle von NOA61 jeweils geprüft werden können. Das hier geschriebene gilt für die Diamant-Nano-Kristalle **ND** im ganzen Dokument.

### Figur 86

Das hier vorgestellte Verfahren sieht in seiner Grundversion vor, einen kolloidalen Lack **KL** umfassend ein Trägermaterial **TM** und Kristalle und/oder Diamant-Nano-Kristalle **ND** auf das Trägersubstrat **1360** aufzubringen.

Typischerweise umfasst das Trägersubstrat **1360** Materialien wie FR-4 (Flameresistent-4) oder PTFE (Polytetrafluorethylen) oder halbleitende Materialien, wie beispielsweise Stücke von Platinenmaterialien oder Stücke von Kunststoffplatten- oder -folien und/oder Stücke von Glas-Wafern oder Stücke von Keramik-Wafern und/oder Stücke von Halbleiterwafern, beispielsweise Stücke von CMOS-Wafern oder beispielsweise Stücke von BiCMOS-Wafern und/oder beispielsweise Stücke von Wafern aus einer Bipolar-Technologie und/oder Stücke eines Wafers aus einem III/V-Material oder dergleichen und/oder beispielsweise Stücke von MEMS-Wafern und/oder Stücke mikroelektronischer Schaltungen und/oder beispielsweise Stücke von MEOS-Wafern (MEOS= micro electro optical system) und/oder beispielsweise Stücke von MOEMS-Wafern etc. und/oder Stücke von MOEMS-Wafern mikroelektronische Schaltkreise und mikroelektronischer Funktionselemente und/oder mikrooptische Funktionselemente und/oder mikromechanische Funktionselemente und/oder mikrofluidische Funktionselemente.

Das Aufbringen des kolloidalen Lackes **KL** auf das Trägersubstrat **1360** kann beispielsweise durch Aufschleudern oder Aufsprühen oder Aufdrucken oder ähnliche Verfahren erfolgen. (Siehe Figur 147.) Hinsichtlich der im Stand der Mikrotechnik möglichen Belackungsverfahren sei hier beispielhaft auf Marc J. Madou "Fundamentals of Microfabrication: the science of miniaturization" CRC Press 2002 verwiesen.

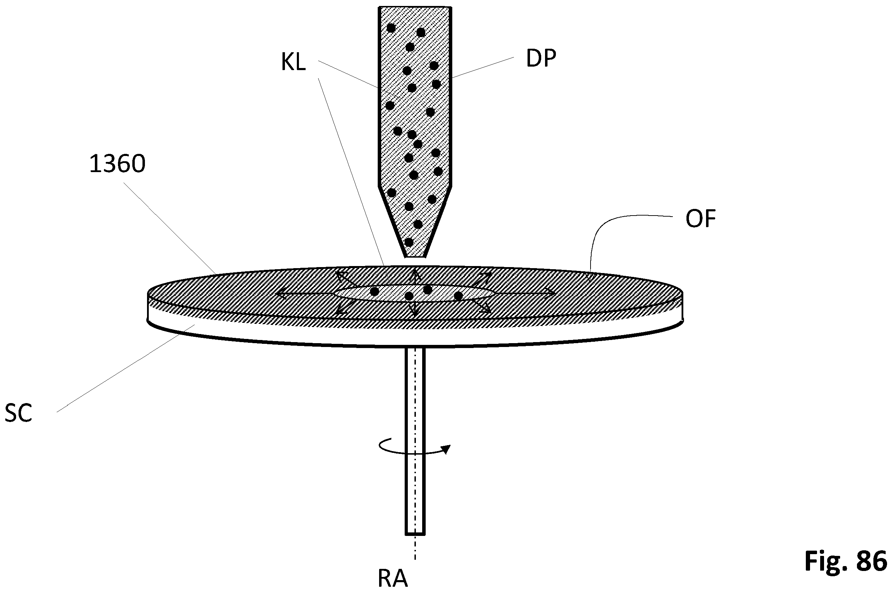

Die Figur 86 stellt ein mögliches, dem entsprechendes Belackungsverfahren beispielhaft dar. Der kolloidale Lack **KL** wird beispielhaft mittels eines Dispensers **DP,** einer speziellen Dosiervorrichtung, bevorzugt im Symmetriezentrum des beispielhaften Trägersubstrats **1360,** hier ein beispielhafter Wafer, auf dieses in einem bevorzugt vorbestimmten zeitlichen Mengenverlauf pro Zeiteinheit aufgebracht. Das beispielhafte Trägersubstrats **1360** in Form des beispielhaften Wafers, der hier das beispielhafte Trägersubstrat **1360** darstellt, liegt in diesem Beispiel auf dem Drehteller einer Lackschleuder **SC.** Dieser Drehteller der Lackschleuder **SC** rotiert mit einer prozesstypischen Geschwindigkeit typischerweise entsprechend einem prozesstypischen zeitlichen Geschwindigkeitsprofil. Die Auftragung und die Rotationsgeschwindigkeit können vom Zeitpunkt seit dem Beginn der Belackung beispielsweise durch den Dispenser **DP** abhängen, um ein optimales Ergebnis für die Belackung mit dem kolloidalen Lack **KL** und die Platzierung der Nanopartikel **NP** sicherzustellen. Sie folgen also bevorzugte einem Rotationsgeschwindigkeitsprofil bzw. einem zeitlichen Profil der Auftragungsmenge des kolloidalen Lacks **KL.**

### Figur 87

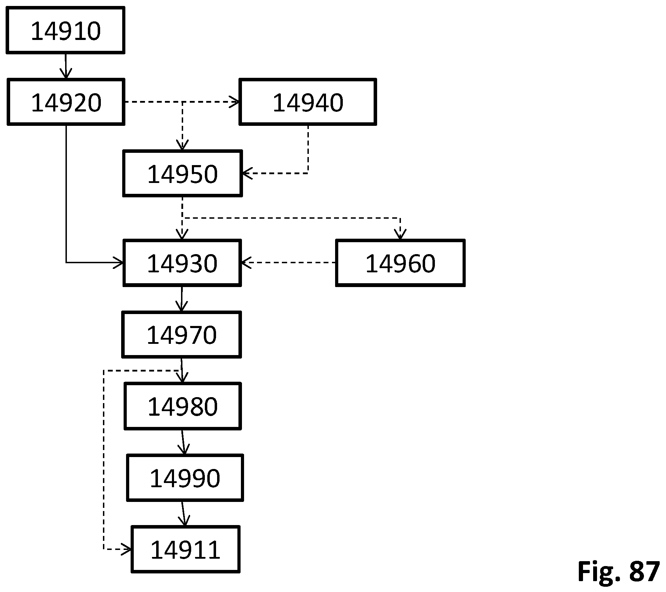

Die beispielhaften Schritte eines Wafer basierenden Belackungsverfahrens sind in Figur 87 beispielhaft schematisch und vereinfacht dargestellt.

Das betreffende beispielhafte Belackungsverfahren der Figur 87 beginnt mit dem Verfahrensbeginn **14910**. Es folgt das Bereitstellen **14920** Trägersubstrats **1360,** bevorzugt also eines Halbleitersubstrates - beispielsweise eines Wafers.

Sodann folgt bevorzugt das Bereitstellen **14930** des eines kolloidalen Lackes **KL** in Form einer kolloidalen Lösung von Kristallen bzw. Diamant-Nano-Kristallen **ND** in einem noch flüssigen Trägermaterial **TM** und ggf. einem zusätzlichen Lösungsmittel. Dabei kann das Bereitstellen **14920** Trägersubstrats **1360** und das Bereitstellen **14930** des eines kolloidalen Lackes **KL** in beliebiger Reihenfolge hintereinander oder gleichzeitig erfolgen. Die Kristalle bzw. Diamant-Nano-Kristalle **ND** umfassen dabei bevorzugt paramagnetische Zentren und/oder NV-Zentren in Diamant.

Der kolloidale Lack **KL** wird später strukturiert und zu einem strukturierten kolloidalen Film in Form der Sensorelemente **SE** auf dem Trägersubstrat **1360** bevorzugt mittels einer Aushärtestrahlung **4910** mit der Aushärtewellenlänge λ_{H} gehärtet. Der kolloidale Lack **KL** wird vorzugsweise strukturiert zu einem strukturierten kolloidalen Film in Form der Sensorelemente **SE** auf dem Trägersubstrat **1360** ganz besonders bevorzugt mittels einer lokal selektiv aufprojezierten oder zugeführten Aushärtestrahlung **4910** mit der Aushärtewellenlänge λ_{H} lokal und selektiv gehärtet. Vorzugsweise werden optische Funktionselemente der Vorrichtung, beispielsweise Lichtwellenleiter LWL und/oder als Lichtwellenleiter verwendete Trägersubstrate **1360,** die später gegenüber den dann ausgebildeten Sensorelementen **SE** und/oder den dann ausgebildeten Sensorelementschichten **5** justiert sein müssen, für die Zuführung Aushärtestrahlung **4910** mit der Aushärtewellenlänge λ_{H} verwendet, sodass sich durch diese Zuführung automatisch ein selbstjustierender Aushärteeffekt des UV-aushärtbaren kolloidalen Lackes **KL** bei der Ausbildung der Sensorelemente **SE** und/oder der Sensorelementschichten **5** gegenüber diesen optische Funktionselemente der Vorrichtung, beispielsweise Lichtwellenleiter **LWL** und/oder als Lichtwellenleiter verwendete Trägersubstrate **1360** justiert sein müssen. Damit dieser spätere ausgehärtete kolloidalen Film in Form der Sensorelemente **SE** auf der Oberfläche des Trägersubstrat **1360** haften kann, sollte der kolloidale Lack **KL** der Kristallen bzw. Diamant-Nano-Kristallen **ND** zumindest Teile des Trägersubstrats **1360** benetzen können. Dies kann beispielsweise durch eine oder mehrere optionale vorausgehende Plasmabehandlungen **14950** mit Wasserstoff oder Sauerstoff oder der Gleichen bekanntermaßen gesteuert werden. Hierbei können die Benetzungseigenschaften der Oberfläche mittels einer der Plasmabehandlung vorausgehenden Fotolithografie **14940** auch in der Fläche moduliert (benetzend vs. nicht benetzend) ausgeführt werden. Hierzu werden vor der Plasmabehandlung **14950** einige Oberflächenbereiche beispielsweise mit Fotolack in dem besagten Fotolithografieschritt **14940** selektiv abgedeckt und andere Bereiche, die behandelt werden sollen, nicht mit Fotolack abgedeckt, so dass diese dem Plasma ausgesetzt sind. Eine solche Modulation der Benetzungseigenschaften wäre somit ein weiterer optionaler zusätzlicher Arbeitsschritt in Form einer Fotolithografie **14940,** der denkbar ist.

Nach der optionalen Plasmabehandlung **14950** wird typischerweise dann der Abdecklack wieder entfernt **14960,** wenn zuvor der besagte Fotolithografieschritt **14940** durchgeführt wurde.

Es folgt dann das Belacken **14970** des Trägersubstrats **1360** mit dem kolloidalen Lack **KL** der Kristalle bzw. Diamant-Nano-Kristallen ND, um einen kolloidalen Film aus kolloidalen Lack **KL** auf einer Oberfläche des Trägersubstrats **1360** zu erhalten. Dies geschieht beispielsweise durch Ausschleudern und/oder Aufsprühen und/oder Aufdrucken eines zuvor erstellten kolloidalen Lackes der Kristalle bzw. Diamant-Nano-Kristallen **ND.** In der Regel wird der kolloidale Lack **KL** der Kristalle bzw. Diamant-Nano-Kristallen **ND** mit den darin enthaltenen Kristallen bzw. Diamant-Nano-Kristallen **ND** dann soweit zu einem kolloidalen Film in Form von Sensorelementen **SE** ausgehärtet **14980,** dass er mechanisch für die weitere Verarbeitung ausreichend stabil ist, aber ggf. noch mittels anderer nachfolgender Verfahrensschritte strukturiert werden kann. Auf die Verarbeitungshinweise des bevorzugten Trägermaterials **TM** NOA 61 in diesem Dokument weist das hier vorgelegte Dokument in diesem Zusammenhang hin.

Diese Strukturierung **14990** des kolloidalen Filmes zur Erzeugung der Sensorelemente **SE** erfolgt in der Regel bevorzugt mit fotolithografischen Methoden.

Die bevorzugte Methode, die dieses Dokument vorschlägt ist die strukturierte Aushärtung des kolloidalen Films aus kolloidalem Lack **KL** auf der Oberfläche des Trägersubstrats **1360** durch selektive Bestrahlung mit Aushärtestrahlung **4910** mit der Aushärtewellenlänge λ_{H}, Entfernung des überschüssigen kolloidalen Lackes **KL** mit einem Lösungsmittel **LM** und ggf. anschließende endgültige Aushärtung durch einen Temperaturschritt in einer Thermokammer oder einen Aushärteschritt durch Lagern.

### Figur 88

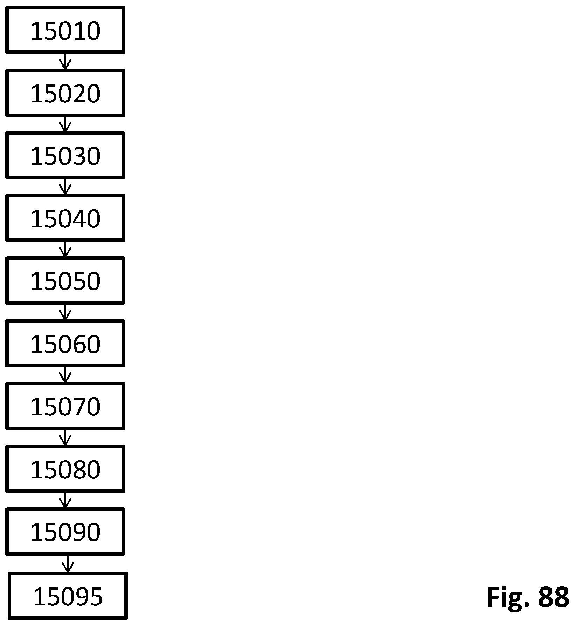

Figur 88 zeigt eine zweite Methode der Strukturierung. Diese zweite Methode der Strukturierung kann durch Vorhärten des kolloidalen Films aus kolloidalem Lack **KL** auf der Oberfläche des Trägersubstrats **1360** erfolgen. Anschließend kann der nicht ganz ausgehärtete kolloidale Film aus kolloidalem Lack KL auf der Oberfläche des Trägersubstrats **1360** mit fotolithografischen Methoden. Eine solche Fotolithografische Methode kann beispielsweise wie folgt aussehen:
1. Aufbringen **15010** des kolloidalen Films aus kolloidalem Lack **KL** auf die Oberfläche des Trägersubstrats **1360;**
2. Anhärten **15020** des kolloidalen Films aus kolloidalem Lack **KL** auf der Oberfläche des Trägersubstrats **1360;**
3. Aufbringen **15030** Fotolack auf die Oberfläche des kolloidalen Films aus kolloidalem Lack **KL** auf der Oberfläche des Trägersubstrats **1360**
4. Aushärten **15040** des Fotolacks;
5. selektives Belichten **15050** des Fotolacks mit einer Maske, die gegenüber anderen Strukturen auf dem Trägersubstrats **1360** justiert ist, oder auf andere Weise ;
6. Entwickeln 15060 des Fotolacks entwickeln mit Öffnung der Ätzöffnungen im Fotolack;
7. ggf. Härten **15070** des Fotolackes, wobei hier die Herausforderung darin besteht, den Fotolack ausreichend zu härten und das Trägermaterial TM des kolloidalen Films im kolloidalen Lack **KL** auf der Oberfläche des Trägersubstrats **1360** nicht zu weit auszuhärten;
8. selektives Ätzen oder Lösen **15080** des freiliegenden kolloidalen Films aus kolloidalem Lack **KL** auf der Oberfläche des Trägersubstrats **1360** in den Ätzöffnungen, wobei der Fotolack möglichst wenig angegriffen werden sollte (ggf. können noch andere Zwischenschichten wie z.B. Metallschichten auf den kolloidalen Film aus kolloidalem Lack KL auf dem Trägersubstrats **1360** aufgebracht und strukturiert werden.);
9. selektives Entfernen **15090** des Fotolacks,
10. Aushärten **15095** des stehen gebliebenen kolloidalen Films aus kolloidalem Lack **KL** auf der Oberfläche des Trägersubstrats **1360,** um die Sensorelemente **SE** und/oder Sensorelementschichten **5** zu erhalten.)

Ein solches Strukturierungsverfahren ist nicht selbstjustierend und daher mit größeren Fertigungsschwankungen behaftet als das selbstjustierende Fertigungsverfahren

Eine solche Strukturierung **14990** ist nicht unbedingt erforderlich. In einigen Anwendungen mag es ausreichen, den kolloidalen Lack **KL** der Kristalle bzw. Diamant-Nano-Kristallen **ND** mit einer der besagten Belackungsverfahren aufzutragen, also die Belackung **14970** durchzuführen und den kolloidalen Lack **KL** der Kristalle bzw. Diamant-Nano-Kristallen **ND** dann direkt komplett auszuhärten **14910.** Die Strukturierung **14990** ist aber neben den besagten fotolithografischen Verfahren auch mittels mikromechanischer Verfahren (Ritzen, Fräsen) denkbar. Auch können Excimer-Laser und Partikelstrahlen wie Elektronen und/oder Ionenstrahlen zur Strukturierung verwendet werden. Entweder ist das Trägermaterial **TM** des kolloidalen Lackes **KL** bzw. des sich daraus ergebenden kolloidalen Films selbst ein Fotolackmaterial und damit der kolloidale Lack ein Fotolack oder der Fotolack wird auf den kolloidalen Lack **KL** als drüber liegende Schicht aufgebracht. Im letzteren Fall sollte der Fotolack so gewählt werden, dass er selektiv von dem kolloidalen Lack **KL** bzw. kolloidalen Film strukturiert werden kann und der kolloidale Lack **KL** bzw. der kolloidale Film selektiv vom Fotolack strukturiert werden kann.

Bevorzugt ist aber eine Variante des kolloidalen Lackes **KL** mit einem fotoempfindlichen Trägermaterial **TM,** beispielsweise einem geeigneten fotoempfindlichen Polyimid und/oder NOA 61.

Es erfolgt dann die bevorzugt fotolithografische oder mikromechanische Strukturierung **14990** des kolloidalen Lackes **KL** zum kolloidalen Film mit den Sensorelementen SE und/oder den Sensorelementschichte **5**.

Nach der Strukturierung **14990** erfolgt typischerweise die finale Aushärtung **14911** des kolloidalen Filmes und damit der Sensorelemente SE und/oder der Sensorelementschichten **5**.

Mittels des vorgeschlagenen Verfahrens ist es somit möglich, beliebige Kristalle und/oder Diamant-Nano-Kristalle **ND** gezielt auf einem Trägersubstrat **1360,** insbesondere einer Platine und/oder einem Wafer, insbesondere auf einem CMOS-Wafer oder BICMOS-Wafer oder Bipolar-Wafer oder einem planaren Glas- oder Kunststoff-Wafer, lokalisiert zu platzieren und, wenn gewünscht selbstjustierend zu platzieren.

### Figur 89

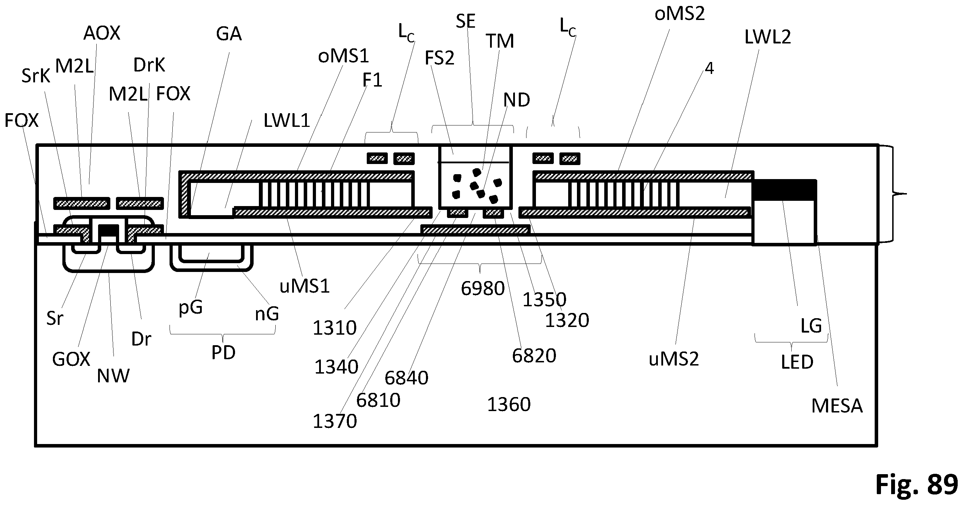

Figur 89 zeigt schematisch und grob vereinfacht einen Schnitt durch ein beispielhaftes System, um den Inhalt des vorausgegangenen Vorschlags bei Anwendung auf einen mikroelektronischen CMOS-Schaltkreis zu verdeutlichen. Basis der beispielhaften Vorrichtung ist das Trägersubstrat **1360.** Hierbei soll es sich in dem Beispiel der Figur 89 beispielhaft zur Verdeutlichung um ein Silizium-Wafer-Stück (Im Allgemeinen mit den Englischen Worten Chip oder Die bezeichnet) beispielhaft mit einer p-Leitfähigkeit handeln, wie er in der MOS-und der CMOS- und der BICMOS- und der Bipolar-Technik heute üblich ist. Die Ausführengen hier lassen sich natürlich auch auf die Bipolartechnik übertragen.

### Integrierte Schalung als Trägersubstrat 1360

Vor dem Einbringen der Kristalle und/oder Diamant-Nano-Kristalle **ND** mit paramagnetischen Zentren und/oder NV-Zentren wurde beispielhaft ein MOS- bzw. CMOS- bzw. BICMOS- bzw. ein Bipolar-Prozess und/oder ein anderer Halbleiterprozess mit dem beispielhaften Trägersubstrat **1360,** hier dem beispielhaften Silizium-Wafer, durchgeführt. Bei diesem wurde eine beispielhafte mikroelektronische Schaltung mit mindestens einem mikroelektronischem Bauteil auf dem beispielhaften Silizium-Wafer und damit auf dem beispielhaften Trägersubstrat **1360** hergestellt. Durch diesen Herstellungsschritt wurde dieser zu einem MOS-Wafer bzw. zu einem CMOS-Wafer bzw. zu einem BICMOS-Wafer bzw. zu einem Bipolar-Wafer wurde. Symbolisch für eine solche mikroelektronische Schaltung ist ein einzelner beispielhafter MOS-Transistor vereinfacht schematisch angedeutet. Die Figur 89 verzichtet auf eine komplexere Schaltungsdarstellung, um die Übersichtlichkeit aufrechtzuerhalten. Eine fachkundige Person liest hier direkt eine größere Menge möglicher Bauelemente und Schaltungen mit. Dort kann man sich beispielsweise auch einen Bipolartransistor oder ähnliche Bauelemente wie Thyristoren und dergleichen denken. Durch diese vereinfachte Darstellung soll sichergestellt werden, dass das Grundprinzip ohne verwirrende Details deutlich wird. Die vereinfachte Darstellung soll die Ko-Integration einer mikroelektronischen Schaltung mit dem Kristall und/oder Diamant-Nano-Kristallen ND mit den paramagnetischen Zentren und/oder insbesondere NV-Zentren zum Ausdruck bringen. Eine Funktionstüchtigkeit kann aufgrund der Komplexität der dann erforderlichen Darstellung hier leider nicht dargestellt werden, was aber den Offenbarungsgehalt nicht reduziert.

### Beispielhafter MOS-Transistor

Der beispielhaft dargestellte MOS-Transistor umfasst in diesem Beispiel eine N-Wanne **NW** in dem Trägersubstrat **1360.** Der angedeutete beispielhafte MOS-Transistor weist ein Source-Gebiet **Sr,** ein Drain-Gebiet **Dr,** einen Source-Kontakt **SrK** zur Kontaktierung des Source-Gebiets **Sr,** einen Drain-Kontakt **DrK** zur Kontaktierung des Drain-Gebiets **Dr,** ein Gate-Oxid **GOX,** ein Feld-Oxid **FOX,** ein Abdeckoxid **AOX** und ein Gate **GA** auf. Oberhalb dieser mikroelektronischen Bauelemente befindet sich der Metallisierungsstapel der mikrointegrierten Schaltung. Der Metallisierungsstapel der mikrointegrierten Schaltung umfasst vorzugsweise mehrere strukturierte Isolationsschichten und mehrere strukturierte elektrische leitende Schichten, insbesondere Metallisierungsschichten, die die elektrischen Verbindungen herstellen. Eine Metallisierungsschicht ist beispielsweise angedeutet durch eine zweite elektrisch nach oben und unten isolierte und strukturierte zweite Metalllage **M2L.** In der Realität sind die MOS-, CMOS-, BICMOS und Bipolar-Strukturen wesentlich komplizierter. Sie umfassen typischerweise beispielsweise mehrere Lagen aus elektrisch leitfähigem Metall und/oder polykristallinem Silizium und typischerweise mehrere Isolationsschichten z.B. aus SiO₂ und Kontakte und Durchkontaktierungen .

Der zweite Lichtwellenleiter **LWL2** koppelt das lichtemittierende Gebiet LG der Mesa-Struktur **MESA,** die die Lichtquelle **LED** des Sensorsystems bilden, an das Sensorelement Se, das sich hier in der mikromechanischen Vertiefung der zweiten Fangstruktur **FS2** befindet und das hier wieder Kristalle und/oder Diamant-Nano-Kristalle **ND** mit paramagnetischen Zentren und/oder NV-Zentren umfasst. Die zweite untere Metallblende **uMS2** des zweiten Lichtwellenleiters **LWL2** schirmt den zweiten Lichtwellenleiter **LWL2** nach unten zum Trägersubstrat **1360** als optische Abschirmung **ME** ab. Die zweite obere Metallblende **oMS2** des zweiten Lichtwellenleiters **LWL2** schirmt den zweiten Lichtwellenleiter **LWL2** nach oben zur Oberfläche des Trägersubstrats **1360** als optische Abschirmung **ME** ab. Der zweite Lichtwellenleiter **LWL2** erfasst die Pumpstrahlung **LB** des Lichterzeugenden Gebiets **LG** in seiner Funktion als Lichtquelle **LED** und transportiert die Pumpstrahlung **LB** zum Sensorelement **SE.** Vorzugsweise umfasst diese optische transportstrecke einen optischer Filter (Shortpass) **4,** der in den zweiten Lichtwellenleiter **LWL2** eingefügt ist und der elektromagnetische Wellen, die nicht die Pumpstrahlungswellenlänge λₚₘₚ aufweisen nicht transmittiert und nur elektromagnetische Strahlung mit der Pumpstrahlungswellenlänge λₚₘₚ transmittiert.

Der erste Lichtwellenleiter **LWL1** erfasst die Fluoreszenzstrahlung **FL** der paramagnetischen Zentren und/oder NV-Zentren des Sensorelements **SE** und transportiert die Fluoreszenzstrahlung **FL** zu dem Fotodetektor **PD.** Der Fotodetektor **PD** ist in dem Beispiel der Figur 89 als PN-Übergang zwischen einem p-dotierten gebiet **pG** und einem n-dotierten Gebiet **nG** beispielhaft ausgeführt. Es kann sich bei dem Fotodetektor **PD** auch um andere Fotodetektoren wie beispielsweise CCD-Detektoren handeln.In den ersten Lichtwellenleiter LWL1 ist ein Filter F1 eingefügt, der im Wesentlichen nur elektromagnetische Strahlung der Fluoreszenzwellenlänge λ_{fl} der Fluoreszenzstrahlung **FL** transmittiert und der vorzugsweise im Wesentlichen elektromagnetische Strahlung einer Wellenlänge verschieden von der Fluoreszenzwellenlänge λ_{fl} der Fluoreszenzstrahlung **FL** absorbiert oder reflektiert. Dies stellt sicher, dass beispielsweise die Pumpstrahlung **LB** mit der Pumpstrahlungswellenlänge λₚₘₚ den Fotodetektor **PD** nicht erreichen kann. Die erste untere Metallblende **uMS1** des ersten Lichtwellenleiters **LWL1** schirmt den ersten Lichtwellenleiter **LWL1** nach unten zum Trägersubstrat **1360** als optische Abschirmung **ME** ab. Die erste obere Metallblende **oMS1** des ersten Lichtwellenleiters **LWL1** schirmt den ersten Lichtwellenleiter **LWL1** nach oben zur Oberfläche des Trägersubstrats **1360** als optische Abschirmung **ME** ab.

Bevorzugt umfasst die mikroelektronische Schaltung auf und/oder in dem Trägersubstrat **1360** Vorrichtungsteile von hier vorgestellten Systemen wie z.B. denen der Figuren 69 bis 71 und/oder denen der

Figuren 73 bis 81. Solche Vorrichtungsteile, die die mikroelektronische Schaltung auf und/oder in dem Trägersubstrat **1360** umfassen kann, können beispielsweise umfassen:
die Auswertevorrichtung (**AWV, 30),** Steuervorrichtungen (**CTR, CTR2, 33**), Datenbusse (**DB**, **29**), Treiberstufen **DRVL,** Signalgeneratoren (**G1, G1_1, G1_2, G1_3, G2, G2_I, G2_II, G2_III, G2_IV**), Magnetfelderzeugungsmittel (**L_{c}, L_{c_}3, L_{c_}2, L_{c_}3, L_{c_}4, L_{c_}5**)**,** Magnetfeldregler LCTR, Lichtquellentreiber (**LDRV, LDRV_1, LDRV_2, LDRV_3, LDRV_4, LDRV_5),** Lichtquellen (**LED, LED_1, LED_2, LED_3, LED_4, LED_5, 2**), Mehrfachkorrelatoren (LIV, **LIV_1, LIV_2, LIV_3, LIV_4, LIV_5**), Multiplizierer (**M1**, **M2**), Mustererkennungsvorrichtung MEV, Mischer **MIX,** Magnetfeldsensoren **MS,** Mikrowellensignalquellen (**µWG, µWG_I, µWG_II, µWG_III, µWG_IV**), Speicher (**RAM, NVM**), Fotodetektoren (**PD, PD_1, PD_2, PD_3, PD_4, PD_5**), Radiowellenquellen **RFG**, Verstärker (**V1**, **V1_1, V1_2, V1_3, V1_4, V1_5**), Lichtsensorarrays **1**, Auswertelektronik **15**, Aufbereitungsvorrichtungen **30**, Schnittstellenschaltungen **36**, etc.

Bevorzugt umfasst die mikroelektronische Schaltung beispielsweise auch einen Spannungsregler zur Versorgung der mikroelektronischen Schaltung und ggf. ihrer Teilkomponenten und/oder zur Versorgung einer Pumplichtquelle, der Lichtquelle **LED,** zur Anregung der Emission der Fluoreszenzstrahlung **FL** der paramagnetischen Zentren der Kristalle und/oder der Diamant-Nano-Kristalle **ND** der Sensorelemente **SE** und/oder der Sensorelementschichten **5** mittels Pumpstrahlung **LB.** Ein geeignetes mikrooptisches System muss aber zum einen die paramagnetischen Zentren der Kristalle und/oder der Diamant-Nano-Kristalle **ND** der Sensorelemente **SE** und/oder der Sensorelementschichten **5** mittels Pumpstrahlung **LB** stimulieren können und zum anderen die Fluoreszenzstrahlung **FL** der paramagnetischen Zentren der Kristalle und/oder der Diamant-Nano-Kristalle **ND** der Sensorelemente **SE** und/oder der Sensorelementschichten **5** erfassen und zuverlässig von der Pumpstrahlung LB der Pumpstrahlungsquelle, hier der Lichtquelle **LED,** trennen können. Hierfür ist es sinnvoll, wenn das mikro-elektrooptische System mikrooptische Bauelemente aufweist, die in einem entsprechenden Prozessschritt mikrotechnisch hergestellt werden. Besonders wichtig sind hierbei optische Filter (**F1**, **3**) und Lichtwellenleiter (**LWL1**, **LWL2**).

An dieser Stelle verweist das hier vorgelegte Dokument beispielhaft auf die Bücher Baha E.A. Saleh, Malvin Carl Teich, "Grundlagen der Photonik"Wiley-VCH, 2007 und Bernhard C. Kress, Patrick Meyreueis "Applied Digital Optics" Wiley, 2009.

Außerdem weist das hier vorgelegte Dokument auf andere Beschreibungsteile dieses Dokuments hin, die ebenfalls sich mit mikroelektronischen Systemen und/oder Schaltungen beschäftigen und die hier in diesem Zusammenhang daher auch wichtige Informationen zu diesem Abschnitt liefern der Kombination mit der technischen Lehrer dieses Abschnitts hier ebenfalls offenbart ist.

Das hier vorgelegte Dokument verweist daher hier auf den einschlägigen Stand der Technik zu mikroelektronischen Schaltkreisen verwiesen.

### erster mikrooptischer Lichtwellenleiter LWL1 und Sensorelement SE

Die der Verdeutlichung dienende Struktur der Vorrichtung der Figur 89 umfasst beispielhafte mikrooptische Komponenten in Form von beispielhaften Lichtwellenleitern (**LWL1**, **LWL2**). Diese beispielhaften Lichtwellenleitern (**LWL1**, **LWL2**) sollen in dem Verdeutlichungsbeispiel der Figur 89 mit der Vielzahl paramagnetischer Zentren in der Vielzahl der Kristalle und/oder Diamant-Nano-Kristallen **ND** mit NV-Zentren und/oder paramagnetischen Zentren zusammenwirken. Bevorzugt kann es sich bei den Diamant-Nano-Kristallen **ND** um Nanodiamanten mit NV-Zentren als paramagnetische Zentren handeln. Der kolloidale Lack **KL** mit Trägermaterial **TM** und Kristallen und/oder Diamant-Nano-Kristallen **ND** ist in der Vertiefung der zweiten Fangstruktur **FS2** platziert worden. Der kolloidale Lack KL bedeckt im Bereich der Fangstruktur **FS2** die Oberfläche der Vorrichtung um die Position der Kristalle und/oder Diamant-Nano-Kristallen **ND** in der Vertiefung der zweiten Fangstruktur **FS2** zu fixieren. Das Trägermaterial **TM** des kolloidalen Lackes **KL** muss nach dem Aushärten für die zu verwendende Pumpstrahlung LB und die verwendete Fluoreszenzstrahlung **FL** der paramagnetischen Zentren der Kristalle und/oder Diamant-Nano-Kristalle **ND** ausreichend transparent sein. Die zweite Fangstruktur **FS2** ist vorzugsweise mit dem Trägermaterial **TM** des kolloidalen Lackes **KL** gefüllt. Die Schicht des kolloidalen Lackes **KL** aus Trägermaterial **TM** und Kristallen und/oder Diamant-Nano-Kristallen **ND** ist in dem Beispiel der Figur 89 fotolithografisch und/oder durch ein selbstjustierendes Aushärteverfahren auf den Bereich der Fangstruktur **FS2** begrenzt worden. Dies hat den Vorteil, dass z.B. elektrische Kontakte der integrierten Schaltung bevorzugt leichter wieder freigelegt werden können.

Die beispielhafte Vorrichtung, die hier zur Verdeutlichung beschrieben wird, weist eine erste Lichtwellenleiterstruktur **LWL1** auf, deren Material beispielsweise ein aufgesputtertes SiO₂-Material oder das Material eines anderen transparenten Oxids und/oder einer optisch transparenten Isolationsschicht des Metallisierungsstapels umfassen kann, das auf die Oberfläche des Trägersubstrat **1360** aufgebracht wurde. Bevorzugt wurde zuvor eine Lichtabstrahlung in andere Bereiche der Schaltung durch einen ersten Abschnitt einer ersten Metallblende **uMS1** nach unten zum Trägersubstrat **1360** hin unterbunden. Die erste Lichtwellenleiterstruktur **LWL1** wurde bevorzugt fotolithografisch strukturiert und beispielhaft mit einem ersten Abschnitt einer zweiten Metallblende **oMS1** nach oben hin zur Reduktion des optischen Übersprechens und zur Verbesserung des Signal- zu Rausch-Verhältnisses abgedeckt. Es wird empfohlen, die Arbeitsfähigkeit einer solchen Konstruktion mit einer FDTD-Simulation vor der Herstellung für die verwendeten Prozessparameter präzise zu simulieren, da bei zu kleinen Dimensionen beispielsweise eine Lichtausbreitung nicht mehr möglich ist. Auf die gleiche Weise wurde eine zweite Lichtwellenleiterstruktur **LWL2** gefertigt, der von einem zweiten Abschnitt der ersten Metallblende **uMS2** und einem zweiten Abschnitt der zweiten Metallblende **oMS2** bevorzugt umfasst ist.

### MESA-Struktur als Lichtquelle

In dem Beispiel der Figur 89 ist eine beispielhafte Lichtquelle vorgesehen. Diese besteht hier beispielhaft aus einer beispielhaften MESA-Struktur **(LED),** die bevorzugt und beispielhaft gegenüber dem planaren Substrat isoliert ist. Statt einer MESA-Struktur **MESA** können auch andere Silizium-LEDs oder andere Lichtquellen als Lichtquelle **LED** der Vorrichtung Verwendung finden. In dieser lichterzeugenden MESA-Struktur **MESA** ist typischerweise ein lichtemittierendes Gebiet als Lichtquelle **LED** gefertigt. In diesem Zusammenhang sei hinsichtlich der Fertigung einer Lichtquelle **LED** in indirekten Halbleitern wie Silizium auf die folgende Schrift verwiesen:
Röcke H., Meijer J., Stephan A., Weidenmüller U., Bukow H. H., Rolfs C. "White electroluminescent nanostructure in silicon fabricated using focused ion implantation" Nuclear Instruments and Methods in Physics Research B 181 (1001) Seite 274-279.

Das besondere bei der Verwendung einer MESA-Struktur **MESA** ist, dass diese einen Wellenlängenbereich in dem notwendigen Wellenlängenbereich der Pumpstrahlungswellenlänge λₚₘₚ der Pumpstrahlung **LB** emittiert. Leider emittiert die MESA-Struktur **MESA** auch andere Wellenlängen, sodass die Verwendung eine optischen Bandpassfilters **4** geboten erscheint.

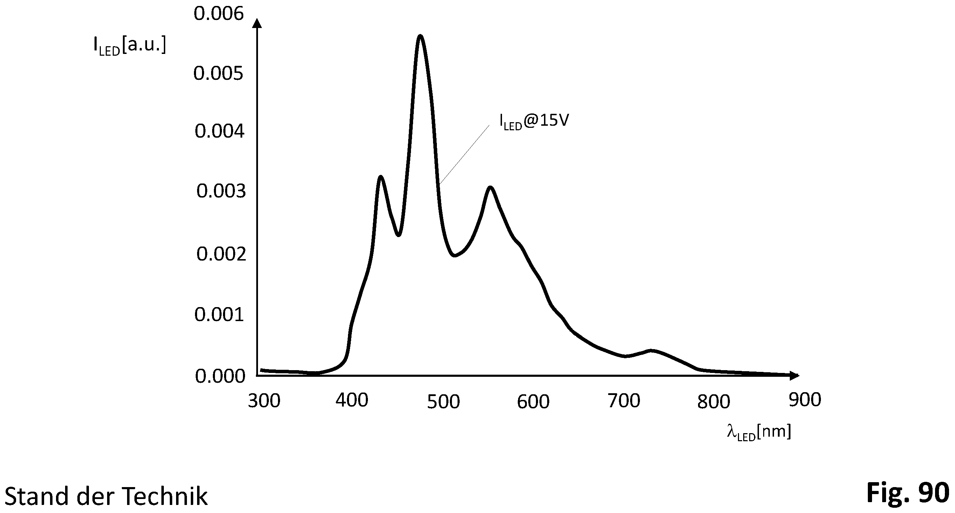

Figur 90 zeigt das beispielhafte Emissionsspektrum einer solchen MESA-Struktur **MESA** als Lichtquelle **LED.** Bei Versuchen hat sich gezeigt, dass das optische Bandpassfilter **4** in den zweiten Lichtwellenleiter **LWL2** eingefügt werden sollte, um die optische Transmission in Richtung der Kristalle und/oder der Diamant-Nano-Kristalle **ND** mit den paramagnetischen Zentren bzw. NV-Zentren auf die Pumpstrahlung **LB** der Pumpstrahlungswellenlänge λₚₘₚ zu begrenzen und elektromagnetische Strahlung aus der Lichtquelle **LED** mit kürzeren und längeren Wellenlängen nicht zu transmittieren.

Sofern eine Lichtquelle **LED** verwendet wird, die im Wesentlichen nur elektromagnetische Strahlung der Pumpstrahlungswellenlänge λₚₘₚ emittiert, kann auf das optische Bandpassfilter **4** verzichtet werden.

In dem Beispiel der Figur 89 wird eine solche Lichtquelle **LED** mit dem lichtemittierenden Gebiet **LG** benutzt, um über den ersten Lichtwellenleiter **LWL1** nach Bandpassfilterung im optischen Bandpassfilter **4** die paramagnetischen Zentren bzw. NV-Zentren der Kristalle und/oder Diamant-Nano-Kristalle **ND** zu pumpen und zur Eimission von Fluoreszenzstrahlung **FL** anzuregen.

Beispielhaft ist in den ersten Lichtwellenleiter **LWL1** ein optisches Bandpassfilter **4** eingefügt, das elektromagnetische Strahlung mit Pumpstrahlungswellenlänge λₚₘₚ im Wesentlichen passieren lässt und elektromagnetische Strahlung anderer Wellenlängen, insbesondere der Fluoreszenzstrahlungswellenlänge λ_{fl} im Wesentlichen soweit dämpft, dass sie für die jeweilige Anwendung keine Rolle mehr spielen.

### Zweiter Lichtwellenleiter LWL2 und Fotodetektor PD

Der zweite Lichtwellenleiter **LWL2** erfasst in dem Beispiel der Figur 89 die Fluoreszenzstrahlung **FL** und leitet diese zu einem Fotodetektor **PD** der mikroelektronischen Schaltung geleitet wird.

Beispielhaft ist in den zweiten Lichtwellenleiter **LWL2** ein optisches Filter **F1** eingefügt, das elektromagnetische Strahlung mit Fluoreszenzstrahlungswellenlänge λ_{fl} im Wesentlichen passieren lässt und elektromagnetische Strahlung anderer Wellenlängen, insbesondere der Pumpstrahlungswellenlänge λₚₘₚ im Wesentlichen soweit dämpft, dass sie für die jeweilige Anwendung keine Rolle mehr spielen.

Bevorzugt sind das optische Filter **F1** und das optische Bandpassfilter **4** als mikrooptische Funktionselemente beispielsweise als dielektrische Schichtfolge und/oder als photonischer Kristall ausgeführt. Das hier vorgelegte Dokument empfiehlt FDTD-Simulationen zur Überprüfung der gewählten Konstruktionen, wobei die Fertigungstoleranzen unbedingt mitsimuliert werden sollten.

Der beispielhafte Fotodetektor **PD** umfasst in diesem Verdeutlichungsbeispiel der Figur 89 beispielhaft eine PN-Diode, die eine N-Wanne **nG** und eine P-Kathode **pG** umfasst.

### mikrotechnische Funktionselemente

Aus dem Stand der Technik sind zahlreiche lichtempfindliche mikroelektronische Bauteile bekannt, die insbesondere mit den besagten MOS-, CMOS-, BICMOS und Bipolar-Prozessen gefertigt werden können. Um die Komplexität der Darstellung gering und transparent zu halten wurde die Figur 89 soweit vereinfacht, dass eine fachkundige Person erkennen kann, welche beispielhaften Elemente wie kombiniert werden können und beispielhaft zusammenwirken können. Es können auch die zahlreichen aus dem Stand der Technik bekannten mikrofluidischen, mikromechanischen, mikrooptischen und mikroelektronischen Funktionselemente in ähnlichen Vorrichtungen mit der hier vorgeschlagenen Methode kombiniert werden. Beispielsweise können Bragg-Filter und Spiegel-Strukturen in den Lichtwellenleitern (**LWL1, LWL2**) vorgesehen werden.

### mikrotechnische Vorrichtung und Wellenleiter

Im Gegensatz zum Stand der Technik sieht der hier vorgelegte Vorschlag vor, einen Wellenleiter **(1380, 1880, 2380, 6830, 6980),** hier eine beispielhafte differenzielle Tri-Plate-Leitung **6980,** oberhalb oder wie hier unterhalb des Sensorelements **SE** zu platzieren. Die differenzielle Tri-Plate-Leitung **6980** umfasst wieder den elektrisch leitender Rückseitenkontakt **1370,** die elektrisch leitende linke Signalmassefläche **1310,** die elektrisch leitende rechte Signalmassefläche **1320** sowie die differentielle Signalleitung **6830** mit der der elektrisch leitenden linken Signalleitung **6810** und der der elektrisch leitenden rechten Signalleitung **6820.** Die differenzielle Tri-Plate-Leitung **6980** ist nur ein Beispiel für einen Wellenleiter. Die beispielhafte mikrointegrierte Schaltung der Figur 89 kann stattdessen auch eine Mikrostreifenleitung **1380** und/oder eine Schlitzleitung **1880** und/oder eine Tri-Plate-Leitung **2380** und/oder eine differenzielle Mikrostreifenleitung **6830** und/oder eine andere Wellenleitung, insbesondere eine planare Wellenleitung, aufweisen, die mit einem Sensorelement **SE** und/oder einer Sensorelementschicht **5** wechselwirken. In den vorausgehenden Figuren wurden verschiedene Positionierungen verschiedener Sensorelemente **SE** gegenüber Vorrichtungsteilen von Wellenleitungen diskutiert. Eine solche mikrointegrierte Schaltung kann ein oder mehrere Sensorelemente **SE** aufweisen, die unterschiedlich zu den Vorrichtungsteilen der besagten Wellenleitungen positioniert sein können und die unterschiedliche Größen relativ zu den Vorrichtungsteilen der Wellenleitungen haben können. Auch diese unterschiedlichen Größen der Sensorelemente **SE** wurden in den vorausgehenden Figurenbeschreibungen diskutiert und werden daher hier nicht wiederholt. Sie gelten aber im Zusammenhang mit der Verwendung in mikrointegrierten Schaltungen im Sinne des hier vorgelegten Dokuments hiermit als offenbart.

### mikroelektronisches System

Bevorzugt umfasst somit das System eine mikroelektronische Schaltung oder zumindest ein mikroelektronisches Bauelement, insbesondere einen Fotodetektor **PD** und/oder ein lichtemittierendes Bauelement als Lichtquelle **LED.** Im spezielleren umfasst das System bevorzugt einen mikroelektronischen MOS-, CMOS-, BICMOS oder Bipolar-Schaltkreis oder zumindest ein mikroelektronisches MOS- bzw. CMOS- bzw. BICMOS- oder Bipolar-Bauelement, insbesondere einen Fotodetektor und/oder ein lichtemittierendes Bauelement. Im Falle einer CMOS-Technologie handelt es sich bevorzugt um einen CMOS-Fotodetektor, z.B. eine CCD-Pixel oder ein CCD-Pixel-Array und/oder ein lichtemittierendes CMOS-Bauelement, wobei ein CMOS-Bauelement dadurch gekennzeichnet ist, dass es in einer CMOS-Technologie gefertigt wurde. Der mikroelektronische Schaltkreis ist bevorzugt zumindest in Teilen in MOS- oder CMOS- oder BICMOS- oder Bipolar-Technologie gefertigt.

Die mikroelektronische Schaltung kann eine Vielzahl von Schaltungselementen umfassen, von denen einige mit dem Sensorelement zusammenwirken können. Das hier vorgelegte Dokument zählt hier nur Beispielhaft einige auf.
- Analog-Digital-Wandler (ADC): Wandelt analoge Eingangssignale in digitale Signale um.
- Digital-Analog-Wandler (DAC): Wandelt digitale Eingangssignale in analoge Signale um.
- Operationsverstärker (OPV): Verstärkt und verstärkt analoge Signale.
- Spannungsreferenzen: Erzeugen stabile Referenzspannungen für den Schaltungsbetrieb.
- Verstärker: Verstärkt analoge Signale mit unterschiedlichen Verstärkungsfaktoren.
- Filter: Filtert unerwünschte Frequenzen aus einem Signal (z. B. Tiefpass-, Hochpass- oder Bandpassfilter).
- Oszillatoren: Erzeugt periodische Wellenformen oder Taktsignale.
- Multiplexer (MUX) und Demultiplexer (DEMUX): Schalten zwischen verschiedenen Eingangssignalen oder verteilen ein Eingangssignal auf mehrere Ausgänge.
- Phasenregelkreise (PLL): Generiert stabilisierte Taktsignale basierend auf einem Referenztakt.
- Verzögerungselemente: Ermöglichen die zeitliche Steuerung von Signalen.
- Komparatoren: Vergleicht zwei Eingangssignale und gibt einen Ausgang entsprechend dem Vergleichsergebnis.
- Pufferverstärker: Verstärkt das Signal, ohne seine Charakteristik zu verändern.
- Spannungsregler: Stabilisiert die Ausgangsspannung, unabhängig von Schwankungen der Eingangsspannung oder Laständerungen.
- Taktgeneratoren: Erzeugt Taktsignale mit definierten Frequenzen und Phasenverschiebungen.
- Datenpuffer: Speichert Daten und ermöglicht eine zeitversetzte Übertragung.
- Schaltungsüberwachung: Überwacht die Betriebsbedingungen der Schaltung und schützt sie vor Schäden.
- Serielle Kommunikationsschnittstellen: Ermöglichen die Kommunikation zwischen verschiedenen Bauteilen oder Geräten über serielle Datenübertragung.
- Leistungstreiber: Verstärken das Signal für den Antrieb von Hochleistungskomponenten wie Motoren oder Aktuatoren.
- Schaltungslogik: Enthält logische Elemente wie AND-, OR-, NAND- und XOR-Gatter zur Durchführung von digitalen Berechnungen und Logikoperationen.
- Speicher: Umfasst verschiedene Arten von Speicherbausteinen wie Flip-Flops, Latches oder Register zum Speichern von Daten.
- Takt- und Phasenregelschleifen (PLL): Generiert präzise und stabile Taktsignale basierend auf einem Referenztakt und ermöglicht die Synchronisation von Signalen.
- Analogschalter: Schaltet analoge Signale zwischen verschiedenen Pfaden oder Kanälen um.
- Impulsbreitenmodulation (PWM): Moduliert die Breite von Impulsen, um die Leistung oder das Verhältnis von Einschaltzeit zu Ausschaltzeit eines Signals zu steuern.
- Signalverarbeitungseinheiten (DSP): Spezialisierte digitale Signalprozessoren für die Verarbeitung und Analyse von analogen und digitalen Signalen.
- Spannungsteiler: Teilt eine Eingangsspannung in zwei oder mehrere Ausgangsspannungen auf.
- Temperatursensoren: Erfassen und messen die Temperatur in der Umgebung oder in einem Bauteil.
- Stromquellen und Stromsenken: Erzeugen konstanten Strom oder absorbieren Strom in einer Schaltung.
- Schutzschaltungen: Überwachen und schützen die Schaltung vor Überspannung, Unterspannung, Übertemperatur oder Kurzschluss.
- Pegelwandler: Übersetzt Signale zwischen verschiedenen Spannungsebenen oder Logikpegeln.
- Impedanzwandler: Passt die Impedanz zwischen verschiedenen Teilen einer Schaltung an, um eine optimale Signalübertragung zu ermöglichen.
- Spannungsregler: Stabilisieren die Ausgangsspannung auf einen vordefinierten Wert, unabhängig von Schwankungen der Eingangsspannung oder Laständerungen.
- Strommessung: Ermöglicht die Messung des Stroms in einem Schaltungsteil oder einer Komponente.
- Digital Signaling Interface (DSI): Ein serieller Hochgeschwindigkeitsbus zur Übertragung von Daten zwischen integrierten Schaltungen.
- Analogschleifenfilter: Filtert unerwünschte Störsignale aus einem analogen Eingangssignal.
- Energieerfassung: Erfasst und misst den Energieverbrauch in einer Schaltung oder einem System.
- Fehlerkorrektur: Verwendet Fehlerkorrekturcodes und Algorithmen zur Erkennung und Korrektur von Übertragungsfehlern in digitalen Signalen.
- Datenkonverter: Wandelt Daten von einem Format in ein anderes um, z. B. seriell zu parallel oder umgekehrt.
- Verstärker mit variabler Verstärkung: Bietet die Möglichkeit, den Verstärkungsfaktor eines Verstärkers dynamisch anzupassen.
- Bandlückenreferenzen: Erzeugt eine stabile Referenzspannung unabhängig von Temperaturänderungen.
- Pulsweitenmodulation (PWM): Moduliert die Pulsweite eines Signals, um analoge Informationen zu übertragen oder die Leistung von Schaltungen zu regeln.
- Taktverteilung: Verteilt Taktsignale an verschiedene Teile einer Schaltung oder eines Systems.
- Taktreiniger: Filtert Störungen und Rauschen aus einem Taktsignal.
- Sensor-Schnittstellen: Integriert Schnittstellen für verschiedene Sensoren wie Temperatursensoren, Drucksensoren, Beschleunigungssensoren usw.
- Schaltungsmodelle: Beschreibt mathematische Modelle zur Analyse und Simulation von Mixed-Signal-Schaltungen.
- Digitale Signalverarbeitung (DSP): Verarbeitet digitale Signale durch mathematische Algorithmen wie Filterung, Spektralanalyse, Signalmodulation usw.
- Phasendetektoren: Vergleicht die Phasenbeziehung zwischen zwei Signalen und erzeugt eine Ausgangsspannung entsprechend der Phasendifferenz.
- Digitale Steuerlogik: Steuert die Funktionen und den Betrieb der Schaltung auf der Grundlage von digitalen Eingangssignalen.
- Spannungsmultiplikatoren: Erzeugt eine höhere Ausgangsspannung als die Eingangsspannung durch wiederholtes Laden und Entladen von Kondensatoren.
- Fehlererkennung und Fehlerkorrektur (ECC): Identifiziert und korrigiert Fehler in digitalen Daten durch Hinzufügen von Redundanzinformationen.
- Programmierbare Logik: Enthält programmierbare Logikbausteine wie FPGAs (Field-Programmable Gate Arrays) oder CPLDs (Complex Programmable Logic Devices), um flexible Schaltungsfunktionalitäten zu ermöglichen.
- Datenpuffer: Speichert Daten vorübergehend, um eine zeitliche Trennung zwischen Eingang und Ausgang zu ermöglichen.
- Taktgenerator: Erzeugt Taktsignale mit spezifischen Frequenzen und Phasenverschiebungen.
- Batteriemanagement: Überwacht und steuert den Ladezustand und die Leistung von Batterien.
- Digitale Filter: Filtert unerwünschte Frequenzen oder Rauschen aus digitalen Signalen.
- Phasenverschiebungsnetzwerke: Führt Phasenverschiebungen in einem Signal ein, um spezifische zeitliche Beziehungen zu erreichen.
- Signalisolatoren: Trennt galvanisch Signale, um elektrische Störungen zu minimieren.
- Impulsgeneratoren: Erzeugt Impulse oder kurze Signale für spezifische Anwendungen.
- Spektrumanalysatoren: Analysiert und visualisiert das Frequenzspektrum eines Signals.
- Echtzeituhr (RTC): Ermöglicht die genaue Zeitmessung und das Aufrechterhalten einer Echtzeituhr während des Stromausfalls.
- Multipunkt-Modulation: Kombiniert mehrere digitale Signale in einem Modulationsschema.
- Displaytreiber: Steuert die Ansteuerung von Anzeigeelementen wie LCDs oder LED-Anzeigen.
- Hysterese-Komparatoren: Vergleicht Eingangssignale mit einer Schwelle und erzeugt eine Ausgangsspannung, die abhängig von der Hysterese ist.
- Analogschleifenkompensatoren: Kompensiert Fehler in Rückkopplungsschleifen von Analogschaltungen, um die Stabilität und Genauigkeit zu verbessern.
- Programmierbare Verstärker: Erlaubt die Anpassung des Verstärkungsfaktors oder der Verstärkungsfunktion über eine digitale Schnittstelle.
- Clock-Multiplexer: Wählt zwischen verschiedenen Taktsignalen aus und leitet sie zur weiteren Verarbeitung weiter.
- Hochspannungstreiber: Verstärkt und treibt Hochspannungssignale an, beispielsweise für die Ansteuerung von Leistungstransistoren.
- I/O-Schnittstellen: Stellt die Kommunikation und den Datenaustausch mit externen Geräten oder Schnittstellen her.
- Logik-Überwachung: Überwacht und steuert die Logikpegel in einer Schaltung, um eine zuverlässige Signalverarbeitung sicherzustellen.
- Data Encoding/Decoding: Kodiert und dekodiert Daten für die effiziente Übertragung oder Speicherung.
- Lasttreiber: Steuert die Ausgabe von Leistung an externe Komponenten oder Lasten.

Bevorzugt umfasst die mikroelektronische Schaltung auf und/oder in dem Trägersubstrat **1360** Vorrichtungsteile von hier vorgestellten Systemen wie z.B. denen der Figuren 69 bis 71 und/oder denen der Figuren 73 bis 81. Solche Vorrichtungsteile, die die mikroelektronische Schaltung auf und/oder in dem Trägersubstrat **1360** umfassen kann, können beispielsweise umfassen:
die Auswertevorrichtung (**AWV, 30)**, Steuervorrichtungen (**CTR, CTR2, 33**), Datenbusse (**DB, 29**), Treiberstufen **DRVL,** Signalgeneratoren (**G1, G1_1, G1_2, G1_3, G2, G2_I, G2_II, G2_III, G2_IV**), Magnetfelderzeugungsmittel (**L_{c}**, **L_{c_}3, L_{c_}2**, **L_{c_}3, L_{c_}4, L_{c_}5**), Magnetfeldregler **LCTR**, Lichtquellentreiber (**LDRV, LDRV_1, LDRV_2, LDRV_3, LDRV_4, LDRV_5**), Lichtquellen (**LED, LED_1, LED_2, LED_3, LED_4, LED_5, 2**), Mehrfachkorrelatoren (**LIV, LIV_1, LIV_2, LIV_3, LIV_4, LIV_5**), Multiplizierer (**M1, M2**), Mustererkennungsvorrichtung **MEV,** Mischer **MIX,** Magnetfeldsensoren **MS,** Mikrowellensignalquellen (**µWG, µWG_I**, **µWG_II**, **µWG_III**, **µWG_IV**), Speicher (**RAM, NVM**), Fotodetektoren (**PD, PD_1, PD_2, PD_3, PD_4, PD_5**), Radiowellenquellen **RFG,** Verstärker (**V1, V1_1, V1_2, V1_3, V1_4, V1_5**), Lichtsensorarrays **1**, Auswertelektronik **15**, Aufbereitungsvorrichtungen **30**, Schnittstellenschaltungen **36**, etc.

Bevorzugt umfasst die mikroelektronische Schaltung beispielsweise auch einen Spannungsregler zur Versorgung der mikroelektronischen Schaltung und ggf. ihrer Teilkomponenten und/oder zur Versorgung einer Pumplichtquelle, der Lichtquelle **LED,** zur Anregung der Emission der Fluoreszenzstrahlung **FL** der paramagnetischen Zentren der Kristalle und/oder der Diamant-Nano-Kristalle **ND** der Sensorelemente **SE** und/oder der Sensorelementschichten **5** mittels Pumpstrahlung **LB.** Ein geeignetes mikrooptisches System muss aber zum einen die paramagnetischen Zentren der Kristalle und/oder der Diamant-Nano-Kristalle **ND** der Sensorelemente **SE** und/oder der Sensorelementschichten **5** mittels Pumpstrahlung **LB** stimulieren können und zum anderen die Fluoreszenzstrahlung **FL** der paramagnetischen Zentren der Kristalle und/oder der Diamant-Nano-Kristalle **ND** der Sensorelemente **SE** und/oder der Sensorelementschichten **5** erfassen und zuverlässig von der Pumpstrahlung LB der Pumpstrahlungsquelle, hier der Lichtquelle **LED,** trennen können. Hierfür ist es sinnvoll, wenn das mikro-elektrooptische System mikrooptische Bauelemente aufweist, die in einem entsprechenden Prozessschritt mikrotechnisch hergestellt werden. Besonders wichtig sind hierbei optische Filter (**F1**, **3**) und Lichtwellenleiter (**LWL1, LWL2**).

An dieser Stelle verweist das hier vorgelegte Dokument beispielhaft auf die Bücher Baha E.A. Saleh, Malvin Carl Teich, "Grundlagen der Photonik"Wiley-VCH, 2007 und Bernhard C. Kress, Patrick Meyreueis "Applied Digital Optics" Wiley, 2009.

Das vorgeschlagene Verfahren umfasst somit bevorzugt einen Schritt zur Durchführung eines Verfahrens zur Herstellung mikrooptischer Bauelemente auf dem Halbleitersubstrat.

### Zur Co-Integration geeigneter lichtemittierender Bauteile

Ein besonderes Problem stellen, wie bereits angedeutet, lichtemittierende Bauelemente in Standard-Silizium-Technologien zur Herstellung mikroelektronischer Schaltungen dar. Entweder wird als Halbleitersubstrat ein Material aus einem Halbleiter mit einem direkten Übergang, wie beispielsweise GaAs oder ein anderes geeignetes III/V-Material, verwendet, wodurch die lichtemittierenden Bauelemente (Lichtquellen **LED**) für die Erzeugung der Pumpstrahlung **LB** für die Anregung der Fluoreszenzstrahlung **FL** der paramagnetischen Zentren der Kristalle und/oder der Diamant-Nano-Kristalle **ND** der Sensorelemente **SE** und/oder der Sensorelementschichten **5** direkt auf dem Wafer gefertigt werden können, oder es wird als Halbleitersubstrat ein Material aus einem Halbleiter mit einem indirekten Übergang, wie beispielsweise Silizium oder Diamant, verwendet. Hinsichtlich der Erzeugung von Lichtquellen **LED** in Diamant verweist das hier vorgelegte Dokument beispielhaft auf das folgende Dokument:
Burchard B., "Elektronische und optoelektronische Bauelemente und Bauelementstrukturen auf Diamantbasis" Dissertation, Hagen 1994.

Hinsichtlich der Erzeugung von Lichtquellen **LED** in Silizium verweist das hier vorgelegte Dokument beispielhaft nochmals auf den bereits erwähnten folgenden Zeitschriftenartikel:
Röcken H., Meijer J., Stephan A., Weidenmüller U., Bukow H.H., Rolfs C., "White electroluminescent nanostructure in silicon fabricated using focused ion implantation" Nuclear Instruments and Methods in Physics Research B 181 (1001) Seite 274-279.

Dieses Dokument behandelt eine PNP- oder NPN-MESA-Struktur **MESA,** bei der die mittlere Dotierung extrem hoch und sehr schmal ausgeführt ist. Die Autoren des Dokuments vertreten die Auffassung, dass es sich hier um ein Bauteil im Lawinendurchbruch handelt. Dabei wird die Lichtenergie in Form eines thermischen Spektrums durch die heißen Elektronen abgestrahlt. Die mikroelektronische Schaltung legt bei einer NPN-Struktur zwischen den Kontakt des ersten N-Gebiets und dem Kontakt des zweiten N-Gebiets eine relativ hohe Spannung an. Es kommt zum Durchbruch. Durch den Durchbruch der Basis-Kollektor-Strecke wird ein Strom in die Basis injiziert. Die extrem hoch dotierte und sehr schmale Basis schaltet durch, sodass der Transistor schlagartig extrem schnell durchschaltet. Die Teile der Basis-Kollektor-Kapazität in der Nähe des PN-Übergangs werden schlagartig entladen. Hierdurch kommt es zu einer elektromagnetischen Welle in der Basis, die durch die hohe Dotierung und den dadurch vorhandenen Brechungsindexsprung fokussiert wird. Wenn ein "+" eine hohe Dotierung symbolisieren soll, wird hier also die Verwendung einer PN+P-Struktur oder einer NP+N-Struktur vorgeschlagen. Aus der Literatur sind insbesondere sogenannte Silicon-Avalance-Based-Light-Emitting-Diodes bekannt, die ähnliches leisten, typischerweise aber im infraroten Wellenlängenbereich strahlen. (K. Kurokawa, "Avalanche Breakdown Electroluminescence in Silicon Carbide Light Emitting Diodes", January 2000Materials Science Forum 338-342:691-694, DOI: 10.4028/www.scientific.net/MSF.338-342.691) Diese kommen also als Pumpstrahlungsquellen nicht in Frage.

Auf Basis einer solchen PN+P-Struktur oder einer NP+N-Struktur oder einer solchen Silicon-Avalance-Based-Light-Emitting-Diode ergibt sich dann ein quantentechnologisches, mikro-elektrooptisches oder photonisches oder mikroelektronisches System in MOS-, CMOS-, BICMOS- oder Bipolar-Technik, oder einer anderen geeigneten Wafer-Fertigungstechnik. Das besagte System umfasst dann ein Trägersubstrat **1360,** das insbesondere aus einem indirekten Halbleiter wie Silizium gefertigt ein kann und eine Oberfläche **OF** aufweist. Bevorzugt weist das Trägersubstrat **1360** für die Lichterzeugung eine Silicon-Avalance-Based-Light-Emitting-Diode oder eine PN+P-Struktur oder eine NP+N-Struktur oder eine halbleitende MESA-Struktur (MESA) **MESA** auf. Diese Silicon-Avalance-Based-Light-Emitting-Diode, PN+P-Struktur, NP+N-Struktur oder halbleitende MESA-Struktur (MESA) **MESA** dienen hier als lichtemittierendes mikroelektronisches Bauteil, das beispielsweise als Pumplichtquelle, hier die Lichtquelle **LED,** für die Anregung eines paramagnetischen Zentrums genutzt werden kann. Die MESA-Struktur **MESA** ist bevorzugt gegenüber dem Substrat isoliert und weist einen ersten Bereich (E) der MESA-Struktur (**MESA**), einen zweiten Bereich (B) der MESA-Struktur (**MESA**) und einen dritten Bereich (C) der MESA-Struktur (**MESA**) auf. Das quantentechnologische, mikro-elektrooptische oder photonische oder mikroelektronische System weist darüber mehrere Kristalle und/oder Diamant-Nano-Kristalle **ND** mit zumindest einer Vielzahl bevorzugt möglichst gleicher paramagnetischer Zentren, insbesondere NV-Zentren, auf. Zumindest ein mikro-optisches Funktionselement, insbesondere ein Lichtwellenleiter **LWL2,** das in dem Trägersubstrat **1360** oder auf der Oberfläche OF des Trägersubstrats **1360** gefertigt ist, koppelt bevorzugt die besagten lichtemittierenden Bauteile in oder auf dem Trägersubstrat **1360** mit einem oder mehreren paramagnetischen Zentren, sodass diese gepumpt oder sonst wie optisch manipuliert werden können. Bevorzugt ist in das mikro-optisches Funktionselement, insbesondere den zweiten Lichtwellenleiter **LWL2,** ein optisches Bandpassfilter **4** integriert, das bevorzugt im Wesentlichen die Pumpstrahlung **LB** mit Pumpstrahlungswellenlänge λₚₘₚ transmittiert. Im Sinne des hier vorgelegten Dokuments umfasst dann das Trägersubstrat **1360** das mikrooptische Funktionselement, hier den zweiten Lichtwellenleiter **LWL2.** Hierbei ist der zweite Lichtwellenleiter **LWL2** in seiner Längserstreckung ganz oder zu großen Teilen vorzugsweise fest mit dem Substrat 1360 verbunden. Der erste Bereich (E) und der dritte Bereich (C) der ggf. verwendeten MESA-Struktur **MESA** weisen bevorzugt einen ersten Leitfähigkeitstyp auf. Der zweite Bereich (B) der ggf. verwendeten MESA-Struktur **MESA** weist bevorzugt einen zweiten Leitfähigkeitstyp auf, der vom ersten Leitfähigkeitstyp verschieden ist und der zweite Bereich (B) zwischen dem ersten Bereich (E) und dem zweiten Bereich (C) angeordnet ist. Bei der MESA-Struktur (MESA) **MESA** handelt es sich bevorzugt um eine PNP- oder NPN-MESA-Struktur **MESA,** wobei die Breite des zweiten Bereichs (B) bevorzugt kleiner als 3µm und/oder kleiner als 1µm und/oder kleiner als 500nm und/oder kleiner als 200nm und/oder kleiner als 100nm und/oder kleiner als 50nm und/oder kleiner als 25nm und/oder kleiner als 10nm ist. Der zweite Bereich (B) ist bei einer ausreichend hohen Dotierung dann dazu geeignet, bei Anlegen einer ausreichend hohen elektrischen Spannung Licht zu emittieren. Ein beispielhaftes Spektrum zeigt Figur 90. Eine Kopplung mit einem optischen Funktionselement dokumentiert dann, dass die MESA-Struktur **MESA** dazu vorgesehen ist, Licht zu emittieren. Das vom zweiten Bereich (B) emittierte Licht wirkt dann mit paramagnetischen Zentren der Kristalle und/oder der Diamant-Nano-Kristalle **ND** des Sensorelements **SE** und/oder der Sensorelementschicht 5 mittels des besagten mikrooptischen Funktionselements, hier dem zweiten Lichtwellenleiter **LWL2** zusammen.

Das Trägersubstrat **1360** ist bevorzugt Halbleitersubstrat oder ein Silizium-Wafer oder ein GaAs-Wafer oder ein Wafer aus einem III/V-Material oder ein Wafer aus II/VI-Material oder aus ein mittels Band-Gap-Engineering behandelter Wafer oder ein Diamant-Wafer oder ein Ge-Wafer oder ein anderer Wafer aus einem Mischhalbleiter oder ein Teil eines solchen Wafers.

Es wird in dieser Offenbarung somit ein quantentechnologisches, mikro-elektrooptisches oder photonisches System vorgeschlagen, das ein Trägersubstrat **1360,** insbesondere ein Halbleitersubstrat umfasst. Das besondere des Vorschlags hier ist, dass das gesamte System mit Ausnahme der Kristalle und/oder Diamant-Nano-Kristalle **ND** aus einem indirekten Halbleitermaterial gefertigt sein kann. In und/oder auf dem Halbleitermaterial ist typischerweise eine mikroelektronische Schaltung, bevorzugt in einer MOS-, CMOS-, BICMOS,- oder Bipolar-Technik gefertigt. Dabei umfasst die mikroelektronische Schaltung bevorzugt eine Mehrzahl von Bauelementen wie Transistoren, Dioden, Widerständen, Kondensatoren, lichtempfindliche und ggf. lichtemittierende elektronische Bauelemente. Ein solches, lichtempfindliches Bauelement, also beispielsweise ein Fotodetektor **PD,** der besagten mikroelektronischen Schaltung beispielsweise zur Erfassung der Intensität **I**ᵢₛₜ der Fluoreszenzstrahlung **FL** der paramagnetischen Zentren der Kristalle und/oder der Diamant-Nano-Kristalle **ND,** die bevorzugt ein Diamant und NV-Zentrum umfassen, kann beispielsweise eine PN-Diode als lichtempfindliches, elektrisches Bauelement, als Fotodetektor **PD** sein, das Teil der mikroelektrischen Schaltung ist. Ein lichtemittierendes Bauelement kann beispielsweise eine MESA-Struktur **MESA,** wie hie beschrieben sein. Das quantentechnologische, mikro-elektrooptische oder photonische System umfasst bevorzugt einen Teilbereich eines kolloidalen Films bzw. kolloidalen Lackes **KL** als Sensorelement **SE** und/oder Sensorelementschicht **5**, der mehrere Kristalle und/oder Diamant-Nano-Kristalle **ND** mit paramagnetischen Zentren aufweist. Ganz besonders bevorzugt ist eine Variante, bei der es sich bei Trägersubstrat **1360** um einen mikroelektronischen Schaltkreis, insbesondere um einen mikroelektronischen Schaltkreis in MOS-, CMOS-, BICMOS, oder Bipolar-Technologie handelt. Typischerweise umfasst das Trägersubstrat **1360** dann Materialien, wie beispielsweise Stücke von Platinenmaterialien oder Stücke von Kunststoffplatten- oder -folien und/oder Stücke von Glas-Wafern oder Stücke von Keramik-Wafern und/oder Stücke von Halbleiterwafern, beispielsweise Stücke von CMOS-Wafern oder beispielsweise Stücke von BiCMOS-Wafern und/oder beispielsweise Stücke von Wafern aus einer Bipolar-Technologie und/oder Stücke eines Wafers aus einem III/V-Material oder dergleichen und/oder beispielsweise Stücke von MEMS-Wafern und/oder Stücke mikroelektronischer Schaltungen und/oder beispielsweise Stücke von MEOS-Wafern (MEOS= micro electro optical system) und/oder beispielsweise Stücke von MOEMS-Wafern etc. und/oder Stücke von MOEMS-Wafern mikroelektronische Schaltkreise und mikroelektronischer Funktionselemente und/oder mikrooptische Funktionselemente und/oder mikromechanische Funktionselemente und/oder mikrofluidische Funktionselemente.

Ein solcher mikroelektronischer Schaltkreis, der typischerweise in dem Trägersubstrat **1360** gefertigt ist, umfasst als bevorzugt eine Mehrzahl mikroelektronischer Bauelemente, wie MOS-Transistoren, Bipolartransistoren, Dioden, Widerstände, Kapazitäten, Spulen und ggf. weitere Halbleiterbauelemente, die in dem Trägersubstrat **1360** und insbesondere im Metallisierungsstapel, gefertigt sind und durch Leitungen zu der mikroelektronischen Schaltung verschaltet sind, die mit den paramagnetischen Zentren der Kristalle und/oder der Diamant-Nano-Kristalle ND, die bevorzugt Diamant und/oder NV-Zentren umfassen, zu einem Gesamtsystem optisch gekoppelt sind. Dabei umfasst das Trägersubstrat **1360** bevorzugt mindestens ein mikrooptisches Funktionselement, z.B. einen ersten Lichtwellenleiter **LWL1** und die mikroelektronische Schaltung in MOS-, CMOS-, BICMOS, oder Bipolar-Technik. Typischerweise weist das Trägersubstrat **1360** auch das lichtempfindliche elektrische Bauelement (**nG, pG**), den Fotodetektor **PD,** auf, um bevorzugt mittels dieses lichtempfindlichen elektrischen Bauelements (**pG, nG**), des Fotodetektors **PD,** eine Emission von Fluoreszenzstrahlung **FL** der paramagnetischen Zentren, insbesondere von NV-Zentren, der Kristalle und/oder Diamant-Nano-Kristalle **ND** zu erfassen. Typischerweise hängt dann zumindest ein Betriebsparameter der mikroelektronischen Schaltung von einem durch das lichtempfindliche Bauelement (**pG, nG**), den Fotodetektor **PD,** erfassten Wert der Intensität **I**ᵢₛₜ der Fluoreszenzstrahlung **FL** der paramagnetischen Zentren der Kristalle und/oder diamant-Nano-Kristalle **ND** der Sensorelemente **SE** und/oder der Sensorelementschicht **5** ab. Die paramagnetischen Zentren der Kristalle und/oder diamant-Nano-Kristalle **ND** der Sensorelemente **SE** und/oder der Sensorelementschicht **5** sind bevorzugt über das erste mikrooptische Funktionselement **LWL1** mit dem lichtempfindlichen elektrischen Bauelement (**pG, nG**), dem Fotodetektor **PD** gekoppelt. Bevorzugt sind das erste optische Funktionselement und/oder das zweite optische Funktionselement in Teilen oder ganz identisch. Figur 89 zeigt jedoch eispielhaft verschiedene optische Funktionselemente. Ein solches quantentechnologisches, mikro-elektrooptisches oder photonisches oder mikroelektronisches System kann aber auch auf einem mit einem Trägersubstrat **1360** aus einem direkten Halbleitermaterial gefertigt werden. Dies hat den Vorteil, dass die Lichtausbeute der lichtemittieren Bauelemente des Systems bei Nutzung als Lichtquellen **LED** höher ist und so eine bessere Pumpleistung durch die Pumpstrahlung **LB** erreicht werden kann, was den Kontrast zwischen der Intensität **I**ᵢₛₜ der Fluoreszenzstrahlung **FL** der paramagnetischen Zentren der Kristalle und/oder Diamant-Nano-Kristalle **ND** der Sensorelemente **SE** und/oder der Sensorelementschicht **5** bei der magnetischen Flussdichte mit maximaler Intensität **I**ᵢₛₜ der Fluoreszenzstrahlung **FL** der paramagnetischen Zentren der Kristalle und/oder Diamant-Nano-Kristalle **ND** der Sensorelemente **SE** und/oder der Sensorelementschicht **5** und der Intensität **I**ᵢₛₜ der Fluoreszenzstrahlung **FL** der paramagnetischen Zentren der Kristalle und/oder Diamant-Nano-Kristalle **ND** der Sensorelemente **SE** und/oder der Sensorelementschicht **5** bei der magnetischen Flussdichte mit minimaler Intensität **I**ᵢₛₜ der Fluoreszenzstrahlung **FL** paramagnetischen Zentren der Kristalle und/oder Diamant-Nano-Kristalle **ND** der Sensorelemente **SE** und/oder der Sensorelementschicht **5** verbessert. Bevorzugt werden dann Substratmaterialen des Trägersubstrats **1360** verwendet, bei denen ein Halbleitermaterial des Substrats ein III/V-Halbleitermaterial und/oder ein II/VI-Halbleitermaterial oder ein durch Bandgap-Engineering hergestelltes Halbleitermaterial sein kann. Das Substratmaterial des Trägersubstrats **1360** muss also ausdrücklich nicht homogen sein, sondern kann aus unterschiedlichen Materialien bestehen. Das System umfasst dann eine mikroelektronischen Schaltung, die bevorzugt Teil des Trägersubstrats **1360** sein kann, und ein elektrisches Bauelement, das bevorzugt Teil der mikroelektrischen Schaltung ist, und eine mikrooptische Teilvorrichtung (**LWL1, LWL2**), die bevorzugt Teil des Trägersubstrats **1360** ist, und mehrere Kristalle und/oder Diamant-Nano-Kristalle **ND,** die Diamanten sein können, mit paramagnetischen Zentren der Kristalle und/oder diamant-Nano-Kristalle **ND** der Sensorelemente **SE** und/oder der Sensorelementschicht **5**. Das Trägersubstrat **1360** umfasst somit in dem hier vorgestellten Fall die mikroelektronische Schaltung und das elektrische Bauelement und die mikrooptische Vorrichtung (**LWL1, LWL2**). Das besondere des Systems ist dann, dass es zumindest ein lichtemittierendes elektrooptisches Bauelement **MESA** vorzugsweise als Lichtquelle **LED** aufweist, das Teil des Trägersubstrats **1360** ist oder auf der Oberfläche des Trägersubstrats **1360** gefertigt ist, wobei das Trägersubstrat **1360** das lichtemittierende Bauelement **MS** als Lichtquelle **LED** umfasst und wobei das lichtemittierende elektrooptische Bauelement **MESA** als Lichtquelle **LED** mit der mikrooptischen Teilvorrichtung (**LWL1, LWL2**) optisch wechselwirkt. Das lichtemittierende elektrooptische Bauelement **MESA** wechselwirkt als Lichtquelle **LED** mit dem elektrischen Bauelement elektrisch und/oder optisch in direkter oder indirekter Weise mittels der mikrooptischen Teilvorrichtung (**LWL1, LWL2**). Diese Wechselwirkung zwischen dem lichtemittierenden elektrooptischen Bauelement **MESA** als Lichtquelle **LED** mit dem elektrischen Bauelement erfolgt dabei bevorzugt unter Mitwirkung der paramagnetischen Zentren der Kristalle und/oder diamant-Nano-Kristalle **ND** der Sensorelemente **SE** und/oder der Sensorelementschicht **5**.

Das Trägersubstrat **1360** ist in dem hier vorgestellten Fall also bevorzugt ein Halbleitersubstrat, ein Silizium-Wafer oder ein GaAs-Wafer oder ein Wafer aus einem III/V-Material oder ein Wafer aus II/VI-Material oder aus ein mittels Band-Gap-Engineering behandelter Wafer oder ein Diamant-Wafer oder ein Ge-Wafer oder ein anderer Wafer aus einem Mischhalbleiter.

Im Falle von III/V-Materialien kann das Substrat auch eine andere LED oder einen Laser als Lichtquelle **LED** umfassen.

Bevorzugt umfasst das quantentechnologische, mikro-elektrooptische oder photonische System mindestens ein mikrooptisches Element. Bevorzugt ist das das mikrooptische Element dazu geeignet oder vorgesehen, zumindest die Funktion eines der folgenden mikrooptischen Elemente zu erfüllen:
- die Funktion einer optischen Linse und/oder
- die Funktion eines photonischen Kristalls und/oder
- die Funktion eines optischen Filters und/oder
- die Funktion eines optischen ganz oder teilweise reflektierenden Spiegels und/oder
- die Funktion eines Lichtwellenleiters (**LWL1, LWL2**) und/oder
- die Funktion eines Richtkopplers und/oder
- die Funktion eines Wellensumpfes und/oder
- die Funktion eines Circulators (Zirkulators) und/oder
- die Funktion eines Koppel- und/oder Auskoppelgliedes.

Die paramagnetischen Zentren der Kristalle und/oder Diamant-Nano-Kristalle **ND** der Sensorelemente **SE** und/oder der Sensorelementschicht **5** wechselwirken in der Regel mit Magnetfeldern. Daher ist es denkbar, dass die Vorrichtung zumindest ein Funktionselement eines magnetischen Kreises und/oder eine ferromagnetische Teilvorrichtung oder eine ferromagnetische Teilstruktur umfasst. Dabei kann es sich um einen mikro- oder nanoskopischen Permanentmagneten **PM** handeln, der ggf. beispielsweise in den Metallisierungsstapel des besagten MOS-, CMOS-, BICMOS oder Bipolar-Schaltkreises, insbesondere oberhalb der paramagnetischen Zentren der Kristalle und/oder diamant-Nano-Kristalle **ND** der Sensorelemente **SE** und/oder der Sensorelementschicht **5** integriert ist. Bevorzugt kann es sich um einen mit einem Gradienten behafteten Permanentmagneten **GPM** handeln. Bevorzugt ist die besagte ferromagnetische Teilvorrichtung oder Teilstruktur Teil eines magnetischen Kreises. In dem Falle verfügt das quantentechnologische, mikro-elektrooptische System bevorzugt über eine Erregungsvorrichtung, beispielsweise ein Magnetfelderzeugungsmittel L_{c}, beispielsweise in Form einer oder mehrerer in dem Metallisierungsstapel gefertigten Flachspule, die dazu geeignet ist, eine magnetische Erregung in dem magnetischen Kreis hervorzurufen. Bevorzugt wird die magnetische Teilvorrichtung durch Abscheiden einer ferromagnetischen Schicht und anschließende fotolithografische Strukturierung gefertigt.

in dem Beispiel der Figur 89 umfasst die beispielhafte Vorrichtung oberhalb des Sensorelements **SE** bzw. der Sensorelementschicht **5** ein beispielhaftes Magnetfelderzeugungsmittel **L_{c}** in Form einer beispielhaften Flachspule im Metallisierungsstapel. Hinsichtlich der Funktion und des Betriebs verweist das hier vorgelegte Dokument auf die vorausgehenden Beschreibungen.

Sollen die paramagnetischen Zentren der Kristalle und/oder Diamant-Nano-Kristalle **ND** der Sensorelemente **SE** und/oder der Sensorelementschicht **5** als Teilvorrichtungen eines Sensorsystems verwendet werden, so hängt der Betrag und/oder die Richtung der durch die Erregungsvorrichtung erzeugten magnetischen Erregung H in dem magnetischen Kreis bzw. in dem Magnetfelderzeugungsmittel **L_{c}** bevorzugt von einem Betriebszustandsparameter des elektronischen Schaltkreises, also bevorzugt des MOS-, CMOS-, BICMOS- oder Bipolar-Schaltkreises, ab. In diesem Zusammenhang verweist das hier vorgelegte Dokument auf das Dokument DE 10 2018 127 394 A1. Die Verwendung des hier vorgestellten Verfahrens zur Herstellung einer Vorrichtung gemäß der DE 10 2018 127 394 A1 ist ausdrücklich Teil dieser Offenlegung. Die hier vorgelegte Schrift beschäftigt sich in ihrem Kern mit der großtechnischen Serienherstellung solcher Systeme, wie sie beispielsweise in der DE 10 2018 127 394 A1 beschrieben sind. Die hier vorgestellten Methoden werden sich aber auch für die Herstellung von Quantencomputern und anderen quantenoptischen Systemen eignen, die eine Anbindung an mikroelektronische und/oder mikromechanische und/oder mikrooptische Systeme benötigen.

Typischerweise weist ein solches quantentechnologische, mikro-elektrooptische System ein lichtempfindliches Bauelement (**pG, nG**) auf. Dabei ist dann bevorzugt das lichtempfindliche Bauelement (**pG, nG**), insbesondere der Fotodetektor **PD**, dazu geeignet und/oder bestimmt, die Intensität **I**ᵢₛₜ einer Fluoreszenzstrahlung **FL** von paramagnetischen Zentren der Kristalle und/oder diamant-Nano-Kristalle **ND** der Sensorelemente **SE** und/oder der Sensorelementschicht **5** zu erfassen. Bevorzugt werden die paramagnetischen Zentren der Kristalle und/oder Diamant-Nano-Kristalle **ND** der Sensorelemente **SE** und/oder der Sensorelementschicht **5** hierfür durch verschiedene optische Elemente zum einen mit einer Pumplichtquelle **MS** als Lichtquelle **LED** über eine optische Wellenverbindung aus mehreren optischen Komponenten (paramagnetische Zentren, **SE, LWL2**) und zum anderen mit dem lichtempfindlichen Bauelement (**pG, nG**) in Form der Lichtquelle **LED** über eine weitere optische Wellenverbindung aus mehreren weiteren optischen Komponenten (paramagnetische Zentren, **SE**, **LWL1**) gekoppelt.

Der hier offenbarte integrierter MOS-Schaltkreis bzw. CMOS- Schaltkreis, bzw. BICMOS-Schaltkreis bzw. Schaltkreis in Bipolar-Technologie oder einer anderen Schaltungstechnik zeichnet sich somit dadurch aus, dass er mehrere kristalline Teilvorrichtungen, die bevorzugt mechanisch mit ihm fest verbunden sind und die paramagnetischen Zentren der Kristalle und/oder Diamant-Nano-Kristalle **ND** der Sensorelemente **SE** und/oder der Sensorelementschicht **5** aufweist, wobei die paramagnetischen Zentren der Kristalle und/oder Diamant-Nano-Kristalle **ND** der Sensorelemente **SE** und/oder der Sensorelementschicht **5** Funktionselemente für die bestimmungsgemäße Verwendung des integrierten Schaltkreises sind. Ein kolloidaler Film und/oder ein kolloidaler Lack **KL** stellen als Sensorelement **SE** bzw. Sensorelementschicht **5** bevorzugt die mechanische Verbindung zwischen den kristallinen Teilvorrichtungen und dem Trägersubstrat **1360** her. Bevorzugt ein oder mehrere optische Kopplungen z.B. durch ein oder mehrere mikro-optisches Funktionselemente rufen eine oder mehrere Wirkverbindungen zwischen den paramagnetischen Zentren der Kristalle und/oder Diamant-Nano-Kristalle **ND** der Sensorelemente **SE** und/oder der Sensorelementschicht **5** und zumindest einem oder mehreren Teilen der MOS-, CMOS-, BICMOS- oder Bipolar- Schaltung, insbesondere lichtemittierenden Gebieten LG der Lichtquelle **LED** und/oder lichtempfindlichen Bauteilen (**PD**, **pG**, **nG**), insbesondere dem Fotodetektor **PD,** hervor. Der integrierte CMOS-Schaltkreis, bzw. MOS-Schaltkreis, bzw. BICMOS-Schaltkreis bzw. Schaltkreis in Bipolar-Technologie oder einer anderen Schaltungstechnik weist typischerweise einen oder mehrere Transistoren auf. Im Falle einer BICMOS-Schaltung können das Bipolartransistoren und/oder MOS-Transistoren sein. Im Falle einer MOS- oder CMOS-Schaltung können das MOS-Transistoren sein. Im Falle einer Bipolar-Schaltung können das Bipolartransistoren sein.

Bevorzugt ist die mikrointegrierte Schaltung einstückig ausgeführt. Bevorzugt umfasst die mikrointegrierte Schaltung mehrere der folgenden Teilvorrichtungen wie die Steuervorrichtung **CTR** und die Speicher **RAM**, **NVM**, Teile des Datenbusses **DB,** einen oder mehrere Lichtquellentreiber **LDRV**, einen oder mehrere erste Signalgeneratoren **G1**, einen oder mehrere Mehrfachkorrelatoren **LIV,** einen oder mehrere Fotodetektoren **PD,** einen oder mehrere erste Verstärker **V1,** einen oder mehrere Mustererkennungsvorrichtungen **MEV,** einen oder mehrere Mikrowellenquellen **µWG**, einen oder mehrere zweite Signalgeneratoren **G2**, einen oder mehrere Magnetfeldsensoransteuerungen **SIS,** einen oder mehrere Magnetfeldsensoren **MS,** einen oder mehrere Magnetfeldregler **LCTR**, einen oder mehrere mikrooptische Funktionselemente **6**, **4**, **F1**, ein oder mehrere Sensorelemente **SE** und/oder Sensorelementschichten **5**, ein oder mehrere Lichtsensorarrays **1**, ein oder mehrere Auswertelektroniken **15** des Lichtsensorarrays **1**, ein oder mehrere Aufbereitungsvorrichtungen **30,**eine oder mehrere Schnittstellenschaltungen **36**, ein oder mehrere Permanentmagneten **19**, ein oder mehrere Magnetfelderzeugungsvorrichtungen **L_{c},.**

Die mikroelektronische Schaltung kann entsprechend der technischen Lehre des hier vorgelegten Dokuments ein oder mehrere Sensorelemente **SE** und/oder ein oder mehrere Sensorschichten **5** umfassen. Die ein oder mehrere Sensorelemente **SE** und/oder die ein oder mehrere Sensorschichten **5** umfassen bevorzugt eine Vielzahl von Kristallen unterschiedlicher Ausrichtung mit paramagnetischen Zentren und/oder eine Vielzahl von Diamant-Nano-Kristallen **ND** unterschiedlicher Ausrichtung und NV-Zentren und/oder anderen paramagnetischen Zentren.

Bevorzugt umfasst die mikroelektronische Schaltung ein oder mehrere Lichtquellen **LED** zur Erzeugung der Pumpstrahlung **LB** für die ein oder mehreren Sensorelemente **SE** und/oder die ein oder mehreren Sensorschichten **5**.

Bevorzugt umfasst die mikroelektronische Schaltung mikrooptische Funktionselemente zur Bestrahlung der ein oder mehreren Sensorelemente **SE** und/oder die ein oder mehreren Sensorschichten **5** mit der Pumpstrahlung **LB** der ein oder mehrere Lichtquellen **LED.**

Bevorzugt umfasst die mikroelektronische Schaltung mikrooptische Funktionselemente zur Erfassung der Fluoreszenzstrahlung **FL** der ein oder mehreren Sensorelemente **SE** und/oder die ein oder mehreren Sensorschichten **5** und zur Abtrennung der Fluoreszenzstrahlung **FL** der ein oder mehreren Sensorelemente **SE** und/oder die ein oder mehreren Sensorschichten **5** von der Pumpstrahlung **LB** der ein oder mehrere Lichtquellen **LED** und zur Bestrahlung der Fotodetektoren **PD** mit der Fluoreszenzstrahlung **FL** der ein oder mehreren Sensorelemente **SE** und/oder die ein oder mehreren Sensorschichten **5**.

Für die Anwendung in verschiedenen Anwendungsfällen kann die mikroelektronische Schaltung darüber hinaus auch mikrofluidische und/oder mikromechanische und weitere mikrooptische Funktionselemente umfassen.

### Figur 90

Die Figur 90 zeigt ein Spektrum einer MESA-Struktur **MESA** der Figur 89 aus dem Stand der Technik für eine Betriebsspannung von 15V.

Die Kurvendaten entstammen dem Dokument Röcken H., Meijer J., Stephan A., Weidenmüller U., Bukow H.H., Rolfs C., "White electroluminescent nanostructure in silicon fabricated using focused ion implantation" Nuclear Instruments and Methods in Physics Researc B 181 (1001) Seite 274-279.

Es ist klar zu erkennen, dass eine solche Struktur nicht nur Licht im Bereich der gewünschten Pumpstrahlungswellenlängen λₚₘₚ um 520nm herum aussendet, sondern auch im Bereich der zu erwartenden Fluoreszenzstrahlung FL oberhalb von 600nm. Eine Verwendung ohne optisches Bandpassfilter **4** ist daher nicht ratsam.

### Figur 91

Figur 91 zeigt ein beispielhaftes Trägersubstrat **1360** mit einem gewinkelt aufgebrachten Wellenleiter **6980.** Der beispielhafte Wellenleiter ist in dem Beispiel der Figur 91 eine differenzielle Tri-Plate-Leitung **6980.** Die beispielhafte Wellenleitung **6980** ist von einer Sensorelementschicht **5** als Sensorelement **SE** bedeckt. Die beispielhafte Sensorelementschicht **5** soll wieder eine Vielzahl von Kristallen und/oder Diamant-Nano-Kristallen **ND** mit paramagnetischen Zentren umfassen, die bei Bestrahlung mit Pumpstrahlung **LB** einer Pumpstrahlungswellenlänge λₚₘₚ eine Fluoreszenzstrahlung **FL** mit einer Fluoreszenzwellenlänge λ_{fl} in Abhängigkeit von der Mikrowellenfrequenz ω_{µW} des Mikrowellensignals **µW** und der zusätzlichen magnetischen Flussdichte **B_{ad}** emittieren. Die Abschlusswiderstände **6710** schließen die beispielhafte Tri-Plate-Wellenleitung **6980** als beispielhafte Wellenleitung wieder vorzugsweise reflexionsfrei ab.

Bevorzugt durchflutet ein Gradienten behafteter Permanentmagnet **GPM** von der anderen Seite des Trägersubstrats **1360** die Sensorelementschicht **5** mit einer zusätzlichen magnetischen Flussdichte, die beispielsweise in x-Richtung von einer maximalen zusätzlichen magnetischen Flussdichte **B_{ad_max}** zu einer minimalen zusätzlichen magnetischen Flussdichte **B_{ad_min}** hin abnimmt und die beispielsweise in y-Richtung von einer maximalen zusätzlichen magnetischen Flussdichte **B_{ad}_ₘₐₓ** zu einer minimalen zusätzlichen magnetischen Flussdichte **B_{ad_min}** hin abnimmt. Natürlich sind andere Verläufe denkbar.

Hierdurch verschiebt sich die Lage der V-Formation (5**22, 525, 530**) der Figur 51b in der Vertikalen der Figur 51b für jeden Punkt der Sensorelementschicht **5** oberhalb des Wellenleiters, hier der Tri-Plate-Leitung **6980.** Somit lässt der Intensitätsverlauf der Intensität **Iᵢₛₜ(x, y)** der Fluoreszenzstrahlung **FL** längs der beiden Äste des Wellenleiters, hier der Tri-Plate-Leitung **6980,** Rückschlüsse auf das Mikrowellenspektrum des Mikrowellensignals **µW** zu.

Bevorzugt umfasst das Sensorsystem in einem Speicher **RAM, NVM** des Sensorsystems über eine Datenbank einer Vielzahl von Messwertverläufen für den Intensitätsverlauf **Iᵢₛₜ(x, y)** der Fluoreszenzstrahlung **FL** längs der Wellenleiterkoordinaten **x**, **y** für die jeweiligen Verläufe der beiden Äste des Wellenleiters, hier der Tri-Plate-Leitung **6980,** für verschiedene bei der Erfassung dieser Messwertverläufe bekannte Mikrowellenfrequenzen ω_{µW} des Mikrowellensignals **µW** und/oder computerimplementierte Modelle und/oder computerimplementierte Approximationsfunktionen, die diese Messwerte liefern können. Bevorzugt ermitteln die Steuervorrichtung **CTR** und/oder die Mustererkennungsvorrichtung MEV mit deren Hilfe für verschiedene Mikrowellenfrequenzen ω_{µW} einen Korrelationswert **K(ω_{µW})** zwischen den Messwertverläufen für den Intensitätsverlauf **I_{LIB}(x)** bzw. **I_{LIB}(y)** der Fluoreszenzstrahlung **FL** längs der beiden Äste des Wellenleiters aus der Datenbank oder den computerimplementierten Modellen oder den computerimplementierten Approximationsfunktionen einerseits und dem aktuell gemessenen Messwertverläufen für den Intensitätsverlauf **Iᵢₛₜ(x)** bzw. **Iᵢₛₜ(y)** der Fluoreszenzstrahlung **FL** längs der beiden Äste des Wellenleiters.

Für den waagerechten Teil des Wellenleiters (siehe Figur 90) bilden wir den Korrelationswert **K_{w}(ω_{µW})** beispielsweise durch Bildung eines L2-Produkt-Integrals: ${K}_{w} \left({ω}_{μ W}\right) = {\int }_{{x}_{a}}^{{x}_{b}} {I}_{LIB} \left(x\right) ∗ {I}_{ist} \left({x}_{0}+x\right) dx$

Für den senkrechten Teil des Wellenleiters (siehe Figur 90) bilden wir den Korrelationswert **Kₛ(ω_{µW}**) beispielsweise durch Bildung eines L2-Produkt-Integrals: ${K}_{s} \left({ω}_{μ W}\right) = {\int }_{{y}_{a}}^{{y}_{b}} {I}_{LIB} \left(y\right) ∗ {I}_{ist} \left({y}_{0}+y\right) dy$

Da jeder Position x und y genau eine zusätzliche magnetische Flussdichte **B_{ad}(x)** bzw. **B_{ad}(y)** zugeordnet ist, kann dieses L2-Produkt auch geschrieben werden als: ${K}_{w} \left({ω}_{μ W}\right) = {\int }_{{B}_{ad} \left({x}_{a}\right)}^{{B}_{ad} \left({x}_{b}\right)} {I}_{LIB} \left(x\left({B}_{ad}\right)\right) ∗ {I}_{ist} \left(x\left({B}_{ad}\right)+x\left({B}_{ad}\left({x}_{0}\right)\right)\right) {dB}_{ad}$ ${K}_{s} \left({ω}_{μ W}\right) = {\int }_{{B}_{ad} \left({y}_{a}\right)}^{{B}_{ad} \left({y}_{b}\right)} {I}_{LIB} \left(y\left({B}_{ad}\right)\right) ∗ {I}_{ist} \left(y\left({B}_{ad}\right)+y\left({B}_{ad}\left({y}_{0}\right)\right)\right) {dB}_{ad}$

Die V-Formation (siehe Figuren 51b und 84) kann auf den linken Ast (5**22**) oder den rechten Ast (**25**) beschränkt werden. Daher sollte vor der Einspeisung des Mikrowellensignals **µW** in den Wellenleiter **6980** im Falle der Nutzung des linken Asts (5**22**) ein Tiefpassfilter (z.B. **µWG_F_I**) sicherstellen, dass das Mikrowellensignal **µW** keine Signalkomponenten mit einer Mikrowellenfrequenz ω_{µW} größer als die Nullpunktsmikrowellenfrequenz ω_{µW0} mehr umfasst. Daher sollte vor der Einspeisung des Mikrowellensignals **µW** in den Wellenleiter **6980** im Falle der Nutzung des rechten Asts (5**25**) ein Hochpassfilter (z.B. **µWG_F_I**) sicherstellen, dass das Mikrowellensignal **µW** keine Signalkomponenten mit einer Mikrowellenfrequenz ω_{µW} kleiner als die Nullpunktsmikrowellenfrequenz ω_{µW0} mehr umfasst. in der Praxis ist die Realisierung des Tiefpassfilters und damit die Nutzung des linken Asts (5**22**) der V-Formation (siehe Figur 2) einfacher.

In dem Fall ist dann jeder zusätzlichen magnetischen Flussdichte **B_{ad}(x)** bzw. **B_{ad}(y)** genau eine Mikrowellenfrequenz **ω_{µW}(B_{ad}(x))** bzw. **ω_{µW}(B_{ad}(y))** zugeordnet.

Das L2-Produkt kann dann geschrieben werden als: $\begin{matrix}{K}_{w} \left({ω}_{μ W}\left({B}_{ad}\left({x}_{0}\right)\right)\right) \\ = {\int }_{{ω}_{μ W} \left({B}_{ad}\left({x}_{a}\right)\right)}^{{ω}_{μ W} \left({B}_{ad}\left({x}_{b}\right)\right)} {I}_{LIB} \left(x\left({B}_{ad}\left({ω}_{μ W}\right)\right)\right) \\ ∗ {I}_{ist} \left(x\left({B}_{ad}\left({ω}_{μ W}\right)\right)+x\left({B}_{ad}\left({ω}_{μ W}\left({B}_{ad}\left({x}_{0}\right)\right)\right)\right)\right) {dω}_{μ W}\end{matrix}$ $\begin{matrix}{K}_{s} \left({ω}_{μ W}\left({B}_{ad}\left({y}_{0}\right)\right)\right) \\ = {\int }_{{ω}_{μ W} \left({B}_{ad}\left({y}_{a}\right)\right)}^{{ω}_{μ W} \left({B}_{ad}\left({y}_{b}\right)\right)} {I}_{LIB} \left(y\left({B}_{ad}\left({ω}_{μ W}\right)\right)\right) \\ ∗ {I}_{ist} \left(y\left({B}_{ad}\left({ω}_{μ W}\right)\right)+y\left({B}_{ad}\left({ω}_{μ W}\left({B}_{ad}\left({y}_{0}\right)\right)\right)\right)\right) {dω}_{μ W}\end{matrix}$

Ein solcher von den Mikrowellenfrequenzen ω_{µW} abhängiger Korrelationswert **Kₛ(ω_{µW}), K_{w}(ω_{µW})** bezeichnet das hier vorgelegte Dokument als Hochfrequenzspektrum des Mikrowellensignals **µW.**

Es ist offensichtlich, dass für eine Vermessung der Messwertverläufen für den Intensitätsverlauf **Iᵢₛₜ(x)** bzw. **Iᵢₛₜ(y)** der Fluoreszenzstrahlung FL längs der beiden Äste des Wellenleiters Magnetfeldkameras wie sie in Figur 79 bis 81 beispielhaft dargestellt sind, besonders günstig sind.

### Figur 92

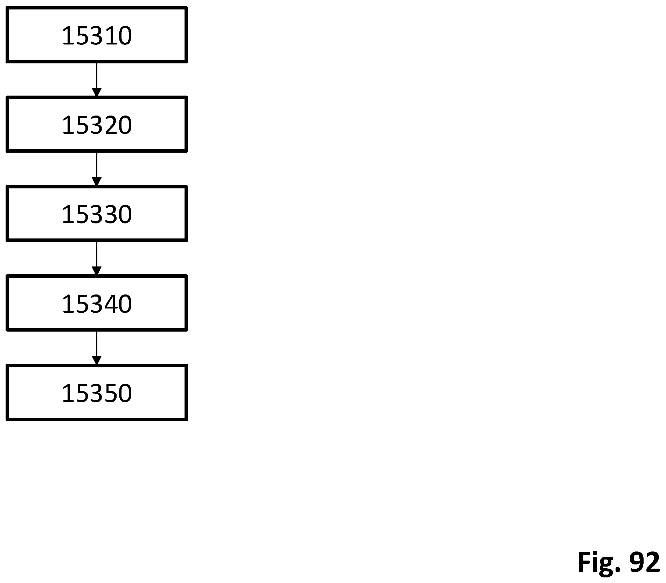

Figur 92 veranschaulicht schematisch vereinfacht das bereits erwähnte Verfahren zur Herstellung eines selbstjustierten Sensorelements SE Lichtwellenleiters **LWL**(**4630**), wie er zuvor beschrieben und verwendet wurde. Das vorgeschlagene Verfahren umfasst die Schritte:
- Bereitstellen **15310** eines Lichtwellenleiters **LWL**(**4630**), wobei der Lichtwellenleiter **LWL**(**4630**) ein erstes Ende und ein zweites Ende aufweist;
- Bereitstellen **15320** eines flüssigen und mittels elektromagnetischer Strahlung einer Aushärtewellenlänge λ_{H} härtbaren Trägermaterials **TM,** wobei in das Trägermaterial **TM** eine Vielzahl von Kristallen und/oder Diamant-Nano-Kristallen **ND,** vorzugsweise Nanodiamanten, eingebettet sind und wobei einer oder mehrere oder alle Kristalle und/oder Diamant-Nano-Kristalle **ND** NV-Zentren und/oder andere paramagnetischen Zentren aufweisen und wobei die NV-Zentren der Kristalle und/oder Diamant-Nano-Kristalle **ND** des Trägermaterials **TM** und/oder die anderen paramagnetischen Zentren der Kristalle und/oder Diamant-Nano-Kristalle **ND** des Trägermaterials **TM** bei Bestrahlung mit Pumpstrahlung **LB** zumindest eine Fluoreszenzstrahlung **FL** emittieren;
- Benetzen **15330** des zweiten Endes des Lichtwellenleiters **LWL(4630)** zumindest auf eine Benetzungslänge L_{B} mit dem Trägermaterial **TM,** das die Vielzahl eingebetteter Kristalle und/oder Diamant-Nano-Kristalle **ND** mit NV-Zentren und/oder paramagnetischen Zentren aufweist;
- Einspeisen **15340** elektromagnetischer Strahlung in das erste Ende des Lichtwellenleiters **LWL**(**4630**), wobei die Wellenlänge dieser elektromagnetischen Strahlung, die Aushärtewellenlänge λ_{H}, so gewählt ist, dass das Trägermaterial **TM** am zweiten Ende des Lichtwellenleiters **LWL**(**4630**) aushärtet und sich in einen Festkörper wandelt.
- Entfernen **15350** des nicht ausgehärteten Trägermaterials **TM** insbesondere mittels eines Lösungsmittels **LM,** wobei der verbleibende Film des Trägermaterials **TM** am zweiten Ende des Lichtwellenleiters **LWL**(**4630**) das Sensorelement **SE** bildet.

Typischerweise härtet das Trägermaterial **TM** nur teilweise aus, was die Bildung des optischen Funktionselements und des Sensorelements **SE** ermöglicht.

### Figur 93

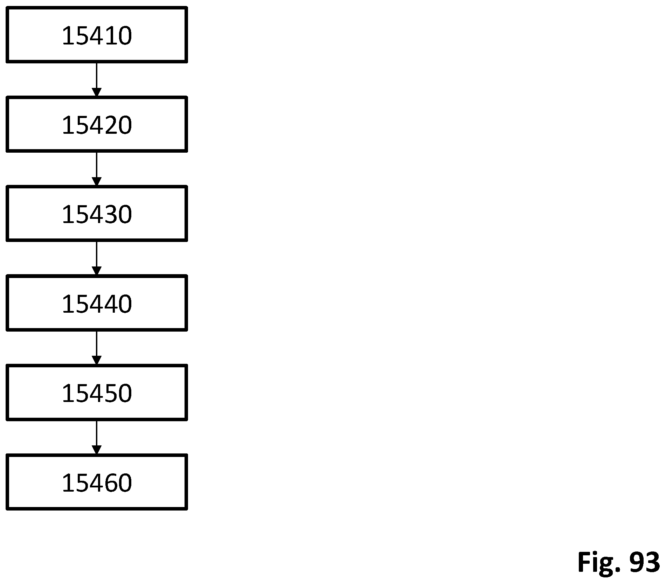

Figur 93 veranschaulicht schematisch vereinfacht das bereits erwähnte Verfahren zur Herstellung eines maskenjustierten Sensorelements **SE** am Lichtwellenleiters **LWL**(**4630**), wie er zuvor beschrieben und verwendet wurde. Das vorgeschlagene Verfahren umfasst die Schritte:
- Bereitstellen **15410** eines Lichtwellenleiters **LWL**(**4630**), wobei der Lichtwellenleiter **LWL**(**4630**) ein erstes Ende und ein zweites Ende aufweist;
- Bereitstellen **15420** eines flüssigen und mittels elektromagnetischer Strahlung einer Aushärtewellenlänge λ_{H} härtbaren Trägermaterials **TM,** wobei in das Trägermaterial **TM** eine Vielzahl von Kristallen und/oder Diamant-Nano-Kristallen **ND,** vorzugsweise Nanodiamanten, eingebettet sind und wobei einer oder mehrere oder alle Kristalle und/oder Diamant-Nano-Kristalle **ND** NV-Zentren und/oder andere paramagnetischen Zentren aufweisen und wobei die NV-Zentren der Kristalle und/oder Diamant-Nano-Kristalle **ND** des Trägermaterials **TM** und/oder die anderen paramagnetischen Zentren der Kristalle und/oder Diamant-Nano-Kristalle **ND** des Trägermaterials **TM** bei Bestrahlung mit Pumpstrahlung **LB** zumindest eine Fluoreszenzstrahlung **FL** emittieren;
- Beschichten **15430** des zweiten Endes des Lichtwellenleiters **LWL**(**4630**) zumindest auf eine Benetzungslänge L_{B} mit dem Trägermaterial **TM,** das die Vielzahl eingebetteter Kristalle und/oder Diamant-Nano-Kristalle **ND** mit NV-Zentren und/oder paramagnetischen Zentren aufweist;
- Justieren **15440 einer** Belichtungsmaske **5410** gegenüber dem Trägersubstrat **1360**.
- Bestrahlen **15450** des zweiten Endes des Lichtwellenleiters **LWL**(**4630**) durch die Belichtungsmaske **5410** mit elektromagnetischer, wobei die Wellenlänge dieser elektromagnetischen Strahlung, die Aushärtewellenlänge λ_{H}, so gewählt ist, dass das Trägermaterial **TM** am zweiten Ende des Lichtwellenleiters **LWL**(**4630**) aushärtet und sich in einen Festkörper wandelt;
- Entfernen **15460** des nicht ausgehärteten Trägermaterials **TM** insbesondere mittels eines Lösungsmittels **LM,** wobei der verbleibende Film des Trägermaterials **TM** am zweiten Ende des Lichtwellenleiters **LWL**(**4630**) das Sensorelement **SE** bildet.

Typischerweise härtet das Trägermaterial **TM** nur teilweise aus, was die Bildung des optischen Funktionselements und des Sensorelements **SE** ermöglicht.

### Figur 94

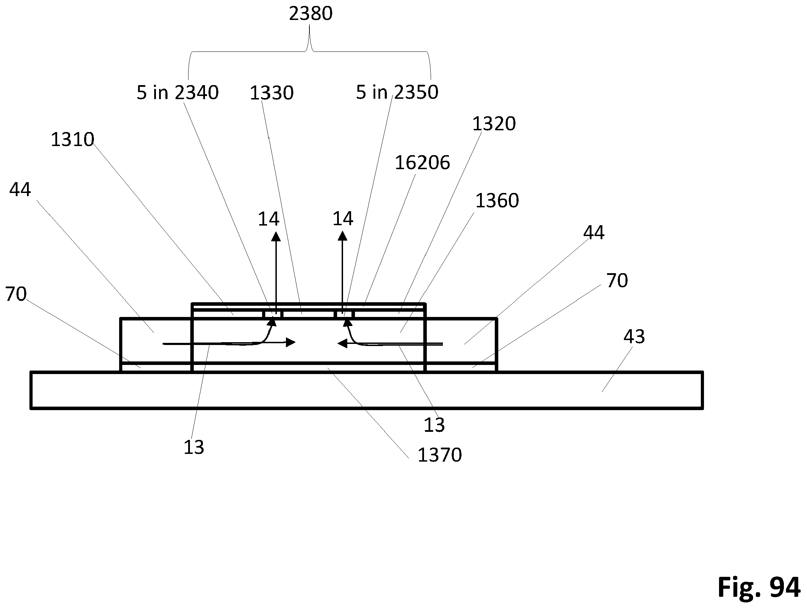

Figur 94 zeigt ein beispielhaftes optisch transparentes Trägersubstrat **1360** mit einem beispielhaften Wellenleiter in Form einer Tri-Plate-Leitung **2380**. Bei der Auswahl des Wellenleitertypen des Wellenleiters auf der Oberfläche des optisch transparenten Trägersubstrats **1360** ist es vorteilhaft, wenn die Leitungen und elektrisch leitenden Flächen des betreffenden Wellenleiters die Oberfläche des optisch transparenten Trägersubstrats **1360** bis auf die Clearences (**2340**, **2350**) komplett abdecken, sodass Licht aus dem optisch transparenten Trägersubstrat **1360** im Wesentlichen nur über die Kanten des optisch transparenten Trägersubstrats **1360** und/oder die Clearences (**2340**, **2350**) des Wellenleiters das optisch transparente Trägersubstrat **1360** verlassen kann. Bevorzugt ist der elektrisch leitender Rückseitenkontakt **1370** hierzu spiegelnd ausgeführt, sodass er das Licht innerhalb des optisch transparenten Trägersubstrats **1360** wieder in das optisch transparente Trägersubstrat **1360** zurückspiegelt. Dies erhöht die Intensität der Pumpstrahlung in den Clearances (**2340**, **2350**) des Wellenleiters. Als Wellenleiter kommen beispielsweise Schlitzleitungen **1880**, Tri-Plate-Leitungen **2380**, und differentielle Tri-Plate-Leitungen **6980** in Frage, da diese typischerweise über eine elektrisch leitende linke Signalmassefläche **1310** und eine elektrisch leitende rechte Signalmassefläche **1320** verfügen, die den Austritt des Lichts, insbesondere der Pumpstrahlung **13** (**13**) aus dem optisch transparenten Trägersubstrat **1360** verhindern.

Im Falle einer Schlitzleitung **1880** bildet der Schlitz **1840** der Schlitzleitung **1880** die Clearance, durch die die Pumpstrahlung 13 (**13**) aus dem für die Pumpstrahlung **13** (**13**) optisch transparenten Trägersubstrat **1360** austreten kann und in die Sensorschicht **5** als Sensorelement **SE** eintreten kann. Typischerweise emittieren die paramagnetischen Zentren, hier typischerweise NV-Zentren in Diamanten innerhalb der bestrahlten Segmente der Sensorschicht **5** im Schlitz **1840** der Schlitzleitung **1880**, Fluoreszenzstrahlung **14** in Folge der Bestrahlung mit der Pumpstrahlung **13** (**13**).

Im Falle einer Tri-Plate-Leitung **2380** bilden die elektrisch im Wesentlichen nicht-leitende linke Isolationslücke **2340** und die elektrisch im Wesentlichen nicht-leitende rechte Isolationslücke **2350** der Tri-Plate-Leitung **2380** die beiden Clearances, durch die die Pumpstrahlung **13** (**13**) aus dem für die Pumpstrahlung **13** (**13**) optisch transparenten Trägersubstrat **1360** austreten kann und in die beiden Teilsegmente der Sensorschicht **5** als Sensorelemente **SE** eintreten kann. Typischerweise emittieren die paramagnetischen Zentren, hier typischerweise NV-Zentren in Diamanten innerhalb der bestrahlten Segmente der Sensorschicht **5** in der elektrisch im Wesentlichen nicht-leitenden linken Isolationslücke **2340** und in der elektrisch im Wesentlichen nicht-leitenden rechten Isolationslücke **2350** der Tri-Plate-Leitung **2380**, Fluoreszenzstrahlung **14** in Folge der Bestrahlung mit der Pumpstrahlung **13** (**13**).

Im Falle einer differentiellen Tri-Plate-Leitung **6980** bilden die elektrisch im Wesentlichen nicht-leitende linke Isolationslücke **2340** und die elektrisch im Wesentlichen nicht-leitende rechte Isolationslücke **2350** der Tri-Plate-Leitung **2380** sowie die elektrisch isolierende Lücke **6840** zwischen dem linken Signalleiter **6810** und dem rechten Signalleiter **6820** des differentiellen Signalleiters **6830** der Tri-Plate-Leitung **2380** die drei Clearances, durch die die Pumpstrahlung **13** (**13**) aus dem für die Pumpstrahlung **13** (**13**) optisch transparenten Trägersubstrat **1360** austreten kann und in die drei Teilsegmente der Sensorschicht **5** als Sensorelemente SE in diesen drei Clearances eintreten kann. Typischerweise emittieren die paramagnetischen Zentren, hier typischerweise NV-Zentren in Diamanten innerhalb der bestrahlten Segmente der Sensorschicht **5** in der elektrisch im Wesentlichen nicht-leitenden linken Isolationslücke **2340** und in der elektrisch im Wesentlichen nicht-leitenden rechten Isolationslücke **2350** der Tri-Plate-Leitung **2380** sowie in der elektrisch isolierende Lücke **6840** zwischen dem linken Signalleiter **6810** und dem rechten Signalleiter **6820** des differentiellen Signalleiters **6830** der Tri-Plate-Leitung **2380**, Fluoreszenzstrahlung **14** in Folge der Bestrahlung mit der Pumpstrahlung **13**.

Vorzugsweise emittieren im normalen Betrieb LEDs als Pumpstrahlungsquellen **44** die Pumpstrahlung **13** und strahlen diese über Kanten des optisch transparenten Trägersubstrats **1360** in das optisch transparente Trägersubstrat **1360** ein. Das optisch transparente Trägersubstrat **1360** verteilt die Pumpstrahlung **13** innerhalb des optisch transparenten Trägersubstrats **1360**.

Die Pumpstrahlung**13** tritt durch die Clearances (**2349**, **2350**) des Wellenleiters (**2380**) aus dem optisch transparenten Trägersubstrat **1360** aus und bestrahlt die Sensorelemente **SE** der Sensorschicht **5**.

Der Schaltungsträger (PCB) **43** für die LEDs **44** ist vorzugsweise in eine Magnetfeldkamera, wie sie beispielsweise dieses Dokument beschreibt eingebaut. Auf die übrigen Abschnitte dieses Dokuments wird hier ausdrücklich Bezug genommen.

### Figur 95

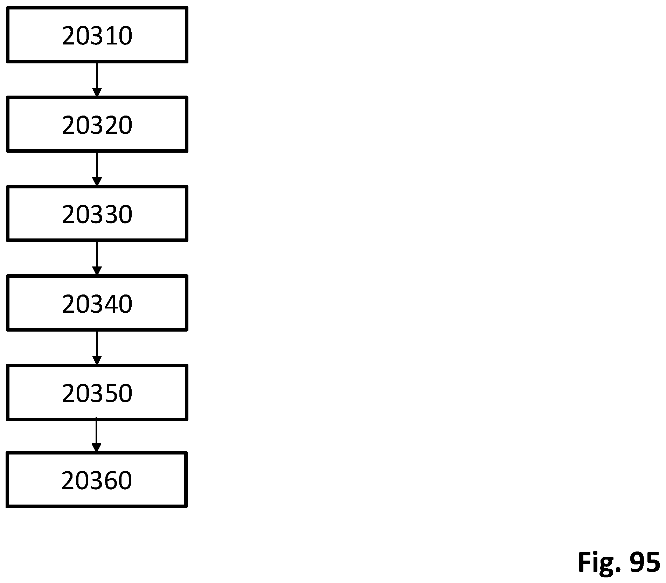

Figur 95 zeigt den beispielhaften Ablauf der Herstellung einer Vorrichtung entsprechend Figur 94.

Das vorgeschlagene Verfahren umfasst vorzugsweise folgende Schritte:
1. Bereitstellen **20310** eines optisch transparenten Trägersubstrat **1360,** wobei das optisch transparente Trägersubstrat **1360** zumindest eine optische transparente Kante aufweist und wobei das optisch transparente Trägersubstrat **1360** mit einem Wellenleiter mit zumindest einer Clearance, beispielsweise einer Schlitzleitung und/oder einer Tri-Plate-Leitung oder einer differenziellen Tri-Plate-Leitung, abgedeckt ist, sodass Licht im Wesentlichen nur durch die Clearance des Welleneiters auf der Oberfläche des optisch transparenten Trägersubstrats **1360** aus dem optisch transparenten Trägersubstrat **1360** austreten kann.
2. Bereitstellen **20320** einer flüssigen kolloidalen Mischung **KL** mit einem flüssigen und mittels elektromagnetischer Strahlung, der Aushärtestrahlung **4910**, einer Aushärtewellenlänge λ_{H} härtbaren Trägermaterial **TM,** wobei in das Trägermaterial **TM** der kolloidalen Mischung **KL** eine Vielzahl von Kristallen und/oder Diamant-Nano-Kristallen **ND,** vorzugsweise Nanodiamanten, eingebettet sind und wobei einer oder mehrere oder alle Kristalle und/oder Diamant-Nano-Kristalle **ND** NV-Zentren und/oder andere paramagnetischen Zentren aufweisen und wobei die NV-Zentren der Kristalle und/oder Diamant-Nano-Kristalle **ND** der kolloidalen Mischung **KL** und/oder die anderen paramagnetischen Zentren der Kristalle und/oder Diamant-Nano-Kristalle **ND** der kolloidalen Mischung KL bei Bestrahlung mit Pumpstrahlung **LB** zumindest eine Fluoreszenzstrahlung **FL** emittieren;
3. Beschichten **20330** der er Oberfläche des optisch transparenten Trägersubstrats **1360** und des Wellenleiters auf der Oberfläche des optisch transparenten Trägersubstrats **1360** zumindest auf eine Benetzungslänge L_{B} mit der kolloidalen Mischung **KL** aus dem Trägermaterial **TM** und den Kristallen und/oder Diamant-Nano-Kristallen **ND** mit NV-Zentren und/oder paramagnetischen Zentren, wobei die kolloidale Mischung **KL** somit eine Vielzahl eingebetteter Kristalle und/oder Diamant-Nano-Kristalle **ND** mit NV-Zentren und/oder paramagnetischen Zentren aufweist;
4. ggf. (nicht eingezeichnet) Anhärten der Beschichtung des optisch transparenten Trägersubstrats **1360** aus der kolloidalen Mischung **KL** insbesondere mittels einer Temperaturbehandlung;
5. Einspeisen **20340** elektromagnetischer Aushärtestrahlung **4910** mit der Aushärtewellenlänge λ_{H} über die mindestens eine Kante des optisch transparenten Trägersubstrats **1360** in das optisch transparente Trägersubstrat **1360** ,
6. Austreten **20350** der Aushärtestrahlung **4910** im Bereich zumindest einer Clearance **(1840, 2340, 2350, 6840)** des Wellenleiters **(1880, 2380, 6980)** auf der Oberfläche des optisch transparenten Trägersubstrats **1360** aus dem des optisch transparenten Trägersubstrats **1360** und einstrahlen der Aushärtestrahlung **4910** in das Trägermaterial **TM** der kolloidalen Mischung KL, wobei die Aushärtewellenlänge λ_{H} der Aushärtestrahlung **4910** so gewählt ist, dass das Trägermaterial **TM** der kolloidalen Mischung **KL** im Bereich dieser Clearance **(1840, 2340, 2350, 6840)** des Wellenleiters **(1880, 2380, 6980)** auf der Oberfläche des optisch transparenten Trägersubstrats **1360** aushärtet und sich die kolloidale Mischung **KL** im bestrahlten Bereich in einen Festkörper wandelt;
7. Entfernen **20360** des nicht ausgehärteten Trägermaterials **TM** der kolloidalen Mischung KL insbesondere mittels eines Lösungsmittels **LM,** wobei der verbleibende Film des Trägermaterials TM der kolloidalen Mischung **KL** und der kolloidalen Mischung **KL** im Bereich dieser Clearance **(1840, 2340, 2350, 6840)** des Wellenleiters **(1880, 2380, 6980)** auf der Oberfläche des optisch transparenten Trägersubstrats **1360** ein Sensorelement SE und/oder eine Sensorschicht **16205** bildet;
8. ggf. (nicht eingezeichnet) finales Aushärten des Trägermaterials **TM** der kolloidalen Mischung KL des verbliebenen Sensorelements SE und/oder eine Sensorschicht **16205** in den Clearances **(1840, 2340, 2350, 6840)** des Wellenleiters **(1880, 2380, 6980)** im Bereich einer Clearance des Wellenleiters (**1880**, **2380, 6980)** auf der Oberfläche des optisch transparenten Trägersubstrats **1360** insbesondere mittels einer Temperaturbehandlung. Die Erforderlichkeit dieses Post-Bake-Schrittes bestimmt sich aus der Art des verwendeten Trägermaterials **TM** der kolloidalen Mischung **KL** und des Lösungsmittels **LM** in der kolloidalen Mischung **KL.**

### Figur 96

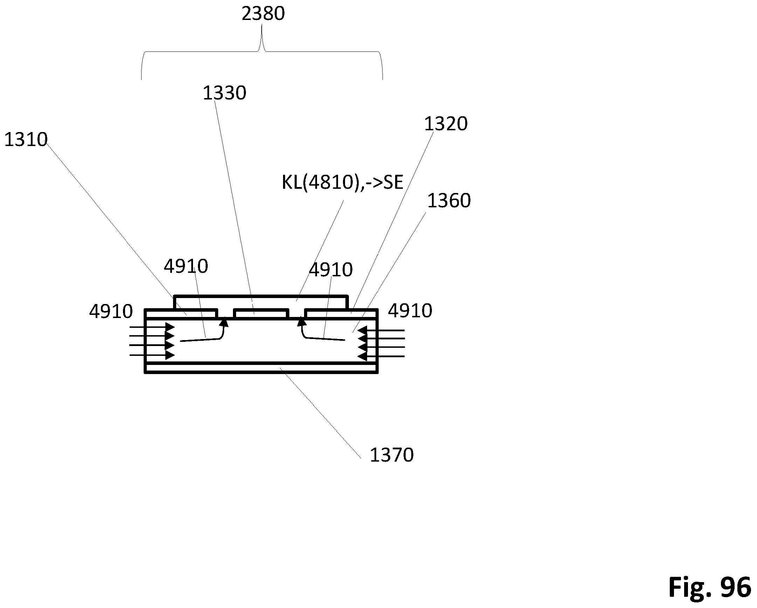

Figur 96 zeigt schematisch die Durchführung der Aushärtung des Trägermaterials **TM** der kolloidalen Mischung **KL** entsprechend des Verfahrens nach Figur 96 in Schritt **20350.** zu diesem Zeitpunkt sind die Pumpstrahlungsquellen **44** und der Schaltungsträger (PCB) **43** für die LEDs **44** und deren Energieversorgung **45** vorzugsweise noch nicht mit dem optisch transparenten Trägersubstrat **1360** verbunden.

Aushärtestrahlungsquellen (nicht eingezeichnet) emittieren Aushärtestrahlung **4910** mit einer Aushärtewellenlänge λ_{H}. Ein optisches Aushärtesystem (nicht eingezeichnet) transportiert die Aushärtestrahlung **4910** zu den optisch transparenten Kanten des optisch transparenten Trägersubstrats **1360.** Dieses optische Aushärtesystem umfasst vorzugsweise ein oder mehrere optische Funktionselemente wie Spiegel, Linsen, Blenden, Prismen etc. um die Aushärtestrahlung **4910** zu führen, in der Intensität und im Spektrum geeignet einzustellen. Vorzugsweise verfügt das System aus Aushärtestrahlungsquellen und optischem Aushärtesystem über eine (nicht eingezeichnete) Aushärtesteuerung mit einem Zeitgeber und/oder einem Rechnersystem mit einem Speicher, so dass das Rechnersystem der Aushärtesteuerung und/oder die Aushärtesteuerung die Dauer der Bestrahlung durch
1. Steuerung der Aushärtestrahlungsquellen z.B. durch Anschalten / Ausschalten der Aushärtestrahlungsquellen und/oder
2. mittels Shuttern innerhalb des optische Aushärtesystems z.B. durch Unterbrechen / Öffnen des optischen Pfads zwischen Aushärtestrahlungsquellen und dem optisch transparenten Trägersubstrat **1360**
steuern kann. Das Rechnersystem innerhalb der Aushärtesteuerungsvorrichtung kann typischerweise mittels eines computerimplementierten Aushärtesteuerungsprogramms innerhalb des Speichers des Rechnersystems der Aushärtesteuerung den Aushärtevorgang steuern. Der Programmcode des computerimplementierten Aushärtesteuerungsprogramms befindet sich dabei vorzugsweise in dem Speicher des Rechnersystems der Aushärtesteuerungsvorrichtung. Das Rechnersystem innerhalb der Aushärtesteuerungsvorrichtung führt diesen Programmcode typischerweise bei der Bestrahlung des optisch transparenten Trägersubstrats **1360** aus. Der Speicher kann ein ggf. auch austauschbares Speichermedium umfassen, das diesen Programmcode und/oder Parameter für die Durchführung der Bestrahlung umfasst. Bevorzugt temperiert eine 8nicht eingezeichnete Temperiervorrichtung das optisch transparenten Trägersubstrat **1360** während der Bestrahlung mit Aushärtestrahlung **4910.** Bei der Temperiervorrichtung kann es sich auch um einen beheizbaren und/oder klimatisierbaren Raum handeln, in dem die Bestrahlung mit Aushärtestrahlung **4910** stattfindet. Die Aushärtesteuerungsvorrichtung kann ggf. diese Temperiervorrichtung in Abhängigkeit von dem temperaturmesswert eines Temperatursensors steuern.

Das optische Aushärtesystem strahlt die Aushärtestrahlung **4910** über die Kanten des optisch transparenten Trägersubstrats **1360** in das optisch transparente Trägersubstrat **1360** ein.

Das optisch transparente Trägersubstrat **1360** ist vorzugsweise für elektromagnetische Strahlung mit der Aushärtewellenlänge λ_{H} der Aushärtestrahlung **4910** für den vorgesehenen Zweck ausreichend transparent, sodass die Aushärtestrahlung 4910 das kolloidale Material **KL** in den Clearances **(1840, 2340, 2350, 6840)** des Wellenleiters (**1880, 2380, 6980**) auf der Oberfläche des optisch transparenten Trägersubstrats **1360** in für eine Aushärtung des Trägermaterials **TM** der kolloidalen Mischung **KL** ausreichenden Intensität erreicht. Dies bedeutet, dass das optisch transparente Trägersubstrat **1360** vorzugsweise für elektromagnetische Strahlung mit der Aushärtewellenlänge λ_{H} der Aushärtestrahlung **4910** im Wesentlichen transparent ist.

Das optisch transparente Trägersubstrat **1360** ist vorzugsweise für elektromagnetische Strahlung mit der Pumpstrahlungswellenlänge λₚₘₚ im Wesentlichen transparent. Dies bedeutet, dass die Intensität der Pumpstrahlung **13** (siehe Figur 94), die die paramagnetischen Zentren der Kristalle und/oder Diamant-Nano-Kristalle **ND** und/oder die NV-Zentren der Diamant-Nano-Kristalle **ND** nach Durchgang durch das Material des optisch transparente Trägersubstrats **1360** erreicht, ausreichend ist, um dies zur Emission von Fluoreszenzstrahlung **14** (siehe Figur 94) zu veranlassen.

Die Bestrahlung des kolloidalen Materials **KL** in den Clearances **(1840, 2340, 2350, 6840)** des Wellenleiters (**1880, 2380, 6980**) auf der Oberfläche des optisch transparenten Trägersubstrats **1360** führt zum Aushärten des Trägermaterials **TM** der kolloidalen Mischung KL in den Clearances (**1840, 2340, 2350, 6840**) des Wellenleiters (**1880, 2380, 6980**) auf der Oberfläche des optisch transparenten Trägersubstrats **1360.** Dies bildet verfestigte Sensorelemente **SE** innerhalb des kolloidalen Materials **KL** in den der Clearances (**1840, 2340, 2350, 6840**) des Wellenleiters (**1880, 2380, 6980**) auf der Oberfläche des optisch transparenten Trägersubstrats **1360** aus. Nach dem Entfernen **20360** des überschüssigen kolloidalen Materials KL umfasst das des optisch transparente Trägersubstrat **1360** in den Clearances **(1840, 2340, 2350, 6840)** des Wellenleiters (**1880, 2380, 6980**) auf der Oberfläche des optisch transparenten Trägersubstrats **1360** die notwendigen Sensorelemente **SE** um wie in der Figur 202 schematisch skizziert eingesetzt zu werden. Dieser Einsatz kann vorzugsweise in einer der zuvor beschriebenen Magnetfeldkameras erfolgen.

### Figur 97a

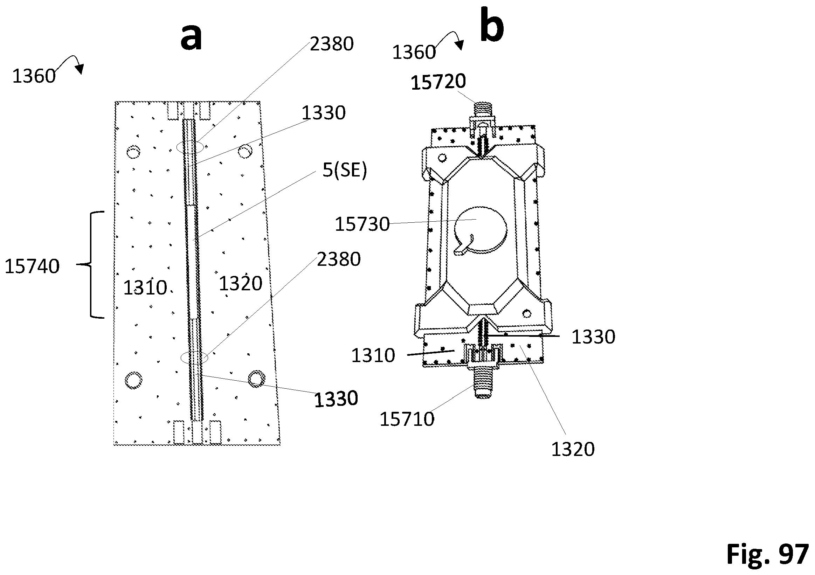

Figur 97a zeigt schematisch ein beispielhaftes Trägersubstrat **1360** mit einem beispielhaften Tri-Plate-Wellenleiter **2389** als Beispiel für einen Wellenleiter (**1380, 1880, 2380, 6880, 6990**). Der beispielhafte Tri-Plate-Wellenleiter **2380** ist auf einer Strecke **15740** des Welleneiters **(1380, 1880, 2380, 6880, 6990)** mit dem Sensorelement **SE** bedeckt. Das vorzugsweise nach einem der hier beschriebenen Verfahren hergestellte und mittels Aushärtestrahlung **4910** ausgehärtete Sensorelement **SE** umfasst beispielhaft wieder ein vorzugsweise strahlungsgehärtetes und optisch transparentes Trägermaterial **TM,** das bevorzugt wieder Kristalle und/oder Diamanten **DM** mit paramagnetischen Zentren und/oder NV-Zentren **NVZ.** In dem Bereich der Strecke **15740** des Welleneiters **(1380, 1880, 2380, 6880, 6990),** die mit dem Sensorelement **SE** bedeckt ist, können die paramagnetischen Zentren und/oder NV-Zentren **NVZ** der Kristalle und/oder Diamanten **DM,** die in dem Trägermaterial **TM** des Sensorelements **SE** eingebettet sind, mit einem Mikrowellensignal **µW** und/oder einem HF-Signal **RW,** die beispielsweise über eine erster Mikrowellen- und/oder HF-Verbinder **15710** für den Anschluss der Wellenleitung **(1380, 1880, 2380, 6880, 6990)** beispielsweise in den Signalleiter **1330** der beispielhaften Triplate-Leitung **2380** eingespeist werden, wechselwirken. Diese Wechselwirkung verursacht einen frequenzabhängigen vom Wellenwiderstand der übrigen Wellenleitung (**1380, 1880, 2380, 6880, 6990**), hier der Tri-Plate-Leitung **2380,** abweichenden Wellenwiderstand.

Ein erster Teil des in die Strecke **15740** des Welleneiters (**1380, 1880, 2380, 6880, 6990**), die mit dem Sensorelement SE bedeckt ist, eingestrahlten Mikrowellensignals **µW** wird als reflektiertes Mikrowellensignal **µWR** infolge der Wellenwiderstandssprünge an den Übergangen vom ungestörten Wellenleiter (**1380, 1880, 2380, 6880, 6990**), zur Strecke **15740** und wieder zurück wieder als reflektierte Mikrowellensignal **µWR** in Richtung des ersten Mikrowellen- und/oder HF-Verbinders **15710** zurückreflektiert und kann dort mittels eines Wellenkopplers **µWC** aus der Übertragungsleitung ausgekoppelt werden und einem Reflexions-Mikrowellen-Analysator **µWAR** zugeführt werden, der beispielsweise relevante Parameter wie Amplitude, Phase, Spektrum etc. bestimmen kann.

Ein zweiter Teil des in die Strecke **15740** des Welleneiters **(1380, 1880, 2380, 6880, 6990),** die mit dem Sensorelement SE bedeckt ist, eingestrahlten Mikrowellensignals **µW** wird als transmittiertes Mikrowellensignal **µWT** infolge der Wellenwiderstandssprünge an den Übergangen vom ungestörten Wellenleiter (**1380, 1880, 2380, 6880, 6990**), zur Strecke **15740** und wieder zurück als transmittiertes Mikrowellensignal **µWT** in Richtung des zweiten Mikrowellen- und/oder HF-Verbinders **15720** transmittiert und kann dort einem Transmissions-Mikrowellen-Analysator **µWAT** zugeführt werden, der beispielsweise relevante Parameter wie Amplitude, Phase, Spektrum etc. bestimmen kann.

Bei Kenntnis der relevanten Parameter des eingestrahlten Mikrowellensignals **µW** und des reflektierten Mikrowellensignals **µWR** und des transmittierten Mikrowellensignals **µWT** kann beispielsweise eine Steuervorrichtung **CTR,** die diese Daten von der Mikrowellenquelle **µWG** und dem Reflexions-Mikrowellen-Analysator **µWAR** und dem Transmissions-Mikrowellen-Analysator **µWAT** über den Datenbus **DB** erhält auf einen dritten absorbierten Anteil eines absorbierten Mikrowellensignals **µWA** des Mikrowellensignals **µW** schließen. Das Trägermaterial **TM** des Sensorelements **SE** und/oder die paramagnetischen Zentren und/oder die den NV-Zentren **NVZ** der Kristalle und/oder Diamanten **DM,** die in dem Trägermaterial **TM** des Sensorelements **SE** eingebettet sind, haben dann typischerweise dieses absorbierte Mikrowellensignal **µWA** beeinflusst. Daher hängt das absorbierte Mikrowellensignal **µWA** typischerweise von den Quantenzuständen der paramagnetischen Zentren und/oder der NV-Zentren **NVZ** der Kristalle und/oder Diamanten **DM,** die in dem Trägermaterial **TM** des Sensorelements **SE** eingebettet sind, ab. Daher ist es möglich, dass das das absorbierte Mikrowellensignal **µWA** von der Intensität einer Pumpstrahlung **LB,** die die paramagnetischen Zentren und/oder der NV-Zentren **NVZ** der Kristalle und/oder Diamanten **DM** mit elektromagnetischer Strahlung einer Pumpstrahlungswellenlänge λₚₘₚ bestrahlt, und dann zusätzlich von physikalischen Parameter physikalischer Größen, wie beispielsweise magnetischer Flussdichten, die die paramagnetischen Zentren und/oder der NV-Zentren **NVZ** der Kristalle und/oder Diamanten **DM** beeinflusst, abhängt.

Bei Kenntnis der relevanten Parameter des eingestrahlten HF-Signals **RW** und des reflektierten HF-Signals **RWR** und des transmittierten HF-Signals **RWT** kann beispielsweise eine Steuervorrichtung **CTR,** die diese Daten von der HF-Quelle **RFG** und dem Reflexions-HF-Signal-Analysator **RWAR** und dem Transmissions-HF-Signal-Analysator **RWAT** über den Datenbus **DB** erhält auf einen dritten absorbierten Anteil eines absorbierten HF-Signals **RWA** des HF-Signals **RW** schließen. Das Trägermaterial **TM** des Sensorelements **SE** und/oder die paramagnetischen Zentren und/oder die den NV-Zentren **NVZ** der Kristalle und/oder Diamanten **DM,** die in dem Trägermaterial **TM** des Sensorelements **SE** eingebettet sind, haben dann typischerweise dieses absorbierte HF-Signal **RWA** beeinflusst. Daher hängt das absorbierte HF-Signal **RWA** typischerweise von den Quantenzuständen der paramagnetischen Zentren und/oder der NV-Zentren **NVZ** der Kristalle und/oder Diamanten **DM,** die in dem Trägermaterial **TM** des Sensorelements **SE** eingebettet sind, ab. Daher ist es möglich, dass das das absorbierte HF-Signal **RWA** von der Intensität einer Pumpstrahlung **LB,** die die paramagnetischen Zentren und/oder der NV-Zentren **NVZ** der Kristalle und/oder Diamanten **DM** mit elektromagnetischer Strahlung einer Pumpstrahlungswellenlänge λₚₘₚ bestrahlt, und dann zusätzlich von physikalischen Parameter physikalischer Größen, wie beispielsweise magnetischer Flussdichten, die die paramagnetischen Zentren und/oder der NV-Zentren **NVZ** der Kristalle und/oder Diamanten **DM** beeinflusst, abhängt.

### Figur 97b

Figur 97b zeigt schematisch ein beispielhaftes Trägersubstrat **1360** mit einem beispielhaften Tri-Plate-Wellenleiter **2389** als Beispiel für einen Wellenleiter **(1380, 1880, 2380, 6880, 6990),** wobei XXXX die Strecke **15740** des Welleneiters **(1380, 1880, 2380, 6880, 6990),** die mit dem Sensorelement **SE** bedeckt ist, abdeckt und so vor Beschädigung schützt. Die Abdeckung **15730** des Trägersubstrats **1360** mit dem Wellenleiter **(1380, 1880, 2380, 6880, 6990)** und dem Sensorelement SE zum mechanischen und chemischen Schutz des Sensorelements **SE** und ggf. zum EMV-Schutz beeinflusst vorzugsweise den Wert und/oder Betrag der zu vermessenden physikalischen Größe nicht. Die zu vermessende physikalische Größe kann beispielsweise eine magnetische Flussdichte B am Ort des Sensorelements **SE** sein.

### Figur 98

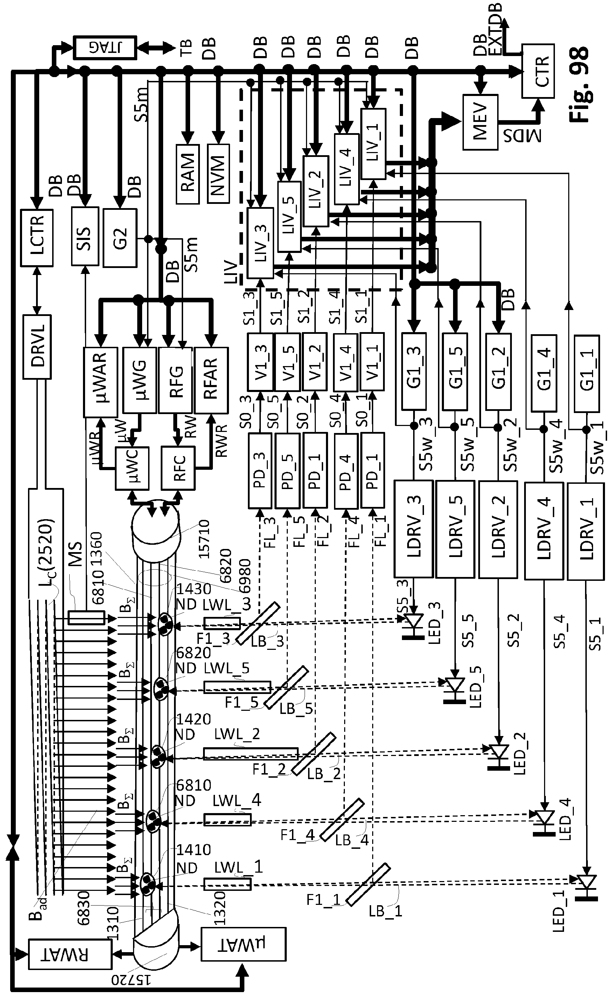

Figur 98 entspricht weitestgehend der Figur 78, wobei zusätzlich das Bezugszeichen des ersten Mikrowellen-und/oder HF-Verbinders **15710** für den Anschluss der Wellenleitung **(1380, 1880, 2380, 6880, 6990)** an die Mikrowellensignalquelle **µWG** und die HF-Signalquelle **RFG** und an einen Reflexions-Mikrowellensignalanalysator (**µWAR**) und an einen Reflexions-HF-Signalanalysator (**RWAR**) mit dem Bezugszeichen **15710** eingezeichnet ist. In dem Beispiel der Figur 98 ist als beispielhafte Wellenleitung (**1380, 1880, 2380, 6880, 6990**) eine differenzielle Tri-Plate-Leitung **6980** beispielhaft und stellvertretend für andere Wellenleitungen (**1380, 1880, 2380, 6880, 6990**) eingezeichnet. Bevorzugt ist in dem Fall der erste Mikrowellen- und/oder HF-Verbinder **15710** ein Triax-Verbinder, der den gleichzeitigen, aber getrennten Anschluss eines Mikrowellensignals µW und eines Hf-Signals RW an verschiedene Signalleiter 6910, 6920 der beispielhaften differenzielle Tri-Plate-Leitung **6980** ermöglicht.

Des Weiteren ist zusätzlich der zweite Mikrowellen- und/oder HF-Verbinder **15720** für den Anschluss der Wellenleitung **(1380, 1880, 2380, 6880, 6990)** an an einen Reflexions-Mikrowellensignalanalysator **(µWAR)** und an einen Transmissions-HF-Signalanalysator (**RWAT**) eingezeichnet. In dem Beispiel der Figur 98 ist als beispielhafte Wellenleitung **(1380, 1880, 2380, 6880, 6990)** eine differenzielle Tri-Plate-Leitung **6980** beispielhaft und stellvertretend für andere Wellenleitungen (**1380, 1880, 2380, 6880, 6990**) eingezeichnet. Bevorzugt ist in dem Fall auch der zweite Mikrowellen- und/oder HF-Verbinder **15720** ein Triax-Verbinder, der die gleichzeitige, aber getrennte Entnahme des transmittierten Mikrowellensignals **µWT** und des transmittierten Hf-Signals **RWT** an die betreffenden verschiedenen Signalleiter **6910, 6920** der beispielhaften differenzielle Tri-Plate-Leitung **6980** ermöglicht.

Ein erster Teil des in die Strecke **15740** der beispielhaften differenziellen Tri-Plate-Leitung **6980,** die mit dem Sensorelement SE bedeckt ist, eingestrahlten Mikrowellensignals **µW** wird als reflektiertes Mikrowellensignal **µWR** infolge der Wellenwiderstandssprünge an den Übergangen von der ungestörten beispielhaften differenziellen Tri-Plate-Leitung **6980** zur Strecke **15740** und wieder zurück wieder als reflektiertes Mikrowellensignal **µWR** in Richtung des ersten Mikrowellen- und/oder HF-Verbinders **15710** zurückreflektiert und wird dort mittels eines Wellenkopplers **µWC** aus der Übertragungsleitung ausgekoppelt und dem Reflexions-Mikrowellen-Analysator **µWAR** zugeführt, der beispielsweise relevante Parameter wie Amplitude, Phase, Spektrum etc. bestimmen kann. Vorzugsweise übermittelt der Reflexions-Mikrowellen-Analysator **µWAR** die erfassten Parameter an die Steuervorrichtung **CTR** über den Datenbus **DB.**

Ein zweiter Teil des in die Strecke **15740** der beispielhaften differenziellen Tri-Plate-Leitung **6980,** die mit dem Sensorelement **SE** bedeckt ist, eingestrahlten Mikrowellensignals **µW** wird als transmittiertes Mikrowellensignal **µWT** infolge der Wellenwiderstandssprünge an den Übergangen vom ungestörten der beispielhaften differenziellen Tri-Plate-Leitung **6980** zur Strecke **15740** und wieder zurück als transmittiertes Mikrowellensignal **µWT** in Richtung des zweiten Mikrowellen- und/oder HF-Verbinders **15720** transmittiert und wird dort einem Transmissions-Mikrowellen-Analysator **µWAT** zugeführt, der beispielsweise relevante Parameter wie Amplitude, Phase, Spektrum etc. bestimmen kann. Vorzugsweise übermittelt der Transmissions-Mikrowellen-Analysator **µWAT** die erfassten Parameter an die Steuervorrichtung **CTR** über den Datenbus **DB.**

Ein erster Teil des in die Strecke **15740** der beispielhaften differenziellen Tri-Plate-Leitung **6980,** die mit dem Sensorelement **SE** bedeckt ist, eingestrahlten HF-Signals **RW** wird als reflektiertes HF-Signal **RWR** infolge der Wellenwiderstandssprünge an den Übergangen von der ungestörten beispielhaften differenziellen Tri-Plate-Leitung **6980** zur Strecke **15740** und wieder zurück wieder als reflektiertes HF-Signal **RWR** in Richtung des ersten Mikrowellen- und/oder HF-Verbinders **15710** zurückreflektiert und wird dort mittels eines HF-Wellenkopplers **RWC** aus der Übertragungsleitung ausgekoppelt und dem Reflexions-HF-Signal-Analysator **RWAR** zugeführt, der beispielsweise relevante Parameter wie Amplitude, Phase, Spektrum etc. bestimmen kann. Vorzugsweise übermittelt der Reflexions-HF-Signal-Analysator **RWAR** die erfassten Parameter an die Steuervorrichtung **CTR** über den Datenbus **DB.**

Ein zweiter Teil des in die Strecke **15740** der beispielhaften differenziellen Tri-Plate-Leitung **6980,** die mit dem Sensorelement **SE** bedeckt ist, eingestrahlten HF-Signals **RW** wird als transmittiertes HF-Signal RWT infolge der Wellenwiderstandssprünge an den Übergangen vom ungestörten der beispielhaften differenziellen Tri-Plate-Leitung **6980** zur Strecke **15740** und wieder zurück als transmittiertes HF-Signal **RWT** in Richtung des zweiten Mikrowellen- und/oder HF-Verbinders **15720** transmittiert und wird dort einem Transmissions-HF-Signal-Analysator **RWAT** zugeführt, der beispielsweise relevante Parameter wie Amplitude, Phase, Spektrum etc. bestimmen kann. Vorzugsweise übermittelt der Transmissions-HF-Signal-Analysator **RWAT** die erfassten Parameter an die Steuervorrichtung **CTR** über den Datenbus **DB.**

Bei Kenntnis der relevanten Parameter des eingestrahlten Mikrowellensignals **µW** und des reflektierten Mikrowellensignals **µWR** und des transmittierten Mikrowellensignals **µWT** kann beispielsweise die Steuervorrichtung **CTR,** die diese Daten von der Mikrowellenquelle **µWG** und dem Reflexions-Mikrowellen-Analysator **µWAR** und dem Transmissions-Mikrowellen-Analysator **µWAT** über den Datenbus **DB** erhält, auf den dritten absorbierten Anteil eines absorbierten Mikrowellensignals **µWA** des Mikrowellensignals **µW** schließen. Das Trägermaterial **TM** des Sensorelements **SE** und/oder die paramagnetischen Zentren und/oder die den NV-Zentren **NVZ** der Kristalle und/oder Diamanten **DM,** die in dem Trägermaterial **TM** des Sensorelements **SE** eingebettet sind, haben dann typischerweise dieses absorbierte Mikrowellensignal **µWA** beeinflusst. Daher hängt das absorbierte Mikrowellensignal **µWA** typischerweise von den Quantenzuständen der paramagnetischen Zentren und/oder der NV-Zentren **NVZ** der Kristalle und/oder Diamanten **DM,** die in dem Trägermaterial **TM** des Sensorelements **SE** eingebettet sind, ab. Daher ist es möglich, dass das das absorbierte Mikrowellensignal **µWA** von der Intensität einer Pumpstrahlung **LB,** die die paramagnetischen Zentren und/oder der NV-Zentren **NVZ** der Kristalle und/oder Diamanten **DM** mit elektromagnetischer Strahlung einer Pumpstrahlungswellenlänge λₚₘₚ bestrahlt, und dann zusätzlich von physikalischen Parameter physikalischer Größen, wie beispielsweise magnetischer Flussdichten, die die paramagnetischen Zentren und/oder der NV-Zentren **NVZ** der Kristalle und/oder Diamanten **DM** beeinflusst, abhängt.

Bei Kenntnis der relevanten Parameter des eingestrahlten HF-Signals **RW** und des reflektierten HF-Signals **RWR** und des transmittierten HF-Signals **RWT** kann beispielsweise eine Steuervorrichtung **CTR,** die diese Daten von der HF-Quelle **RFG** und dem Reflexions-HF-Signal-Analysator **RWAR** und dem Transmissions-HF-Signal-Analysator **RWAT** über den Datenbus **DB** erhält auf einen dritten absorbierten Anteil eines absorbierten HF-Signals **RWA** des HF-Signals **RW** schließen. Das Trägermaterial **TM** des Sensorelements **SE** und/oder die paramagnetischen Zentren und/oder die den NV-Zentren **NVZ** der Kristalle und/oder Diamanten **DM,** die in dem Trägermaterial **TM** des Sensorelements **SE** eingebettet sind, haben dann typischerweise dieses absorbierte HF-Signal **RWA** beeinflusst. Daher hängt das absorbierte HF-Signal **RWA** typischerweise von den Quantenzuständen der paramagnetischen Zentren und/oder der NV-Zentren **NVZ** der Kristalle und/oder Diamanten **DM,** die in dem Trägermaterial **TM** des Sensorelements **SE** eingebettet sind, ab. Daher ist es möglich, dass das das absorbierte HF-Signal **RWA** von der Intensität einer Pumpstrahlung **LB,** die die paramagnetischen Zentren und/oder der NV-Zentren **NVZ** der Kristalle und/oder Diamanten **DM** mit elektromagnetischer Strahlung einer Pumpstrahlungswellenlänge λₚₘₚ bestrahlt, und dann zusätzlich von physikalischen Parameter physikalischer Größen, wie beispielsweise magnetischer Flussdichten, die die paramagnetischen Zentren und/oder der NV-Zentren **NVZ** der Kristalle und/oder Diamanten **DM** beeinflusst, abhängt. Mittels computerimplementierter Verfahren können die Mustererkennungsvorrichtung **MEV** und/oder die Steuervorrichtung **CTR** unter Nutzung dieser Daten Werte physikalischer Parameter schätzen und/oder ermitteln, die auf diesen und anderen in diesem System ermittelten Daten beruhen. Bevorzugt ist der Programmcode für solche computerimplementierten Verfahren, die insbesondere Verfahren zur Mustererkennung umfassen können, in Speichern (**RAM, NVM**) der Vorrichtung abgelegt. Das hier Vorgelegte Dokument verweist hier auf die an anderer Stelle in diesem Dokument erwähnten Verfahren der Mustererkennung und künstlichen Intelligenz. Insbesondere die Emulation eines computerimplementieren neuronalen Netzwerkmodells und/oder die Anwendung von computerimplementierten Deep-Learning Verfahren und computerimplementieren Machine-Learning-Verfahren durch die Mustererkennungsvorrichtung **MEV** und/oder die Steuervorrichtung **CTR** können solche computerimplementierte Verfahren umfassen. Vorzugsweise verwendet die Steuervorrichtung **CTR** zumindest einen Teil der in der Vorrichtung erfassten Daten für die Erzeugung eines Merkmalsvektors (Englisch Feature-Vektor), auf den die Steuervorrichtung dann ein computerimplementiertes Mustererkennungsverfahren anwendet.

Die Anwendung der technischen Lehre der Figuren 97 und 98 auf die der übrigen Figuren und zwar insbesondere der Figuren 1, 6, 8, 11 bis 14, 16 bis 20, 27, 29 bis 35, 38 bis 44,47 bis 84, 89, 91, 96, 97 und der Beschreibung ist ausdrücklicher Teil der Offenlegung des hier vorgelegten Dokuments. Einer fachkundigen Person ist es ein Leichtes, die zusätzlichen Komponenten der Figur 98 im Vergleich zur Figur 78 in gleicherweise zusätzlich in die entsprechenden vorbenannten Figuren, insbesondere die besonders relevanten Figuren 1, 6, 17, 49, 69, 70, 71, 73 bis 81 und 98, in analoger Weise bei Bedarf einzufügen und damit zu der hier offenbarten technischen Lehre zu gelangen. Gleiches gilt für Komponenten, die in der entsprechenden Figur fehlen, aber in der Figur 98 vorhanden sind. Insofern sind die hier dargestellten Figuren nur Beispiele zur Erläuterung, deren technischen Lehren miteinander sofern sinnvoll, kombiniert werden können. Einer technisch fachkundigen Person ist die Prüfung der Sinnhaftigkeit dieser Kombinationen möglich.

### Bezugszeichenliste

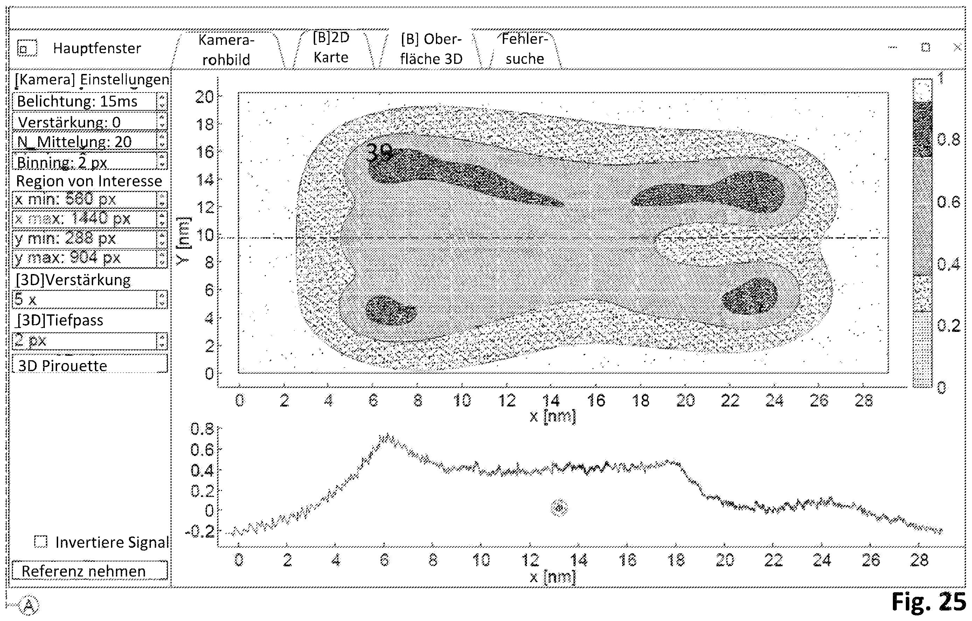

- 1: Lichtsensorarray **1** mit Elektronik (Ansteuerung, etc.). Vorzugsweise umfasst das Lichtsensorarray **1** einen CCD Kamerasensor oder dergleichen, wobei jedes CCD Pixel des CCD Kamerasensors einen Lichtsensor des Lichtsensorarrays im Sinne des hier vorgelegten Dokuments darstellt;
- 2: Lichtquelle **2**. Bei der Lichtquelle **2** kann es sich beispielsweise um einen Laser oder eine LED handeln. Bevorzugt strahlt die Lichtquelle **2** bei Versorgung mit elektrischer Energie Pumpstrahlung **13** (**LB**) der Pumpstrahlungswellenlänge λₚₘₚ ab. Das hier vorgelegte Dokument bezeichnet die Lichtquelle **2** auch als Pumpstrahlungsquelle **PL** mit dem Bezugszeichen **PL;**
- 3: Beleuchtungsoptik;
- 4: optischer Filter (Shortpass);
- 5: Sensorschicht **5**. Figur 25 zeigt einen beispielhaften Aufbau der Sensorschicht **5** für die Bestrahlung durch eine externe Pumplichtquelle **2** als Pumpstrahlungsquelle **PL;**
- 6: optischer Filter (Longpass) **6**. Der optische Filter **6** hat die Funktion des dichroitischen Spiegels / optischer Filters **F1** zur Trennung der Fluoreszenzstrahlung **FL** von der Pumpstrahlung **LB;**
- 7: abbildende Optik **7**;
- 8: Gehäuse **8**. Beispielsweise kann es sich bei dem Gehäuse **8** der Magnetfeldkamera um ein 3D-Druckgehäuse handeln. Das Gehäuse **8** der Magnetfeldkamera kann beispielsweise oberer Gehäuseteil **40** des Gehäuses **8** und einen unteren Gehäuseteil **41** des Gehäuses **8** umfassen;
- 9: Trägermaterial I **9**. Typischerweise umfasst das Trägermaterial I **9** eine Teilvorrichtung des unteren Gehäuseteils **41** des Gehäuses **8** der Magnetfeldkamera und/oder das Material eines Schaltungsträgers (PCB) und/oder ein Halbleiter-Wafer-Teil (Die) und/oder eine mikrointegrierte Halbleiterschaltung und/oder eine mikromechanische Vorrichtung und/oder eine mikroelektromechanische Vorrichtung und/oder eine mikrooptische Vorrichtung und/oder eine mikroelektrooptische Vorrichtung und/oder eine mikrofluidische Vorrichtung etc. und/oder Kombinationen dieser;
- 10: Verspiegelung **10**;
- 11: Schicht **11** mit Kristallen und/oder Nanokristallen **66** mit paramagnetischen Zentren. Bevorzugt umfasst diese Schicht eine Vielzahl von Kristallen und/oder Nanokristallen **66**, die vorzugsweise vollkommen zufällig, gleichverteilt orientiert sind und deren Dichte vorzugsweise im Wesentlichen nicht abhängig von der Position in der Schicht ist. Vorzugsweise handelt es sich bei den Kristallen und/oder Nanokristallen **66** um Diamanten. Vorzugsweise handelt es sich bei den paramagnetischen Zentren um NV-Zentren. Bei diesem Diamantmaterial handelt es sich bevorzugt um NV-reichem Diamantstaub in einem optisch transparentem Verbundmaterial, das für elektromagnetische Strahlung, beispielsweise Pumpstrahlung **13**, mit Pumpstrahlungswellenlänge λₚₘₚ und für elektromagnetische Strahlung mit Fluoreszenzstrahlungswellenlänge λ_{fl} im Wesentlichen transparent ist. Typischerweise umfasst die Sensorschicht **5** diese Schicht **11**. Die Schicht **11** umfasst bevorzugt eine verfestigte kolloidale Mischung **KL** eines mittels elektromagnetischer Strahlung einer Aushärtewellenlänge λ_{H} ausgehärteten Trägermaterials **TM.** In das Trägermaterial **TM** sind bevorzugt eine Vielzahl von Diamanten **DM** bzw. Nanodiamanten und/oder Kristalle eingebettet. Einer oder mehrere oder alle Diamanten **DM** bzw. Nanodiamanten dieser Diamanten **DM** und/oder Kristalle weisen vorzugsweise NV-Zentren **NVZ** und/oder andere paramagnetischen Zentren auf. Die NV-Zentren **NVZ** des Trägermaterials **TM** und/oder die anderen paramagnetischen Zentren des Trägermaterials **TM** emittieren bevorzugt bei Bestrahlung mit Pumpstrahlung **LB** zumindest eine Fluoreszenzstrahlung **FL;**
- 12: Trägermaterial II **12**. Bei dem Trägermaterial II **12** kann es sich beispielsweise um eine Glasplatte **46** handeln, die gleichzeitig als beispielhaftes optisches Funktionselement die Schicht **11** mit Kristallen und/oder Nanokristallen **66** mit paramagnetischen Zentren mit Pumpstrahlung **13** mit der Pumpstrahlungswellenlänge λₚₘₚ bestrahlt. Im Sinne des hier vorgelegten Dokuments handelt es sich bei dem Trägermaterial II **12** um einen Lichtwellenleiter **LWL;**
- 13: Pumpstrahlung **13** mit der Pumpstrahlungswellenlänge λₚₘₚ. Das hier vorgelegte Dokument bezeichnet die Pumpstrahlung **13** auch mit dem Bezugszeichen **LB** (Wie Laser-Beam);
- 14: Fluoreszenzstrahlung **14** mit der Fluoreszenzstrahlungswellenlänge λ_{fl}. Das hier vorgelegte Dokument bezeichnet die Fluoreszenzstrahlung **14** auch mit dem Bezugszeichen **FL** (Wie Fluoreszenz);
- 15: Auswertelektronik **15** des Lichtsensorarrays **1**;
- 16: vorzugsweise ebene Fläche **16**;
- 17: ferromagnetisches Material **17**;
- 18: Fehler in dem beispielhaften ferromagnetischen Material **17** der Figur 26;
- 19: Hilfsmagnet **19**;
- 20: beispielhafte Bewegungsrichtung **20**;
- 21: Magnetfeldkamerakopf **21**;
- 22: Unterseite der Sensorschicht **5** in Richtung vom Lichtsensorarray **1** weg;
- 23: Oberseite der Sensorschicht **5** in Richtung des Lichtsensorarrays **1**;
- 24: Unterseite **24** des Gehäuses **8** der Magnetfeldkamera;
- 25: Sensorschichtdicke **25** der Sensorschicht **5**;
- 26: der Abstand **26** zwischen Sensorschicht **5** und der Außenfläche des Gehäuses **8** der Magnetfeldkamera im Bereich der Sensorschicht **5**. In den hier vorgestellten Beispielen betrug der Abstand zwischen der Sensorschicht **5** und der Oberfläche **34** des Messobjekts **17** weniger als 1mm;
- 27: elektromagnetische Strahlung **27** anderer Wellenlängenbereiche **27**;
- 28: Rechnersystem **28** zur Bedienung des Magnetfeldkamerakopfes **21**;
- 29: Datenbus **29** zur Herstellung der Datenverbindung zwischen Aufbereitungsschaltung **30** für die Ausgangssignale **31** der Lichtsensoren des Lichtsensorarrays **1** des Magnetfeldkamerakopfes **21** und Rechnersystem **28** zur Bedienung des Magnetfeldkamerakopfes **21**;
- 30: Aufbereitungsschaltung **30** für die Ausgangssignale **31** der Lichtsensoren des Lichtsensorarrays **1** des Magnetfeldkamerakopfes **21**. Die Aufbereitungsschaltung **30** ist bevorzugt Teil der Auswerteelektronik **15** des Magnetfeldkamerakopfes **21**;
- 31: Ausgangssignale **31** der Lichtsensoren des Lichtsensorarrays **1** des Magnetfeldkamerakopfes **21**;
- 32: Bildschirm **32** der Magnetfeldkamera;
- 33: Rechnerkern **33** des Rechnersystems **28** zur Bedienung des Magnetfeldkamerakopfes **21** der Magnetfeldkamera mit zumindest einer CPU;
- 34: Oberfläche **34** des Messobjekts. In Figur **16** Oberfläche des ferromagnetischen Materials **17**;
- 35: Ansteuervorrichtung **35** für die Elektromagnete der Hilfsmagnete **19** des Magnetfeldkamerakopfes **21**;
- 36: Schnittstellenschaltung **36**;
- 37: Permanentmagnete **37** für Prüfzwecke der Magnetfeldkamera und/oder des Magnetfeldkamerakopfes **21**;
- 38: Glasplatte **38**. Die technische Lehre des hier vorgelegten Dokuments verwendet in einigen Ausprägungen die Glasplatte **38** als Lichtwellenleiter LWL;
- 39: zweidimensionale Falschfarben- Magnetflussdichtenbetragsbild der Verteilung der magnetischen Flussdichte von vier Permanentmagneten **37** auf einer Glasplatte **38**, das mit einer Magnetfeldkamera mit einem Magnetfeldkamerakopf **21** entsprechend der hier vorgestellten technischen Lehre ermittelt wurde.
- 40: oberer Gehäuseteil **40** des Gehäuses **8** eines beispielhaften Magnetfeldkamerakopfes **21** einer beispielhaften Magnetfeldkamera. Beispielsweise kann es sich um einen oberen 3D-Druckgehäuseteil des beispielhaften 3D-Druckgehäuses **8** handeln;
- 41: unterer Gehäuseteil **41** des Gehäuses **8** eines beispielhaften Magnetfeldkamerakopfes **21** einer beispielhaften Magnetfeldkamera. Beispielsweise kann es sich um einen unteren 3D-Druckgehäuseteil des beispielhaften 3D-Druckgehäuses **8** handeln;
- 42: Stromversorgungskabel **42** für das PCB **43** mit den LEDs **44** eines beispielhaften Magnetfeldkamerakopfes **21** einer beispielhaften Magnetfeldkamera;
- 43: Schaltungsträger (PCB) **43** für die LEDs **44** eines beispielhaften Magnetfeldkamerakopfes **21** einer beispielhaften Magnetfeldkamera und deren Energieversorgung **45**;
- 44: LED **44** zur Bestrahlung der Sensorschicht **5** über eine Beleuchtungsoptik **3** beispielsweise in Form einer Glasplatte **46** als beispielhaftes optisches Funktionselement mit Pumpstrahlung **13(LB)** mit der Pumpstrahlungswellenlänge λₚₘₚ. In dem Beispiel dient die Glasplatte **46** als optisches Funktionselement eines Lichtwellenleiters **LWL.** Die Kante der Glasplatte **46** das zweite Ende **ELWL2** des Lichtwellenleiters **LWL**, hier das zweite Ende ELWL2 der Glasplatte **46**, dar, über den die LEDs **44** als Pumpstrahlungsquellen (**2**, **PL**) die Pumpstrahlung **13(LB)** mit der Pumpstrahlungswellenlänge λₚₘₚ in den Lichtwellenleiters **LWL**, hier die Glasplatte **46**, einstrahlen. Die Pumpstrahlung **13(LB)** mit der Pumpstrahlungswellenlänge λₚₘₚ tritt dann über Oberfläche der Glasplatte **46** als erstes Ende **ELWL1** des Lichtwellenleiters **LWL**, hier das erste Ende **ELWL1** der Glasplatte **46**, aus dem Lichtwellenleiter **LWL**, hier die Glasplatte **46**, wieder aus und in das Trägermaterial **TM** der verfestigten kolloidalen Mischung **KL** (Schicht **11**) mit den Diamanten **DM** und/oder Nanodiamanten bz. den Diamanten und/oder Kristallen **ND** mit den paramagnetischen Zentren und/oder NV-Zentren **NVZ** ein. Die Oberfläche der Glasplatte **46** stellt dabei die erste Endoberfläche **EF1** des Lichtwellenleiters **LWL** dar, über den die LEDs **44** als Pumpstrahlungsquellen (**2**, **PL**) in das Sensorelement **SE** auf der Oberfläche der Glasplatte **46** (Lichtwellenleiter **LWL**) eintritt. Die optische Strecke zum Lichtsensorarray 1 stellt in dem Beispiel der Magnetfeldkamera mit dem Magnetfeldsensorkopf **21** den zweite Lichtwellenleiter **LWL2** im Sinne des hier vorgelegten Dokuments dar. ;
- 45: Energieversorgung **45** der LEDs **44** des beispielhaften Schaltungsträgers (PCB) **43** des Magnetfeldsensorkopfes **21** der Magnetfeldkamera;
- 46: Glasplatte **46** als beispielhaftes optisches Funktionselement und beispielhafter Lichtwellenleiter **LWL,** die die paramagnetischen Zentren der Schicht **11** mit Pumpstrahlung **13** mit der Pumpstrahlungswellenlänge λₚₘₚ bestrahlen. Die Schicht **11** umfasst dabei bevorzugt Kristalle und/oder Nanokristalle **66** mit diesen paramagnetischen Zentren, die bevorzugt NV-Zentren sind. Bevorzugt umfasst die Schicht 11 eine ausgehärtete kolloidale Mischung KL aus einem Trägermaterial TM und Diamanten **DM** und/oder Diamant-Nano-Kristalle ND mit einem oder mehreren paramagnetischen Zentren und/oder einem oder mehreren NV-Zentren **NVZ.** Bevorzugt bildet die Glasplatte **46** die ebene Fläche **16** des unteren Gehäuseteils **41** des Gehäuses **8** des Magnetfeldsensorkopfes **21** der beispielhaften Magnetfeldkamera aus. Die Glasplatte **46** hat hier auch die Funktion des Trägermaterials II **12**. Im Sinne des hier vorgelegten Dokuments ist die Glasplatte **46** des Magnetfeldsensorkopfes **21** der beispielhaften Magnetfeldkamera somit ein Lichtwellenleiter **LWL** bei dem die erste Endfläche **ELWL1** senkrecht zur zweiten Endfläche **ELWL2** steht. Aus der ersten Endfläche **ELWL1,** des Lichtwellenleiters **LWL**, hier die Glasplatte **46**, tritt die Pumpstrahlung **LB** in das Trägermaterial **TM** der kolloidalen Mischung **KL** der Schicht **11** über. Aus der ersten Endfläche **ELWL1,** des Lichtwellenleiters **LWL**, hier die Glasplatte **46**, tritt die Aushärtestrahlung mit der Aushärtewellenlänge λ_{H} aus dem Lichtwellenleiter **LWL** in das Trägermaterial **TM** der kolloidalen Mischung **KL** der Schicht **11** über. Über die zweite Endfläche ELWL2 des Lichtwellenleiters **LWL**, hier der Glasplatte **46**, wird die Pumpstrahlung **LB** und/oder die Aushärtestrahlung mit der Aushärtewellenlänge λ_{H} eingespeist;
- 47: dichroitisch verspiegelte optionale Schicht **47**. Diese Schicht hat die Funktion des optischen Filters **6** und des dichroitischen Spiegels / optischer Filters **F1** zur Trennung der Fluoreszenzstrahlung **FL(14)** von der Pumpstrahlung **LB(13);**
- 48: Kleber **48**;
- 49: zweiter Kühlkörper **49** zur Kühlung des Schaltungsträgers (PCB) **43** des Magnetfeldsensorkopfes **21** der beispielhaften Magnetfeldkamera für die LEDs **44** und deren Energieversorgung **45** und der LEDs **44**. Der zweite Kühlkörper **49** umfasst bevorzugt Kupfer als Kühlkörpermaterial des zweiten Kühlkörpers **49**;
- 50: erster Kühlkörper **50** zur Kühlung der Auswertelektronik **15** des Lichtsensorarrays **1** des Magnetfeldsensorkopfes **21** der beispielhaften Magnetfeldkamera und/oder des Lichtsensorarrays **1**. Der erste Kühlkörper **50** umfasst bevorzugt Kupfer als Kühlkörpermaterial des ersten Kühlkörpers **50**;
- 51: Kühlrippen **51**, die thermisch mit dem ersten Kühlkörper **50** des Magnetfeldsensorkopfes **21** der beispielhaften Magnetfeldkamera beispielsweise mittels einer Wärmeleitpaste **53** oder dergleichen gekoppelt sind;
- 52: Deckel **52** des Gehäuses **8** des Magnetfeldsensorkopfes **21** der beispielhaften Magnetfeldkamera;
- 53: Wärmeleitpaste **53** des Magnetfeldsensorkopfes **21** der beispielhaften Magnetfeldkamera;
- 54: Kameragehäuse **54** der Fluoreszenzkamera mit dem Lichtsensorarray **1** mit dessen Auswertelektronik **15** und der abbildenden Optik **7**. Es handelt sich um ein beispielhaftes Gehäuse **8** des Magnetfeldsensorkopfes **21** der beispielhaften Magnetfeldkamera;
- 55: Energiezuleitung **55** zur Energieversorgung des Schaltungsträgers (PCB) **43** des Magnetfeldsensorkopfes **21** der beispielhaften Magnetfeldkamera für die LEDs **44** und deren Energieversorgung **45** und der LEDs **44**;
- 56: Anschlussstecker **56** für die Energiezuleitung **55** zur Energieversorgung des Schaltungsträgers (PCB) **43** des Magnetfeldsensorkopfes **21** der beispielhaften Magnetfeldkamera für die LEDs **44** und deren Energieversorgung **45** und der LEDs **44**;
- 57: elastisches und thermisch leitendes Material **57** des Magnetfeldsensorkopfes **21** der beispielhaften Magnetfeldkamera;
- 58: Thermisch leitende Isolationsfolie **58** des Magnetfeldsensorkopfes **21** der beispielhaften Magnetfeldkamera;
- 59: LED-Vorwiderstände **59** der LEDs **44** auf dem Schaltungsträger (PCB) **43** des Magnetfeldsensorkopfes **21** der beispielhaften Magnetfeldkamera für die LEDs **44**;
- 60: elektronische Bauteile **60** der Energieversorgung der LEDs **44** auf dem Schaltungsträger (PCB) **43** des Magnetfeldsensorkopfes **21** der beispielhaften Magnetfeldkamera;
- 61: Spannungsregler und/oder Regeltransistor **61**. Der Spannungsregler und/oder Regeltransistor **61** ist typischerweise ein elektronisches Bauteile **60** der Energieversorgung der LEDs **44** auf dem Schaltungsträger (PCB) **43** des Magnetfeldsensorkopfes **21** der beispielhaften Magnetfeldkamera. Der Spannungsregler und/oder Regeltransistor **61** ist typischerweise das Stellglied der Spannungsreglung der Energieversorgung der LEDs **44** auf dem Schaltungsträger (PCB) **43** des Magnetfeldsensorkopfes **21** der beispielhaften Magnetfeldkamera;
- 62: Kodierstecker **62** zur Änderung analoger Betriebsparameter der elektronischen Schaltung auf dem Schaltungsträger (PCB) **43** des Magnetfeldsensorkopfes **21** der beispielhaften Magnetfeldkamera;
- 63: Befestigungsmittel für die beispielhafte Befestigung des Hilfsmagneten **19** an dem Deckel **52** des Gehäuses des Magnetfeldsensorkopfes **21** der beispielhaften Magnetfeldkamera ;
- 64: Zugangsöffnung **64** in dem unterer Gehäuseteil **41** des Gehäuses **8** an der Unterseite des Gehäuses **8** des Magnetfeldsensorkopfes **21** der beispielhaften Magnetfeldkamera, die die Änderung der Kodierposition des Jumpers des Kodiersteckers **62** und damit eine Änderung analoger Betriebsparameter der elektronischen Schaltung auf dem Schaltungsträger (PCB) **43** nach dem Verschließen des Gehäuses **8** des Magnetfeldsensorkopfes **21** der beispielhaften Magnetfeldkamera erlaubt. Hierfür muss der Kodierstecker **64** jedoch auf der anderen Seite des Schaltungsträgers (PCB) **43** des Magnetfeldsensorkopfes **21** der beispielhaften Magnetfeldkamera als in den Figuren 30, 31, 35, 38, 39 gezeigt montiert werden. Bei der Ausarbeitung der technischen Lehre dieses Dokuments wurde erkannt, dass eine Kodierung auf dieser Seite des Schaltungsträgers (PCB) **43** statt mit Jumpern und Kodiersteckern **62** durch Lötbrücken effizienter und haltbarer ist;
- 65: Öffnung **65** in dem Schaltungsträger (PCB) **43** des Magnetfeldsensorkopfes **21** der beispielhaften Magnetfeldkamera für die LEDs **44**. Die Öffnung **65** dient dazu, dass die Fluoreszenzstrahlung **14** der paramagnetischen Zentren, also beispielsweise der NV-Zentren, in der Schicht **11** der Sensorschicht **5** auf der Unterseite der Glasplatte **46** des Magnetfeldsensorkopfes **21** der beispielhaften Magnetfeldkamera durch die Glasplatte **46** und die Öffnung in dem Schaltungsträger (PCB) **43** zum Lichtsensorarray **1** des Magnetfeldsensorkopfes **21** der beispielhaften Magnetfeldkamera gelangen kann
- 66: Kristall, vorzugsweise Nano-Kristall **66** und/oder Diamant mit vorzugsweise mehreren paramagnetischen Zentren und/oder einem oder mehreren NV-Zentren NVZ;
- 67: erste Oberfläche **67** des ersten optischen Funktionselements (Glasplatte **46** des Magnetfeldsensorkopfes **21** der beispielhaften Magnetfeldkamera);
- 68: zweite Oberfläche **68** des ersten optischen Funktionselements (Glasplatte **46** des Magnetfeldsensorkopfes **21** der beispielhaften Magnetfeldkamera);
- 69: Diffusor-Schicht **69**. Im Sinne der technischen Lehre des hiervorgelegten Dokuments kann die Diffusor-Schicht **69** auch eine Diffuser-Struktur auf der ersten Oberfläche **67** oder auf der zweiten Oberfläche **68** des ersten optischen Funktionselements, insbesondere der Glasplatte **46** des Magnetfeldsensorkopfes **21** der beispielhaften Magnetfeldkamera sein. Bevorzugt befindet sich die Diffusor-Schicht **69** an der ersten Oberfläche **67** des ersten optischen Funktionselements der Sensorschicht **5** - hier der Glasplatte **46** des Magnetfeldsensorkopfes **21** der beispielhaften Magnetfeldkamera;
- 70: Anschlussleitung der LEDs **44**;
- 71: Anschlussstecker und/oder Anschlussbuchse **71** des Mikrowellensignals **µW** und/oder des HF-Signals RW an einen Wellenleiter (**1380, 1880, 2380, 6830, 6980**) auf der Oberfläche des Trägersubstrats **1360**. Im Falle des Anschlusses eines differentiellen Mikrostreifenwellenleiters 6830 oder einer differentiellen Tri-Plate-Leitung 6980 ist der Anschlussstecker und/oder Anschlussbuchse **71** vorzugsweise als Triaxstecker oder Triaxbuchse ausgeführt. Informationen hierzu können unter der URL https://de.wikipedia.org/wiki/Triaxialkabel im Internet gefunden werden. Die hier offengelegte technische Lehre beschreibt somit einen Anschluss einer Wellenleitung auf dem Trägersubstrat 1360 mittels eines Triaxkabels und ggf. der zugehörigen Triaxverbindungen.
- 72: Speicher **72** und/oder Speichermedium des Rechnerkerns **33** im Rechnersystem **38**; Der Speicher **72** und/oder das Speichermedium können flüchtige Speicher **RAM** und nicht flüchtige Speicher **ROM** umfassen.
- λ_{fl}: Fluoreszenzstrahlungswellenlänge λ_{fl} der Fluoreszenzstrahlung **14 (FL);**
- λₚₘₚ: Pumpstrahlungswellenlänge λₚₘₚ der Pumpstrahlung **13 (LB);**
- 140: Bereitstellen **140** eines Lichtwellenleiters **LWL**, wobei der Lichtwellenleiter **LWL** ein erstes Ende **ELWL1** und ein zweites Ende **ELWL2** aufweist;
- 145: Bereitstellen **145** eines flüssigen und mittels elektromagnetischer Strahlung einer Aushärtewellenlänge λ_{H} härtbaren Trägermaterials **TM,** wobei in das Trägermaterial (TM) eine Vielzahl von Diamanten **DM** bzw. Nanodiamanten eingebettet sind und wobei einer oder mehrere oder alle Diamanten **DM** bzw. Nanodiamanten dieser Diamanten **DM** NV-Zentren **NVZ** und/oder andere paramagnetischen Zentren aufweisen und wobei die NV-Zentren **NVZ** des Trägermaterials **TM** und/oder die anderen paramagnetischen Zentren des Trägermaterials **TM** bei Bestrahlung mit Pumpstrahlung **LB** zumindest eine Fluoreszenzstrahlung **FL** emittieren;
- 145: ggf. Vorhärten **147** (Pre-Bake) des Sensorelements **SE** durch eine vorausgehende Temperaturbehandlung;
- 150: Benetzen **150** des ersten Endes des Lichtwellenleiters **TM** auf eine Benetzungslänge **L_{B}** mit dem Trägermaterial **TM,** das die Vielzahl eingebetteter Diamanten **DM** bzw. Nanodiamanten und/oder Kristalle mit einem oder mehreren NV-Zentren und/oder einem oder mehreren paramagnetischen Zentren aufweist;
- 155: Einspeisen **155** elektromagnetischer Strahlung in das zweite Ende **ELWL2** des Lichtwellenleiters **LWL**, wobei die Wellenlänge dieser elektromagnetischen Strahlung, die Aushärtewellenlänge λ_{H} so gewählt ist, dass das Trägermaterial **TM** am zweiten Ende **ELWL2** des Lichtwellenleiters **LWL** aushärtet und sich in einen Festkörper wandelt, wobei das ausgehärtete Trägermaterial **TM** das Sensorelement SE ausbildet;
- 160: Entfernen **160** des nicht ausgehärteten Trägermaterials **TM** insbesondere mittels eines Lösungsmittels, wobei der verbleibende Film des Trägermaterials **TM** am ersten Ende des Lichtwellenleiters **LWL** das Sensorelement bildet;
- 165: ggf. Nachhärten **165** (Post-Bake) des Sensorelements **SE** durch eine nachfolgende Temperaturbehandlung;
- 167: Bereitstellen **167** eines Sensorkopfgehäuses **GH** des Sensorkopfes **SK** und einer Erregungsquelle für eine magnetische Erregung **H,** insbesondere eines Permanentmagneten **PM** (in Anwendungsbeispiel I);
- 170: Einbau **170** des Lichtwellenleiters **LWL** mit dem neu gebildeten Sensorelement **SE** in den Kanal **KN** des Sensorkopfgehäuses **GH** des Sensorkopfes **SK** und Einbau der einer Erregungsquelle für eine magnetische Erregung **H** in das Sensorkopfgehäuses **GH** des Sensorkopfes **SK** (in Anwendungsbeispiel I);
- 180: Verwendung **180** des Sensorkopfes **SK** zur ortsaufgelösten Vermessung der magnetischen Eigenschaften des Materials eines Werkstücks in der Nähe der Oberfläche **OF** des Werkstücks (in Anwendungsbeispiel I), wobei die Ortsauflösung besser als 500µm und/oder besser als 200µm und/oder besser als 100µm und/oder besser als 50µm und/oder besser als 20µm und/oder besser als 10µm ist. Dabei ist Auflösung die Möglichkeit zwei beieinanderliegende Störungen der magnetischen Eigenschaften einer Oberfläche **OF** eines Werkstücks noch durch ein Extremum von 5% der Signalamplitude zu können, wenn diese entsprechend der Auflösung voneinander beabstandet sind. Solche Störungen können beispielsweise Risse, Lunker, Materialinhomogenitäten etc. sein.
- 182: Bereitstellen **182** eines Gehäuses **GH** des Motors;
- 185: Einbau **185** des Lichtwellenleiters **LWL** mit dem neu gebildeten Sensorelement **SE** in die Öffnung OF des Gehäuses **GH** des Motors;
- 187: Verwendung **187** des Lichtwellenleiters **LWL** mit dem neu gebildeten Sensorelement **SE** zur Vermessung der magnetischen Flussdichte **B** innerhalb des Luftspalts **LS** des Motors oder im Streufeld **BSTR** des Magnetfelds im Luftspalt **LS.**
- 190: ggf. Ermittlung **190** des Zeitpunkten des Nulldurchgangs des Betrags der magnetischen Flussdichte B der magnetischen Flussdichte **B** innerhalb des Luftspalts **LS** des Motors oder im Streufeld **BSTR** des Magnetfelds im Luftspalt **LS** und/oder ggf. Ermittlung **190** des Betrags der magnetischen Flussdichte **B** der magnetischen Flussdichte **B** innerhalb des Luftspalts **LS** des Motors oder im Streufeld **BSTR** des Magnetfelds im Luftspalt **LS.**
- 193: ggf. Ermittlung **193** oder Schätzung der Position des Magnetfelds innerhalb des Luftspalts des Motors.
- 195: ggf. Kommutierung **195** der Bestromung einer oder mehrerer Statorspulen des Motors und/oder einer oder mehrerer Rotorspulen des Motors in Abhängigkeit
a) von den ermittelten Zeitdurchgängen des Nulldurchgangs des Betrags der magnetischen Flussdichte B der magnetischen Flussdichte **B** innerhalb des Luftspalts **LS** des Motors oder im Streufeld **BSTR** des Magnetfelds im Luftspalt **LS** und/oder
b) von dem ermittelten Betrags der magnetischen Flussdichte **B** der magnetischen Flussdichte **B** innerhalb des Luftspalts **LS** des Motors oder im Streufeld **BSTR** des Magnetfelds im Luftspalt **LS** und/oder von der ermittelten oder geschätzten Position des Magnetfelds innerhalb des Luftspalts des Motors
- 511: Diagramm der Resonanzlinien des Anteils mit Mikrowellenmodulationsfrequenz **f** µW an der der Intensität **Iᵢₛₜ** der Fluoreszenzstrahlung **FL** eines mit NV-Zentren versehenen Diamant-Einkristalls in Anhängigkeit von der Mikrowellenfrequenz ω_{µW} und von der magnetischen Flussdichte **B.** Dabei ist die Mikrowellenfrequenz ω_{µW} in der X-Achse des Diagramms **511** aufgetragen. Die magnetische Flussdichte **B** ist in der Y-Achse des Diagramms **511** in willkürlichen Einheiten aufgetragen (englisch: "arbitrary units" oder abgekürzt "au"). In dem Beispiel ist ein einzelner Diamantkristall in [111] gegenüber der Richtung der magnetischen Flussdichte **B** eines Magnetfelds ausgerichtet. Das in dem Diagramm **511** dargestellte Verhalten ist aus dem Stand der Technik bekannt;
- 512: Resonanzlinie von NV-Zentren eines Diamant-Einkristalls für die Spinquantenzahl mₛ=-1, der gegenüber der magnetischen Flussdichte **B** des Magnetfelds in [111] Richtung ausgerichtet ist und wobei die bei dieser Resonanzlinie wechselwirkenden NV-Zentren des Diamant-Einkristalls in der [111]-Richtung des Diamant-Einkristalls ausgerichtet sind. Die B-Komponente des Mikrowellenfeldes ist gegenüber der magnetischen Flussdichte **B** des Magnetfelds senkrecht ausgerichtet. Die Resonanzlinie entspricht der Spinquantenzahl mₛ=-1;
- 513: Resonanz eines Einkristalls, der gegenüber dem Magnetfeld in [111] Richtung ausgerichtet ist und wobei die bei dieser Resonanzlinie wechselwirkenden NV-Zentren des Diamant-Einkristalls in einer der drei anderen Kristallrichtungen des Diamant-Einkristalls gegenüber der [111]-Richtung des Diamant-Einkristalls ausgerichtet sind. Die B-Komponente des Mikrowellenfeldes ist gegenüber der magnetischen Flussdichte **B** des Magnetfelds senkrecht ausgerichtet. Die Resonanzlinie entspricht der Spinquantenzahl mₛ=-1
- 514: Resonanzlinie von NV-Zentren eines Diamant-Einkristalls für die Spinquantenzahl mₛ=+1, der gegenüber der magnetischen Flussdichte **B** des Magnetfelds in [111] Richtung ausgerichtet ist und wobei die bei dieser Resonanzlinie wechselwirkenden NV-Zentren des Diamant-Einkristalls in einer der drei anderen Kristallrichtungen des Diamant-Einkristalls gegenüber der [111]-Richtung des Diamant-Einkristalls ausgerichtet sind. Die B-Komponente des Mikrowellenfeldes ist gegenüber der magnetischen Flussdichte **B** des Magnetfelds senkrecht ausgerichtet. Die Resonanzlinie entspricht der Spinquantenzahl mₛ=+1;
- 515: Resonanzlinie von NV-Zentren eines Diamant-Einkristalls für die Spinquantenzahl mₛ=+1, der gegenüber der magnetischen Flussdichte **B** des Magnetfelds in [111] Richtung ausgerichtet ist und wobei die bei dieser Resonanzlinie wechselwirkenden NV-Zentren des Diamant-Einkristalls in der [111]-Richtung des Diamant-Einkristalls ausgerichtet sind. Die B-Komponente des Mikrowellenfeldes ist gegenüber der magnetischen Flussdichte **B** des Magnetfelds senkrecht ausgerichtet. Die Resonanzlinie entspricht der Spinquantenzahl mₛ=+1;
- 520: Diagramm der Resonanz der Intensität **Iᵢₛₜ** der Fluoreszenzstrahlung **FL** bzw. der Änderung der Intensität **Iᵢₛₜ** der Fluoreszenzstrahlung **FL** eines Kollektivs von Diamantkristallen, die zueinander zufällig und im Wesentlichen gleichverteilt unterschiedlich im Raum orientiert sind, in Anhängigkeit von der Mikrowellenfrequenz ω_{µW} und von der magnetischen Flussdichte B. Dabei ist die Mikrowellenfrequenz ω_{µW} in der X-Achse des Diagramms aufgetragen. Die magnetische Flussdichte B ist in der Y-Achse in willkürlichen Einheiten aufgetragen. (englisch: "arbitrary units" oder abgekürzt "au"), In dem Beispiel sind die Diamanten der Vielzahl der Diamantkristalle in unterschiedlichen Richtungen gegenüber dem Magnetfeld ausgerichtet. Dieses Verhalten ist aus dem Stand der Technik bekannt.
- 522: untere Resonanzkante **522.** Es handelt sich um die untere Resonanzkante der Intensität **Iᵢₛₜ** der Fluoreszenzstrahlung **FL** bzw. der Änderung der Intensität **Iᵢₛₜ** der Fluoreszenzstrahlung **FL** des Resonanzfelds der Intensität **Iᵢₛₜ** der Fluoreszenzstrahlung **FL** eines Kollektivs von Diamantkristallen, die zueinander zufällig und im Wesentlichen gleichverteilt unterschiedlich im Raum orientiert sind, in Anhängigkeit von der Mikrowellenfrequenz ω_{µW} und von der magnetischen Flussdichte B. Dabei ist die Mikrowellenfrequenz ω_{µW} in der X-Achse des Diagramms aufgetragen. Die magnetische Flussdichte B ist in der Y-Achse in willkürlichen Einheiten aufgetragen. (englisch: "arbitrary units" oder abgekürzt "au"), In dem Beispiel sind die Diamanten der Vielzahl der Diamantkristalle in unterschiedlichen Richtungen gegenüber der magnetischen Flussdichte **B** des Magnetfelds ausgerichtet.
- 523: untere mittlere Resonanzkante **523**. Es handelt sich um die untere mittlere Resonanzkante der Intensität **Iᵢₛₜ** der Fluoreszenzstrahlung FL bzw. der Änderung der Intensität **Iᵢₛₜ** der Fluoreszenzstrahlung **FL** des Resonanzfelds der Intensität **Iᵢₛₜ** der Fluoreszenzstrahlung **FL** eines Kollektivs von Diamantkristallen, die zueinander zufällig und im Wesentlichen gleichverteilt unterschiedlich im Raum orientiert sind, in Anhängigkeit von der Mikrowellenfrequenz ω_{µW} und von der magnetischen Flussdichte B. Dabei ist die Mikrowellenfrequenz ω_{µW} in der X-Achse des Diagramms aufgetragen. Die magnetische Flussdichte B ist in der Y-Achse in willkürlichen Einheiten aufgetragen. (englisch: "arbitrary units" oder abgekürzt "au"), In dem Beispiel sind die Diamanten der Vielzahl der Diamantkristalle in unterschiedlichen Richtungen gegenüber der magnetischen Flussdichte des Magnetfelds ausgerichtet.
- 524: obere mittlere Resonanzkante **524.** Es handelt sich um die obere mittlere Resonanzkante der Intensität **Iᵢₛₜ** der Fluoreszenzstrahlung **FL** bzw. der Änderung der Intensität **Iᵢₛₜ** der Fluoreszenzstrahlung **FL** des Resonanzfelds der Intensität **Iᵢₛₜ** der Fluoreszenzstrahlung **FL** eines Kollektivs von Diamantkristallen, die zueinander zufällig und im Wesentlichen gleichverteilt unterschiedlich im Raum orientiert sind, in Anhängigkeit von der Mikrowellenfrequenz ω_{µW} und von der magnetischen Flussdichte B. Dabei ist die Mikrowellenfrequenz ω_{µW} in der X-Achse des Diagramms aufgetragen. Die magnetische Flussdichte B ist in der Y-Achse in willkürlichen Einheiten aufgetragen. (englisch: "arbitrary units" oder abgekürzt "au"), In dem Beispiel sind die Diamanten der Vielzahl der Diamantkristalle in unterschiedlichen Richtungen gegenüber der magnetischen Flussdichte des Magnetfelds ausgerichtet.
- 525: obere Resonanzkante **525.** Es handelt sich um die obere Resonanzkante der Intensität **Iᵢₛₜ** der Fluoreszenzstrahlung **FL** bzw. der Änderung der Intensität **Iᵢₛₜ** der Fluoreszenzstrahlung **FL** des Resonanzfelds der Intensität **Iᵢₛₜ** der Fluoreszenzstrahlung **FL** eines Kollektivs von Diamantkristallen, die zueinander zufällig und im Wesentlichen gleichverteilt unterschiedlich im Raum orientiert sind, in Anhängigkeit von der Mikrowellenfrequenz ω_{µW} und von der magnetischen Flussdichte B. Dabei ist die Mikrowellenfrequenz ω_{µW} in der X-Achse des Diagramms aufgetragen. Die magnetische Flussdichte B ist in der Y-Achse in willkürlichen Einheiten aufgetragen. (englisch: "arbitrary units" oder abgekürzt "au"), In dem Beispiel sind die Diamanten der Vielzahl der Diamantkristalle in unterschiedlichen Richtungen gegenüber der magnetischen Flussdichte des Magnetfelds ausgerichtet.
- 526: unteres Resonanzteilfeld. Es handelt sich um das untere Resonanzteilfeld der Intensität **Iᵢₛₜ** der Fluoreszenzstrahlung **FL** bzw. der Änderung der Intensität **Iᵢₛₜ** der Fluoreszenzstrahlung **FL** des Resonanzfelds der Intensität **Iᵢₛₜ** der Fluoreszenzstrahlung **FL** eines Kollektivs von Diamantkristallen, die zueinander zufällig und im Wesentlichen gleichverteilt unterschiedlich im Raum orientiert sind, in Anhängigkeit von der Mikrowellenfrequenz ω_{µW} und von der magnetischen Flussdichte B. Dabei ist die Mikrowellenfrequenz ω_{µW} in der X-Achse des Diagramms aufgetragen. Die magnetische Flussdichte B ist in der Y-Achse in willkürlichen Einheiten aufgetragen. (englisch: "arbitrary units" oder abgekürzt "au"), In dem Beispiel sind die Diamanten der Vielzahl der Diamantkristalle in unterschiedlichen Richtungen gegenüber der magnetischen Flussdichte des Magnetfelds ausgerichtet. Die untere Resonanzkante **522** begrenzt das untere Resonanzteilfeld **26** zu niedrigeren Mikrowellenfrequenzen ω_{µW} und zu niedrigeren magnetischen Flussdichten **B** hin. Die untere mittlere Resonanzkante **523** begrenzt das untere Resonanzteilfeld **526** zu höheren Mikrowellenfrequenzen ω_{µW} und zu niedrigeren magnetischen Flussdichten **B** hin. Eine Offsetflussdichte **B_{off}** begrenzt das untere Resonanzteilfeld **526** zu kleineren magnetischen Flussdichten **B** hin weiter.
- 527: oberes Resonanzteilfeld. Es handelt sich um das obere Resonanzteilfeld der Intensität **Iᵢₛₜ** der Fluoreszenzstrahlung **FL** bzw. der Änderung der Intensität **Iᵢₛₜ** der Fluoreszenzstrahlung **FL** des Resonanzfelds der Intensität **Iᵢₛₜ** der Fluoreszenzstrahlung **FL** eines Kollektivs von Diamantkristallen, die zueinander zufällig und im Wesentlichen gleichverteilt unterschiedlich im Raum orientiert sind, in Anhängigkeit von der Mikrowellenfrequenz ω_{µW} und von der magnetischen Flussdichte B. Dabei ist die Mikrowellenfrequenz ω_{µW} in der X-Achse des Diagramms aufgetragen. Die magnetische Flussdichte B ist in der Y-Achse in willkürlichen Einheiten aufgetragen. (englisch: "arbitrary units" oder abgekürzt "au"), In dem Beispiel sind die Diamanten der Vielzahl der Diamantkristalle in unterschiedlichen Richtungen gegenüber der magnetischen Flussdichte des Magnetfelds ausgerichtet. Die obere Resonanzkante **525** begrenzt das obere Resonanzteilfeld **527** zu niedrigeren Mikrowellenfrequenzen ω_{µW} und zu höheren magnetischen Flussdichten **B** hin. Die obere mittlere Resonanzkante **24** begrenzt das obere Resonanzteilfeld **527** zu höheren Mikrowellenfrequenzen ω_{µW} und zu höheren magnetischen Flussdichten **B** hin. Eine Offsetflussdichte **B_{off}** begrenzt das obere Resonanzteilfeld **527** zu kleineren magnetischen Flussdichten **B** hin weiter.
- 528: unteres Resonanzfeld. Es handelt sich um das untere Resonanzteilfeld der Intensität **Iᵢₛₜ** der Fluoreszenzstrahlung **FL** bzw. der Änderung der Intensität **Iᵢₛₜ** der Fluoreszenzstrahlung **FL** des Resonanzfelds der Intensität **Iᵢₛₜ** der Fluoreszenzstrahlung **FL** eines Kollektivs von Diamantkristallen, die zueinander zufällig und im Wesentlichen gleichverteilt unterschiedlich im Raum orientiert sind, in Anhängigkeit von der Mikrowellenfrequenz ω_{µW} und von der magnetischen Flussdichte B. Dabei ist die Mikrowellenfrequenz ω_{µW} in der X-Achse des Diagramms aufgetragen. Die magnetische Flussdichte B ist in der Y-Achse in willkürlichen Einheiten aufgetragen. (englisch: "arbitrary units" oder abgekürzt "au"), In dem Beispiel sind die Diamanten der Vielzahl der Diamantkristalle in unterschiedlichen Richtungen gegenüber der magnetischen Flussdichte des Magnetfelds ausgerichtet. Die untere Resonanzkante **522** begrenzt das untere Resonanzfeld **528** zu niedrigeren Mikrowellenfrequenzen ω_{µW} und zu kleineren magnetischen Flussdichten **B** hin. Die obere Resonanzkante **525** begrenzt das untere Resonanzteilfeld **528** zu höheren Mikrowellenfrequenzen ω_{µW} und zu kleineren magnetischen Flussdichten **B** hin. Eine Offsetflussdichte **B_{off}** begrenzt das untere Resonanzfeld **528** zu höheren magnetischen Flussdichten **B** hin weiter.
- 529: mittleres Resonanzminimum **529**. Es handelt sich um das mittlere Resonanzminimum der Intensität **Iᵢₛₜ** der Fluoreszenzstrahlung **FL** bzw. der Änderung der Intensität **Iᵢₛₜ** der Fluoreszenzstrahlung **FL** des Resonanzfelds der Intensität **Iᵢₛₜ** der Fluoreszenzstrahlung **FL** eines Kollektivs von Diamantkristallen, die zueinander zufällig und im Wesentlichen gleichverteilt unterschiedlich im Raum orientiert sind, in Anhängigkeit von der Mikrowellenfrequenz ω_{µW} und von der magnetischen Flussdichte B. Dabei ist die Mikrowellenfrequenz ω_{µW} in der X-Achse des Diagramms aufgetragen. Die magnetische Flussdichte B ist in der Y-Achse in willkürlichen Einheiten aufgetragen. (englisch: "arbitrary units" oder abgekürzt "au"), In dem Beispiel sind die Diamanten der Vielzahl der Diamantkristalle in unterschiedlichen Richtungen gegenüber der magnetischen Flussdichte des Magnetfelds ausgerichtet. Das Resonanzminimum verläuft zwischen der unteren mittleren Resonanzkante **523** und der oberen mittleren Resonanzkante **524**.Eine Offsetflussdichte **B_{off}** begrenzt das Resonanzminimum **529** zu kleineren magnetischen Flussdichten **B** hin weiter.
- 530: Spitze der V-Formation **530** aus unterer Resonanzkante **522** und einer oberer Resonanzkante **525**;
- 541: Linie **541** entlang derer der Arbeitspunkt des Sensorelements **SE** wandert, wenn für die Bestimmung einer unbekannten Mikrowellenfrequenz ω_{µWnk} die Vorrichtung beispielsweise die wirksame magnetische Referenzflussdichte **B_{ref}** mittels Änderung der zusätzlichen wirksamen magnetischen Flussdichte **B_{adw}** verändert;
- 542: Schnittpunkt **542** der Linie **543** mit der unteren Resonanzkante **522**;
- 543: Linie **543** entlang derer der Arbeitspunkt des Sensorelements **SE** wandert, wenn für die Bestimmung einer unbekannten Mikrowellenfrequenz ω_{µWnk} die Vorrichtung beispielsweise die ein Mikrowellensignal **µW** mit der variierten Mikrowellenfrequenz ω_{µW} zumischt und sich hierdurch innerhalb des Sensorelements **SE** Mikrowellensignalanteile mit einer gemischten Mikrowellenfrequenz von ω_{µWmix+}=ω_{µWnk}+ω_{µW} und ω_{µWmix-}=ω_{µWnk}-ω_{µW}. ergeben;
- 545: Schnittpunkt **545** der Linie **543** mit der oberen Resonanzkante **525**;
- 561: obere Referenzlinie **561**;
- 562: untere Referenzlinie **562**;
- 563: mittlere Referenzlinie **563**;
- 564: Wert **564** der magnetischen Flussdichte **B₆₁**, der der oberen Referenzlinie **561** zugeordnet ist;
- 565: Wert **565** der magnetischen Flussdichte **B₆₂**, der der unteren Referenzlinie **562** zugeordnet ist;
- 566: Differenz **566** des Werts der magnetischen Flussdichte **B₆₃**, der der mittleren Referenzlinie **563** zugeordnet ist, minus dem Wert **565** der magnetischen Flussdichte **B₆₂**, der der unteren Referenzlinie **562** zugeordnet ist;
- 567: Steigung **567** der Kurve;
- 627: Polynomapproximation **627** der Kurve;
- 1310: elektrisch leitende linke Signalmassefläche **1310** der beispielhaften Schlitzleitung **1880** bzw. der beispielhaften Triplate-Leitung **2380** bzw. beispielhaften differentiellen Tri-Plate-Leitung **6980;**
- 1320: elektrisch leitende rechte Signalmassefläche **1320** beispielhaften Schlitzleitung **1880** bzw. der beispielhaften Triplate-Leitung **2380** bzw. beispielhaften differentiellen Tri-Plate-Leitung **6980;**
- 1330: Signalleiter **1330** der beispielhaften Mikrostreifenleitung **1380** bzw. beispielhaften differenziellen Mikrostreifenleitung **6880** bzw. der beispielhaften Triplate-Leitung **2380** bzw. beispielhaften differentiellen Tri-Plate-Leitung **6980**;
- 1340: elektrisch im Wesentlichen nicht-leitende linke Isolationsfläche **1340**. Im Sinne des hier vorgelegten Dokuments handelt es sich um eine Clearance, durch die im Falle eines optisch für Aushärtestrahlung **4910** einer Aushärtewellenlänge λ_{H} aus dem Trägersubstrat **1360** in ein ggf. aufgebrachtes Trägermaterial **TM** austreten kann und/oder durch die Pumpstrahlung **LB** aus dem Trägersubstrat 1360 in ein aufgebrachtes Sensorelement **SE** übertreten kann;
- 1350: elektrisch im Wesentlichen nicht-leitende rechte Isolationsfläche **1350**. Im Sinne des hier vorgelegten Dokuments handelt es sich um eine Clearance, durch die im Falle eines optisch für Aushärtestrahlung **4910** einer Aushärtewellenlänge λ_{H} aus dem Trägersubstrat **1360** in ein ggf. aufgebrachtes Trägermaterial **TM** austreten kann und/oder durch die Pumpstrahlung **LB** aus dem Trägersubstrat 1360 in ein aufgebrachtes Sensorelement **SE** übertreten kann;
- 1360: Trägersubstrat **1360**. Insbesondere kann es sich um das Trägersubstrat **1360** der beispielhaften Triplate-Leitung **2380** oder der beispielhaften Mikrostreifenleitung **1380** bzw. beispielhaften differenziellen Mikrostreifenleitung **6880** bzw. beispielhaften Schlitzleitung **1880** bzw. der beispielhaften Triplate-Leitung **2380** bzw. beispielhaften differentiellen Tri-Plate-Leitung **6980** handeln. Bevorzugt ist das Trägersubstrat **1360** ein dielektrisches Substrat wie beispielsweise eine Keramik mit hoher Dielektrizitätszahl εᵣ. Bei dem Trägersubstrat **1360** kann es sich auch um einen Halbleiterwafer, wie beispielsweise einen Silizium-Wafer oder einen CMOS-Wafer oder BiCMOS-Wafer oder einen Wafer aus einem Bipolar-HalbleiterProzess oder ein Wafer aus einem III/V-Material oder ein Wafer aus einem II/VI-Material oder ein Wafer aus einem Mischkristallhableitermaterial oder einen Diamant-Wafer oder einen diamantbeschichteten Wafer handeln. Auch kann es sich bei dem Trägersubstrat **1360** um eine Isolationsschicht eines mikrointegrierten Schaltkreises und/oder eines MEMS-Bauteils oder einer mikro-optischen Systems oder eines mikro-elektro-optischen Systems oder eines mikrofluidischen Systems oder dergleichen handeln.
- 1370: elektrisch leitender Rückseitenkontakt **1370** der beispielhaften Mikrostreifenleitung **1380** bzw. beispielhaften differenziellen Mikrostreifenleitung **6880** bzw. beispielhaften Schlitzleitung **1880** bzw. der beispielhaften Triplate-Leitung **2380** bzw. beispielhaften differentiellen Tri-Plate-Leitung **6980**;
- 1380: einzelne Mikrostreifenleitung **1380**. Die beispielhafte einzelne Mikrostreifenleitung 1380 umfasst ein vorzugsweise nicht oder nur wenig elektrisch leitendes Trägersubstrat **1360**, einen elektrisch leitenden Rückseitenkontakt **1370** auf der Unterseite des elektrisch nicht-leitenden Trägersubstrats **1360**, eine elektrisch leitende Signalleitung **1330** auf der Oberseite des elektrisch nicht-leitenden Trägersubstrats **1360**. Dabei trennt eine elektrisch im Wesentlichen nicht-leitende linke Isolationsfläche **1340** die elektrisch leitende Signalleitung **1330** von anderen Schaltungsteilen. Außerdem trennt eine elektrisch im Wesentlichen nicht-leitende rechte Isolationsfläche **1350** die elektrisch leitende Signalleitung **1330** von anderen Schaltungsteilen. Bevorzugt weist einzelne Mikrostreifenleitung **1380** bezogen auf die elektrisch leitende Signalleitung **1330** als "heißen" Innenleiter und den elektrisch leitenden Rückseitenkontakt **1370** als Masseelektrode einen Wellenwiderstand auf;
- 1410: linkes Sensorelement **SE**(**1410**)
- links der elektrisch leitenden Signalleitung **1330** auf der elektrisch im Wesentlichen nicht-leitenden linken Isolationsfläche **1340** der beispielhaften Mikrostreifenleitung **1380** bzw.
- links der elektrisch leitenden linken Signalleitung **6810** auf der elektrisch im Wesentlichen nicht-leitenden linken Isolationsfläche **1340** der beispielhaften differenziellen Mikrostreifenleitung **6880** bzw.
- links der elektrisch leitenden Signalleitung **1330** in der nicht-leitenden linken Isolationslücke **2340** zwischen der elektrisch leitenden linken Signalmassefläche **1310** der beispielhaften Triplate-Leitung **2380** und der elektrisch leitenden Signalleitung **1330** bzw.
- links der elektrisch leitenden linken Signalleitung **6810** in der nicht-leitenden linken Isolationslücke **2340** zwischen der elektrisch leitenden linken Signalmassefläche **1310** der beispielhaften differentiellen Triplate-Leitung **6980** und der elektrisch leitenden linken Signalleitung **6810** der beispielhaften differentiellen Triplate-Leitung **6980** bzw.
- links des Schlitzes **1840** der Schlitzleitung **1880** auf der elektrisch leitenden linken Signalmassefläche **1310** der beispielhaften Schlitzleitung **1880;**
- 1420: mittleres Sensorelement **SE(1420)** auf der elektrisch leitenden Signalleitung **1330** der beispielhaften Triplate-Leitung **2380** bzw.
in der Lücke **6840** zwischen der elektrisch leitenden linken Signalleitung **6810** der differenziellen Signalleitung **6830** der beispielhaften differentiellen Triplate-Leitung **6980** und der der elektrisch leitenden rechten Signalleitung **6820** der differenziellen Signalleitung **6830** der beispielhaften differenziellen Triplate-Leitung **6980** bzw. auf der elektrisch leitenden Signalleitung **1330** der beispielhaften Mikrostreifenleitung **1380** bzw. in der Lücke **6840** zwischen der elektrisch leitenden linken Signalleitung **6810** der differenziellen Signalleitung **6830** der beispielhaften differenziellen Mikrostreifenleitung **6880** und der der elektrisch leitenden rechten Signalleitung **6820** der differenziellen Signalleitung **6830** der beispielhaften differenziellen Mikrostreifenleitung **6880** bzw. im Schlitz **1840** der Schlitzleitung **1880;**
- 1430: rechtes Sensorelement **SE(1430)**
- rechts der elektrisch leitenden Signalleitung **1330** auf der elektrisch im Wesentlichen nicht-leitenden rechten Isolationsfläche **1350** der beispielhaften Mikrostreifenleitung **1380** bzw.
- rechts der elektrisch leitenden rechten Signalleitung **6820** auf der elektrisch im Wesentlichen nicht-leitenden rechten Isolationsfläche **1350** der beispielhaften differenziellen Mikrostreifenleitung **6880** bzw.
- rechts der elektrisch leitenden Signalleitung **1330** in der nicht-leitenden rechten Isolationslücke **2350** zwischen der elektrisch leitenden rechten Signalmassefläche **1320** der beispielhaften Triplate-Leitung **2380** und der elektrisch leitenden Signalleitung **1330** bzw.
- rechts der elektrisch leitenden rechten Signalleitung **6820** in der nicht-leitenden rechten Isolationslücke **2350** zwischen der elektrisch leitenden rechten Signalmassefläche **1320** der beispielhaften differentiellen Triplate-Leitung **6980** und der elektrisch leitenden rechten Signalleitung **6820** der beispielhaften differentiellen Triplate-Leitung **6980** bzw.
- rechts des Schlitzes **1840** der Schlitzleitung **1880** auf der elektrisch leitenden rechten Signalmassefläche **1320** der beispielhaften Schlitzleitung **1880;**
- 1440: Richtung des Vektors **1440** der magnetische Flussdichte **B_{µW}** des Mikrowellenfeldes des Mikrowellensignals **µW**,
a) das die Mikrowellensignalquelle **µWG** in die Signalleitung **1330** einspeist, im Bereich des Sensorelements SE, wenn das Sensorelement **SE** links der Signalleitung **1330** platziert ist und es sich um Mikrostreifenleitung **1380** handelt, bzw.
b) das die Mikrowellensignalquelle **µWG** in die Signalleitung **1330** einspeist, im Bereich des Sensorelements **SE,** wenn das Sensorelement **SE** links der Signalleitung **1330** platziert ist und es sich um eine Triplate-Leitung **2380** handelt, bzw.
c) das die Mikrowellensignalquelle **µWG** in den Schlitz **1840** der Schlitzleitung **1880** einspeist, im Bereich des Sensorelements **SE,** wenn das Sensorelement **SE** im Schlitz **1840** der Schlitzleitung **1880** platziert ist und es sich um eine Schlitzleitung **1880** handelt;
- 1450: Richtung des Vektors **1450** der magnetische Flussdichte **B_{µW}** des Mikrowellenfeldes des Mikrowellensignals **µW**,
a) das die Mikrowellensignalquelle **µWG** in die Signalleitung **1330** einspeist, im Bereich des Sensorelements **SE,** wenn das Sensorelement **SE** auf der Signalleitung **1330** platziert ist und es sich um Mikrostreifenleitung **1380** handelt, bzw.
b) das die Mikrowellensignalquelle **µWG** in die Signalleitung **1330** einspeist, im Bereich des Sensorelements **SE,** wenn das Sensorelement **SE** auf der Signalleitung **1330** platziert ist und es sich um eine Triplate-Leitung **2380** handelt, bzw.
c) das die Mikrowellensignalquelle **µWG** in die Schlitzleitung **1880** einspeist, im Bereich des Sensorelements **SE,** wenn das Sensorelement **SE** auf elektrisch leitenden linken Signalmassefläche **1310** platziert ist und es sich um eine Schlitzleitung **1880** handelt, bzw.
d) das die Mikrowellensignalquelle **µWG** in die Schlitzleitung **1880** einspeist, im Bereich des Sensorelements **SE,** wenn das Sensorelement **SE** auf elektrisch leitenden rechten Signalmassefläche **1320** platziert ist und es sich um eine Schlitzleitung **1880** handelt;
- 1460: Richtung des Vektors **1460** der magnetische Flussdichte **B_{µW}** des Mikrowellenfeldes des Mikrowellensignals **µW**,
a) das die Mikrowellensignalquelle **µWG** in die Signalleitung **1330** einspeist, im Bereich des Sensorelements **SE,** wenn das Sensorelement **SE** rechts der Signalleitung **1330** platziert ist und es sich um Mikrostreifenleitung **1380** handelt, bzw.
b) das die Mikrowellensignalquelle **µWG** in die Signalleitung **1330** einspeist, im Bereich des Sensorelements **SE,** wenn das Sensorelement **SE** rechts der Signalleitung **1330** platziert ist und es sich um eine Triplate-Leitung **2380** handelt, bzw.
c) das die Mikrowellensignalquelle **µWG** in den Schlitz **1840** der Schlitzleitung **1880** einspeist, im Bereich des Sensorelements **SE,** wenn das Sensorelement **SE** im Schlitz **1840** der Schlitzleitung **1880** platziert ist und es sich um eine Schlitzleitung **1880** handelt;
- 1710: Sensorelement **SE(1710),** dass die elektrisch leitende Signalleitung **1330** umgibt. Im weitesten Sinne ist das Sensorelement **SE(1710)** eine Kombination der Sensorelemente **1410, 1420** und **1430;**
- 1840: Schlitz **1840** der Schlitzleitung **1880.** Das hier vorgelegte Dokument bezeichnet den Schlitz **1840** einer Schlitzleitung **1880** auch als Clearance einer Schlitzleitung **1880.** Der Schlitz **1840** der Schlitzleitung **1880** ist eine nicht-leitende Isolationslücke im Sinne dieses Dokuments. Im Sinne des hier vorgelegten Dokuments handelt es sich um eine Clearance, durch die im Falle eines optisch für Aushärtestrahlung **4910** einer Aushärtewellenlänge λ_{H} aus dem Trägersubstrat **1360** in ein ggf. aufgebrachtes Trägermaterial **TM** austreten kann und/oder durch die Pumpstrahlung **LB** aus dem Trägersubstrat 1360 in ein aufgebrachtes Sensorelement **SE** übertreten kann;
- 1880: Schlitzleitung **1880.** Die beispielhafte Schlitzleitung **1880** umfasst ein vorzugsweise nicht oder nur wenig elektrisch leitendes Trägersubstrat **1360,** einen elektrisch leitenden Rückseitenkontakt **1370** auf der Unterseite des elektrisch nicht-leitenden Trägersubstrats **1360,** eine elektrisch leitende linke Signalmassefläche **1310** der beispielhaften Schlitzleitung **1880** auf der Oberseite des elektrisch nicht-leitenden Trägersubstrats **1360** und eine elektrisch leitende rechte Signalmassefläche **1320** der beispielhaften Schlitzleitung **1880** auf der Oberseite des elektrisch nicht-leitenden Trägersubstrats **1360.** Dabei trennt eine elektrisch im Wesentlichen nicht-leitende linke Isolationsfläche **1340** die elektrisch leitende Signalleitung **1330** von anderen Schaltungsteilen. Außerdem trennt ein elektrisch im Wesentlichen nicht-leitender Schlitz **1840** der Schlitzleitung **1880** die elektrisch leitende linke Signalmassefläche **1310** der beispielhaften Schlitzleitung **1880** von der elektrisch leitenden rechten Signalmassefläche **1320** der beispielhaften Schlitzleitung **1880.** Bevorzugt weist Schlitzleitung **1880** bezogen auf die elektrisch leitende linke Signalmassefläche **1310** der beispielhaften Schlitzleitung **1880** und die elektrisch leitende rechte Signalmassefläche **1320** der beispielhaften Schlitzleitung **1880** als "heißen" Außenleiter und den elektrisch leitenden Rückseitenkontakt **1370** als Masseelektrode einen Wellenwiderstand auf;
- 2210: den Schlitz **1840** der Schlitzleitung **1880** überdeckendes Sensorelement **SE(2210);**
- 2340: elektrisch im Wesentlichen nicht-leitende linke Isolationslücke **2340.** Im Sinne des hier vorgelegten Dokuments handelt es sich um eine Clearance, durch die im Falle eines optisch für Aushärtestrahlung **4910** einer Aushärtewellenlänge λ_{H} aus dem Trägersubstrat **1360** in ein ggf. aufgebrachtes Trägermaterial **TM** austreten kann und/oder durch die Pumpstrahlung **LB** aus dem Trägersubstrat 1360 in ein aufgebrachtes Sensorelement **SE** übertreten kann;
- 2350: elektrisch im Wesentlichen nicht-leitende rechte Isolationslücke **2350.** Im Sinne des hier vorgelegten Dokuments handelt es sich um eine Clearance, durch die im Falle eines optisch für Aushärtestrahlung **4910** einer Aushärtewellenlänge λ_{H} aus dem Trägersubstrat **1360** in ein ggf. aufgebrachtes Trägermaterial **TM** austreten kann und/oder durch die Pumpstrahlung **LB** aus dem Trägersubstrat 1360 in ein aufgebrachtes Sensorelement **SE** übertreten kann;
- 2380: Tri-Plate-Leitung **2380.** Die beispielhafte Tri-Plate-Leitung **2380** umfasst ein vorzugsweise nicht oder nur wenig elektrisch leitendes Trägersubstrat **1360,** einen elektrisch leitenden Rückseitenkontakt **1370** auf der Unterseite des elektrisch nicht leitenden Trägersubstrats **1360,** eine elektrisch leitende linke Signalmassefläche **1310** auf der Oberseite des elektrisch nicht leitenden Trägersubstrats **1360,** eine elektrisch leitende rechte Signalmassefläche **1320** auf der Oberseite des elektrisch nicht leitenden Trägersubstrats **1360,** eine elektrisch leitende Signalleitung **1330** auf der Oberseite des elektrisch nicht leitenden Trägersubstrats **1360** zwischen der elektrisch leitende linken Signalmassefläche **1310** und der elektrisch leitende rechten Signalmassefläche **1320.** Dabei trennt eine elektrisch im Wesentlichen nicht-leitende linke Isolationslücke **2340** die elektrisch leitende Signalleitung **1330** von der elektrisch leitenden linken Signalmassefläche **1310.** Außerdem trennt eine elektrisch im Wesentlichen nicht-leitende rechte Isolationslücke **2350** die elektrisch leitende Signalleitung **1330** von der elektrisch leitenden rechten Signalmassefläche **1320.** Bevorzugt weist die Tri-Plate-Leitung **2380** bezogen auf die elektrisch leitende Signalleitung **1330** als "heißen" Innenleiter und die Gemeinschaft aus elektrisch leitender linken Signalmassefläche **1310,** elektrisch leitender rechter Signalmassefläche **1320** und elektrisch leitendem Rückseitenkontakt **1370** als Masseelektroden einen Wellenwiderstand auf;
- 2410: linkes Sensorelement **SE(2410),** das die nicht-leitende linke Isolationslücke **2340** der Tri-Plate-Leitung **2380** überdeckt;
- 2420: mittleres Sensorelement **SE(2420),** das die elektrisch leitende Signalleitung **1330** der Tri-Plate-Leitung **2380** überdeckt;
- 2430: rechtes Sensorelement **SE(2430),** das die nicht-leitende rechte Isolationslücke **2350** der Tri-Plate-Leitung **2380** überdeckt;
- 2510: Isolationsschicht **2510;**
- 2520: Flachspule **2520** als Magnetfelderzeugungsmittel Lc;
- 4410: großes Sensorelement **SE(4410)** zu dem das mittlere Sensorelement **SE (1420)** und das rechte Sensorelement **SE (1430)** und das linke Sensorelement **SE (1410)** verschmolzen sind;
- 4510: linke Durchkontaktierung **4510,** die die elektrisch leitende linke Signalmassefläche **1310** der beispielhaften Schlitzleitung **1880** bzw. der beispielhaften Triplate-Leitung **2380** bzw. der beispielhaften differenziellen Triplate-Leitung **6980** mit dem elektrisch leitenden Rückseitenkontakt **1370** der beispielhaften Triplate-Leitung **2380** oder der beispielhaften differenziellen Triplate-Leitung **6980** oder der beispielhaften Schlitzleitung **1880** elektrisch verbinden;
- 4520: rechte Durchkontaktierung **4520,** die die elektrisch leitende rechte Signalmassefläche **1320** der beispielhaften Schlitzleitung **1880** bzw. der beispielhaften Triplate-Leitung **2380** bzw. der beispielhaften differenziellen Triplate-Leitung **6980** mit dem elektrisch leitenden Rückseitenkontakt **1370** der beispielhaften Triplate-Leitung **2380** oder der beispielhaften differenziellen Triplate-Leitung **6980** oder der beispielhaften Schlitzleitung **1880** elektrisch verbinden;
- 4610: linker optischer Wellenleiter **LWL (4610) ;**
- 4620: rechter optischer Wellenleiter **LWL (4620) ;**
- 4630: mittleren optischen Lichtwellenleiters **LWL (4630);**
- 4810: Sensorelementschicht **4810;**
- 4910: Aushärtestrahlung **4910** mit der Aushärtewellenlänge λ_{H};
- 5210: linke Justiermarke **5210;**
- 5220: rechte Justiermarke **5220;**
- 6710: Abschlusswiderstände **6710.** Die Abschlusswiderstände **6710** können beispielsweise zwischen den Leitungen der jeweiligen Wellenleitung und/oder den Leitungen und dem elektrisch leitenden Rückseitenkontakt **1370** geschaltet sein;
- 6810: linker Signalleiter **6810** des differentiellen Signalleiters **6830;**
- 6820: rechter Signalleiter **6820** des differentiellen Signalleiters **6830;**
- 6830: differentieller Signalleiter **6830** der beispielhaften differentiellen Mikrostripleitung **6830** bzw. der beispielhaften differentiellen Triplate-Leitung **7080.** Der differentielle Signalleiter **6830** kann Signale ggf. auch gleichzeitig im Gleichtaktbetrieb und im Gegentaktbetrieb übertragen. Im Gleichtaktbetrieb verhält der differentielle Signalleiter **6830 sich wie der** Signalleiter **1330** der beispielhaften Mikrostripleitung **1380** bzw. der beispielhaften Triplate-Leitung **2380** ;
- 6840: elektrisch isolierende Lücke **6840** zwischen dem linken Signalleiter **6810** und dem rechten Signalleiter **6820** des differentiellen Signalleiters **6830.** Das hier vorgelegte Dokument bezeichnet die elektrisch isolierende Lücke **6840** zwischen dem linken Signalleiter **6810** und dem rechten Signalleiter **6820** des differentiellen Signalleiters **6830** auch als Clearance des differentiellen Signalleiters **6830.** Die elektrisch isolierende Lücke **6840** ist eine nicht-leitende Isolationslücke im Sinne diese Dokuments. Im Sinne des hier vorgelegten Dokuments handelt es sich um eine Clearance, durch die im Falle eines optisch für Aushärtestrahlung **4910** einer Aushärtewellenlänge λ_{H} aus dem Trägersubstrat **1360** in ein ggf. aufgebrachtes Trägermaterial **TM** austreten kann und/oder durch die Pumpstrahlung **LB** aus dem Trägersubstrat 1360 in ein aufgebrachtes Sensorelement **SE** übertreten kann;
- 6880: differentielle Mikrostreifenleitung **6880.** Die beispielhafte differentielle Mikrostreifenleitung **6880** umfasst ein vorzugsweise nicht oder nur wenig elektrisch leitendes Trägersubstrat **1360,** einen elektrisch leitenden Rückseitenkontakt **1370** auf der Unterseite des elektrisch nicht leitenden Trägersubstrats **1360,** eine elektrisch im Wesentlichen nicht-leitende linke Isolationsfläche **1340** auf der Oberseite des elektrisch nicht leitenden Trägersubstrats **1360,** elektrisch im Wesentlichen nicht-leitende rechte Isolationsfläche **1350** auf der Oberseite des elektrisch nicht leitenden Trägersubstrats **1360,** eine linke elektrisch leitende Signalleitung **6810** auf der Oberseite des elektrisch nicht leitenden Trägersubstrats **1360** zwischen der elektrisch im Wesentlichen nicht-leitende linke Isolationsfläche **1340** einerseits und der elektrisch isolierenden Lücke **6840** zwischen dem linken Signalleiter **6810** und dem rechten Signalleiter **6820** des differentiellen Signalleiters **6830** andererseits, eine rechte elektrisch leitende Signalleitung **6820** auf der Oberseite des elektrisch nicht leitenden Trägersubstrats **1360** zwischen der elektrisch isolierenden Lücke **6840** zwischen dem linken Signalleiter **6810** und dem rechten Signalleiter **6820** des differentiellen Signalleiters **6830** einerseits und der elektrisch im Wesentlichen nicht-leitenden rechten Isolationsfläche **1350** andererseits. Die elektrisch isolierende Lücke **6840** zwischen dem linken Signalleiter **6810** und dem rechten Signalleiter **6820** des differentiellen Signalleiters **6830** isoliert elektrisch den linken Signalleiter **6810** von dem rechten Signalleiter **6820** des differentiellen Signalleiters **6830.** Der linke Signalleiter **6810** und der rechte Signalleiter **6820** bilden zusammen den differentiellen Signalleiter **6830 der** differentiellen Mikrostreifenleitung **6880.** Das hier vorgelegte Dokument bezeichnet die elektrisch isolierende Lücke **6840** zwischen dem linken Signalleiter **6810** und dem rechten Signalleiter **6820** des differentiellen Signalleiters **6830** auch als Clearance des differentiellen Signalleiters **6830.** Das hier vorgelegte Dokument bezeichnet die elektrisch isolierende Lücke **6840** zwischen dem linken Signalleiter **6810** und dem rechten Signalleiter **6820** des differentiellen Signalleiters **6830** der differentiellen Mikrostreifenleitung **6880** auch als Clearance des differentiellen Signalleiters **6830** der differentiellen Mikrostreifenleitung **6880.** Das hier vorgelegte Dokument bezeichnet die elektrisch isolierende Lücke **6840** zwischen dem linken Signalleiter **6810** und dem rechten Signalleiter **6820** des differentiellen Signalleiters **6830** der differentiellen Mikrostreifenleitung **6880** auch als Clearance der differentiellen Mikrostreifenleitung **6880.** Die differentiellen Mikrostreifenleitung **6880** kann mit einem Gleichtaktsignal angesteuert werden, bei dem in den linken Signalleiter **6810** und den rechten Signalleiter **6820** des differentiellen Signalleiters **6830** das gleiche Signal zeitsynchron eingespeist wird. Dieser Betriebszustand heißt Gleichtaktansteuerung mit einem Gleichtaktsignal. Die differentiellen Mikrostreifenleitung **6880** kann mit einem Gegentaktaktsignal angesteuert werden, bei dem in den linken Signalleiter **6810** und den rechten Signalleiter **6820** des differentiellen Signalleiters **6830** das gleiche Signal zeitsynchron, aber mit unterschiedlichem Vorzeichen, eingespeist wird. Dieser Betriebszustand heißt Gegentaktansteuerung mit einem Gegentaktsignal. Bevorzugt weist die differentiellen Mikrostripleitung **6880** bezogen auf den differentieller Signalleiter **6830** als "heißen" Innenleiter einen Gleichtaktwellenwiderstand für eine Gleichtaktansteuerung auf und einen Gegentaktwellenwiderstand für eine Gegentaktansteuerung auf;
- 6980: differentielle Tri-Plate-Leitung **6980;**
- 7110: linkes Leitungssensorelement **SE(7110)** auf der elektrisch leitenden linken Signalleitung **6810** der differentiellen Signalleitung **6830** der differentiellen Mikrostreifenleitung **6880** der beispielhaften differenziellen Triplate-Leitung **6980** bzw. auf der elektrisch leitenden linken Signalleitung **6810** der differentiellen Signalleitung **6830** der differentiellen Mikrostreifenleitung **6880;**
- 7120: rechtes Leitungssensorelement **SE(7120)** auf der elektrisch leitenden rechten Signalleitung **6820** der differentiellen Signalleitung **6830** der differentiellen Mikrostreifenleitung **6880** der beispielhaften differenziellen Triplate-Leitung **6980** bzw. auf der elektrisch leitenden rechten Signalleitung **6820** der differentiellen Signalleitung **6830** der differentiellen Mikrostreifenleitung **6880;**
- 7140: Richtung des Vektors **7340** der magnetische Flussdichte **B_{µW}** des Mikrowellenfeldes des Mikrowellensignals **µW**,
a) das die Mikrowellensignalquelle **µWG** und/oder eine andere Signalquelle (**RWG**) in die linke Signalleitung **6810** der differentiellen Signalleitung **6830** der differentiellen Mikrowellenleitung **6880** einspeist, im Bereich des linken Sensorelements **SE(1410),** wenn es sich um eine differenzielle Mikrostreifenleitung **6880** handelt, bzw.
a) das die Mikrowellensignalquelle **µWG** und/oder eine andere Signalquelle (**RWG**) in die linke Signalleitung **6810** der differentiellen Signalleitung **6830** der differentiellen Mikrowellenleitung **6880** der differentiellen Tri-Plate-Leitung **6980** einspeist, im Bereich des linken Sensorelements **SE(1410),** wenn es sich um eine differentielle Tri-Plate-Leitung **6980** handelt;
- 7150: Richtung des Vektors **7350** der magnetische Flussdichte **B_{µW}** des Mikrowellenfeldes des Mikrowellensignals **µW**,
a) das die Mikrowellensignalquelle **µWG** und/oder eine andere Signalquelle (**RWG**) in die linke Signalleitung **6810** der differentiellen Signalleitung **6830** der differentiellen Mikrowellenleitung **6880** einspeist, im Bereich des linken Leitungssensorelements **SE(7110),** wenn es sich um eine differenzielle Mikrostreifenleitung **6880** handelt, bzw.
a) das die Mikrowellensignalquelle **µWG** und/oder eine andere Signalquelle **(RWG)** in die linke Signalleitung **6810** der differentiellen Signalleitung **6830** der differentiellen Mikrowellenleitung **6880** der differentiellen Tri-Plate-Leitung **6980** einspeist, im Bereich des linken Leitungssensorelements **SE(7110),** wenn es sich um eine differentiellen Tri-Plate-Leitung **6980** handelt;
- 7160: Richtung des Vektors **7360** der magnetische Flussdichte **B_{µW}** des Mikrowellenfeldes des Mikrowellensignals **µW**,
a) das die Mikrowellensignalquelle **µWG** und/oder eine andere Signalquelle **(RWG)** in die linke Signalleitung **6810** der differentiellen Signalleitung **6830** der differentiellen Mikrowellenleitung **6880** einspeist, im Bereich des mittleren Sensorelements **SE(1420),** wenn es sich um eine differenzielle Mikrostreifenleitung **6880** handelt, bzw.
a) das die Mikrowellensignalquelle **µWG** und/oder eine andere Signalquelle **(RWG)** in die linke Signalleitung **6810** der differentiellen Signalleitung **6830** der differentiellen Mikrowellenleitung **6880** der differentiellen Tri-Plate-Leitung **6980** einspeist, im Bereich des mittleren Leitungssensorelements **SE(1420),** wenn es sich um eine differentiellen Tri-Plate-Leitung **6980** handelt;
- 7170: Richtung des Vektors **7370** der magnetische Flussdichte **B_{µW}** des Mikrowellenfeldes des Mikrowellensignals **µW**,
a) das die Mikrowellensignalquelle **µWG** und/oder eine andere Signalquelle **(RWG)** in die rechte Signalleitung **6820** der differentiellen Signalleitung **6830** der differentiellen Mikrowellenleitung **6880** einspeist, im Bereich des mittleren Sensorelements **SE(1420),** wenn es sich um eine differenzielle Mikrostreifenleitung **6880** handelt, bzw.
a) das die Mikrowellensignalquelle **µWG** und/oder eine andere Signalquelle **(RWG)** in die rechte Signalleitung **6820** der differentiellen Signalleitung **6830** der differentiellen Mikrowellenleitung **6880** der differentiellen Tri-Plate-Leitung **6980** einspeist, im Bereich des mittleren Leitungssensorelements **SE(1420),** wenn es sich um eine differentiellen Tri-Plate-Leitung **6980** handelt;
- 7180: Richtung des Vektors **7380** der magnetische Flussdichte **B_{µW}** des Mikrowellenfeldes des Mikrowellensignals **µW**,
a) das die Mikrowellensignalquelle **µWG** und/oder eine andere Signalquelle **(RWG)** in die rechte Signalleitung **6820** der differentiellen Signalleitung **6830** der differentiellen Mikrowellenleitung **6880** einspeist, im Bereich des rechten Leitungssensorelements **SE(7120),** wenn es sich um eine differenzielle Mikrostreifenleitung **6880** handelt, bzw.
a) das die Mikrowellensignalquelle **µWG** und/oder eine andere Signalquelle **(RWG)** in die rechte Signalleitung **6820** der differentiellen Signalleitung **6830** der differentiellen Mikrowellenleitung **6880** der differentiellen Tri-Plate-Leitung **6980** einspeist, im Bereich des rechten Leitungssensorelements **SE(7120),** wenn es sich um eine differentiellen Tri-Plate-Leitung **6980** handelt;
- 7190: Richtung des Vektors **7390** der magnetische Flussdichte **B_{µW}** des Mikrowellenfeldes des Mikrowellensignals **µW**,
a) das die Mikrowellensignalquelle **µWG** und/oder eine andere Signalquelle **(RWG)** in die rechte Signalleitung **6820** der differentiellen Signalleitung **6830** der differentiellen Mikrowellenleitung **6880** einspeist, im Bereich des rechten Sensorelements **SE(1430),** wenn es sich um eine differenzielle Mikrostreifenleitung **6880** handelt, bzw.
a) das die Mikrowellensignalquelle **µWG** und/oder eine andere Signalquelle **(RWG)** in die rechte Signalleitung **6820** der differentiellen Signalleitung **6830** der differentiellen Mikrowellenleitung **6880** der differentiellen Tri-Plate-Leitung **6980** einspeist, im Bereich des rechten Sensorelements **SE(1430),** wenn es sich um eine differentielle Tri-Plate-Leitung **6980** handelt;
- 13320: vergrößertes mittleres Sensorelement **SE(13320).** Das vergrößerte mittlere Sensorelement **SE(13320)** entspricht einem mittleren Sensorelement **SE(1420),** das Eigenschaften der benachbarten Sensorelemente, beispielsweise des linken Leitungssensorelements **SE(7110)** und des rechten Leitungssensorelement **SE(7120),** mitaufweist. Das vergrößerte mittlere Sensorelement SE(13320)befindet sich im Wesentlichen auf der elektrisch leitenden Signalleitung **1330** der beispielhaften Triplate-Leitung **2380** bzw. in der Lücke **6840** zwischen der elektrisch leitenden linken Signalleitung **6810** der differenziellen Signalleitung **6830** der beispielhaften differenziellen Triplate-Leitung **6980** und der der elektrisch leitenden rechten Signalleitung **6820** der differenziellen Signalleitung **6830** der beispielhaften differenziellen Triplate-Leitung **6980** bzw. auf der elektrisch leitenden Signalleitung **1330** der beispielhaften Mikrostreifenleitung **1380** bzw. in der Lücke **6840** zwischen der elektrisch leitenden linken Signalleitung **6810** der differenziellen Signalleitung **6830** der beispielhaften differenziellen Mikrostreifenleitung **6880** und der der elektrisch leitenden rechten Signalleitung **6820** der differenziellen Signalleitung **6830** der beispielhaften differenziellen Mikrostreifenleitung **6880** bzw. im Schlitz **1840** der Schlitzleitung **1880;**
- 15710: erster Mikrowellen und/oder HF-Verbinder für den Anschluss der Wellenleitung **(1380, 1880, 2380, 6880, 6990)** an eine Mikrowellensignalquelle **µWG** oder eine HF-Signalquelle **RFG** oder an einen Mikrowellensignalanalysator **(µWAT, µWAR)** oder an einen HF-Signalanalysator **(RFAR, RFAT).**
- 15720: zweiter Mikrowellen und/oder HF-Verbinder für den Anschluss der Wellenleitung **(1380, 1880, 2380, 6880, 6990)** an eine Mikrowellensignalquelle **µWG** oder eine HF-Signalquelle **RFG** oder an einen Mikrowellensignalanalysator **(µWAT, µWAR)** oder an einen HF-Signalanalysator (**RFAR, RFAT**).
- 15730: Abdeckung **15730** des Trägersubstrats **1360** mit dem Wellenleiter **(1380, 1880, 2380, 6880, 6990)** und dem Sensorelement **SE** zum mechanischen und chemischen Schutz und ggf. zum EMV-Schutz.
- 15740: mit dem Sensorelement **SE** bedeckte Strecke **15740** des Welleneiters **(1380, 1880, 2380, 6880, 6990)**
- 20310: Bereitstellen **20310** eines optisch transparenten Trägersubstrat **1360,** wobei das optisch transparente Trägersubstrat **1360** zumindest eine optische transparente Kante aufweist und wobei das optisch transparente Trägersubstrat **1360** mit einem Wellenleiter mit zumindest einer Clearance, beispielsweise einer Schlitzleitung und/oder einer Tri-Plate-Leitung oder einer differenziellen Tri-Plate-Leitung, abgedeckt ist, sodass Licht im Wesentlichen nur durch die Clearance des Welleneiters auf der Oberfläche des optisch transparenten Trägersubstrats **1360** aus dem optisch transparenten Trägersubstrat **1360** austreten kann.
- 20320: Bereitstellen **20320** einer flüssigen kolloidalen Mischung **KL** mit einem flüssigen und mittels elektromagnetischer Strahlung, der Aushärtestrahlung **4910,** einer Aushärtewellenlänge λ_{H} härtbaren Trägermaterial **TM,** wobei in das Trägermaterial **TM** der kolloidalen Mischung **KL** eine Vielzahl von Kristallen und/oder Diamant-Nano-Kristallen **ND,** vorzugsweise Nanodiamanten, eingebettet sind und wobei einer oder mehrere oder alle Kristalle und/oder Diamant-Nano-Kristalle **ND** NV-Zentren und/oder andere paramagnetischen Zentren aufweisen und wobei die NV-Zentren der Kristalle und/oder Diamant-Nano-Kristalle **ND** der kolloidalen Mischung **KL** und/oder die anderen paramagnetischen Zentren der Kristalle und/oder Diamant-Nano-Kristalle **ND** der kolloidalen Mischung **KL** bei Bestrahlung mit Pumpstrahlung **LB** zumindest eine Fluoreszenzstrahlung **FL** emittieren;
- 20330: Beschichten **20330** der er Oberfläche des optisch transparenten Trägersubstrats **1360** und des Wellenleiters auf er Oberfläche des optisch transparenten Trägersubstrats **1360** zumindest auf eine Benetzungslänge L_{B} mit der kolloidalen Mischung **KL,** das die Vielzahl eingebetteter Kristalle und/oder Diamant-Nano-Kristalle **ND** mit NV-Zentren und/oder paramagnetischen Zentren aufweist;
- 20340: Einspeisen **20340** elektromagnetischer Aushärtestrahlung **4910** mit der Aushärtewellenlänge λ_{H} über die mindestens eine Kante des optisch transparenten Trägersubstrats **1360** in das optisch transparente Trägersubstrat **1360,**
- 20350: Austreten **20350** der Aushärtestrahlung **4910** im Bereich einer Clearance des Wellenleiters auf der Oberfläche des optisch transparenten Trägersubstrats **1360** aus dem des optisch transparenten Trägersubstrats **1360** und einstrahlen der Aushärtestrahlung **4910** in das Trägermaterial **TM** der kolloidalen Mischung **KL,** wobei die Aushärtewellenlänge λ_{H} der Aushärtestrahlung **4910** so gewählt ist, dass das Trägermaterial **TM** der kolloidalen Mischung **KL** im Bereich dieser Clearance des Wellenleiters auf der Oberfläche des optisch transparenten Trägersubstrats **1360** aushärtet und sich in einen Festkörper wandelt;
- 20360: Entfernen **20360** des nicht ausgehärteten Trägermaterials **TM** der kolloidalen Mischung **KL** insbesondere mittels eines Lösungsmittels **LM,** wobei der verbleibende Film der kolloidalen Mischung **KL** im Bereich dieser Clearance des Wellenleiters auf der Oberfläche des optisch transparenten Trägersubstrats **1360** ein Sensorelement **SE** und/oder eine Sensorschicht **16205** bildet;
- α: Winkel, den der Lichtwellenleiter **LWL** mit der Auflagefläche **AF** in unmittelbarer Nähe des Sensorelements SE bildet;
- β: Winkel zwischen der virtuellen Senkrechten **AFS** zur Auflagefläche **AF** des Sensorkopfes **SK** einerseits und dem Lichtwellenleiter **LWL** beim Austritt aus dem Sensorkopfgehäuse **GH** des Sensorkopfes **SK.** Bevorzugt beträgt der Winkel β 90°. Dies hat den Vorteil, dass ein solcher Winkel β das Drehmoment, das der Lichtwellenleiter **LWL** zusammen mit seiner mechanischen Hülle **MH** auf den Sensorkopf **SK** ausübt, minimiert, da der Lichtwellenleiter **LWL** dann in relativ geringer Entfernung vom Sensorkopf **SK** auf der Oberfläche des Werkstücks oder einer Oberfläche, auf der das Werkstück aufliegt zum Liegen kommt. Bevorzugt liegt der Wert von β zwischen 45° und 135°, besser zwischen 70° und 110°, besser zwischen 80° und 100°, besser zwischen 85° und 95°, besser zwischen 87° und 93°;
- AOX: Abdeckoxid **AOX;**
- AWV: Auswertungsvorrichtung **AWV;**
- AX: (erstes Anwendungsbeispiel) oder Permanentmagnetsymmetrieachse (zweites Anwendungsbeispiel);
- AF: Auflagefläche des Sensorkopfes **SK;**
- AFS: virtuelle Senkrechte zur Auflagefläche **AF** des Sensorkopfes **SK;**
- B: magnetische Flussdichte **B;**
- B₀: Nullpunktsflussdichte **B₀**;
- B₂₂: untere wirksame magnetische Flussdichte **B₂₂**;
- B₂₃: untere mittlere wirksame magnetische Flussdichte **B₂₃**;
- B₂₄: obere mittlere wirksame magnetische Flussdichte **B₂₄**;
- B₂₅: obere wirksame magnetische Flussdichte **B₂₅**;
- B₂₉: wirksame magnetische Resonanzminimum-Flussdichte **B₂₉**;
- B₆₁: magnetischen Flussdichte **B₆₁**, die der oberen Referenzlinie **61** zugeordnet ist;
- B₆₂: magnetischen Flussdichte **B₆₂**, die der unteren Referenzlinie **62** zugeordnet ist;
- B₆₃: magnetischen Flussdichte **B₆₃**, die der mittleren Referenzlinie **63** zugeordnet ist;
- dₗ: Dicke des Trägermaterials **TM** am Mittelpunkt **MP** der Endfläche **EF** am ersten Ende **ELWL1** des ersten gemeinsamen Lichtwellenleiters **LWL;**
- Bₑₓₜ: externe Flussdichte **Bₑₓₜ**. Die externe Flussdichte **Bₑₓₜ** umfasst den Anteil der externen Flussdichte **Bₑₓₜ**, deren Flussdichtevektor senkrecht zur magnetischen Flussdichtekomponente **B_{µW}** der Mikrowellenstrahlung des Mikrowellensignals **µW** ist, und den Anteil der externen Flussdichte **Bₑₓₜ**, deren Flussdichte Vektor parallel zur magnetischen Flussdichtekomponente **B_{µW}** der Mikrowellenstrahlung des Mikrowellensignals **µW** ist. Sofern der Anteil der externen Flussdichte **Bₑₓₜ**, deren Flussdichte Vektor senkrecht zur magnetischen Flussdichtekomponente **B_{µW}** der Mikrowellenstrahlung des Mikrowellensignals **µW** ist, unbekannt ist, ist der Anteil der externen
- B_{g}: Flussdichte **Bₑₓₜ**, deren Flussdichte Vektor senkrecht zur magnetischen Flussdichtekomponente **B_{µW}** der Mikrowellenstrahlung des Mikrowellensignals **µW** ist, gleich der unbekannte externe wirksame magnetische Flussdichte **Bₙₖ**; gemittelte mittlere wirksame Flussdichte **B_{g}**;
- B_{µW}: Flussdichtekomponente **B_{µW}** der Mikrowellenstrahlung des Mikrowellensignal **µW**;
- Bₙₖ: unbekannte externe wirksame magnetische Flussdichte **Bₙₖ**. Die unbekannte externe wirksame magnetische Flussdichte **Bₙₖ** ist der Anteil der unbekannten externen Flussdichte **Bₑₓₜ**, deren Flussdichtevektor senkrecht zur magnetischen Flussdichtekomponente **B_{µW}** der Mikrowellenstrahlung des Mikrowellensignals **µW** ist.
- **B_{off}**: wirksame Offsetflussdichte **B_{off}**;
- BSTR: magnetisches Streufeld des Luftspalts **LS** (erstes Anwendungsbeispiel) oder der magnetischen Flussdichte des Permanentmagneten **PM** (zweites Anwendungsbeispiel);
- B_{ref}: wirksame magnetische Referenzflussdichte **B_{ref}**;
- B_{Σ}: Gesamtflussdichte **B_{Σ}**, die das Sensorelement **SE** und die Nano-Diamanten **ND** durchflutet. Sie setzt sich zusammen aus der externen magnetischen Flussdichte **Bₑₜₓ** und der zusätzlichen magnetischen Flussdichte **B_{ad}**, die das Magnetfelderzeugungsmittel Lc erzeugt.
- CTR: Steuervorrichtung **CTR;**
- CTR2: weitere Steuervorrichtung **CTR2.** Die weitere Steuervorrichtung **CTR2** kann als Steuervorrichtung **CTR** der Vorrichtung dienen. (Siehe Figur 81.) Bevorzugt umfasst die Auswertevorrichtung **30** die Steuervorrichtung **CTR;**
- CTRH: Halbbrückensteuerung **CTRH.** Die Halbbrückensteuerung **CTRH** umfasst bevorzugt in der Regel eine Steuervorrichtung **CTR** und/oder eine weitere Steuervorrichtung **CTR2** im Sinne des hier vorgelegten Dokuments;
- DB: Datenbus **DB;**
- D_{LWL}: Durchmesser **D_{LWL}** des Lichtwellenleiters **LWL;**
- d_{I}: Dicke des Trägermaterials **TM** am Mittelpunkt **MP** der Endfläche **EF** am ersten Ende **ELWL1** des ersten und/oder der zweiten oder des gemeinsamen Lichtwellenleiters **LWL;**
- d_{IS1}: Breite **d_{IS1}** der nicht-leitenden linken Isolationslücke **2340** der Tri-Plate-Leitung **2380;**
- d_{IS2}: Breite **d_{IS2}** der nicht-leitenden rechten Isolationslücke **2350** der Tri-Plate-Leitung **2380;**
- Dr: Drain-Gebiet **Dr;**
- DrK: Drain-Kontakt **DrK;**
- DRVL: Treiberstufe **DRVL** zur Versorgung des Magnetfelderzeugungsmittels **Lc** mit elektrischer Energie und/oder zur Steuerung des Magnetfelderzeugungsmittels **L_{C}**. Sofern es sich bei dem Magnetfelderzeugungsmittels **L_{C}** um eine oder mehrere Spulen, insbesondere Flachspulen, handelt bestromt die Treiberstufe **DRVL** bevorzugt das des Magnetfelderzeugungsmittel Lc mit einem elektrischen Spulenstrom **I_{L}**. Ein Magnetfeldregler **LCTR** vergleicht Werte der magnetischen Flussdichte B mit einem Referenzwert und regelt die Versorgung des Magnetfelderzeugungsmittels **L_{C}** mit elektrischer Energie und/oder die Bestromung des Magnetfelderzeugungsmittel Lc mit einem elektrischen Spulenstrom **I_{L}** so nach, dass diese Änderung einer Differenz zwischen den Werten der magnetischen Flussdichte **B** und dem Referenzwert entgegenwirkt. Der Ein Magnetfeldregler **LCTR** erhält die Informationen über die Werte der magnetischen Flussdichte **B** entweder von separaten Magnetfeldsensoren und/oder von einer Steuervorrichtung **CTR** der vorschlagemäßen Vorrichtung;
- dₛ: Breite **dₛ** der elektrisch leitenden Signalleitung **1330**;
- d_{SE}: Durchmesser **d_{SE}** des Sensorelements **SE;**
- D_{SE}: Dicke **D_{SE}** des Sensorelements **SE** und/oder der Sensorelementschicht **14305;**
- d_{SL}: Breite **d_{SL}** des Schlitzes **1840** der Schlitzleitung **1880** bzw. der Lücke **6840** einer differenziellen Mikrostreifenleitung **6880** bzw. der Lücke **6840** einer differenziellen Tri-Plate-Leitung **6980;**
- dₚₘ: Abstand **dₚₘ** des unteren Endes des Permanentmagneten **PM** zur Auflagefläche **AF;**
- dᵣ: Dicke an anderen Punkten der Endfläche **EF** des ersten Endes **ELWL1** des ersten und/oder der zweiten oder des gemeinsamen Lichtwellenleiters **LWL;**
- d_{SK1}: Höhe des Sensorkopfes **SK;**
- d_{SK2}: Länge des Sensorkopfes **SK;**
- d_{SK3}: Breite des Sensorkopfes **SK;**
- d_{SK4}: Tiefe der Vertiefung **VT** des Sensorkopfes **SK;**
- D_{LWL}: Durchmesser des Lichtwellenleiters **LWL;**
- D_{LWLL}: Durchmesser der Lichtwellenleiterlinse **LWLL;**
- D_{LWLMH}: Durchmesser des ummantelten Lichtwellenleiters **LWL** umfassend den Durchmesser des Lichtwellenleiters **LWL** mit der mechanischen Hülle **MH;**
- DM: Diamanten **DM.** Die Diamanten haben vorzugsweise eine Größe kleiner 5mm, besser kleiner 2mm, besser kleiner 1mm, besser kleiner 0,5mm, besser kleiner 0,2mm, besser kleiner 0,1mm, besser kleiner 50µm, besser kleiner 20µm, besser kleiner 10µm, besser kleiner 5µm, besser kleiner 2mm, besser kleiner 1µm, besser kleiner 0,5µm, besser kleiner 0,2µm, besser kleiner 0,1µm, besser kleiner 50nm, besser kleiner 20nm, besser kleiner 10nm. Die Diamanten stehen hier auch für die anderen möglichen Kristalle mit paramagnetischen Zentren, die das Trägermaterial **TM** umfassen kann und die Fluoreszenzstrahlung **FL** bei Bestrahlung mit Pumpstrahlung **LB** abgeben;
- EF: Endfläche des ersten Endes **ELWL1** des ersten und/oder der zweiten oder des gemeinsamen Lichtwellenleiters **LWL;**
- ELWL1: erstes Ende des Lichtwellenleiters **LWL;**
- ELWL2: zweites Ende des Lichtwellenleiters **LWL;**
- EU: eine Umdrehung des Motors;
- EXTDB: externer Datenbus **EXTDB,** insbesondere zur Kommunikation einer Steuervorrichtung (**CTR**, **CTRH**, **CTR2**) mit einem übergeordneten Rechnersystem;
- F1: dichroitischer Spiegel **F1** oder optischer Filter **F1** zur Trennung der Fluoreszenzstrahlung **FL** von der Pumpstrahlung **LB** für das Sensorelement **SE.** Der dichroitische Spiegel / optischer Filter **F1** ist damit funktionsgleich zum optischen Filter (Longpass) **6.** Bei dem dichroitischer Spiegel **F1** oder dem optischer Filter **F1** kann es sich im Sinne des hier vorgelegten Dokuments auch einen vektoriellen dichroitischen Spiegel **F1** oder einen vektoriellen optischer Filter **F1** handeln, die eine Mehrzahl von dichroitischer Spiegelkomponenten oder eine Mehrzahl von optischen Filterkomponenten (**F1_1**, **F1_2, F1_3, F1_4, F1_5)** umfassen können;
- F1_1: dichroitischer Spiegel **F1_1** für das linke Sensorelement **SE**(**1410**) oder optischer Filter **F1** für das linke Sensorelement **SE**(**1410**) zur Abtrennung der Fluoreszenzstrahlung **FL_1** des linken Sensorelements **SE**(**1410**) von der Pumpstrahlung **LB_1** für das linke Sensorelement **SE**(**1410**);
- F1_2: dichroitischer Spiegel **F1_2** für das mittlere Sensorelement **SE**(**1420**) oder optischer Filter **F1** für das mittlere Sensorelement **SE**(**1420**) zur Abtrennung der Fluoreszenzstrahlung **FL_2** des mittleren Sensorelements **SE**(**1420**) von der Pumpstrahlung **LB_2** für das mittlere Sensorelement **SE**(**1420**);
- F1_3: dichroitischer Spiegel **F1_3** für das rechte Sensorelement **SE**(**1430**) oder optischer Filter **F1** für das rechte Sensorelement **SE**(**1430**) zur Abtrennung der Fluoreszenzstrahlung **FL_3** des rechten Sensorelements **SE**(**1430**) von der Pumpstrahlung **LB_3** für das rechte Sensorelement **SE**(**1430**);
- F1_4: dichroitischer Spiegel **F1_4** für das linke Leitungssensorelement **SE**(**7110**) oder optischer Filter **F1** für das linke Leitungssensorelement **SE**(**7110**)zur Abtrennung der Fluoreszenzstrahlung **FL_4** des linken Leitungssensorelements **SE**(**7110**) von der Pumpstrahlung **LB_4** für das linke Leitungssensorelement **SE**(**7110**);
- F1_5: dichroitischer Spiegel **F1_5** für das rechte Leitungssensorelement **SE**(**7120**) oder optischer Filter **F1** für das rechte Leitungssensorelement **SE**(**7120**) zur Abtrennung der Fluoreszenzstrahlung **FL_5** des rechten Leitungssensorelements **SE**(**7120**) von der Pumpstrahlung **LB_5** für das rechte
- f_{fµW}: Mikrowellenfrequenzmodulationsfrequenz **f_{fµW}**;
- FL: Fluoreszenzstrahlung **FL** der NV-Zentren und/oder paramagnetischen Zentren innerhalb des Sensorelements **SE.** Das hier vorgelegte Dokument bezeichnet die Fluoreszenzstrahlung **FL** auch mit dem Bezugszeichen **14**. Bei der Fluoreszenzstrahlung **FL** kann es sich im Sinne des hier vorgelegten Dokuments auch eine vektorielle Fluoreszenzstrahlung FL handeln, die eine Mehrzahl von Fluoreszenzstrahlungskomponenten (**FL_1**, **FL_2**, **FL_3**, **FL_4**, **FL_5**) umfassen kann;
- FL_1: Fluoreszenzstrahlung **FL_1** der NV-Zentren und/oder paramagnetischen Zentren innerhalb des linken Sensorelements **SE**(**1410**);
- FL_2: Fluoreszenzstrahlung **FL_2** der NV-Zentren und/oder paramagnetischen Zentren innerhalb des mittleren Sensorelements **SE**(**1420**);
- FL_3: Fluoreszenzstrahlung **FL_3** der NV-Zentren und/oder paramagnetischen Zentren innerhalb des rechten Sensorelements **SE**(**1430**);
- FL_4: Fluoreszenzstrahlung **FL_4** der NV-Zentren und/oder paramagnetischen Zentren innerhalb des linken Leitungssensorelements **SE**(**7110**);
- FL_5: Fluoreszenzstrahlung **FL_5** der NV-Zentren und/oder paramagnetischen Zentren innerhalb des rechten Leitungssensorelements **SE**(**7120**);
- f_{LED}: LED -Modulationsfrequenz **f_{LED}** des LED-Modulationssignals **S5w** des Sendesignals **S5** für das Sensorelement **SE** zur Modulation der Lichtquelle **LED** für das Sensorelement **SE;**
- f_{LED_1}: LED -Modulationsfrequenz **f_{LED_1}** des LED-Modulationssignals **S5w_1** des Sendesignals **S5_1** für das linke Sensorelement **SE**(**1410**) zur Modulation der Lichtquelle **LED_1** für das linke Sensorelement **SE**(**1410**);
- f_{LED_2}: LED -Modulationsfrequenz **f_{LED_2}** des LED-Modulationssignals **S5w_2** des Sendesignals **S5_2** für das mittlere Sensorelement **SE**(**1420**) zur Modulation der Lichtquelle **LED_2** für das mittlere Sensorelement **SE**(**1420**);
- f_{LED_3}: LED -Modulationsfrequenz **f_{LED_3}** des LED-Modulationssignals **S5w_3** des Sendesignals **S5_3** für das rechte Sensorelement **SE**(**1430**) zur Modulation der Lichtquelle **LED_3** für das rechte Sensorelement **SE**(**1430**);
- f_{LED_4}: LED -Modulationsfrequenz **f_{LED_4}** des LED-Modulationssignals **S5w_4** des Sendesignals **S5_4** für das linke Leitungssensorelement **SE**(**7110**) zur Modulation der Lichtquelle **LED_5** für das linke Leitungssensorelement **SE**(**71100**);
- f_{LED_5}: LED -Modulationsfrequenz **f_{LED_5}** des LED-Modulationssignals **S5w_5** des Sendesignals **S5_5** für das rechte Leitungssensorelement **SE**(**7120**) zur Modulation der Lichtquelle **LED_5** für das rechte Leitungssensorelement **SE**(**7120**);
- FM: optisch intransparenten Füllmasse
- f_{mg}: Magnetfeldmodulationsfrequenz **f_{mg}**;
- f_{µW}: Mikrowellenmodulationsfrequenz **f_{µW};**
- FMM: ferromagnetisches Material;
- FOX: Feld-Oxid **FOX;**
- f_{RWm}: Radiowellenmodulationsfrequenz **f_{RWm};**
- FS2: zweiten Fangstruktur **FS2;**
- G: Signalgenerator **G;**
- G1: erster Signalgenerator **G1.** Bei dem ersten Signalgenerator **G1** kann es sich im Sinne des hier vorgelegten Dokuments auch um einen vektoriellen ersten Signalgenerator **G1** handeln, der eine Mehrzahl von ersten Signalgeneratorkomponenten (**G1_1**, **G1_2**, **G1_3**, **G1_4**, **G1_5**) umfassen kann;
- G1_1: erster Signalgenerator **G1** für das linke Sensorelement **SE**(**1410**);
- G1_2: erster Signalgenerator **G1** für das mittlere Sensorelement **SE**(**1420**);
- G1_3: erster Signalgenerator **G1** für das rechte Sensorelement **SE**(**1430**);
- G1_4: erster Signalgenerator **G1** für das rechte Leitungssensorelement **SE**(**7110**);
- G1_5: erster Signalgenerator **G1** für das rechte Leitungssensorelement **SE**(**7120**);
- G2: zweiter Signalgenerator **G2;**
- G2_I: erster zweiter Signalgenerator **G2_I** zur Erzeugung des ersten Mikrowellenmodulationssignals **S5m_I;**
- G2_II: zweiter zweiter Signalgenerator **G2_II** zur Erzeugung des zweiten Mikrowellenmodulationssignals **S5m_II;**
- G2_III: dritter zweiter Signalgenerator **G2_III** zur Erzeugung des dritten Mikrowellenmodulationssignals **55m_III;**
- G2_IV: vierter zweiter Signalgenerator **G2_IV** zur Erzeugung des vierten Mikrowellenmodulationssignals **S5m_IV;**
- GA: Gate **GA;**
- GH: Gehäuse, insbesondere des Stators des Motors im zweiten Ausführungsbeispiel eines Motors;
- GHR: Rotorgehäuse;
- GH: Sensorkopfgehäuse **GH.** Das Sensorkopfgehäuse **GH** des Sensorkopfes **SK** kann beispielsweise mittels 3D-Druck, beispielsweise mittels FDM oder SLS-Druck hergestellt werden. Bevorzugt ist das Material des Sensorkopfgehäuses zumindest in der Nähe des Sensorelements **SE** nicht ferromagnetisch (µₜ<1). Bevorzugt ist das Material des Sensorkopfgehäuses diamagnetisch;
- GND: Bezugspotenzial;
- GOX: Gate-Oxid **GOX;**
- H: magnetische Erregung;
- HB: Halbbrücken **HB;**
- HSL: Halbbrückensteuerleitungen **HSL;**
- I_{MPHU}: Motorphasenstrom der U-Motorphase **MPH_{U};**
- I_{MPHV}: Motorphasenstrom der V-Motorphase **MPH_{V};**
- I_{MPHW}: Motorphasenstrom der W-Motorphase **MPH_{W}**;
- JTAG: IEEE 1149 JATG-Test-Controller **JTAG;**
- KI: Knick im Kanal **KN** des Sensorkopfgehäuses **GH;**
- KL: kolloidaler Lack **KL.** Der kolloidale Lack **KL** umfasst bevorzugt das Trägermaterial **TM,** beispielsweise den UV-härtbaren NOA 61 Kleber und die Kristalle und/oder Diamant-Nano-Kristalle **ND.** Ggf. kann der kolloidale Lack **KL** zum Zeitpunkt der Verarbeitung ein Lösungsmittel **LM** zur Einstellung der Viskosität für den Belackungs- und/oder Druck- und/oder Dispensiervorgang umfassen;
- KN: Kanal KN, durch den der Lichtwellenleiter **LWL** in das Sensorkopfgehäuse **GH** eingeführt ist;
- L_{B}: Benetzungslänge;
- LB: Pumpstrahlung **LB.** Das hier vorgelegte Dokument bezeichnet die Pumpstrahlung **LB** auch mit dem Bezugszeichen **13.** Bei der Pumpstrahlung **LB (13)** kann es sich im Sinne des hier vorgelegten Dokuments auch eine vektorielle Pumpstrahlung **LB** handeln, die eine Mehrzahl von Pumpstrahlungskomponenten **(LB_1, LB_2, LB_3, LB_4, LB_5)** umfassen kann;
- LB_1: Pumpstrahlung **LB_1** der Lichtquelle **LED_1** (Pumpstrahlungsquelle) für das linke Sensorelement **SE(1410);**
- LB_2: Pumpstrahlung **LB_2** der Lichtquelle **LED_2** (Pumpstrahlungsquelle) für das mittlere Sensorelement **SE(1420);**
- LB_3: Pumpstrahlung **LB_3** der Lichtquelle **LED_3** (Pumpstrahlungsquelle) für das rechte Sensorelement **SE(1430);**
- LB_4: Pumpstrahlung **LB_4** der Lichtquelle **LED_4** (Pumpstrahlungsquelle) für das linke Leitungssensorelement **SE(7110);**
- LB_5: Pumpstrahlung **LB_5** der Lichtquelle **LED_5** für das rechte Leitungssensorelement **SE(7120);**
- Leitungssensorelement: **SE(7120);**
- L_{C}: Magnetfelderzeugungsmittel **L_{C}.** Das Magnetfelderzeugungsmittel **L_{C}.** kann beispielsweise eine elektrische Spule, insbesondere eine elektrische Flachspule auf der Rückseite des Schaltungsträgers **1360 (PCB),** sein. Bevorzugt versorgt eine Treiberstufe **DRVL** zur Versorgung des Magnetfelderzeugungsmittels **L_{C}** das Magnetfelderzeugungsmittel **L_{C}** mit elektrischer Energie. Im Falle einer Spule als Magnetfelderzeugungsmittel **L_{C}** bestromt Treiberstufe **DRVL** zur Versorgung des Magnetfelderzeugungsmittels **L_{C}** das Magnetfelderzeugungsmittel **L_{C}** mit einem elektrischen Strom. Das Magnetfelderzeugungsmittel **L_{C}** kann im Sinne des hier vorgelegten Dokuments auch einen Permanentmagneten **PM** mit einer Positionierungsvorrichtung **PV** umfassen, wobei dann die Treiberstufe **DRVL** vorzugsweise die Positioniervorrichtung **PV** des Permanentmagneten **PM** steuert. Je nach Positionierung des Permanentmagneten **PM** relativ zum Sensorelement **SE** durchflutet eine andere wirksame magnetische Flussdichte **B_{w}** das Sensorelement **SE.** Bevorzugt steuert der Magnetfeldregler **LCTR** die Treiberstufe **DRVL.** Bei dem Magnetfelderzeugungsmittel **L_{C}** kann es sich im Sinne des hier vorgelegten Dokuments auch im ein vektorielles Magnetfelderzeugungsmittel **L_{C}** handeln, das eine Mehrzahl von Magnetfelderzeugungsmittelkomponenten **(L_{C}_1, L_{C}_2, L_{C_}3, L_{C} _4, L_{C}_5)** umfassen kann;
- L_{c}_1: erstes Magnetfelderzeugungsmittel **L_{C}_1** für das erste Sensorelement **SE** des ersten Sensorelementkanals. In dem Beispiel der Figur 141 ist das erste Magnetfelderzeugungsmittel **L_{C}_1** Teil des Magnetfelderzeugungsmittels **L_{C}.** Das hier vorgelegte Dokument verweist an dieser Stelle auf die Beschreibung des Magnetfelderzeugungsmittels **L_{C}.**
- L_{c}_2: zweites Magnetfelderzeugungsmittel **L_{C}_2** für das zweite Sensorelement **SE** des zweiten Sensorelementkanals. In dem Beispiel der Figur 141 ist das zweite Magnetfelderzeugungsmittel **L_{C}_2** Teil des Magnetfelderzeugungsmittels **L_{C}.** Das hier vorgelegte Dokument verweist an dieser Stelle auf die Beschreibung des Magnetfelderzeugungsmittels **L_{C}.**
- L_{c}_3: drittes Magnetfelderzeugungsmittel **L_{C}_3** für das dritte Sensorelement **SE** des dritten Sensorelementkanals. In dem Beispiel der Figur 141 ist das dritte Magnetfelderzeugungsmittel **L_{C}_3** Teil des Magnetfelderzeugungsmittels **L_{C}.** Das hier vorgelegte Dokument verweist an dieser Stelle auf die Beschreibung des Magnetfelderzeugungsmittels Lc.
- L_{c}_4: viertes Magnetfelderzeugungsmittel **L_{C}_4** für das vierte Sensorelement **SE** des vierten Sensorelementkanals. In dem Beispiel der Figur 141 ist das vierte Magnetfelderzeugungsmittel **L_{C}_4** Teil des Magnetfelderzeugungsmittels **L_{C}.** Das hier vorgelegte Dokument verweist an dieser Stelle auf die Beschreibung des Magnetfelderzeugungsmittels **L_{C}.**
- L_{c}_5: fünftes Magnetfelderzeugungsmittel **L_{C}_5** für das fünfte Sensorelement **SE** des fünftem Sensorelementkanals. In dem Beispiel der Figur 141 ist das fünfte Magnetfelderzeugungsmittel **L_{C}_5** Teil des Magnetfelderzeugungsmittels **L_{C}.** Das hier vorgelegte Dokument verweist an dieser Stelle auf die Beschreibung des Magnetfelderzeugungsmittels **L_{C}.**
- LCTR: Magnetfeldregler **LCTR.** Der Magnetfeldregler **LCTR** vergleicht vorzugsweise Werte der magnetischen Flussdichte B mit einem Referenzwert und regelt die Versorgung des Magnetfelderzeugungsmittels **L_{C}** mit elektrischer Energie und/oder die Bestromung des Magnetfelderzeugungsmittel **L_{C}** mit einem elektrischen Spulenstrom **I_{L}** so nach, dass diese Änderung einer Differenz zwischen den Werten der magnetischen Flussdichte **B** und dem Referenzwert entgegenwirkt. Der Magnetfeldregler **LCTR** erhält die Informationen über die Werte der magnetischen Flussdichte **B** entweder von separaten Magnetfeldsensoren und/oder von einer Steuervorrichtung **CTR** der vorschlagemäßen Vorrichtung. Der Ein Magnetfeldregler **LCTR** kann beispielsweise in P-Regler und/oder ein PI-Regler und/oder ein PID-Regler oder dergleichen sein, wobei der Regler vorzugsweise in seiner Regelcharakteristik zumindest eine integrierende Eigenschaft aufweist. Der Magnetfeldregler **LCTR** erhält den Referenzwert vorzugsweise von einer Steuervorrichtung **CTR** der vorschlagemäßen Vorrichtung oder durch konstruktive Maßnahmen oder dergleichen. Die Steuervorrichtung **CTR** kann ggf. den Magnetfeldregler **LCTR** emulieren;
- LDRV: Lichtquellentreiber **LDRV** für die Lichtquelle **LED** (Pumpstrahlungsquelle). Bei dem Lichtquellentreiber **LDRV** für die Lichtquelle **LED** (Pumpstrahlungsquelle) kann es sich im Sinne des hier vorgelegten Dokuments auch um einen vektoriellen Lichtquellentreiber **LDRV** für eine vektorielle Lichtquelle **LED** (Pumpstrahlungsquelle) handeln, der eine Mehrzahl von Lichtquellentreiberkomponenten **(LDRV_1, LDRV_2, LDRV_3, LDRV_4, LDRV_5)** umfassen kann;
- LDRV_1: Lichtquellentreiber **LDRV_1** für die Lichtquelle **LED_1** (Pumpstrahlungsquelle) für die Pumpstrahlung **LB_1** für das linke Sensorelement **SE(1410);**
- LDRV_2: Lichtquellentreiber **LDRV_2** für die Lichtquelle **LED_2** (Pumpstrahlungsquelle) für die Pumpstrahlung **LB_2** für das mittlere Sensorelement **SE(1420);**
- LDRV_3: Lichtquellentreiber **LDRV_3** für die Lichtquelle **LED_3** (Pumpstrahlungsquelle) für die Pumpstrahlung **LB_3** für das rechte Sensorelement **SE(1430);**
- LDRV_4: Lichtquellentreiber **LDRV_4** für die Lichtquelle **LED_4** (Pumpstrahlungsquelle) für die Pumpstrahlung **LB_4** für das linke Leitungssensorelement **SE(7110);**
- LDRV_5: Lichtquellentreiber **LDRV_5** für die Lichtquelle **LED_5** (Pumpstrahlungsquelle) für die Pumpstrahlung **LB_5** für das rechte Leitungssensorelement **SE(7120);**
- LED: Lichtquelle **LED** (Pumpstrahlungsquelle). Bei der Lichtquelle **LED** (Pumpstrahlungsquelle) kann es sich im Sinne des hier vorgelegten Dokuments auch eine vektorielle Lichtquelle **LED** (Pumpstrahlungsquelle) handeln, der eine Mehrzahl von Lichtquellenkomponenten **(LED_1, LED_2, LED_3, LED_4, LED_5)** umfassen kann;
- LED_1: Lichtquelle **LED_1** (Pumpstrahlungsquelle) für das linke Sensorelement **SE(1410);**
- LED_2: Lichtquelle **LED_2** (Pumpstrahlungsquelle) für das mittlere Sensorelement **SE(1420);**
- LED_3: Lichtquelle **LED_3** (Pumpstrahlungsquelle) für das rechte Sensorelement **SE(1430);**
- LED_4: Lichtquelle **LED_4** (Pumpstrahlungsquelle) für das linke Leitungssensorelement **SE(7110);**
- LED_5: Lichtquelle **LED_5** (Pumpstrahlungsquelle) für das rechte Leitungssensorelement **SE(7120);**
- λ_{B}: Belichtungswellenlänge **λ_{B};**
- λ_{fl}: Fluoreszenzstrahlungswellenlänge **λ_{fl};**
- λ_{H}: Aushärtewellenlänge **λ_{H};**
- λₚₘₚ: Pumpstrahlungswellenlänge **λₚₘₚ;**
- LIV: Mehrfachkorrelator **LIV.** Bei dem Mehrfachkorrelator **LIV** handelt es sich bevorzugt um einen Lock-In-Verstärker oder eine funktionsäquivalente Vorrichtung beispielsweise zur Abschätzung des Anteils eines vorbestimmten Sendesignals in einem Empfangssignal. Bei dem Mehrfachkorrelator **LIV** kann es sich im Sinne des hier vorgelegten Dokuments auch im einen vektoriellen Mehrfachkorrelator **LIV** handeln, der eine Mehrzahl von Mehrfachkorrelatorkomponenten **(LIV_1, LIV_2, LIV _3, LIV_4, LIV_5)** umfassen kann;
- LIV_1: Mehrfachkorrelator **LIV_1** für das linke Sensorelement **SE(1410);**
- LIV_2: Mehrfachkorrelator **LIV_2** für das mittlere Sensorelement **SE(1420);**
- LIV_3: Mehrfachkorrelator **LIV_3** für das rechte Sensorelement **SE(1430);**
- LIV_4: Mehrfachkorrelator **LIV_4** für das linke Leitungssensorelement **SE(7110);**
- LIV_5: Mehrfachkorrelator **LIV_5** für das rechte Leitungssensorelement **SE(7120);**
- LS: Luftspalt;
- LST: Wert des fluoreszenzintensitätsbasierenden Filterausgangssignals **S4** (in willkürlichen Einheiten);
- LWL: Lichtwellenleiter **LWL.** Beispielsweise kann es sich kann es sich um eine Glasfaser oder eine Glasplatte **46** oder eine optische Übertragungsstrecke handeln. Bei dem Lichtwellenleiter **LWL** kann es sich im Sinne des hier vorgelegten Dokuments auch einen vektoriellen Lichtwellenleiter **LWL** (z.B. ein Lichtwellenleiterbündel oder eine Zusammenstellung von Lichtwellenleitern **LWL)** handeln, die eine Mehrzahl von Lichtwellenleiterkomponenten **(LWL_1, LWL_2, LWL_3, LWL_4, LWL_5)** umfassen kann;
- LWL1: erster Lichtwellenleiter **LWL1;**
- LWL2: zweiter Lichtwellenleiter **LWL2;**
- LWLC: Kern (Englisch Core) des Lichtwellenleiters LWL;
- LWLL: Lichtwellenleiterlinse;
- λ_{fl}: Fluoreszenzwellenlänge **λ_{fl};**
- λ_{H}: Aushärtewellenlänge **λ_{H};**
- λₚₘₚ: Pumpstrahlungswellenlänge **λₚₘₚ;**
- M1: erster Multiplizierer **M1** bzw. einfach nur Multiplizierer;
- M2: zweiter Multiplizierer **M2;**
- M2L: zweite Metalllage **M2L;**
- MDS: Musterdatensatz **MDS.** Bevorzugt umfasst dieser Musterdatensatz **MDS** den Datensatz eines erkannten Musters und oder eine Merkmalsvektor für eine Mustererkennung die die Steuervorrichtung **CTR** mit Hilfe eines computerimplementierten Programms zur Mustererkennung oder dergleichen durchführt. Typischerweise handelt es sich um den Wert der erkannten Gesamtflussdichte **B_{Σ}.** Typischerweise umfasst dieser Datensatz auch den Messfehlerwert, mit dem dieser Wert der erkannten Gesamtflussdichte **B_{Σ}** behaftet ist;
- ME: optionale mechanische Hülle **ME** und/oder optische Abschirmung **ME;**
- ME_1: optionale mechanische Hülle **ME_1** und/oder optische Abschirmung **ME_1** für das linke Sensorelement **SE(1410);**
- ME_2: optionale mechanische Hülle **ME_2** und/oder optische Abschirmung **ME_2** für das mittlere Sensorelement **SE(1420);**
- ME_3: optionale mechanische Hülle **ME_3** und/oder optische Abschirmung **ME_3** für das rechte Sensorelement **SE(1430);**
- MESA: MESA-Struktur **MESA;**
- MEV: Mustererkennungsvorrichtung **MEV;**
- MH: mechanische Hülle;
- MIX: Mischer **MIX;**
- ML: Mittellinie des Lichtwellenleiters **LWL** (Es handelt sich um eine virtuelle Linie);
- MP: Mittelpunkt der Endfläche **EF** des ersten Endes **ELWL1** des Lichtwellenleiters **LWL;**
- MPH: Motorphasen;
- MPH_{U}: U-Motorphase;
- MPH_{V}: V-Motorphase;
- MPH_{W}: W-Motorphase;
- MRK: Markierung auf dem Rotorgehäuse GHR;
- MS: Magnetfeldsensor **MS;**
- µW: Mikrowellensignal **µW;**
- µW_I: erstes Mikrowellensignal **µW_I;**
- µW_II: zweites Mikrowellensignal **µW_II**;
- µW_III: drittes Mikrowellensignal **µW_III;**
- µW_IV: viertes Mikrowellensignal **µW_IV**;
- µWG_F_I: erstes Mikrowellenfilter **µWG_F_I;**
- µWG_F_II: erstes Mikrowellenfilter **µWG_F_II;**
- µWG_F_III: erstes Mikrowellenfilter **µWG_F_III;**
- µWG_F_IV: erstes Mikrowellenfilter **µWG_F_IV;**
- µW_G_I: erstes internes Mikrowellensignal **µW_G_I;**
- µW_G_II: zweites internes Mikrowellensignal **µW_G_II;**
- µW_G_III: drittes internes Mikrowellensignal **µW_G_III;**
- µW_G_IV: viertes internes Mikrowellensignal **µW_G_IV;**
- µW_MX_I: erstes Mikrowellenmischsignal **µW_MX_I;**
- µW_MX_II: zweites Mikrowellenmischsignal **µW_MX_II;**
- µW_MX_III: drittes Mikrowellenmischsignal **µW_MX_III;**
- µW_MX_IV: viertes Mikrowellenmischsignal **µW_MX_IV;**
- µWAR: Transmissions-Mikrowellensignalanalysator **µWAR** für die Erfassung des durch die mit dem Sensorelement **SE** bedeckte Strecke **15740** des Welleneiters **(1380, 1880, 2380, 6880, 6990)** durch Wechselwirkung mit dem Trägermaterial **TM** des Sensorelements **SE** und durch die Wechselwirkung mit den NV-Zentren **NVZ** und/oder paramagnetischen Zentren der Kristalle und/oder Diamanten **DM** innerhalb des Trägermaterials **TM** des Sensorelements **SE** deformierten und reflektierten Mikrowellensignals **µWR** des Mikrowellensignals **µW**.
- µWAT: Reflektions-Mikrowellensignalanalysator **µWAT** für die Erfassung des durch die mit dem Sensorelement **SE** bedeckte Strecke **15740** des Welleneiters **(1380, 1880, 2380, 6880, 6990)** durch Wechselwirkung mit dem Trägermaterial **TM** des Sensorelements **SE** und durch die Wechselwirkung mit den NV-Zentren **NVZ** und/oder paramagnetischen Zentren der Kristalle und/oder Diamanten **DM** innerhalb des Trägermaterials **TM** des Sensorelements **SE** deformierten und transmittierten Mikrowellensignals **µWT** des Mikrowellensignals **µW.**
- µWC: Mikrowellen-Richtkoppler zum Einspeisen des Mikrowellensignals **µW** in den Wellenleiter **(1380, 1880, 2380, 6880, 6990)** und zum Auskoppeln des reflektierten Mikrowellensignals **µWR** für die Analyse durch den den Reflexions-Mikrowellenanalysator **µWAR.**
- µWG: Mikrowellensignalquelle **µWG;**
- µWG_I: erste Mikrowellensignalquelle **µWG_I**;
- µWG_II: zweite Mikrowellensignalquelle **µWG_II;**
- µWG_III: dritte Mikrowellensignalquelle **µWG_III;**
- µWG_IV: vierte Mikrowellensignalquelle **µWG_IV;**
- µWG_MX_I: erster interner Mixer **µW_G_I**;
- µWG_MX_II: zweiter interner Mixer **µW_G_II;**
- µWG_MX_III: dritter interner Mixer **µW_G_III;**
- µWG_MX_IV: vierter interner Mixer **µW_G_IV;**
- µWR: reflektiertes Mikrowellensignal **µWR** des Mikrowellensignals **µW**, das durch Wechselwirkung mit dem Trägermaterial **TM** des Sensorelements **SE** und durch die Wechselwirkung mit den NV-Zentren **NVZ** und/oder paramagnetischen Zentren der Kristalle und/oder Diamanten **DM** innerhalb des Trägermaterials **TM** des Sensorelements **SE** in der mit dem Sensorelement **SE** bedeckte Strecke **15740** des Welleneiters **(1380, 1880, 2380, 6880, 6990)** deformiert und reflektiert wird;
- µWT: transmittiertes Mikrowellensignal **µWT** des Mikrowellensignals **µW**, das durch Wechselwirkung mit dem Trägermaterial **TM** des Sensorelements **SE** und durch die Wechselwirkung mit den NV-Zentren **NVZ** und/oder paramagnetischen Zentren der Kristalle und/oder Diamanten **DM** innerhalb des Trägermaterials **TM** des Sensorelements **SE** in der mit dem Sensorelement **SE** bedeckte Strecke **15740** des Welleneiters **(1380, 1880, 2380, 6880, 6990)** deformiert und durch diese hindurch transmittiert wird;
- ND: Diamant-Nano-Kristalle **ND.** Das hier vorgelegte Dokument bezeichnet mit dem Bezugszeichen **ND** nicht nur Diamanten **DM,** sondern ganz allgemein Kristalle, die paramagnetische Zentren aufweise können. Gleichwohl sind Diamantkristalle **DM** als Diamant-Nano-Kristalle **ND** bevorzugt. Als paramagnetische Zentren sind NV-Zentren in Diamant bevorzugt. Die kleinen stochastisch gleichverteilten Diamant-Nano-Kristalle **ND** im Material des Trägermaterials **TM** der kolloidalen Mischung **KL** sind in einigen Figuren zur Verdeutlichung angedeutet. Bevorzugt sind die Diamant-Nano-Kristalle **ND** Kristalle, vorzugsweise Diamantkristalle, mit einer Größe kleiner 10µm, besser kleiner 5µm, besser kleiner 2µm, besser kleiner 1µm, besser kleiner 0,5µm, besser kleiner 0,2µm, besser, kleiner 0,1µm, kleiner 50nm, kleiner 20nm, , kleiner 10nm. Besonders bevorzugt sind Größen über 100nm, da Größen kleiner 100nm spezielle Oberflächeneffekte zwischen den paramagnetischen Zentren, insbesondere NV-Zentren und der jeweiligen Kristalloberfläche des betreffenden Diamant-Nano-Kristalls **ND** bzw. Kristalls hervorrufen können. Bevorzugt umfassen eine Vielzahl dieser Diamant-Nano-Kristalle **ND** bzw. Kristalle ein oder mehrere NV-Zentren in Diamant, die dann die Fluoreszenzstrahlung **FL** bei Bestrahlung mit Pumpstrahlung **LB** erzeugen.;
- NVM: nicht flüchtiger Speicher **NVM;**
- NVZ: NV-Zentren;
- NW: N-Wanne **NW;**
- OF: Öffnung
- KE: Kern;
- KN: Kanal im Gehäuse GH bzw. Sensorkopfgehäuse **GH** für die Zuführung des Lichtwellenleiters **LWL** und/oder optisches Fenster im Gehäuse bzw. Sensorkopfgehäuse **GH;**
- OE: Öffnung für den Lichtwellenleiter **LWL** in der ferromagnetischen Stütze **ST** des zweiten Anwendungsbeispiels;
- OF: Oberfläche des Werkstücks, beispielsweise die Oberfläche eines ferromagnetischen Materials **FMM,** des ersten Anwendungsbeispiels;
- OFF1: Offset-Addition;
- oMS1: erste obere Metallblende **oMS1** des ersten Lichtwellenleiters **LWL1** nach oben zur Oberfläche des Trägersubstrats **1360.** Es handelt sich um eine optische Abschirmung **ME;**
- oMS2: zweite obere Metallblende **oMS2** des zweiten Lichtwellenleiters **LWL2** nach oben zur Oberfläche des Trägersubstrats **1360.** Es handelt sich um eine optische Abschirmung **ME;**
- ω_{µw}: Mikrowellenfrequenz ω_{µW};
- ω_{µW0}: Nullpunktsmikrowellenfrequenz ω_{µW0};
- ω_{µW22}: untere Mikrowellenfrequenz ω_{µW22};
- ω_{µW23}: untere mittlere Mikrowellenfrequenz ω_{µW23};
- ω_{µW24}: obere mittlere Mikrowellenfrequenz ω_{µW24};
- ω_{µW25}: obere Mikrowellenfrequenz ω_{µW25};
- ω_{µW29}: Resonanzminimum-Mikrowellenfrequenz ω_{µW29};
- ω_{µWnk}: unbekannte Mikrowellenfrequenz ω_{µWnk};
- φ_{MPHU}: Stromwinkel deskomplexen Stromvektors des Motorphasenstroms **I_{MPHU}** der Motorphase **MPH_{U};**
- φ_{MPHV}: Stromwinkel deskomplexen Stromvektors des Motorphasenstroms **I_{MPHV}** der Motorphase **MPH_{V};**
- φ_{MPHW}: Stromwinkel deskomplexen Stromvektors des Motorphasenstroms **I_{MPHW}** der Motorphase **MPH_{W};**
- PD: Fotodetektor **PD.** Bei dem Fotodetektor **PD** kann es sich im Sinne des hier vorgelegten Dokuments auch im einen vektoriellen Fotodetektor **PD** handeln, der eine Mehrzahl von Fotodetektorkomponenten **(PD_1, PD_2, PD_3, PD_4, PD_5)** umfassen kann;
- PD_1: Fotodetektor **PD_1** für das linke Sensorelement **SE(1410);**
- PD_2: Fotodetektor **PD_2** für das mittlere Sensorelement **SE(1420);**
- PD_3: Fotodetektor **PD_3** für das rechte Sensorelement **SE(1430);**
- PD_4: Fotodetektor **PD_4** für das linke Leitungssensorelement **SE(7110);**
- PD_5: Fotodetektor **PD_5** für das rechte Leitungssensorelement **SE(7120);**
- PL: Pumpstrahlungsquelle **PL,** auch mit dem Bezugszeichen **2** als Lichtquelle **2** bezeichnet;
- PM: Permanentmagnet **PM.** Bevorzugt ist in dem ersten Anwendungsbeispiel des Sensorkopfes **SK** der Permanentmagnet **PM** röhrenförmig mit einer Permanentmagnetsymmetrieachse **AX** ausgeführt. Sofern in diesem ersten Anwendungsbeispiel das Sensorelement **SE** sich auf dieser Symmetrieachse **AX** befindet, ist die horizontale Komponente der magnetischen Flussdichte **B** in etwa 0 T. In dem hier vorgestellten ersten Anwendungsbeispiel dient der Permanentmagnet **PM** zur Bereitstellung der magnetischen Erregung **H** des magnetischen Kreises des Sensorkopfes **SK** im Zusammenwirken mit dem Material des Werkstücks in der Nähe der Oberfläche **OF** des Werkstücks und in der Nähe des Sensorelements **SE.** Statt eines Permanentmagneten PM kann in dem ersten Anwendungsbeispiel auch eine stromdurchflossene Spule oder dergleichen hier eingesetzt werden. Auch sind kompliziertere magnetische Kreise mit mehr als einer Quelle magnetischer Erregung in dem ersten Anwendungsbeispiel zu dem gleichen Zweck denkbar. Beispielsweise kann der Sensorkopf **SK** in dem ersten Anwendungsbeispiel auch eine Kombination aus einem der mehreren Permanentmagneten mit einer oder mehreren Spulen als Quelle der magnetischen Erregung **H** aufweisen. Beispielsweise kann der Sensorkopf **SK** in dem ersten Anwendungsbeispiel auch einer oder mehrere Spulen als Quelle der magnetischen Erregung **H** aufweisen. Der Begriff Permanentmagnet steht im Sinne des hier vorgelegten Dokuments für eine beliebig strukturierte Quelle magnetischer Erregung **H.** Ein einzelner Permanentmagnet ist in dem ersten Anwendungsbeispiel jedoch ausdrücklich besonders bevorzugt. In dem zweiten Anwendungsbeispiel kann es sich um einen Permanentmagneten des Motors, also beispielsweise des Rotors oder des Stators handeln. In dem dritten Anwendungsbeispiel einer Magnetkamera kann der Permanentmagnet PM als Hilfsmagnet **19** für die magnetische Erregung H des zu prüfenden Messobjekts sorgen. Im Falle des vierten Anwendungsbeispiels eines Mikrowellenspektrometers kann der Permanentmagnet als Gradienten behafteter Permanentmagnet **GPM** für eine unterschiedliche Aufspaltung der unteren Resonanzkante **522** und der oberen Resonanzkante **525** sorgen. Ein Permanentmagnet **PM** kann beispielsweise als Magnetfelderzeugungsmittel Lc verwendet werden;
- POS: Positionsdetektor;
- POSS: Positionssignal;
- POSSW: Wert des Positionssignals POSS in willkürlichen Einheiten;
- RAM: Speicher **RAM,** insbesondere flüchtiger Speicher;
- RFG: Radiowellenquelle (RF-Quelle) **RFG;**
- RFAR: Transmissions-HF-Signalanalysator **RFAR** für die Erfassung des durch die mit dem Sensorelement **SE** bedeckte Strecke **15740** des Welleneiters **(1380, 1880, 2380, 6880, 6990)** durch Wechselwirkung mit dem Trägermaterial **TM** des Sensorelements **SE** und durch die Wechselwirkung mit den NV-Zentren **NVZ** und/oder paramagnetischen Zentren der Kristalle und/oder Diamanten **DM** innerhalb des Trägermaterials **TM** des Sensorelements **SE** in der mit dem Sensorelement **SE** bedeckte Strecke **15740** des Welleneiters **(1380, 1880, 2380, 6880, 6990)** deformierten und reflektierten HF-Signals **RWR** des HF-Signals **RW.**
- RFAT: Reflexions-HF-Signalanalysator **RFAT** für die Erfassung des durch die mit dem Sensorelement **SE** bedeckte Strecke **15740** des Welleneiters **(1380, 1880, 2380, 6880, 6990)** durch Wechselwirkung mit dem Trägermaterial **TM** des Sensorelements **SE** und durch die Wechselwirkung mit den NV-Zentren **NVZ** und/oder paramagnetischen Zentren der Kristalle und/oder Diamanten **DM** innerhalb des Trägermaterials **TM** des Sensorelements **SE** in der mit dem Sensorelement **SE** bedeckte Strecke **15740** des Welleneiters **(1380, 1880, 2380, 6880, 6990)** deformierten und transmittierten HF-Signals **RWT** des HF-Signals **RW.**
- RMK: magnetischer Rotorkreis **RMK;**
- RI: Störung im ferromagnetischen Material **FMM.** Bei einer solchen Störung kann es sich um eine Änderung der Zusammensetzung handeln, die die magnetischen Eigenschaften des ferromagnetischen Materials FM lokal ändert. Beispielsweise kann es sich um einen Riss oder einen Lunker oder eine Bohrung oder eine Vertiefung oder um eine Dickenschwankung oder eine Modulation eines Formfaktors wie Dicke, Breite oder dergleichen handeln;
- RW: Radiowellensignal **RW;**
- RWC: Mikrowellen-Richtkoppler zum Einspeisen des HF-Signals **RW** in den Wellenleiter **(1380, 1880, 2380, 6880, 6990)** und zum Auskoppeln des reflektierten HF-Signals **RWR** für die Analyse durch den Reflexions-HF-Signalanalysator **µWAR.**
- RWR: reflektiertes HF-Signal **RWR** des HF-Signals **RW,** das durch Wechselwirkung mit dem Trägermaterial **TM** des Sensorelements **SE** und durch die Wechselwirkung mit den NV-Zentren **NVZ** und/oder paramagnetischen Zentren der Kristalle und/oder Diamanten **DM** innerhalb des Trägermaterials **TM** des Sensorelements **SE** in der mit dem Sensorelement **SE** bedeckte Strecke **15740** des Welleneiters **(1380, 1880, 2380, 6880, 6990)** deformiert und reflektiert wird;
- RWT: transmittiertes HF-Signal **RWT** des HF-Signals **RW,** das durch Wechselwirkung mit dem Trägermaterial **TM** des Sensorelements **SE** und durch die Wechselwirkung mit den NV-Zentren **NVZ** und/oder paramagnetischen Zentren der Kristalle und/oder Diamanten **DM** innerhalb des Trägermaterials **TM** des Sensorelements **SE** in der mit dem Sensorelement **SE** bedeckte Strecke **15740** des Welleneiters **(1380, 1880, 2380, 6880, 6990)** deformiert und durch diese hindurch transmittiert wird;
- S0: Empfängerausgangssignal **S0**. Bei dem Empfängerausgangssignal **S0** kann es sich im Sinne des hier vorgelegten Dokuments auch im ein vektorielles Empfängerausgangssignal **S0** handeln, das eine Mehrzahl von Empfängerausgangssignalkomponente (**S0_1**, **S0_2, S0_3, S0_4, S0_5**) umfassen kann;
- S0_1: Empfängerausgangssignal **S0_1** für das linke Sensorelement **SE(1410).** Das Empfängerausgangssignal **S0_1** für das linke Sensorelement **SE(1410)** stellt bevorzugt eine Empfängerausgangssignalkomponente des vektoriellen Empfängerausgangssignals S0 dar;
- S0_2: Empfängerausgangssignal **S0_2** für das mittlere Sensorelement **SE(1420);**
- S0_3: Empfängerausgangssignal **S0_3** für das rechte Sensorelement **SE(1430);**
- S0_4: Empfängerausgangssignal **S0_4** für das linke Leitungssensorelement **SE(7110);**
- S0_5: Empfängerausgangssignal **S0_5** für das rechte Leitungssensorelement **SE(7120);**
- S1: verstärktes Empfängerausgangssignal **S1** bzw. digitalisiertes Empfängerausgangssignal **S1.** Bei dem verstärktes Empfängerausgangssignal **S1** bzw. digitalisiertes Empfängerausgangssignal **S1** kann es sich im Sinne des hier vorgelegten Dokuments auch im ein vektorielles verstärktes Empfängerausgangssignal **S1** bzw. ein vektorielles digitalisiertes Empfängerausgangssignal **S1** handeln, das eine Mehrzahl von verstärkten Empfängerausgangssignalkomponente **(S1_1, S1_2, S1_3, S1_4, S1_5)** umfassen kann;
- S1_1: verstärktes Empfängerausgangssignal **S1_1** für das linke Sensorelement **SE(1410)** bzw. digitalisiertes Empfängerausgangssignal **S1_1** für das linke Sensorelement **SE(1410);**
- S1_2: verstärktes Empfängerausgangssignal **S1_2** für das linke Sensorelement **SE(1420)** bzw. digitalisiertes Empfängerausgangssignal **S1_2** für das linke Sensorelement **SE(1410);**
- S1_3: verstärktes Empfängerausgangssignal **S1_3** für das linke Sensorelement **SE(1430)** bzw. digitalisiertes Empfängerausgangssignal **S1_3** für das linke Sensorelement **SE(1430);**
- S1_4: verstärktes Empfängerausgangssignal **S1_4** für das linke Leitungssensorelement **SE(7110)** bzw. digitalisiertes Empfängerausgangssignal **S1_3** für das linke Leitungssensorelement **SE(7110);**
- S1_5: verstärktes Empfängerausgangssignal **S1_5** für das rechte Leitungssensorelement **SE(7120)** bzw. digitalisiertes Empfängerausgangssignal **S1_3** für das rechte Leitungssensorelement **SE(7120);**
- S3: Filtereingangssignal;
- S3a: erstes Zwischensignal **S3a** des L3-Produkts des Mehrfachkorrelators **LIV;**
- S3b: zweites Zwischensignal **S3b** des L3-Produkts des Mehrfachkorrelators **LIV;**
- S4: Filterausgangssignal **S4** auch als Flussdichtemesssignal im Falle der Verwendung als Magnetometer bezeichnet. Bei dem Filterausgangssignal **S4** kann es sich im Sinne des hier vorgelegten Dokuments auch im ein vektorielles Filterausgangssignal **S4** handeln, das eine Mehrzahl von Filterausgangssignalkomponente **(S4_1, S4_2, S4_3, S4_4, S4_5)** umfassen kann;
- S4_1: Filterausgangssignal **S4_1** für das linke Sensorelement **SE(1410);**
- S4_2: Filterausgangssignal **S4_2** für das mittlere Sensorelement **SE(1420);**
- S4_3: Filterausgangssignal **S4_3** für das rechte Sensorelement **SE(1430);**
- S4_4: Filterausgangssignal **S4_4** für das linke Leitungssensorelement **SE(7110);**
- S4_5: Filterausgangssignal **S4_5** für das rechte Leitungssensorelement **SE(7120);**
- S5: Sendesignal **S5.** Bei dem Sendesignal **S5** kann es sich im Sinne des hier vorgelegten Dokuments auch im ein vektorielles Sendesignal **S5** handeln, das eine Mehrzahl von Sendesignalkomponente **(S5_1, S5_2, S5_3, S5_4, S5_5)** umfassen kann;
- S5: Sendesignal **S5** zur Modulation der Lichtquelle **LED** (Pumpstrahlungsquelle der Pumpstrahlung **LB);**
- S5_1: Sendesignal **S5_1** für das linke Sensorelement **SE(1410)** zur Modulation der Lichtquelle **LED_1** für das linke Sensorelement **SE(1410)** (Pumpstrahlungsquelle der Pumpstrahlung **LB_1** für das linke Sensorelement **SE(1410));**
- S5_2: Sendesignal **S5_2** für das mittlere Sensorelement **SE(1420)** zur Modulation der Lichtquelle **LED_2** für das mittlere Sensorelement **SE(1420)** (Pumpstrahlungsquelle der Pumpstrahlung **LB_2** für das mittlere Sensorelement **SE(1420));**
- S5_3: Sendesignal **S5_3** für das rechte Sensorelement **SE(1430)** zur Modulation der Lichtquelle **LED_3** für das rechte Sensorelement **SE(1430)** (Pumpstrahlungsquelle der Pumpstrahlung **LB_3** für das rechte Sensorelement **SE(1430));**
- S5_4: Sendesignal **S5_4** für das linke Leitungssensorelement **SE(7110)** zur Modulation der Lichtquelle **LED_4** für das linke Leitungssensorelement **SE(7110)** (Pumpstrahlungsquelle der Pumpstrahlung **LB_4** für das linke Leitungssensorelement **SE(7110));**
- S5_5: Sendesignal **S5_5** für das rechte Leitungssensorelement **SE(7120)** zur Modulation der Lichtquelle **LED_5** für das rechte linke Leitungssensorelement **SE(7120)** (Pumpstrahlungsquelle der Pumpstrahlung **LB_5** für das rechte linke Leitungssensorelement **SE(7120));**
- S5m: Mikrowellenmodulationssignal **S5m;**
- S5mq: invertiertes Mikrowellenmodulationssignal **S5mq;**
- S5w: LED-Modulationssignal **S5w,** auch als Sendevorsignal bezeichnet. Bei dem LED-Modulationssignal **S5w** kann es sich im Sinne des hier vorgelegten Dokuments auch im ein vektorielles LED-Modulationssignal **S5w** handeln, das eine Mehrzahl von LED-Modulationssignalkomponente **(S5w_1, S5w_2, S5w_3, S5w_4, S5w_5)** umfassen kann;
- S5w_1: LED-Modulationssignal **S5w1** für das linke Sensorelement **SE(1410)** zur Modulation der Lichtquelle **LED_1** für das linke Sensorelement **SE(1410)** (Pumpstrahlungsquelle der Pumpstrahlung **LB_1** für das linke Sensorelement **SE(1410));**
- S5w_2: LED-Modulationssignal **S5w2** für das mittlere Sensorelement **SE(1420)** zur Modulation der Lichtquelle **LED_2** für das mittlere Sensorelement **SE(1420)** (Pumpstrahlungsquelle der Pumpstrahlung **LB_2** für das mittlere Sensorelement **SE(1420));**
- S5w_3: LED-Modulationssignal **S5w3** für das rechte Sensorelement **SE(1430)** zur Modulation der Lichtquelle **LED_3** für das rechte Sensorelement **SE(1430)** (Pumpstrahlungsquelle der Pumpstrahlung **LB_3** für das rechte Sensorelement **SE(1430));**
- S5w_4: LED-Modulationssignal **S5w4** für das linke Leitungssensorelement **SE(7110)** zur Modulation der Lichtquelle **LED_4** für das linke Leitungssensorelement **SE(7110)** (Pumpstrahlungsquelle der Pumpstrahlung **LB_4** für das linke Leitungssensorelement **SE(7110));**
- S5w_5: LED-Modulationssignal **S5w5** für das rechte Leitungssensorelement **SE(7120)** zur Modulation der Lichtquelle **LED_5** für das rechte Leitungssensorelement **SE(7120)** (Pumpstrahlungsquelle der Pumpstrahlung **LB_5** für das rechte Leitungssensorelement **SE(7120));**
- S5wq: invertiertes LED-Modulationssignal **S5wq;**
- SCHR: Schraube. Das Sensorkopfgehäuse **GH** weist im ersten Anwendungsbeispiel zur Aufnahme der Schraube vorzugsweise ein Gewinde für eine Madenschraube zur Fixierung des Lichtwellenleiters **LWL** auf;
- SE: Sensorelement **SE.** Bevorzugt umfasst das Sensorelement **SE** eine Vielzahl von Nanodiamanten bzw. Diamanten **DM,** die unterschiedlich orientiert sind und bevorzugt eine Vielzahl von NV-Zentren **NVZ** aufweisen. Bevorzugt umfasst das Sensorelement **SE** eine Vielzahl von Kristallen, die unterschiedlich orientiert sind und bevorzugt eine Vielzahl von NV-Zentren **NVZ** und/oder paramagnetischer Zentren aufweisen. Bevorzugt ist im Falle des ersten Anwendungsbeispiels eines Sensorkopfes **SK** das Sensorelement **SE** mit den Diamanten **DM** bzw. Nanodiamanten und/oder den Kristallen mit paramagnetischen Zentren mittig unter dem Permanentmagneten **PM** und möglichst nah am Prüfobjekt, hier im ersten Anwendungsbeispiel eines Sensorkopfes **SK** dem beispielhaften Werkstück mit dem ferromagnetischen Material **FMM,** platziert. Im Falle des zweiten Anwendungsbeispiels eines Motors ist das Sensorelement vorzugsweise innerhalb der Luftspalts **LS** des Motors oder in dessen Streufeld positioniert. Im Falle des dritten Anwendungsbeispiels einer Magnetfeldkamera umfasst das Sensorelement **SE** vorzugsweise eine Sensorschicht **5.** Im Falle des vierten Anwendungsbeispiels einer Wellenleitung **(1380, 1880, 2380 6830, 6980)** befindet sich das Sensorelement vorzugsweise in der Nähe einer Leitung **(1310, 1320, 1330, 6810, 6820)** der jeweiligen Wellenleitung und/oder in einer Clearance **(1340, 1350, 1840, 2340, 2350, 6840)** einer jeweiligen Wellenleitung. Das Sensorelement **SE** umfasst typischerweise die Nano-Diamant-Kristalle **ND** und ein typischerweise verfestigtes Trägermittel **TE.** Die hier vorgelegte Schrift beschreibt verschiedene Sensorelemente **SE,** insbesondere die Sensorelemente **1410, 1420, 1430, 1710, 2210, 2410, 2420, 2430, 4410, 7115, 7125, 1735, 7110** und **7120, 13310** die sich nach Ausdehnung und Lage gegenüber den Leitungen unterscheiden;
- SIS: Magnetfeldsensoransteuerung **SIS;**
- SK: Sensorkopf;
- SL: Wicklungen einer Stator-Spule;
- SMK: magnetischer Stator-Kreis;
- Sr: Source-Gebiet **Sr;**
- SrK: Source-Kontakt **SrK;**
- ST: ferromagnetische Stütze;
- TB: Datenschnittstelle des IEEE JATG-Test-Controllers **JTAG** und JTAG-Testdatenbus;
- TM: Trägermaterial **TM.** Das Trägermaterial **TM** der kolloidalen Mischung **KL** ist vorzugsweise zu Beginn der Verarbeitung flüssig und wird im Rahmen der Verarbeitung, beispielsweise durch Bestrahlung mit einer Aushärtestrahlung **4910** einer Aushärtewellenlänge λ_{H} verfestigt. Vorzugsweise ist das Trägermaterial **TM** nach der Verfestigung optisch transparent für elektromagnetische Strahlung mit der Pumpstrahlungswellenlänge λₚₘₚ und der Fluoreszenzwellenlänge λ_{fl} der paramagnetischen Zentren der eingebetteten Kristalle und/oder Diamant-Nano-Kristalle **ND,** hier bevorzugt der NV-Zentren;
- t: Zeit;
- T: Periodendauer der Motorströme (I_{MPHU}, I_{MPHV}, I_{MPHW});
- TM: Trägermaterial;
- TP: Tiefpass;
- TP: Tiefpassfilter bzw. Filter mit Tiefpasseigenschaften;
- uMS1: erste untere Metallblende **uMS1**
- uMS2: zweite untere Metallblende **uMS2**
- v: Vorschubgeschwindigkeit;
- V1: erster Verstärker **V1** oder nur Verstärker in diesem Dokument. Bei dem Verstärker **V1**kann es sich im Sinne des hier vorgelegten Dokuments auch im einen vektoriellen Verstärker **V1**handeln, das eine Mehrzahl von Verstärkerkomponente **(V1_1, V1_2, V1_3, V1_4, V1w_5)** umfassen kann;
- V1_1: erster Verstärker **V1_1** für das linke Sensorelement **SE(1410)** zur Verstärkung und/oder Digitalisierung des Empfangssignals **S0_1** für das linke Sensorelement **SE(1410)** zum verstärkten Empfängerausgangssignal **S1_1** für das linke Sensorelement **SE(1410)** bzw. zum digitalisierten Empfängerausgangssignal **S1_1** für das linke Sensorelement **SE(1410);**
- V1_2: erster Verstärker **V1_2** für das mittlere Sensorelement **SE(1420)** zur Verstärkung und/oder Digitalisierung des Empfangssignals **S0_2** für das mittlere Sensorelement **SE(1420)** zum verstärkten Empfängerausgangssignal **S1_2** für das mittlere Sensorelement **SE(1420)** bzw. zum digitalisierten Empfängerausgangssignal **S1_2** für das linke Sensorelement **SE(1420);**
- V1_3: erster Verstärker **V1_3** für das rechte Sensorelement **SE(1430)** zur Verstärkung und/oder Digitalisierung des Empfangssignals **S0_3** für das rechte Sensorelement **SE(1430)** zum verstärkten Empfängerausgangssignal **S1_3** für das rechte Sensorelement **SE(1430)** bzw. zum digitalisierten Empfängerausgangssignal **S1_3** für das rechte Sensorelement **SE(1430);**
- V1_4: erster Verstärker **V1_4** für das linke Leitungssensorelement **SE(7110)** Verstärkung und/oder Digitalisierung des Empfangssignals **S0_4** für das linke Leitungssensorelement **SE(7110)** zum verstärkten Empfängerausgangssignal **S1_4** für das linke Leitungssensorelement **SE(7110)** bzw. zum digitalisierten Empfängerausgangssignal **S1_4** für das linke Leitungssensorelement **SE(7110)**
- V1_5: erster Verstärker **V1_5** für das rechte Leitungssensorelement **SE(7120)** zur Verstärkung und/oder Digitalisierung des Empfangssignals **S0_5** für das rechte Leitungssensorelement **SE(7120)** zum verstärkten Empfängerausgangssignal **S1_5** für das rechte Leitungssensorelement **SE(7120)** bzw. zum digitalisierten Empfängerausgangssignal **S1_5** für das rechte Leitungssensorelement **SE(7120);**
- VDD: Versorgungsspannung;
- V_{MPHU}: Motorphasenspannung der U-Motorphase MPH_{U} bezogen auf das Bezugspotenzial GND;
- V_{MPHV}: Motorphasenspannung der V-Motorphase MPH_{V} bezogen auf das Bezugspotenzial GND;
- V_{MPHW}: Motorphasenspannung der W-Motorphase MPH_{W} bezogen auf das Bezugspotenzial GND;
- VT: Vertiefung **VT** des Sensorkopfes **SK** z.B. für einen Führungsfinger einer Hand;

### Glossar

### Diamant-Nano-Kristalle ND

Bevorzugt verwendet die hier vorgestellte technische Lehre HD-NV-Diamanten als Diamant-Nano-Kristalle **ND** bzw. Kristalle der Sensorelemente **SE** bzw. der Sensorelementschichten **5.** Das hier vorgelegte Dokument weist in diesem Zusammenhang auf die Schrift DE 10 2020 109 477 A1 hin.

Ein HD-NV-Diamant ist im Sinne der hier vorgelegten Schrift ein Kristall mit einer besonders hohen Dichte an paramagnetischen Zentren. Durch diese hohe Dichte an paramagnetischen Zentren zeigen die Fluoreszenzintensitätskurve und/oder die Fluoreszenzverzögerungskurve Fluoreszenzmerkmale, die Kopplungen dieser paramagnetischen Zentren mit anderen Kristallstrukturelementen verursachen. Solche andere Kristallstrukturelemente können beispielsweise sein:
i. Andere zum ankoppelnden paramagnetischen Zentrum gleich ausgerichtete paramagnetische Zentren gleicher Art, also beispielsweise die Kopplung eines NV-Zentrums an ein gleichausgerichtetes NV-Zentrum in Diamant;
ii. Andere zum ankoppelnden paramagnetischen Zentrum nicht gleich ausgerichtete paramagnetische Zentren gleicher Art, also beispielsweise die Kopplung eines NV-Zentrums an ein nicht gleichausgerichtetes NV-Zentrum in Diamant;
iii. Andere zum ankoppelnden paramagnetischen Zentrum gleich ausgerichtete paramagnetische Zentren anderer Art, also beispielsweise die Kopplung eines SiV-Zentrums und/oder TiV-Zentrums und/oder GeV-Zentrums und/oder SnV-Zentrums und/oder NiN4-Zentrums und/oder PbV-Zentrums und/oder ST1-Zentrums an ein gleichausgerichtetes NV-Zentrum in Diamant;
iv. Andere zum ankoppelnden paramagnetischen Zentrum nicht gleich ausgerichtete paramagnetische Zentren anderer Art, also beispielsweise die Kopplung eines SiV-Zentrums und/oder TiV-Zentrums und/oder GeV-Zentrums und/oder SnV-Zentrums und/oder NiN4-Zentrums und/oder PbV-Zentrums und/oder ST1-Zentrums an ein nicht gleichausgerichtetes NV-Zentrum in Diamant;
v. Nukleare Spins mit magnetischem Moment von Isotopen mit einem solchen Spin, die an das ankoppelnde paramagnetischen Zentrum koppeln und die Teil des paramagnetischen Zentrums sind, also beispielsweise die Kopplung eines NV-Zentrums an ein den Kern des Stickstoffs im NV-Zentrum;
vi. Nukleare Spins mit magnetischem Moment von Isotopen mit einem solchen Spin, die an das ankoppelnde paramagnetischen Zentrum koppeln und die nicht Teil des paramagnetischen Zentrums sind, also beispielsweise die Kopplung eines NV-Zentrums an ein den Kern eines ¹³C-Isotops im Umfeld eines NV-Zentrums.

Die hohe Dichte an paramagnetischen Zentren einer Art, beispielsweise von NV-Zentren in Diamant als Kristall, erhöht die Wahrscheinlichkeit, dass der Abstand eines paramagnetischen Zentrums zu einem solchen anderen Kristallstrukturelement so gering ist, dass eine der oben angegebenen Kopplungen möglich wird. Dies hat zur Folge, dass die Fluoreszenzmerkmale, die eine solche Kopplung zwischen einem paramagnetischen Zentrum und einem anderen Kristallstrukturelement anzeigen, in der Fluoreszenzintensitätskurve bzw. der Fluoreszenzverzögerungskurve des Kristalls stärker ausgeprägt sind. Auf einen Diamanten mit einer hohen Dichte an NV-Zentren bedeutet dies, dass die Fluoreszenzmerkmale, die eine solche Kopplung zwischen einem NV-Zentrum und einem anderen Kristallstrukturelement anzeigen, in der Fluoreszenzintensitätskurve bzw. der Fluoreszenzverzögerungskurve des Diamanten stärker ausgeprägt sind.

Ein Merkmal, das beispielsweise für einen HD-NV-Diamanten kennzeichnend ist, ist die Kopplung eines NV-Zentrums an ein anderes NV-Zentrum. Ein solcher Diamant umfasst also ein NV-Zentren-Paar zweier gekoppelter und äquivalenter NV-Zentren. Entsprechend dem Inhalt der hier vorgelegten Schrift ist dieser Diamant (HDNV) dann bevorzugt für die Verwendung in einer quantentechnologischen Vorrichtung und/oder in einem quantentechnologischen Verfahren bestimmt. Der HD-NV-Diamant kann sich dann beispielsweise dadurch auszeichnen, dass die Intensitätswertkurve der Intensität **Iᵢₛₜ** der Fluoreszenzstrahlung **FL** des NV-Zentren-Paares bei Bestrahlung mit einer Pumpstrahlung **LB** mit einer Pumpstrahlungswellenlänge **(λₚₘₚ)** in Abhängigkeit vom Wert der magnetischen Flussdichte (B) eines zum Diamanten (HDNV) externen magnetischen Feldes einen typischen Intensitätsabfall (englisch: Dip) des Fluoreszenzintensitätswerts der Intensität **Iᵢₛₜ** der Fluoreszenzstrahlung **FL** und/oder einen typischen Verzögerungsanstieg des Fluoreszenzverzögerungswerts von mehr als 0,01% und/oder von mehr als 0,02% und/oder von mehr als 0,05% und/oder von mehr als 0,1% und/oder von mehr als 0,2% und/oder von mehr als 0,5% und/oder 1% und/oder von mehr als 2% und/oder von mehr als 5% bei einer auf den Diamanten einwirkenden externen magnetischen Flussdichte (B) von etwa 34,0mT (E_{34.0,0}) zeigt, der auf eine NV-NV-Wechselwirkung äquivalenter Pare von NV-Zentren und damit einen geringen mittleren Abstand zwischen den äquivalenten NV-Zentren hinweist.
An dieser Stelle weist die hier vorgelegte Schrift darauf hin, dass in der Regel Diamanten eine extrem hohe Dichte an P1-Zentren aufweisen. Daher führt eine Erhöhung der NV-Zentrendichte in der Regel nicht zu einer Veränderung des Fluoreszenzmerkmals, das auf eine NV/P1-Kopplung hinweist.
Die Größe der Diamant-Nano-Kristalle **ND** ist bevorzugt kleiner 1mm, besser kleiner 500µm, besser kleiner 200µm, besser kleiner 100µm, besser kleiner 50µm, besser kleiner 20µm, besser kleiner 10µm, besser kleiner 5µm, besser kleiner 2µm, besser kleiner 1µm, besser kleiner 500nm, besser kleiner 200nm, besser kleiner 100nm, besser kleiner 50nm. Die Größe der Diamant-Nano-Kristalle kann kleiner 20nm und/oder kleiner 10nm und/oder kleiner 5nm und/oder kleiner 2nm und/oder kleiner 1nm sein. Bei den Autoren besteht die Meinung, dass eine Größe von 50nm optimal ist, ohne dass entsprechende Experimente durchgeführt wurden. Gleiches gilt beim Einsatz von Kristallen, die andere Materialien aufweisen, und die Diamant-Nano-Kristalle **ND** funktionsäquivalent in den Sensorelementen **SE** ersetzen oder in den Sensorelementen **SE** ergänzen. Die technische Lehre dieses Dokuments ist somit ausdrücklich nicht auf Diamant-Nano-Kristalle **ND** mit Diamantkristallen und NV-Zentren beschränkt. Wenn in dem Text und/oder den Ansprüchen von Diamant-Nano-Kristallen **ND** und/oder NV-Zentren die Rede ist, kann eine fachkundige Person die Verwendung anderer Kristalle und/oder anderer paramagnetischer Zentren mitlesen. Diese müssen jedoch auf Eignung für den jeweiligen Anwendungsfall ausdrücklich erprobt werden.

### Fluoreszenzmerkmale

Fluoreszenzmerkmale im Sinne der hier vorgelegten Schrift sind kennzeichnende Stellen in der Fluoreszenzintensitätskurve oder der Fluoreszenzverzögerungskurve. Die Fluoreszenzintensitätskurve ist dabei der Graph der Fluoreszenzintensitätswerte der Intensität **Iᵢₛₜ** der Fluoreszenzstrahlung **FL** eines Diamant-Nano-Kristalls **ND** aus Diamant dargestellt gegen den Betrag der magnetischen Flussdichte B. Die Fluoreszenzverzögerungskurve ist dabei der Graph der zeitlichen Verzögerungswerte der zeitlichen Verzögerung der Modulation der Intensität **Iᵢₛₜ** der Fluoreszenzstrahlung **FL** gegenüber der Modulation der Intensität der Pumpstrahlung **LB** oder gegenüber dem Modulationssignal **S5** oder einem daraus abgeleiteten Signal dargestellt gegen den Betrag der magnetischen Flussdichte B. Fluoreszenzmerkmale in der Fluoreszenzintensitätskurve sind lokale Minima und Maxima im Kurvenverlauf. Fluoreszenzmerkmale in der Fluoreszenzverzögerungskurve sind lokale Maxima und Minima im Kurvenverlauf. Die folgende Liste zählt die in den Vorarbeiten zu den zitierten Schriften ermittelten Fluoreszenzmerkmale eines HD-NV-Diamanten (HDNV) mit einer hohen Dichte an NV-Zentren auf. Diese kommen als Fluoreszenzmerkmale im Sinne dieser Schrift bei Verwendung eines Diamanten als Kristall einer vorschlagsgemäßen Vorrichtung oder eines vorschlagsgemäßen Verfahren in Frage. Wenn in dieser Schrift von Fluoreszenzmerkmalen die Rede ist, sind zumindest die nachfolgenden Fluoreszenzmerkmale bei Verwendung eines Diamanten als Kristall einer vorschlagsgemäßen Vorrichtung oder eines vorschlagsgemäßen Verfahren gemeint. Im Falle der Verwendung anderer Materialien (siehe auch Inhalt der ZPL-Tabelle) ergeben sich andere Fluoreszenzmerkmale, die aber in der Regel auf analoge Mechanismen zurückzuführen sind. Die Verwendung dieser anderen Materialien und der entsprechenden paramagnetischen Zentren und deren Fluoreszenzmerkmale ist von der Offenlegung der hier vorgelegten Schrift umfasst. Insbesondere ist darüber hinaus die Verwendung von Kristallen aus Elementen der II. Hauptgruppe und der VI. Hauptgruppe und der IV. Hauptgruppe von der hier vorgelegten Offenlegung umfasst. Isotopen der IV-Hauptgruppe des Periodensystems der Elemente und aus Mischkristallen Die Fluoreszenzmerkmale sind hierauf aber nicht beschränkt. Ggf. können weniger und mehr Fluoreszenzmerkmale verwendet werden:

| **Fluoreszenzmerkmalsgruppe** | **Nr.** | **Paar Nr des Fluoreszenzmerkmals** | **ca. Position in mT (ca. Angabe) *)** | **Typ des Intensitätsextremums min=Minimum max=Maximum** | **Typ des Verzögerungsextremums min=Minimum max=Maximum** | **Fluoreszenzmerkmalskategorie** |
|---|---|---|---|---|---|---|
| 0mT | E_{0.0,0} | 0 | 0,00 mT | min | max | Hauptfluoreszenzmerkmal |
| | E_{0.0,1b} | 1 | 2,10 mT | max | min | Nebenfluoreszenzmerkmal |
| | E_{0.0,2b} | 2 | 3,80 mT | max | min | Nebenfluoreszenzmerkmal |
| | E_{0.0,3b} | 3 | 5,30 mT | max | min | Nebenfluoreszenzmerkmal |
| 9,5mT | E_{9.5,8a} | 8 | 5,91 mT | max | min | Nebenfluoreszenzmerkmal |
| | E_{9.5,7a} | 7 | 6,70 mT | max | min | Nebenfluoreszenzmerkmal |
| | E_{9.5,6a} | 6 | 6,95 mT | min | max | Nebenfluoreszenzmerkmal |
| | E_{9.5,5a} | 5 | 7,21 mT | max | min | Nebenfluoreszenzmerkmal |
| | E_{9.5,4a} | 4 | 7,85 mT | min | max | Nebenfluoreszenzmerkmal |
| | E_{9.5,3a} | 3 | 8,12 mT | max | min | Nebenfluoreszenzmerkmal |
| | E_{9.5,2a} | 2 | 8,43 mT | min | max | Nebenfluoreszenzmerkmal |
| | E_{9.5,la} | 1 | 8,82 mT | max | min | Nebenfluoreszenzmerkmal |
| | E_{9.5,0} | 0 | 9,38 mT | min | max | Hauptfluoreszenzmerkmal |
| | E_{9.5,1b} | 1 | 10,05 mT | max | min | Nebenfluoreszenzmerkmal |
| | E_{9.5,2b} | 2 | 10,55 mT | min | max | Nebenfluoreszenzmerkmal |
| | E_{9.5,3b} | 3 | 11,10 mT | max | min | Nebenfluoreszenzmerkmal |
| | E_{9.5,4b} | 4 | 11,60 mT | min | max | Nebenfluoreszenzmerkmal |
| | E_{9.5,5b} | 5 | 11,89 mT | max | min | Nebenfluoreszenzmerkmal |
| | E_{9.5,6b} | 6 | 12,12 mT | min | max | Nebenfluoreszenzmerkmal |
| 34mT | E_{34,11a} | 11 | 31,22 mT | max | min | Nebenfluoreszenzmerkmal |
| | E_{34,10a} | 10 | 31,67 mT | min | max | Nebenfluoreszenzmerkmal |
| | E_{34,9a} | 9 | 31,78 mT | max | min | Nebenfluoreszenzmerkmal |
| | E_{34,8a} | 8 | 32,00 mT | min | max | Nebenfluoreszenzmerkmal |
| | E_{34,7a} | 7 | 32,25 mT | max | min | Nebenfluoreszenzmerkmal |
| | E_{34,6a} | 6 | 32,63 mT | min | max | Nebenfluoreszenzmerkmal |
| | E_{34,5a} | 5 | 32,72 mT | max | min | Nebenfluoreszenzmerkmal |
| | E_{34,4a} | 4 | 32,96 mT | min | max | Nebenfluoreszenzmerkmal |
| | E_{34,3a} | 3 | 33,24 mT | max | min | Nebenfluoreszenzmerkmal |
| | E_{34,2a} | 2 | 33,53 mT | min | max | Nebenfluoreszenzmerkmal |
| | E_{34,1a} | 1 | 33,65 mT | max | min | Nebenfluoreszenzmerkmal |
| | E_{34,0} | 0 | 33,98 mT | min | max | Hauptfluoreszenzmerkmal |
| | E_{34,1b} | 1 | 34,28 mT | max | min | Nebenfluoreszenzmerkmal |
| | E_{34,2b} | 2 | 34,38 mT | min | max | Nebenfluoreszenzmerkmal |
| | E_{34,3b} | 3 | 34,72 mT | max | min | Nebenfluoreszenzmerkmal |
| | E_{34,4b} | 4 | 34,97 mT | min | max | Nebenfluoreszenzmerkmal |
| | E_{34,5b} | 5 | 35,24 mT | max | min | Nebenfluoreszenzmerkmal |
| | E_{34,6b} | 6 | 35,35 mT | min | max | Nebenfluoreszenzmerkmal |
| | E_{34,7b} | 7 | 35,74 mT | max | min | Nebenfluoreszenzmerkmal |
| | E_{34,8b} | 8 | 36,03 mT | min | max | Nebenfluoreszenzmerkmal |
| | E_{34,9b} | 9 | 36,30 mT | max | min | Nebenfluoreszenzmerkmal |
| | E_{34,10a} | 10 | 36,44 mT | min | max | Nebenfluoreszenzmerkmal |
| | E_{34,11b} | 11 | 36,67 mT | max | min | Nebenfluoreszenzmerkmal |
| | E_{34,12b} | 12 | 36,80 mT | min | max | Nebenfluoreszenzmerkmal |
| | E_{34,13b} | 13 | 36,97 mT | min | min | Nebenfluoreszenzmerkmal |
| 51,0mT | E_{51.0,0} | 0 | 51,00 mT | min | max | Hauptfluoreszenzmerkmal |
| 59,5mT | E_{59.5,0} | 0 | 59,50 mT | min | max | Hauptfluoreszenzmerkmal |
| 102,4mT | E_{102.4,9a} | 9 | 97,10 mT | max | min | Nebenfluoreszenzmerkmal |
| | E_{102.4,8a} | 8 | 97,60 mT | min | max | Nebenfluoreszenzmerkmal |
| | E_{102.4,7a} | 7 | 98,00 mT | max | min | Nebenfluoreszenzmerkmal |
| | E_{102.4,6a} | 6 | 98,40 mT | min | max | Nebenfluoreszenzmerkmal |
| | E_{102.4,5a} | 5 | 98,90 mT | max | min | Nebenfluoreszenzmerkmal |
| | E_{102.4,4a} | 4 | 99,50 mT | min | max | Nebenfluoreszenzmerkmal |
| | E_{102.4,3a} | 3 | 100,10 mT | max | min | Nebenfluoreszenzmerkmal |
| | E_{102.4,2a} | 2 | 101,10 mT | min | max | Nebenfluoreszenzmerkmal |
| | E_{102.4,1a} | 1 | 101,80 mT | max | min | Nebenfluoreszenzmerkmal |
| | E_{102.4,0} | 0 | 102,40 mT | min | max | Hauptfluoreszenzmerkmal |
| | E_{102.4,1b} | 1 | 103,10 mT | max | min | Nebenfluoreszenzmerkmal |
| | E_{102.4,2b} | 2 | 103,80 mT | min | max | Nebenfluoreszenzmerkmal |
| | E_{102.4,3b} | 3 | 104,80 mT | max | min | Nebenfluoreszenzmerkmal |
| | E_{102.4,4b} | 4 | 105,50 mT | min | max | Nebenfluoreszenzmerkmal |
| | E_{102.4,5b} | 5 | 106,10 mT | max | min | Nebenfluoreszenzmerkmal |
| | E_{102.4,6b} | 6 | 106,60 mT | min | max | Nebenfluoreszenzmerkmal |
| | E_{102.4,7b} | 7 | 107,00 mT | max | min | Nebenfluoreszenzmerkmal |
| | E_{102.4,8b} | 8 | 107,30 mT | min | max | Nebenfluoreszenzmerkmal |
| | E_{102.4,9b} | 9 | 107,70 mT | max | min | Nebenfluoreszenzmerkmal |

| | | | | | | |
|---|---|---|---|---|---|---|
| *) In dieser Schrift auch als kennzeichnende magnetischen Flussdichte B des Fluoreszenzmerkmals bezeichnet. Die jeweilige kennzeichnende magnetischen Flussdichte B des jeweiligen Fluoreszenzmerkmals ist jeweils den Zeichnungen entnommen. Die hier vorgelegte Schrift empfiehlt daher explizit bei der Nacharbeit der hier offengelegten technischen Lehre eine vorausgehende Nachmessung der präzisen Werte der kennzeichnenden magnetischen Flussdichten B. Die Werte könnten ggf. mit einem Offset von max. +/-1mT und einem proportionalen Fehler von 1% versehen sein. | | | | | | |

### Im Wesentlichen

Der Begriff "im Wesentlichen bedeutet im Sinne der hier vorgelegten Schrift, dass Abweichungen von einem idealen Wert zugelassen sind, die daraus resultierenden technischen Wirkungen aber den angestrebten Zweck des Verfahrens oder der Vorrichtung nur so wenig beeinträchtigen, dass die Nutzbarkeit der technischen Vorrichtung bzw. des technischen Verfahrens für einen Nutzer nicht oder nur so wenig beeinträchtigt ist, dass der Nutzer die reale technische Wirkung im Vergleich zur idealen technischen Wirkung als ausreichend bewertet.

### Kristall (HDNV)

Bevorzugt umfasst der das Objekt, das der hier vorgelegten Text als Kristall (HDNV) bezeichnet, ein einkristallines Material. Sofern es sich nicht um ein einkristallines Material handelt, sollten bevorzugt die Teilkristalle einkristallin sein und bevorzugt soweit gleichausgerichtet sein, dass die Fluoreszenzmerkmale sich im Wesentlichen in gleicher Weise ausprägen. Bevorzugt ist das Material des Kristalls (HDNV) Diamant.

Hierzu verweist das hier vorgelegte Dokument auf die Schrift DE 10 2021 132 783 A1.

Die in der hier vorgelegten Schrift offengelegten Prinzipien können aber auch mit anderen kristallinen Materialien Anwendung finden. Diamant ist aber besonders geeignet, da eine Kühlung der Elektronenspinkonfiguration auf wenige mK leicht durch Bestrahlung mit Pumpstrahlung (LB) möglich ist und die T₂-Zeiten, insbesondere die von NV-Zentren, relativ lang sind. An einigen Stellen in diesem Text ist nur von Dimant die Rede. Hier können auch andere Kristalle eingesetzt werden. In dem Fall des Einsatzes anderer Kristalle aus anderen Materialien als Diamant verwenden die in dieser Schrift offengelegten Vorrichtungen und Verfahren andere paramagnetische Zentren mit anderen Pumpstrahlungswellenlängen (λₚₘₚ) und mit anderen Fluoreszenzwellenlängen (λ_{fl}). Besonders interessant sind hier Silizium-Kristalle, Germanium-Kristalle und Mischkristalle aus Elementen der IV.-Hauptgruppe des Periodensystems. In manchen Anwendungen sind die Kristalle isotopenrein. Isotopenrein im Sinne der hier vorgelegten Schrift ist ein Material dann, wenn die Konzentration anderer Isotope als der Basis-Isotope, die das Material des Kristalls (HDNV)dominieren, so gering ist, dass der technische Zweck in einem für die Produktion und den Verkauf von Produkten ausreichenden Maße mit einer wirtschaftlich ausreichenden Produktionsausbeute erreicht wird. Dies bedeutet, dass Störungen, die von solchen Isotopenverunreinigungen ausgehen, die Funktionstüchtigkeit der paramagnetischen Zentren nicht oder höchstens ausreichend gering stören. Auf Diamant als Material des Kristalls (HDNV) bezogen heißt das, dass der Diamant bevorzugt im Wesentlichen aus ¹²C-Isotopen als Basis-Isotopen besteht, die kein magnetisches Moment haben. Dies zeigt sich so, dass beispielsweise in der Fluoreszenzintensitätskurve und/oder der Fluoreszenzverzögerungskurve die Nebenfluoreszenzmerkmale (E_{102.4,9a}, E_{102.4,8a}, E_{102.4,7a}, E_{102.4,6a}, E_{102.4,5a}, E_{102.4,4a}, E_{102.4,3a}, E_{102.4,2a}, E_{102.4,1a}, E_{102.4,1b}, E_{102.4,2b}, E_{102.4,3b}, E_{102.4,4b}, E_{102.4,5b}, E_{102.4,6b}, E_{102.4,7b}, E_{102.4,8b}, E_{102.4,9b}) des 102.4mT-Hauptfluoreszenzmerkmals (E_{102.4,0}) nicht oder schwächer ausgeprägt sind. Umgekehrt kann es wünschenswert sein, dass die Nebenfluoreszenzmerkmale (E_{102.4,9a}, E_{102.4,8a}, E_{102.4,7a}, E_{102.4,6a}, E_{102.4,5a}, E_{102.4,4a}, E_{102.4,3a}, E_{102.4,2a}, E_{102.4,1a}, E_{102.4,1b}, E_{102.4,2b}, E_{102.4,3b}, E_{102.4,4b}, E_{102.4,5b}, E_{102.4,6b}, E_{102.4,7b}, E_{102.4,8b}, E_{102.4,9b}) des 102.4mT-Hauptfluoreszenzmerkmals (E_{102.4,0}) besonders stark ausgeprägt sind, da dies eine verbesserte Interpolation und Kalibrierung ermöglicht. Auf Diamant als Material des Kristalls (HDNV) bezogen heißt das, dass dann zur Erhöhung der Intensität der Nebenfluoreszenzmerkmale der Diamant bevorzugt im Wesentlichen aus ¹³C-Isotopen als Basis-Isotopen besteht, die ein magnetisches Moment haben. Eine weniger bevorzugte Möglichkeit ist, dass zur Erhöhung der Intensität der Nebenfluoreszenzmerkmale der Diamant bevorzugt einen erhöhten Anteil an ¹³C-Isotopen als Basis-Isotopen umfasst, die ein magnetisches Moment haben. Als normale Isotopen-Verteilung nimmt die hier vorgelegte Schrift folgende Verteilung an:

| Isotop | Anteil K₀ der Isotope ohne magnetisches Moment an 100% C |
|---|---|
| Isotop ¹²C | 98,94 % |
| Isotop ¹⁴C | Spuren |
| Gesamtanteil K_{0G} der Isotope ohne magnetisches Moment an 100% C | 98,94% |
| Gesamtanteil K_{1G} der Isotope mit magnetischen Moment an 100% C | 1,06% |

Eine Verringerung des Faktors K_{1G} um mehr als 10% besser mehr als 25% fasst die hier vorgelegte Schrift als einen isotopenreinen Diamantkristall (HDNV) auf. Eine Erhöhung des Faktors K_{1G} um mehr als 10% und/oder besser um mehr als 25% und/oder besser um mehr als 50% und/oder um mehr als 100% und/oder besser um mehr als 250% und/oder besser um mehr als 500% und/oder besser um mehr als 1000% und/oder besser um mehr als 2500% und/oder besser um mehr als 5000% (auf K_{1G}>50%) fasst die hier vorgelegte Schrift als einen isotopenreinen Diamantkristall (HDNV) mit verstärkten Nebenfluoreszenzmerkmalen auf. Die Verwendung solcher Diamanten für quantentechnologische Systeme im Sinne der hier vorgelegten Schrift und/oder im Sinne der quantentechnologischen Vorrichtungen und Verfahren, insbesondere im Sinne der quantentechnologischen Sensorvorrichtungen und Messverfahren der Schriften DE 10 2020 101 784 B3, DE 20 2020 106 110 U, PCT / DE 2020 / 100 953, PCT / EP 2019 / 079 992, PCT / EP 2020 / 068 110, PCT / EP 2020 / 070 485, PCT / DE 2021 / 100 069, PCT / DE 2020 / 100 827, WO 2020 239 172 A1 (PCT / DE 2020 / 100 430) WO 2001 073 935 A1 und WO 2021 013 308 A1 (PCT / DE 2020 / 100 648) und der in diesen zitierten Schriften ist Teil der hier vorgelegten Offenbarung soweit dies das jeweilige Recht des Anmeldestaates zulässt.
Das hier geschriebene gilt für den ganzen hier vorgelegten Text.

### Pumpstrahlung λₚₘₚ

### Definition

Die vorausgehenden Beschreibungsteile verwenden den Begriff Pumpstrahlung **LB** zum Pumpen der paramagnetischen Zentren der Kristalle bzw. der Diamant-Nano-Kristalle **ND,** der bevorzugt Diamant umfassen. Die Pumpstrahlung **LB** weist eine Pumpstrahlungswellenlänge **λₚₘₚ** auf. Werden andere Störstellenzentren als NV-Zentren in Diamant verwendet, so kann eine vorschlagsgemäße Vorrichtung bzw. ein vorschlagsgemäßes Verfahren Licht bzw. elektromagnetische Strahlung anderer Pumpstrahlungswellenlängen **λₚₘₚ** als Pumpstrahlung **LB** verwenden. Damit diese Pumpstrahlung **LB** mit der Pumpstrahlungswellenlänge **λₚₘₚ** die paramagnetischen Zentren in den Kristallen erreichen kann, sollte die Struktur ggf. auf der Oberfläche der Kristalle vorhandener elektrischer Leitungen und anderer Strukturen an der Oberfläche der Kristalle ein Passieren der Pumpstrahlung **LB** in Richtung auf die jeweiligen paramagnetischen Zentren zulassen. Vorzugsweise sind die Oberflächen der Kristalle bzw. Diamant-Nano-Kristalle **ND** frei von solchen Leitungen und Strukturen.

Die hier vorgeschlagenen Sensorsysteme nutzen nun bevorzugt die HD-NV-Diamanten (HDNV) mit einer jeweiligen hohen Dichte an paramagnetischen Zentren in Form von NV-Zentren als Sensorelemente **(SE, 14305),** die die Intensität **Iᵢₛₜ** der Fluoreszenzstrahlung **FL** der paramagnetischen Zentren bei Bestrahlung mit Pumpstrahlung **LB** erfassen. Die Pumpstrahlung **LB** mit der Pumpstrahlungswellenlänge **λₚₘₚ** veranlasst das jeweilige paramagnetische Zentrum oder die paramagnetischen Zentren bzw. die Gruppe oder die Gruppen paramagnetischer Zentren in den Kristallen bzw. Diamant-Nano-Kristallen **ND** zur Abgabe von Fluoreszenzstrahlung **FL** mit einer Fluoreszenzwellenlänge **λ_{fl}** bei Bestrahlung mit der Pumpstrahlung **LB** der Pumpstrahlungswellenlänge **λₚₘₚ.** Typischerweise ist bei Verwendung von NV-Zentren in Diamant als paramagnetischen Zentren der Kristalle bzw. Diamant-Nano-Kristalle **ND** die Fluoreszenzwellenlänge **λ_{fl}** der Fluoreszenzstrahlung **FL** der NV-Zentren so, dass diese rot erscheinen. Es hat sich gezeigt, dass in Verbindung mit NV-Zentren in Diamant als paramagnetischen Zentren der Kristalle bzw. Diamantnanokristalle **ND** prinzipiell Licht mit einer Pumpstrahlungswellenlänge **λₚₘₚ** der Pumpstrahlung **LB** von höchstens 700nm und mindestens 500nm besonders als Pumpstrahlung

**LB** geeignet ist. Im Zusammenhang mit der Verwendung Kristallen anderer Materialien an Stelle der Diamant-Nano-Kristalle **ND** oder zur Ergänzung für das Sensorelement **SE** und entsprechend anderer paramagnetischer Zentren können ganz andere Wellenlängenbereiche der Pumpstrahlungswellenlänge **λₚₘₚ** der Pumpstrahlung **LB** die gleichen Funktionen in dem dann so modifizierten Sensorsystem erfüllen. Daher stellen die NV-Zentren hier nur ein Beispiel einer Ausführungsform eines solchen paramagnetischen Zentrums dar. Insbesondere bei der Verwendung eines NV-Zentrums in Diamant als paramagnetisches Zentrum in den Kristallen bzw. Diamant-Nano-Kristallen **ND** sollte die Pumpstrahlung **LB** eine Pumpstrahlungswellenlänge **λₚₘₚ** in einem Wellenlängenbereich von 400 nm bis 700 nm Wellenlänge und/oder besser 450 nm bis 650 nm und/oder besser 500 nm bis 550 nm und/oder besser 515 nm bis 540 nm aufweisen. Bevorzugt ist dabei eindeutig eine Wellenlänge von 532 nm als Pumpstrahlungswellenlänge **λₚₘₚ.** Licht bzw. elektromagnetische Pumpstrahlung **LB,** die bei der Verwendung anderer paramagnetischer Zentren insbesondere auch in anderen Materialien als von NV-Zentren in Diamant zur Ausführung gleicher Funktionen verwendet wird, sind ebenfalls möglich. Die vorgeschlagenen Sensorsystem sind somit auch für andere geeignete paramagnetische Zentren, wie z.B. SiV-Zentrum und/oder TiV-Zentrum und/oder GeV-Zentrum und/oder SnV-Zentrum und/oder NiN4-Zentrum und/oder PbV-Zentrum und/oder ST1-Zentrum etc. anwendbar. Das NV-Zentrum in Diamant ist aber besonders geeignet und besonders gut, z.B. wie oben beschrieben, und in hoher Dichte mit hoher Fertigungsausbeute herzustellen. Zweckmäßigerweise wird die Pumpstrahlung **LB** der jeweiligen Pumpstrahlungsquelle hier der Lichtquelle **LED,** die vorzugsweise ein Laser oder eine LED ist, gepulst in Abhängigkeit von einem gepulsten Wechselanteil des LED-Modulationssignals **S5w** mittels des Sendesignals **S5** gepulst. Das LED-Modulationssignal **S5w** wird als Messsignal d.h. als Referenzsignal für einen Look-In-Verstärker, Hier den Mehrfachkorrelator **LIV,** genutzt, um die in modulierte elektrische Ströme, insbesondere Fotoelektronenströme oder Spannungen beispielsweise eines Empfängerausgangssignals **S0** umgewandelte Modulation der Intensität **Iᵢₛₜ** der Fluoreszenzstrahlung **FL** rauscharm zu verstärken. Es wurde erkannt, dass die gepulste Pulsmodulation der Pumpstrahlung **LB** und damit die gepulste Pulsmodulation der Wechselanteil des Sendesignals **S5** bevorzugt kein 50% Tastverhältnis (Englisch Duty-Cycle) aufweisen sollte. Der der Wechselanteil des Sendesignals **S5** besitzt eine Amplitude des Wechselanteils des Sendesignals **S5.** Zu Beginn einer Modulationssignalperiode Tₚ liegt der Wert des Sendesignals **S5** beim Wert des Gleichanteils des Sendesignals **S5** minus dem Werts der Amplitude des Wechselanteils des Sendesignals **S5.** Der Wert des Sendesignals **S5** steigt dann auf den Wert aus der Summe des Werts der Amplitude des Wechselanteils des Sendesignals **S5** plus dem Wert des Gleichanteils des Sendesignals **S5** an. Für eine Modulationssignalplateauzeit verharrt dann der Wert des Sendesignals **S5** im Wesentlichen auf diesem Werteniveau, um dann mit einer Modulationssignalabfallszeit auf den Wert aus der Differenz Wert des Gleichanteils des Sendesignals **S5** minus dem Wert der Amplitude des Wechselanteils des Sendesignals **S5** abzufallen. Auf diesem Wert verharrt dann im Wesentlichen der Wert des Sendesignals **S5** bis zum Ende der Modulationssignalperiode Tₚ der Wert des Sendesignals **S5** dann wieder mit einer Modulationssignalanstiegszeit auf den Wert aus der Summe der Amplitude des Wechselanteils des Sendesignals **S5** plus dem Wert des Gleichanteils des Sendesignals **S5** ansteigt. Bevorzugt wird der maximale Wert der Pulse des Wechselanteils des Sendesignals **S5** in Form der Summe der Amplitude des Wechselanteils des Sendesignals **S5** plus dem Wert des Gleichanteils des Sendesignals **S5** maximiert, um eine maximale Intensität der Pumpstrahlung **LB** zu den Zeiten zu erreichen, in denen die Pumpstrahlungsquelle, hier die Lichtquelle **LED,** Pumpstrahlung **LB** aussendet. Dies hat den Zweck, den Kontrast zu maximieren, da der Kontrast nicht linear von der Intensität der Pumpstrahlung **LB,** die die paramagnetischen Zentren erreicht, abhängt und zu großen Intensitäten Pumpstrahlung **LB** hinzunimmt. Dies ist für einzelne NV-Zentren in Diamant, also nicht für HD-NV-Diamanten, wie sie hier beschrieben sind, beispielsweise aus der Schrift Staacke, R., John, R., Wunderlich, R., Horsthemke, L, Knolle, W., Laube, C, Glösekötter, P., Burchard, B., Abel, B., Meijer, J. (2020), "Isotropic Scalar Quantum Sensing of Magnetic Fields for Industrial Application", Adv. Quantum Technol., doi:10.1002/qute.202000037, bekannt. Wir verweisen insbesondere auf die Figuren 3b und 3d jener Schrift. Durch eine hohe Dichte an paramagnetischen Zentren in den Diamant-Nano-Kristallen **ND,** wie beispielsweise durch eine hohe Dichte an NV-Zentren wie in einem HD-NV-Diamanten, wie er in den Schriften DE 10 2021 132 780 A1, DE 10 2021 132 781 A1, DE 10 2021 132 782 A1, DE 10 2021 132 783 A1, DE 10 2021 132 784 A1, DE 10 2021 132 785 A1, DE 10 2021 132 786 A1, DE 10 2021 132 787 A1, DE 10 2021 132 788 A1, DE 10 2021 132 790 A1, DE 10 2021 132 791 A1, DE 10 2021 132 793 A1, DE 10 2021 132 794 A1,
beschrieben wird, kann der Kontrast über das in jenen Schriften gezeigte Maß hinaus gesteigert werden.

Das Tastverhältnis des Sendesignals **S5** wird hierbei als Modulationssignalpulsdauer dividiert durch die Modulationssignalperiode Tₚ definiert. Modulationssignalpulsdauer plus Modulationssignalkomplementärzeit sind hier gleich der Modulationssignalperiode. Bevorzugt ist der Wechselanteil des Sendesignals **S5** mit einem Tastverhältnis des Wechselanteils des Sendesignals **S5** kleiner 50% und/oder besser kleiner 40% und/oder besser kleiner 30% und/oder besser kleiner 20% und/oder besser kleiner 10% pulsmoduliert. Bevorzugt handelt es sich also um einen ultrakurzen Puls mit möglichst hoher Amplitude. Bevorzugt ist dementsprechend das LED-Modulationssignal **S5w** daher mit einem Tastverhältnis kleiner 50% und/oder besser kleiner 40% und/oder besser kleiner 30% und/oder besser kleiner 20% und/oder besser kleiner 10% pulsmoduliert. Bevorzugt handelt es sich also um einen ultrakurzen Puls. Dieser ultrakurze Puls wird bevorzugt mit möglichst große Verstärkung in einen entsprechenden kurzen, möglichst intensiven Intensitätspuls der Intensität der Pumpstrahlung **LB** gewandelt. Da die Pumpstrahlungsquelle, hier die Lichtquelle **LED,** mit dem Sendesignal **S5** angesteuert wird, reproduziert sie typischerweise verzögert um eine Sendverzögerung im Wesentlichen das Sendesignal **S5.** Für die Berechnung vieler Anwendungen kann diese Sendverzögerung zu 0 s zur Vereinfachung angenommen werden. Dabei wird die Pumpstrahlungspulsdauer hier so definiert, dass der Intensitätspuls der Intensität der Pumpstrahlung **LB** ein Pumpstrahlungsintensitätsmaximum aufweist und dass die Pumpstrahlungsimpulsdauer eines Intensitätspulses der Pumpstrahlung **LB** mit dem ersten Zeitpunkt des Überschreitens von 50% des Intensitätswerts des Pumpstrahlungsintensitätsmaximums minus dem ggf. vorhandenen Bias-Wert der Intensität der Pumpstrahlung **LB,** durch die momentane Intensität des Intensitätspulses der Pumpstrahlung **LB** minus dem ggf. vorhandenen Bias-Wert der Intensität der Pumpstrahlung **LB** beginnt und dass die Pumpstrahlungsimpulsdauer eines Intensitätspulses der Pumpstrahlung **LB** mit dem zweiten Zeitpunkt des Unterschreitens von 50% des Intensitätswerts des Pumpstrahlungsintensitätsmaximums minus dem ggf. vorhandenen Bias-Wert der Intensität der Pumpstrahlung LB, durch die momentane Intensität des Intensitätspulses der Pumpstrahlung **LB** minus dem ggf. vorhandenen Bias-Wert der Intensität der Pumpstrahlung **LB** endet.

### ZPL-Tabelle

Die Tabelle ist nur eine beispielhafte Zusammenstellung einiger möglicher paramagnetischer Zentren, die in Kristallen, die die Funktion der Diamant-Nano-Kristalle ND in diesem Dokument wahrnehmen können. Die funktionaläquivalente Nutzung anderer paramagnetischer Zentren in anderen Materialien der Kristalle ist ausdrücklich möglich. Für andere Kristalle und/oder paramagnetische Zentren als NV-Zentren ist eine Erprobung notwendig. Die Pumpstrahlungswellenlängen λₚₘₚ der Pumpstrahlung **LB** sind ebenfalls beispielhaft. Andere Pumpstrahlungswellenlängen **λₚₘₚ** sind in der Regel möglich, wenn sie kürzer als die Wellenlänge der anzuregenden ZPL sind.

| Material Störstellenzentrum des Kristalls | ZPL | beispielhafte | | Referenz | |
|---|---|---|---|---|---|
| | | | Pumpstrahlungs wellenlänge (λₚₘₚ) | | |
| **ND** | | | | | |
| Diamant | NV-Zentrum | | 520nm, 532nm | | |
| Diamant | SiV-Zentrum | 738 nm | 685 nm | /2/, /3/, /4/ | |
| Diamant | GeV-Zentrum | 602 nm | 532 nm | | /4/, /5/ |
| Diamant | SnV-Zentrum | 620 nm | 532 nm | | /4/, /6/ |
| Diamant | PbV-Zentrum | 520 nm, | 450 nm | | /4/, /7/ |
| | | 552 nm | | | /4/, /7/ |
| | | 715 nm | 532 nm | | /7/ |
| Diamant | ST1-Zentrum | 555 nm | 532 nm | | /15/ |
| Diamant | TR12-Zentrum | 471 nm | 410 nm | | /16/ |
| Silizium | G-Zentrum | 1278,38 nm | 637 nm | | /8/ |
| Siliziumkarbid | V_{SI}-Zentrum | 862 nm(V1) 4H, 1330 nm | | /1/, /9/, /10/ | |
| | | 858,2 nm(V1') 4H | 1330 nm | | /1/, /9/, /10/ |
| | | 917 nm(V2) 4H, 1330 nm | | /1/, /9/, /10/ | |
| | | 865 nm(V1) 6H, 1330 nm | | /1/, /9/, /10/ | |
| | | 887 nm(V2) 6H, 1330 nm | | /1/, /9/, /10/ | |
| | | 907 nm(V3) 6H | 1330 nm | | /1/, /9/, /10/ |
| Siliziumkarbid | DV-Zentrum | 1078-1132 nm 6H | 1330 nm | | /9/ |
| Siliziumkarbid | V_{C}V_{SI}-Zentrum | 1093-1140 nm 6H | 1330 nm | | /9/ |
| Siliziumkarbid | CAV-Zentrum | 648.7 nm 4H, 6H, 3C | 1330 nm | | /9/ |
| | | 651.8 nm 4H, 6H, 3C | 1330 nm | | /9/ |
| | | 665.1 nm 4H, 6H, 3C | 1330 nm | | /9/ |
| | | 668.5 nm 4H, 6H, 3C | 1330 nm | | /9/ |
| | | 671.7 nm 4H, 6H, 3C | 1330 nm | | /9/ |
| | | 673 nm 4H, 6H, 3C | 1330 nm | | /9/ |
| | | 675.2 nm 4H, 6H, 3C | 1330 nm | | /9/ |
| | | 676.5 nm 4H, 6H, 3C | 1330 nm | | /9/ |
| Siliziumkarbid | N_{C}V_{SI}-Zentrum | 1180 nm-1242 nm 6H | 1330 nm | | /9/, /13/, /14/ |

### Liste der Referenzliteratur zu obiger Tabelle

/1/ Marina Radulaski, Matthias Widmann, Matthias Niethammer, Jingyuan Linda Zhang, Sang-Yun Lee, Torsten Rendler, Konstantinos G. Lagoudakis, Nguyen Tien Son, Erik Janzén, Takeshi Ohshima, Jörg Wrachtrup, Jelena Vučkovič, "Scalable Quantum Photonics with Single Color Centers in Silicon Carbide", Nano Letters 17 (3), 1782-1786 (2017), DOI: 10.1021/acs.nanolett.6b05102, arXiv:1612.02874
/2/ C. Wang, C. Kurtsiefer, H. Weinfurter, and B. Burchard, "Single photon emission from SiV centres in diamond produced by ion implantation" J. Phys. B: At. Mol.Opt. Phys., 39(37), 2006
/3/ Björn Tegetmeyer, "Luminescence properties of SiV-centers in diamond diodes" Promotionsschrift, Universität Freiburg, 30.01.2018
/4/ Carlo Bradac, Weibo Gao, Jacopo Forneris, Matt Trusheim, Igor Aharonovich, "Quantum Nanophotonics with Group IV defects in Diamond", DOI: 10.1038/s41467-020-14316-x, arXiv:1906.10992
/5/ Rasmus Høy Jensen, Erika Janitz, Yannik Fontana, Yi He, Olivier Gobron, Ilya P. Radko, Mihir Bhaskar, Ruffin Evans, Cesar Daniel Rodriguez Rosenblueth, Lilian Childress, Alexander Huck, Ulrik Lund Andersen, "Cavity-Enhanced Photon Emission from a Single Germanium-Vacancy Center in a Diamond Membrane", arXiv:1912.05247v3 [quant-ph] 25 May 2020
/6/ Takayuki Iwasaki, Yoshiyuki Miyamoto, Takashi Taniguchi, Petr Siyushev, Mathias H. Metsch, Fedor Jelezko, Mutsuko Hatano, "Tin-Vacancy Quantum Emitters in Diamond", Phys. Rev. Lett. 119, 253601 (2017), DOI: 10.1103/PhysRevLett.119.253601, arXiv:1708.03576 [quant-ph]
/7/ Matthew E. Trusheim, Noel H. Wan, Kevin C. Chen, Christopher J. Ciccarino, Ravishankar Sundararaman, Girish Malladi, Eric Bersin, Michael Walsh, Benjamin Lienhard, Hassaram Bakhru, Prineha Narang, Dirk Englund, "Lead-Related Quantum Emitters in Diamond" Phys. Rev. B 99, 075430 (2019), DOI: 10.1103/PhysRevB.99.075430, arXiv:1805.12202 [quant-ph]
/8/ M. Hollenbach, Y. Berencén, U. Kentsch, M. Helm, G. V. Astakhov "Engineering telecom single-photon emitters in silicon for scalable quantum photonics" Opt. Express 28, 26111 (2020), DOI: 10.1364/OE.397377, arXiv:2008.09425 [physics.app-ph]
/9/ Castelletto and Alberto Boretti, "Silicon carbide color centers for quantum applications" 2020 J. Phys. Photonics2 022001
/10/ V. Ivády, J. Davidsson, N. T. Son, T. Ohshima, I. A. Abrikosov, A. Gali, "Identification of Si-vacancy related room-temperature qubits in 4H silicon carbide", Phys. Rev.B, 2017, 96,161114
/11/ J. Davidsson, V. Ivády, R. Armiento, N. T. Son, A. Gali, I. A. Abrikosov, "First principles predictions of magneto-optical data for semiconductor point defect identification: the case of divacancy defects in 4H-SiC", New J. Phys., 2018, 20, 023035
/12/ J. Davidsson, V. Ivády, R. Armiento, T. Ohshima, N. T. Son, A. Gali, I. A. Abrikosov "Identification of divacancy and silicon vacancy qubits in 6H-SiC", Appl. Phys. Lett. 2019, 114, 112107
/13/ S. A. Zargaleh, S. Hameau, B. Eble, F. Margaillan, H. J. von Bardeleben, J. L. Cantin, W. Gao , "Nitrogen vacancy center in cubic silicon carbide: a promising qubit in the 1.5µm spectral range for photonic quantum networks" Phys. Rev.B, 2018, 98, 165203
/14/ S. A. Zargaleh et al "Evidence for near-infrared photoluminescence of nitrogen vacancy centers in 4H-SiC" Phys. Rev.B, 2016, 94, 060102
/15/ P. Balasubramanian, M. H. Metsch, Reddy, R. Prithvi, J. Lachlan, N. B. Manson, M. W. Doherty, F. Jelezko, "Discovery of ST1 centers in natural diamond" Nanophotonics, Vol. 8, Nr. 11, 2019, Seiten 1993-2002. https://doi.org/10.1515/nanoph-2019-0148
/16/ J. Foglszinger, A. Denisenko, T. Kornher, M. Schreck, W. Knolle, B. Yavkin, R. Kolesov, J. Wrachtrup "ODMR on Single TR12 Centers in Diamond" arXiv:2104.04746v1 [physics.optics]

### Radiowellen vs. Mikrowellen

Radiowellen des Niederfrequenzbereiches sind im Sinne des hier vorgelegten Dokuments elektromagnetische Strahlungswellen in einem Frequenzbereich von 3Hz bis 30kHz, dem Niederfrequenzbereich.

Radiowellen des Radiowellenfrequenzbereiches sind im Sinne des hier vorgelegten Dokuments elektromagnetische Strahlungswellen in einem Frequenzbereich von 30kHz bis 300MHz, dem Radiowellenfrequenzbereich.

Mikrowellen des Mikrowellenfrequenzbereiches sind im Sinne des hier vorgelegten Dokuments elektromagnetische Strahlungswellen in einem Frequenzbereich von 300MHz bis 300GHz, dem Mikrowellenfrequenzbereich.

### Streifenleitungstechnik für Wellenleiter

Die Streifenleitungstechnologie für die Verwendung im Zusammenhang mit Wellenleitern, insbesondere die hier erwähnten beispielhaften Wellenleitern **(1380, 1880, 2380, 6880, 6980),** ist eine Methode zur Übertragung elektrischer Signale vorzugsweise in Hochfrequenzanwendungen. Dabei werden die Leiterbahnen (Signalleitungen **1310, 1320, 1330, 6810, 6820)** auf einer isolierenden Substratschicht (Trägersubstrat **1360)** angeordnet, um eine effiziente und kontrollierte Signalübertragung zu ermöglichen. Hier sind einige der wichtigsten Funktionselemente der Streifenleitungstechnologie:
1. Leiterbahnen: In der Streifenleitungstechnologie umfassen die Leiterbahnen (Signalleitungen **1310, 1320, 1330, 6810, 6820)** Metallstreifen, die auf dem Substrat (Trägersubstrat **1360)** angebracht sind. Diese Metallstreifen Leiterbahnen (Signalleitungen **1310, 1320, 1330, 6810, 6820)** dienen zur Übertragung des elektrischen Signals.
2. Substrat(Trägersubstrat **1360):** Das Substrat (Trägersubstrat **1360)** ist eine elektrisch isolierende Schicht, auf der die Leiterbahnen (Signalleitungen **1310, 1320, 1330, 6810, 6820)** platziert werden. Typischerweise besteht das Substrat (Trägersubstrat **1360)** aus Materialien wie FR-4 (Flameresistent-4) oder PTFE (Polytetrafluorethylen) oder aus halbleiten Materialien, wie beispielsweise Stücken von Halbleiterwafern, beispielsweise Stücken von CMOS-Wafern oder beispielsweise Stücken von BiCMOS-Wafern beispielsweise Stücken von Wafern aus einer Bipolar-Technologie und/oder beispielsweise Stücken von MEMS-Wafern und/oder beispielsweise Stücken von MEOS-Wafern (MEOS= micro electro optical system) und/oder beispielsweise Stücken von MOEMS-Wafern etc. Beispielsweise können diese Stücke von CMOS-Wafern oder Stücken von BiCMOS-Wafern oder Stücke von Wafern aus einer Bipolar-Technologie oder Stücke eines Wafers aus einem III/V-Material oder dergleichen und/oder Stücke von MEMS-Wafern und/oder Stücke von MEOS-Wafern (MEOS= micro electro optical system) und/oder Stücke von MOEMS-Wafern mikroelektronische Schaltkreise und Funktionselemente und/oder mikrooptische Funktionselemente und/oder Mikromechanische Funktionselemente und/oder mikrofluidische Funktionselemente umfassen. Die se wiederum können Unterfunktionselemente umfassen, die mit den paramagnetischen Zentren und/oder NV-Zentren der Sensorelementschicht **14305** und oder Sensorelementen **SE** wechselwirken.
3. Dielektrikum: Das Dielektrikum ist das isolierende Material, das die Leiterbahnen (Signalleitungen **1310, 1320, 1330, 6810, 6820)** umgibt und sie voneinander trennt. Es wird verwendet, um die Signalintegrität der Signale auf den Leiterbahnen (Signalleitungen **1310, 1320, 1330, 6810, 6820)** zu erhalten und unerwünschte Signalverluste zu minimieren. Bei Streifenleitungen (z.B. Wellenleiter **1380, 1880, 2380, 6880, 6980)** wird häufig Luft oder ein spezielles Dielektrikum mit niedrigem Verlust wie beispielsweise PTFE verwendet.
4. Impedanzkontrolle (Kontrolle des Wellenwiderstands): In der Streifenleitungstechnologie ist die Impedanzkontrolle des Wellenwiderstands der Wellenleitungen (z.B. Wellenleiter **1380, 1880, 2380, 6880, 6980)** ein wichtiger Aspekt. Die Breite und Geometrie der Leiterbahnen (Signalleitungen **1310, 1320, 1330, 6810, 6820)** sowie die Eigenschaften des Dielektrikums werden so gestaltet, dass die gewünschte Impedanz (Wellenwiderstand) des Übertragungssystems erreicht wird. Dies gewährleistet eine effiziente Signalübertragung und minimiert Reflexionen.
5. Abschlusswiderstände **(6710):** Abschlusswiderstände **(6710)** werden am Ende einer Streifenleitung (Signalleitungen **1310, 1320, 1330, 6810, 6820)** platziert, um Reflexionen zu minimieren und die Signalintegrität zu verbessern. Sie werden verwendet, um die Impedanz (Wellenwiderstand) der Streifenleitung Wellenleitungen (z.B. Wellenleiter **1380, 1880, 2380, 6880, 6980)** abzuschließen und eine effiziente Signalübertragung zu gewährleisten.
6. Verbindungsstrukturen: In der Streifenleitungstechnologie werden verschiedene Verbindungsstrukturen wie T-Verbinder, Kreuzverbinder und S-Verbinder verwendet, um Leiterbahnen(Signalleitungen **1310, 1320, 1330, 6810, 6820)** und/oder verschiedene Streifenleitungen (z.B. Wellenleiter **1380, 1880, 2380, 6880, 6980)** miteinander zu verbinden, Signale zu verzweigen oder zu kombinieren.

Diese Funktionselemente sind grundlegend für die Gestaltung und den Betrieb von Streifenleitungen in Hochfrequenzanwendungen. Sie ermöglichen eine präzise Signalübertragung und eine hohe Leistungsfähigkeit in Bereichen wie der Hochfrequenzkommunikation, Mikrowellen- und Radartechnik, Leistungselektronik und vielem mehr.

Unter Wikipedia (https://de.wikipedia.org/wiki/Streifenleitung) finden sich folgende Funktionselemente (Zitat):
*"Einfache Bauelemente wie Kondensatoren und Induktivitäten lassen sich direkt durch besonders dimensionierte Streifen erzeugen. So haben lange, dünne Leiter eine induktive, dagegen breite, kurze eine kapazitive Wirkung. Neben diesen klassischen Bauelementen lassen sich noch weitere für die Hochfrequenztechnik typische Bauelemente direkt mit Streifen realisieren.*

*Dazu gehören:*
- *Sumpf (reflexionsfreier Abschluss)*
- *Impedanzanpassung, induktive oder kapazitive Kopplung*
- *Reflektor, Reihenschwingkreis, Parallelschwingkreis*

*Aus diesen Grundelementen lassen sich komplexere Funktionseinheiten herstellen:*
- *Richtkoppler*
- *Leistungsteiler*
- *Filter (Bandpass, Bandsperre, Hochpass, Tiefpass)*
- *Frequenzweichen*
- *Übertrager zur Aus- und Einkopplung, Potentialtrennung, Impedanz- oder Symmetrieanpassung Diskrete Bauelemente, wie sie auf normalen Platinen verwendet werden, können auch auf eine Mikrostreifenleiterschaltung gelötet werden, wenn man ihre Abmessungen und gegenseitige Beeinflussung berücksichtigt. Besonders geeignet sind SMD-Bauteile. Teilweise werden auch SMD-Bauformen speziell für diesen Fall gestaltet. Das ist besonders bei aktiven Elementen wie Transistoren oder Dioden der Fall."*

In der Mikrostreifenleitungstechnik lassen sich verschiedene Mikrowellenbauelemente realisieren. Hier sind einige der wichtigsten:
1. Mikrostreifenleitung: Eine Mikrostreifenleitung ist eine geprägte Leiterbahn auf einer Dielektrikumsschicht, die auf einem leitenden Substrat liegt. Sie dient als Übertragungsmedium für Mikrowellensignale.
2. Mikrostreifen-Übergang: Ein Mikrostreifen-Übergang ermöglicht den Anschluss von zwei Mikrostreifenleitungen mit unterschiedlichen Impedanzen.
3. Mikrostreifenfilter: Ein Mikrostreifenfilter ist ein elektronisches Bauelement, das verwendet wird, um bestimmte Frequenzbereiche in einem Mikrowellensignal zu filtern. Es kann beispielsweise als Tiefpassfilter, Hochpassfilter oder Bandpassfilter ausgelegt sein.
4. Mikrostreifen-Koppler: Ein Mikrostreifen-Koppler wird verwendet, um ein Mikrowellensignal von einer Mikrostreifenleitung auf eine andere zu übertragen. Es gibt verschiedene Arten von Kopplern, wie z.B. Richtkoppler, Hybridkoppler und Ringkoppler.
5. Mikrostreifen-Phasenschieber: Ein Mikrostreifen-Phasenschieber ist ein Bauelement, das verwendet wird, um die Phase eines Mikrowellensignals zu ändern. Es kann für Phasenmodulation, Phasensteuerung oder Phasenanpassung eingesetzt werden.
6. Mikrostreifen-Verzögerungsleitung: Eine Mikrostreifen-Verzögerungsleitung ist eine spezielle Form der Mikrostreifenleitung, die verwendet wird, um die Laufzeit von Mikrowellensignalen zu verzögern. Sie kann zur Phasenkorrektur, zur Signalverarbeitung oder zur Erzeugung von Verzögerungselementen eingesetzt werden.
7. Mikrostreifen-Schaltkreiselemente: In der Mikrostreifenleitungstechnik können auch verschiedene Schaltkreiselemente realisiert werden, wie z.B. Mikrostreifen-Dioden, Mikrostreifen-Transistoren, Mikrostreifen-Induktoren und Mikrostreifen-Kapazitäten. Diese werden in der Regel für aktive Schaltungen und passive Komponenten verwendet.

Es gibt noch viele weitere Mikrowellenbauelemente, die in der Mikrostreifenleitungstechnik eingesetzt werden können. Die genannten Beispiele sollten jedoch einen Überblick über die grundlegenden Bauelemente geben. Die Verwendung dieser Funktionselemente zusammen mit den Sensorelementen **SE** und/oder Sensorelementschichten **14305** im Sinne des hier vorgelegten Dokuments sind Teil der Offenlegung des hier vorgelegten Dokuments.

### Allgemeines zu verschiedenen Wellenleitungstypen

Dieser Abschnitt soll für beliebige Wellenleitungen und somit für das ganze Dokument gelten.

Das hier vorgelegte Dokument erwähnt nur der Vollständigkeit halber, dass grundsätzlich immer das Vorhandensein ein oder mehrerer Sensorelemente **SE(1410, 1420, 1430, 7110, 7120, 2210, 2410, 2420, 2430, 4410)** auf einer Wellenleitung, hier der beispielhaften differentiellen Tri-Plate-Leitung **6980** und/oder der beispielhaften differentiellen Mikrostreifenleitung **6880** und/oder der beispielhaften Mikrostreifenleitung **1330** und/oder der beispielhaften Schlitzleitung **1880** und/oder der beispielhaften Tri-Plate-Leitung **2380** und/oder anderen vorzugsweise planaren Wellenleitern möglich ist. Dabei können immer mehre verschiedene dieser Typen von Sensorelemente **SE** zu einem Sensorelement **SE** "verschmolzen" sein.

Vorzugsweise ist jedem dieser Sensorelemente **SE** zumindest ein Sensorelementkanal zugeordnet.

Sofern einem Sensorelemente **SE** mehr als ein Sensorelementkanal zugeordnet sind, sollte bevorzugt das Sensorelement unterschiedliche paramagnetische Zentren mit mindestens zwei unterschiedlicher Pumpstrahlungswellenlängen **λₚₘₚ** aufweisen und bevorzugt jeder Sensorelementkanal der mindestens zwei zugeordneten Sensorelementkanäle eine Pumpstrahlungswellenlänge **λₚₘₚ** dieser Pumpstrahlungswellenlängen **λₚₘₚ** verwenden, die von den Pumpstrahlungswellenlängen **λₚₘₚ** , die die anderen Sensorelementkanäle dieses Sensorelements **SE** verwenden, verschieden ist.

Einem Sensorelementkanal kann grundsätzlich im Sinne dieses Dokuments auch mehr als ein Sensorelement **SE** zugeordnet sein.

Das hier vorgelegte Dokument erwähnt nur der Vollständigkeit halber, dass grundsätzlich immer das Vorhandensein ein oder mehrerer Sensorelemente **SE(1410, 1420, 1430, 7110, 7120, 2210, 2410, 2420, 2430, 4410)** auf einer Wellenleitung, hier der beispielhaften differentiellen Tri-Plate-Leitung **6980,** möglich ist. Dabei können ein oder mehr der Sensorelemente **SE** Nanokristalle **ND** mit paramagnetischen Zentren an Stelle der Diamant-Nano-Kristalle **ND** und deren paramagnetischen Zentren umfassen. Diese Nanokristalle **ND** mit paramagnetischen Zentren an Stelle der Diamant-Nano-Kristalle **ND** und deren paramagnetischen Zentren können insbesondere andere Kristalle als Diamantkristalle umfassen und daher andere paramagnetische Zentren als die hier erwähnten paramagnetischen Zentren in Diamant-Nanokristallen **ND** umfassen.

Im Falle der Verwendung solcher anderen Nanokristalle **ND** und/oder anderen paramagnetischen Zentren in Sensorelementen **SE** sollte insbesondere die Pumpstrahlungswellenlänge **λₚₘₚ** der Pumpstrahlungsquelle, insbesondere der Lichtquelle **LED,** des einem solchen Sensorelements **SE** zugeordneten Sensorelementkanals auf diese anderen paramagnetischen Zentren dieser ggf. anderen Nanokristalle **ND** angepasst sein. Vorzugsweise sollte LED-Modulationsfrequenz **f_{LED}** zumindest zwischen Sensorelementkanälen mit unterschiedlichen Pumpstrahlungswellenlängen **λₚₘₚ** unterschiedlich sein.

Im Falle der Verwendung solcher anderen Nanokristalle **ND** und/oder anderen paramagnetischen Zentren in Sensorelementen **SE** sollten ggf. auch die anderen Vorrichtungsteile der Sensorelementkanäle und/oder die Parameter zu deren Betrieb des einem solchen Sensorelements **SE** zugeordneten Sensorelementkanals auf diese anderen paramagnetischen Zentren dieser ggf. anderen Nanokristalle **ND** angepasst sein.

Die Positionierung der Struktur der Figur 2 in der zweidimensionalen Parameterfläche aus magnetischer Gesamtflussdichte **B_{Σ}** bzw. zusätzlicher magnetischer Flussdichte **B_{ad}** einerseits und deren Form ist von den verwendeten Nanokristallen bzw. Diamant-Nano-Kristallen **ND** und den verwendeten paramagnetischen Zentren abhängig. Typischerweise ist das Vorhandensein einer Struktur ähnlich der der Figur 2 für einen als Diamant-Nano-Kristall **ND** eingesetzten Kristall und dessen Kristallmaterial sowie die in diesem Kristall benutzten und verwendeten paramagnetischen Zentren Voraussetzung für die Anwendung der hier beschriebenen technischen Lehre. Sofern andere Kristalle aus einem Material anders als Diamant und/oder andere paramagnetische Zentren als NV-Zentren in Diamant eingesetzt werden sollen, sollte bei einer Nacharbeit die Struktur der Figur 2 oder eine funktionsäquivalente Struktur in entsprechenden Messwerten nachgewiesen werden.

Somit kann durch die Mikrowellenfrequenz **f_{µW}** die Selektion unterschiedlicher paramagnetischer Zentren vorgenommen werden. Es ist daher denkbar, dass eines oder mehr Sensorelemente **SE** verschiedene Nanokristalle **ND** mit paramagnetischen Zentren an Stelle der Diamant-Nano-Kristalle **ND** und deren paramagnetischen Zentren und/oder Diamant-Nano-Kristalle **ND** mit verschiedenen paramagnetischen Zentren, beispielsweise SiV-Zentren und NV-Zentren, umfassen. Somit kann die vorgeschlagene Vorrichtung durch Verwendung unterschiedlicher Mikrowellenfrequenz **f_{µW}** unterschiedliche paramagnetische Zentren und damit ggf. auch unterschiedliche Sensorelemente **SE** adressieren.

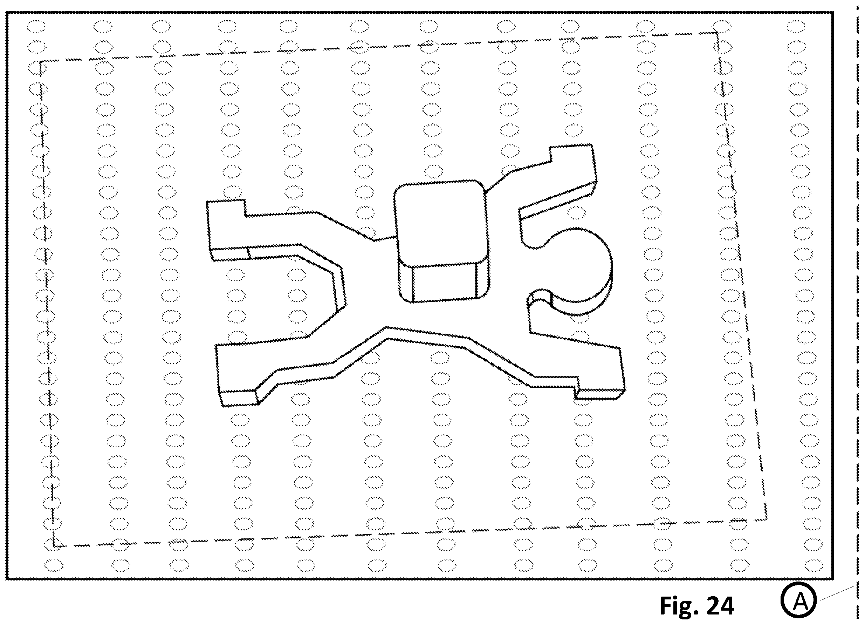

Wie in den Beschreibungen der Figuren 13 bis 64 und 68 bis 134 dargestellt, kann durch eine unterschiedliche Positionierung und/oder Ausformung der Sensorelemente relativ zu den Vorrichtungselementen des jeweiligen Wellenleiters **(1380, 1880, 2380, 6880, 6980)** die Empfindlichkeit und Selektivität des jeweiligen Sensorelements **SE** bzgl. der magnetischen Gesamtflussdichte **B_{Σ}** und/oder der externen magnetischen Flussdichte **Bₑₓₜ** und/oder der zusätzlichen magnetischen Flussdichte **B_{ad}** und/oder der magnetischen Flussdichtekomponente **B_{µW}** des Mikrowellensignals **µW** gesteuert werden.

Des Weiteren kann durch die jeweilige LED-Modulationsfrequenz **f_{LED}** zwischen den Sensorelementen **SE** mit unterschiedlichen paramagnetischen Zentren unterschiedlicher zugehöriger Pumpstrahlungswellenlänge **λₚₘₚ** unterschieden werden.

### Sensorelementkanal

Ein Sensorelementkanal im Sinne des hier vorgelegten Dokuments umfasst einen Lichtquellentreiber **LDRV,** eine Pumpstrahlungsquelle **(LED),** erste optische Mittel **(LWL)** zum Transport der Pumpstrahlung **LB** zum Sensorelement **SE,** zweite optische Mittel **(LWL)** zum Transport der Fluoreszenzstrahlung **FL** des Sensorelements **SE** zum Fotodetektor **PD,** einen Fotodetektor **PD,** Mittel **(F1)** zum Abtrennen der Fluoreszenzstrahlung **FL** aus dem Gesamtstrahlungsspektrum vor dem Erreichen des Fotodetektors **PD,** ggf. Mittel **(1380, 1880, 2380, 6880, 6980, µWG)** zum Bestrahlen des Sensorelements **SE** mit elektromagnetischer Strahlung eines Mikrowellensignals **µW,** ggf. Mittel **(µWG)** zum Erzeugen des Mikrowellensignals **µW,** Mittel **(G1, S5, S5w)** zum Modulieren der Intensität der Pumpstrahlung **LB** der Pumpstrahlungsquelle **(LED)** mit einem LED-Modulationssignal **S5w,** Mittel **(G1)** zum Erzeugen des LED-Modulationssignals **S5w,** Mittel **(S5m, G2)** zum Modulieren der Amplitude des Mikrowellensignals **µW** mittels eines Mikrowellenmodulationssignals **S5m,** Mittel **(G2)** zum Erzeugen des Mikrowellenmodulationssignals **S5m,** Mittel **(V1)** zur Aufbereitung des Empfängerausgangssignals **S0** des Fotodetektors **PD** zu einem aufbereiteten (verstärktem, gefilterten und/oder digitalisierten) Empfängerausgangssignal **S1,** Mittel (**LIV**) zur Durchführung einer Mehrfachkorrelation zumindest zwischen dem aufbereiteten (verstärktem, gefilterten und/oder digitalisierten) Empfängerausgangssignal **S1,** dem LED-Modulationssignal **S5w** und ggf. dem Mikrowellenmodulationssignal **S5m** zur Erzeugung eines Korrelationsergebnisses beispielsweise zur Übergabe an die Steuervorrichtung **CTR.** Im Sinne des hier vorgelegten Dokuments ist das Sensorelement **SE** selbst nicht Teil des Sensorelementkanals. Ein Sensorsystem umfasst somit vorzugsweise zumindest ein Sensorelement SE, einen oder mehrere Sensorelementkanäle und eine Steuervorrichtung **CTR** mit Speichern **RAM, NVM** zur Steuerung des Sensorkanals und zur Steuerung der Vorrichtungsteile des Sensorsystems und zur Kommunikation mit übergeordneten Rechnersystemen. Vorzugsweise kann ein solches Sensorsystem beispielsweise weitere Komponenten, wie Mittel **(LCTR, LDRV, L_{c})** zur Erzeugung einer zusätzlichen magnetischen Flussdichte **B_{ad}** und/oder Mittel **(MS, SIS)** zur Messung der Gesamtflussdichte **B_{Σ}** umfassen und/oder Mittel **(MEV)** zur Mustererkennung umfassen.

### Potenzielle Wechselwirkung mit plasmonisch wirkenden Nanopartikeln im Sensorelement SE

Die Fluoreszenzstrahlung der NV-Zentren und/oder der anderen paramagnetischen Zentren in den Kristallen und/oder Diamant-Nano-Kristallen **ND** in den Trägermaterialien **TM** der Sensorelemente **SE** und insbesondere die Fluoreszenzwellenlänge λ_{fl} der Fluoreszenzstrahlung **FL** der NV-Zentren und/oder der anderen paramagnetischen Zentren in den Kristallen und/oder Diamant-Nano-Kristallen **ND** in den Trägermaterialien **TM** der Sensorelemente **SE** kann beispielsweise mittels plasmonischer Kopplung durch optionale metallische Nanopartikel, die den Trägermaterialien **TM** von Sensorelementen **SE** ebenfalls bei der Herstellung der kolloidalen Mischungen **KL** beigemischt werden, modifiziert werden. In dem Fall kann dann beispielsweise ein Trägermaterial **TM** der kolloidalen Mischung **KL** metallische Nanopartikel mit einem Durchmesser kleiner 200nm und/oder kleiner 100nm und/oder kleiner 50nm und/oder kleiner 20nm und/oder kleiner 10nm und/oder kleiner 5nm aufweisen, die später dann in dem verfestigten Trägermaterial **TM** der kolloidalen Mischung **KL** eingelagert sind. Dies verbessert die Anwendbarkeit in speziellen Anwendungsfällen.

Die metallischen Nanopartikel wechselwirken dann typischerweise plasmonisch mit den NV-Zentren und/oder den anderen paramagnetischen Zentren in den Kristallen und/oder Diamant-Nano-Kristallen **ND** in den Trägermaterialien **TM** der Sensorelemente **SE** und beeinflussen dann so die Fluoreszenzstrahlung **FL** dieser NV-Zentren und/oder der anderen paramagnetischen Zentren in den Kristallen und/oder Diamant-Nano-Kristallen **ND** in den Trägermaterialien **TM** der Sensorelemente **SE.**

Diese metallischen Nanopartikel weisen typischerweise Gold und/oder Platin und/oder Palladium und/oder Graphit und/oder Graphen und/oder Chrom und/oder Silizium und/oder Germanium und/oder Zinn und/oder Schwefel und/oder Selen und/oder Tellur und/oder Magnesium und/oder Kalzium und/oder Strontium und/oder Barium und/oder Titan und/oder Zirkon und/oder Hafnium und/oder Chrom und/oder Molybdän und/oder Wolfram und/oder Eisen und/oder Ruthenium und/oder Osmium und/oder Nickel und/oder Zinn und/oder Kadmium und/oder Quecksilber und/oder Cerium und/oder Neodym und/oder Samarium und/oder Gadolinium und/oder Dysprosium und/oder Erbium und/oder Ytterbium und/oder Thorium und/oder Proactinium und/oder Uran und/oder Plutonium auf. Wobei erstere besonders bevorzugt sind.

Die Atome des Metalls dieser optionalen Nanopartikel umfassen eines oder mehrerer Elemente des Periodensystems. Jedes dieser Elemente tritt in verschiedenen Isotopen in der Natur mit einem jeweiligen natürlichen Isotopenmischungsverhältnis auf. Jedes Isotop eines Elements weist dabei einen natürlichen Anteil entsprechend dem natürlichen Isotopenmischungsverhältnis dieses Elements auf. Hinsichtlich der dieser Anteile und der Werte verweist das hier vorgelegte Dokument auf die deutsche Patentanmeldung DE 10 2020 125 178 A1 der Anmelderin. Diese Isotope weisen jeweils ein magnetisches Kernmoment µ auf oder nichtaufweisen je nach Isotop. Bevorzugt weisen die metallischen Nanopartikel bei zumindest einem Element, das die metallischen Nanopartikel aufweisen, einen erhöhten Anteil im Isotopenmischungsverhältnis gegenüber dem natürlichen Anteil des Isotopenmischungsverhältnisses für zumindest eines der folgenden Isotope auf:
¹²C, ¹⁴C, ²⁸Si, ³⁰Si, ⁷⁰Ge, ⁷²Ge, ⁷⁴Ge, ⁷⁶Ge, ¹¹²Zn, ¹¹⁴Zn, ¹¹⁶Zn, ¹¹³Zn, ¹²⁰Zn, ¹²²Zn, ¹²⁴Zn, ¹⁶O, ¹⁸O, ³²S, ³⁴S, ³⁶S, ⁷⁴Se, ⁷⁶Se, ⁷⁸Se, ⁸⁰Se, ³²Se, ¹²⁰Te, ¹²²Te, ¹²⁴Te, ¹²⁶Te, ¹²⁸Te, ¹³⁰Te, ²⁴Mg, ²⁶Mg, ⁴⁰Ca, ⁴²Ca, ⁴⁴Ca, ⁴⁶Ca, ⁴³Ca, ⁸⁴Sr, ⁸⁶Sr, ⁸⁸Sr, ¹³⁰Ba, ¹³²Ba, ¹³⁴Ba, ¹³⁶Ba, ¹³⁸Ba, ⁴⁶Ti, ⁴⁸Ti, ⁵⁰Ti, ⁹⁰Zr, ⁹⁰Zr, ⁹²Zr, ⁹⁴Zr, ⁹⁶Zr, ¹⁷⁴Hf, ¹⁷⁶Hf, ¹⁷⁸Hf, ⁵⁰Cr, ⁵²Cr, ⁵³Cr, ⁹²Mo, ⁹⁴Mo, ⁹⁶Mo, ⁹³Mo, ¹⁰⁰Mo, ¹⁸⁰W, ¹⁸²W, ¹⁸⁴W, ¹⁸⁶W, ⁵⁴Fe, ⁵⁶Fe, ⁵⁸Fe, ⁹⁶Ru, ⁹⁸Ru, ¹⁰⁰Ru, ¹⁰²Ru, ¹⁰⁴Ru, ¹⁸⁴Os, ¹⁸⁶Os, ¹⁸³Os, ¹⁹⁰Os, ¹⁹²Os, ⁵⁸Ni, ⁶⁰Ni, ⁶²Ni, ⁶⁴Ni, ¹⁰²Pd, ¹⁰²Pd, ¹⁰⁴Pd, ¹⁰⁶Pd, ¹⁰⁸Pd, ¹¹⁰Pd, ¹⁹⁰Pt, ¹⁹²Pt, ¹⁹⁴Pt, ¹⁹⁶Pt, ¹⁹⁸Pt, ⁶⁴Zn, ⁶⁶Zn, ⁶³Zn, ⁷⁰Zn, ¹⁰⁶Cd, ¹⁰⁸Cd, ¹¹⁰Cd, ¹¹²Cd, ¹¹⁴Cd, ¹¹⁶Cd, ¹⁹⁶Hg, ¹⁹⁸Hg, ²⁰⁰Hg, ²⁰²Hg, ²⁰⁴Hg, ¹³⁶Ce, ¹³⁸Ce, ¹⁴⁰Ce, ¹⁴²Ce, ¹⁴²Nd, ¹⁴⁴Nd, ¹⁴⁶Nd, ¹⁴⁸Nd, ¹⁵⁰Nd, ¹⁴⁴Sm, ¹⁴⁶Sm, ¹⁴⁸Sm, ¹⁵⁰Sm, ¹⁵²Sm, ¹⁵⁴Sm, ¹⁵²Gd, ¹⁵⁴Gd, ¹⁵⁶Gd, ¹⁵⁸Gd, ¹⁶⁰Gd, ¹⁵⁶Dy, ¹⁵⁸Dy, ¹⁶⁰Dy, ¹⁶²Dy, ¹⁶⁴Dy, ¹⁶²Er, ¹⁶⁴Er, ¹⁶⁶Er, ¹⁶⁸Er, ¹⁷⁰Er, ¹⁶⁸Yb, ¹⁷⁰Yb, ¹⁷²Yb, ¹⁷⁴Yb, ¹⁷⁶Yb, ²³²Th, ²³⁴Pa, ²³⁴U, ²³⁸U, ²⁴⁴Pu.

### Liste der zitierten Schriften

### Patentliteratur

DE 10 2018 127 394 A1, DE 10 2019 120 076 A1, DE 10 2019 121 028 A1, DE 10 2020 101 784 B3,
DE 102020109477 A1, DE 10 2020 125 178 A1, DE 10 2020 129 319 A1, DE 10 2020 129 367 A1,
DE 10 2021 101 565 A1, DE 10 2021114 589.9, DE 10 2021 132 148 A1, DE 10 2021 132 780 A1,
DE 10 2021 132 781 A1, DE 10 2021 132 782 A1, DE 10 2021 132 783 A1, DE 10 2021 132 784 A1,
DE 10 2021 132 785 A1, DE 10 2021 132 786 A1, DE 10 2021 132 787 A1, DE 10 2021 132 788 A1,
DE 10 2021 132 790 A1, DE 10 2021 132 791 A1, DE 10 2021 132 793 A1, DE 10 2021 132 794 A1,
DE 10 2022 121 444.3, DE 10 2022 122 505.7, DE 10 2022 122 507.0, DE 10 2023 100 856.0,
DE 10 2023 100 857.9, DE 10 2023 111 858.7, DE 10 2023 111 859.5, DE 11 2020 003 569 A5,
DE 11 2020 004 650 A5, DE 20 2020 106 110 U,
EP 3 213 093 B1, EP 3 874 343 A2,
US 2017 / 0 322 244 A1, US 2022 / 0 307 997 A1,
WO 2001 073 935 A1, WO 2020 089 465 A1, WO 2020 239 172 A1, WO 2020 260 640 A1,
WO 2021 013 308 A1, WO 2021 083 448 A1, WO 2021 089 091 A1, WO 2021 018 654 A1,
WO 2021 151 479 A1

### Nicht-Patentliteratur

Keunhong Jeong, Anna J. Parker, Ralph H. Page, Alexander Pines, Christophoros C. Vassiliou, Jonathan P. King "Understanding the Magnetic Resonance Spectrum of Nitrogen Vacancy Centers in an Ensemble of Randomly Oriented Nanodiamonds", The Journal of Physical Chemistry C, 2017, 121 (38), p. 21057-21061, DOI: 10.1021/acs.ipcc.7b07247
R.K. Hoffmann "Integrierte Mikrowellenschaltungen: Elektrische Grundlagen, Dimensionierung, technische Ausführung, Technologien" Springer; 1. Edition (1. Juni 1983), ISBN-10: 3540123520, ISBN-13: 978-3540123521 Marc J. Madou "Fundamentals of Microfabrication: the science of miniaturization" CRC Press 2002
Röcke H., Meijer J., Stephan A., Weidenmüller U., Bukow H. H., Rolfs C. "White electroluminescent nanostructure in silicon fabricated using focused ion implantation" Nuclear Instruments and Methods in Physics Research B 181 (1001) Seite 274-279.
Baha E.A. Saleh, Malvin Carl Teich, "Grundlagen der Photonik"Wiley-VCH, 2007
Bernhard C. Kress, Patrick Meyreueis "Applied Digital Optics" Wiley, 2009
Burchard B., "Elektronische und optoelektronische Bauelemente und Bauelementstrukturen auf Diamantbasis" Dissertation, Hagen 1994.
K. Kurokawa, "Avalanche Breakdown Electroluminescence in Silicon Carbide Light Emitting Diodes", January 2000Materials Science Forum 338-342:691-694, DOI: 10.4028/www.scientific.net/MSF.338-342.691
Staacke, R., John, R., Wunderlich, R., Horsthemke, L, Knolle, W., Laube, C, Glösekötter, P., Burchard, B., Abel, B., Meijer, J. (2020), "Isotropic Scalar Quantum Sensing of Magnetic Fields for Industrial Application", Adv. Quantum Technol., doi:10.1002/qute.202000037,
Marina Radulaski, Matthias Widmann, Matthias Niethammer, Jingyuan Linda Zhang, Sang-Yun Lee, Torsten Rendler, Konstantinos G. Lagoudakis, Nguyen Tien Son, Erik Janzén, Takeshi Ohshima, Jörg Wrachtrup, Jelena Vučković, "Scalable Quantum Photonics with Single Color Centers in Silicon Carbide", Nano Letters 17 (3), 1782-1786 (2017), DOI: 10.1021/acs.nanolett.6b05102, arXiv:1612.02874
C. Wang, C. Kurtsiefer, H. Weinfurter, and B. Burchard, "Single photon emission from SiV centres in diamond produced by ion implantation" J. Phys. B: At. Mol.Opt. Phys., 39(37), 2006
Björn Tegetmeyer, "Luminescence properties of SiV-centers in diamond diodes" Promotionsschrift, Universität Freiburg, 30.01.2018
Carlo Bradac, Weibo Gao, Jacopo Forneris, Matt Trusheim, Igor Aharonovich, "Quantum Nanophotonics with Group IV defects in Diamond", DOI: 10.1038/s41467-020-14316-x, arXiv:1906.10992
Rasmus Høy Jensen, Erika Janitz, Yannik Fontana, Yi He, Olivier Gobron, Ilya P. Radko, Mihir Bhaskar, Ruffin Evans, Cesar Daniel Rodriguez Rosenblueth, Lilian Childress, Alexander Huck, Ulrik Lund Andersen, "Cavity-Enhanced Photon Emission from a Single Germanium-Vacancy Center in a Diamond Membrane", arXiv:1912.05247v3 [quant-ph] 25 May 2020
Takayuki Iwasaki, Yoshiyuki Miyamoto, Takashi Taniguchi, Petr Siyushev, Mathias H. Metsch, Fedor Jelezko, Mutsuko Hatano, "Tin-Vacancy Quantum Emitters in Diamond", Phys. Rev. Lett. 119, 253601 (2017), DOI: 10.1103/PhysRevLett.119.253601, arXiv:1708.03576 [quant-ph]
Matthew E. Trusheim, Noel H. Wan, Kevin C. Chen, Christopher J. Ciccarino, Ravishankar Sundararaman, Girish Malladi, Eric Bersin, Michael Walsh, Benjamin Lienhard, Hassaram Bakhru, Prineha Narang, Dirk Englund, "Lead-Related Quantum Emitters in Diamond" Phys. Rev. B 99, 075430 (2019), DOI: 10.1103/PhysRevB.99.075430, arXiv:1805.12202 [quant-ph]
M. Hollenbach, Y. Berencén, U. Kentsch, M. Helm, G. V. Astakhov "Engineering telecom single-photon emitters in silicon for scalable quantum photonics" Opt. Express 28, 26111 (2020), DOI: 10.1364/OE.397377, arXiv:2008.09425 [physics.app-ph]
Castelletto and Alberto Boretti, "Silicon carbide color centers for quantum applications" 2020 J. Phys. Photonics2 022001
V. Ivády, J. Davidsson, N. T. Son, T. Ohshima, I. A. Abrikosov, A. Gali, "Identification of Si-vacancy related room-temperature qubits in 4H silicon carbide", Phys. Rev.B, 2017, 96,161114
J. Davidsson, V. Ivády, R. Armiento, N. T. Son, A. Gali, I. A. Abrikosov, "First principles predictions of magneto-optical data for semiconductor point defect identification: the case of divacancy defects in 4H-SiC", New J. Phys., 2018, 20, 023035
J. Davidsson, V. Ivády, R. Armiento, T. Ohshima, N. T. Son, A. Gali, I. A. Abrikosov "Identification of divacancy and silicon vacancy qubits in 6H-SiC", Appl. Phys. Lett. 2019, 114, 112107
S. A. Zargaleh, S. Hameau, B. Eble, F. Margaillan, H. J. von Bardeleben, J. L. Cantin, W. Gao , "Nitrogen vacancy center in cubic silicon carbide: a promising qubit in the 1.5µm spectral range for photonic quantum networks" Phys. Rev.B, 2018, 98, 165203
S. A. Zargaleh et al "Evidence for near-infrared photoluminescence of nitrogen vacancy centers in 4H-SiC" Phys. Rev.B, 2016, 94, 060102
P. Balasubramanian, M. H. Metsch, Reddy, R. Prithvi, J. Lachlan, N. B. Manson, M. W. Doherty, F. Jelezko, "Discovery of ST1 centers in natural diamond" Nanophotonics, Vol. 8, Nr. 11, 2019, Seiten 1993-2002. https://doi.org/10.1515/nanoph-2019-0148
J. Foglszinger, A. Denisenko, T. Kornher, M. Schreck, W. Knolle, B. Yavkin, R. Kolesov, J. Wrachtrup "ODMR on Single TR12 Centers in Diamond" arXiv:2104.04746v1 [physics.optics]
IEEE Standard for Test Access Port and Boundary-Scan Architecture, IEEE Std 1149.1-2013 (Revision of IEEE Std 1149.1-2001) beschrieben.
IEEE Standard for Reduced-Pin and Enhanced-Functionality Test Access Port and Boundary-Scan Architecture IEEE Std 1149.7-2009
IEEE Supplement to Standard Test Access Port and Boundary-Scan Architecture (1149.1) IEEE Std 1149.1b-1994
IEEE Standard for Reduced-Pin and Enhanced-Functionality Test Access Port and Boundary-Scan Architecture, IEEE Std 1149.7-2022 (Revision of IEEE Std 1149.7-2009)
IEEE Standard for Access and Control of Instrumentation Embedded within a Semiconductor Device, IEEE Std 1687-2014 Ilja Fescenko, Andrey Jarmola, Igor Savukov, Pauli Kehayias, Janis Smits, Joshua Damron, Nathaniel Ristoff, Nazanin Mosavian und Victor M. Acosta "Diamond magnetometer enhanced by ferrite flux concentrators", Phys. Rev. Research 2, 023394, 24 June 2020,
DOI:https://doi.org/10.1103/PhysRevResearch.2.023394
Georgios Chatzidrosos, Joseph Shaji Rebeirro, Huijie Zheng, Muhib Omar, Andreas Brenneis, Felix M. Stürner, Tino Fuchs, Thomas Buck, Robert Rölver, Tim Schneemann, Peter Blümler, Dmitry Budker, Arne Wickenbrock, "Fiberized Diamond-Based Vector Magnetometers", Front. Photon., 20 August 2021, Sec. Quantum Optics, Volume 2 - 2021 | https://doi.org/10.3389/fphot.2021.732748
Yuji Hatano, Jaewon Shin, Daisuke Nishitani, Haruki Iwatsuka, Yuta Masuyama, Hiroki Sugiyama, Makoto Ishii, Shinobu Onoda, Takeshi Ohshima, Keigo Arai, Takayuki Iwasaki, Mutsuko Hatano, "Simultaneous thermometry and magnetometry using a fiber-coupled quantum diamond sensor" Appl. Phys. Lett. 118, 034001 (2021)
https://doi.org/10.1063/5.0031502,
https://de.wikipedia.org/wiki/Lichtwellenleiter
"https://de.wikipedia.org/wiki/Streifenleitung"
"https://de.wikipedia.org/wiki/Joint_Test_Action_Group"
"https://www.corelis.com/education/tutorials/boundary-scan/"
"https://de.wikipedia.org/wiki/Statistische_Versuchsplanung"
"https://www.norlandprod.com/adhesives/noa%2061.html"

## Patentansprüche

1. Verfahren zur Herstellung eines Lichtwellenleiters (LWL)
mit den Schritten
Bereitstellen (140) eines Lichtwellenleiters (LWL),
wobei der Lichtwellenleiter (LWL) ein erstes Ende und ein zweites Ende aufweist; Bereitstellen (145) eines flüssigen und mittels elektromagnetischer Strahlung einer Aushärtewellenlänge (λ_{H}) härtbaren Trägermaterials (TM),
wobei in das Trägermaterial (TM) eine Vielzahl von Diamanten (DM) und/oder Kristalle eingebettet sind und
wobei einer oder mehrere oder alle Diamanten (DM) dieser Diamanten (DM) und/oder Kristalle NV-Zentren (NVZ) und/oder andere paramagnetischen Zentren aufweisen und
wobei die NV-Zentren (NVZ) des Trägermaterials (TM) und/oder die anderen paramagnetischen Zentren des Trägermaterials (TM) bei Bestrahlung mit Pumpstrahlung (LB) einer Pumpstrahlungswellenlänge (λₚₘₚ) zumindest eine Fluoreszenzstrahlung (FL) emittieren;
Benetzen (150) des ersten Endes des Lichtwellenleiters (LWL), insbesondere auf eine Benetzungslänge (L_{B}) oder in einem Benetzungsbereich, mit dem Trägermaterial (TM), das die Vielzahl eingebetteter Diamanten (DM) und/oder Kristalle aufweist;
Bestrahlen (155) des Trägermaterials (TM) im Bereich des ersten Endes (ELWL1) des Lichtwellenleiters (LWL) mit elektromagnetischer Aushärtestrahlung, wobei die Wellenlänge dieser elektromagnetischen Strahlung, die Aushärtewellenlänge (λ_{H}), so gewählt ist, dass das Trägermaterial (TM) am ersten Ende (ELWL1) des Lichtwellenleiters (LWL) im bestrahlten Bereich zumindest teilweise aushärtet und sich zumindest teilweise in einen Festkörper wandelt; Entfernen (160) des nicht ausgehärteten Trägermaterials (TM), insbesondere mittels eines Lösungsmittels,
wobei der verbleibende Film des Trägermaterials (TM) am ersten Ende des Lichtwellenleiters (LWL) das Sensorelement (SE) bildet und
wobei das Bestrahlen (155) des Trägermaterials (TM) im Bereich des ersten Endes (ELWL1) des Lichtwellenleiters (LWL) ein Einspeisen (155) elektromagnetischer Aushärtestrahlung in das zweite Ende des Lichtwellenleiters (LWL) umfasst, wobei die Wellenlänge dieser elektromagnetischen Strahlung, die Aushärtewellenlänge (λ_{H}), so gewählt ist, dass das Trägermaterial (TM) am ersten Ende des Lichtwellenleiters (LWL) aushärtet und sich in einen Festkörper wandelt.

2. Verfahren nach Anspruch 1,
wobei das Trägermaterial (TM) bei der Bestrahlung mit der Aushärtestrahlung der Aushärtewellenlänge (λ_{H}) nur teilweise aushärtet.

3. Verfahren nach einem der Ansprüche 1 bis 2,
wobei die Strahlung der am zweiten Ende des Lichtwellenleiters zur Aushärtung eingespeisten Aushärtestrahlung UV-Strahlung mit einer Aushärtewellenlänge (λ_{H}) im Wellenlängenbereich von 1nm bis 400nm ist.

4. Verfahren nach einem der Ansprüche 1 bis 3
wobei der bereitgestellte Lichtwellenleiter (LWL)
- zumindest am ersten Ende des Lichtwellenleiters (LWL) einen Lichtwellenleiterkern (LWLC) aufweist und/oder
- zumindest am ersten Ende des Lichtwellenleiters mit einer lichtundurchlässigen Schicht beschichtet ist, die eine oder mehrere lichtdurchlässige Öffnungen, die Clearances, aufweist, und
wobei diese Strukturen des Lichtwellenleiters (LWL), der Lichtwellenleiterkern (LWLC) und/oder die Clearances, den Lichtaustritt der Aushärtestrahlung mit der Aushärtewellenlänge λ_{H} am ersten Ende des Lichtwellenleiters bereichsweise auf einen oder mehrere Austrittsbereiche begrenzen und
wobei das Verfahren in dem Trägermaterial (TM) beim Aushärten durch Einspeisung der Aushärtestrahlung mit der Aushärtewellenlänge λ_{H} am zweiten Ende (ELWL2) des Lichtwellenleiters (LWL)
- ein oder mehrere optische Funktionselemente (LWLL) und/oder
- ein oder mehrere Sensorelemente (SE) am ersten Ende (ELWL1) des Lichtwellenleiters (LWL) im Bereich des einen oder der mehreren Austrittsbereiche ausformt und
wobei das eine oder die mehreren so durch das Verfahren ausgeformte(n) optische(n) Funktionselement(e) (LWLL) und/oder das eine oder die mehreren so durch das Verfahren ausgeformte(n) Sensorelement(e) (SE) durch das Verfahren so eingerichtet werden, dass das eine oder die mehreren so durch das Verfahren ausgeformte(n) optischen Funktionselement(e) (LWLL) und/oder das eine oder die mehreren so durch das Verfahren ausgeformte(n) Sensorelement(e) (SE)
- mit dem Lichtwellenleiterkern (LWLC) am ersten Ende (ELWL1) des Lichtwellenleiters (LWL) und/oder
- mit der einen oder den mehreren Clearances am ersten Ende (ELWL1) des Lichtwellenleiters (LWL),
insbesondere durch das Verfahren selbstjustiert, optisch zusammenwirken,
- wenn am zweiten Ende (ELWL2) des Lichtwellenleiters (LWL) optische Strahlung, insbesondere Pumpstrahlung (LB) mit der Pumpstrahlungswellenlänge (λₚₘₚ) eingespeist wird und/oder
- wenn am ersten Ende (ELWL1) des Lichtwellenleiters (LWL) NV-Zentren (NVZ) innerhalb des Trägermaterials (TM) und/oder andere paramagnetische Zentren innerhalb des Trägermaterials (TM) eine Fluoreszenzstrahlung (FL) emittieren.

5. Verfahren nach einem oder mehreren der Ansprüche 1 bis 4,
wobei der bereitgestellte Lichtwellenleiter (LWL) mit einem oder mehreren Wellenleitern (1380, 1880, 2380, 6880, 6980) beschichtet ist, die zum Einspeisen eines Mikrowellensignals (µW) in den einen oder die mehreren Wellenleiter (1380, 1880, 2380, 6880, 6980) eingerichtet sind und die zum Bestrahlen der paramagnetischen Zentren und/oder NV-Zentren in Diamant mit einem modulierten Mikrowellensignal (µW) eingerichtet sind und die insbesondere Clearances aufweisen.

## Claims

1. A method for manufacturing an optical fiber (LWL) (light wave guide)
comprising the steps
providing (140) an optical fiber (LWL),
wherein the optical fiber (LWL) has a first end and a second end;
providing (145) a carrier material (TM) in liquid form which is curable by means of electromagnetic radiation at a curing wavelength (λ_{H}),
wherein a plurality of diamonds (DM) and/or crystals are embedded in the carrier material (TM) and
wherein one or more or all of the diamonds (DM) among these diamonds (DM) and/or crystals comprise nitrogen-vacancy-centers (NVZ) and/or other paramagnetic centers, and
wherein the nitrogen-vacancy centers (NVZ) of the carrier material (TM) and/or the other paramagnetic centers of the carrier material (TM) emit at least one fluorescence radiation (FL) when irradiated with pump radiation (LB) of a pump radiation wavelength (λₚₘₚ);
Coating (150) of the first end of the optical fiber (LWL), in particular over a coating length (L_{B}) or within a coating region, with the carrier material (TM) comprising the plurality of embedded diamonds (DM) and/or crystals;
Irradiating (155) the carrier material (TM) in the region of the first end (ELWL1) of the optical fiber (LWL) with electromagnetic curing radiation,
wherein the wavelength of this electromagnetic radiation, the curing wavelength (λ_{H}), is selected such that the carrier material (TM) at the first end (ELWL1) of the optical fiber (LWL) in the irradiated region at least partially cures and is at least partially converted into a solid;
removing (160) the uncured carrier material (TM), in particular by means of a solvent,
whereby the remaining film of the carrier material (TM) at the first end of the optical fiber (LWL) forms the sensor element (SE) and
wherein the irradiation (155) of the carrier material (TM) in the region of the first end (ELWL1) of the optical fiber (LWL) comprises the injection (155) of electromagnetic curing radiation into the second end of the optical fiber (LWL), wherein the wavelength of this electromagnetic radiation, the curing wavelength (λ_{(H)} ), is selected such that the carrier material (TM) at the first end of the optical fiber (LWL) cures and transforms into a solid.

2. The method according to claim 1,
wherein the carrier material (TM) cures only partially when irradiated with the curing radiation of the curing wavelength (λ_{H}).

3. A method according to any one of claims 1 to 2,
wherein the curing radiation fed into the second end of the optical fiber for curing is UV radiation with a curing wavelength (λ_{H}) in the wavelength range from 1 nm to 400 nm.

4. A method according to any one of claims 1 to 3
wherein the optical fiber (LWL) provided
- comprises an optical fiber core (LWLC) at least at the first end of the optical fiber (LWL) and/or
- is coated, at least at the first end of the optical fiber, with a light-impermeable layer which has one or more light-transmitting openings, the clearances, and
wherein these structures of the optical fiber (LWL)-namely the optical fiber core (LWLC) and/or the clearances-locally restrict the light emission of the curing radiation at the curing wavelength (λ_{H}) at the first end of the optical fiber to one or more emission regions, and
wherein, during curing, the method takes place in the carrier material (TM) by feeding the curing radiation with the curing wavelength (λ_{H}) at the second end (ELWL2) of the optical fiber (LWL)
- one or more optical functional elements (LWLL) and/or
- one or more sensor elements (SE)
at the first end (ELWL1) of the optical fiber (LWL) in the region of the one or more exit regions, and
whereby the one or more optical functional elements (LWLL) formed by the method and/or the one or more sensor elements (SE) formed by the method are configured by the method in such a way that the one or more optical functional elements (LWLL) formed by the method and/or the one or more sensor elements (SE) formed by the method
- with the optical fiber core (LWLC) at the first end (ELWL1) of the optical fiber (LWL) and/or
- with the one or more clearances at the first end (ELWL1) of the optical fiber (LWL),
which interact optically, and are in particular self-aligned by the method,
- when optical radiation, in particular pump radiation (LB) with the pump radiation wavelength (λₚₘₚ), is injected at the second end (ELWL2) of the optical fiber (LWL) and/or
- when, at the first end (ELWL1) of the optical fiber (LWL), nitrogen-vacancy-centers (NVZ) within the cladding material (TM) and/or other paramagnetic centers within the cladding material (TM) emit fluorescent radiation (FL).

5. A method according to one or more of claims 1 to 4,
wherein the optical fiber provided is coated with one or more waveguides (1380, 1880, 2380, 6880, 6980), which are configured to inject a microwave signal (µW) into the one or more waveguides (1380, 1880, 2380, 6880, 6980) and which are arranged to irradiate the paramagnetic centers and/or nitrogen-vacancy-centers in diamond with a modulated microwave signal (µW) and which, in particular, comprise clearances.

## Revendications

1. Procédé de fabrication d'un fibre optique (LWL) (guide d'ondes optiques)
comprenant les étapes suivantes:
la mise à disposition (140) d'un guide d'ondes optiques (LWL),
ledit fibre optique (LWL) comportant une première extrémité et une deuxième extrémité ;
mise à disposition (145) d'un matériau de support (TM) liquide et durcissable au moyen d'un rayonnement électromagnétique d'une longueur d'onde de durcissement (λ_{H}) ;
dans lequel une pluralité de diamants (DM) et/ou de cristaux sont incorporés dans le matériau de support (TM) et
dans lequel un ou plusieurs, voire tous les diamants (DM) parmi ces diamants (DM) et/ou cristaux présentent des centres NV (NVZ) et/ou d'autres centres paramagnétiques, et
les centres NV (NVZ) du matériau de support (TM) et/ou les autres centres paramagnétiques du matériau de support (TM) émettant, lorsqu'ils sont irradiés par un rayonnement de pompage (LB) d'une longueur d'onde de rayonnement de pompage (λₚₘₚ), au moins un rayonnement fluorescent (FL) ;
mouillage (150) de la première extrémité de la fibre optique (LWL), en particulier sur une longueur de mouillage (L_{B} ) ou dans une zone de mouillage, avec le matériau de support (TM) qui comporte la pluralité de diamants (DM) et/ou de cristaux incorporés ;
Irradiation (155) du matériau de support (TM) dans la zone de la première extrémité (ELWL1) de la fibre optique (LWL) avec un rayonnement électromagnétique de durcissement,
la longueur d'onde de ce rayonnement électromagnétique, la longueur d'onde de durcissement (λ_{H}), étant choisie de telle sorte que le matériau de support (TM) au niveau de la première extrémité (ELWL1) de la fibre optique (LWL) durcisse au moins partiellement dans la zone irradiée et se transforme au moins partiellement en un solide ;
élimination (160) du matériau de support (TM) non durci, notamment à l'aide d'un solvant,
le film restant du matériau de support (TM) à la première extrémité de la fibre optique (LWL) formant alors l'élément capteur (SE) et
l'irradiation (155) du matériau de support (TM) dans la zone de la première extrémité (ELWL1) de la fibre optique (LWL) comprend l'injection (155) d'un rayonnement électromagnétique de durcissement dans la deuxième extrémité de la fibre optique (LWL), la longueur d'onde de ce rayonnement électromagnétique, la longueur d'onde de durcissement (λ_{(H)} ), est choisie de telle sorte que le matériau de support (TM) au niveau de la première extrémité de la fibre optique (LWL) durcisse et se transforme en un solide.

2. Procédé selon la revendication 1,
dans lequel le matériau de support (TM) ne durcit que partiellement lorsqu'il est irradié par le rayonnement de durcissement de longueur d'onde de durcissement (λ_{H}).

3. Procédé selon l'une des revendications 1 à 2,
le rayonnement de durcissement injecté à la deuxième extrémité de la fibre optique à des fins de durcissement étant un rayonnement UV dont la longueur d'onde de durcissement (λ_{H}) se situe dans la plage de longueurs d'onde comprise entre 1 nm et 400 nm.

4. Procédé selon l'une des revendications 1 à 3
dans lequel la fibre optique (LWL) mise en place
- comporte, au moins à la première extrémité de la fibre optique (LWL), un cœur de fibre optique (LWLC) et/ou
- est recouvert, au moins à la première extrémité de la fibre optique, d'une couche opaque comportant une ou plusieurs ouvertures transparentes, les « clearances », et
ces structures de la fibre optique (LWL), à savoir le cœur de fibre optique (LWLC) et/ou les « clearances », limitant par zones la sortie de la lumière du rayonnement de durcissement, dont la longueur d'onde de durcissement est (λ_{H}), à une ou plusieurs zones de sortie au niveau de la première extrémité de la fibre optique, et le procédé consistant, lors du durcissement, à injecter dans le matériau de support (TM) le rayonnement de durcissement ayant la longueur d'onde de durcissement (λ_{H}) à la deuxième extrémité (ELWL2) de la fibre optique (LWL)
- un ou plusieurs éléments fonctionnels optiques (LWLL) et/ou
- un ou plusieurs éléments capteurs (SE)
à la première extrémité (ELWL1) du fibre optique (LWL) dans la zone de la ou des zones de sortie, et
le ou les éléments fonctionnels optiques (LWLL) ainsi formés par le procédé et/ou le ou les éléments capteurs (SE) ainsi formés par le procédé étant configurés par le procédé de telle sorte que le ou les éléments fonctionnels optiques (LWLL) ainsi formés par le procédé et/ou le ou les éléments capteurs (SE) ainsi formés par le procédé
- avec le cœur de la fibre optique (LWLC) à la première extrémité (ELWL1) de la fibre optique (LWL) et/ou
- avec le ou les espaces libres situés à la première extrémité (ELWL1) de la fibre optique (LWL),
en particulier auto-alignés par le procédé, interagissent optiquement,
- lorsqu'un rayonnement optique, en particulier un rayonnement de pompage (LB) ayant la longueur d'onde de rayonnement de pompage (λₚₘₚ), est injecté à la deuxième extrémité (ELWL2) de la fibre optique (LWL) et/ou
- lorsque, à la première extrémité (ELWL1) de la fibre optique (LWL), des centres NV (NVZ) au sein du matériau de support (TM) et/ou d'autres centres paramagnétiques au sein du matériau de support (TM) émettent un rayonnement fluorescent (FL).

5. Procédé selon une ou plusieurs des revendications 1 à 4,
le guide d'ondes optique (LWL) fourni étant recouvert d'un ou plusieurs guides d'ondes (1380, 1880, 2380, 6880, 6980), qui sont configurés pour injecter un signal micro-ondes (µW) dans le ou les guides d'ondes (1380, 1880, 2380, 6880, 6980) et qui sont agencés pour irradier les centres paramagnétiques et/ou les centres NV dans le diamant avec un signal micro-ondes modulé (µW) et qui comportent notamment des espaces libres.
